# EUROPEAN PATENT APPLICATION

(11) **EP 4 194 460 A1**
(43) Date of publication of application: **14.06.2023**
(21) Application number: 21911590.4
(22) Date of filing: 23.12.2021
(51) Int. Cl.: C07F 5/02, H01L 51/00, H01L 51/50, C09K 11/06

(54) **ORGANIC LIGHT-EMITTING DEVICE INCLUDING ORGANIC COMPOUND**

(30) Priority: 24.12.2020 KR 20200183776; 17.06.2021 KR 20210078534
(71) Applicant: Lg Chem, Ltd., Seoul 07336 (KR)
(72) Inventor: KIM, Hoon Jun, Daejeon 34122 (KR); HA, Jae Seung, Daejeon 34122 (KR); LEE, Woochul, Daejeon 34122 (KR); KIM, Joo Ho, Daejeon 34122 (KR); KIM, Moung Gon, Daejeon 34122 (KR); LEE, Hojung, Daejeon 34122 (KR); KIM, Seonwoo, Daejeon 34122 (KR)
(74) Representative: Hoffmann Eitle
(86) International application number: PCT/KR2021/019772
(87) International publication number: WO 2022/139525

(57) **Abstract**

The present specification provides an organic light emitting device including a light emitting layer including a compound represented by Chemical Formula 1; and a compound represented by Chemical Formula H.

## Description

### [Technical Field]

The present specification relates to a compound, and an organic light emitting device including the same.

This application claims priority to and the benefits of Korean Patent Application No. 10-2020-0183776, filed with the Korean Intellectual Property Office on December 24, 2020, and Korean Patent Application No. 10-2021-0078534, filed with the Korean Intellectual Property Office on June 17, 2021, the entire contents of which are incorporated herein by reference.

### [Background Art]

An organic light emission phenomenon generally refers to a phenomenon converting electrical energy to light energy using an organic material. An organic light emitting device using an organic light emission phenomenon normally has a structure including an anode, a cathode, and an organic material layer therebetween. Herein, the organic material layer is often formed in a multilayer structure formed with different materials in order to increase efficiency and stability of the organic light emitting device, and for example, may be formed with a hole injection layer, a hole transfer layer, a light emitting layer, an electron transfer layer, an electron injection layer and the like. When a voltage is applied between the two electrodes in such an organic light emitting device structure, holes and electrons are injected to the organic material layer from the anode and the cathode, respectively, and when the injected holes and electrons meet, excitons are formed, and light emits when these excitons fall back to the ground state.

Development of new materials for such an organic light emitting device has been continuously required. Among these, a blue organic light emitting device essentially needs to have high color purity and long lifetime properties, however, technologies to obtain both at the same time is insufficient due to instability caused by high energy of a blue material. Recently, a thermally active delayed fluorescent material having a core structure including boron has been newly developed and received attention with its high efficiency and color purity, however, the material has disadvantages of having a short lifetime due to high triplet energy and slow reverse intersystem crossing rate. Accordingly, development of a blue organic light emitting material achieving high color purity and long lifetime properties at the same time has been required.

### [Disclosure]

### [Technical Problem]

The present specification is directed to providing an organic light emitting device including an organic compound.

### [Technical Solution]

One embodiment of the present specification provides an organic light emitting device including an anode; a cathode; and an organic material layer between the anode and the cathode,
wherein the organic material layer includes a light emitting layer, and
the light emitting layer includes a compound represented by the following Chemical Formula 1; and a compound represented by the following Chemical Formula H.

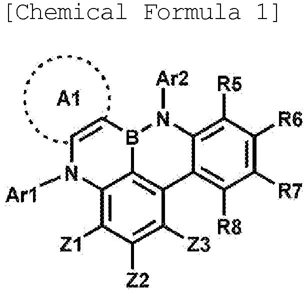

In Chemical Formula 1,
A1 is any one selected from the group consisting of a substituted or unsubstituted aromatic hydrocarbon ring; a substituted or unsubstituted aliphatic hydrocarbon ring; a substituted or unsubstituted heteroring; and a fused ring thereof,
R5 to R8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form a substituted or unsubstituted ring,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form a substituted or unsubstituted ring,
when Ar2 and R5 form a benzoxazine ring, the benzoxazine ring is an unsubstituted benzoxazine ring,
Z1 to Z3 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group, 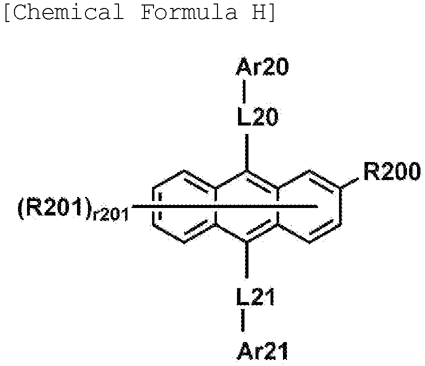
in Chemical Formula H,
L20 and L21 are the same as or different from each other, and each independently a direct bond; or a substituted or unsubstituted arylene group,
Ar20 and Ar21 are the same as or different from each other, and each independently hydrogen; deuterium; a substituted or unsubstituted aryl group; or a substituted or unsubstituted heterocyclic group,
at least one of Ar20 and Ar21 is a substituted or unsubstituted heterocyclic group,
R200 and R201 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r201 is an integer of 1 to 7, and when r201 is 2 or greater, the two or more R201s are the same as or different from each other.

### [Advantageous Effects]

An organic light emitting device according to one embodiment of the present specification includes a compound represented by Chemical Formula 1 and a compound represented by Chemical Formula H as a light emitting layer material, and has high color purity, high efficiency and/or long lifetime properties.

### [Description of Drawings]

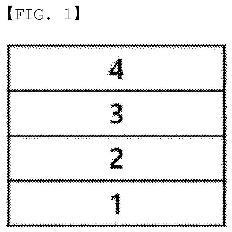

FIG. 1 illustrates an organic light emitting device according to one embodiment of the present specification.

### [Reference Numeral]

- 1:: Substrate
- 2:: Anode
- 3:: Light Emitting Layer
- 4:: Cathode

### [Mode for Disclosure]

Hereinafter, the present specification will be described in more detail.

The present specification provides an organic light emitting device including a light emitting layer including a compound represented by Chemical Formula 1 and a compound represented by Chemical Formula H. Specifically, the compound represented by Chemical Formula 1 is included as a dopant, and the compound represented by Chemical Formula H is included as a host.

An existing organic light emitting device using a boronbased compound has high efficiency compared to an organic light emitting device using a pyrene-based compound, but has a disadvantage of short lifetime. However, the compound represented by Chemical Formula 1 has a narrow full width at half maximum, and an organic light emitting device including the same has advantages of increasing efficiency and lifetime. A narrow full width at half maximum is maintained by the hexagonal ring of boron and amine, and by filling insufficient electrons of the boron through a direct bond of boron and amine on the opposite side, stability of the core in an unstable polaron state increases, which increases a lifetime, and by facilitating a transition of the polaron into an exciton state, an organic light emitting device including the same has increased efficiency.

The compound represented by Chemical Formula H has favorable hole and electron migration and injection, which stabilizes a driving voltage, and results in a high photoluminescence quantum yield. Accordingly, properties of long lifetime and high efficiency are obtained when using the compound represented by Chemical Formula H as a host of a light emitting layer of an organic light emitting device.

Throughout the specification of the present application, a term "combination thereof" included in a Markush-type expression means a mixture or a combination of one or more selected from the group consisting of constituents described in the Markush-type expression, and means including one or more selected from the group consisting of the constituents.

Examples of substituents in the present specification are described below, however, the substituents are not limited thereto.

In the present specification, a dotted line or 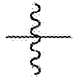 means a linked site.

The term "substitution" means a hydrogen atom bonding to a carbon atom of a compound being changed to another substituent, and the position of substitution is not limited as long as it is a position at which the hydrogen atom is substituted, that is, a position at which a substituent is capable of substituting, and when two or more substituents substitute, the two or more substituents may be the same as or different from each other.

In the present specification, a term "substituted or unsubstituted" means being substituted with one or more substituents selected from the group consisting of deuterium; a halogen group; a cyano group; an alkyl group; a cycloalkyl group; an alkoxy group; an aryloxy group; an alkylthioxy group; an arylthioxy group; an alkenyl group; a haloalkyl group; a haloalkoxy group; an arylalkyl group; an alkylaryl group; a silyl group; a boron group; an amine group; an aryl group; a heterocyclic group; and a fused hydrocarbon ring group, or being substituted with a substituent linking two or more substituents among the substituents illustrated above, or having no substituents.

In the present specification, linking two or more substituents refers to linking hydrogen of any one substituent to another substituent. For example, linking two or more substituents may include a phenyl group and a naphthyl group being linked to become a substituent of 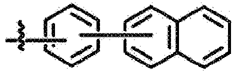 or 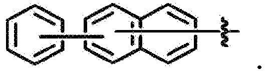 In addition, linking three substituents includes not only continuously linking (substituent 1)-(substituent 2)-(substituent 3), but also linking (substituent 2) and (substituent 3) to (substituent 1). For example, a phenyl group, a naphthyl group and an isopropyl group may be linked to become a substituent of 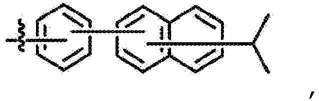 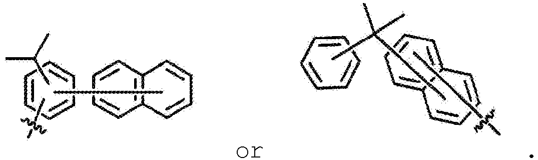 The same definition described above also applies when linking four or more substituents.

In the present specification, being "substituted with A₁ or A₂" includes, as well as a case of being substituted A₁ and a case of being substituted with A₂, a case of being substituted with A₁ and A₂.

In one embodiment of the present specification, a term "substituted or unsubstituted" means being substituted with one or more substituents selected from the group consisting of deuterium; a halogen group; a cyano group; an alkyl group; a cycloalkyl group; an alkoxy group; an aryloxy group; an alkylthioxy group; an arylthioxy group; an alkenyl group; a haloalkyl group; a haloalkoxy group; an arylalkyl group; an alkylaryl group; a silyl group; a boron group; an amine group; an aryl group; a heterocyclic group; and a fused hydrocarbon ring group, or being substituted with a substituent linking two or more substituents among the substituents illustrated above, or having no substituents, and
the alkyl group has 1 to 20 carbon atoms, the cycloalkyl group has 3 to 60 carbon atoms, the aryl group has 6 to 60 carbon atoms, the heterocyclic group has 2 to 60 carbon atoms, the heterocyclic group includes one or more of O, S, N and Si as a hetero-element, and the fused hydrocarbon ring group has 9 to 90 carbon atoms.

In the present specification, examples of the halogen group may include fluorine, chlorine, bromine or iodine.

In the present specification, the alkyl group may be linear or branched, and although not particularly limited thereto, the number of carbon atoms is preferably from 1 to 30, and more preferably from 1 to 15; 1 to 10; or 1 to 6. Specific examples thereof may include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl and the like, but are not limited thereto.

In the present specification, t-Bu means a tert-butyl group.

In the present specification, the cycloalkyl group is not particularly limited, but may have 3 to 60 carbon atoms, preferably has 3 to 30 carbon atoms, and more preferably has 3 to 20 carbon atoms. The cycloalkyl group may be monocyclic or polycyclic of dicyclic or higher. Specific examples of the cycloalkyl group may include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, an adamantyl group, a bicyclo[2.2.1]heptyl group, a bicyclo[2.2.1]octyl group, a norbornyl group and the like, but are not limited thereto.

In the present specification, the alkoxy group may be linear, branched or cyclic. The number of carbon atoms of the alkoxy group is not particularly limited, but is preferably from 1 to 30, and more preferably from 1 to 15; 1 to 10; or 1 to 6. Specific examples thereof may include methoxy, ethoxy, n-propoxy, isopropoxy, n-butoxy, isobutoxy, tert-butoxy, secbutoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy and the like, but are not limited thereto.

In the present specification, the alkenyl group may be linear or branched, and although not particularly limited thereto, the number of carbon atoms is preferably from 2 to 30. Specific examples thereof may include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group and the like, but are not limited thereto.

In the present specification, the haloalkyl group means, in the definition of the alkyl group, hydrogen of the alkyl group being substituted with at least one halogen group.

In the present specification, the haloalkoxy group means, in the definition of the alkoxy group, hydrogen of the alkoxy group being substituted with at least one halogen group.

In the present specification, the aryl group is not particularly limited, but may have 6 to 50 carbon atoms, preferably has 6 to 30 carbon atoms, and more preferably has 6 to 20 carbon atoms. The aryl group may be monocyclic or polycyclic.

When the aryl group is a monocyclic aryl group, the number of carbon atoms is not particularly limited, but is preferably from 6 to 30, and more preferably from 6 to 20. Specific examples of the monocyclic aryl group may include a phenyl group, a biphenyl group, a terphenyl group and the like, but are not limited thereto.

When the aryl group is a polycyclic aryl group, the number of carbon atoms is not particularly limited, but is preferably from 10 to 30, and more preferably from 10 to 20. Specific examples of the polycyclic aryl group may include a naphthyl group, an anthracene group, a phenanthrene group, a triphenylene group, a pyrene group, a phenalene group, a perylene group, a chrysene group, a fluorene group and the like, but are not limited thereto.

In the present specification, the fluorene group may be substituted, and adjacent groups may bond to each other to form a ring.

When the fluorene group is substituted, 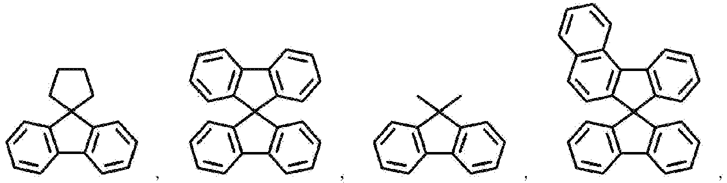 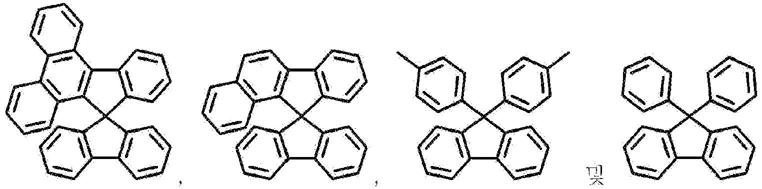 and the like may be included, however, the structure is not limited thereto.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituting ortho positions in a benzene ring, and two substituents substituting the same carbon in an aliphatic ring may be interpreted as groups "adjacent" to each other.

In the present specification, the arylalkyl group means the alkyl group being substituted with an aryl group, and the examples of the aryl group and the alkyl group described above may be applied to the aryl group and the alkyl group in the arylalkyl group.

In the present specification, the aryloxy group means, in the definition of the alkoxy group, the alkyl group of the alkoxy group is substituted with an aryl group, and the descriptions on the aryl group provided above may be applied. Examples of the aryloxy group may include a phenoxy group, a p-tolyloxy group, an m-tolyloxy group, a 3,5-dimethyl-phenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, but are not limited thereto.

In the present specification, the alkyl group in the alkylthioxy group is the same as the examples of the alkyl group described above. Specific examples of the alkylthioxy group may include a methylthioxy group, an ethylthioxy group, a tert-butylthioxy group, a hexylthioxy group, an octylthioxy group and the like, but are not limited thereto.

In the present specification, the aryl group in the arylthioxy group is the same as the examples of the aryl group described above. Specific examples of the arylthioxy group may include a phenylthioxy group, a 2-methylphenylthioxy group, a 4-tert-butylphenylthioxy group and the like, but are not limited thereto.

In the present specification, the heterocyclic group is a group including one or more atoms that are not carbon, that is, heteroatoms, and specifically, the heteroatom may include one or more atoms selected from the group consisting of N, O, S, Si, Se and the like, and includes an aromatic heterocyclic group or an aliphatic heterocyclic group. The aromatic heterocyclic group may be expressed as a heteroaryl group. The number of carbon atoms of the heterocyclic group is not particularly limited, but may be from 2 to 60, is preferably from 2 to 30 and is more preferably from 2 to 20, and the heterocyclic group may be monocyclic or polycyclic. Examples of the heterocyclic group may include a thiophene group, a furan group, a pyrrole group, an imidazole group, a thiazole group, an oxazole group, an oxadiazole group, a pyridine group, a bipyridine group, a pyrimidine group, a triazine group, a triazole group, an acridine group, a pyridazine group, a pyrazine group, a quinoline group, a quinazoline group, a quinoxaline group, a phthalazine group, a pyridopyrimidine group, a pyridopyrazine group, a pyrazinopyrazine group, an isoquinoline group, an indole group, a carbazole group, a benzoxazole group, a benzimidazole group, a benzothiazole group, a benzocarbazole group, a benzothiophene group, a dibenzothiophene group, a benzofuran group, a naphthobenzofuran group, a naphthobenzothiophene group, a dibenzosilole group, a naphthobenzosilole group, a phenanthridine group, a phenanthroline group, an isoxazole group, a thiadiazole group, a dibenzofuran group, dibenzosilole group, a phenoxanthine group, a phenoxazine group, a phenothiazine group, a decahydrobenzocarbazole group, a hexahydrocarbazole group, a dihydrobenzoazasiline group, a dihydroindenocarbazole group, a spirofluorenexanthene group, a spirofluorenethioxanthene group, a tetrahydronaphthothiophene group, a tetrahydronaphthofuran group, a tetrahydrobenzothiophene group, a tetrahydrobenzofuran group and the like, but are not limited thereto.

In the present specification, the silyl group may be an alkylsilyl group, an arylsilyl group, an alkylarylsilyl group, a heteroarylsilyl group or the like. As the alkyl group in the alkylsilyl group, the examples of the alkyl group described above may be applied, and as the aryl group in the arylsilyl group, the examples of the aryl group described above may be applied, and as the alkyl group and the aryl group in the alkylarylsilyl group, the examples of the alkyl group and the aryl group may be applied, and as the heteroaryl group in the heteroarylsilyl group, the examples of the heterocyclic group may be applied.

In the present specification, the boron group may be - BR₁₀₀R₁₀₁. R₁₀₀ and R₁₀₁ are the same as or different from each other, and may be each independently selected from the group consisting of hydrogen; deuterium; halogen; a nitrile group; a substituted or unsubstituted monocyclic or polycyclic cycloalkyl group having 3 to 30 carbon atoms; a substituted or unsubstituted linear or branched alkyl group having 1 to 30 carbon atoms; a substituted or unsubstituted monocyclic or polycyclic aryl group having 6 to 30 carbon atoms; and a substituted or unsubstituted monocyclic or polycyclic heterocyclic group having 2 to 30 carbon atoms. Specific examples of the boron group may include a dimethylboron group, a diethylboron group, a t-butylmethylboron group, a diphenylboron group and the like, but are not limited thereto.

In the present specification, the amine group may be selected from the group consisting of -NH₂; an alkylamine group; an alkylarylamine group; an arylamine group; an arylheteroarylamine group; an alkylheteroarylamine group and a heteroarylamine group, and although not particularly limited thereto, the number of carbon atoms is preferably from 1 to 60. The arylamine group has 6 to 60 carbon atoms. According to another embodiment, the arylamine group has 6 to 40 carbon atoms. Specific examples of the amine group may include a methylamine group; a dimethylamine group; an ethylamine group; a diethylamine group; a phenylamine group; a naphthylamine group; a biphenylamine group; an anthracenylamine group; a 9-methylanthracenylamine group; a diphenylamine group; an N-phenylnaphthylamine group; a ditolylamine group; an N-phenyltolylamine group; a triphenylamine group; an N-phenylbiphenylamine group; an N-phenylnaphthylamine group; an N-biphenylnaphthylamine group; an N-naphthylfluorenylamine group; an N-phenylphenanthrenylamine group; an N-biphenylphenanthrenylamine group; an N-phenylfluorenylamine group; an N-phenylterphenylamine group; an N-phenanthrenylfluorenylamine group; an N-biphenylfluorenylamine group; an N-(4-(tert-butyl)phenyl)-N-phenylamine group; an N,N-bis(4-(tert-butyl)phenyl)amine group; an N,N-bis(3-(tert-butyl)phenyl)amine group and the like, but are not limited thereto.

In the present specification, the N-alkylarylamine group means an amine group in which N of the amine group is substituted with an alkyl group and an aryl group. The alkyl group and the aryl group in the N-alkylarylamine group are the same as the examples of the alkyl group and the aryl group described above.

In the present specification, the N-arylheteroarylamine group means an amine group in which N of the amine group is substituted with an aryl group and a heteroaryl group. The aryl group and the heteroaryl group in the N-arylheteroarylamine group are the same as the examples of the aryl group and the heterocyclic group described above.

In the present specification, the N-alkylheteroarylamine group means an amine group in which N of the amine group is substituted with an alkyl group and a heteroaryl group. The alkyl group and the heteroaryl group in the N-alkylheteroarylamine group are the same as the examples of the alkyl group and the heterocyclic group described above.

In the present specification, the alkylamine group means an amine group in which N of the amine group is substituted with an alkyl group, and includes a dialkylamine group, an alkylarylamine group and an alkylheteroarylamine group.

In the present specification, the arylamine group means an amine group in which N of the amine group is substituted with an aryl group, and includes a diarylamine group, an arylheteroarylamine group and an alkylarylamine group.

In the present specification, the heteroarylamine group means an amine group in which N of the amine group is substituted with a heteroaryl group, and includes a diheteroarylamine group, an arylheteroarylamine group and an alkylheteroarylamine group.

In the present specification, the hydrocarbon ring group may be an aromatic hydrocarbon ring group, an aliphatic hydrocarbon ring group, or a fused ring group of an aromatic hydrocarbon ring and an aliphatic hydrocarbon ring, and may be selected from, for example, a cycloalkyl group, an aryl group, and combinations thereof. Examples of the hydrocarbon ring group may include a phenyl group, a cyclohexyl group, an adamantyl group, a bicyclo[2.2.1]heptyl group, a bicyclo[2.2.1]octyl group, a tetrahydronaphthalene group, a tetrahydroanthracene group, a 1,2,3,4-tetrahydro-1,4-methanonaphthalene group, a 1,2,3,4-tetrahydro-1,4-ethanonaphthalene group and the like, but are not limited thereto.

In the present specification, the meaning of "adjacent" in the "bonding to adjacent groups to form a ring" is the same as the descriptions provided above, and the "ring" means a substituted or unsubstituted hydrocarbon ring; or a substituted or unsubstituted heteroring.

In the present specification, the hydrocarbon ring may be an aromatic hydrocarbon ring, an aliphatic hydrocarbon ring, or a fused ring of an aromatic hydrocarbon ring and an aliphatic hydrocarbon ring, and may be selected from, for example, a cycloalkyl group, an aryl group, and combinations thereof except for those that are not monovalent. Examples of the hydrocarbon ring may include benzene, cyclohexane, adamantane, bicyclo[2.2.1]heptane, bicyclo[2.2.1]octane, tetrahydronaphthalene, tetrahydroanthracene, 1,2,3,4-tetrahydro-1,4-methanonaphthalene, 1,2,3,4-tetrahydro-1,4-ethanonaphthalene and the like, but are not limited thereto.

In addition, the aliphatic hydrocarbon ring includes all of a hydrocarbon ring including a single bond, a non-aromatic hydrocarbon ring including a multiple bond, or a ring having a form in which rings including a single bond and a multiple bond are fused. Accordingly, the ring formed with a single bond of the aliphatic hydrocarbon ring may be selected from, for example, a cycloalkyl group except for those that are not a monovalent group, and a hydrocarbon ring including a single bond and a double bond but not an aromatic ring such as cyclopropene, cyclobutene, cyclopentene, cyclohexene, cycloheptene, cyclooctene, cyclononene, cyclodecene or cyclonorbornene also belongs to the aliphatic hydrocarbon ring.

In the present specification, the fused hydrocarbon ring (group) means a fused ring (group) of an aromatic hydrocarbon ring and an aliphatic hydrocarbon ring, and as the aromatic hydrocarbon ring, the descriptions on the aryl group provided above may be applied, and as the aliphatic hydrocarbon ring, the descriptions on the cycloalkyl group provided above may be applied. The fused hydrocarbon ring (group) may have 9 to 90 carbon atoms, preferably has 9 to 60 carbon atoms, and more preferably has 9 to 30 carbon atoms.

In the present specification, the heteroring means a ring including one or more atoms that are not carbon, that is, heteroatoms, and specifically, the heteroatom may include one or more atoms selected form the group consisting of N, O, S, Si, Se and the like. The heteroring may be monocyclic or polycyclic, and may be an aromatic heteroring; an aliphatic heteroring; a fused ring of an aromatic heteroring and an aliphatic heteroring; a fused ring of an aliphatic hydrocarbon ring, an aromatic hydrocarbon ring and an aromatic heteroring, or a fused ring of an aliphatic hydrocarbon ring, an aromatic hydrocarbon ring and an aliphatic heteroring, and the aromatic heteroring may be selected from, for example, a heteroaryl group among heterocyclic group except for those that are not monovalent.

In the present specification, the aliphatic heteroring means an aliphatic ring including one or more of heteroatoms. The aliphatic heteroring includes all of an aliphatic ring including a single bond, an aliphatic ring including a multiple bond, or an aliphatic ring having a form in which rings including a single bond and a multiple bond are fused. Examples of the aliphatic heteroring may include oxirane, tetrahydrofuran, 1,4-dioxane, pyrrolidine, piperidine, morpholine, oxepane, azokane, thiokane, tetrahydronaphthothiophene, tetrahydronaphthofuran, tetrahydrobenzothiophene, tetrahydrobenzofuran and the like, but are not limited thereto.

In the present specification, "deuteration", "substituted with deuterium" or "deuterated" means hydrogen at a substitutable position of a compound being substituted with deuterium.

In the present specification, "substituted with deuterium by X%", "X% deuterated", "degree of deuteration of X%" or "deuterium substitution rate of X%" means X% of hydrogens at a substitutable position in a corresponding structure being substituted with deuterium. For example, when the corresponding structure is dibenzofuran, the dibenzofuran being "substituted with deuterium by 25%", the dibenzofuran being "25% deuterated", the dibenzofuran having a "degree of deuteration of 25%", or the dibenzofuran having a "deuterium substitution rate of 25%" means two of eight hydrogens at a substitutable position of the dibenzofuran being substituted with deuterium.

In the present specification, the degree of deuteration may be identified using known methods such as nuclear magnetic resonance (¹H NMR), TLC/MS (thin-layer chromatography/mass spectrometry) or MALDI-TOF MS (matrix assisted laser desorption/ionization time-of-flight mass spectrometry).

In the present specification, a description of a certain member being placed "on" another member includes not only a case of the certain member being in contact with the another member but a case of still another member being present between the two members.

In the present specification, a description of a certain part "including" certain constituents means capable of further including other constituents, and does not exclude other constituents unless particularly stated on the contrary.

In the present specification, the "layer" has a meaning compatible with a `film' mainly used in the art, and means coating covering a target area. The size of the "layer" is not limited, and each "layer" may have the same or a different size. According to one embodiment, the size of the "layer" may be the same as the whole device, may correspond to the size of a specific functional area, or may be as small as a single subpixel.

In the present specification, a meaning of a specific A material being included in a B layer includes both i) one or more types of A materials being included in one B layer, and ii) a B layer being formed in one or more layers, and an A material being included in one or more of the B layers that is a multilayer.

In the present specification, a meaning of a specific A material being included in a C layer or a D layer includes both i) being included in one or more layers of one or more C layers, ii) being included in one or more layers of one or more D layers, or iii) being included in each of one or more C layers and one or more D layers.

Unless defined otherwise in the present specification, all technical and scientific terms used in the present specification have the same meanings as terms commonly understood by those skilled in the art. Although methods and materials similar or equivalent to those described in the present specification may be used in implementing or experimenting embodiments of the present disclosure, suitable methods and materials are described later. All publications, patent applications, patents and other reference documents mentioned in the present specification are incorporated by reference in the present specification as a whole, and when conflicting, the present specification including definitions has priority unless specific passage is mentioned. Furthermore, materials, methods and examples are for illustrative purposes only, and not to limit the present specification.

Hereinafter, the following Chemical Formula 1 will be described in detail.

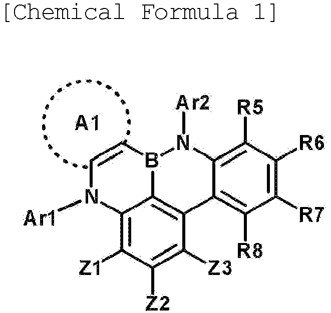

In Chemical Formula 1,
A1 is any one selected from the group consisting of a substituted or unsubstituted aromatic hydrocarbon ring; a substituted or unsubstituted aliphatic hydrocarbon ring; a substituted or unsubstituted heteroring; and a fused ring thereof,
R5 to R8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form a substituted or unsubstituted ring,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form a substituted or unsubstituted ring,
when Ar2 and R5 form a benzoxazine ring, the benzoxazine ring is an unsubstituted benzoxazine ring,
Z1 to Z3 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

According to one embodiment of the present specification, at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to adjacent groups to form a substituted or unsubstituted ring, and the rest are hydrogen.

According to one embodiment of the present specification, Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form any one selected from the group consisting of an aromatic heteroring, an aliphatic heteroring, and a fused ring thereof, each of which is substituted or unsubstituted and includes one or more of N, S, O and Si.

According to one embodiment of the present specification, Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form one of an aromatic heteroring, an aliphatic heteroring, and a fused ring thereof, each of which is substituted or unsubstituted and includes one or more of N, S, O and Si.

According to one embodiment of the present specification, Chemical Formula 1 is represented by the following Chemical Formula 1-1.

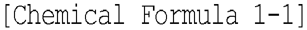

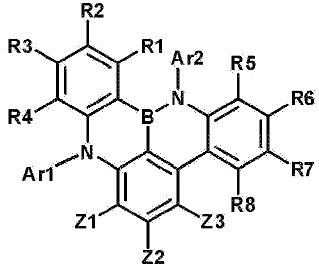

In Chemical Formula 1-1,
R5 to R8, Ar2 and Z1 to Z3 have the same definitions as in Chemical Formula 1,
R1 to R4 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form one of a substituted or unsubstituted aromatic hydrocarbon ring; a substituted or unsubstituted aliphatic hydrocarbon ring; a substituted or unsubstituted heteroring; and a fused ring thereof,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R4 to form a substituted or unsubstituted ring, and
when Ar1 is a phenyl group, and R1 to R4 and R6 to R8 are hydrogen, and adjacent groups among Z1 to Z3 do not bond to each other to form a substituted or unsubstituted ring, and Ar2 and R5 form an indole group at the same time, the indole group is a substituted indole group.

According to one embodiment of the present specification, Chemical Formula 1 is represented by the following Chemical Formula 1-2.

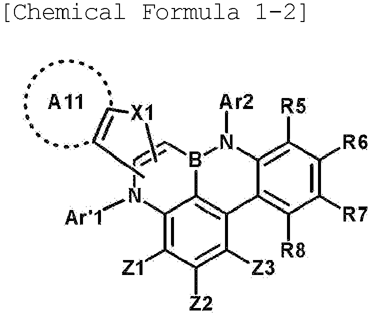

In Chemical Formula 1-2,
R5 to R8, Ar2 and Z1 to Z3 have the same definitions as in Chemical Formula 1,
X1 is CRR'; O; or S,
A11 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
R and R' are the same as or different from each other, and each independently a substituted or unsubstituted alkyl group; a substituted or unsubstituted aryl group; or a substituted or unsubstituted heterocyclic group, or bond to each other to form a substituted or unsubstituted ring.

According to one embodiment of the present specification, Chemical Formula 1-1 is represented by one of the following Chemical Formulae 1-1-1 to 1-1-36.

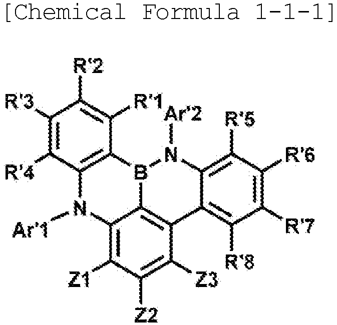

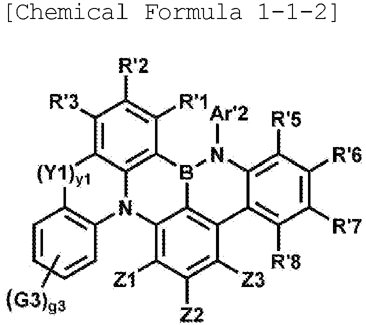

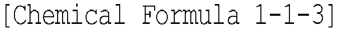

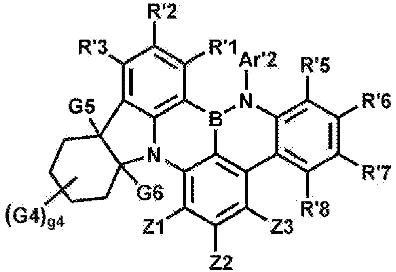

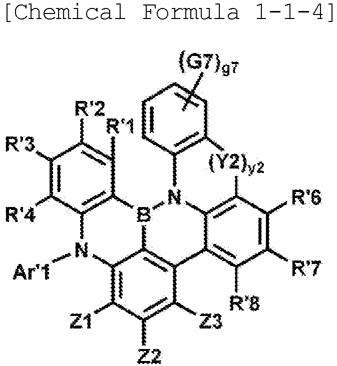

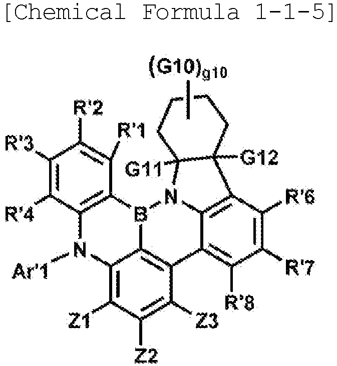

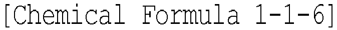

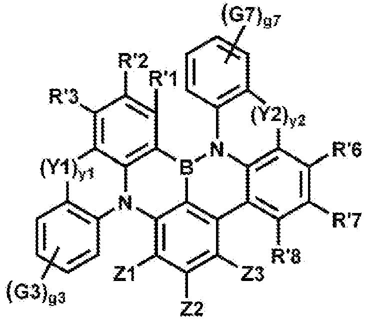

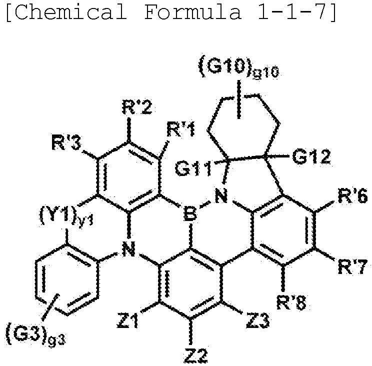

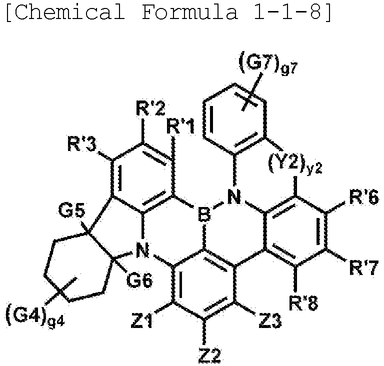

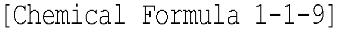

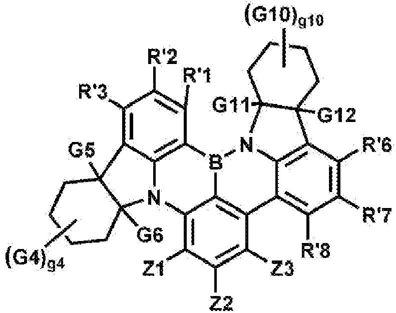

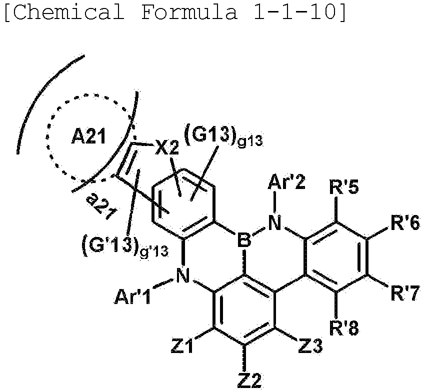

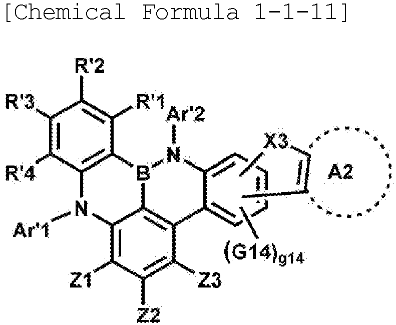

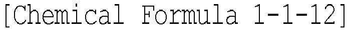

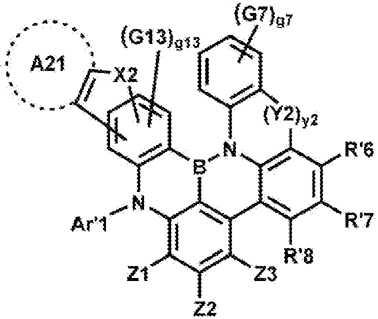

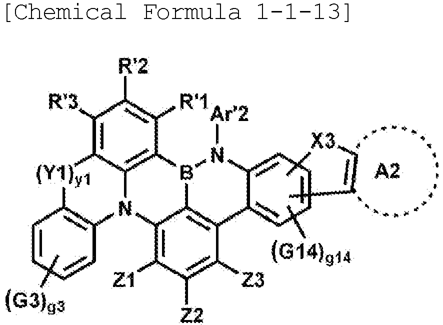

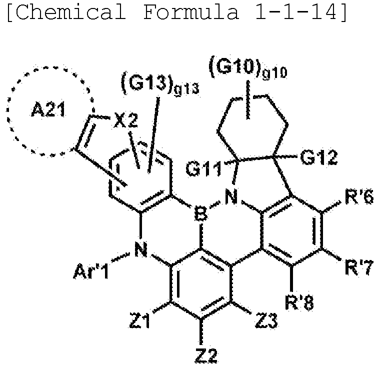

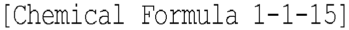

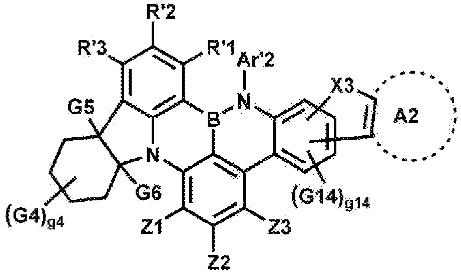

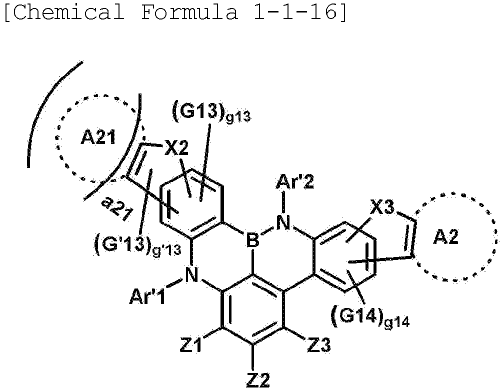

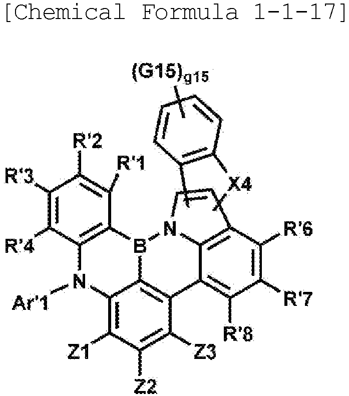

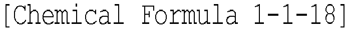

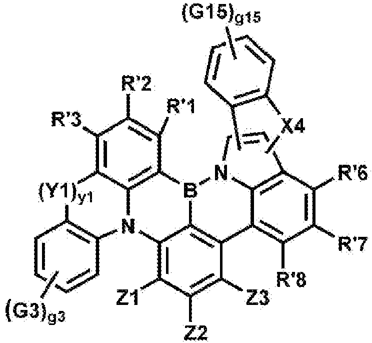

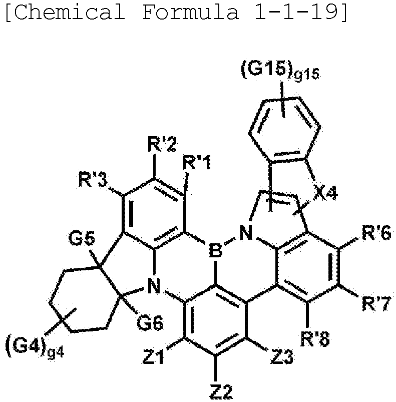

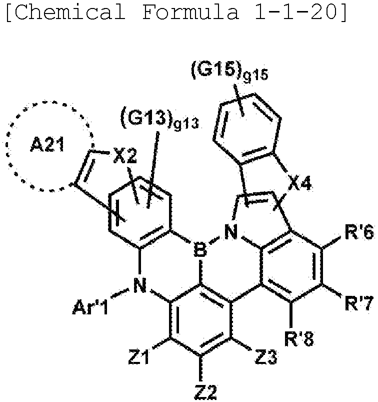

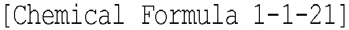

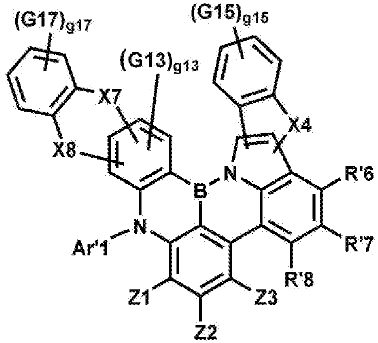

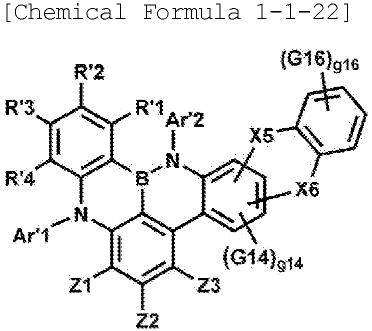

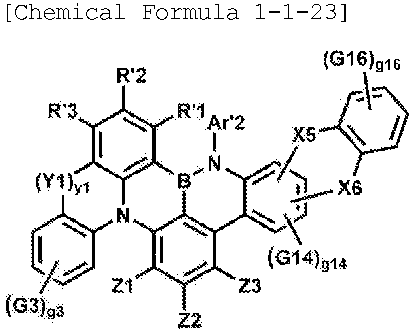

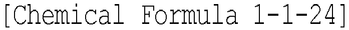

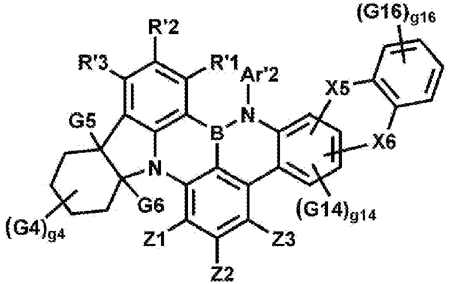

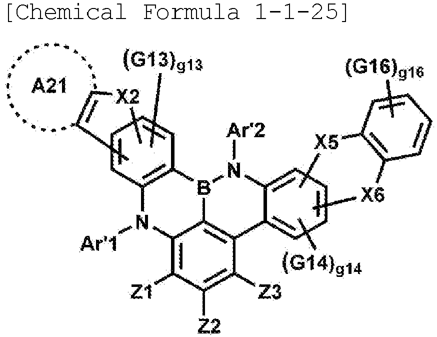

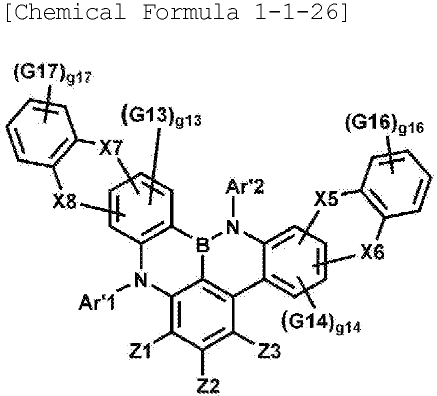

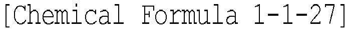

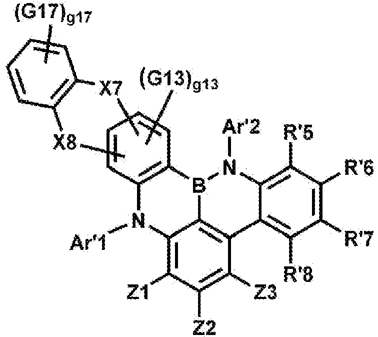

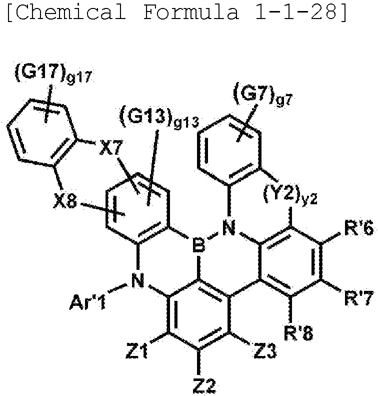

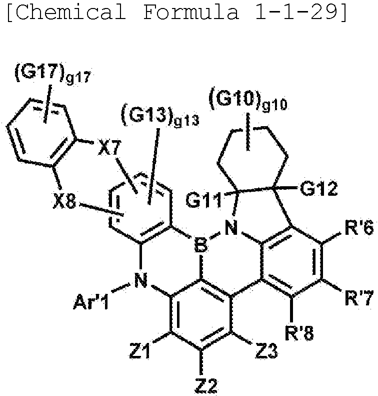

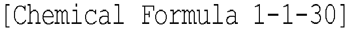

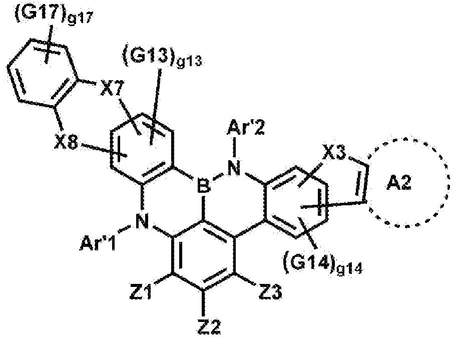

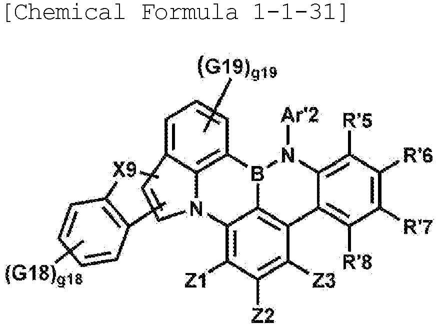

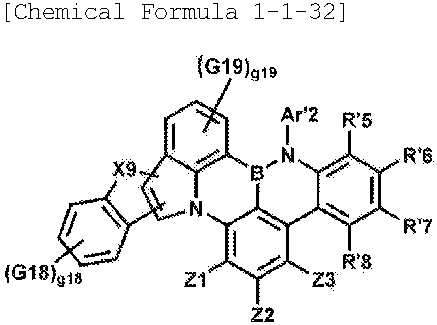

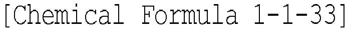

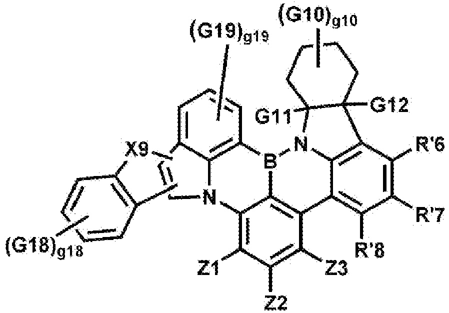

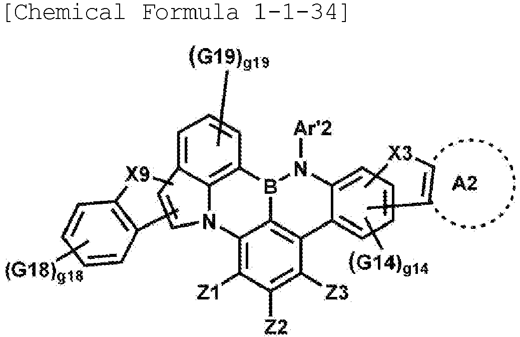

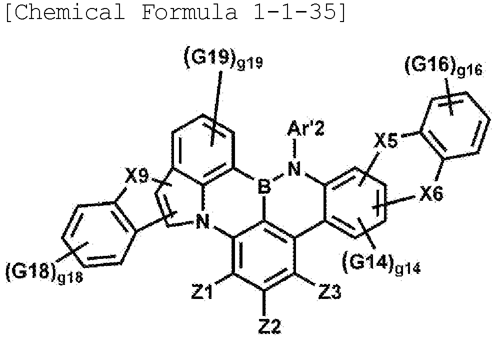

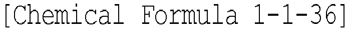

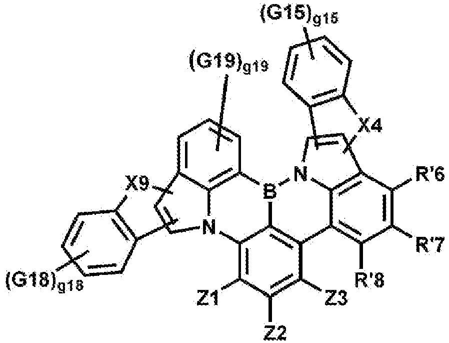

In Chemical Formulae 1-1-1 to 1-1-36,
X2 to X9 are the same as or different from each other, and each independently CRR'; NR"; O; or S,
Y1 and Y2 are the same as or different from each other, and each independently CG1G2; SiG8G9; NG101; O; or S,
y1 is 0 or 1, and when y1 is 0, Y1 is a direct bond,
y2 is 0 or 1, and when y2 is 0, Y2 is a direct bond,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'1 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1 to G19, G'13 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g3, g7, and g15 to g18 are each an integer of 1 to 4,
g4 and g10 are each an integer of 1 to 8,
g13 and g14 are each 1 or 2,
g'13 is an integer of 0 to 2,
g19 is an integer of 1 to 3,
a21 is 0 or 1,
when g3, g4, g7, g10, and g15 to g19 are each 2 or greater, substituents in the two or more parentheses are the same as or different from each other,
when g13, g'13 and g14 are each 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
A2 and A21 are the same as or different from each other, and each independently a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Z1 to Z3 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
in Chemical Formulae 1-1-4, 1-1-6, 1-1-8, 1-1-12, 1-1-28 and 1-1-32,
when y2 is 1 and Y2 is O, G7 and R'6 to R'8 are hydrogen.

In one embodiment of the present specification, at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to adjacent groups to form a substituted or unsubstituted ring, and the rest are hydrogen.

According to one embodiment of the present specification, Chemical Formula 1-2 is represented by one of the following Chemical Formulae 1-2-1 to 1-2-6.

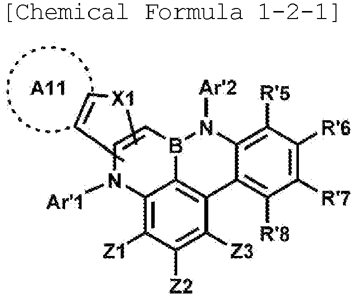

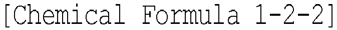

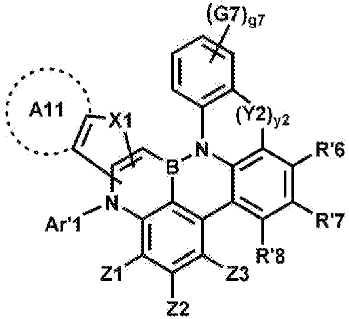

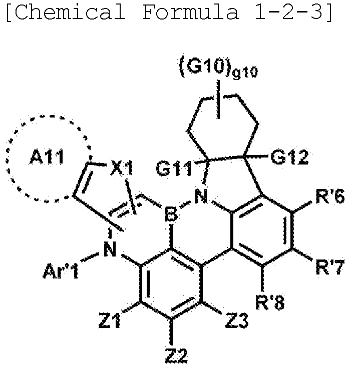

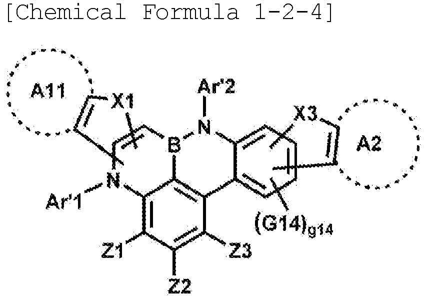

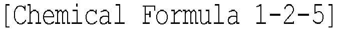

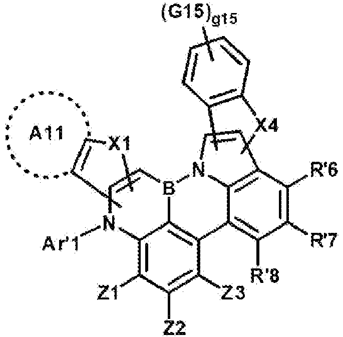

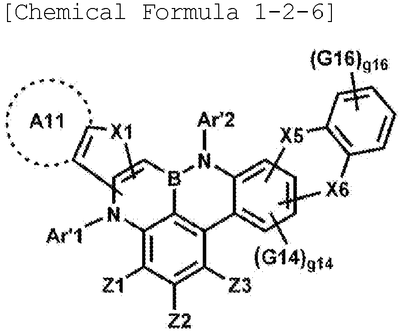

In Chemical Formulae 1-2-1 to 1-2-6,
X1, A11 and Z1 to Z3 have the same definitions as in Chemical Formula 1-2,
X3 to X6 are the same as or different from each other, and each independently CRR'; NR"; O; or S,
Y2 is CG1G2; SiG8G9; NG101; O; or S,
y2 is 0 or 1, and when y2 is 0, Y2 is a direct bond,
A2 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'5 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1, G2, G7 to G12, G14, G15, G16 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g7, g15 and g16 are each an integer of 1 to 4,
g10 is an integer of 1 to 8,
g14 is 1 or 2,
when g7, g10, g15 and g16 are each 2 or greater, substituents in the two or more parentheses are the same as or different from each other,
when g14 is 2, substituents in the two parentheses are the same as or different from each other, and
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group.

According to one embodiment of the present specification, in Chemical Formula 1-1-4,
Y2 is CG1G2; SiG8G9; NG101; O; or S, and y2 is 0 or 1, when y2 is 0, Y2 is a direct bond,
R'1 to R'4 and R'6 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G7s are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and g7 is an integer of 1 to 4,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
Z1 to Z3 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and
in Chemical Formula 1-2-2,
when y2 is 1 and Y2 is O, G7 and R'6 to R'8 are hydrogen.

According to one embodiment of the present specification, at least one of Z1 to Z3 is deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group.

According to one embodiment of the present specification, in Chemical Formula 1-1-4, a case of the substituents bonding to each other to form a substituted or unsubstituted ring is excluded.

According to one embodiment of the present specification, Chemical Formula 1 is represented by one of the following Chemical Formulae 1-3 to 1-5.

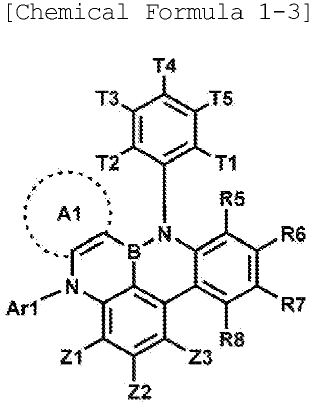

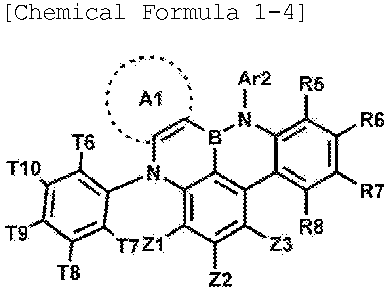

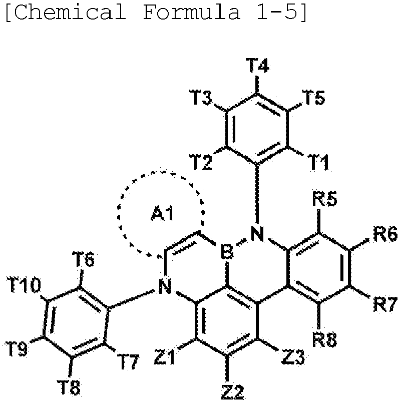

In Chemical Formulae 1-3 to 1-5,
Ar1, Ar2, A1, R5 to R8 and Z1 to Z3 have the same definitions as in Chemical Formula 1,
T1 to T10 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
at least one of T1 and T2 is a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and
at least one of T6 and T7 is a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group.

In one embodiment of the present specification, at least one of T1 and T2 is a substituent that is not hydrogen.

In one embodiment of the present specification, at least one of T6 and T7 is a substituent that is not hydrogen.

According to one embodiment of the present specification, Chemical Formula 1 is represented by the following Chemical Formula 2.

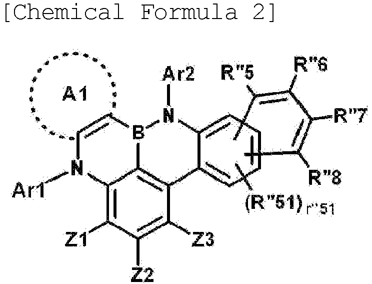

In Chemical Formula 2,
A1, Ar1 and Z1 to Z3 have the same definitions as in Chemical Formula 1,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one of an aromatic heteroring, an aliphatic heteroring, and a fused ring thereof, each of which is substituted or unsubstituted and includes one or more of N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, Chemical Formula 1-1 is represented by the following Chemical Formula 2-1.

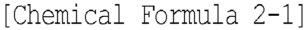

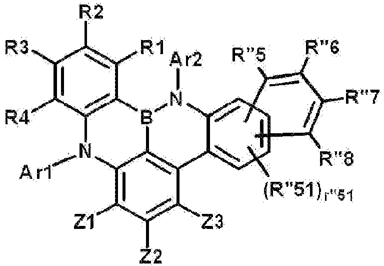

In Chemical Formula 2-1,
Ar1, R1 to R4 and Z1 to Z3 have the same definitions as in Chemical Formula 1-1,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one of an aromatic heteroring, an aliphatic heteroring, and a fused ring thereof, each of which is substituted or unsubstituted and includes one or more of N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, Chemical Formula 1-2 is represented by the following Chemical Formula 2-2. 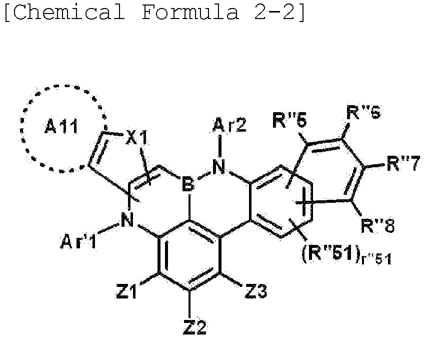
X1, A11, Ar'1 and Z1 to Z3 have the same definitions as in Chemical Formula 1-2,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R"51 to form one of an aromatic heteroring, an aliphatic heteroring, and a fused ring thereof, each of which is substituted or unsubstituted and includes one or more of N, S, O and Si,
R"51 and R"5 to R"8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring,
r"51 is 1 or 2, and
when r"51 is 2, the two R"51s are the same as or different from each other.

According to one embodiment of the present specification, adjacent groups among Z1 to Z3 bond to each other to form a ring represented by the following Chemical Formula C-1 or C-2.

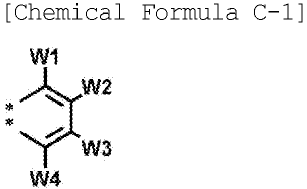

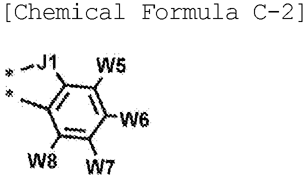

In Chemical Formulae C-1 and C-2,
J1 is O; S; NQ7; CQ8Q9; or SiQ10Q11,
W1 to W8 and Q7 to Q11 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form a substituted or unsubstituted ring, and
* is a site bonding to Chemical Formula 1.

Adjacent groups among Z1 to Z3 mean Z1 and Z2; or Z2 and Z3.

According to one embodiment of the present specification, adjacent groups among W1 to W8 bond to each other to form the ring represented by Chemical Formula C-1.

According to one embodiment of the present specification, Chemical Formula C-2 is one selected from the following structures.

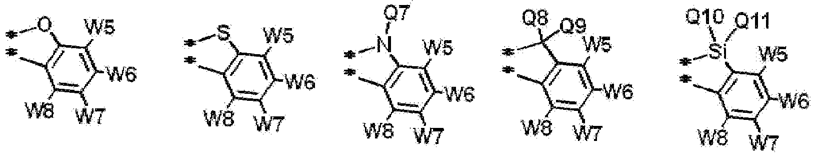

In the structures,
*, W1 to W8 and Q7 to Q11 have the same definitions as described above.

According to one embodiment of the present specification, A1 is a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, A1 is a monocyclic or polycyclic aromatic hydrocarbon ring having 6 to 30 carbon atoms unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, A1 is benzene unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; naphthalene; indene unsubstituted or substituted with a linear or branched alkyl group having 1 to 30 carbon atoms; fluorene unsubstituted or substituted with a linear or branched alkyl group having 1 to 30 carbon atoms; tetrahydronaphthalene unsubstituted or substituted with a linear or branched alkyl group having 1 to 30 carbon atoms; dibenzofuran unsubstituted or substituted with a linear or branched alkyl group having 1 to 30 carbon atoms; dibenzothiophene unsubstituted or substituted with a linear or branched alkyl group having 1 to 30 carbon atoms; benzofuran unsubstituted or substituted with a linear or branched alkyl group having 1 to 30 carbon atoms or a monocyclic or polycyclic aryl group having 6 to 30 carbon atoms; benzothiophene unsubstituted or substituted with a linear or branched alkyl group having 1 to 30 carbon atoms or a monocyclic or polycyclic aryl group having 6 to 30 carbon atoms; benzonaphthofuran; naphthofuran; benzonaphthothiophene unsubstituted or substituted with a linear or branched alkyl group having 1 to 30 carbon atoms; tetrahydrobenzonaphthofuran unsubstituted or substituted with a linear or branched alkyl group having 1 to 30 carbon atoms; tetrahydrobenzonaphthothiophene unsubstituted or substituted with a linear or branched alkyl group having 1 to 30 carbon atoms; tetrahydrobenzofluorene unsubstituted or substituted with a linear or branched alkyl group having 1 to 30 carbon atoms; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; naphthothiophene unsubstituted or substituted with a linear or branched alkyl group having 1 to 30 carbon atoms; or tetrahydrobenzoindene unsubstituted or substituted with a linear or branched alkyl group having 1 to 30 carbon atoms.

According to one embodiment of the present specification, A1 is benzene unsubstituted or substituted with a methyl group, a tert-butyl group, a tetramethyltetrahydronaphthyl group, a phenyl group or NQ1Q2; naphthalene; indene unsubstituted or substituted with a methyl group; fluorene unsubstituted or substituted with a methyl group; tetrahydronaphthalene unsubstituted or substituted with a methyl group; dibenzofuran unsubstituted or substituted with a methyl group or a tert-butyl group; dibenzothiophene unsubstituted or substituted with a methyl group or a tert-butyl group; benzofuran unsubstituted or substituted with a methyl group, a phenyl group or a tert-butyl group; benzothiophene unsubstituted or substituted with a methyl group, a phenyl group or a tert-butyl group; benzonaphthofuran; naphthofuran; benzonaphthothiophene unsubstituted or substituted with a tert-butyl group; tetrahydrobenzonaphthofuran unsubstituted or substituted with a methyl group; tetrahydrobenzonaphthothiophene unsubstituted or substituted with a methyl group; tetrahydrobenzofluorene unsubstituted or substituted with a methyl group; tetrahydronaphthofuran unsubstituted or substituted with a methyl group; tetrahydronaphthothiophene unsubstituted or substituted with a methyl group; naphthothiophene unsubstituted or substituted with a methyl group; or tetrahydrobenzoindene unsubstituted or substituted with a methyl group.

According to one embodiment of the present specification, Q1 and Q2 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms.

According to one embodiment of the present specification, Q1 and Q2 are the same as or different from each other, and each independently a methyl group; a tert-butyl group; a phenyl group unsubstituted or substituted with a methyl group or a tert-butyl group; a biphenyl group unsubstituted or substituted with a methyl group or a tert-butyl group; a fluorene group unsubstituted or substituted with a methyl group; a tetrahydronaphthyl group unsubstituted or substituted with a methyl group; a dibenzofuran group; or a dibenzothiophene group.

According to one embodiment of the present specification, R5 to R8 are the same as or different from each other, and each independently hydrogen; a substituted or unsubstituted linear or branched alkyl group having 1 to 30 carbon atoms; a substituted or unsubstituted monocyclic or polycyclic aryl group having 6 to 30 carbon atoms; or NQ3Q4, or bond to adjacent groups to form a substituted or unsubstituted monocyclic or polycyclic aliphatic hydrocarbon ring having 3 to 30 carbon atoms; a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, R5 to R8 are the same as or different from each other, and each independently hydrogen; deuterium; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, R5 to R8 are the same as or different from each other, and each independently hydrogen; deuterium; a methyl group; a tert-butyl group; a phenyl group; or NQ3Q4, or bond to adjacent groups to form cyclohexane unsubstituted or substituted with a linear or branched alkyl group having 1 to 30 carbon atoms; benzene; benzofuran unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; benzothiophene unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; naphthofuran; naphthothiophene; indene unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; indole unsubstituted or substituted with a monocyclic or polycyclic aryl group having 6 to 30 carbon atoms; indoloindene unsubstituted or substituted with a linear or branched alkyl group having 1 to 30 carbon atoms; indoloindole; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; tetrahydrobenzoindene unsubstituted or substituted with a linear or branched alkyl group having 1 to 30 carbon atoms; benzodioxine; benzooxathiine; benzodithiine; thiochromene unsubstituted or substituted with a linear or branched alkyl group having 1 to 30 carbon atoms; chromene unsubstituted or substituted with a linear or branched alkyl group having 1 to 30 carbon atoms; or dihydronaphthalene unsubstituted or substituted with a linear or branched alkyl group having 1 to 30 carbon atoms.

According to one embodiment of the present specification, R5 to R8 are the same as or different from each other, and each independently hydrogen; deuterium; a methyl group; a tert-butyl group; a phenyl group; or NQ3Q4, or bond to adjacent groups to form cyclohexane unsubstituted or substituted with a methyl group; benzene; benzofuran unsubstituted or substituted with a methyl group, a tert-butyl group, or a diphenylamine group unsubstituted or substituted with a tert-butyl group; benzothiophene unsubstituted or substituted with a methyl group, a tert-butyl group, or a diphenylamine group unsubstituted or substituted with a tert-butyl group; naphthofuran; naphthothiophene; indene unsubstituted or substituted with a methyl group, or a diphenylamine group unsubstituted or substituted with a tert-butyl group; indole unsubstituted or substituted with a phenyl group; indoloindene unsubstituted or substituted with a methyl group; indoloindole; tetrahydronaphthofuran unsubstituted or substituted with a methyl group; tetrahydronaphthothiophene unsubstituted or substituted with a methyl group; tetrahydrobenzoindene unsubstituted or substituted with a methyl group; benzodioxine; benzooxathiine; benzodithiine; thiochromene unsubstituted or substituted with a methyl group; chromene unsubstituted or substituted with a methyl group; or dihydronaphthalene unsubstituted or substituted with a methyl group.

According to one embodiment of the present specification, Q3 and Q4 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or Q3 and Q4 are the same as or different from each other and each independently a monocyclic or polycyclic aryl group having 6 to 30 carbon atoms unsubstituted or substituted with a linear or branched alkyl group having 1 to 30 carbon atoms, and bond to each other to form a ring.

According to one embodiment of the present specification, Q3 and Q4 are the same as or different from each other, and each independently a methyl group; a tert-butyl group; a phenyl group unsubstituted or substituted with a methyl group or a tert-butyl group; a biphenyl group unsubstituted or substituted with a methyl group or a tert-butyl group; a fluorene group unsubstituted or substituted with a methyl group; a tetrahydronaphthyl group unsubstituted or substituted with a methyl group; a dibenzofuran group; or a dibenzothiophene group, or Q3 and Q4 are the same as or different from each other and each independently a phenyl group unsubstituted or substituted with a methyl group or a tert-butyl group, and bond to each other to form a carbazole ring.

According to one embodiment of the present specification, Ar1 is a substituted or unsubstituted monocyclic or polycyclic aryl group having 6 to 30 carbon atoms; a substituted or unsubstituted fused ring group of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heterocyclic group having 2 to 30 carbon atoms, or bonds to A1 to form one of a monocyclic or polycyclic aromatic heteroring having 2 to 30 carbon atoms, a monocyclic or polycyclic aliphatic heteroring having 2 to 30 carbon atoms, and a fused ring thereof, each of which is substituted or unsubstituted and includes one or more of N, S, O and Si.

According to one embodiment of the present specification, Ar1 is a monocyclic or polycyclic aryl group having 6 to 30 carbon atoms unsubstituted or substituted with one or more selected from a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to A1 to form one of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more of N, S, O and Si.

According to one embodiment of the present specification, Ar1 is a phenyl group unsubstituted or substituted with one or more selected from a linear or branched alkyl group having 1 to 30 carbon atoms, a monocyclic or polycyclic aryl group having 6 to 30 carbon atoms, and a combination thereof; a biphenyl group unsubstituted or substituted with a linear or branched alkyl group having 1 to 30 carbon atoms; a terphenyl group; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group, or bonds to A1 to form dihydroacridine unsubstituted or substituted with a linear or branched alkyl group having 1 to 30 carbon atoms or a monocyclic or polycyclic aryl group having 6 to 30 carbon atoms; spiroacridinefluorene; hexahydrocarbazole unsubstituted or substituted with a linear or branched alkyl group having 1 to 30 carbon atoms; dihydrobenzoacridine unsubstituted or substituted with a linear or branched alkyl group having 1 to 30 carbon atoms or a monocyclic or polycyclic aryl group having 6 to 30 carbon atoms; hexahydrobenzoacridine unsubstituted or substituted with a linear or branched alkyl group having 1 to 30 carbon atoms or a monocyclic or polycyclic aryl group having 6 to 30 carbon atoms; spirobenzoacridine; spirotetrahydrobenzoacridinefluorene; benzofuroindole; benzothienoindole; dihydrodibenzoazasiline unsubstituted or substituted with a linear or branched alkyl group having 1 to 30 carbon atoms or a monocyclic or polycyclic aryl group having 6 to 30 carbon atoms; spirodibenzosiloledibenzoazasiline; phenoxazine; phenothiazine; dihydroindenoindole unsubstituted or substituted with a linear or branched alkyl group having 1 to 30 carbon atoms or a monocyclic or polycyclic aryl group having 6 to 30 carbon atoms; benzocarbazole; or carbazole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, Ar1 is a phenyl group unsubstituted or substituted with one or more selected from a methyl group, an iso-propyl group, a tert-butyl group, a phenyl group and a combination thereof; a biphenyl group unsubstituted or substituted with a methyl group or a tert-butyl group; a terphenyl group; a fluorene group unsubstituted or substituted with a methyl group; a tetrahydronaphthyl group unsubstituted or substituted with a methyl group; a dibenzofuran group; or a dibenzothiophene group, or bonds to A1 to form dihydroacridine unsubstituted or substituted with a methyl group or a phenyl group; spiroacridinefluorene; hexahydrocarbazole unsubstituted or substituted with one or more selected from a methyl group and a tert-butyl group; dihydrobenzoacridine unsubstituted or substituted with a methyl group or a phenyl group; hexahydrobenzoacridine unsubstituted or substituted with a methyl group or a phenyl group; spirobenzoacridine; spirotetrahydrobenzoacridinefluorene; benzofuroindole; benzothienoindole; dihydrodibenzoazasiline unsubstituted or substituted with a methyl group or a phenyl group; spirodibenzosiloledibenzoazasiline; phenoxazine; phenothiazine; dihydroindenoindole unsubstituted or substituted with a methyl group or a phenyl group; benzocarbazole; or carbazole unsubstituted or substituted with a tert-butyl group, an adamantyl group or a phenyl group.

According to one embodiment of the present specification, Ar2 is a substituted or unsubstituted monocyclic or polycyclic aryl group having 6 to 30 carbon atoms; a substituted or unsubstituted fused ring group of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heterocyclic group having 2 to 30 carbon atoms, or bonds to R5 to form one of a monocyclic or polycyclic aromatic heteroring having 2 to 30 carbon atoms, a monocyclic or polycyclic aliphatic heteroring having 2 to 30 carbon atoms, and a fused ring thereof, each of which is substituted or unsubstituted and includes one or more of N, S, O and Si.

According to one embodiment of the present specification, Ar2 is a monocyclic or polycyclic aryl group having 6 to 30 carbon atoms unsubstituted or substituted with one or more selected from a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to R5 to form one of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more of N, S, O and Si.

According to one embodiment of the present specification, Ar2 is a phenyl group unsubstituted or substituted with one or more selected from a linear or branched alkyl group having 1 to 30 carbon atoms, a monocyclic or polycyclic aryl group having 6 to 30 carbon atoms, and a combination thereof; a biphenyl group unsubstituted or substituted with a linear or branched alkyl group having 1 to 30 carbon atoms; a terphenyl group; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group, or bonds to R5 to form dihydroquinoline unsubstituted or substituted with a linear or branched alkyl group having 1 to 30 carbon atoms or a monocyclic or polycyclic aryl group having 6 to 30 carbon atoms; spiroquinolinefluorene; hexahydroindene unsubstituted or substituted with a linear or branched alkyl group having 1 to 30 carbon atoms; dihydrobenzoquinoline unsubstituted or substituted with a linear or branched alkyl group having 1 to 30 carbon atoms or a monocyclic or polycyclic aryl group having 6 to 30 carbon atoms; hexahydrobenzoquinoline unsubstituted or substituted with a linear or branched alkyl group having 1 to 30 carbon atoms or a monocyclic or polycyclic aryl group having 6 to 30 carbon atoms; spirobenzoquinoline; spirotetrahydrobenzoquinolinefluorene; benzofuropyrrole; benzothienopyrrole; dihydrobenzoazasiline unsubstituted or substituted with a linear or branched alkyl group having 1 to 30 carbon atoms or a monocyclic or polycyclic aryl group having 6 to 30 carbon atoms; spirodibenzosilolebenzoazasiline; benzoxazine; benzothiazine; dihydroindenopyrrole unsubstituted or substituted with a linear or branched alkyl group having 1 to 30 carbon atoms or a monocyclic or polycyclic aryl group having 6 to 30 carbon atoms; benzindole; or indole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, Ar2 is a phenyl group unsubstituted or substituted with one or more selected from the group consisting of a methyl group, an iso-propyl group, a tert-butyl group, a phenyl group and a combination thereof; a biphenyl group unsubstituted or substituted with a methyl group or a tert-butyl group; a terphenyl group; a fluorene group unsubstituted or substituted with a methyl group; a tetrahydronaphthyl group unsubstituted or substituted with a methyl group; a dibenzofuran group; or a dibenzothiophene group, or bonds to R5 to form dihydroquinoline unsubstituted or substituted with a methyl group or a phenyl group; spiroacridinequinoline; hexahydroindene unsubstituted or substituted with one or more selected from a methyl group and a tert-butyl group; dihydrobenzoquinoline unsubstituted or substituted with a methyl group or a phenyl group; hexahydrobenzoquinoline unsubstituted or substituted with a methyl group or a phenyl group; spirobenzoquinoline; spirotetrahydrobenzoquinolinefluorene; benzofuropyrrole; benzothienopyrrole; dihydrobenzoazasiline unsubstituted or substituted with a methyl group or a phenyl group; spirobenzosiloledibenzoazasiline; benzoxazine; benzothiazine; dihydroindenopyrrole unsubstituted or substituted with a methyl group or a phenyl group; benzindole; or indole unsubstituted or substituted with a tert-butyl group, an adamantyl group or a phenyl group.

According to one embodiment of the present specification, Z1 to Z3 are the same as or different from each other, and each independently hydrogen; deuterium; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or NQ5Q6, or form a substituted or unsubstituted monocyclic or polycyclic aromatic hydrocarbon ring having 6 to 30 carbon atoms; or a substituted or unsubstituted monocyclic or polycyclic heteroring having 2 to 30 carbon atoms.

According to one embodiment of the present specification, Z1 to Z3 are the same as or different from each other, and each independently hydrogen; deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6, or bond to adjacent groups to form a monocyclic or polycyclic aromatic hydrocarbon ring having 6 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with one or more substituents selected from the group consisting of a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 to Z3 are the same as or different from each other, and each independently hydrogen; deuterium; a methyl group; an iso-propyl group; a tert-butyl group; a cyclohexyl group; a phenyl group unsubstituted or substituted with deuterium, or a linear or branched alkyl group having 1 to 30 carbon atoms; or NQ5Q6, or bond to adjacent groups to form benzene; indene unsubstituted or substituted with a linear or branched alkyl group having 1 to 30 carbon atoms; benzofuran unsubstituted or substituted with a linear or branched alkyl group having 1 to 30 carbon atoms; naphthofuran; tetrahydronaphthofuran unsubstituted or substituted with a linear or branched alkyl group having 1 to 30 carbon atoms; benzothiophene; or indole unsubstituted or substituted with one or more substituents selected from the group consisting of a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 to Z3 are the same as or different from each other, and each independently hydrogen; deuterium; a methyl group; an iso-propyl group; a tert-butyl group; a cyclohexyl group; a phenyl group unsubstituted or substituted with deuterium or a methyl group; or NQ5Q6, or bond to adjacent groups to form benzene; indene unsubstituted or substituted with a methyl group; benzofuran unsubstituted or substituted with a tert-butyl group; naphthofuran; tetrahydronaphthofuran unsubstituted or substituted with a methyl group; benzothiophene; or indole unsubstituted or substituted with a phenyl group, or a tetrahydronaphthyl group substituted with a methyl group.

According to one embodiment of the present specification, at least one of Z1 to Z3 is a substituent that is not hydrogen, or bonds to adjacent groups to form a substituted or unsubstituted ring.

According to one embodiment of the present specification, at least one of Z1 to Z3 is a substituent that is not hydrogen.

According to one embodiment of the present specification, Z2 is deuterium; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or NQ5Q6.

According to one embodiment of the present specification, Z2 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6.

According to one embodiment of the present specification, Z2 is deuterium; a methyl group; an iso-propyl group; a tert-butyl group; a cyclohexyl group; a phenyl group unsubstituted or substituted with deuterium, or a linear or branched alkyl group having 1 to 30 carbon atoms; or NQ5Q6.

According to one embodiment of the present specification, Z2 is deuterium; a methyl group; an iso-propyl group; a tert-butyl group; a cyclohexyl group; a phenyl group unsubstituted or substituted with deuterium or a methyl group; or NQ5Q6.

According to one embodiment of the present specification, Z1 and Z3 are hydrogen.

According to one embodiment of the present specification, Z1 and Z3 are deuterium.

According to one embodiment of the present specification, Q5 and Q6 are the same as or different from each other, and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms.

According to one embodiment of the present specification, Q5 and Q6 are the same as or different from each other, and each independently a phenyl group unsubstituted or substituted with a linear or branched alkyl group having 1 to 30 carbon atoms; a biphenyl group unsubstituted or substituted with a linear or branched alkyl group having 1 to 30 carbon atoms; a fluorene group unsubstituted or substituted with a linear or branched alkyl group having 1 to 30 carbon atoms; a tetrahydronaphthyl group unsubstituted or substituted with a linear or branched alkyl group having 1 to 30 carbon atoms; a dibenzofuran group; or a dibenzothiophene group.

According to one embodiment of the present specification, Q5 and Q6 are the same as or different from each other, and each independently a phenyl group unsubstituted or substituted with a methyl group; a biphenyl group unsubstituted or substituted with a methyl group or a biphenyl group; a fluorene group unsubstituted or substituted with a methyl group; a tetrahydronaphthyl group unsubstituted or substituted with a methyl group; a dibenzofuran group; or a dibenzothiophene group.

According to one embodiment of the present specification, Z1 and G3 bond to each other to form a substituted or unsubstituted monocyclic or polycyclic heteroring having 2 to 30 carbon atoms.

According to one embodiment of the present specification, Z1 and G3 bond to each other to form a monocyclic or polycyclic heteroring having 2 to 30 carbon atoms unsubstituted or substituted with one or more substituents selected from the group consisting of a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 and G3 bond to each other to form indole unsubstituted or substituted with one or more substituents selected from the group consisting of a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof.

According to one embodiment of the present specification, Z1 and G3 bond to each other to form indole unsubstituted or substituted with a phenyl group, or a tetrahydronaphthyl group substituted with a methyl group.

According to one embodiment of the present specification, A1 is a monocyclic or polycyclic aromatic hydrocarbon ring having 6 to 30 carbon atoms unsubstituted or substituted with a linear or branched alkyl group having 1 to 30 carbon atoms, a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms, a monocyclic or polycyclic aryl group having 6 to 30 carbon atoms, or NQ1Q2; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms, Q1 and Q2 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, R5 to R8 are the same as or different from each other and each independently hydrogen; deuterium; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms, or a monocyclic or polycyclic diarylamine group having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms, a monocyclic or polycyclic aryl group having 6 to 30 carbon atoms, or a monocyclic or polycyclic diarylamine group having 6 to 30 carbon atoms unsubstituted or substituted with a linear or branched alkyl group having 1 to 30 carbon atoms, Q3 and Q4 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or Q3 and Q4 are the same as or different from each other and each independently a monocyclic or polycyclic aryl group having 6 to 30 carbon atoms unsubstituted or substituted with a linear or branched alkyl group having 1 to 30 carbon atoms or bond to each other to form a ring, Ar1 is a monocyclic or polycyclic aryl group having 6 to 30 carbon atoms unsubstituted or substituted with one or more selected from a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to A1 to form one of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and inclues one or more of N, S, O and Si, Ar2 is a monocyclic or polycyclic aryl group having 6 to 30 carbon atoms unsubstituted or substituted with one or more selected from a linear or branched alkyl group having 1 to 30 carbon atoms, a monocyclic or polycyclic aryl group having 6 to 30 carbon atoms, and a combination thereof; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, or bonds to R5 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more of N, S, O and Si, at least one of Z1 to Z3 is deuterium; a linear or branched alkyl group having 1 to 30 carbon atoms; a monocyclic or polycyclic cycloalkyl group having 3 to 30 carbon atoms; a monocyclic or polycyclic aryl group having 6 to 30 carbon atoms unsubstituted or substituted with deuterium, or a linear or branched alkyl group having 1 to 30 carbon atoms; or NQ5Q6, or bonds to adjacent groups to form a monocyclic or polycyclic aromatic hydrocarbon ring having 6 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with one or more substituents selected from a linear or branched alkyl group having 1 to 30 carbon atoms, a monocyclic or polycyclic aryl group having 6 to 30 carbon atoms, a fused ring group of an aromatic hydrocarbon ring and an aliphatic hydrocarbon ring, and a combination thereof, and the rest are hydrogen, Q5 and Q6 are the same as or different from each other and each independently a monocyclic or polycyclic aryl group having 6 to 30 carbon atoms unsubstituted or substituted with a linear or branched alkyl group having 1 to 30 carbon atoms; a fused ring group of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heterocyclic group having 2 to 30 carbon atoms, when Ar2 and R5 form a benzoxazine ring, the benzoxazine ring is an unsubstituted benzoxazine ring, and when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group.

According to one embodiment of the present specification, R1 to R4 are the same as or different from each other, and each independently hydrogen; a substituted or unsubstituted linear or branched alkyl group having 1 to 30 carbon atoms; a substituted or unsubstituted monocyclic or polycyclic aryl group having 6 to 30 carbon atoms; or NQ3Q4, or bond to adjacent groups to form a substituted or unsubstituted monocyclic or polycyclic aliphatic hydrocarbon ring having 3 to 30 carbon atoms; a substituted or unsubstituted monocyclic or polycyclic aromatic hydrocarbon ring having 6 to 30 carbon atoms; a substituted or unsubstituted fused ring of a monocyclic or polycyclic aromatic hydrocarbon ring having 6 to 30 carbon atoms and a monocyclic or polycyclic aliphatic hydrocarbon ring having 3 to 30 carbon atoms; or a substituted or unsubstituted monocyclic or polycyclic heteroring having 2 to 30 carbon atoms.

According to one embodiment of the present specification, R1 to R4 are the same as or different from each other, and each independently hydrogen; a linear or branched alkyl group having 1 to 30 carbon atoms; a monocyclic or polycyclic aryl group having 6 to 30 carbon atoms; or NQ3Q4, or bond to adjacent groups to form a monocyclic or polycyclic aliphatic hydrocarbon ring having 3 to 30 carbon atoms unsubstituted or substituted with a linear or branched alkyl group having 1 to 30 carbon atoms; a monocyclic or polycyclic aromatic hydrocarbon ring having 6 to 30 carbon atoms unsubstituted or substituted with a linear or branched alkyl group having 1 to 30 carbon atoms; a fused ring of a monocyclic or polycyclic aromatic hydrocarbon ring having 6 to 30 carbon atoms and a monocyclic or polycyclic aliphatic hydrocarbon ring having 3 to 30 carbon atoms unsubstituted or substituted with a linear or branched alkyl group having 1 to 30 carbon atoms; or a monocyclic or polycyclic heteroring having 2 to 30 carbon atoms unsubstituted or substituted with a linear or branched alkyl group having 1 to 30 carbon atoms or a monocyclic or polycyclic aryl group having 6 to 30 carbon atoms.

According to one embodiment of the present specification, R1 to R4 are the same as or different from each other, and each independently hydrogen; a methyl group; a tert-butyl group; a phenyl group; or NQ3Q4, or bond to adjacent groups to form cyclohexane unsubstituted or substituted with a linear or branched alkyl group having 1 to 30 carbon atoms; benzene; benzofuran unsubstituted or substituted with a linear or branched alkyl group having 1 to 30 carbon atoms; benzothiophene unsubstituted or substituted with a linear or branched alkyl group having 1 to 30 carbon atoms; naphthofuran; naphthothiophene; indene unsubstituted or substituted with a linear or branched alkyl group having 1 to 30 carbon atoms; indole unsubstituted or substituted with a monocyclic or polycyclic aryl group having 6 to 30 carbon atoms; indoloindene unsubstituted or substituted with a linear or branched alkyl group having 1 to 30 carbon atoms; indoloindole; tetrahydronaphthofuran unsubstituted or substituted with a linear or branched alkyl group having 1 to 30 carbon atoms; tetrahydronaphthothiophene unsubstituted or substituted with a linear or branched alkyl group having 1 to 30 carbon atoms; tetrahydrobenzoindene unsubstituted or substituted with a linear or branched alkyl group having 1 to 30 carbon atoms; benzodioxine; benzooxathiine; benzodithiine; thiochromene unsubstituted or substituted with a linear or branched alkyl group having 1 to 30 carbon atoms; chromene unsubstituted or substituted with a linear or branched alkyl group having 1 to 30 carbon atoms; or dihydronaphthalene unsubstituted or substituted with a linear or branched alkyl group having 1 to 30 carbon atoms.

According to one embodiment of the present specification, R1 to R4 are the same as or different from each other, and each independently hydrogen; a methyl group; a tert-butyl group; a phenyl group; or NQ3Q4, or bond to adjacent groups to form cyclohexane unsubstituted or substituted with a methyl group; benzene; benzofuran unsubstituted or substituted with a methyl group or a tert-butyl group; benzothiophene unsubstituted or substituted with a methyl group or a tert-butyl group; naphthofuran; naphthothiophene; indene unsubstituted or substituted with a methyl group; indole unsubstituted or substituted with a phenyl group; indoloindene unsubstituted or substituted with a methyl group; indoloindole; tetrahydronaphthofuran unsubstituted or substituted with a methyl group; tetrahydronaphthothiophene unsubstituted or substituted with a methyl group; tetrahydrobenzoindene unsubstituted or substituted with a methyl group; benzodioxine; benzooxathiine; benzodithiine; thiochromene unsubstituted or substituted with a methyl group; chromene unsubstituted or substituted with a methyl group; or dihydronaphthalene unsubstituted or substituted with a methyl group.

According to one embodiment of the present specification, Q3 and Q4 have the same definitions as described above.

According to one embodiment of the present specification, R4 bonds to Ar1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is substituted or unsubstituted and includes one or more of N, S, O and Si.

According to one embodiment of the present specification, R4 bonds to Ar1 to form one selected from the group consisting of a monocyclic or polycyclic aromatic heteroring having 2 to 30 carbon atoms, a monocyclic or polycyclic aliphatic heteroring having 2 to 30 carbon atoms, and a fused ring thereof, each of which is unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms and includes one or more of N, S, O and Si.

According to one embodiment of the present specification, R4 bonds to Ar1 to form dihydroquinoline unsubstituted or substituted with a linear or branched alkyl group having 1 to 30 carbon atoms or a monocyclic or polycyclic aryl group having 6 to 30 carbon atoms; spiroquinolinefluorene; hexahydroindene unsubstituted or substituted with a linear or branched alkyl group having 1 to 30 carbon atoms; dihydrobenzoquinoline unsubstituted or substituted with a linear or branched alkyl group having 1 to 30 carbon atoms or a monocyclic or polycyclic aryl group having 6 to 30 carbon atoms; hexahydrobenzoquinoline unsubstituted or substituted with a linear or branched alkyl group having 1 to 30 carbon atoms or a monocyclic or polycyclic aryl group having 6 to 30 carbon atoms; spirobenzoquinoline; spirotetrahydrobenzoquinolinefluorene; benzofuropyrrole; benzothienopyrrole; dihydrobenzoazasiline unsubstituted or substituted with a linear or branched alkyl group having 1 to 30 carbon atoms or a monocyclic or polycyclic aryl group having 6 to 30 carbon atoms; spirodibenzosilolebenzoazasiline; benzoxazine; benzothiazine; dihydroindenopyrrole unsubstituted or substituted with a linear or branched alkyl group having 1 to 30 carbon atoms or a monocyclic or polycyclic aryl group having 6 to 30 carbon atoms; benzindole; or indole unsubstituted or substituted with a linear or branched alkyl group having 1 to 30 carbon atoms, a monocyclic or polycyclic cycloalkyl group having 3 to 30 carbon atoms or a monocyclic or polycyclic aryl group having 6 to 30 carbon atoms.

According to one embodiment of the present specification, R4 bonds to Ar1 to form dihydroquinoline unsubstituted or substituted with a methyl group or a phenyl group; spiroacridinequinoline; hexahydroindene unsubstituted or substituted with one or more selected from a methyl group and a tert-butyl group; dihydrobenzoquinoline unsubstituted or substituted with a methyl group or a phenyl group; hexahydrobenzoquinoline unsubstituted or substituted with a methyl group or a phenyl group; spirobenzoquinoline; spirotetrahydrobenzoquinolinefluorene; benzofuropyrrole; benzothienopyrrole; dihydrobenzoazasiline unsubstituted or substituted with a methyl group or a phenyl group; spirobenzosiloledibenzoazasiline; benzoxazine; benzothiazine; dihydroindenopyrrole unsubstituted or substituted with a methyl group or a phenyl group; benzindole; or indole unsubstituted or substituted with a tert-butyl group, an adamantyl group or a phenyl group.

According to one embodiment of the present specification, the compound of Chemical Formula 1 is one selected from the following compounds. 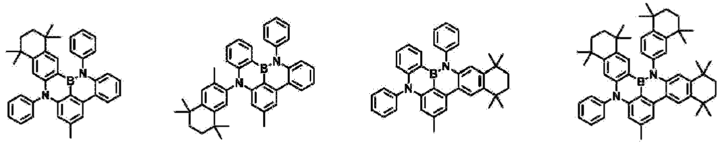 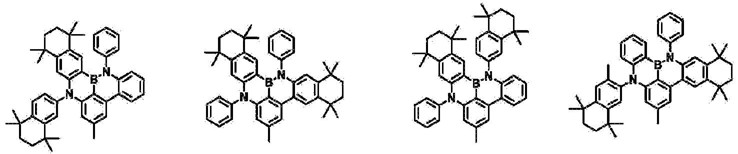 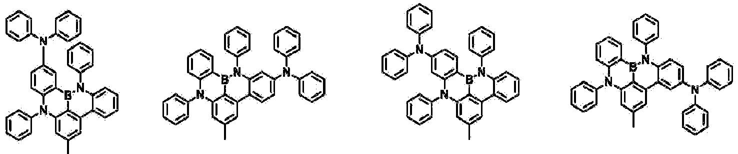 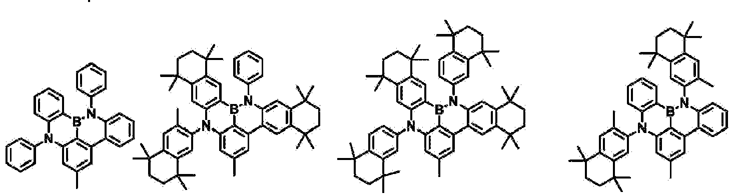 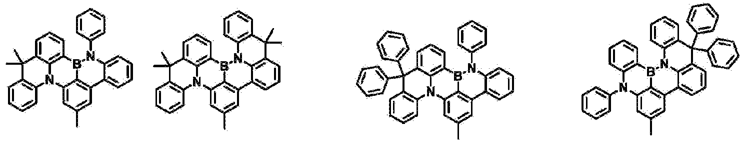 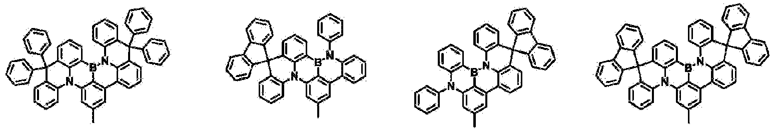 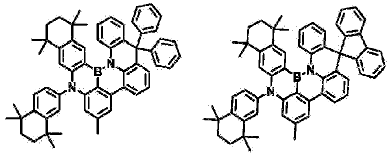 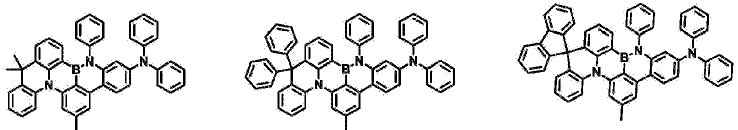 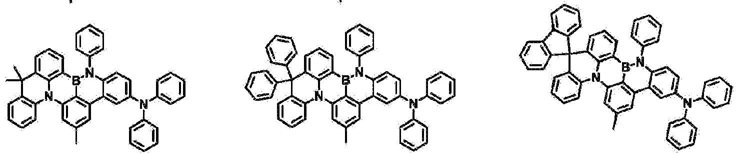 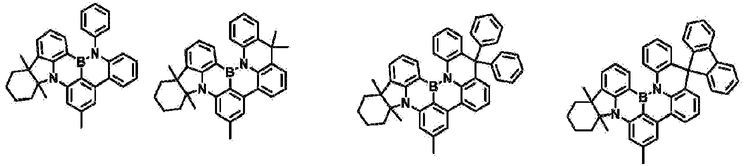 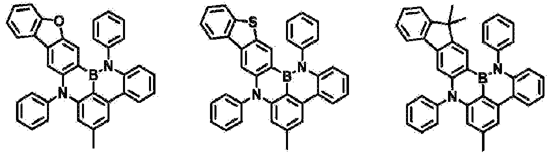 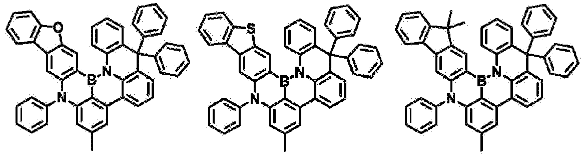 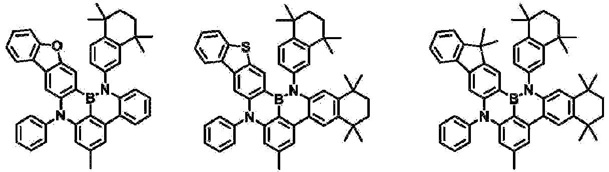 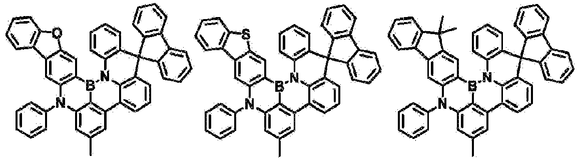 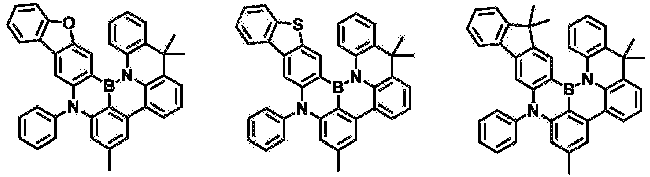 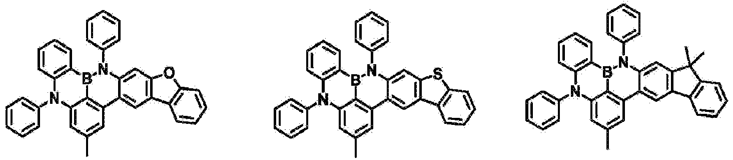 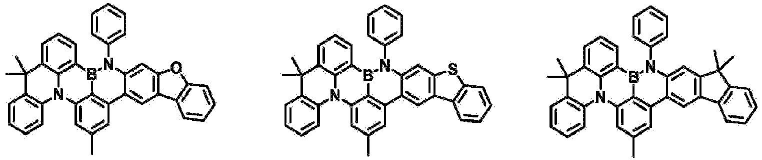 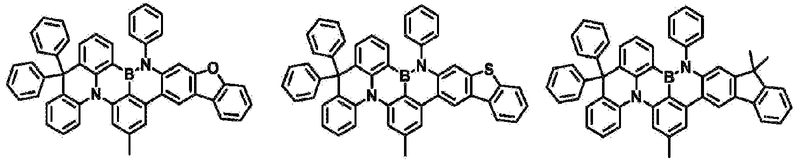 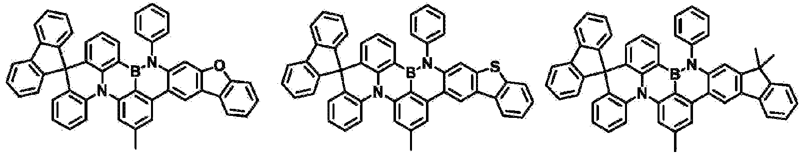 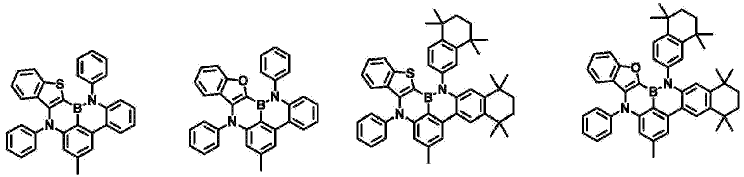 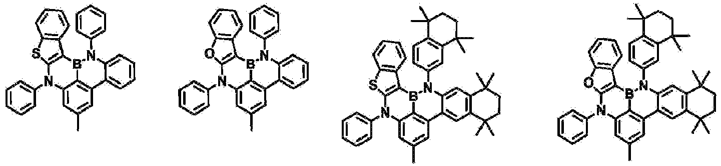 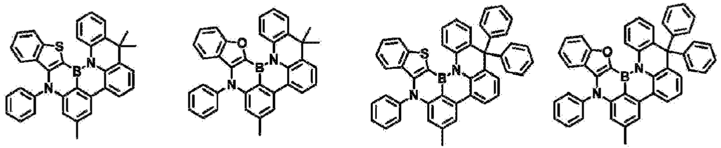 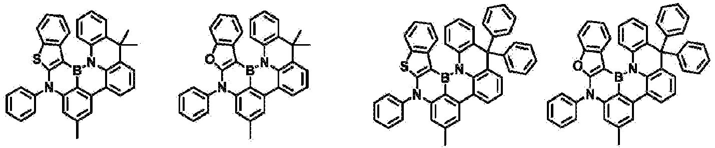 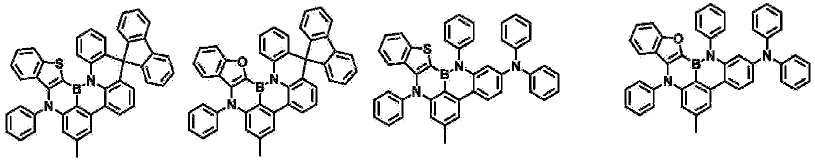 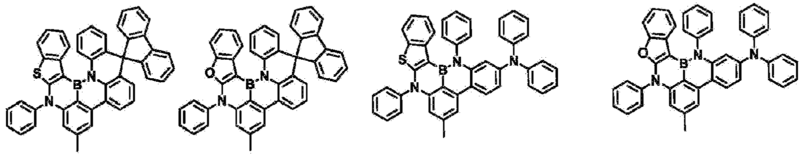 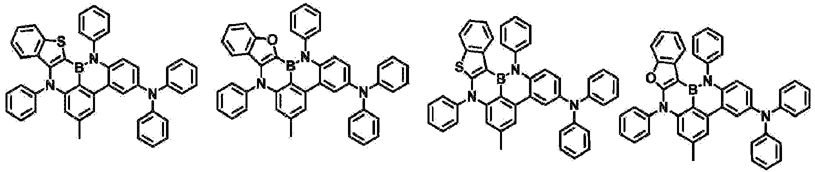 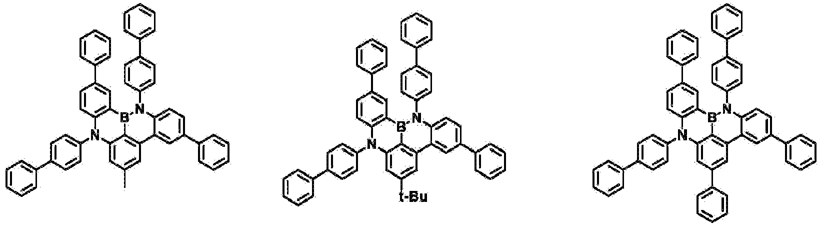 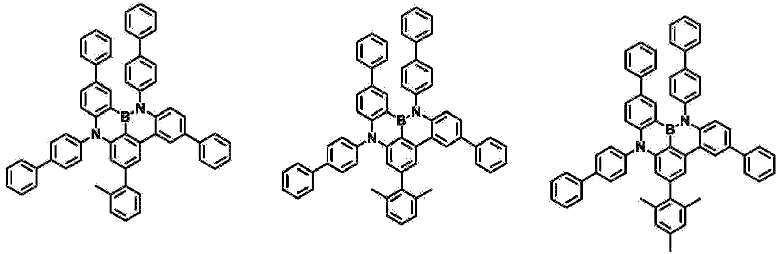 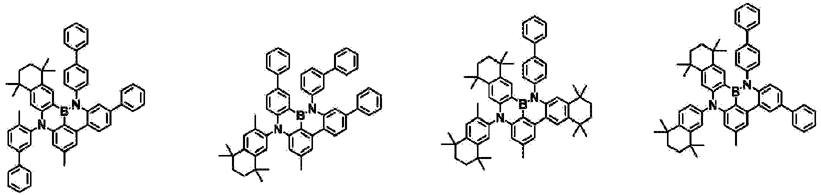 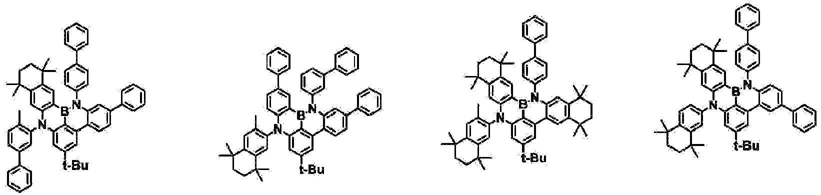 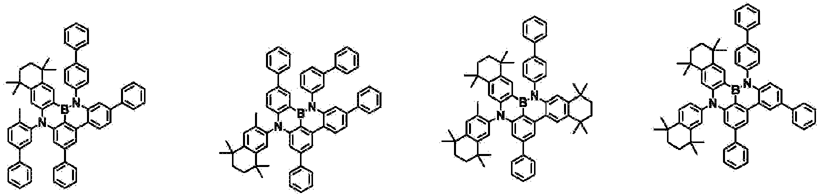 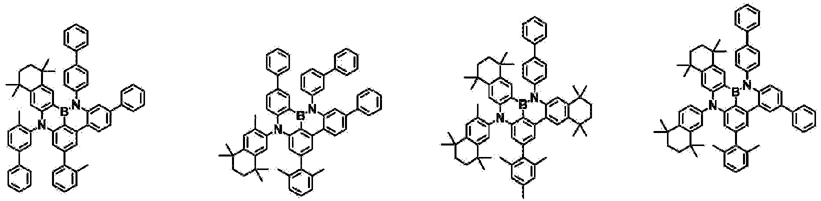 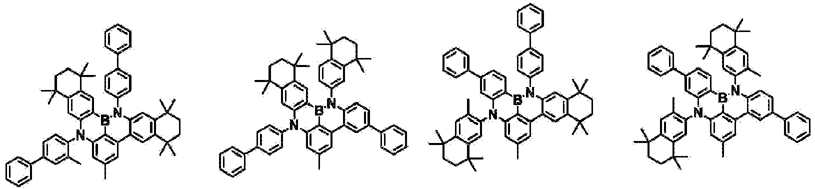 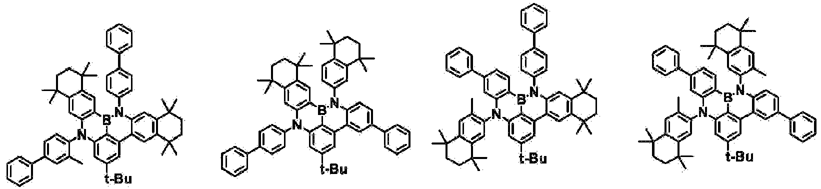 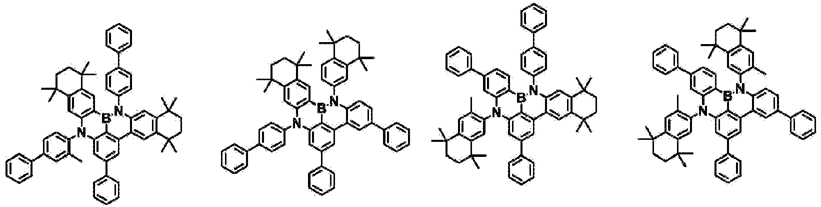 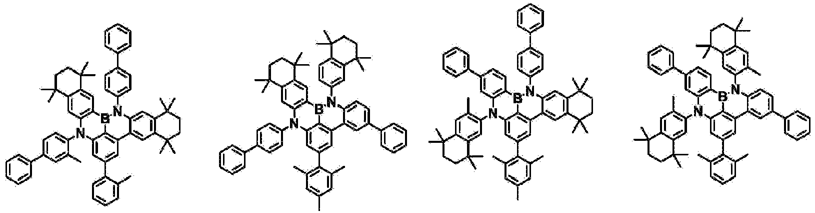 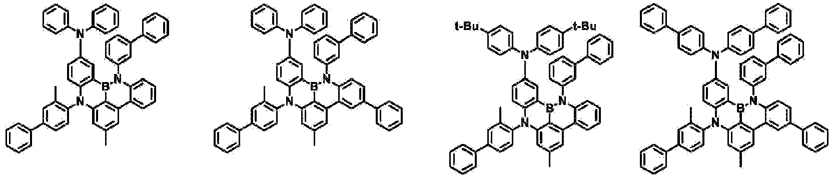 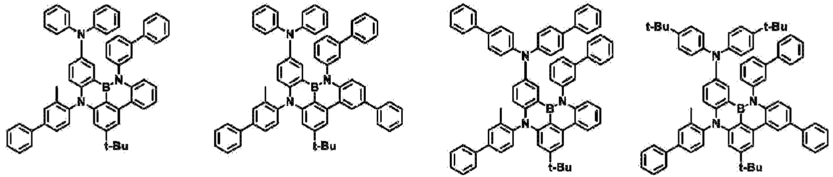 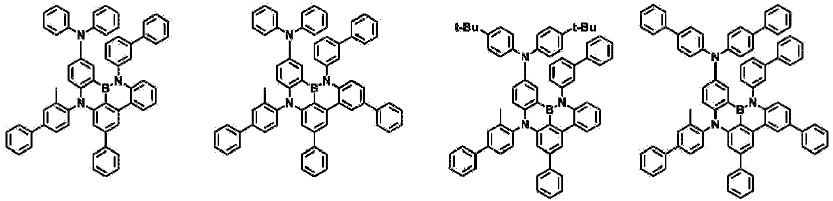 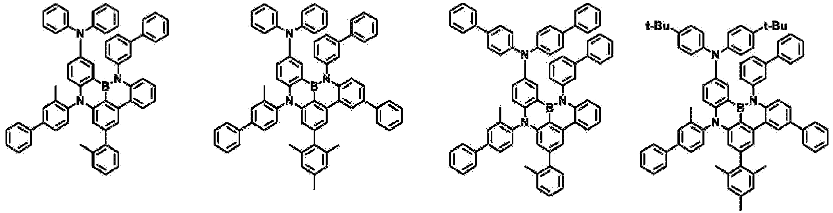 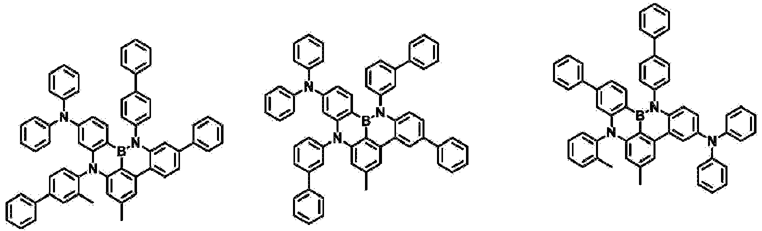 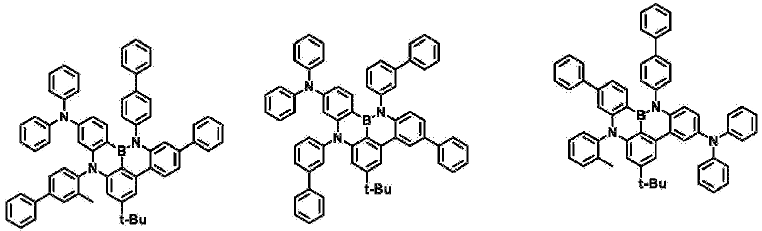 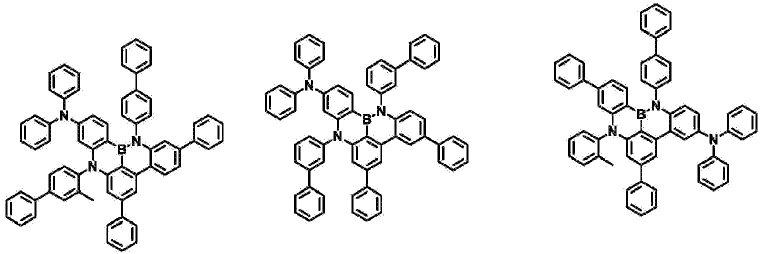 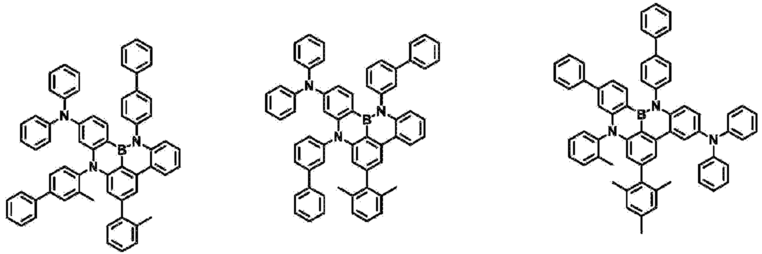 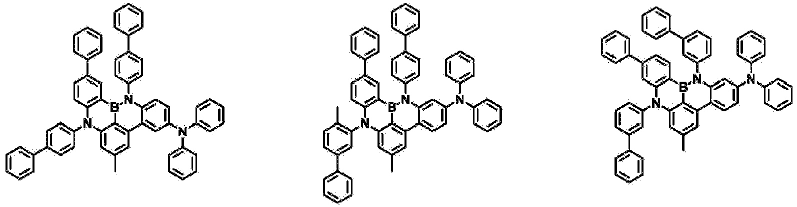 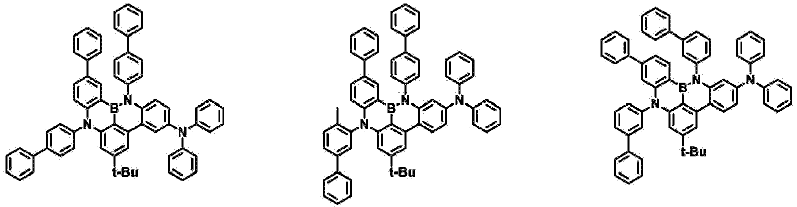 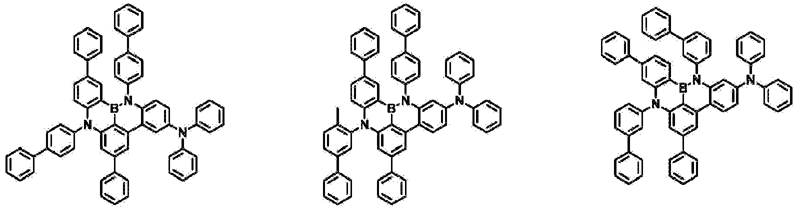 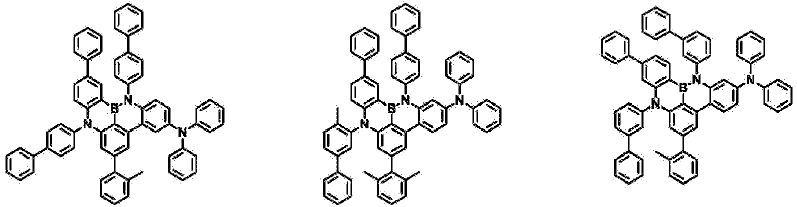 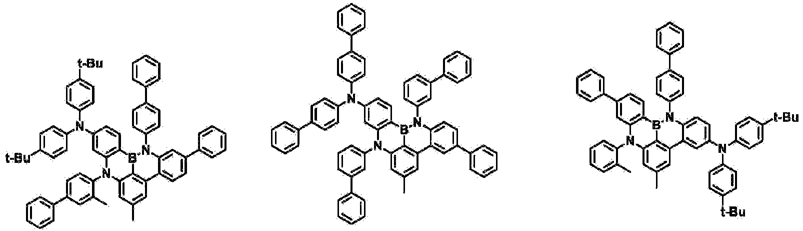 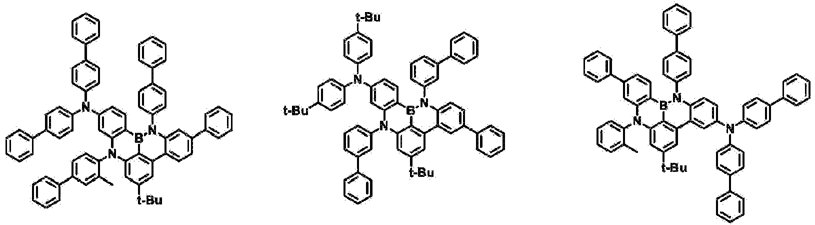 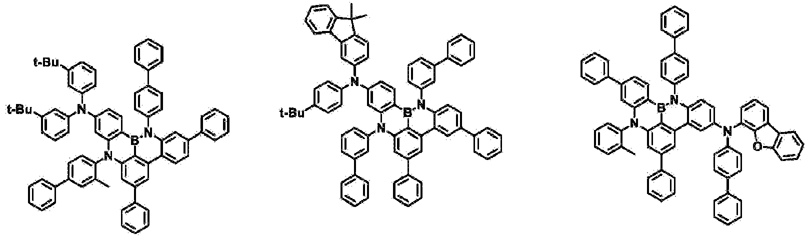 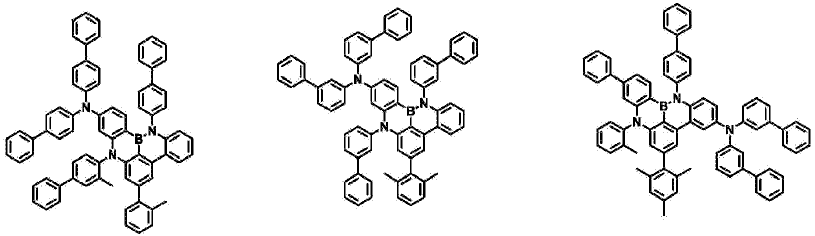 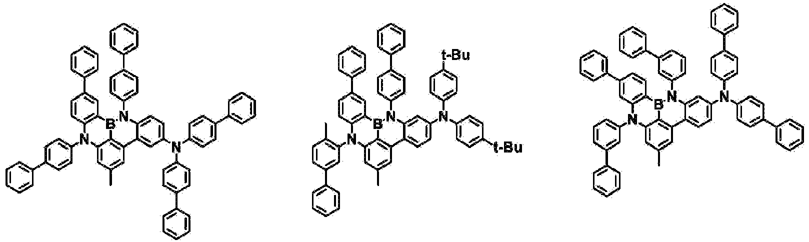 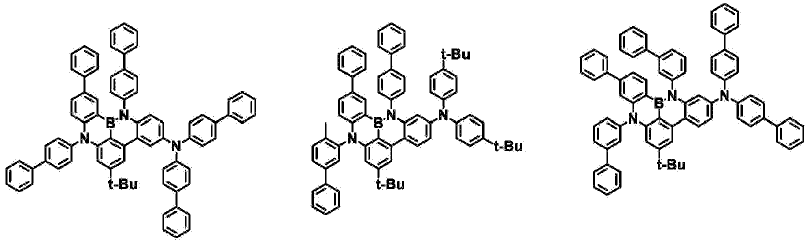 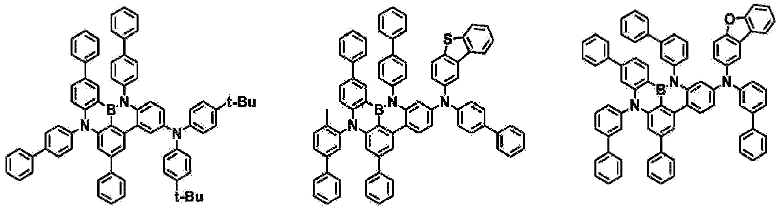 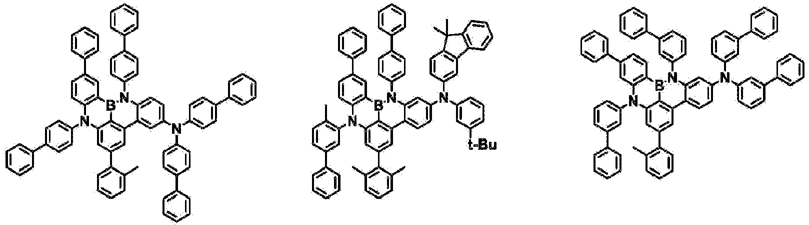 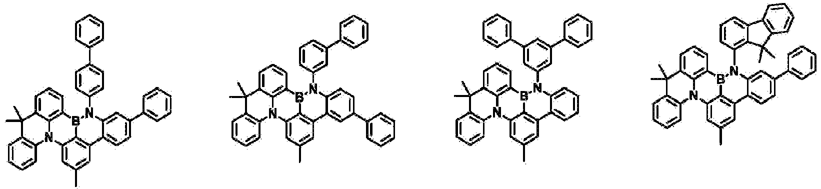 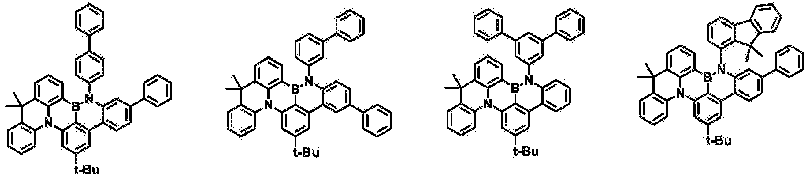 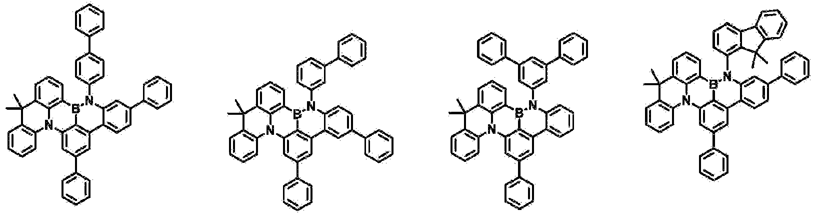 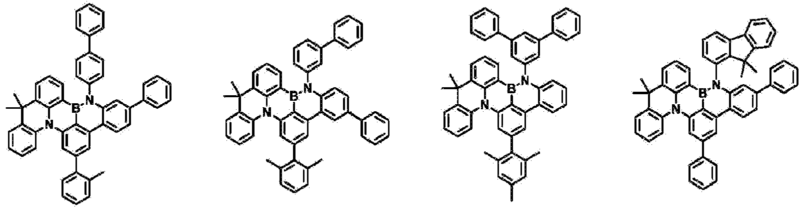 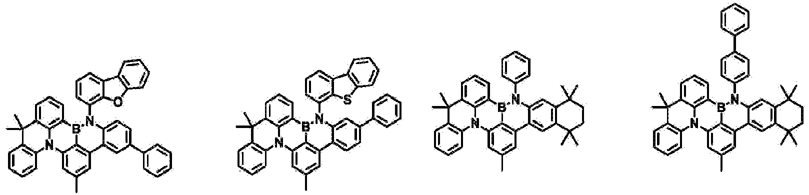 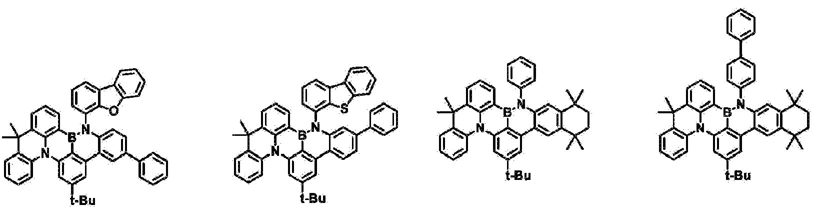 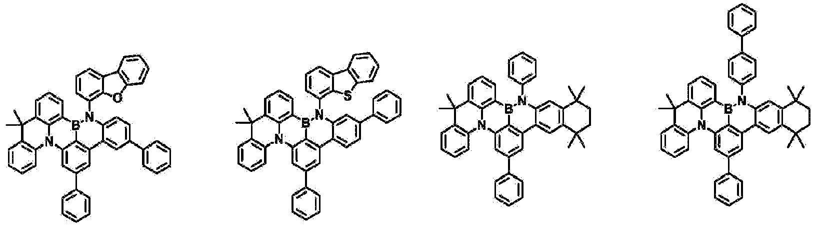 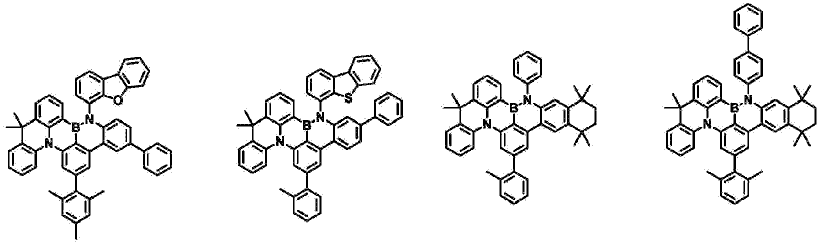 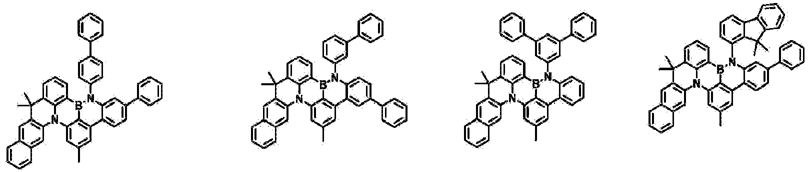 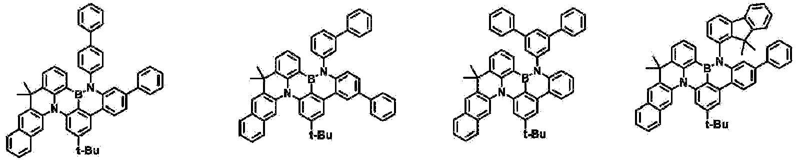 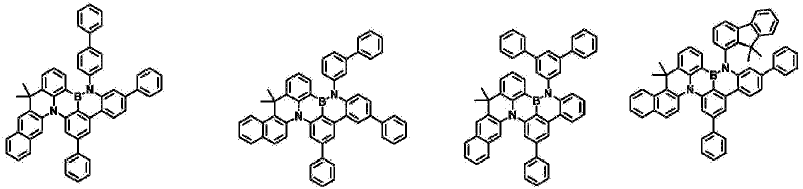 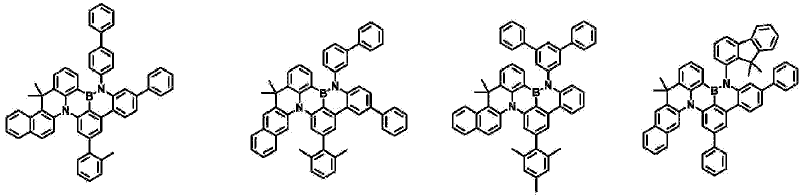 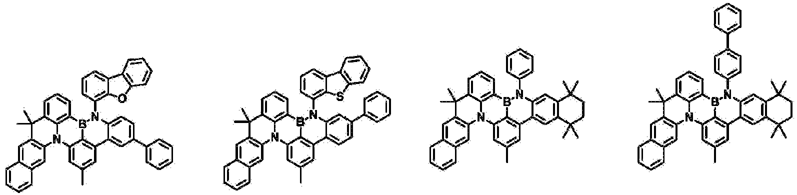 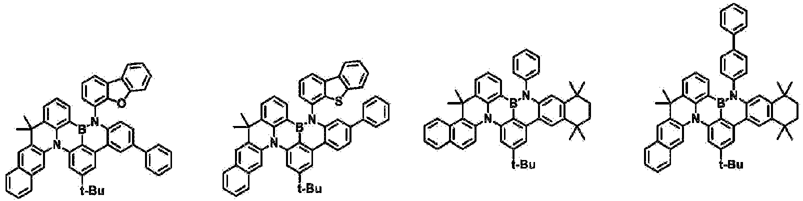 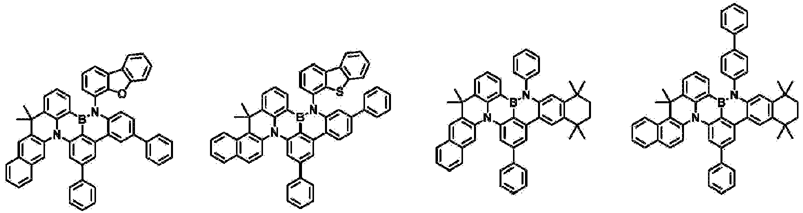 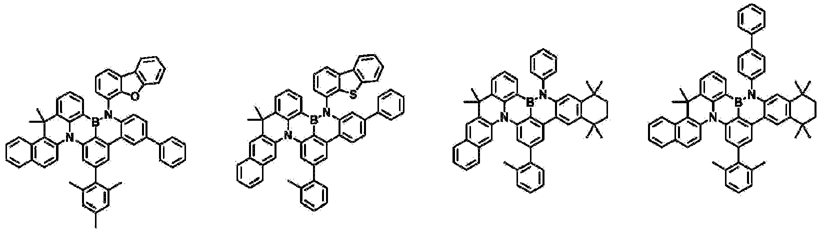 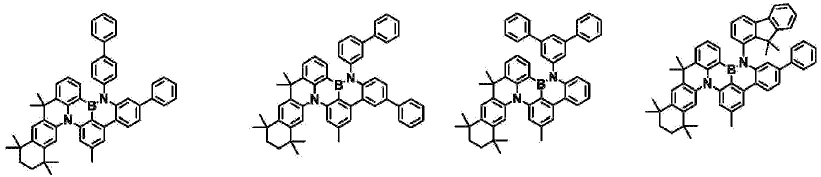 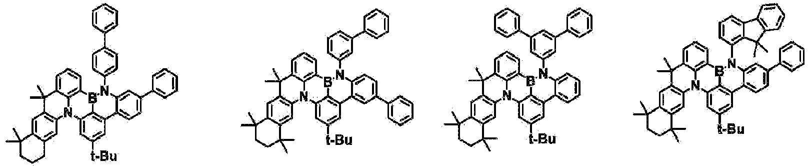 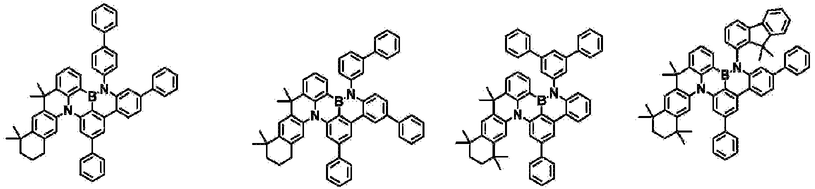 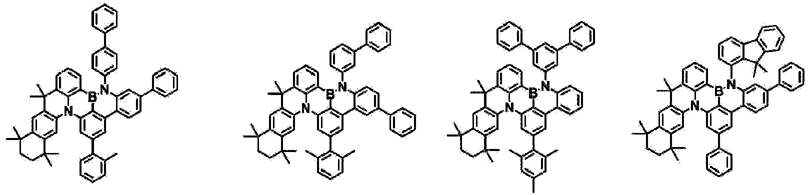 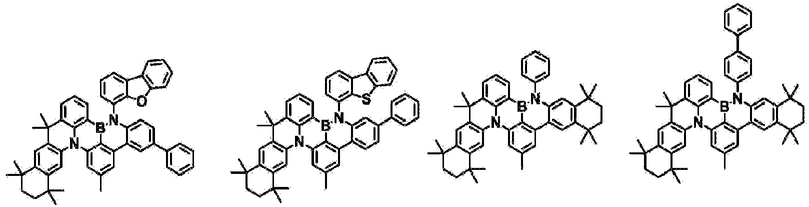 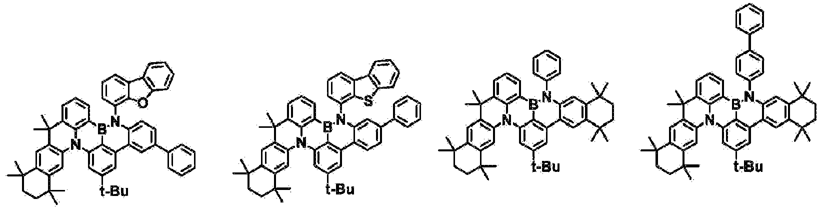 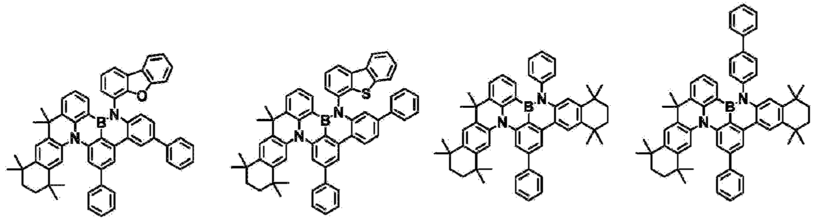 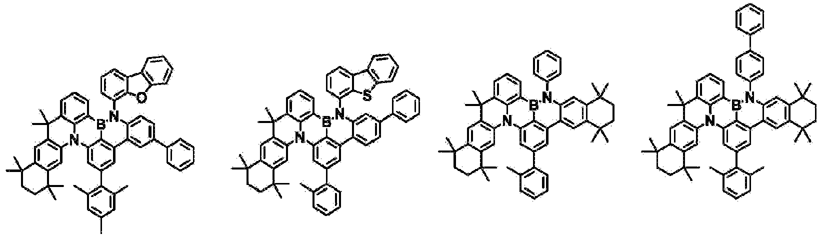 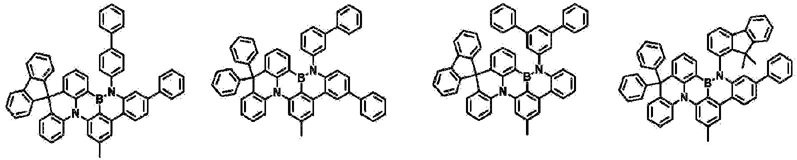 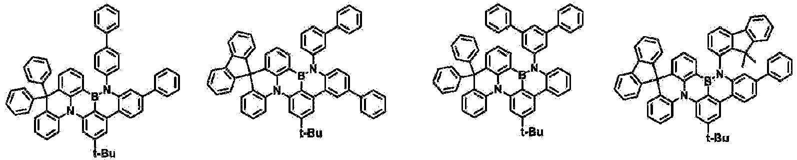 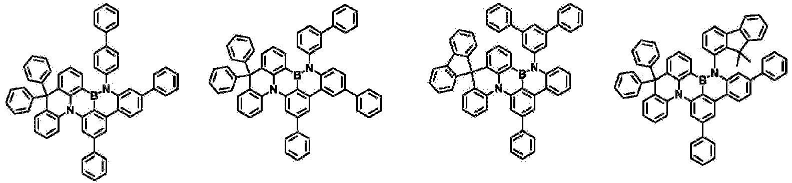 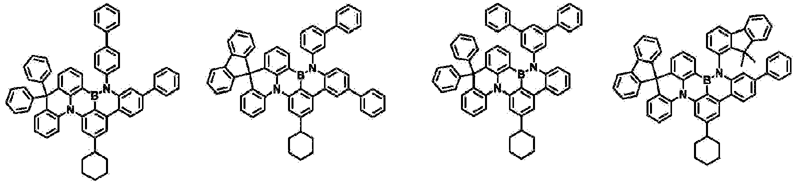 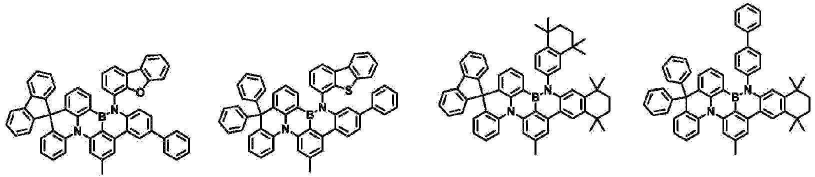 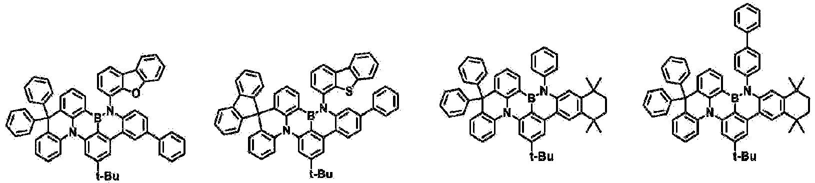 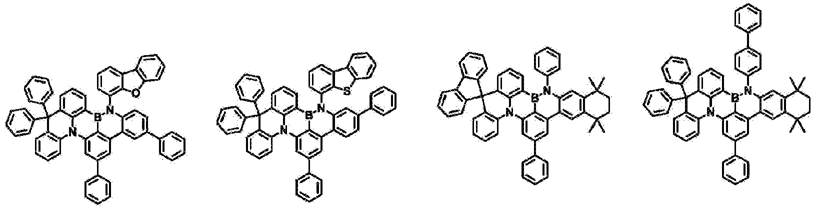 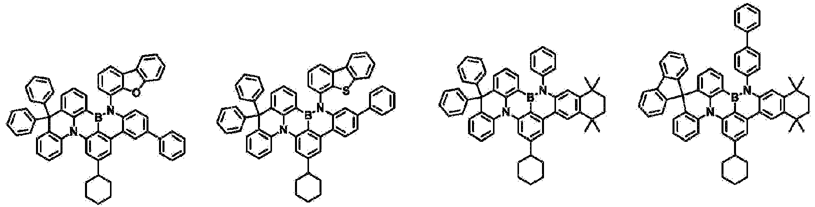 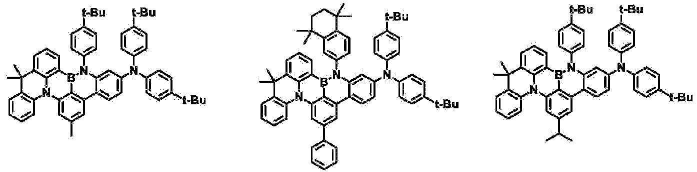 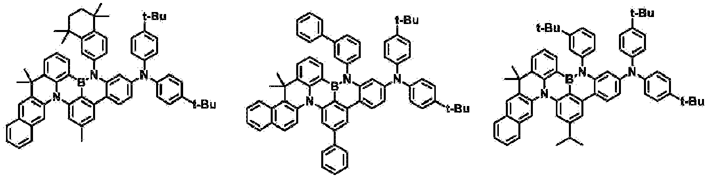 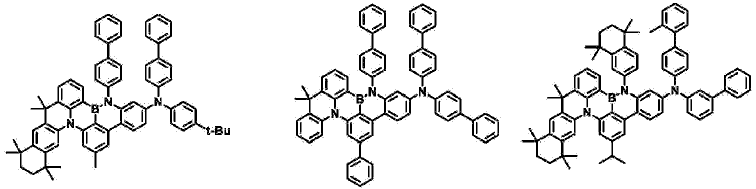 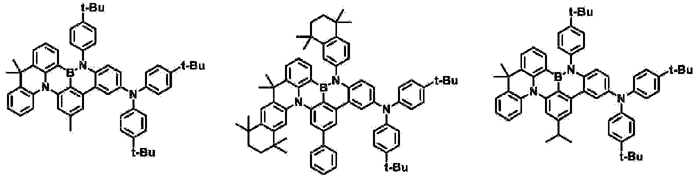 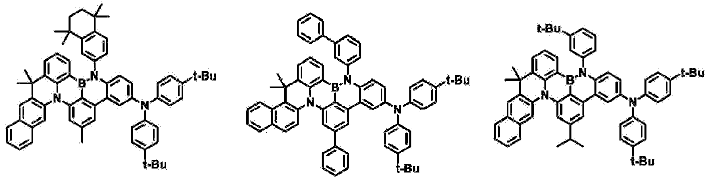 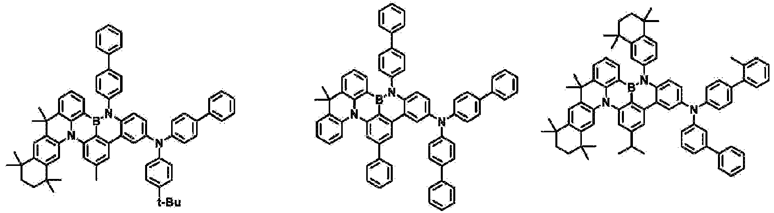 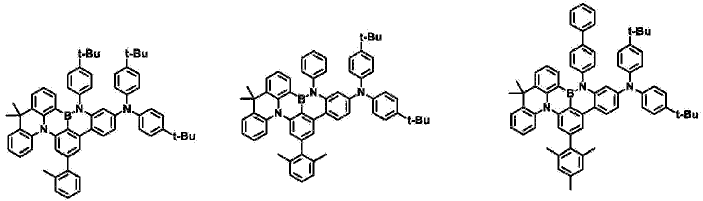 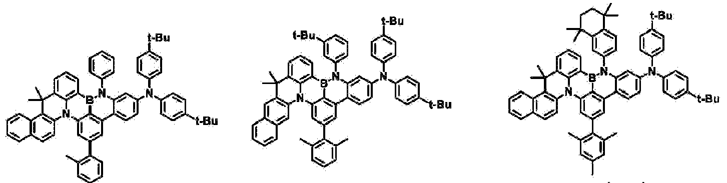 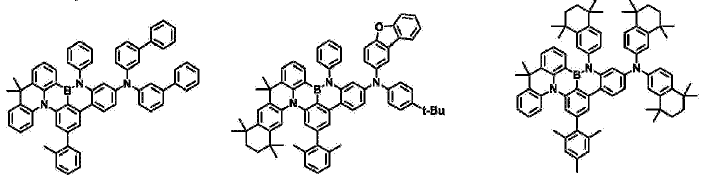 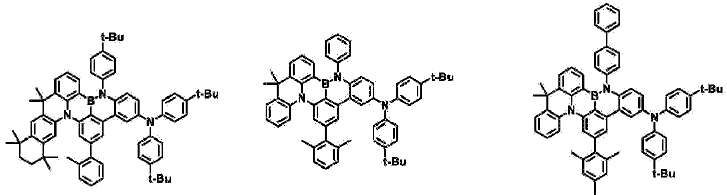 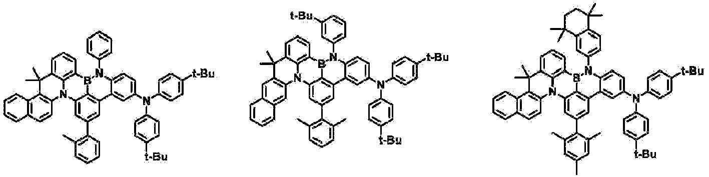 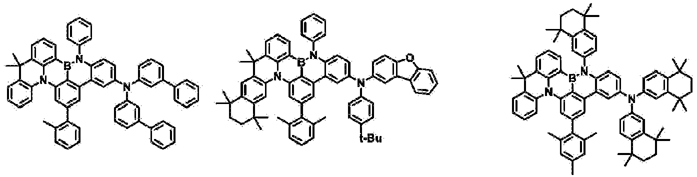 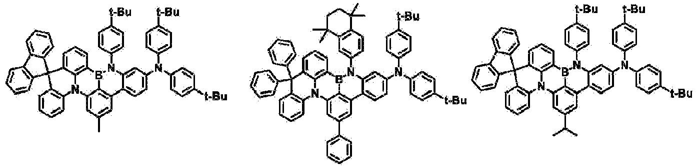 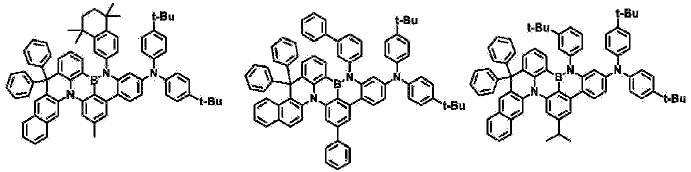 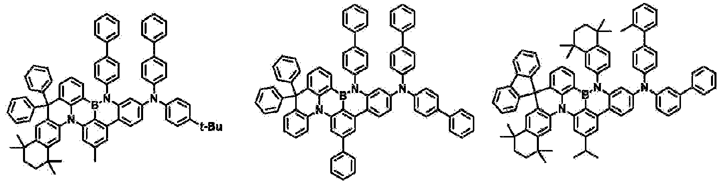 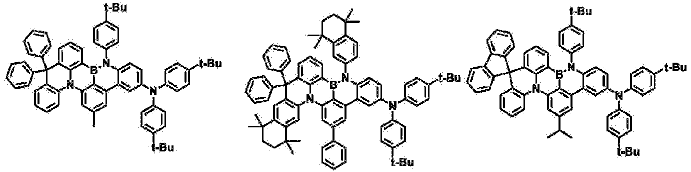 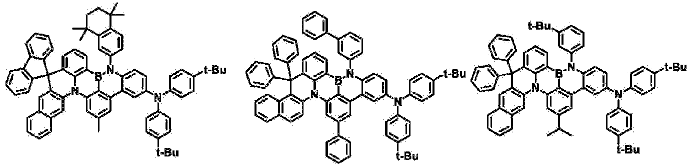 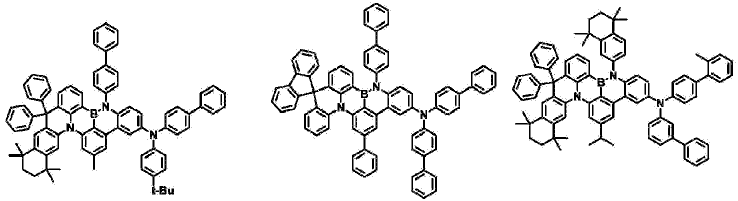 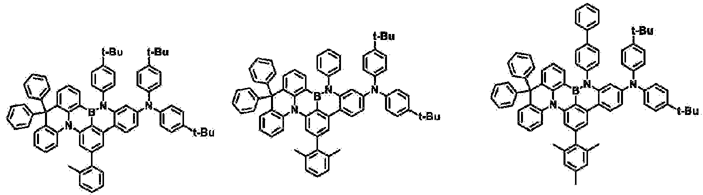 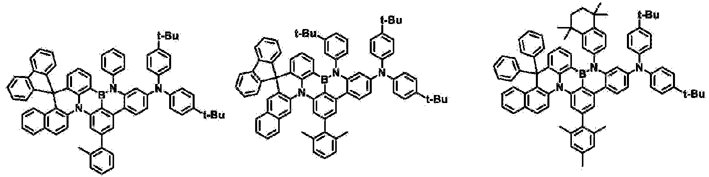 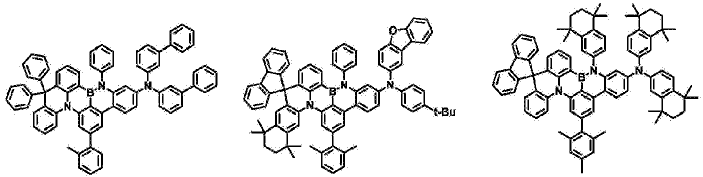 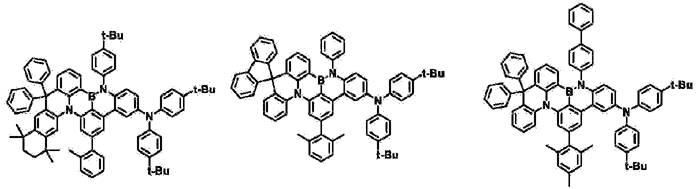 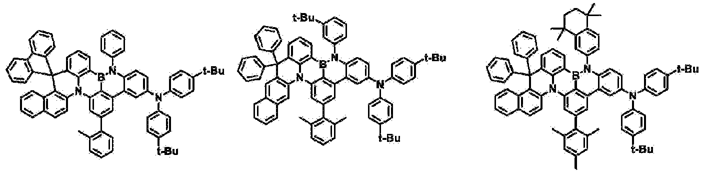 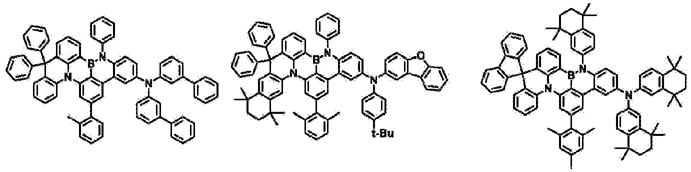 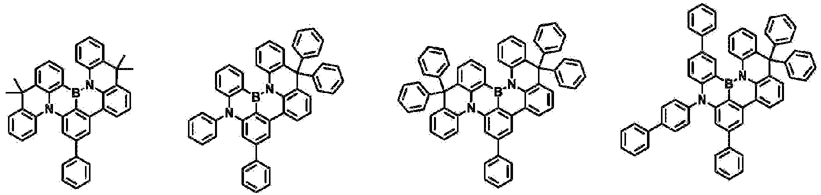 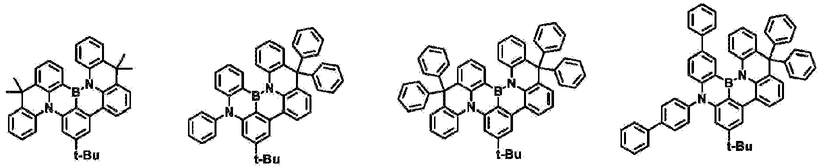 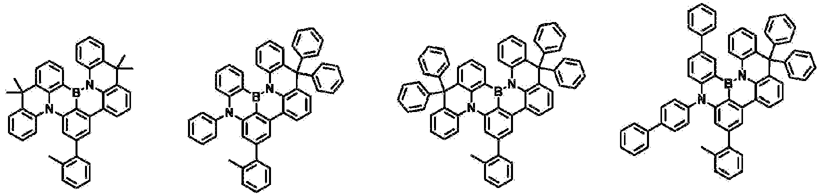 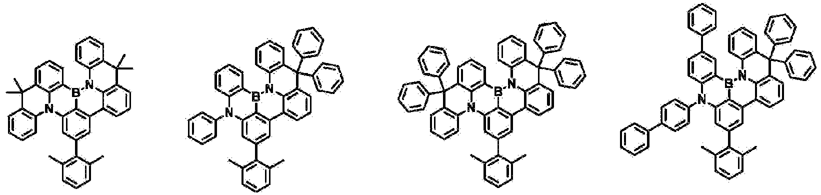 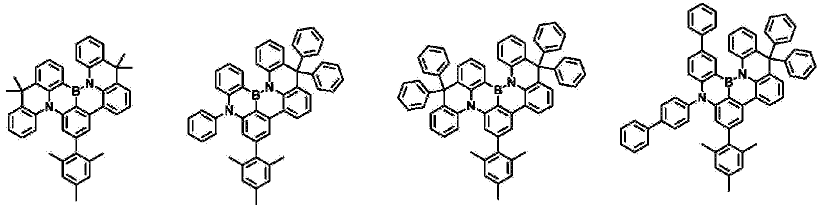 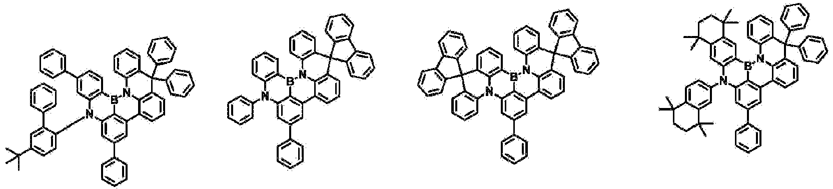 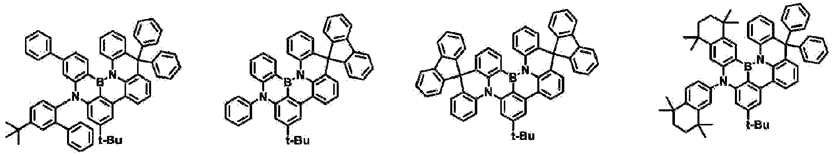 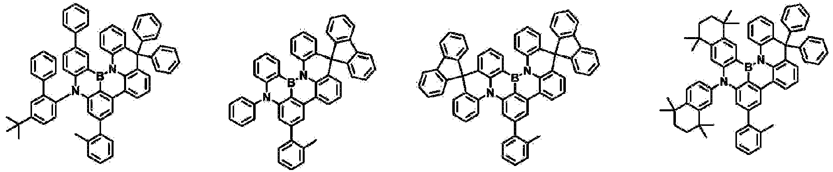 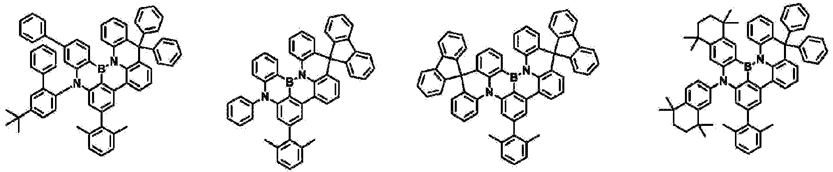 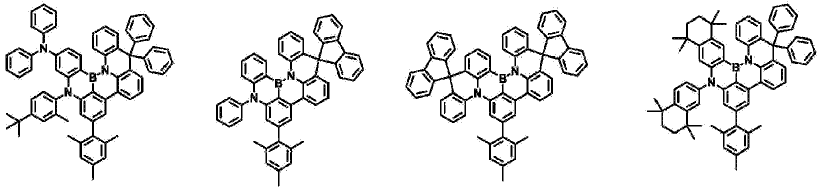 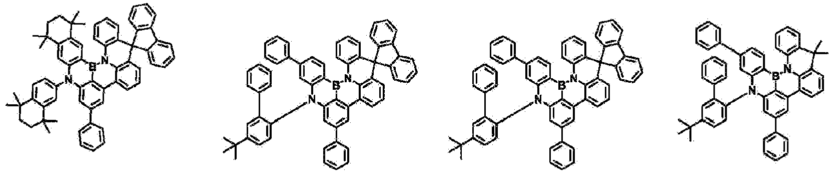 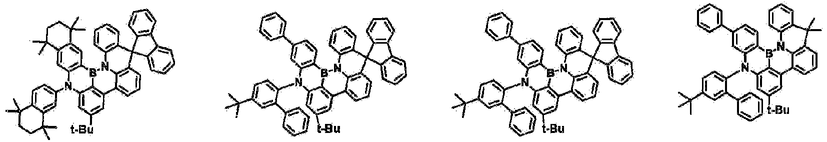 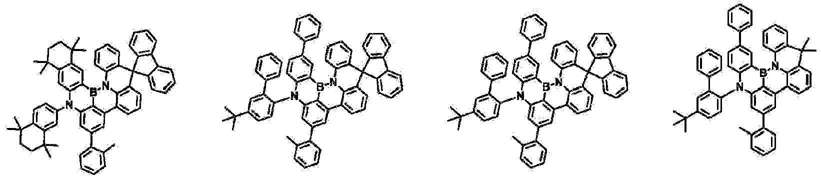 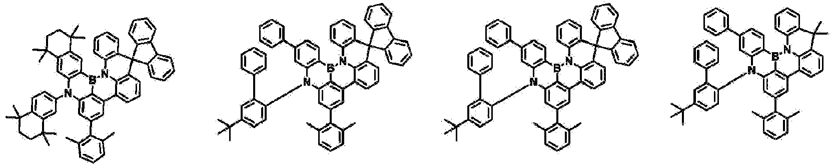 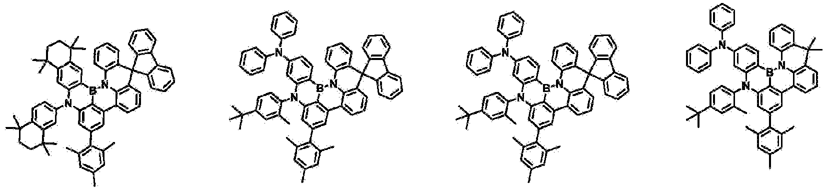 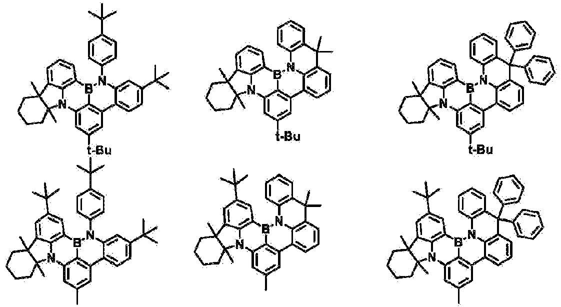 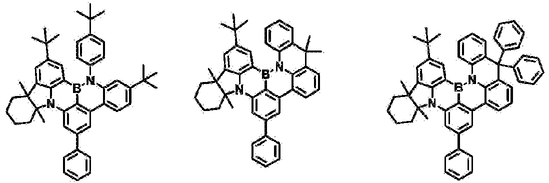 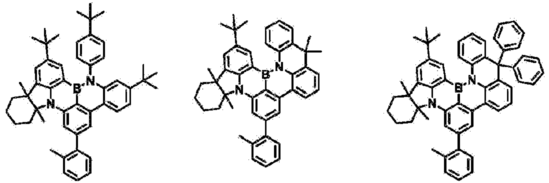 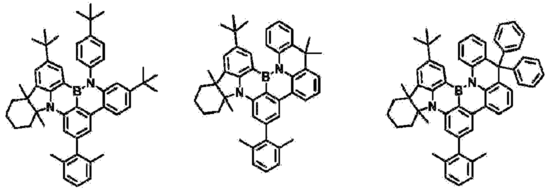 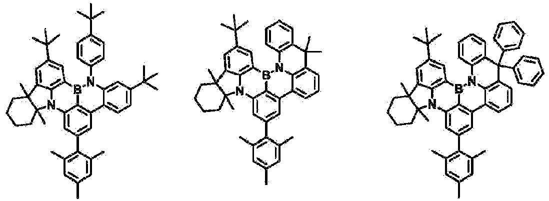 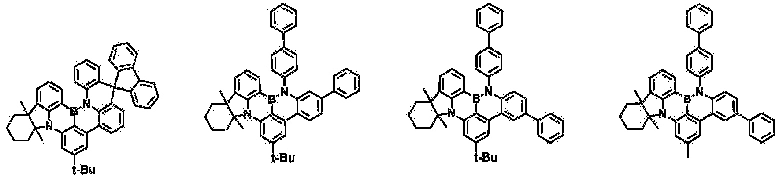 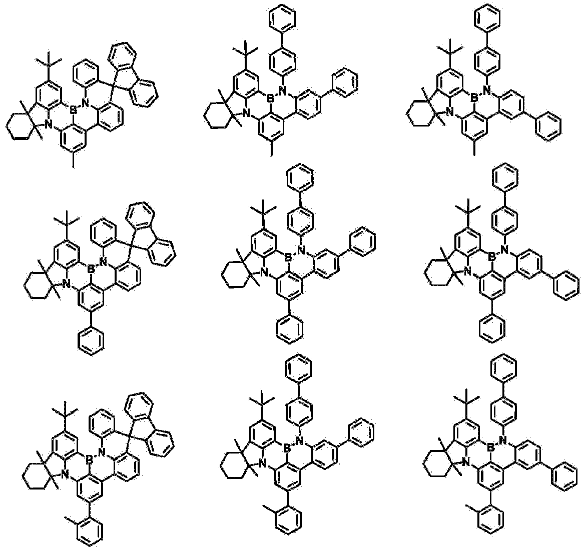 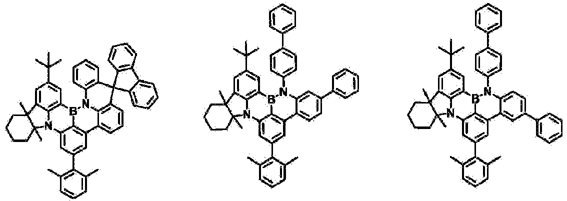 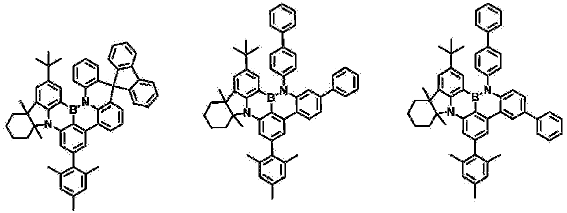 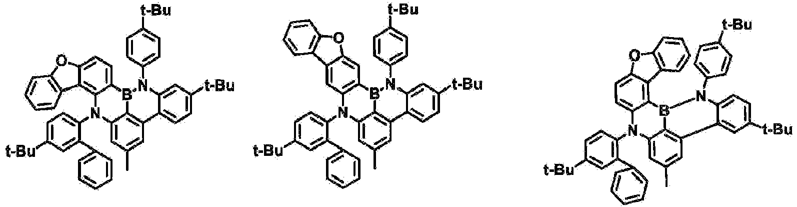 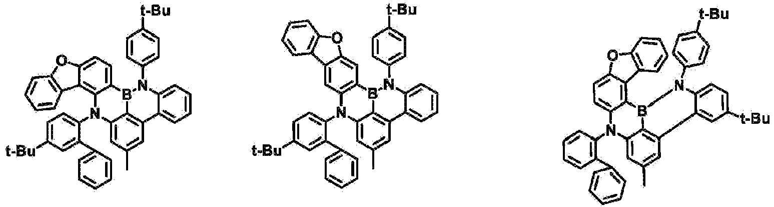 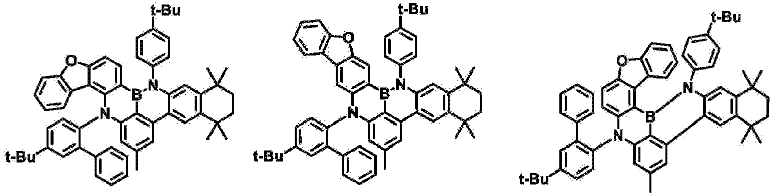 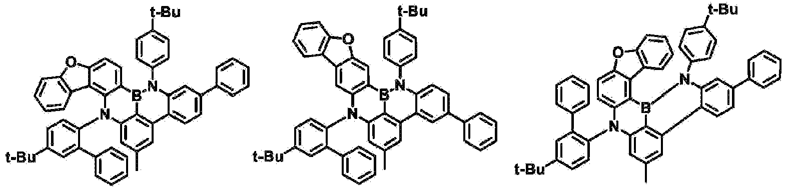 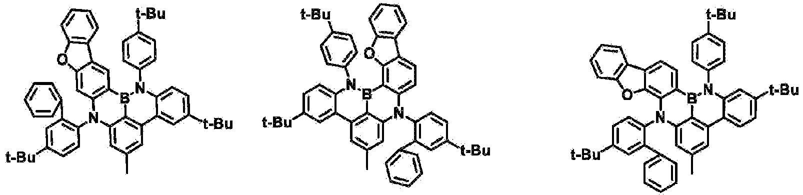 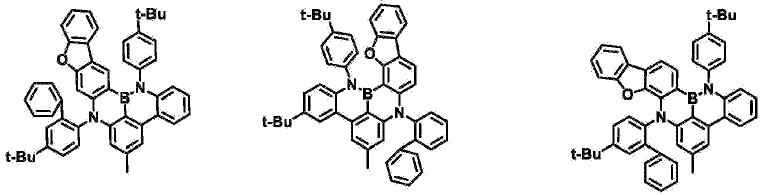 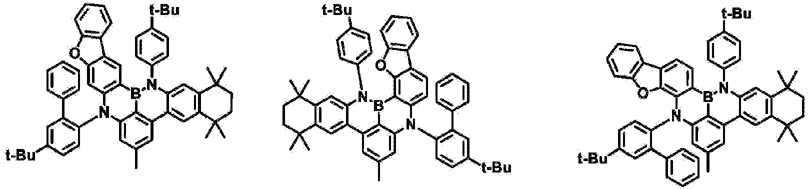 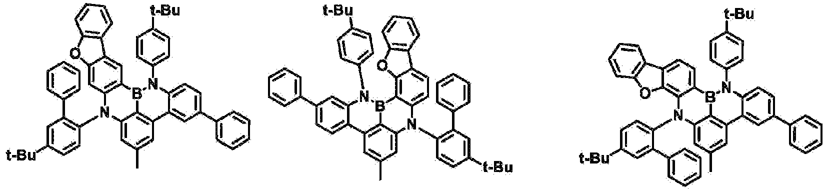 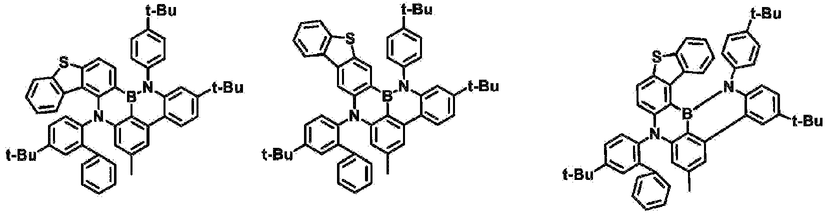 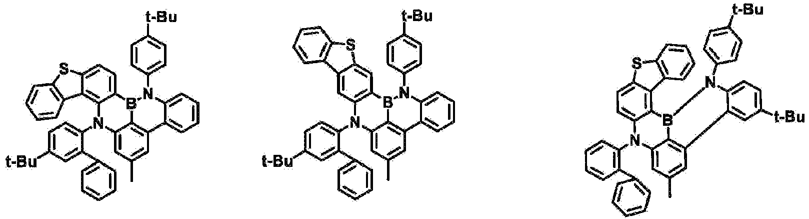 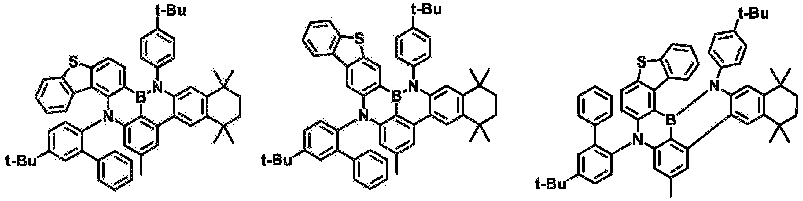 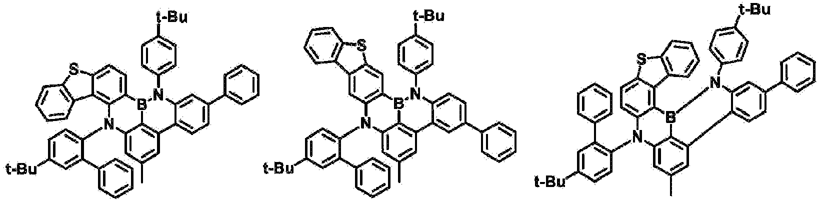 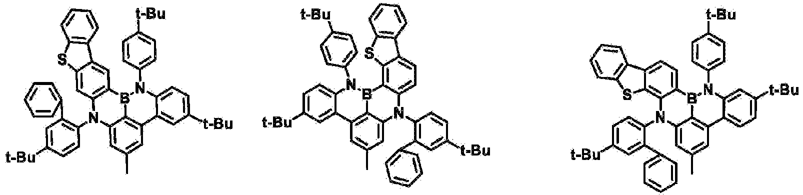 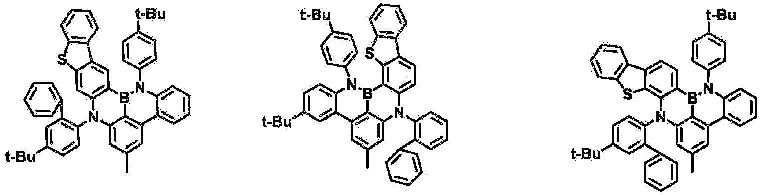 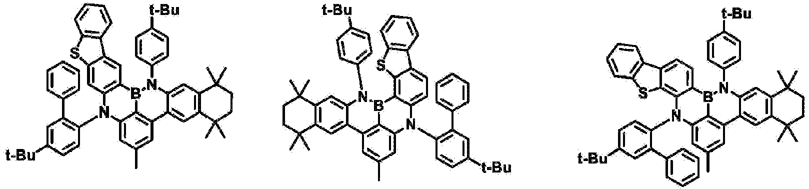 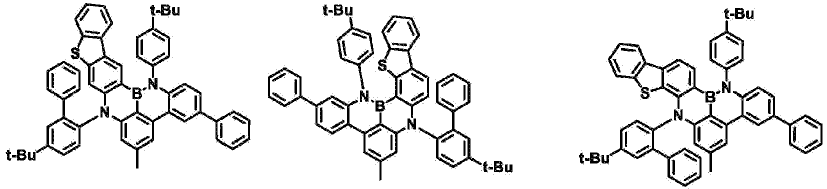 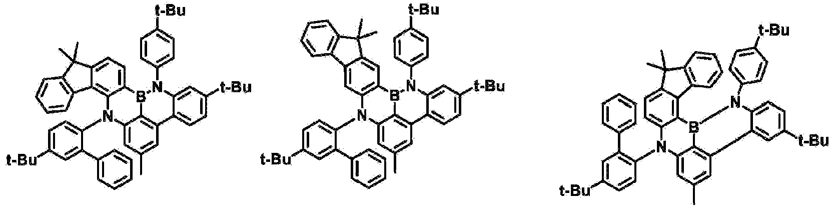 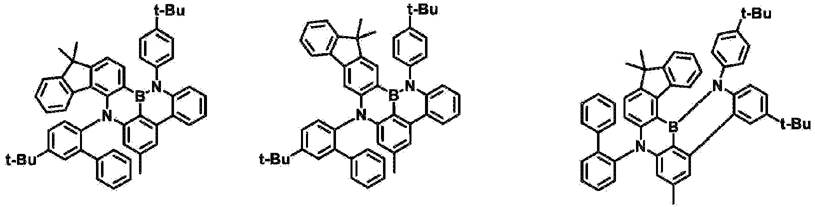 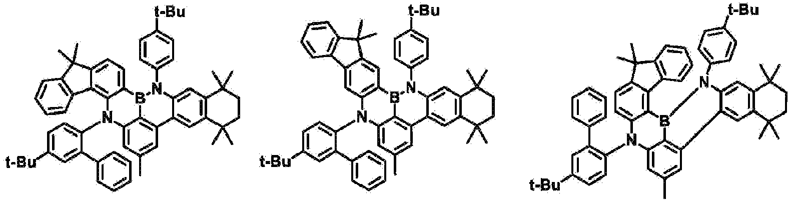 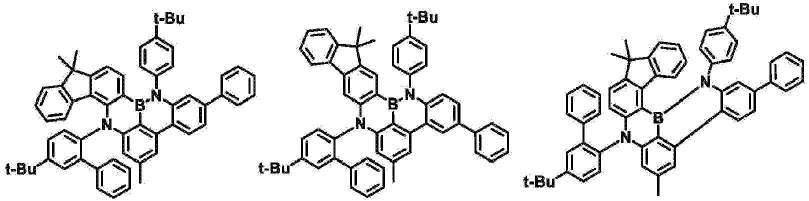 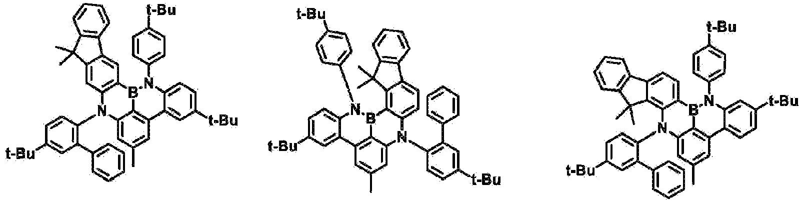 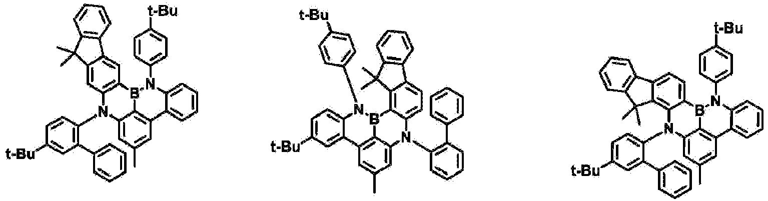 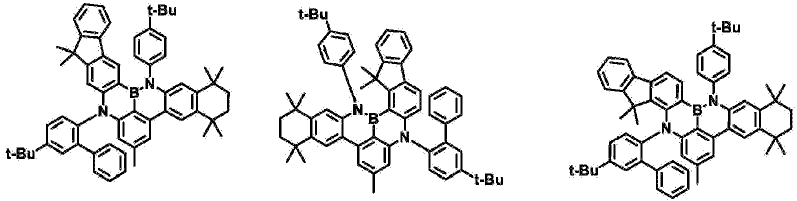 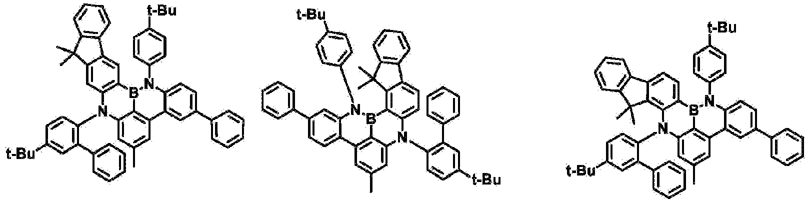 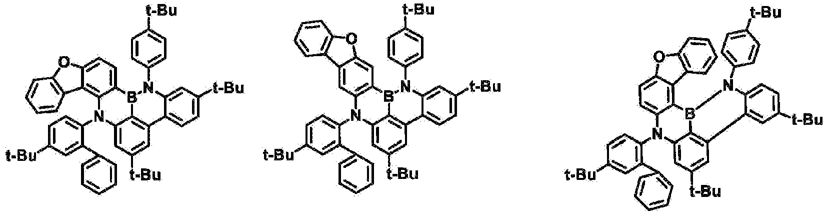 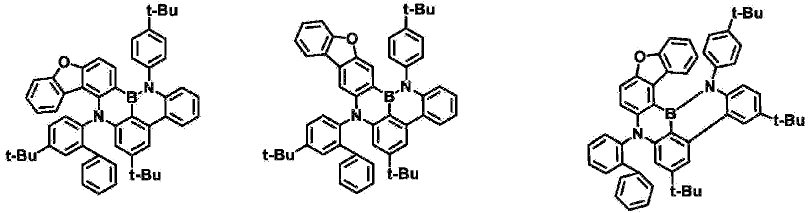 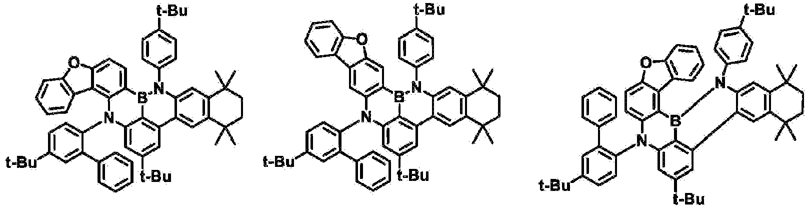 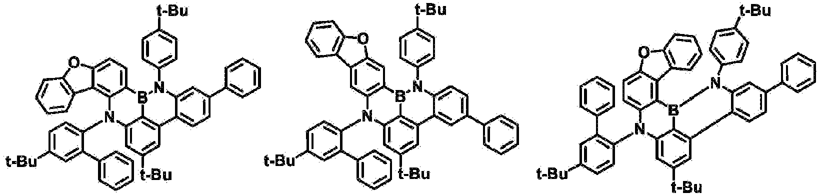 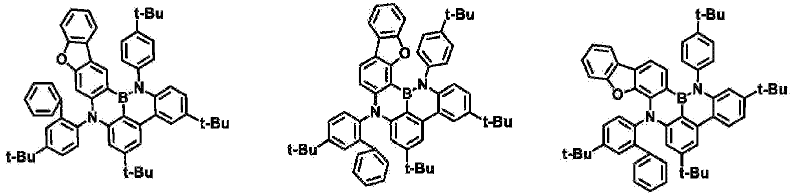 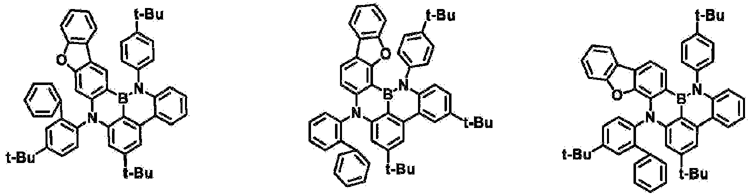 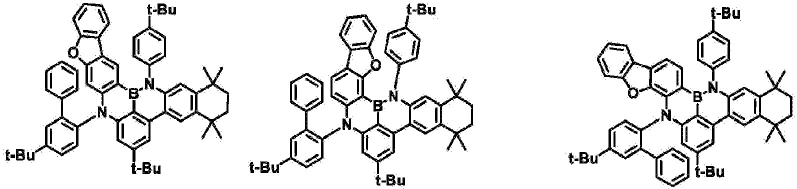 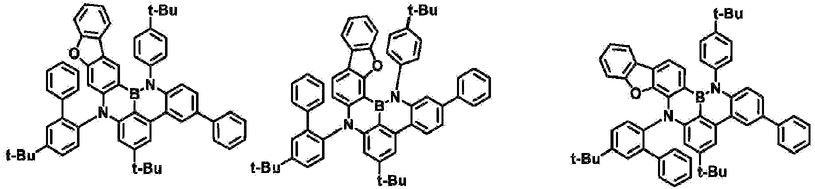 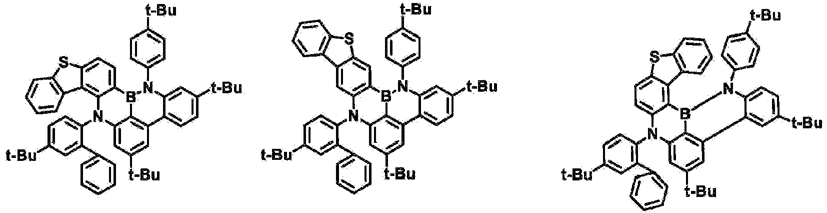 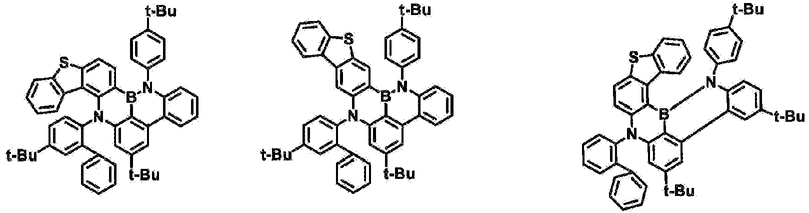 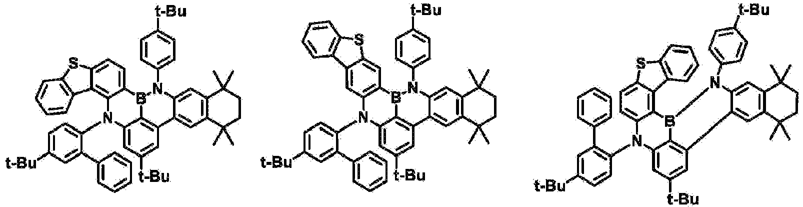 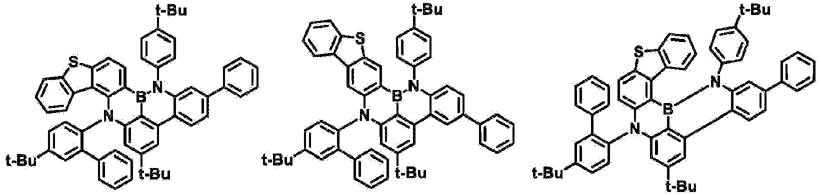 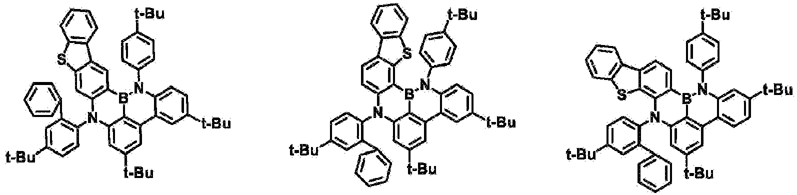 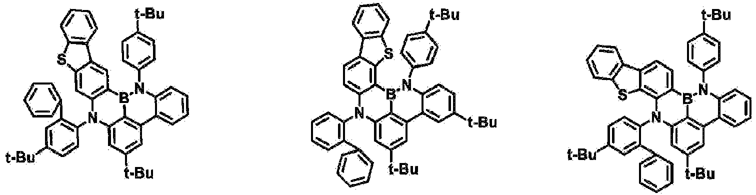 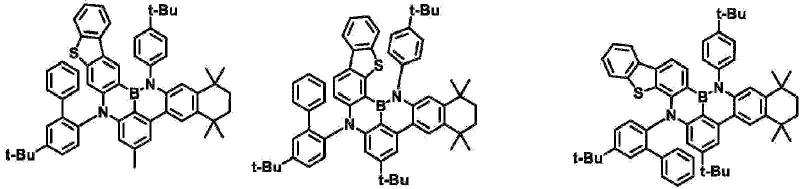 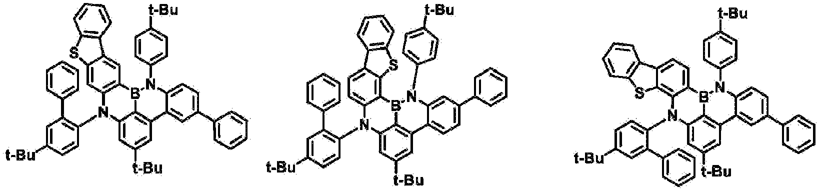 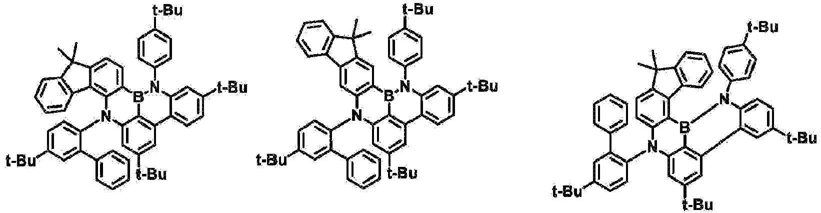 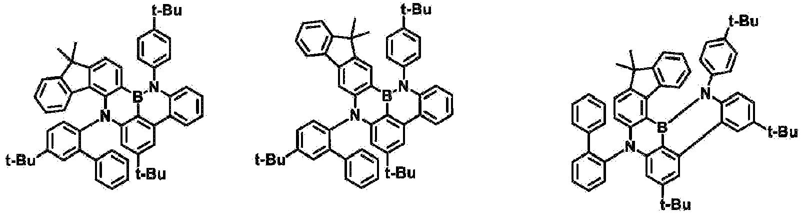 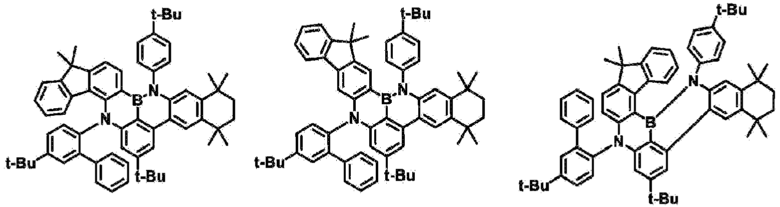 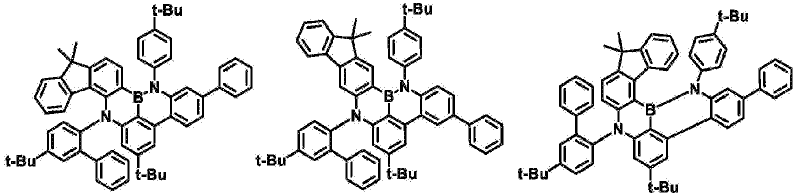 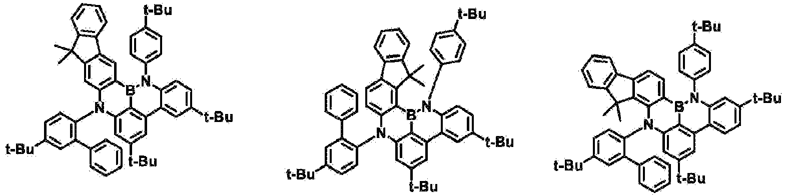 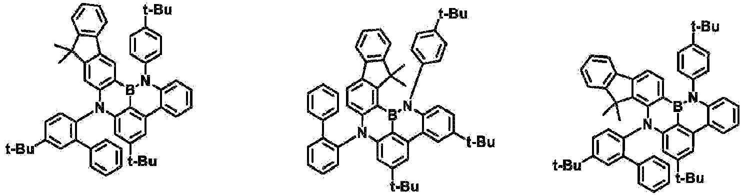 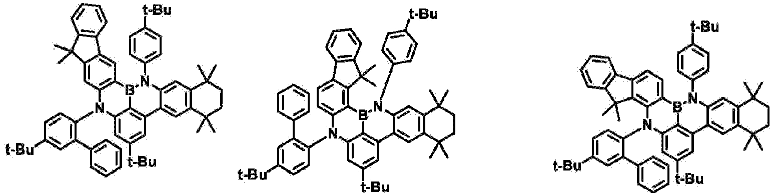 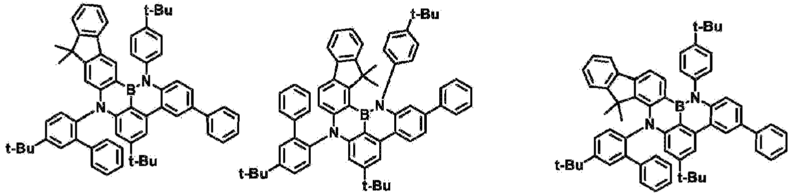 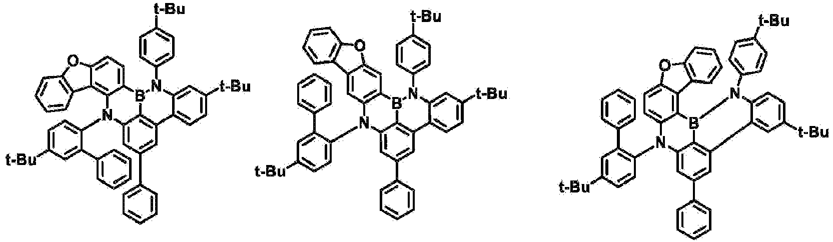 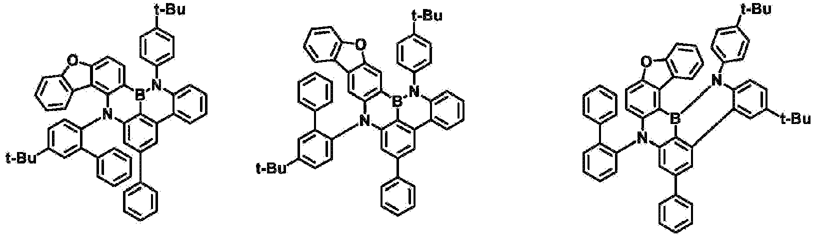 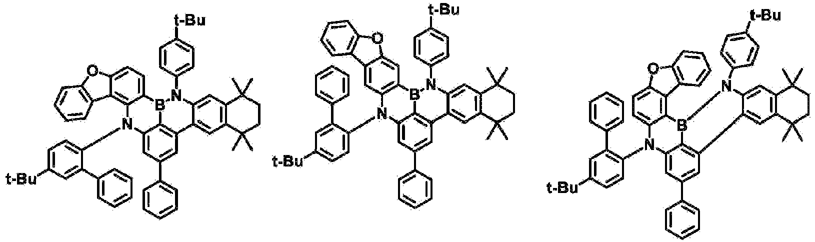 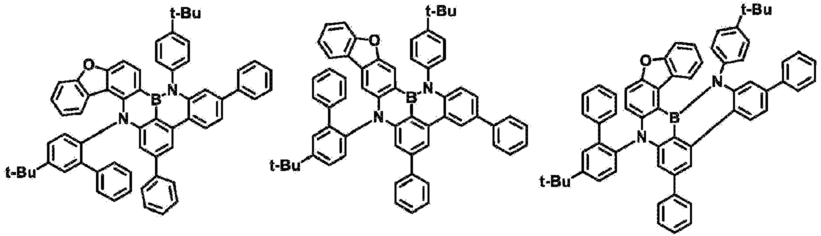 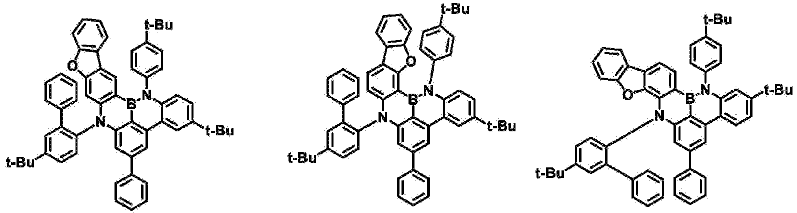 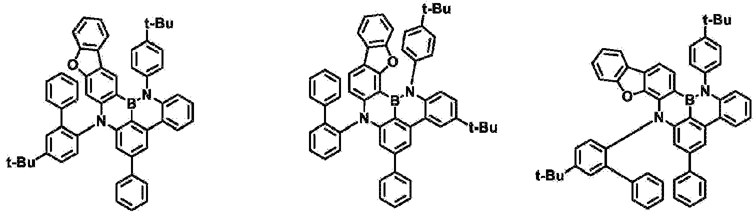 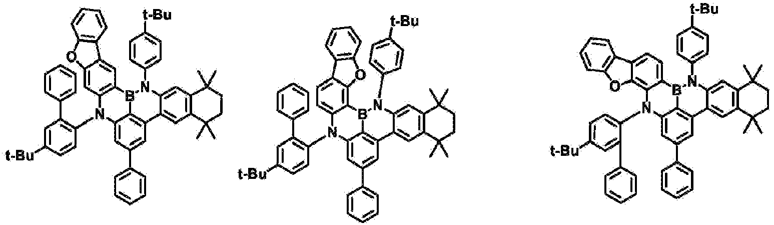 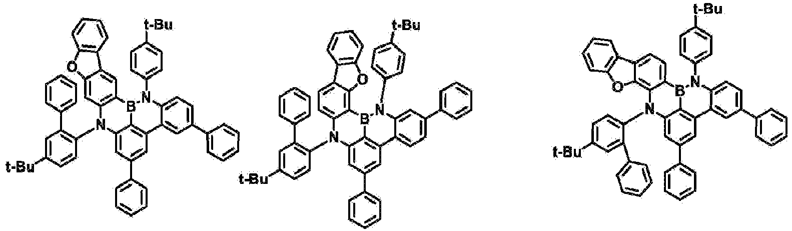 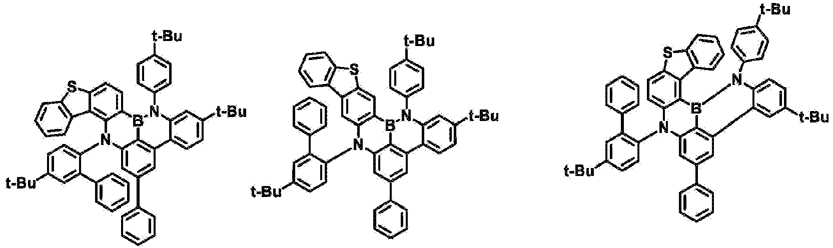 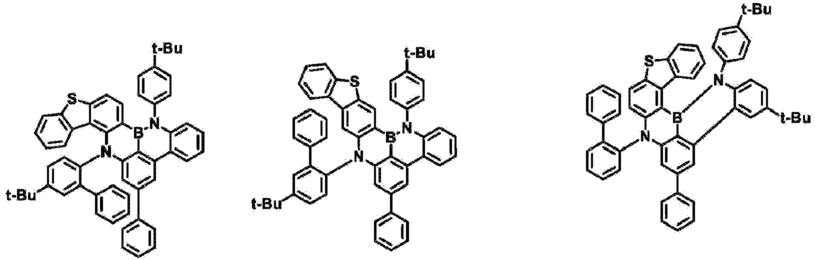 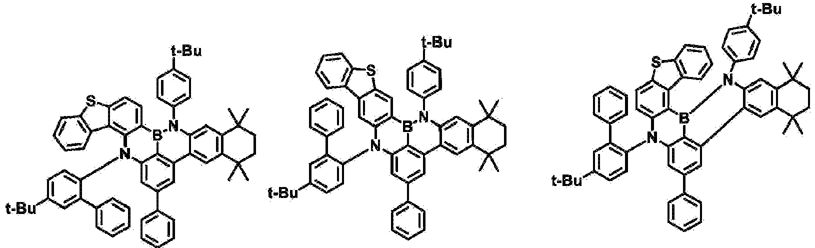 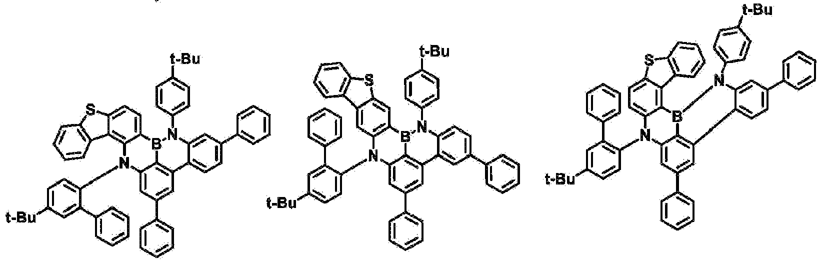 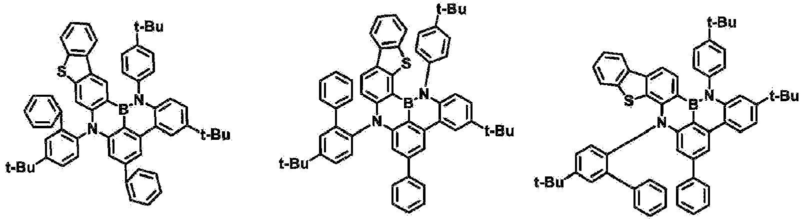 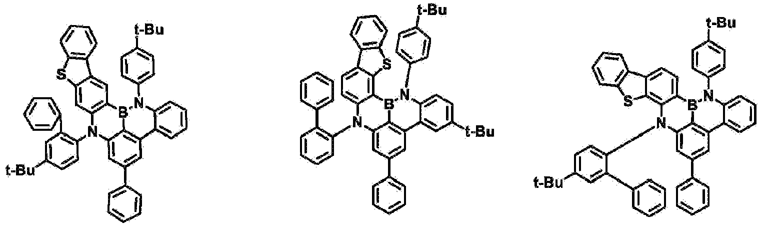 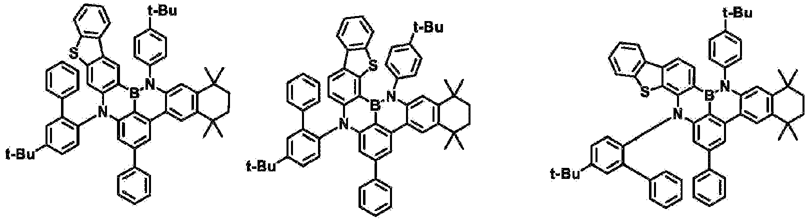 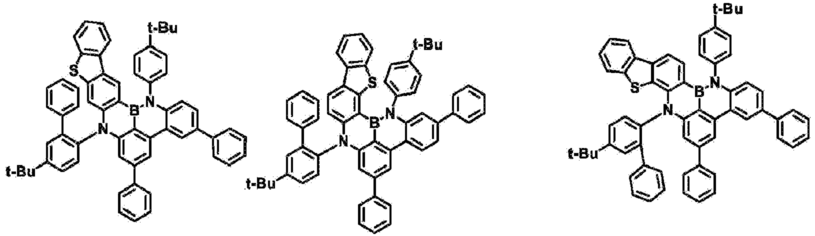 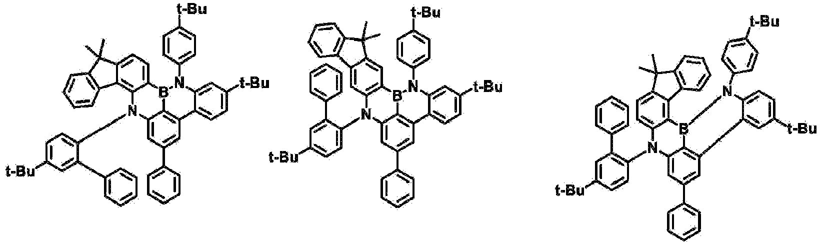 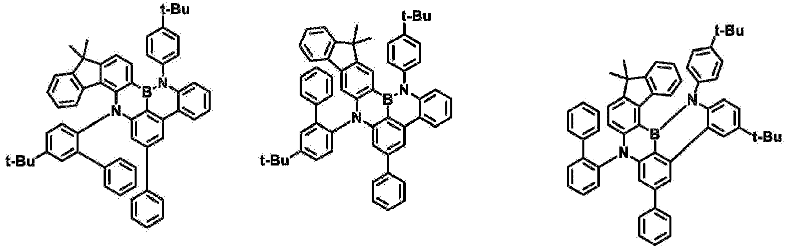 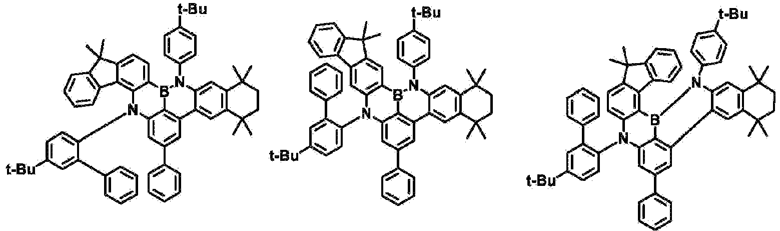 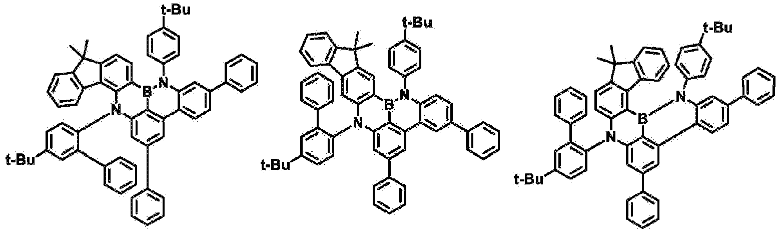 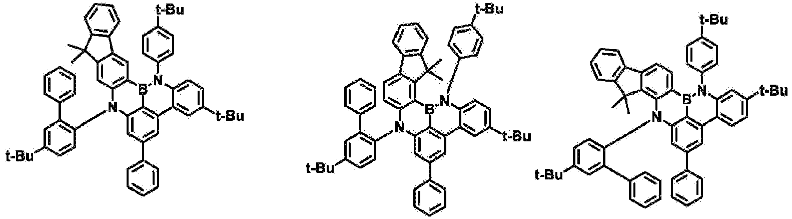 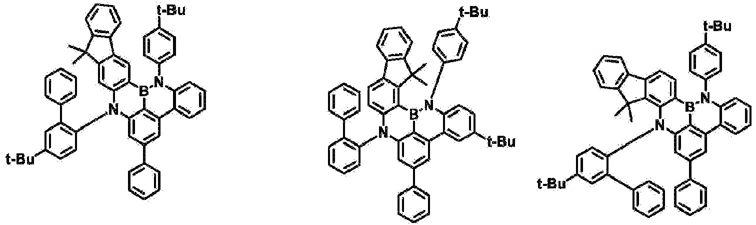 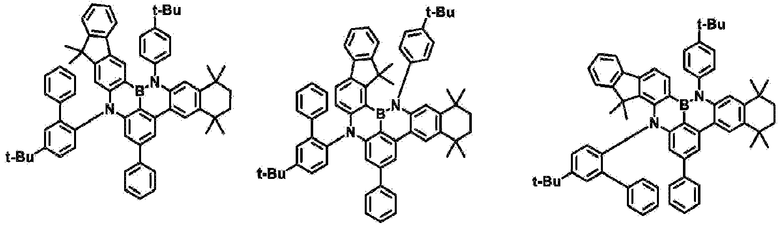 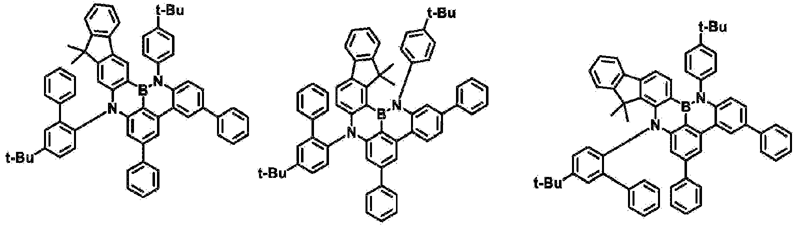 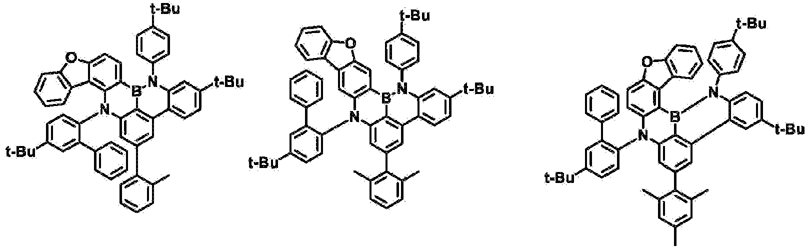 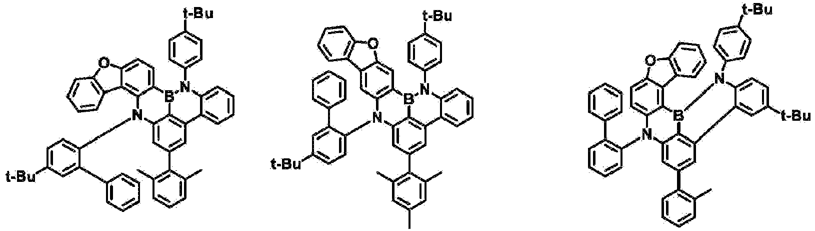 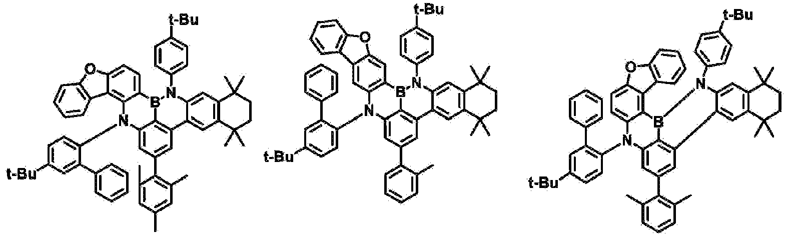 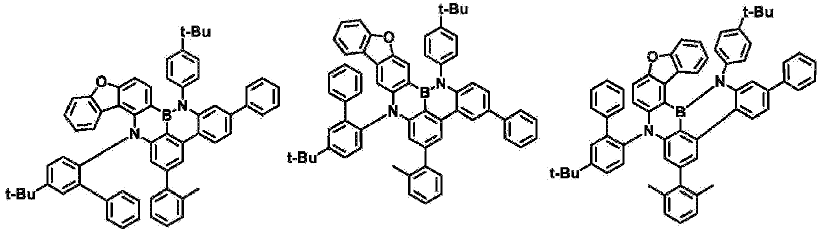 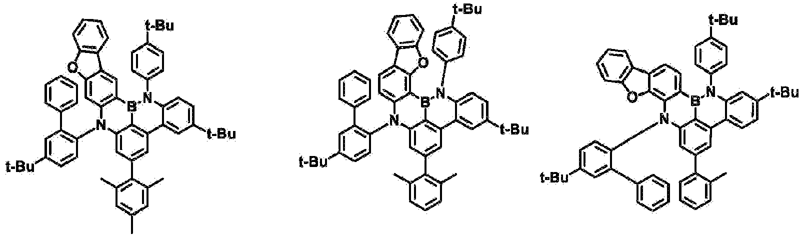 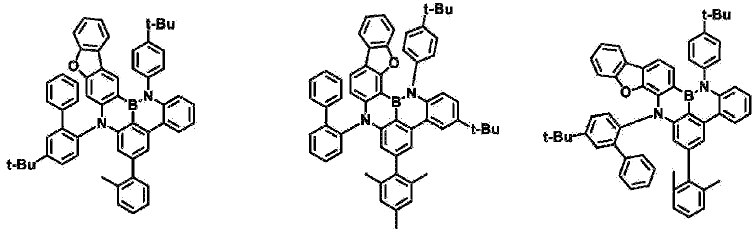 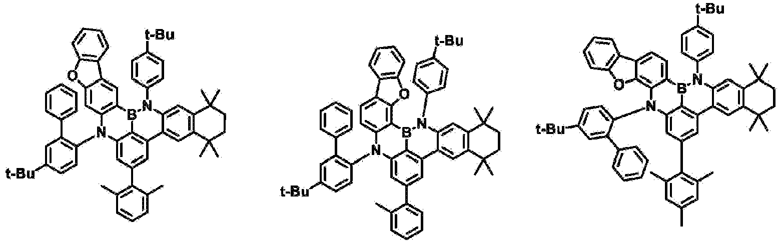 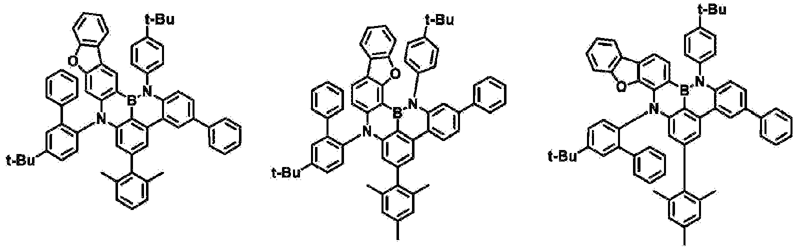 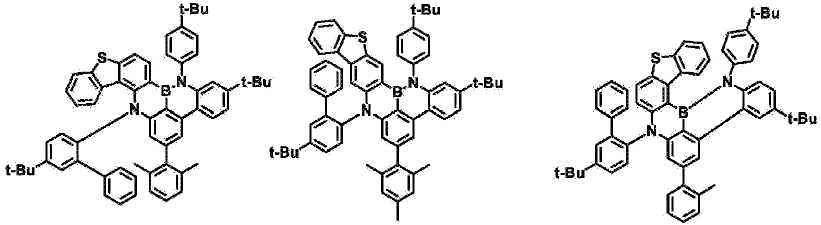 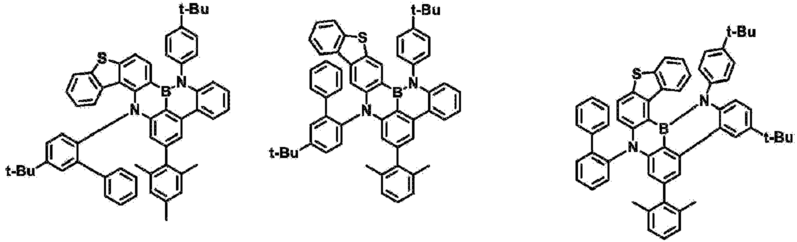 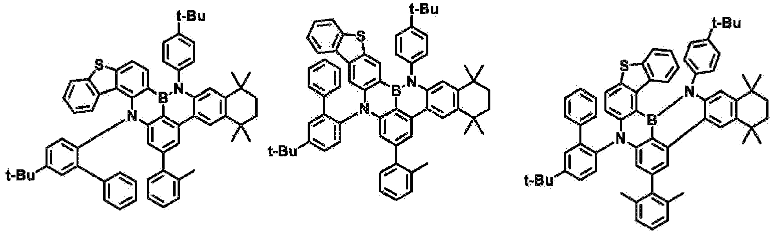 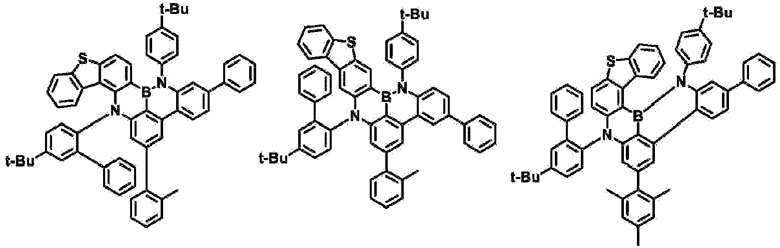 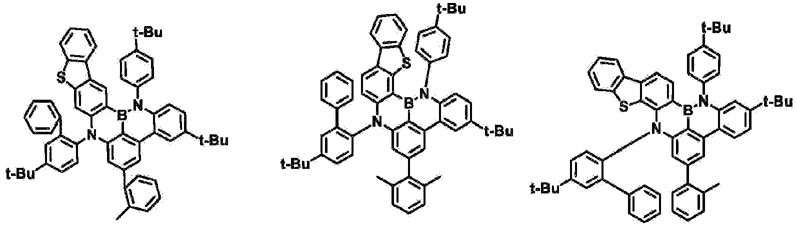 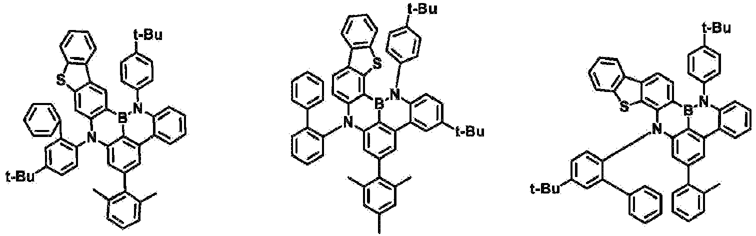 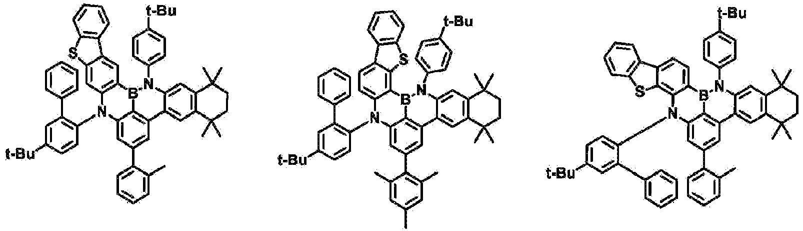 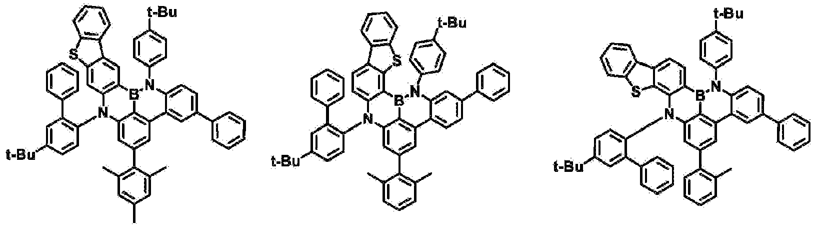 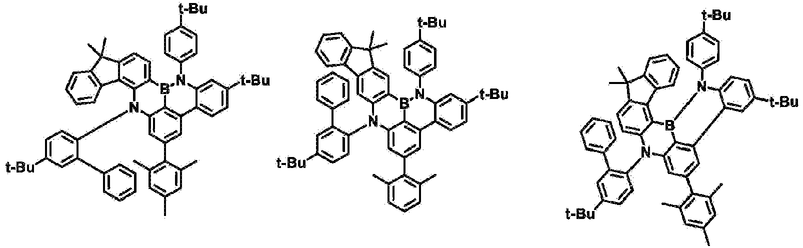 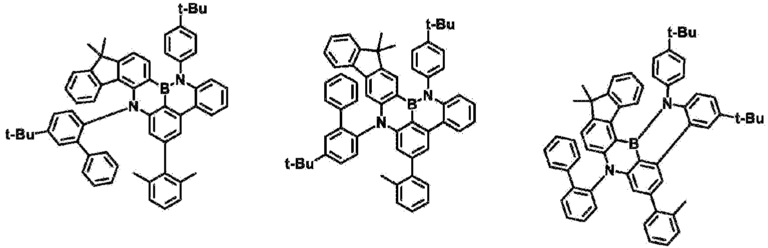 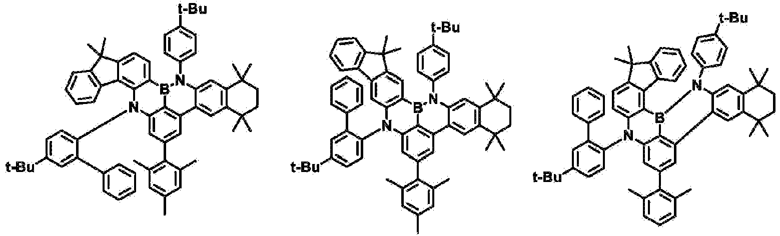 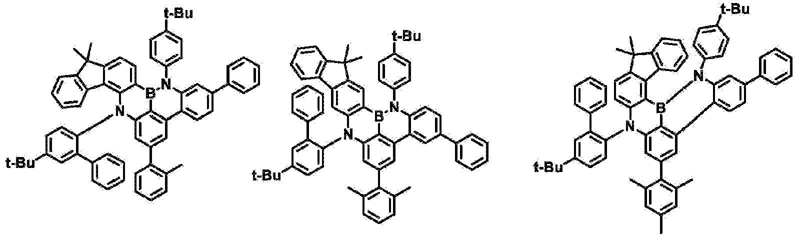 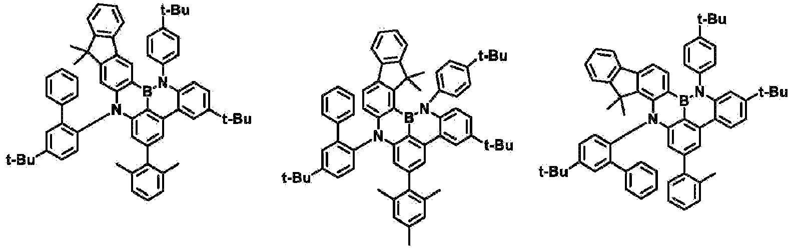 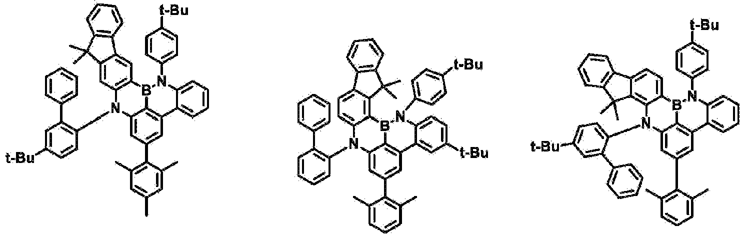 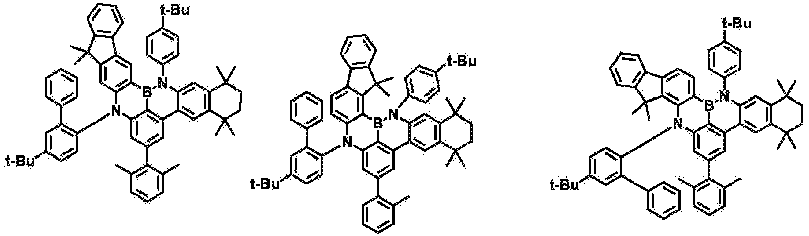 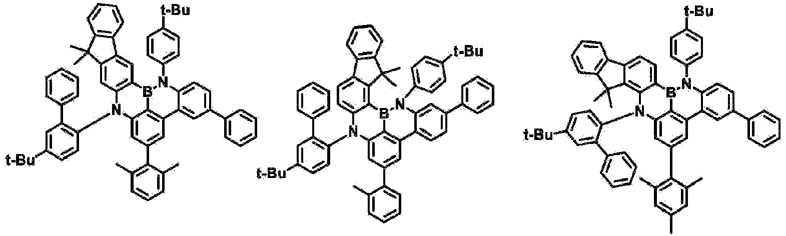 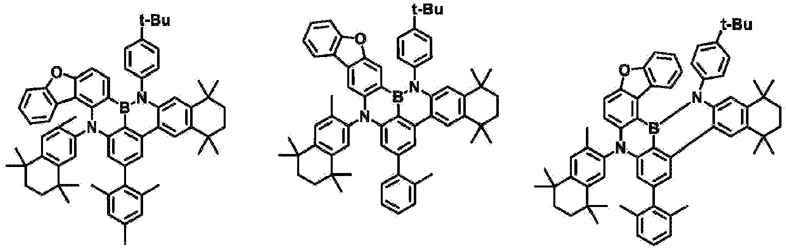 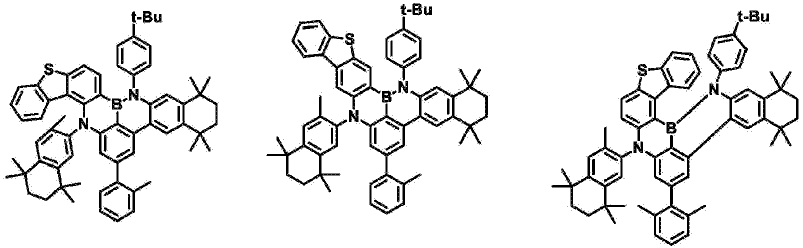 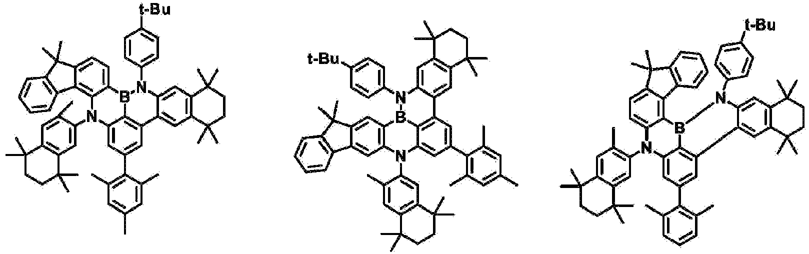 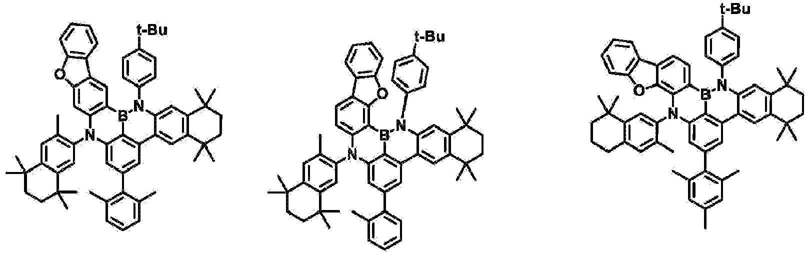 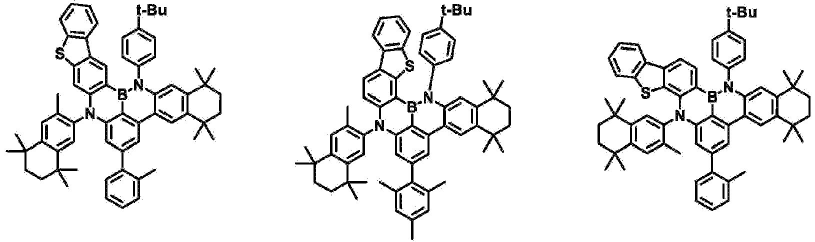 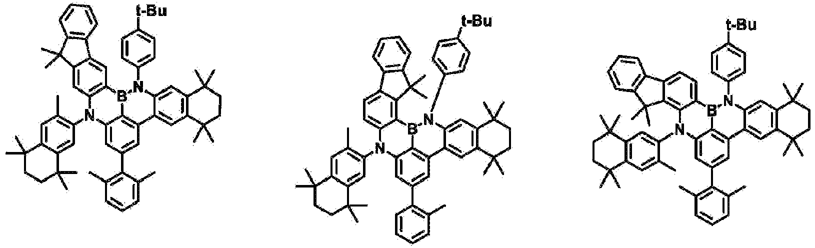 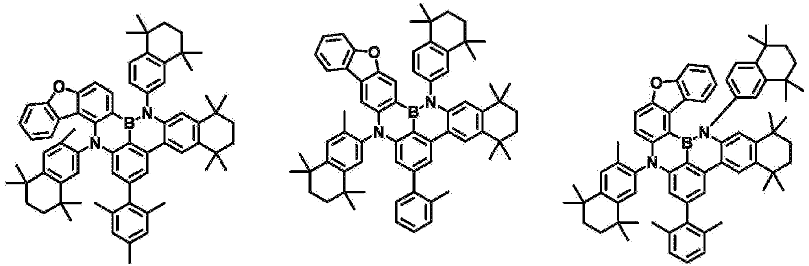 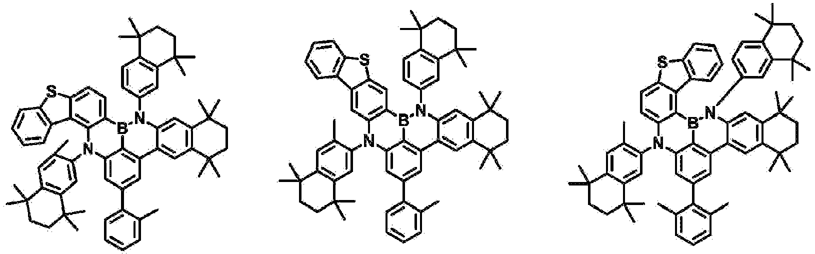 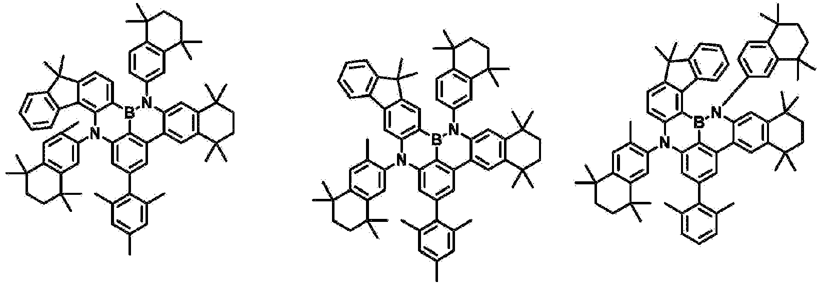 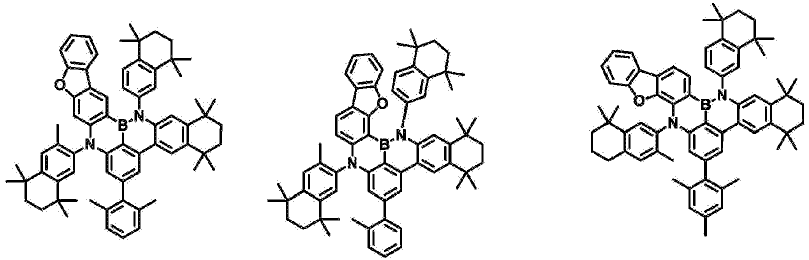 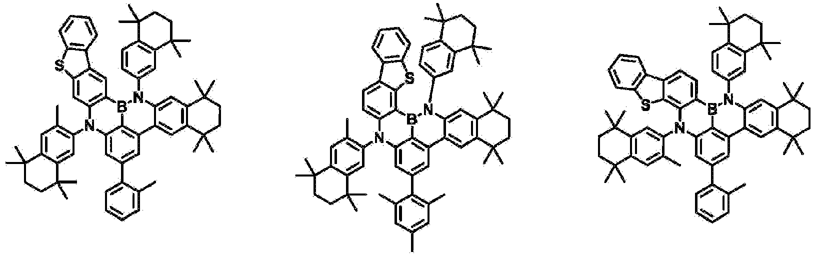 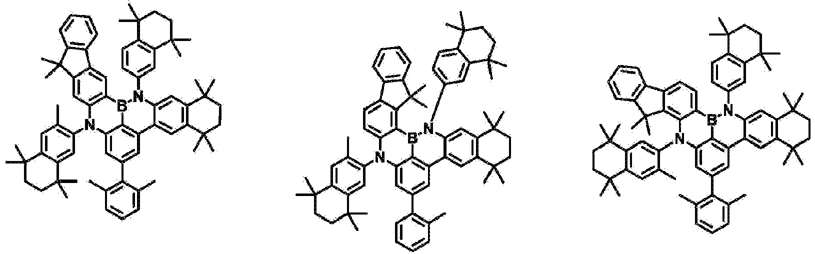 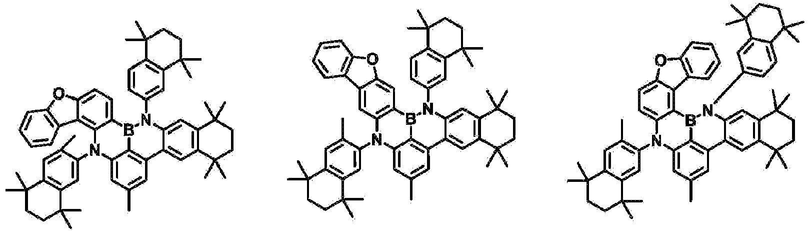 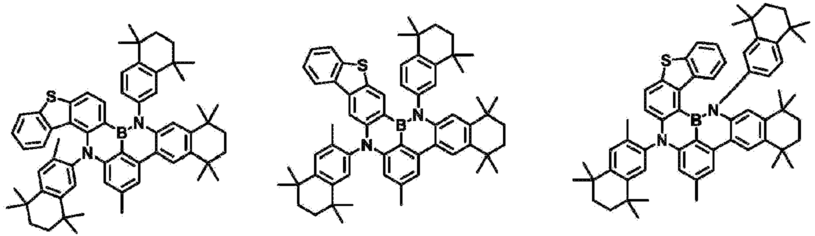 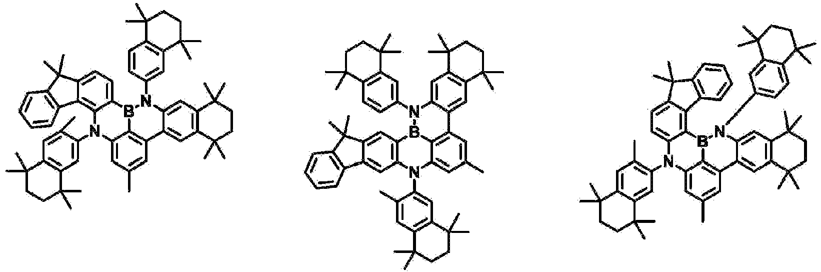 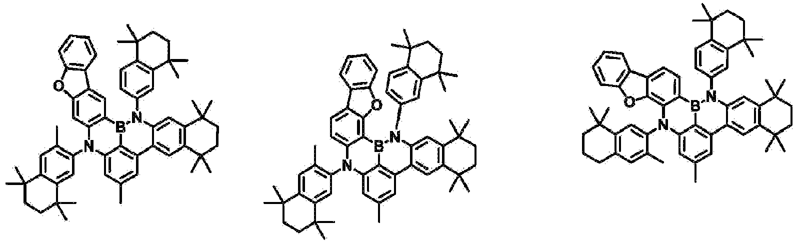 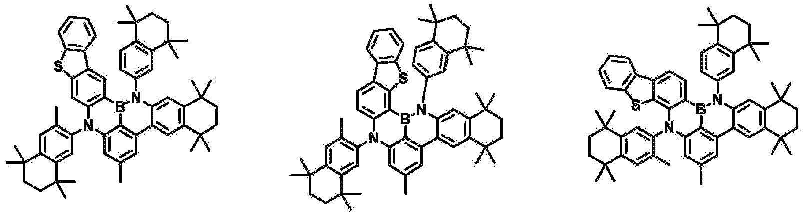 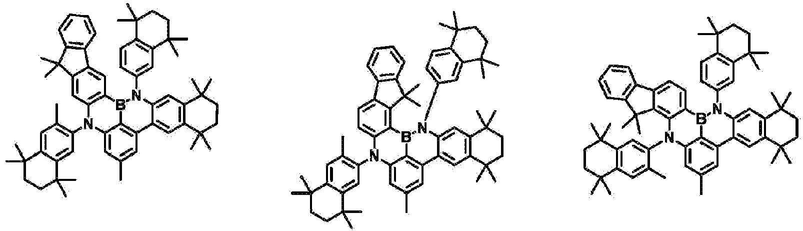 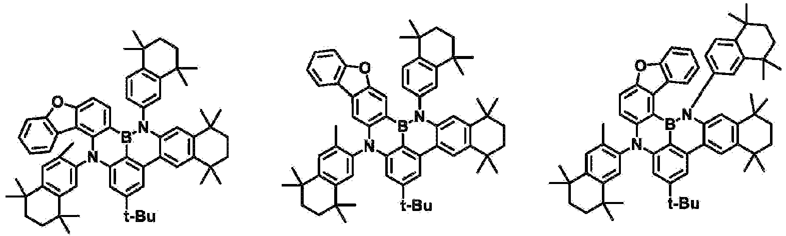 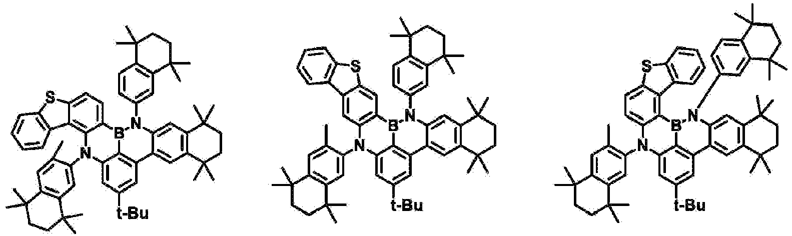 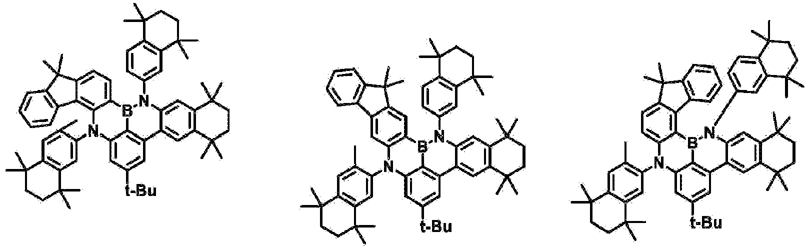 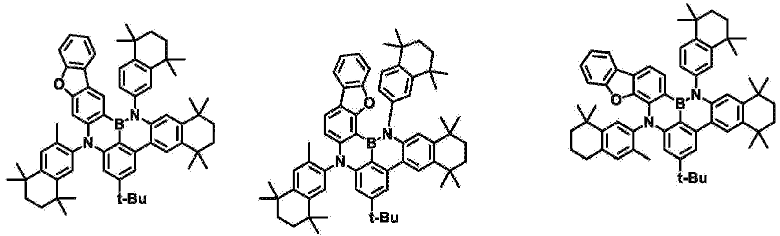 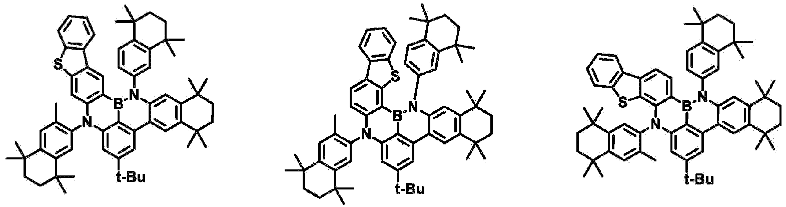 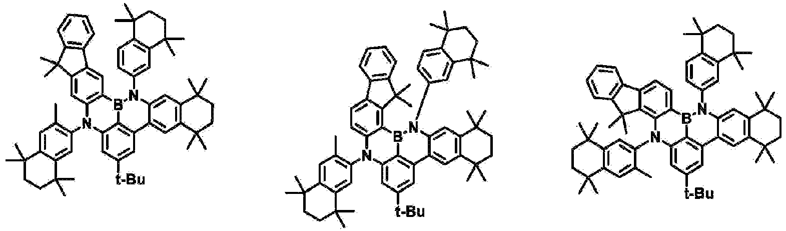 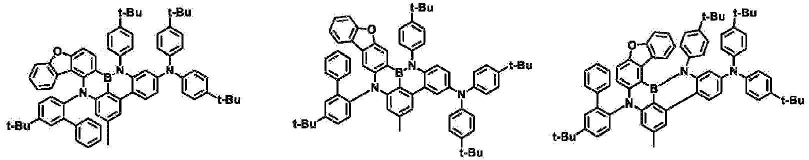 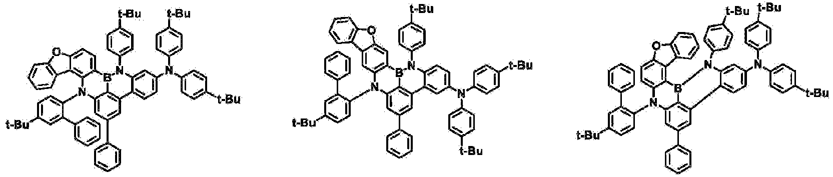 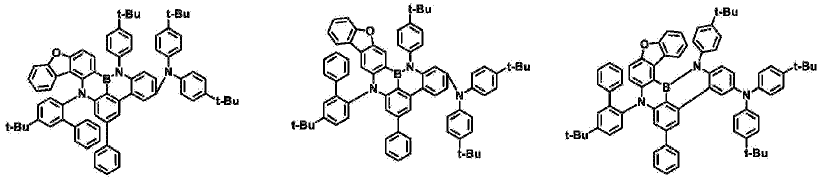 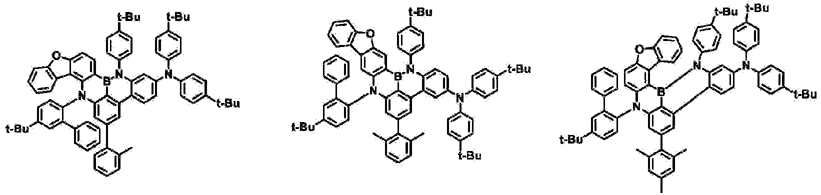 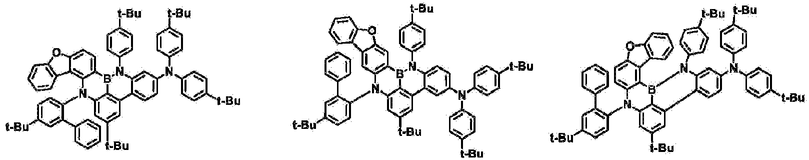 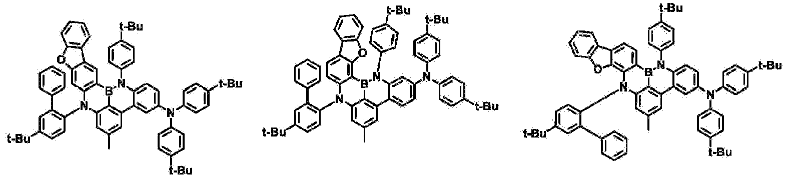 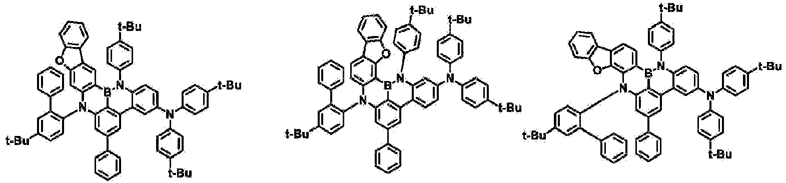 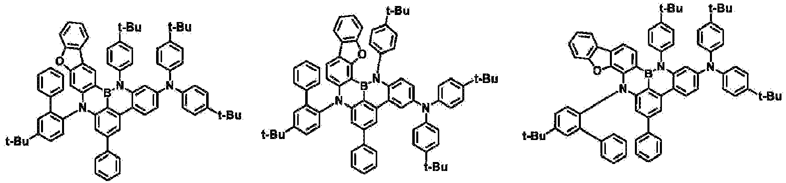 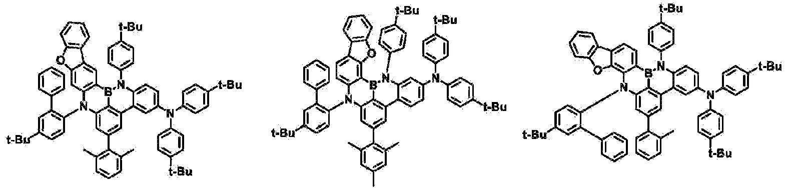 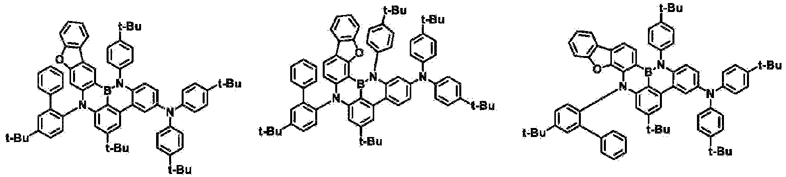 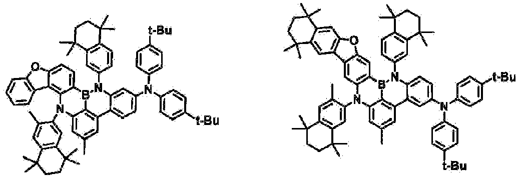 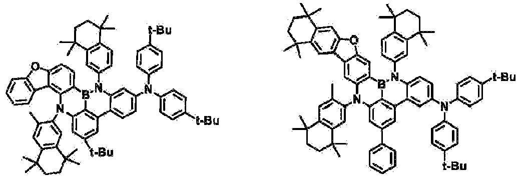 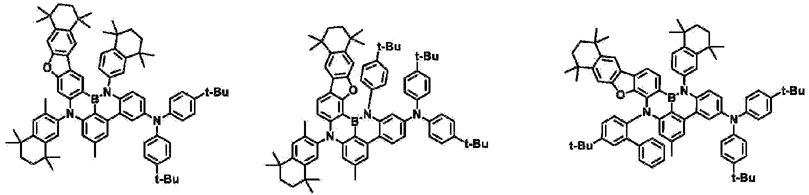 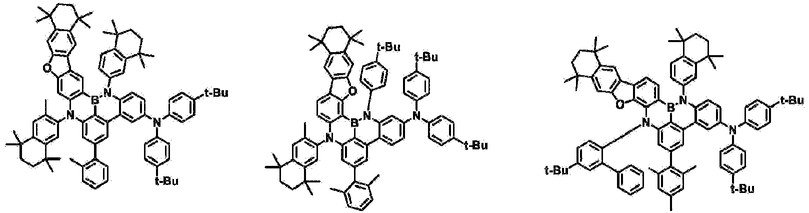 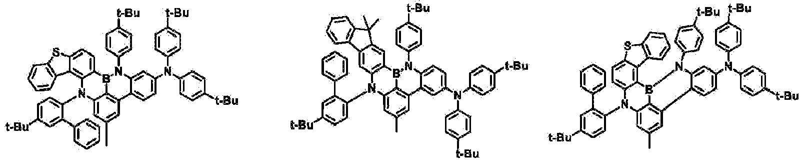 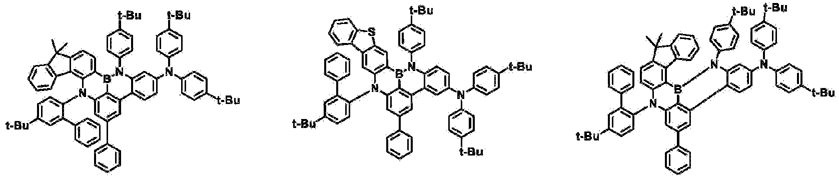 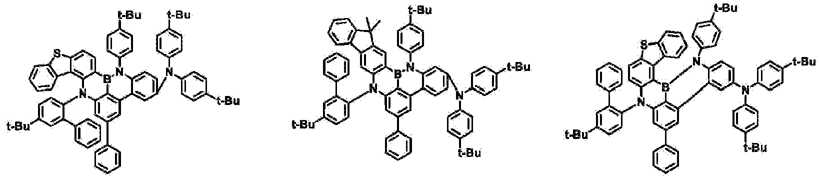 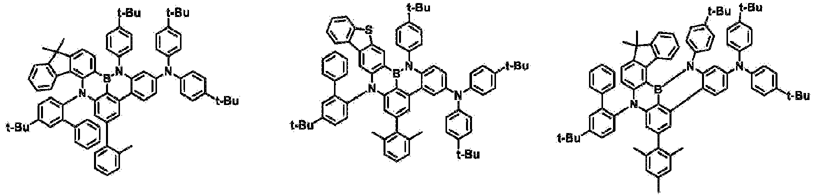 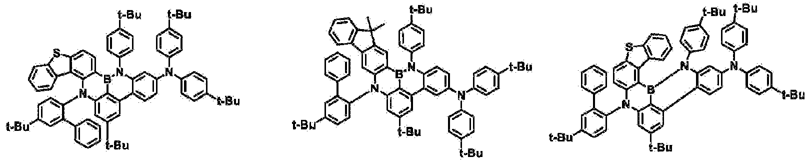 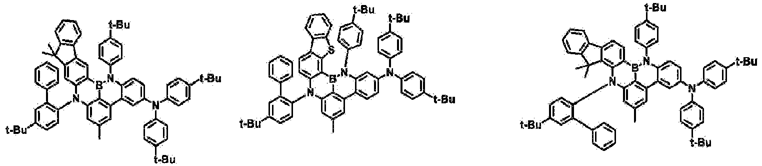 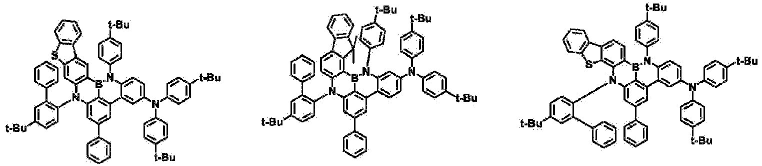 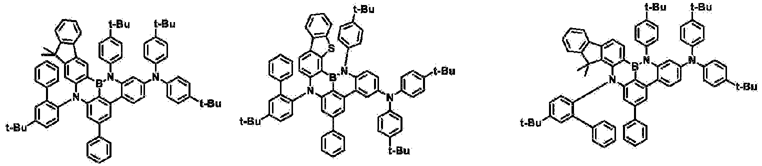 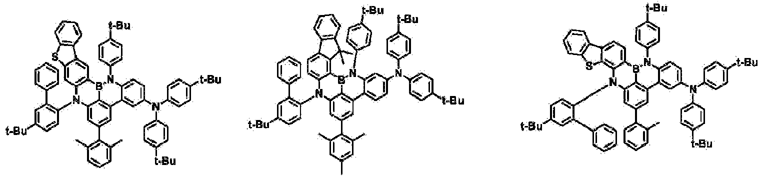 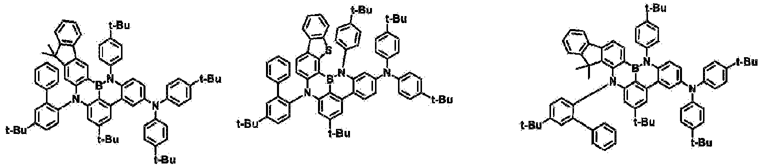 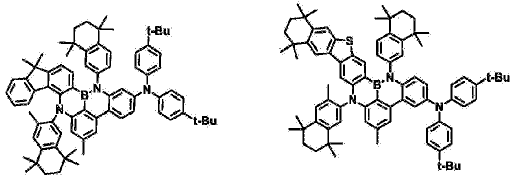 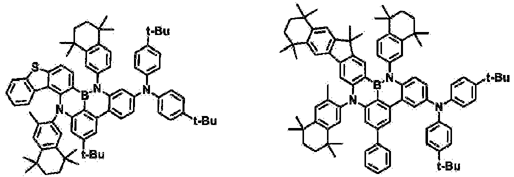 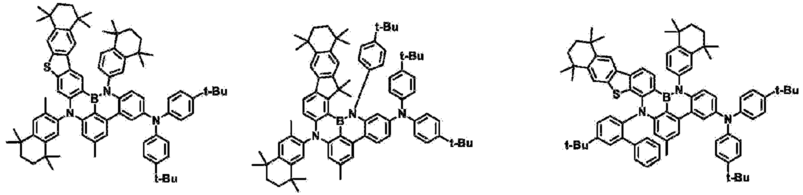 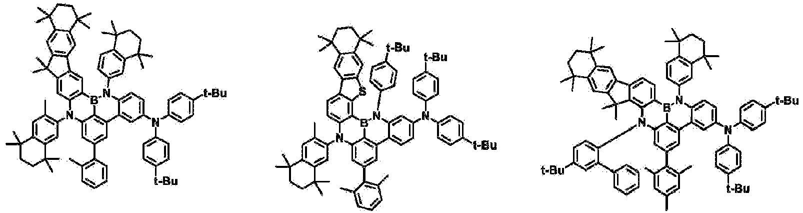 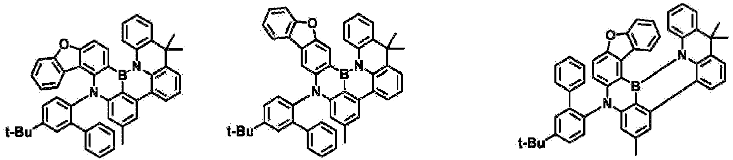 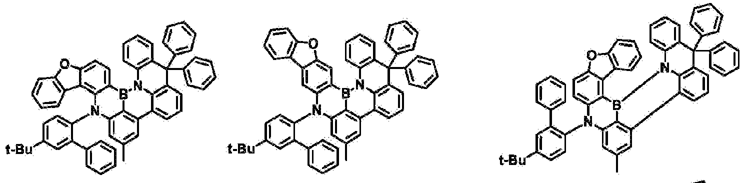 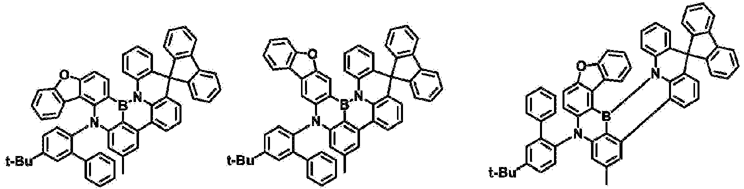 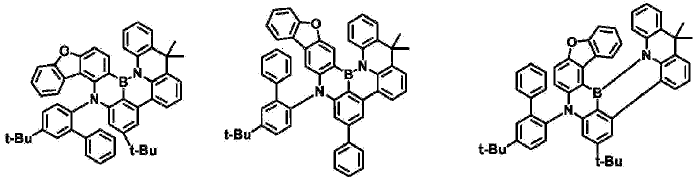 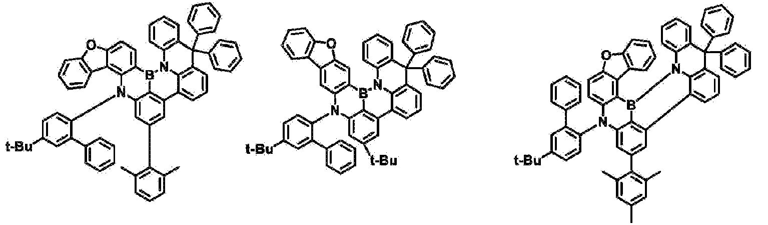 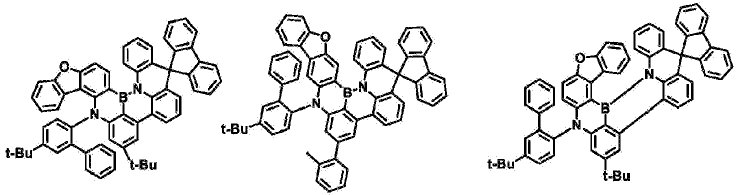 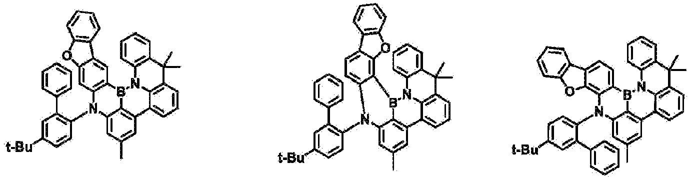 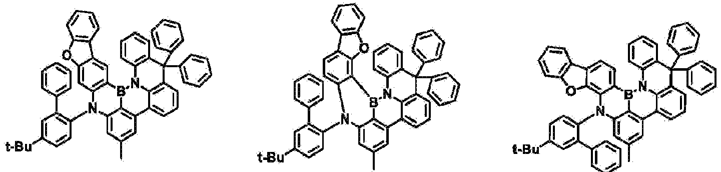 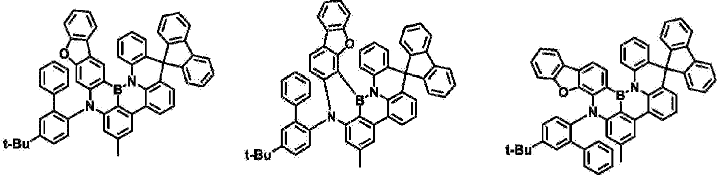 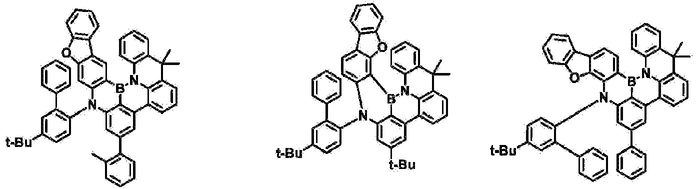 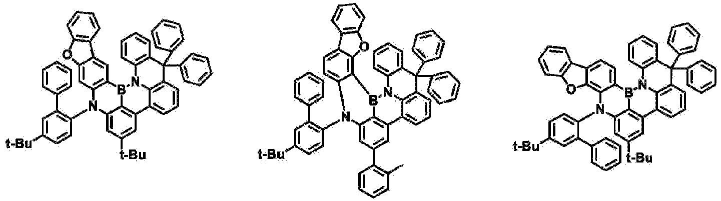 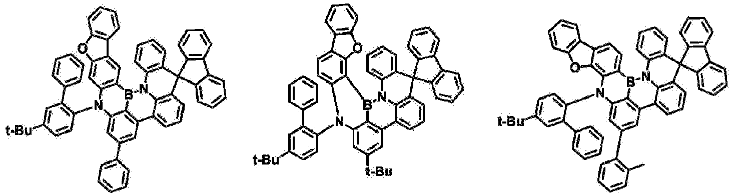 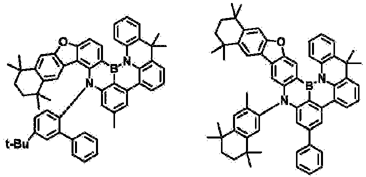 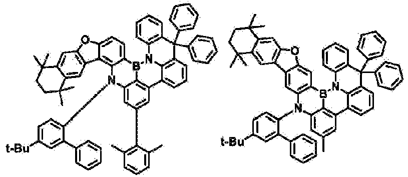 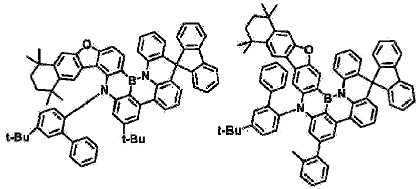 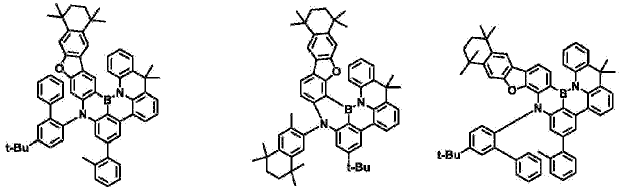 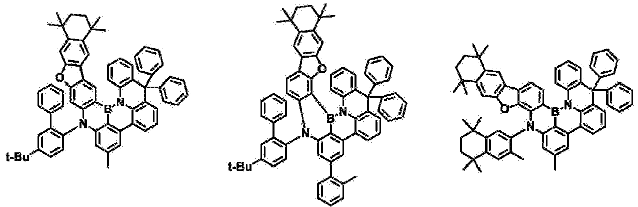 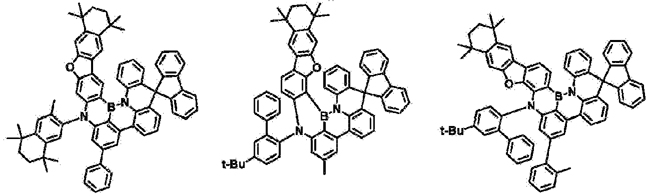 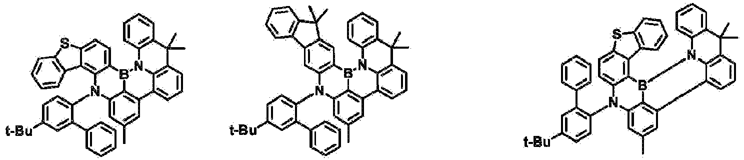 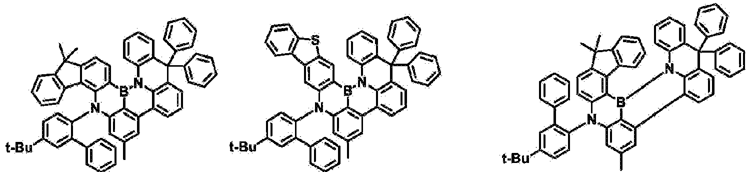 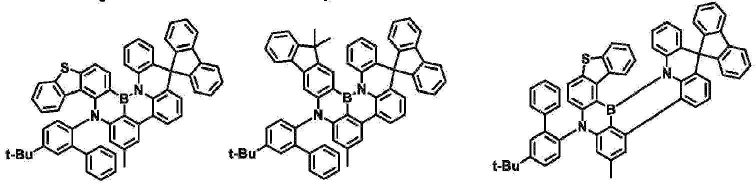 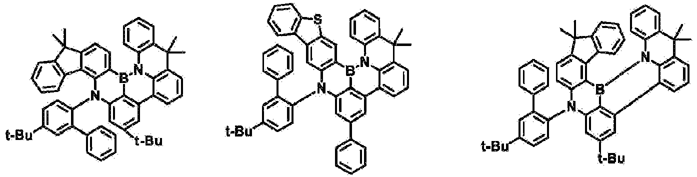 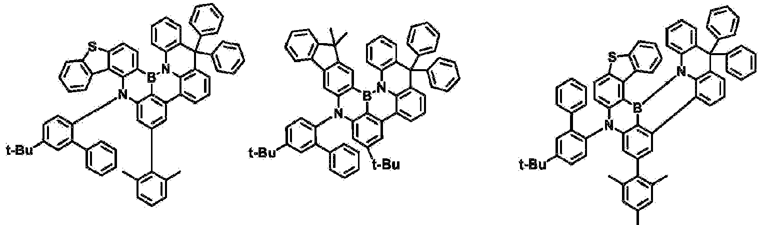 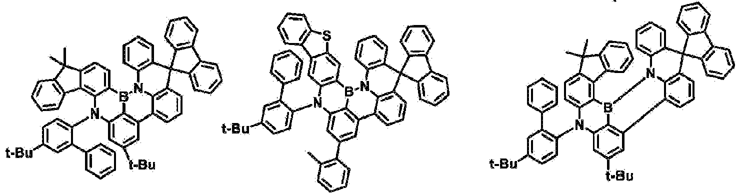 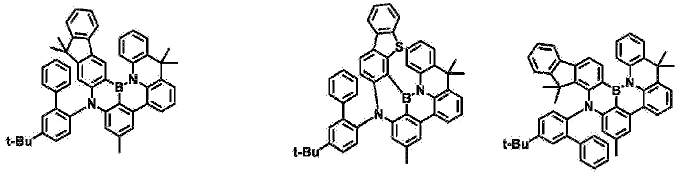 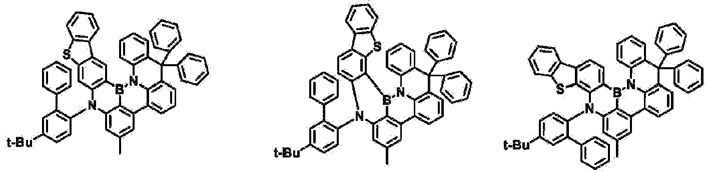 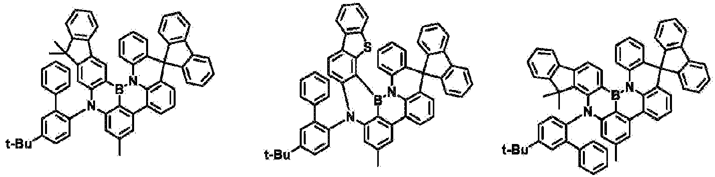 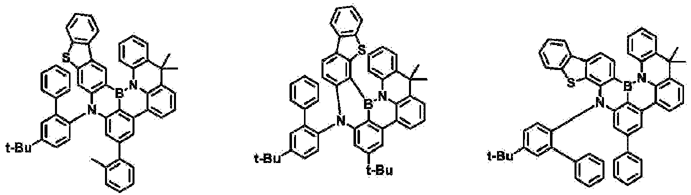 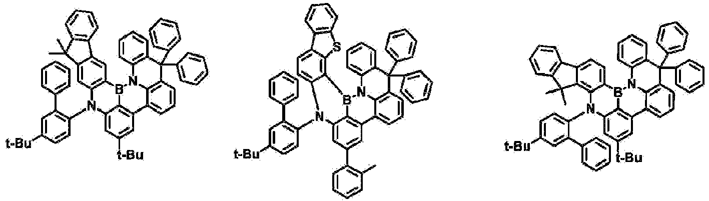 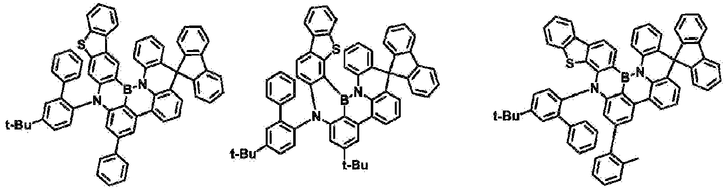 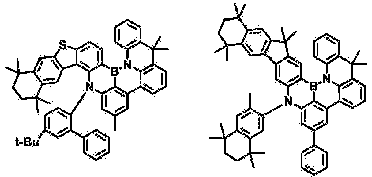 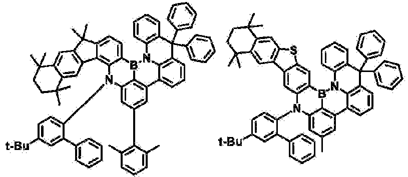 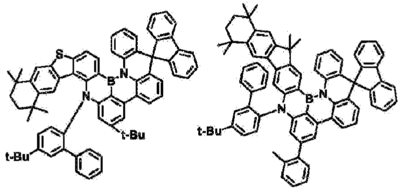 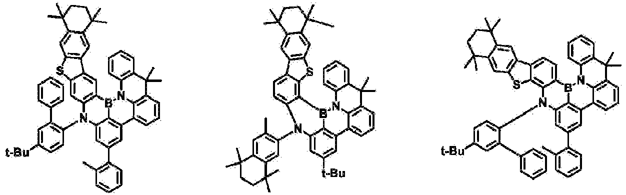 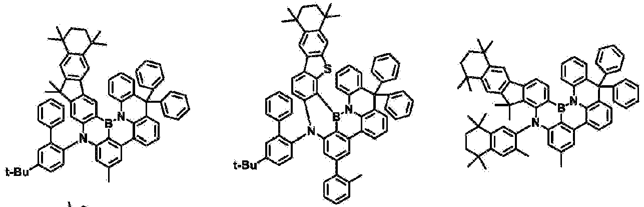 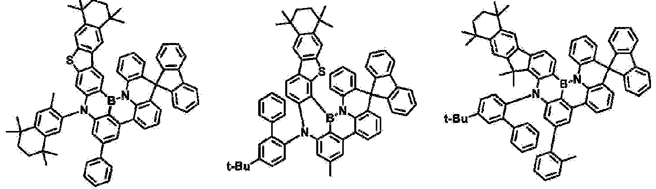 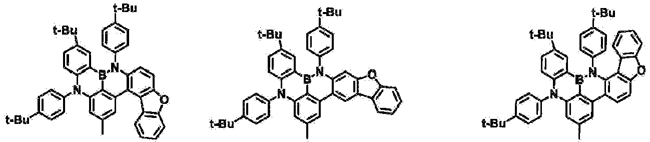 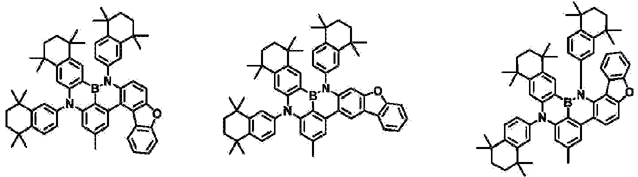 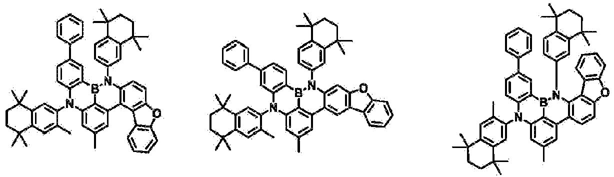 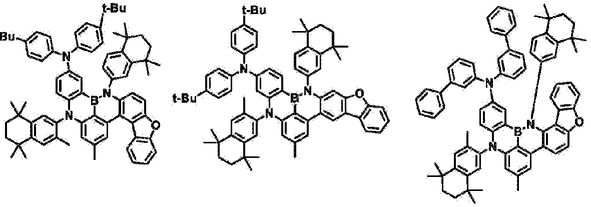 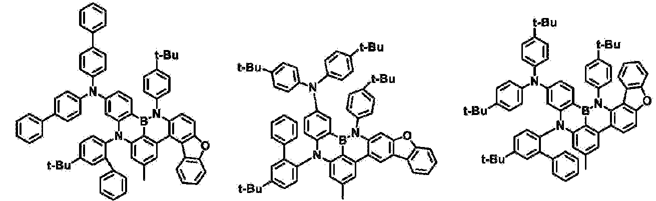 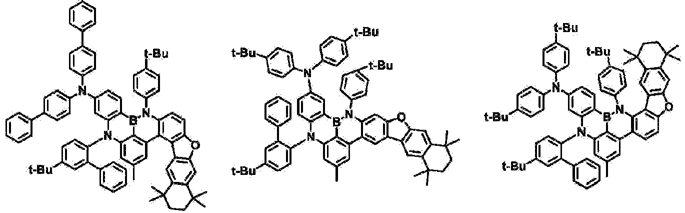 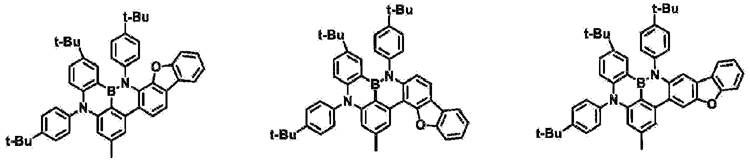 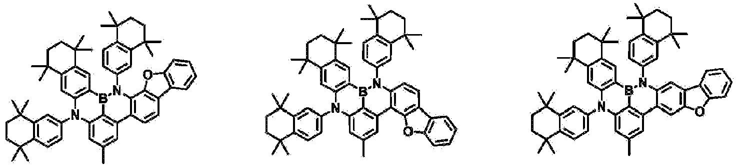 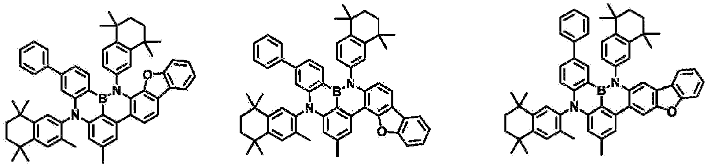 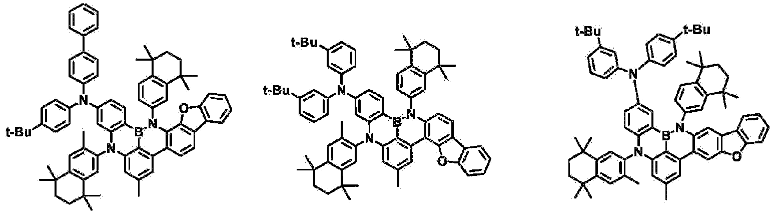 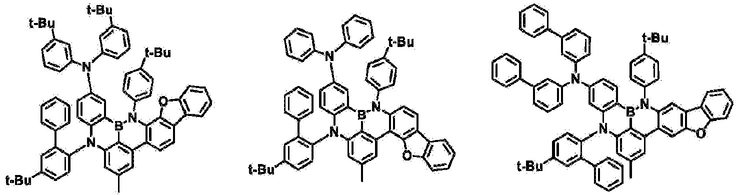 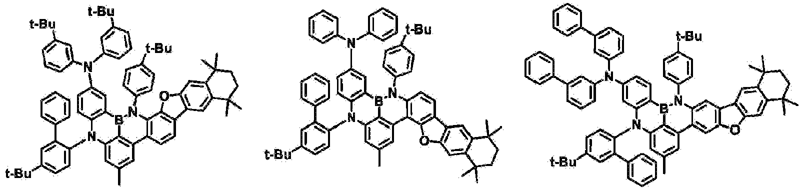 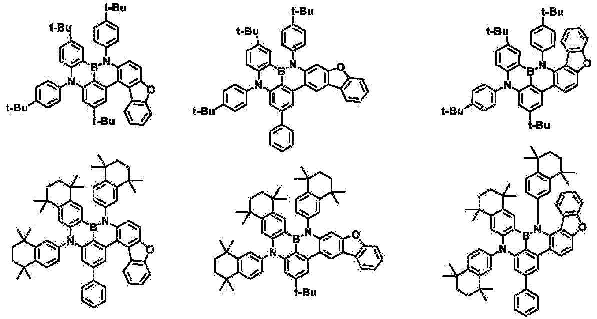 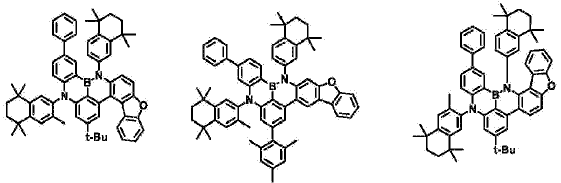 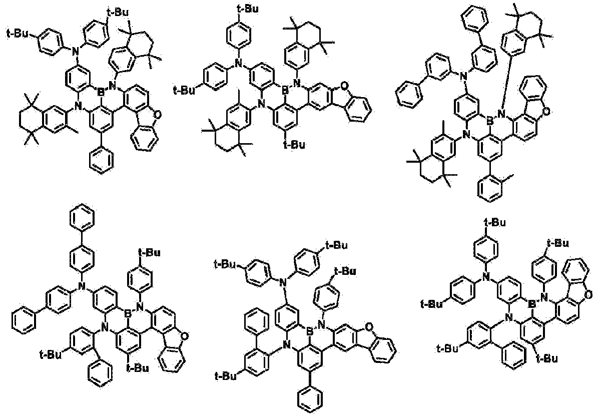 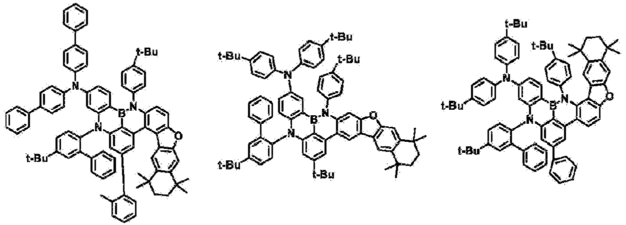 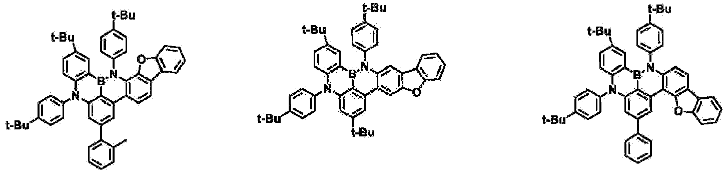 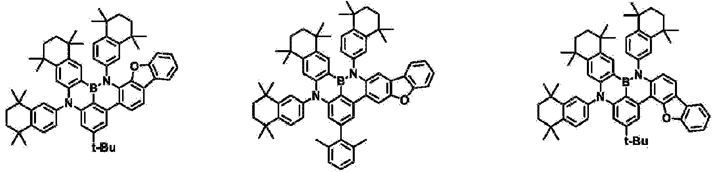 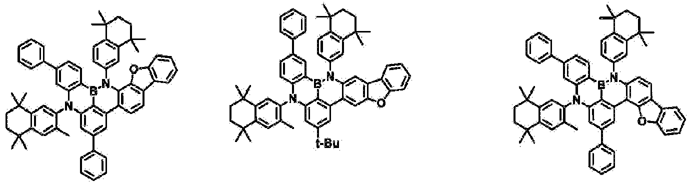 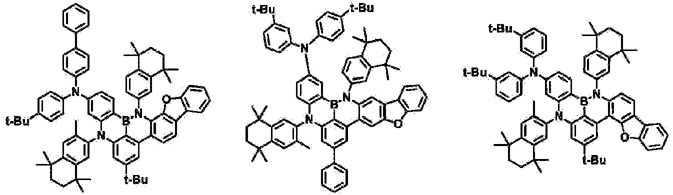 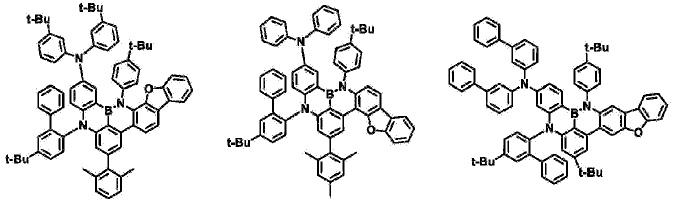 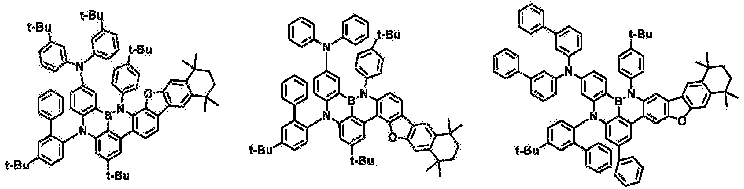 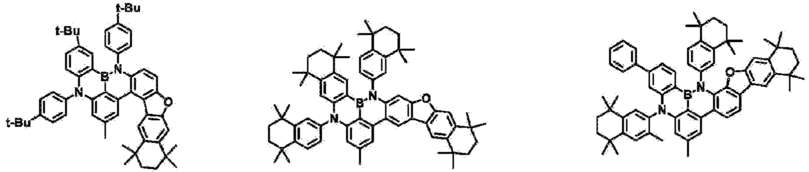 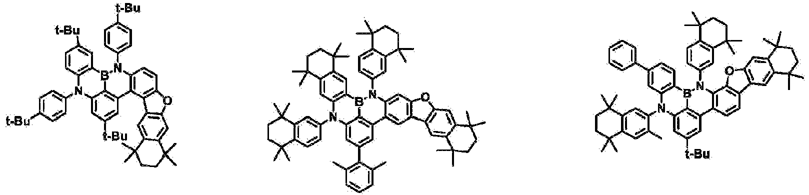 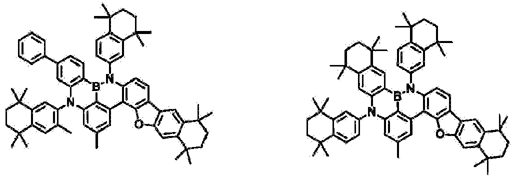 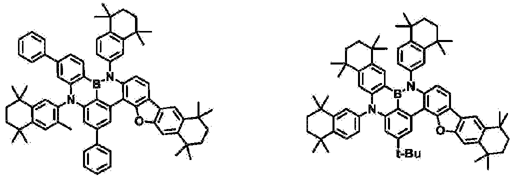 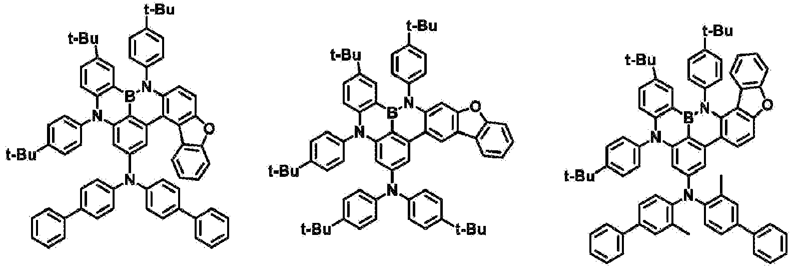 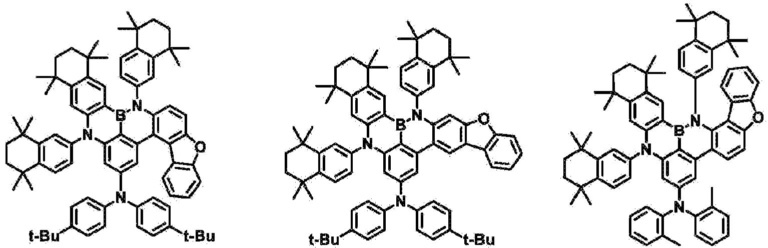 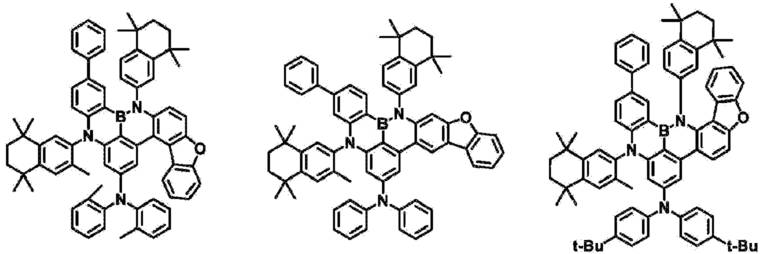 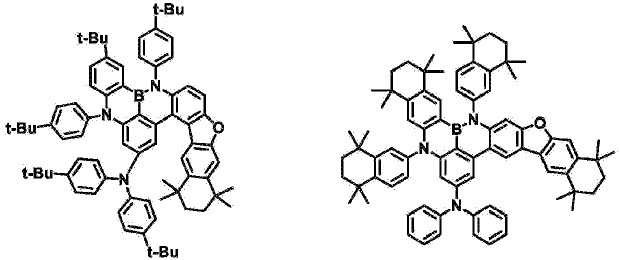 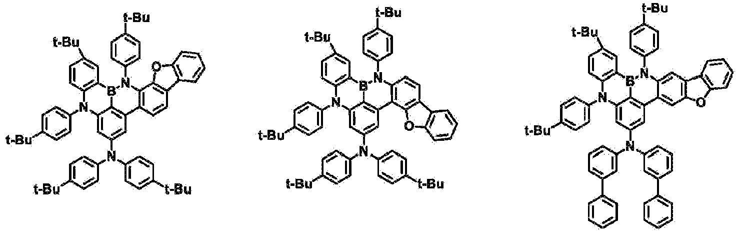 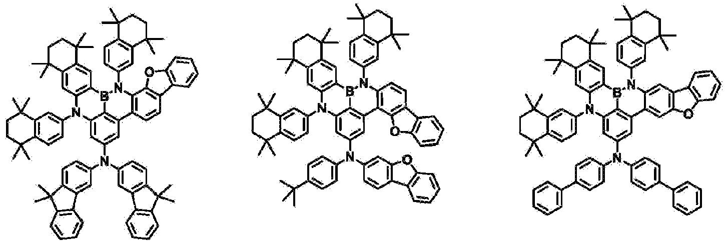 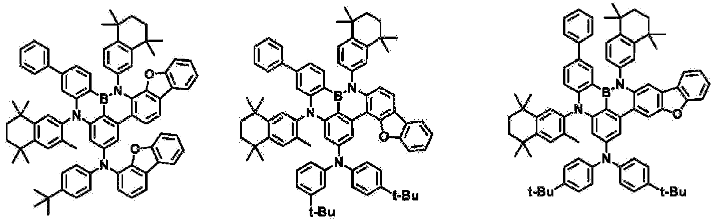 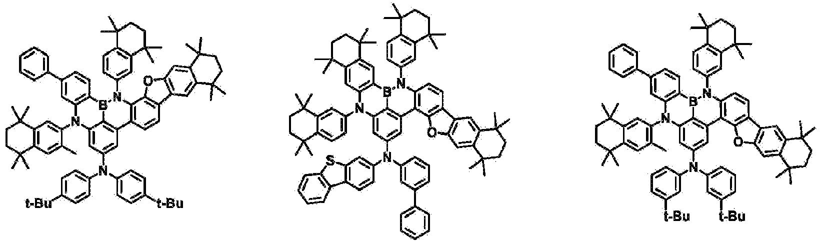 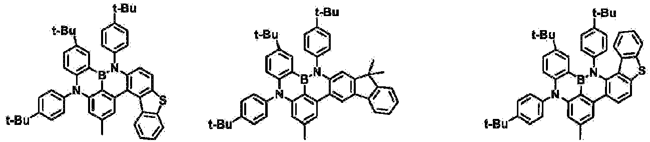 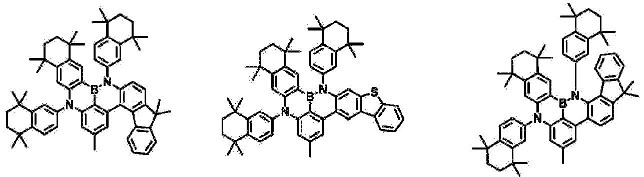 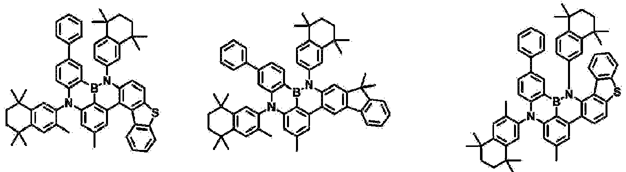 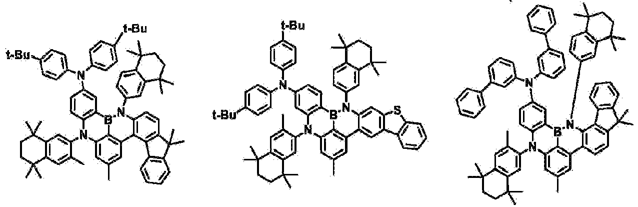 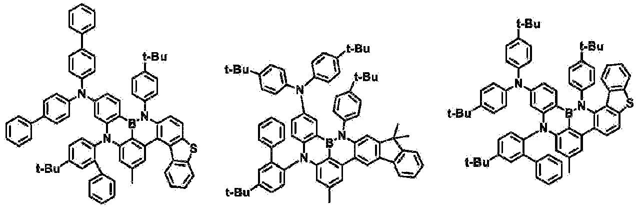 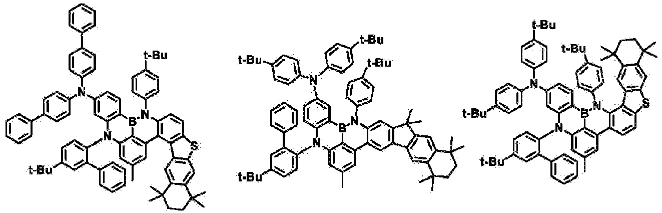 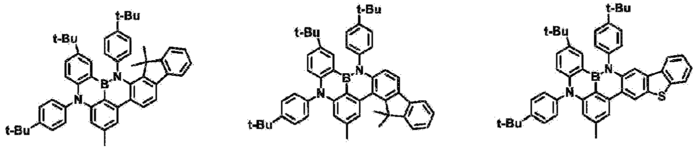 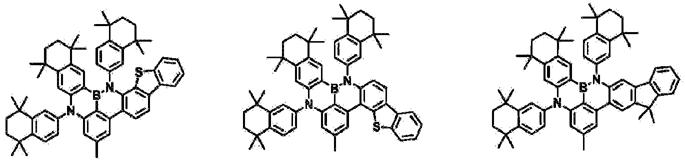 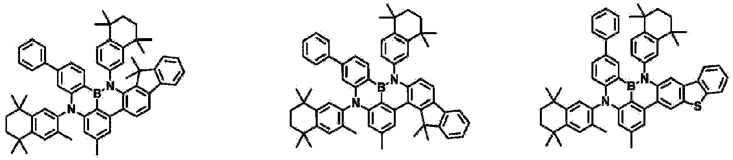 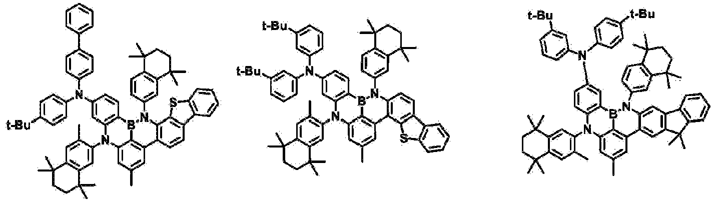 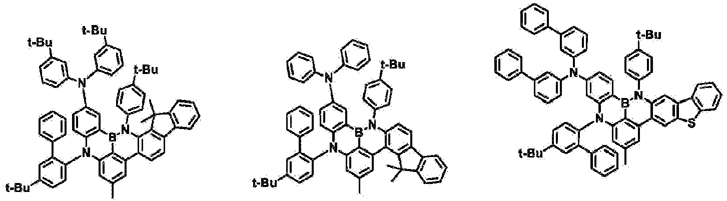 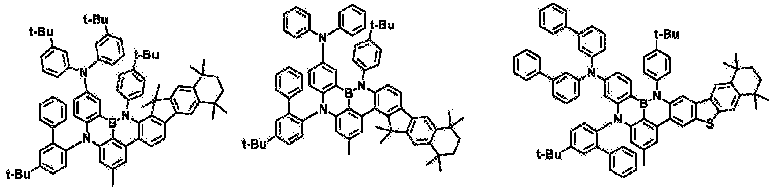 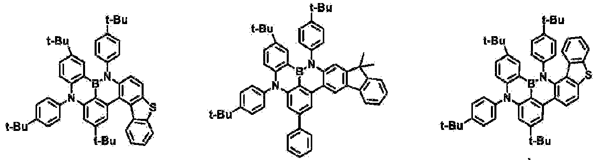 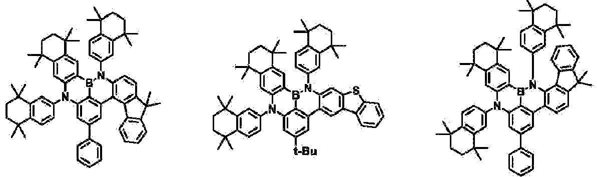 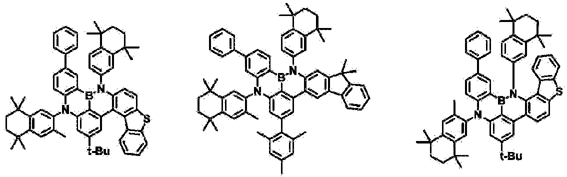 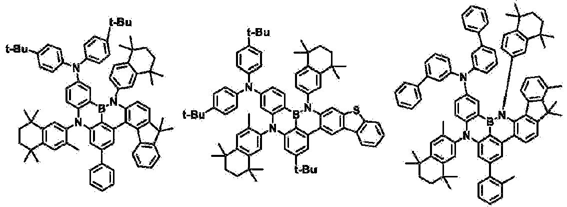 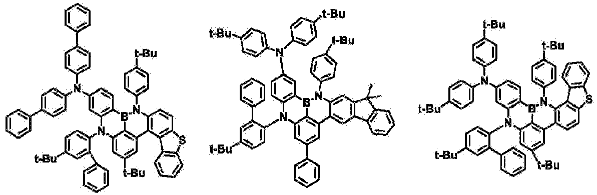 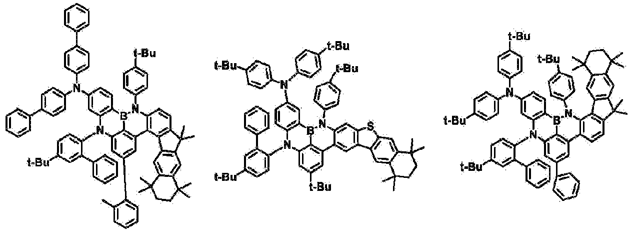 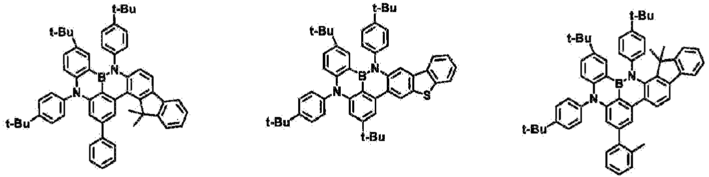 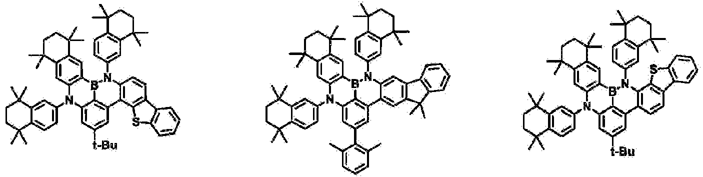 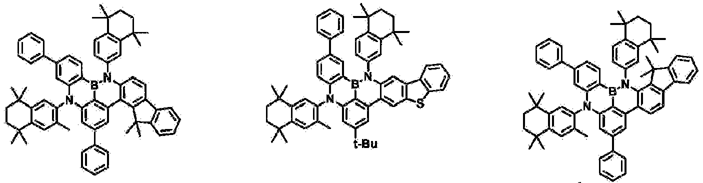 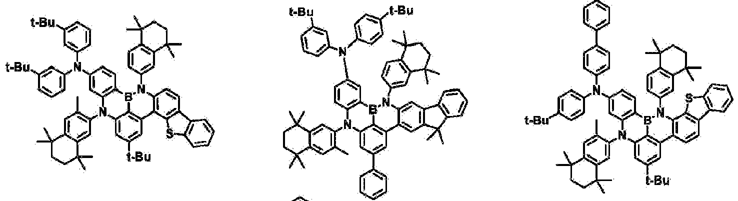 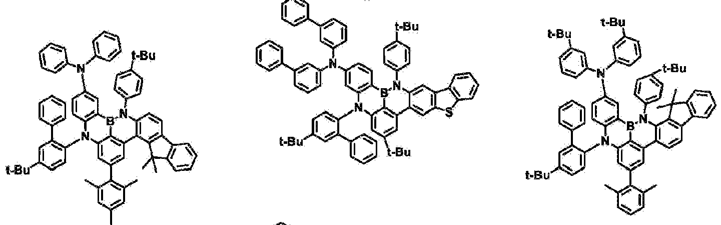 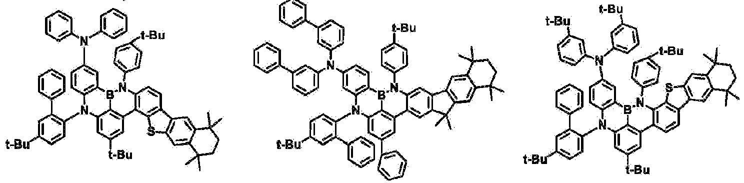 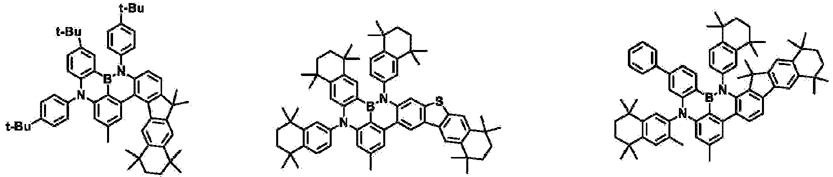 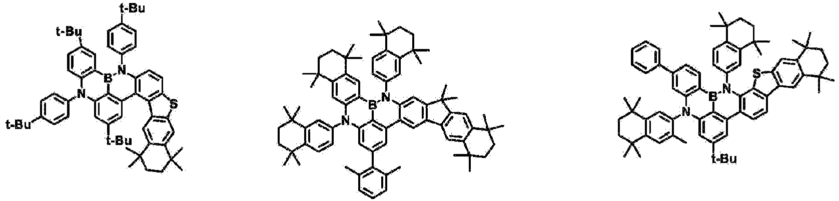 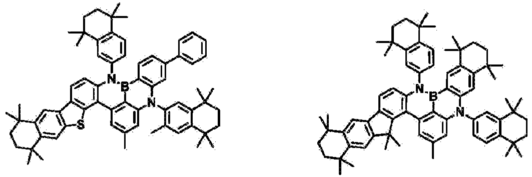 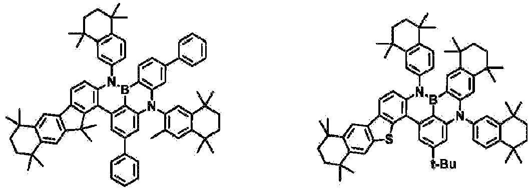 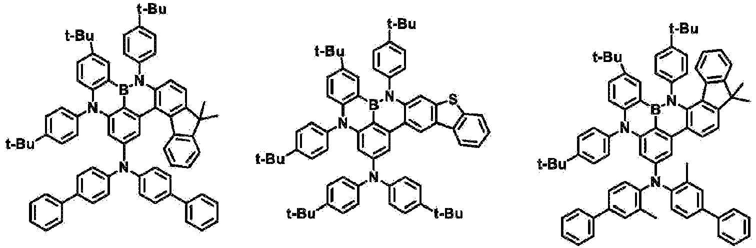 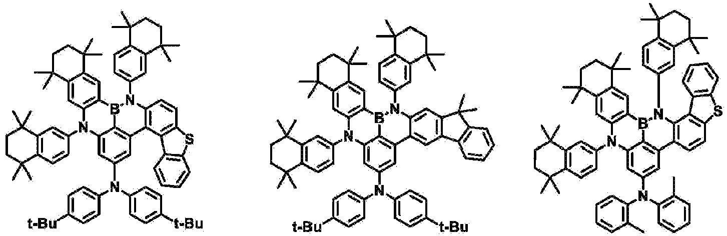 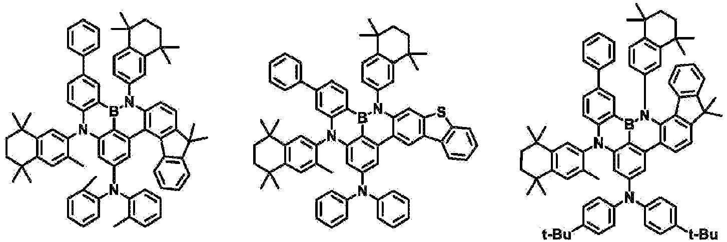 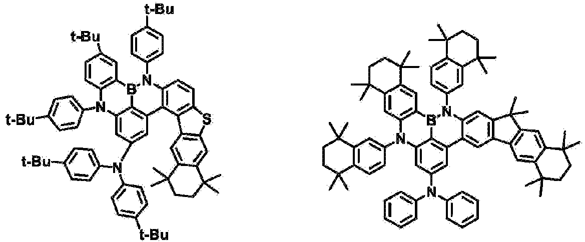 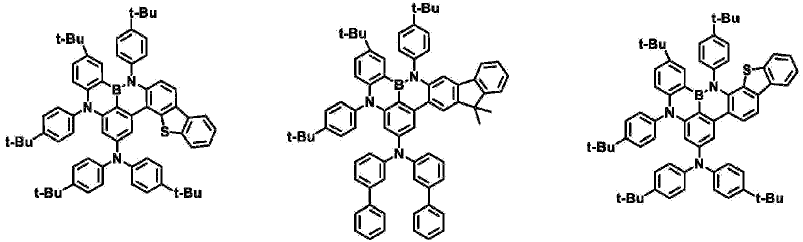 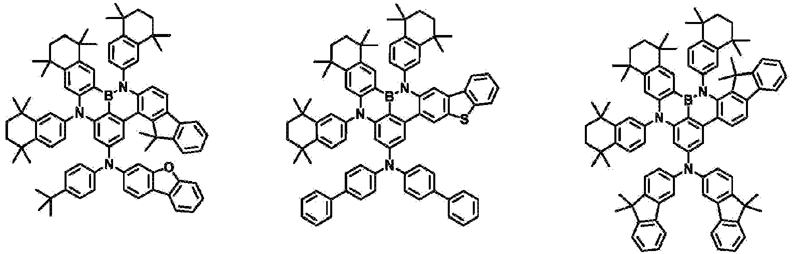 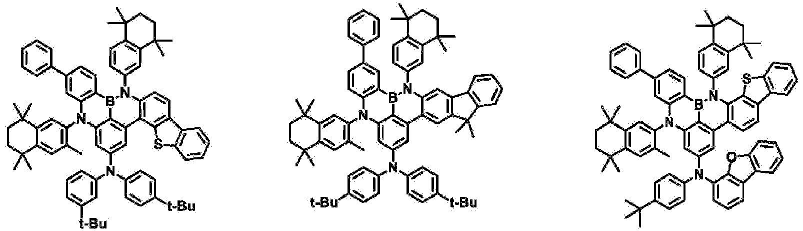 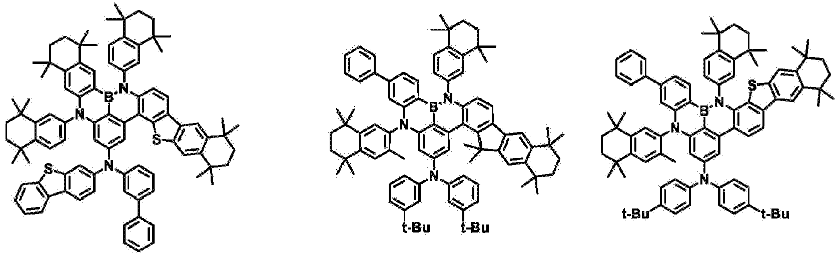 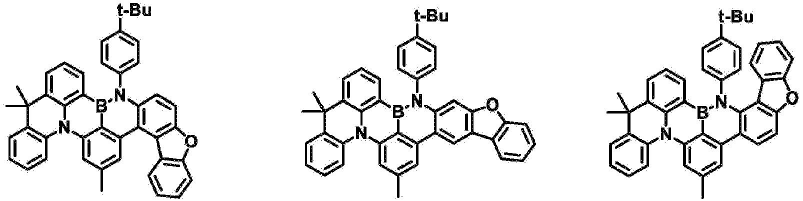 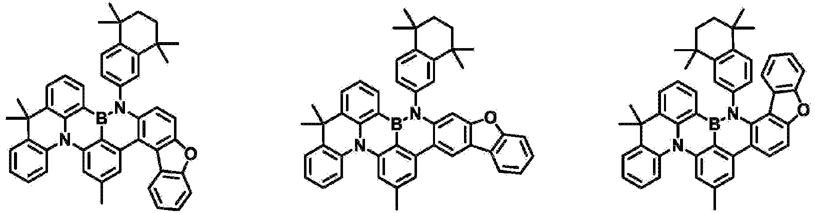 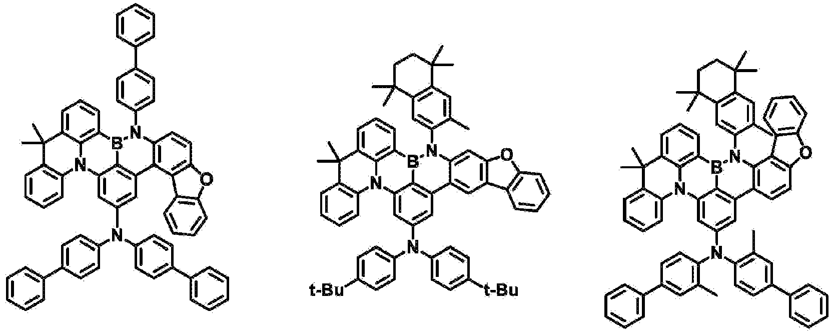 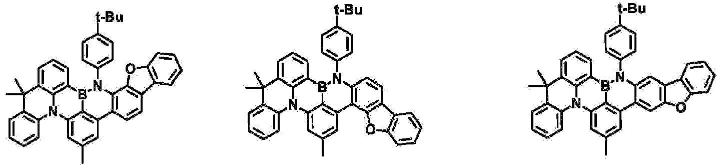 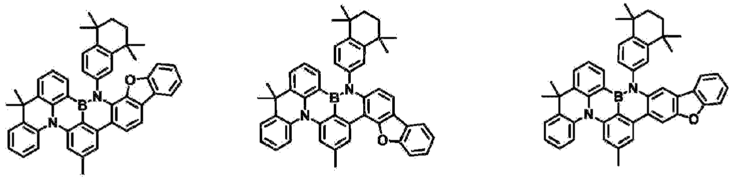 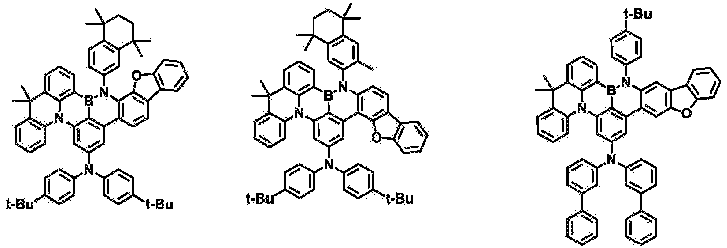 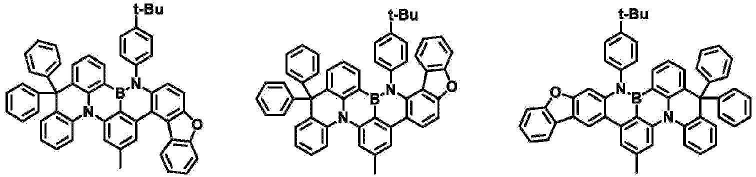 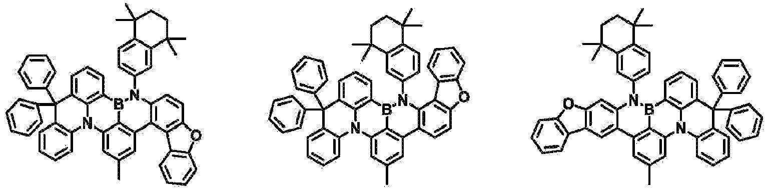 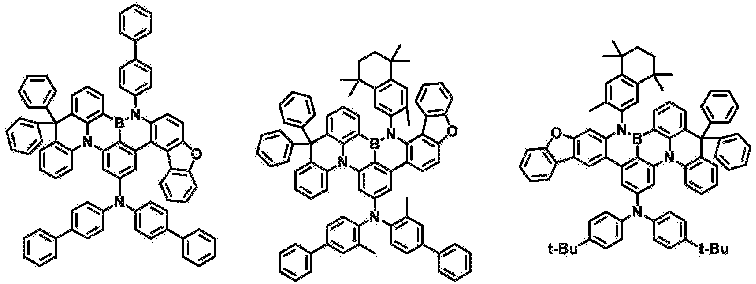 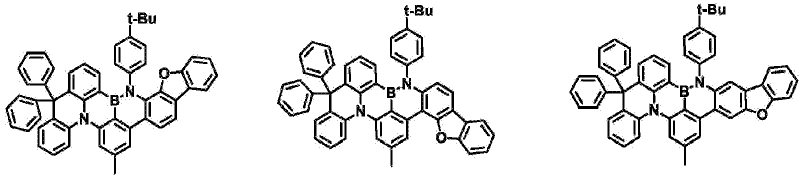 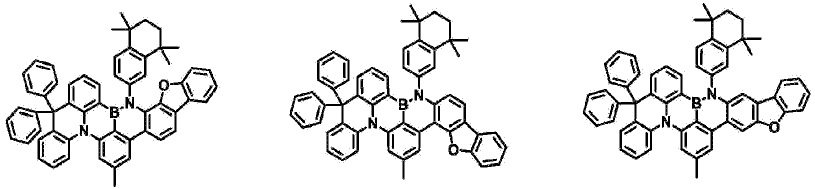 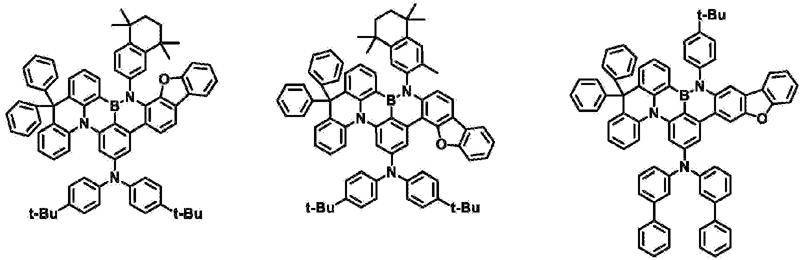 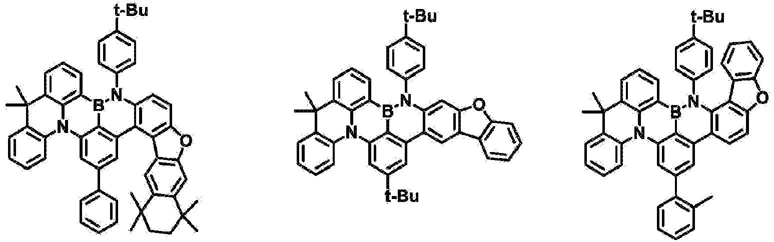 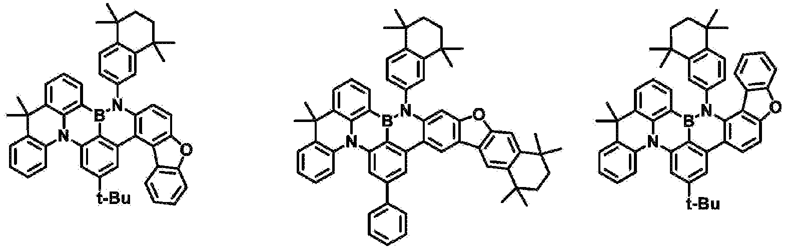 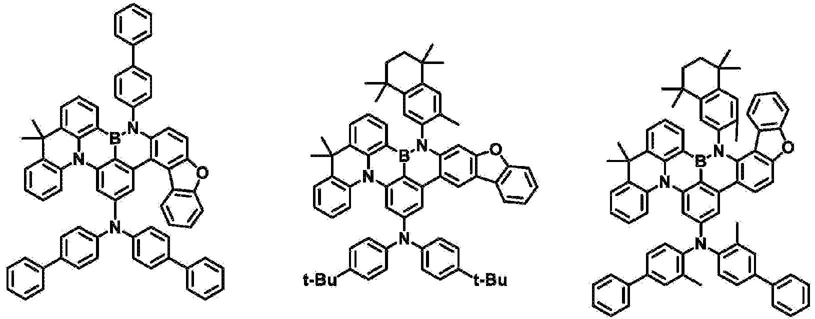 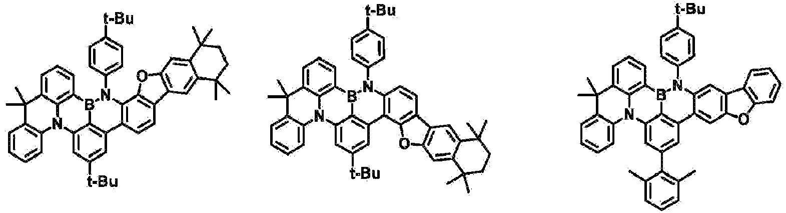 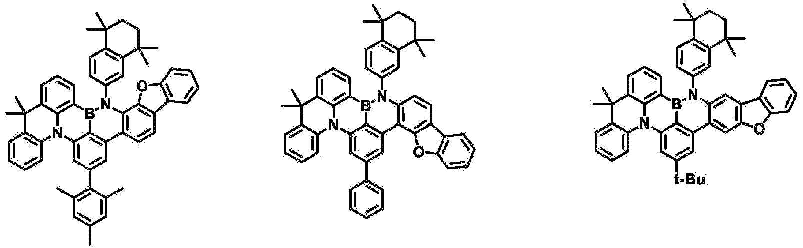 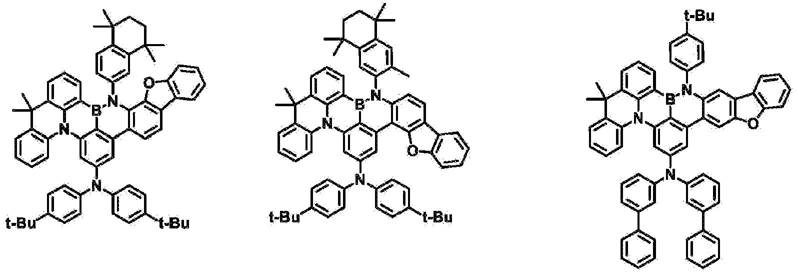 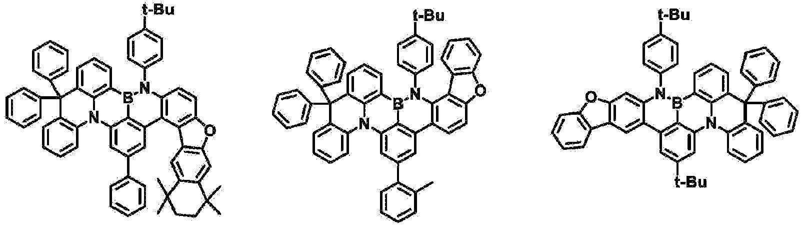 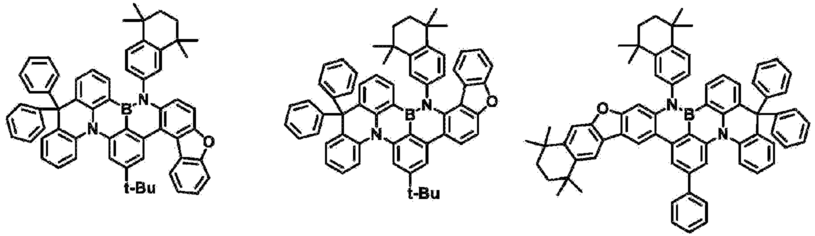 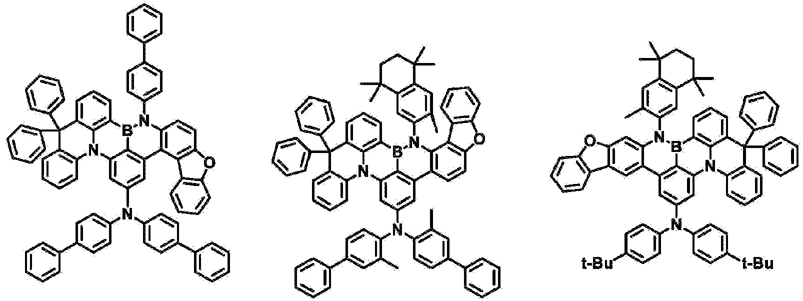 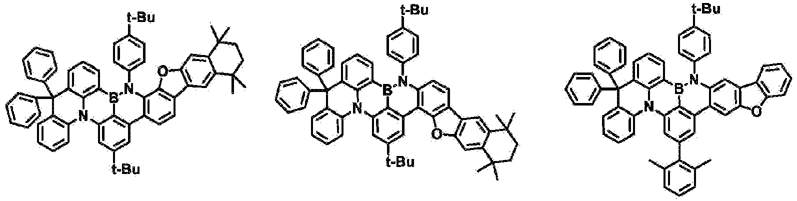 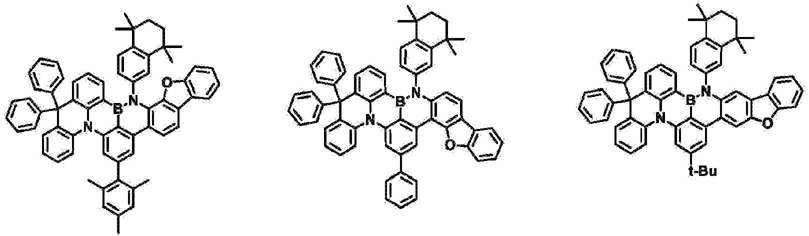 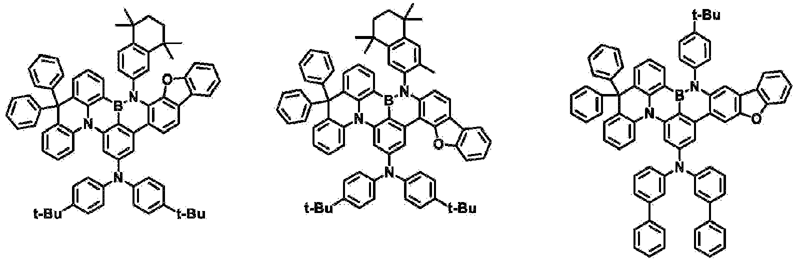 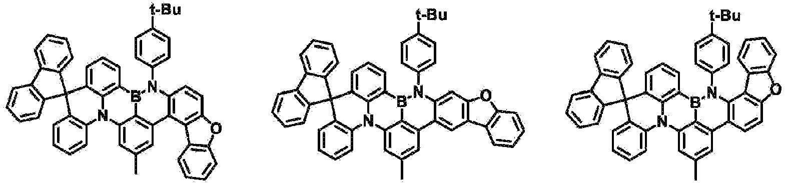 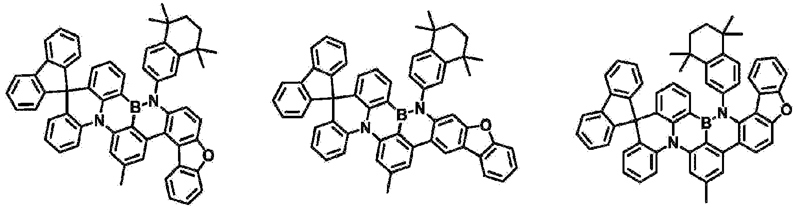 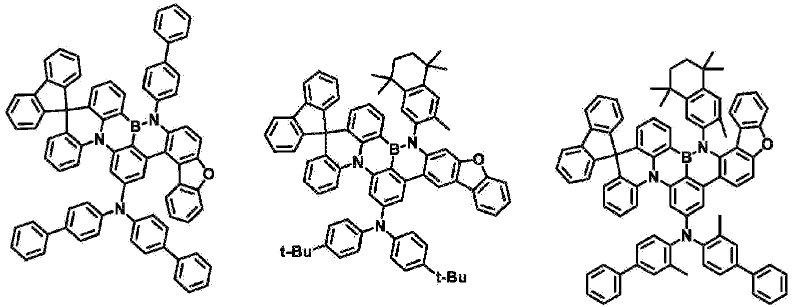 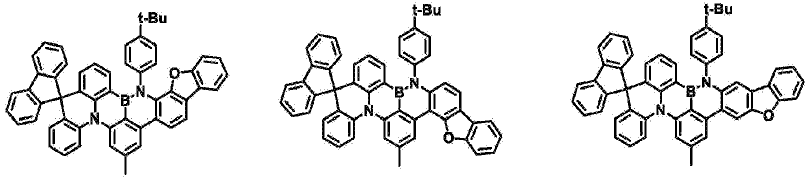 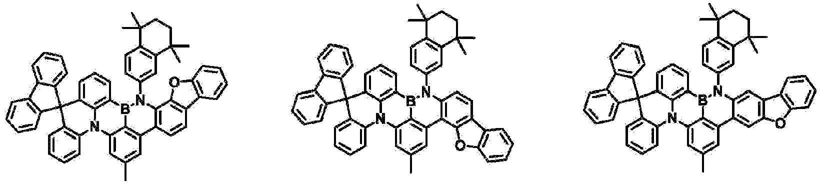 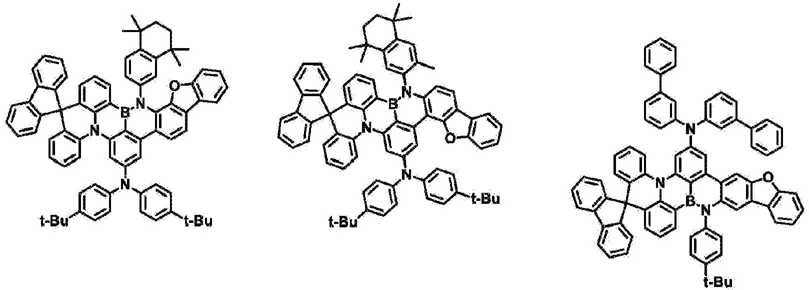 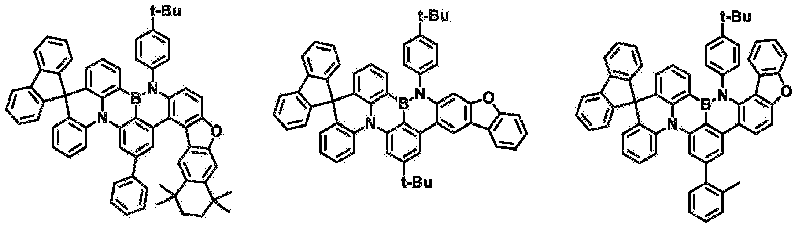 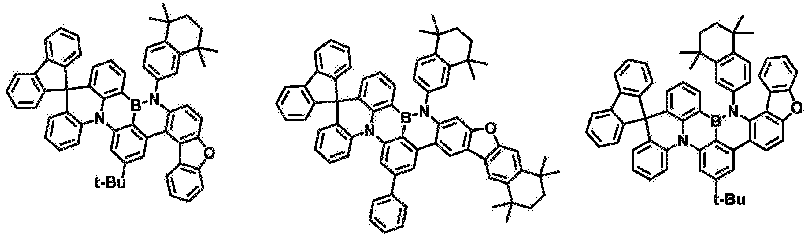 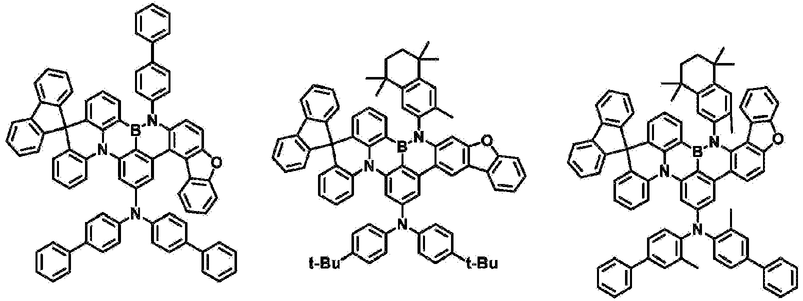 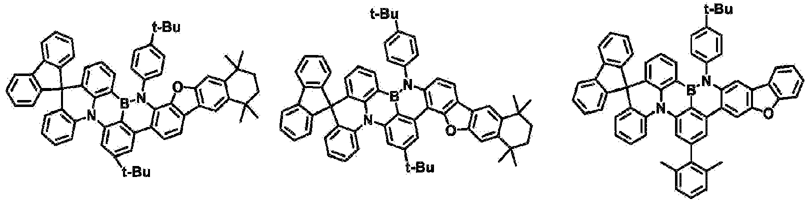 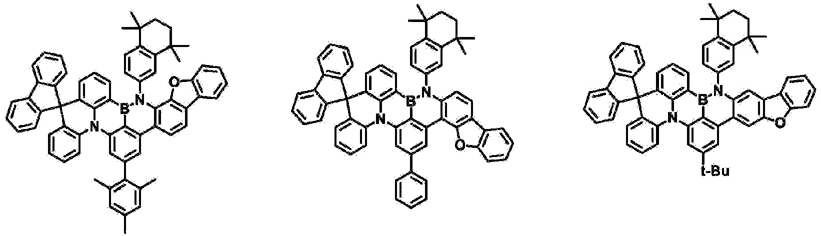 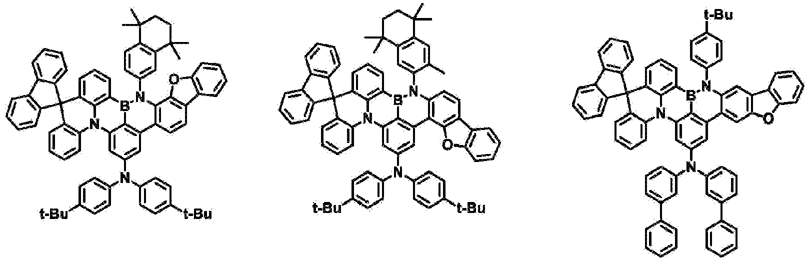 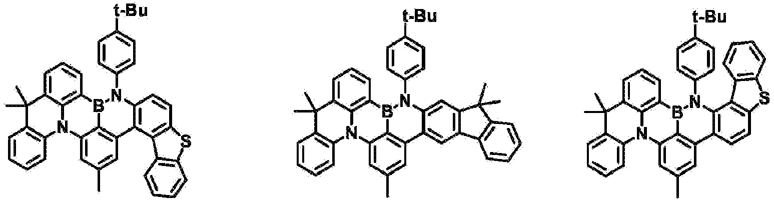 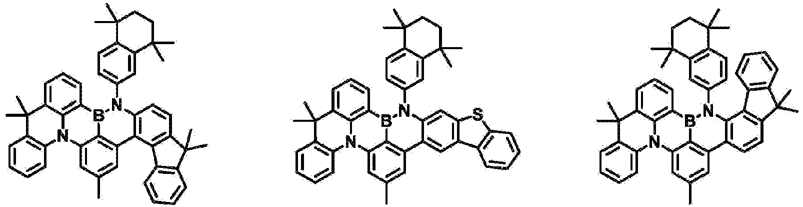 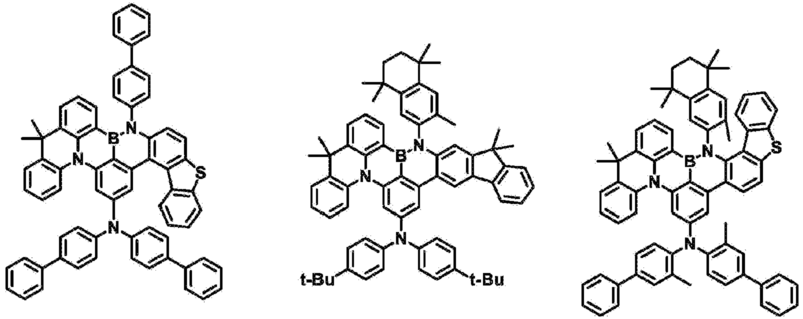 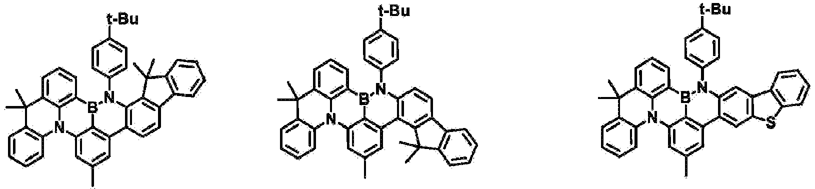 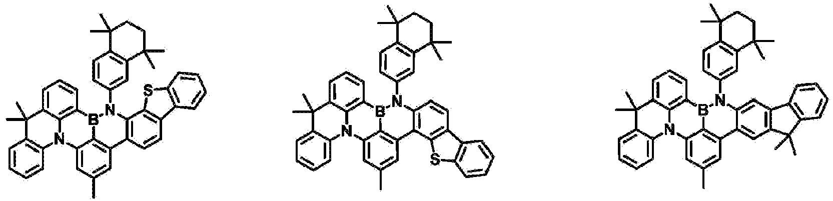 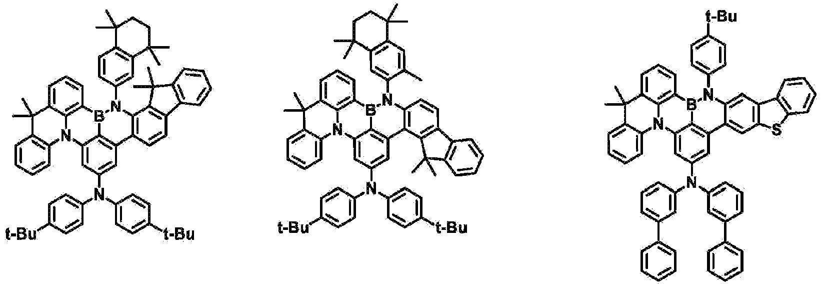 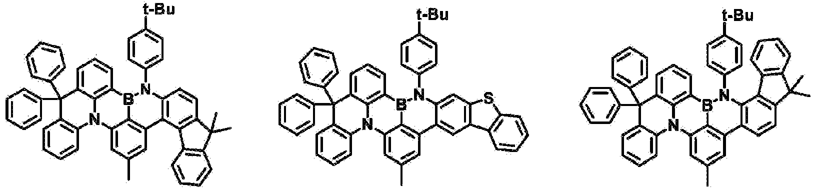 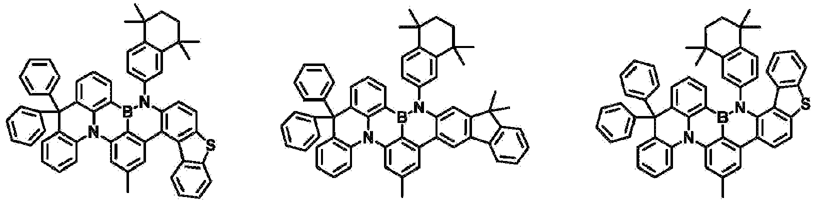 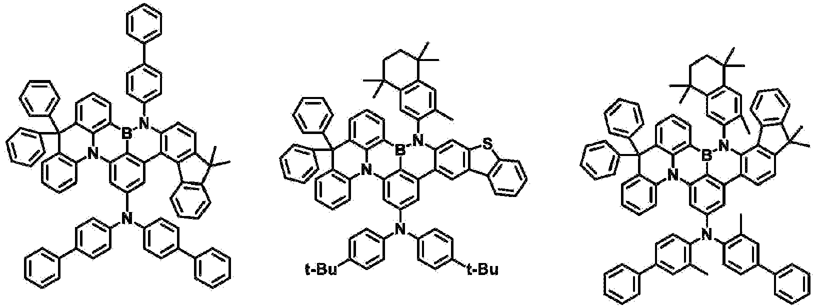 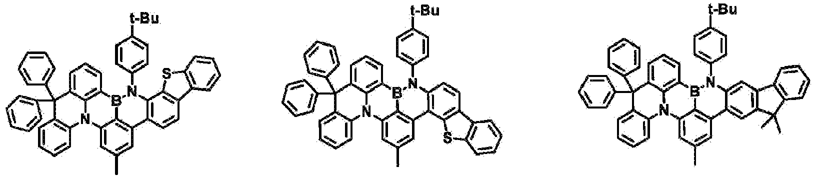 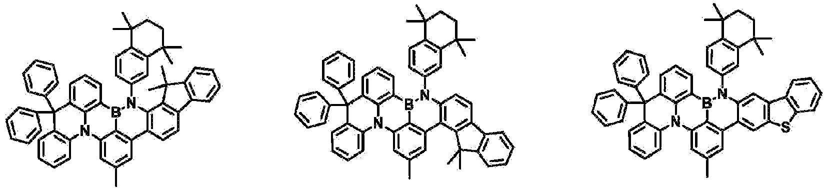 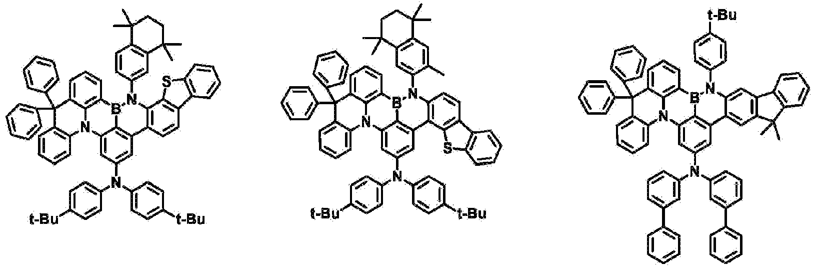 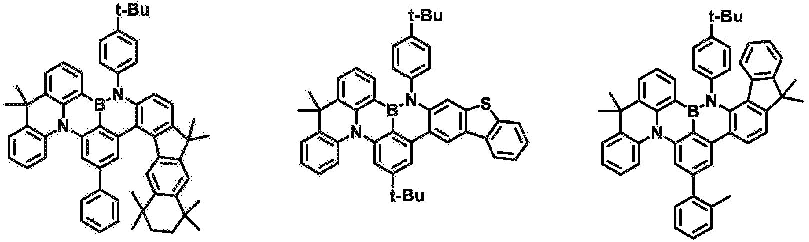 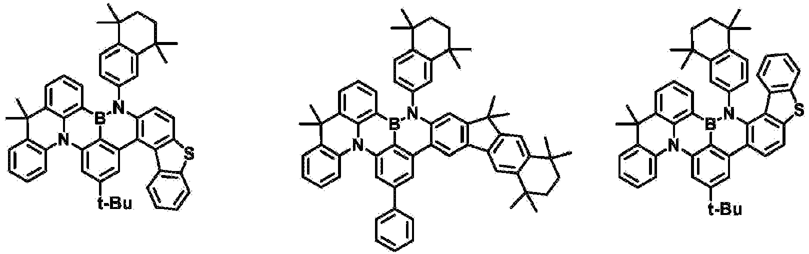 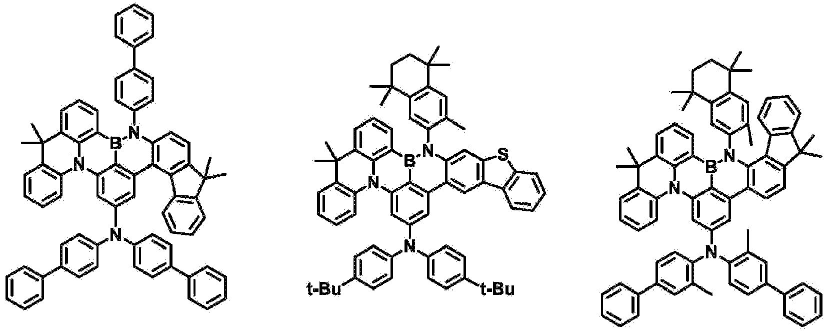 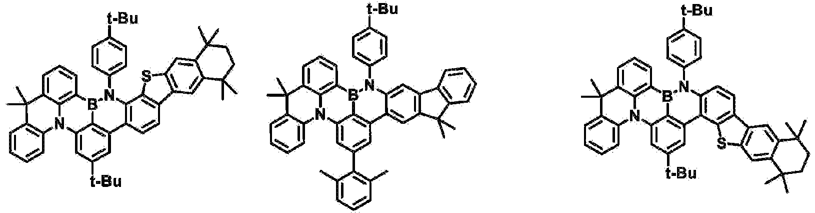 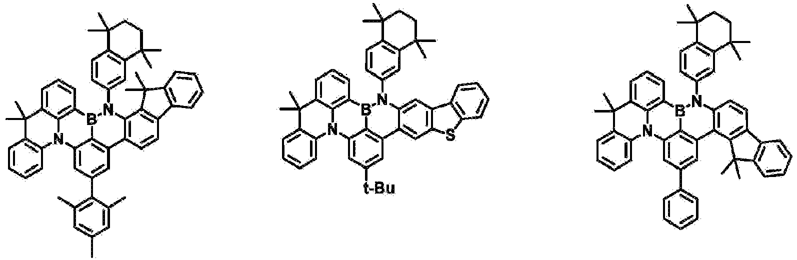 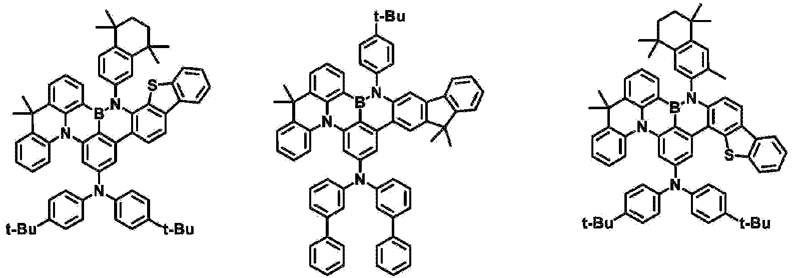 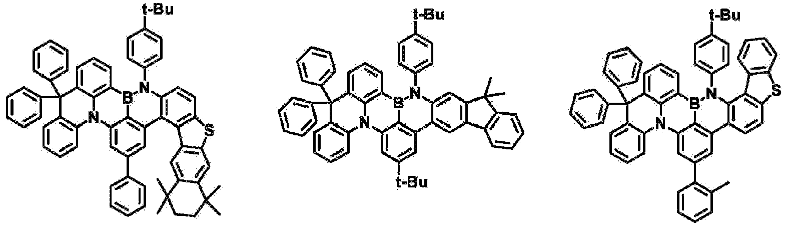 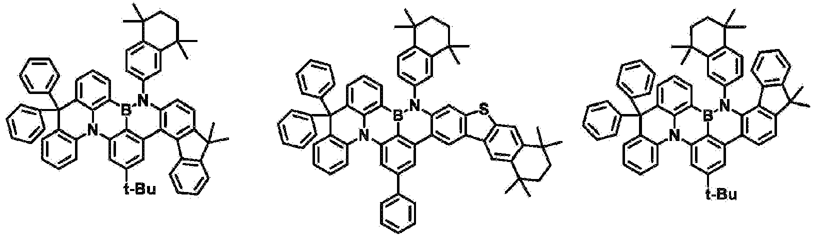 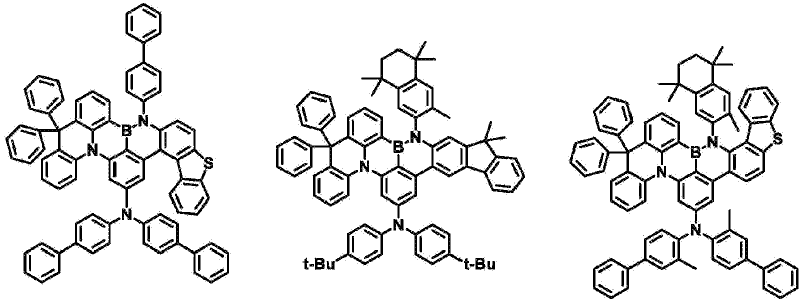 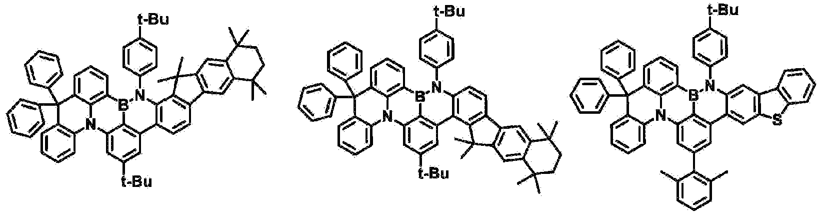 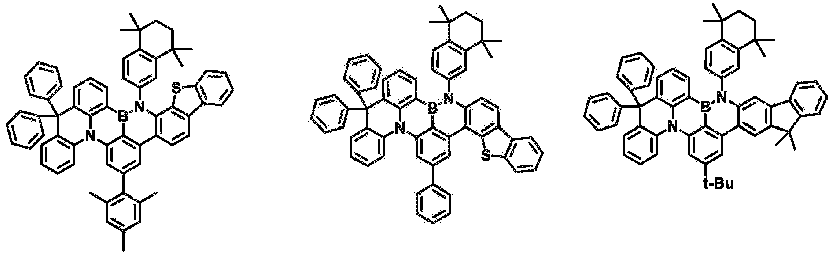 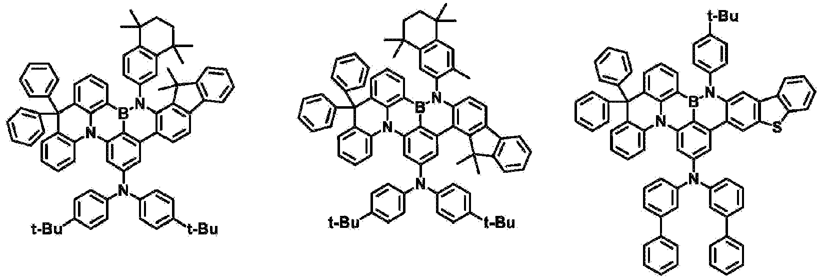 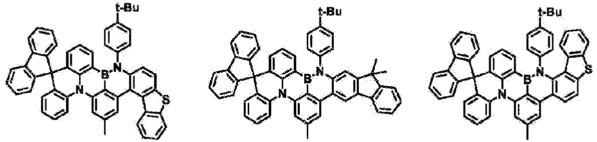 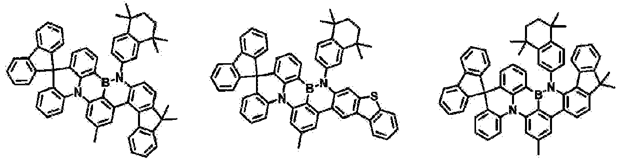 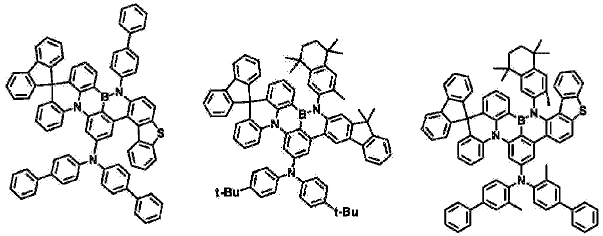 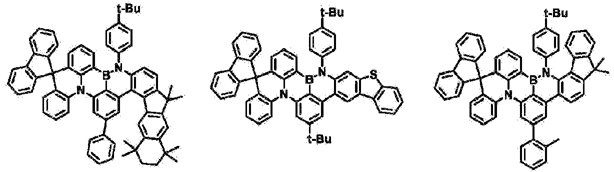 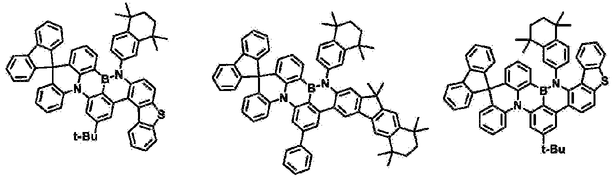 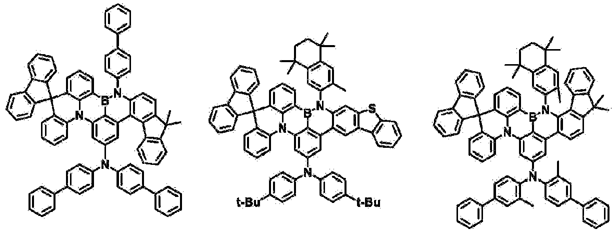 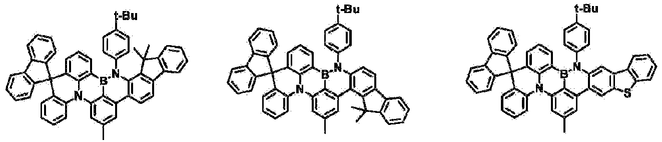 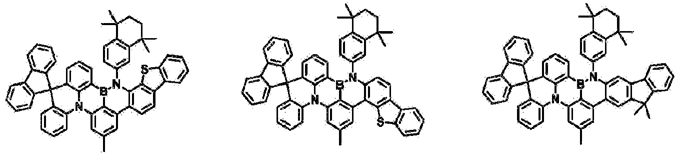 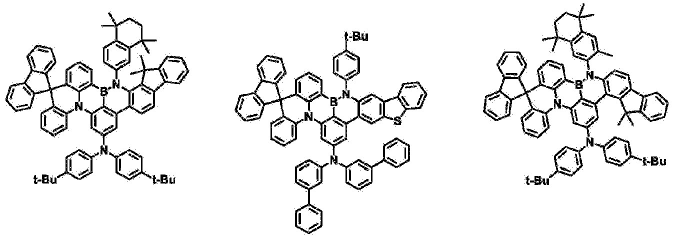 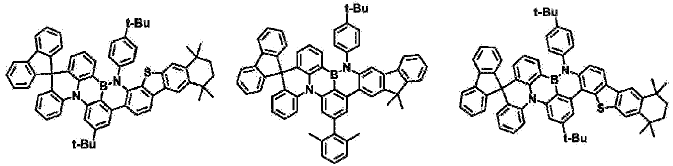 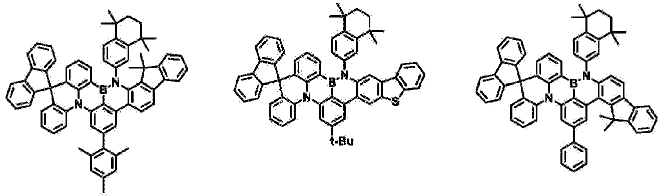 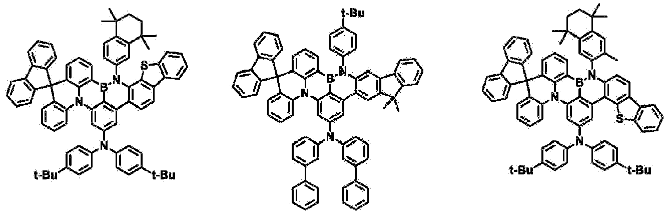 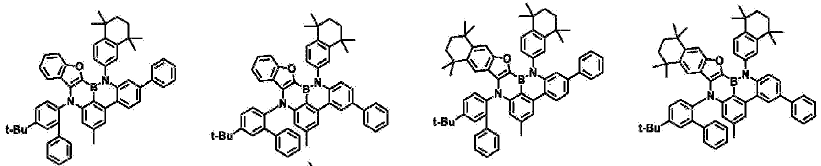 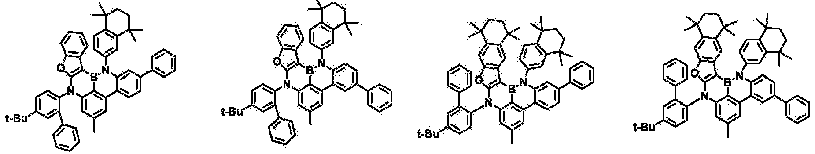 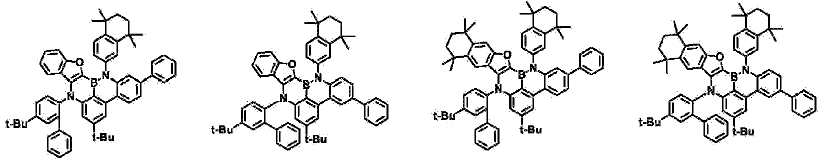 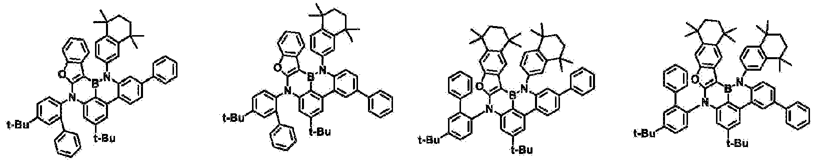 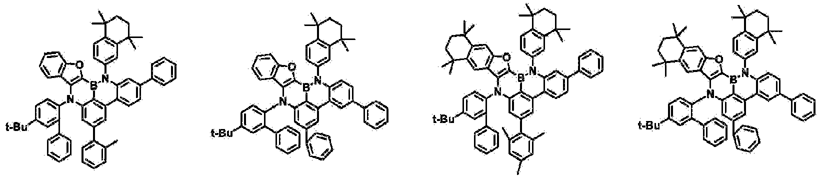 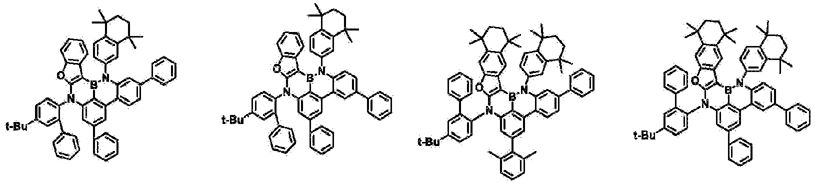 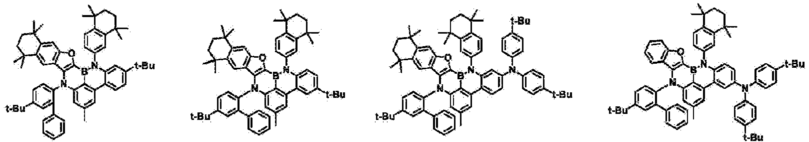 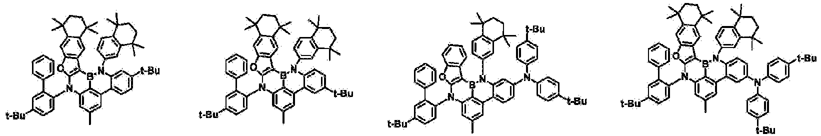 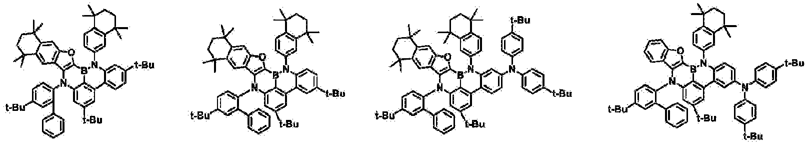 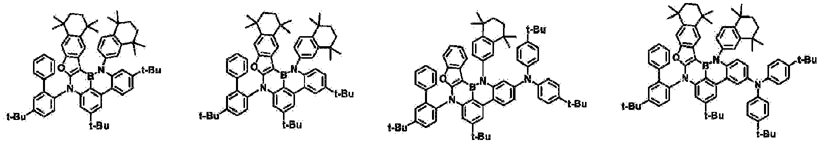 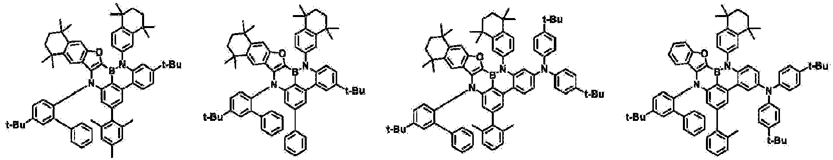 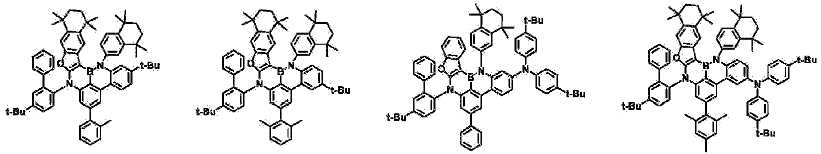 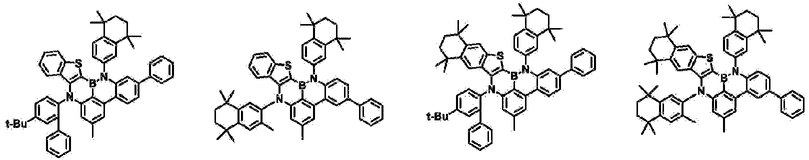 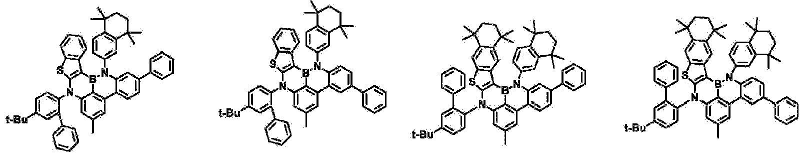 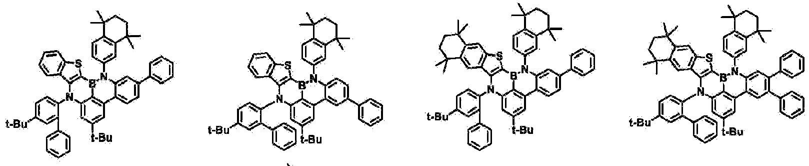 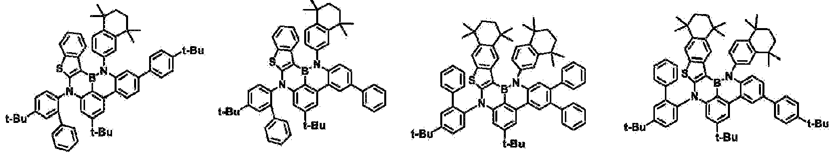 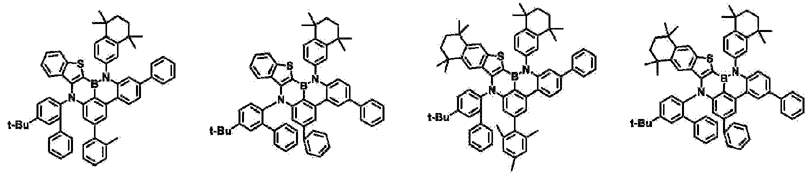 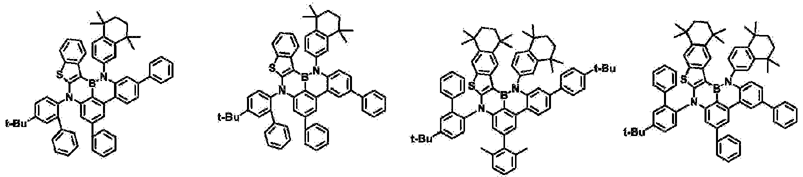 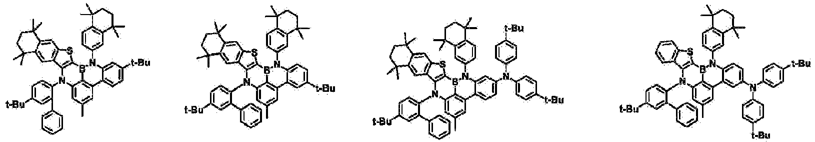 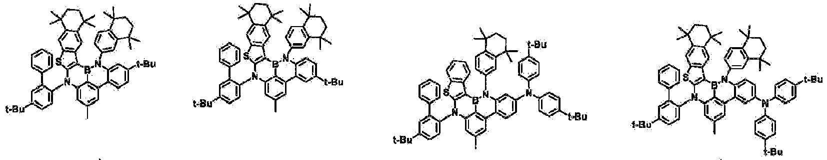 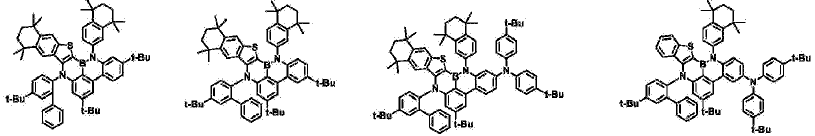 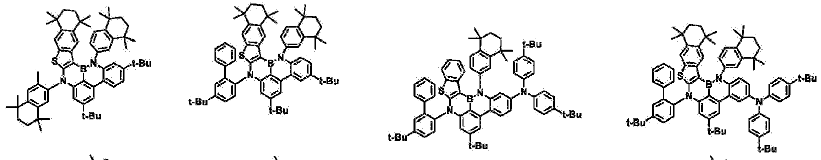 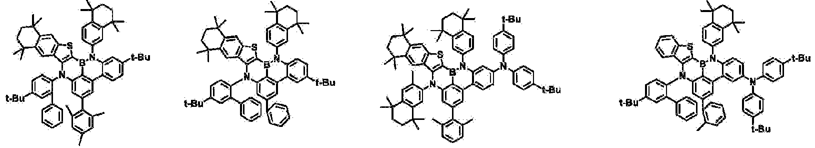 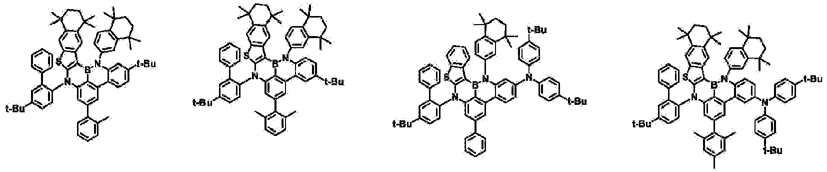 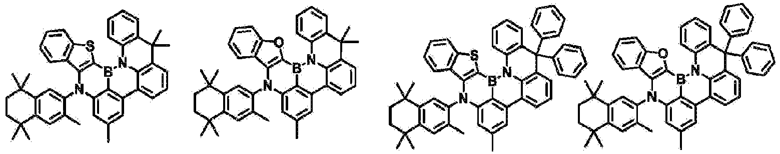 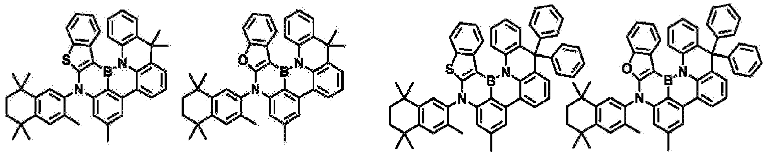 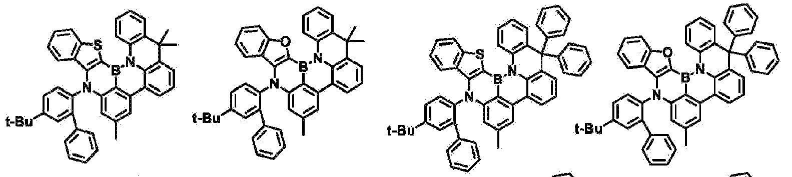 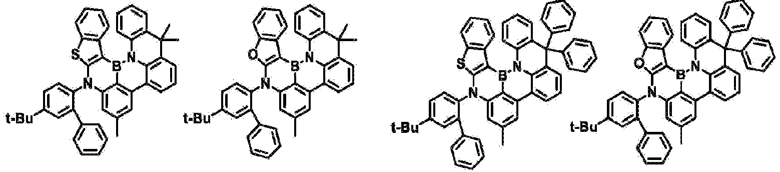 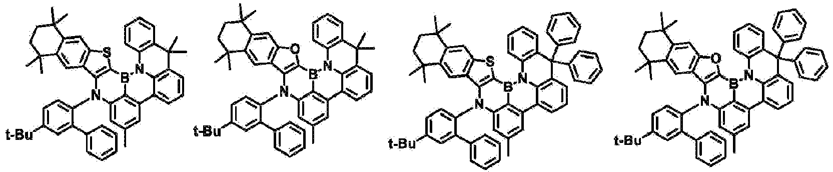 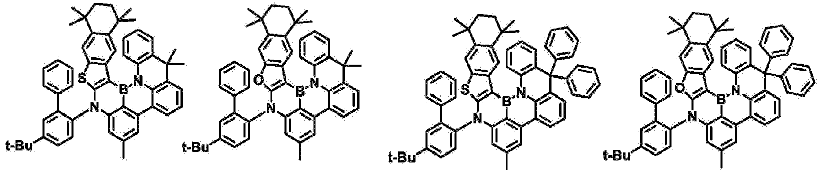 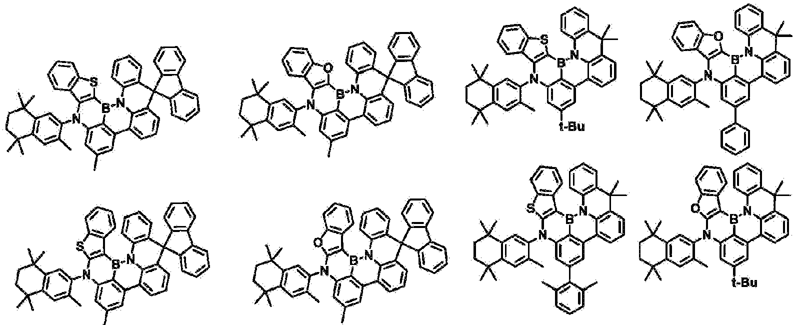 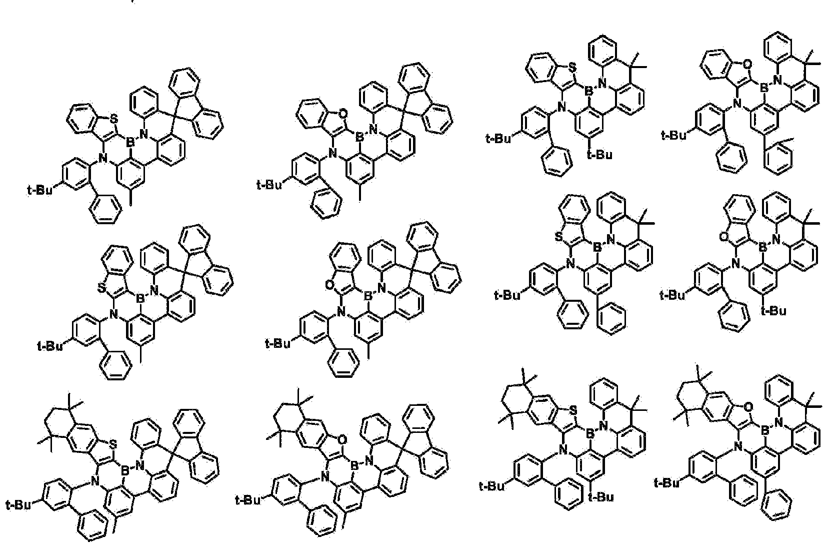 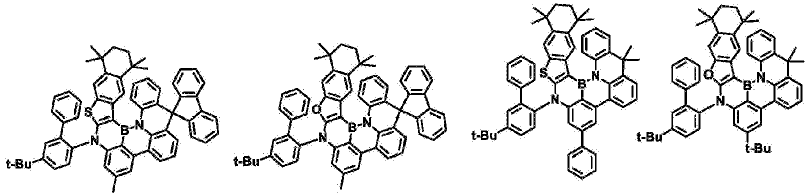 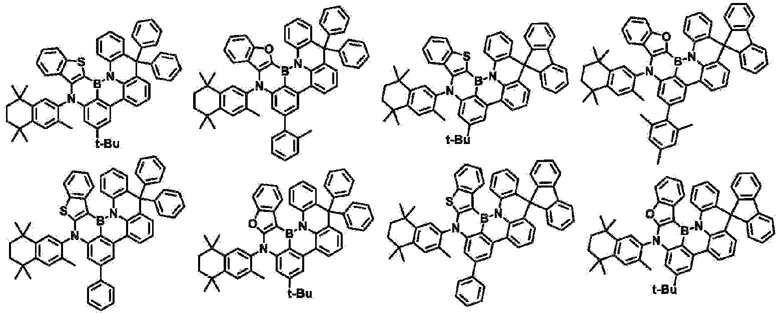 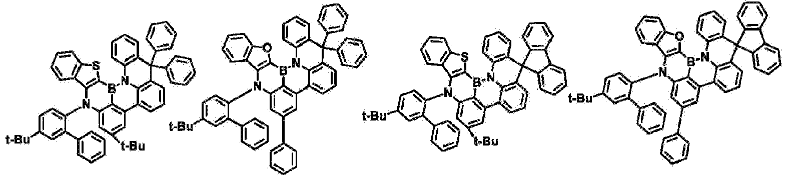 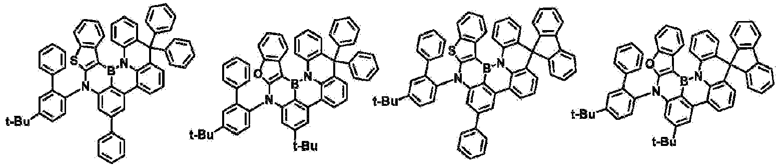 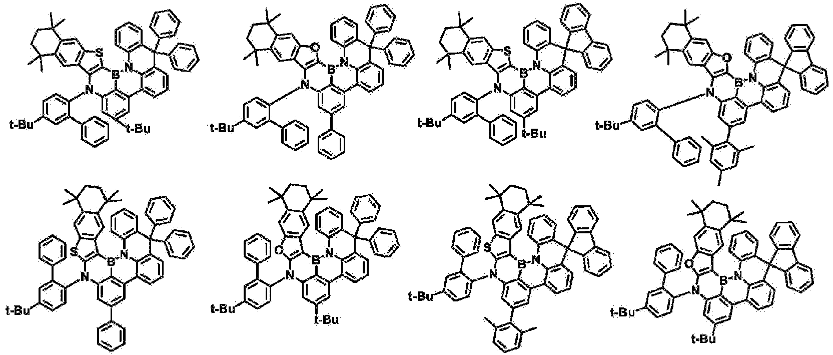 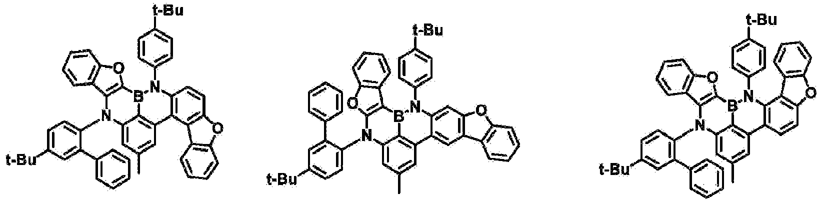 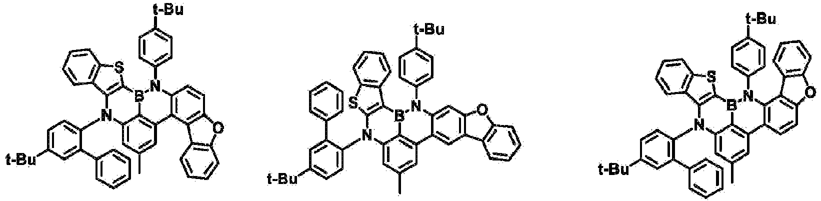 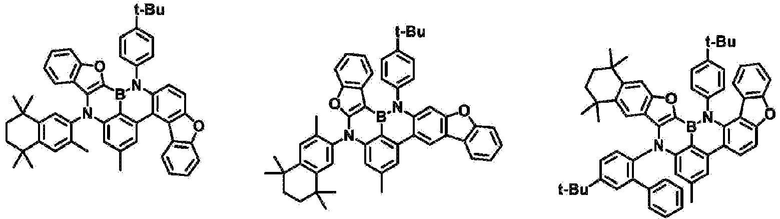 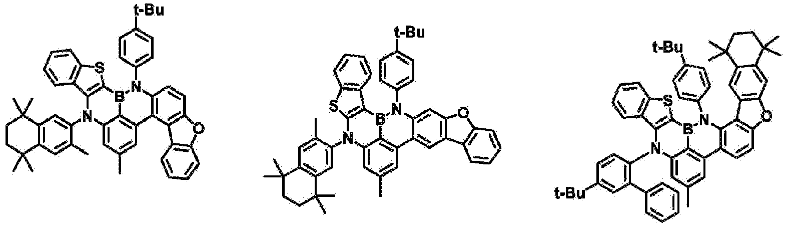 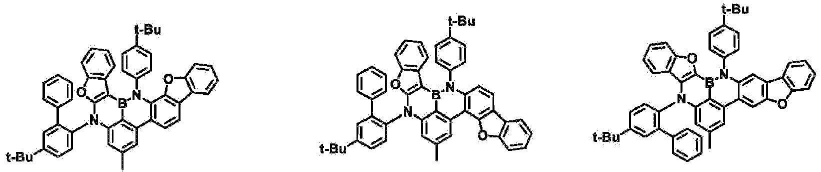 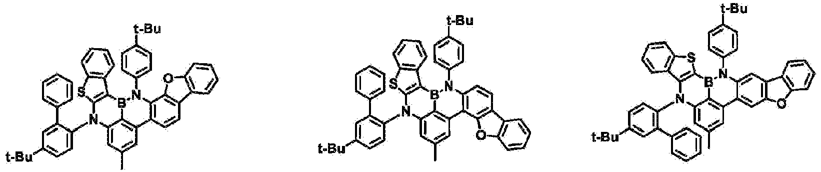 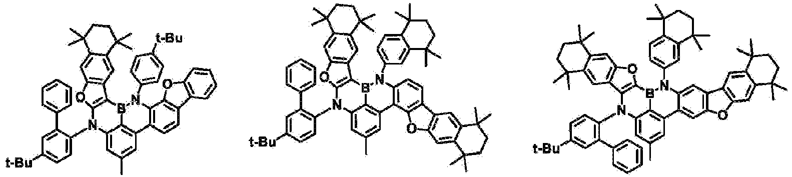 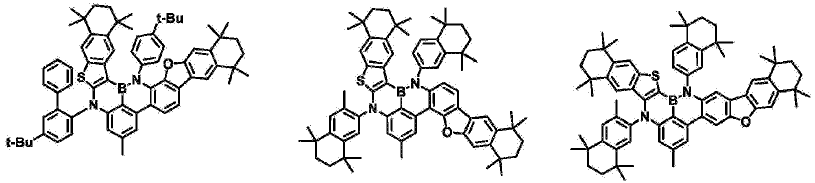 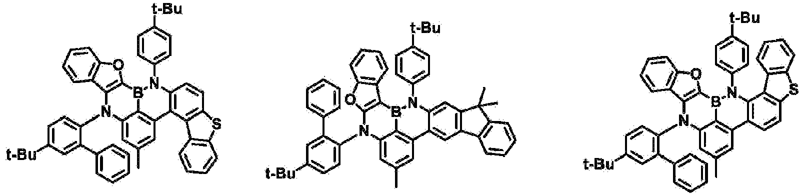 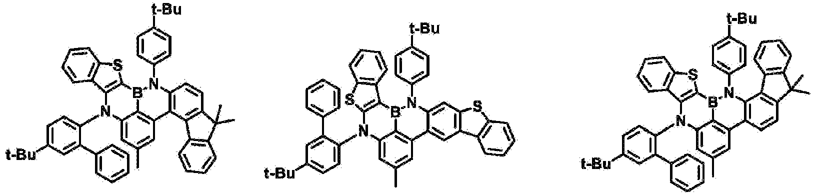 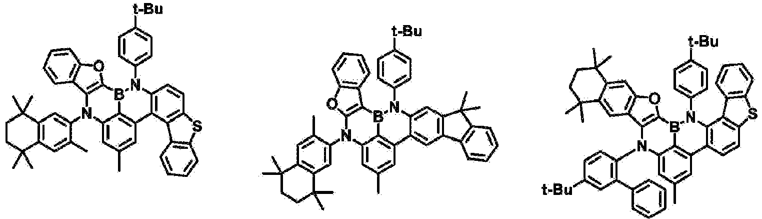 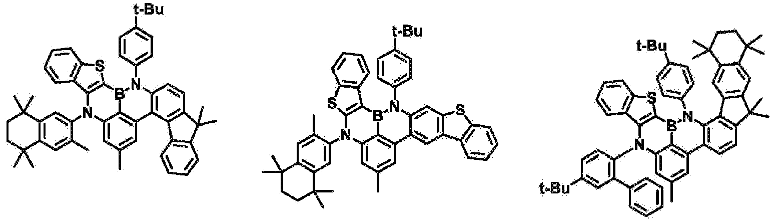 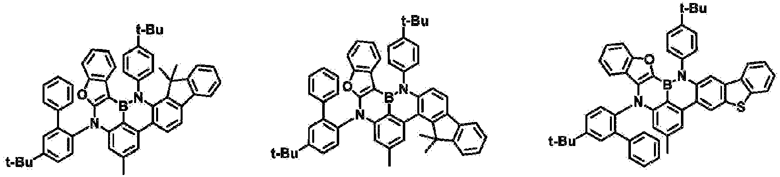 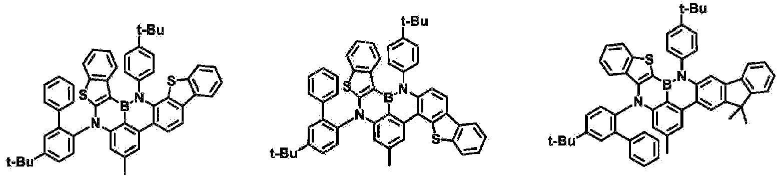 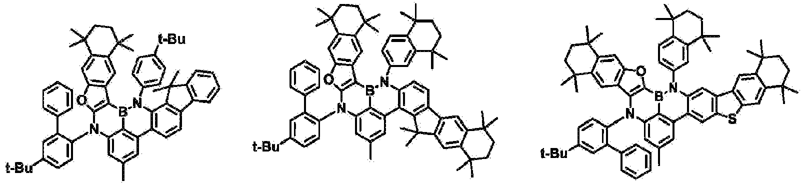 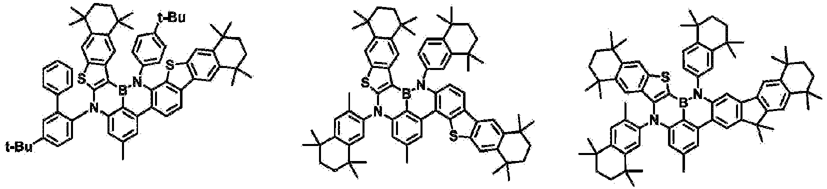 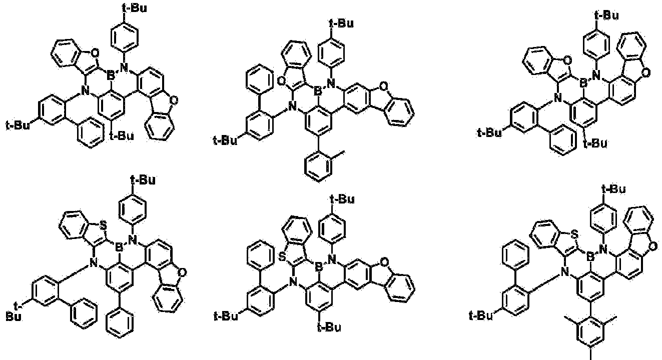 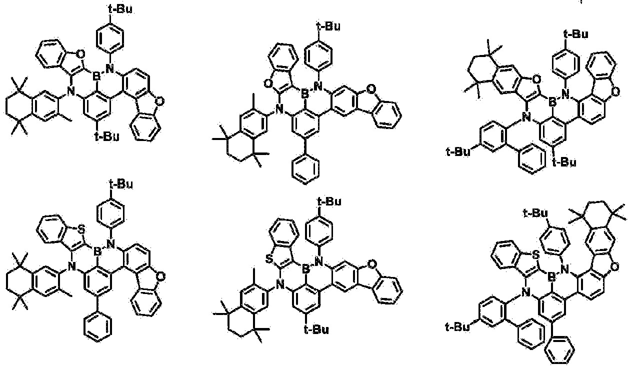 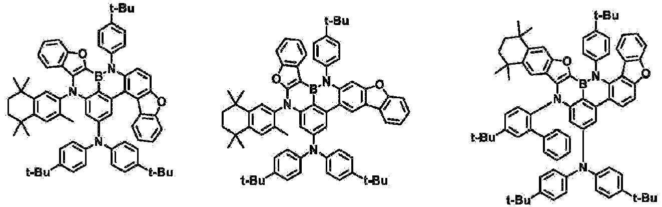 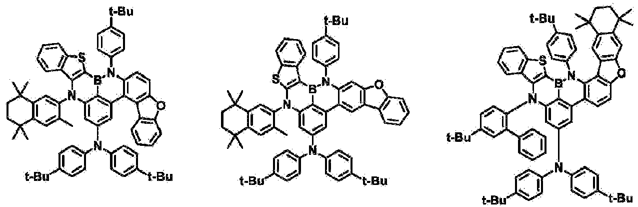 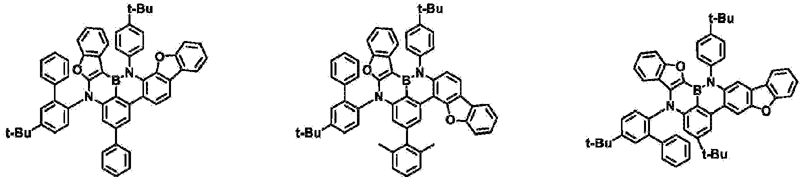 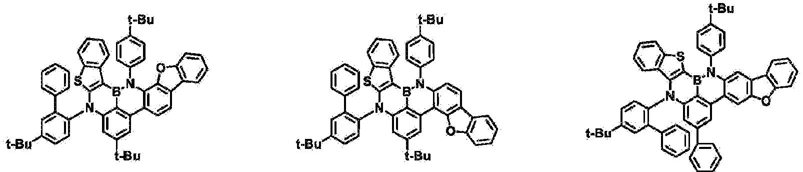 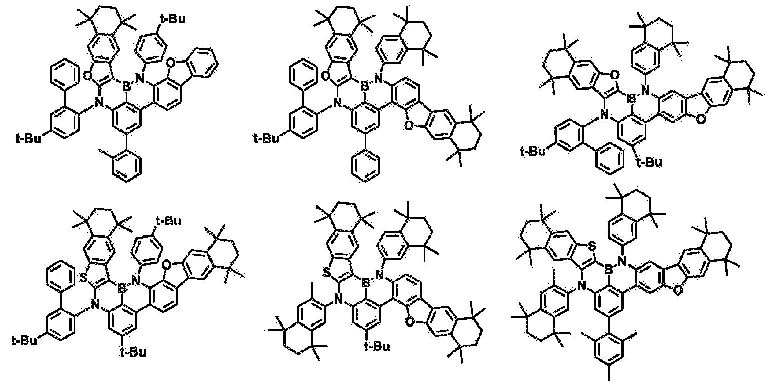 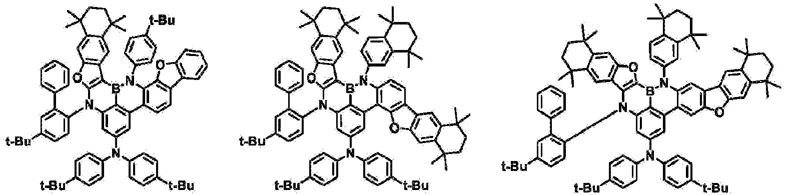 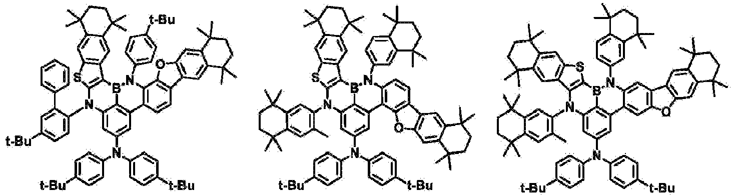 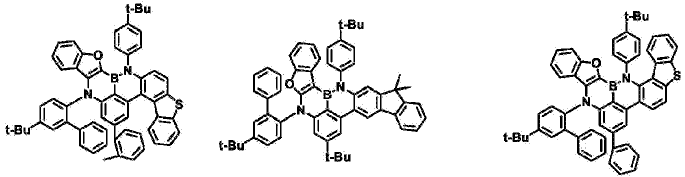 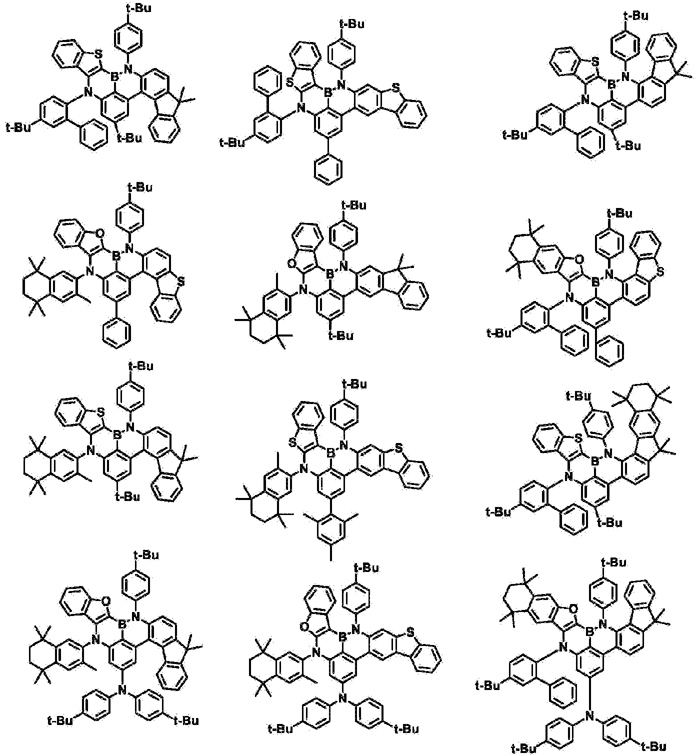 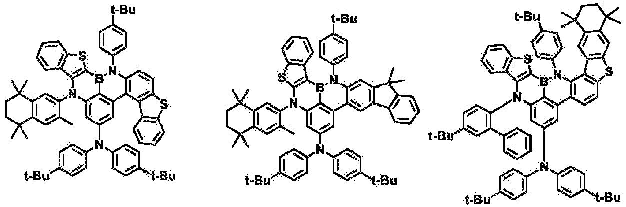 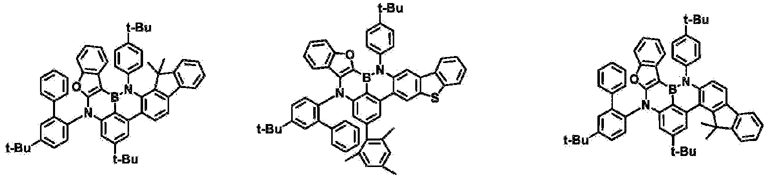 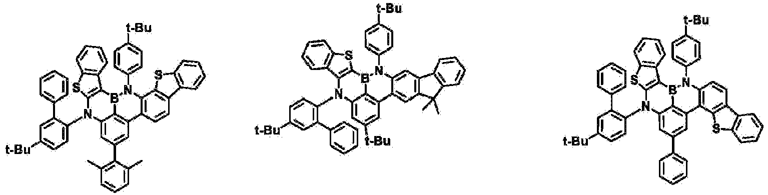 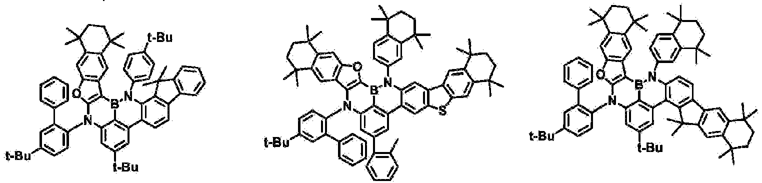 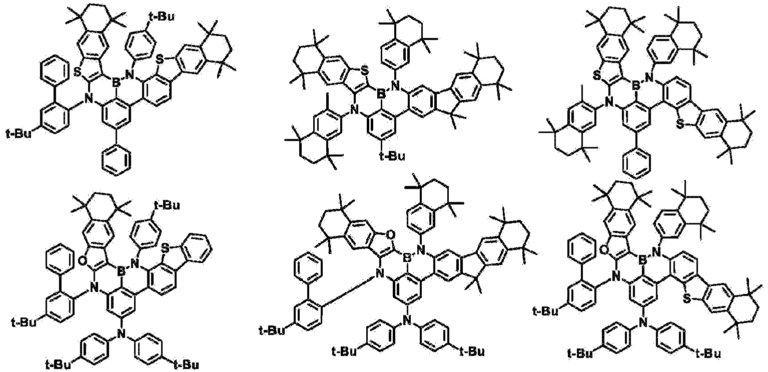 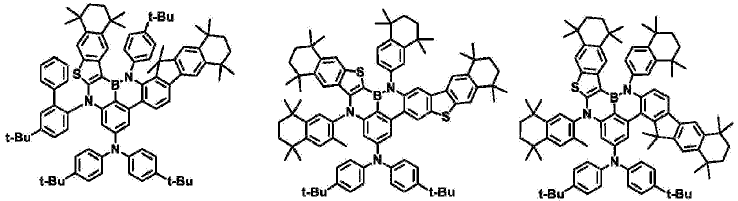 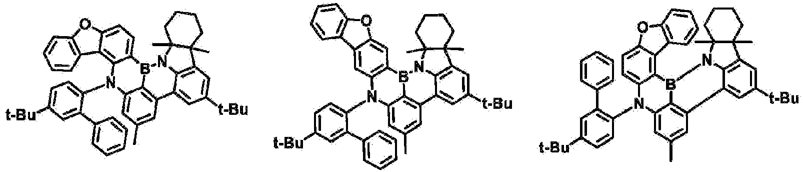 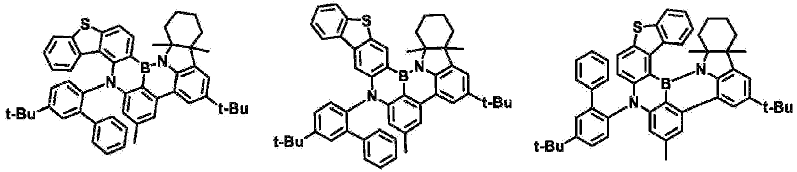 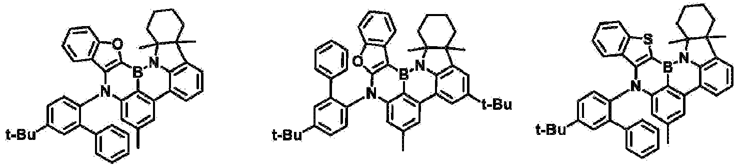 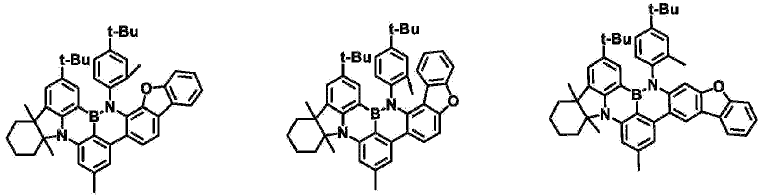 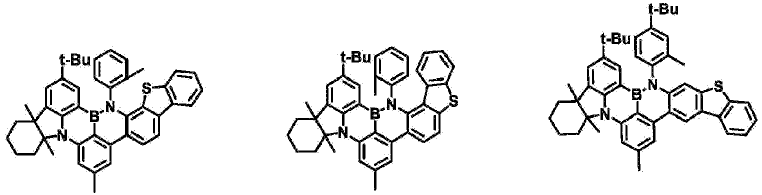 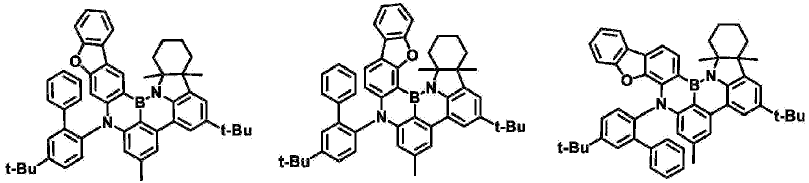 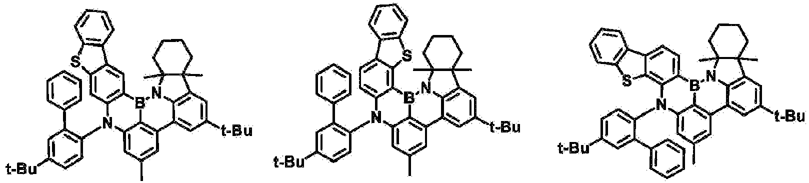 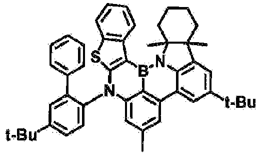 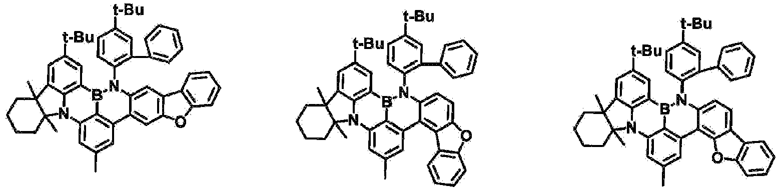 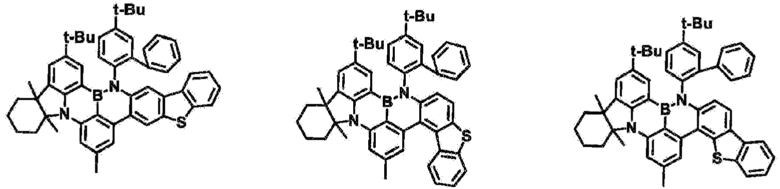 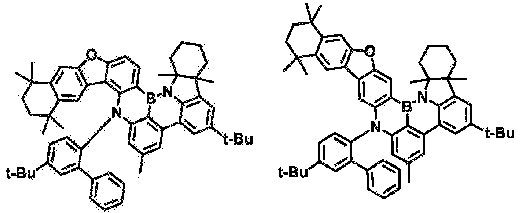 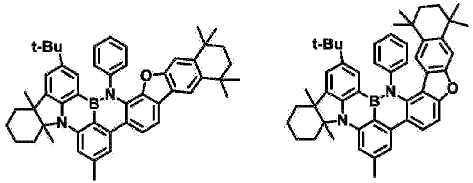 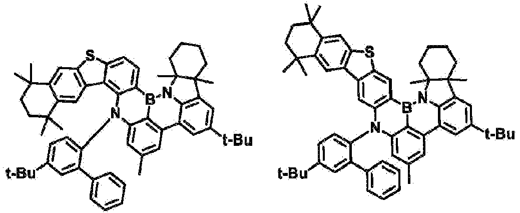 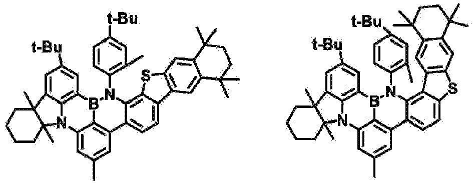 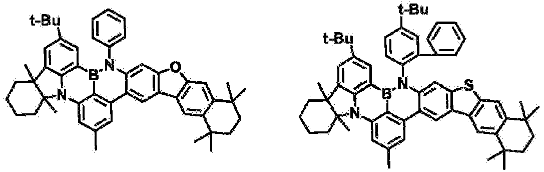 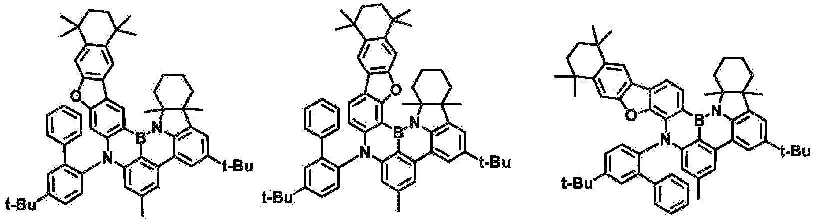 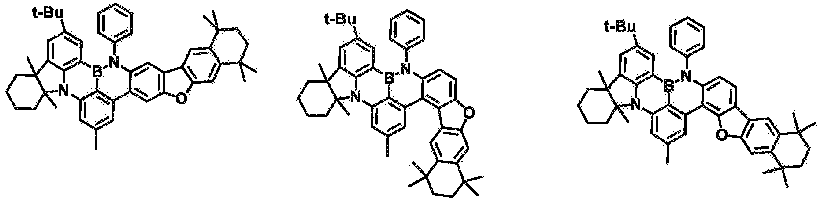 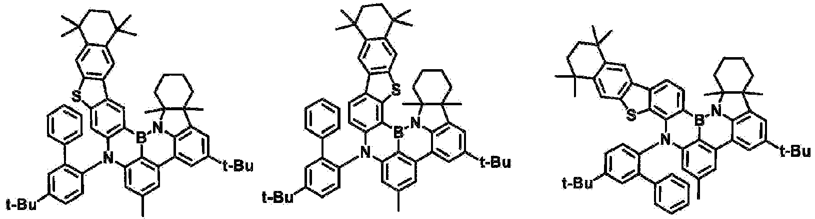 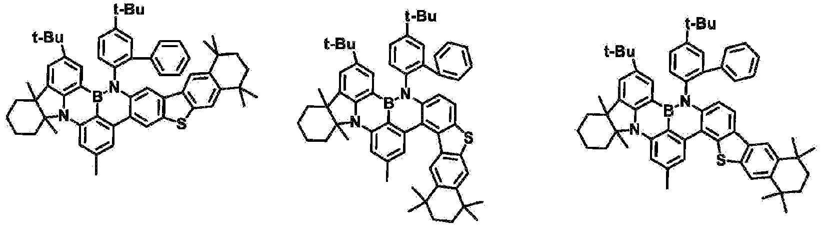 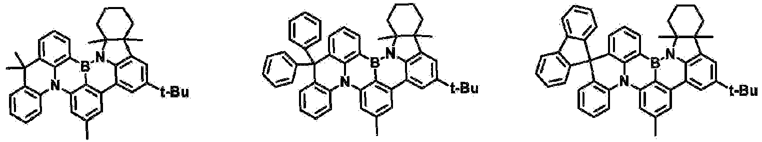 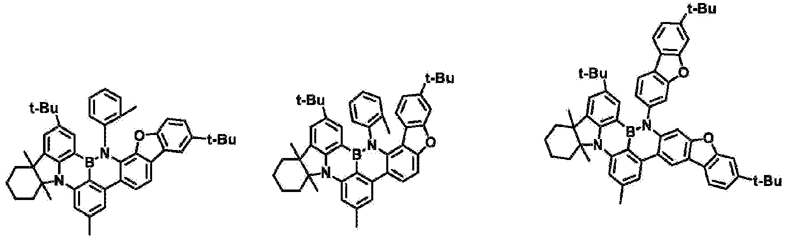 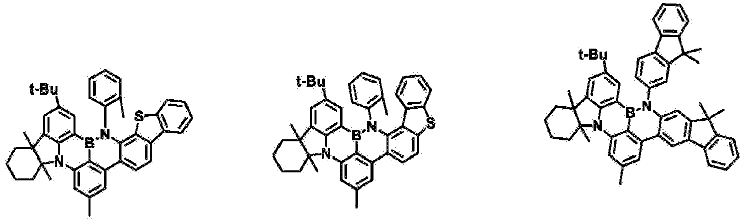 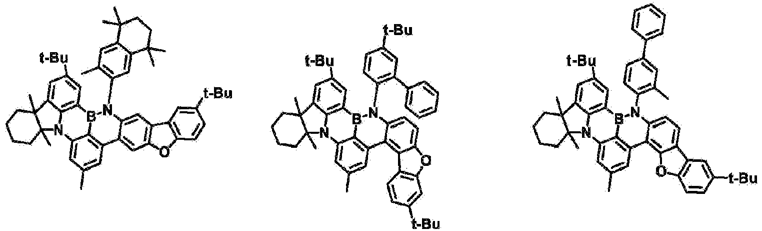 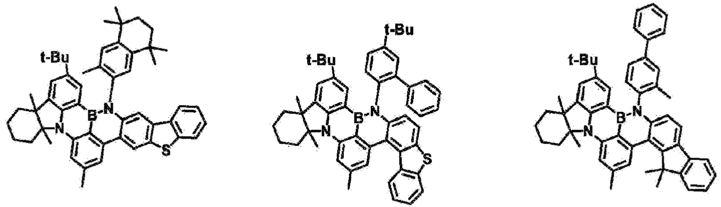 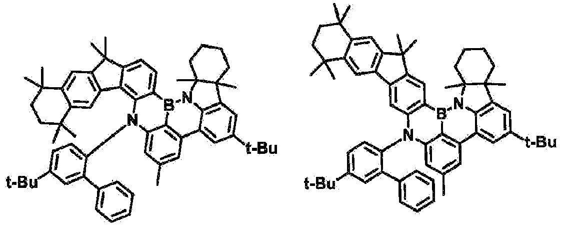 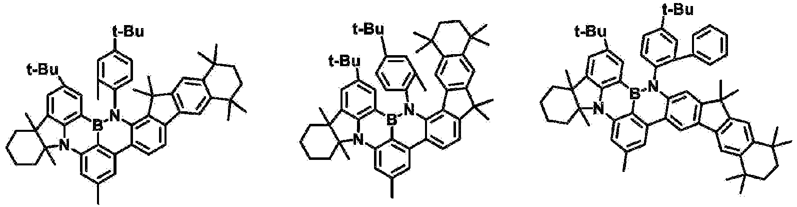 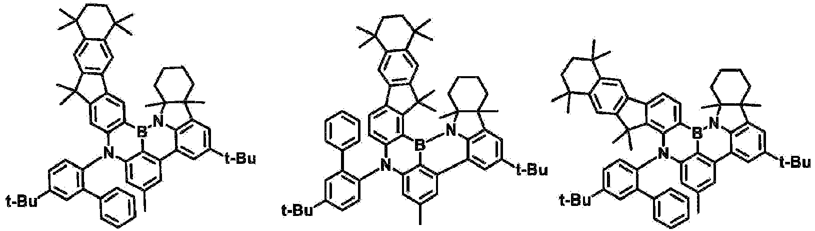 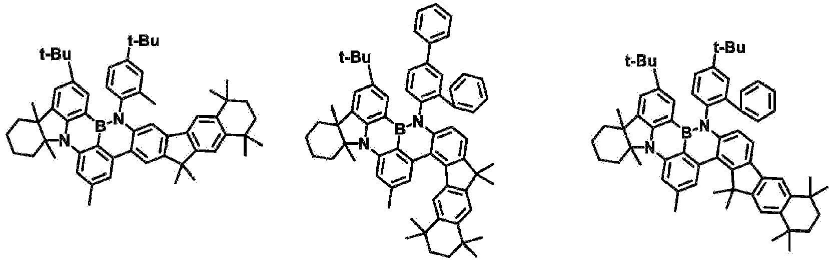 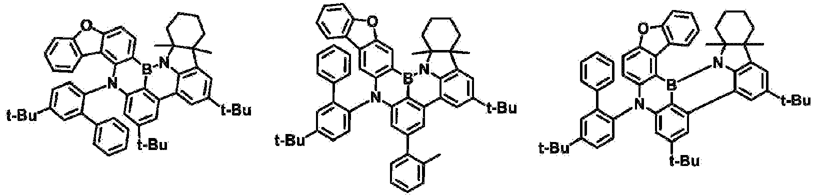 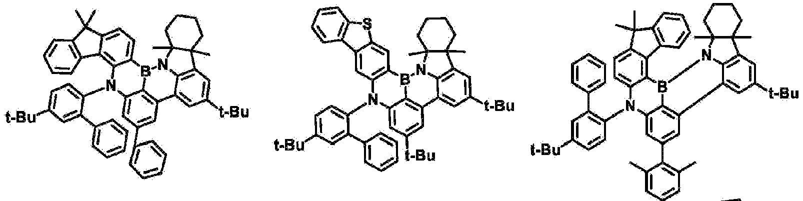 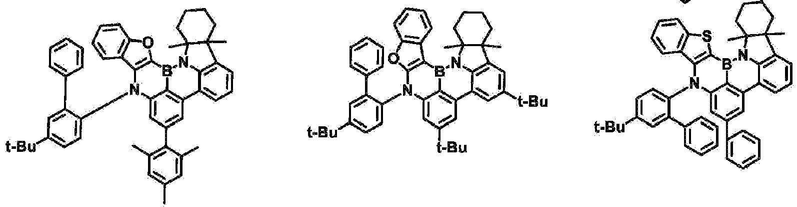 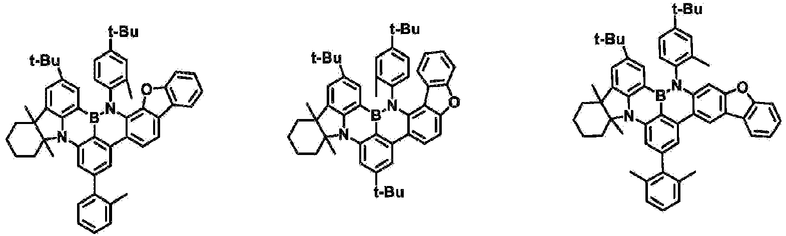 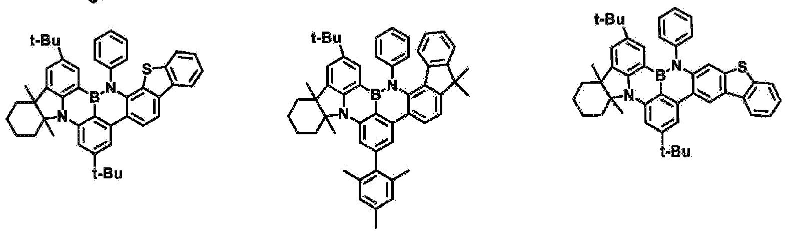 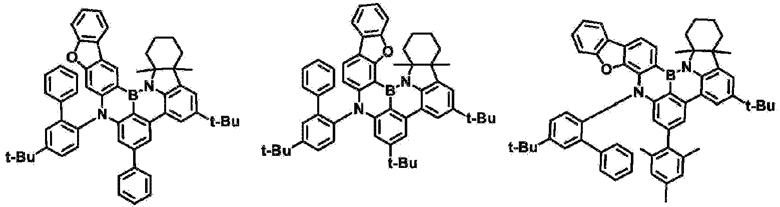 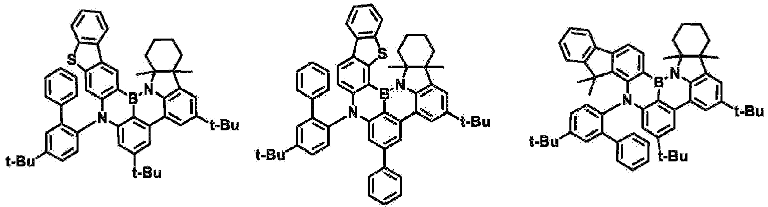 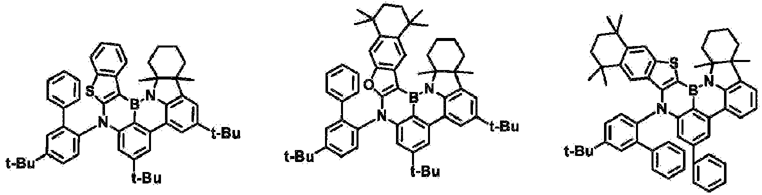 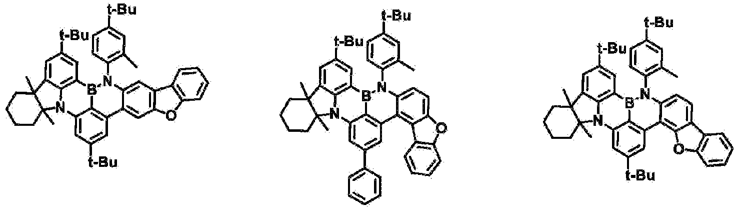 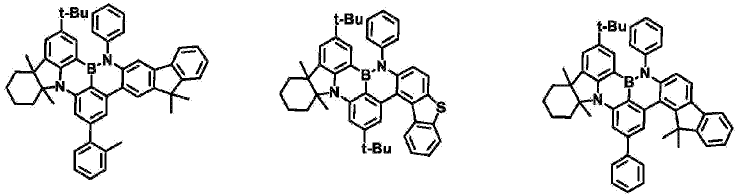 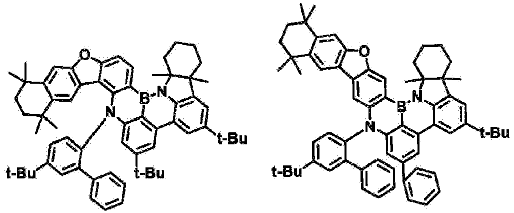 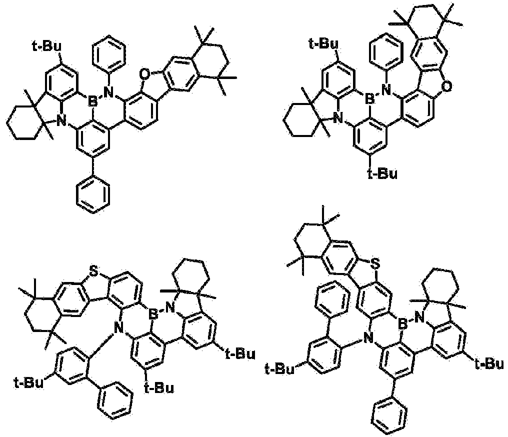 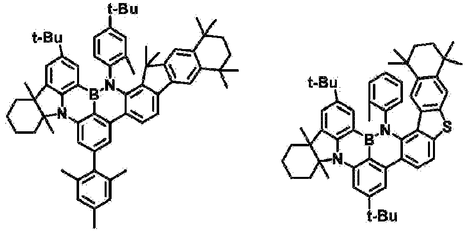 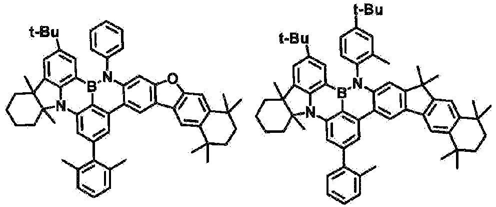 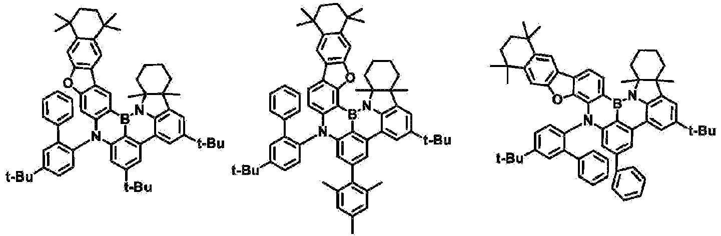 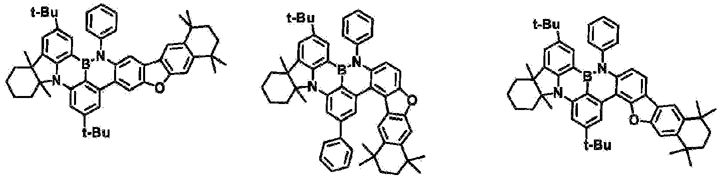 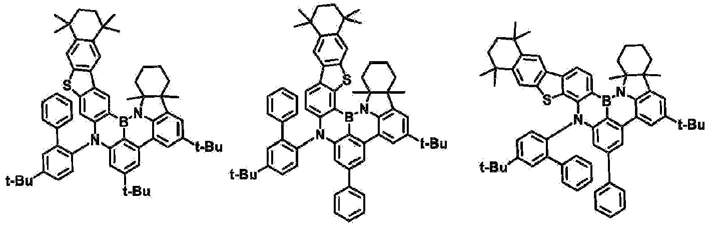 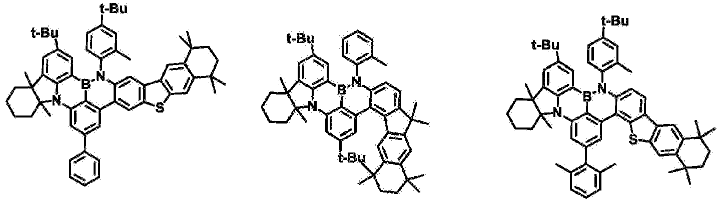 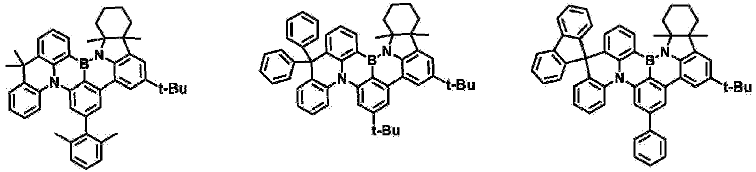 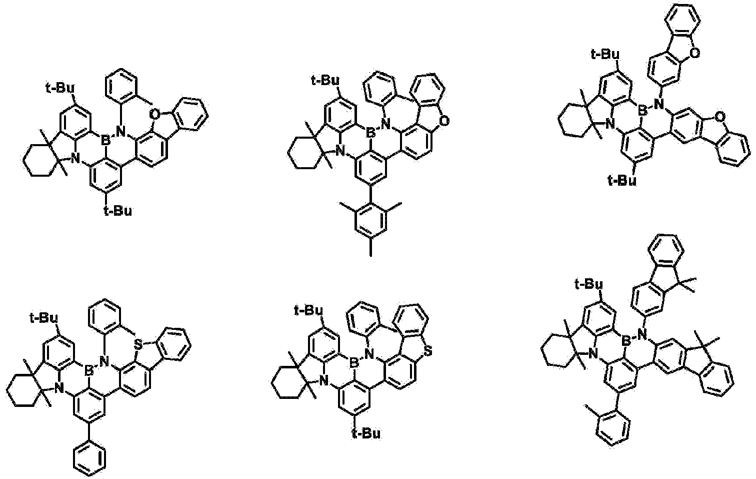 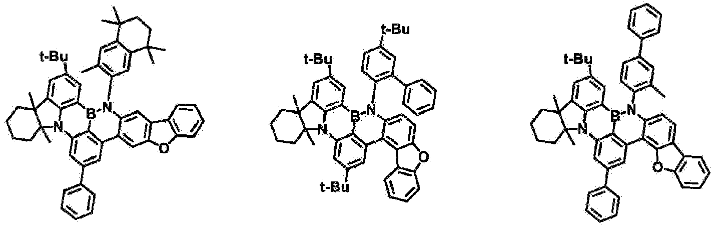 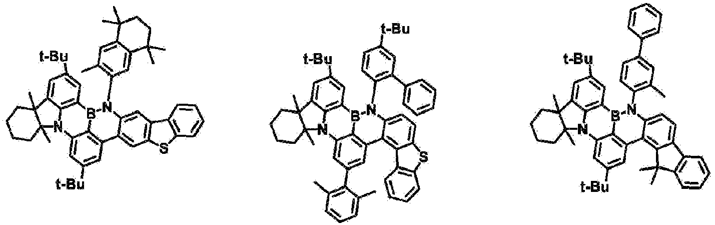 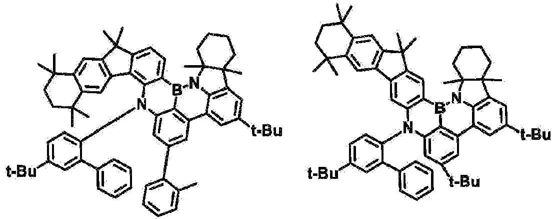 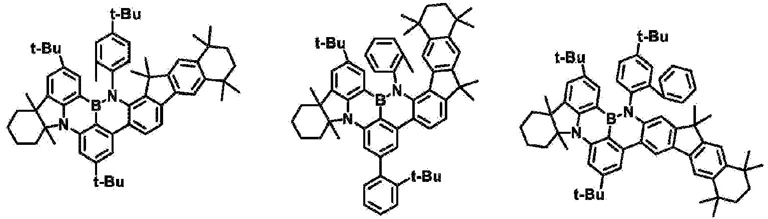 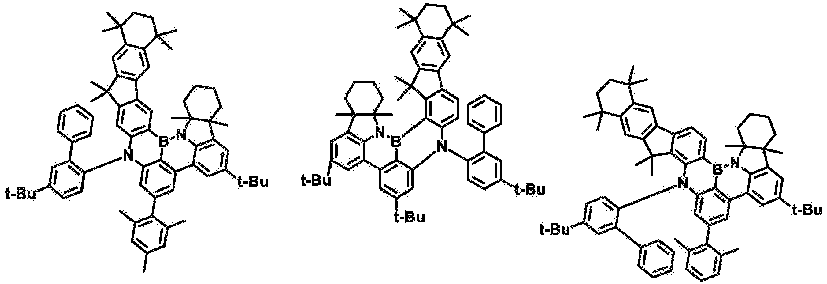 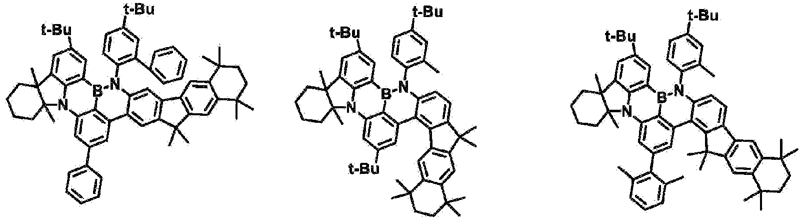 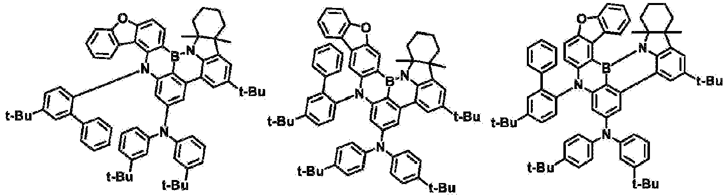 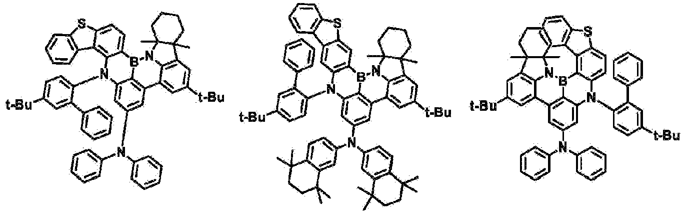 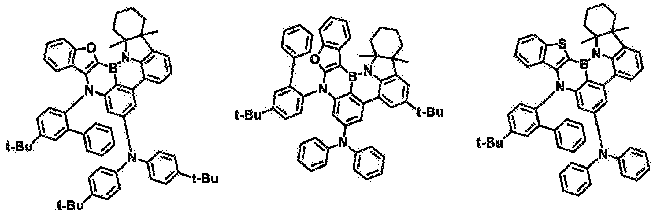 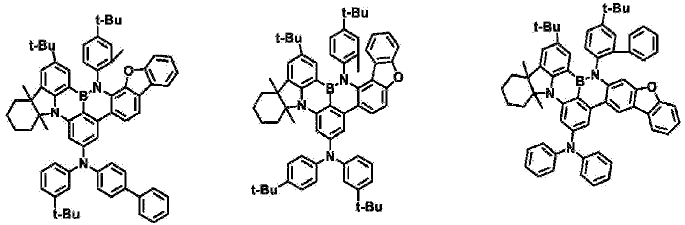 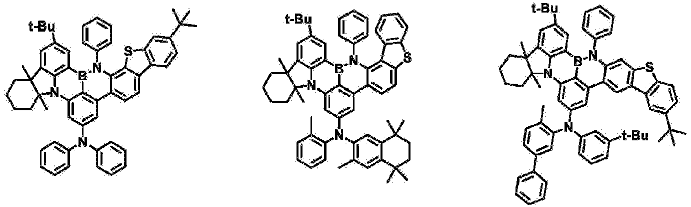 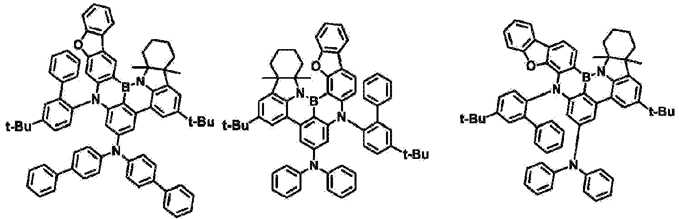 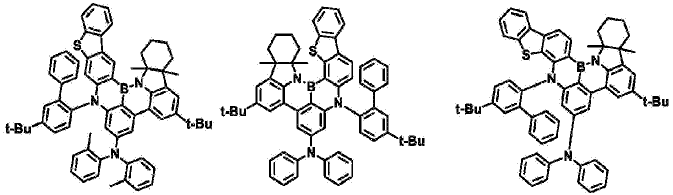 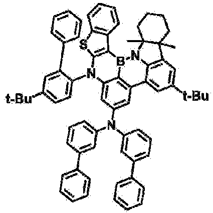 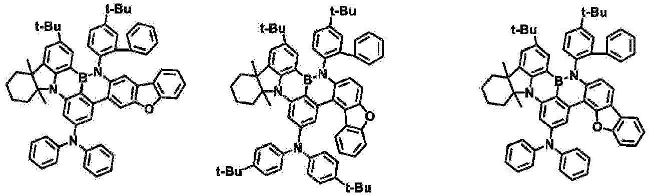 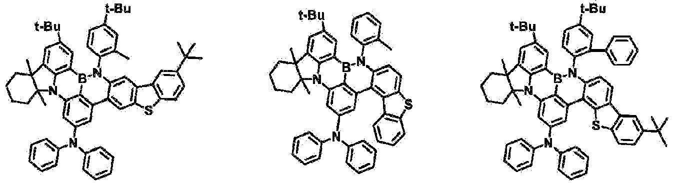 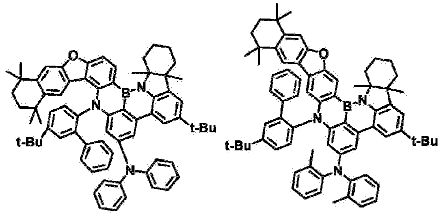 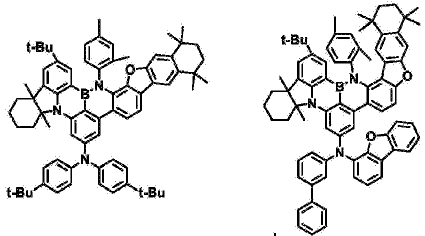 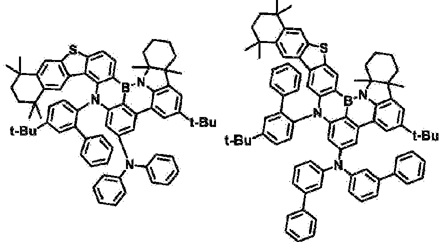 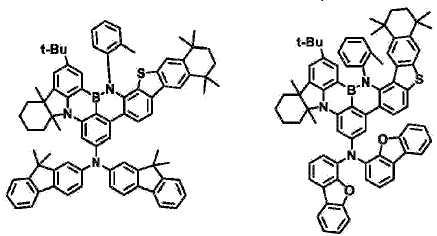 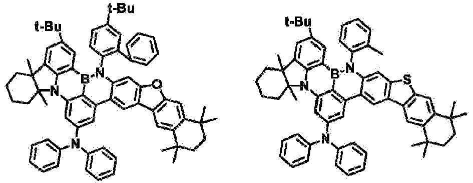 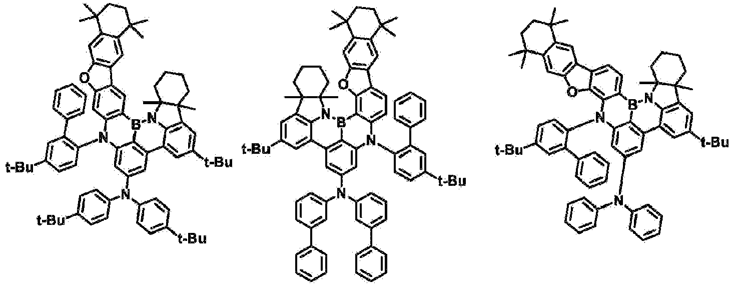 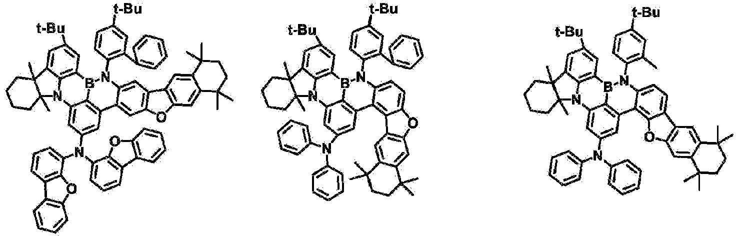 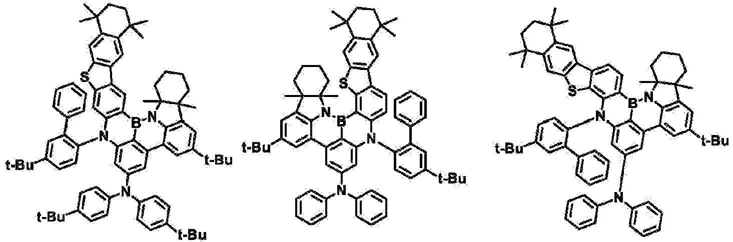 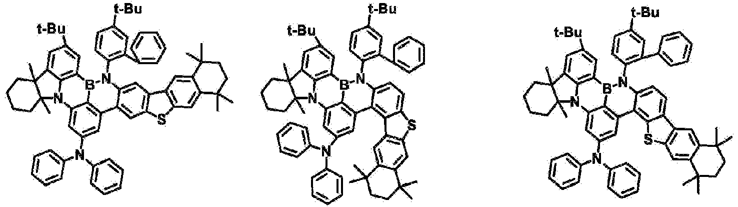 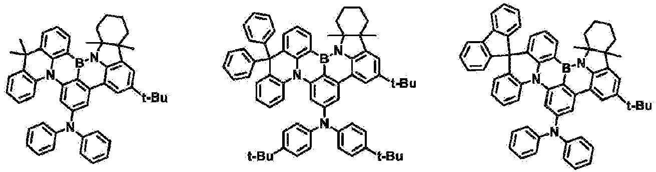 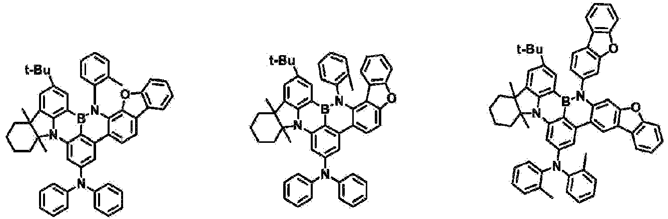 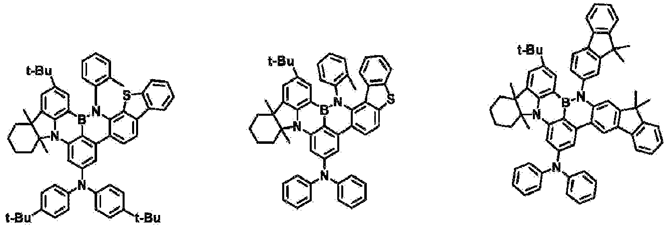 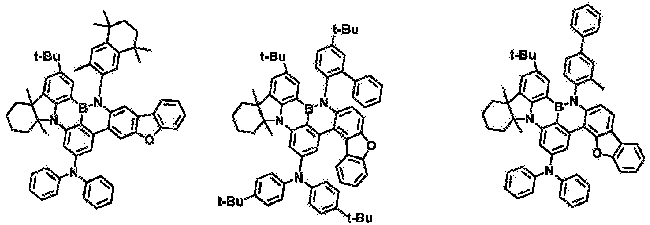 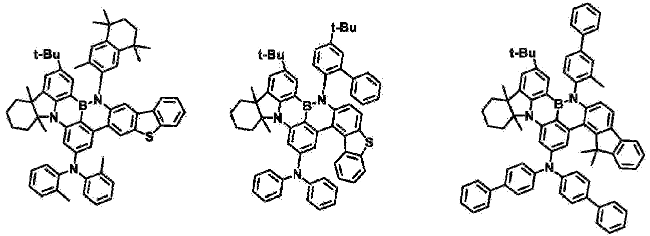 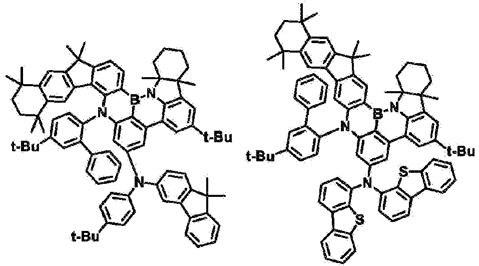 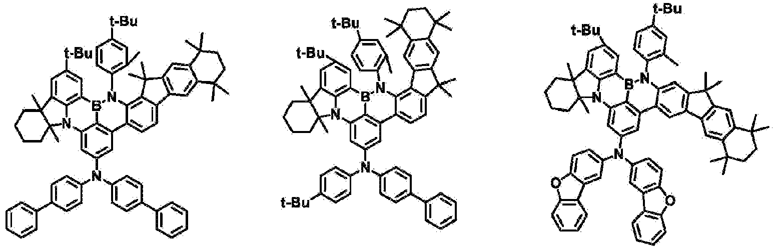 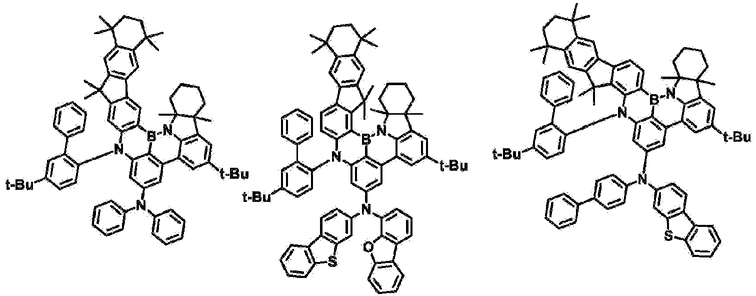 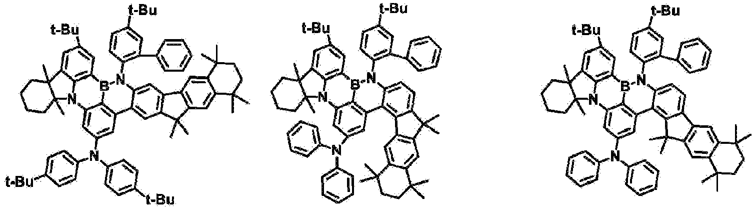 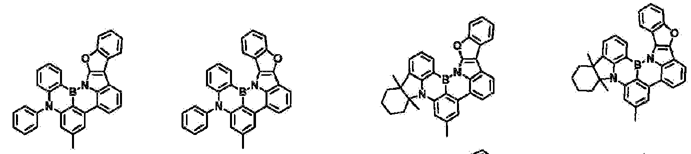 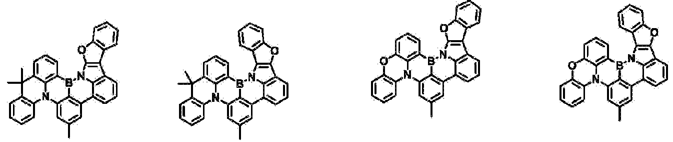 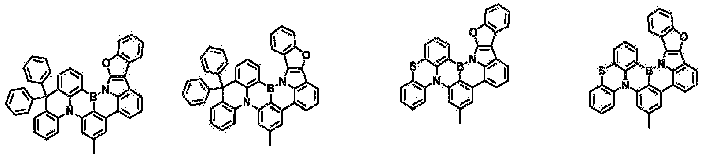 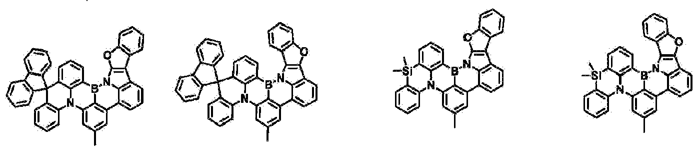 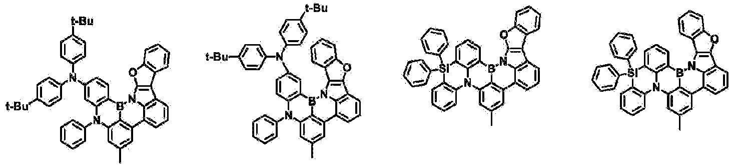 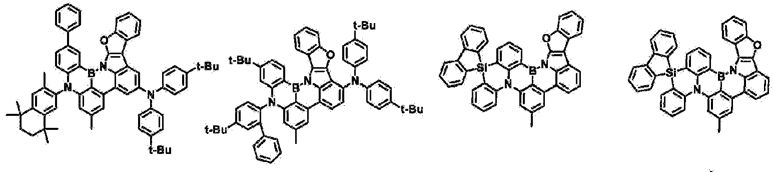 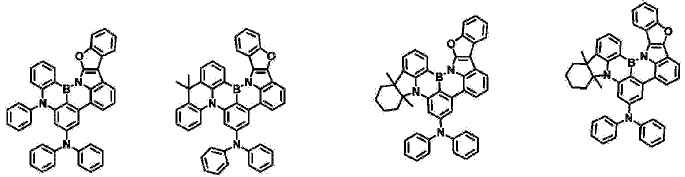 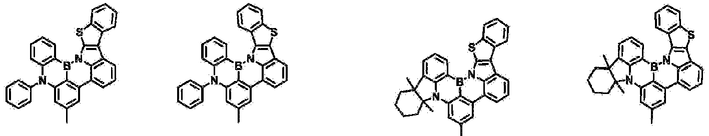 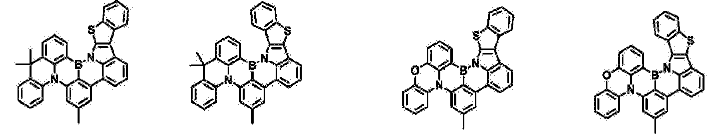 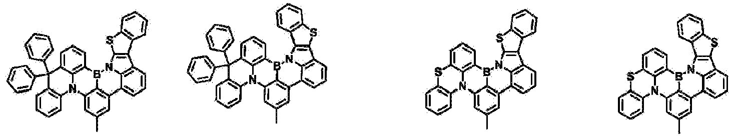 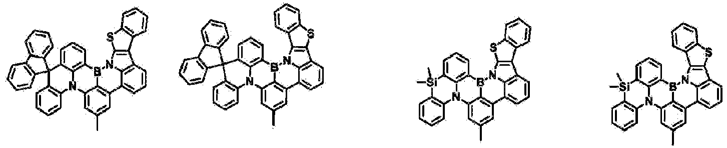 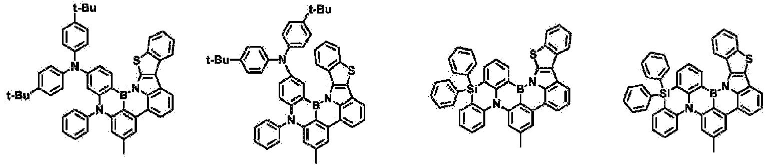 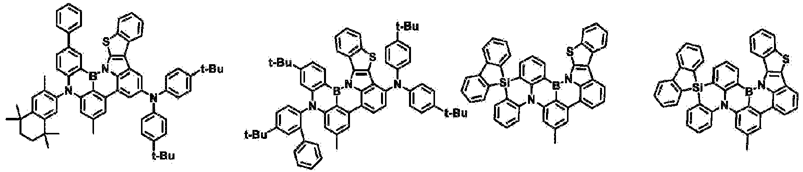 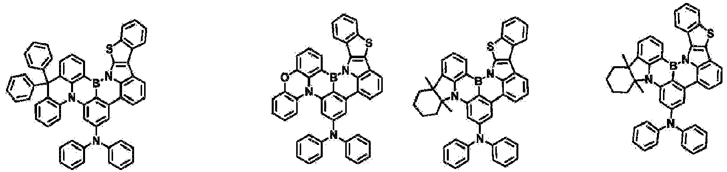 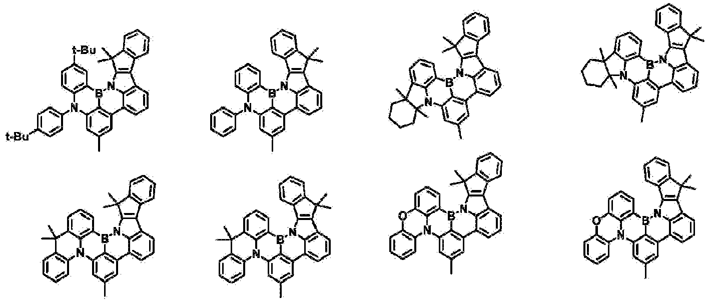 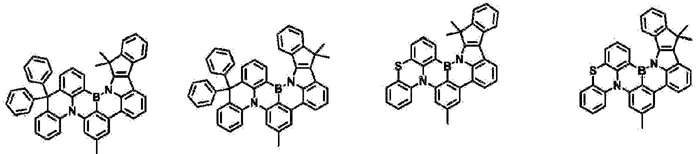 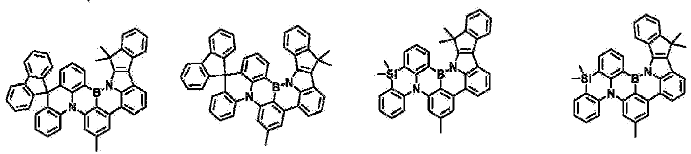 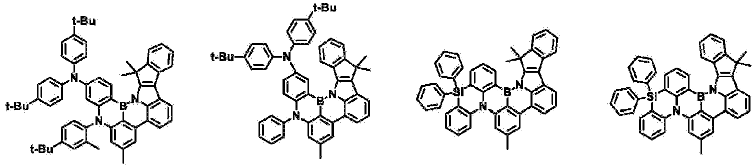 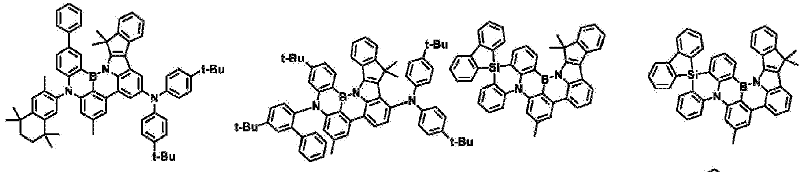 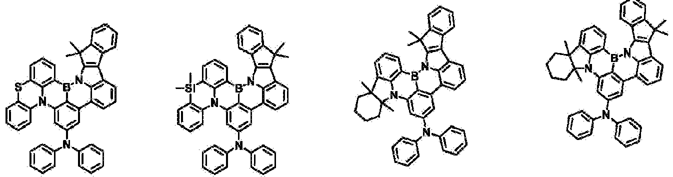 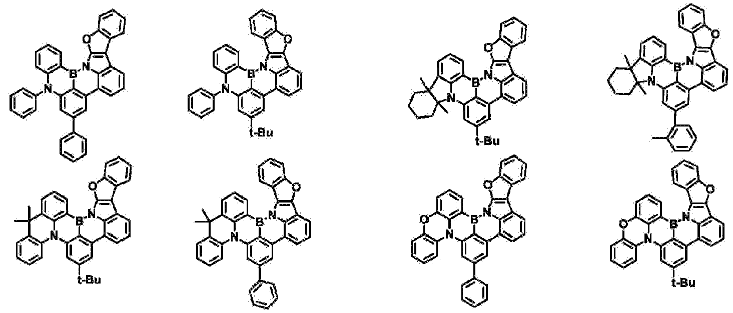 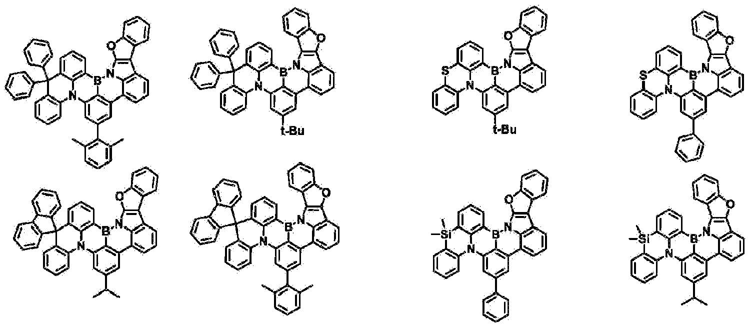 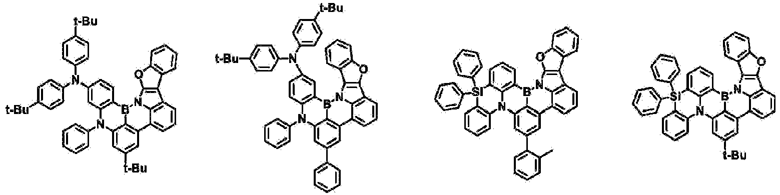 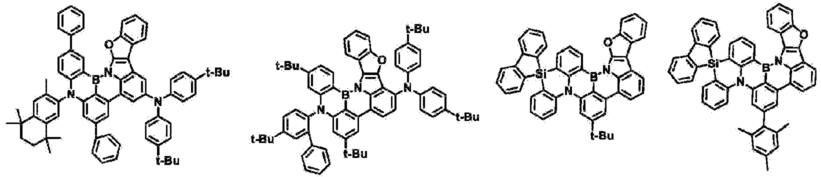 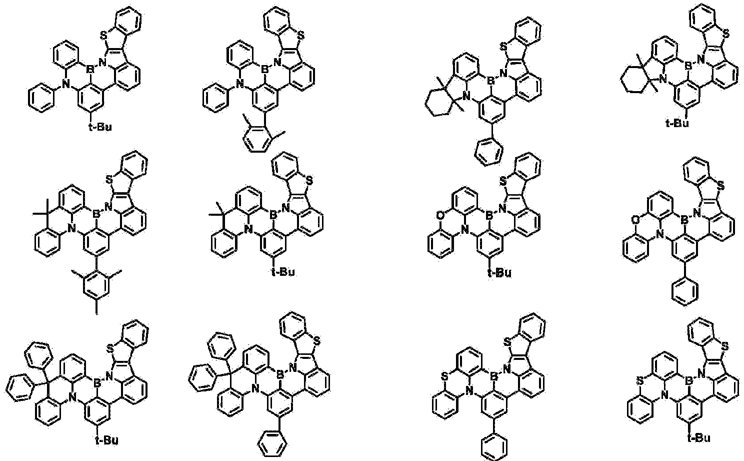 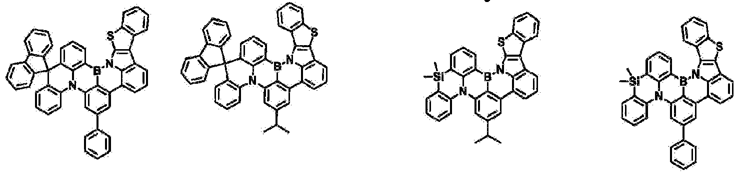 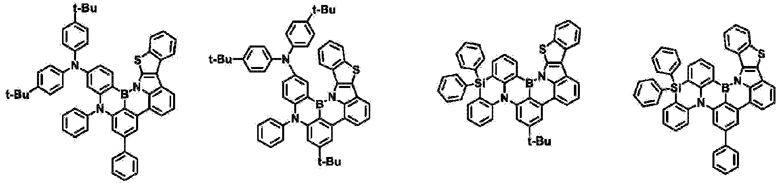 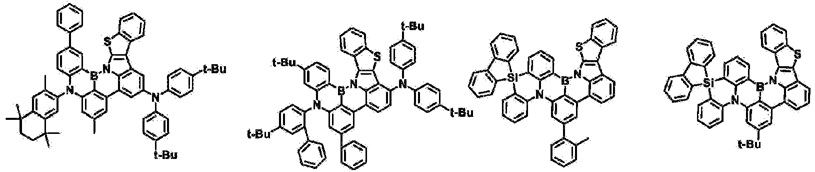 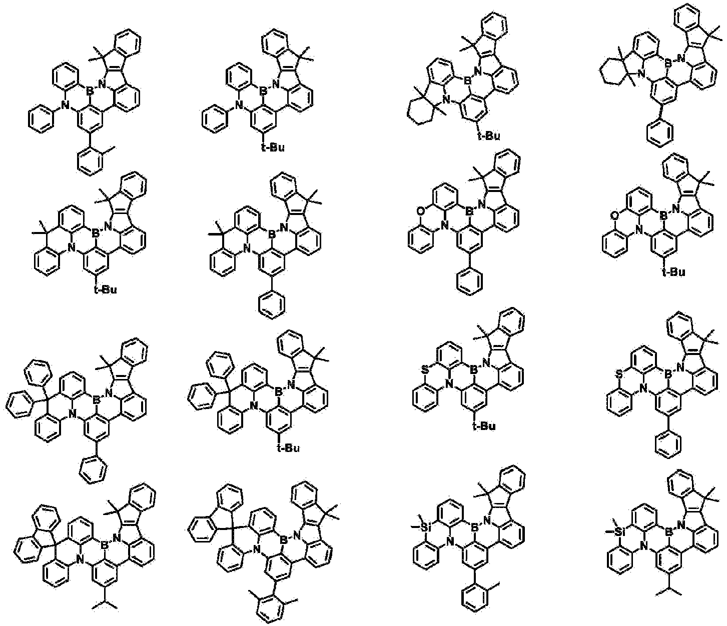 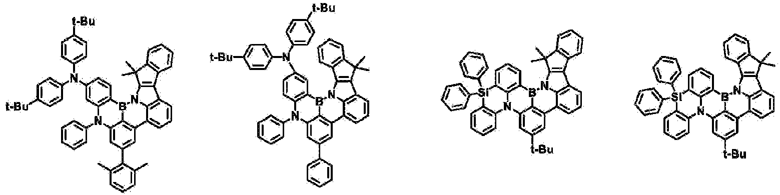 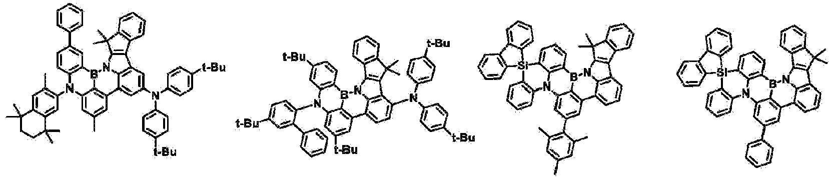 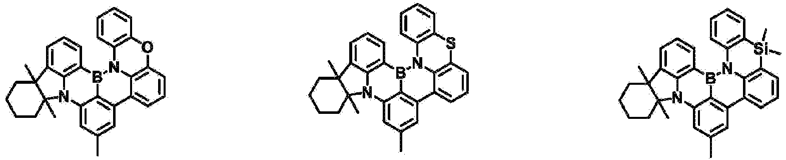 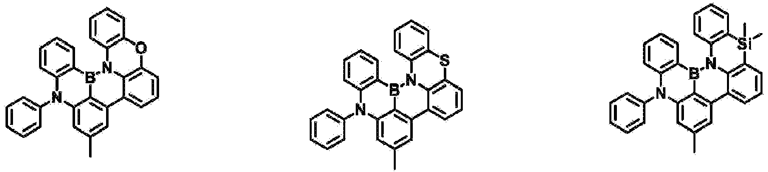 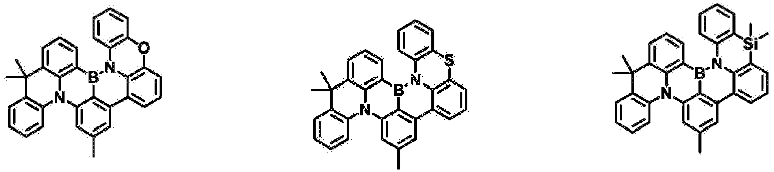 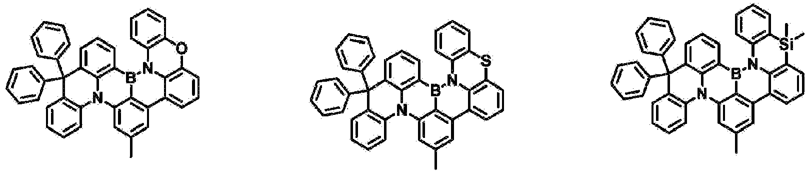 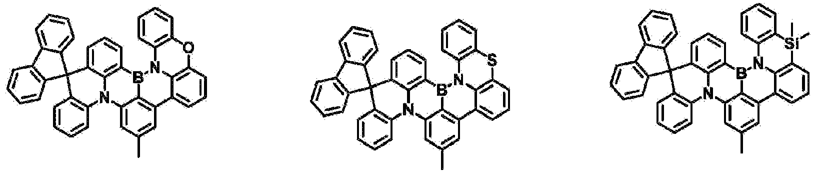 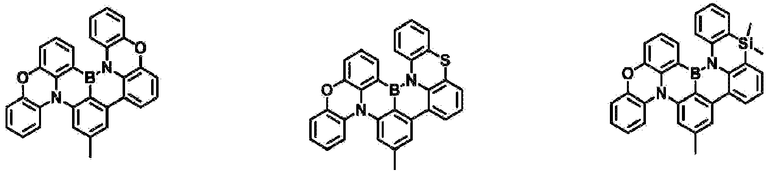 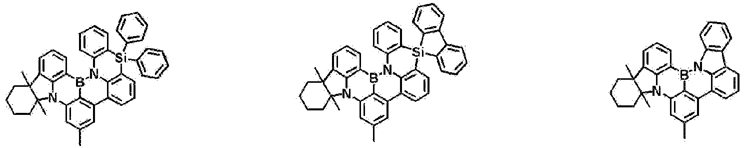 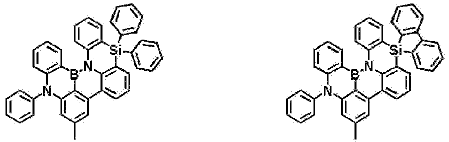 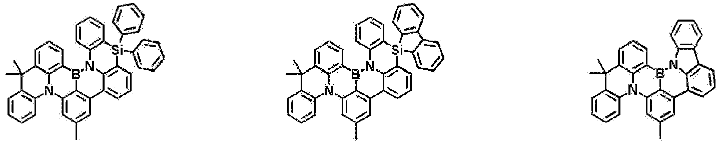 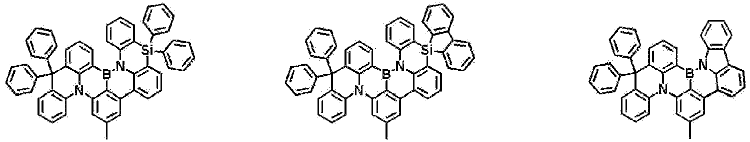 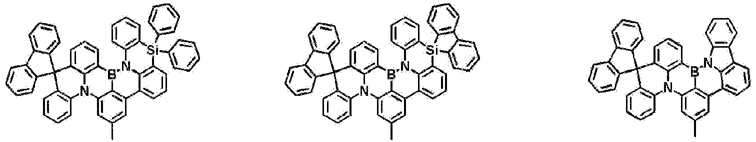 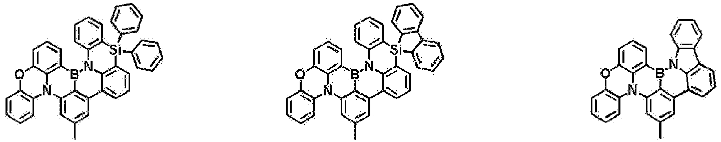 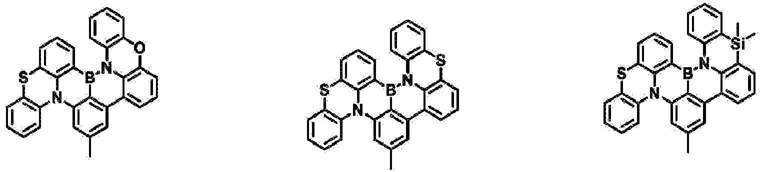 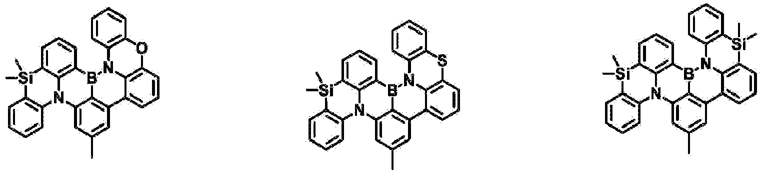 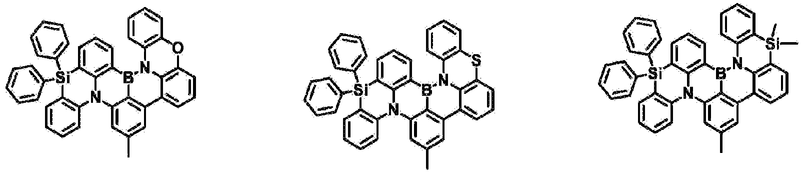 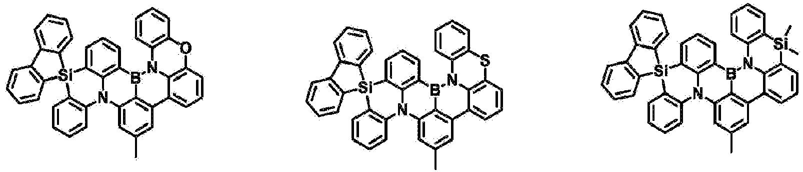 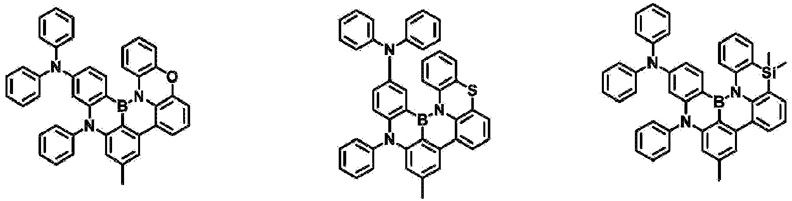 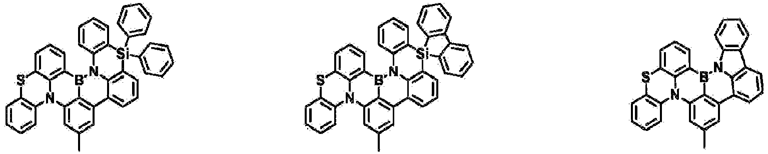 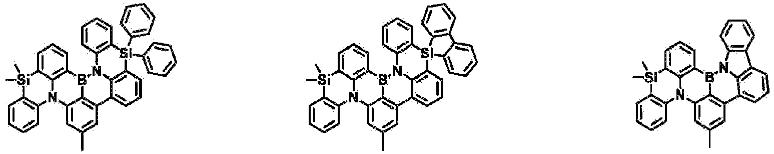 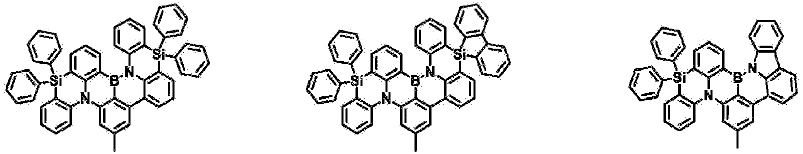 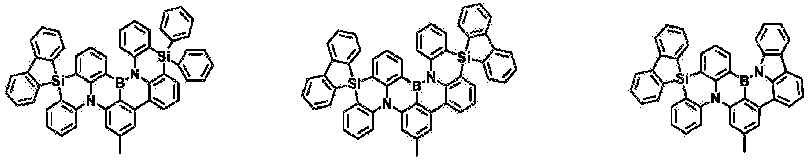 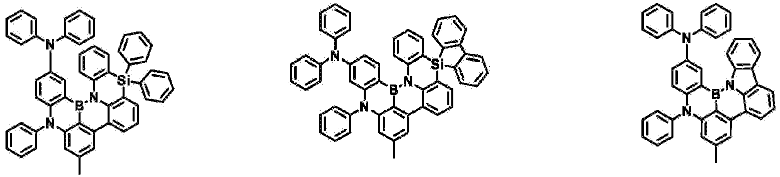 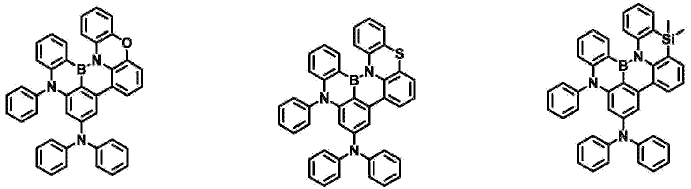 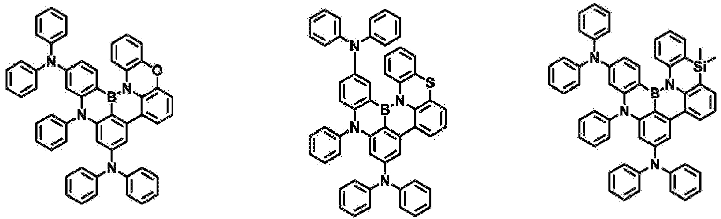 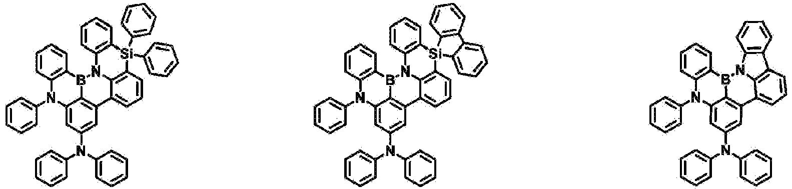 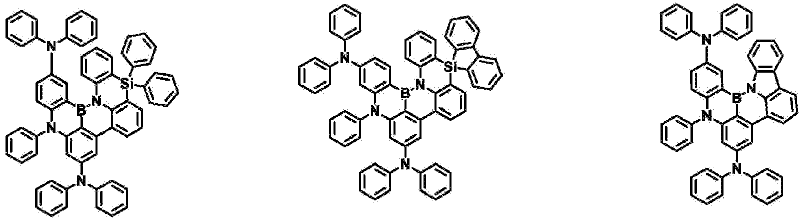 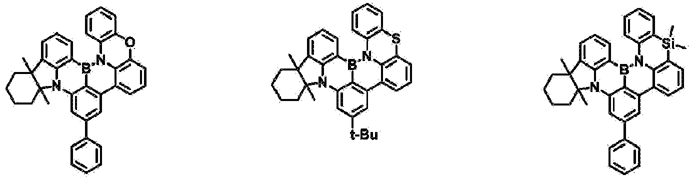 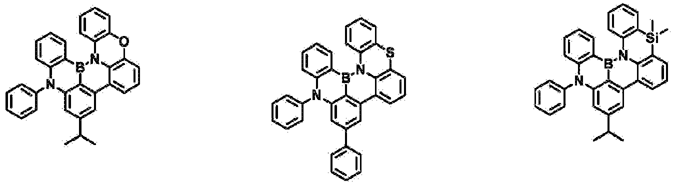 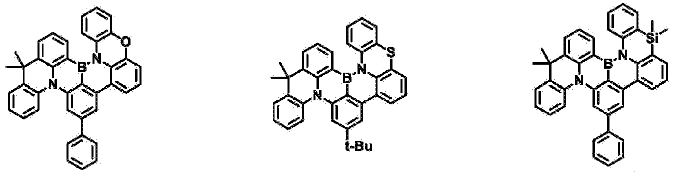 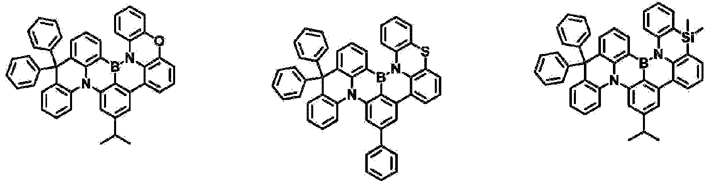 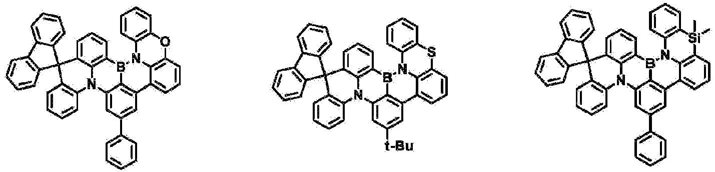 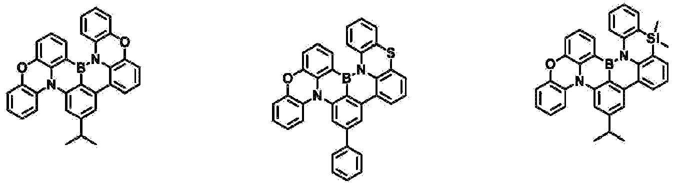 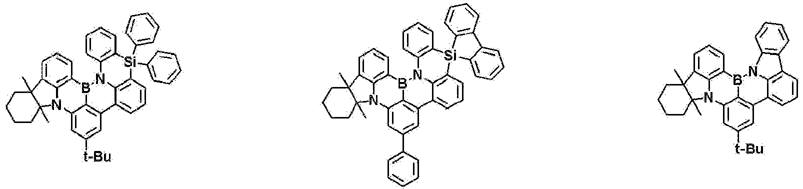 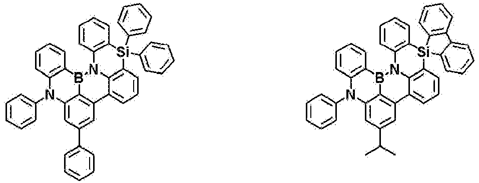 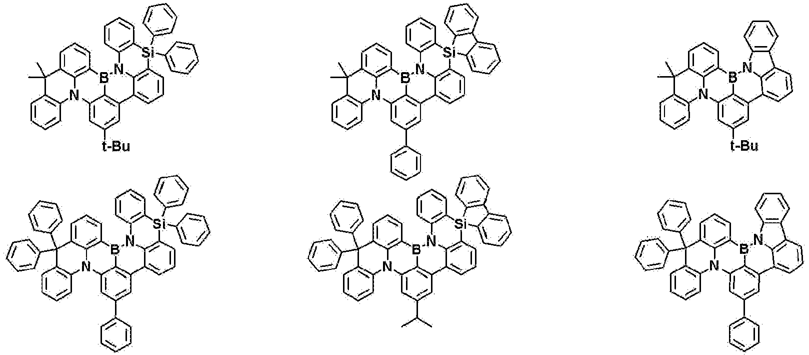 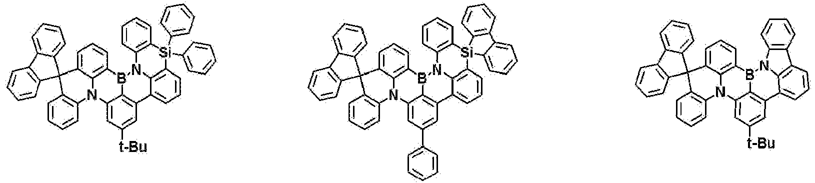 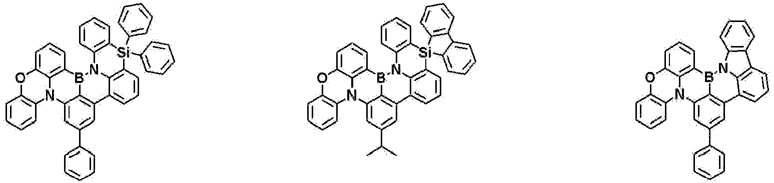 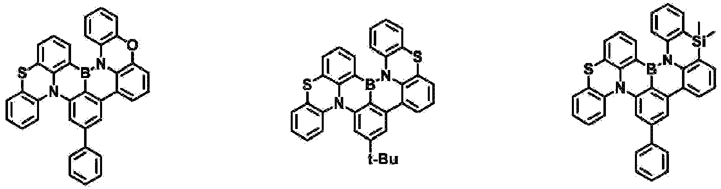 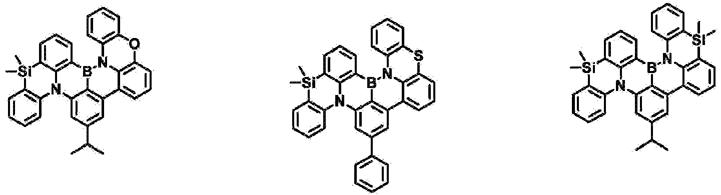 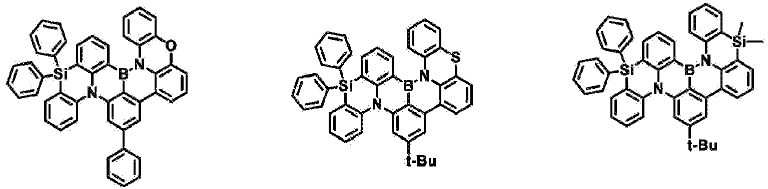 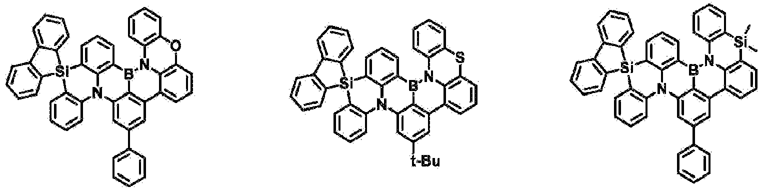 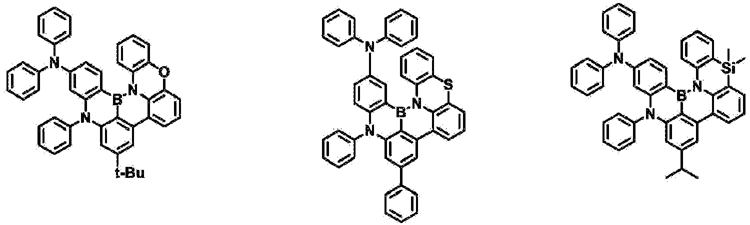 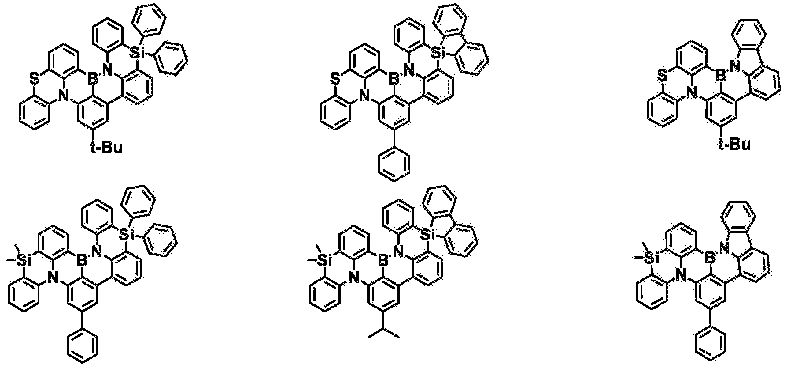 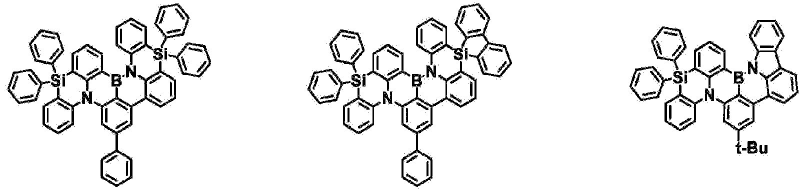 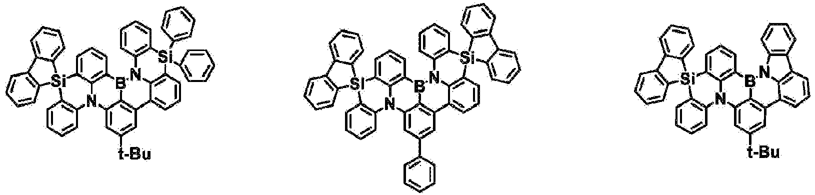 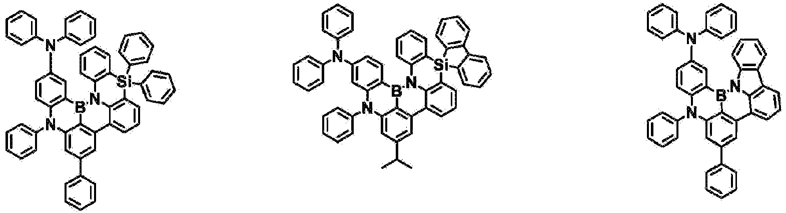 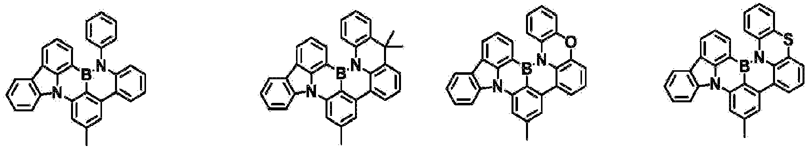 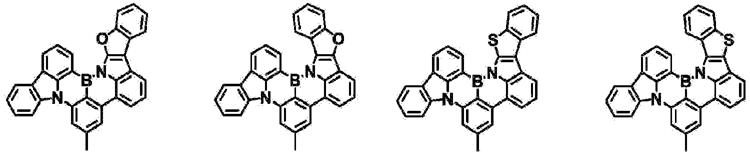 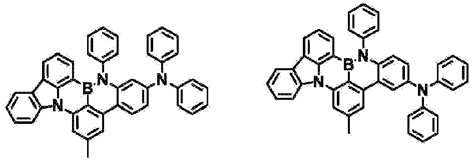 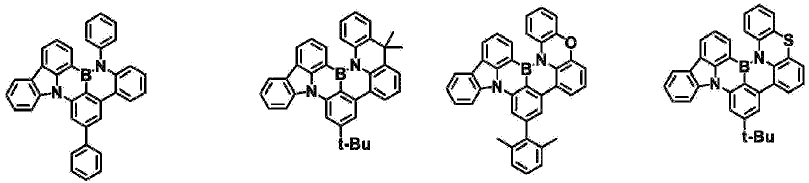 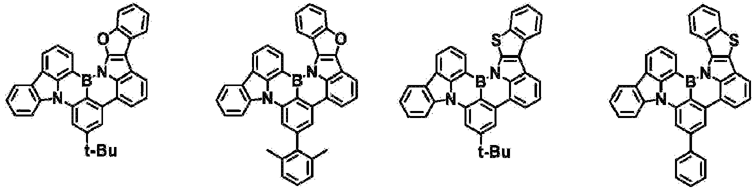 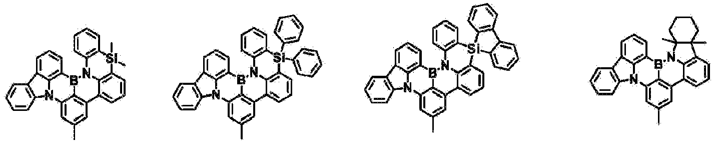 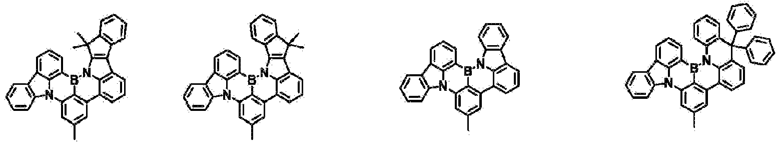 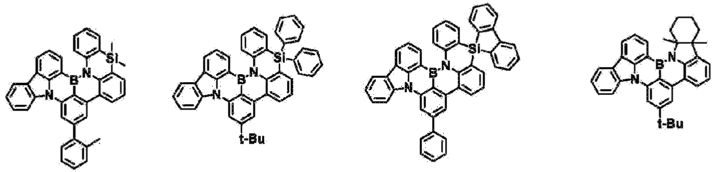 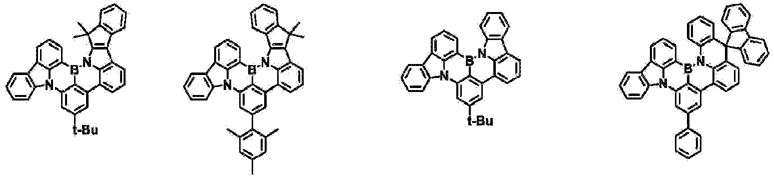 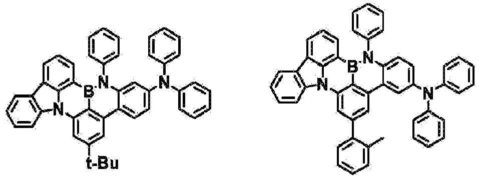 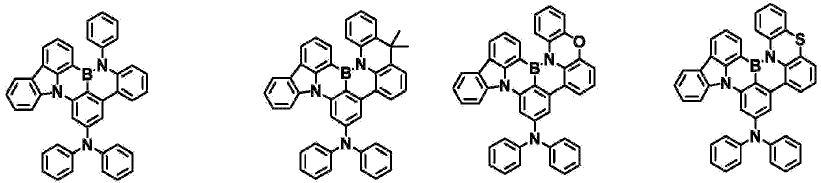 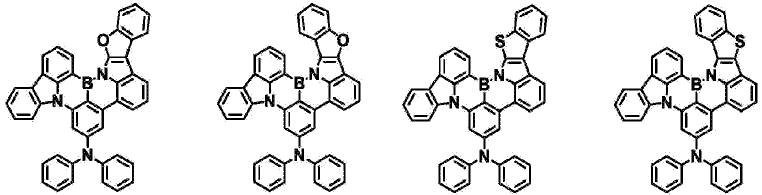 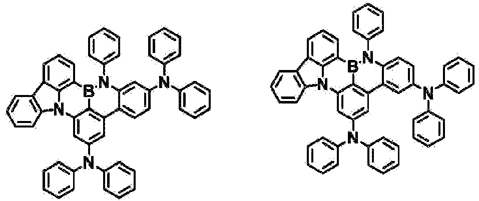 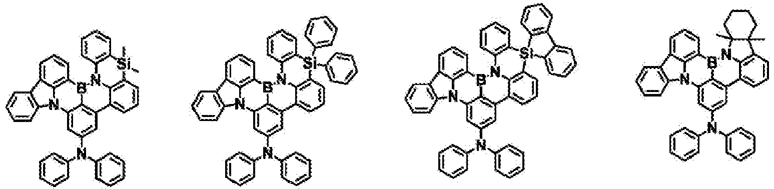 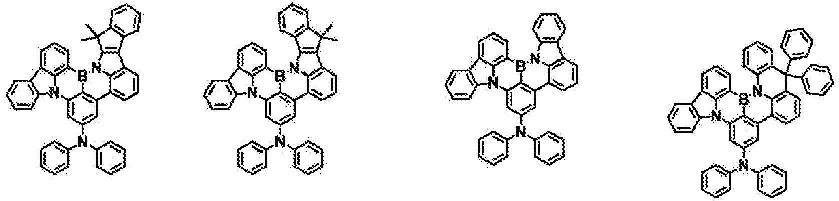 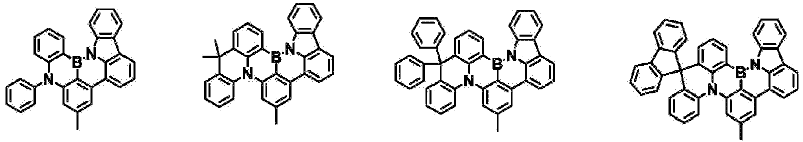 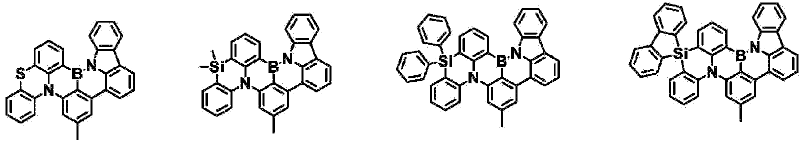 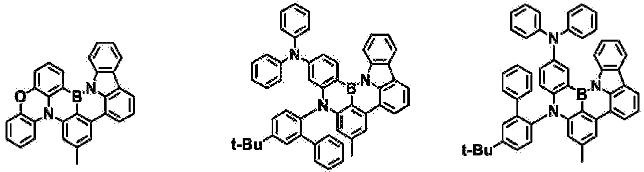 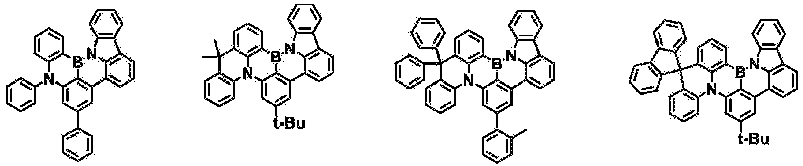 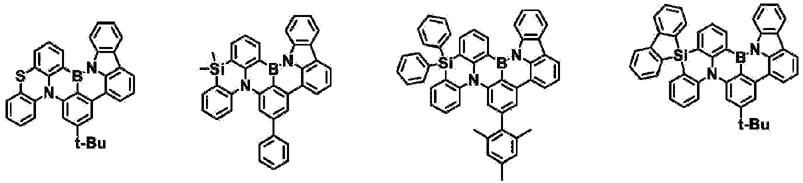 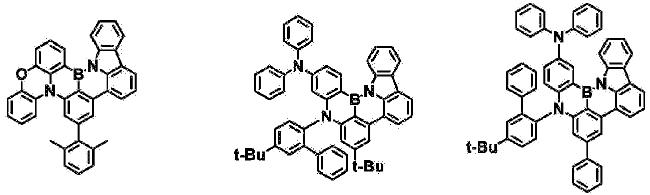 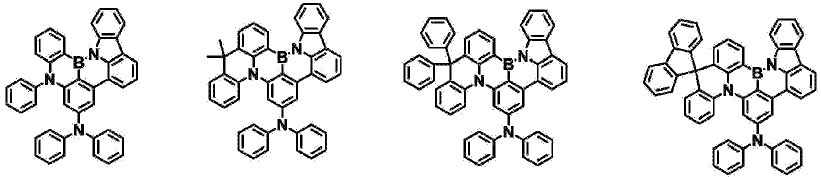 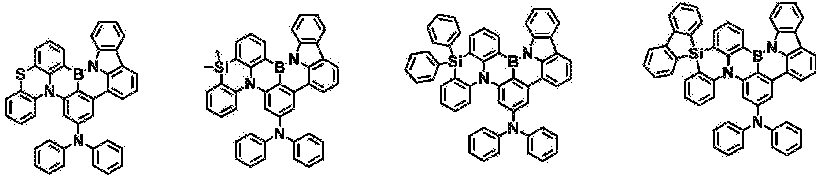 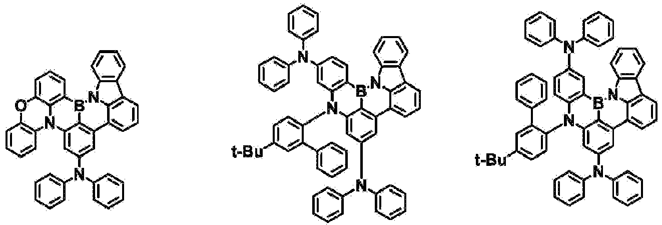 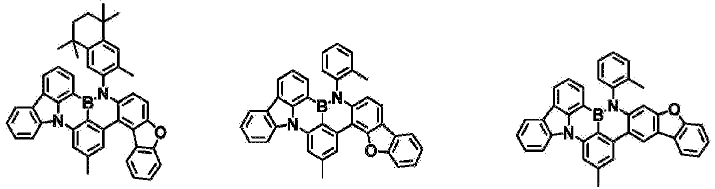 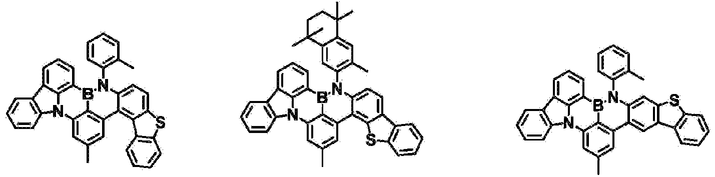 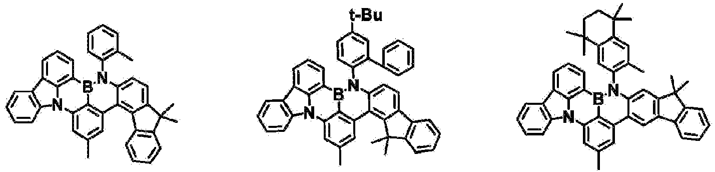 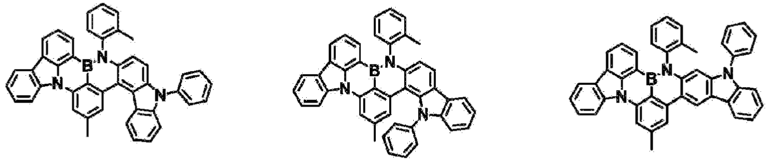 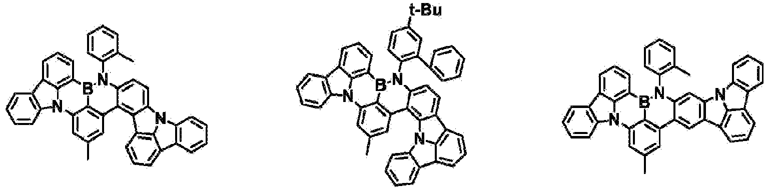 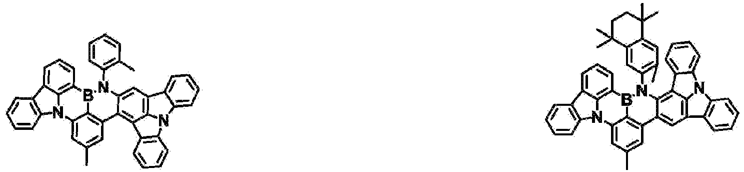 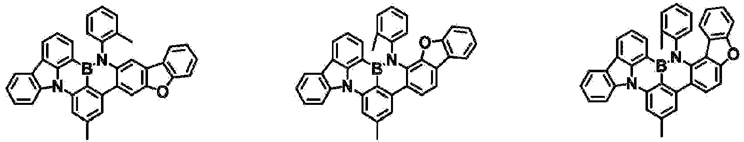 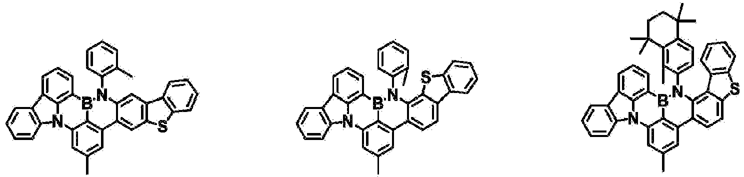 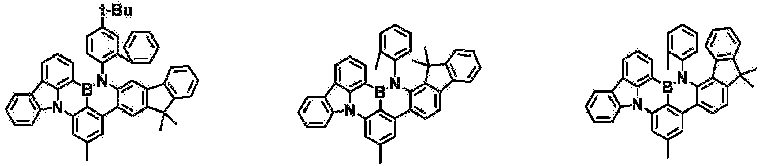 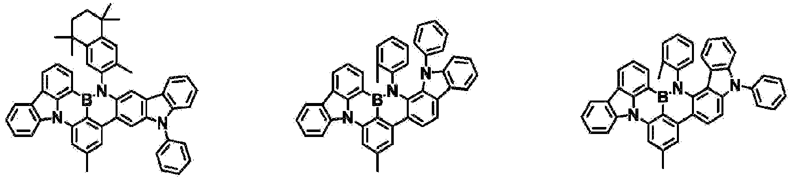 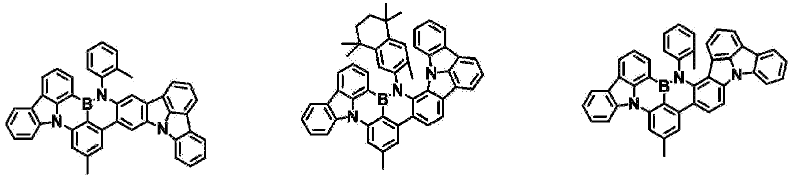 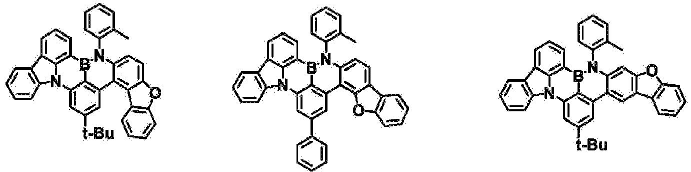 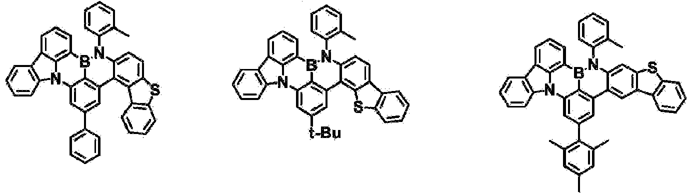 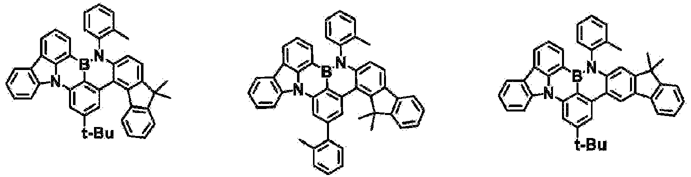 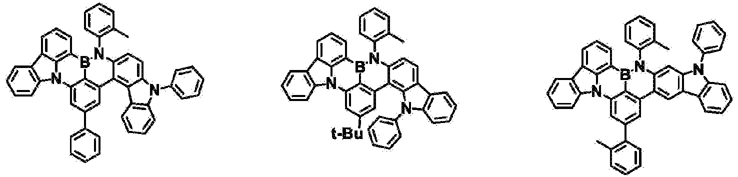 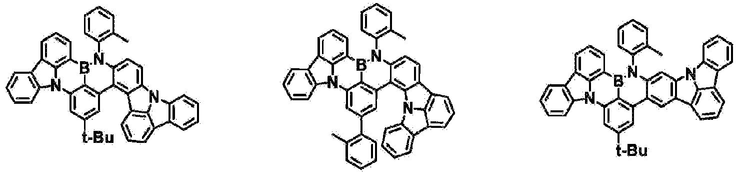 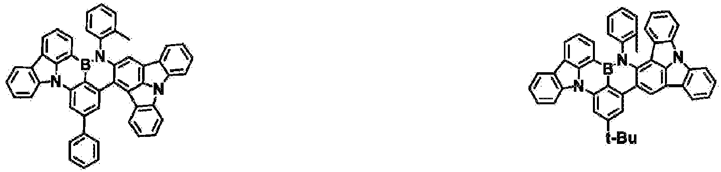 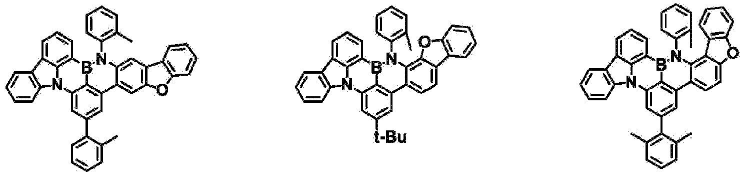 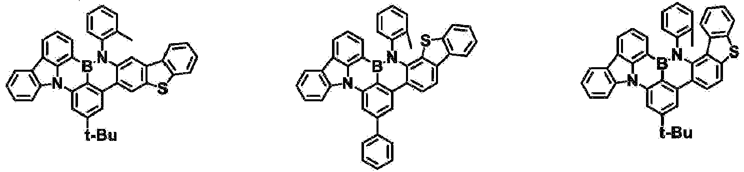 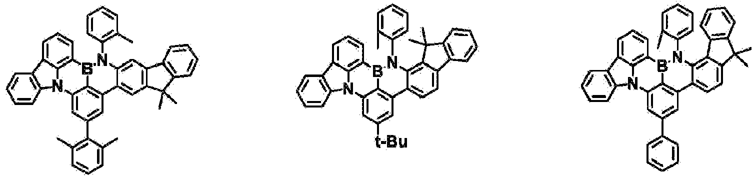 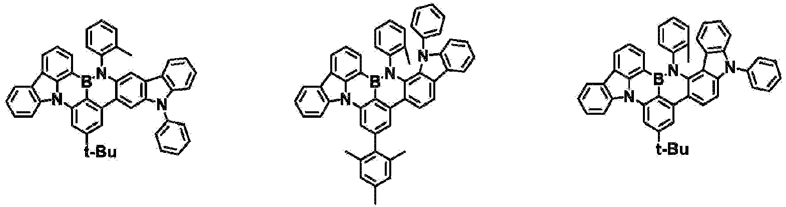 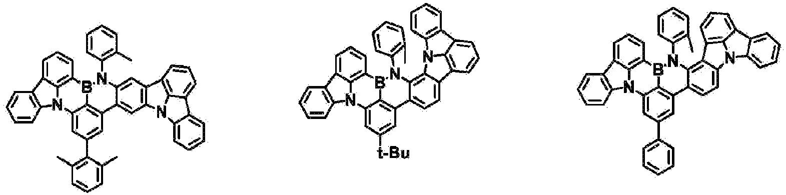 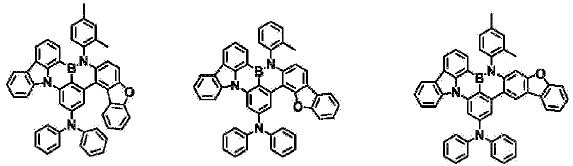 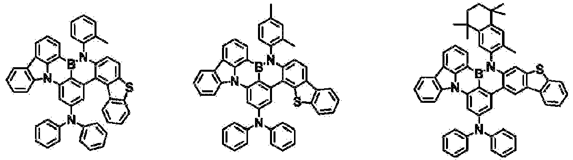 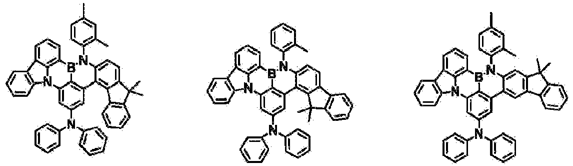 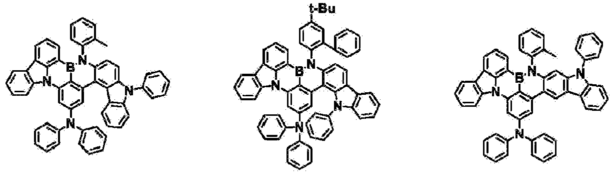 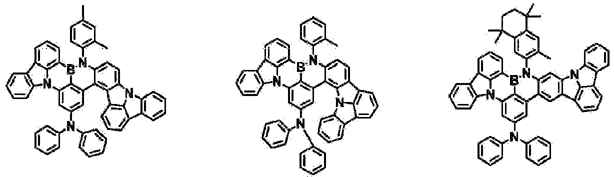 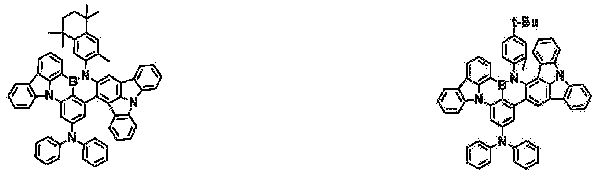 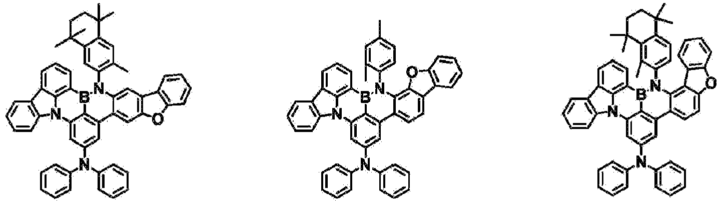 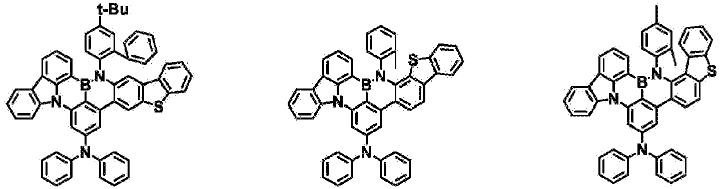 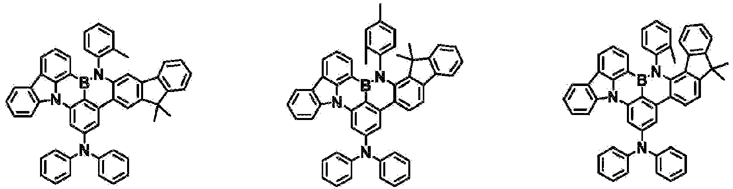 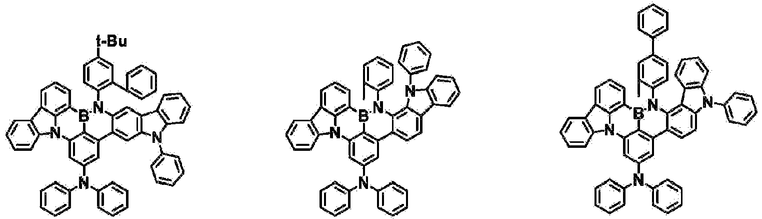 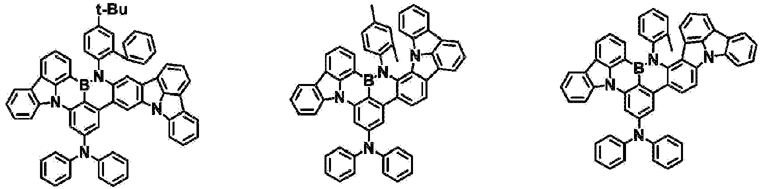 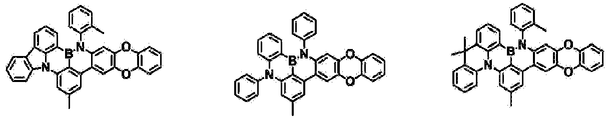 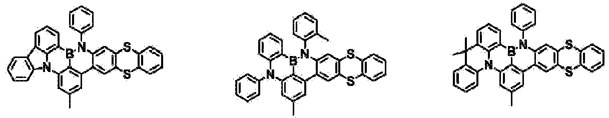 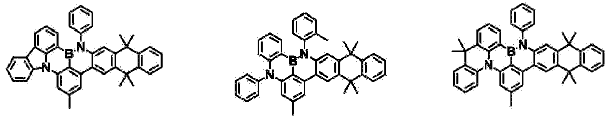 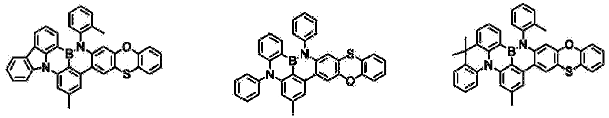 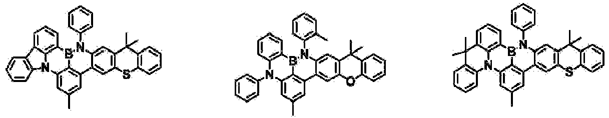 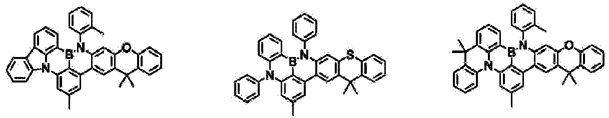 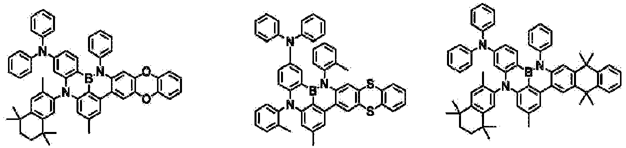 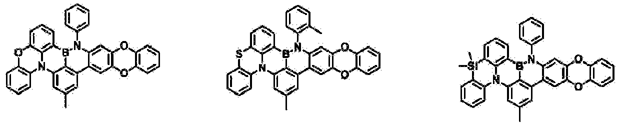 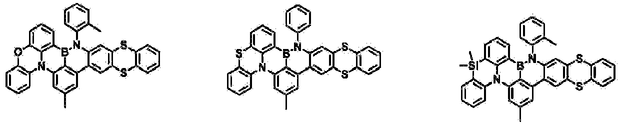 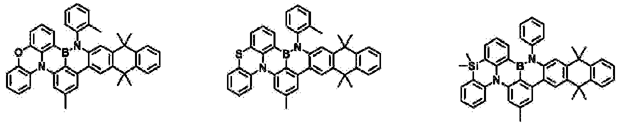 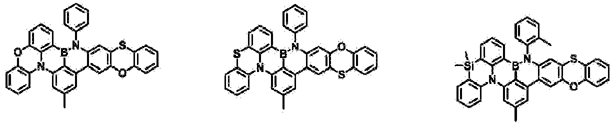 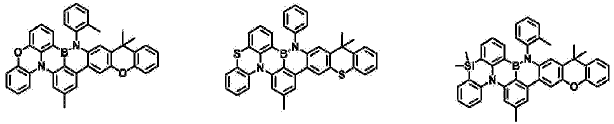 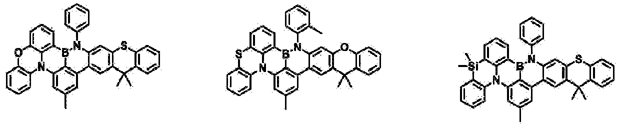 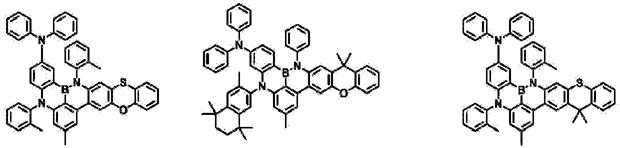 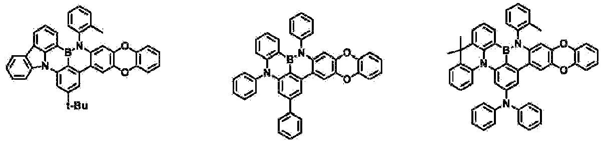 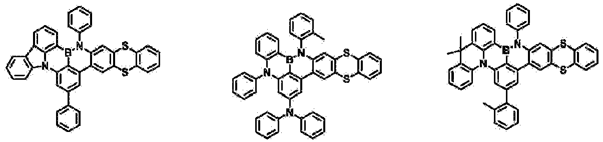 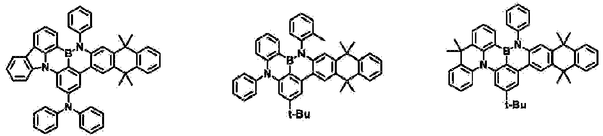 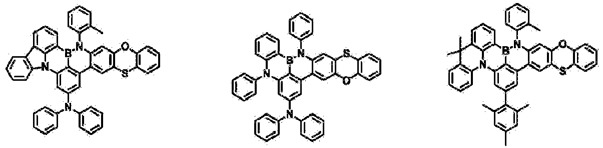 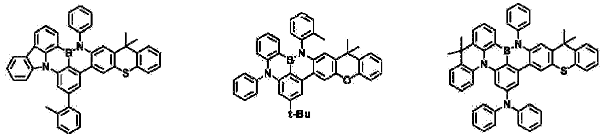 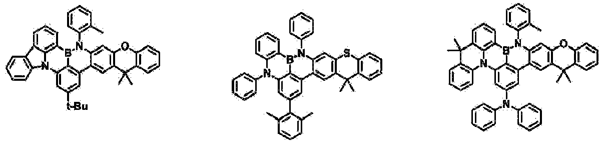 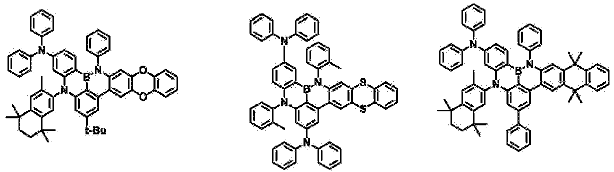 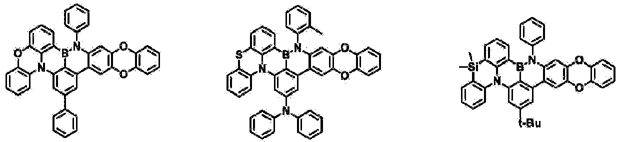 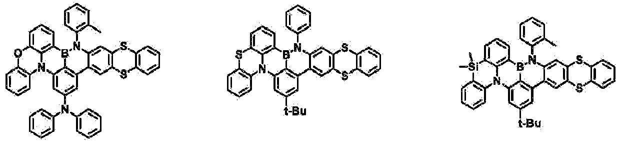 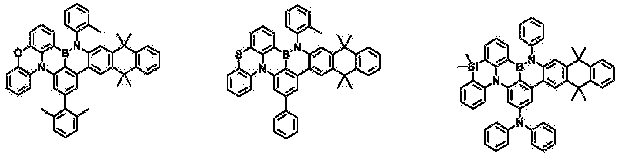 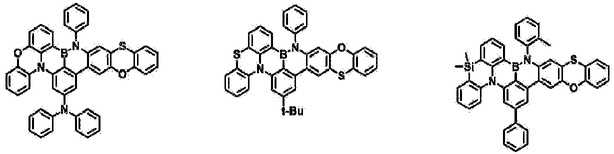 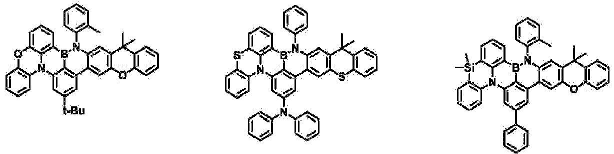 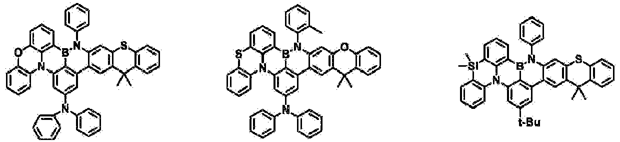 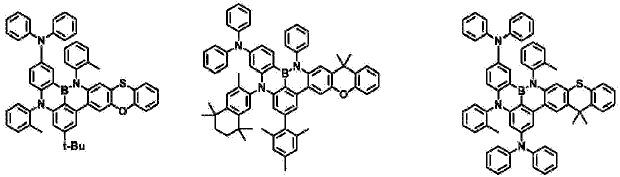 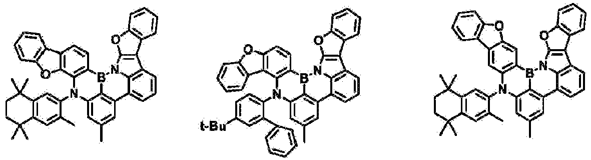 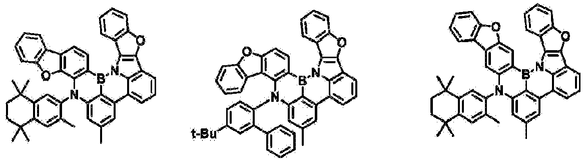 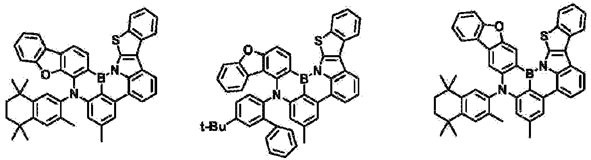 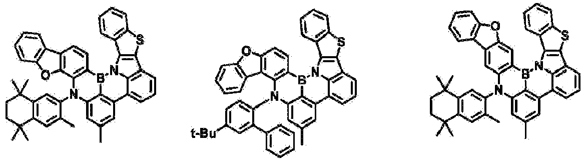 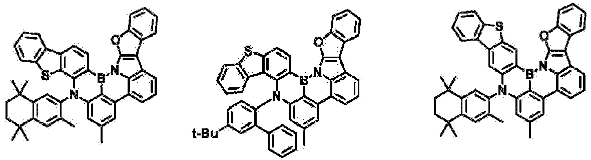 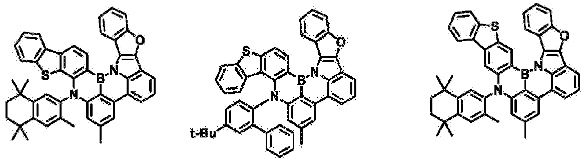 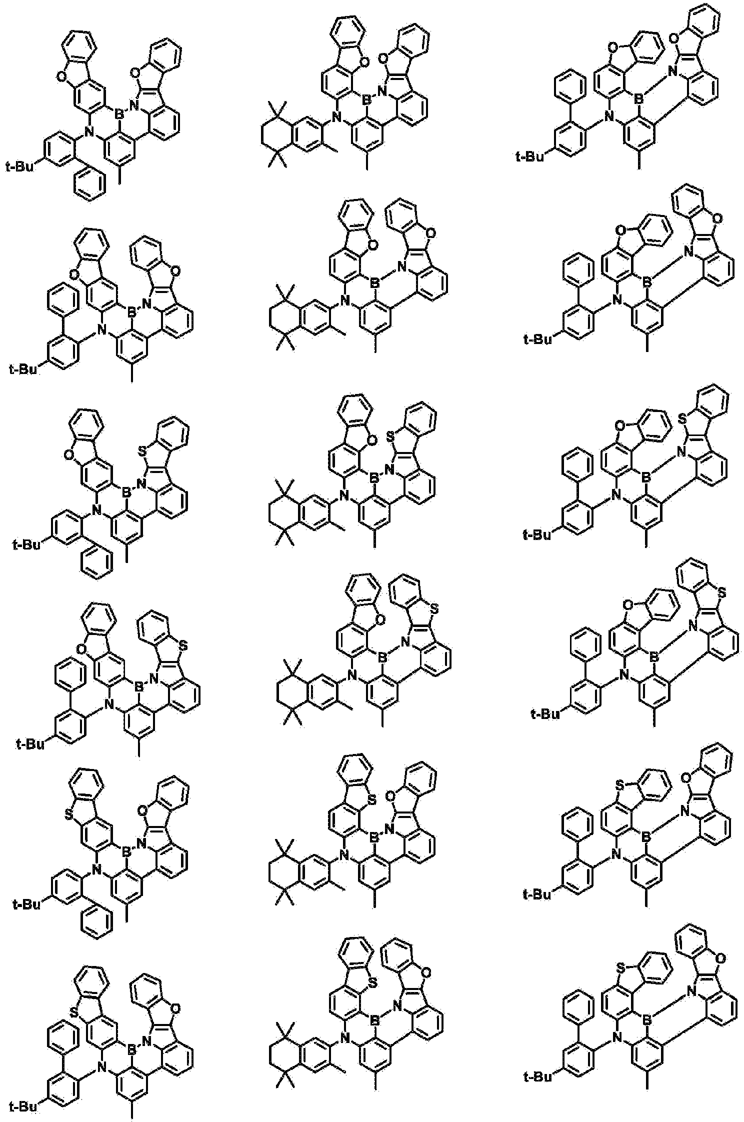 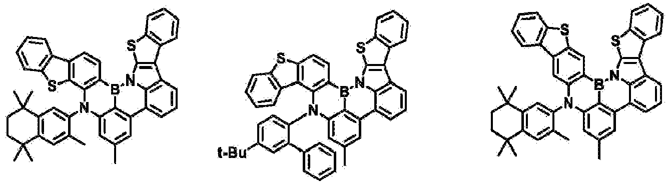 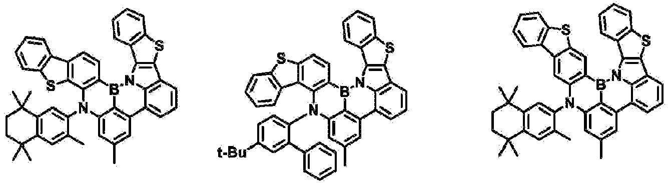 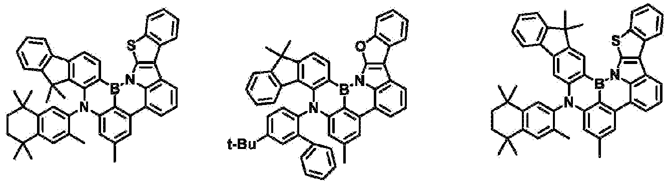 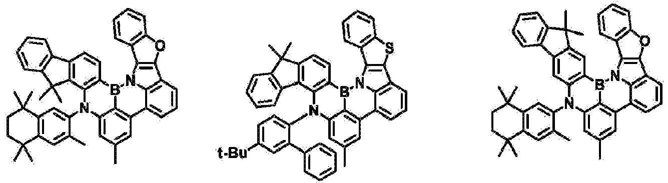 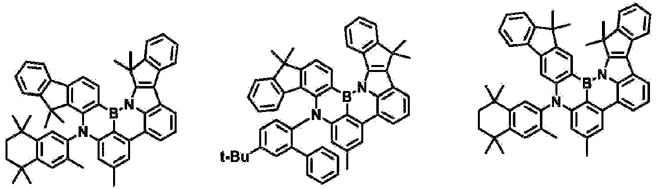 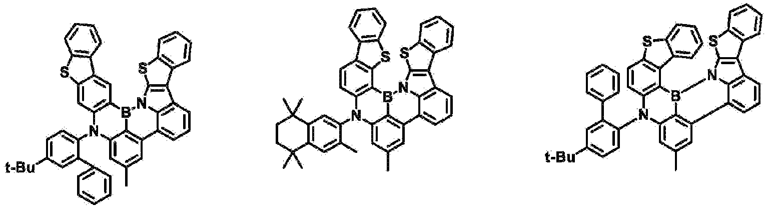 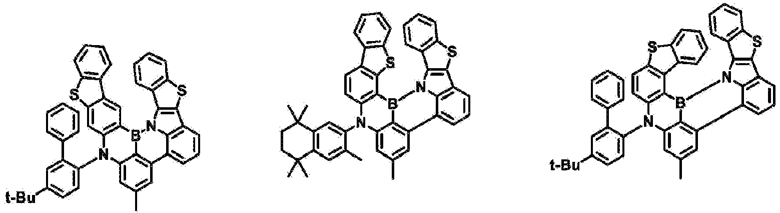 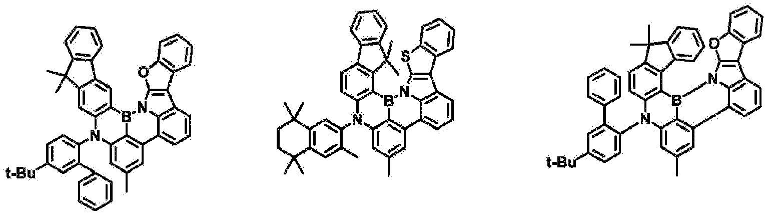 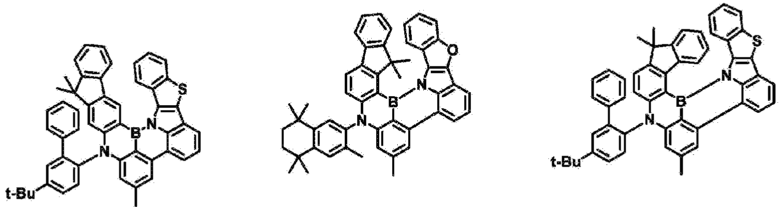 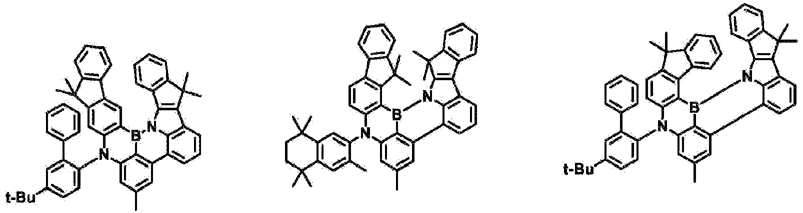 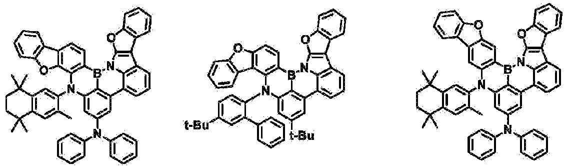 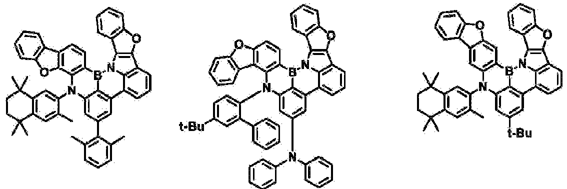 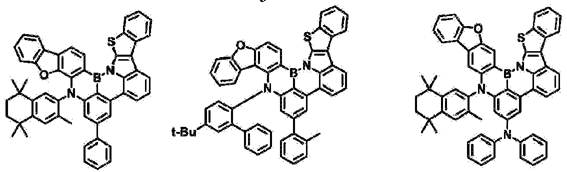 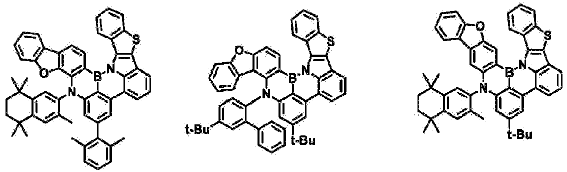 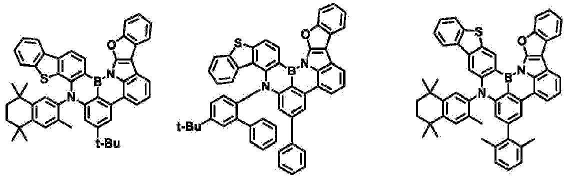 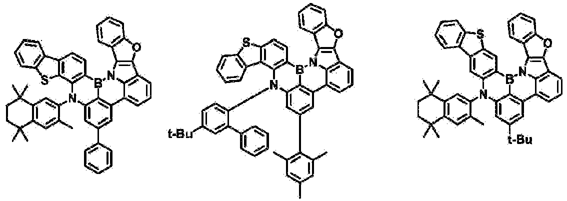 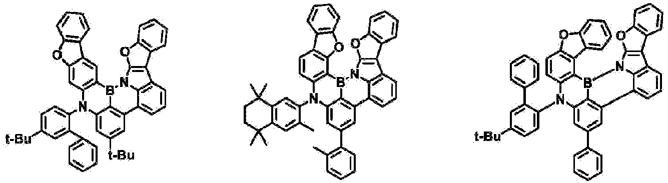 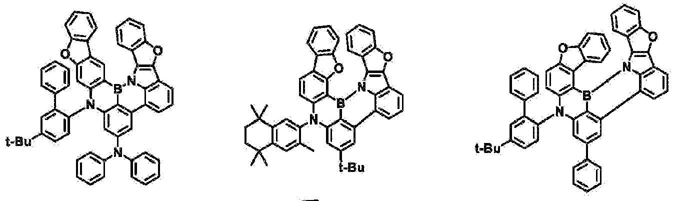 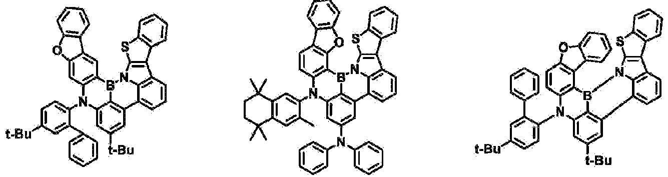 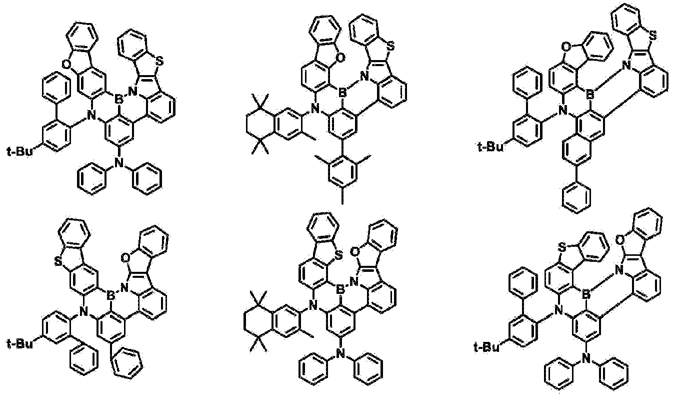 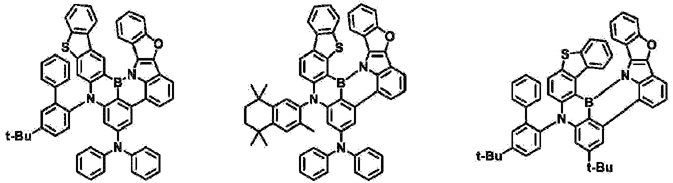 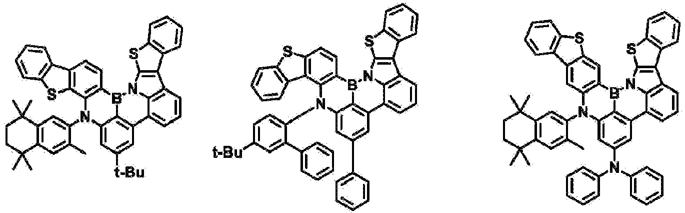 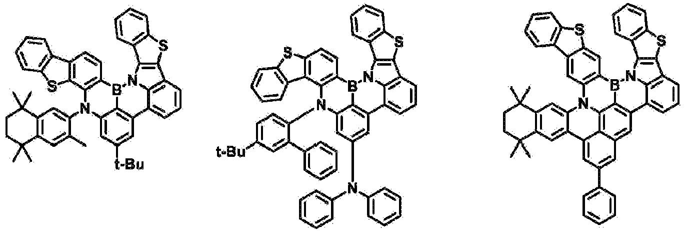 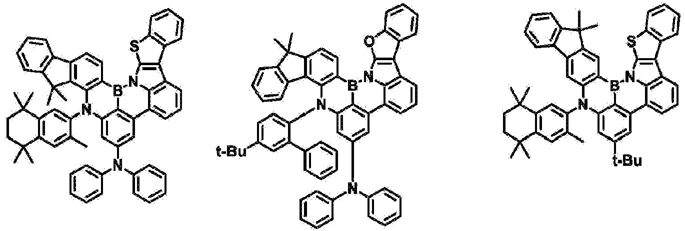 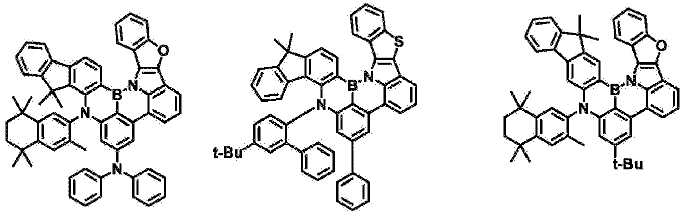 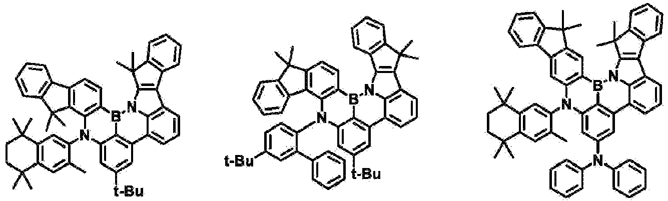 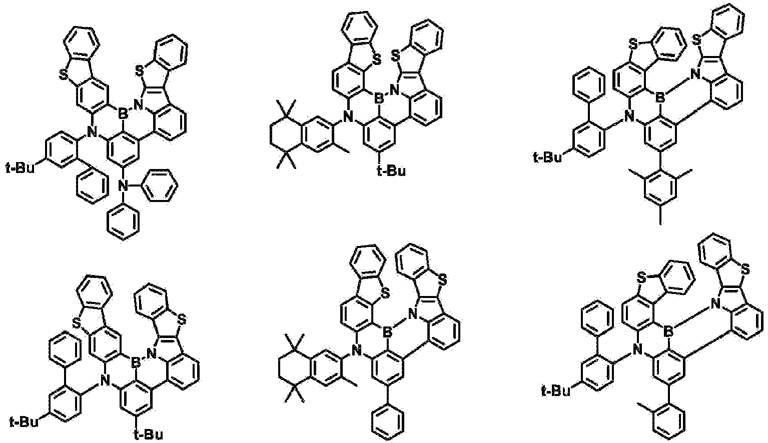 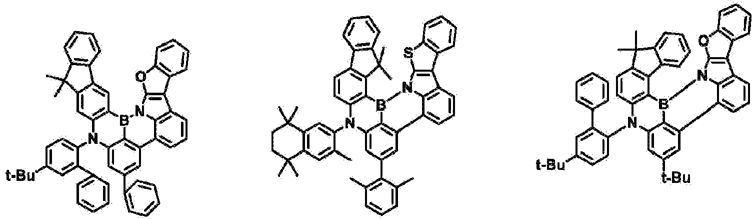 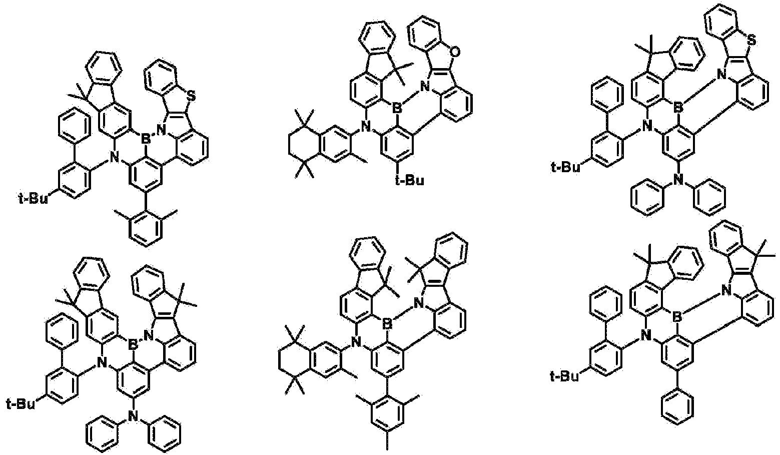 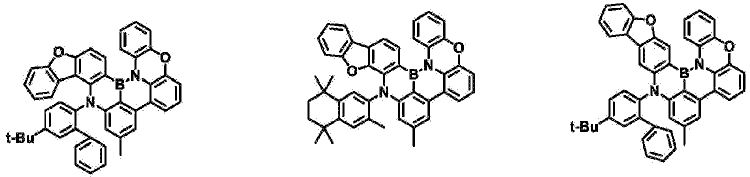 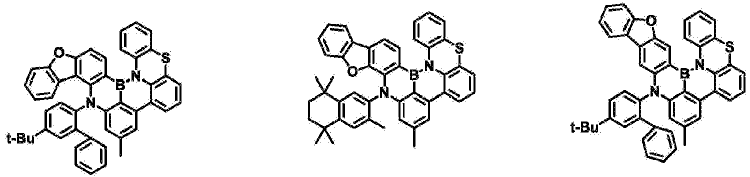 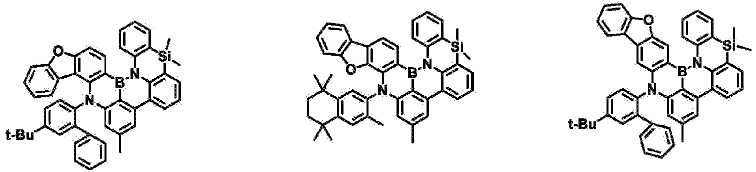 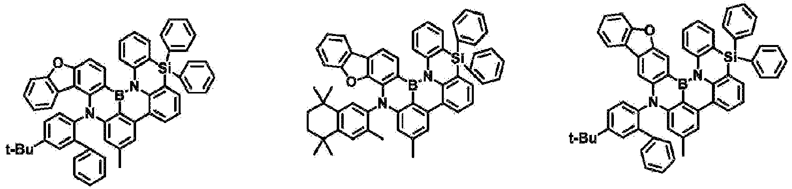 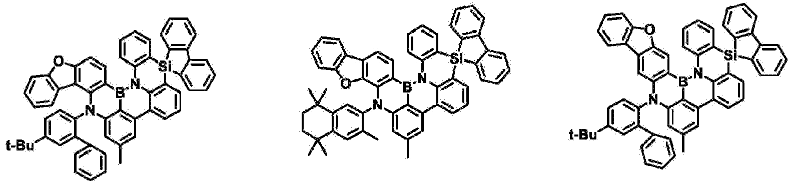 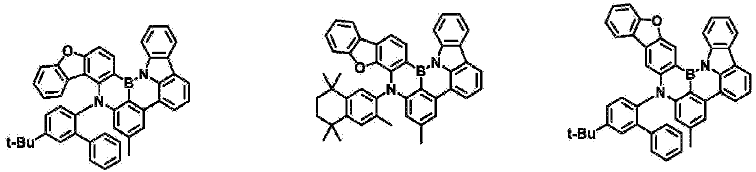 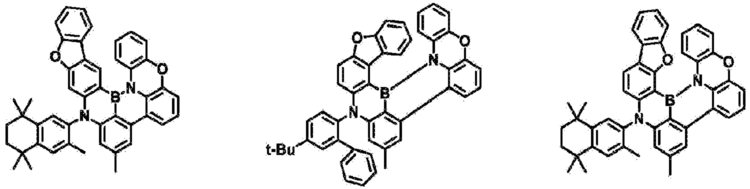 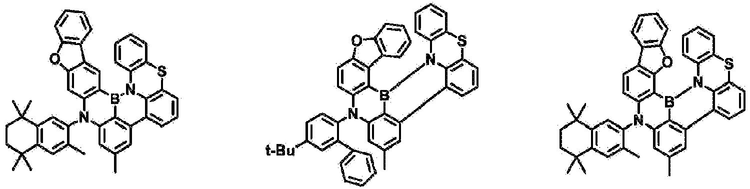 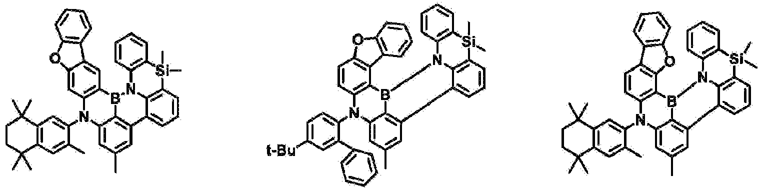 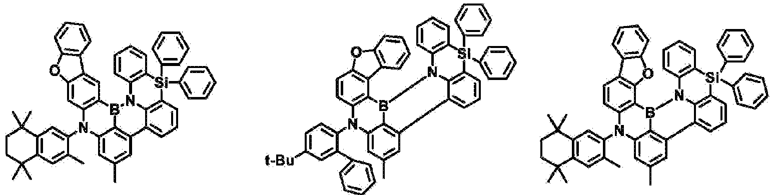 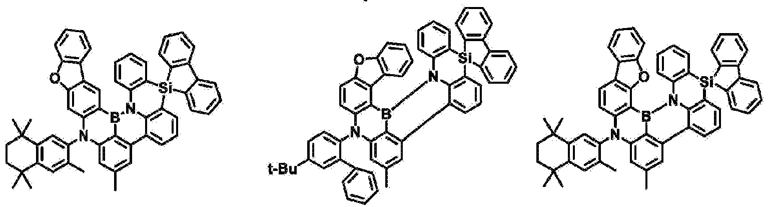 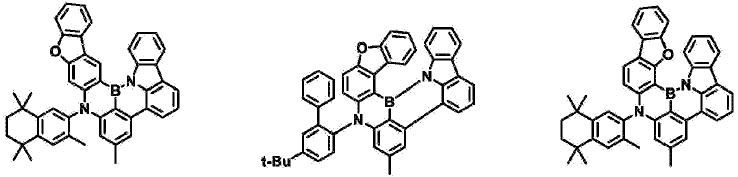 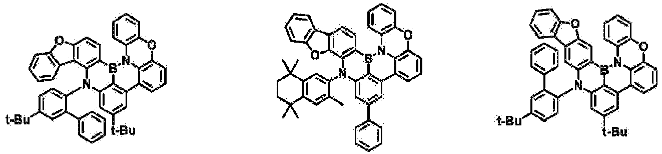 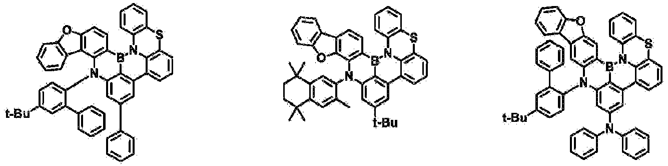 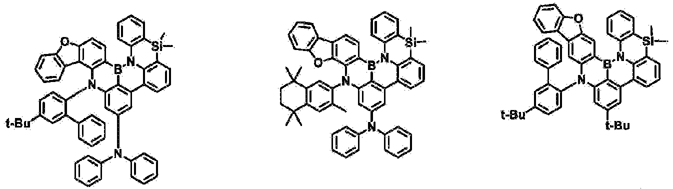 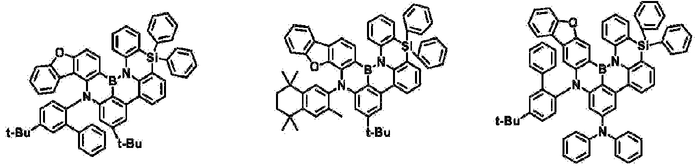 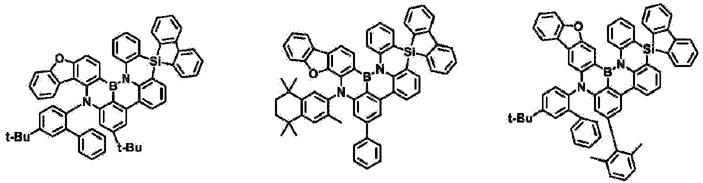 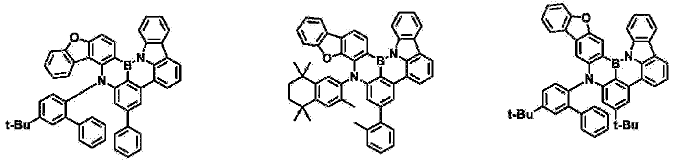 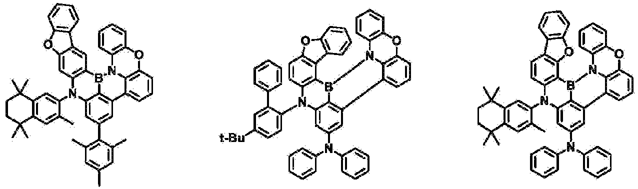 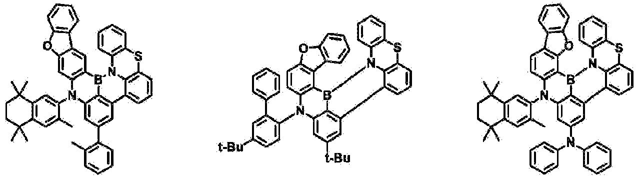 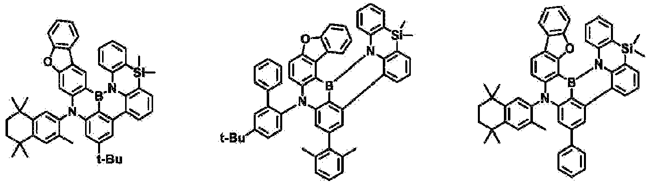 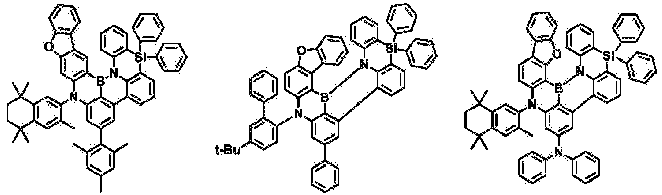 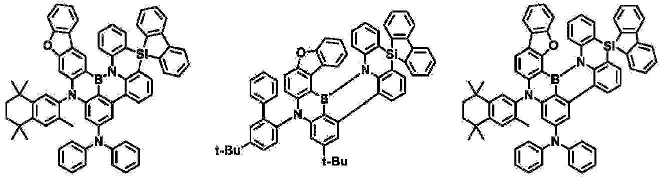 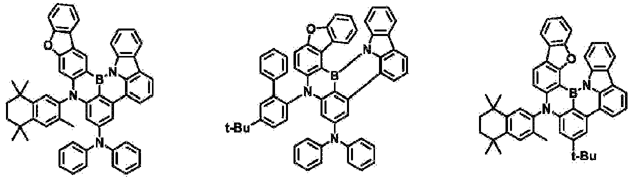 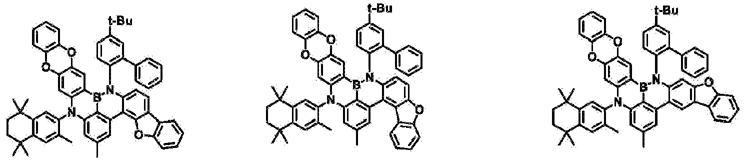 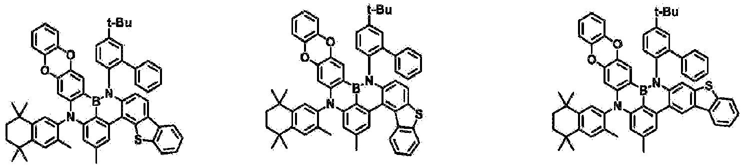 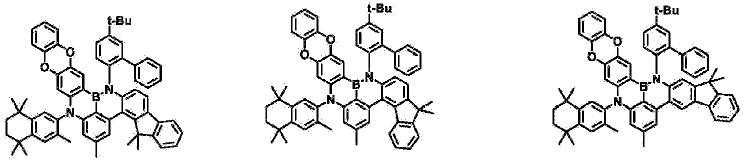 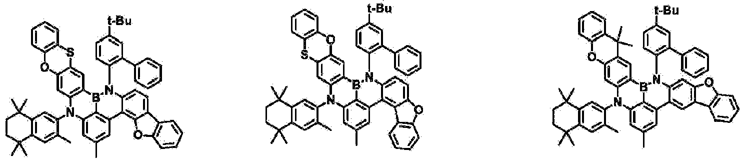 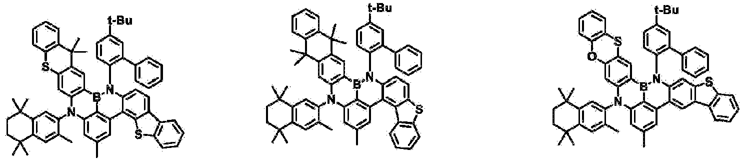 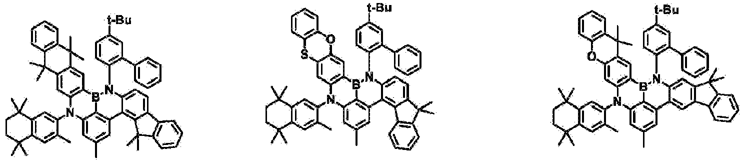 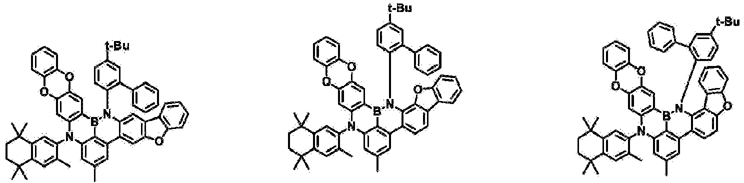 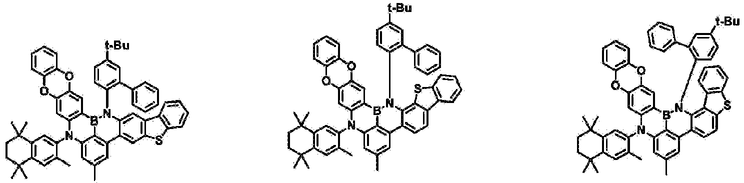 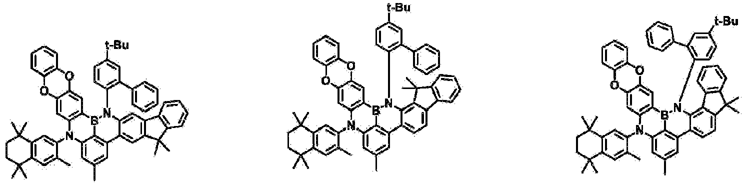 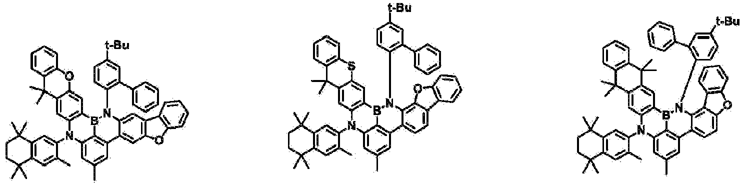 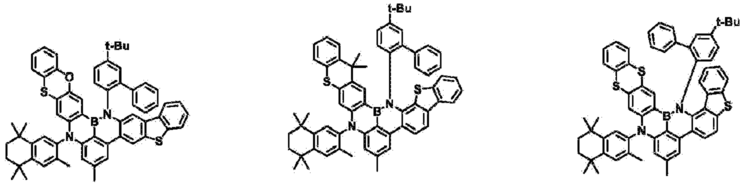 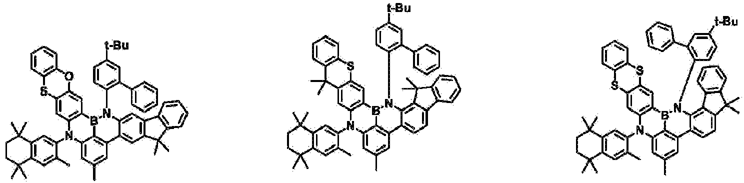 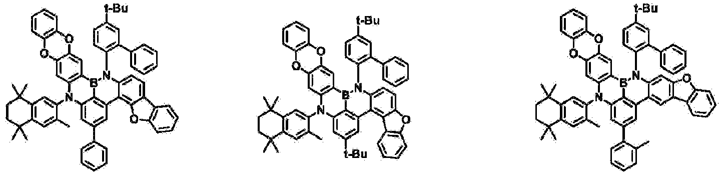 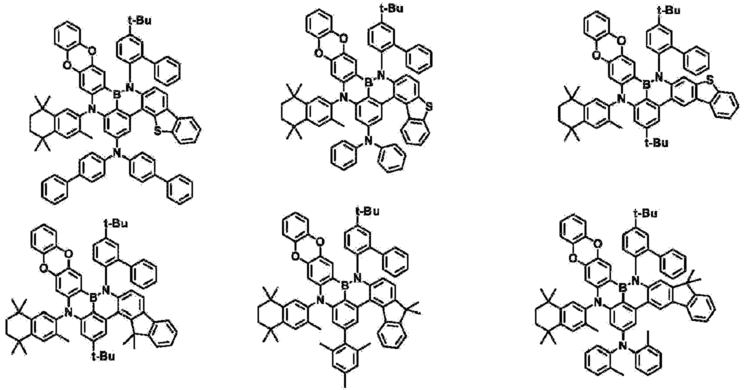 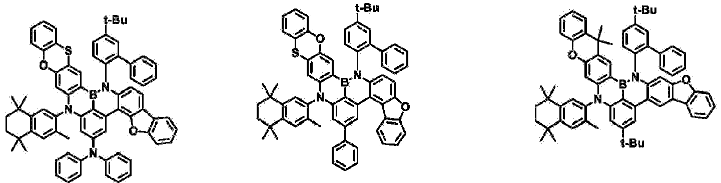 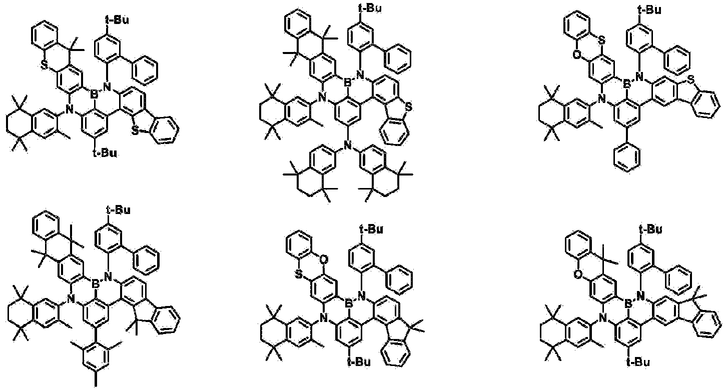 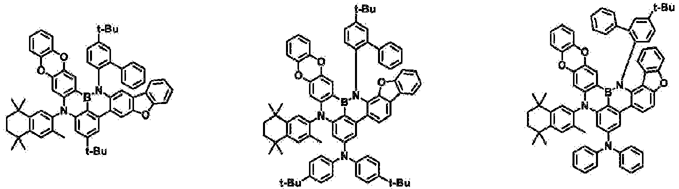 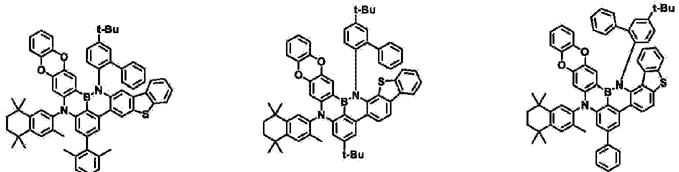 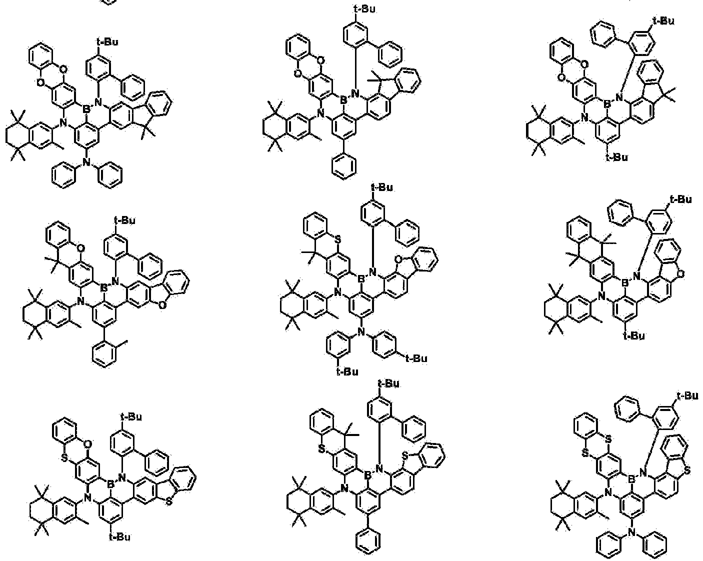 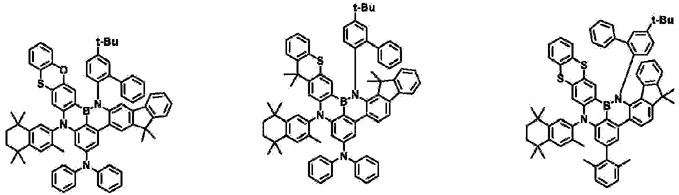 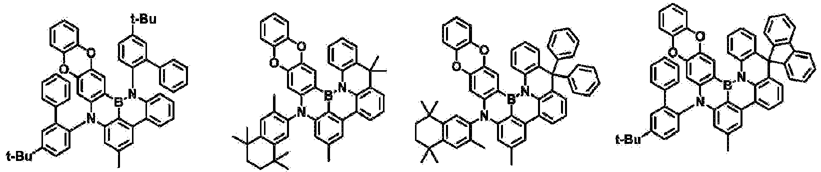 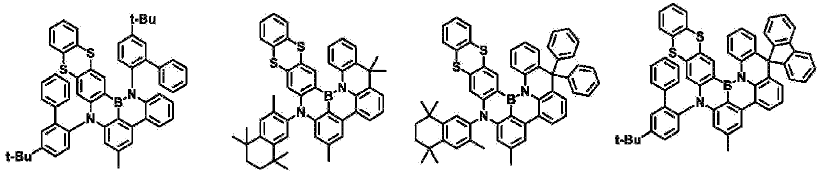 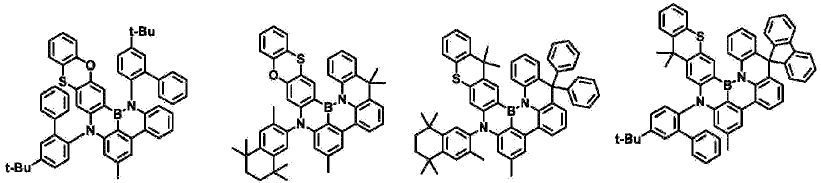 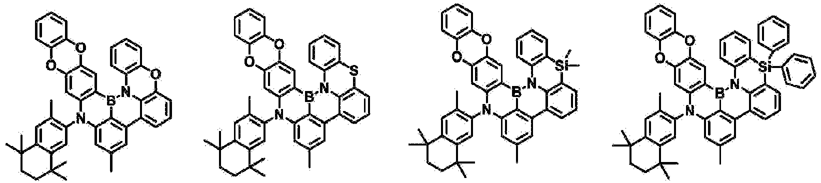 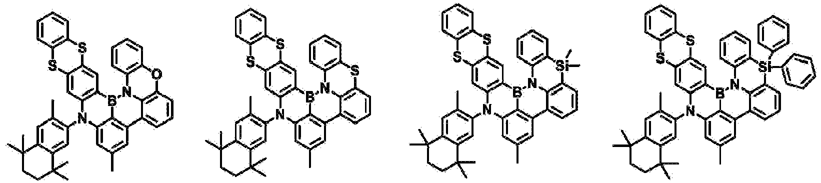 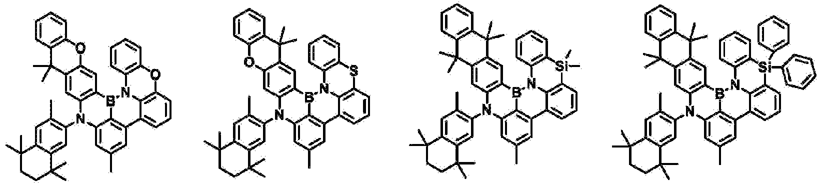 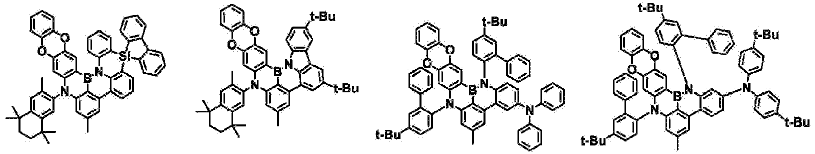 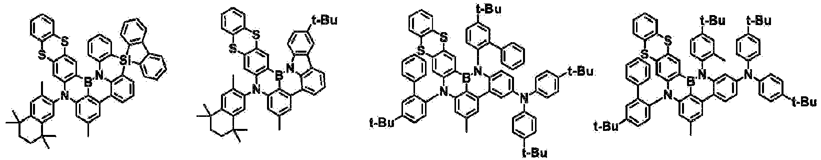 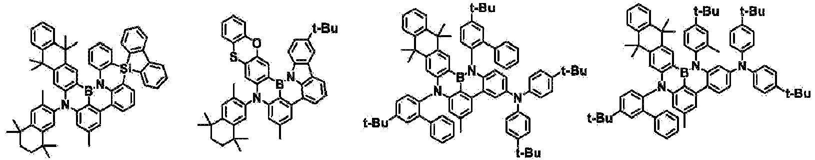 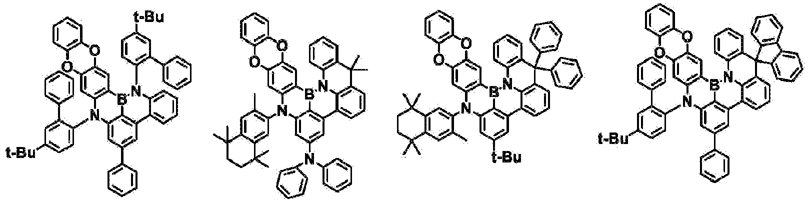 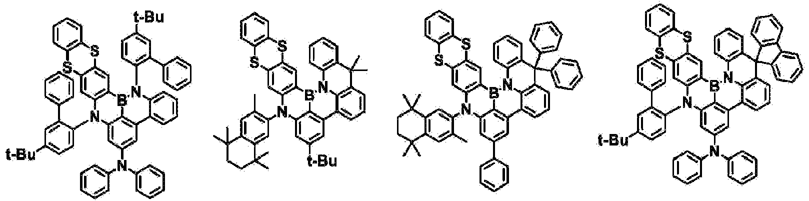 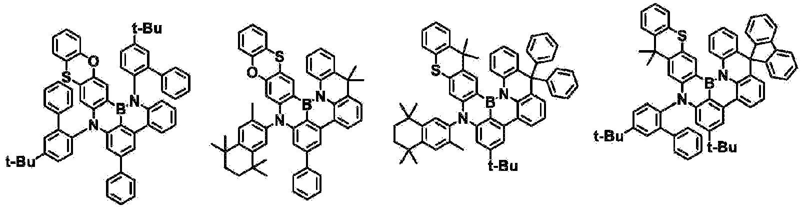 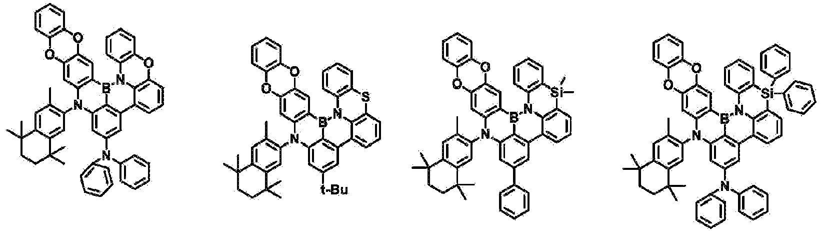 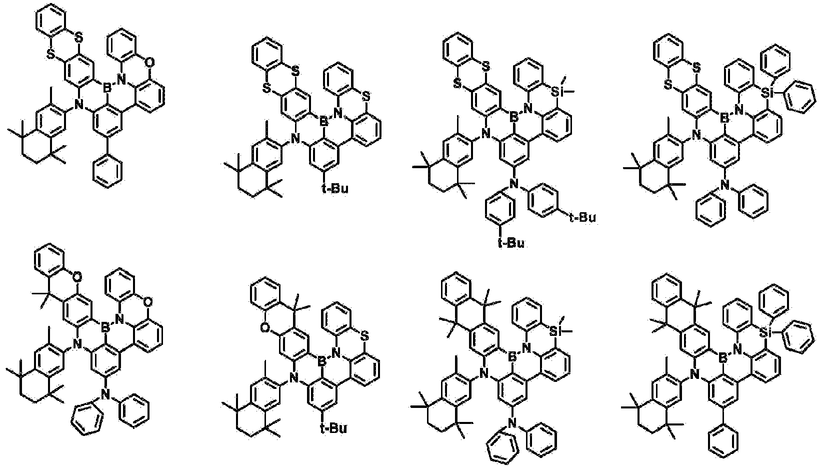 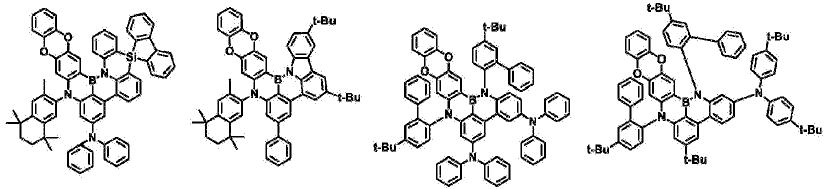 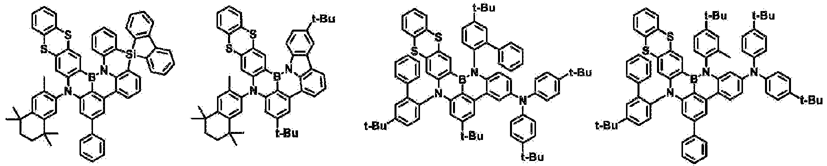 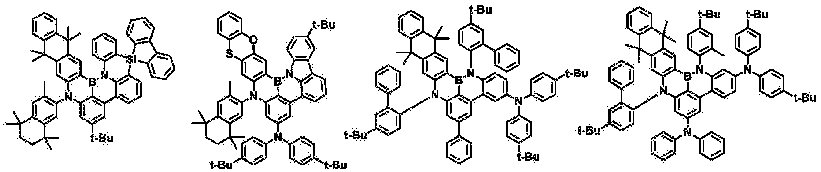 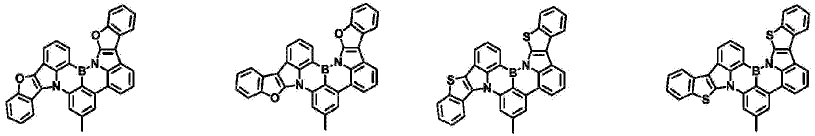 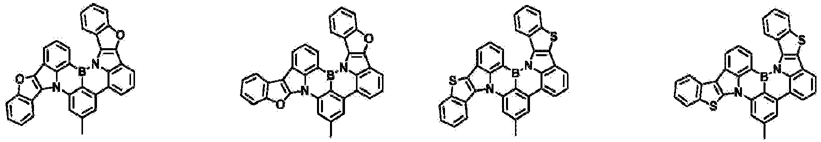 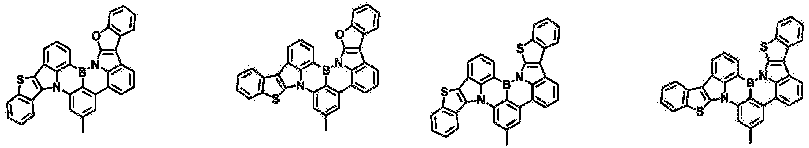 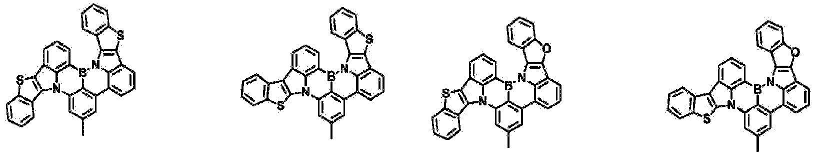 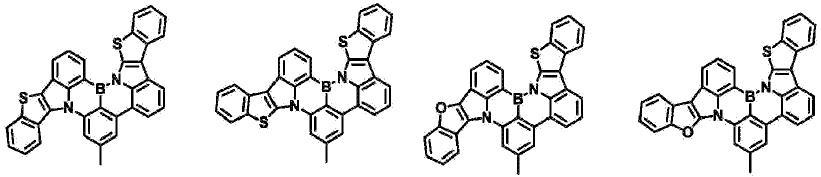 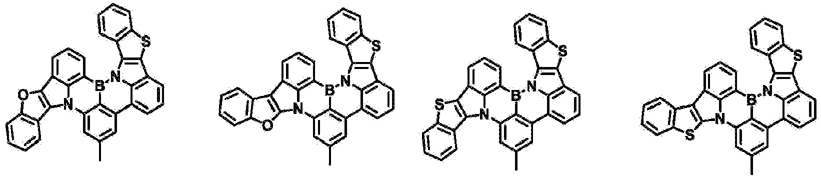 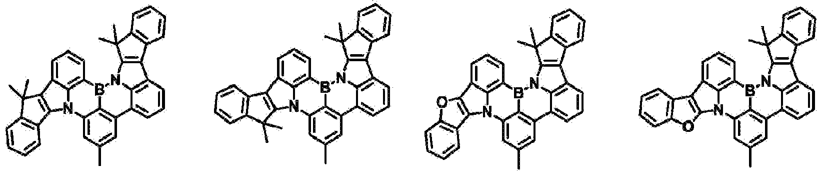 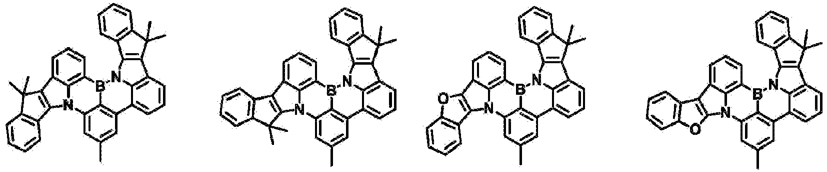 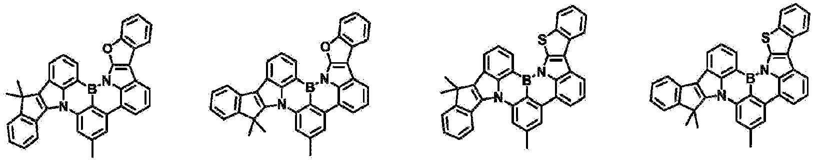 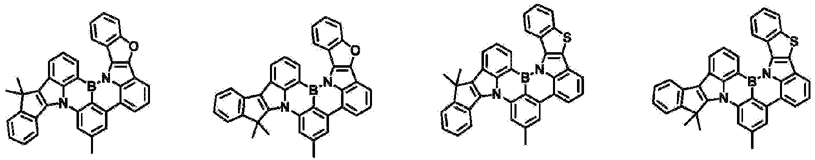 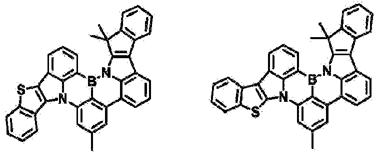 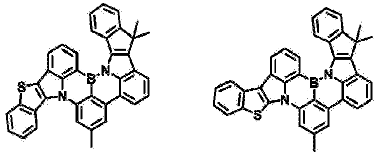 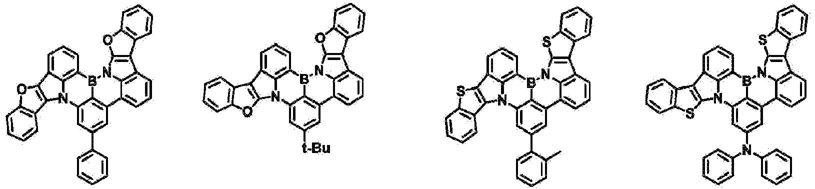 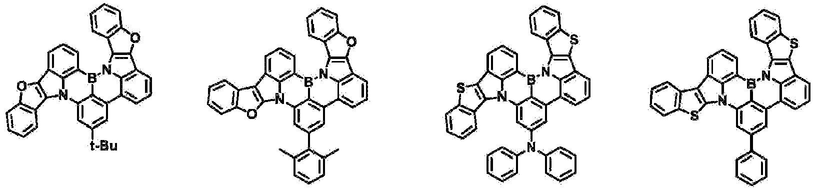 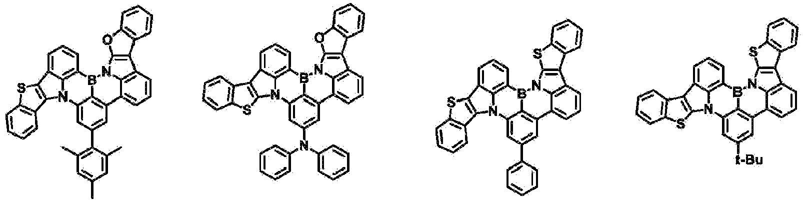 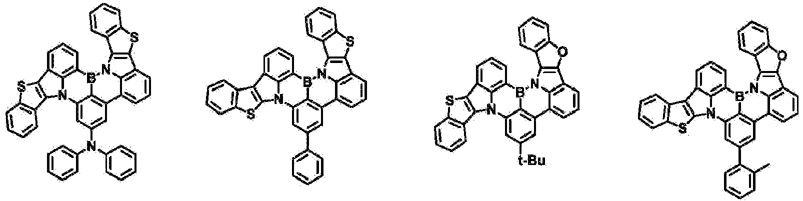 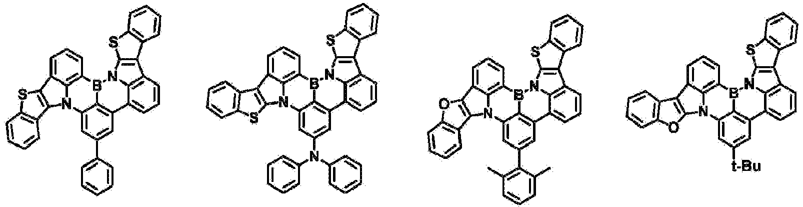 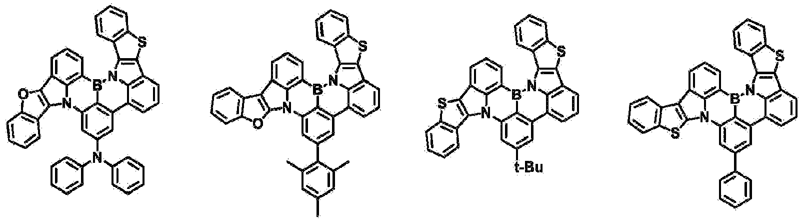 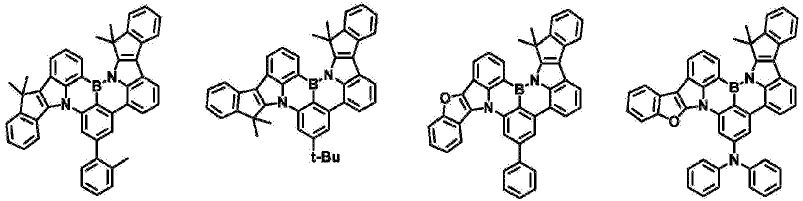 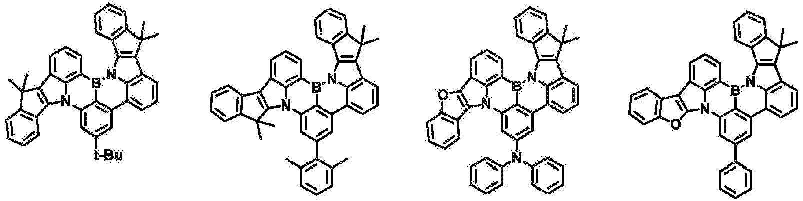 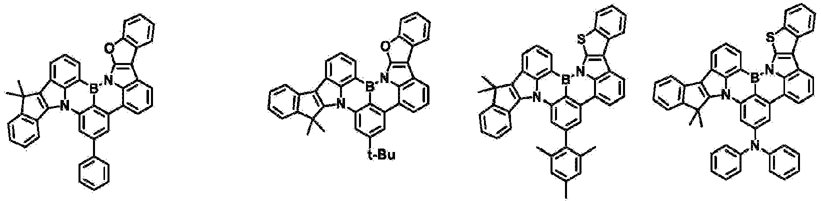 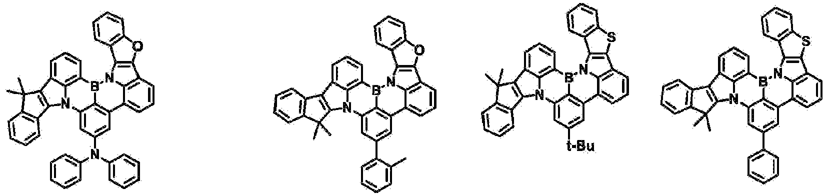 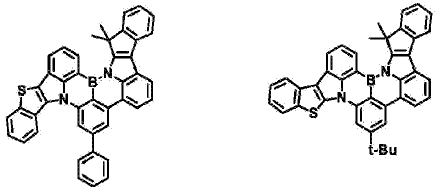 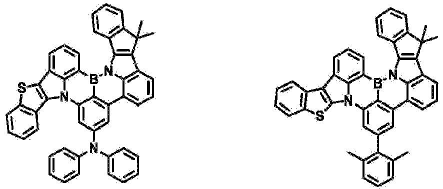 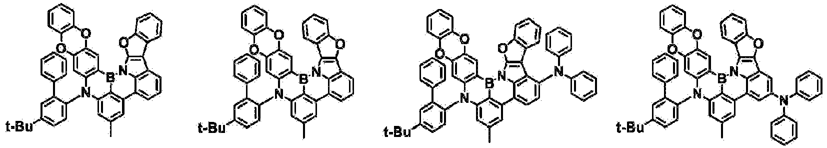 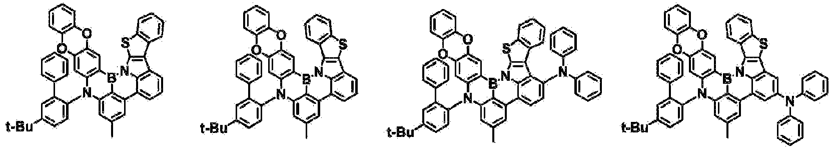 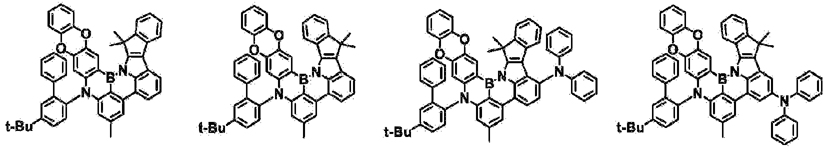 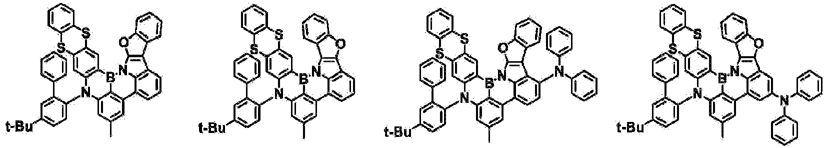 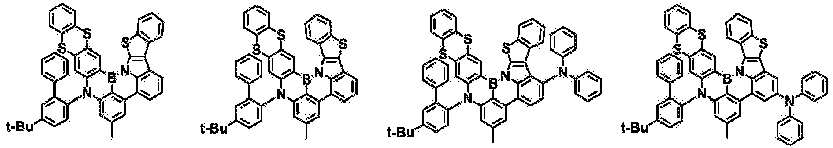 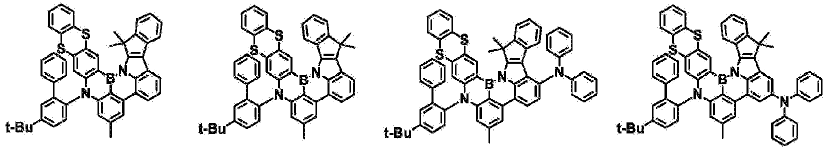 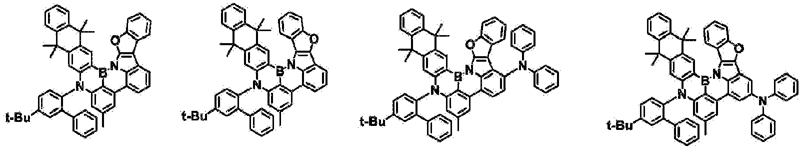 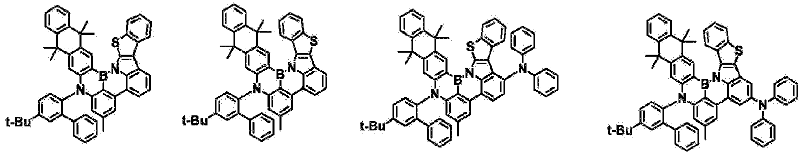 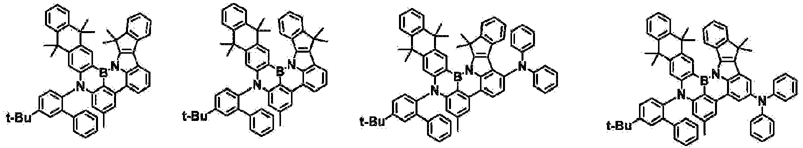 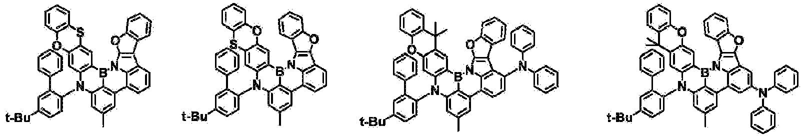 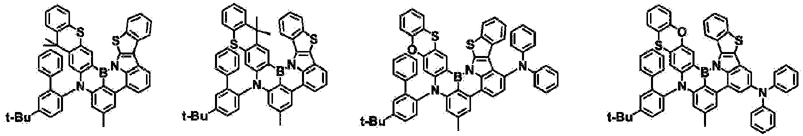 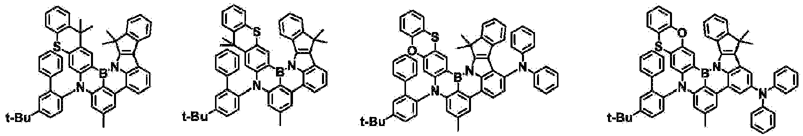 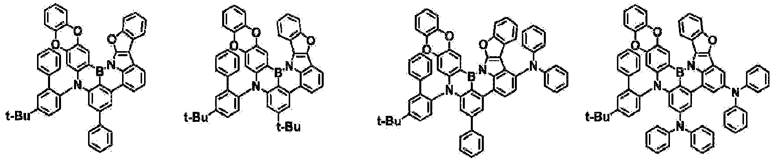 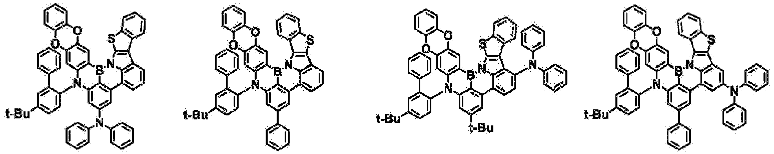 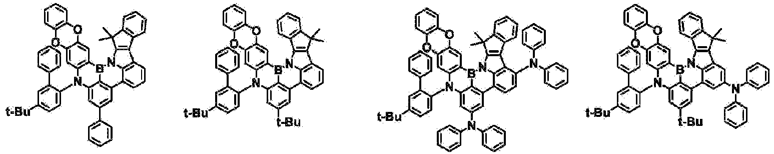 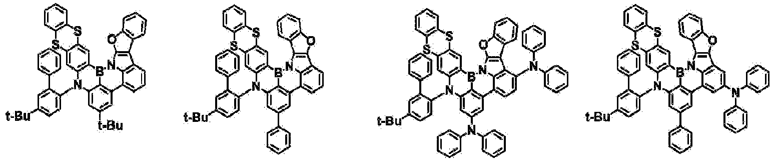 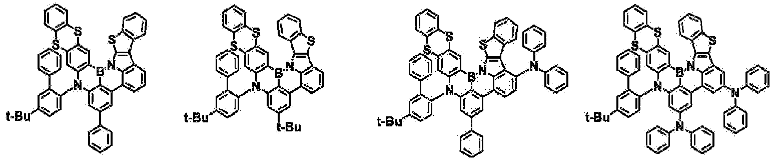 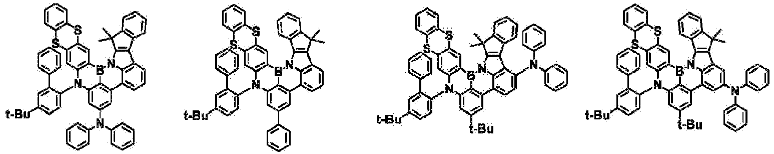 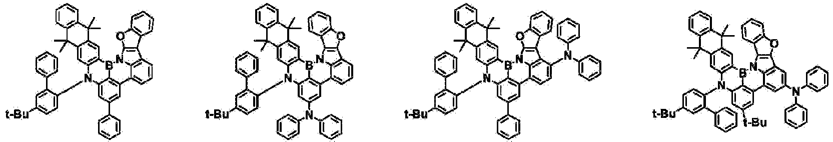 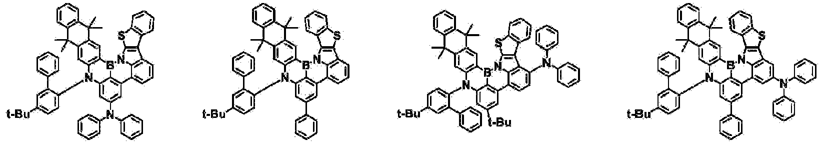 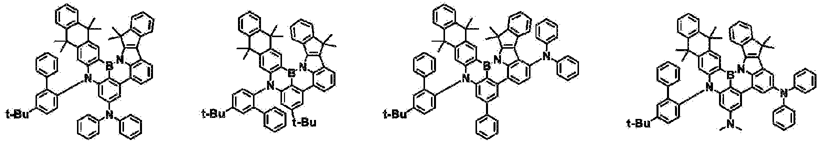 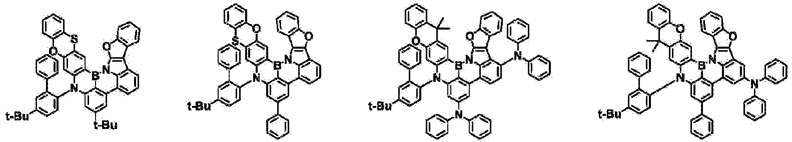 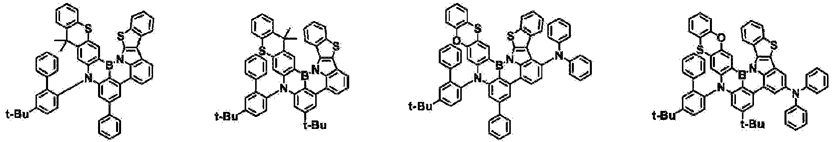 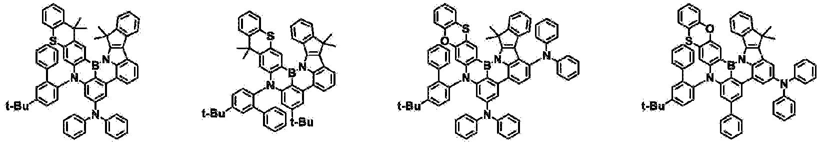 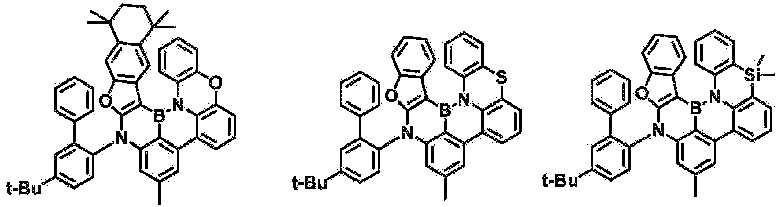 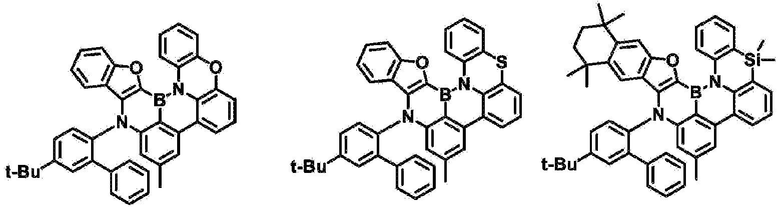 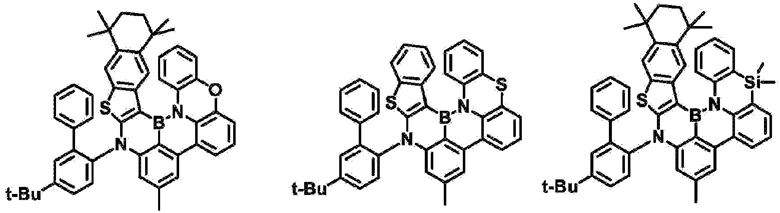 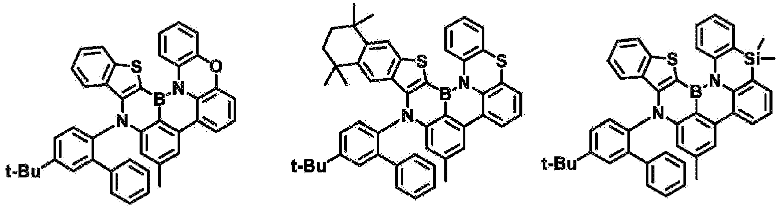 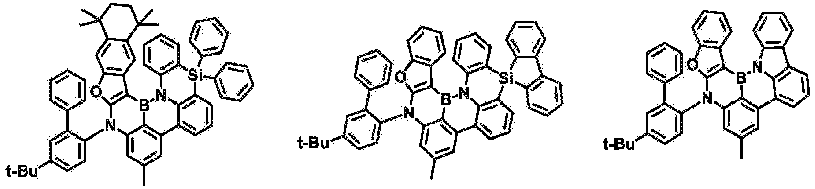 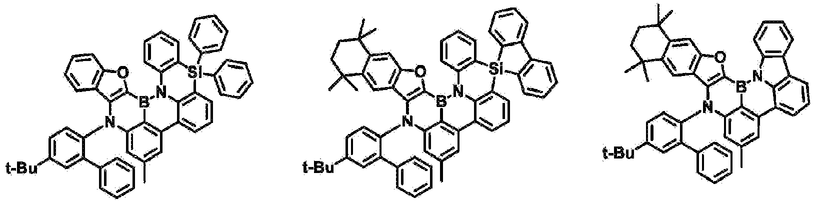 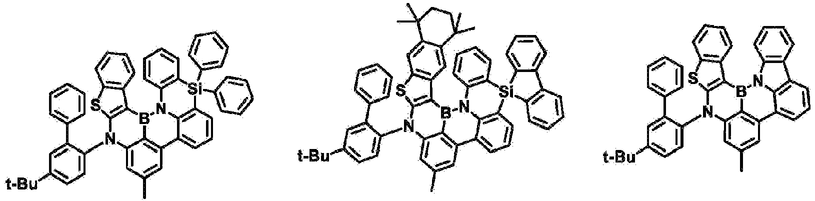 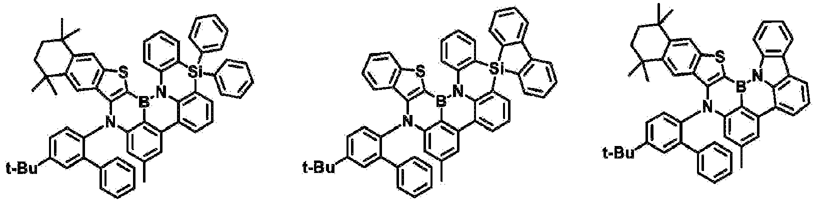 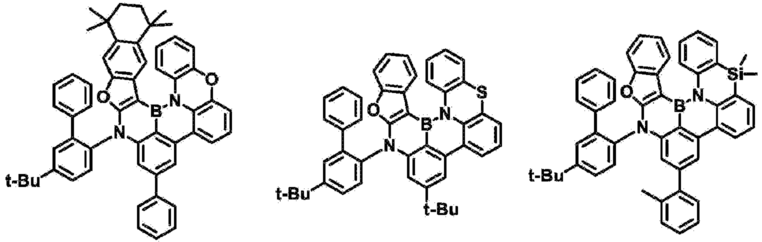 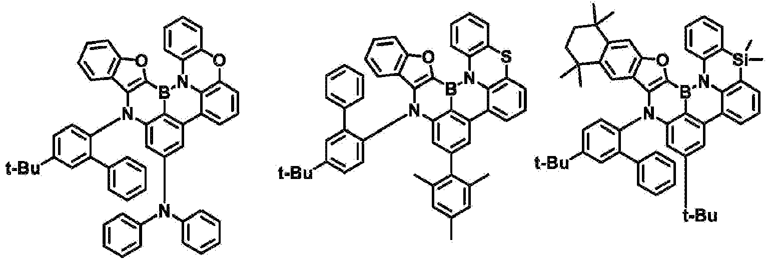 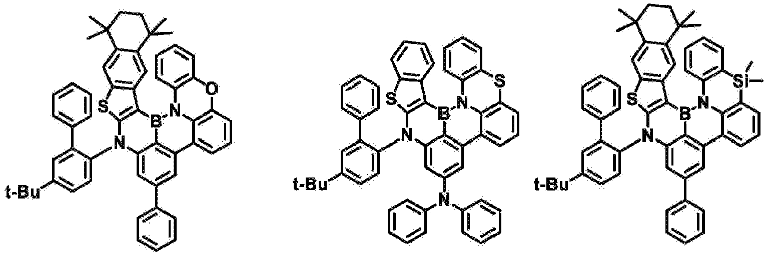 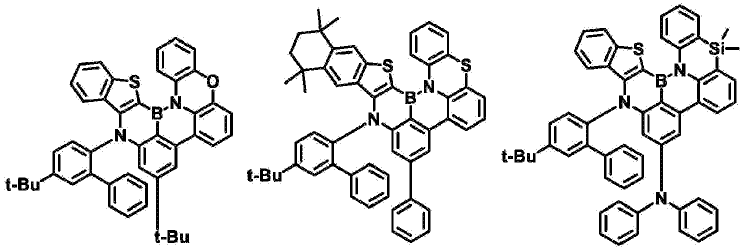 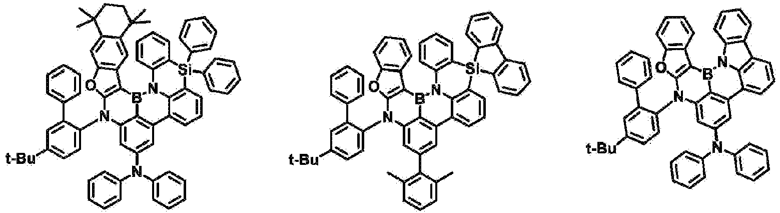 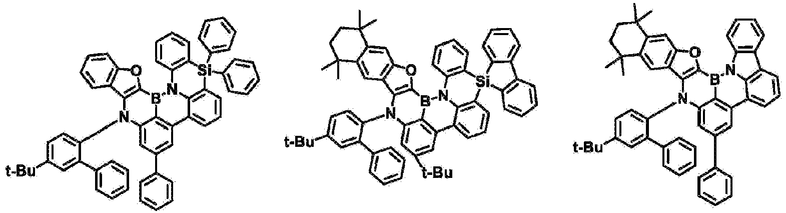 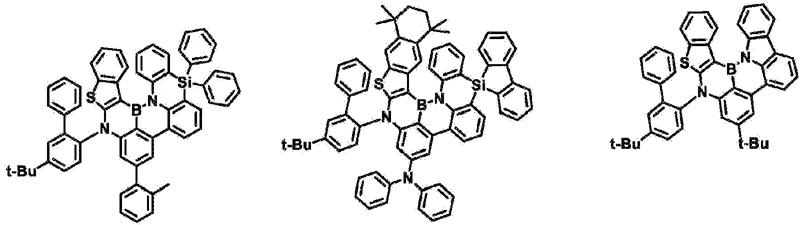 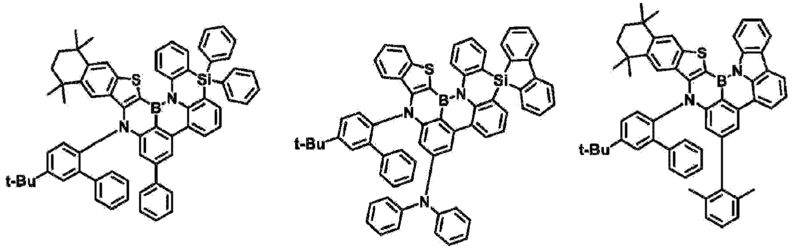 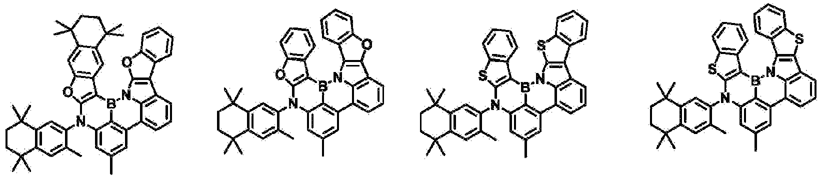 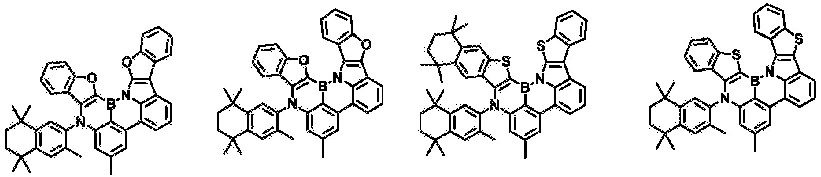 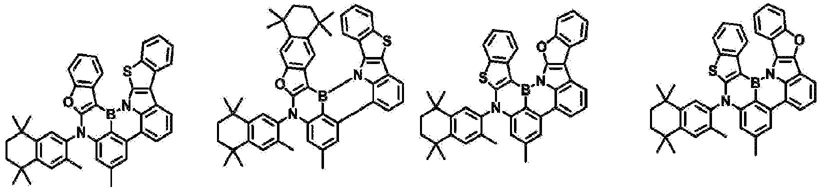 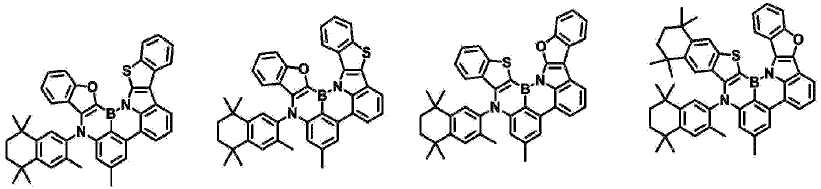 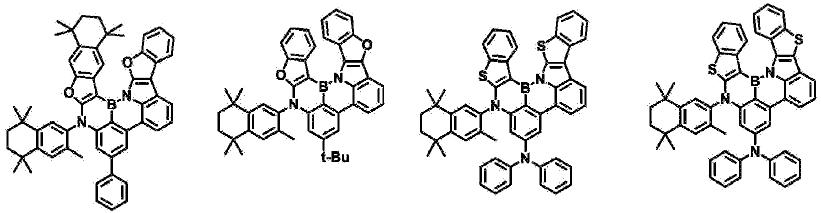 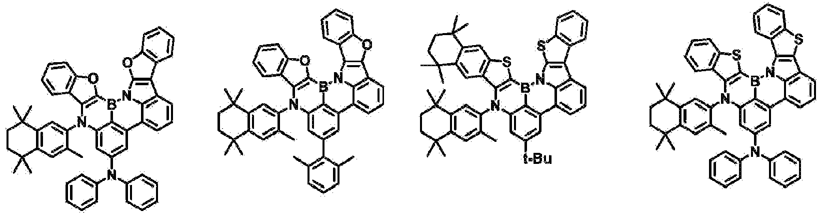 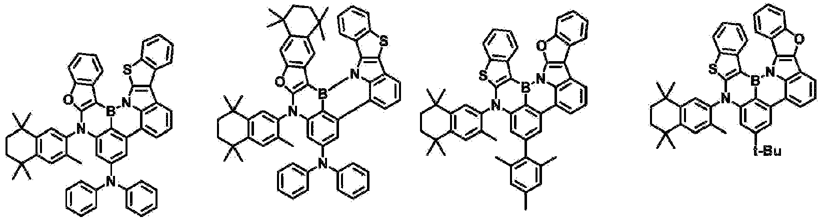 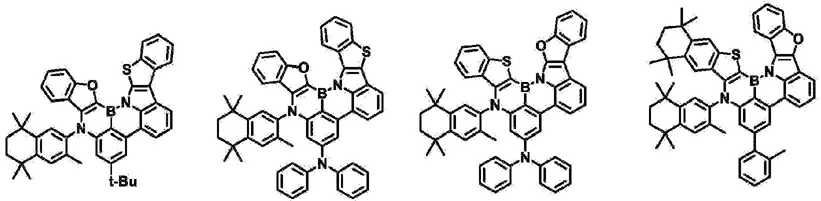 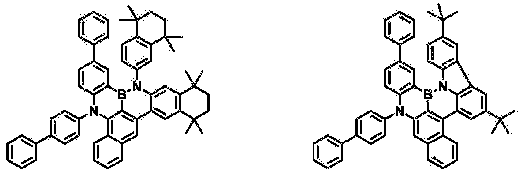 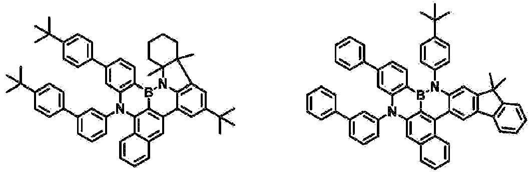 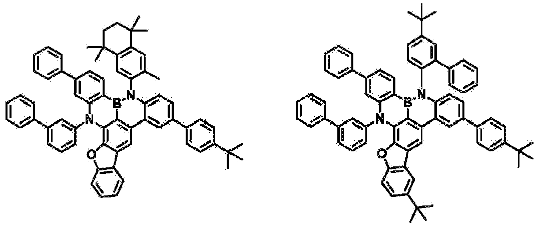 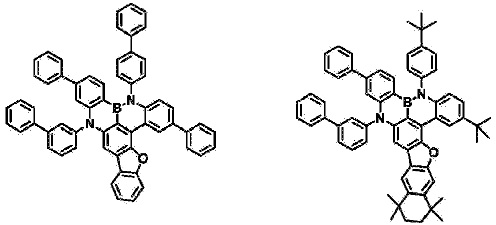 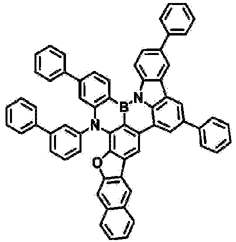 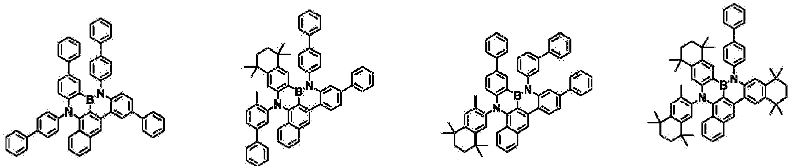 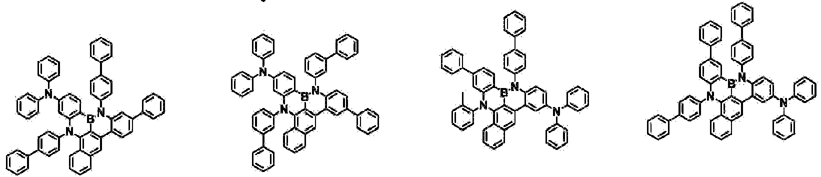 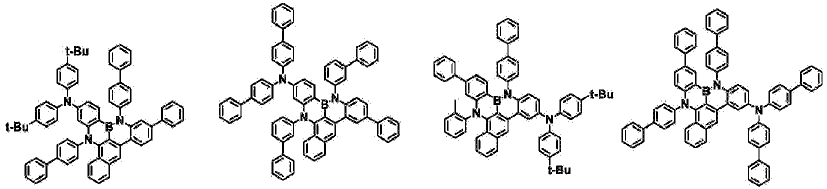 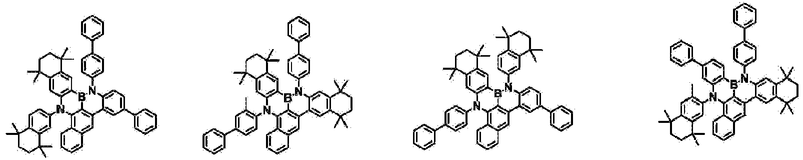 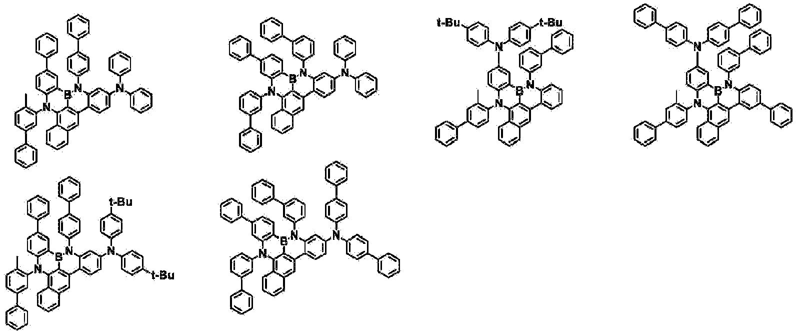 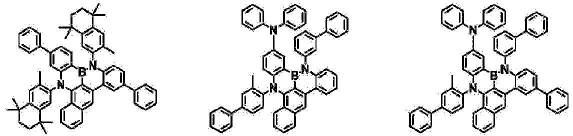 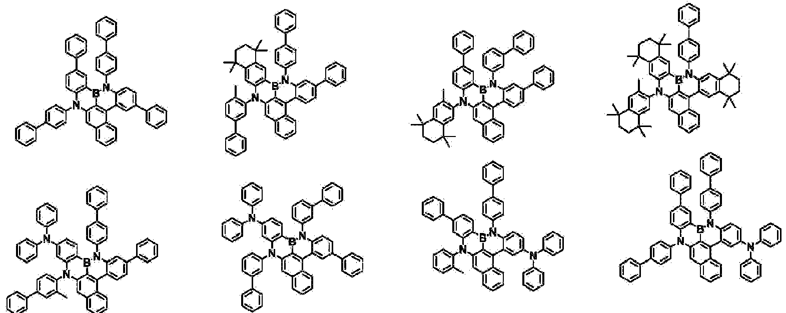 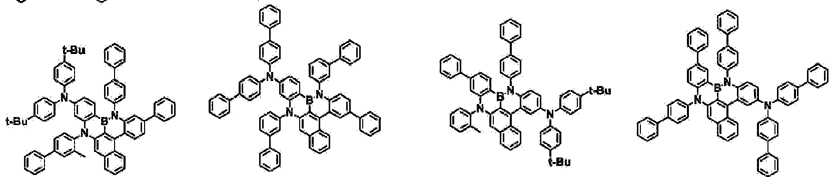 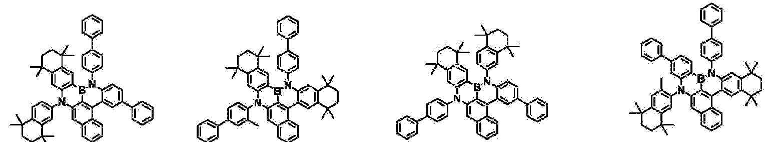 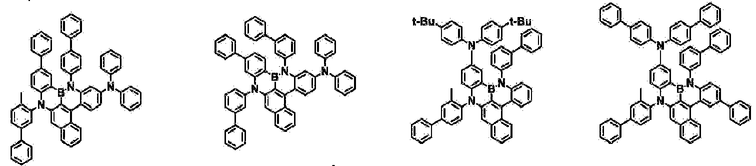 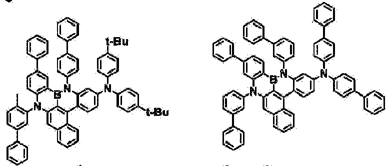 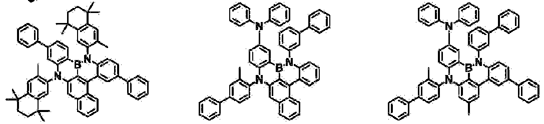 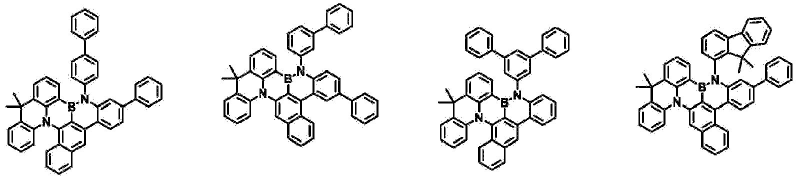 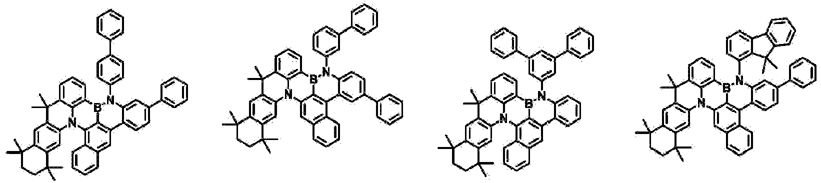 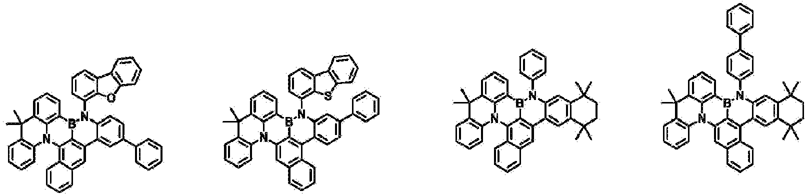 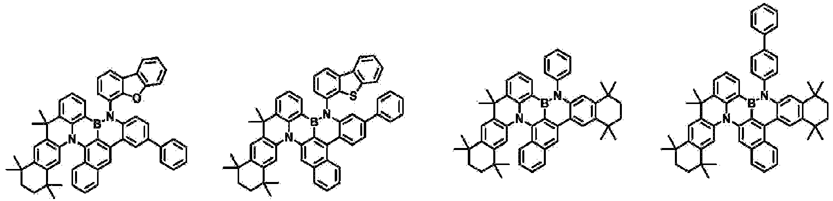 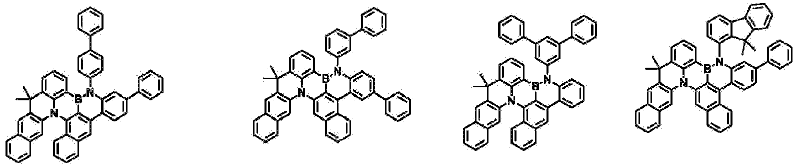 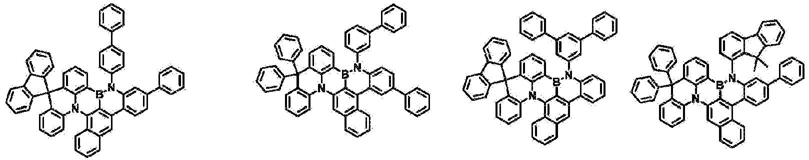 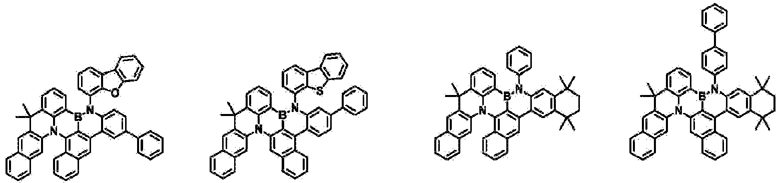 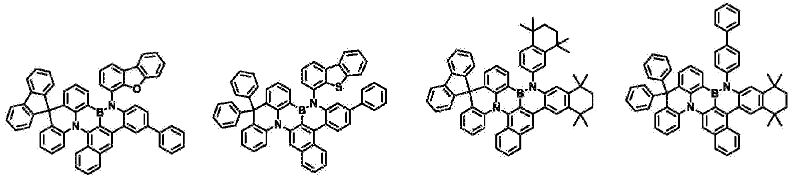 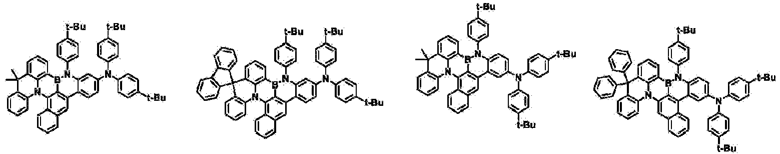 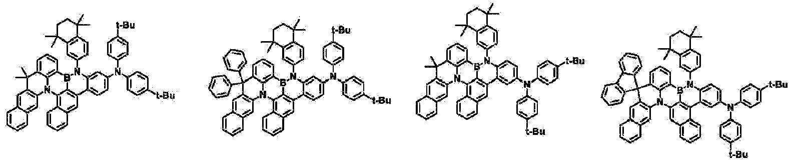 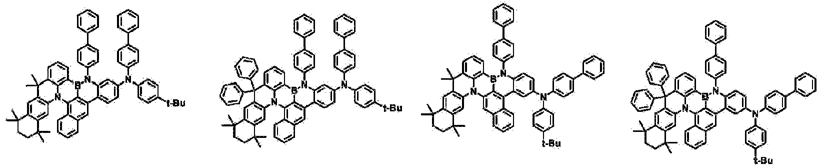 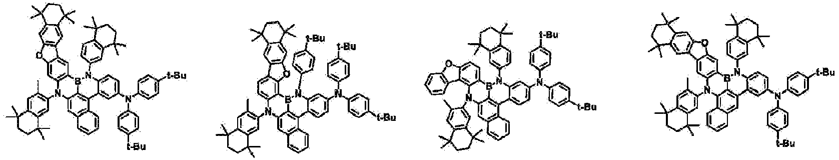 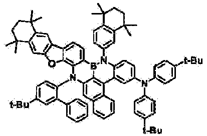 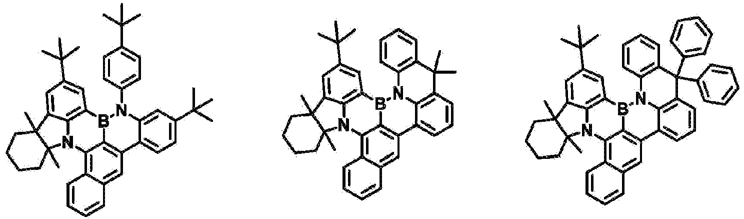 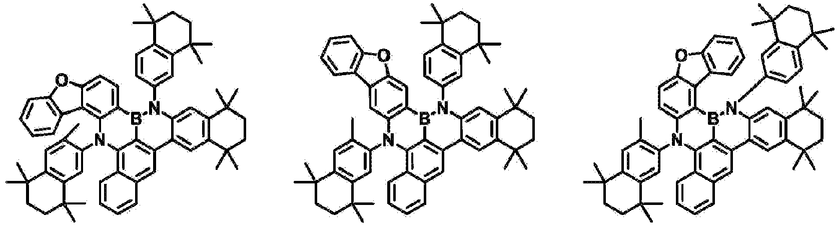 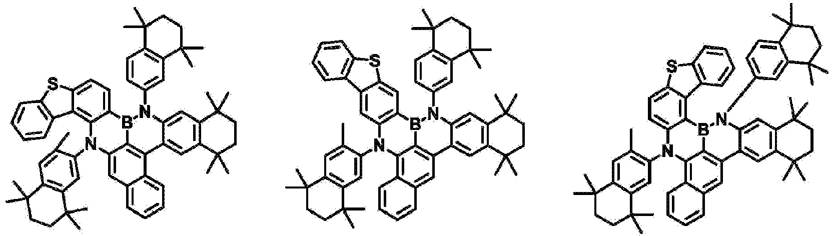 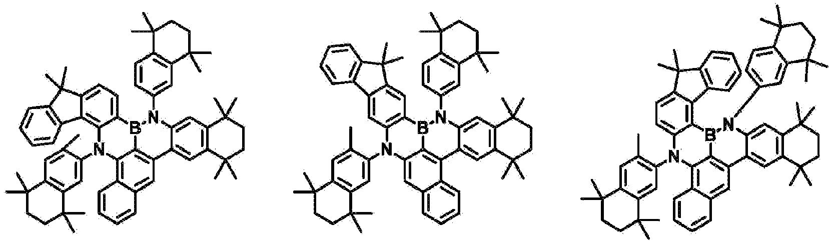 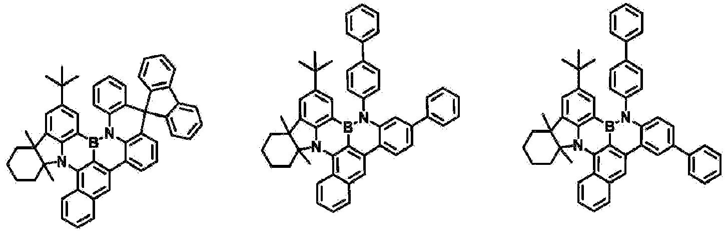 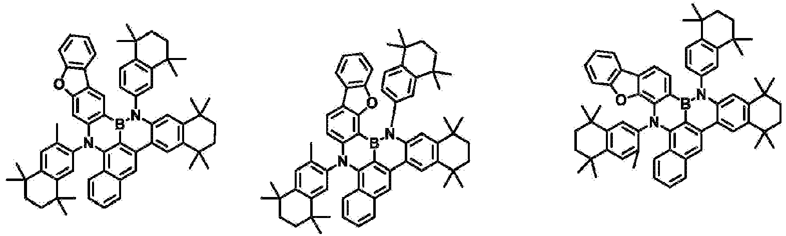 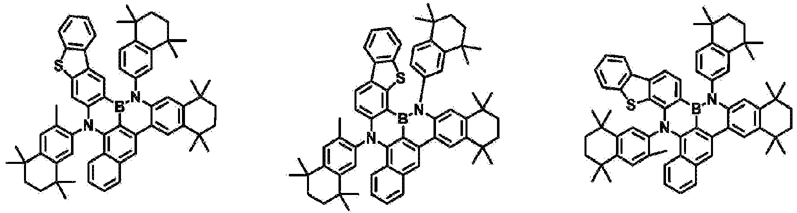 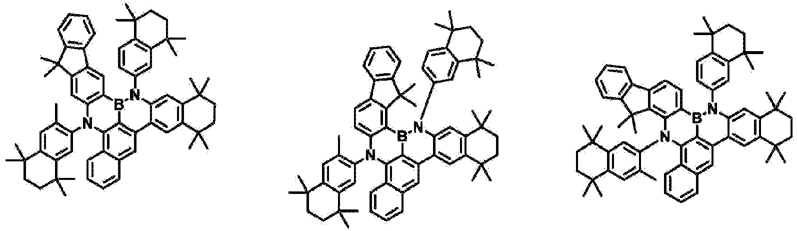 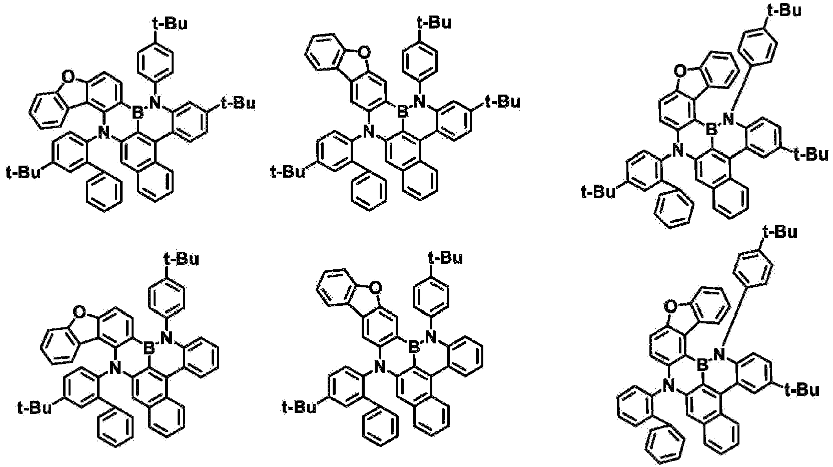 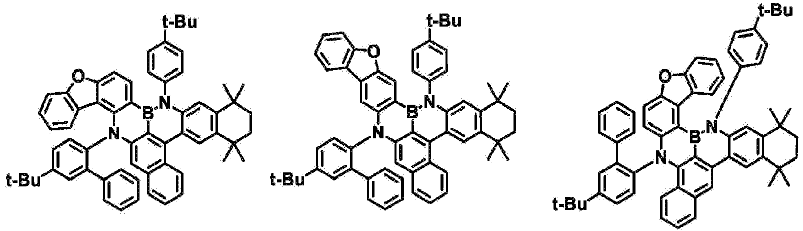 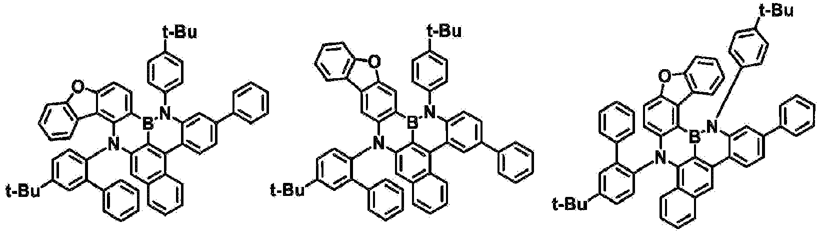 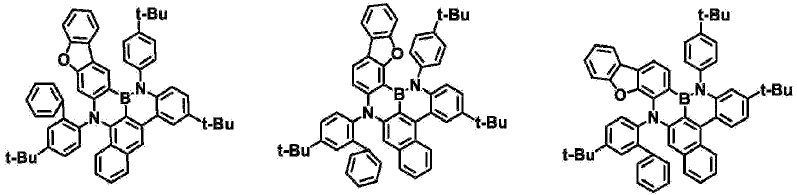 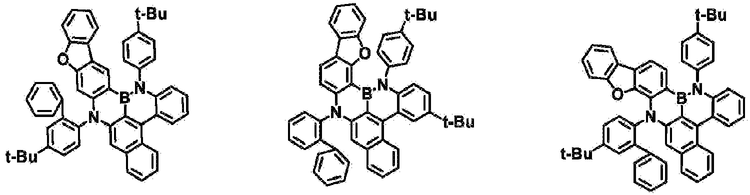 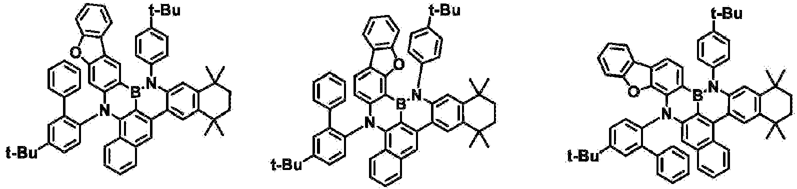 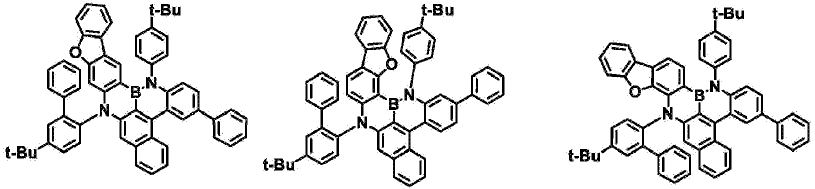 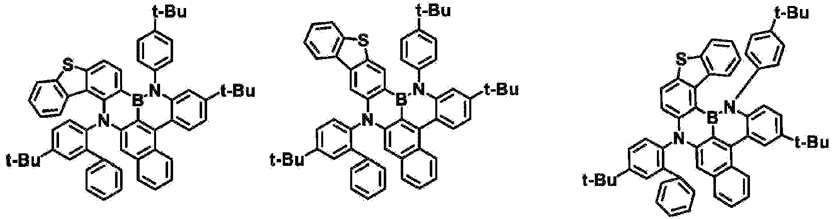 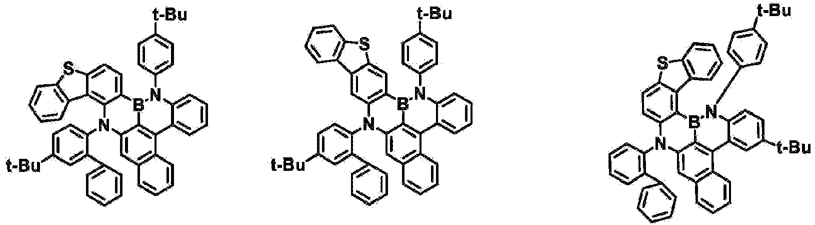 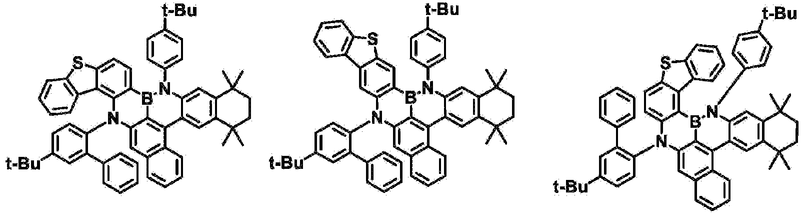 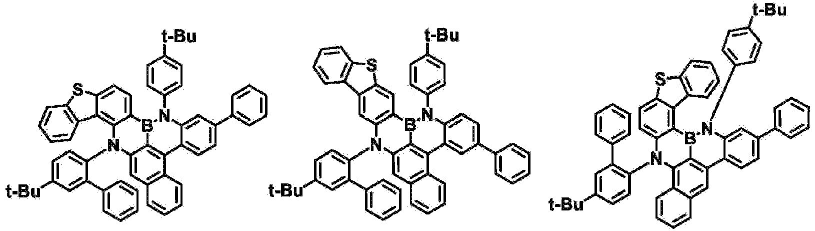 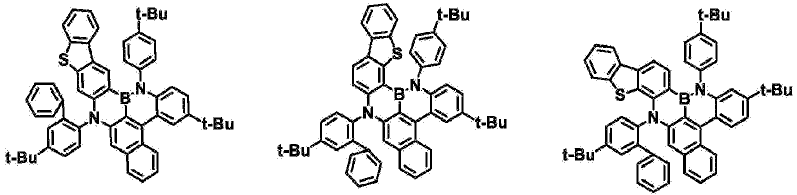 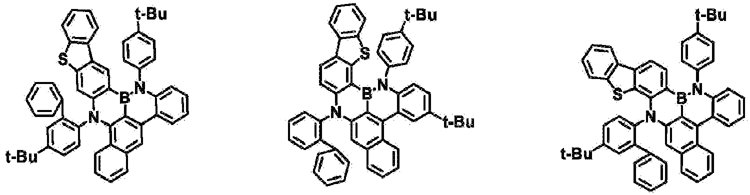 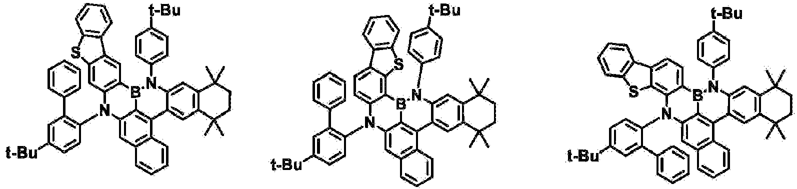 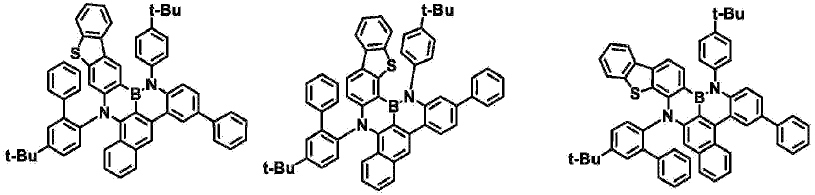 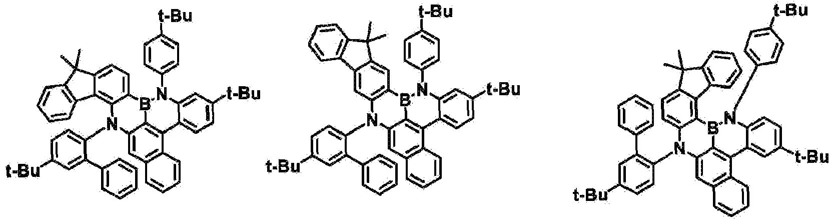 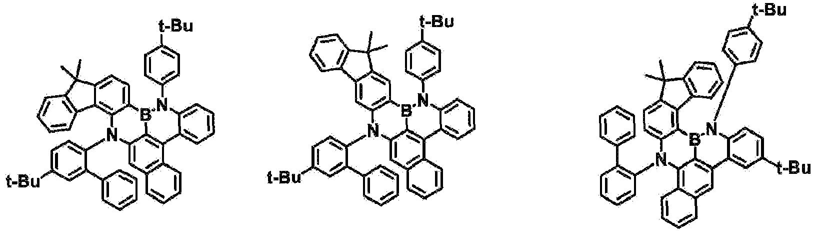 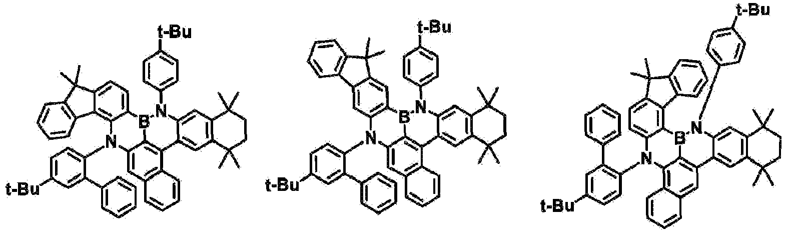 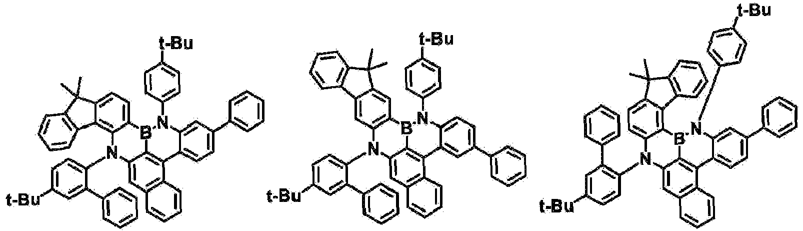 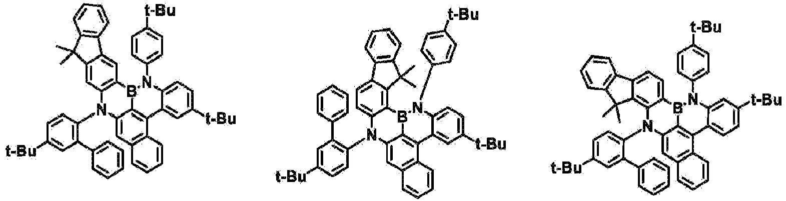 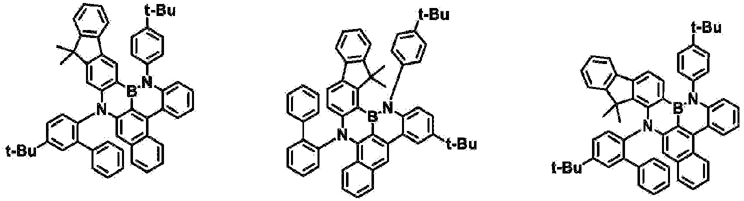 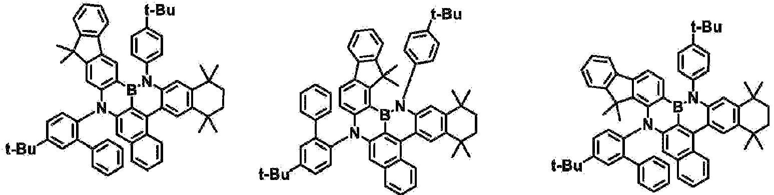 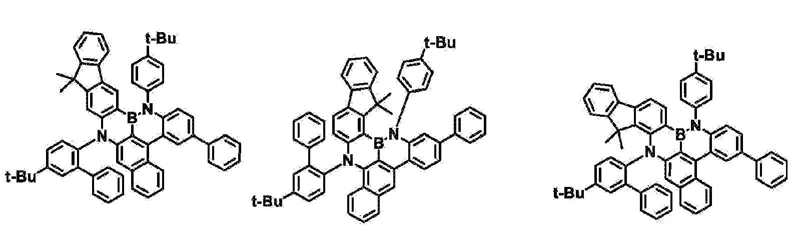 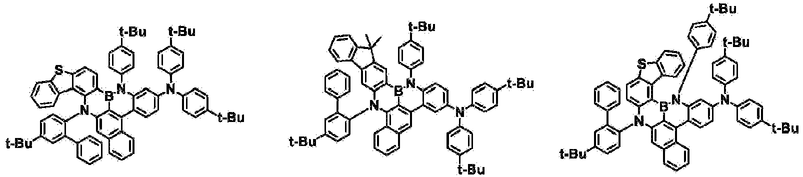 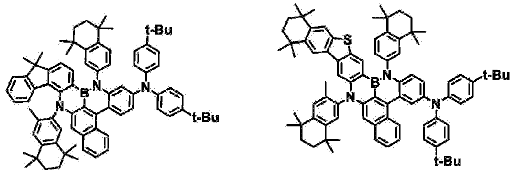 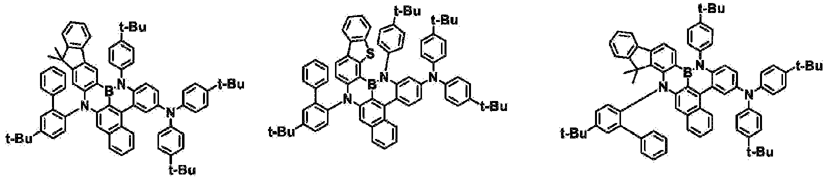 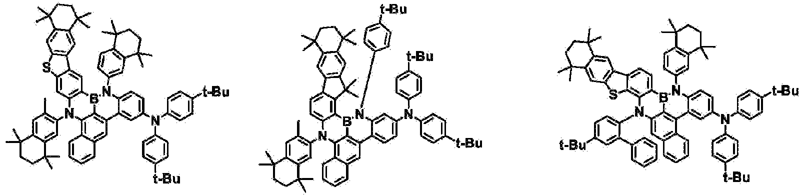 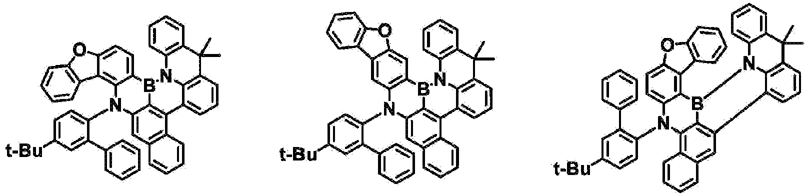 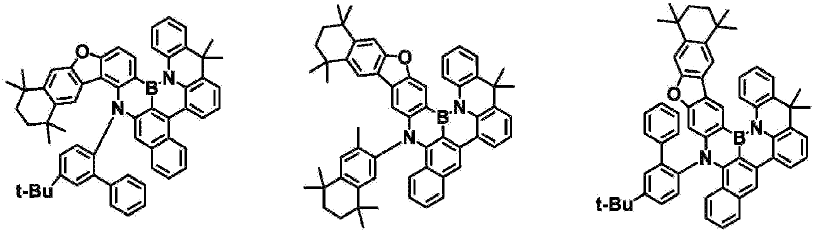 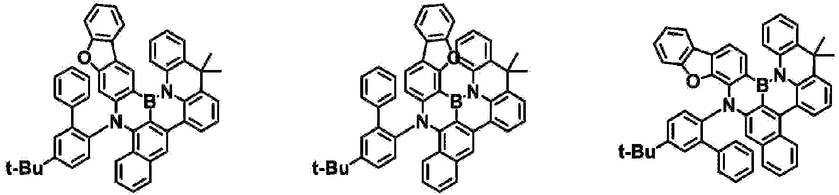 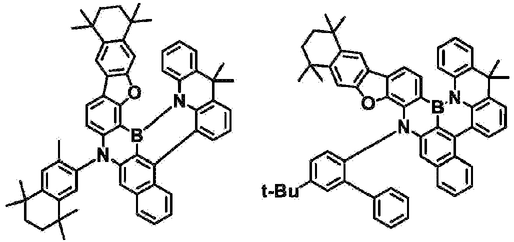 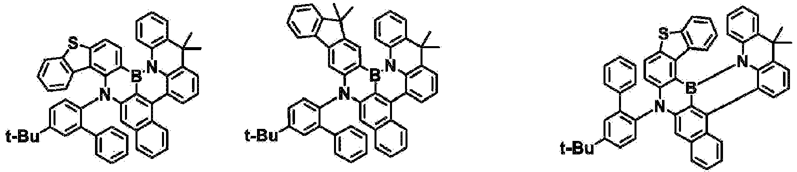 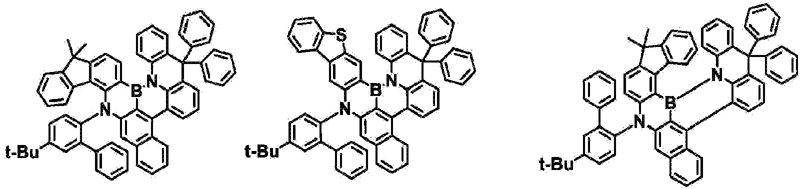 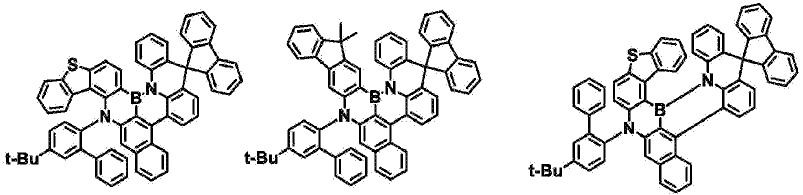 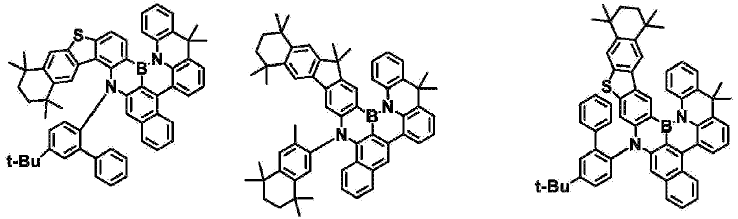 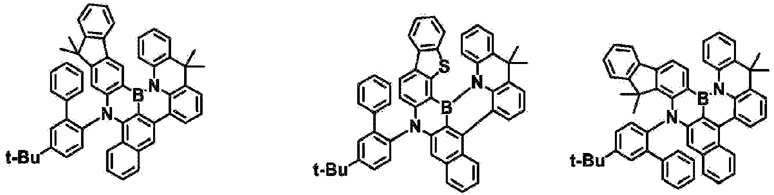 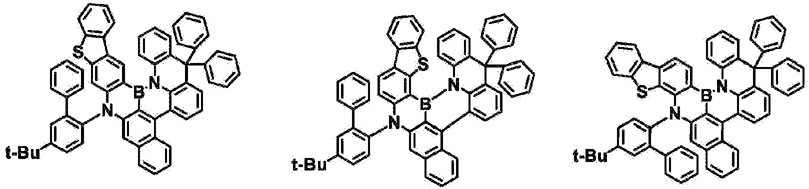 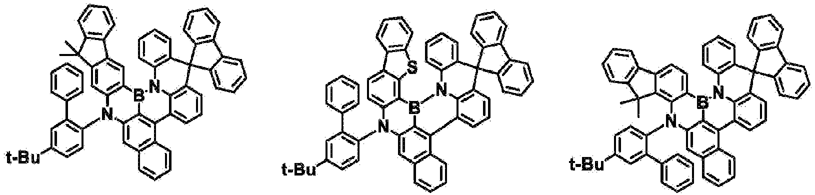 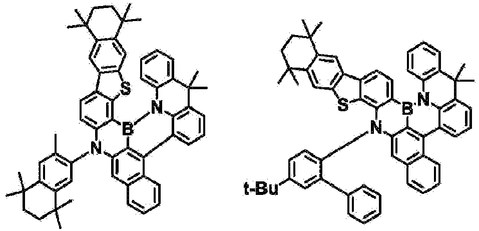 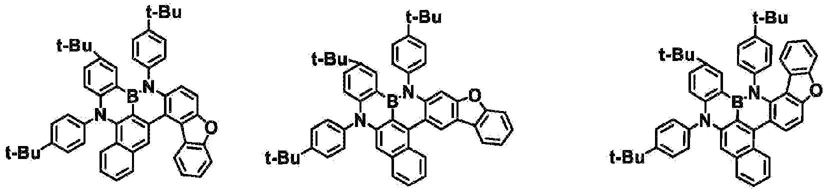 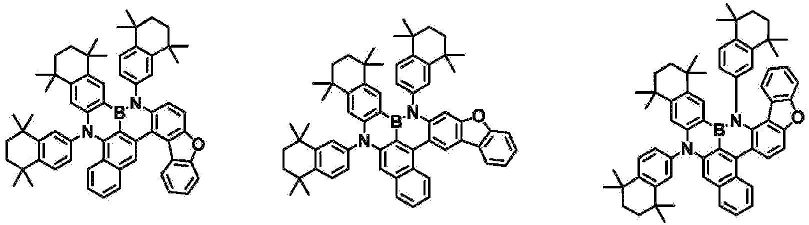 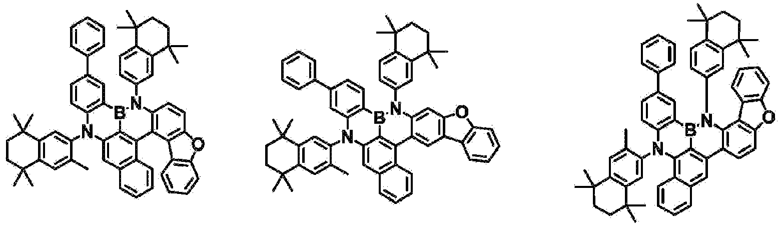 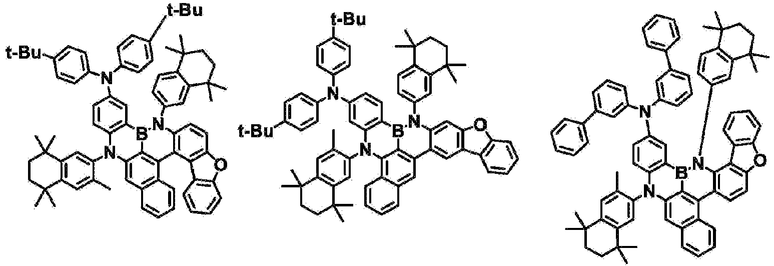 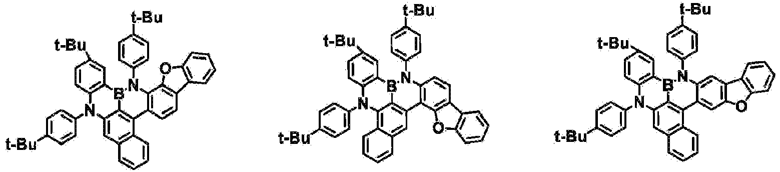 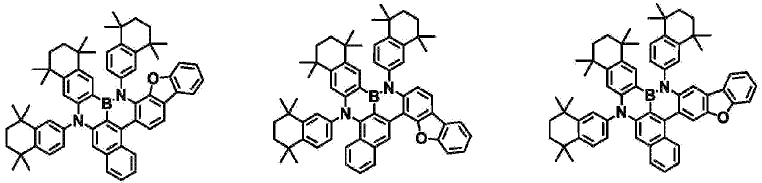 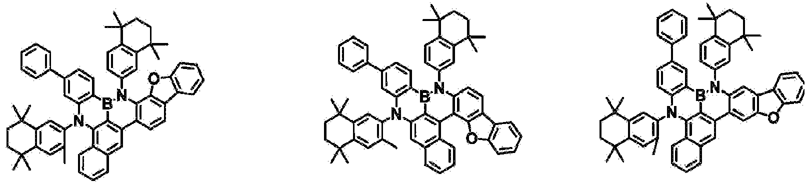 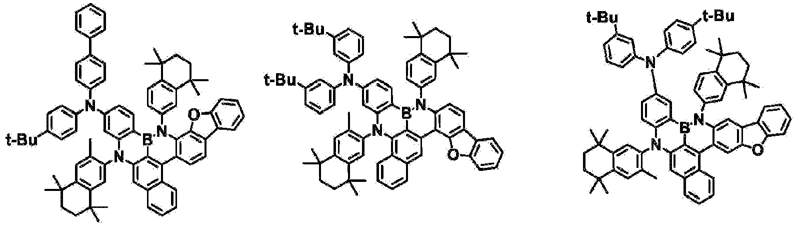 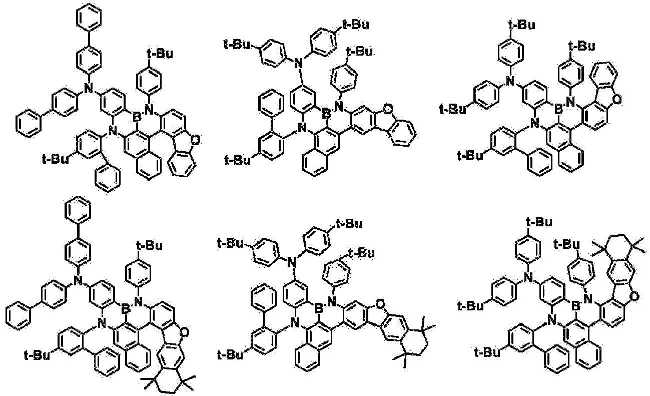 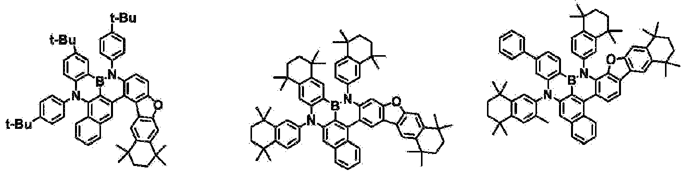 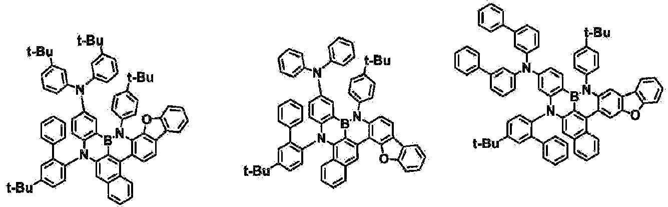 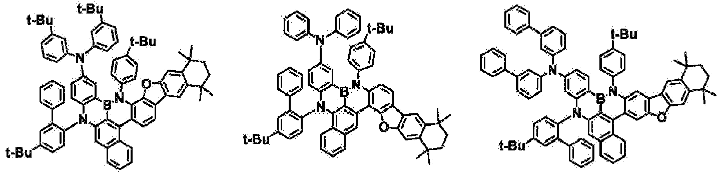 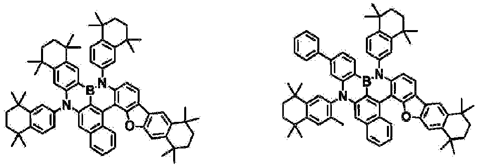 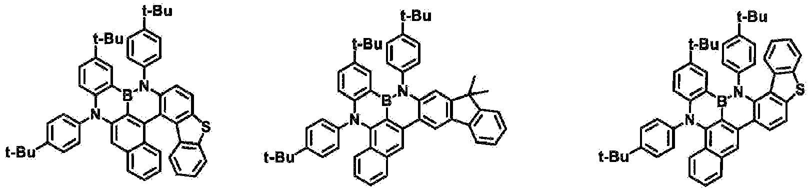 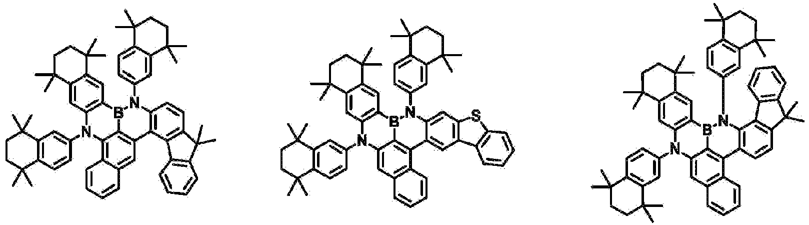 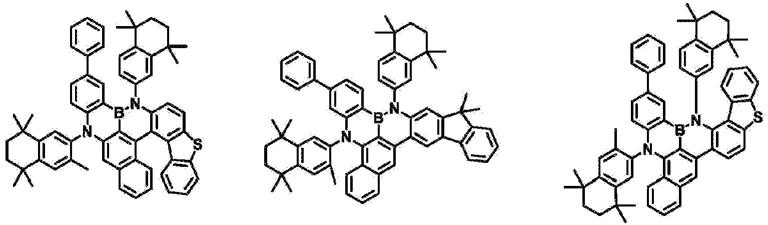 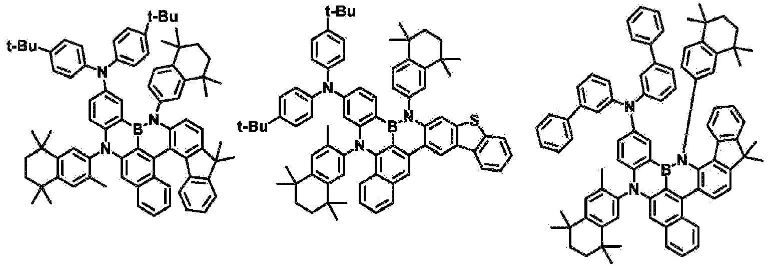 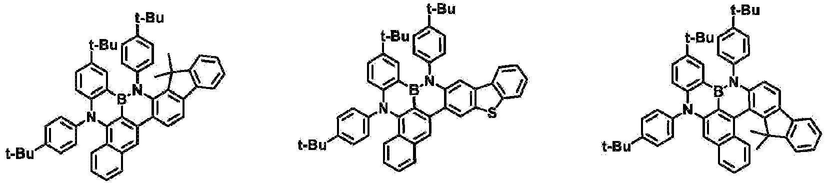 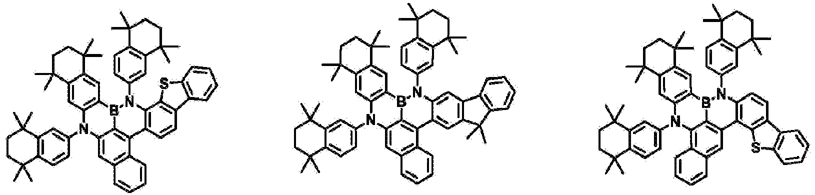 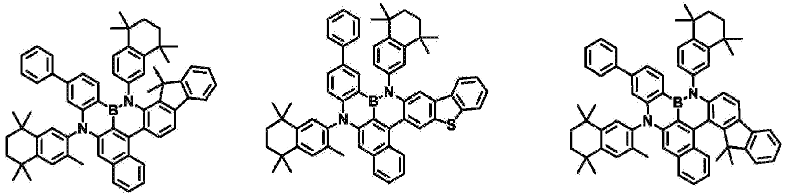 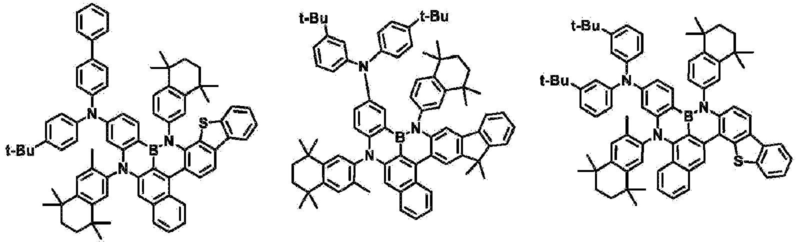 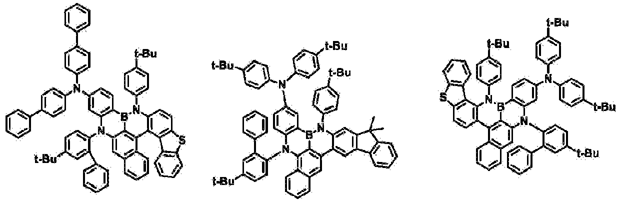 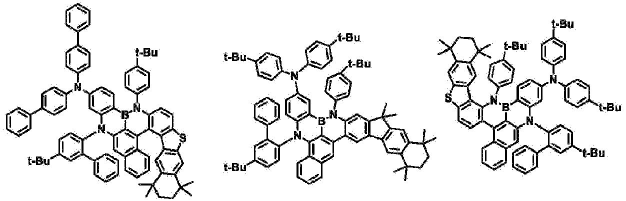 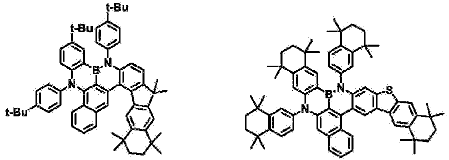 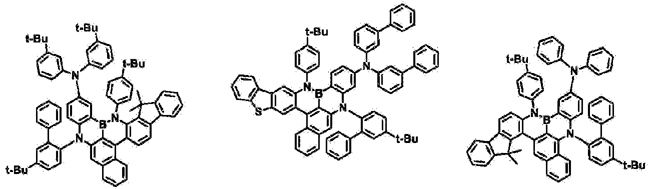 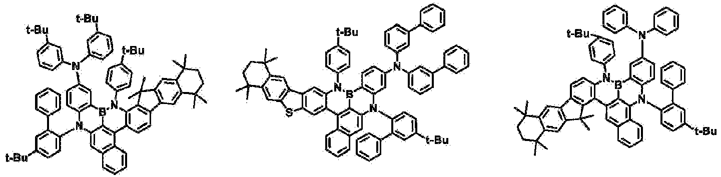 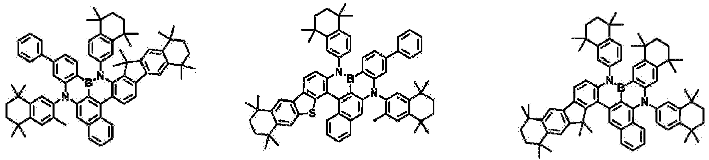 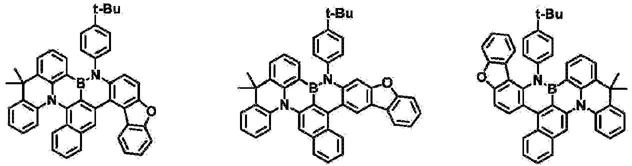 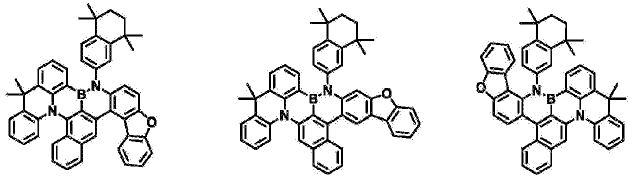 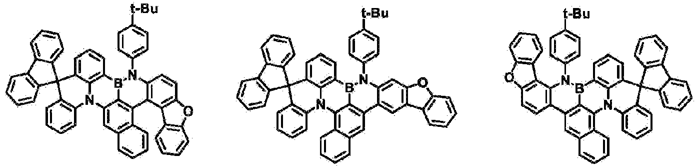 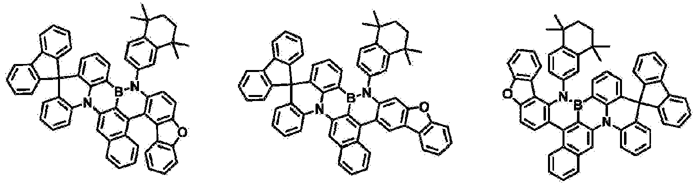 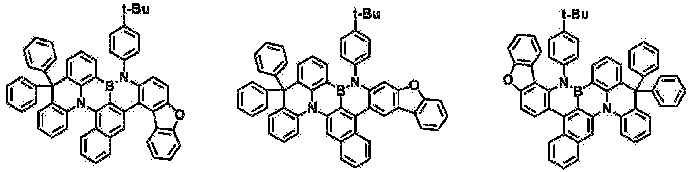 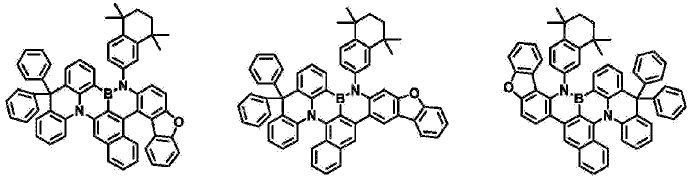 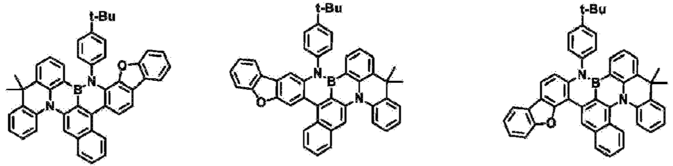 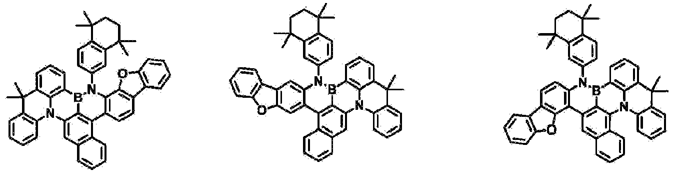 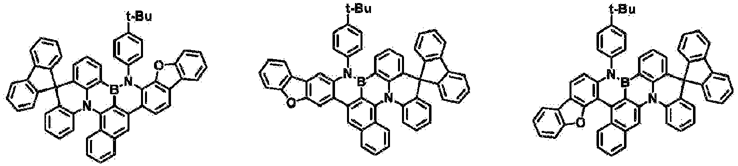 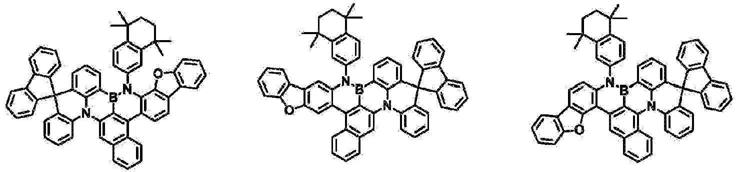 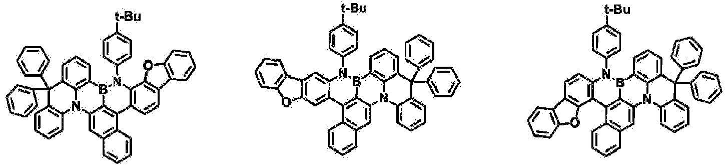 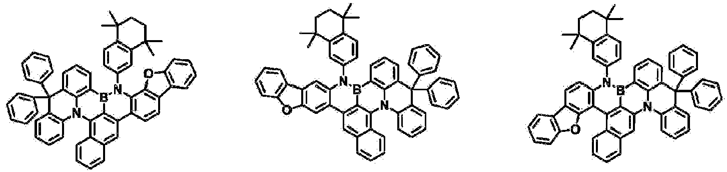 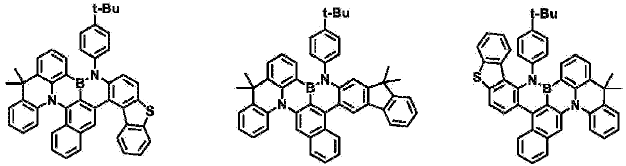 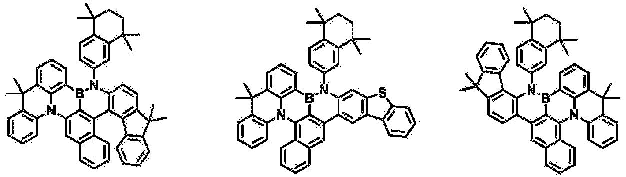 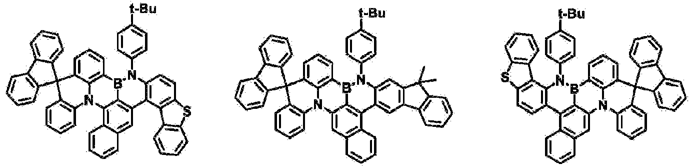 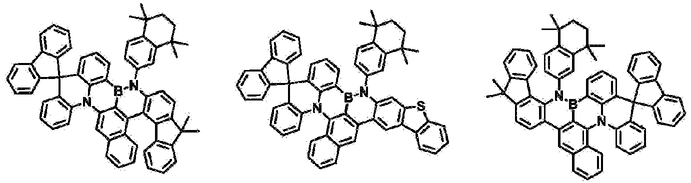 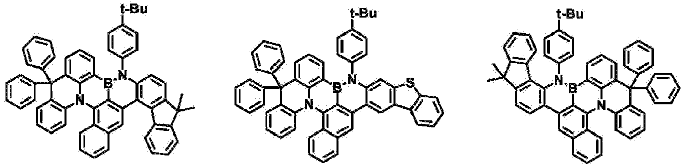 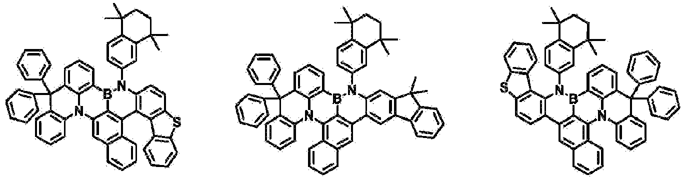 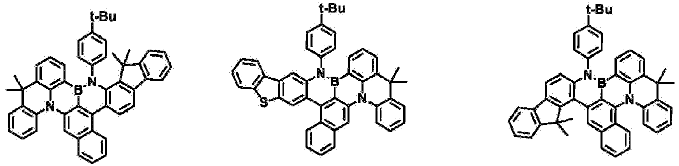 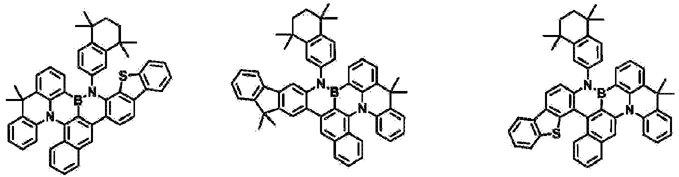 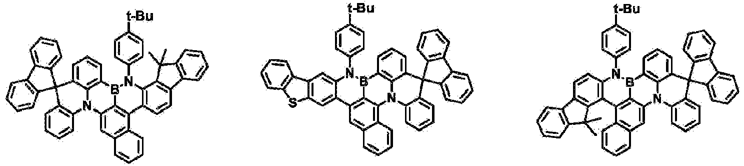 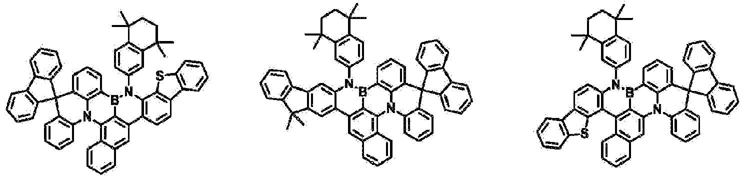 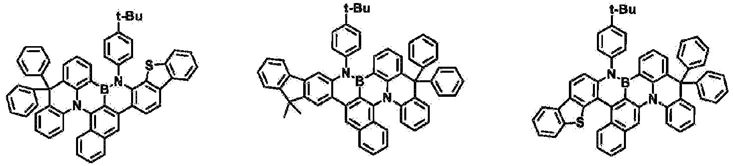 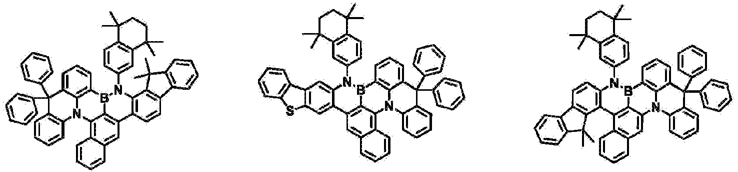 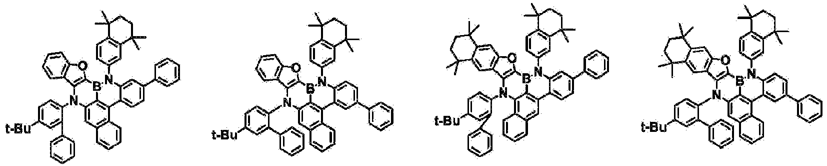 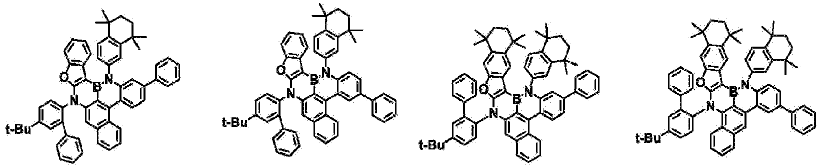 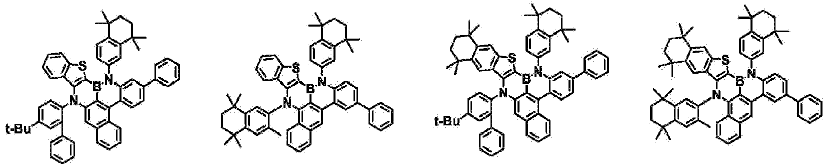 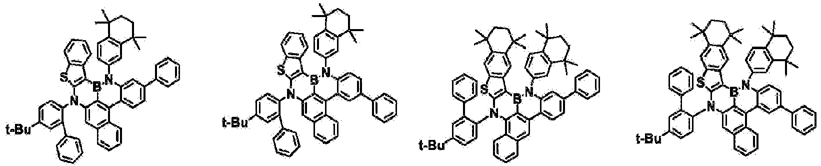 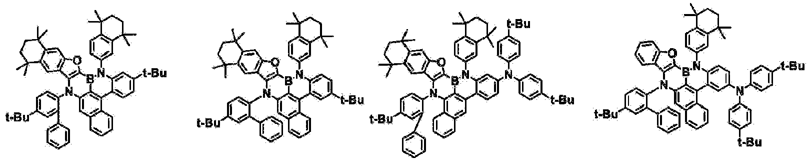 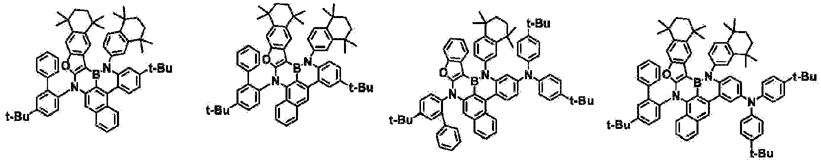 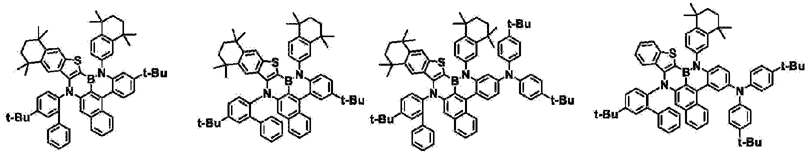 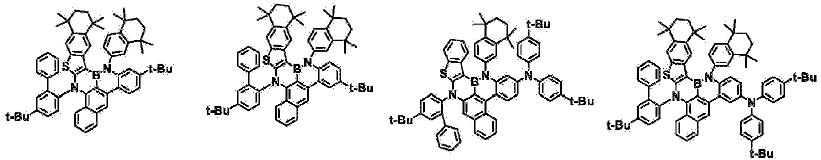 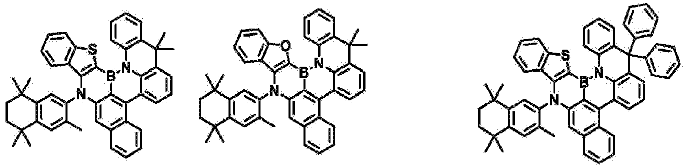 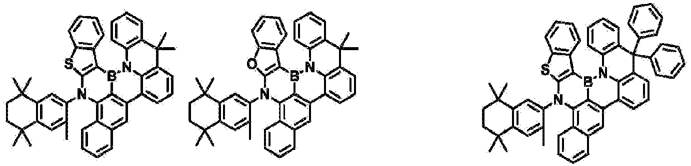 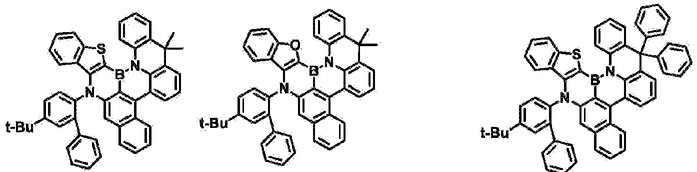 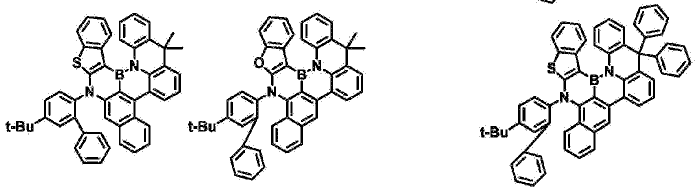 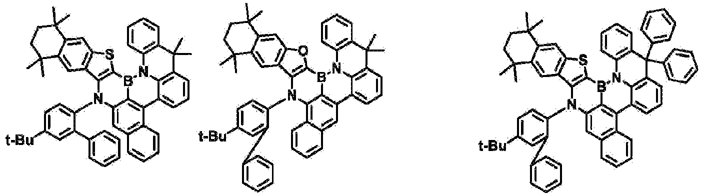 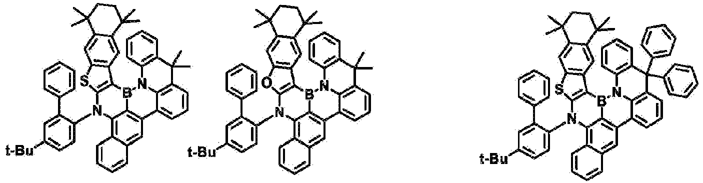 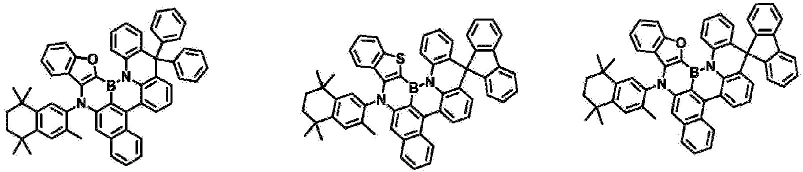 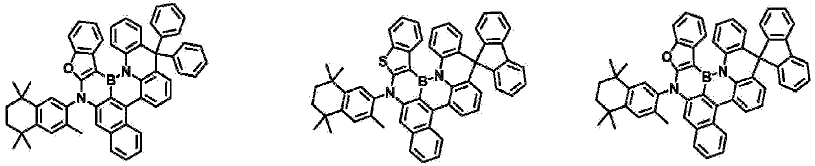 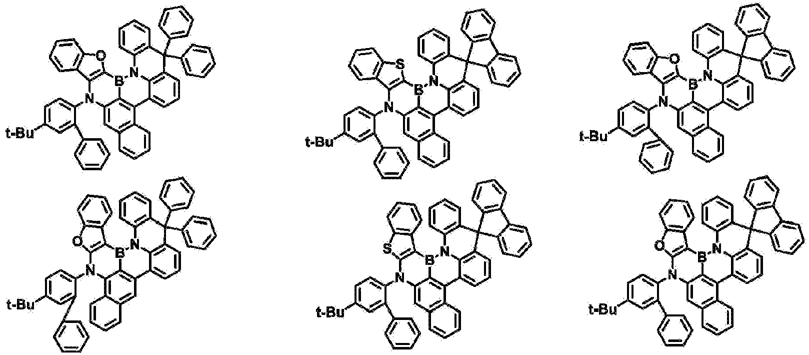 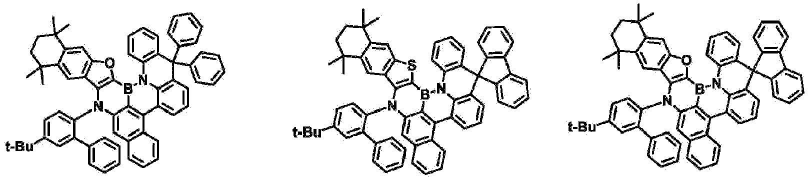 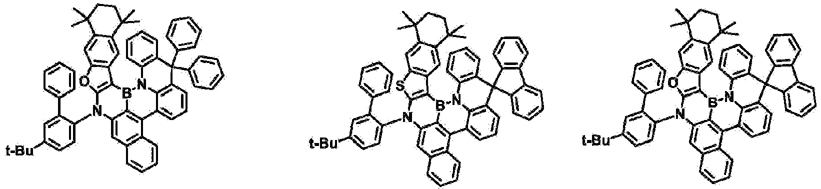 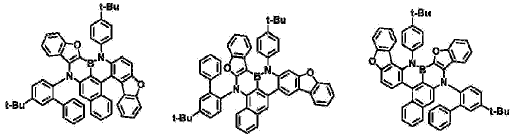 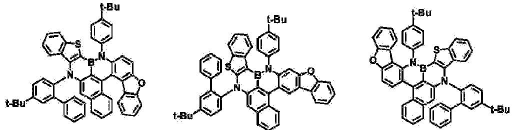 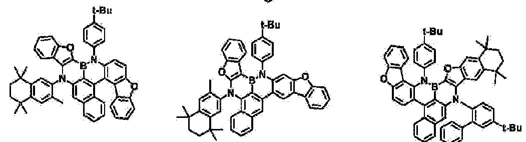 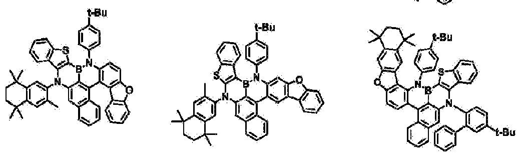 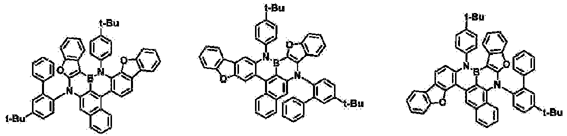 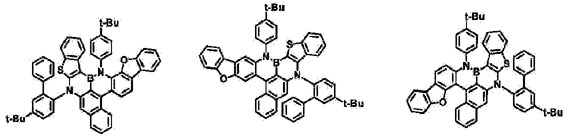 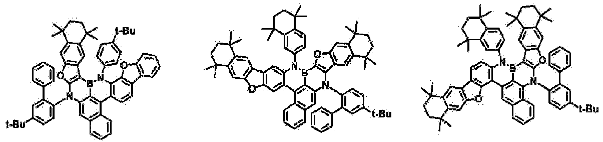 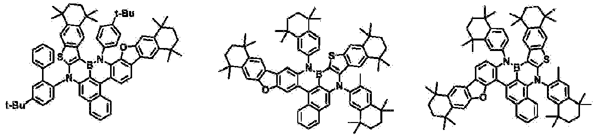 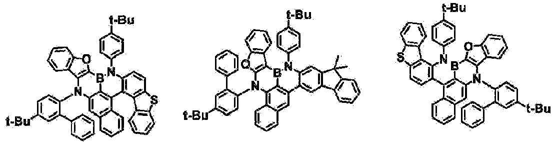 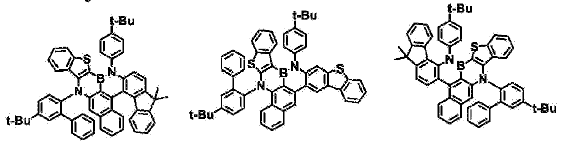 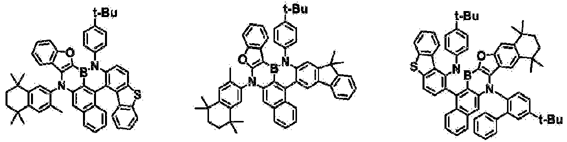 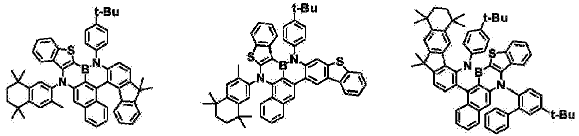 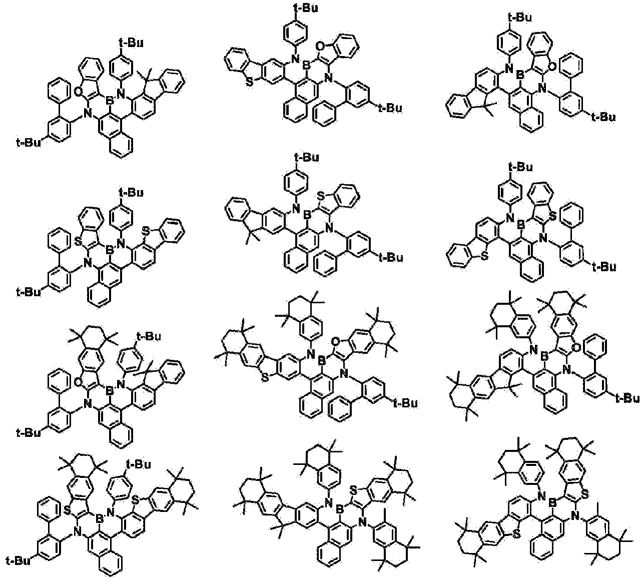 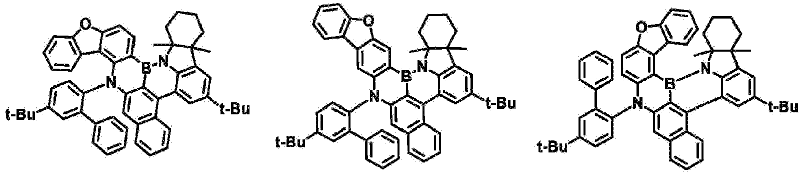 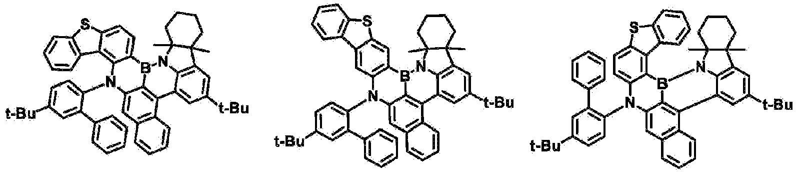 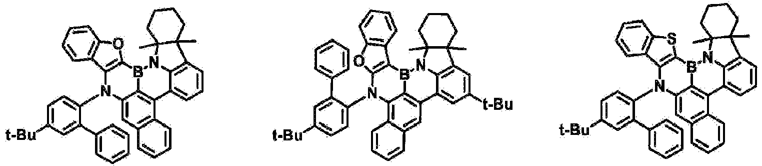 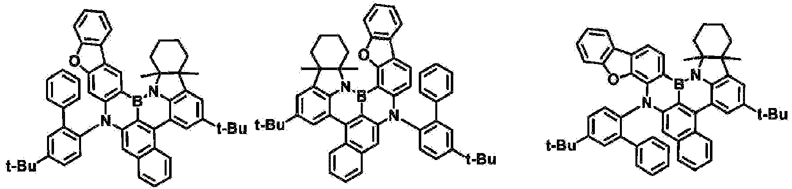 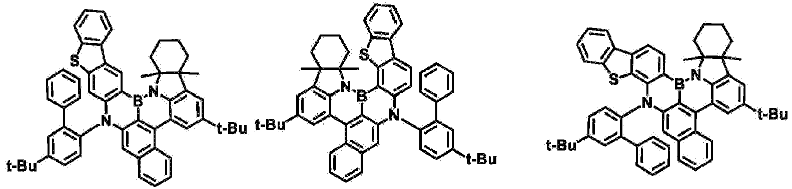 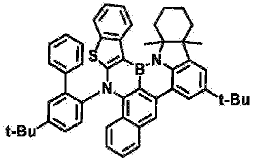 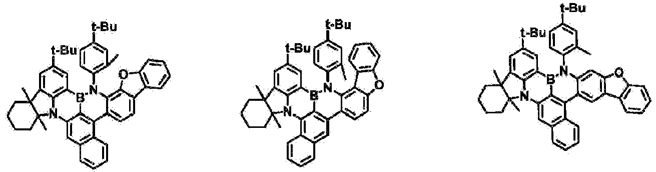 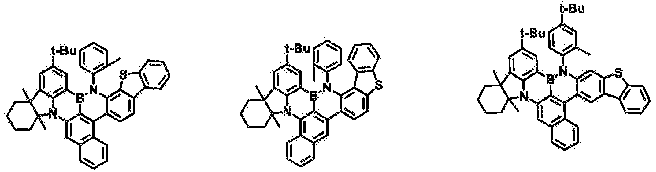 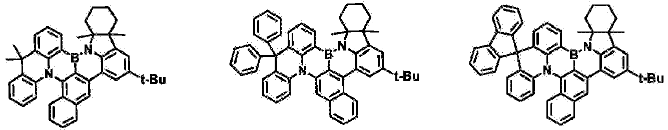 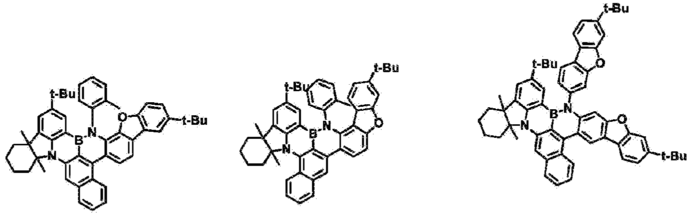 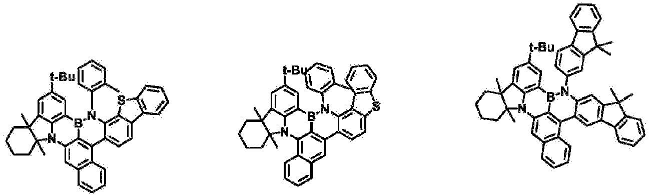 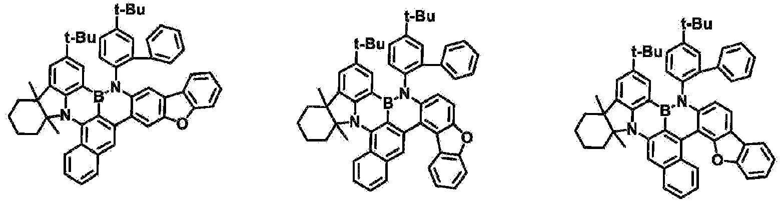 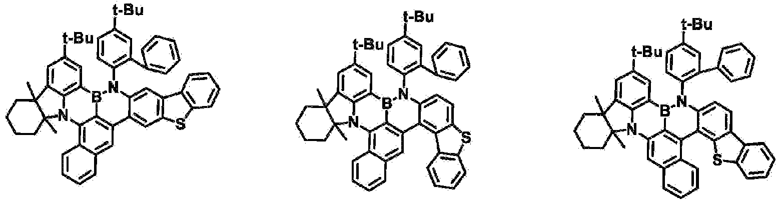 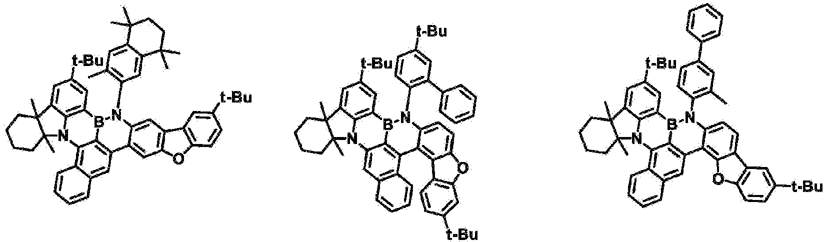 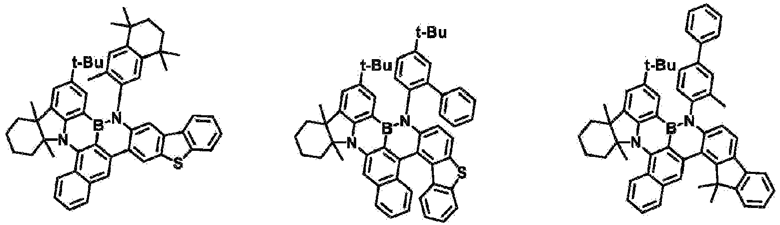 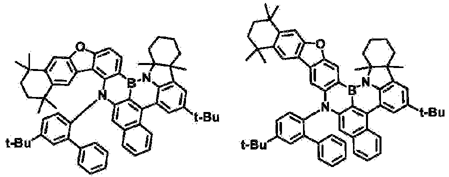 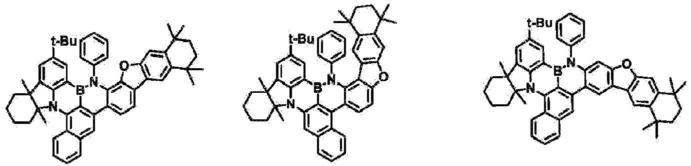 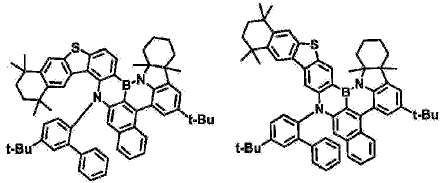 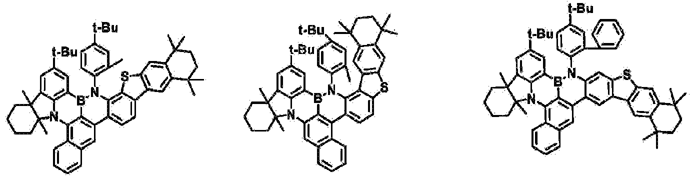 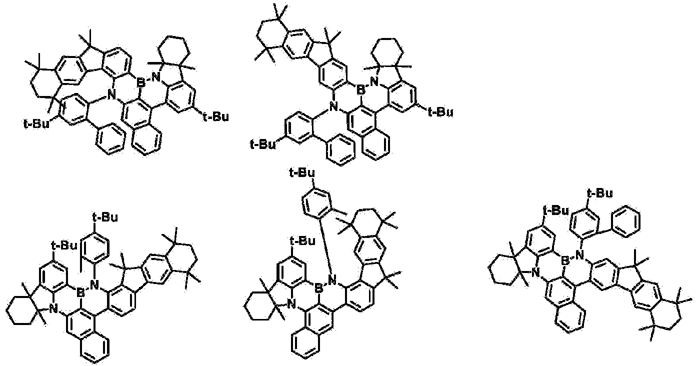 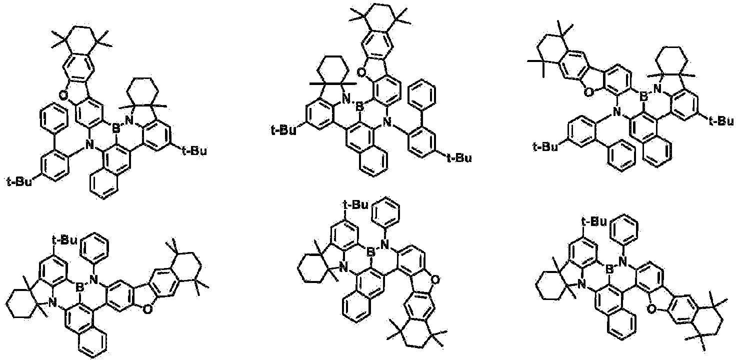 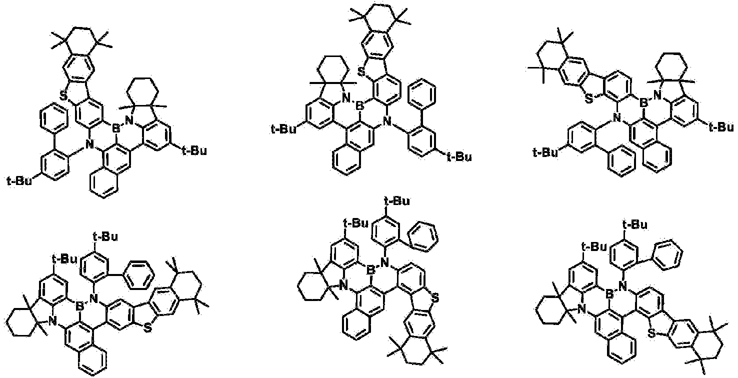 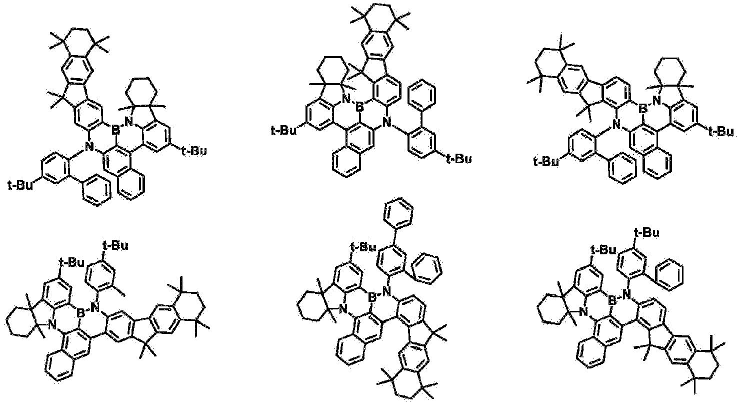 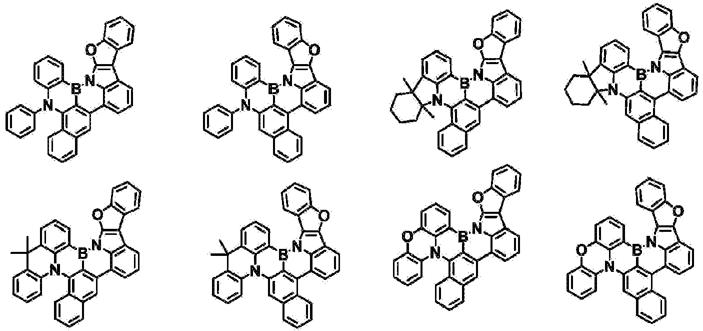 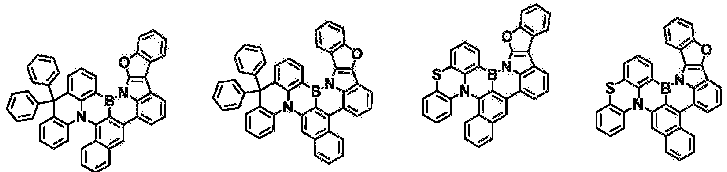 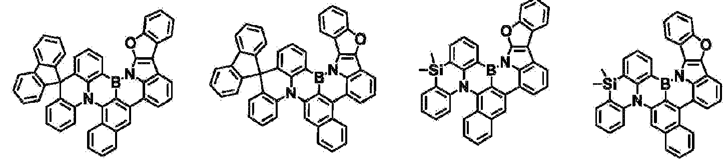 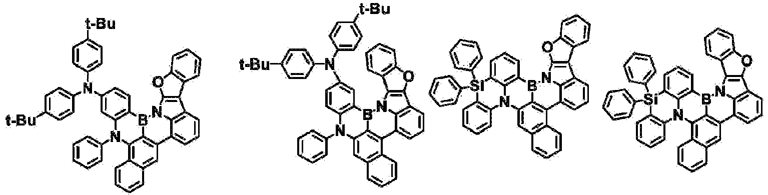 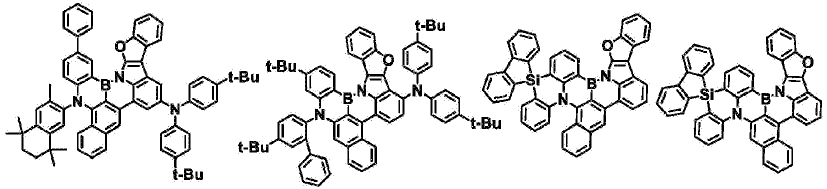 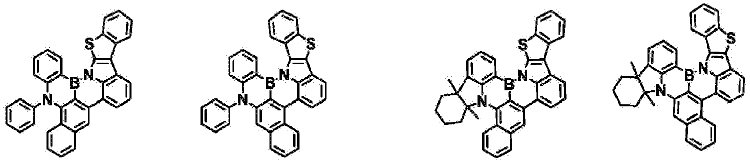 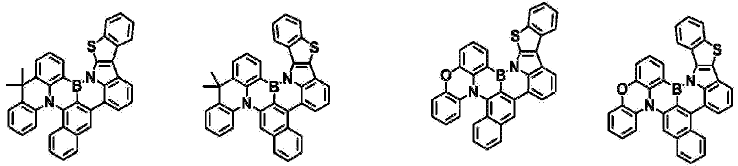 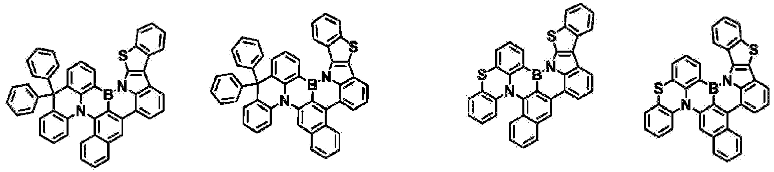 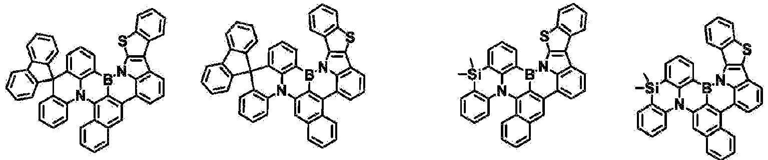 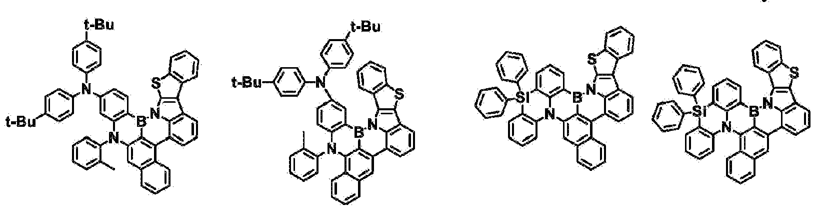 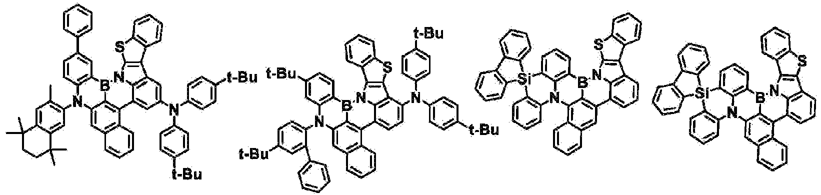 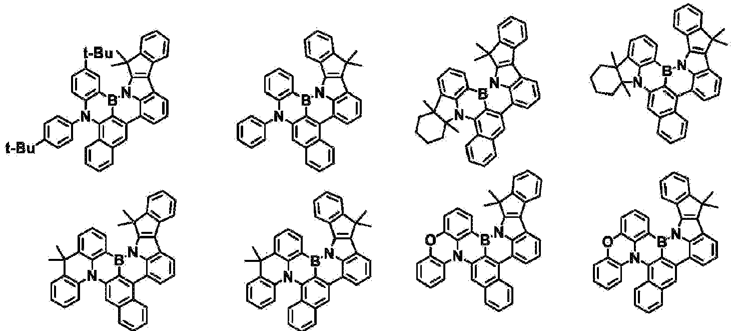 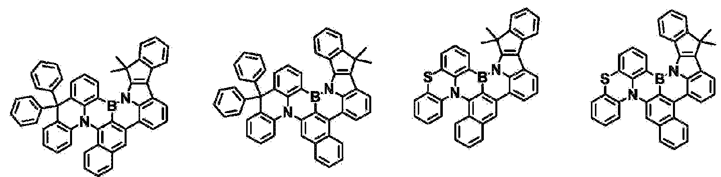 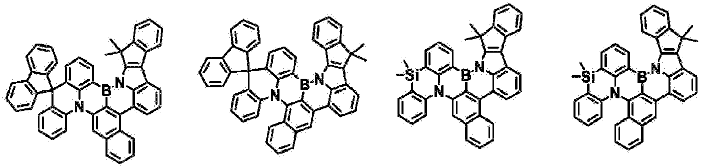 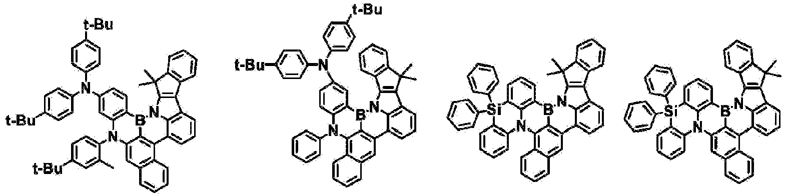 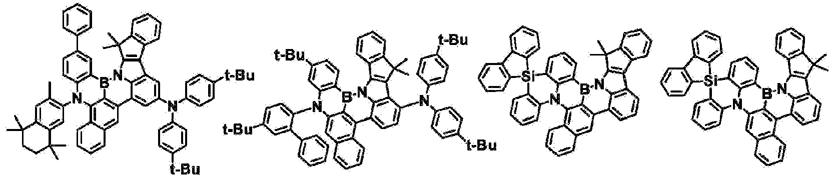 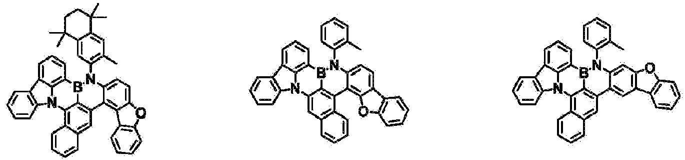 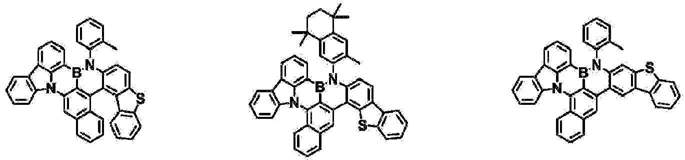 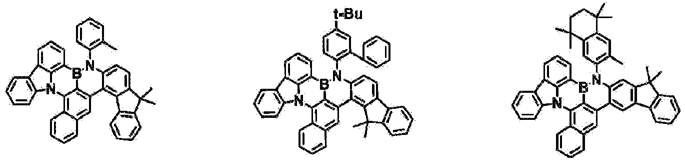 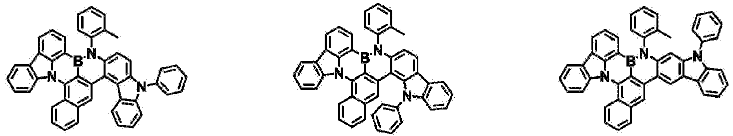 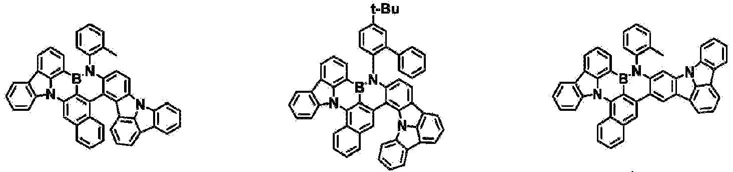 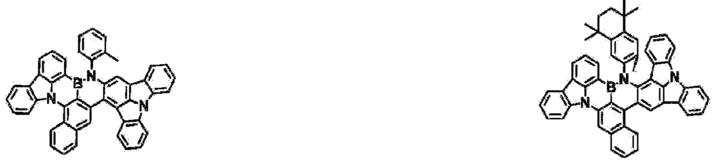 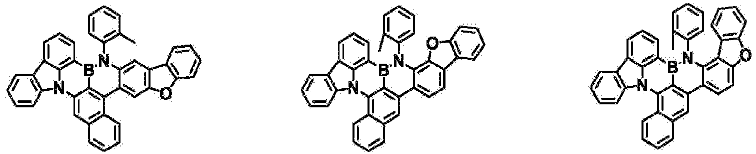 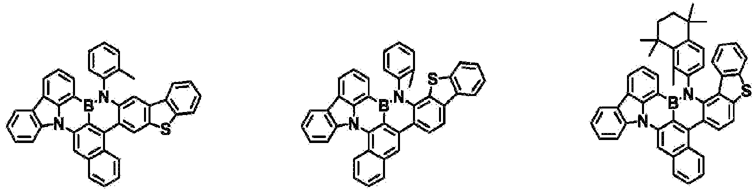 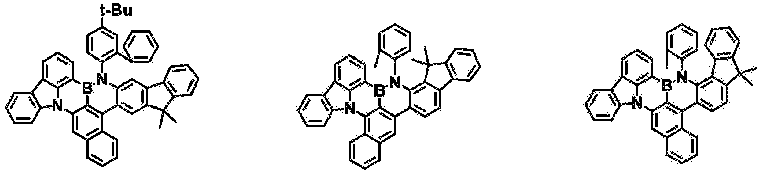 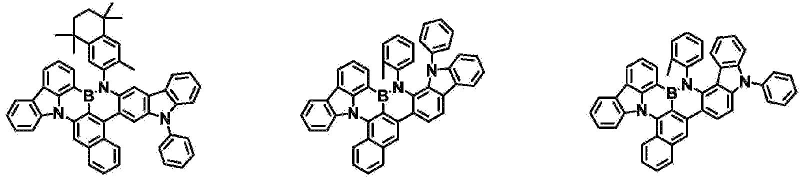 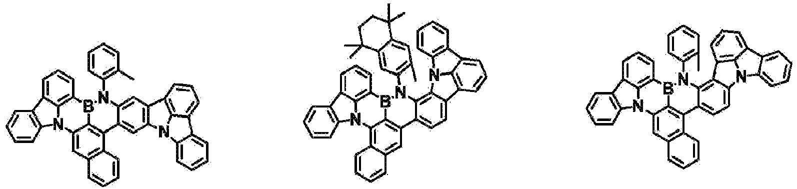 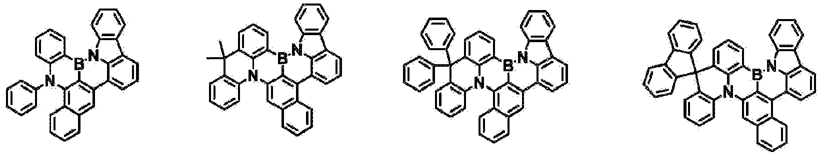 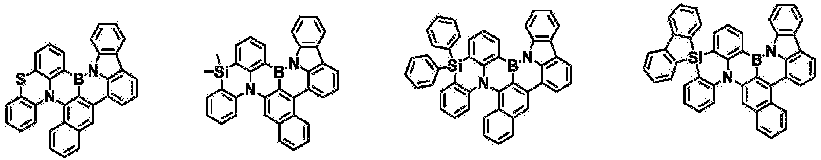 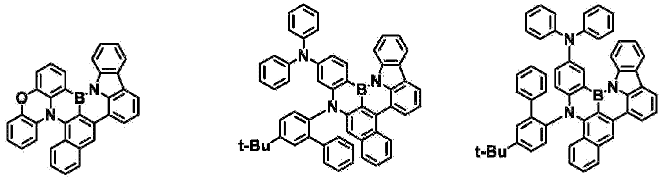 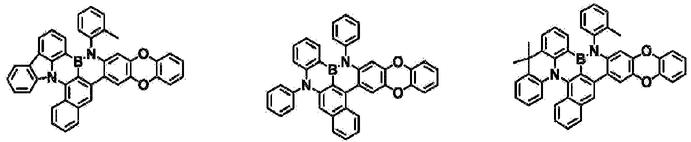 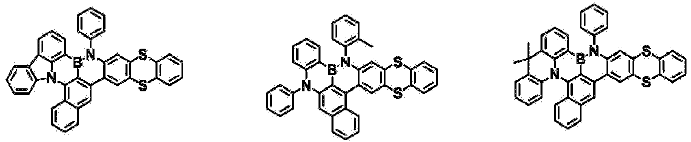 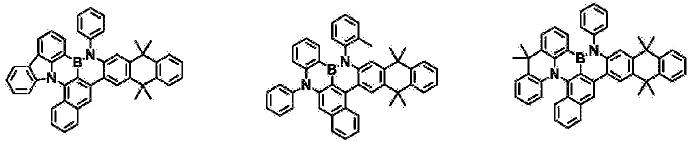 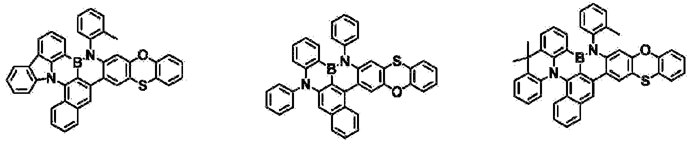 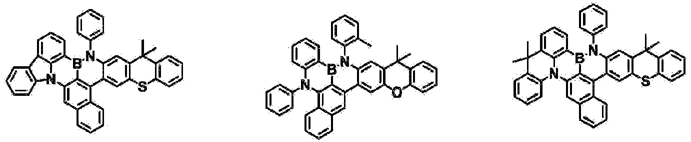 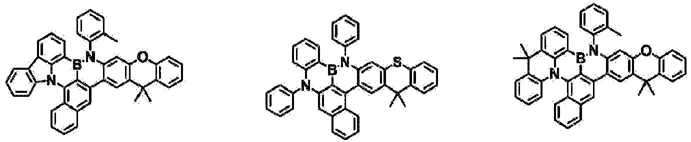 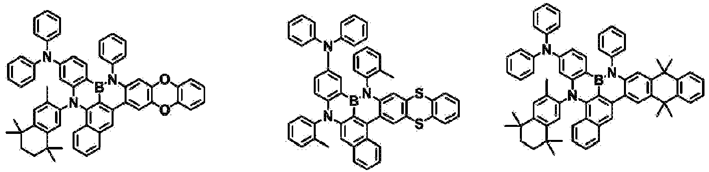 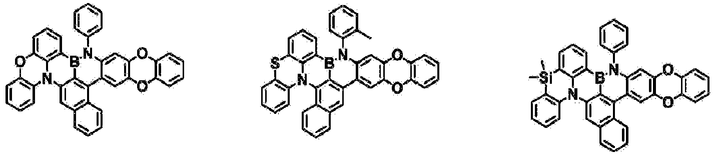 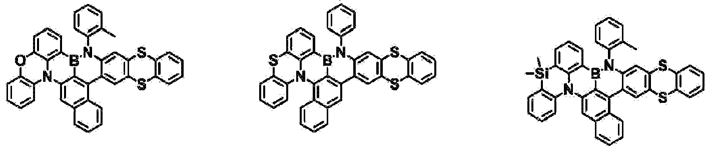 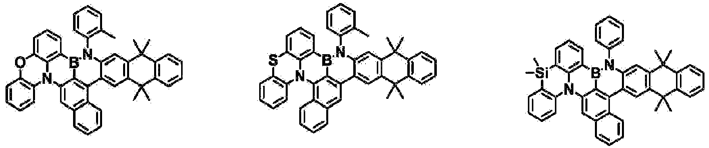 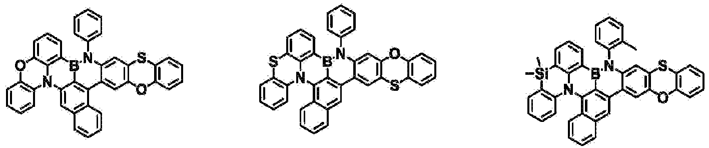 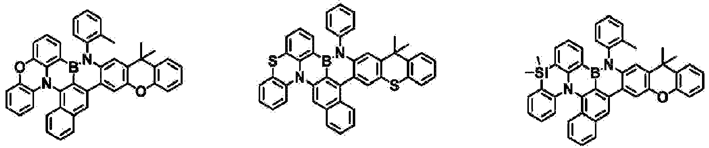 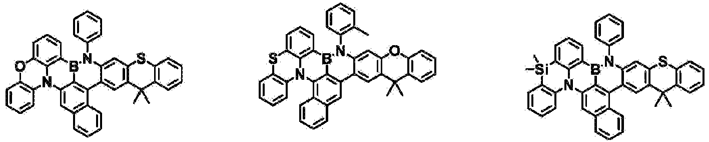 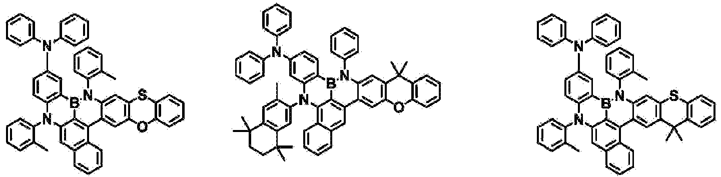 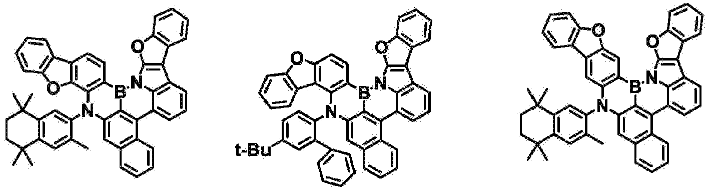 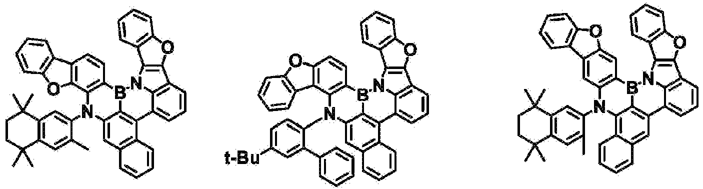 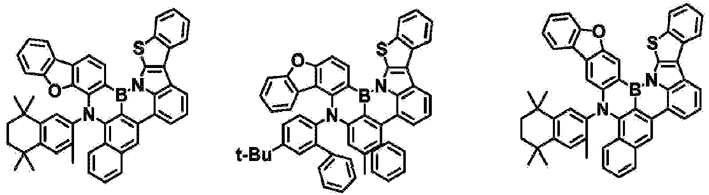 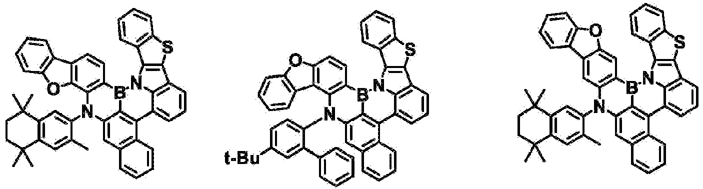 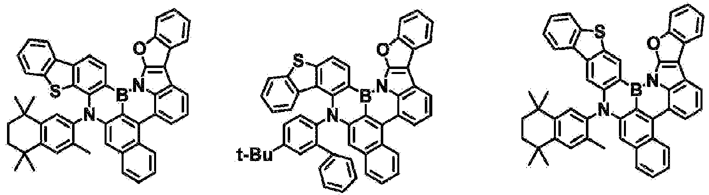 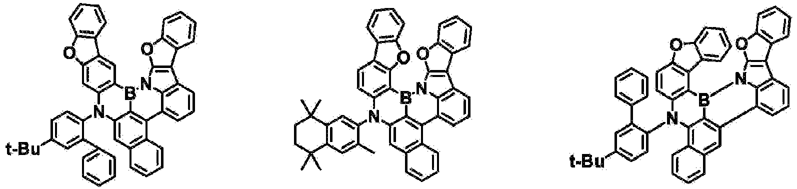 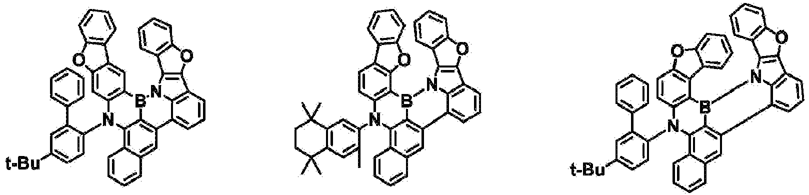 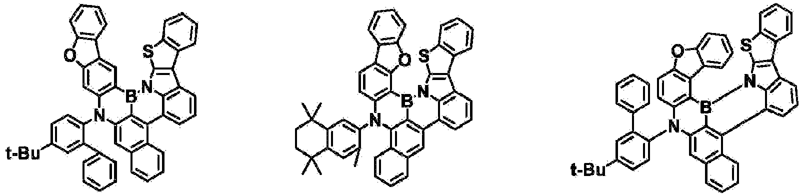 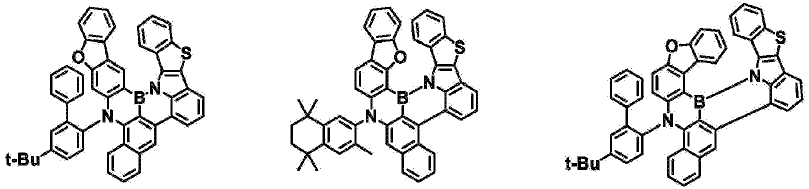 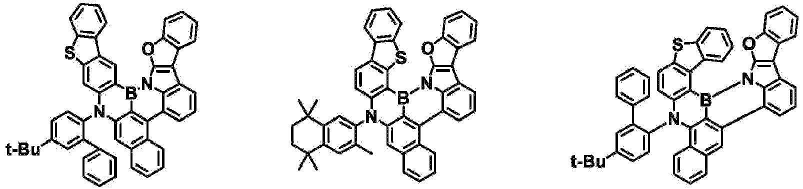 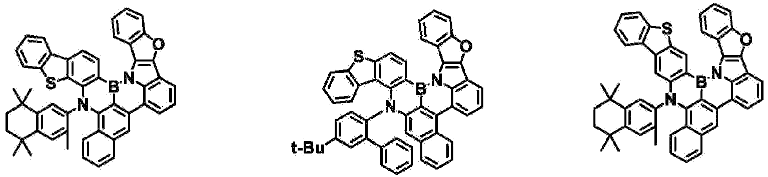 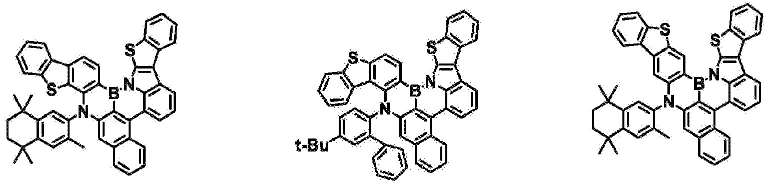 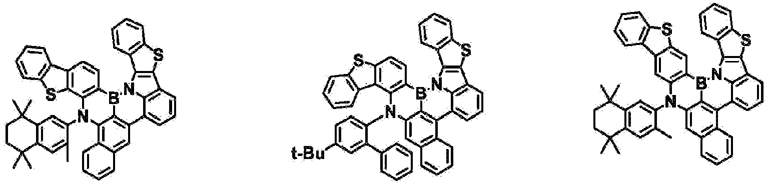 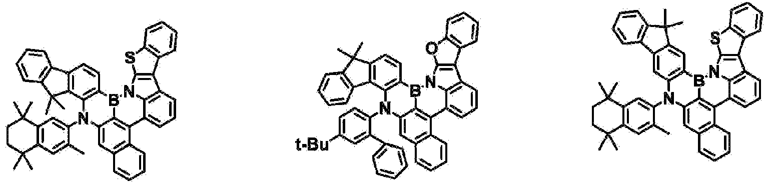 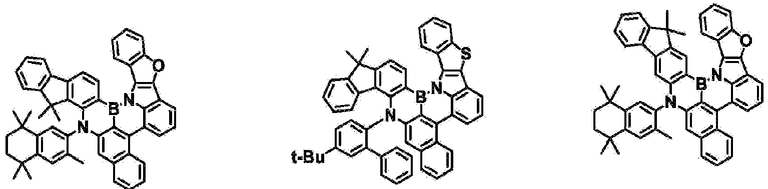 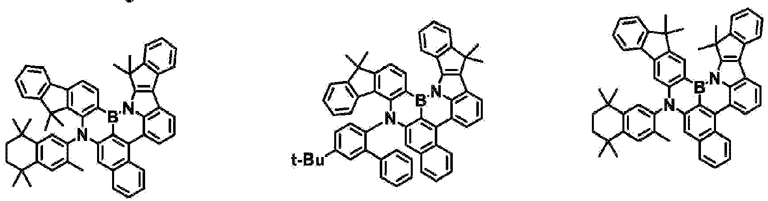 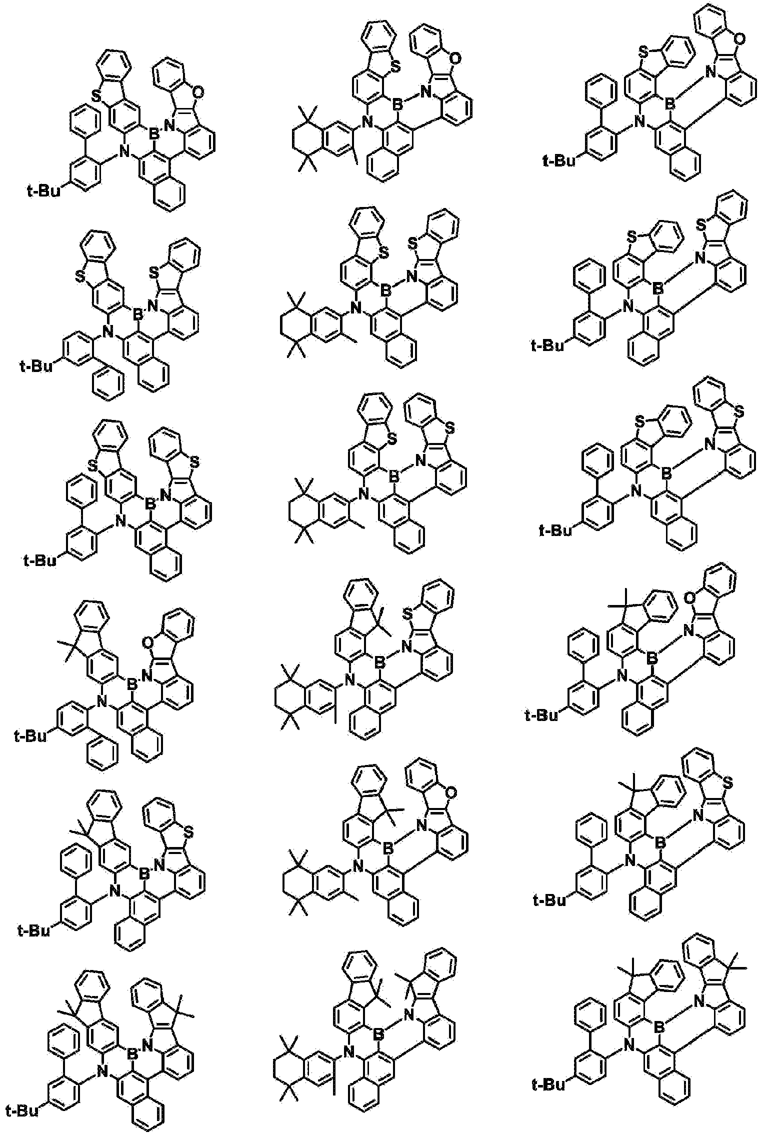 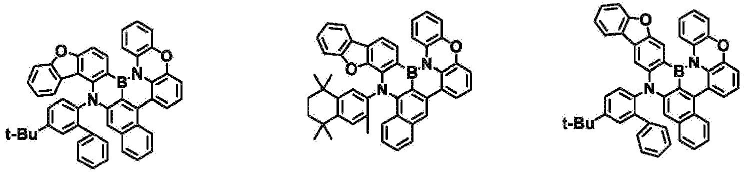 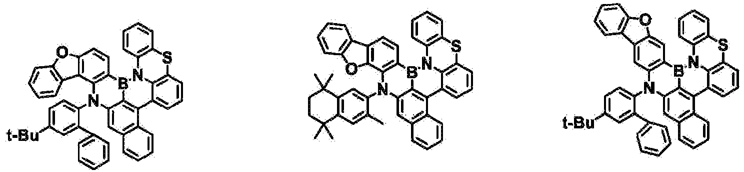 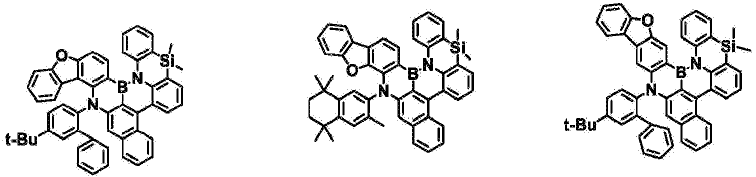 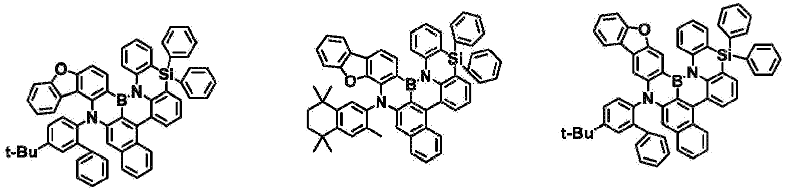 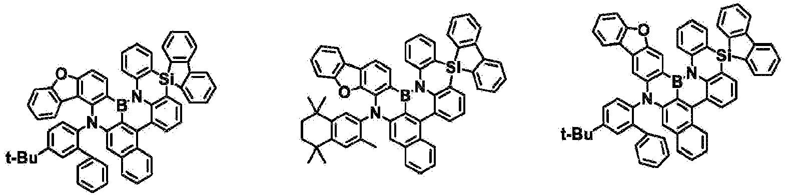 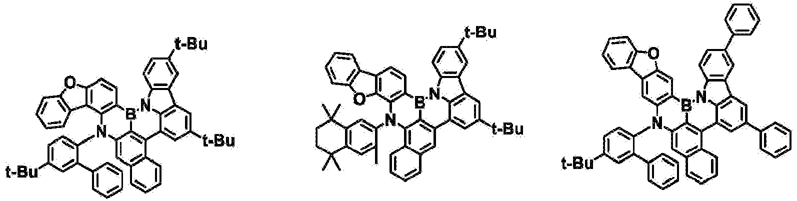 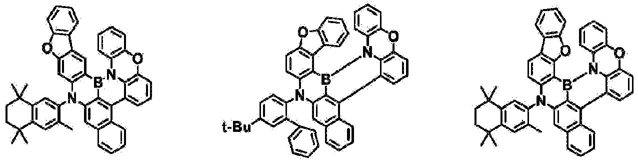 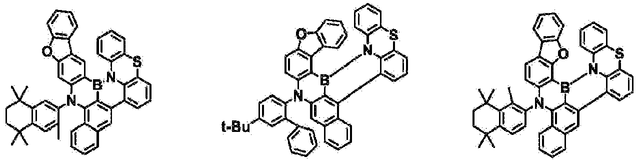 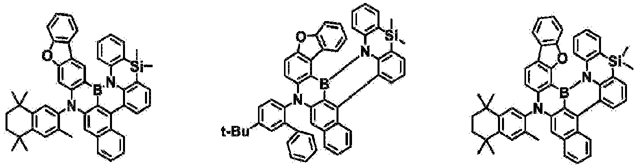 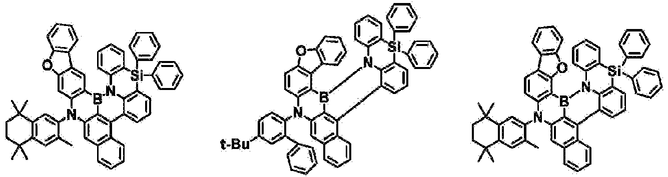 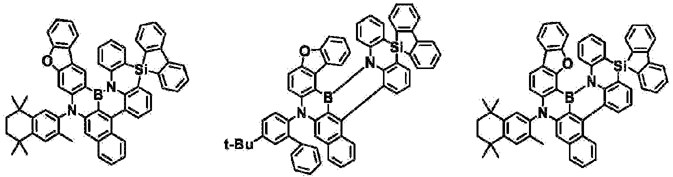 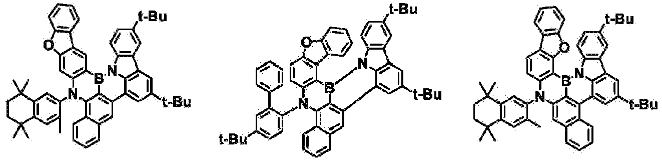 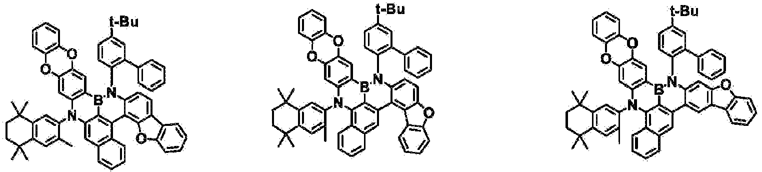 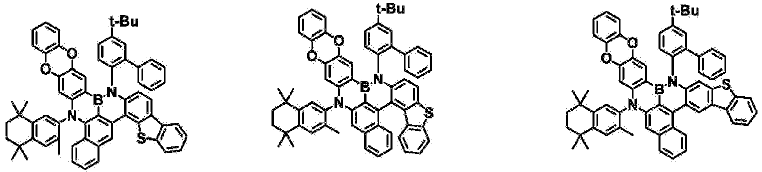 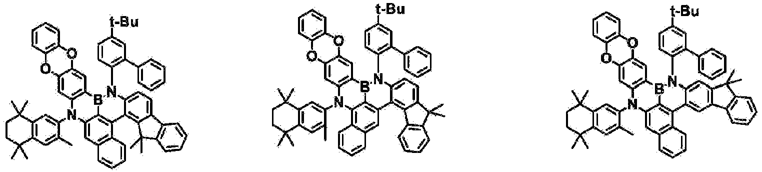 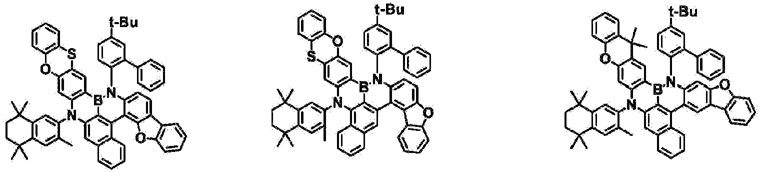 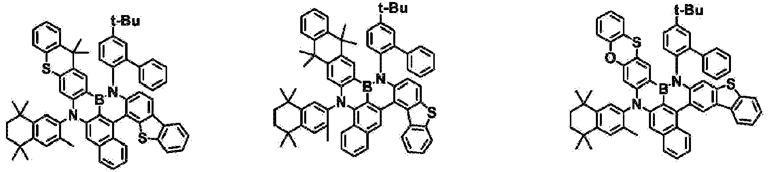 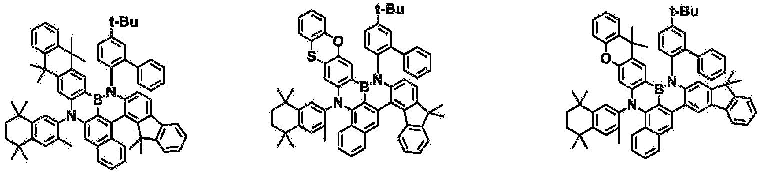 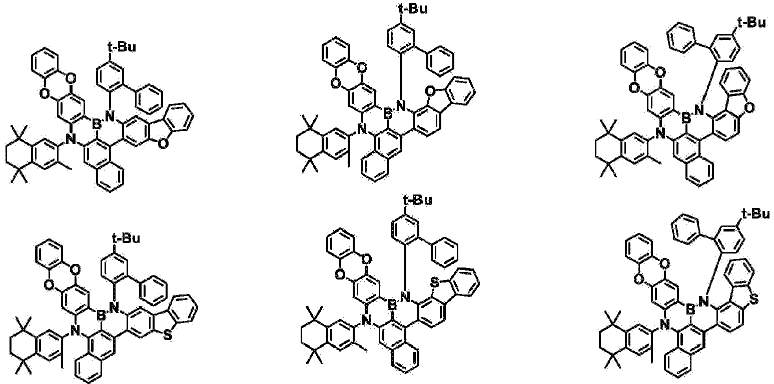 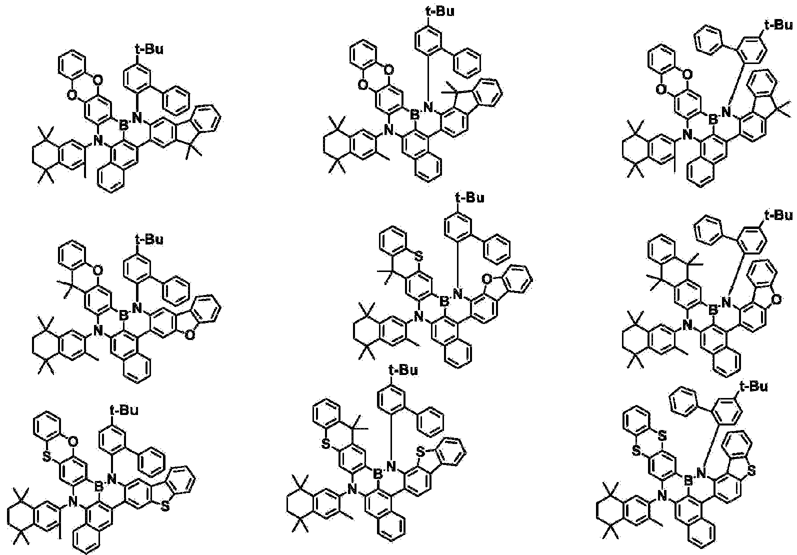 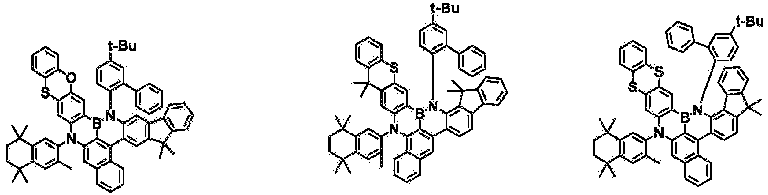 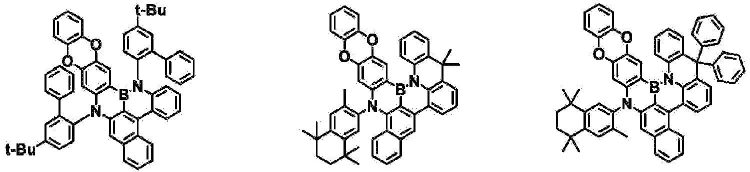 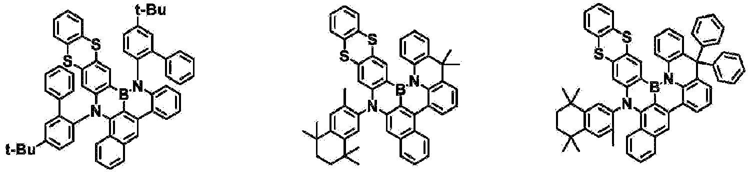 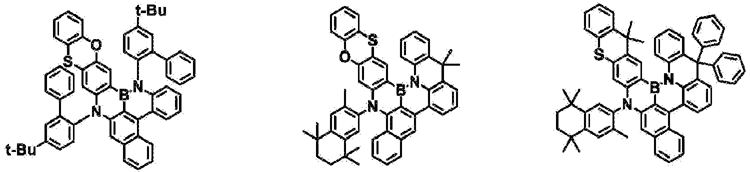 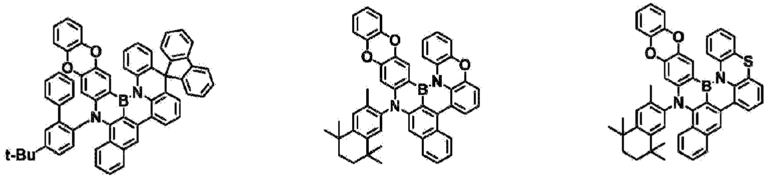 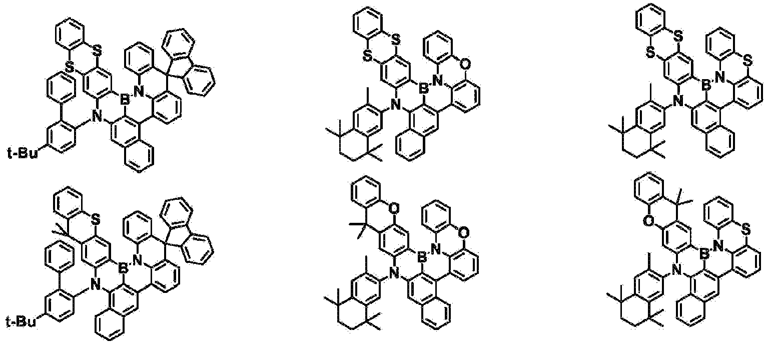 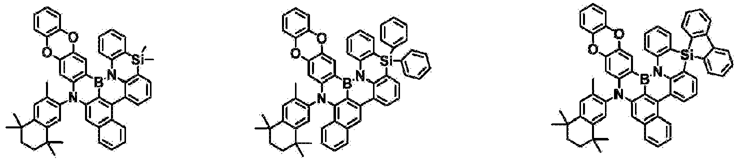 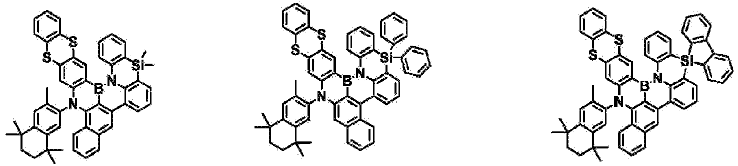 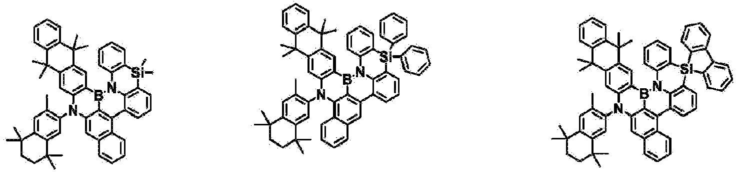 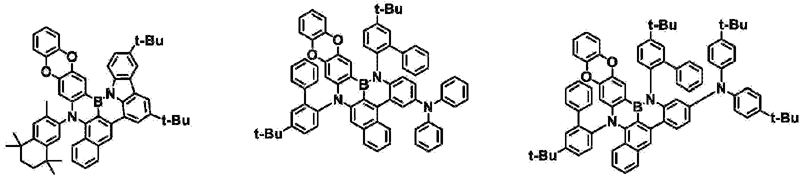 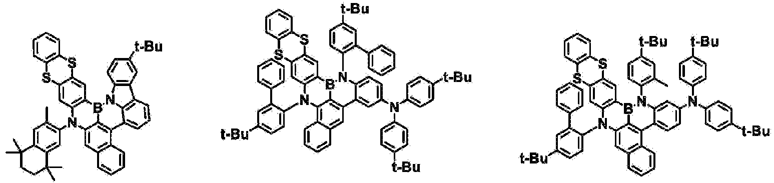 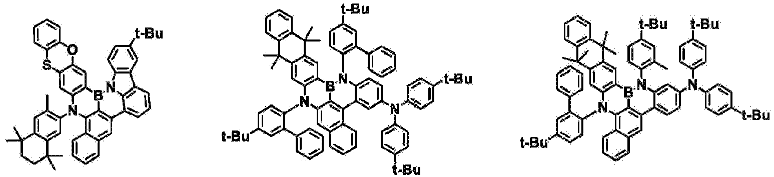 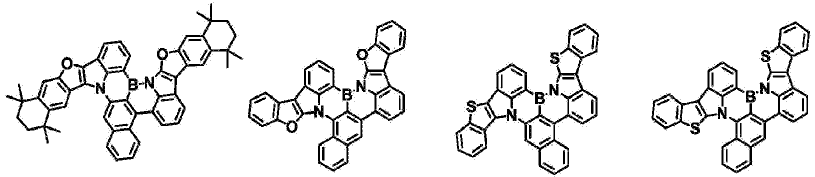 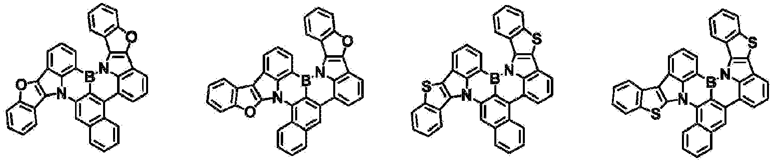 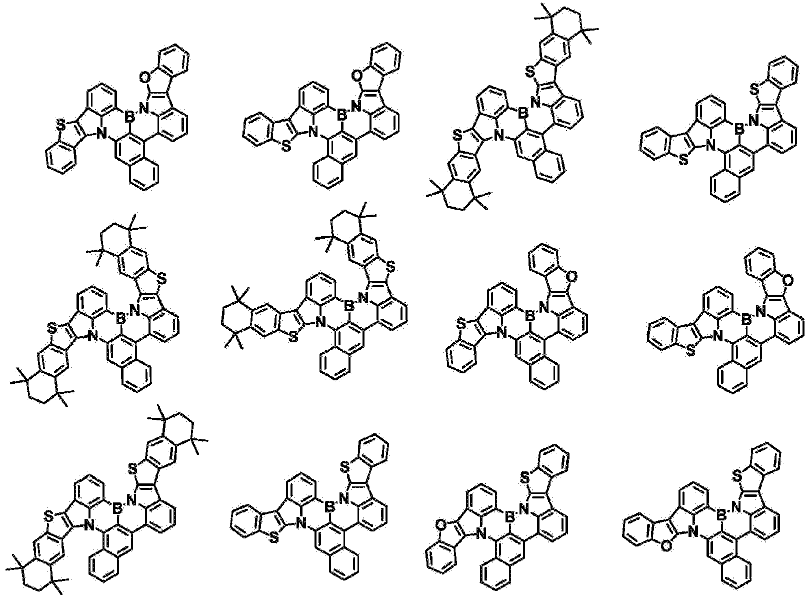 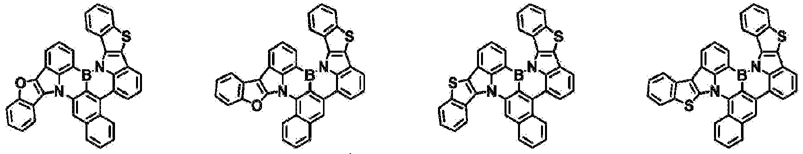 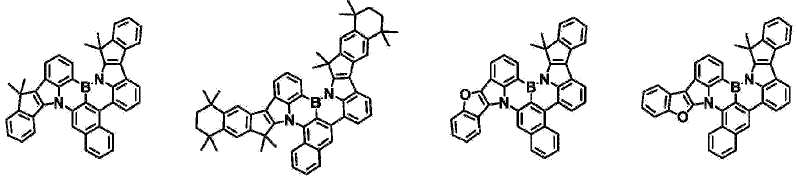 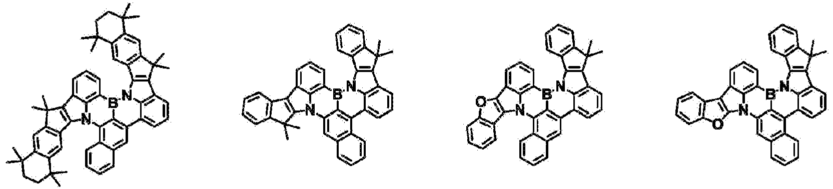 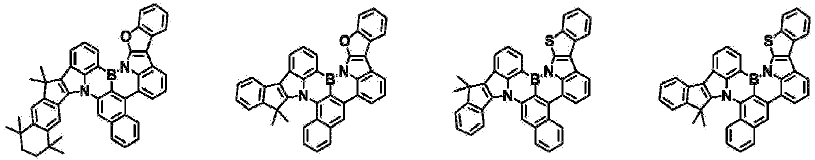 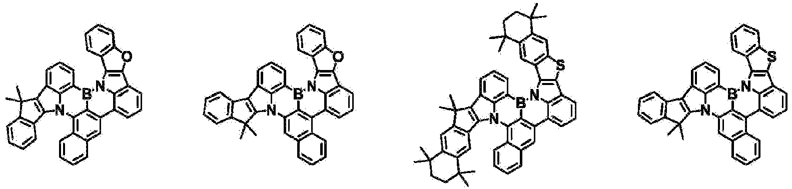 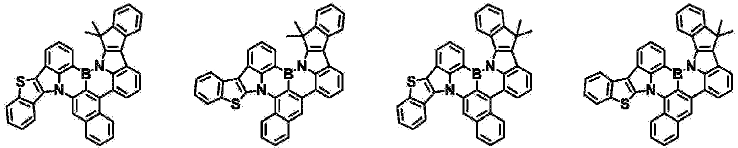 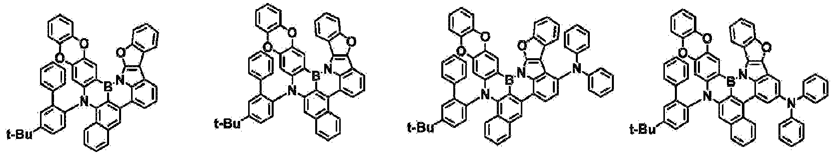 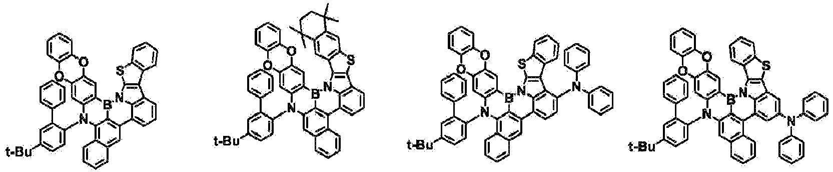 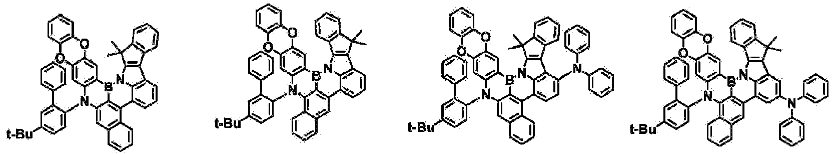 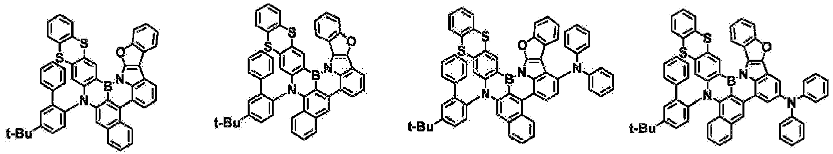 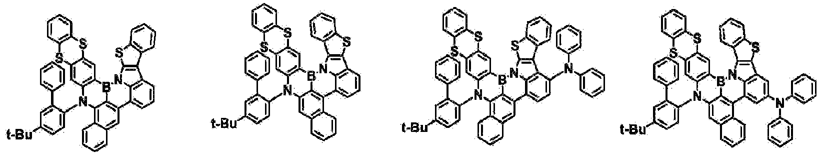 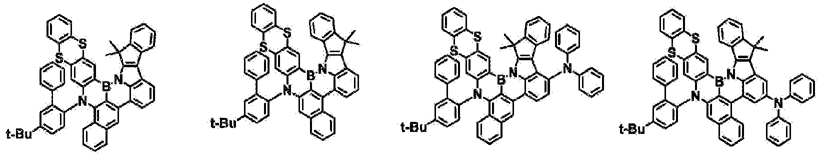 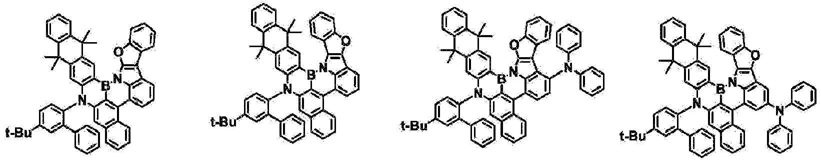 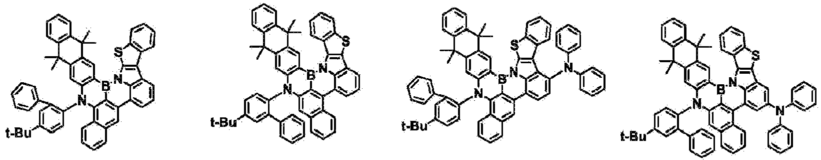 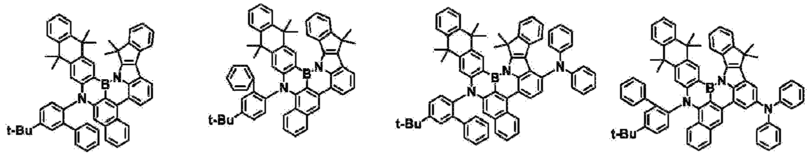 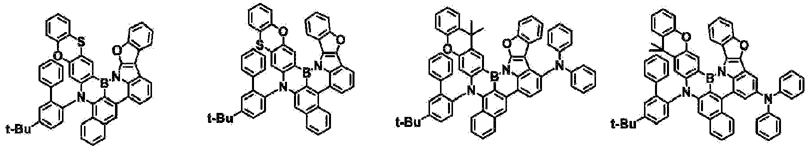 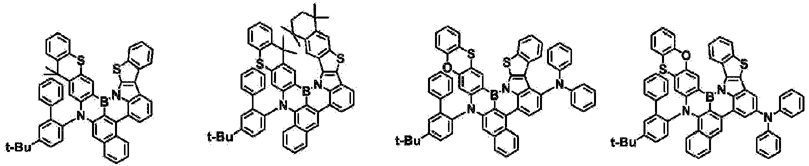 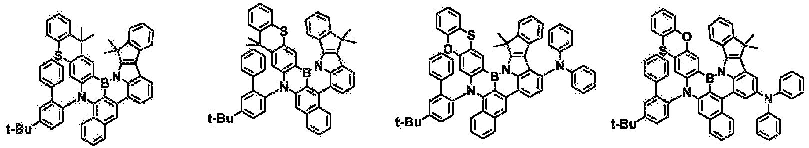 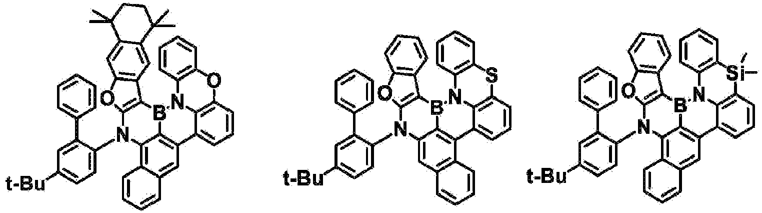 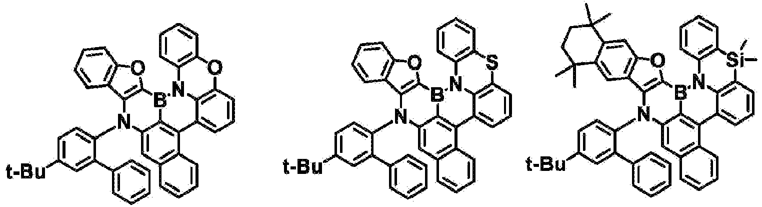 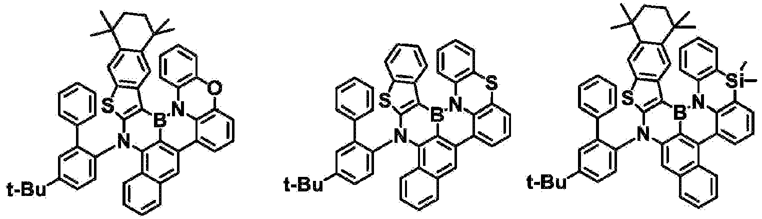 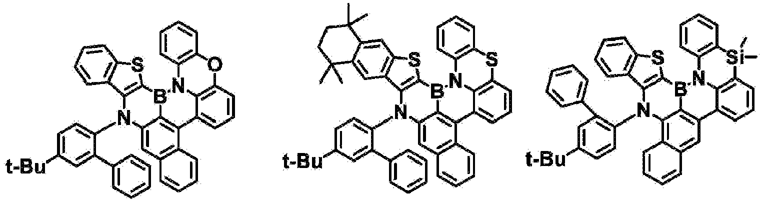 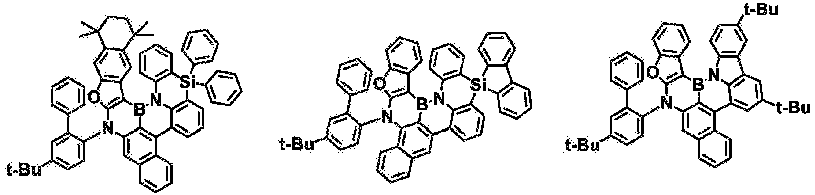 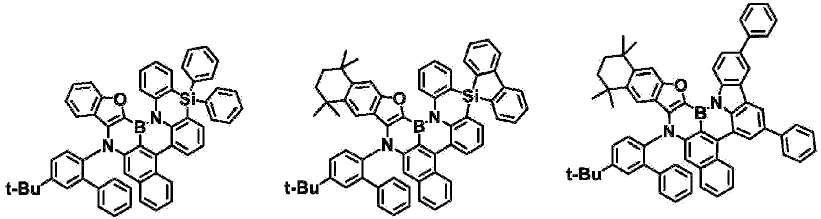 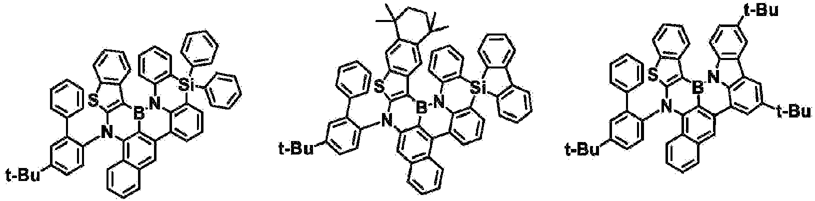 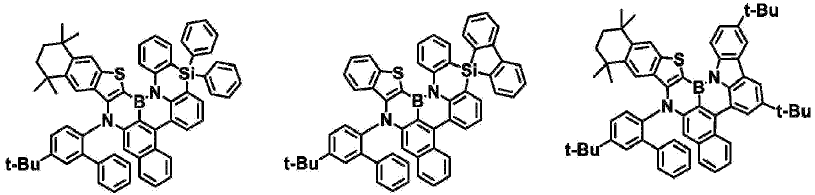 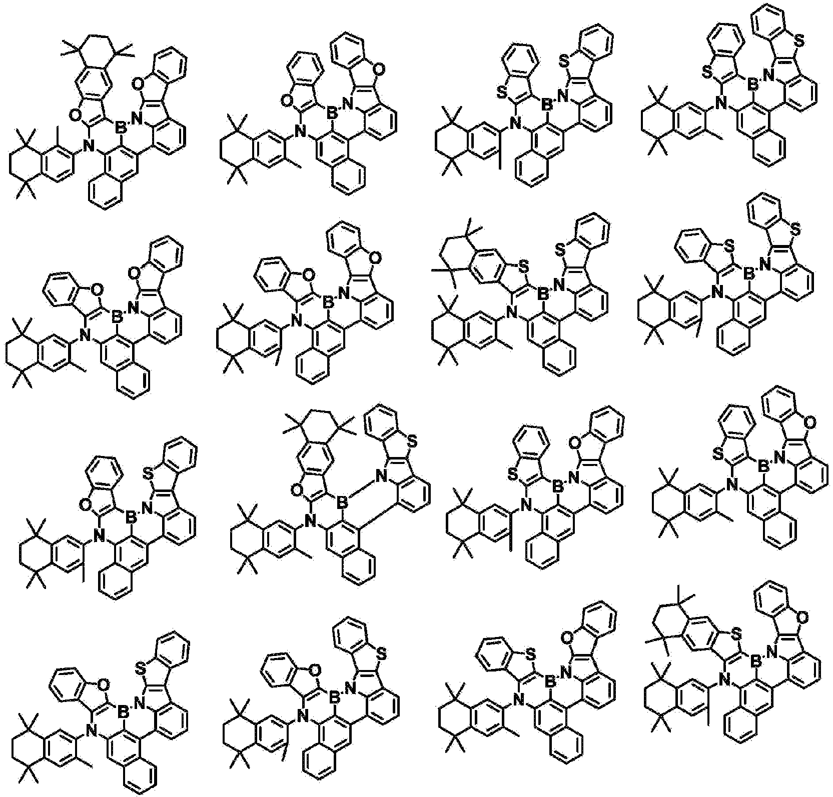 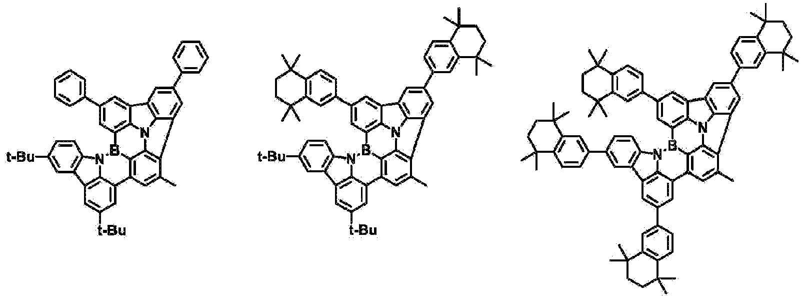 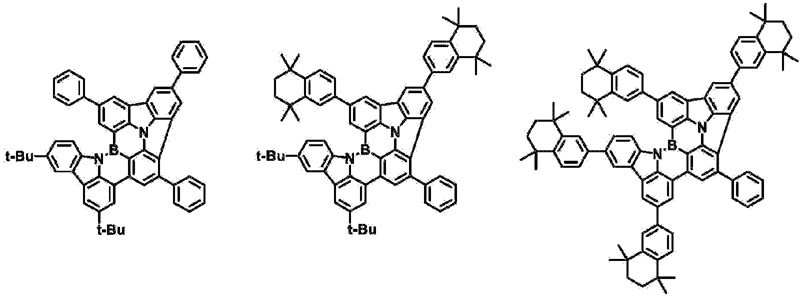 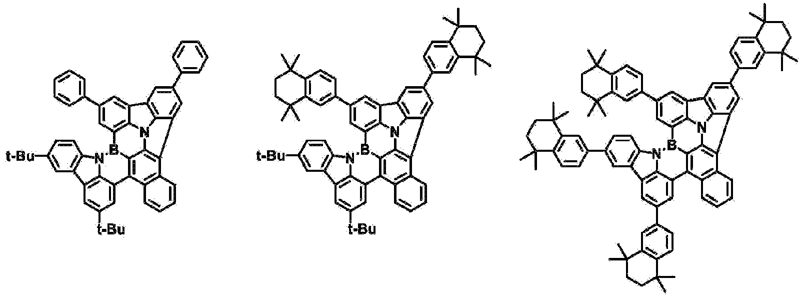 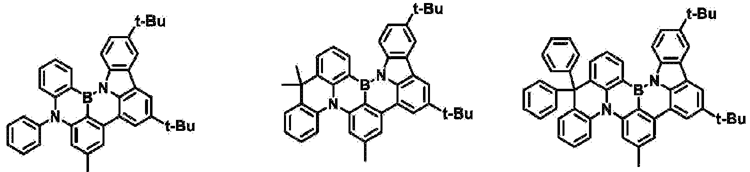 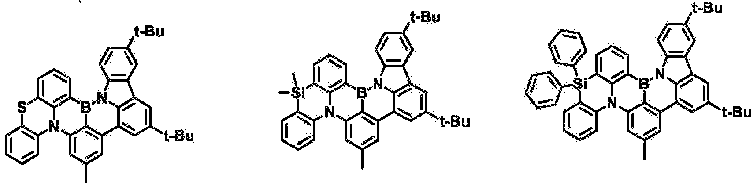 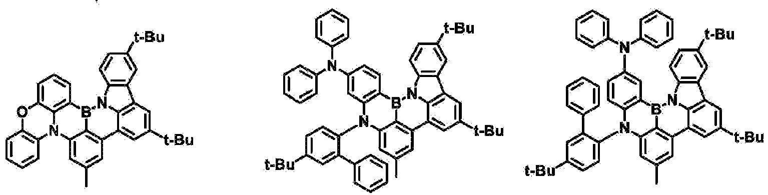 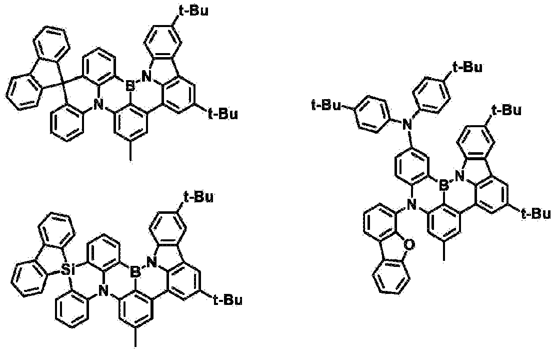 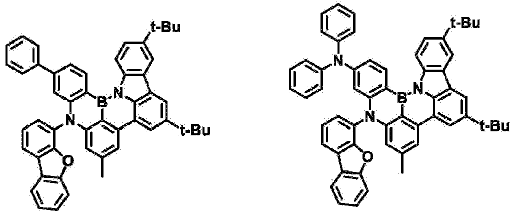 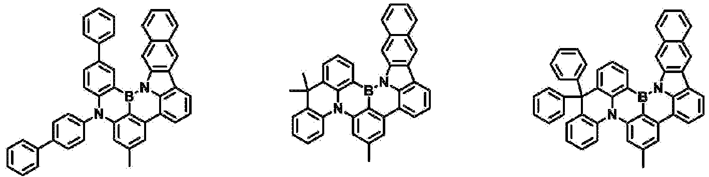 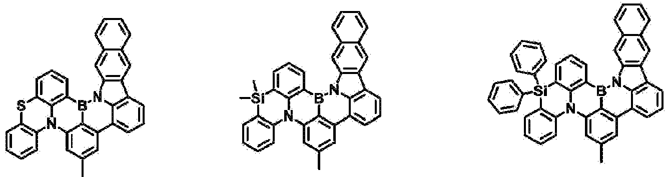 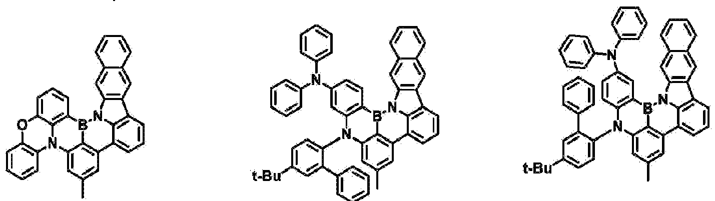 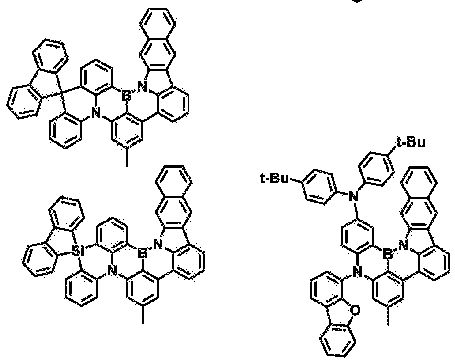 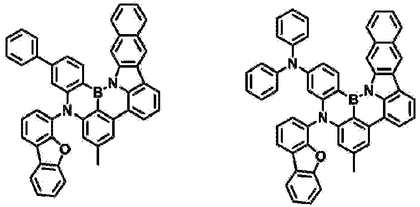 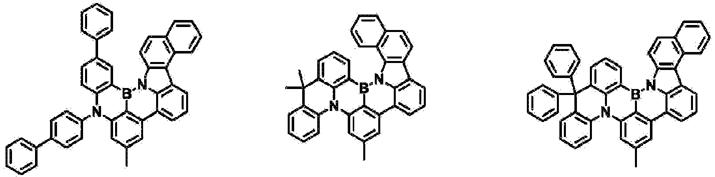 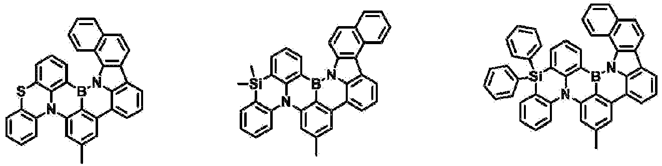 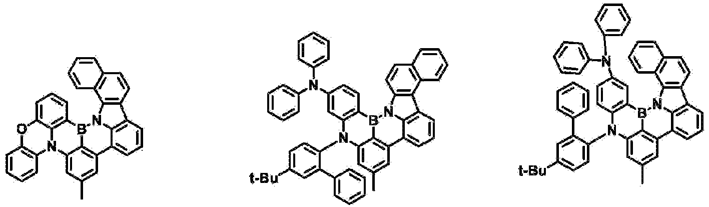 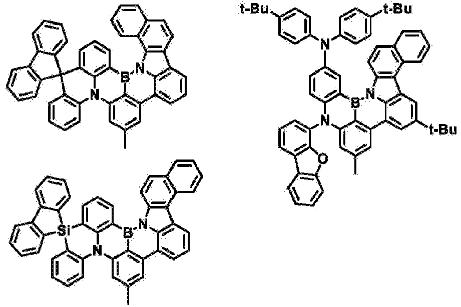 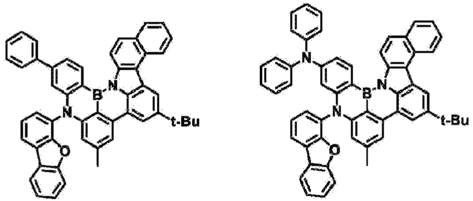 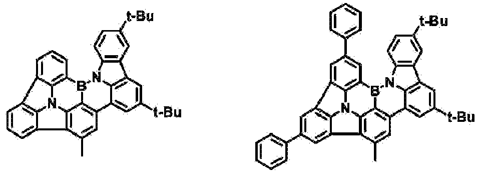 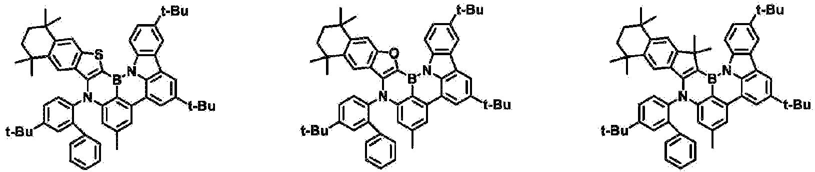 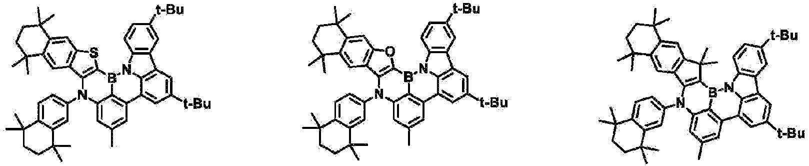 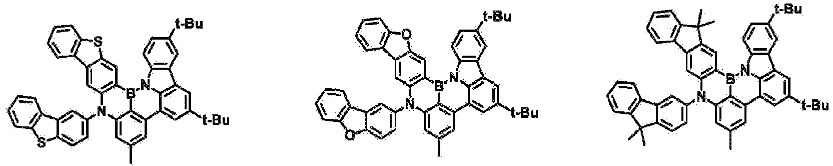 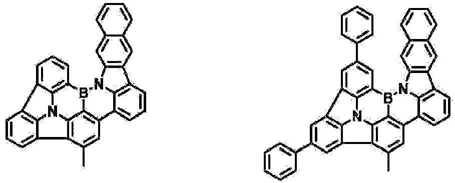 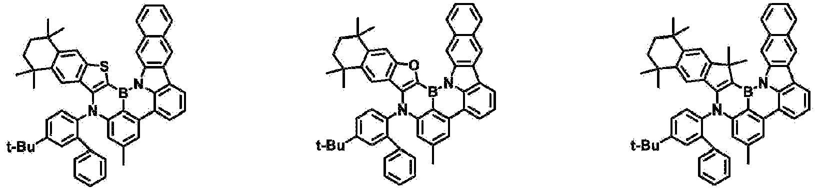 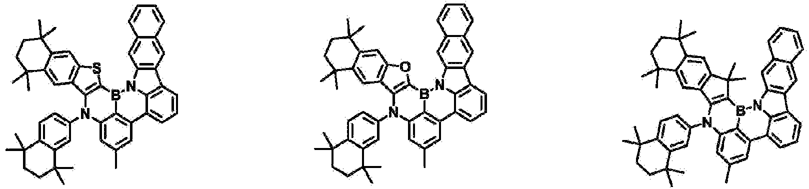 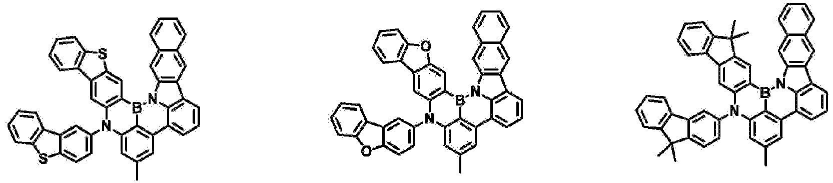 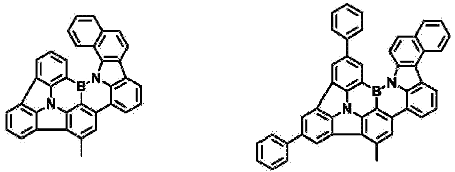 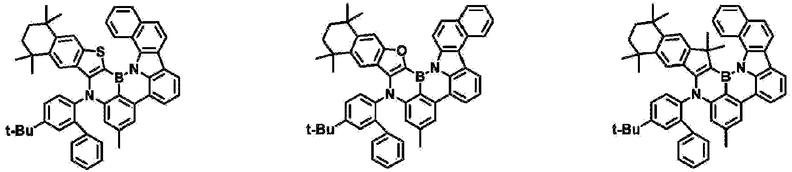 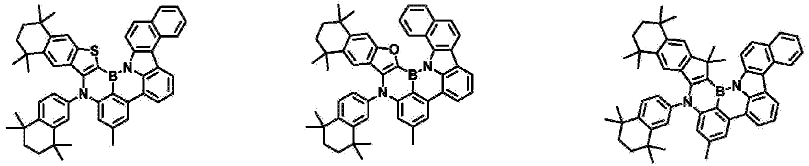 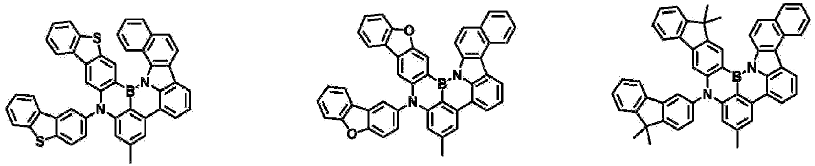 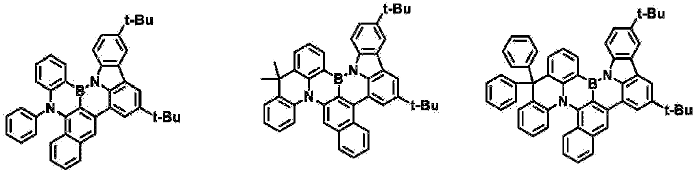 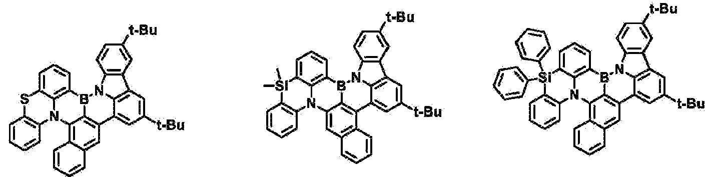 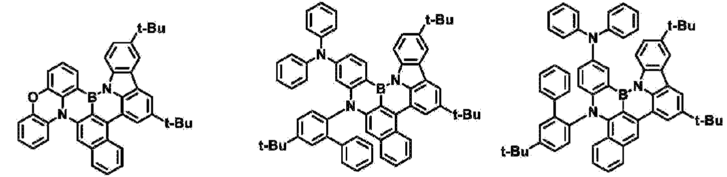 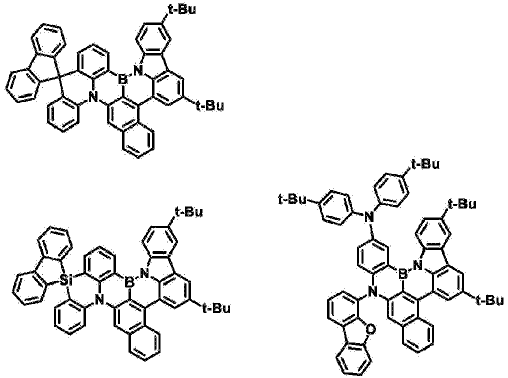 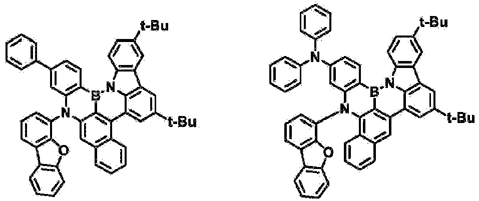 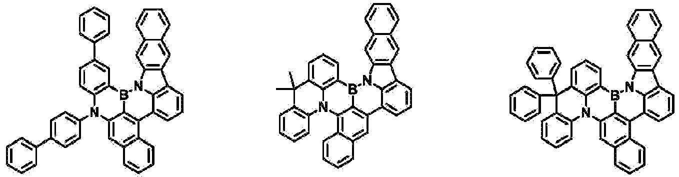 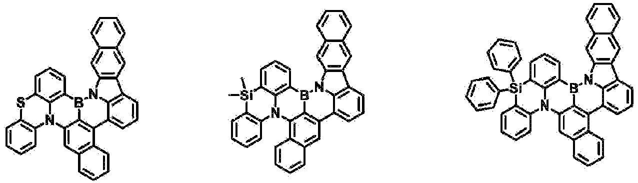 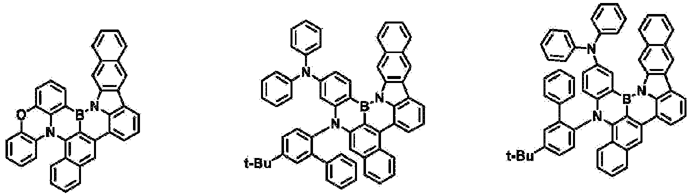 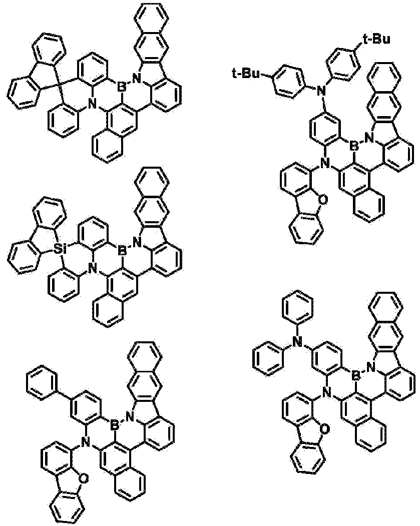 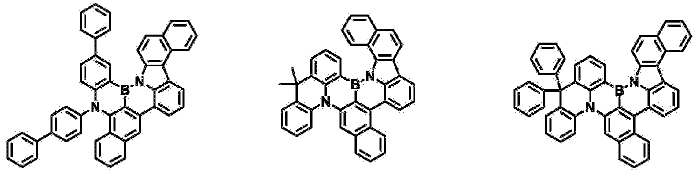 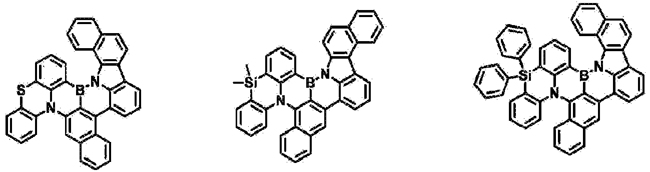 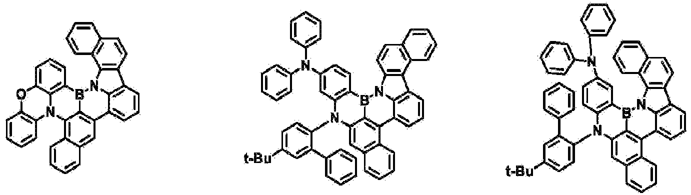 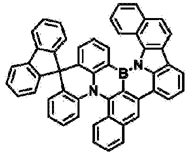 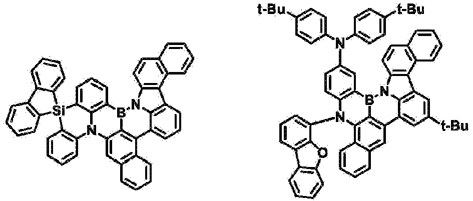 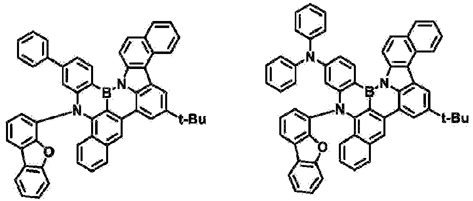 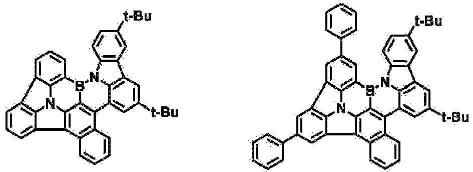 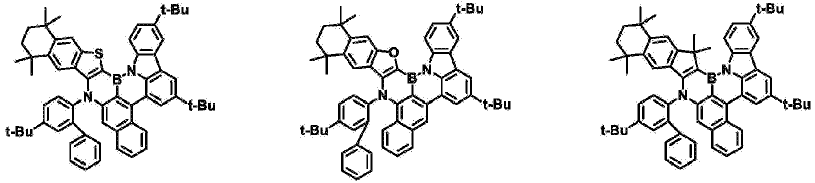 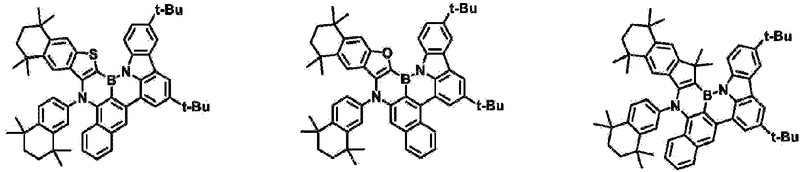 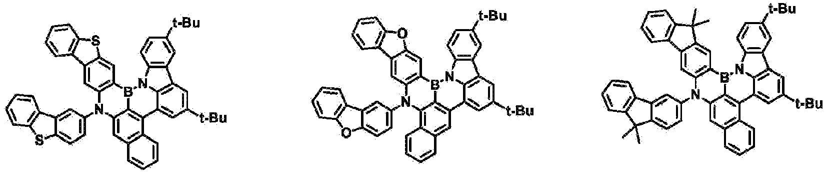 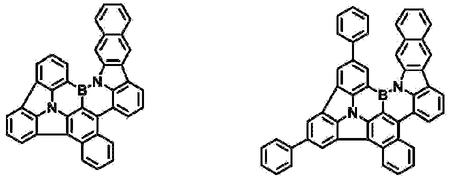 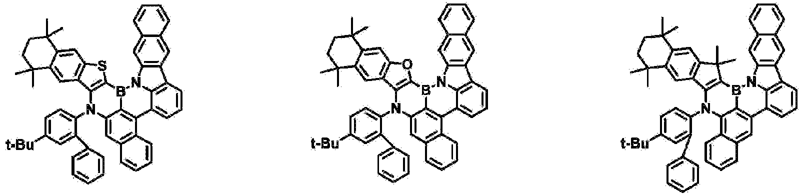 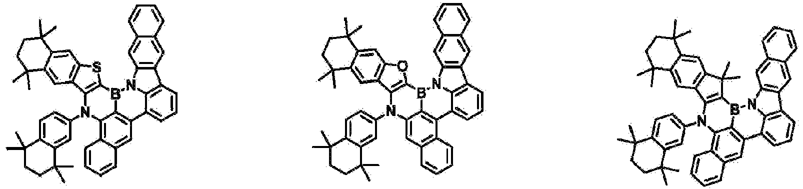 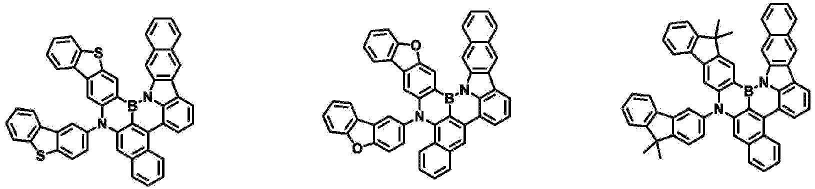 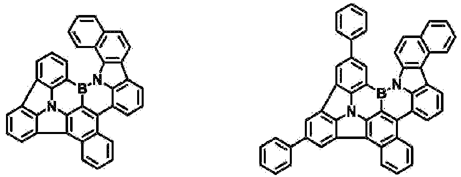 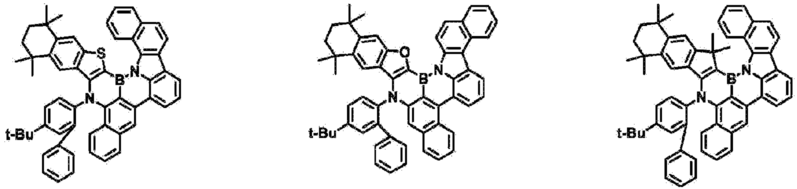 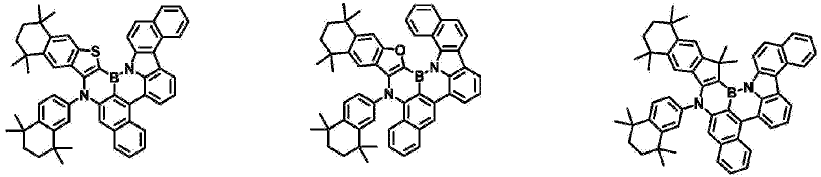 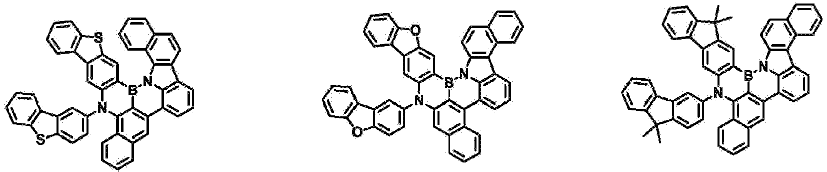 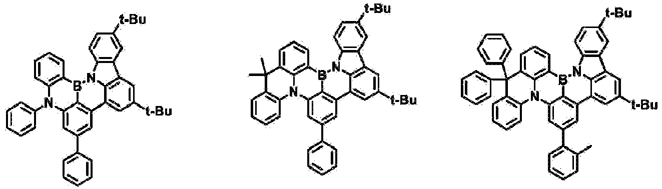 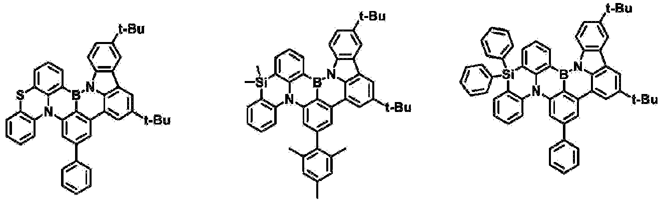 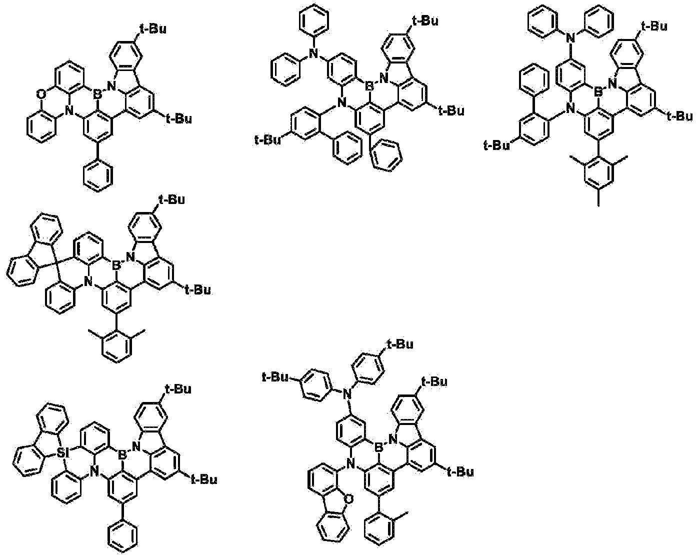 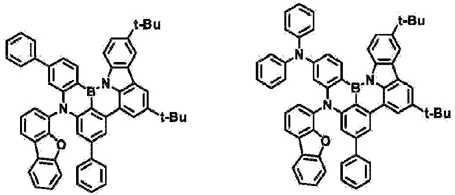 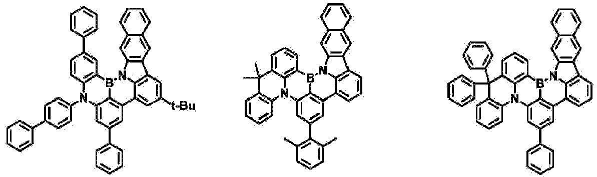 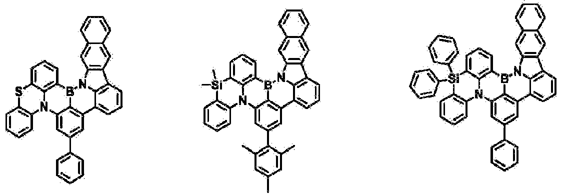 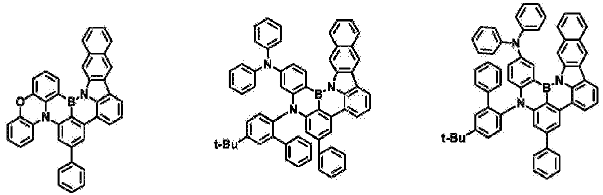 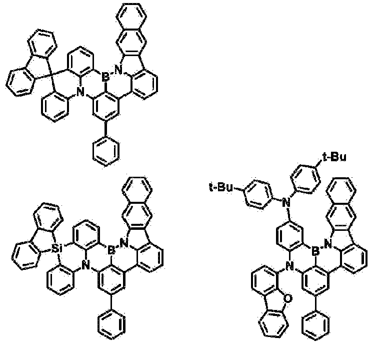 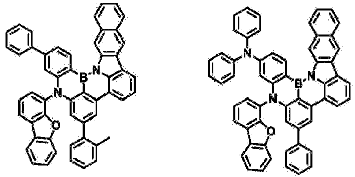 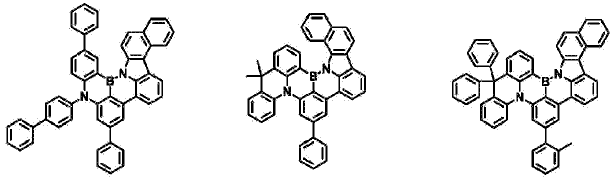 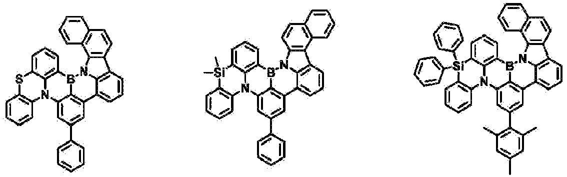 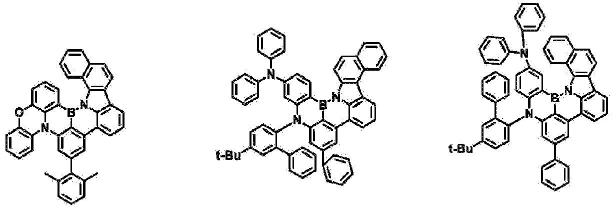 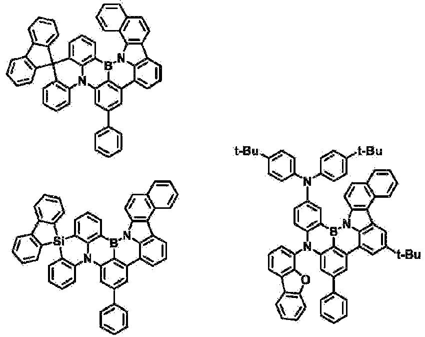 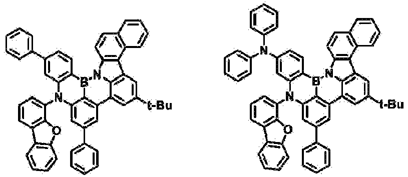 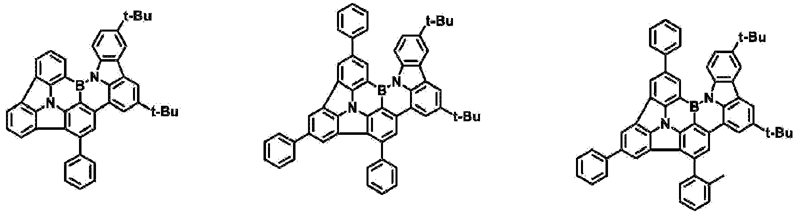 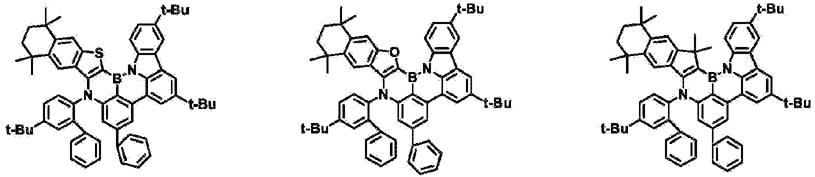 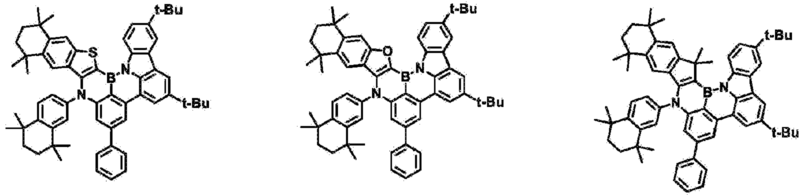 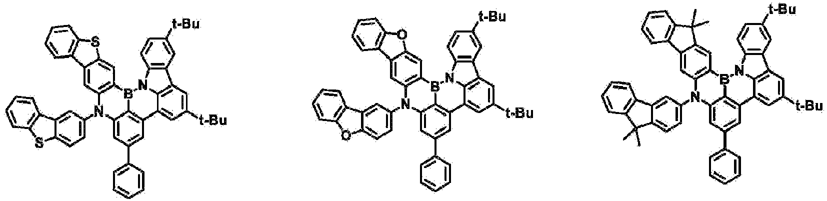 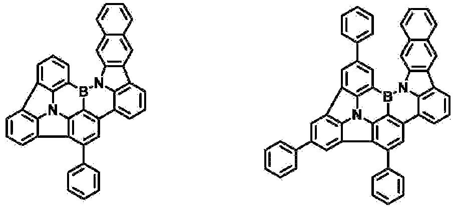 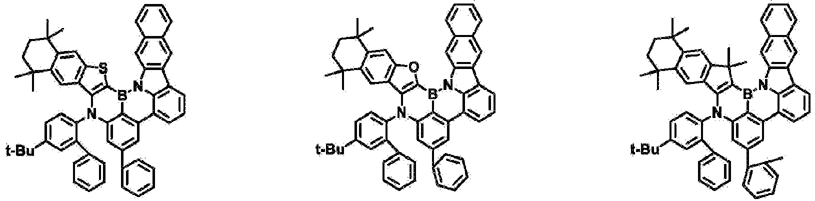 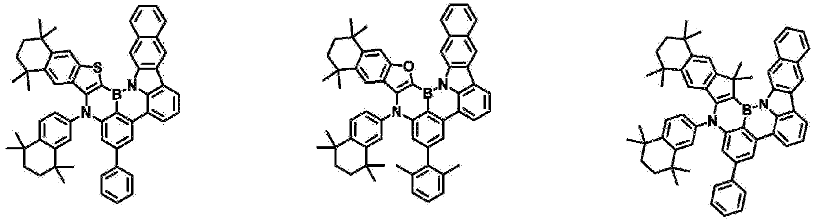 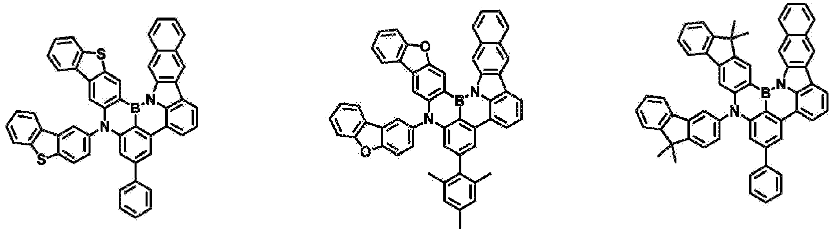 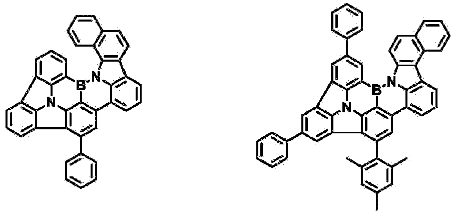 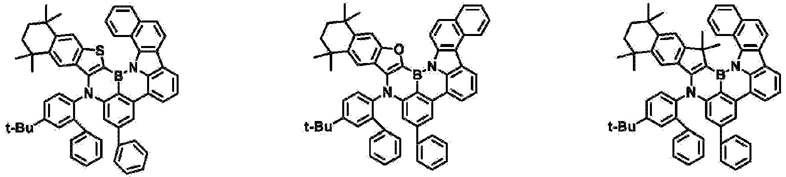 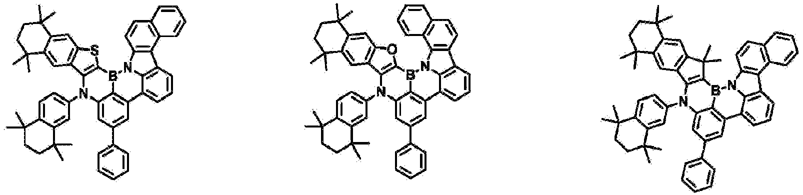 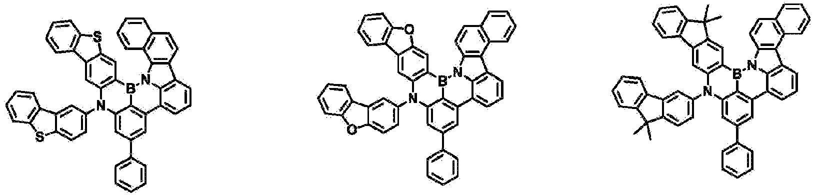 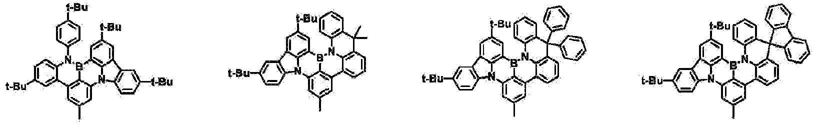 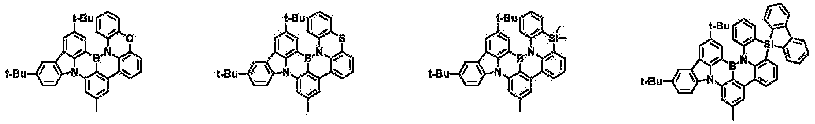 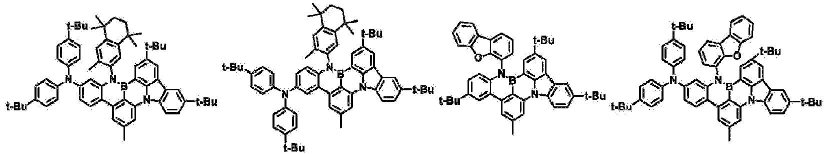 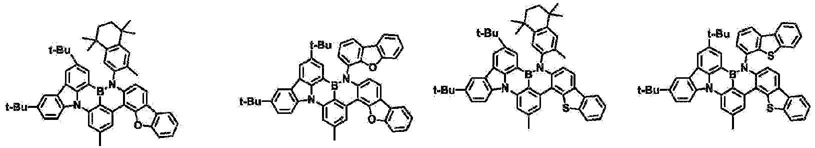 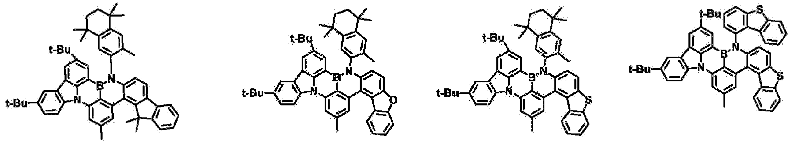 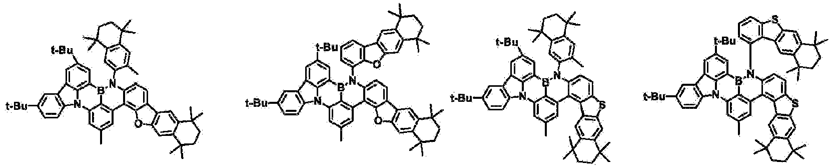 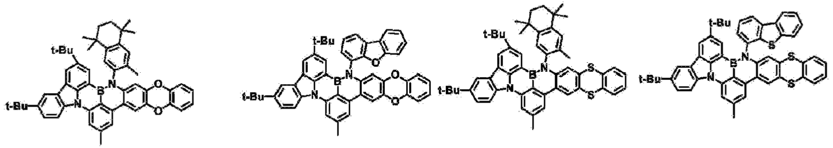 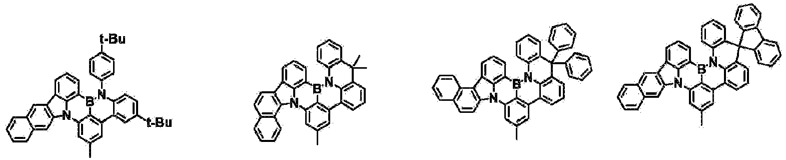 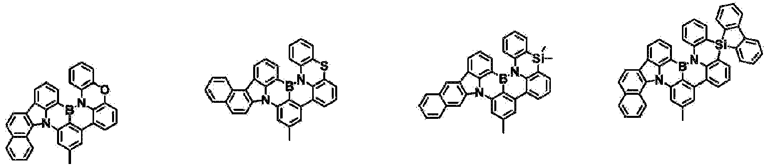 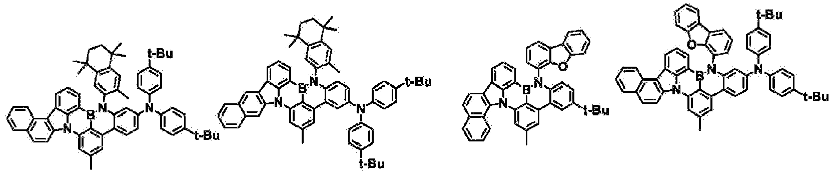 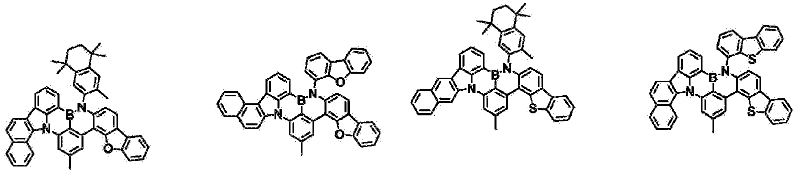 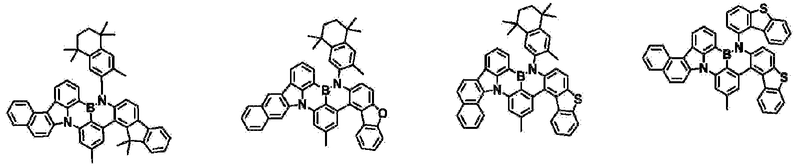 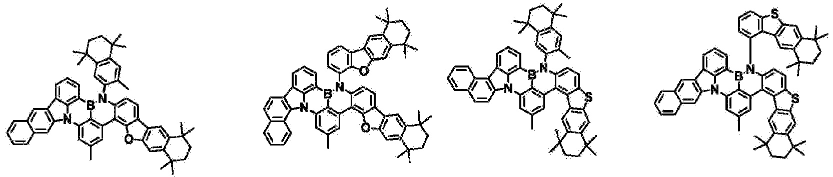 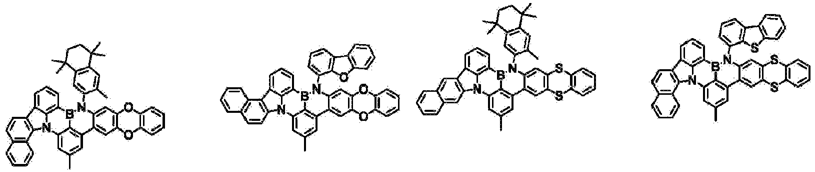 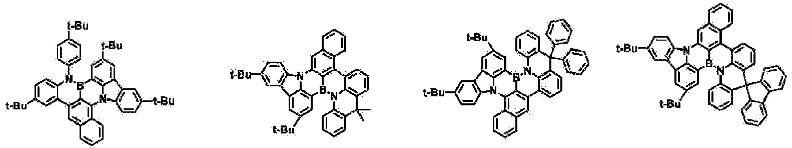 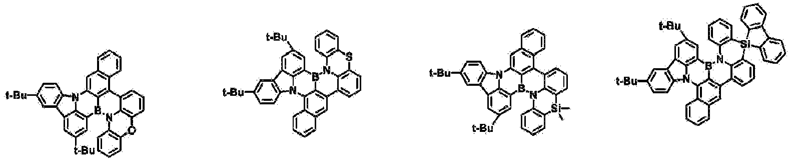 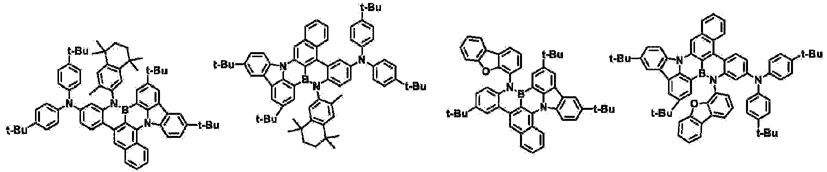 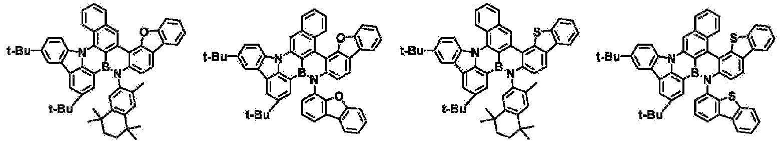 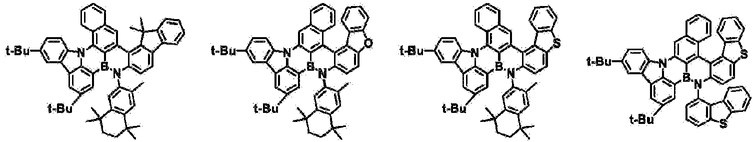 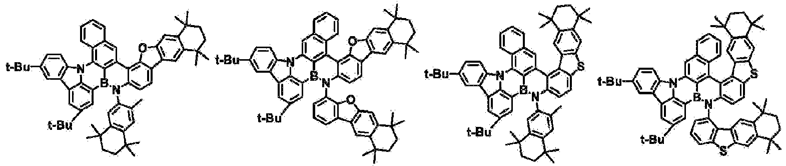 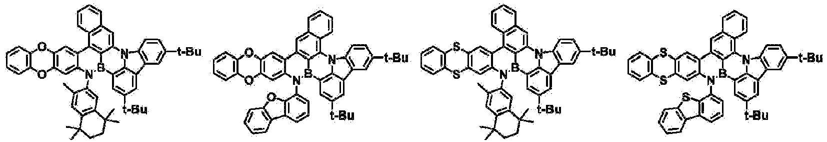 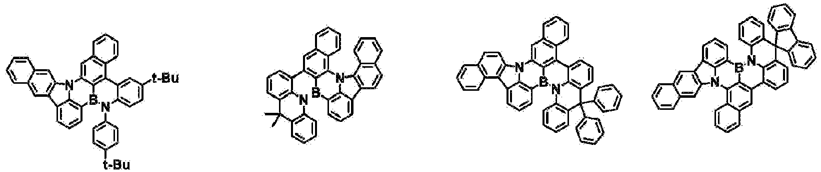 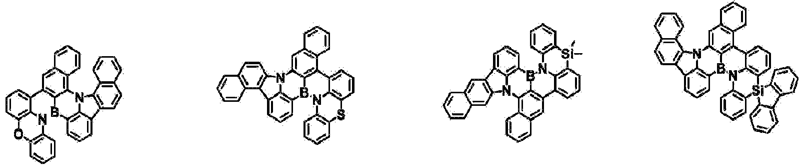 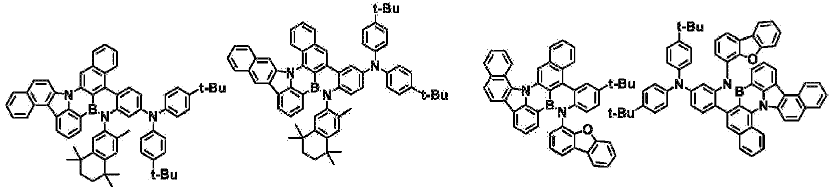 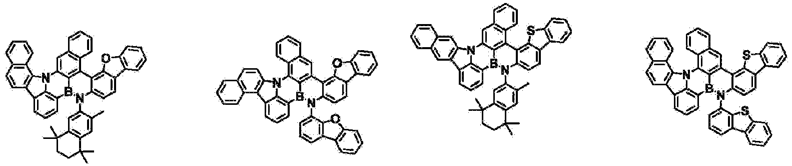 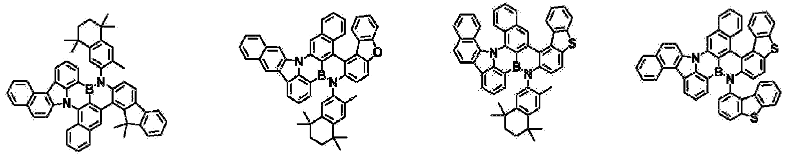 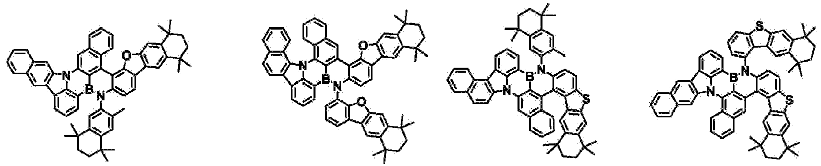 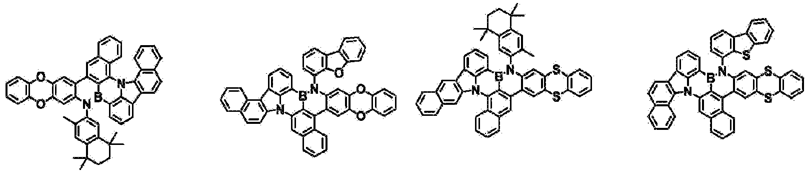 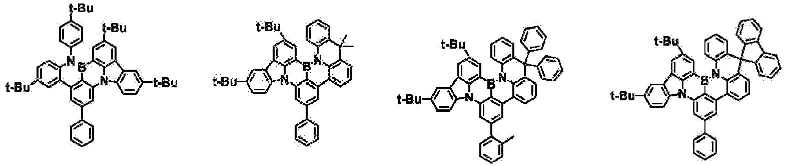 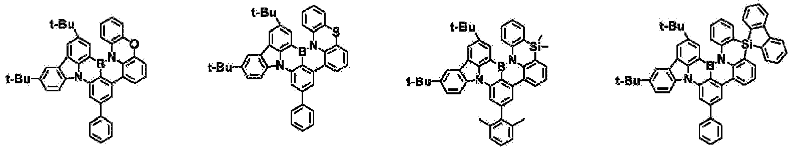 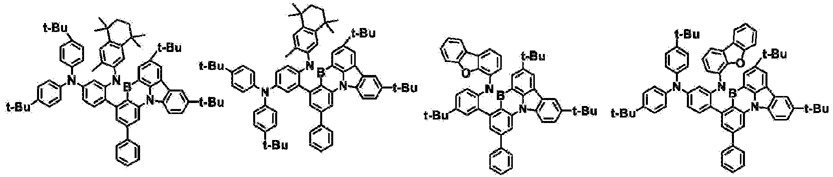 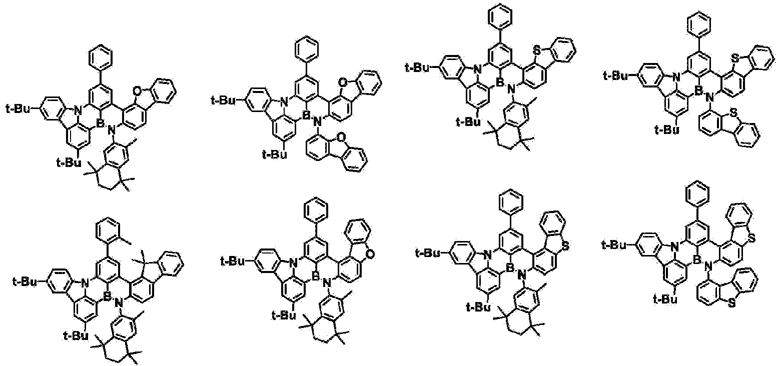 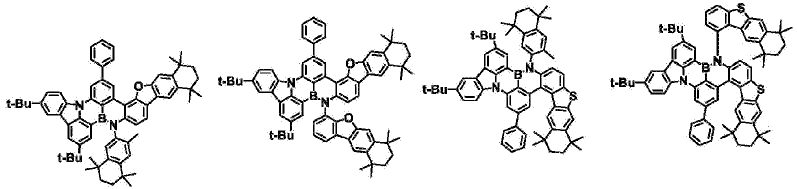 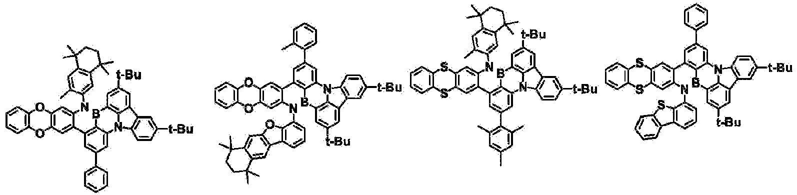 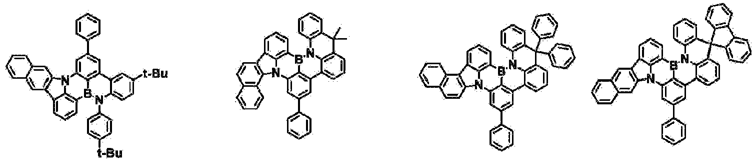 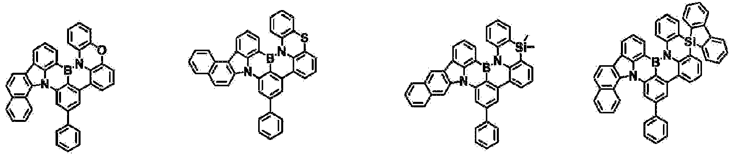 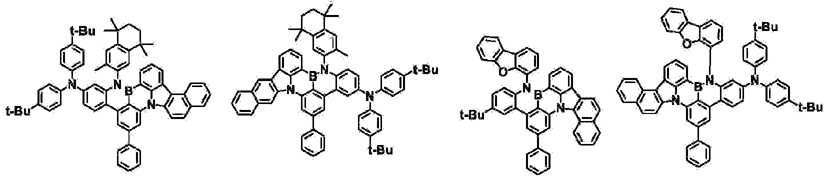 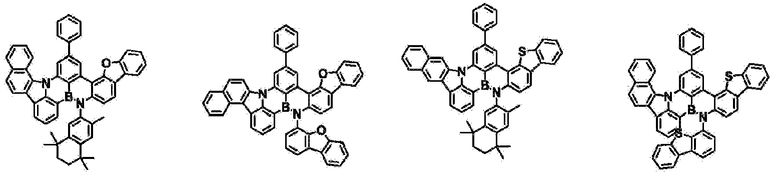 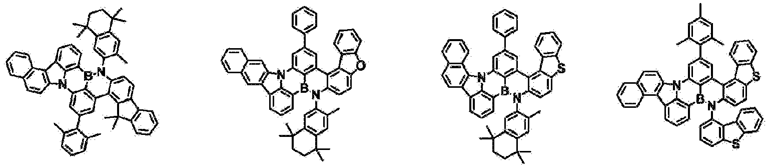 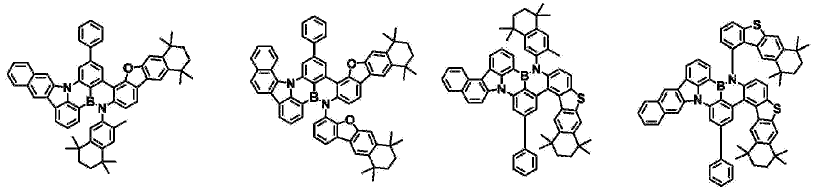 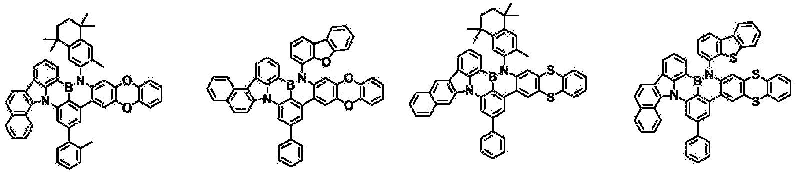 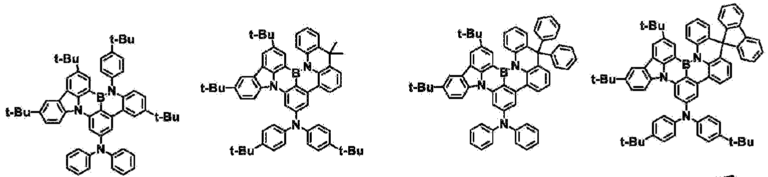 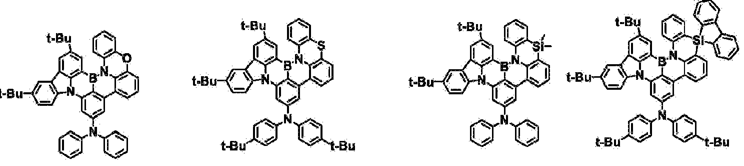 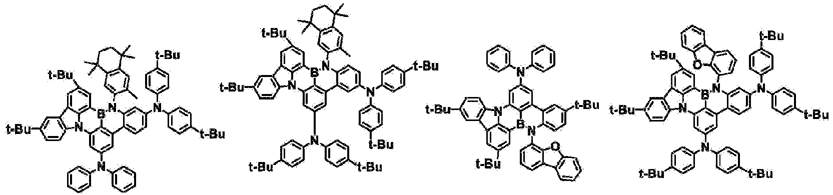 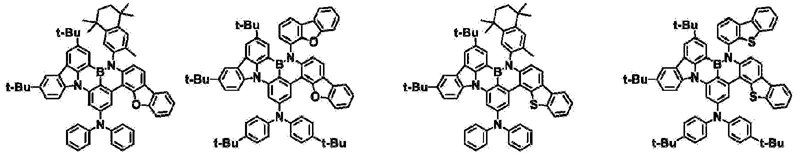 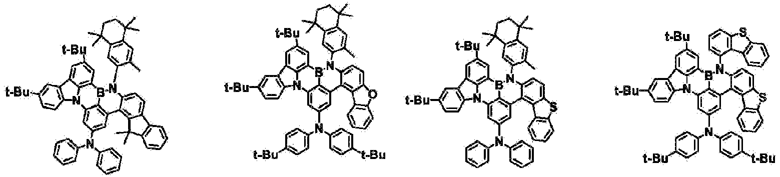 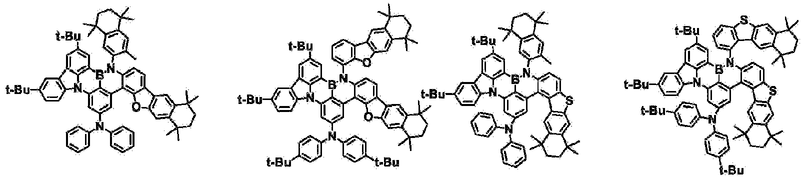 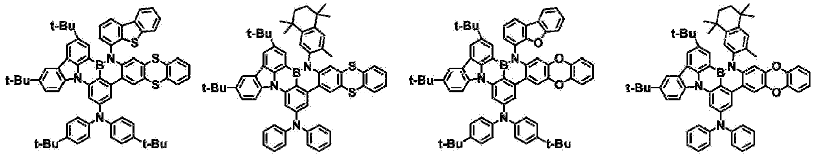 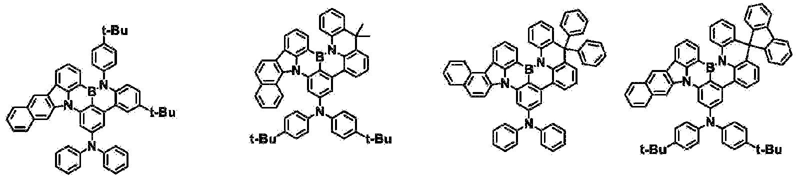 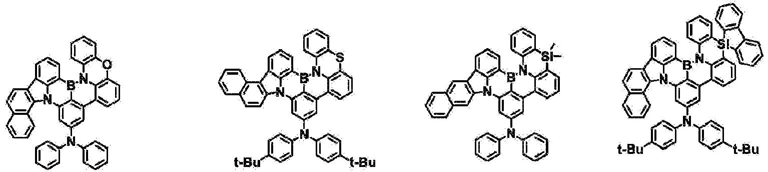 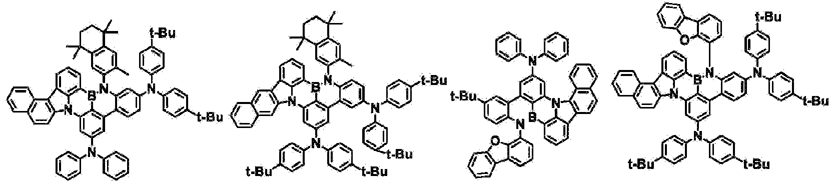 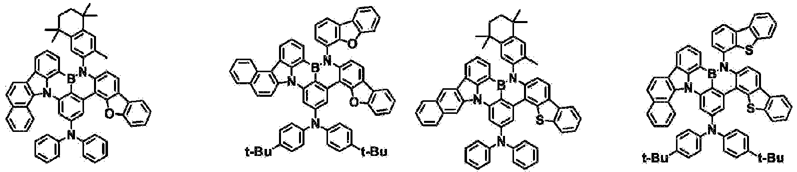 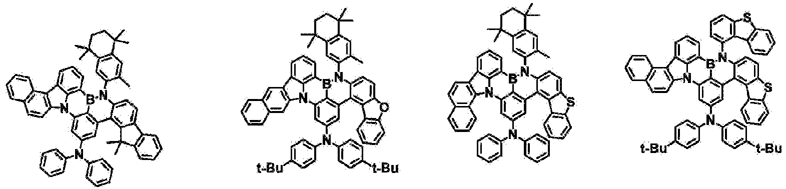 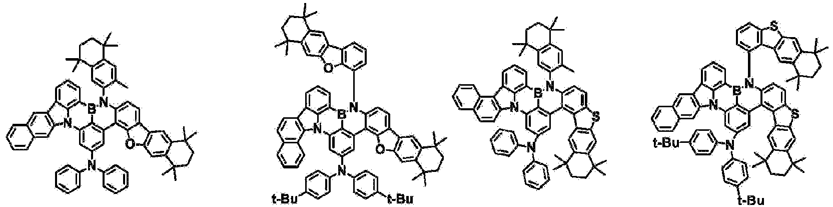 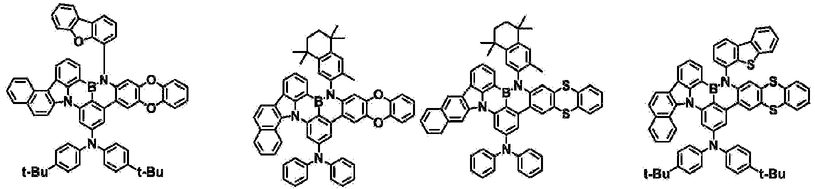 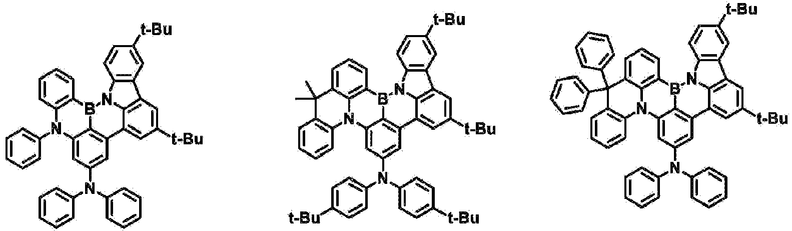 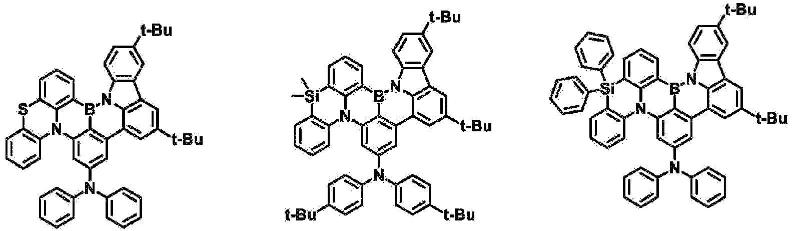 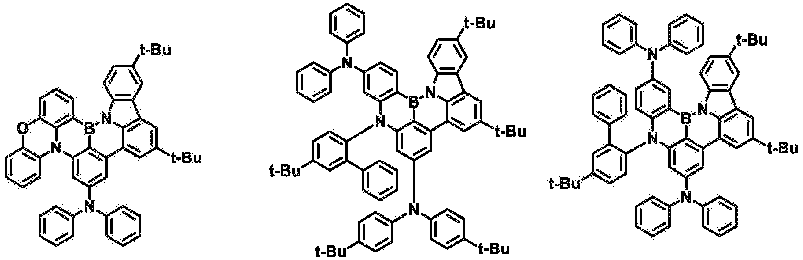 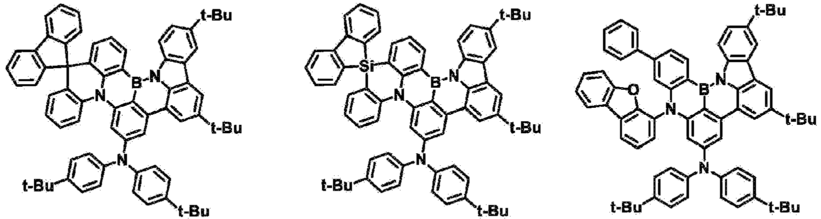 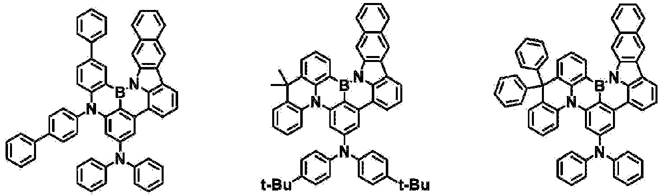 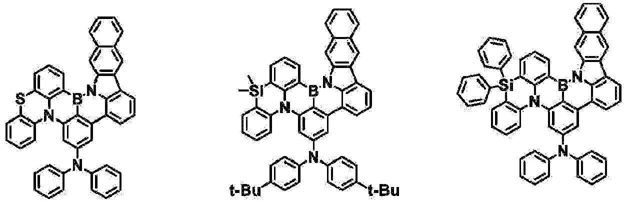 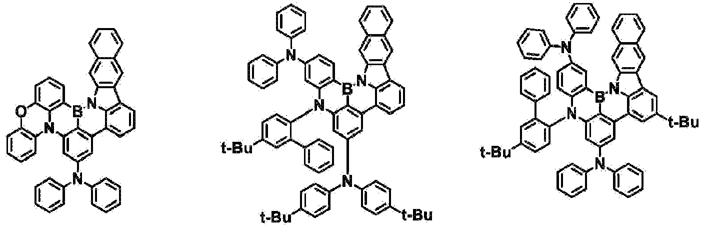 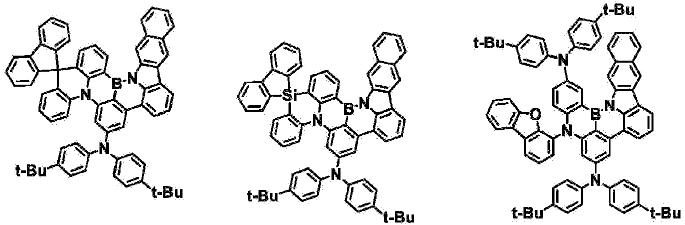 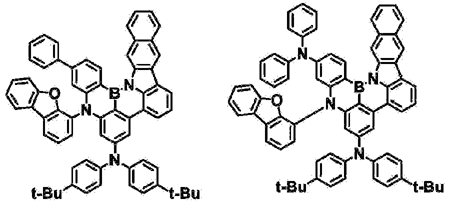 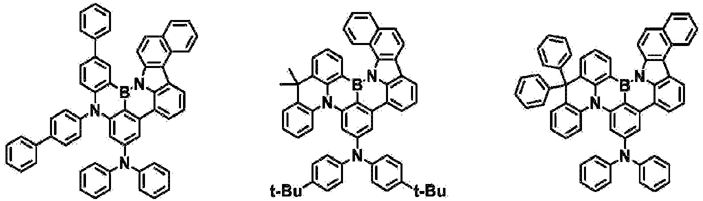 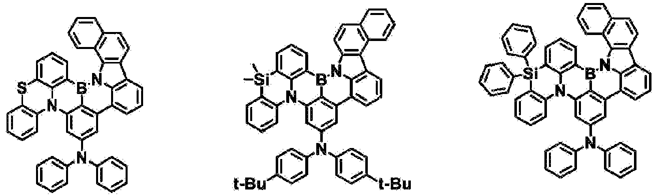 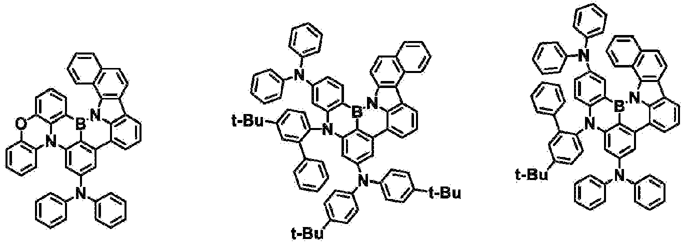 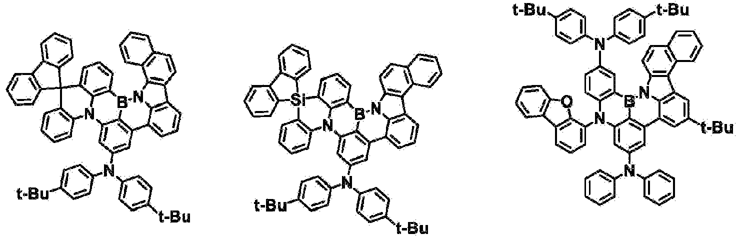 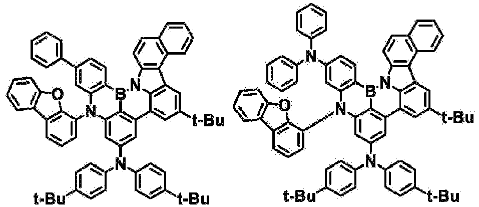 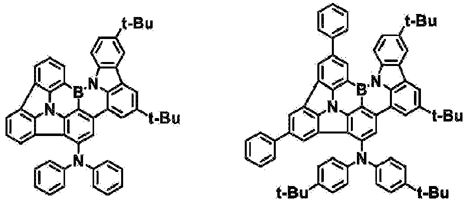 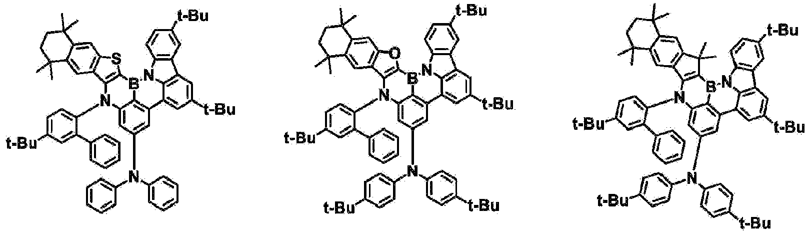 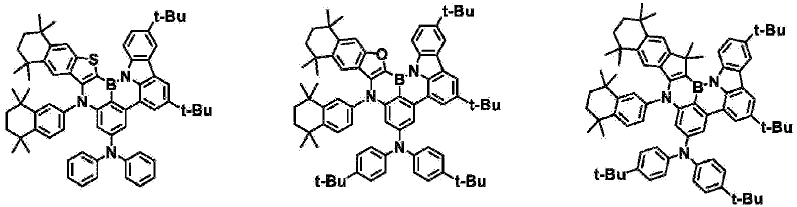 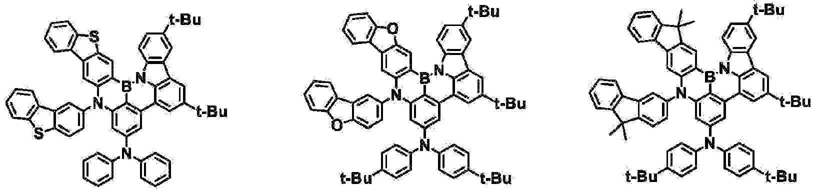 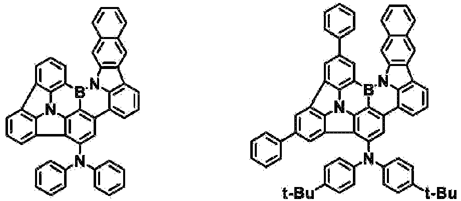 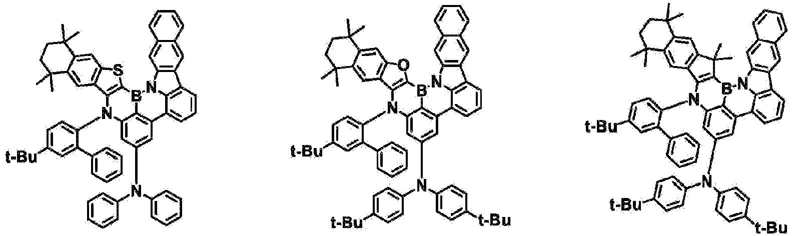 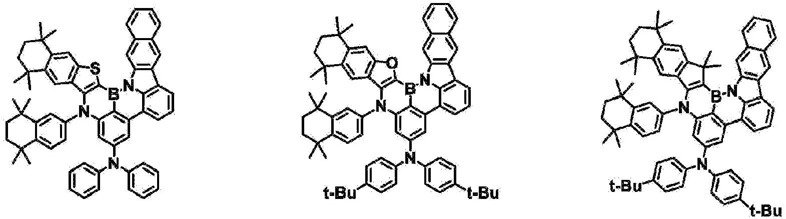 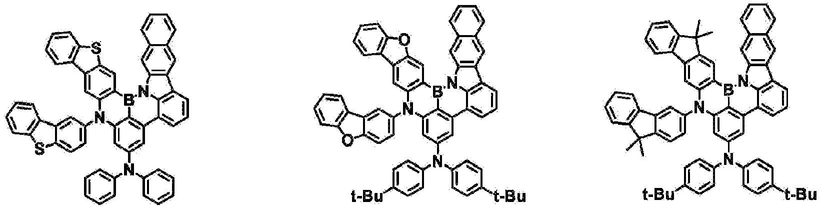 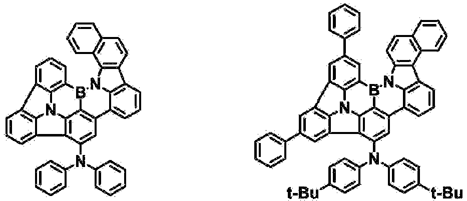 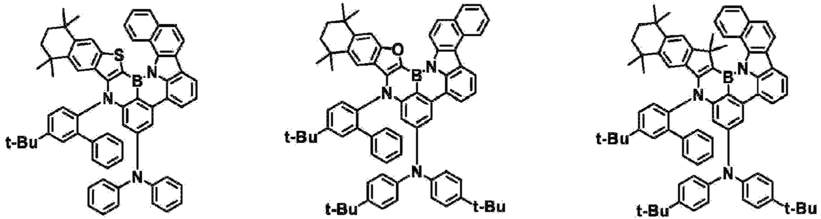 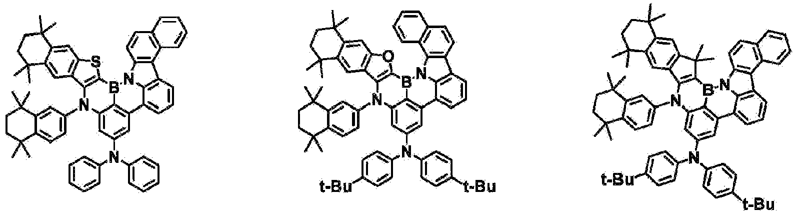 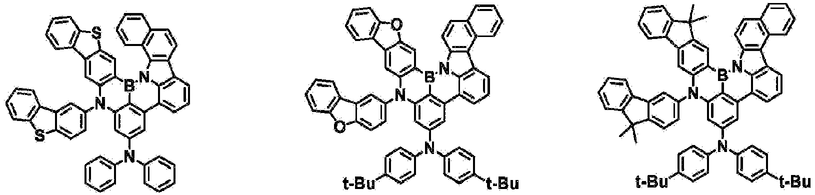 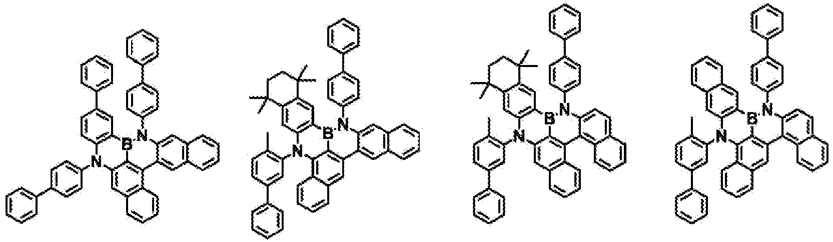 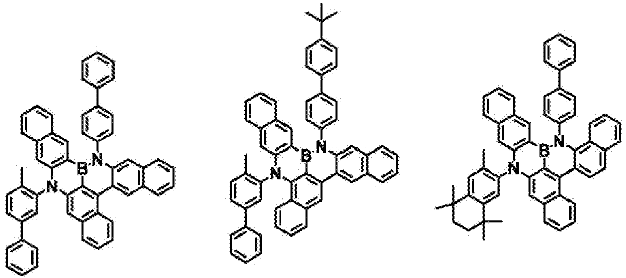 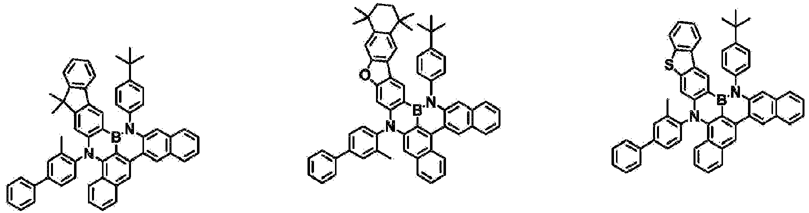 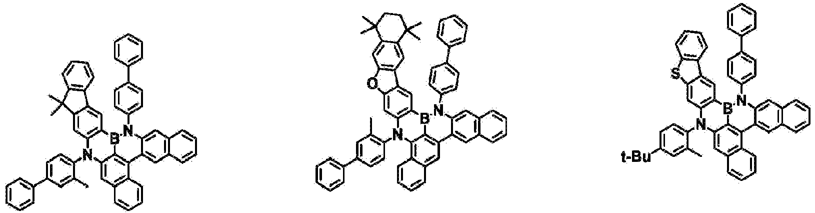 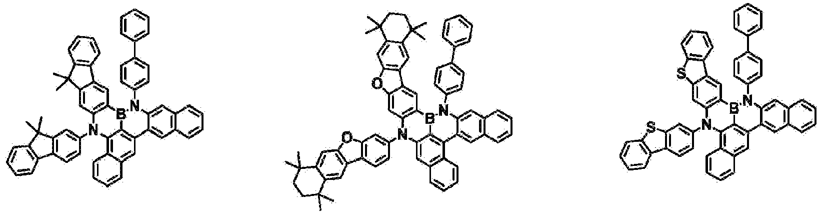 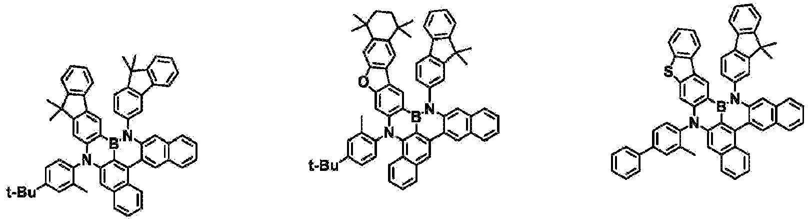 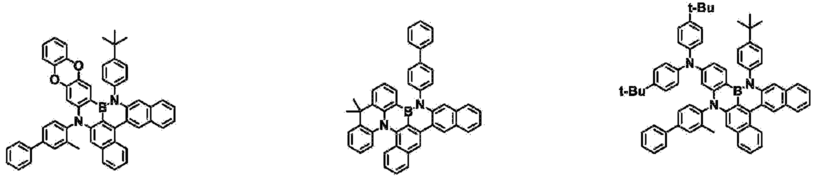 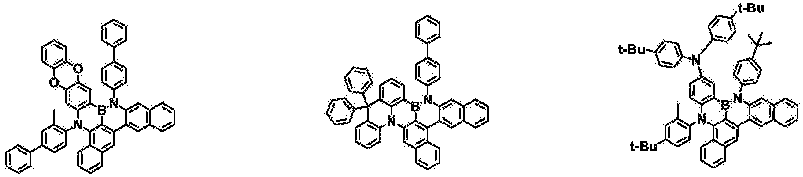 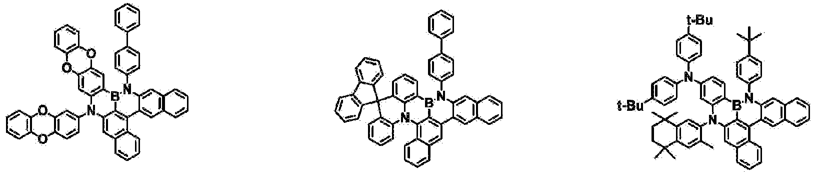 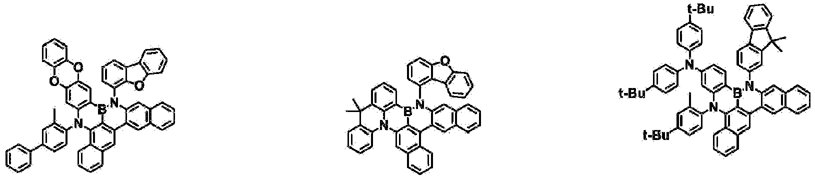 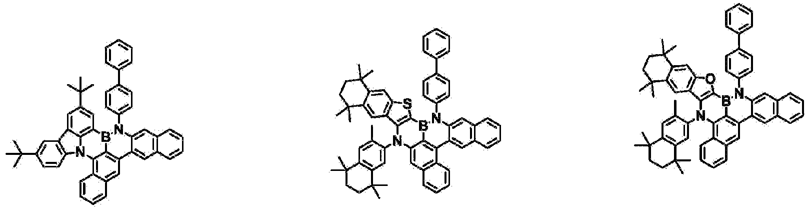 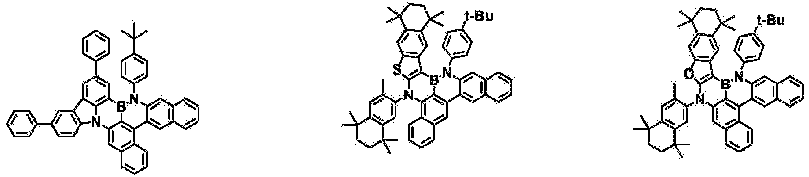 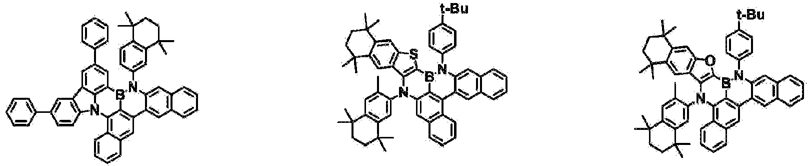 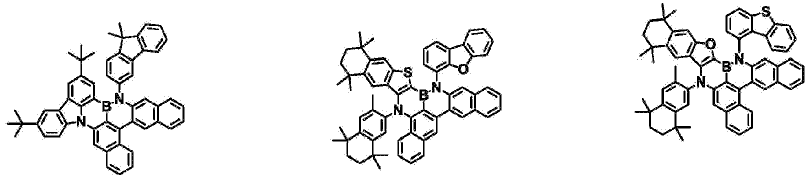 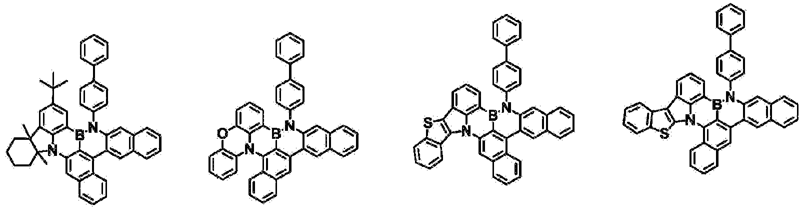 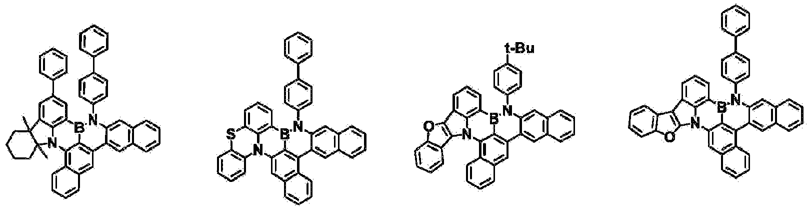 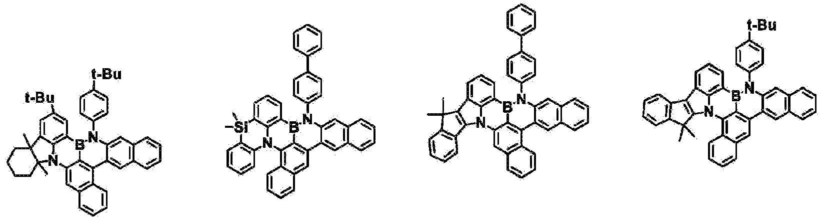 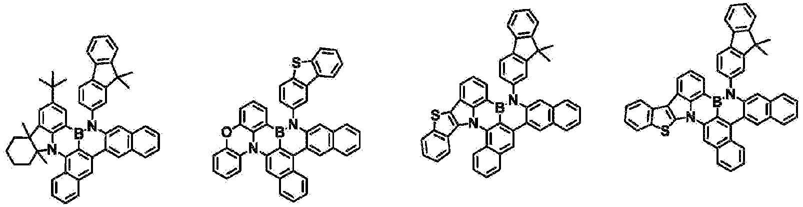 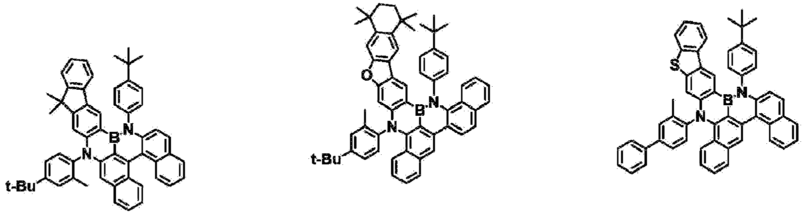 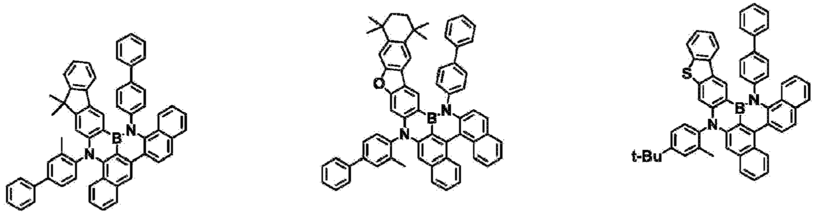 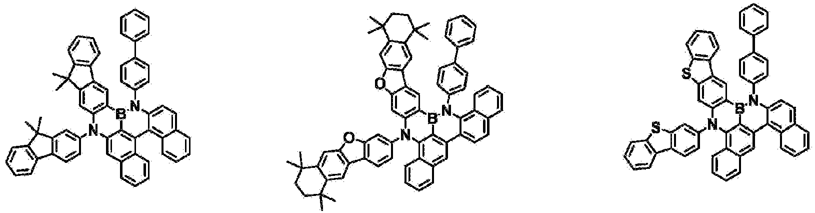 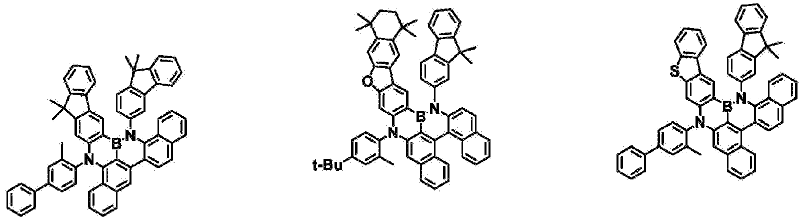 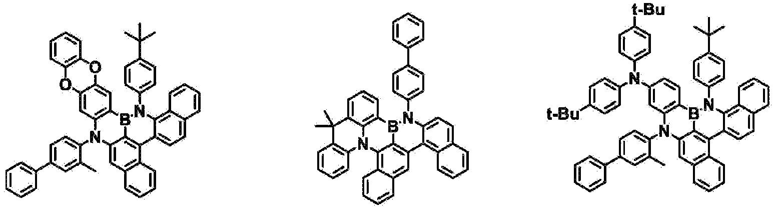 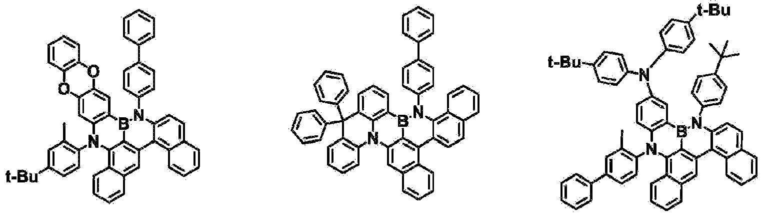 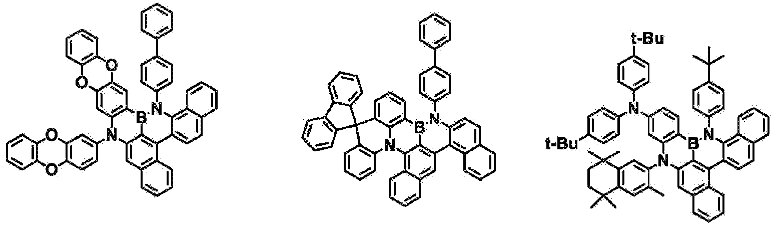 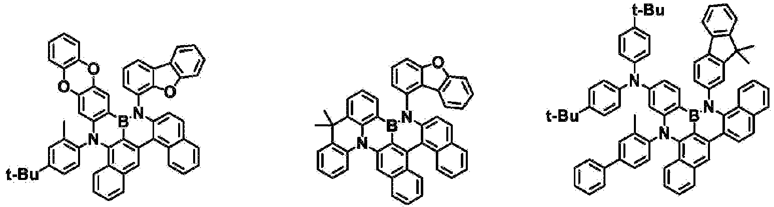 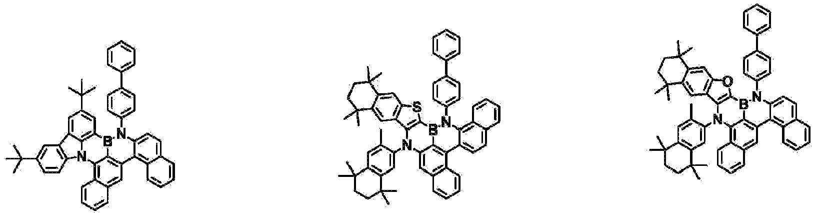 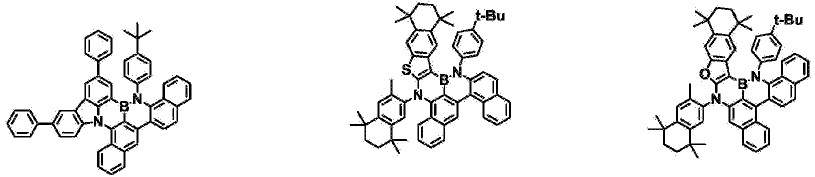 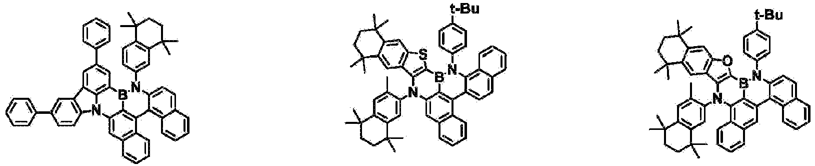 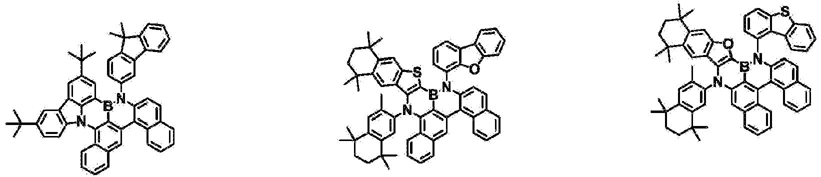 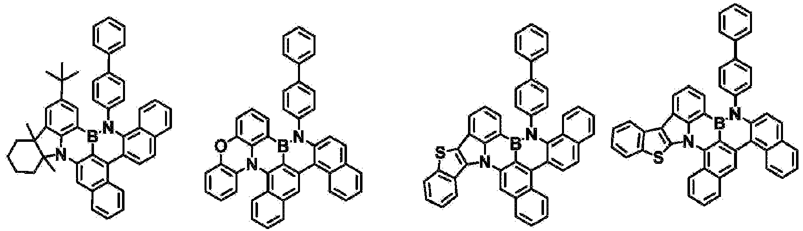 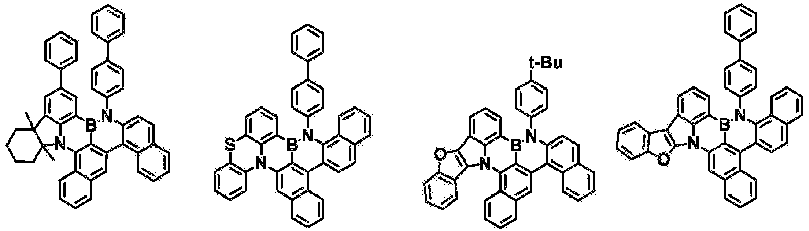 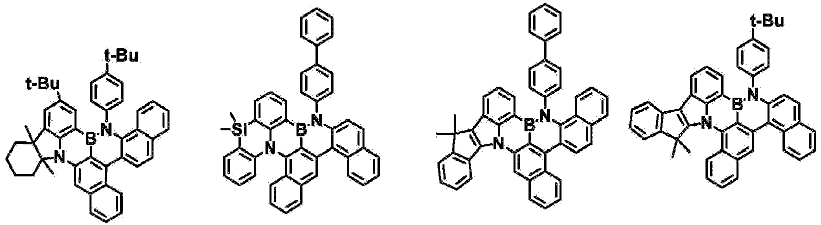 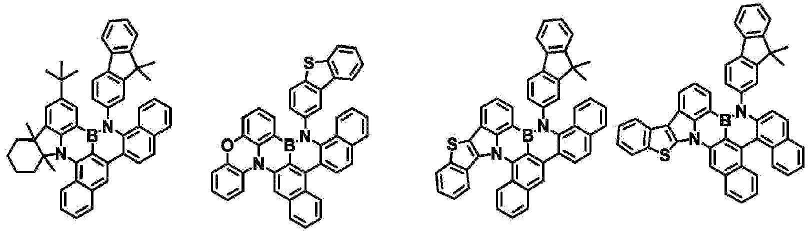 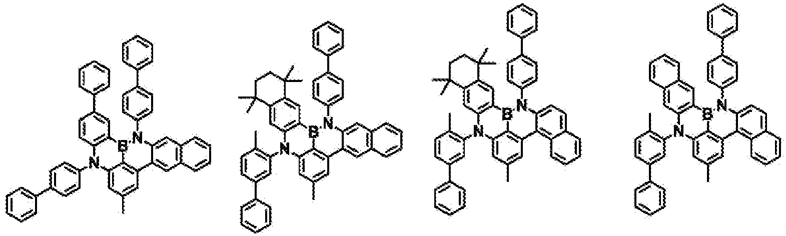 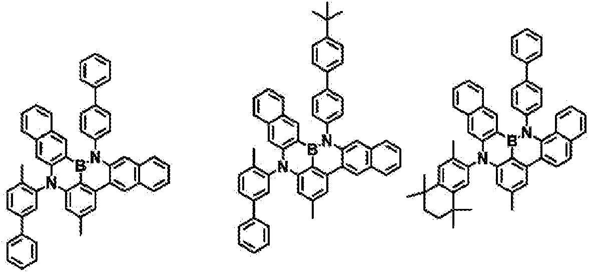 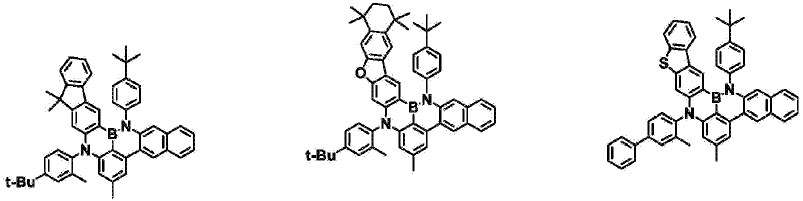 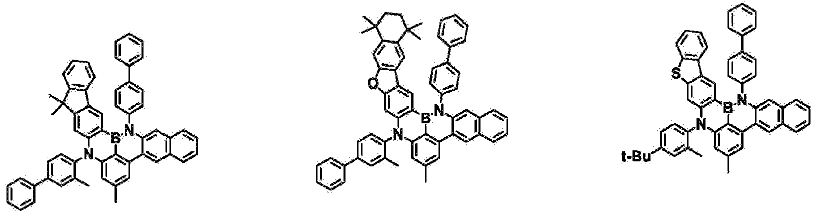 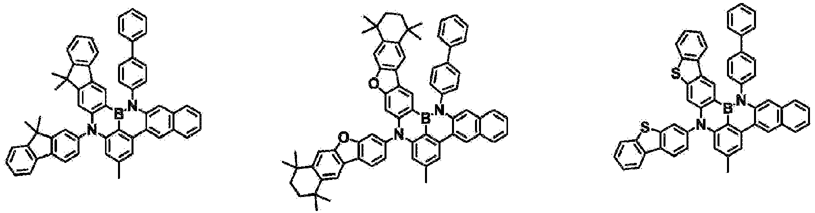 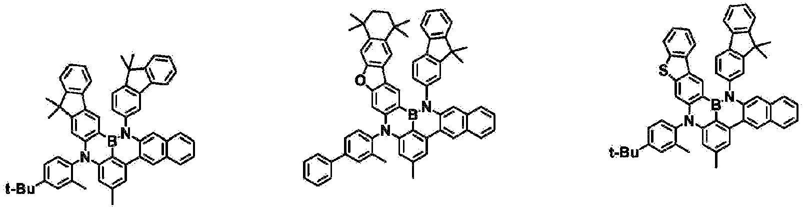 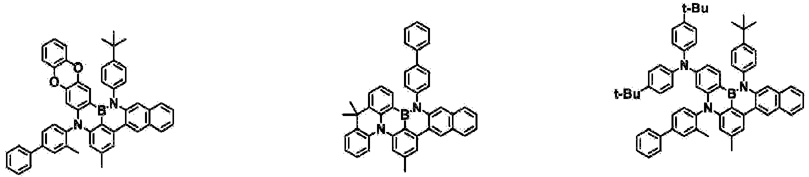 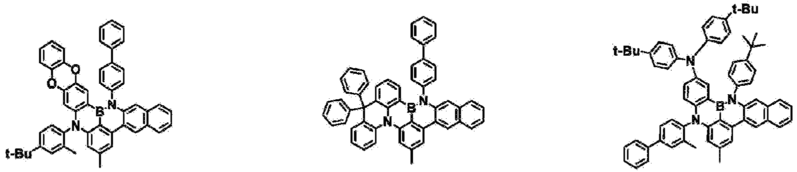 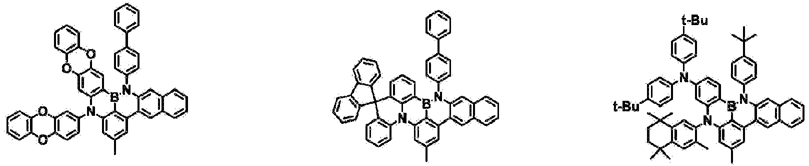 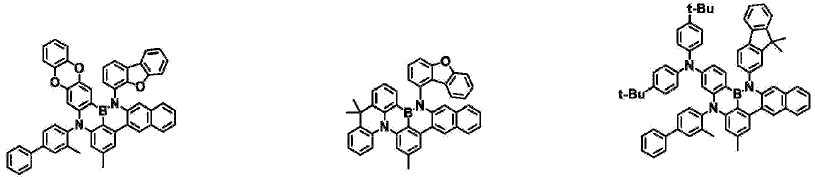 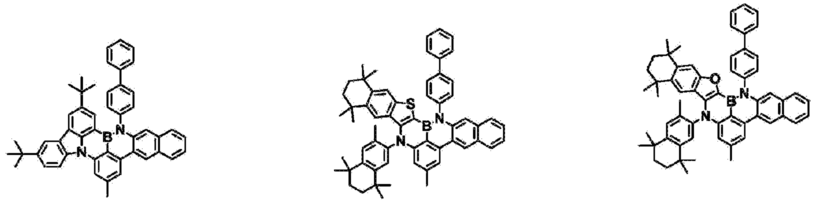 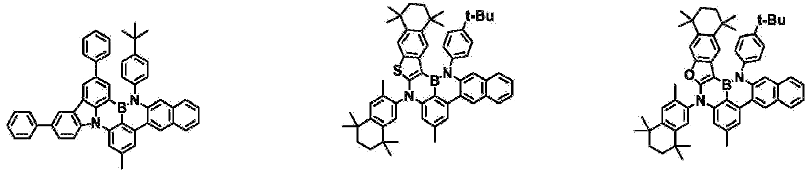 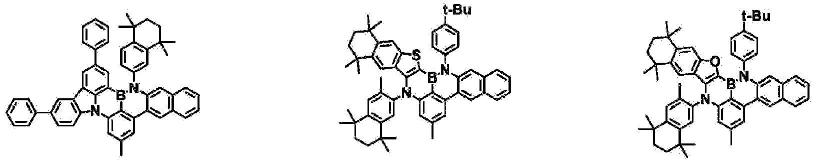 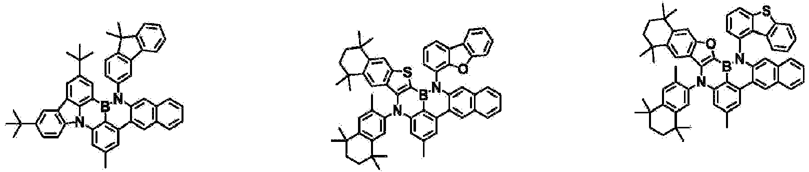 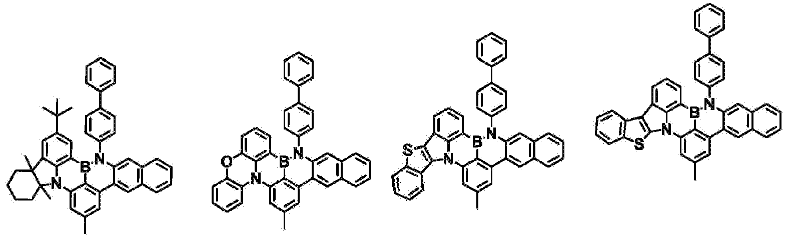 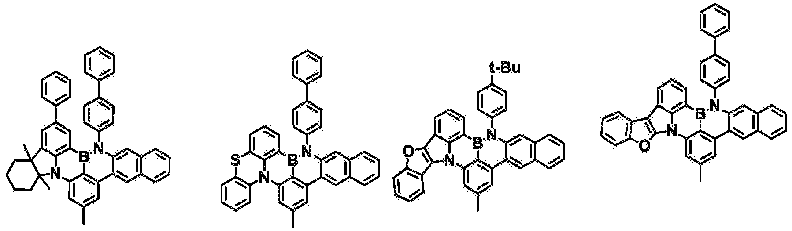 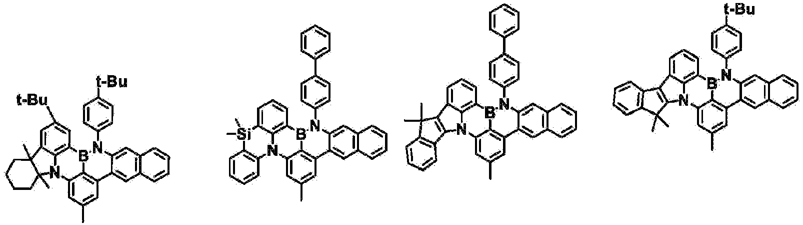 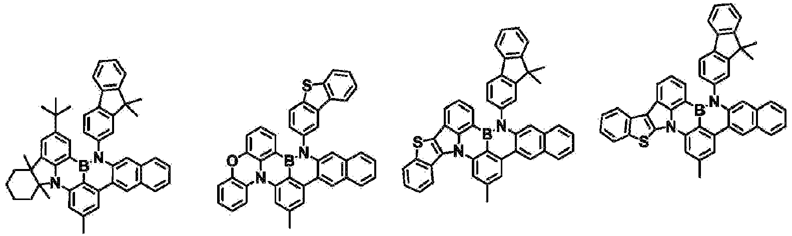 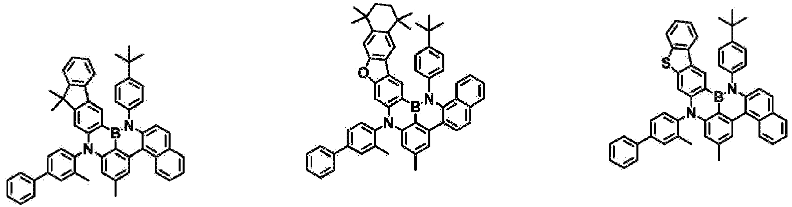 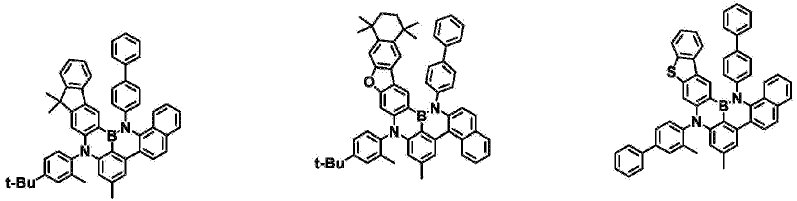 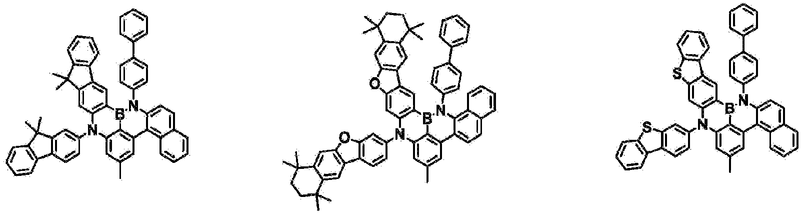 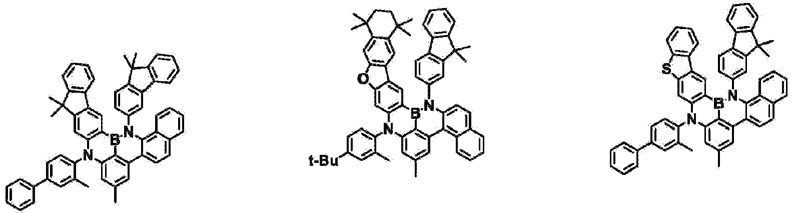 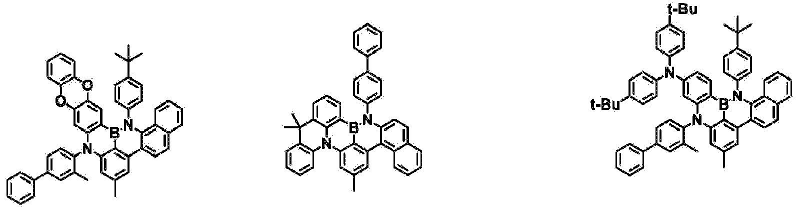 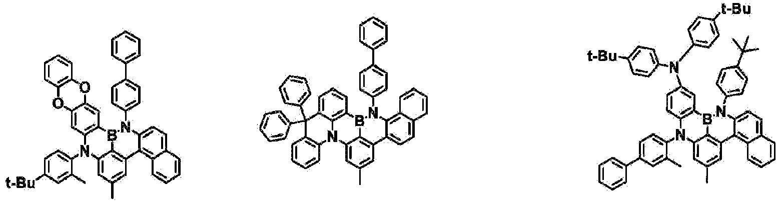 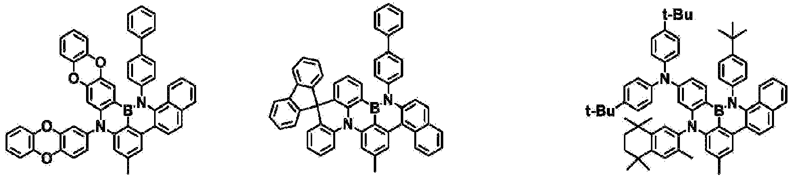 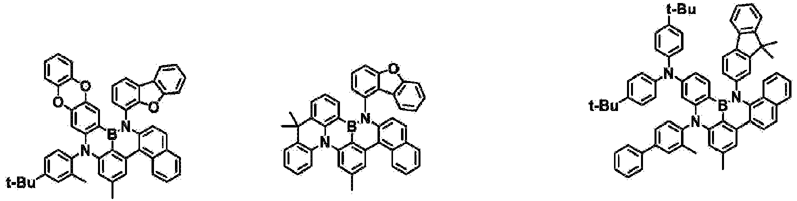 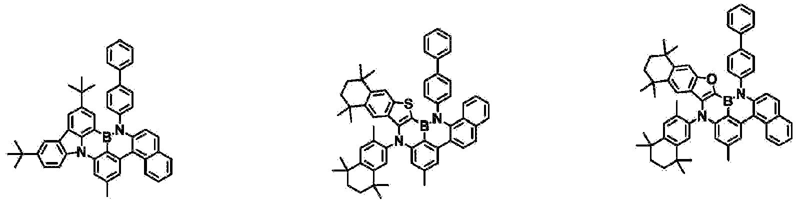 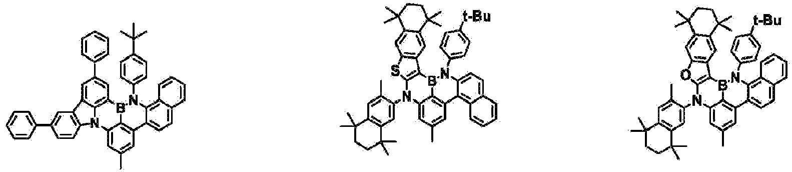 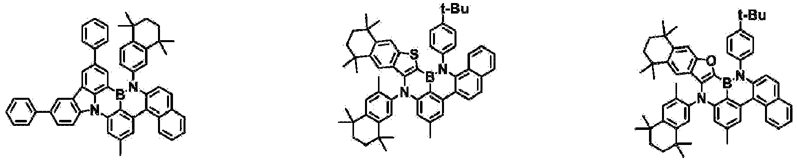 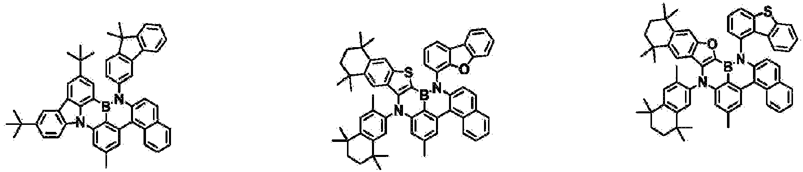 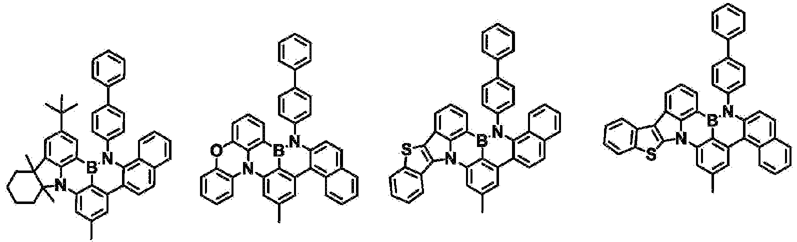 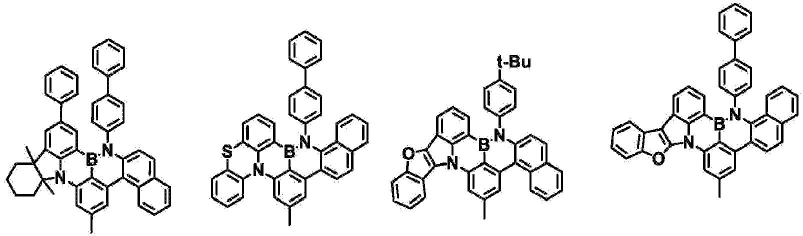 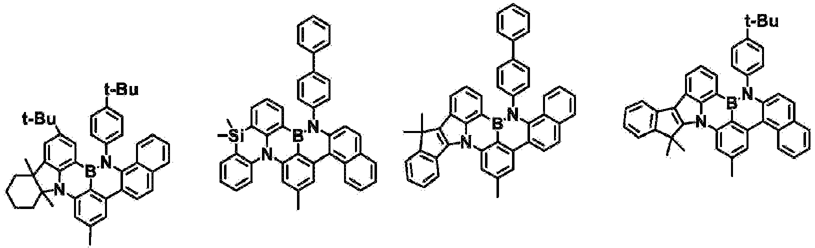 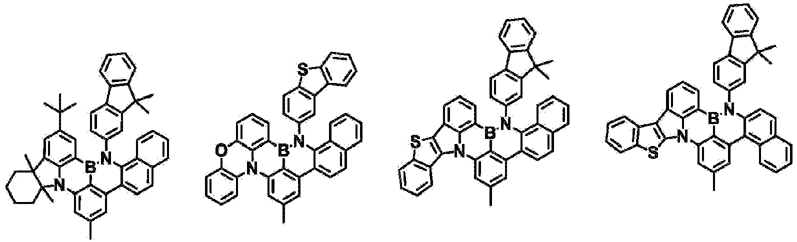 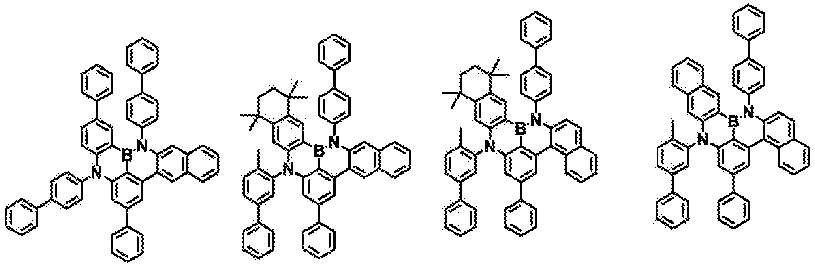 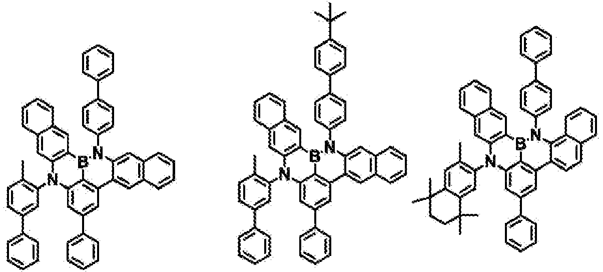 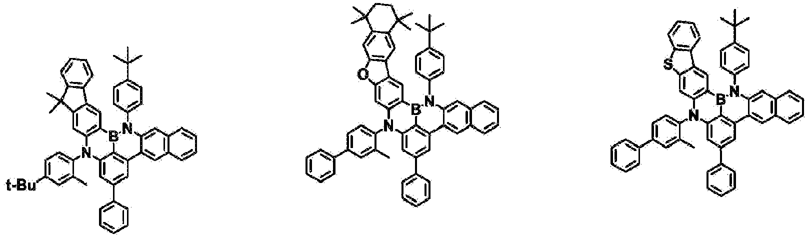 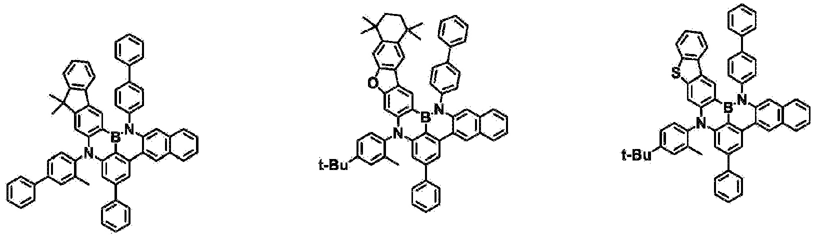 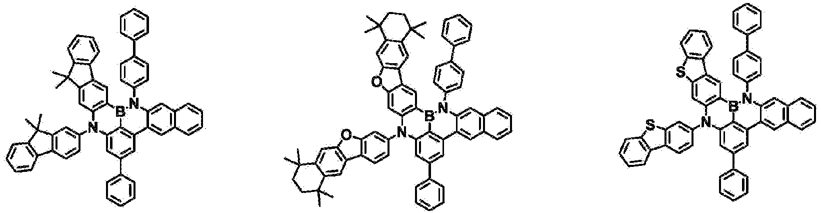 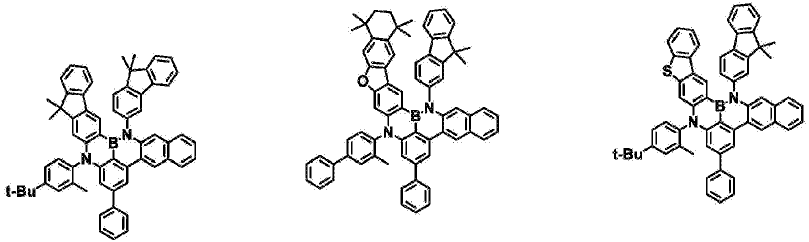 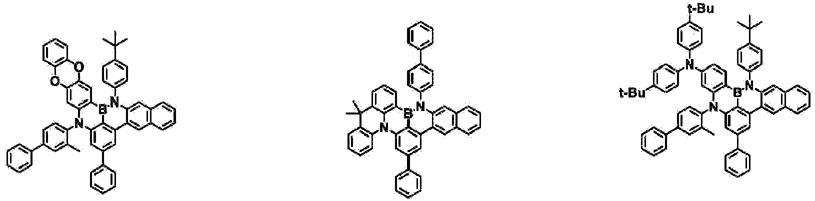 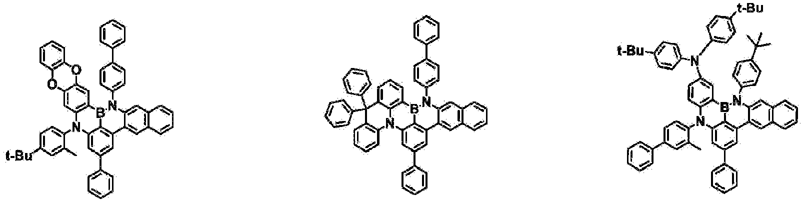 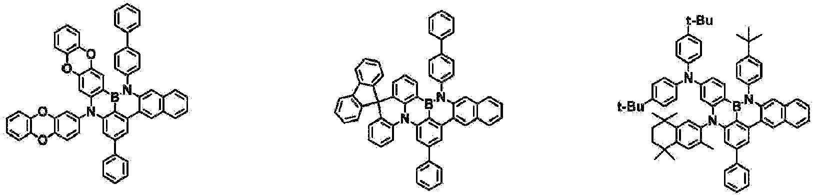 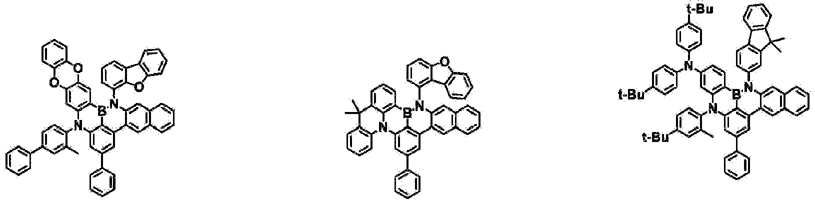 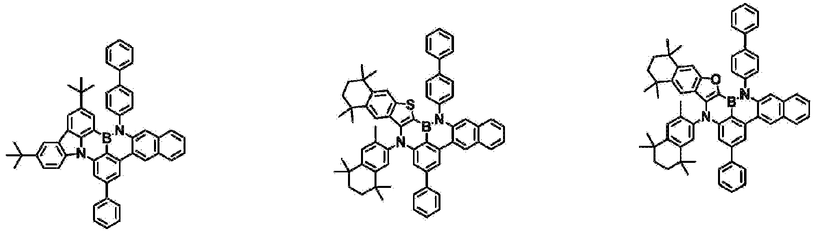 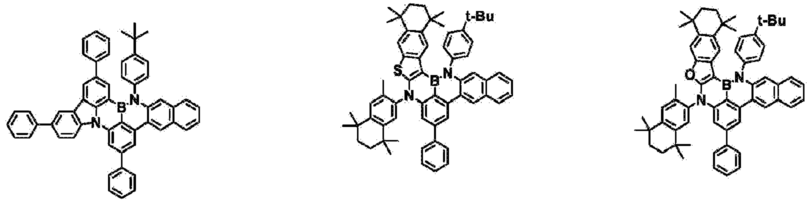 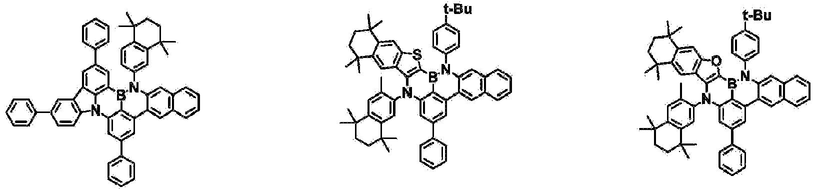 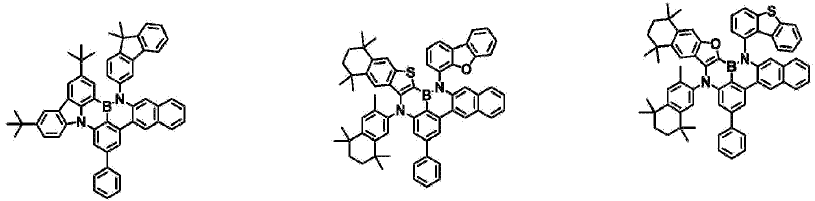 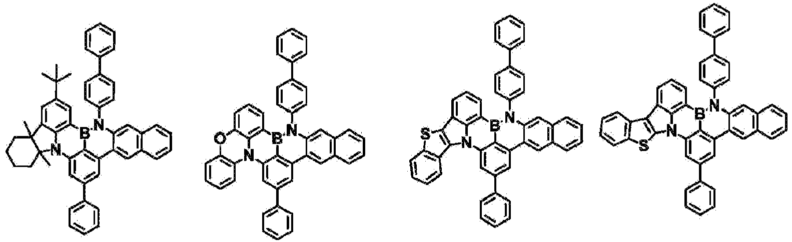 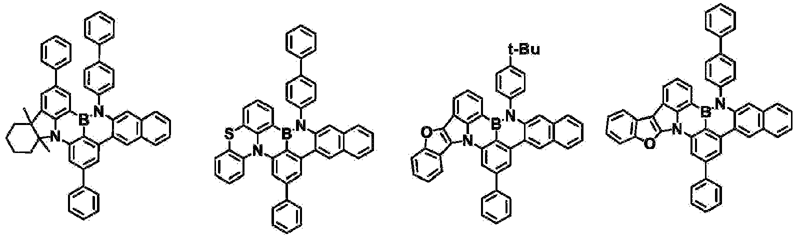 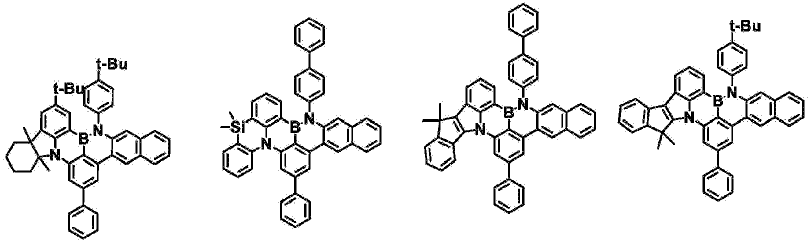 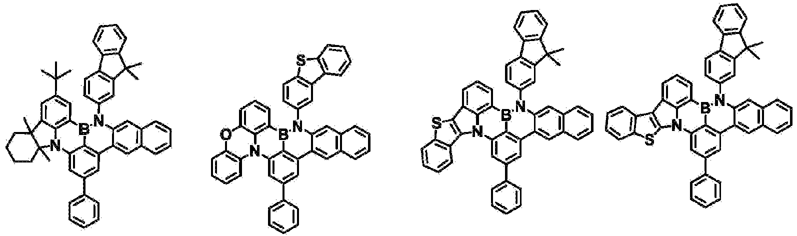 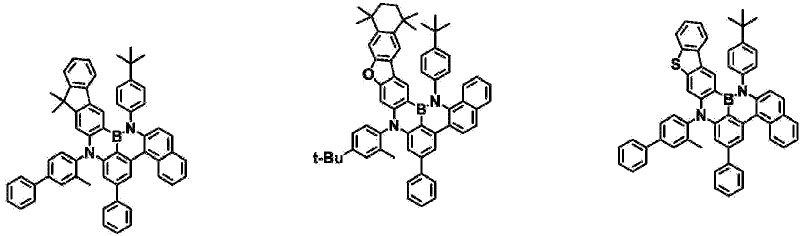 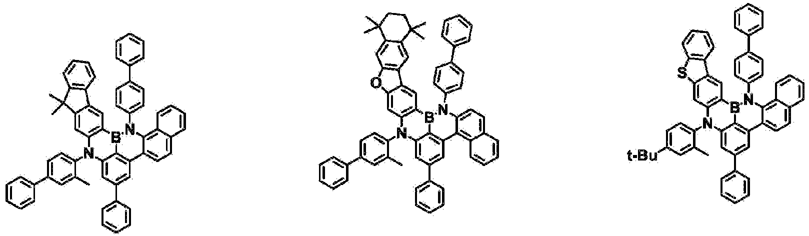 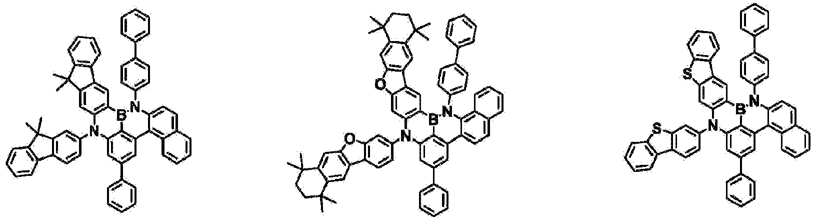 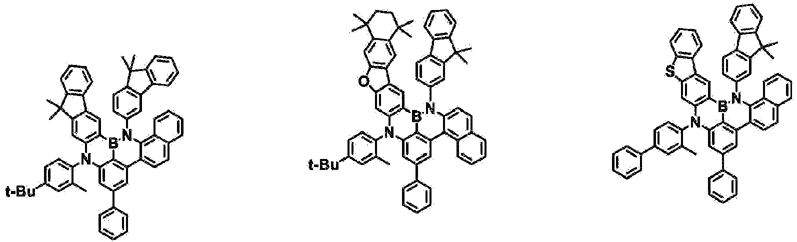 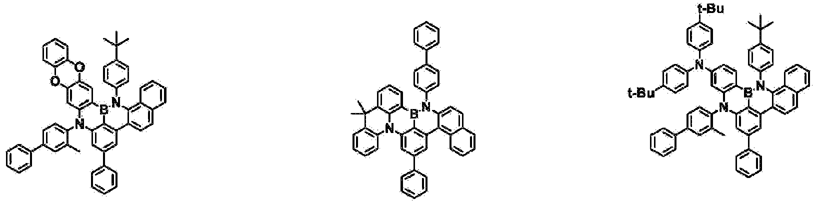 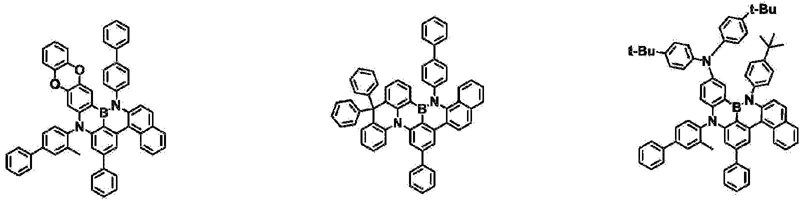 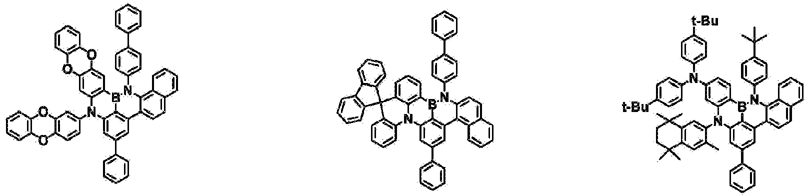 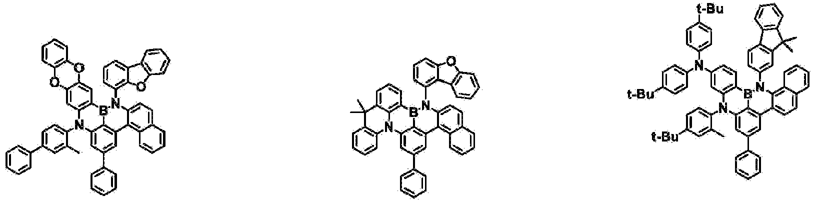 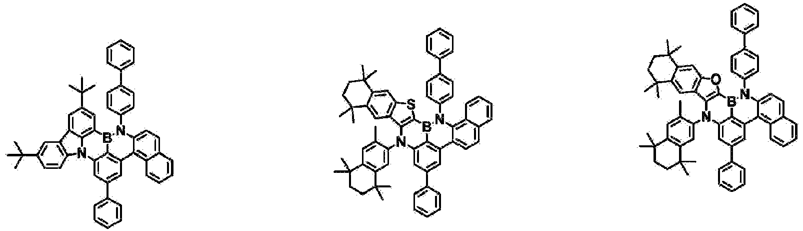 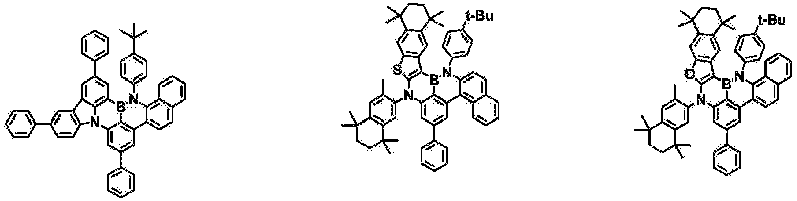 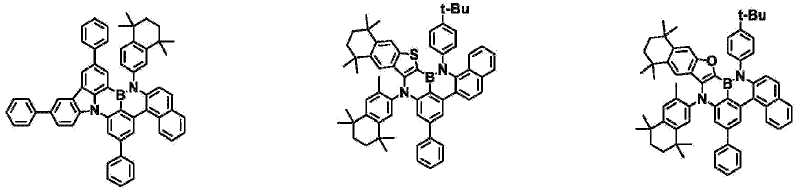 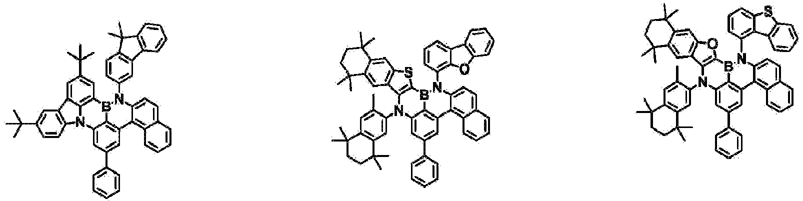 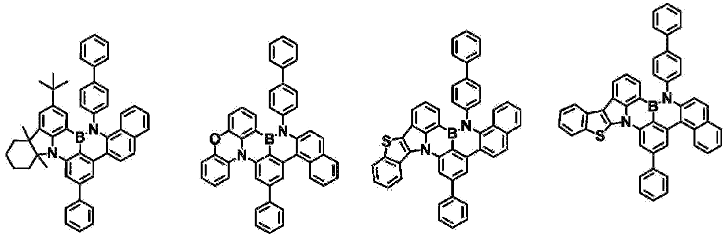 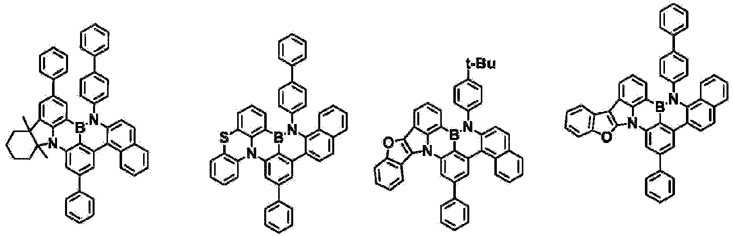 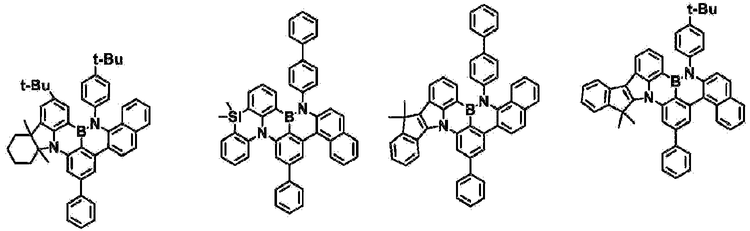 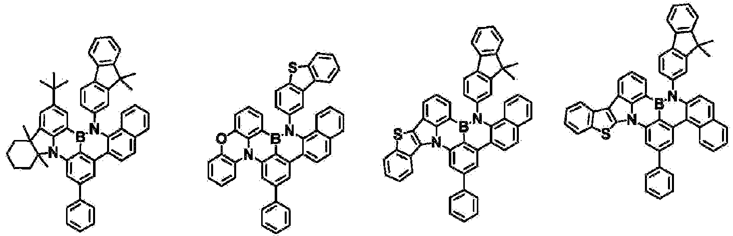 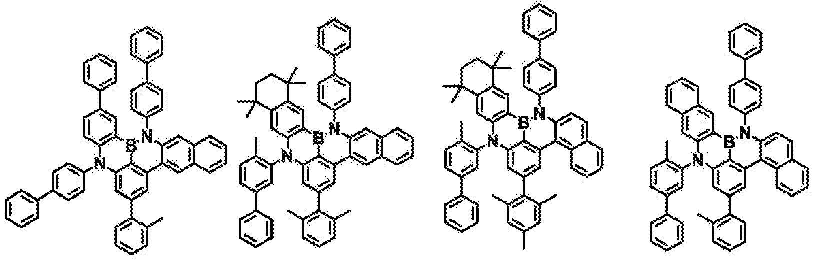 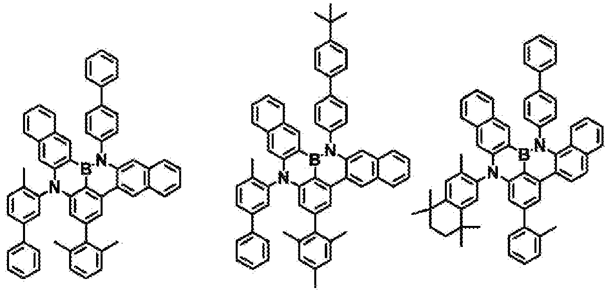 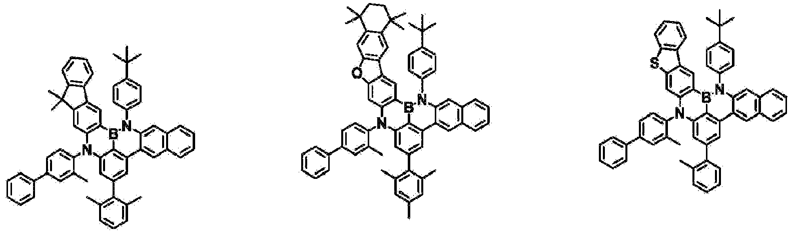 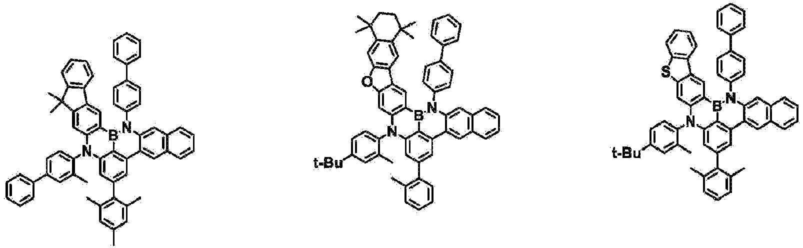 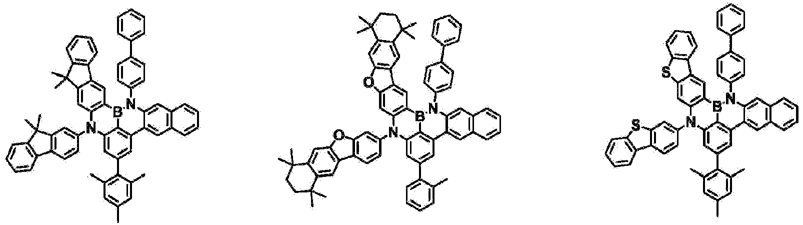 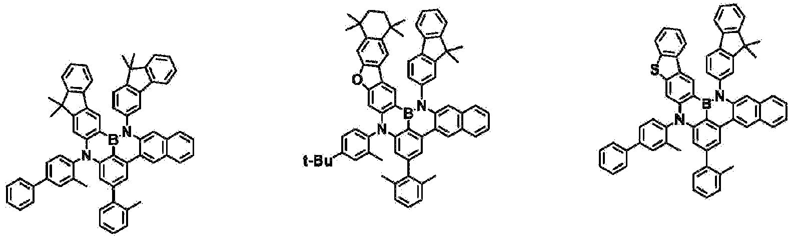 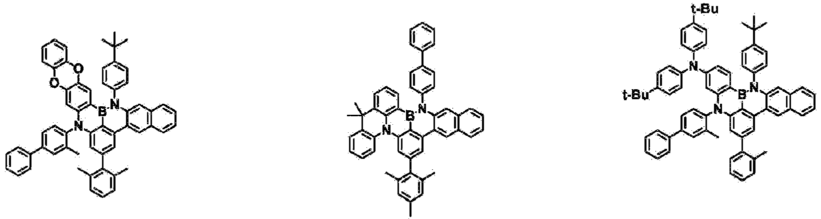 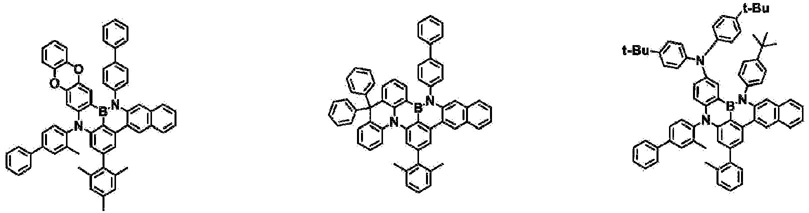 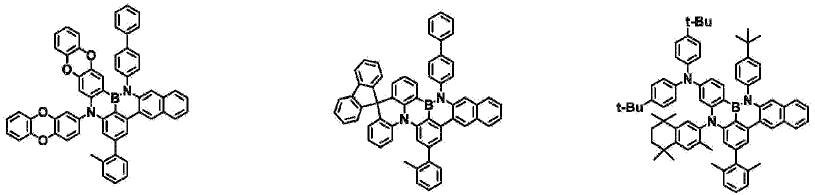 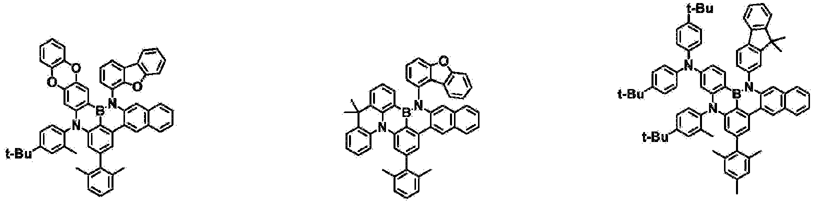 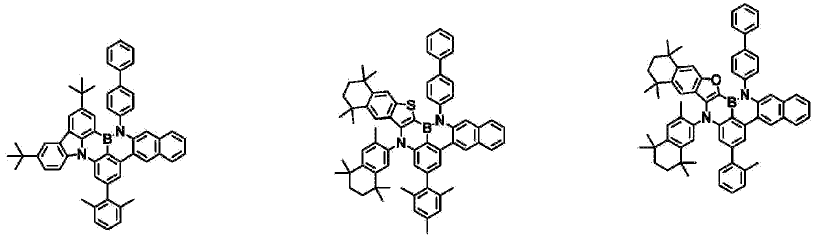 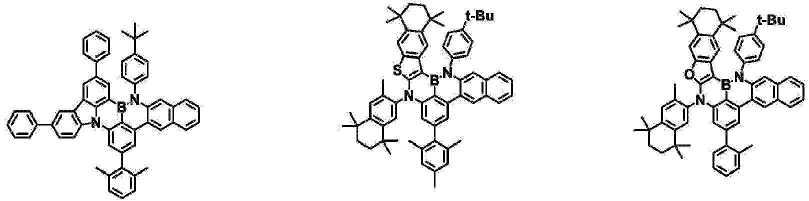 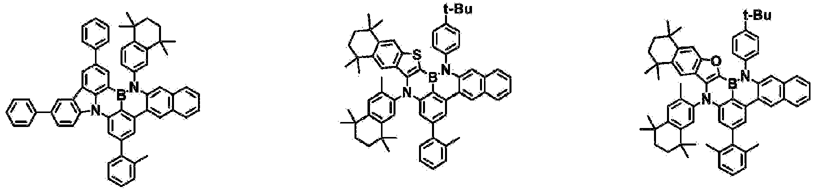 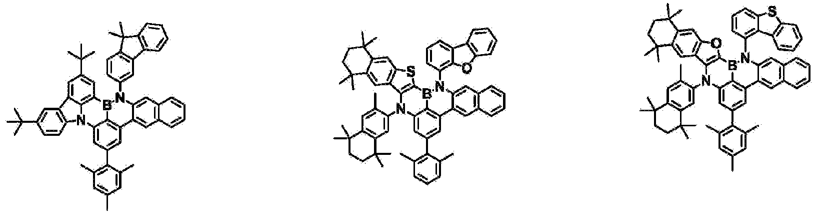 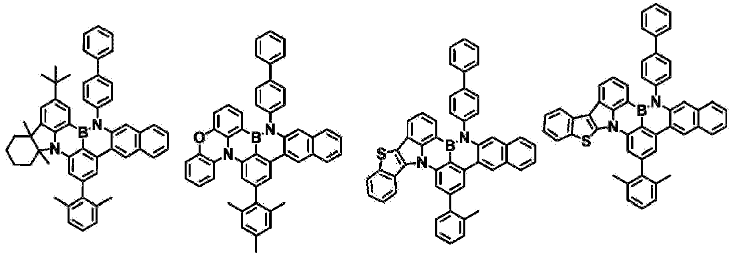 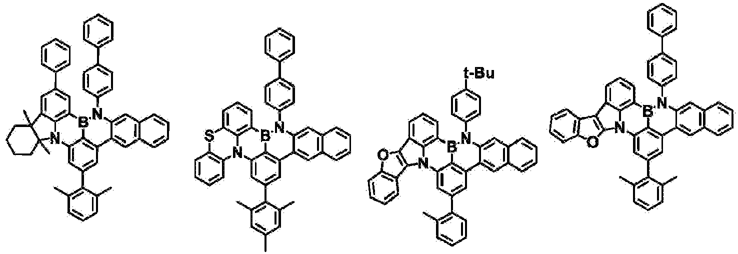 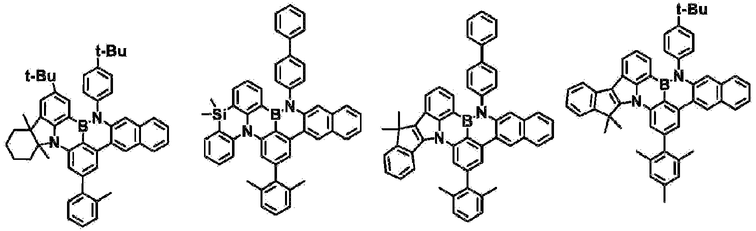 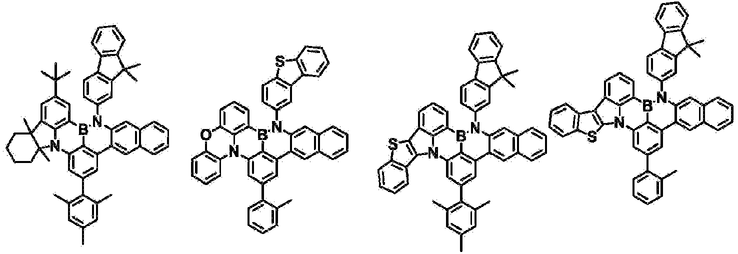 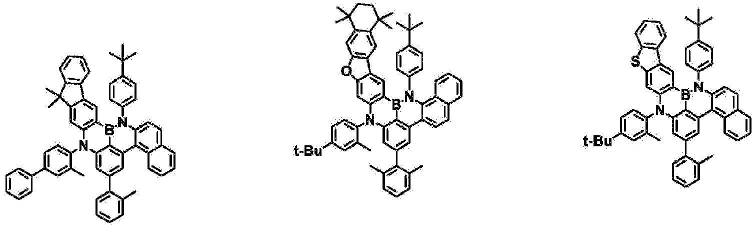 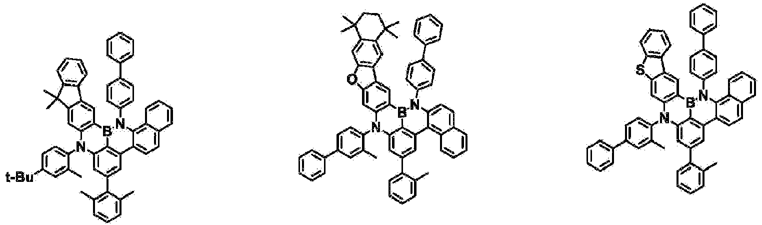 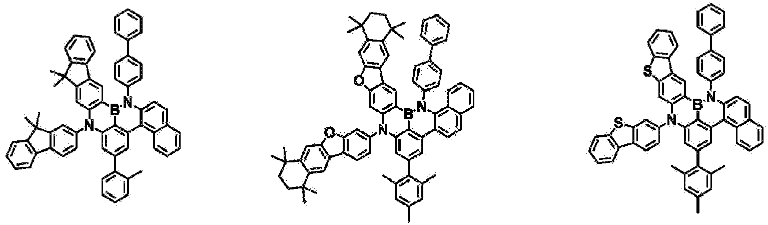 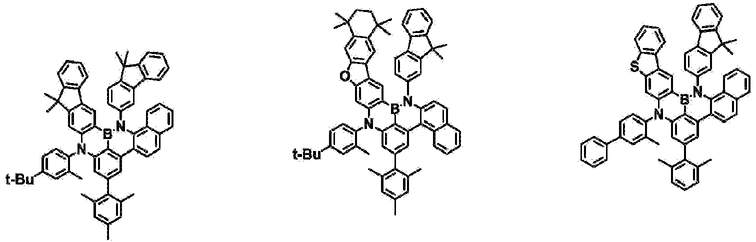 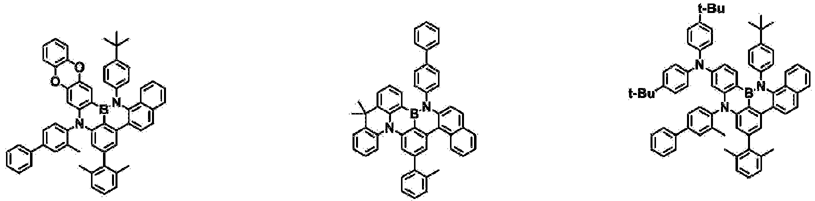 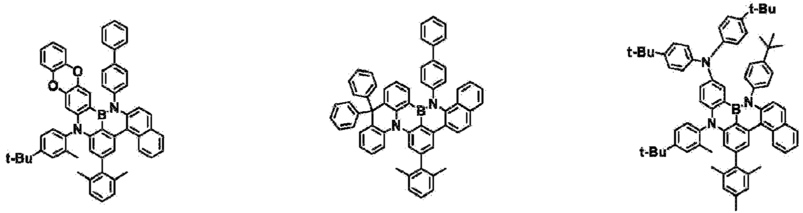 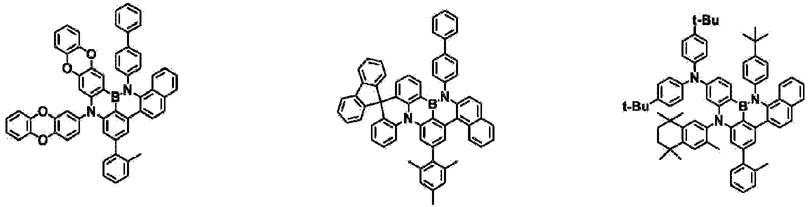 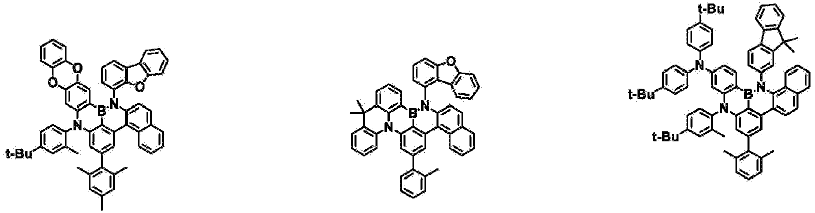 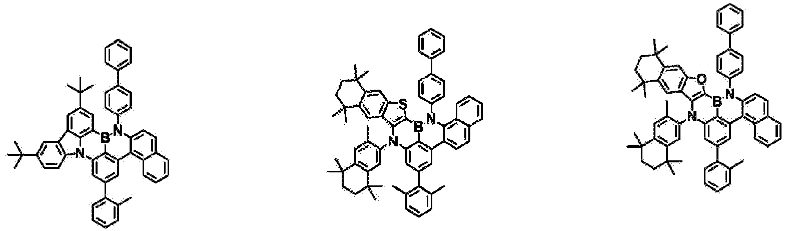 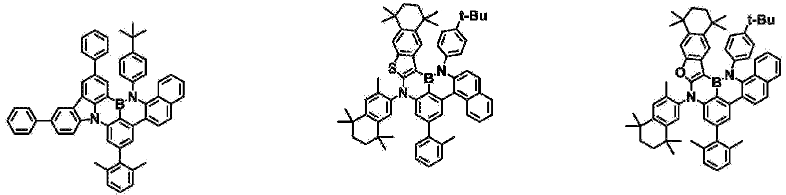 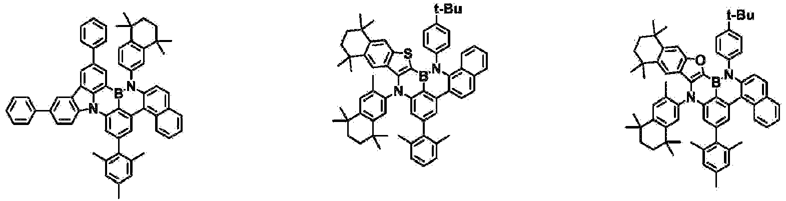 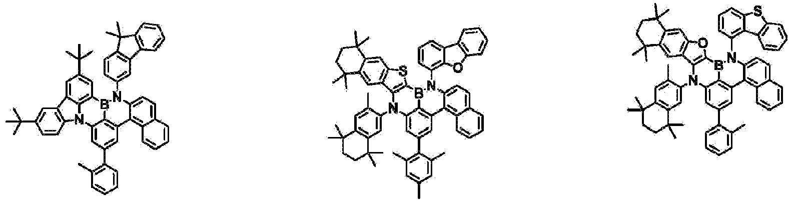 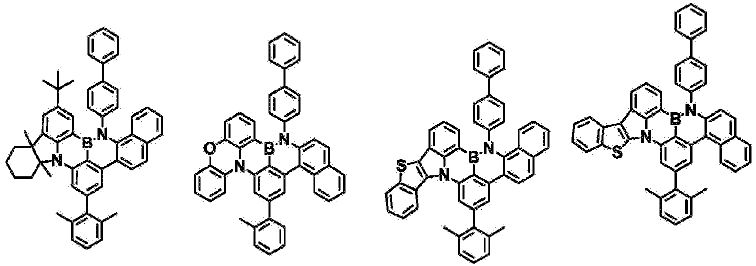 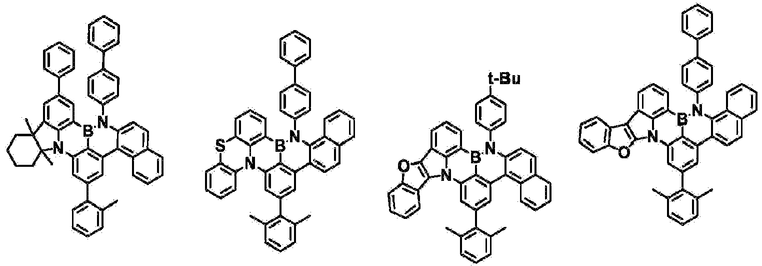 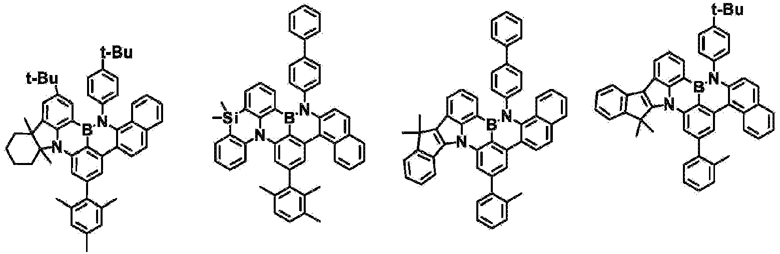 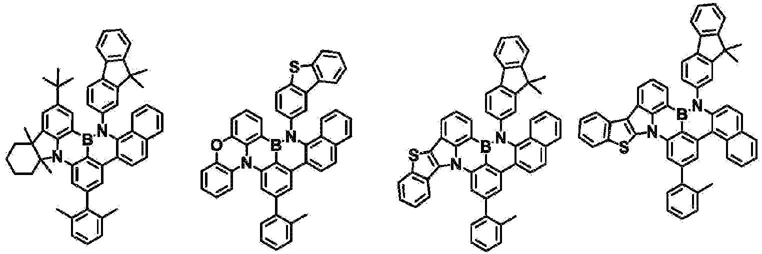 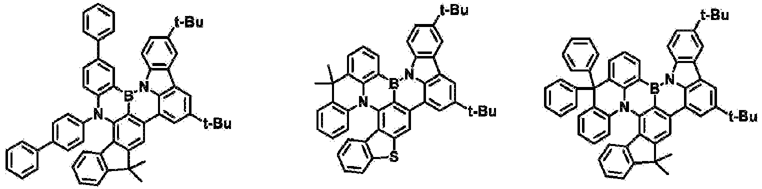 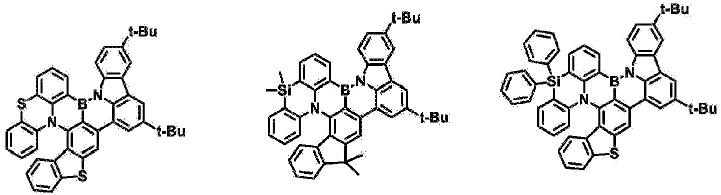 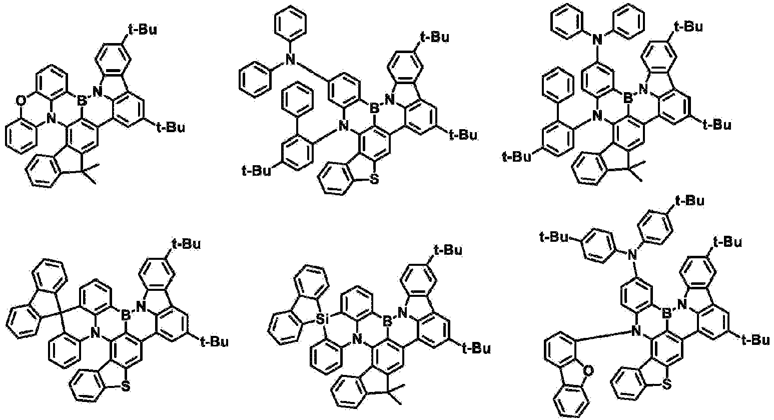 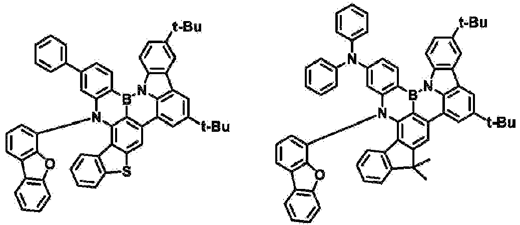 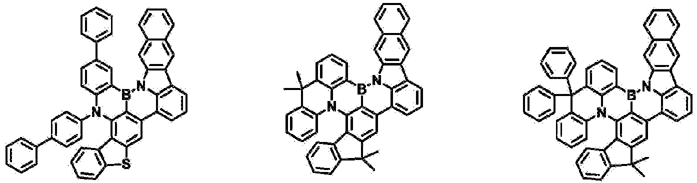 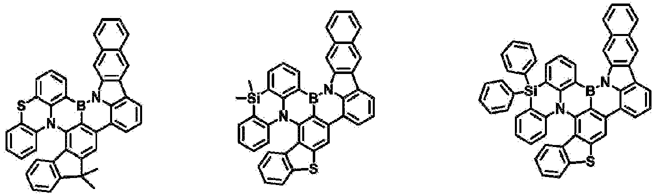 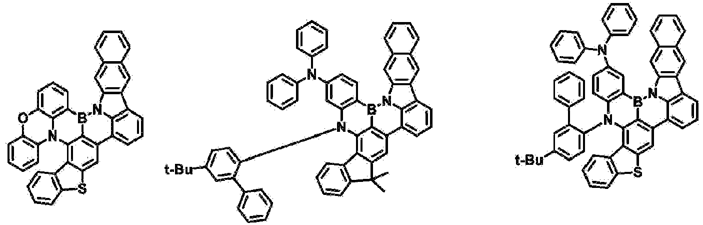 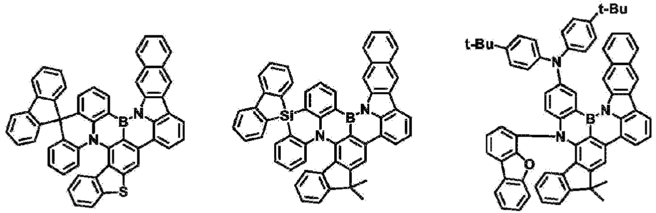 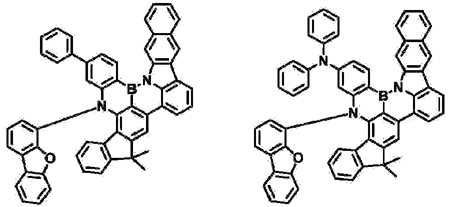 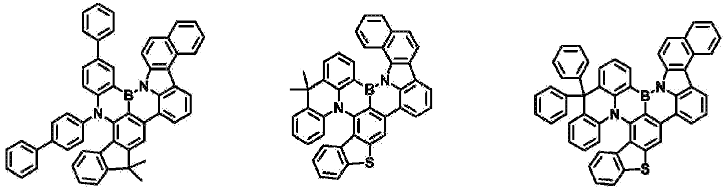 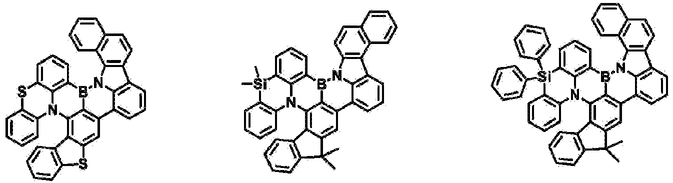 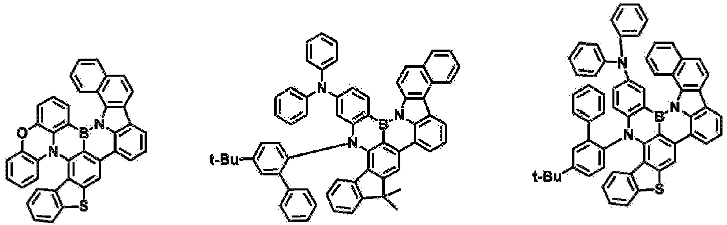 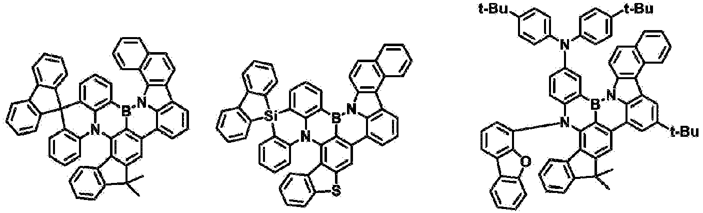 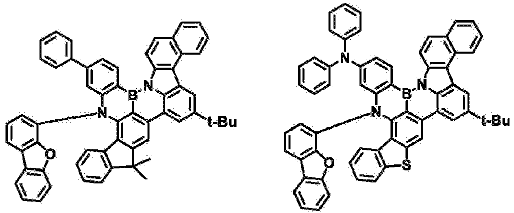 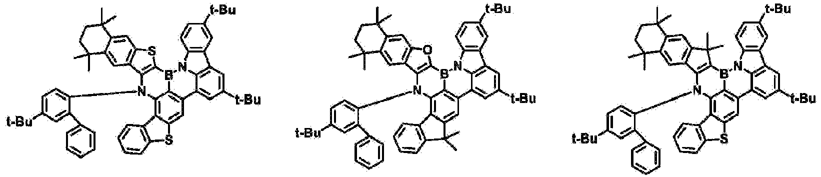 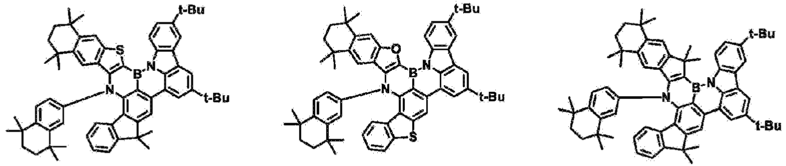 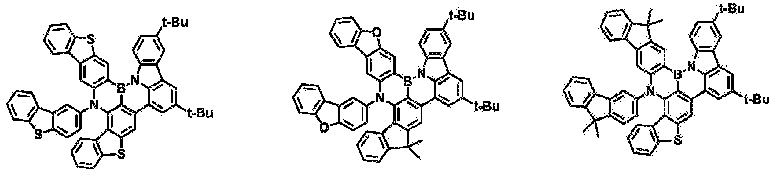 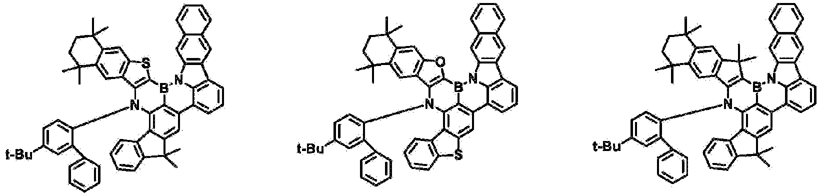 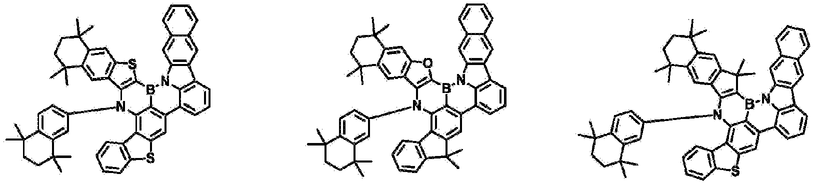 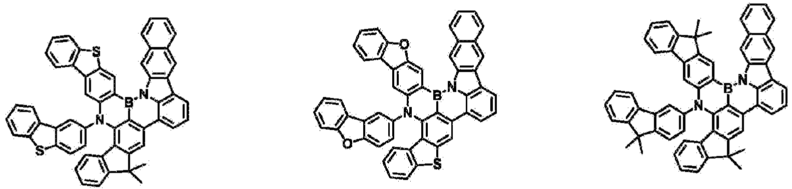 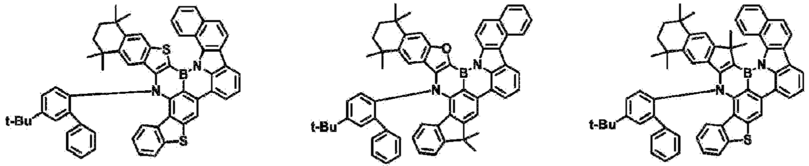 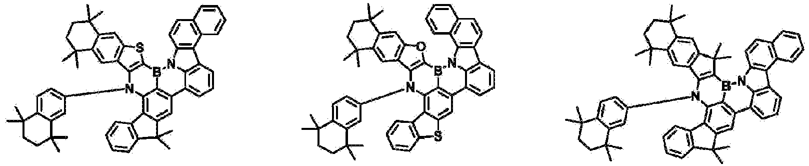 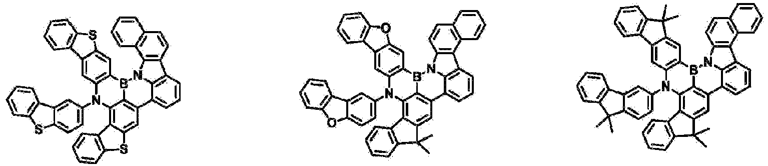 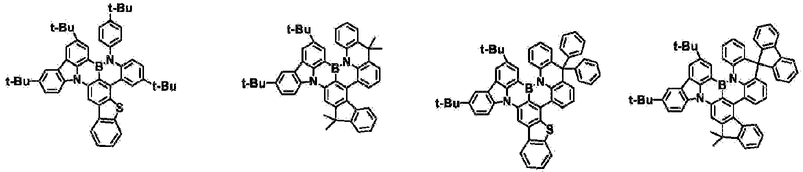 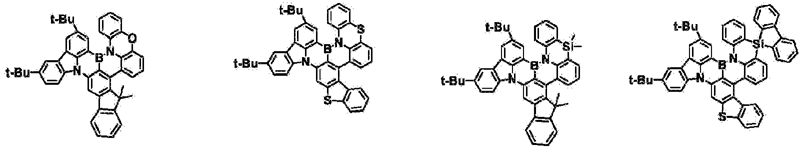 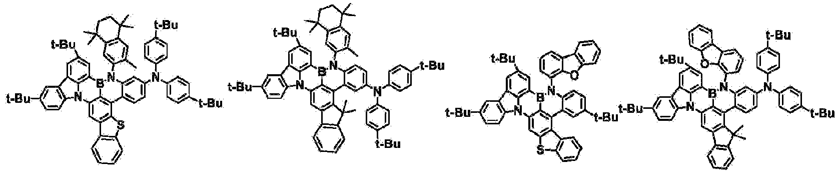 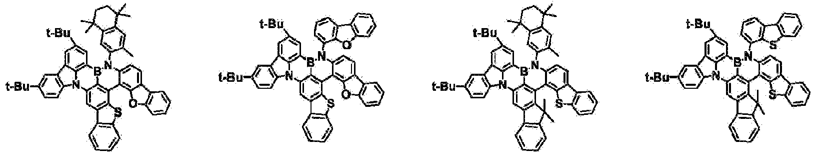 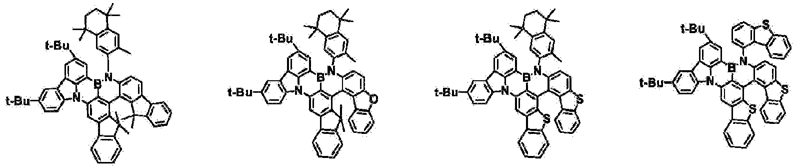 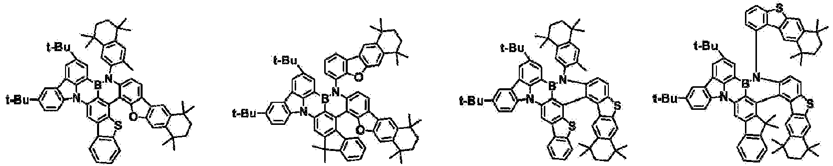 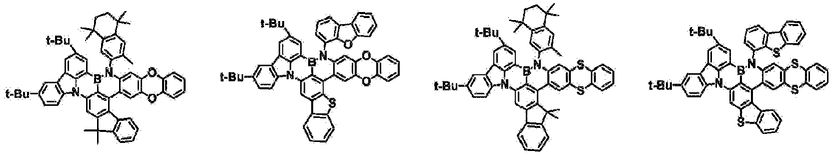 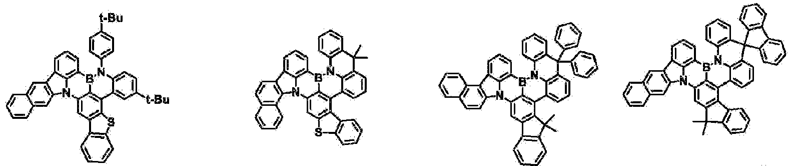 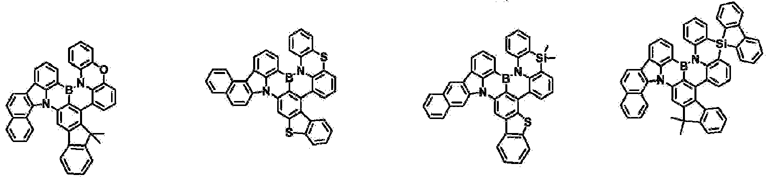 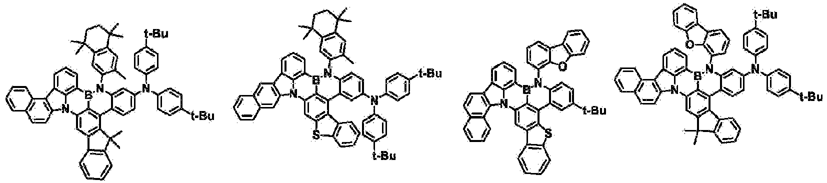 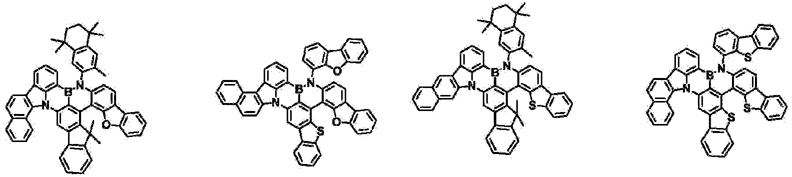 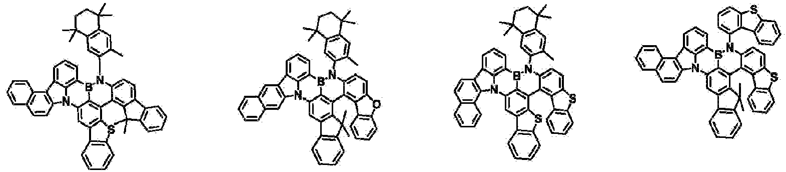 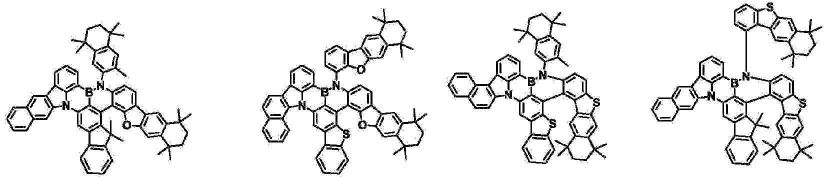 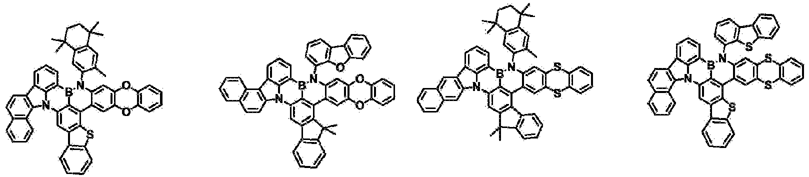 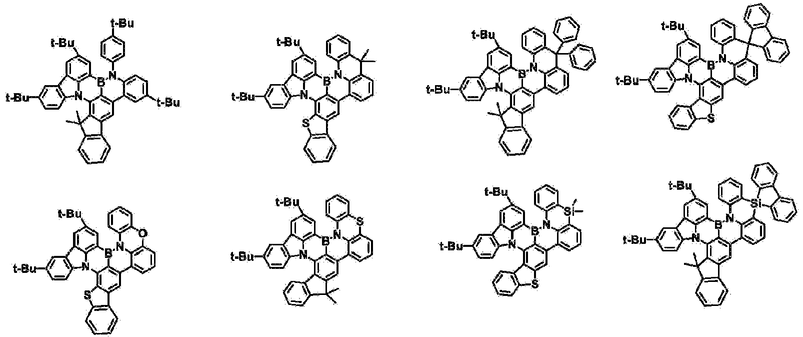 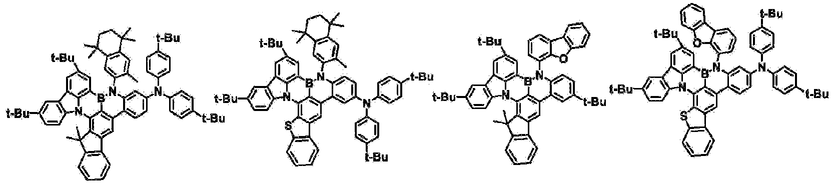 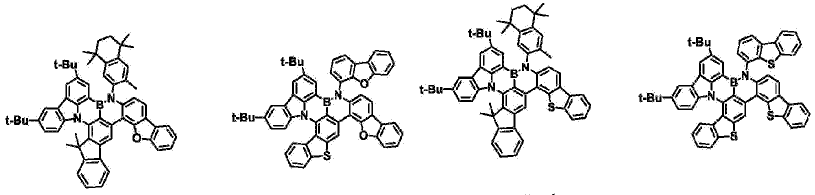 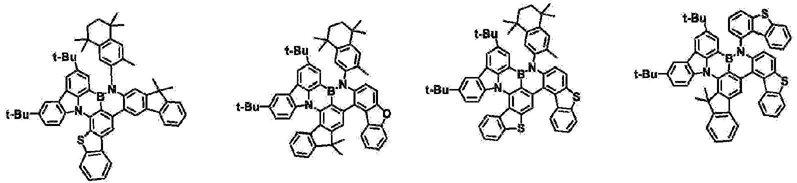 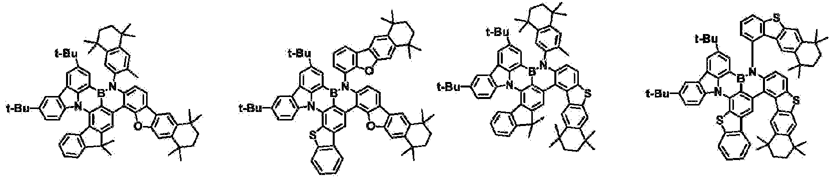 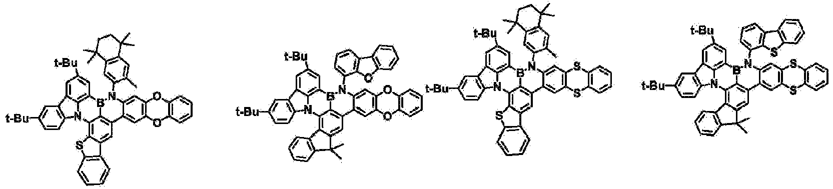 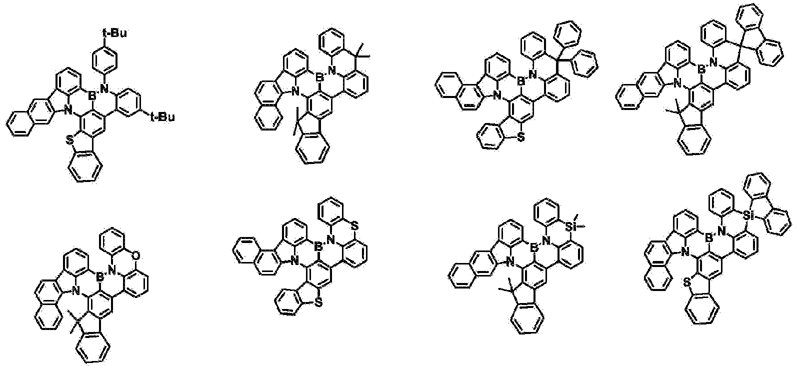 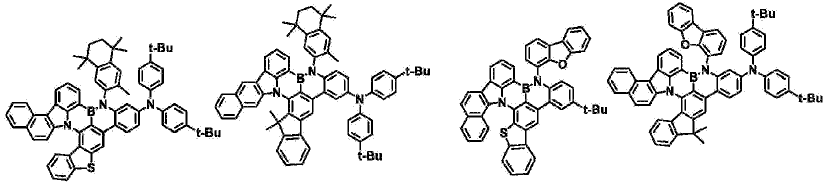 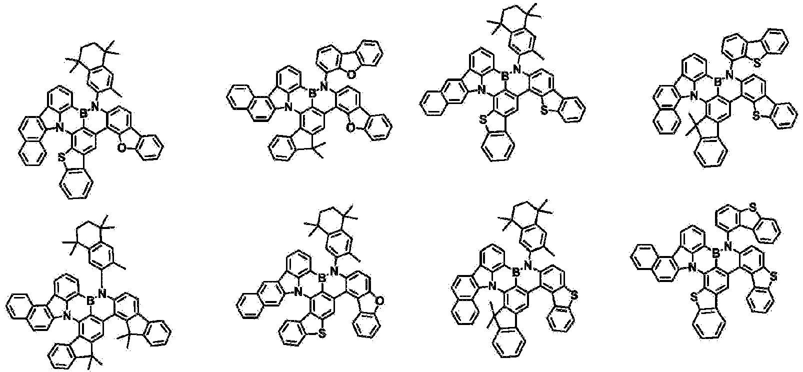 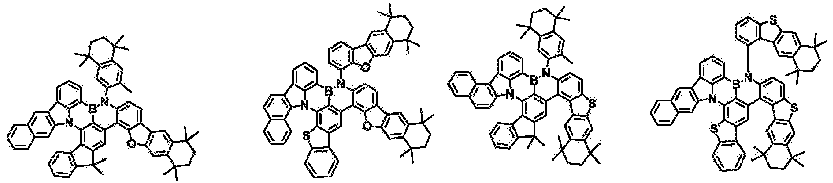 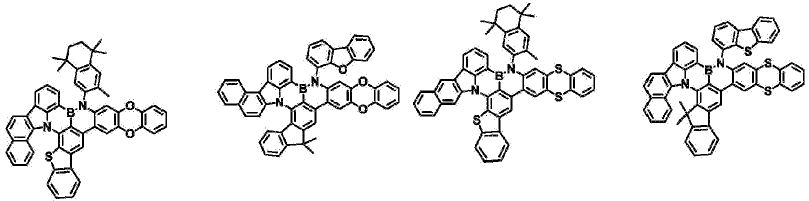 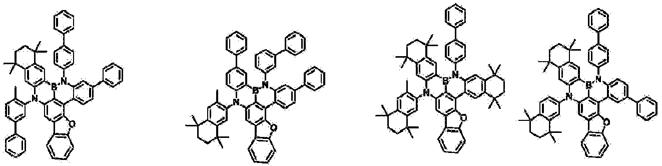 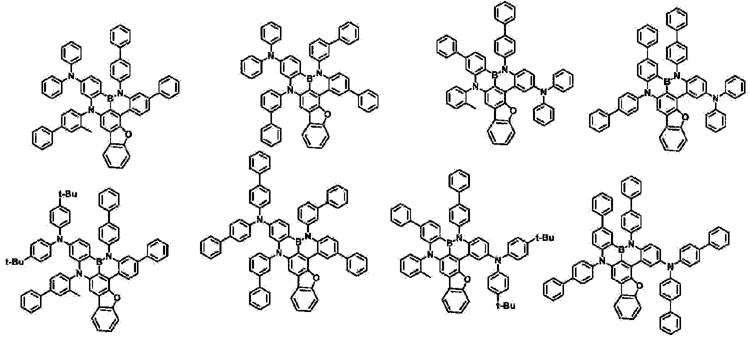 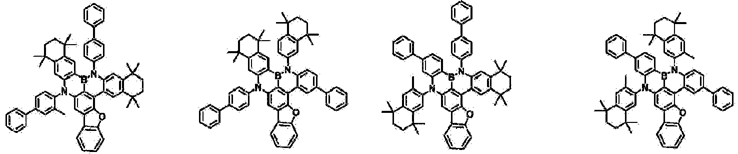 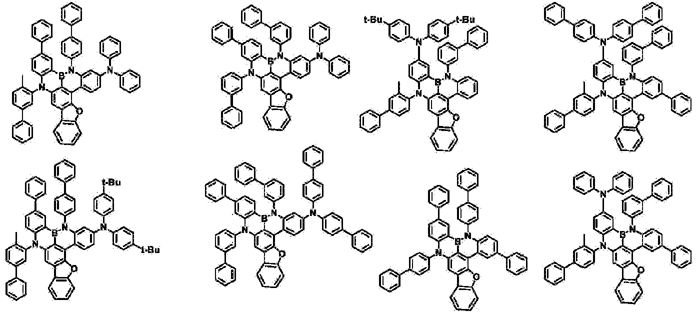 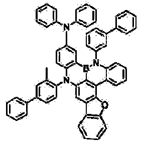 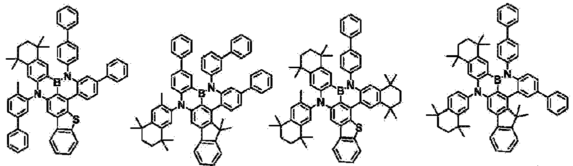 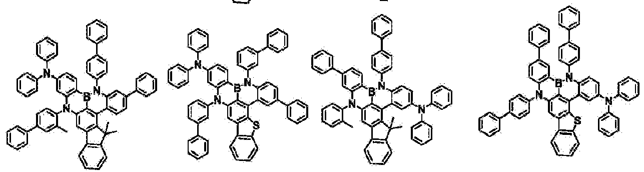 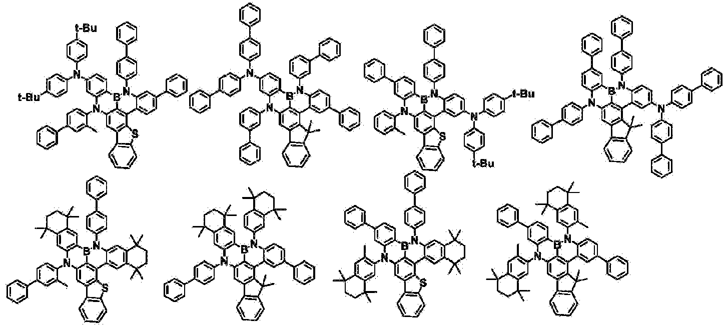 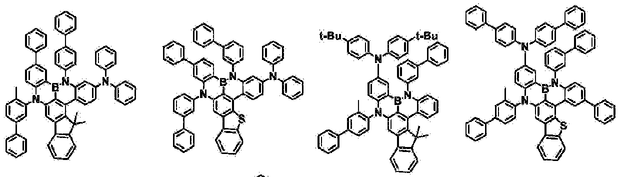 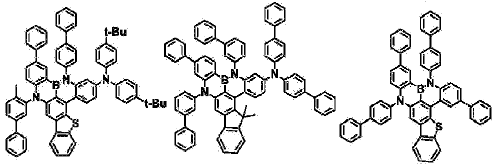 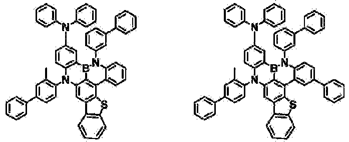 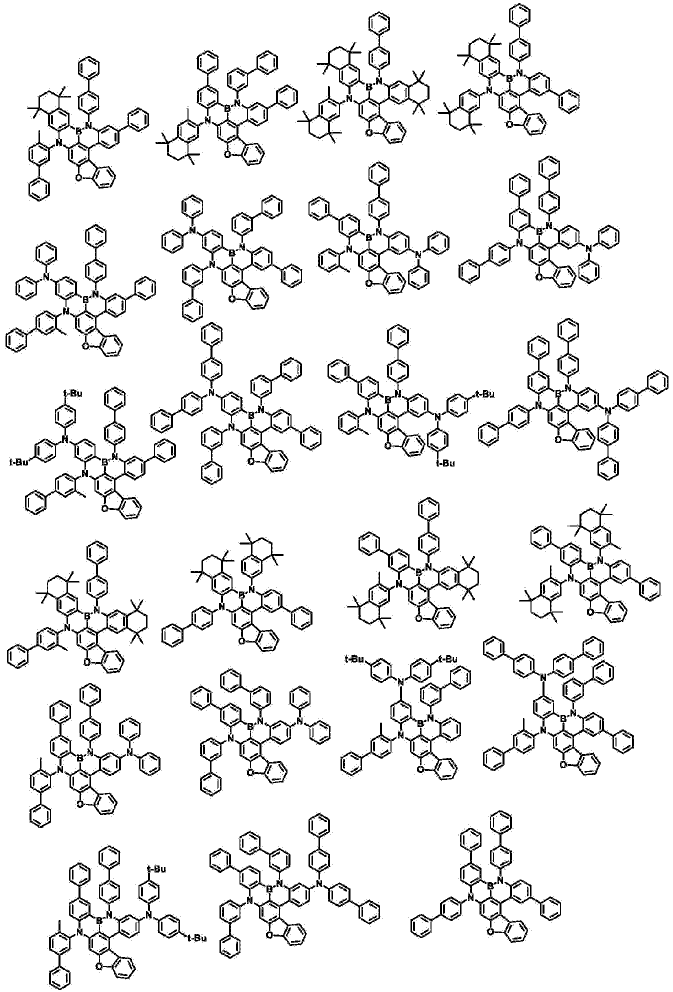 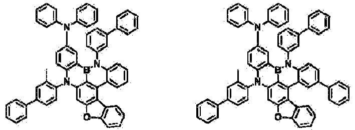 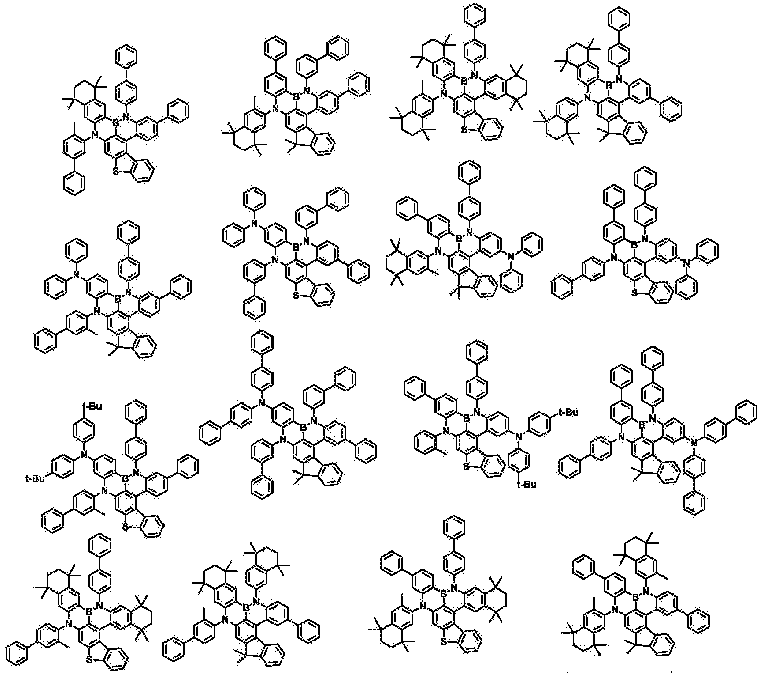 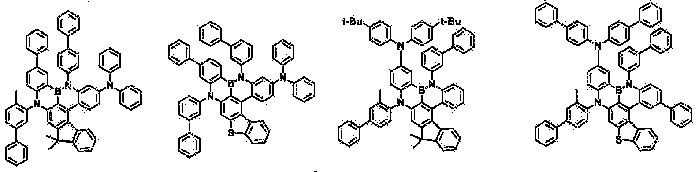 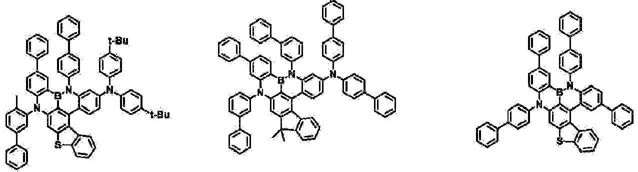 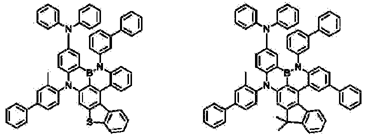 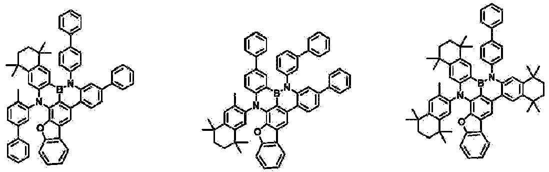 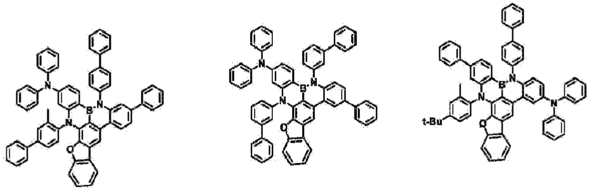 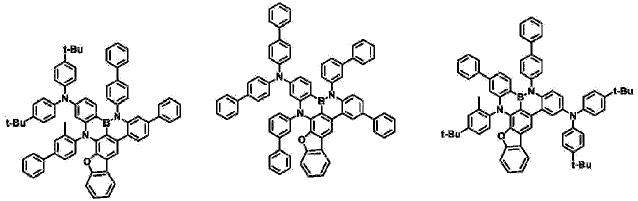 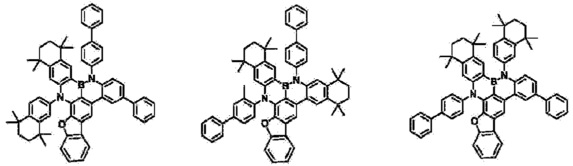 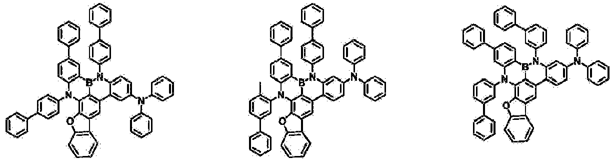 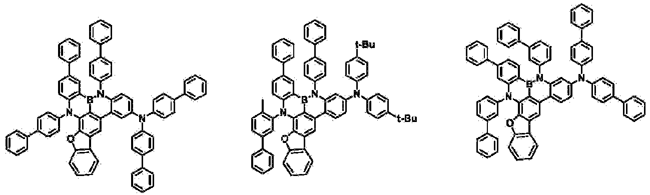 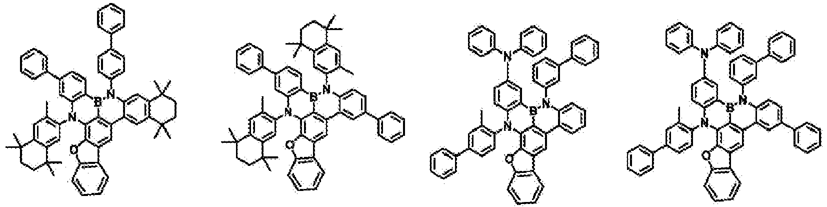 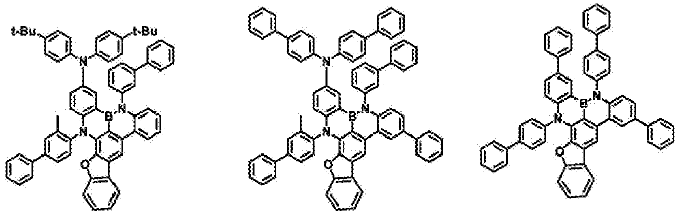 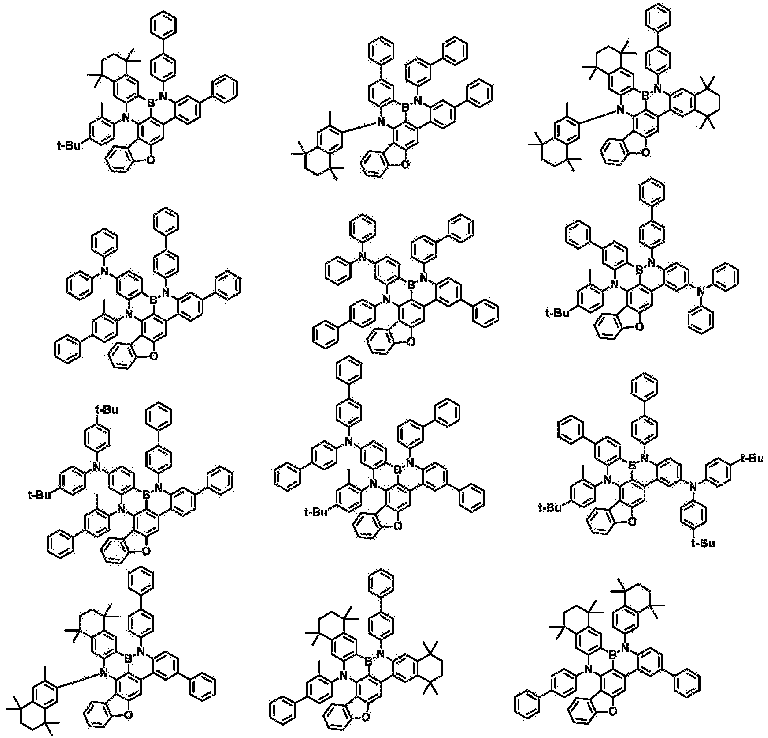 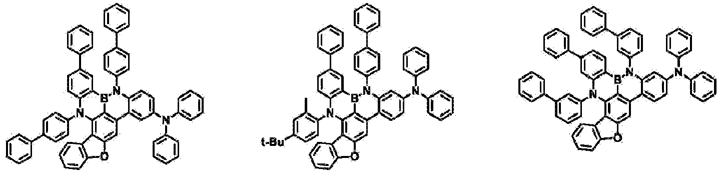 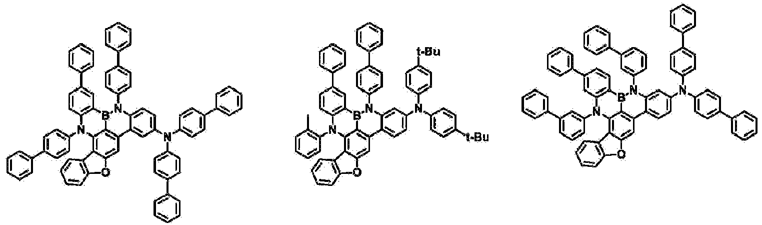 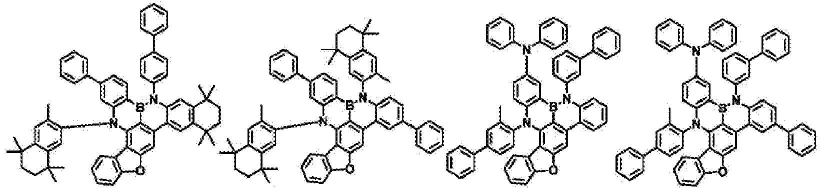 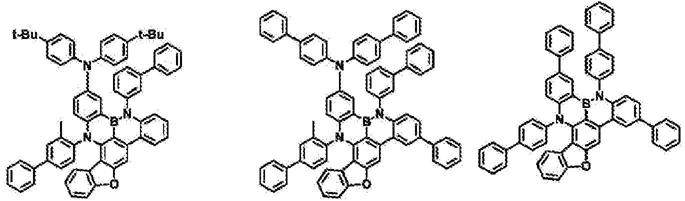 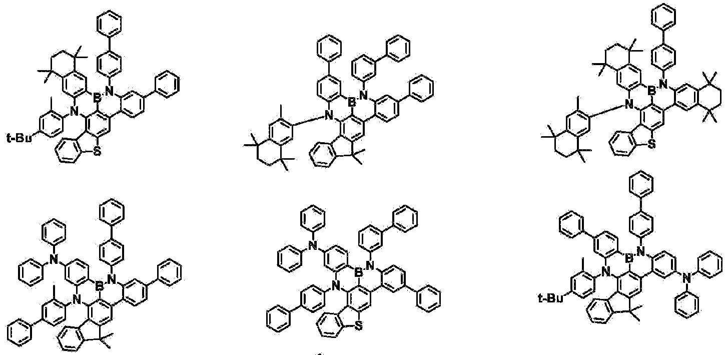 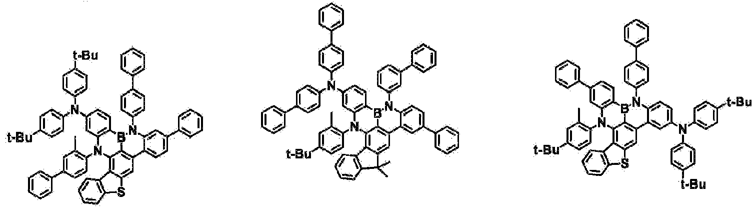 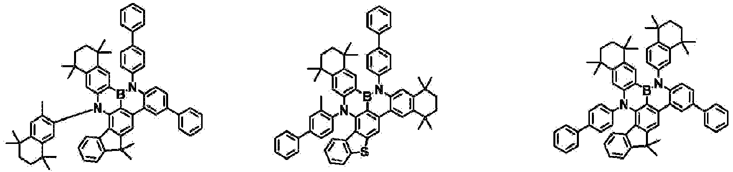 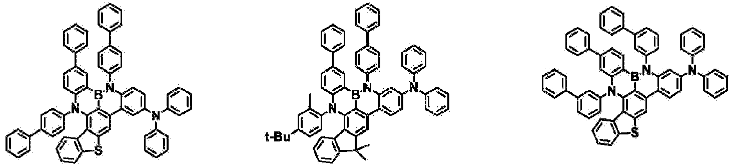 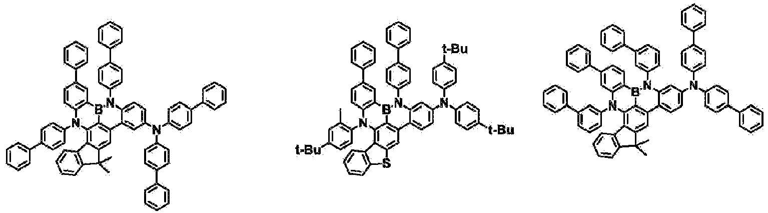 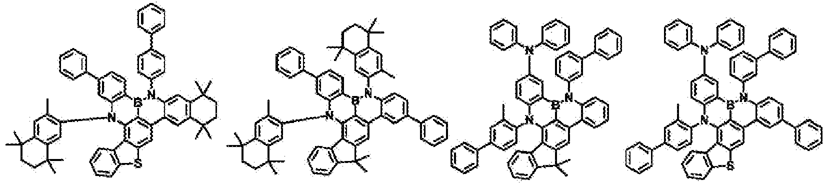 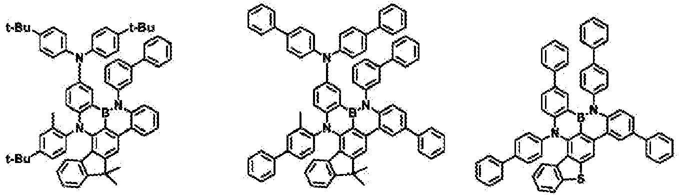 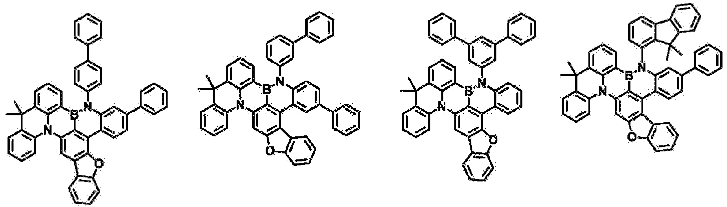 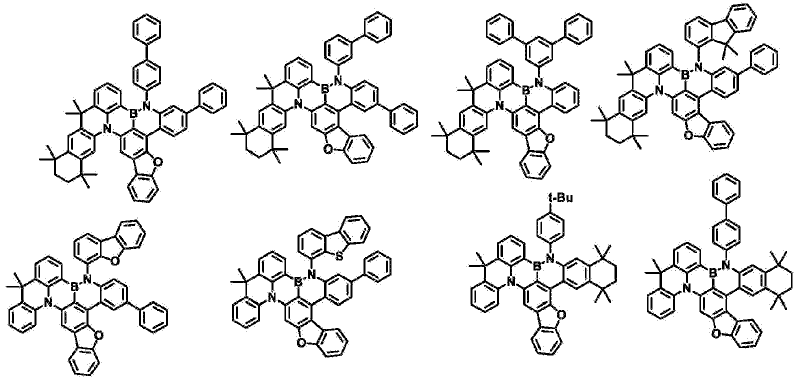 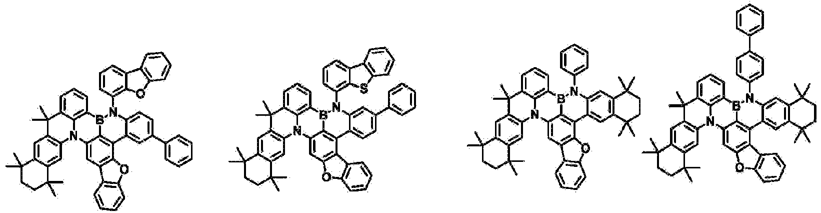 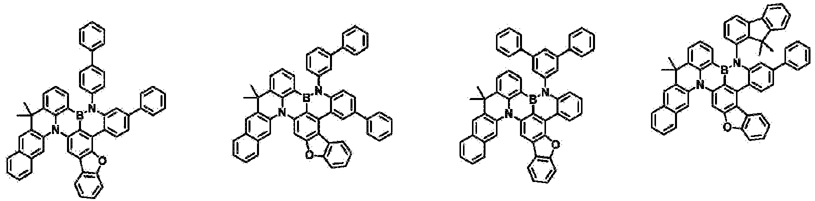 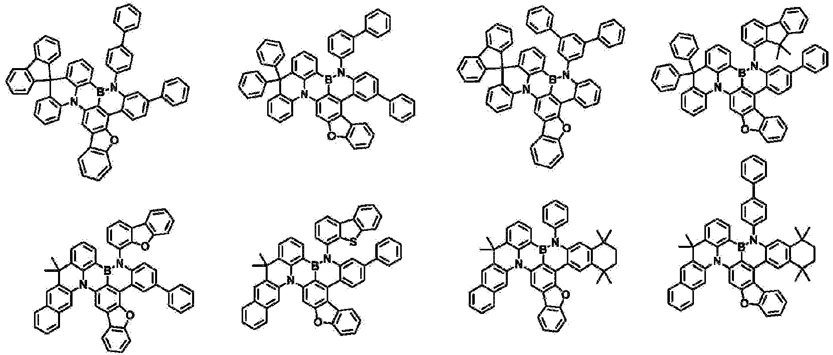 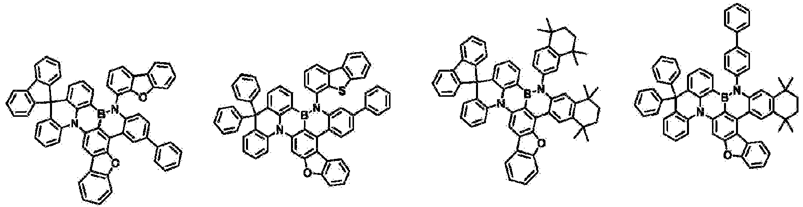 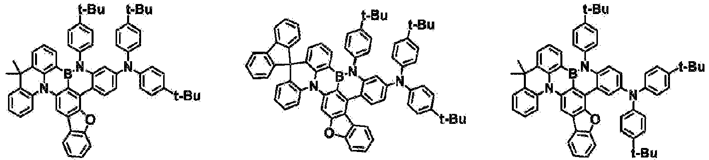 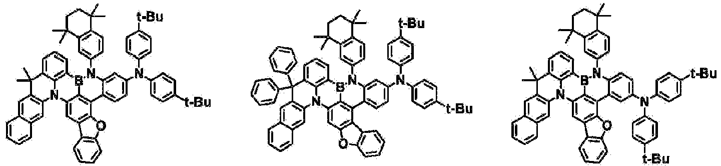 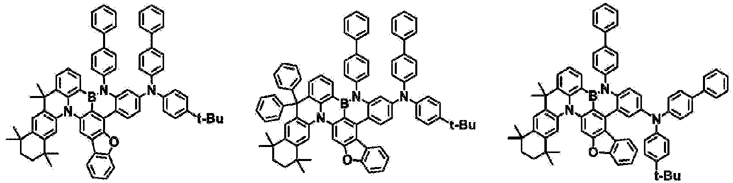 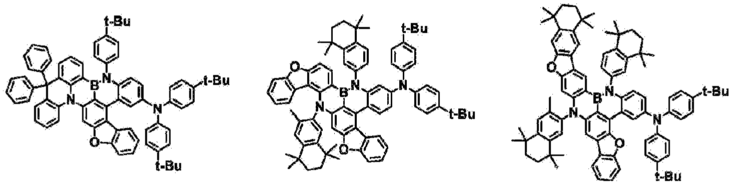 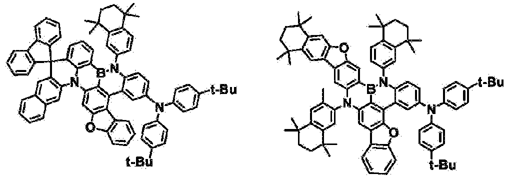 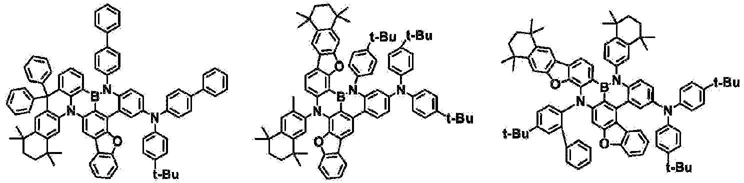 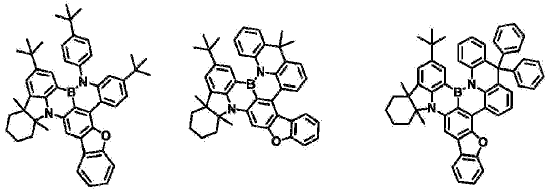 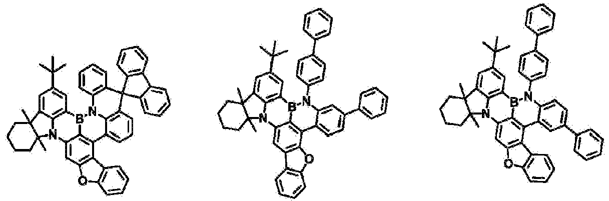 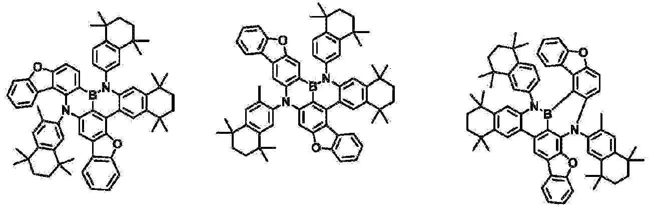 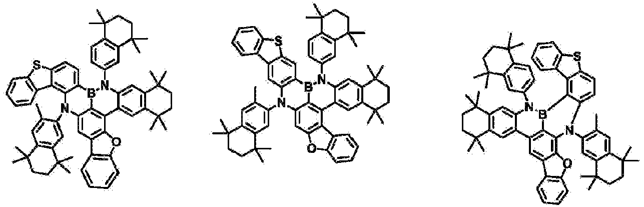 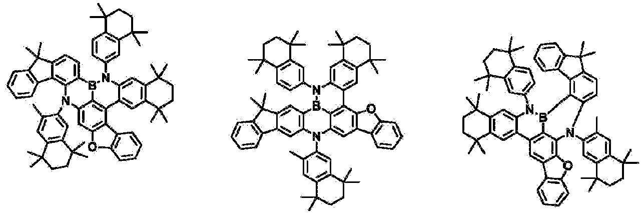 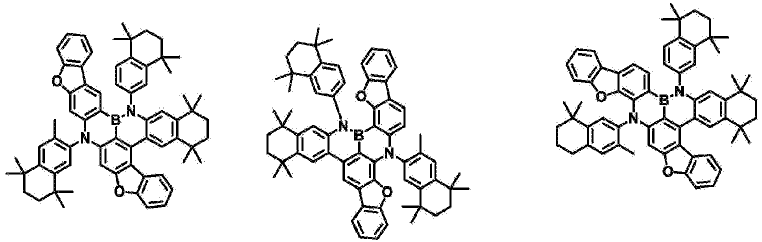 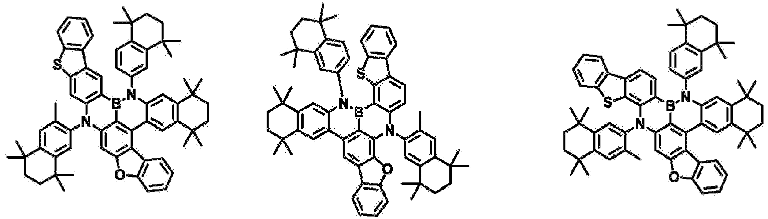 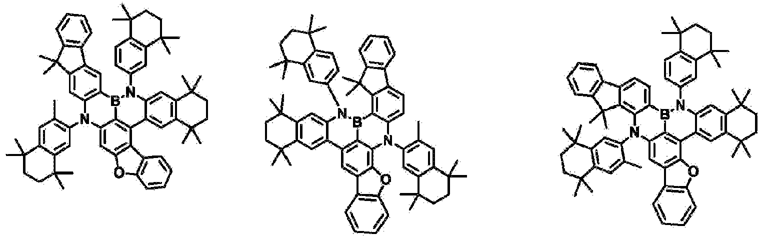 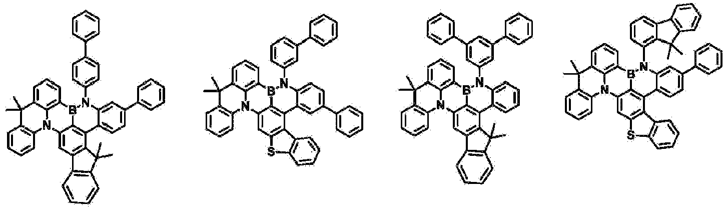 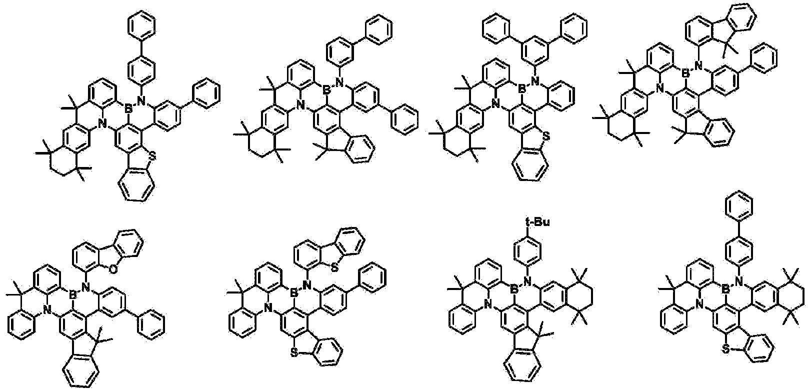 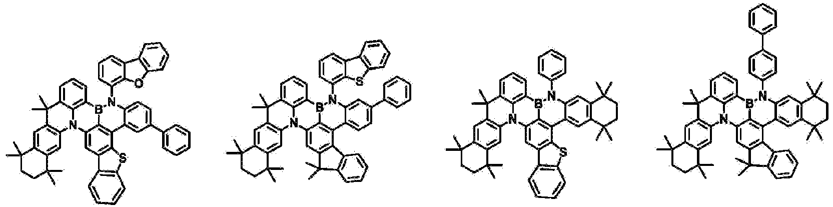 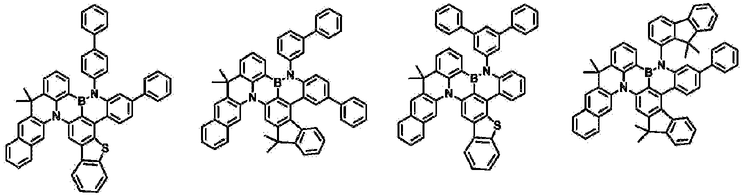 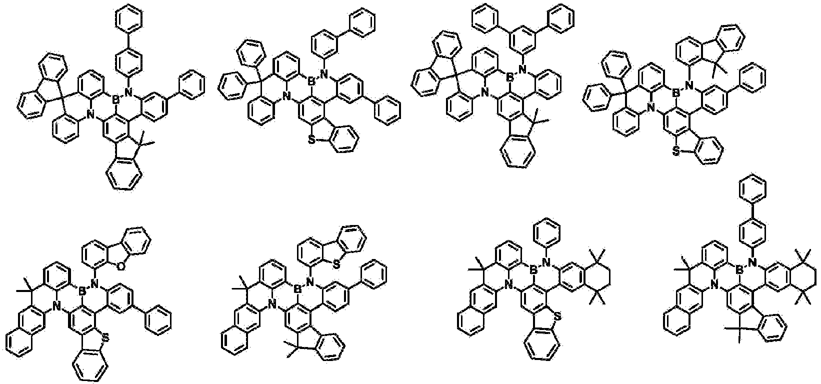 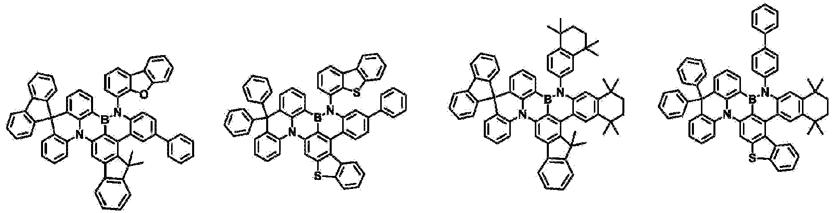 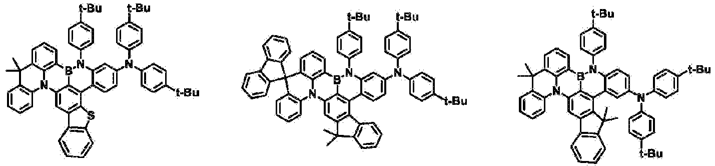 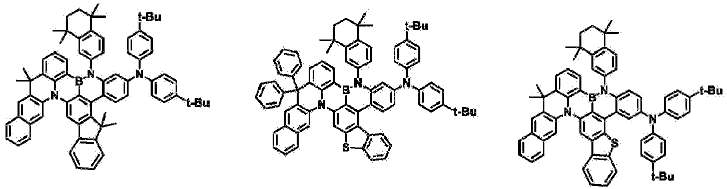 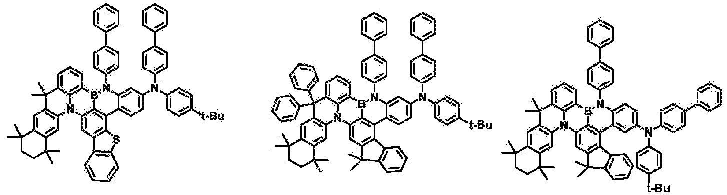 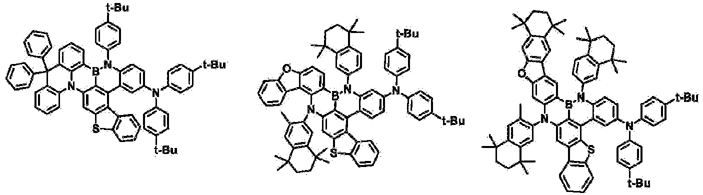 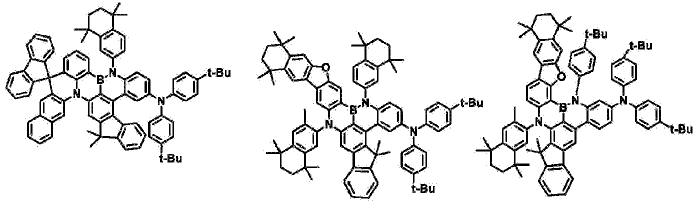 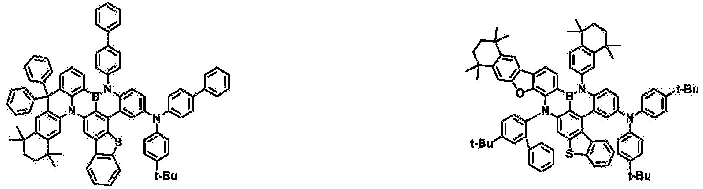 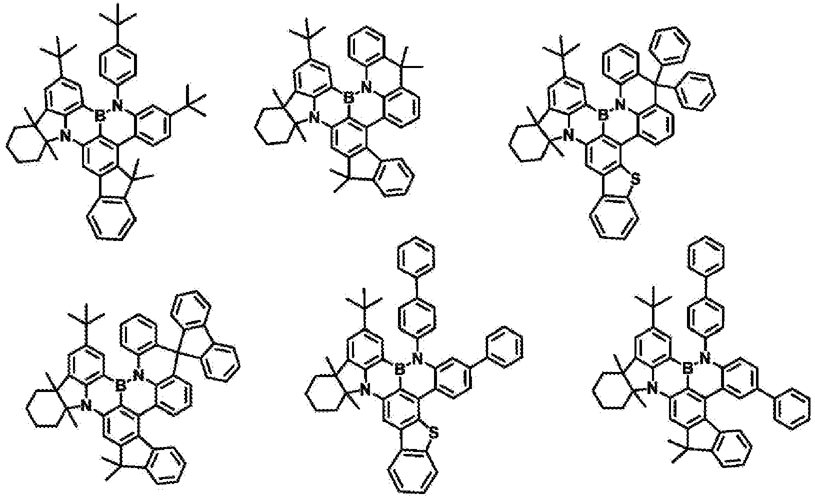 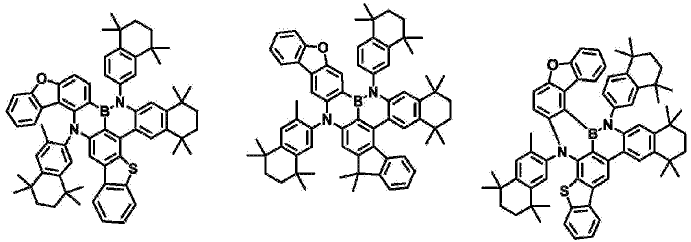 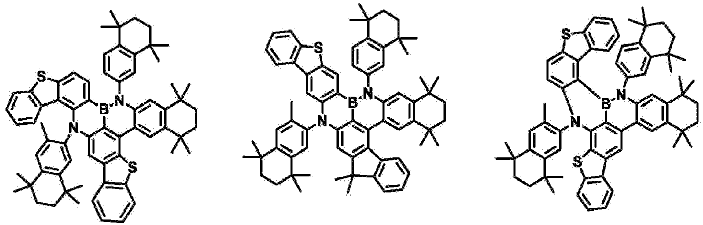 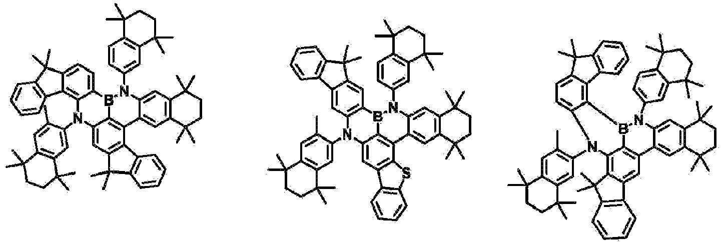 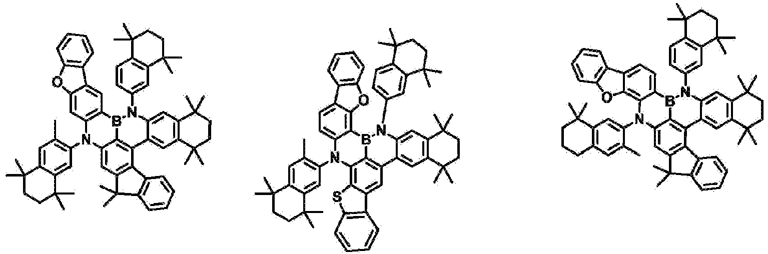 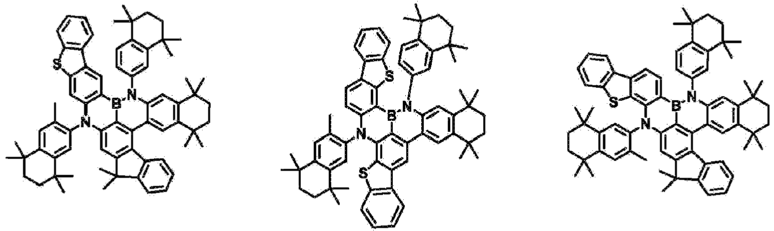 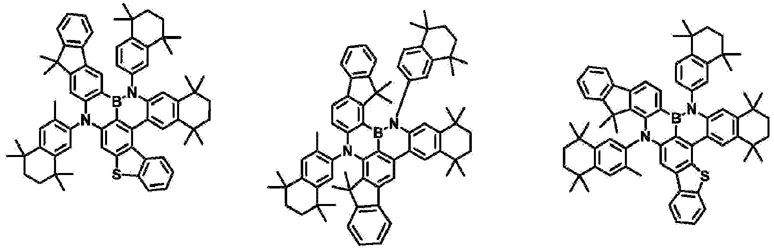 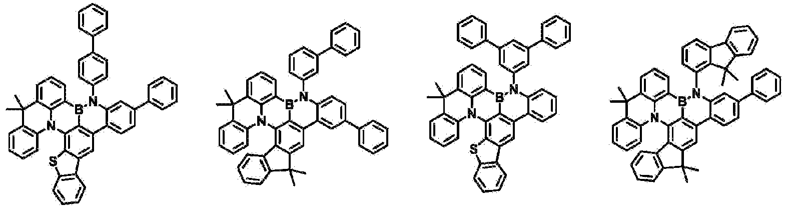 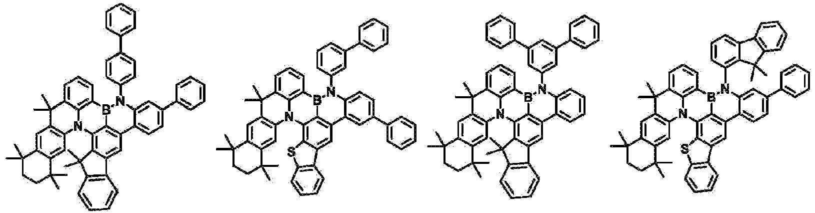 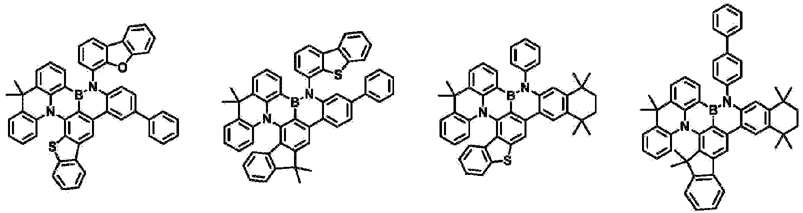 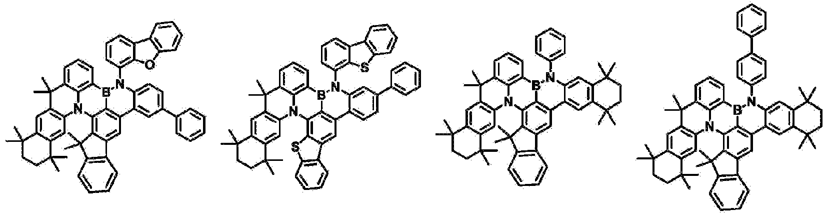 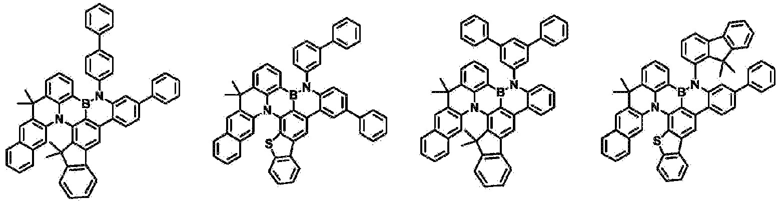 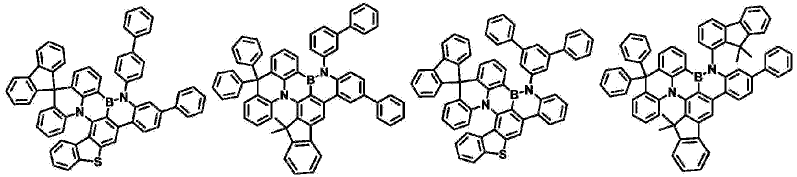 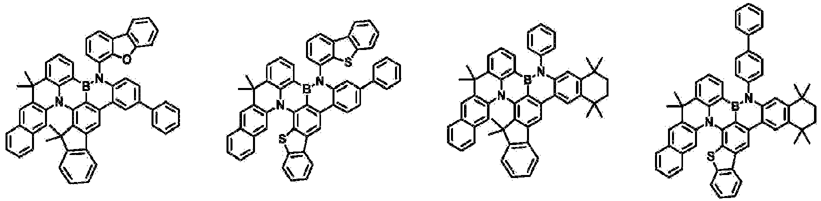 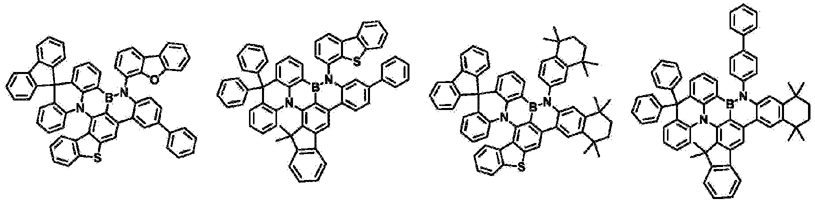 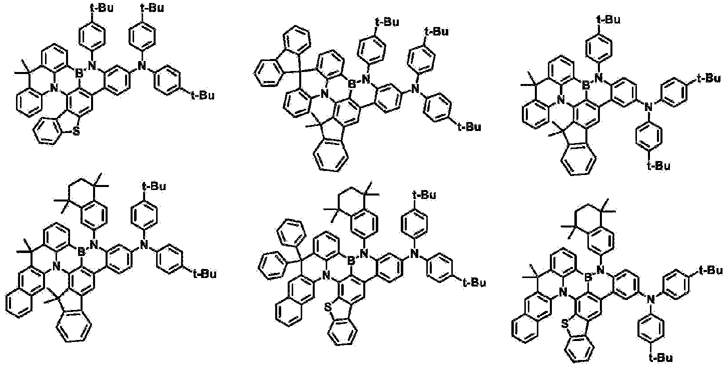 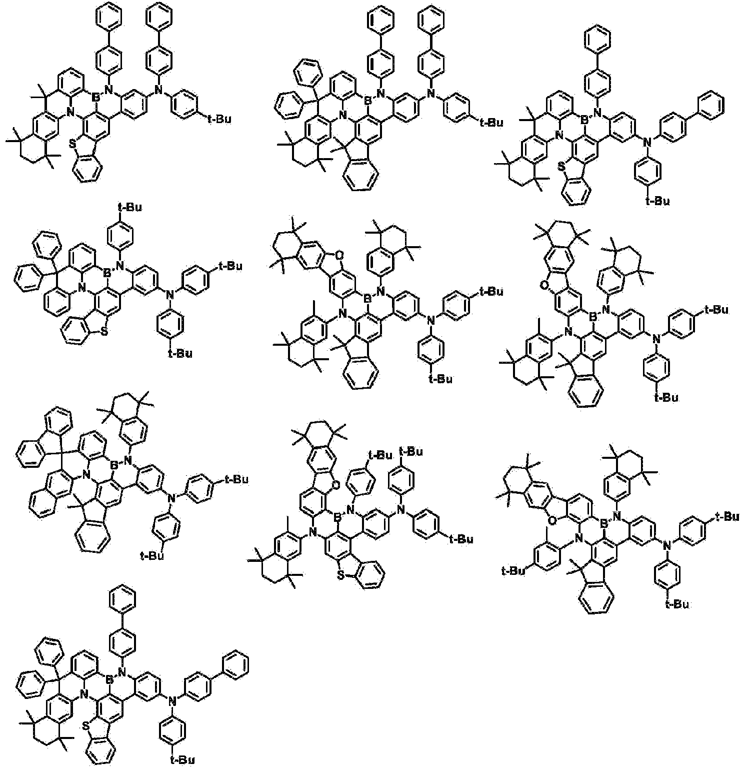 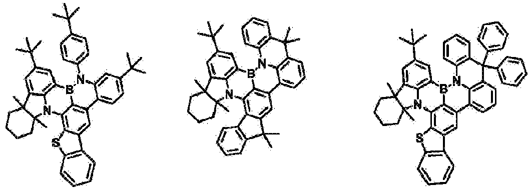 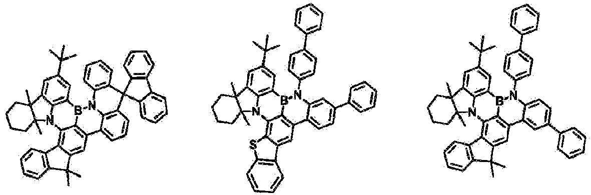 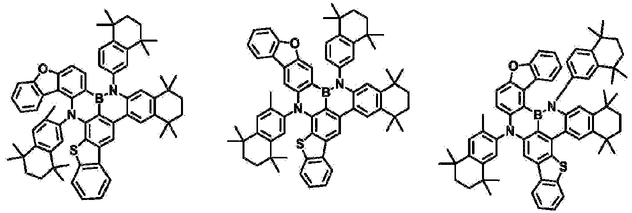 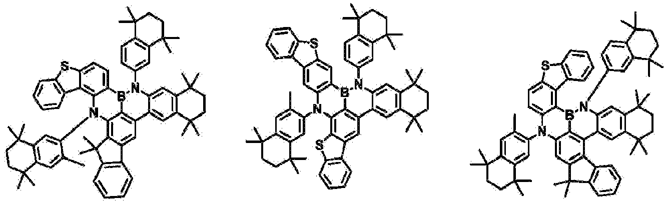 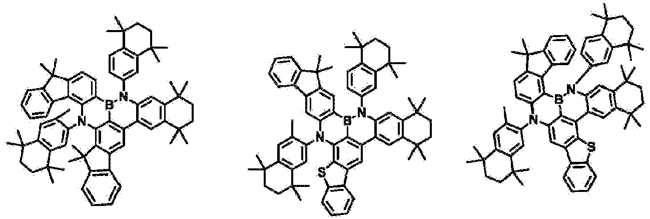 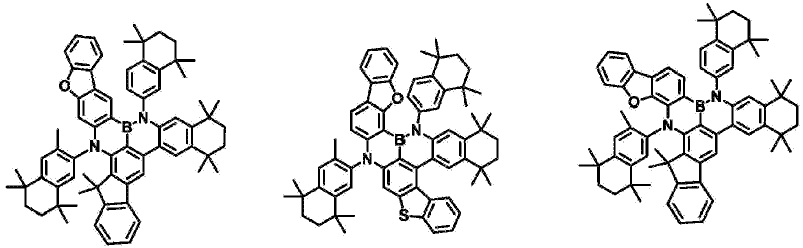 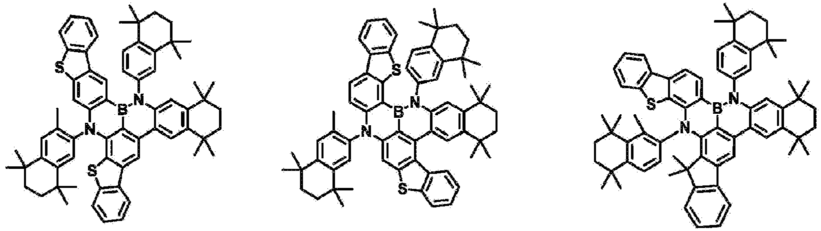 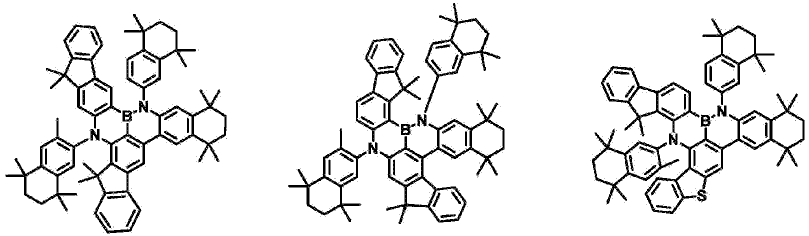 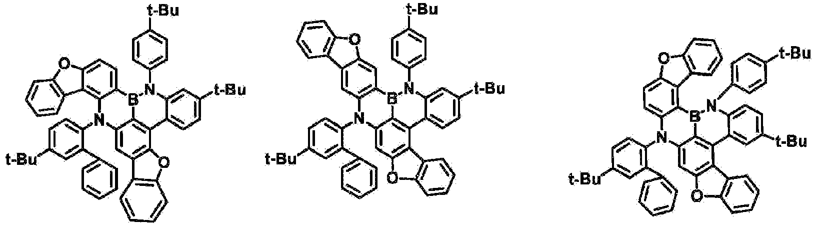 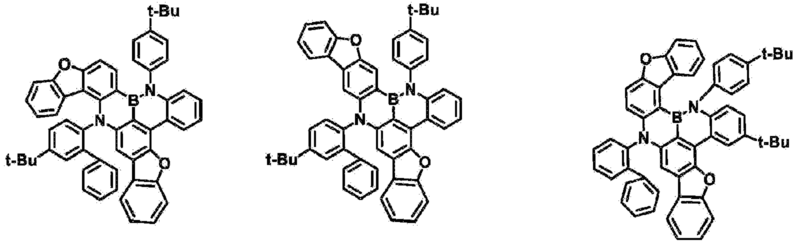 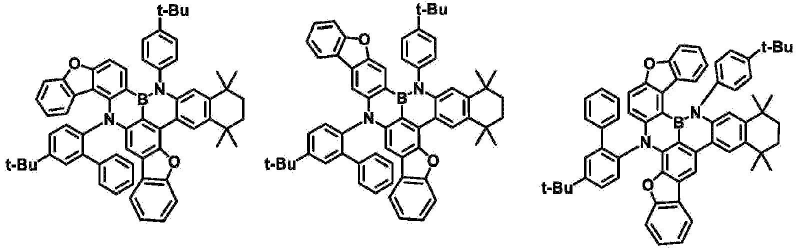 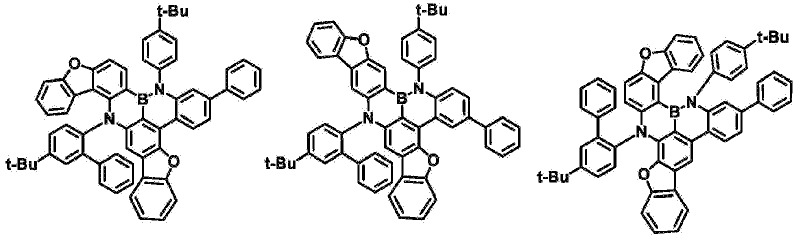 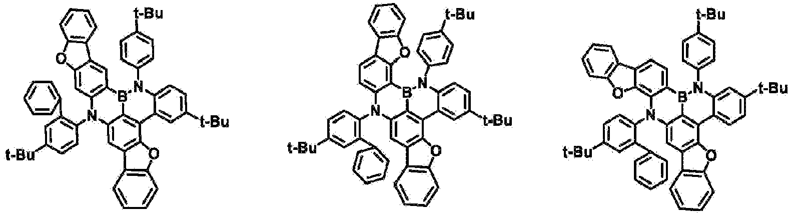 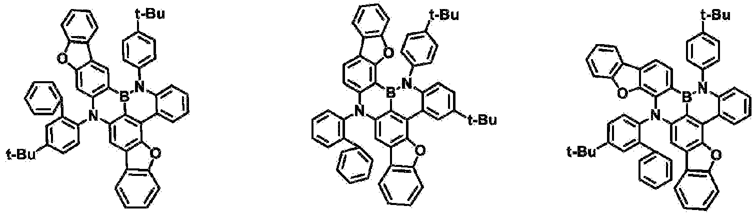 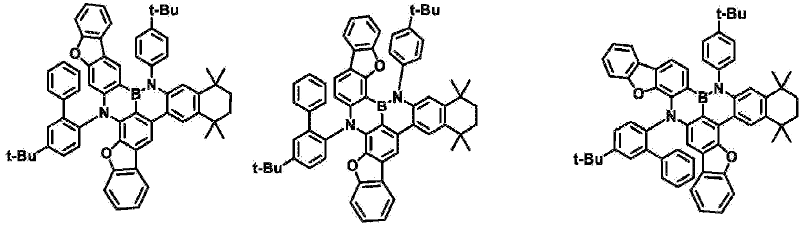 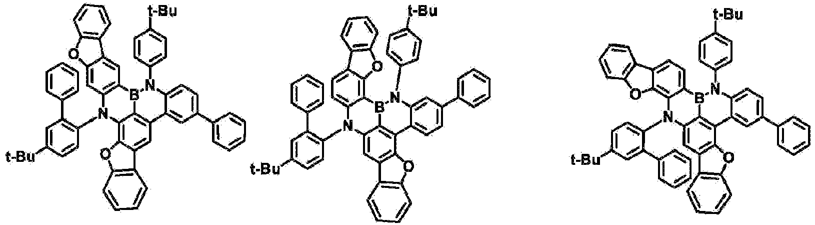 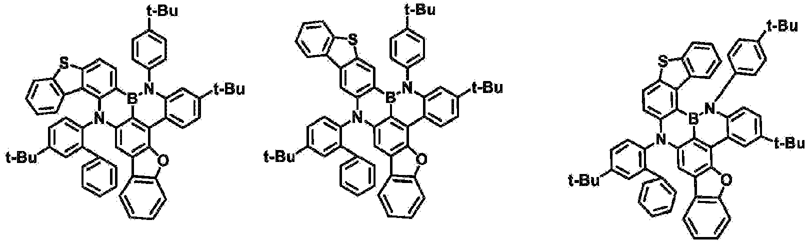 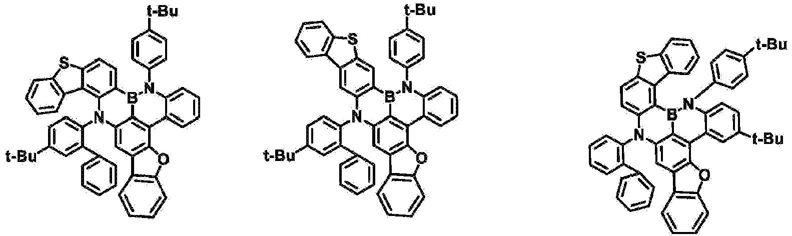 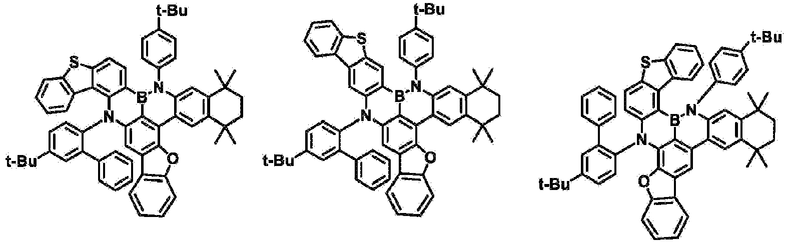 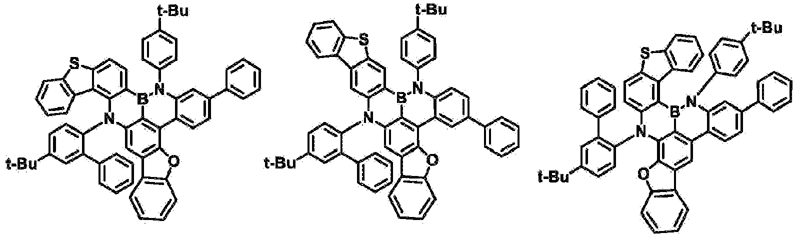 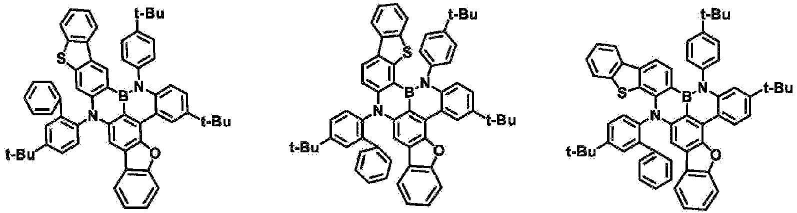 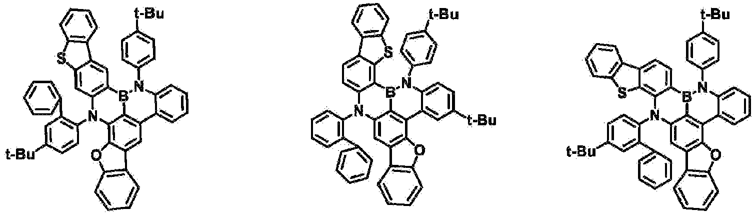 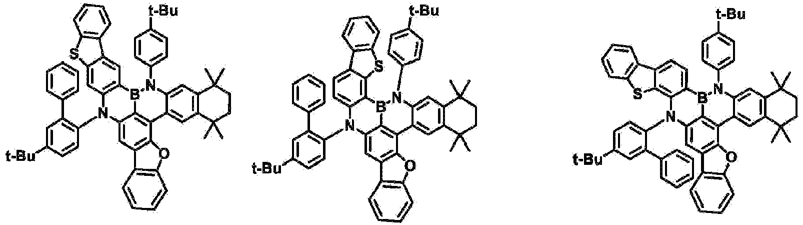 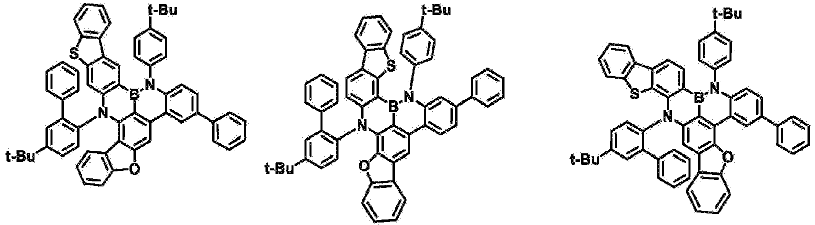 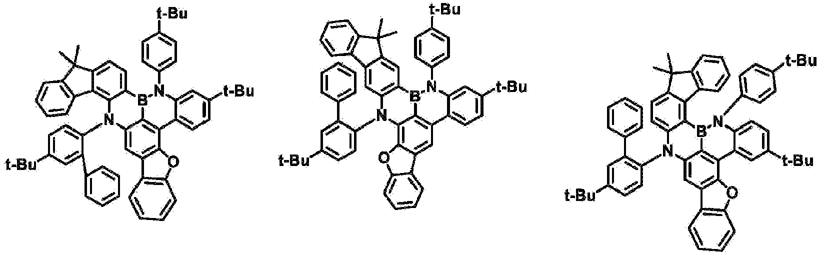 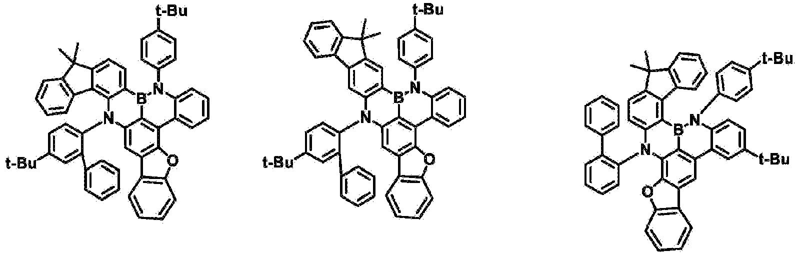 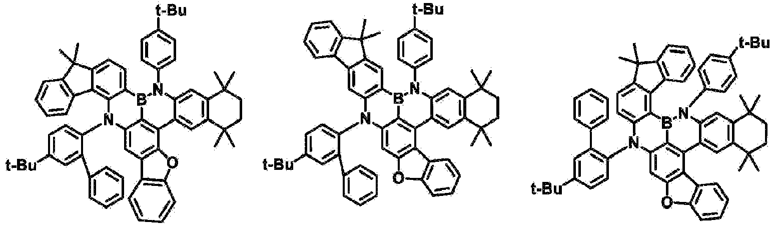 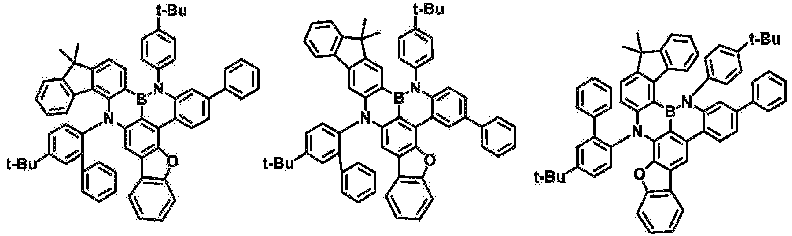 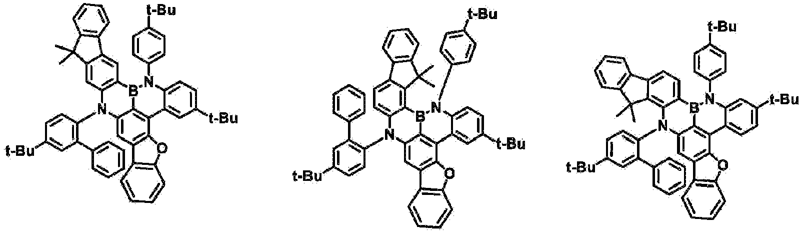 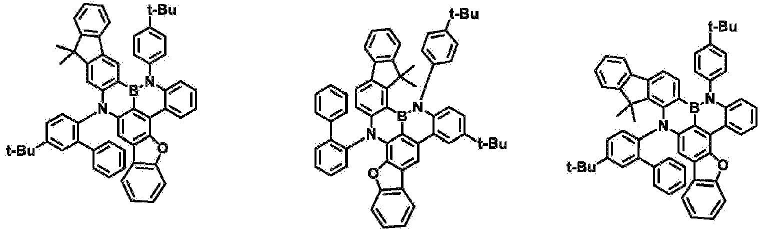 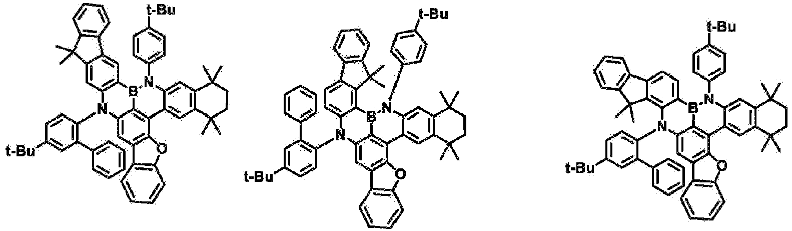 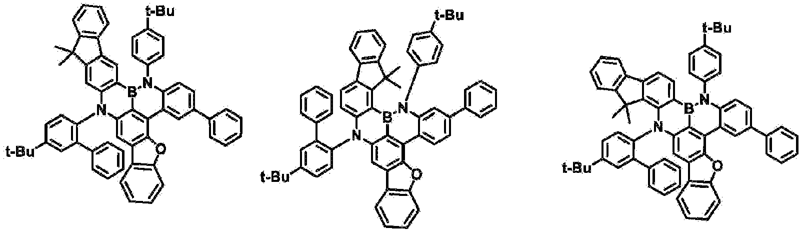 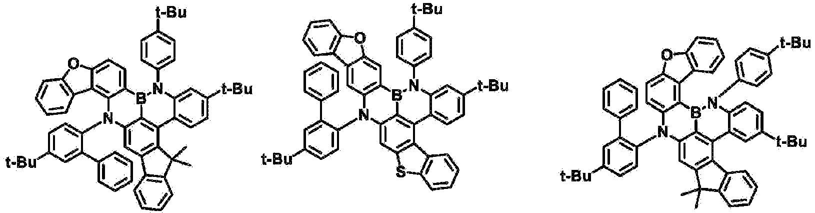 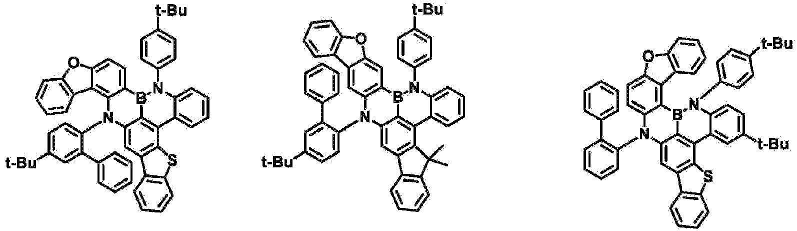 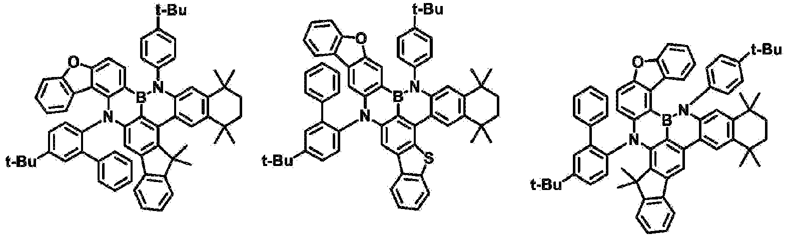 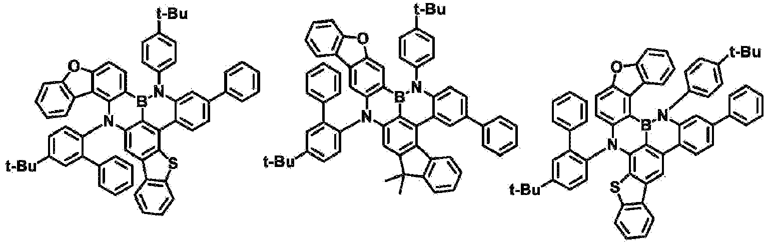 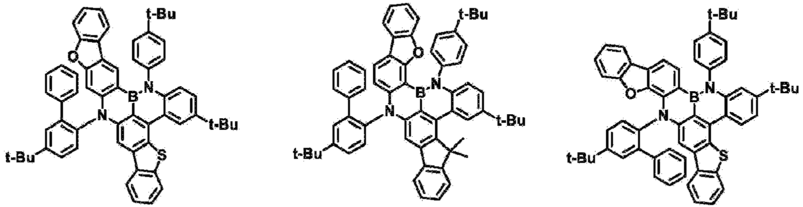 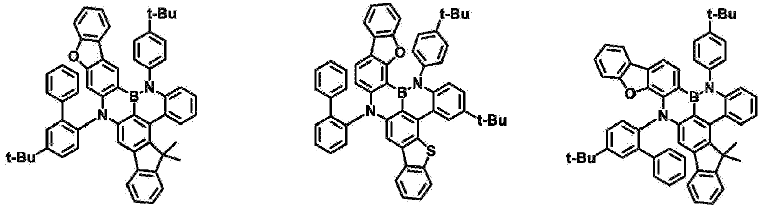 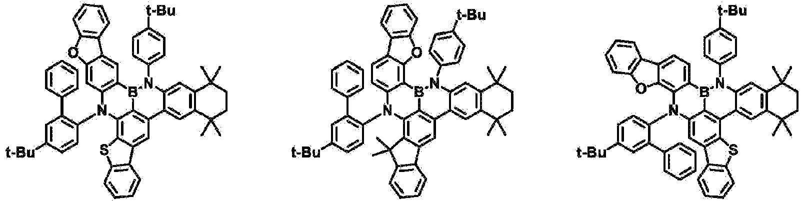 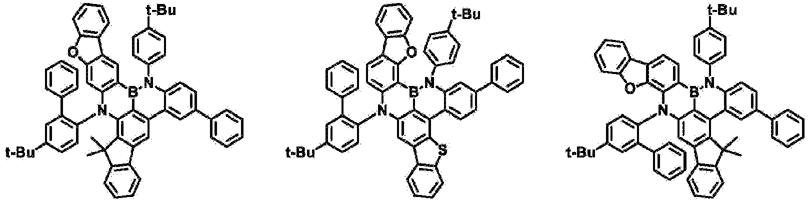 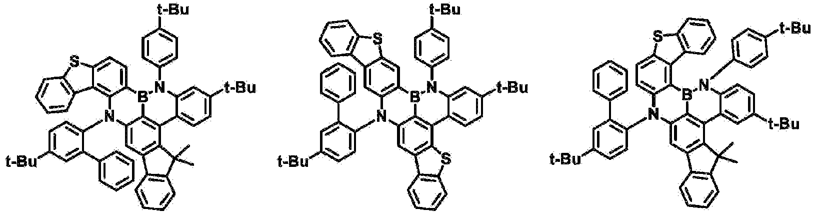 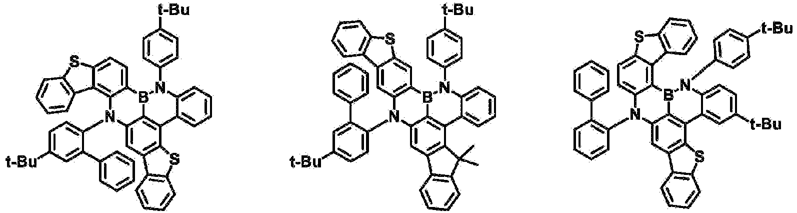 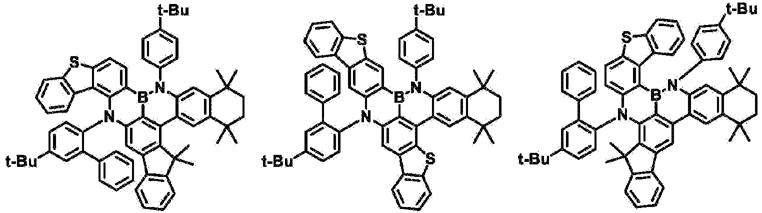 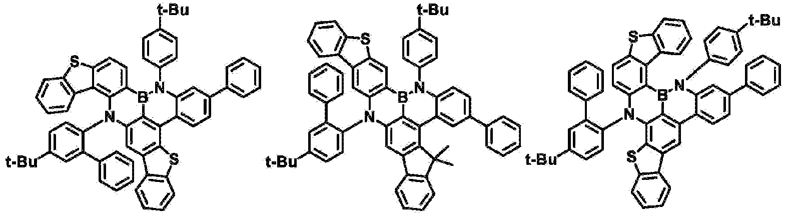 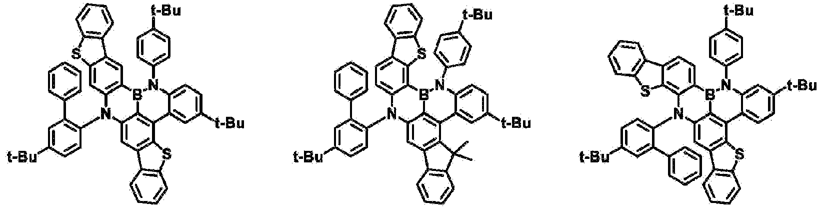 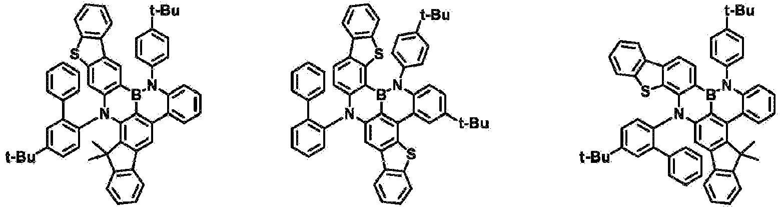 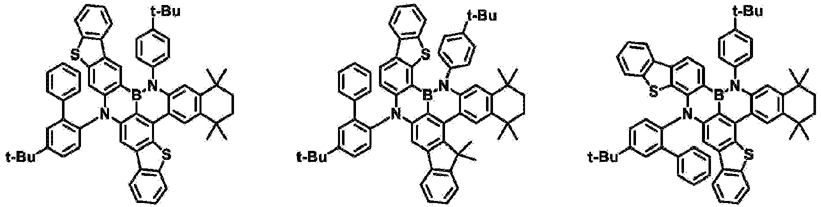 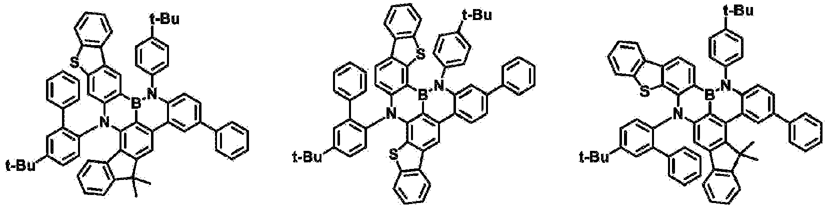 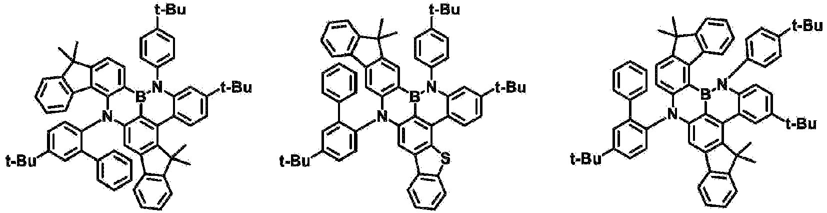 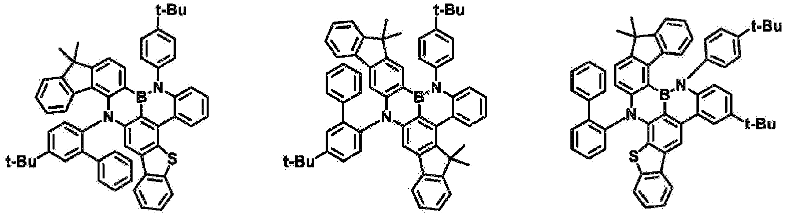 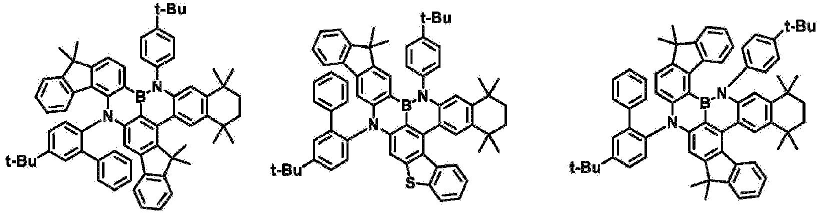 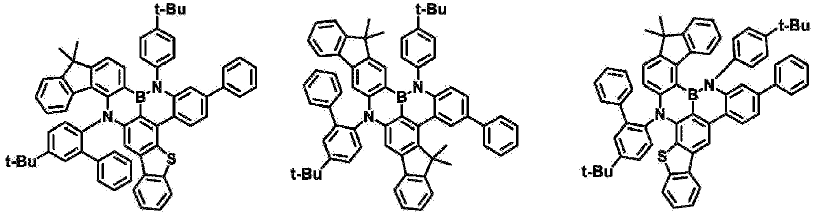 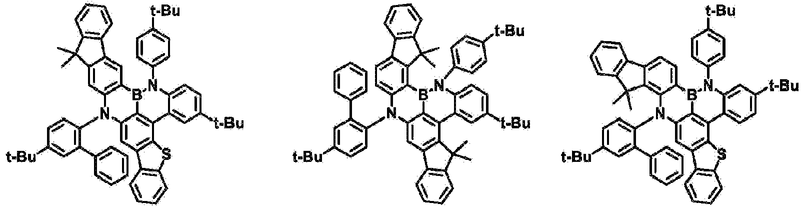 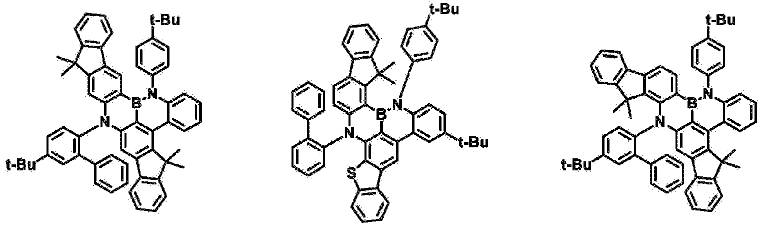 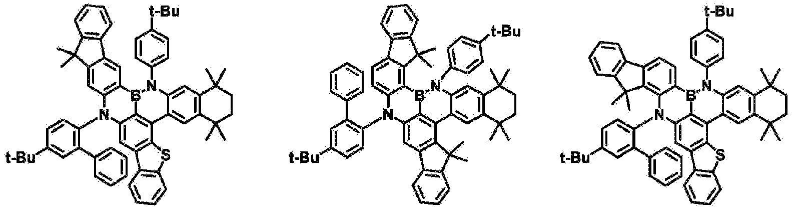 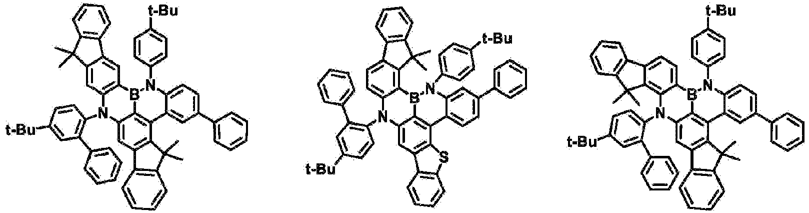 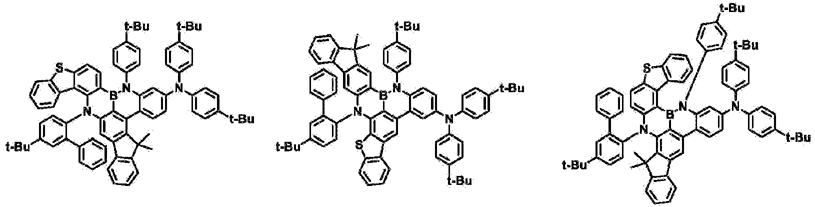 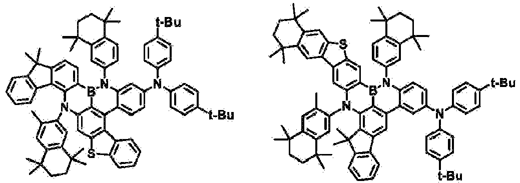 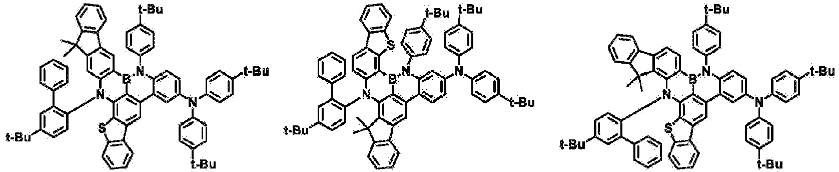 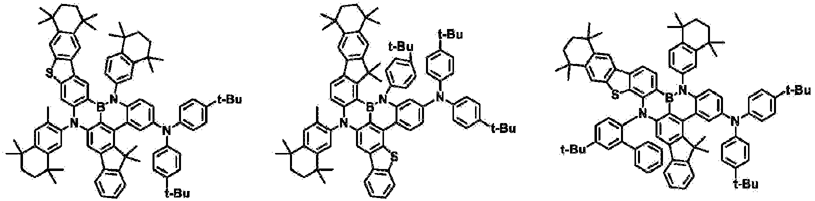 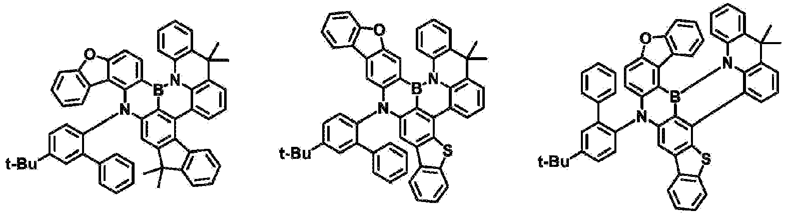 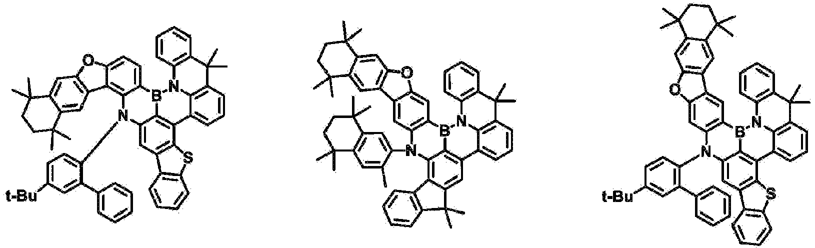 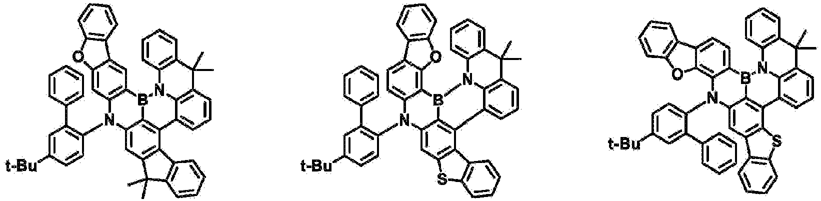 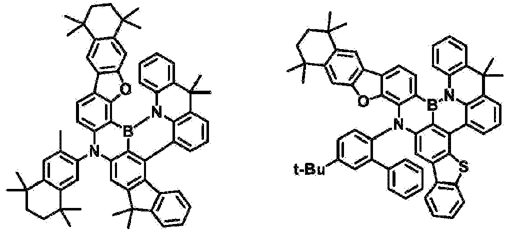 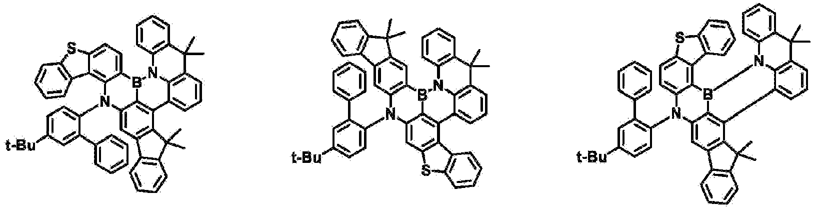 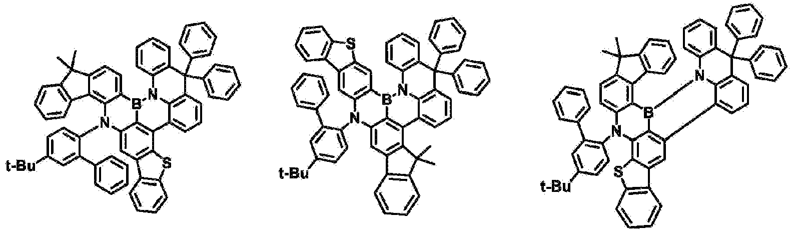 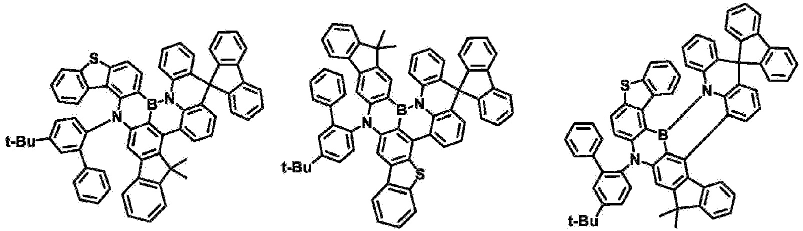 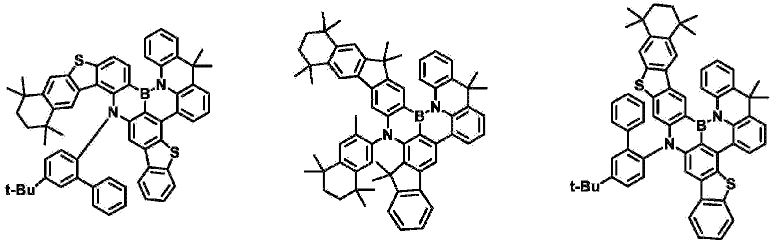 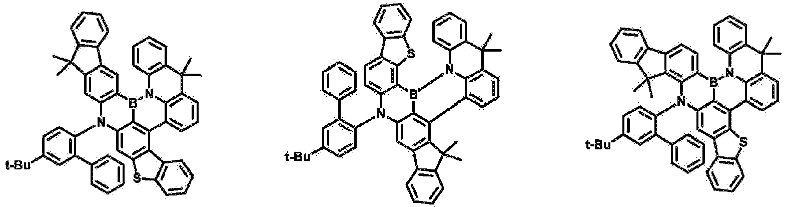 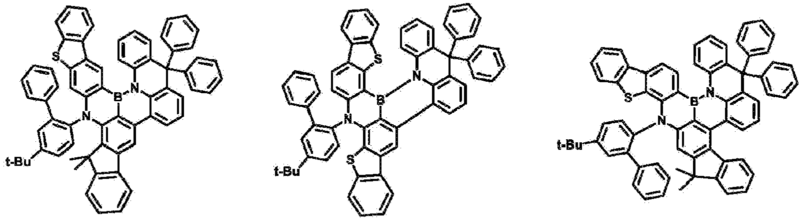 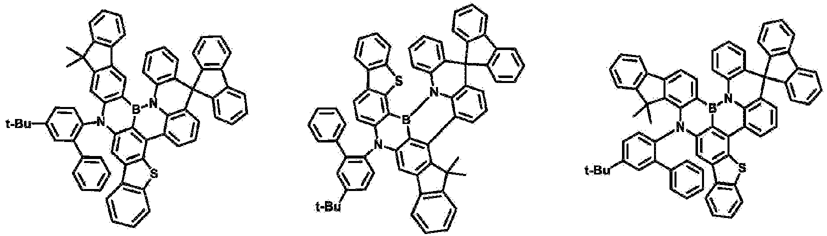 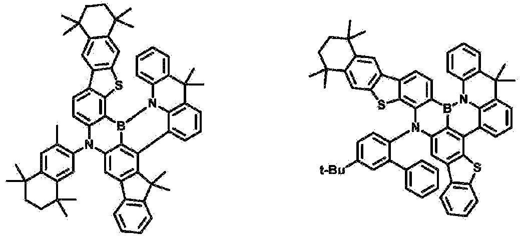 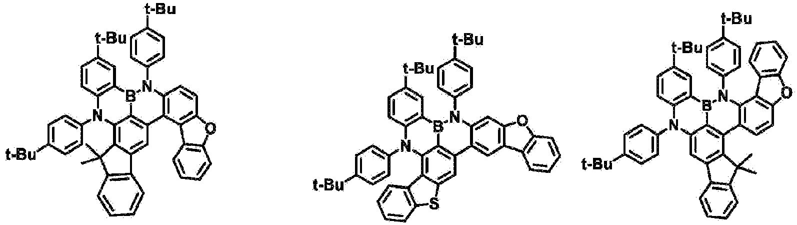 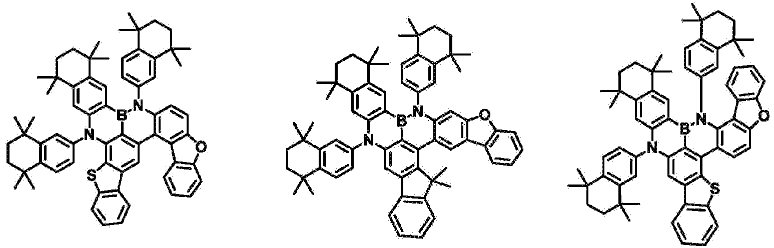 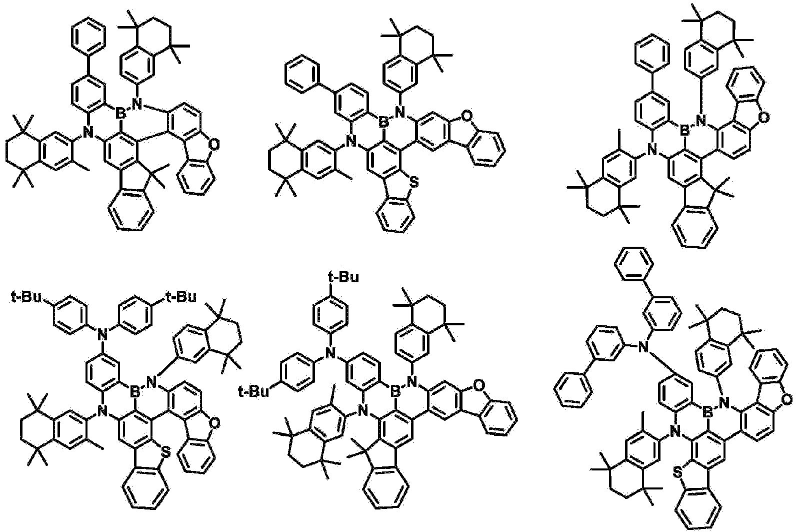 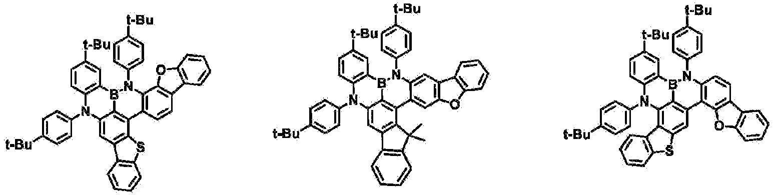 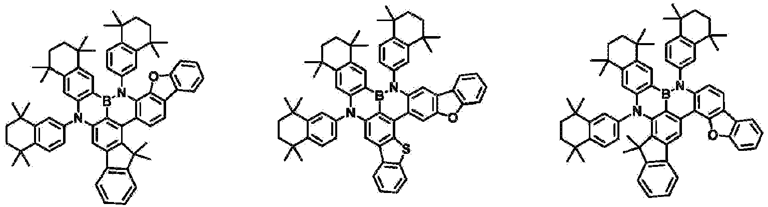 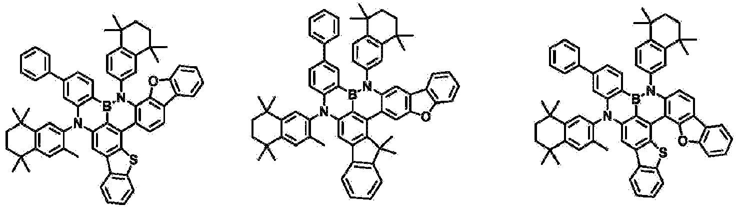 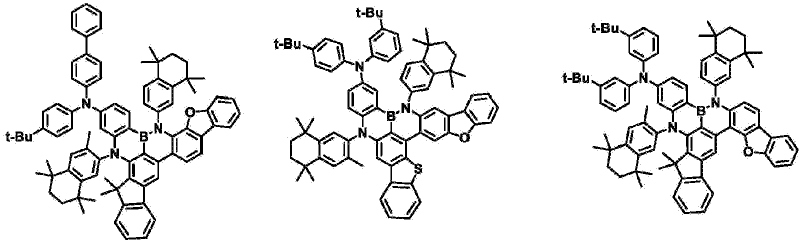 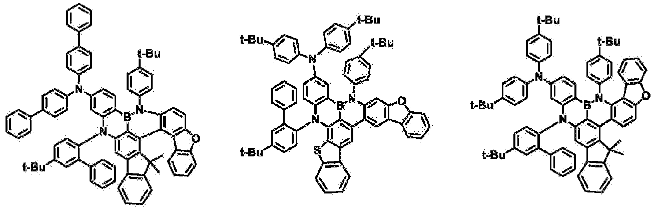 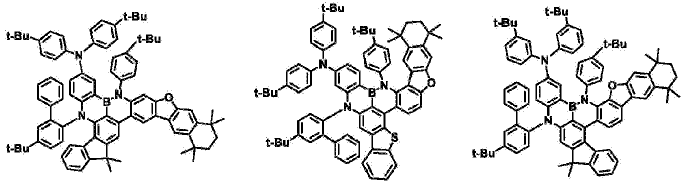 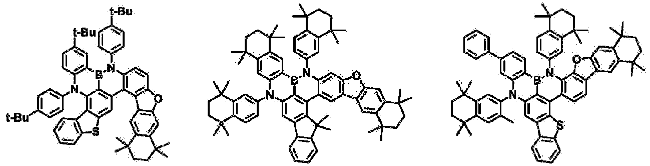 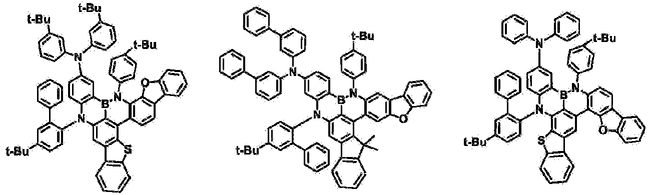 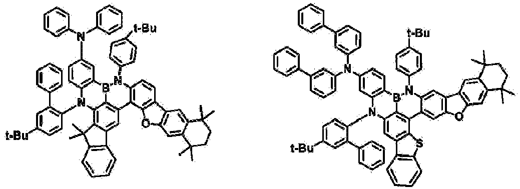 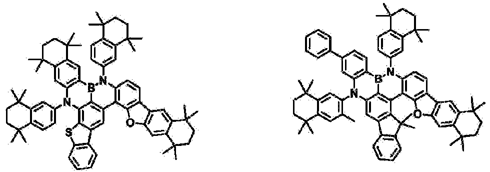 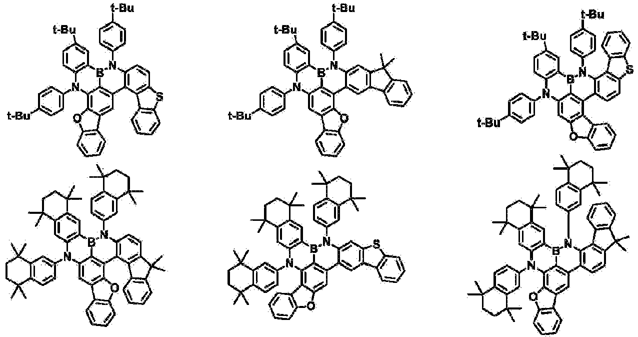 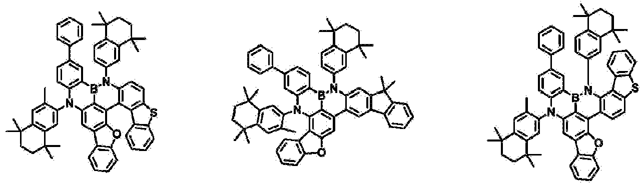 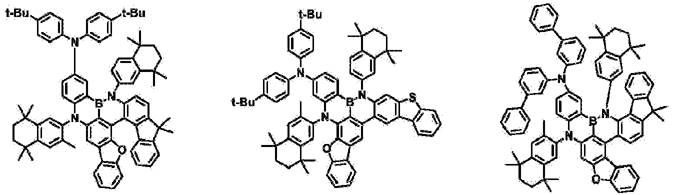 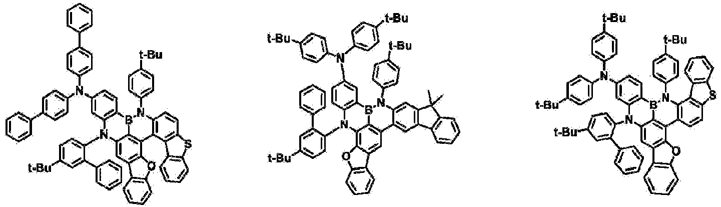 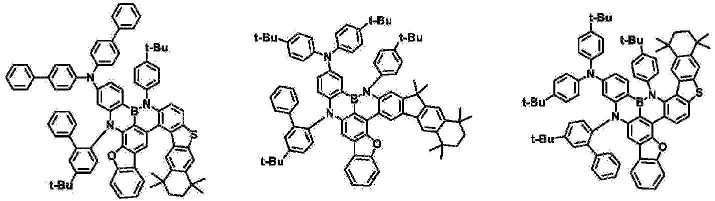 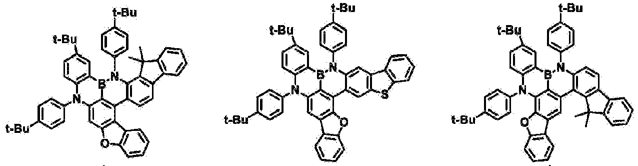 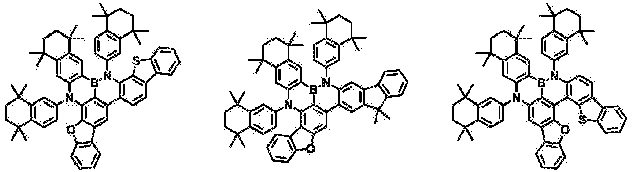 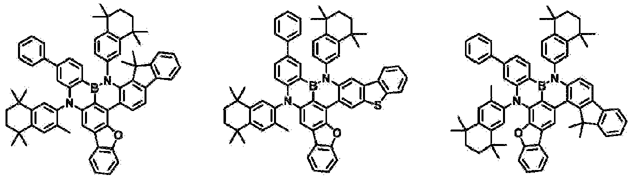 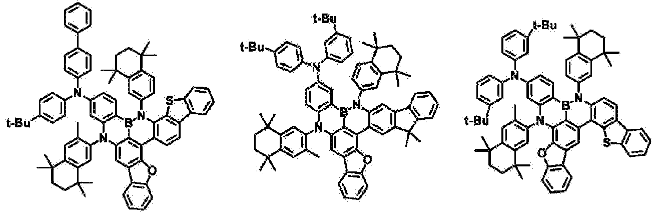 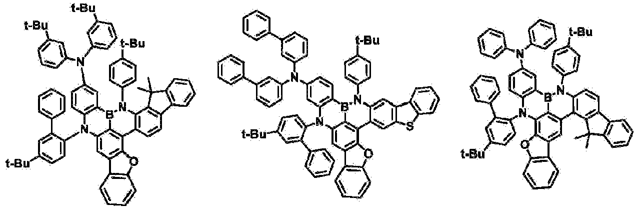 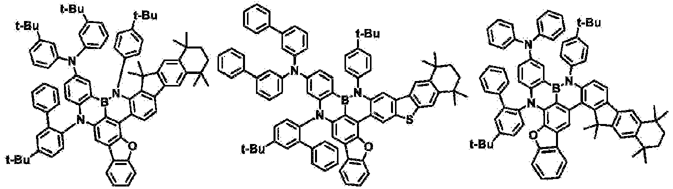 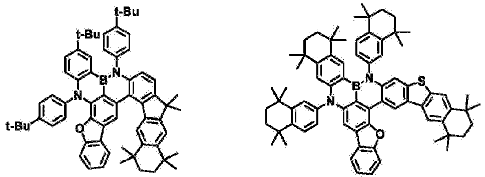 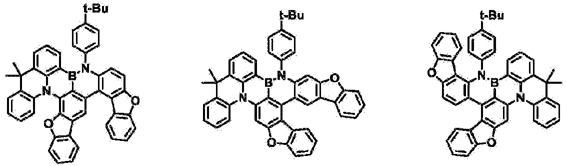 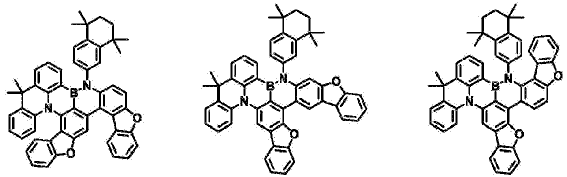 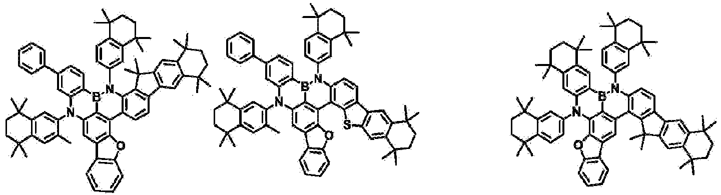 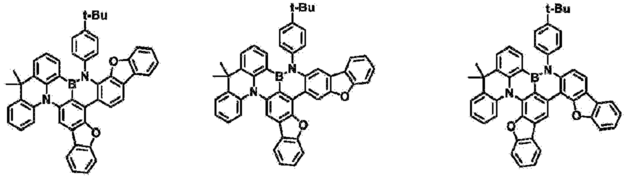 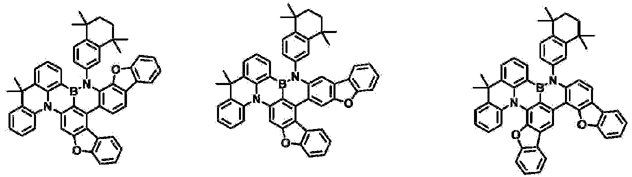 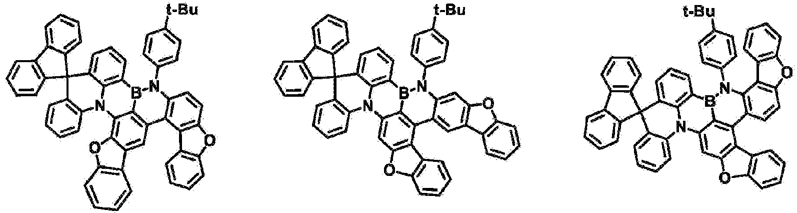 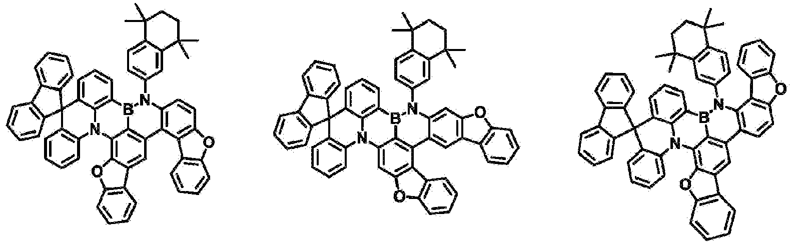 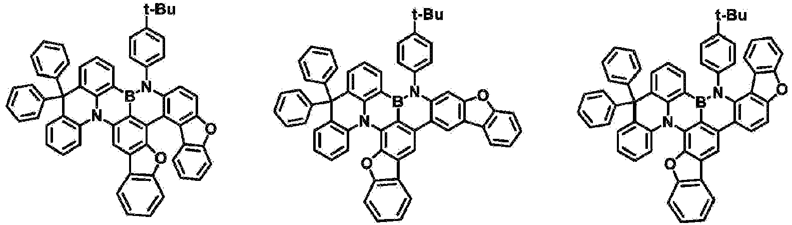 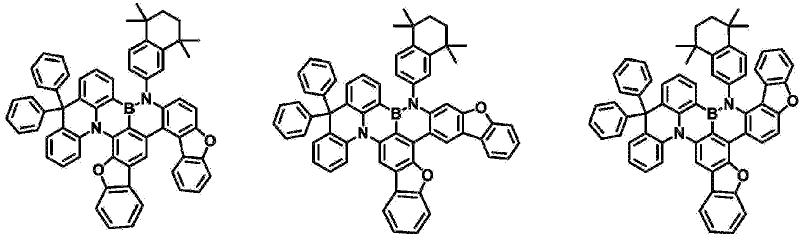 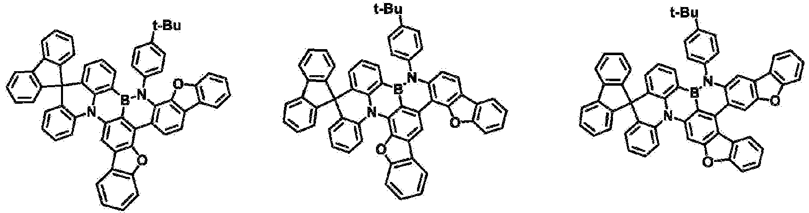 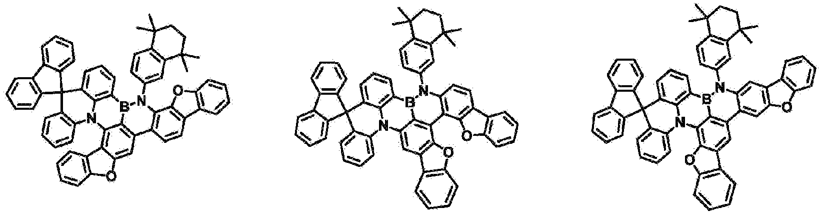 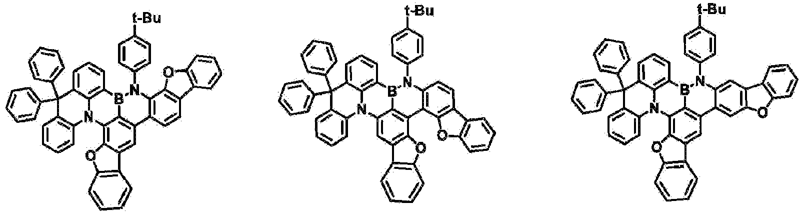 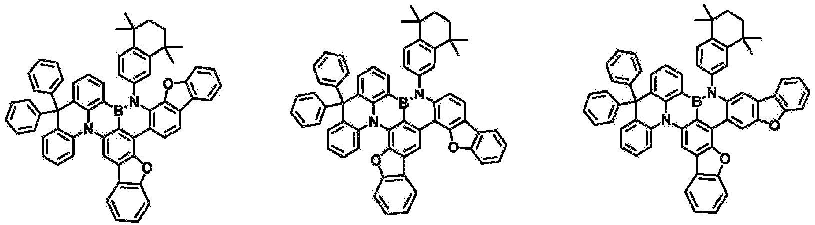 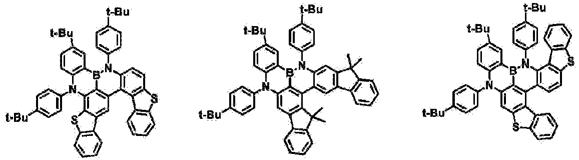 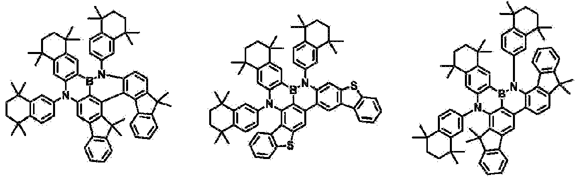 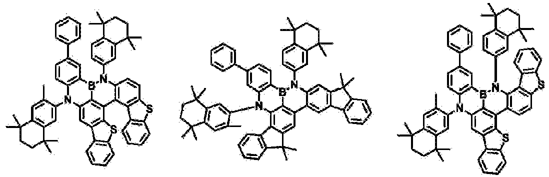 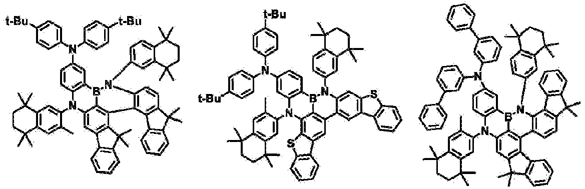 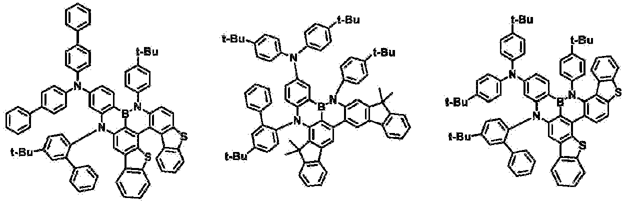 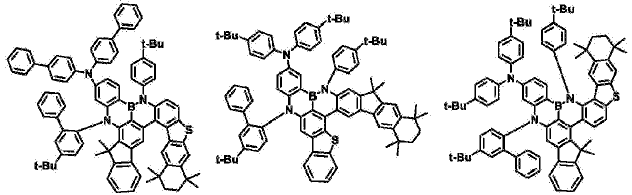 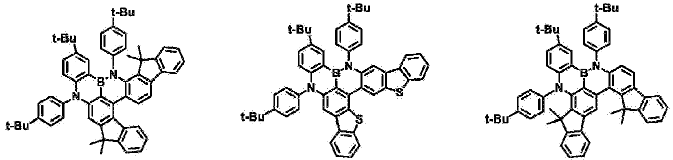 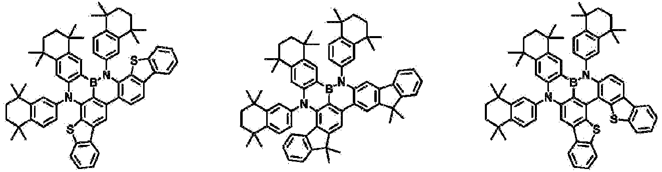 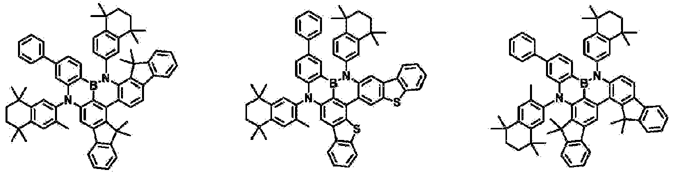 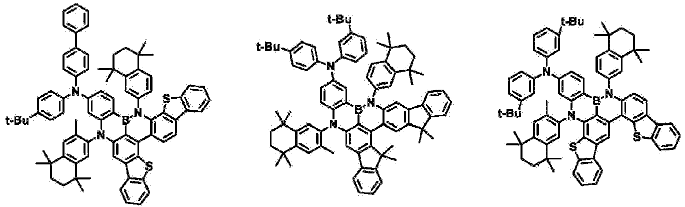 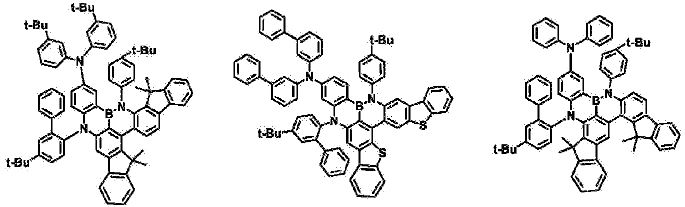 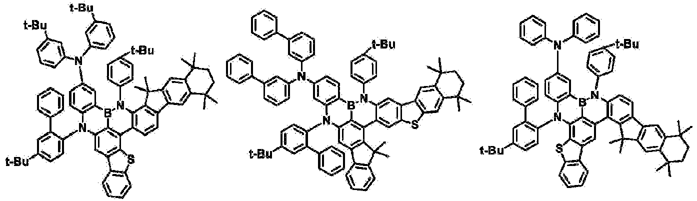 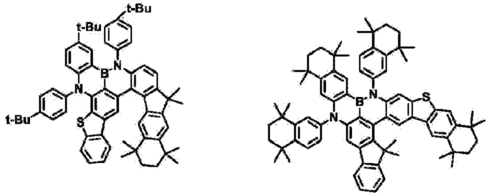 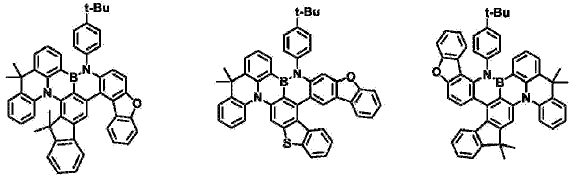 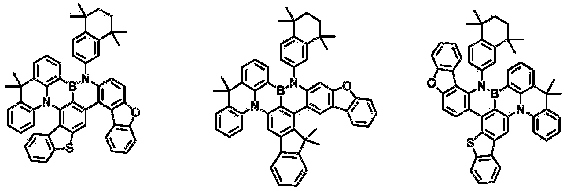 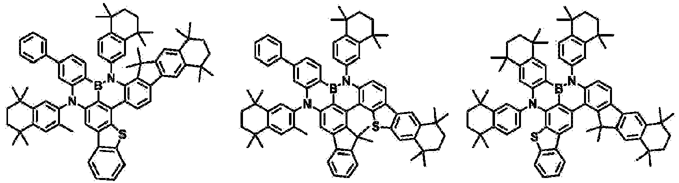 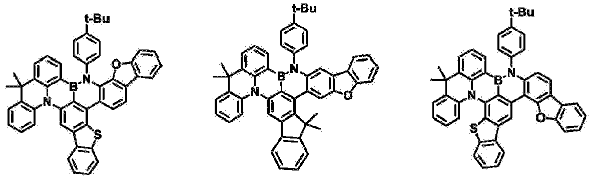 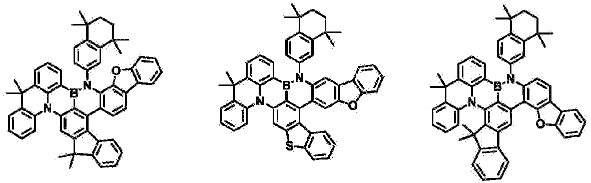 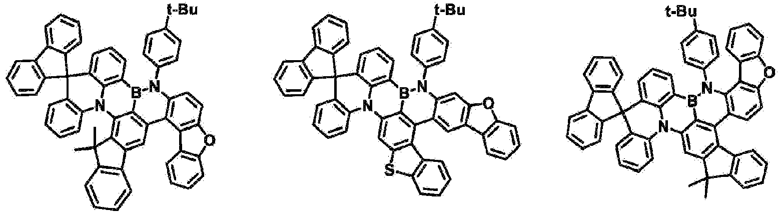 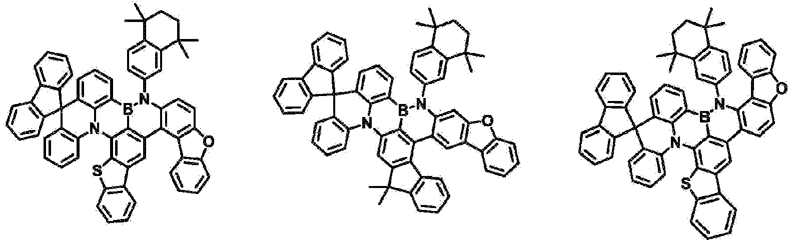 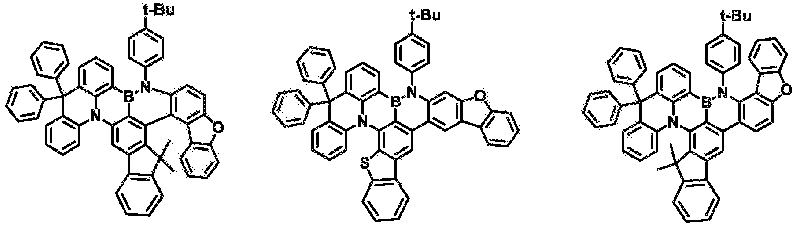 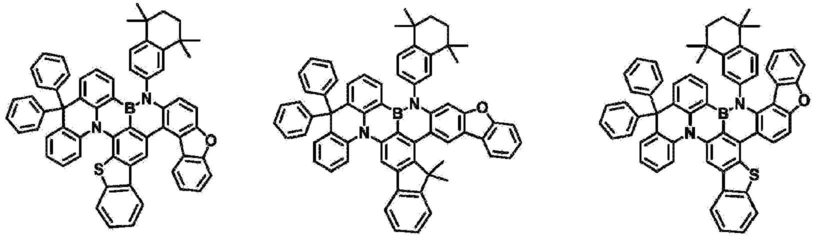 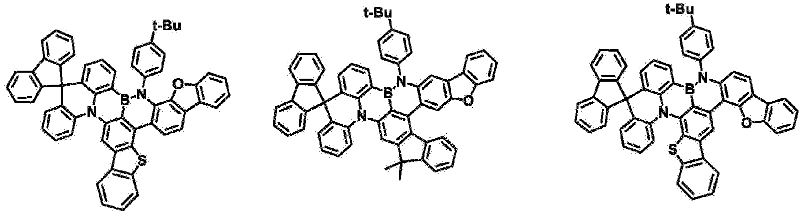 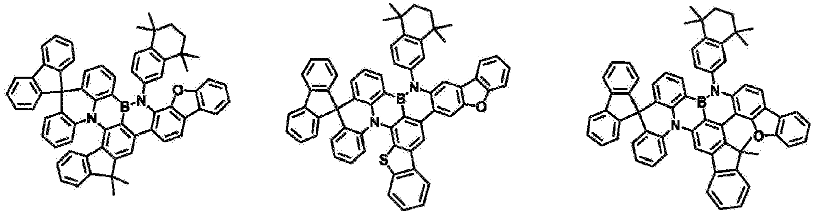 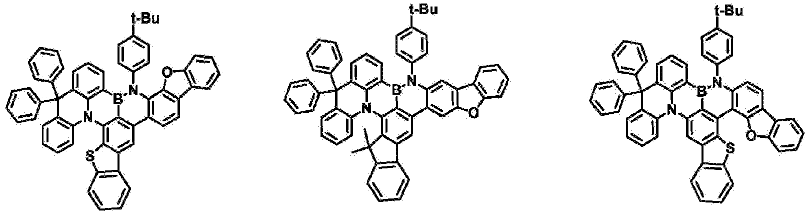 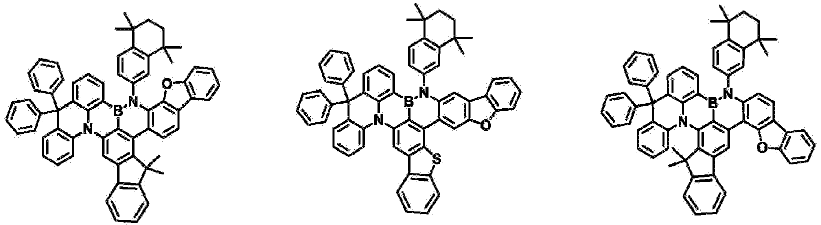 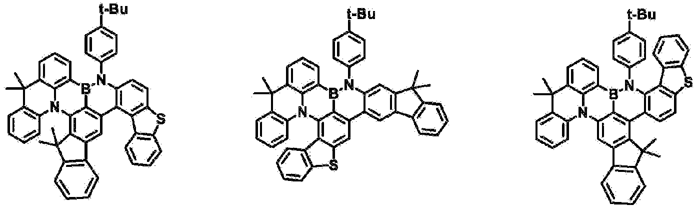 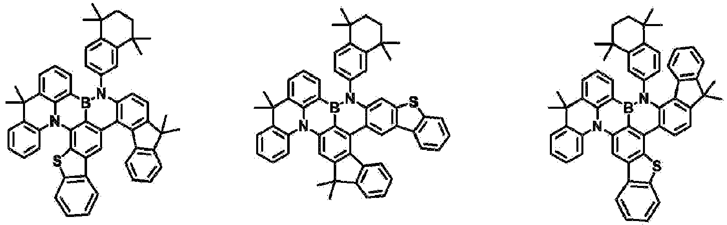 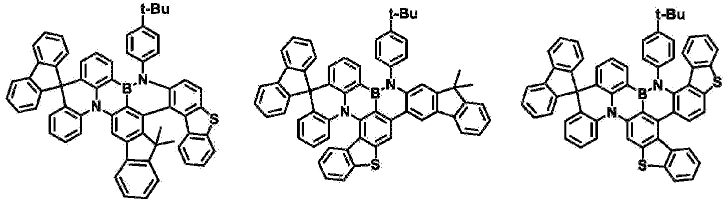 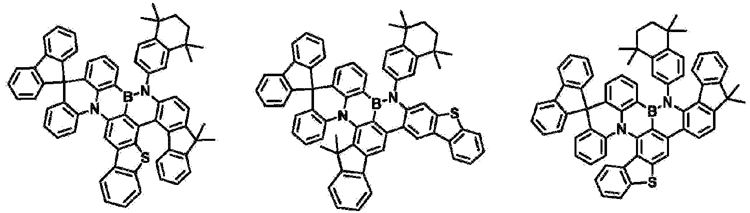 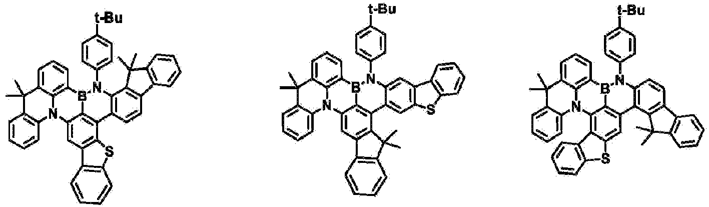 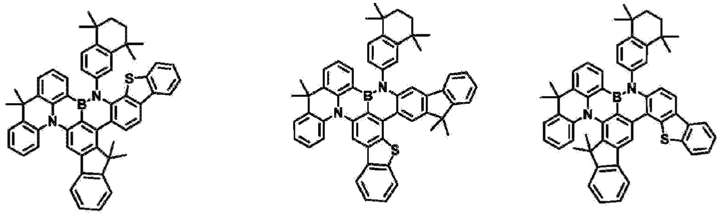 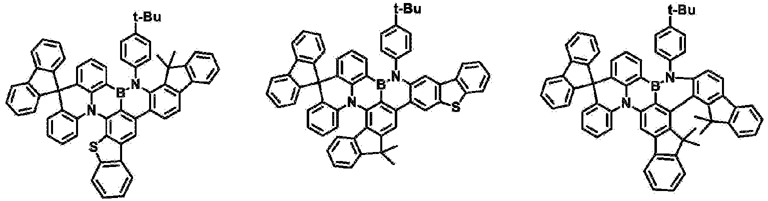 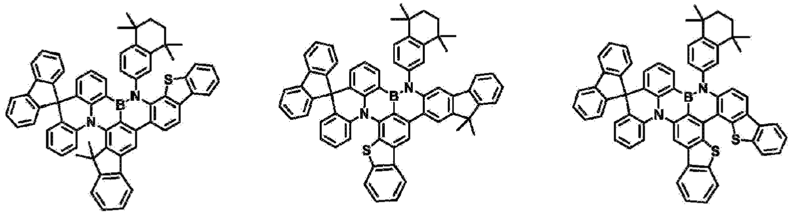 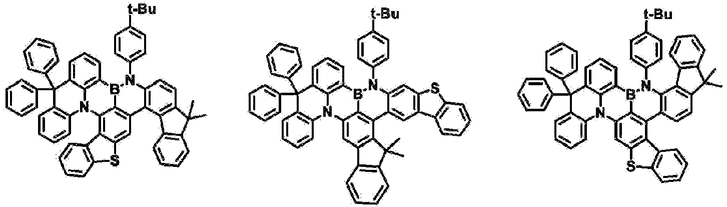 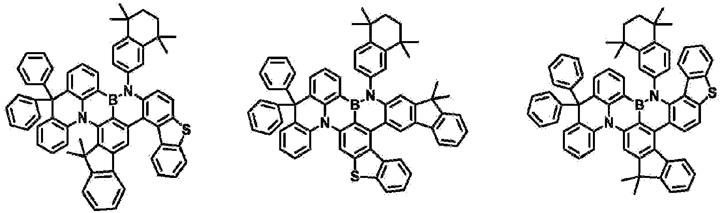 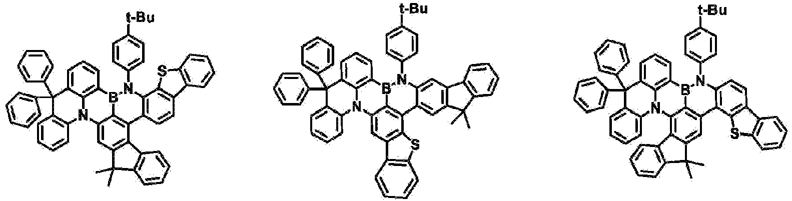 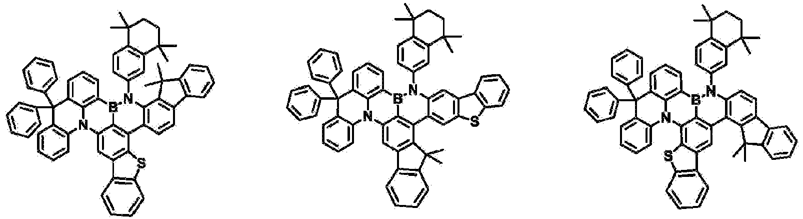 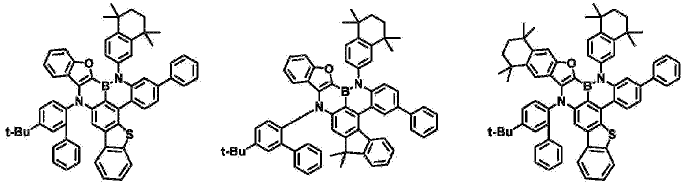 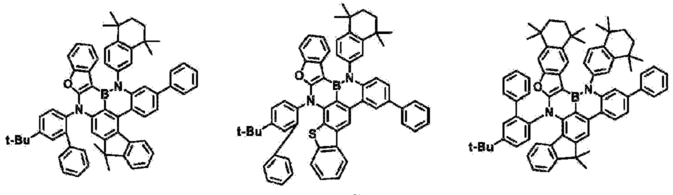 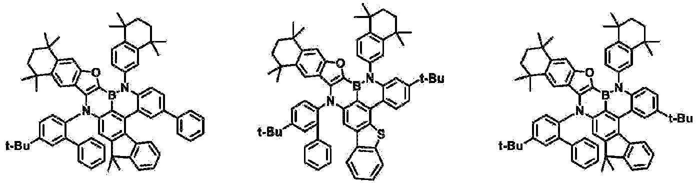 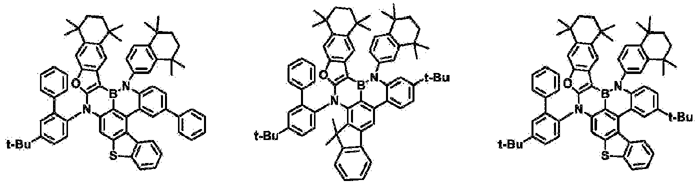 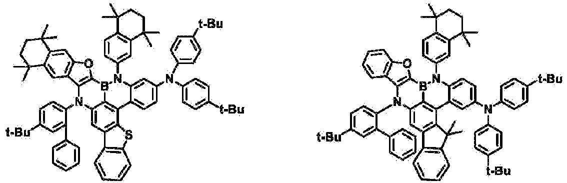 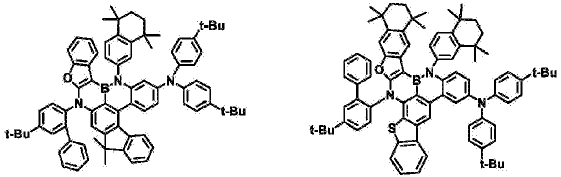 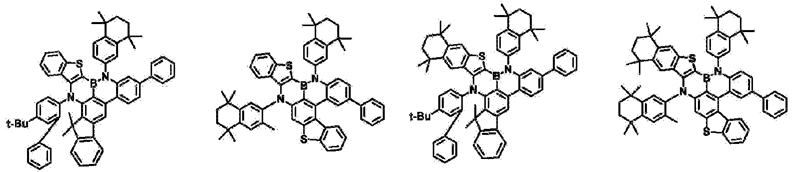 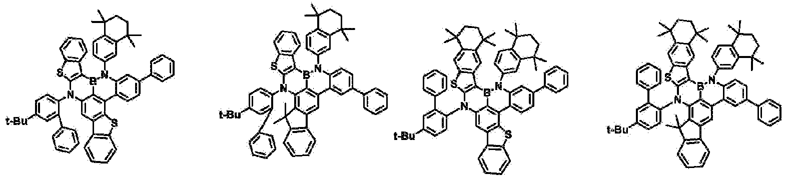 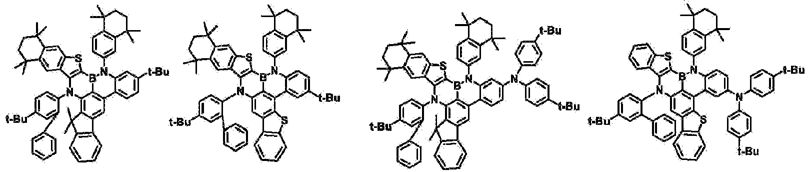 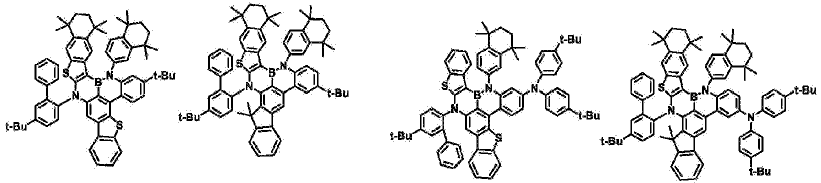 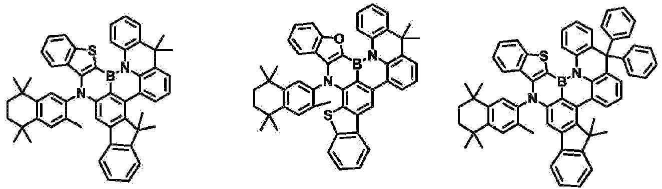 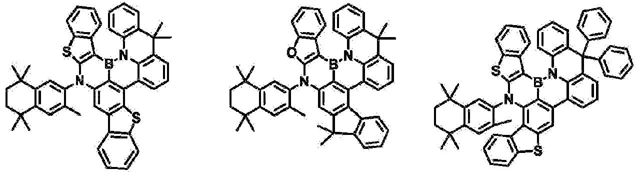 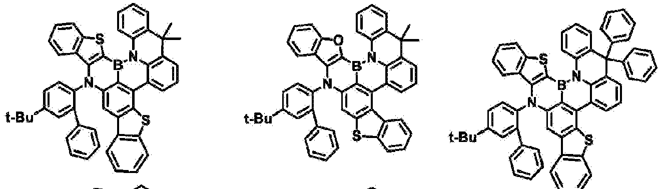 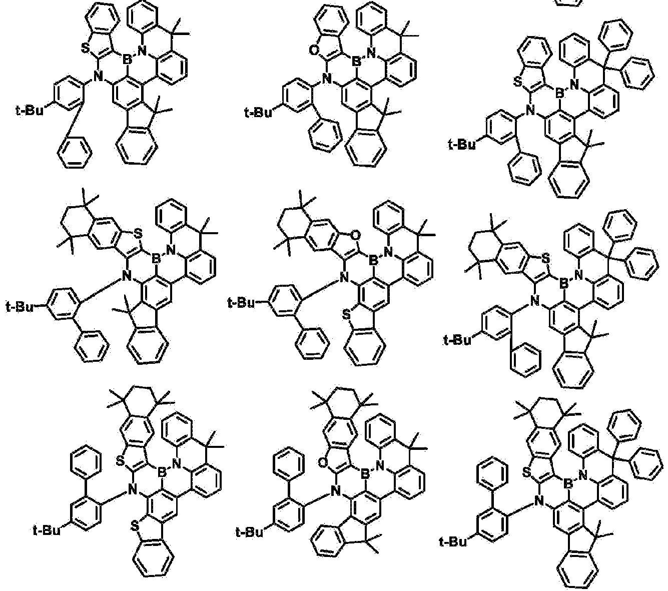 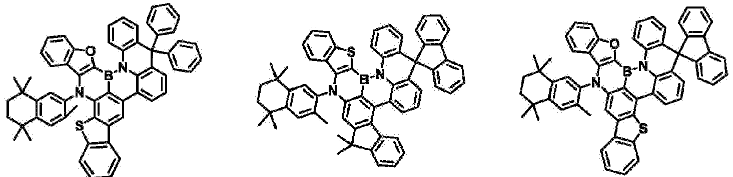 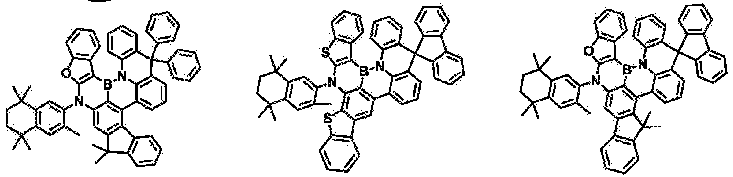 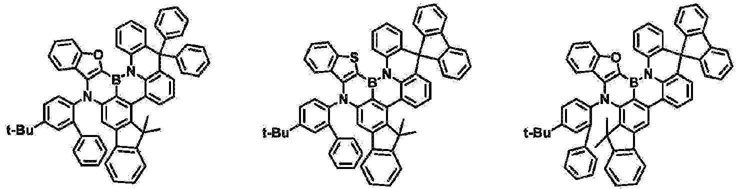 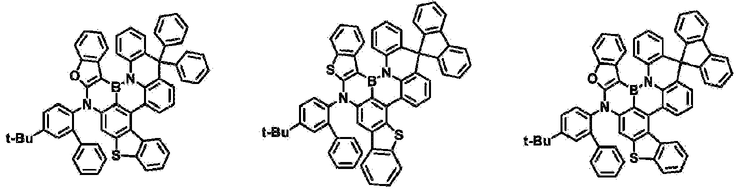 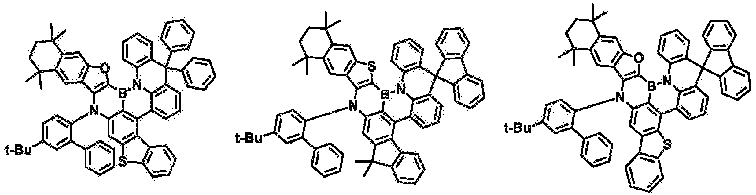 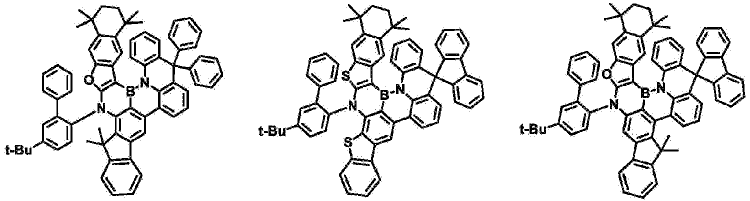 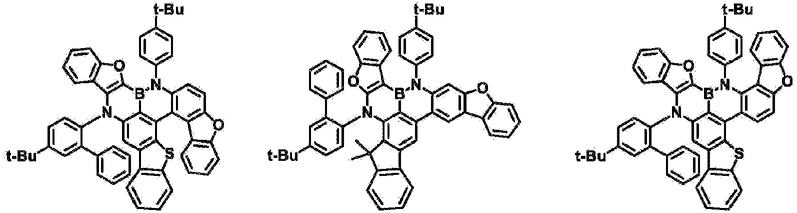 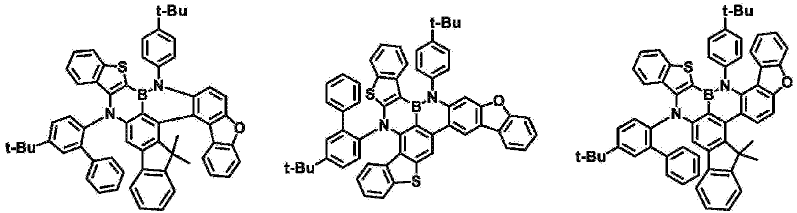 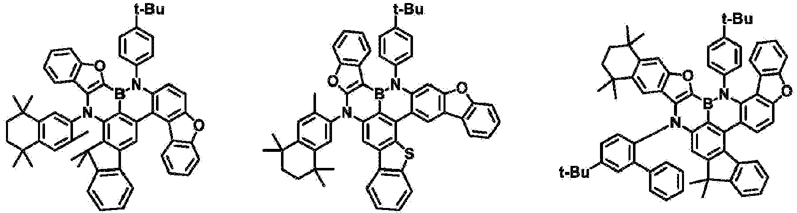 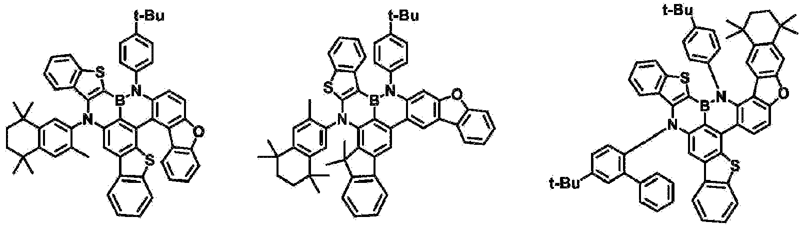 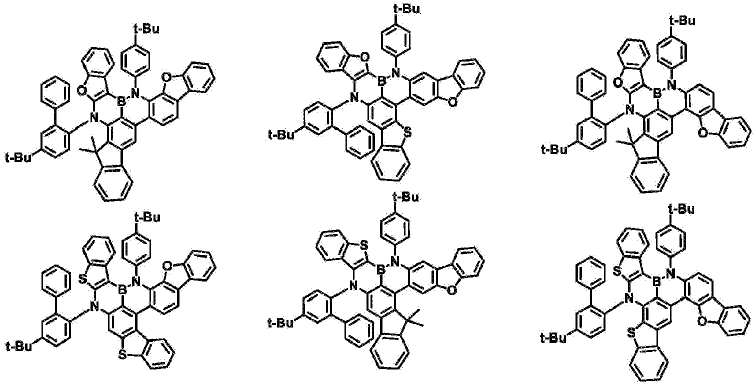 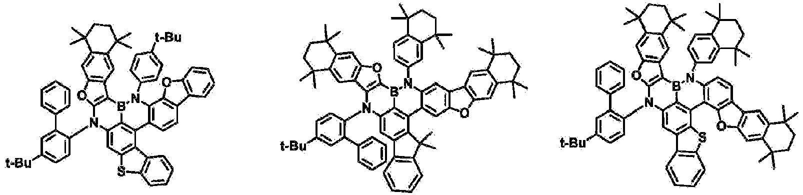 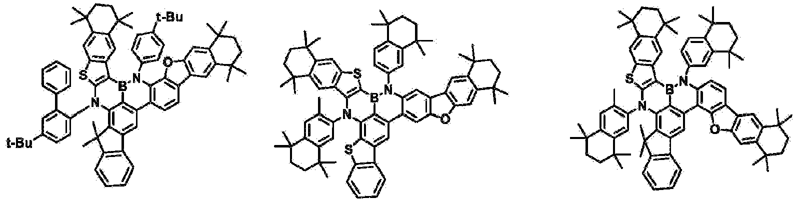 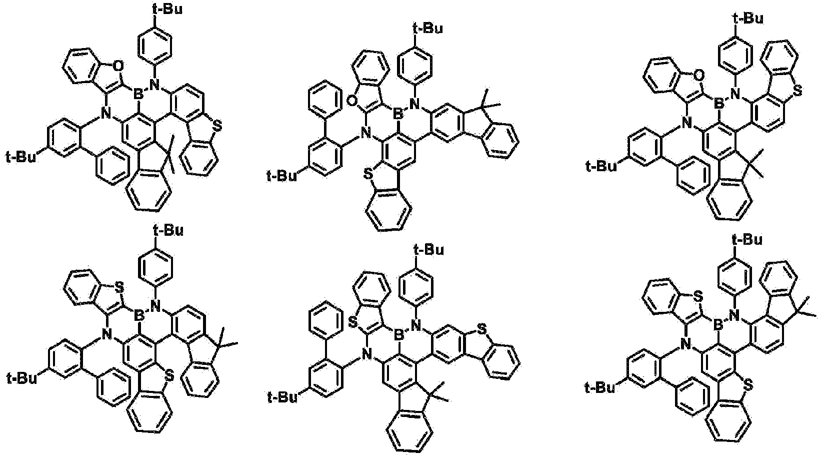 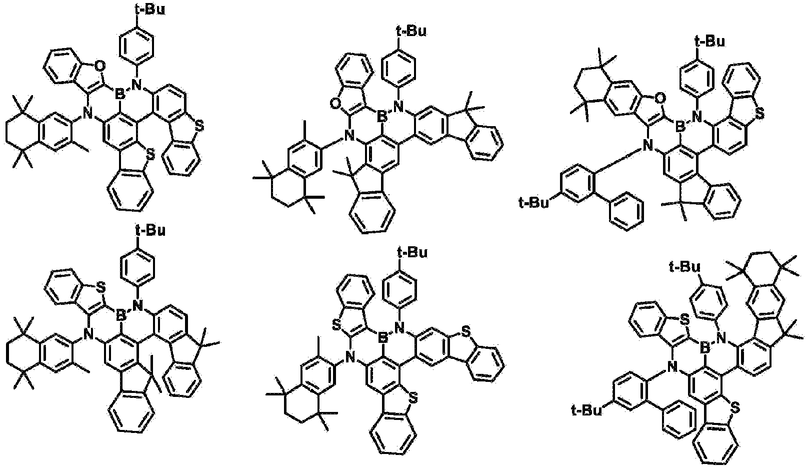 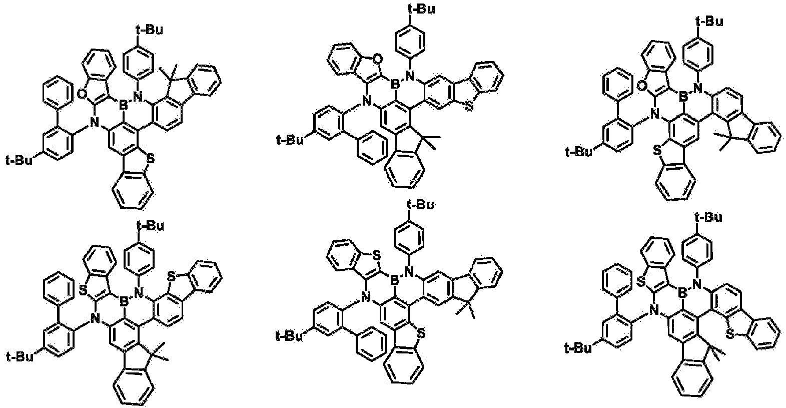 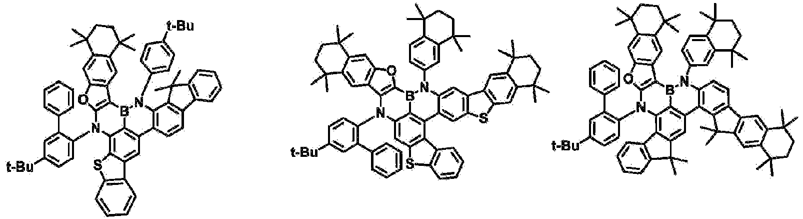 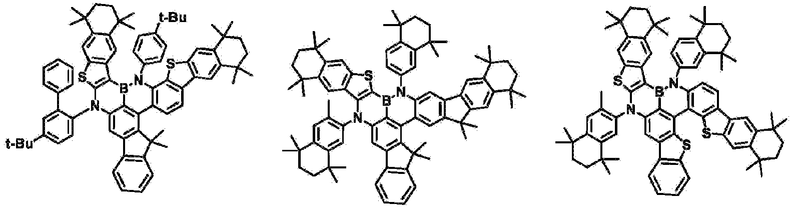 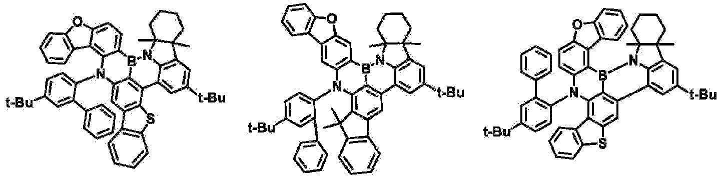 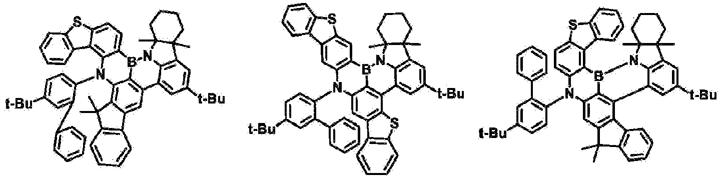 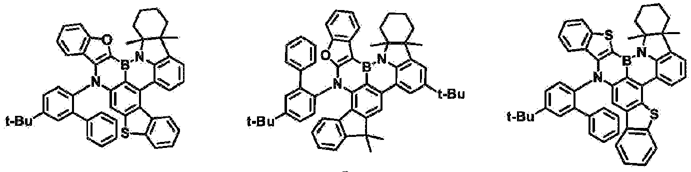 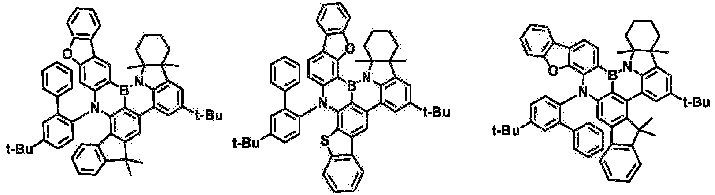 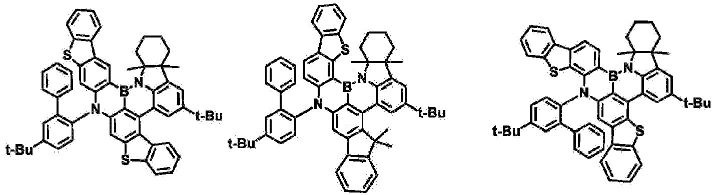 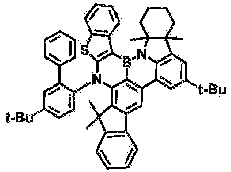 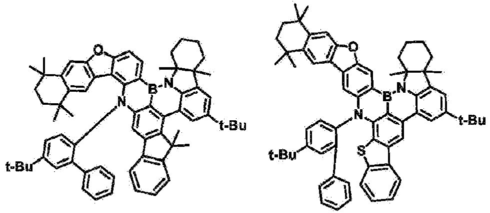 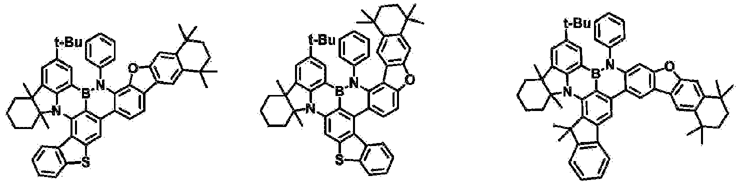 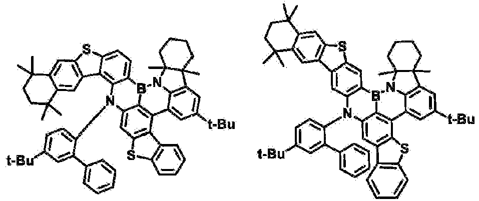 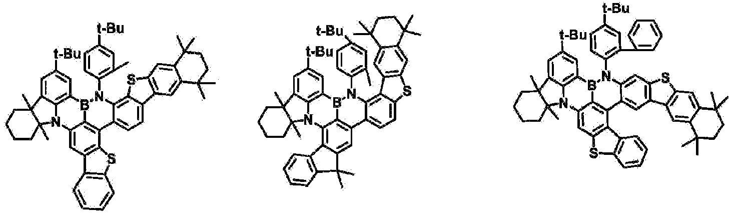 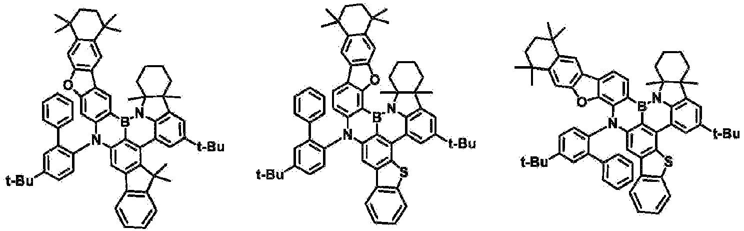 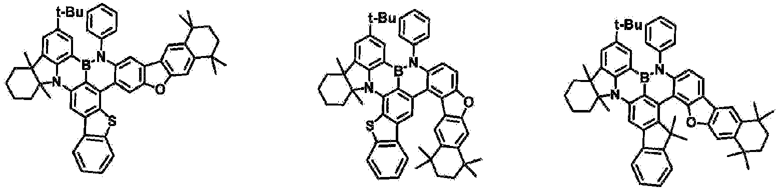 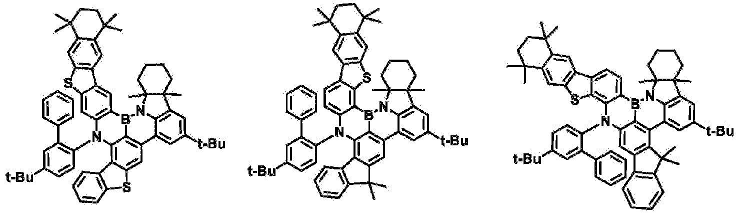 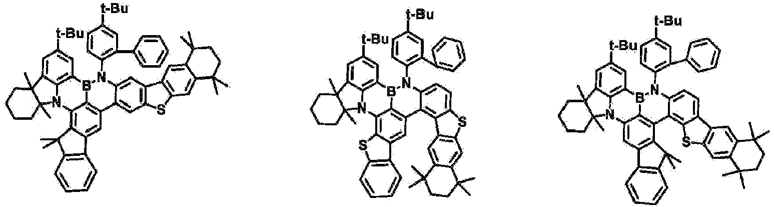 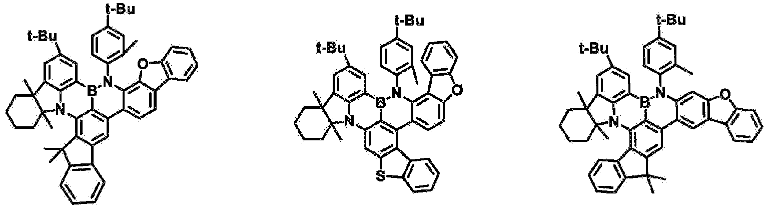 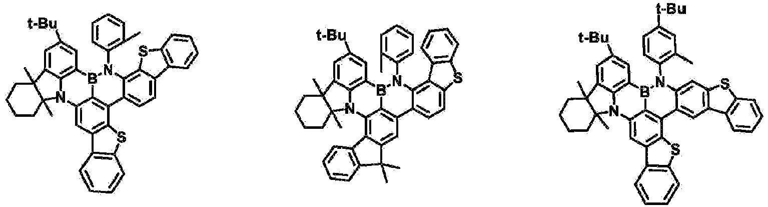 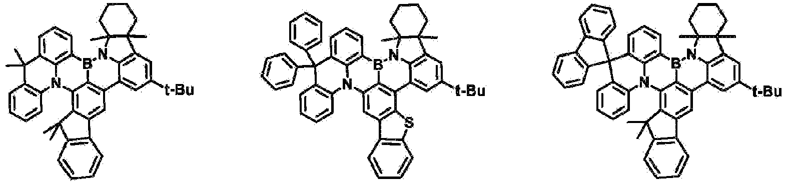 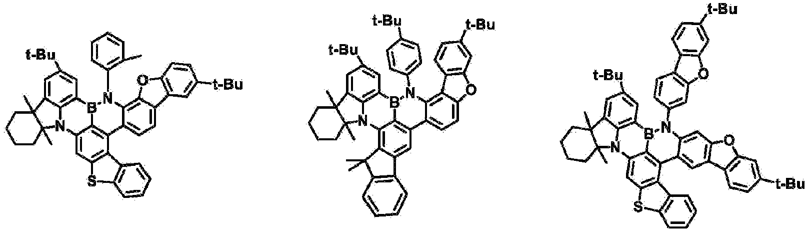 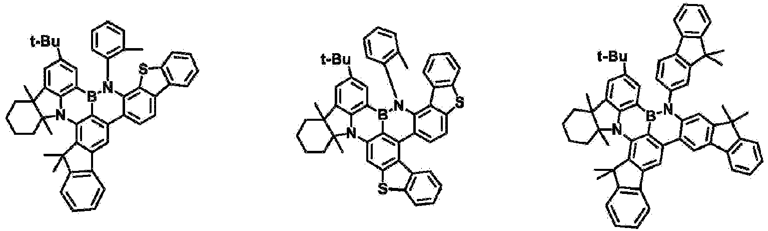 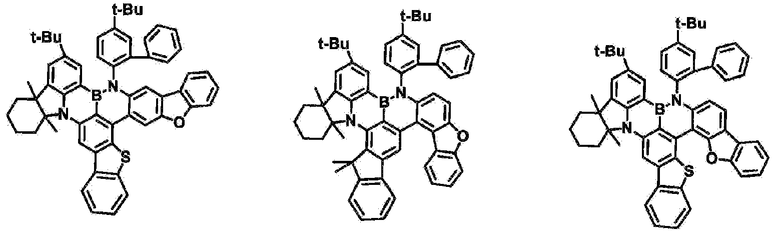 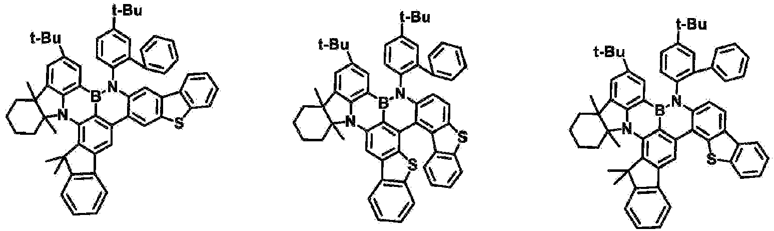 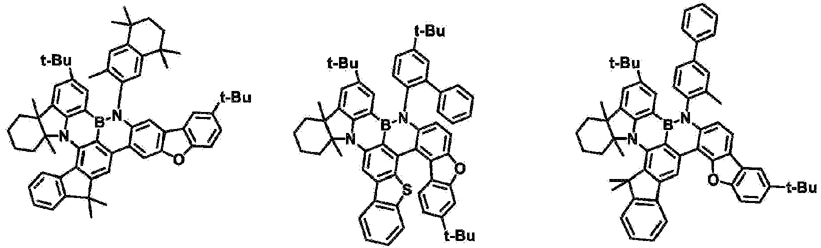 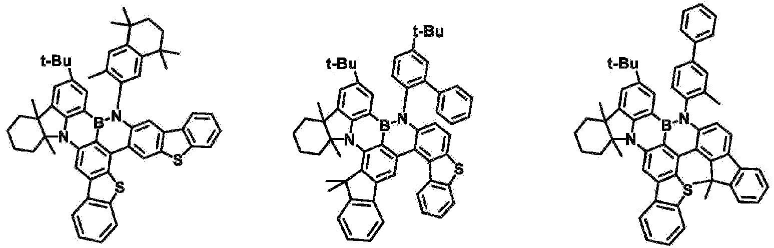 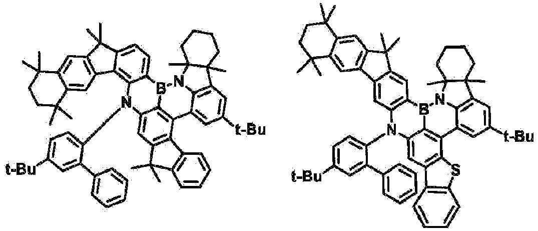 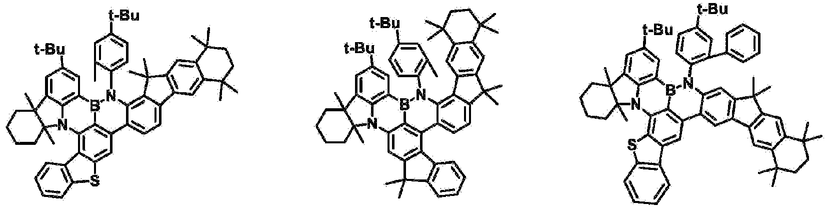 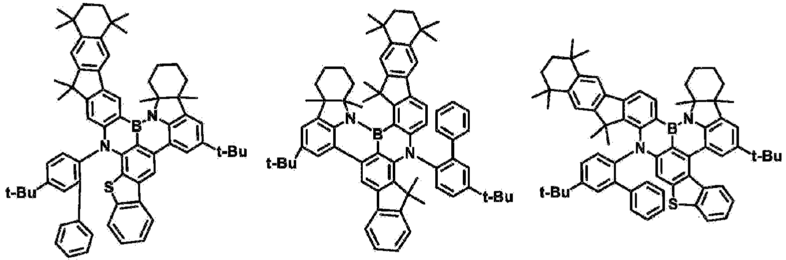 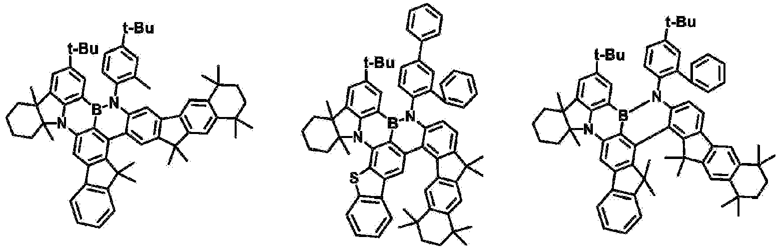 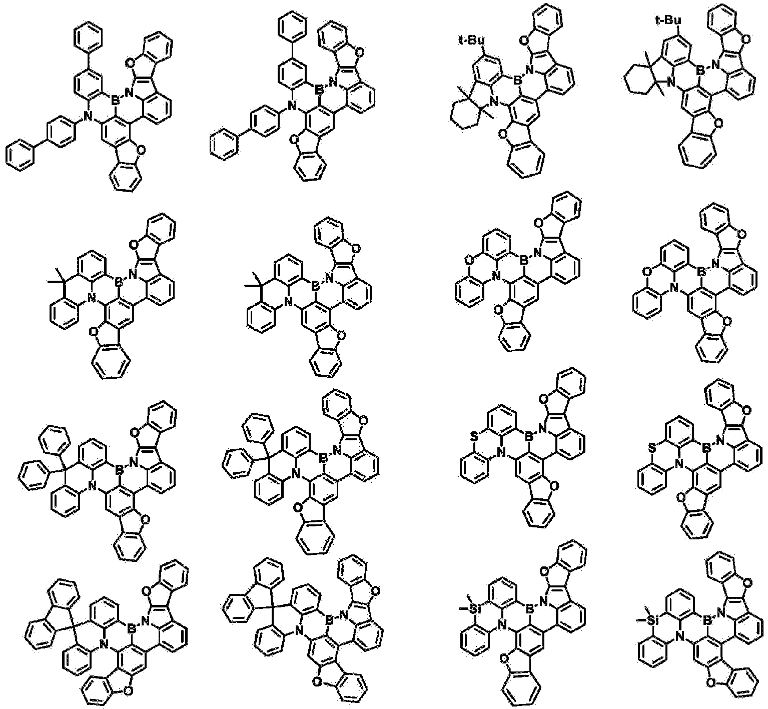 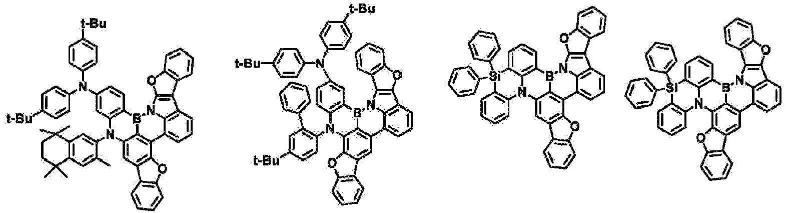 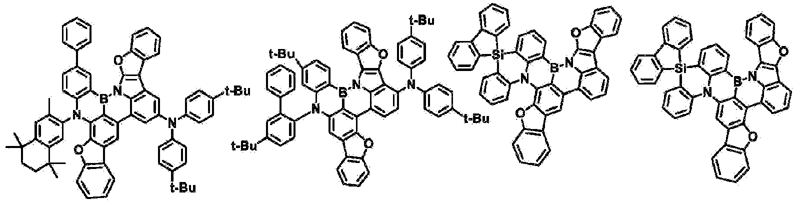 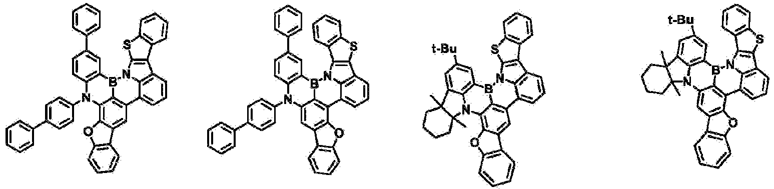 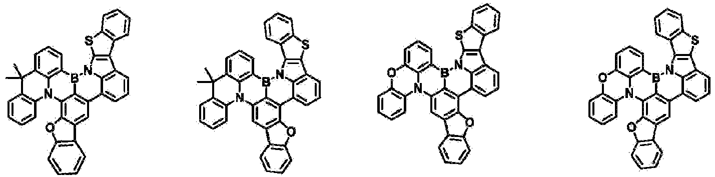 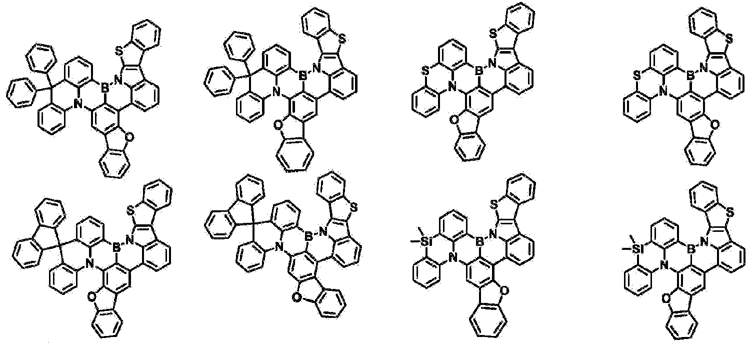 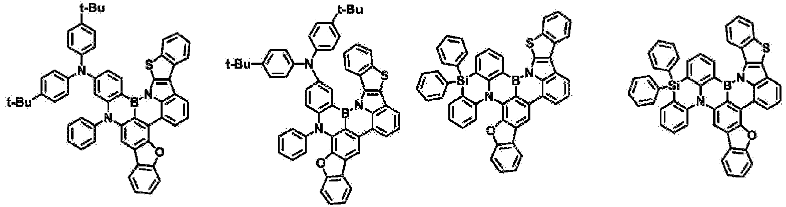 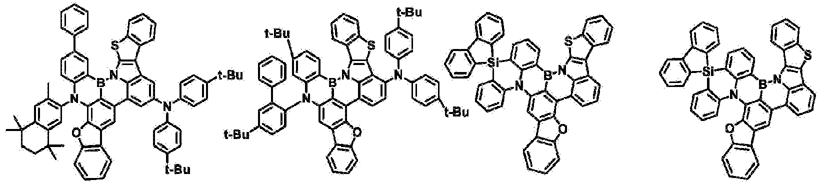 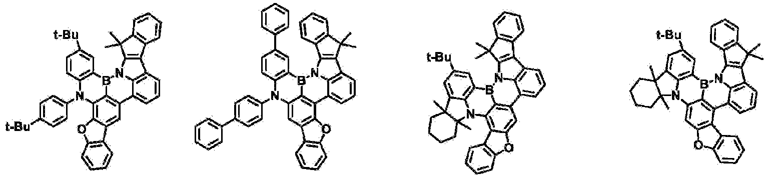 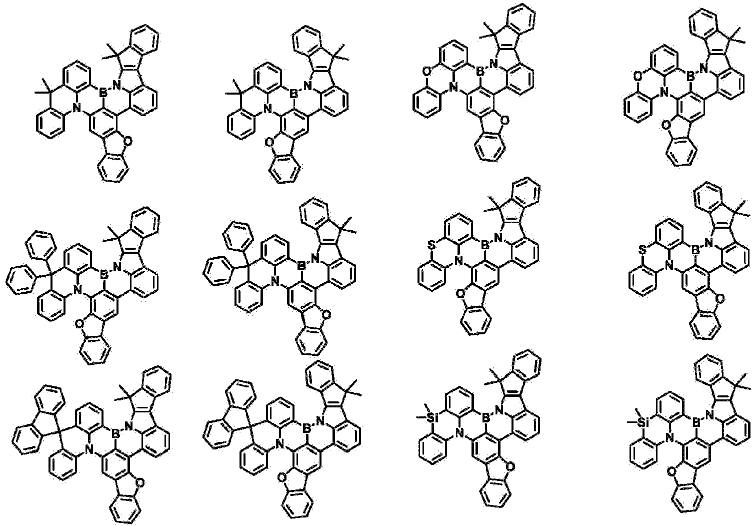 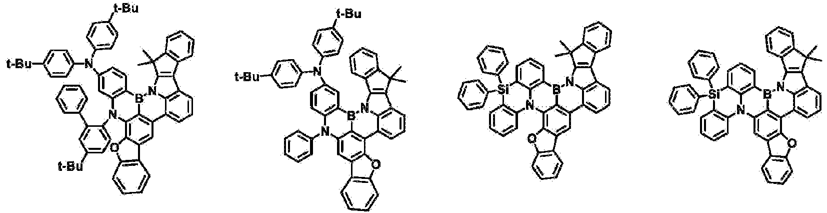 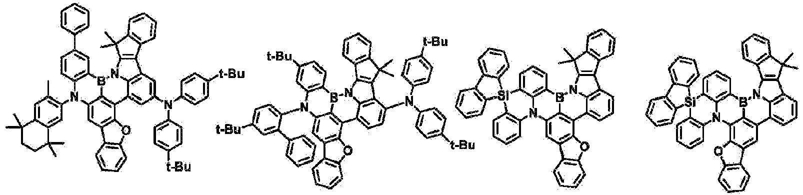 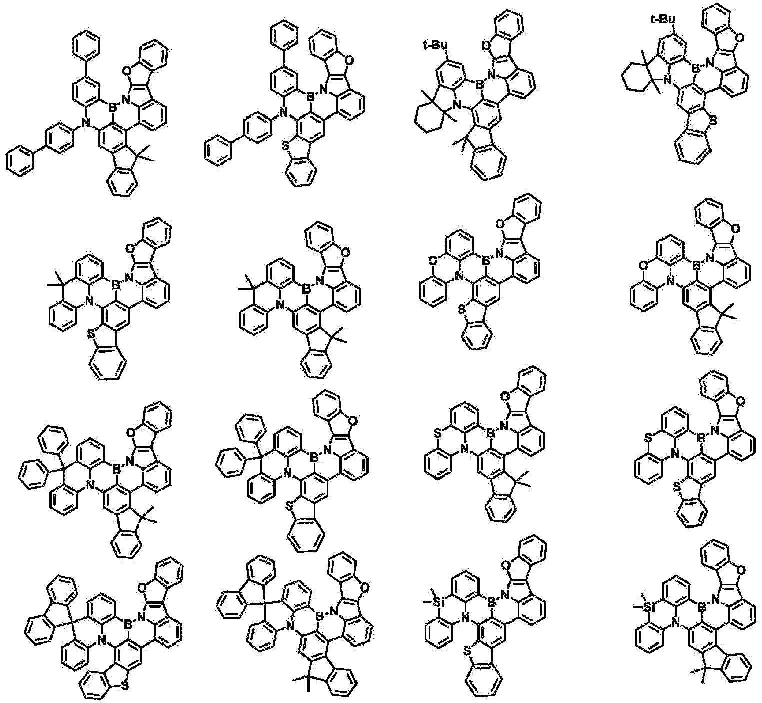 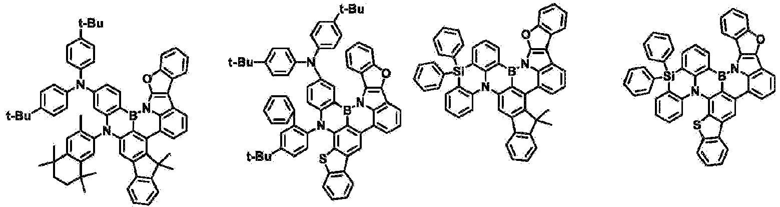 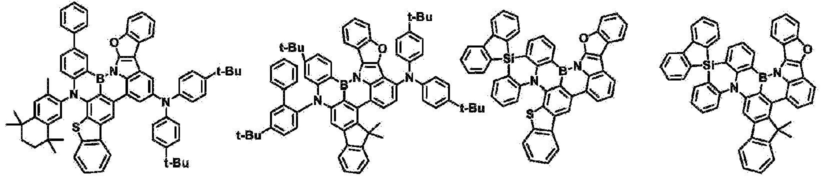 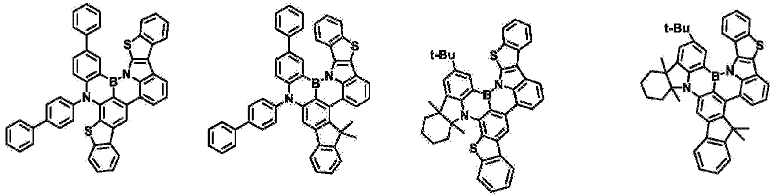 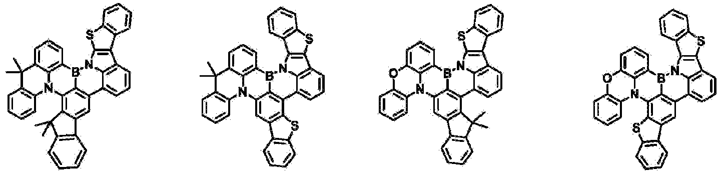 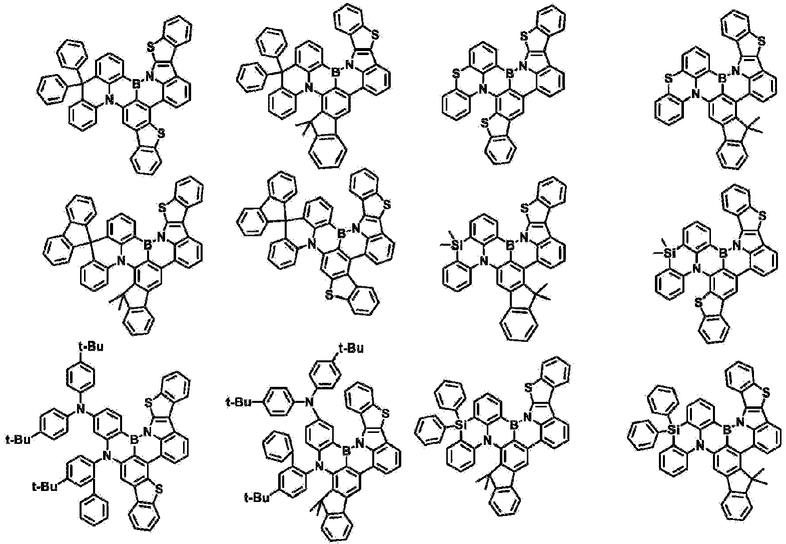 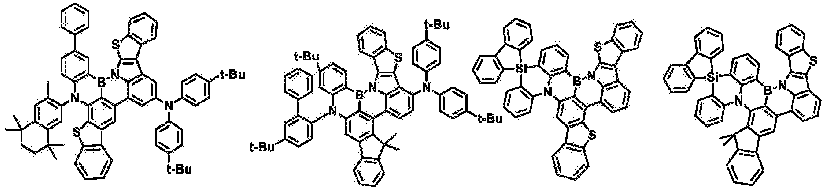 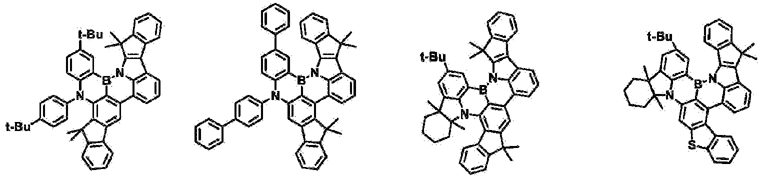 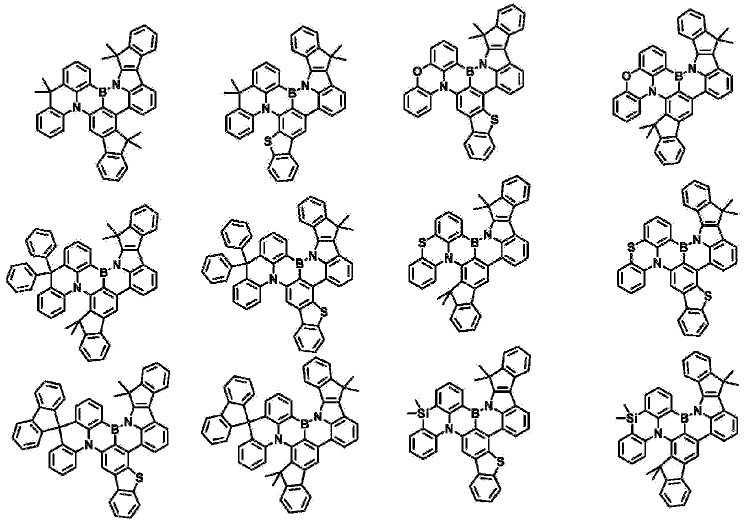 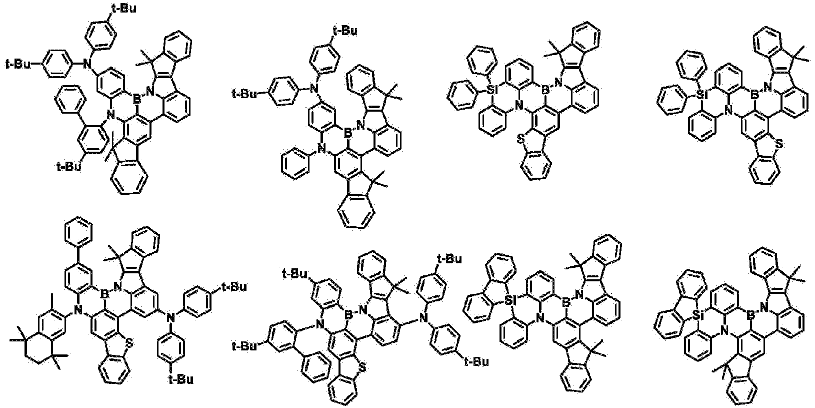 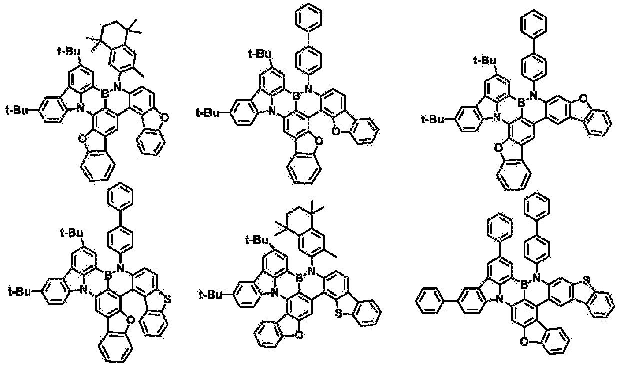 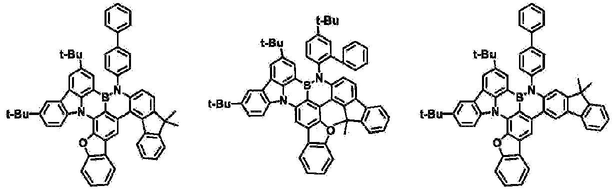 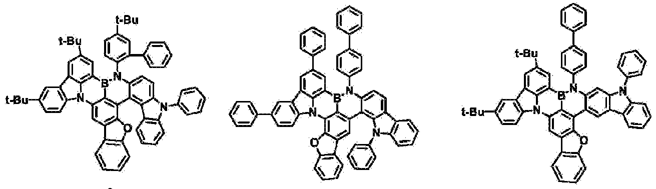 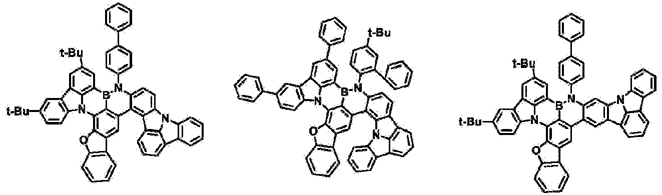 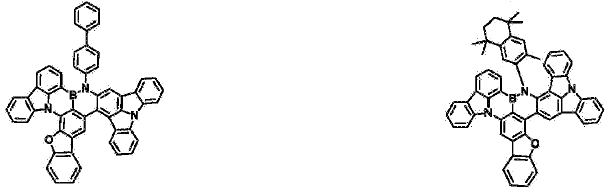 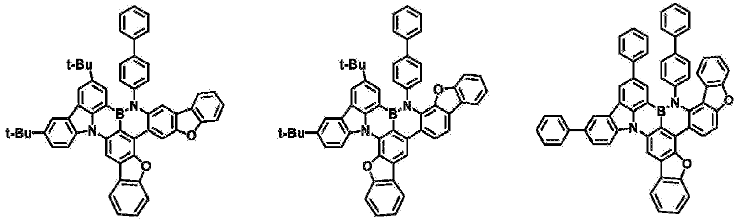 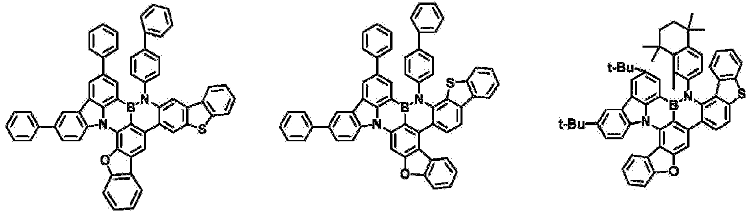 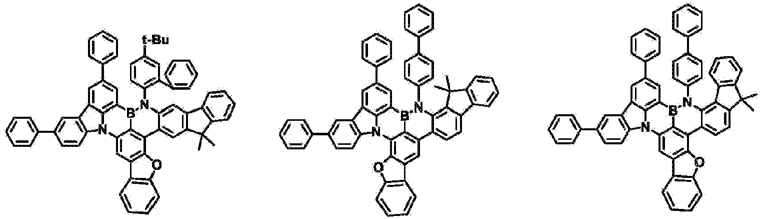 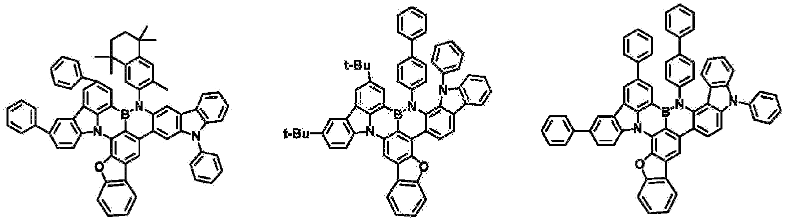 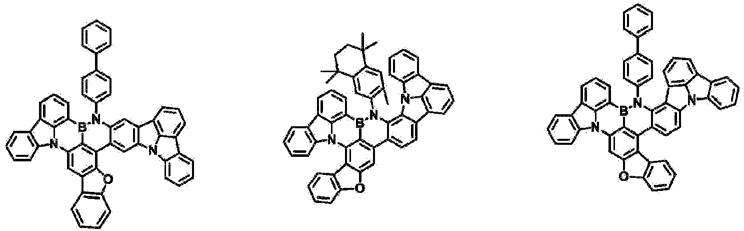 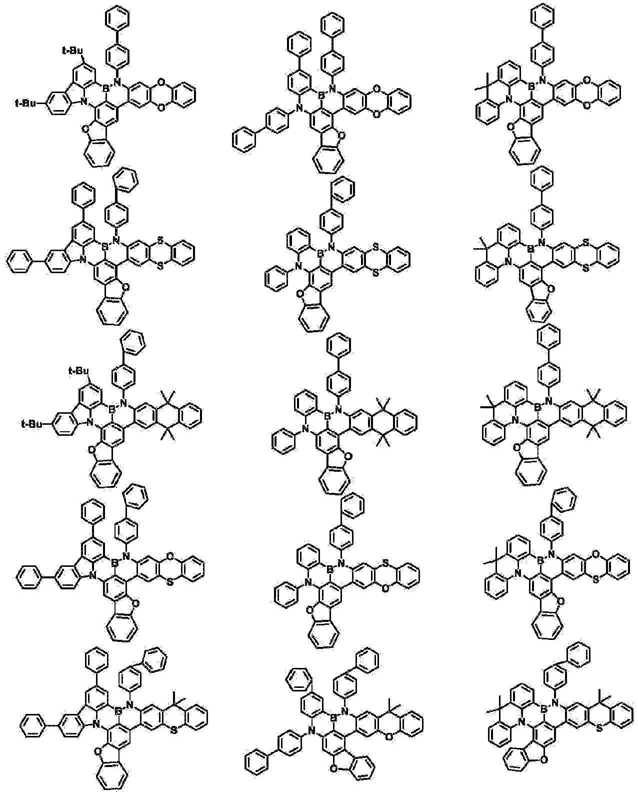 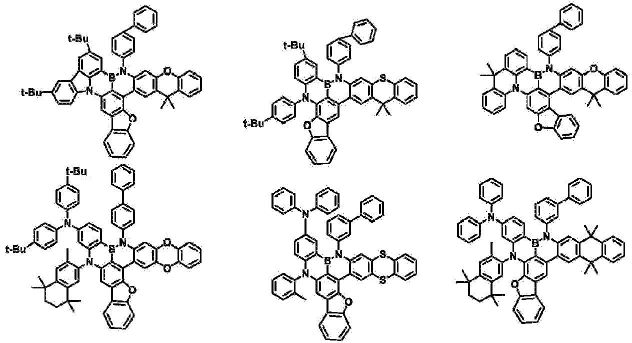 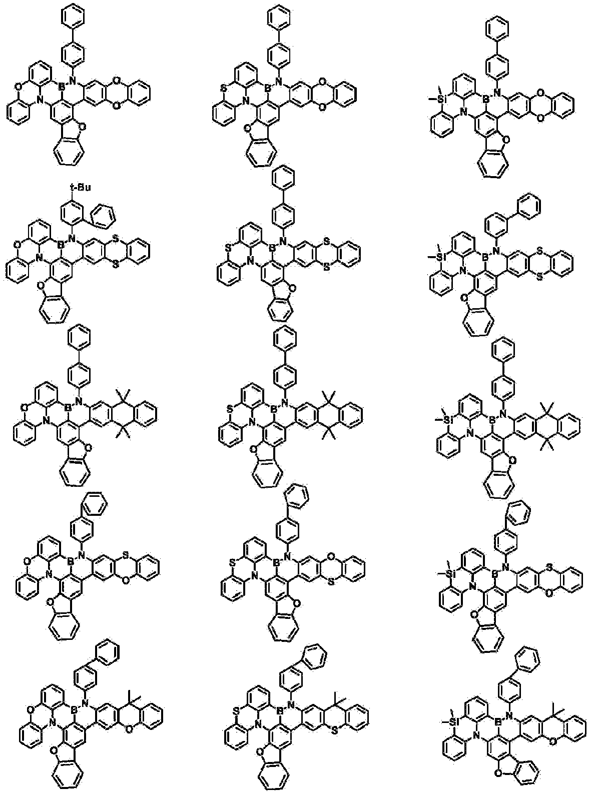 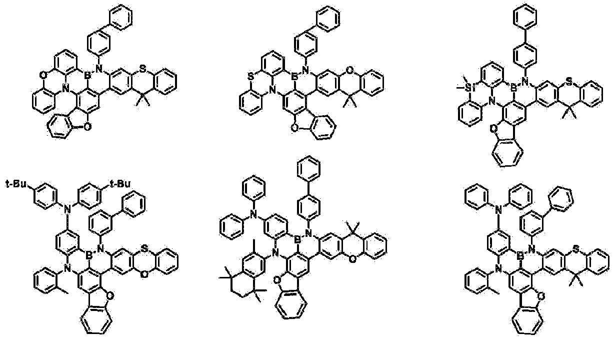 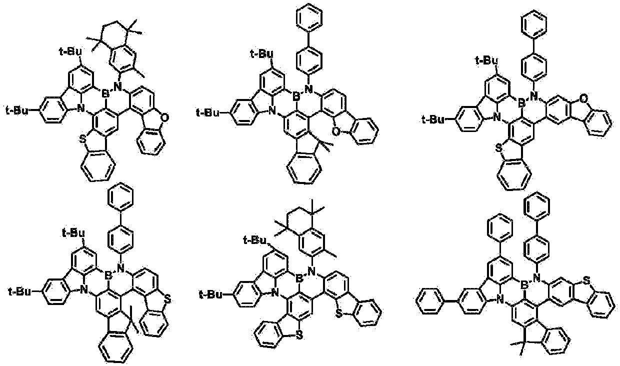 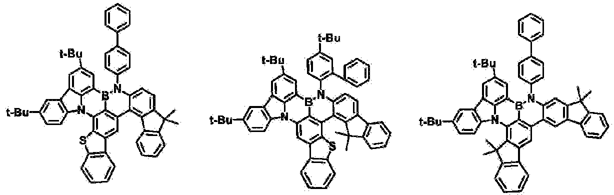 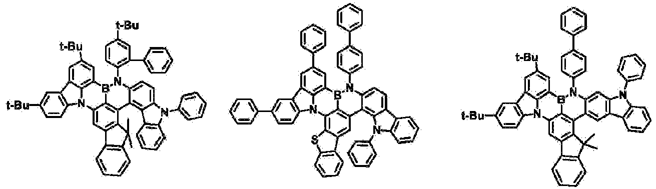 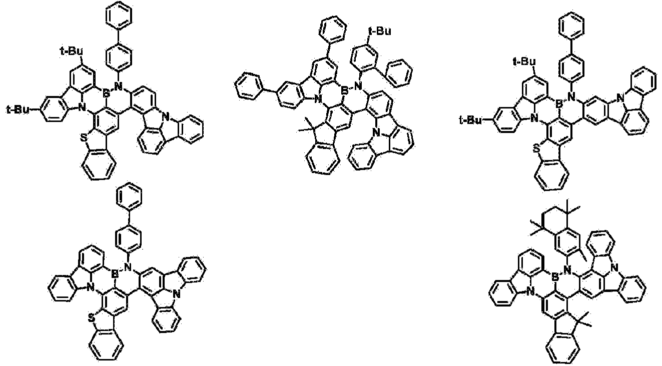 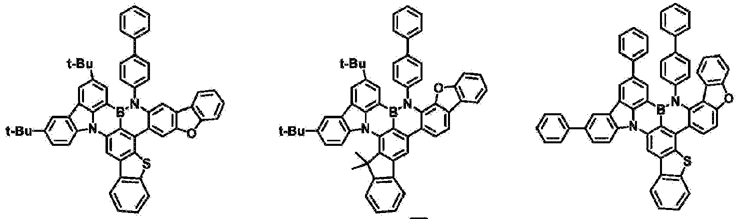 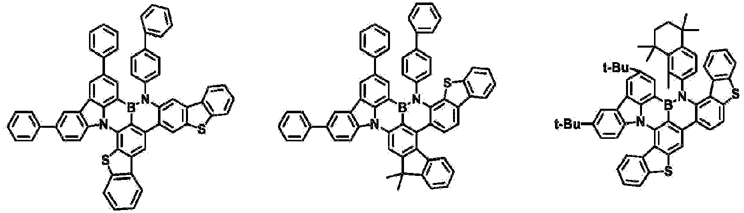 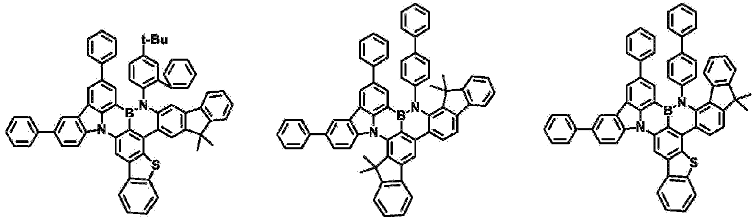 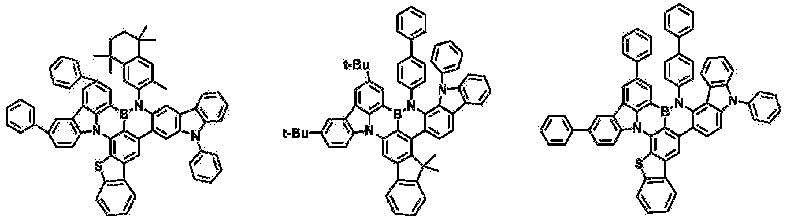 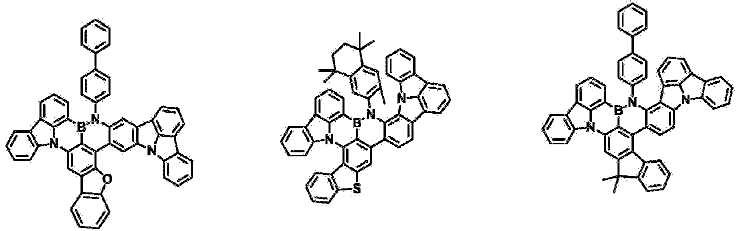 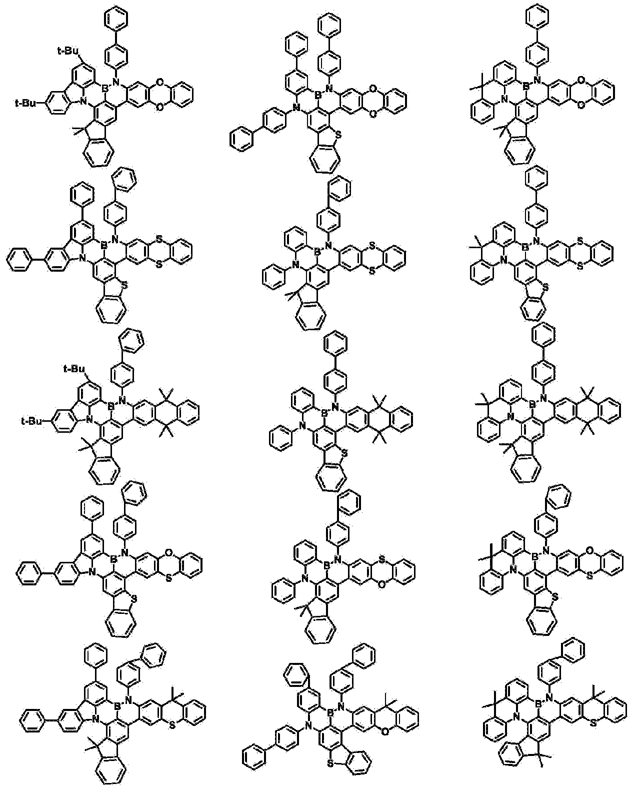 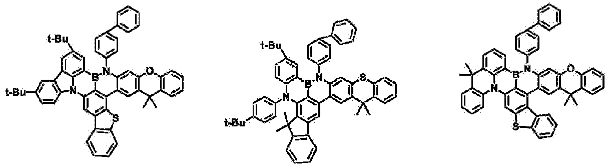 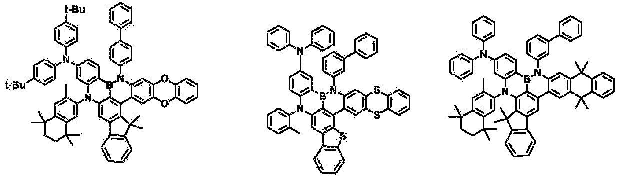 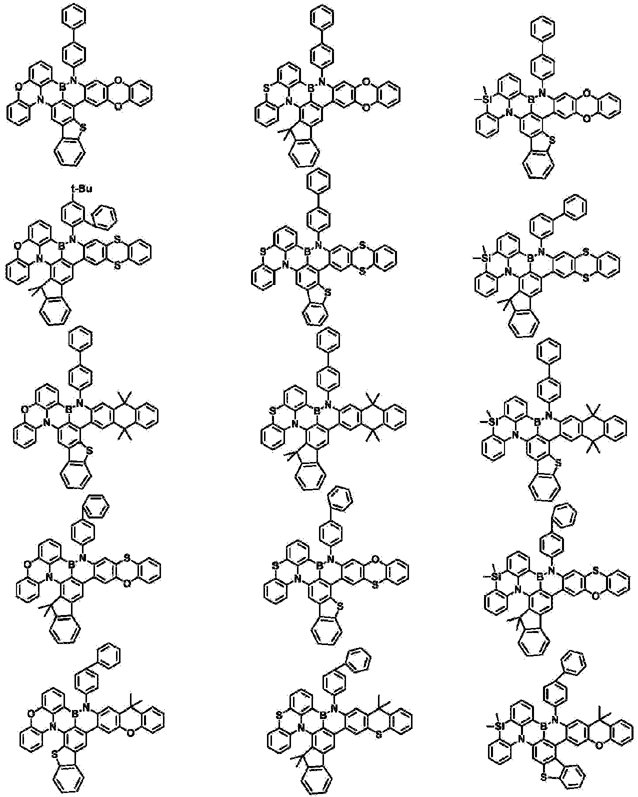 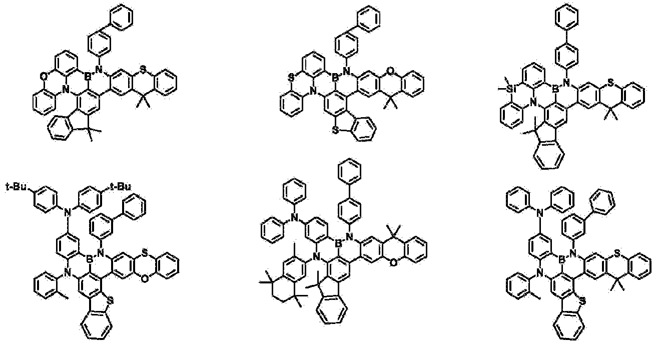 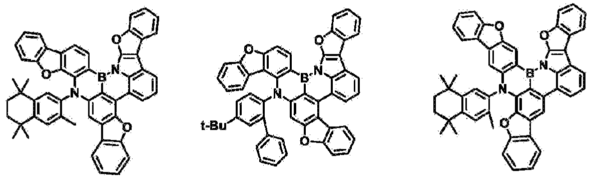 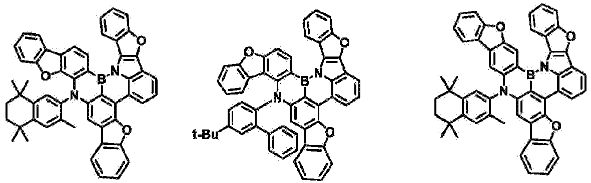 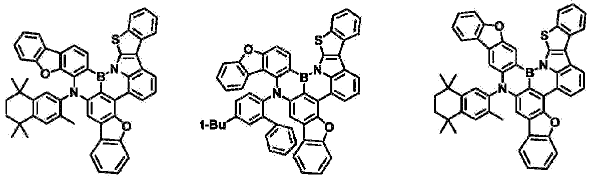 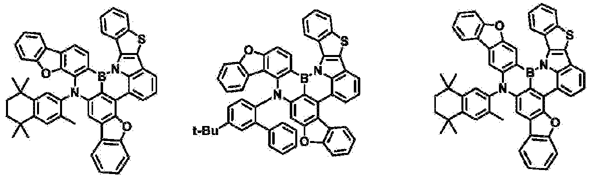 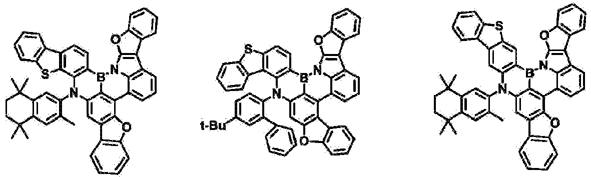 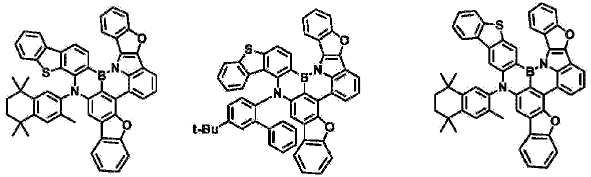 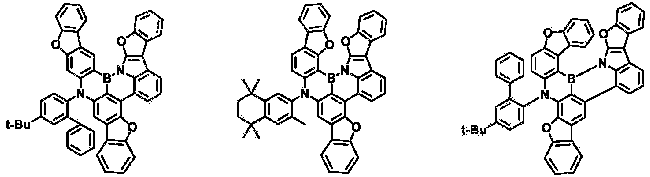 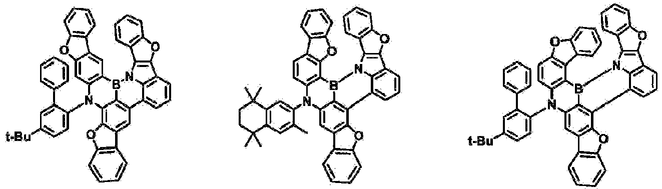 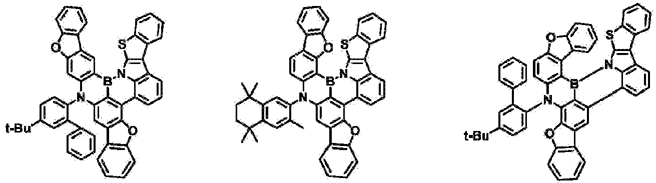 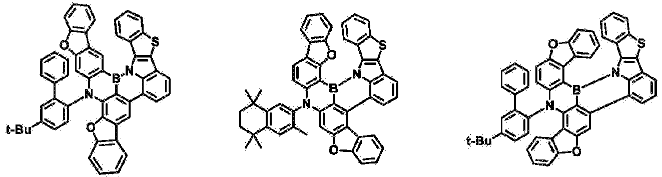 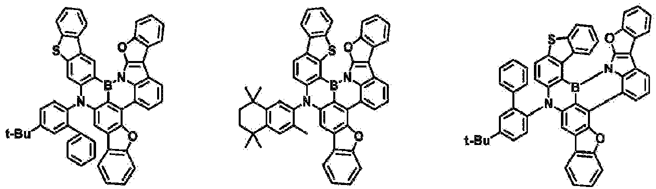 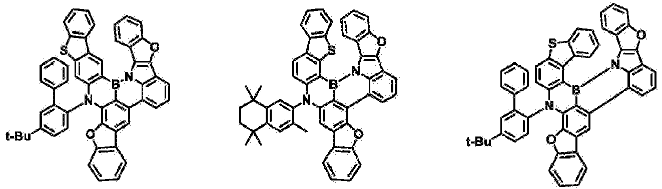 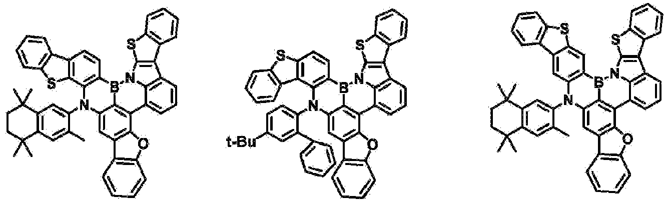 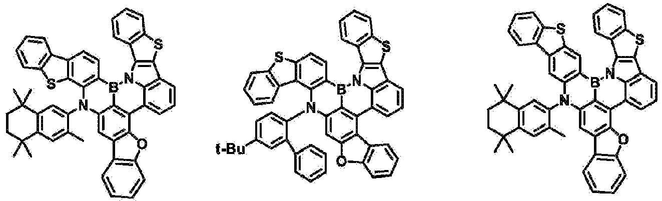 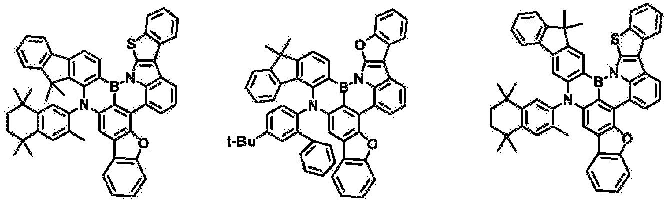 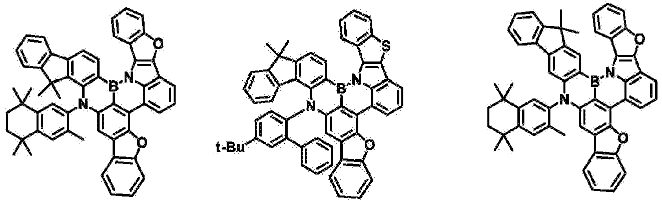 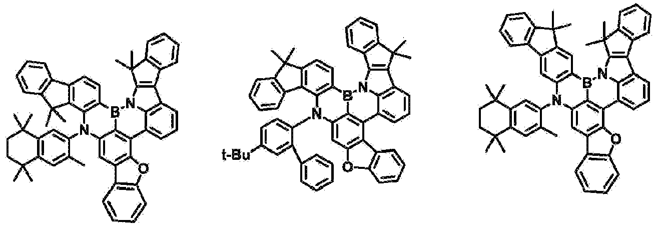 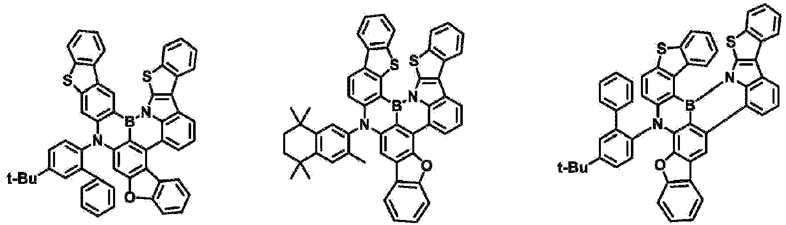 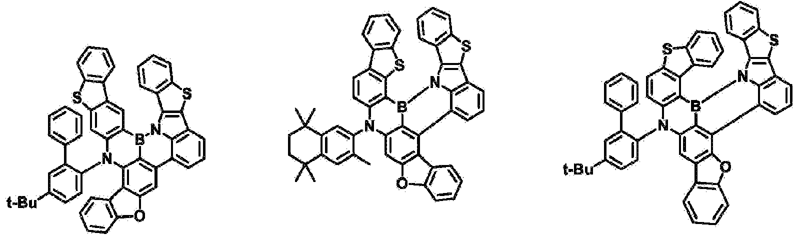 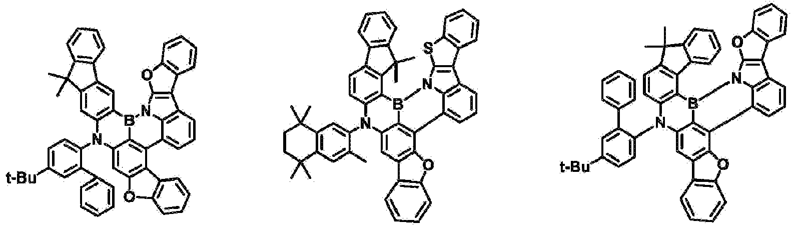 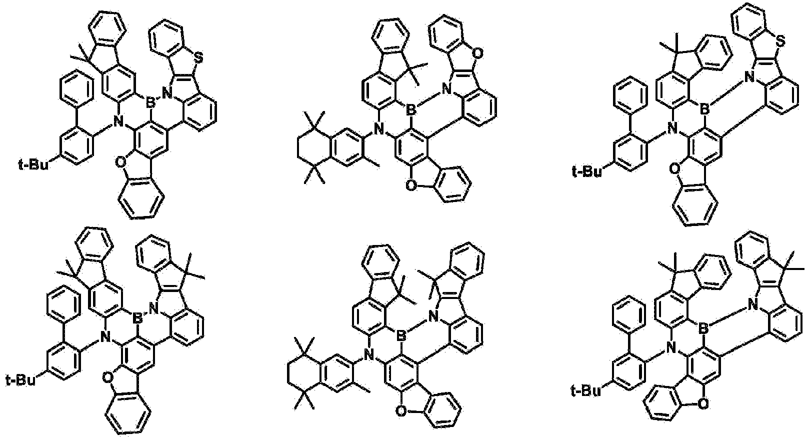 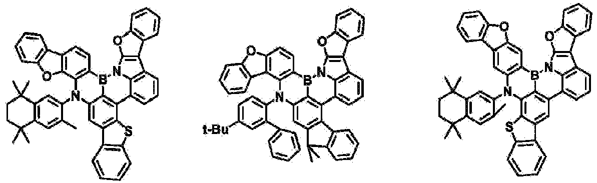 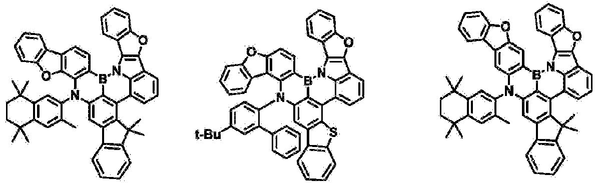 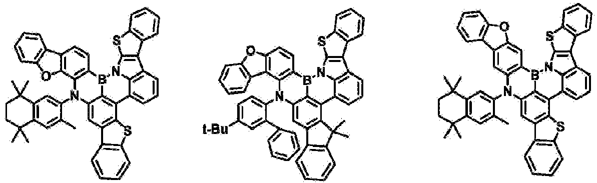 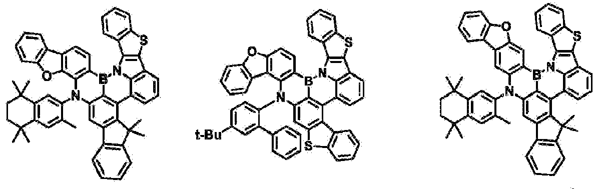 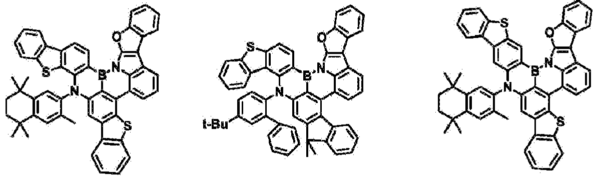 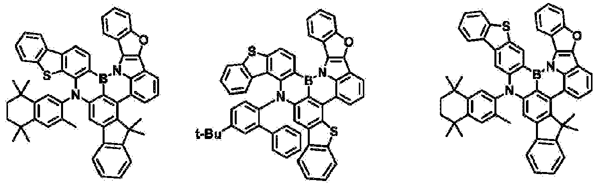 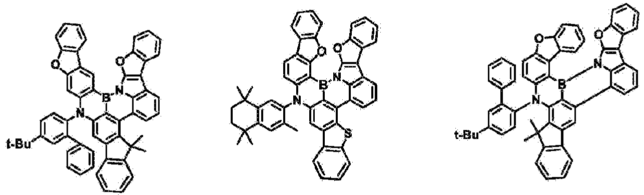 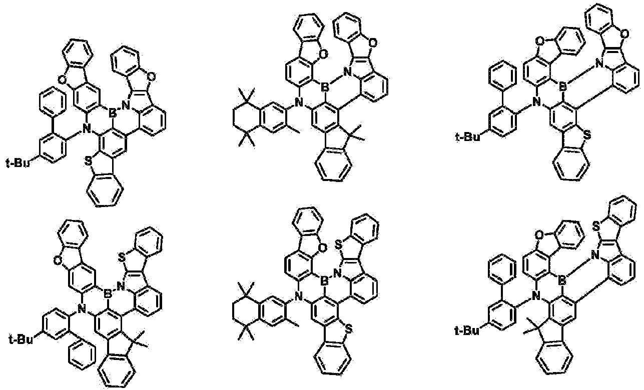 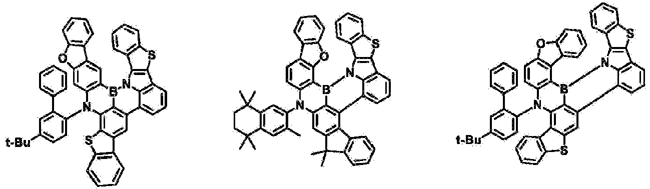 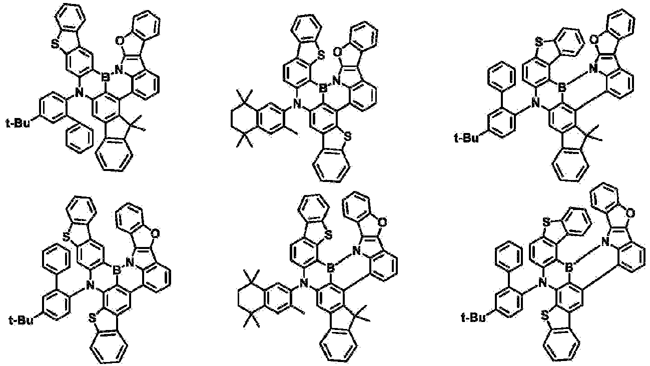 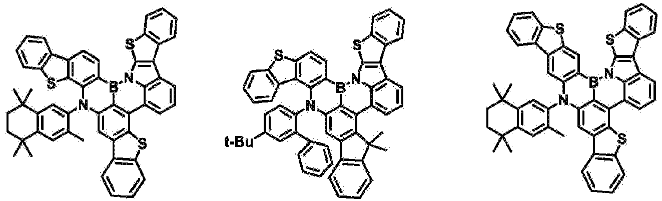 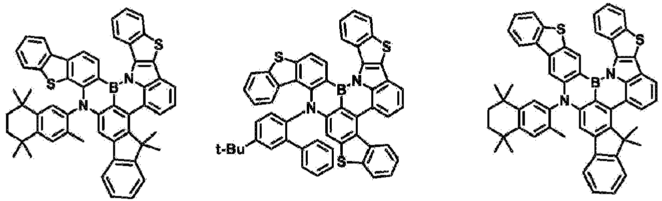 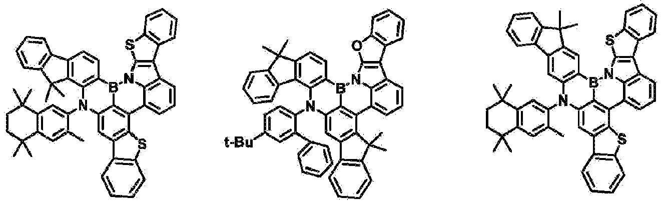 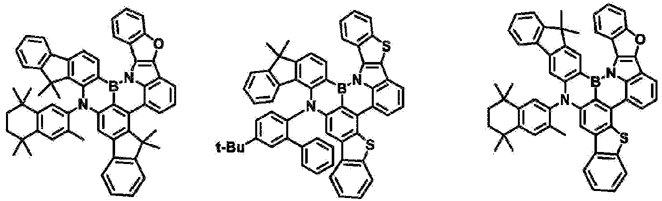 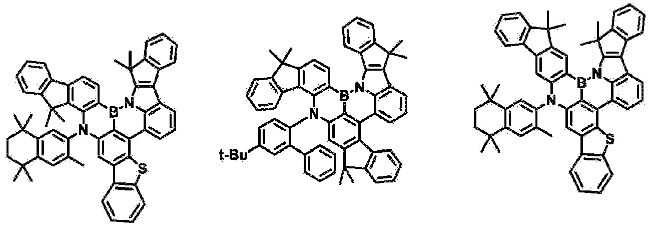 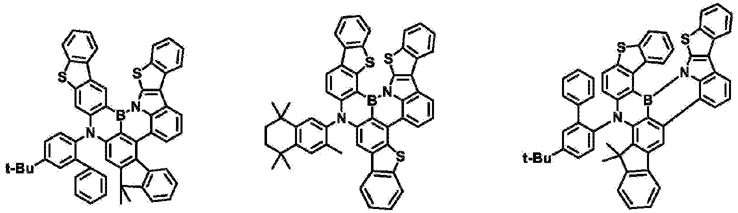 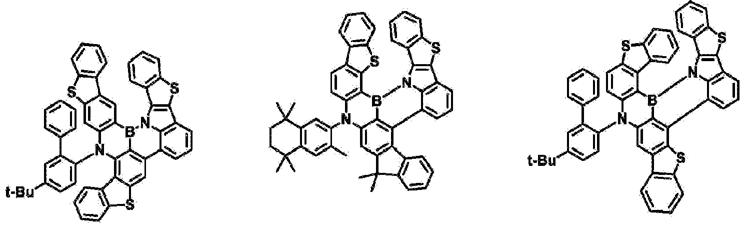 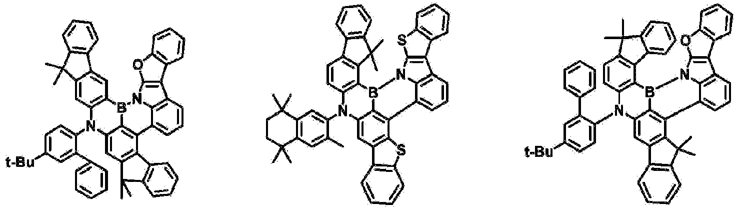 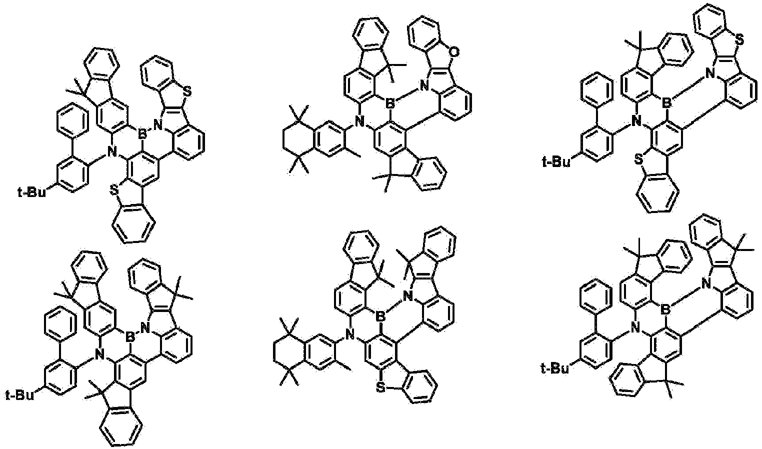 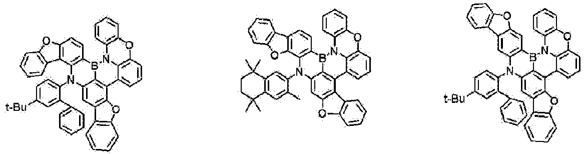 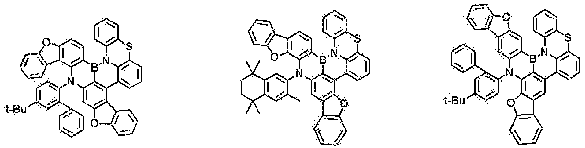 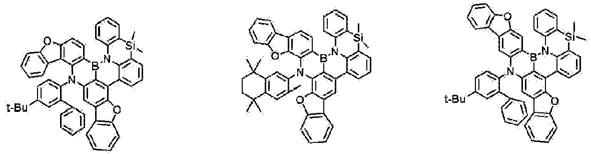 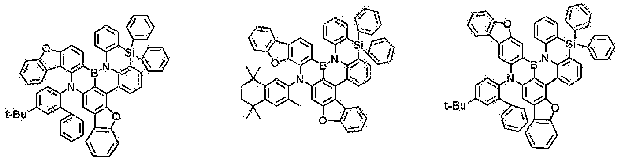 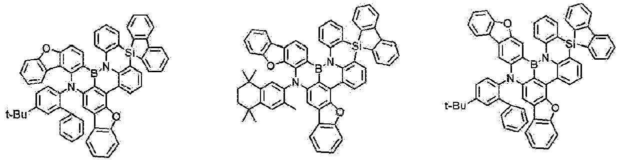 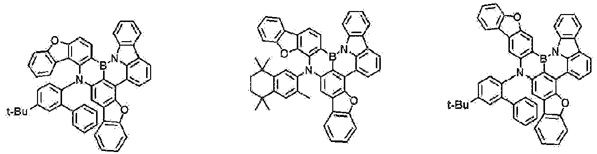 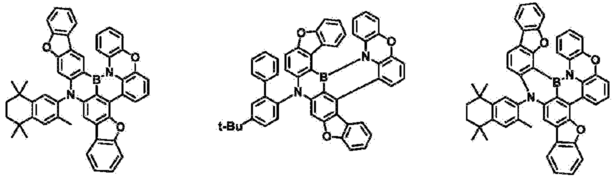 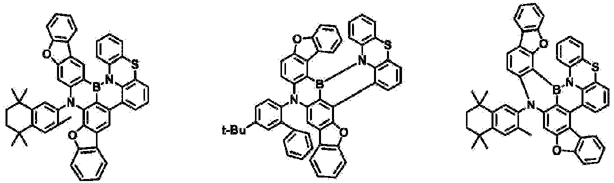 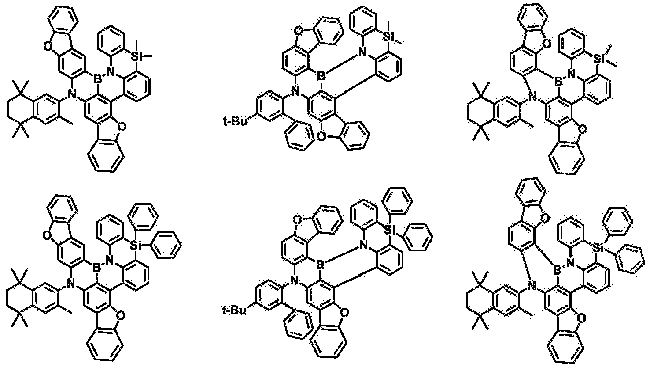 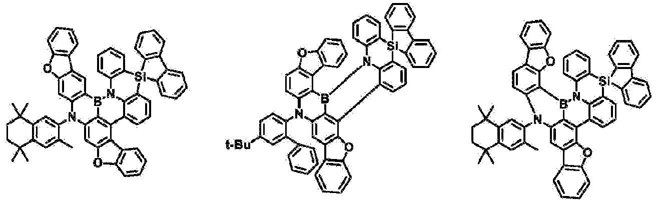 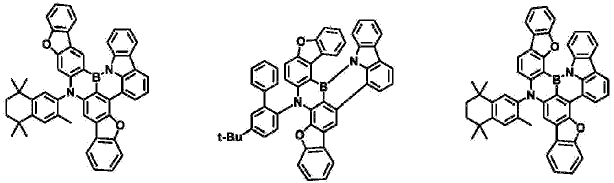 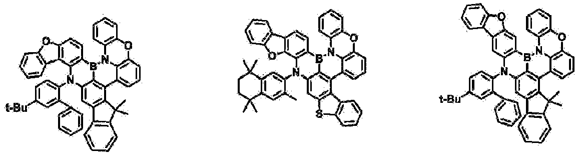 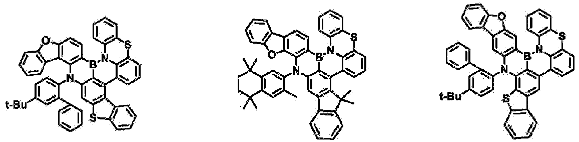 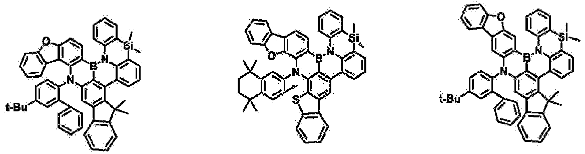 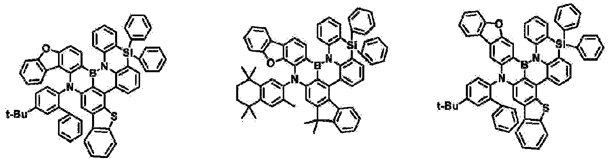 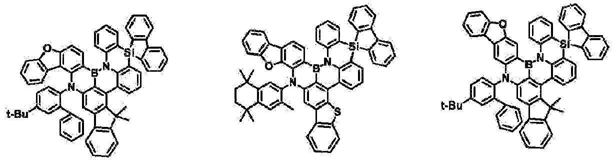 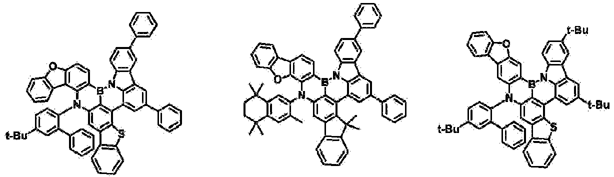 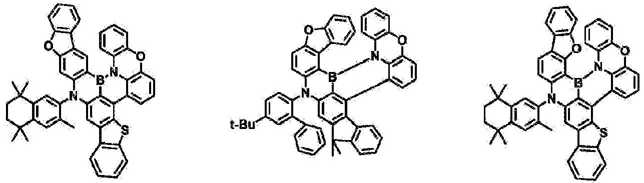 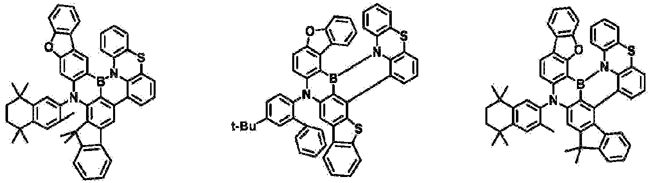 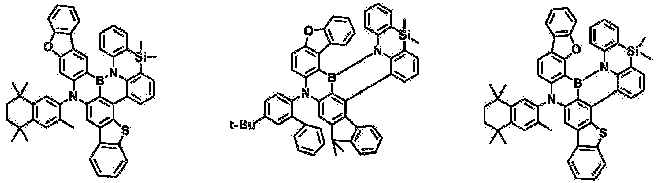 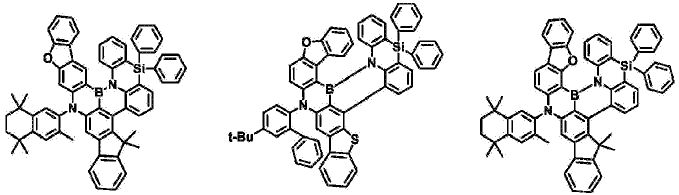 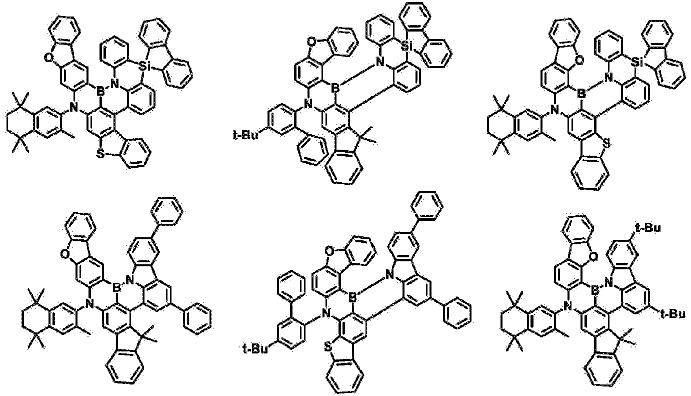 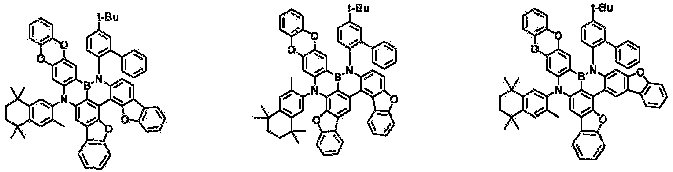 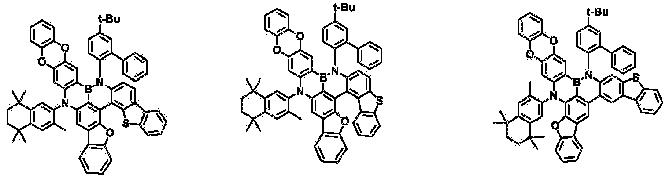 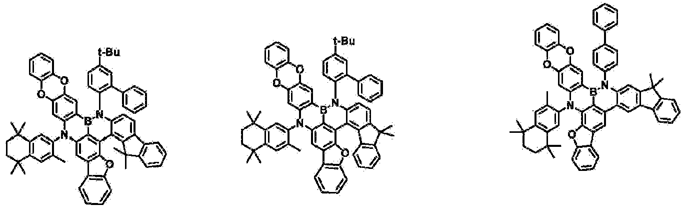 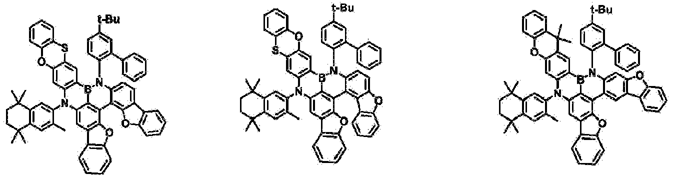 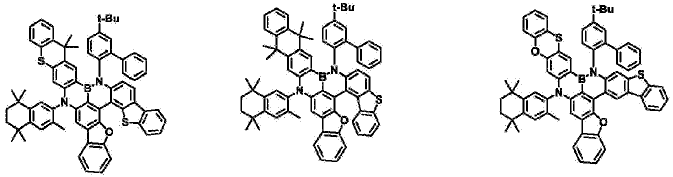 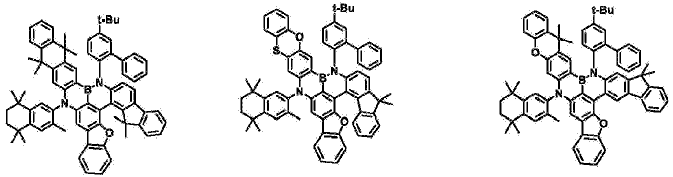 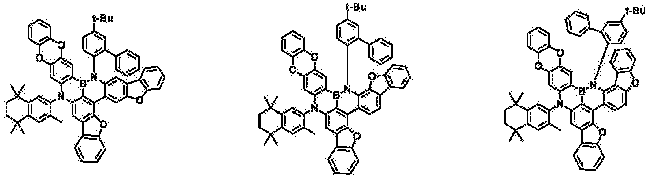 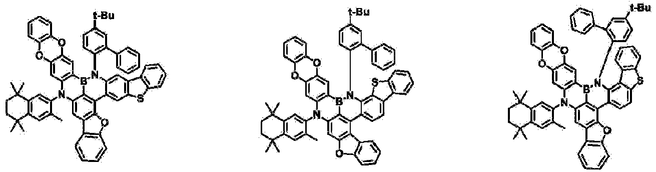 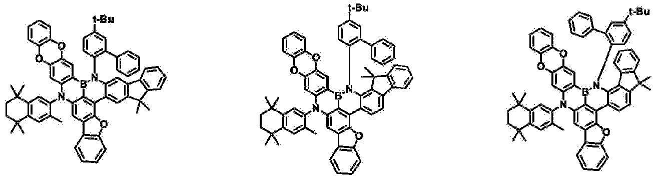 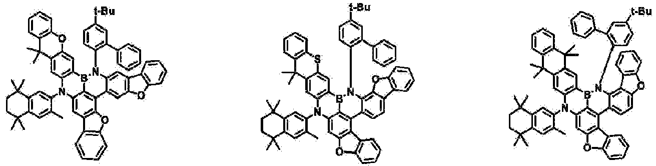 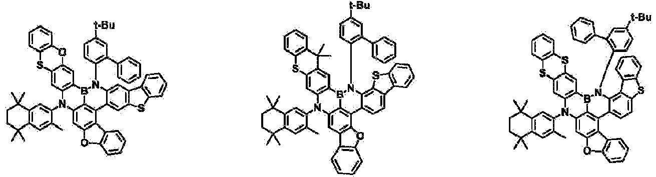 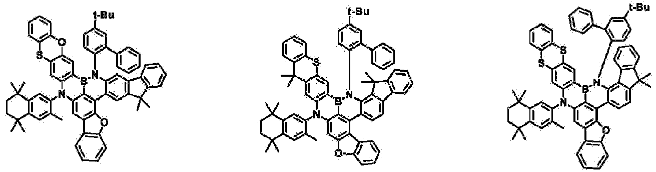 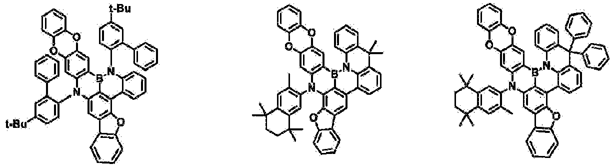 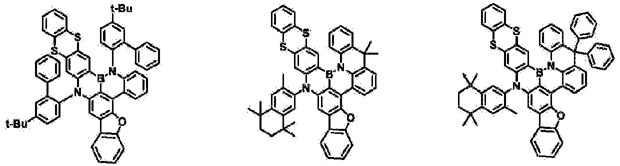 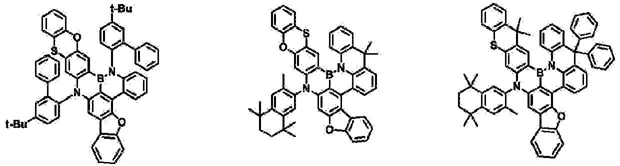 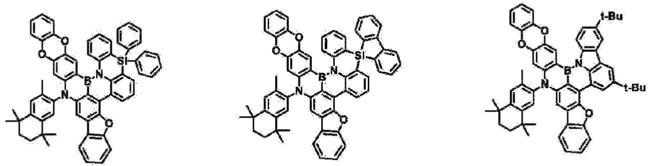 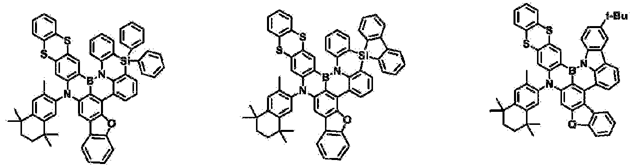 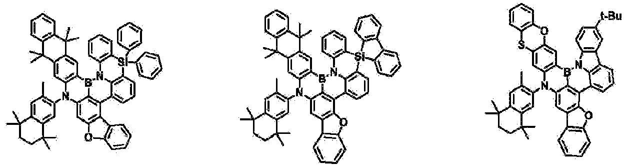 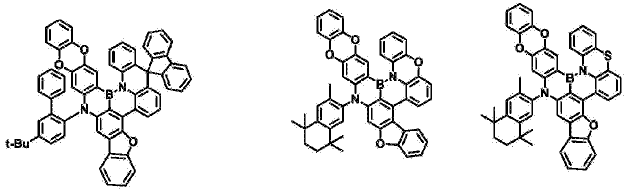 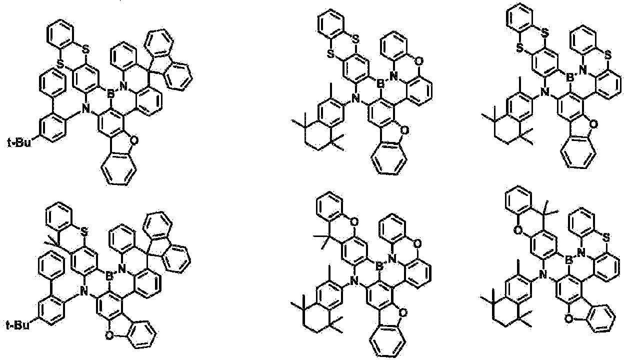 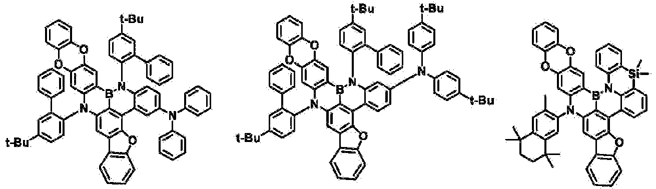 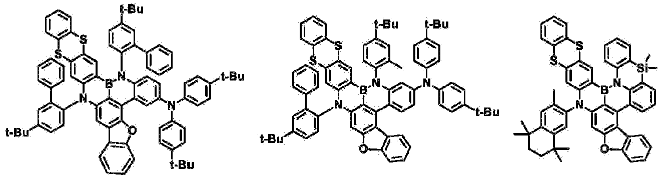 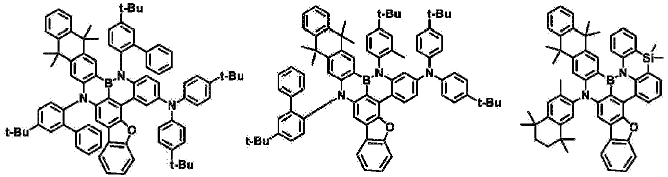 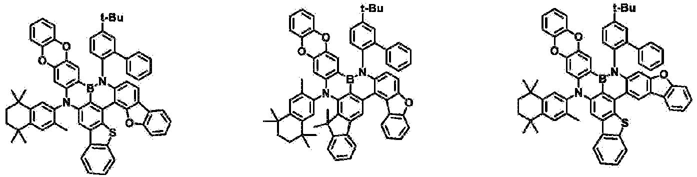 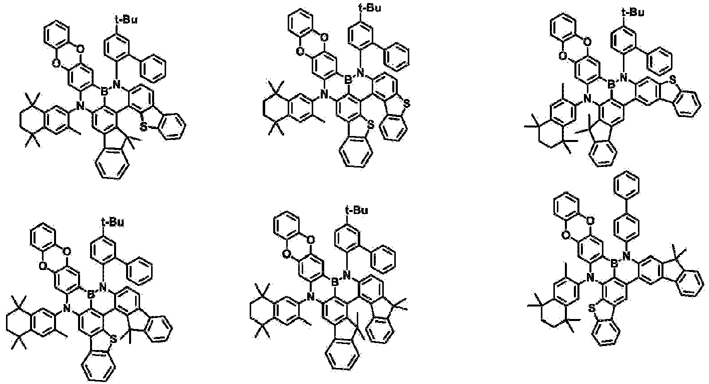 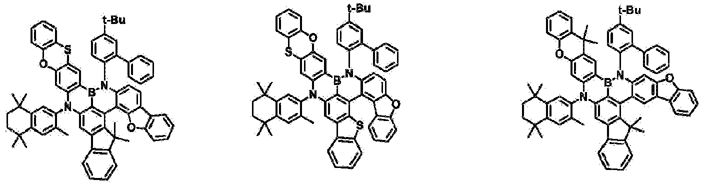 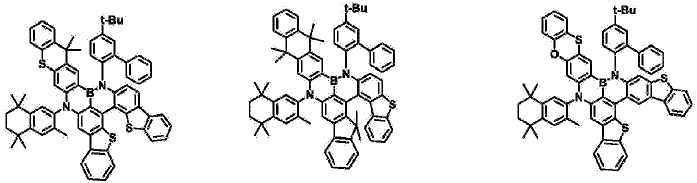 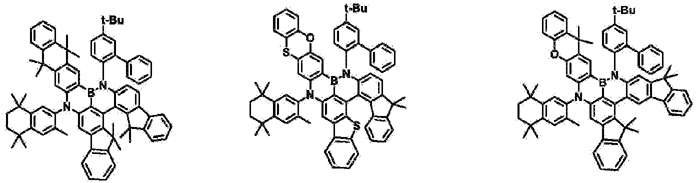 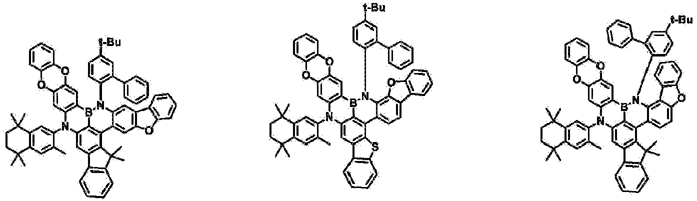 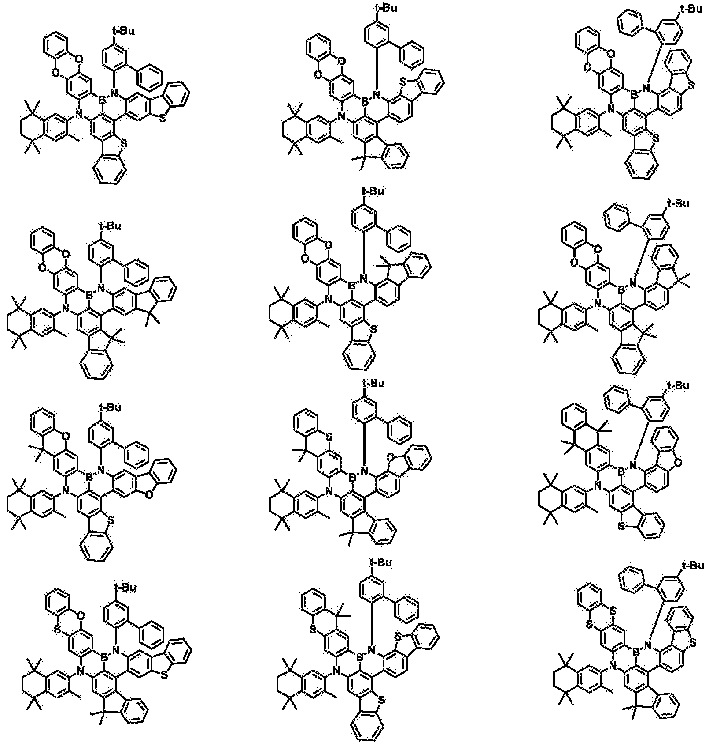 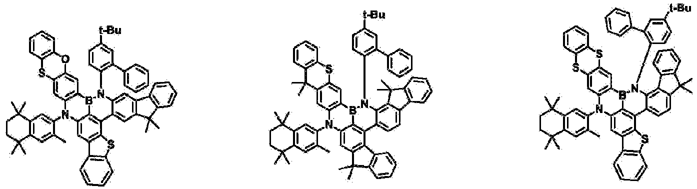 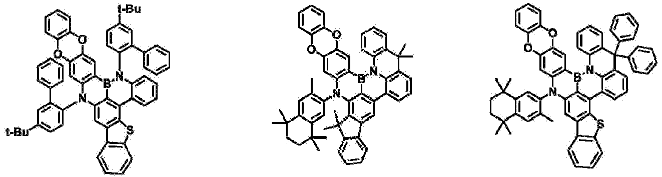 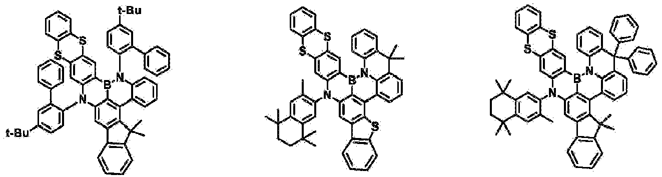 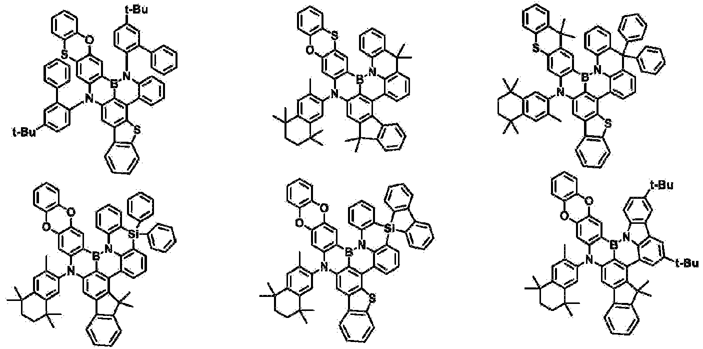 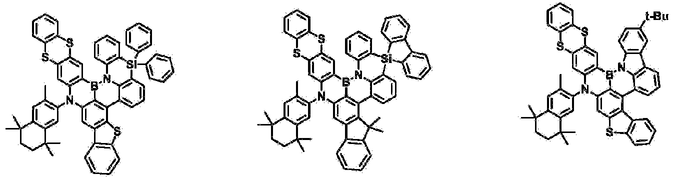 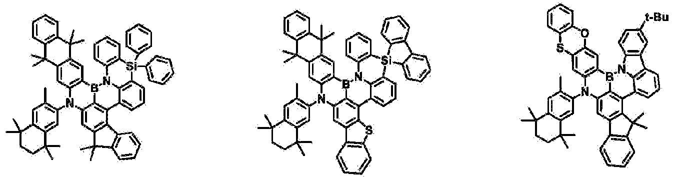 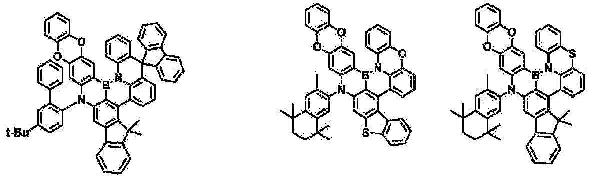 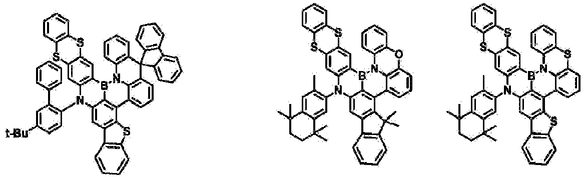 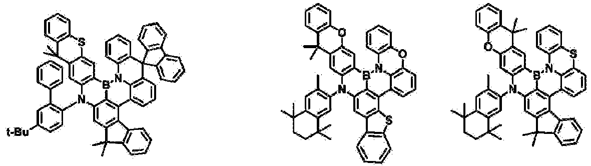 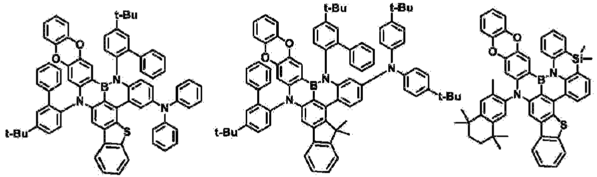 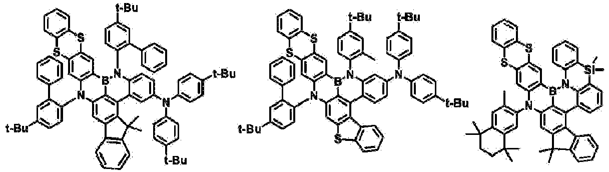 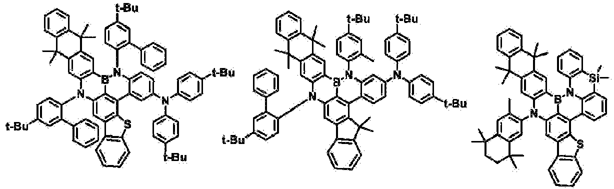 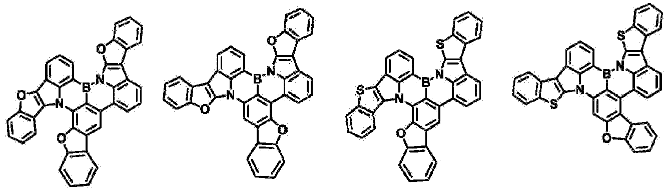 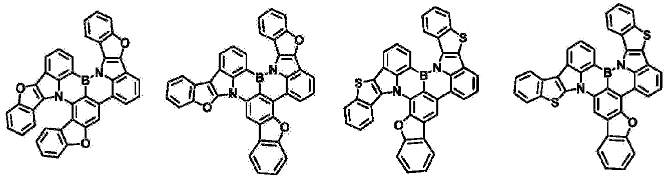 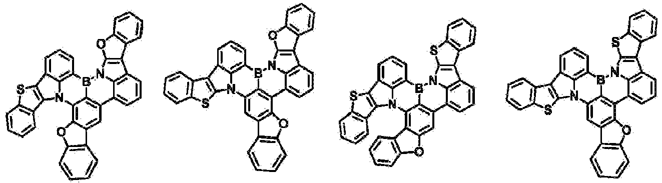 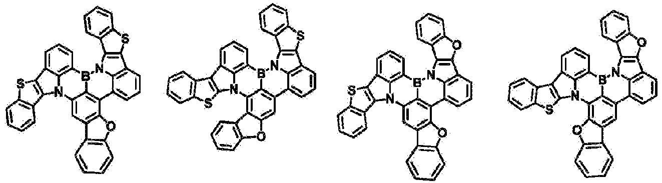 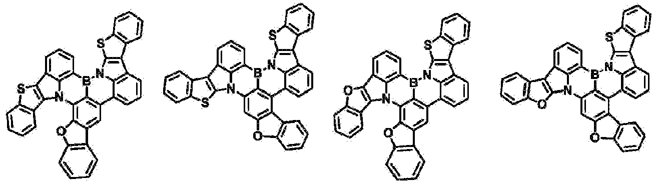 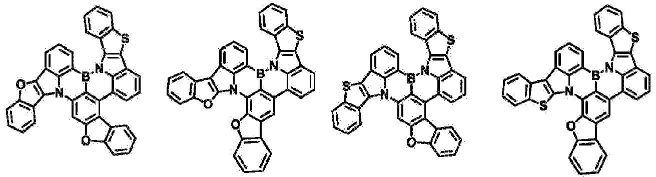 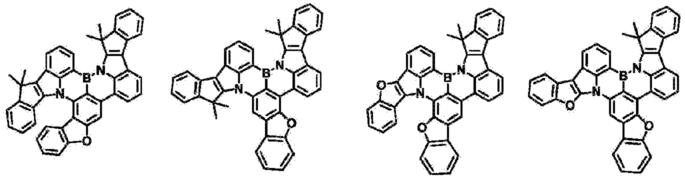 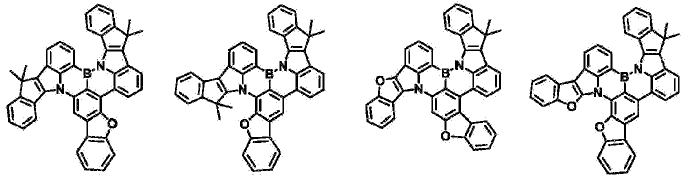 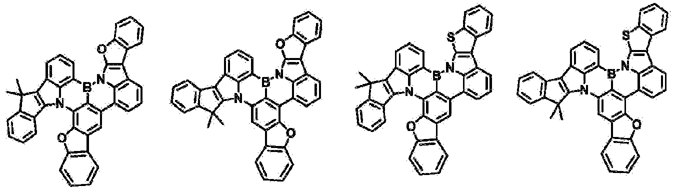 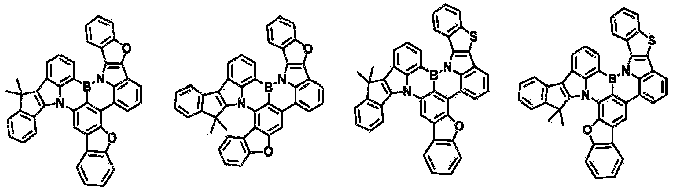 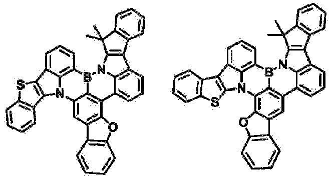 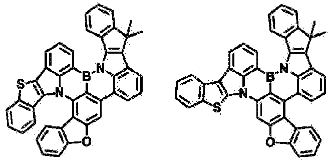 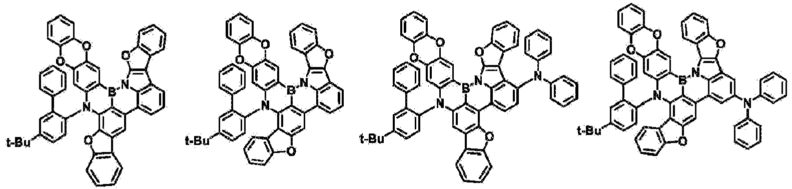 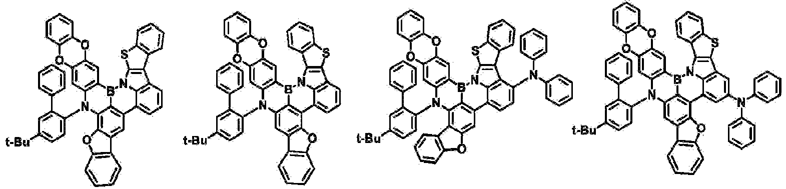 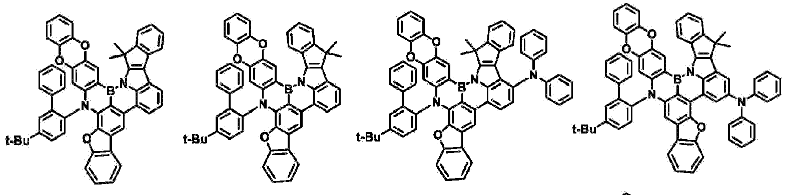 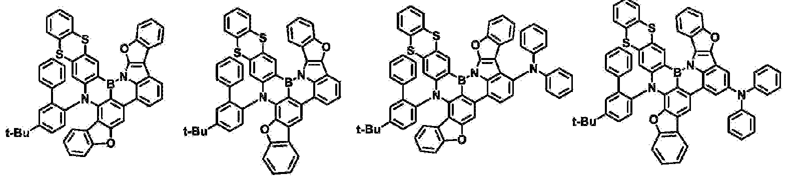 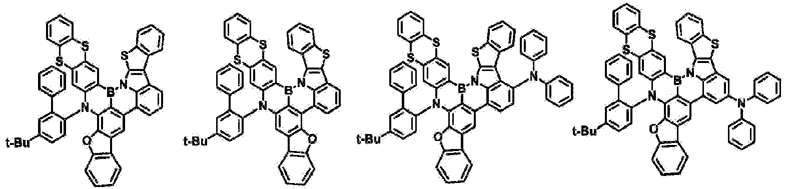 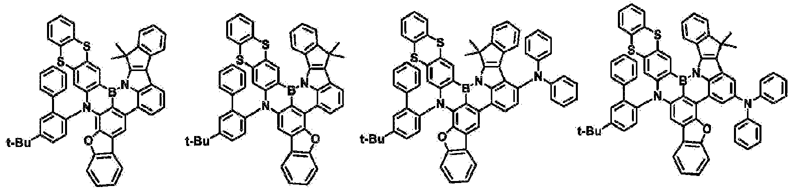 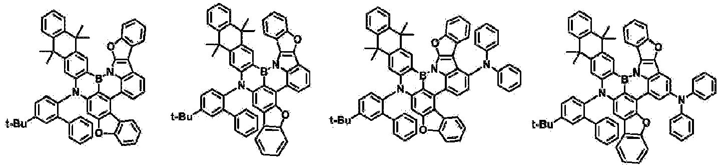 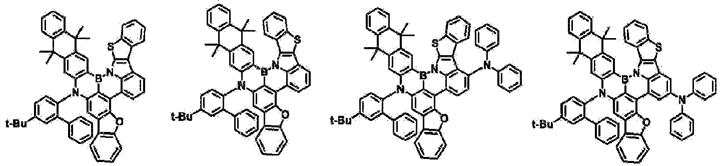 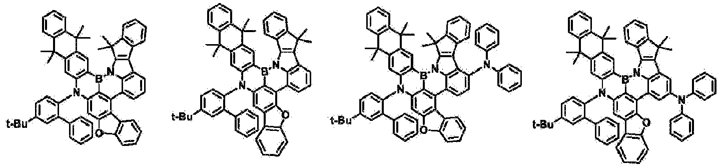 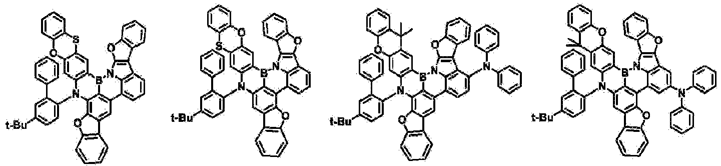 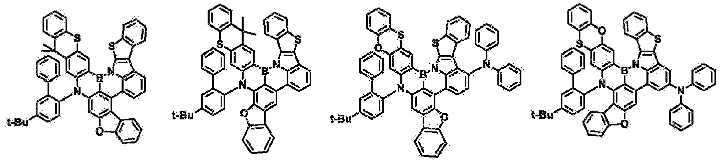 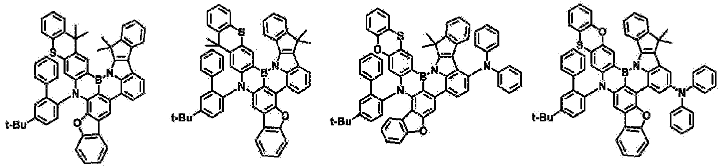 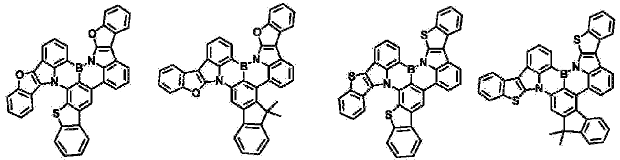 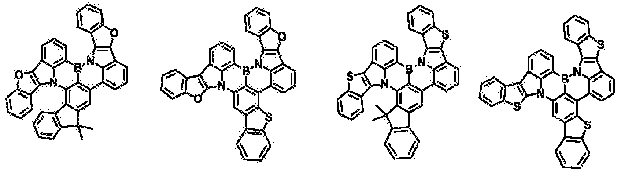 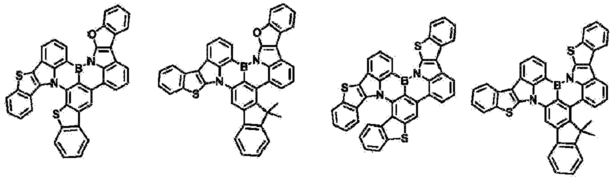 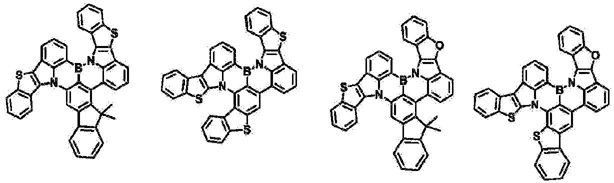 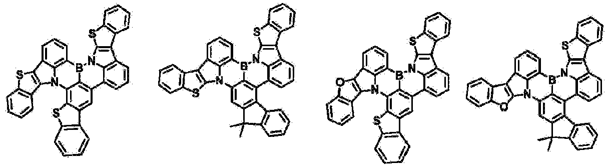 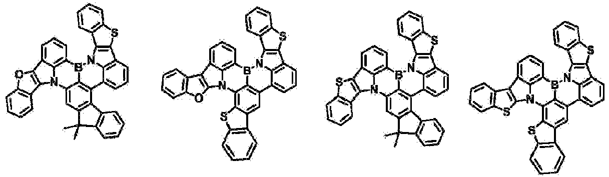 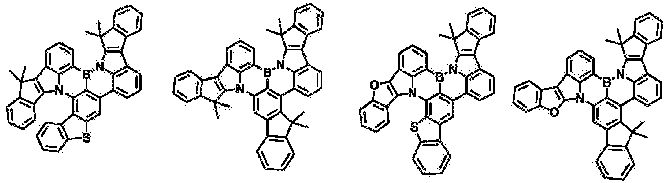 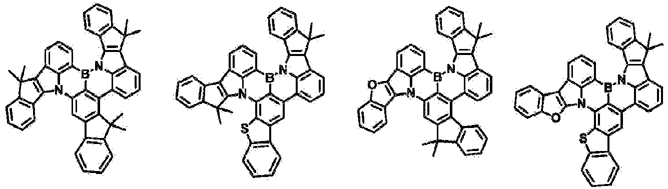 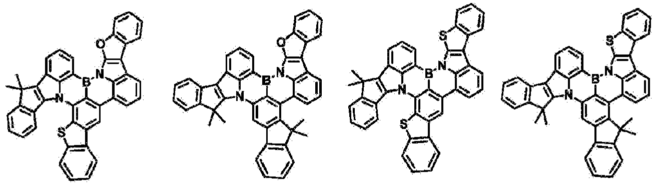 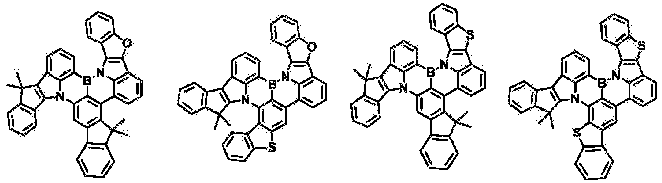 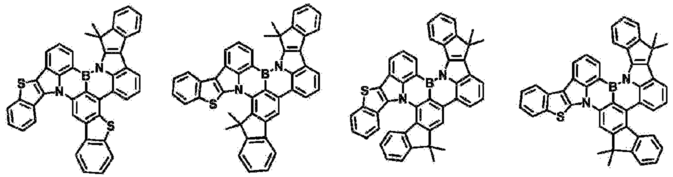 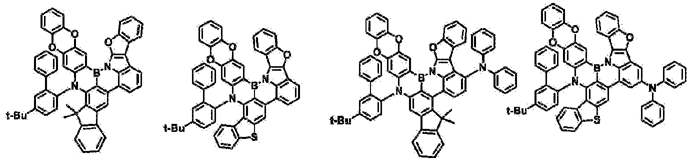 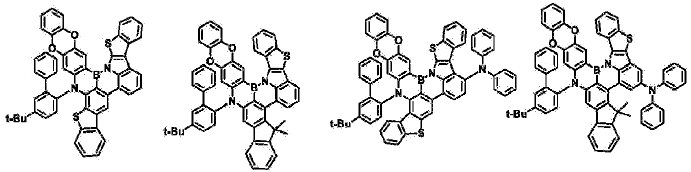 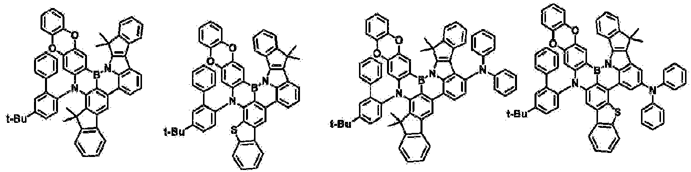 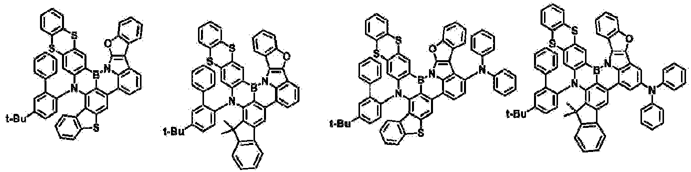 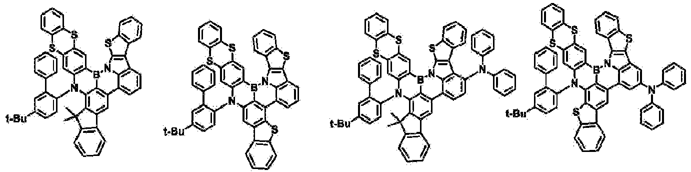 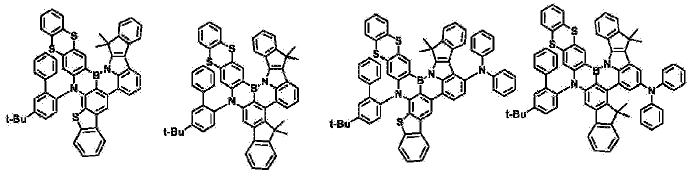 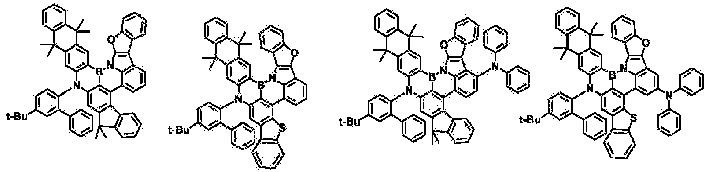 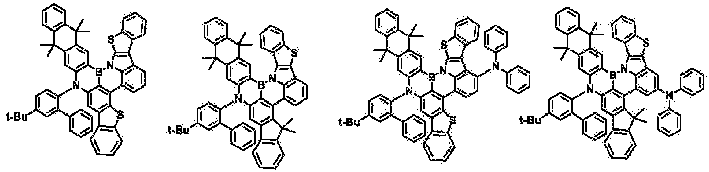 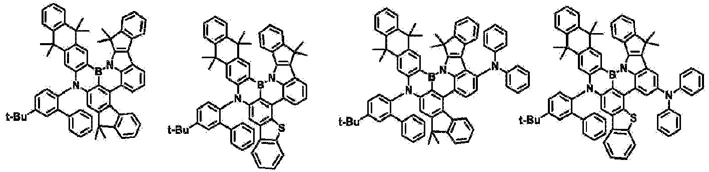 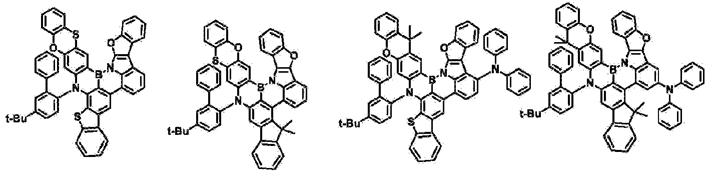 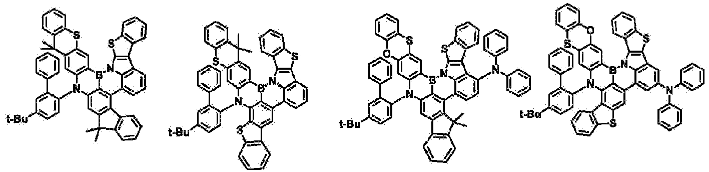 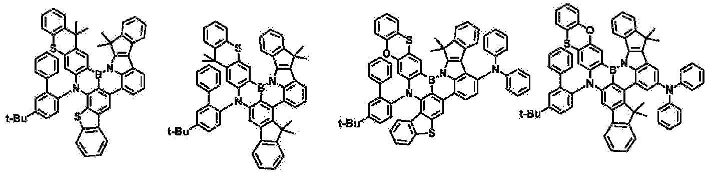 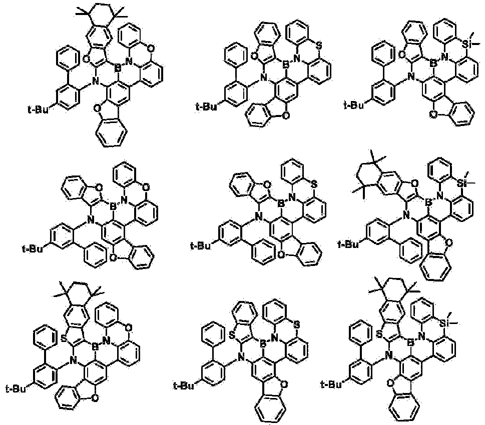 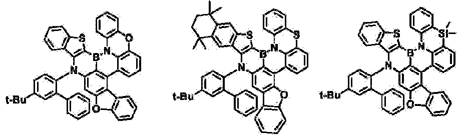 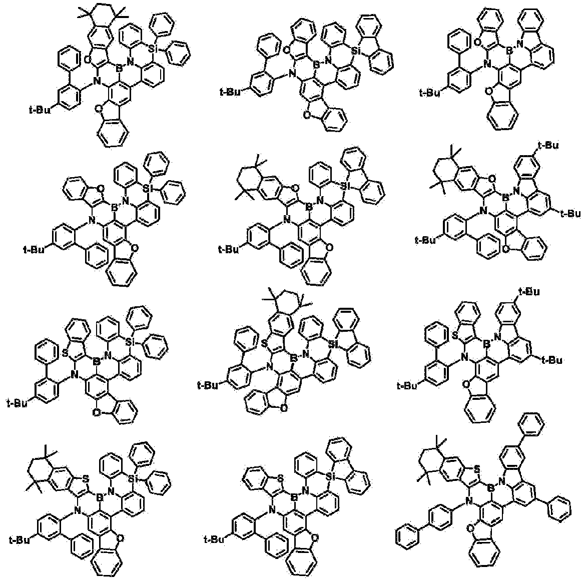 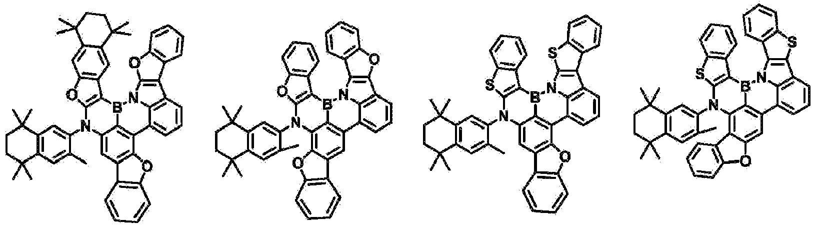 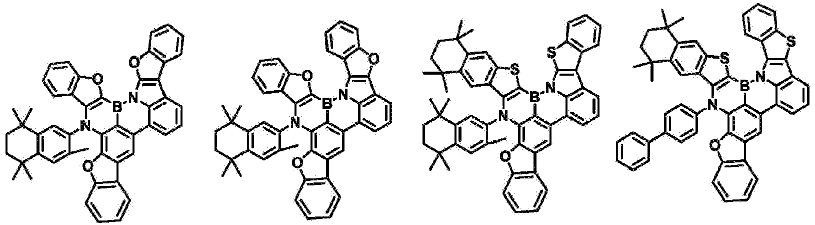 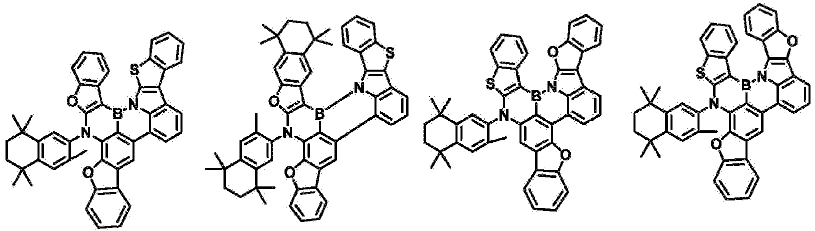 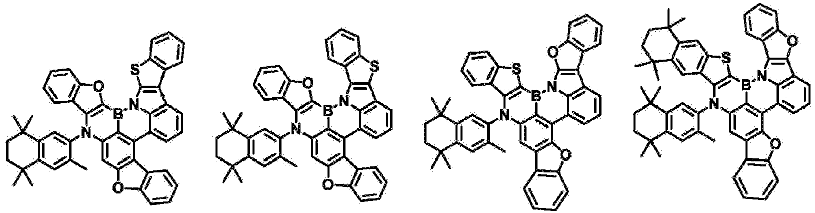 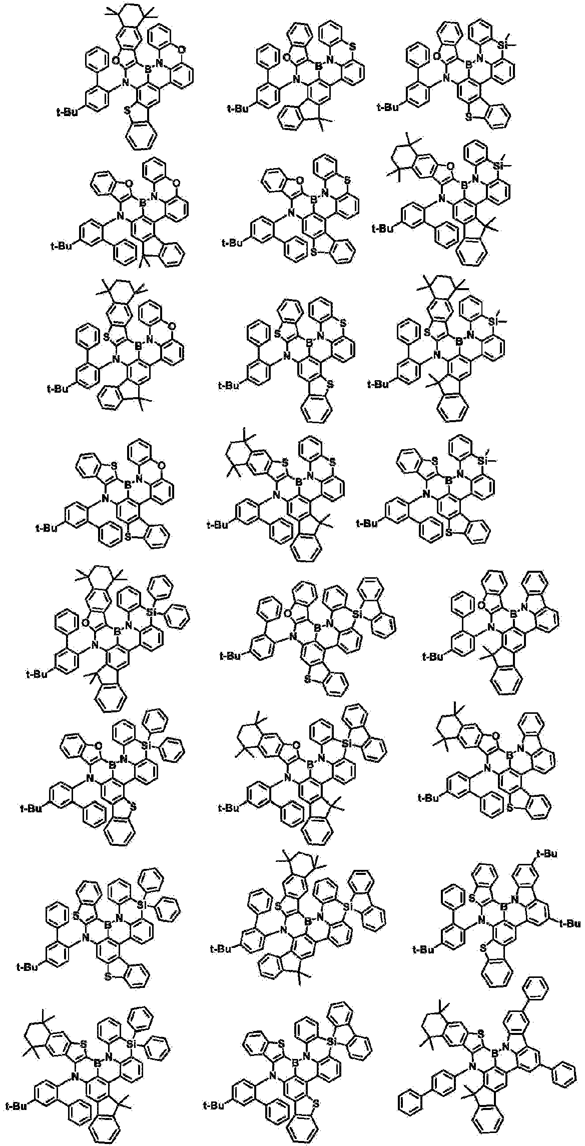 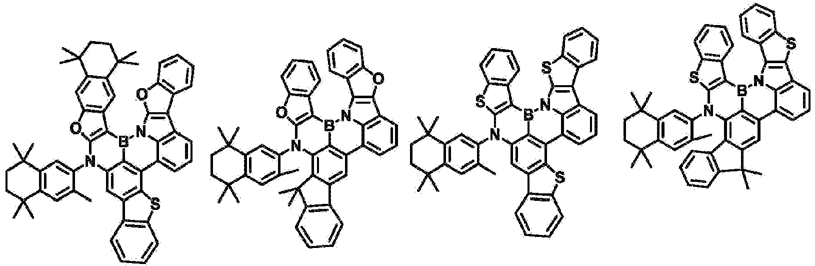 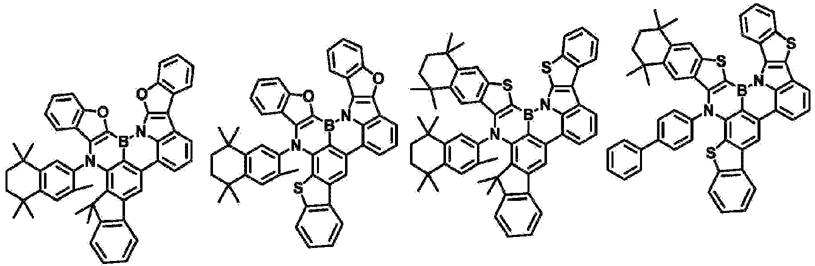 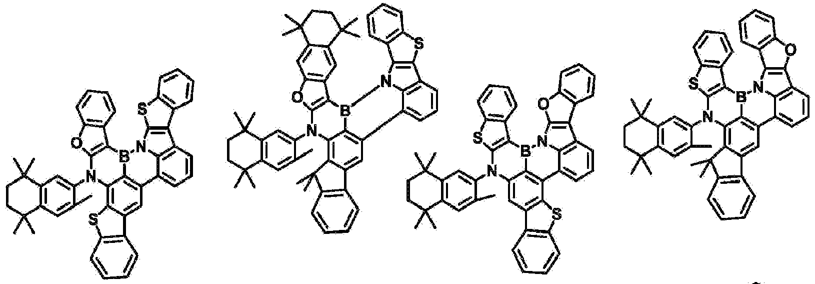 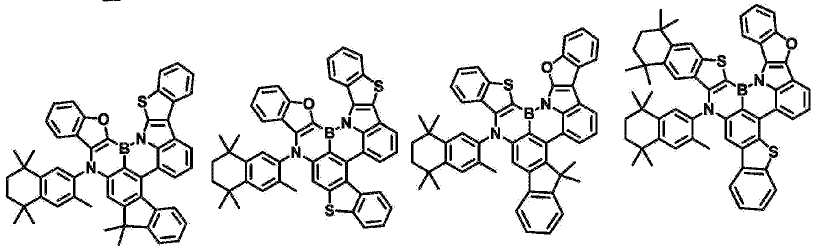 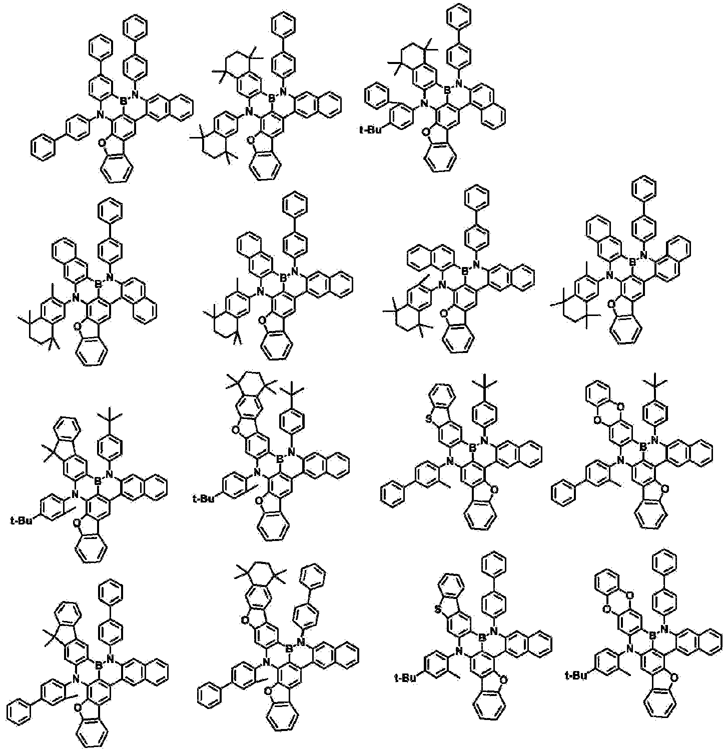 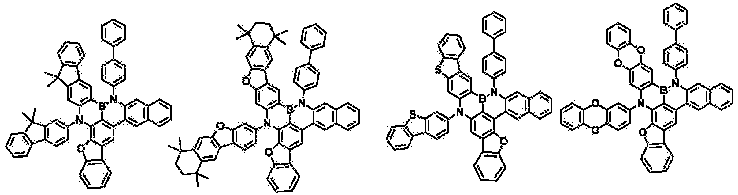 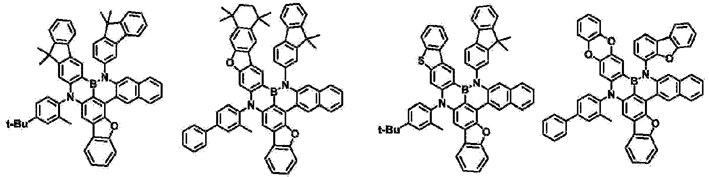 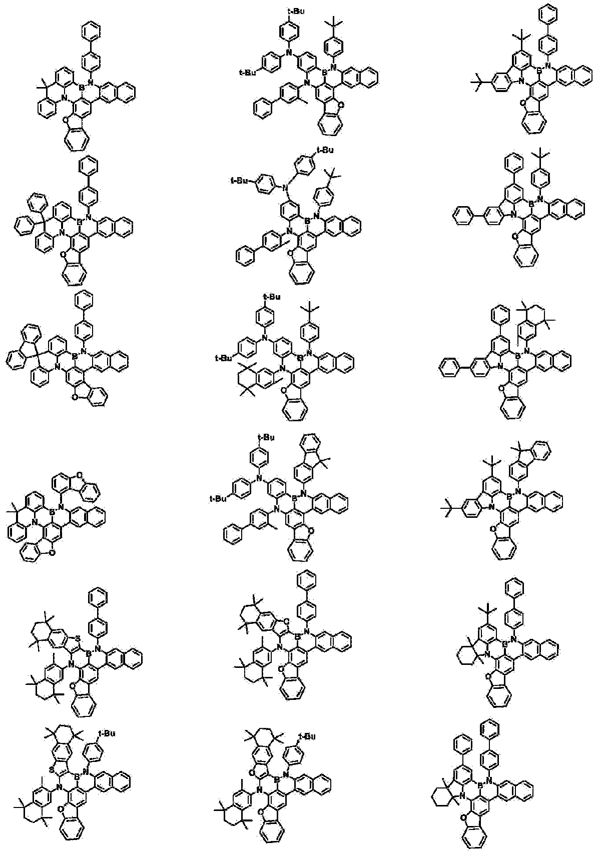 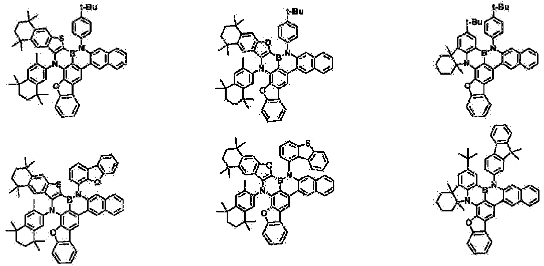 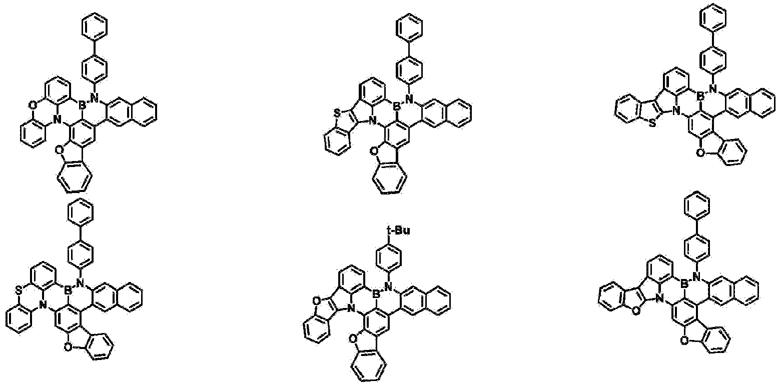 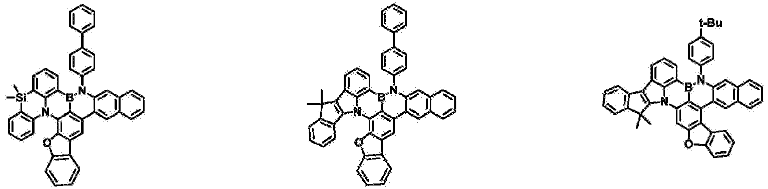 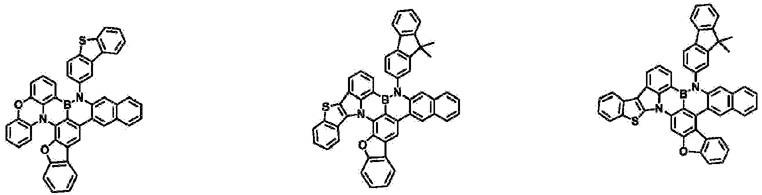 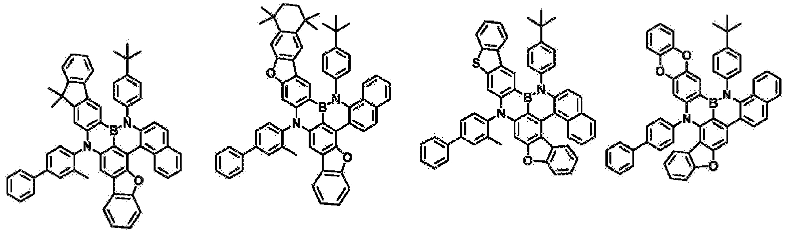 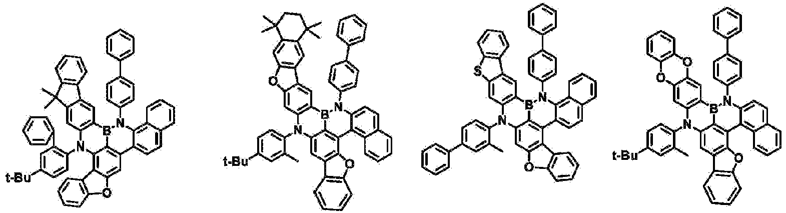 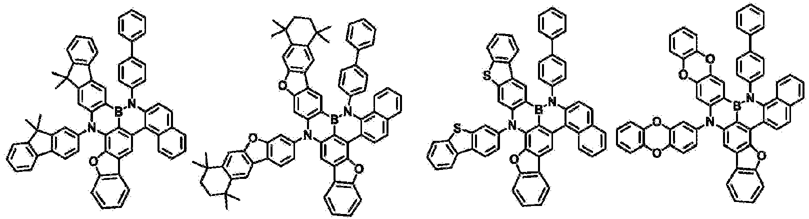 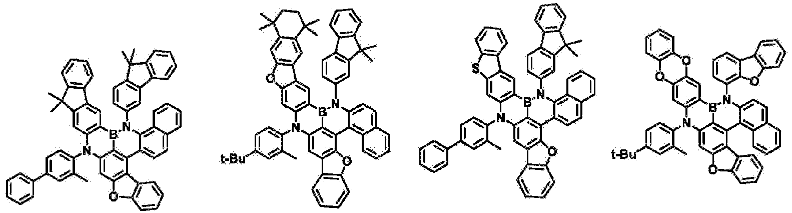 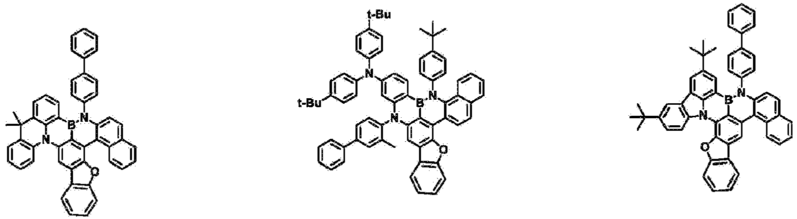 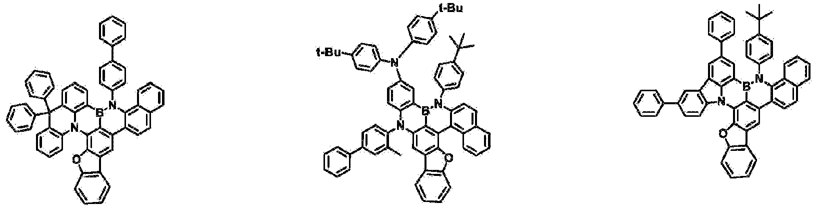 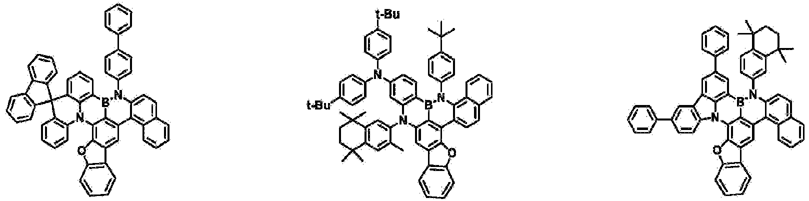 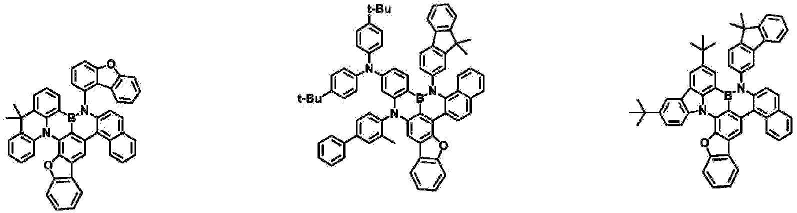 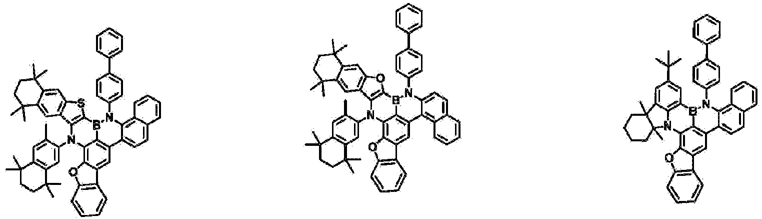 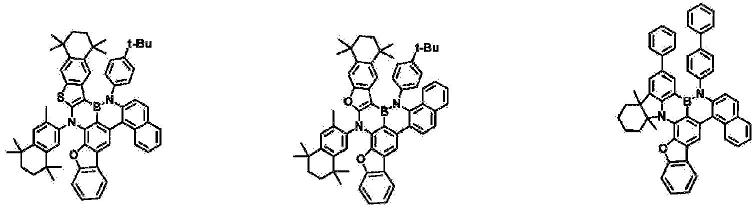 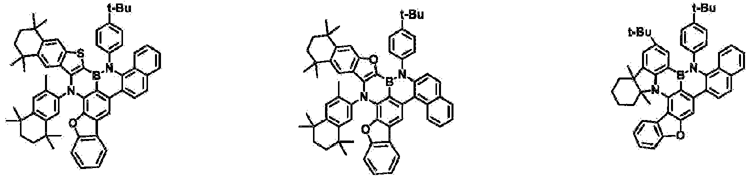 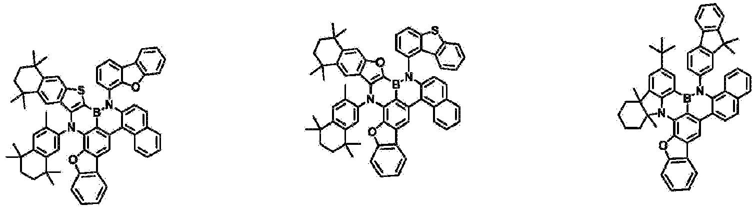 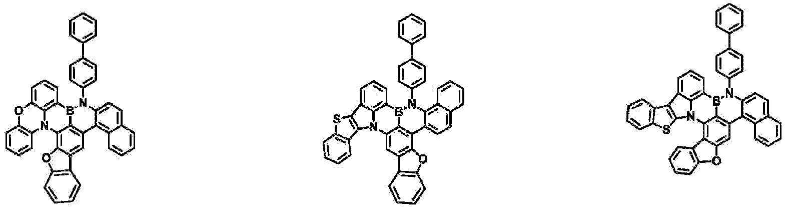 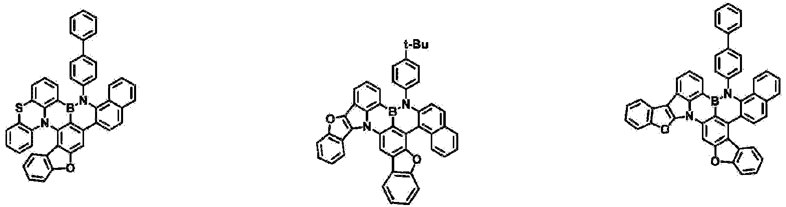 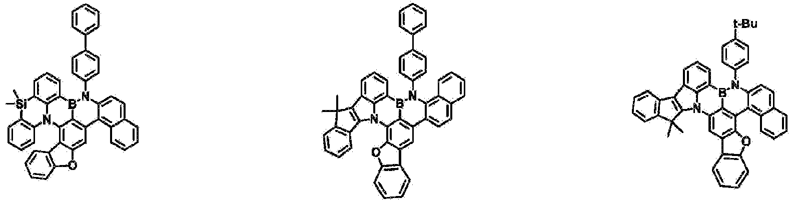 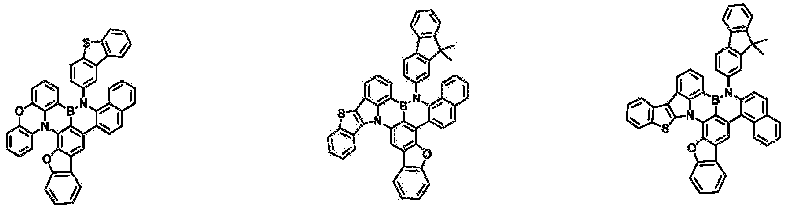 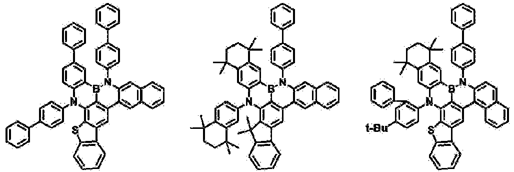 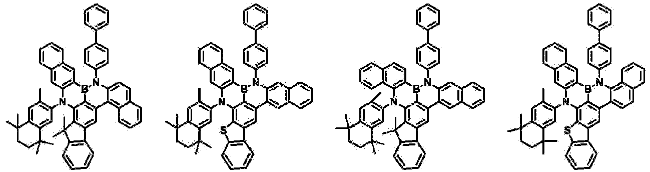 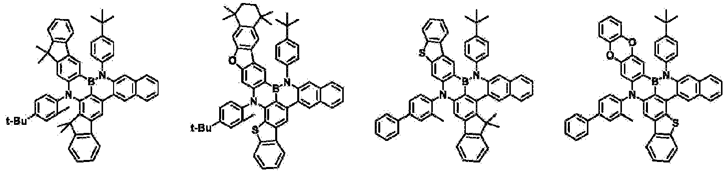 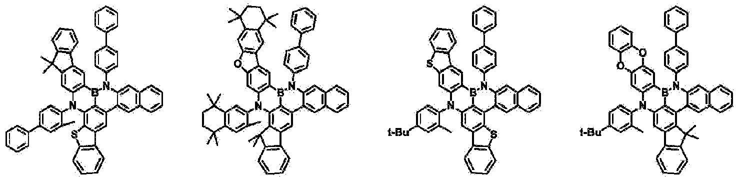 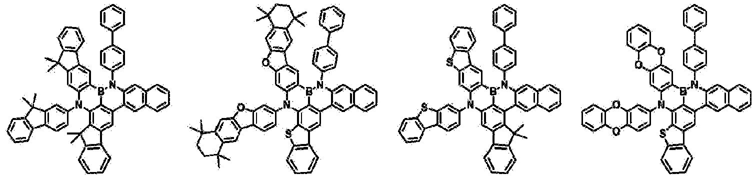 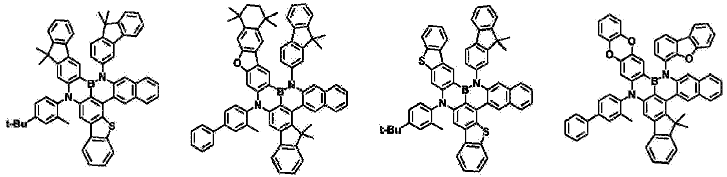 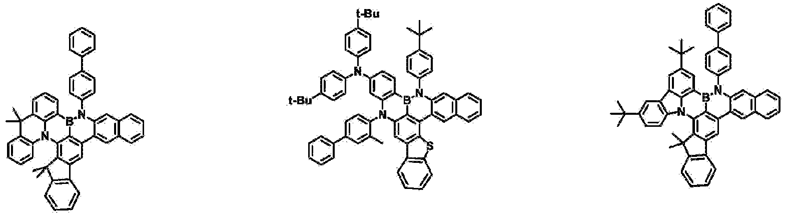 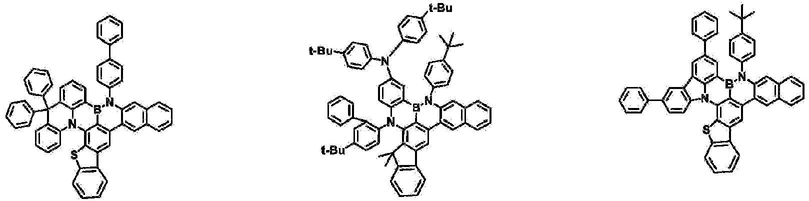 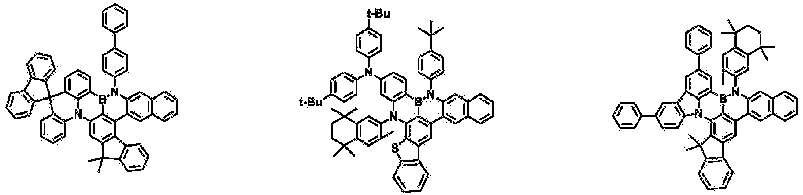 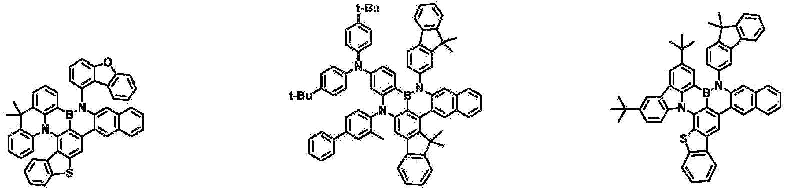 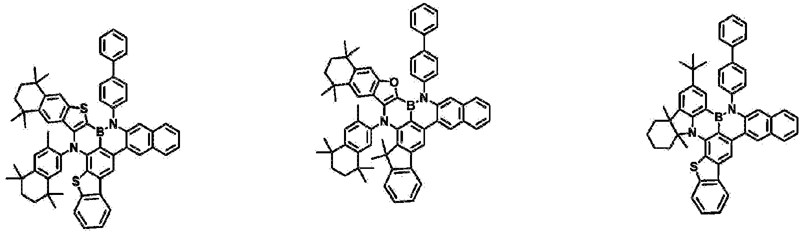 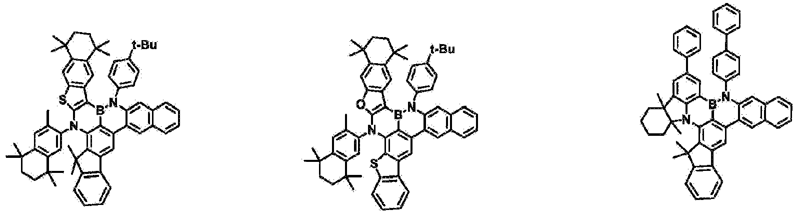 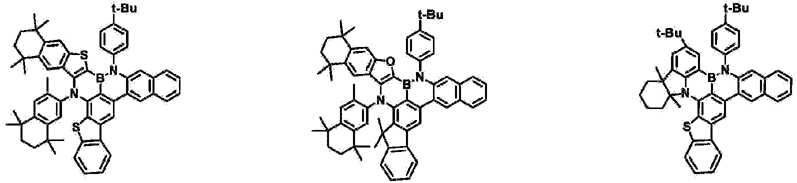 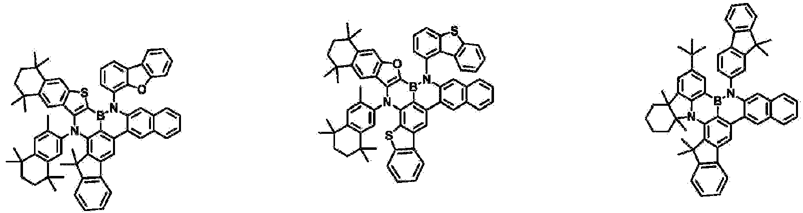 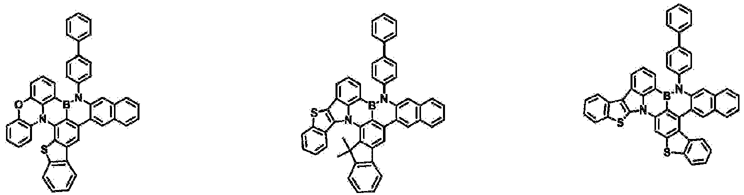 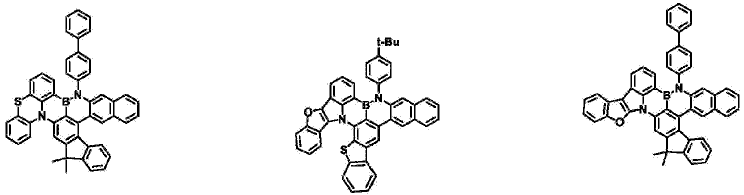 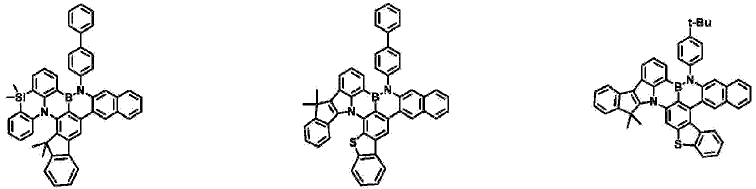 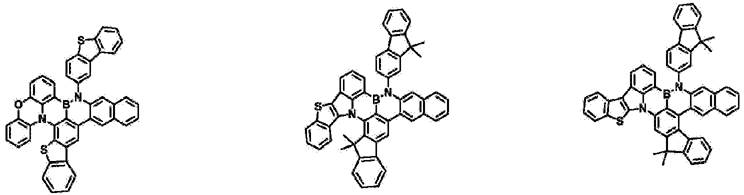 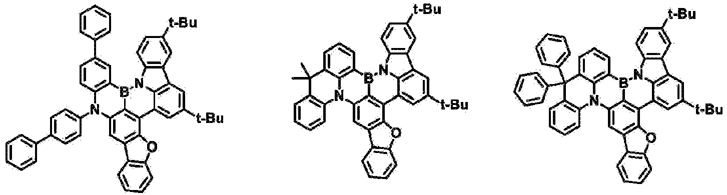 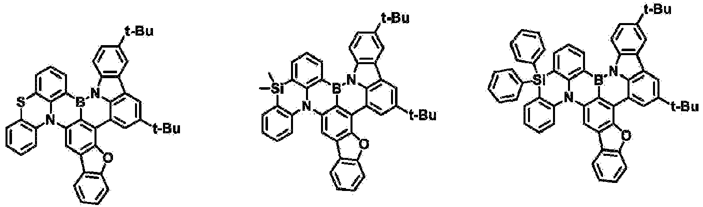 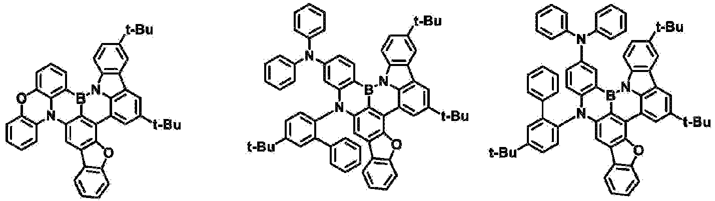 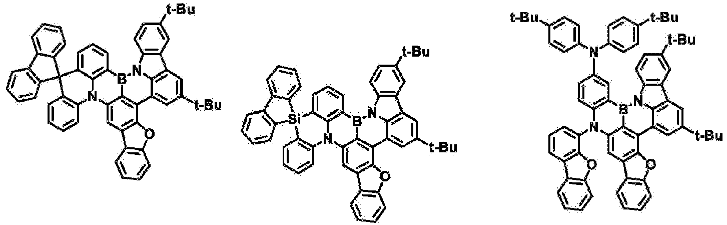 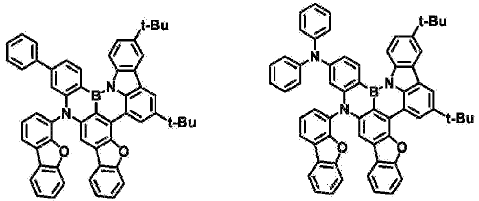 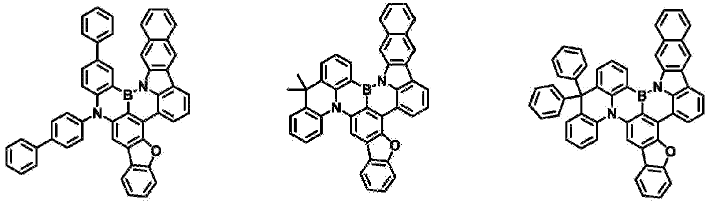 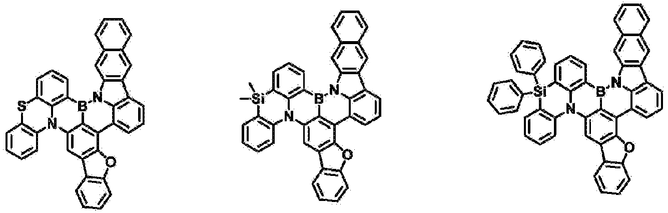 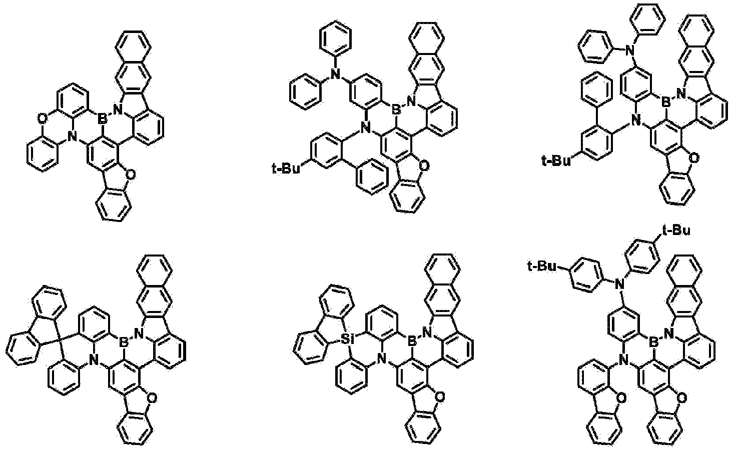 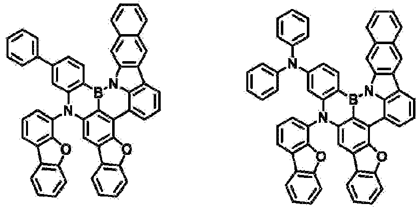 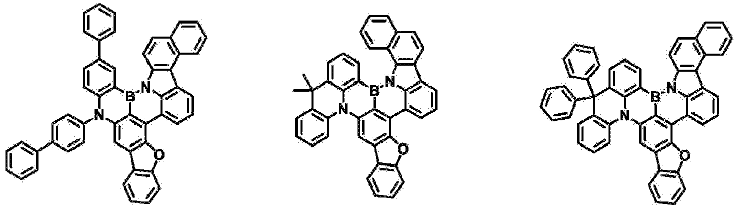 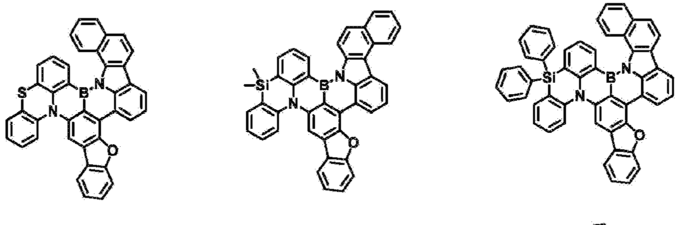 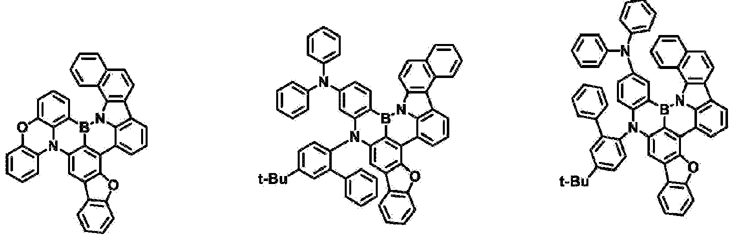 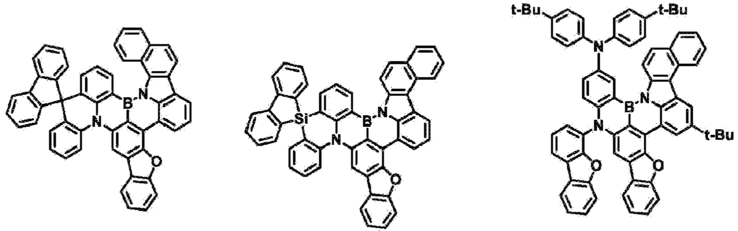 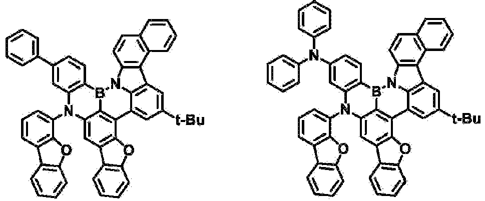 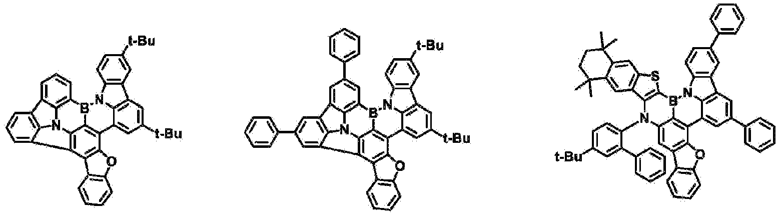 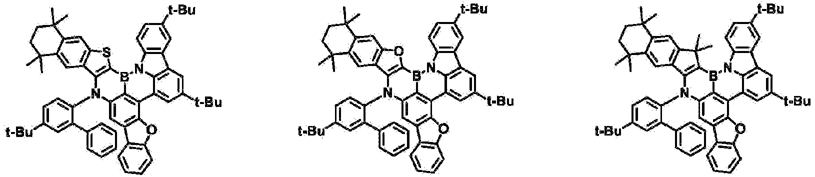 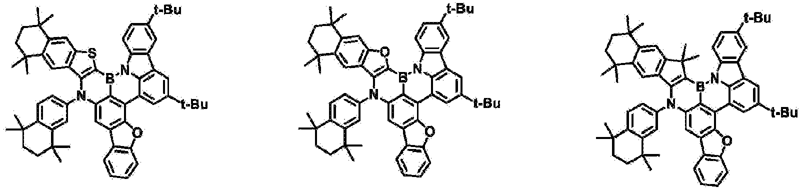 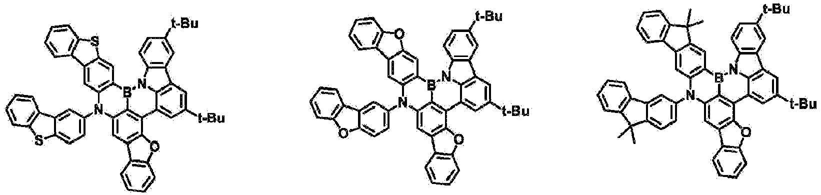 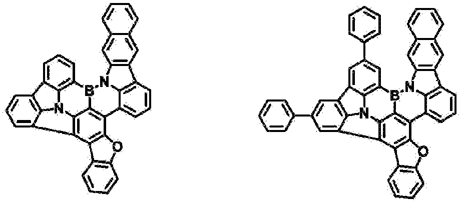 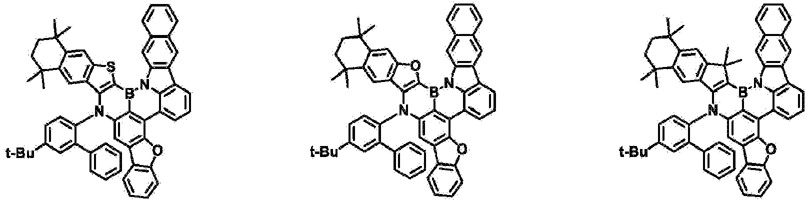 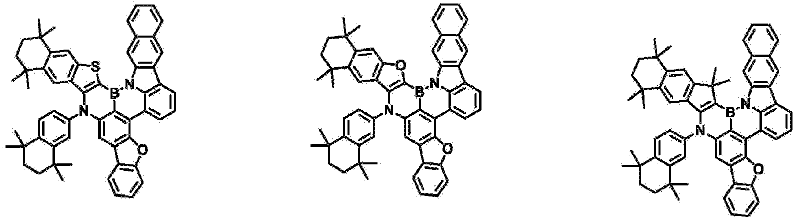 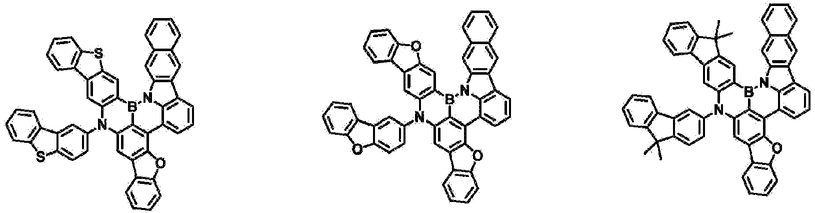 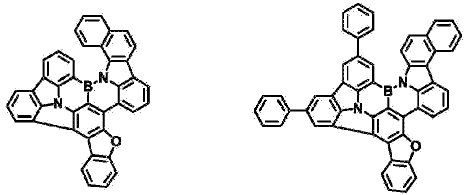 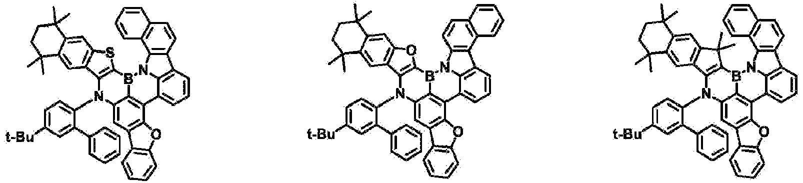 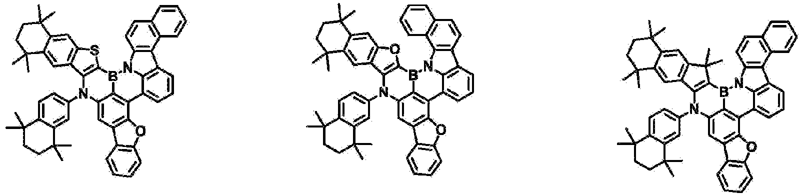 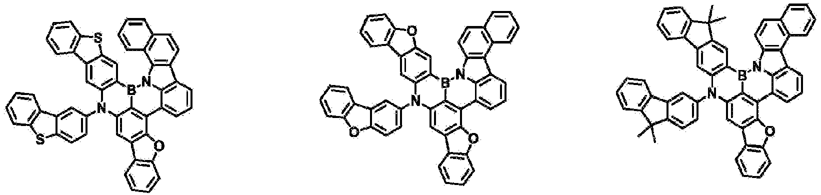 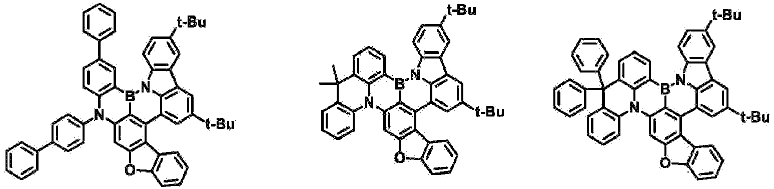 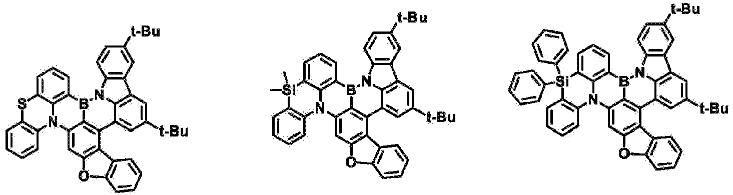 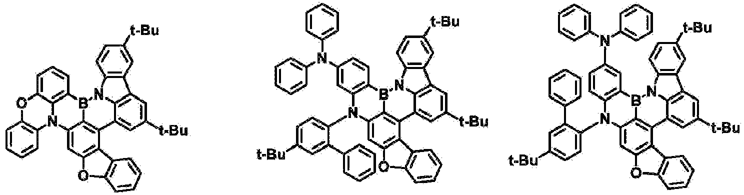 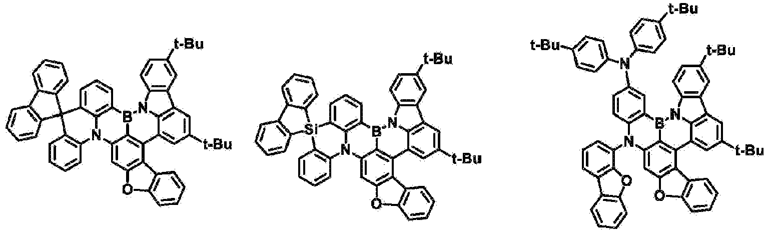 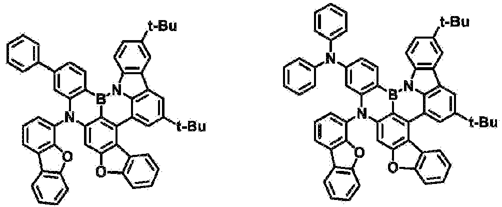 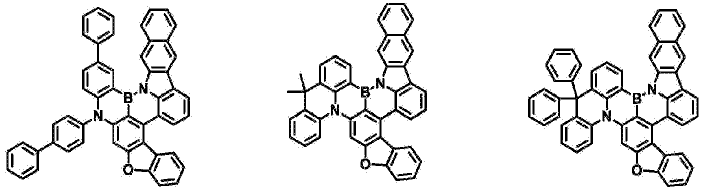 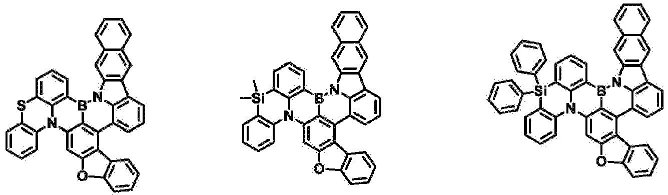 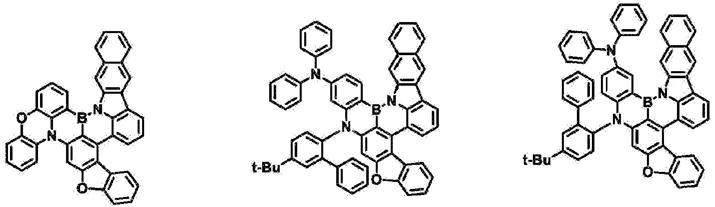 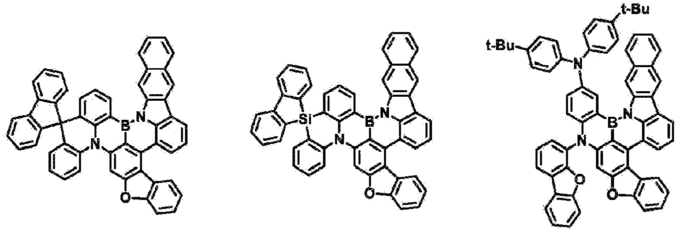 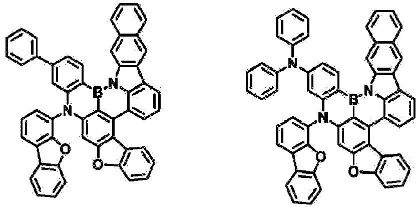 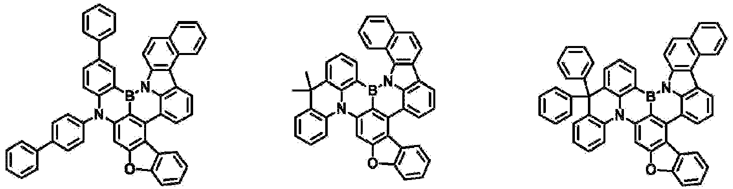 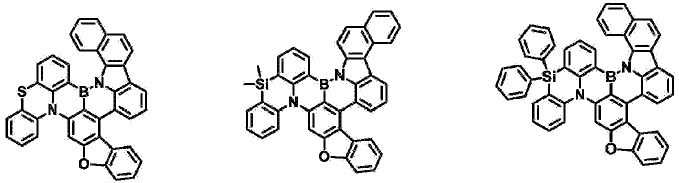 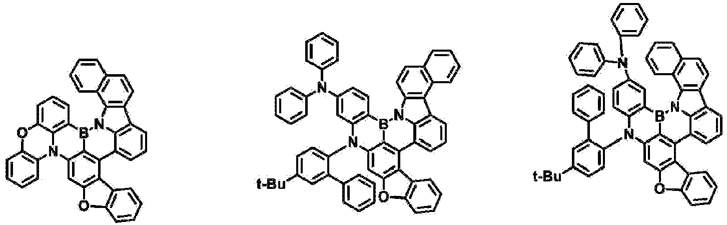 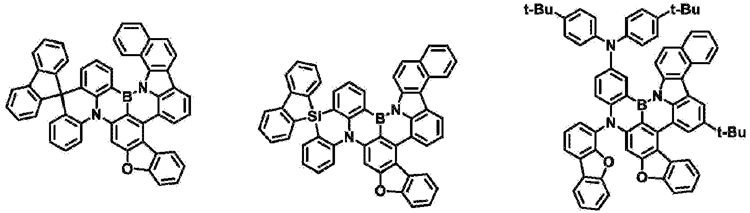 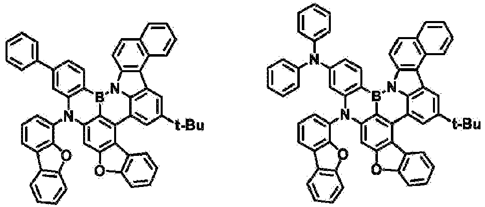 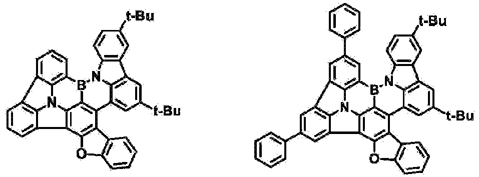 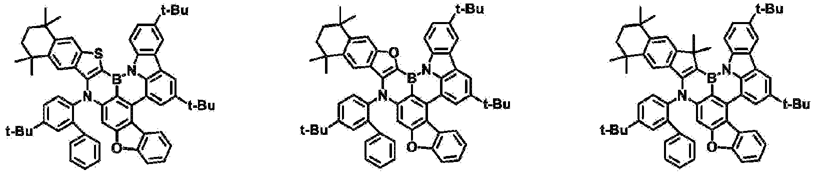 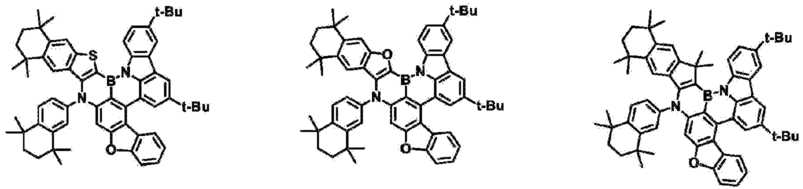 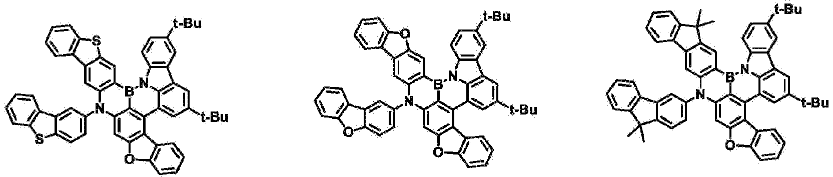 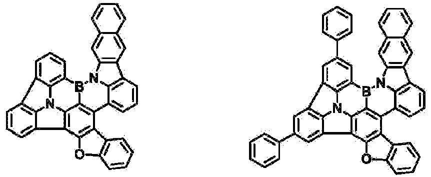 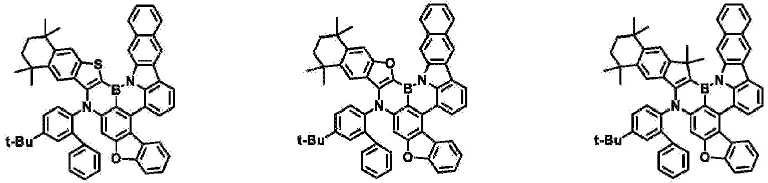 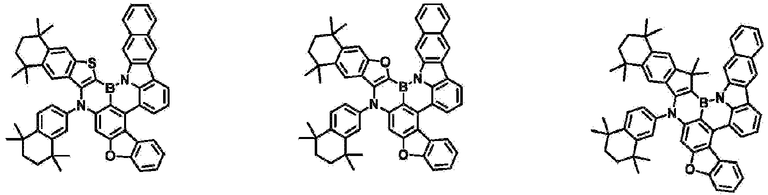 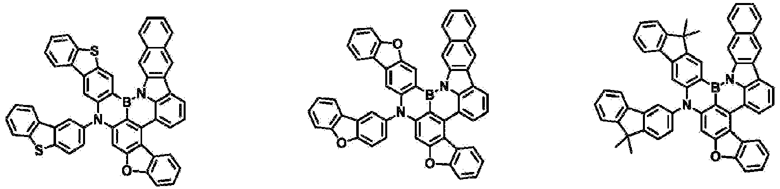 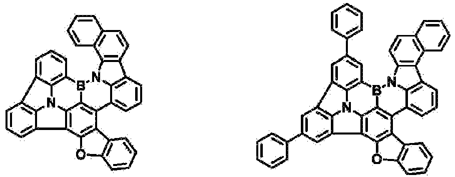 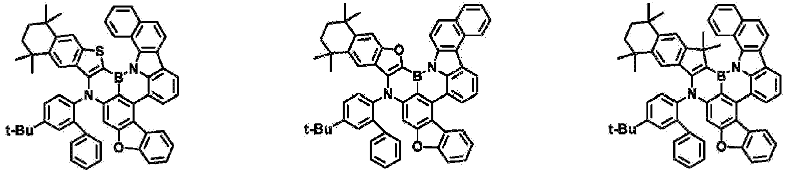 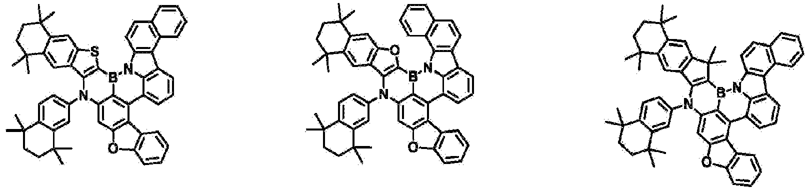 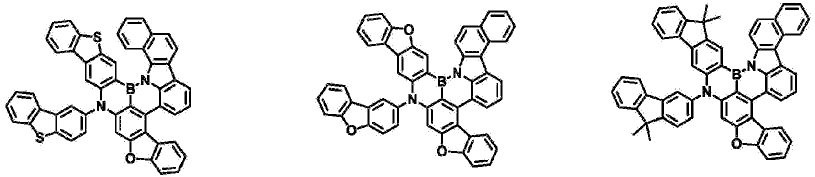 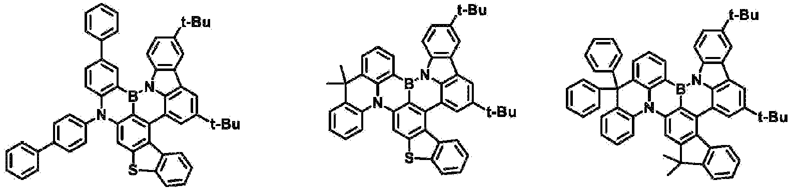 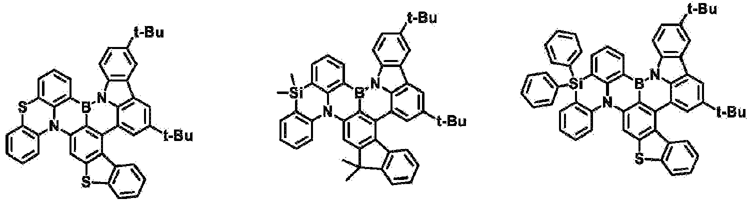 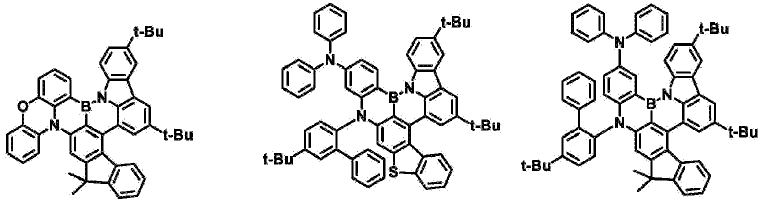 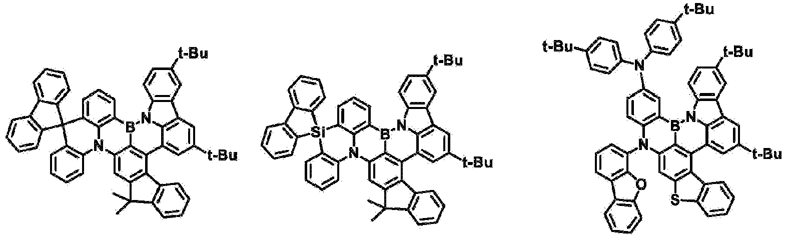 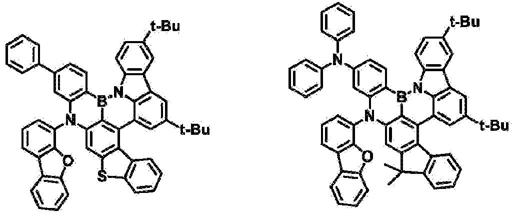 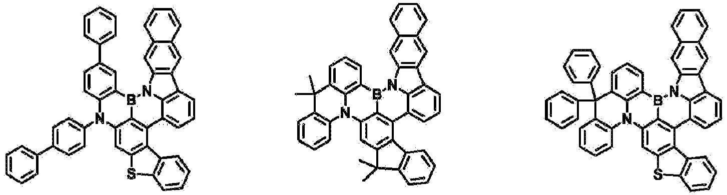 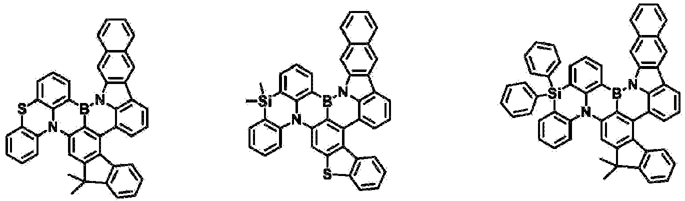 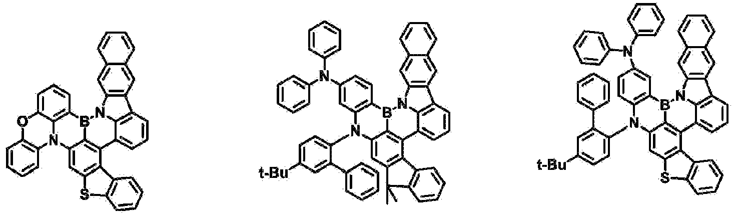 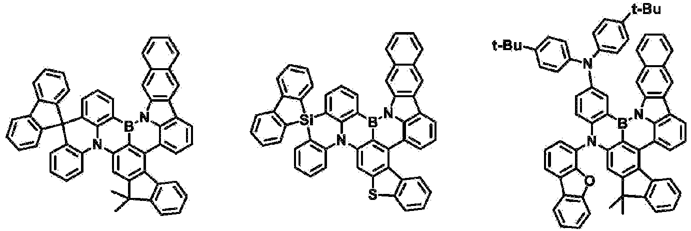 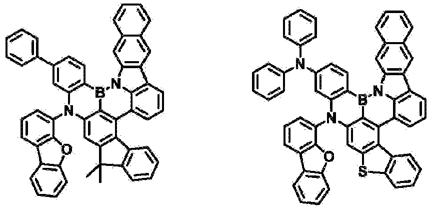 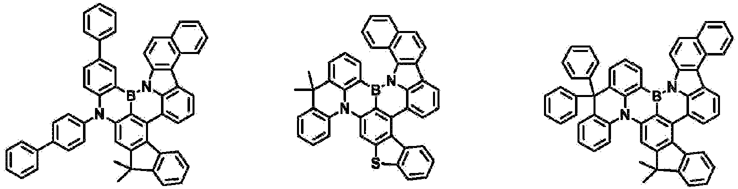 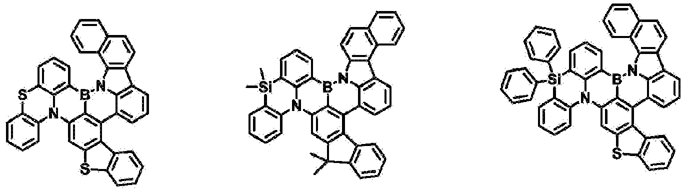 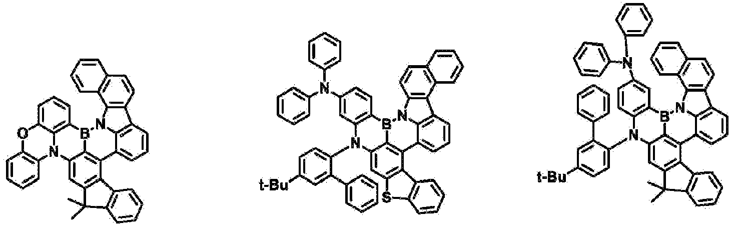 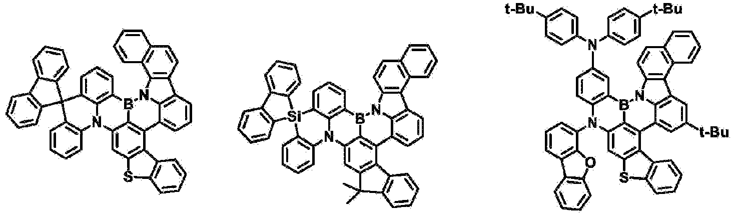 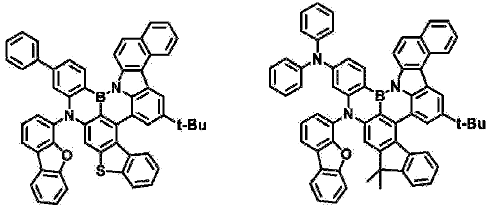 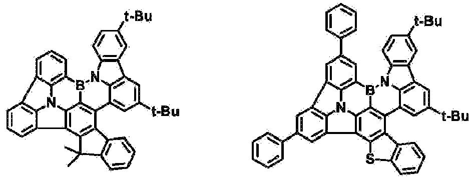 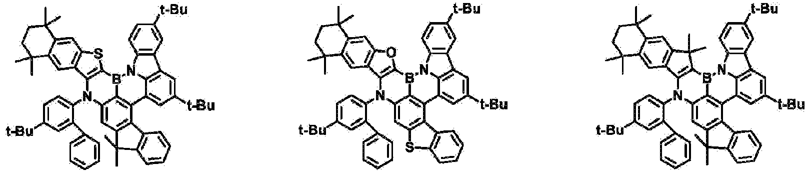 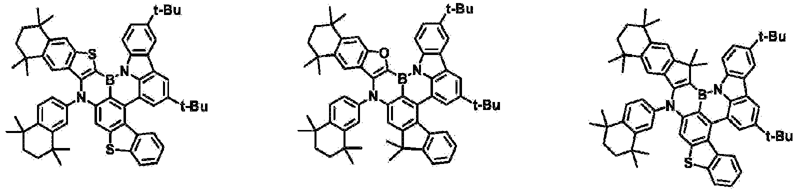 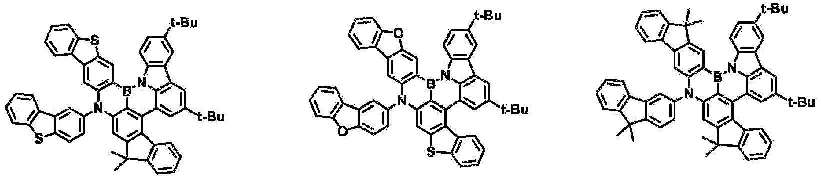 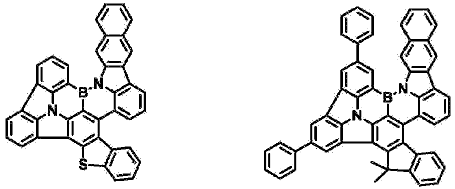 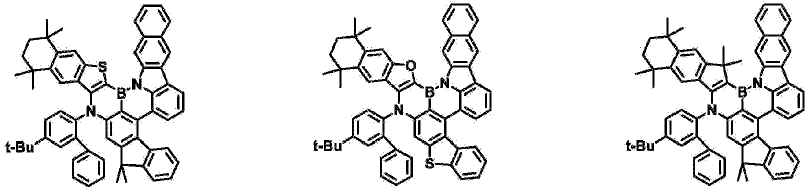 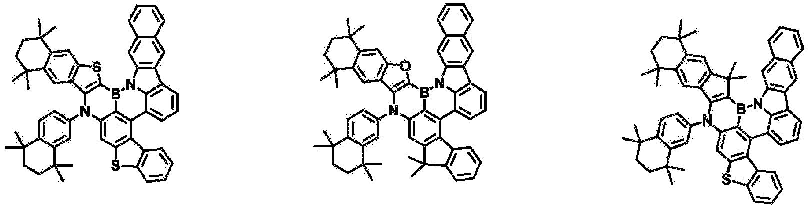 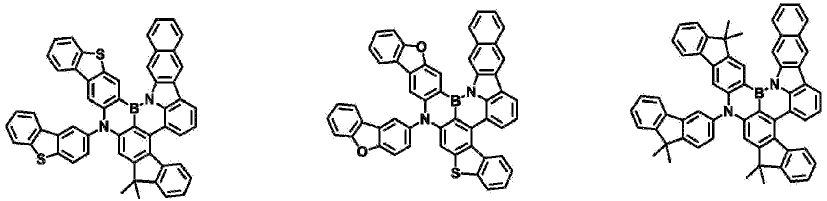 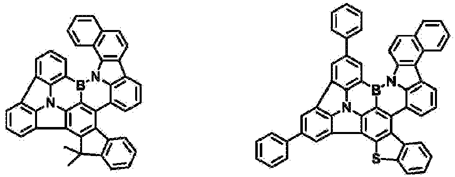 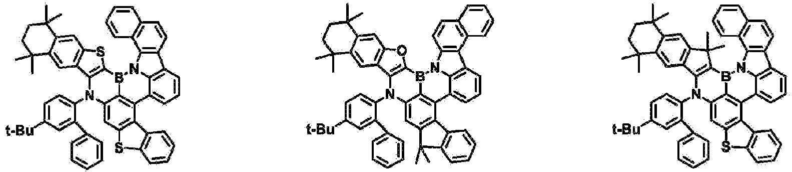 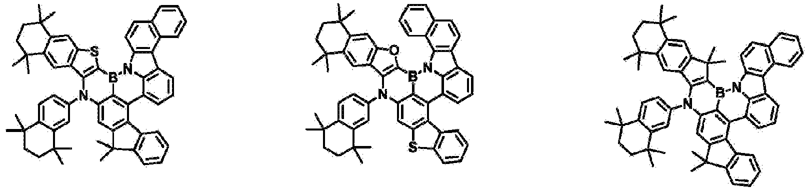 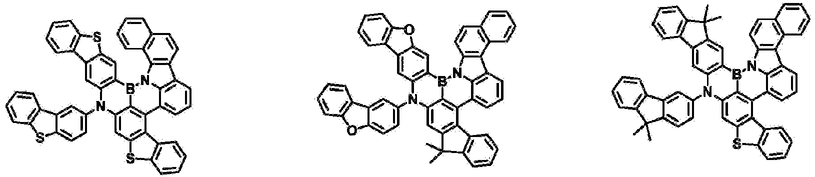 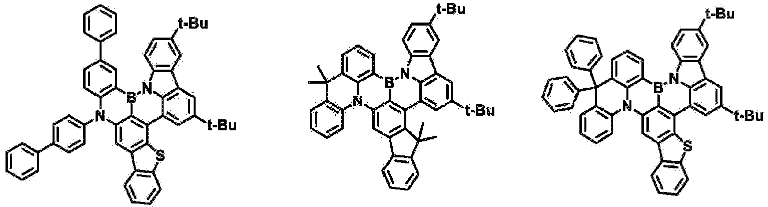 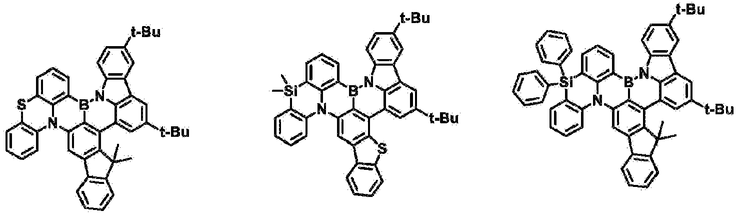 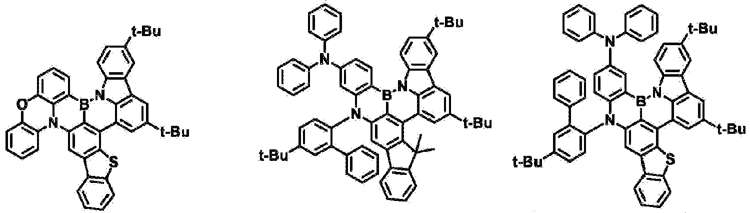 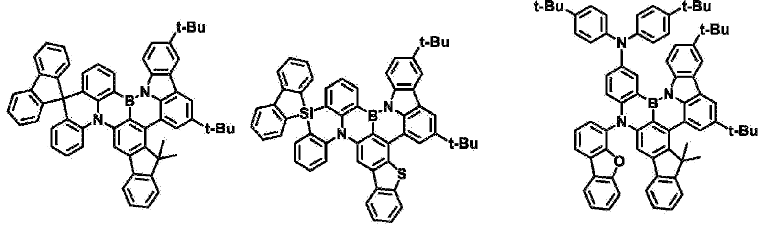 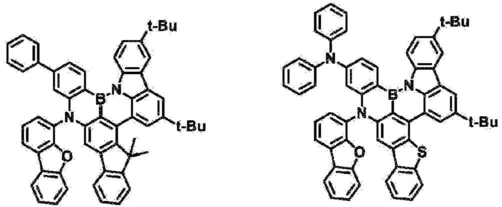 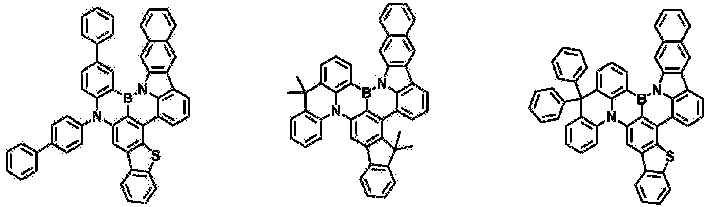 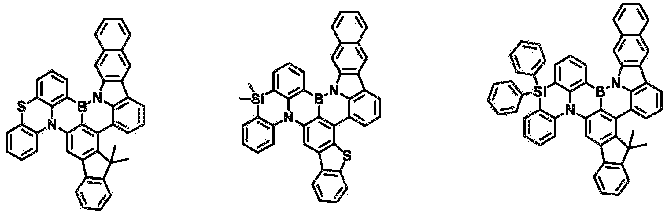 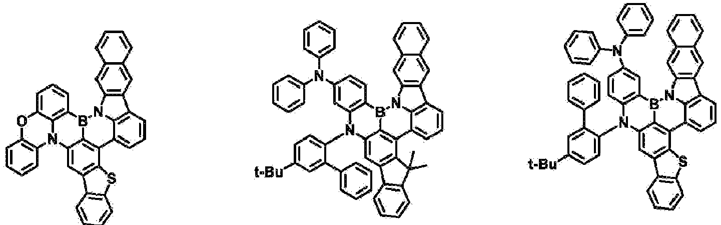 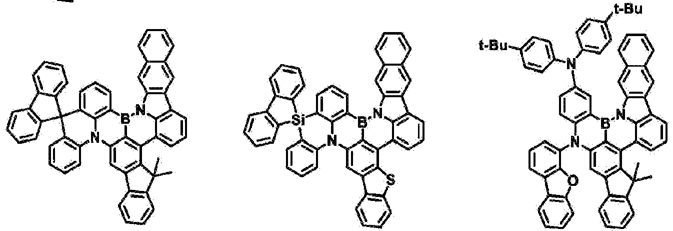 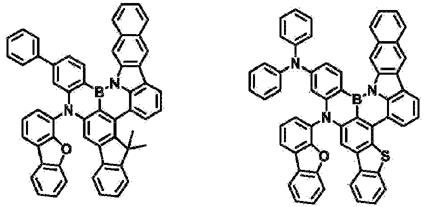 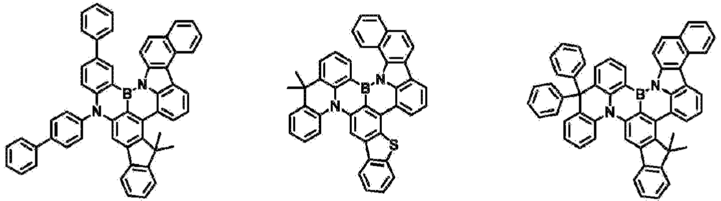 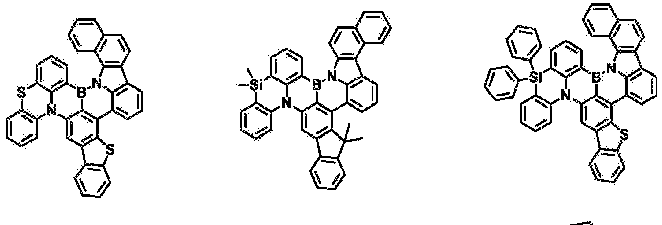 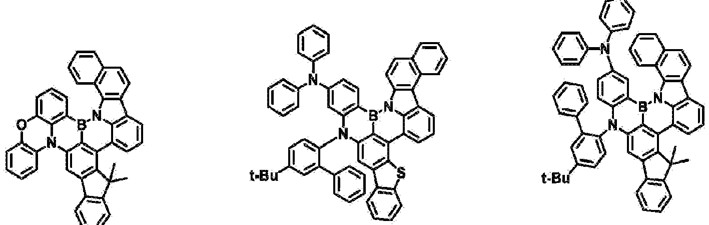 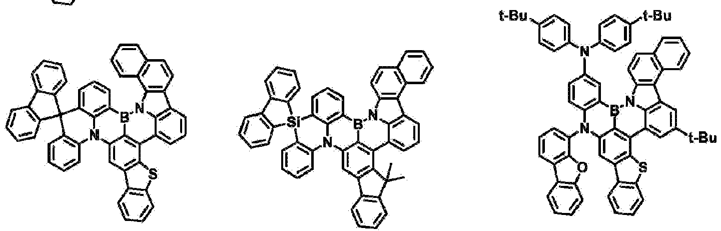 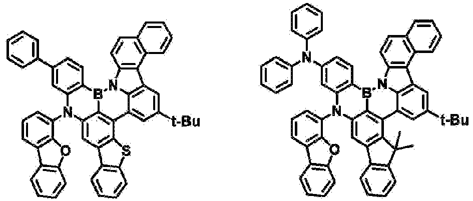 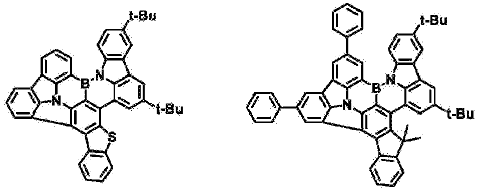 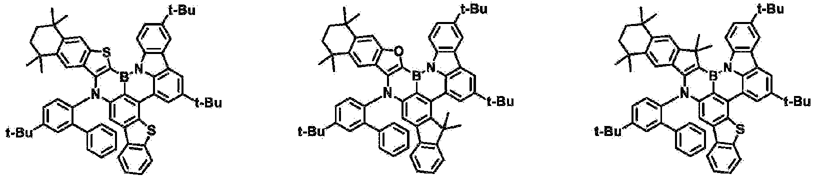 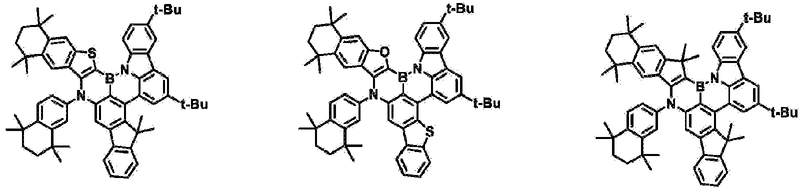 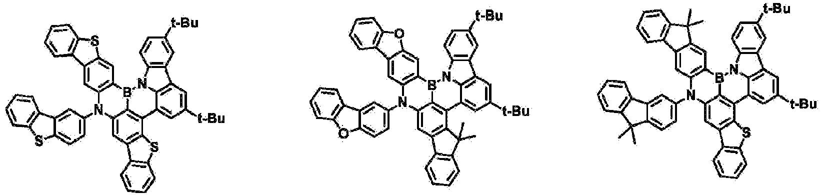 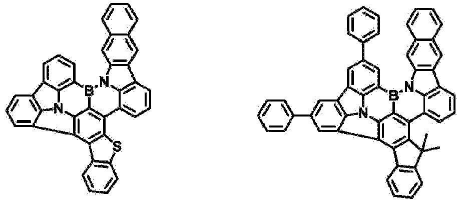 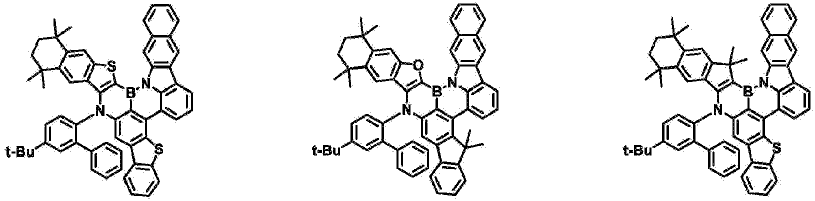 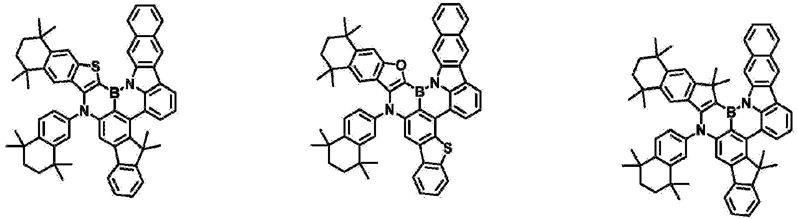 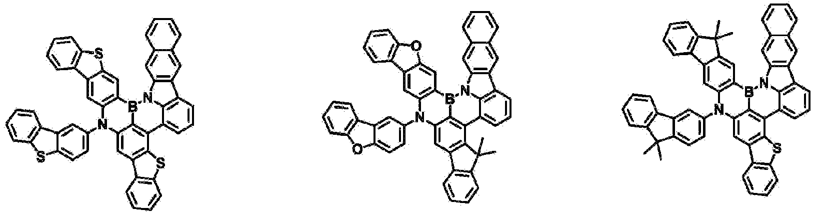 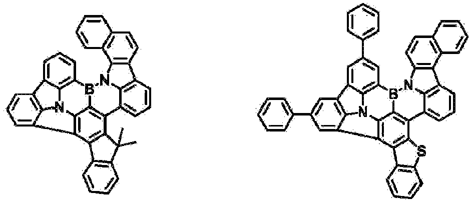 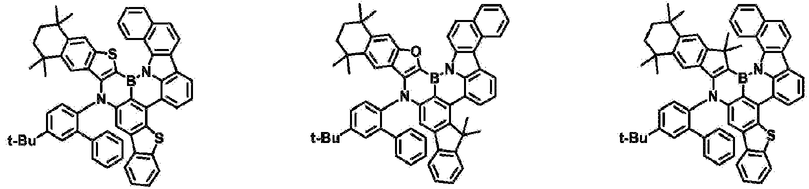 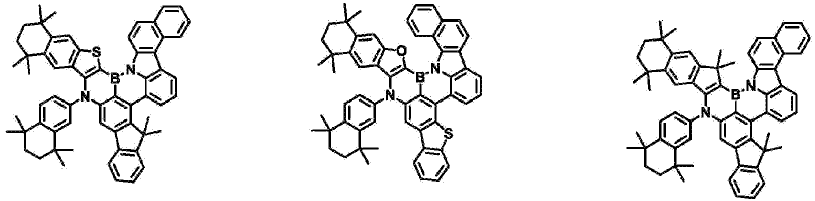 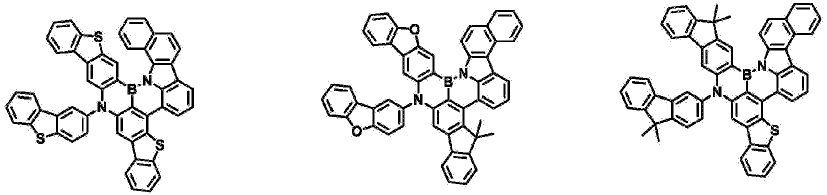 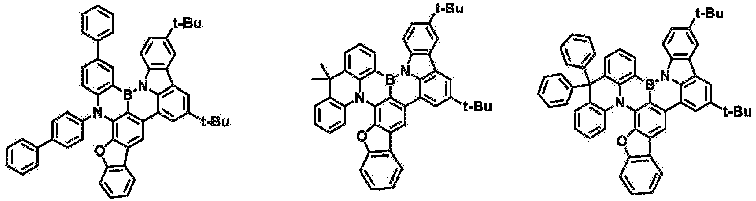 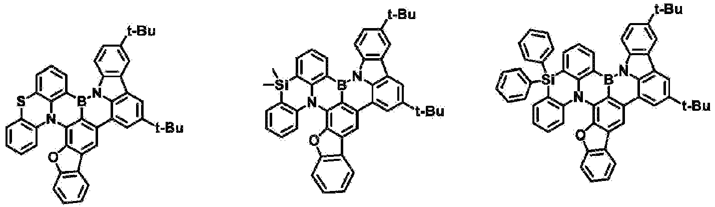 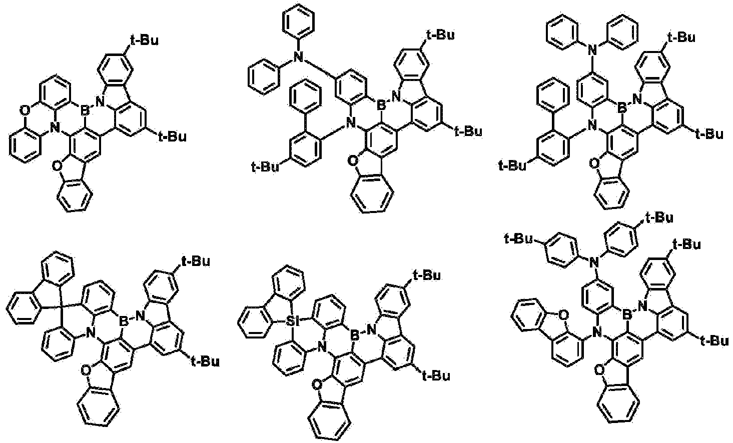 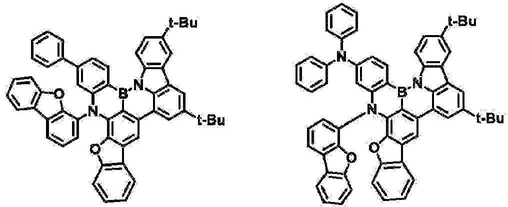 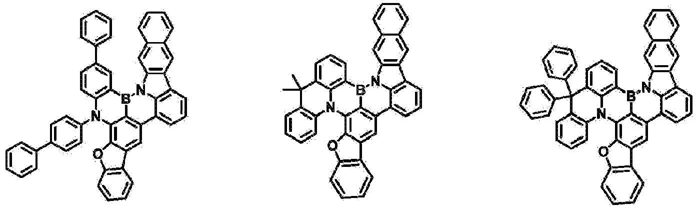 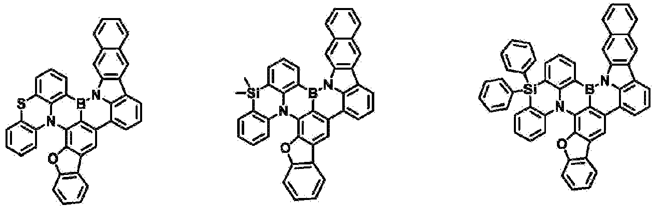 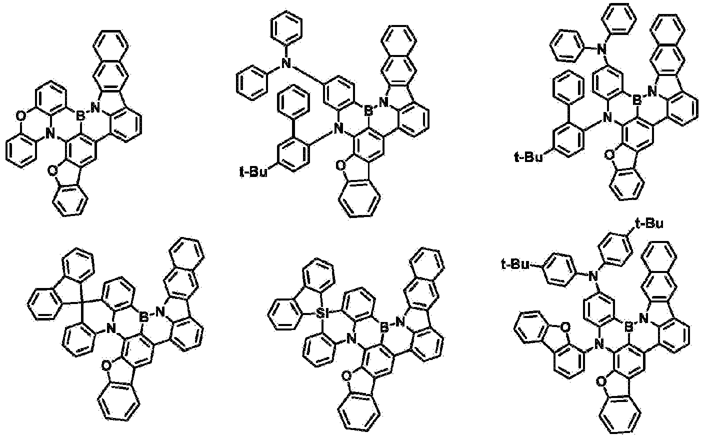 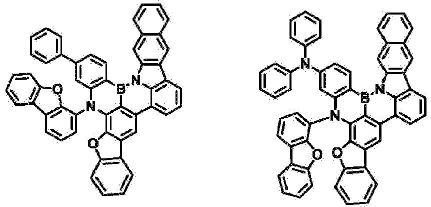 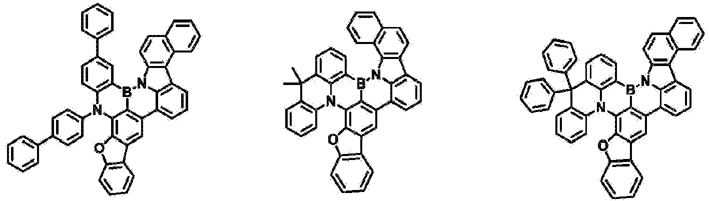 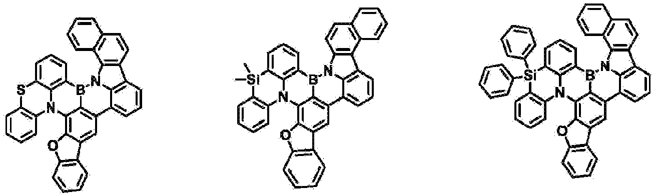 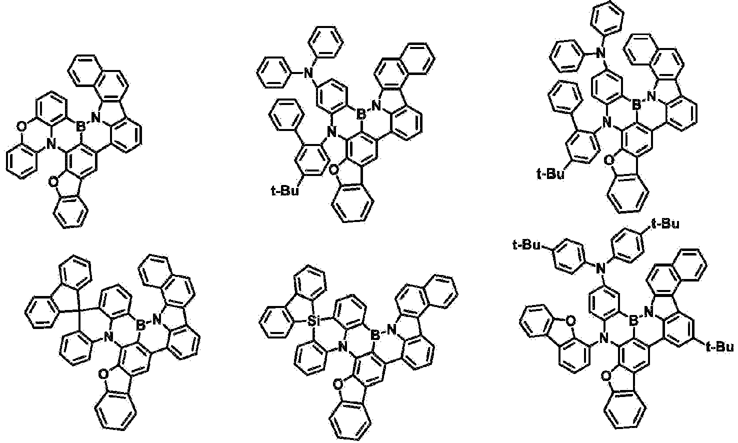 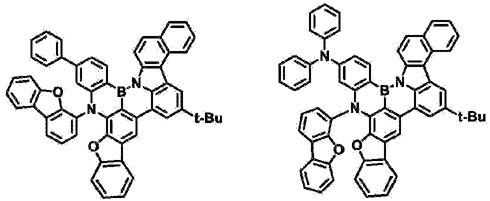 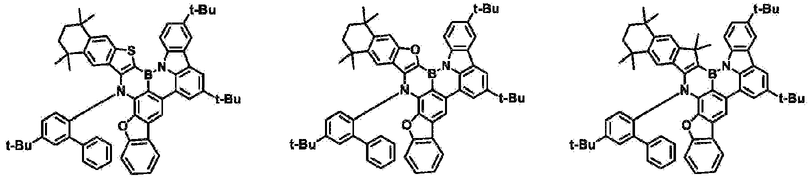 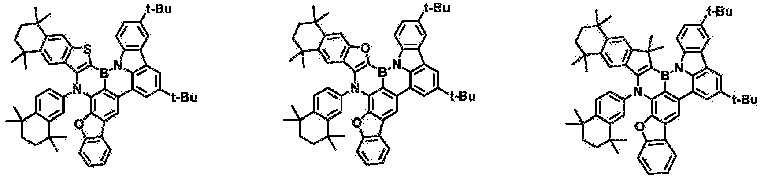 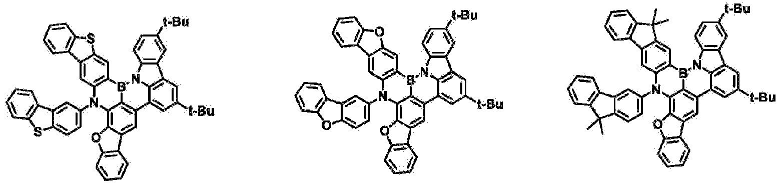 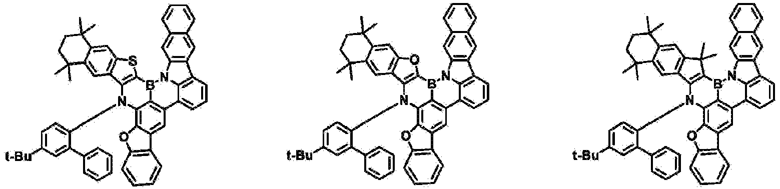 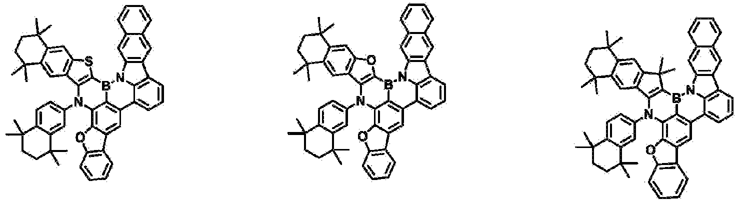 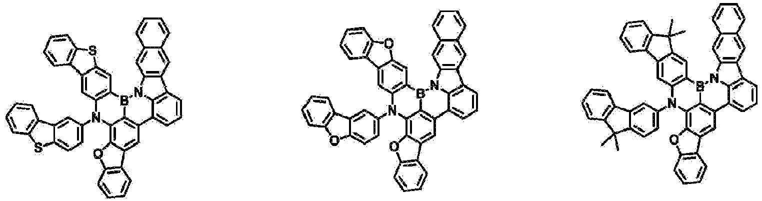 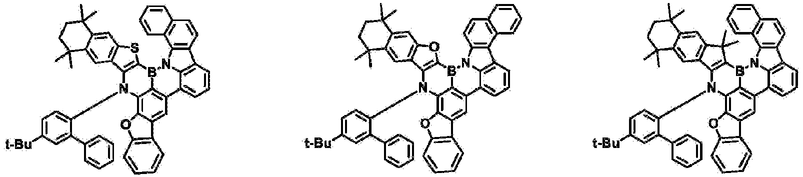 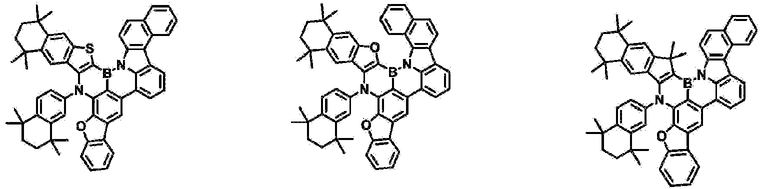 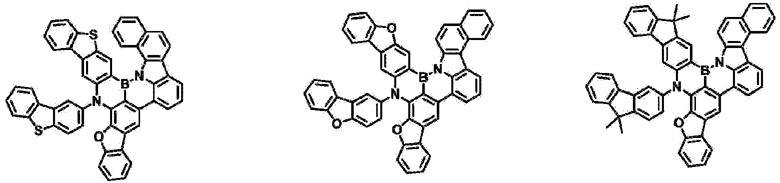 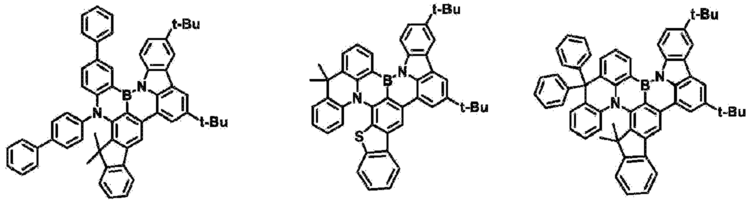 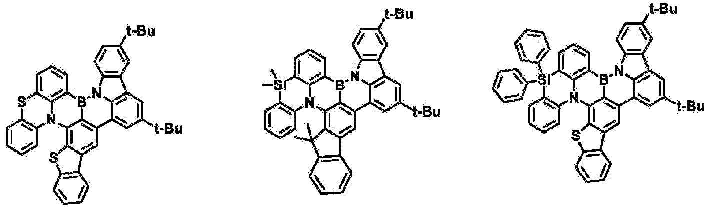 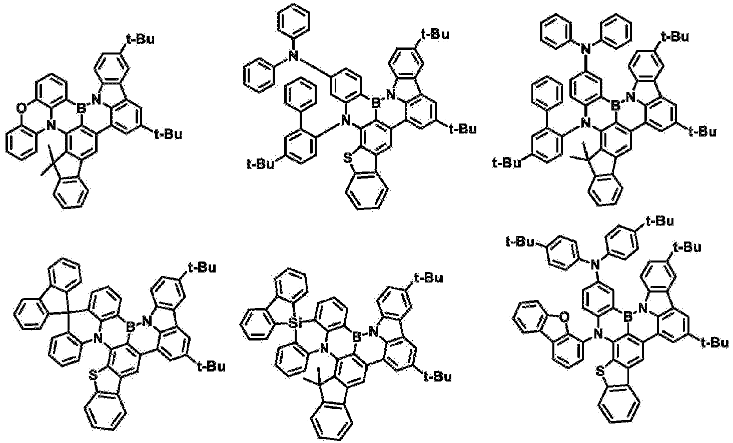 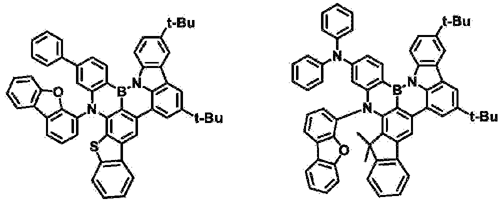 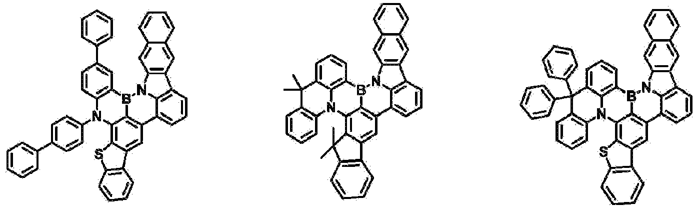 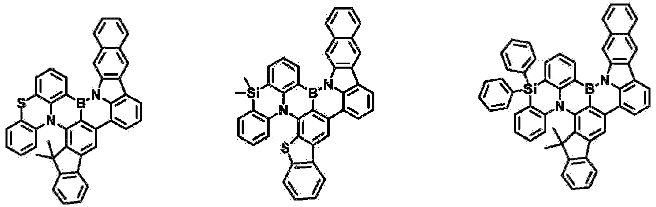 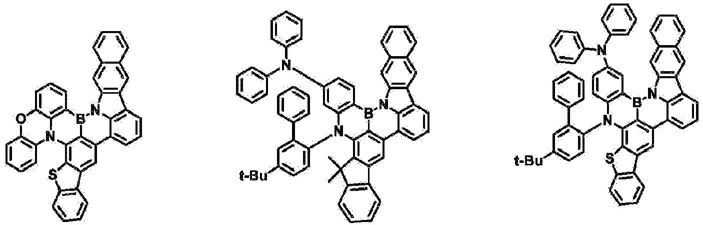 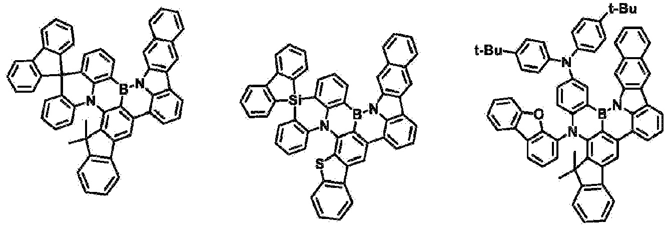 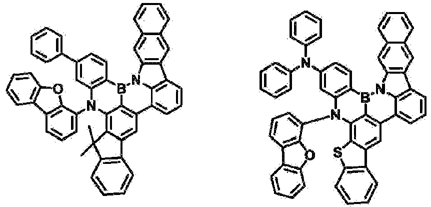 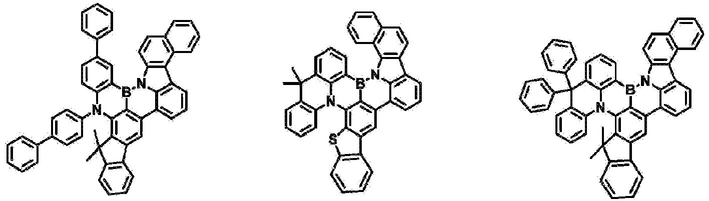 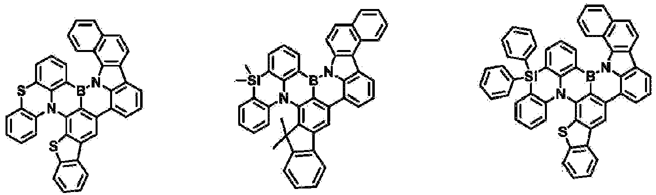 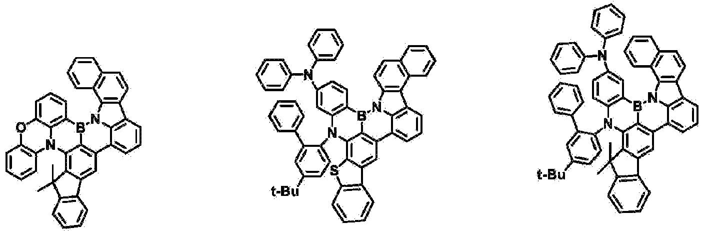 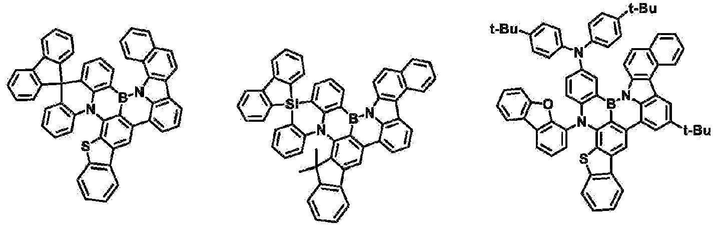 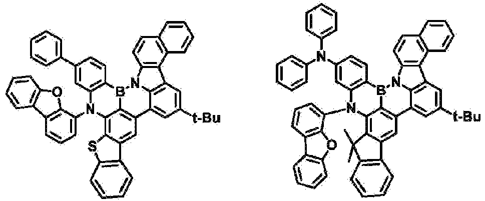 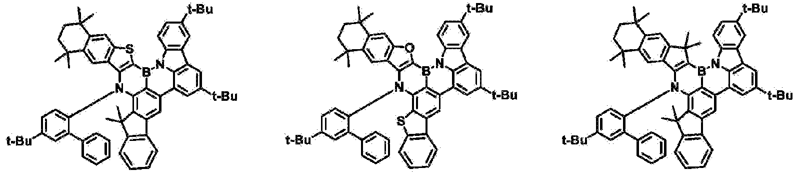 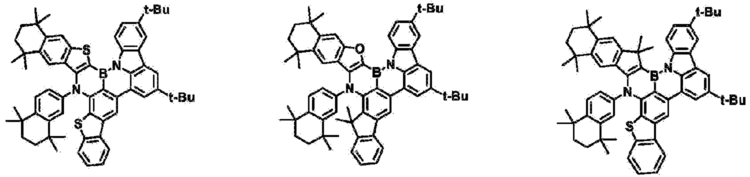 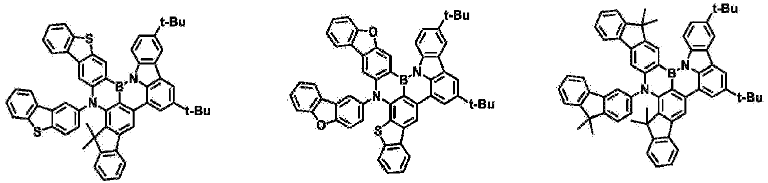 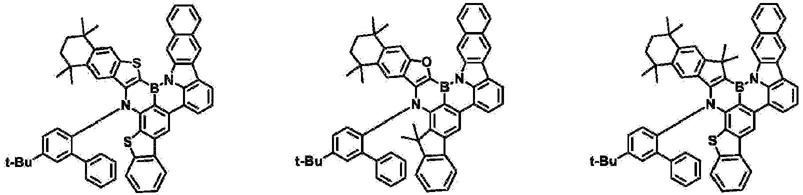 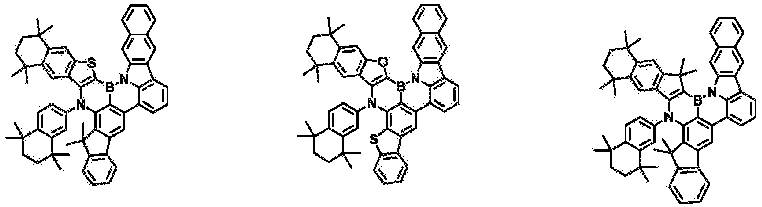 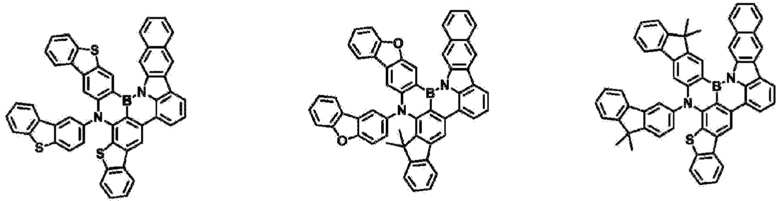 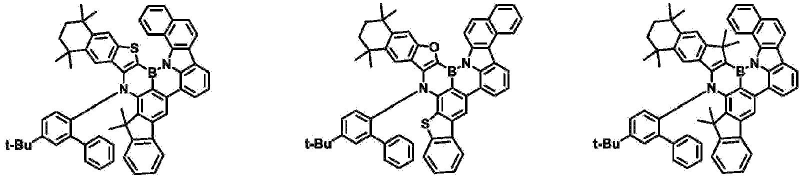 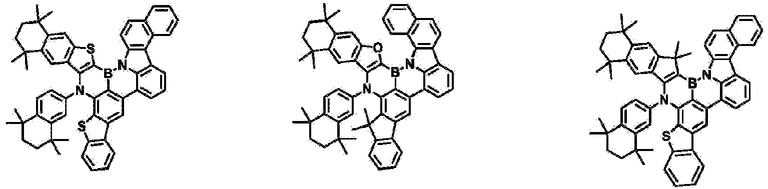 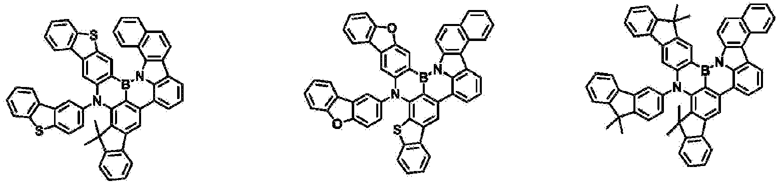 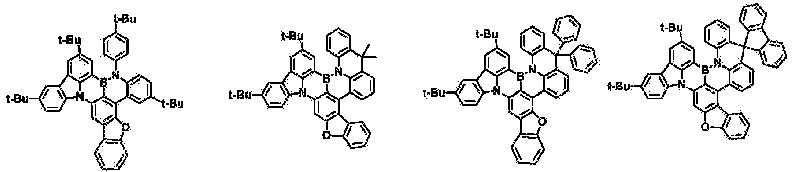 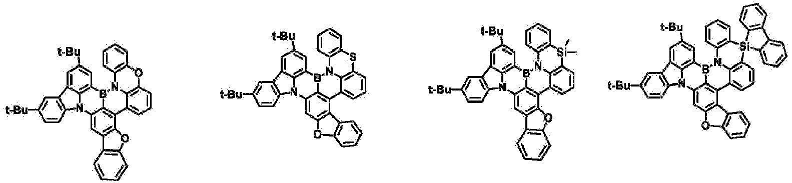 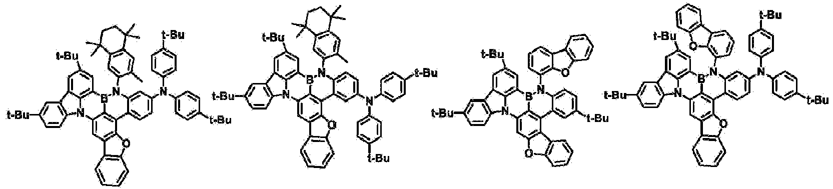 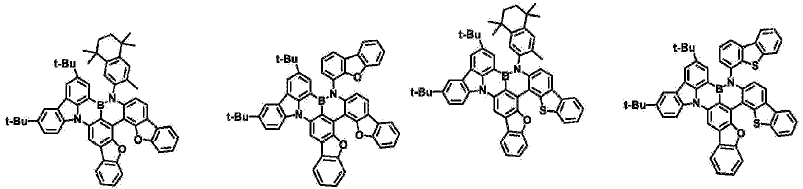 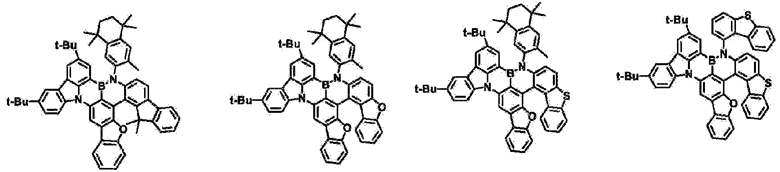 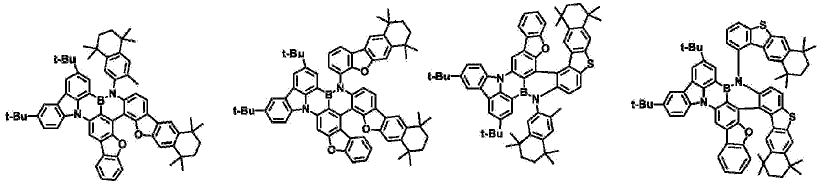 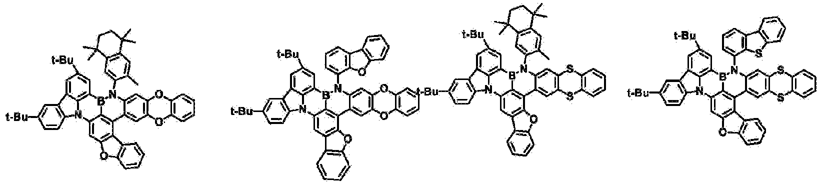 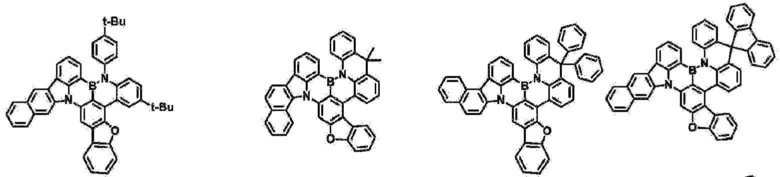 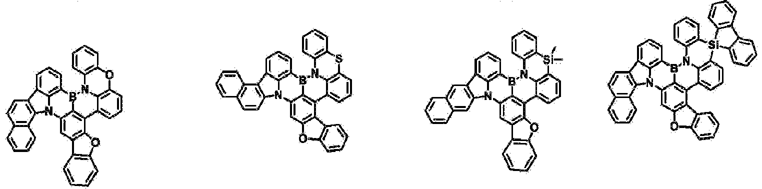 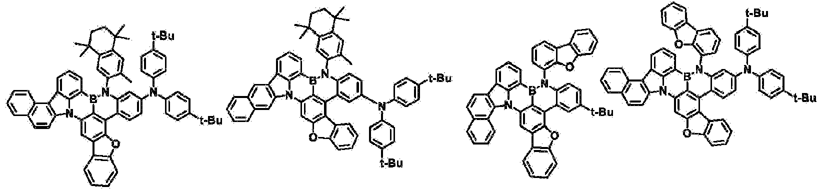 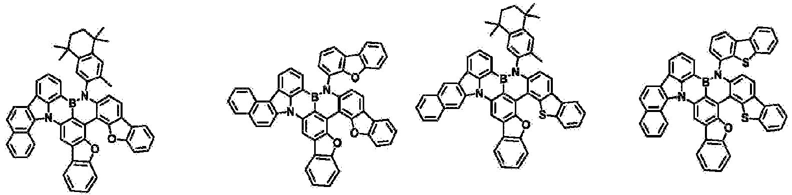 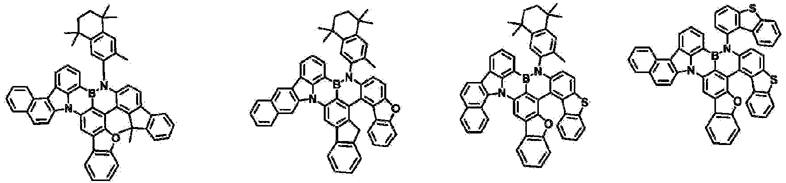 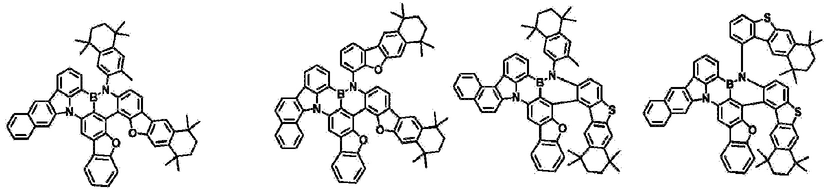 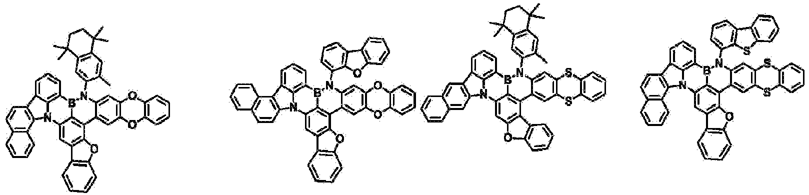 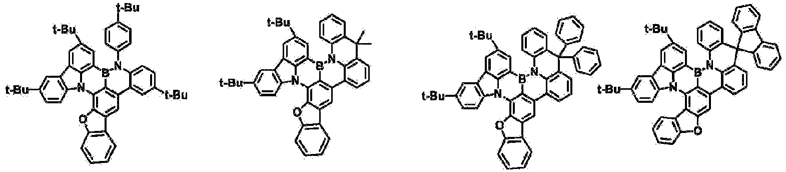 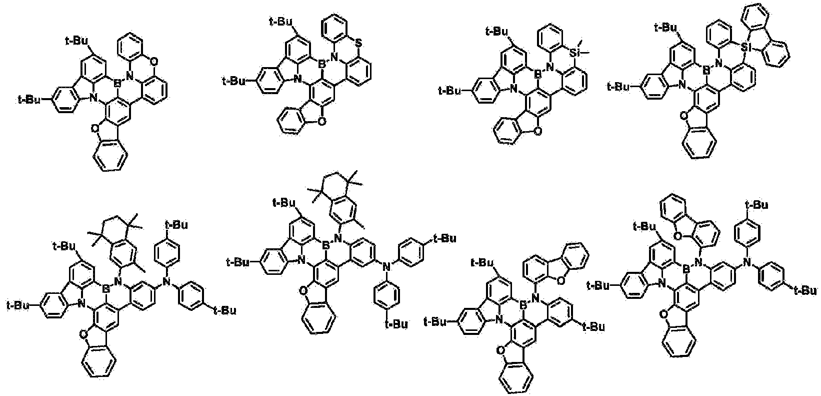 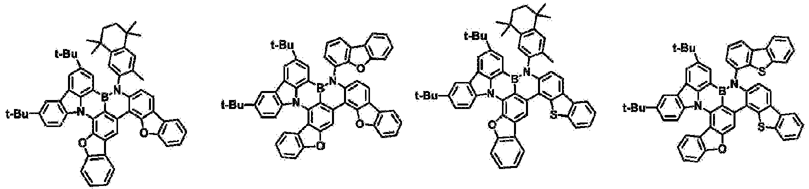 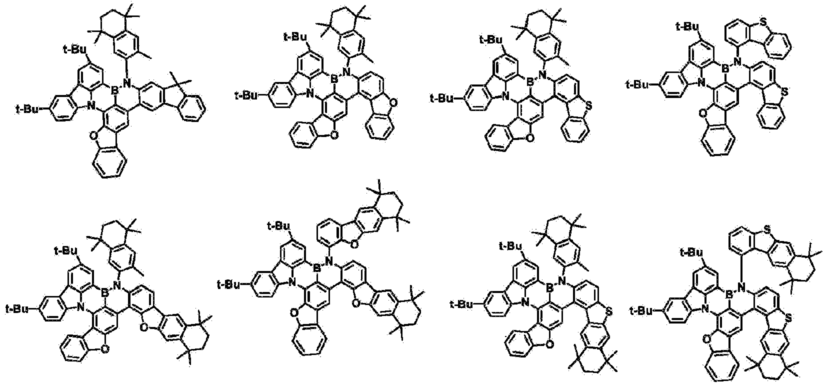 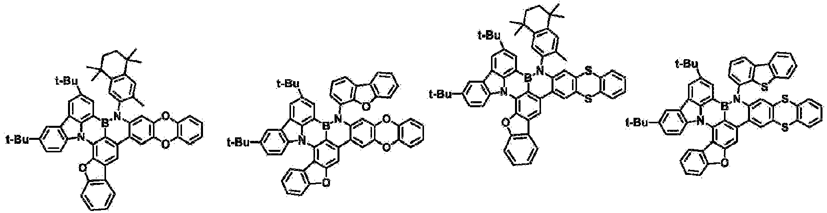 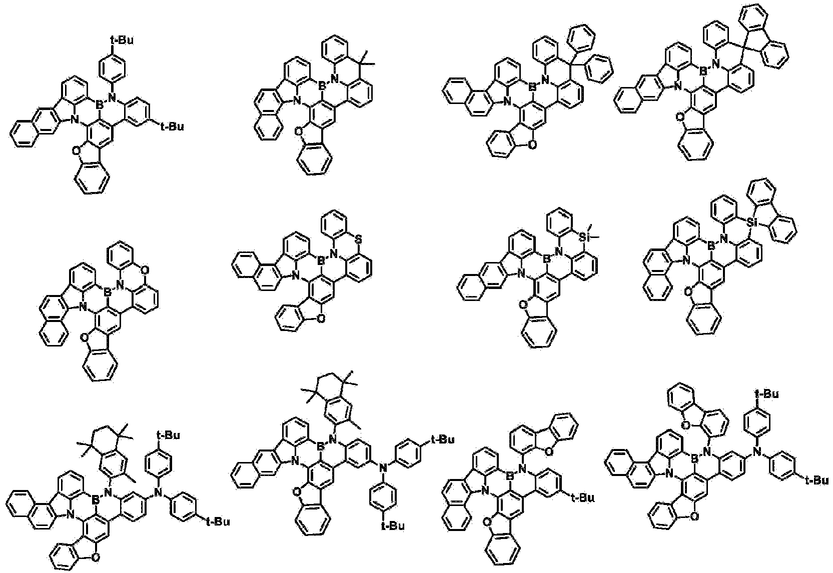 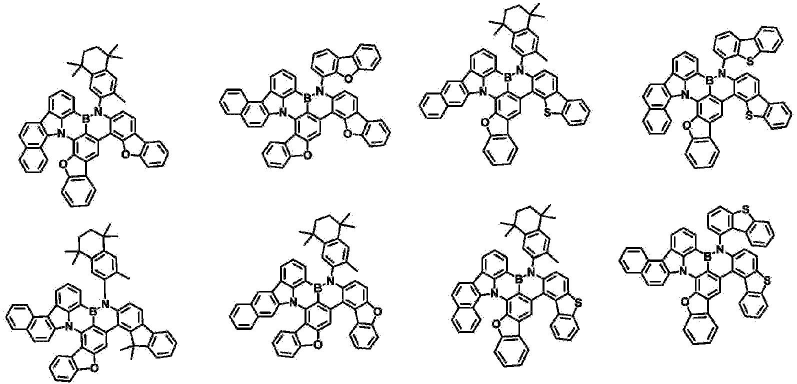 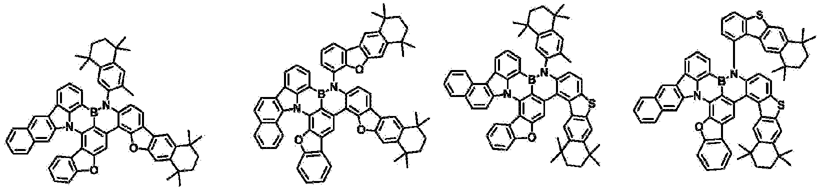 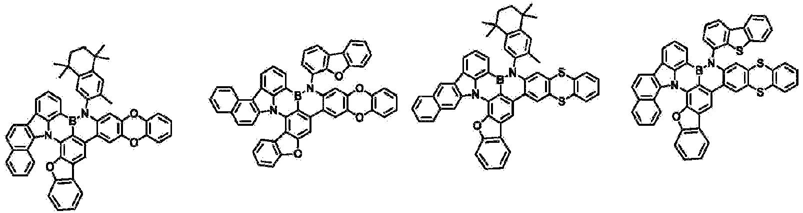 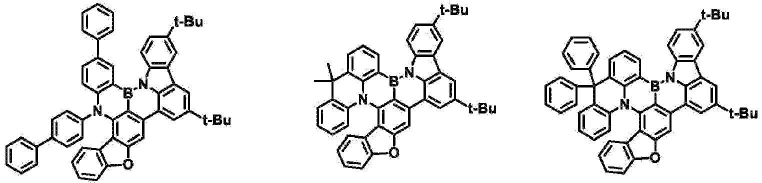 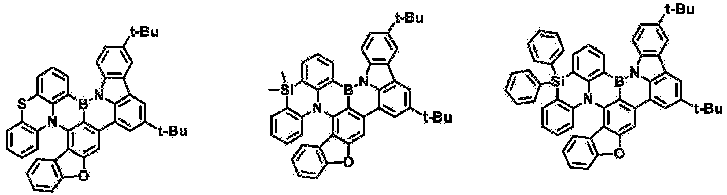 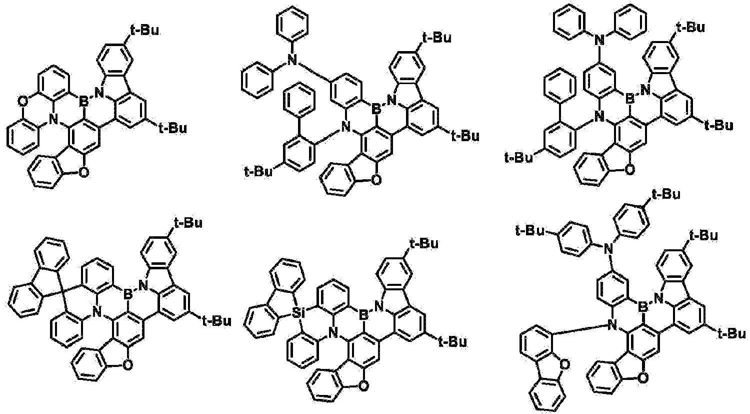 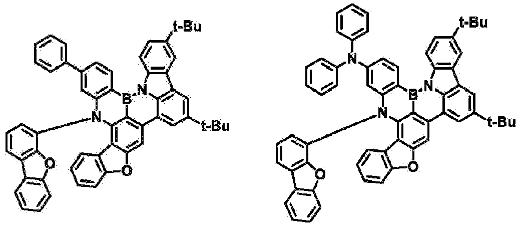 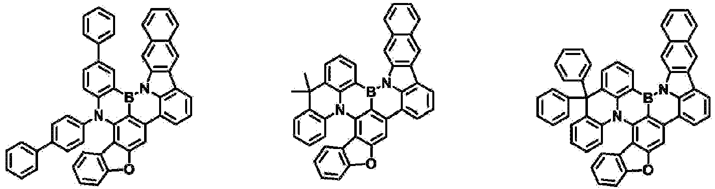 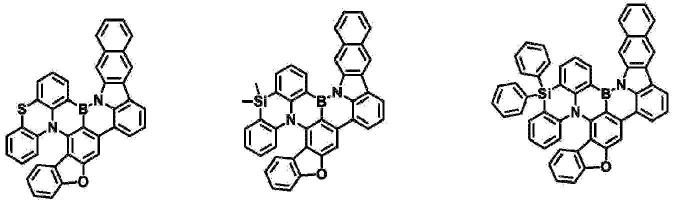 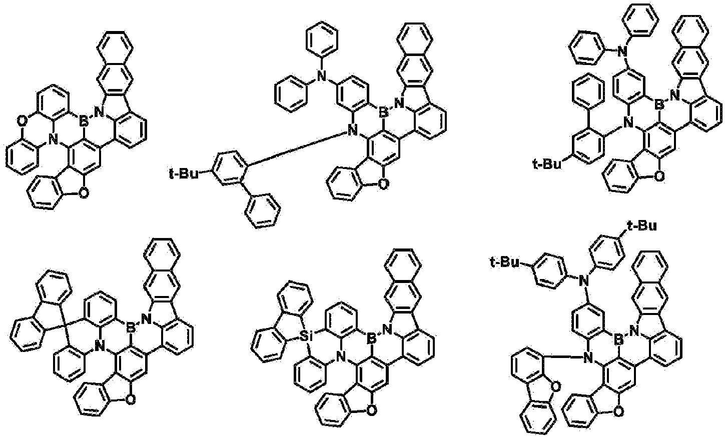 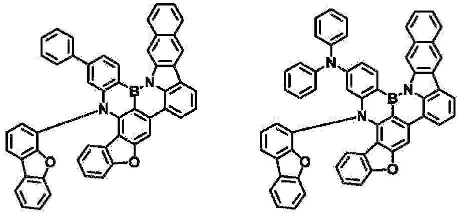 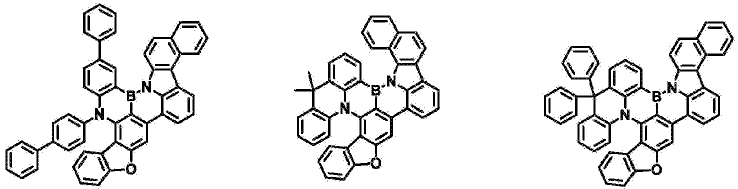 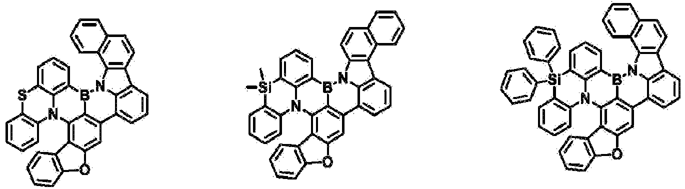 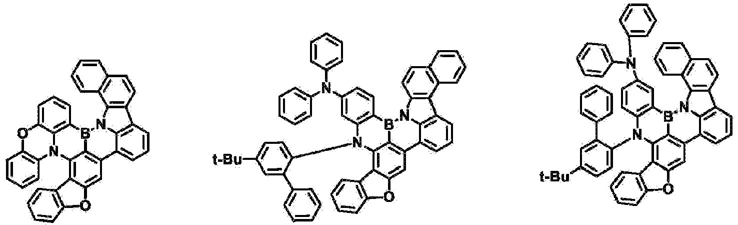 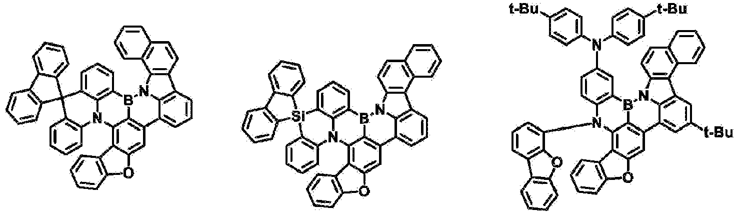 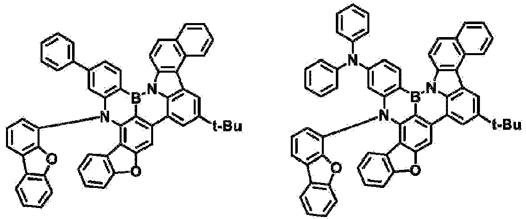 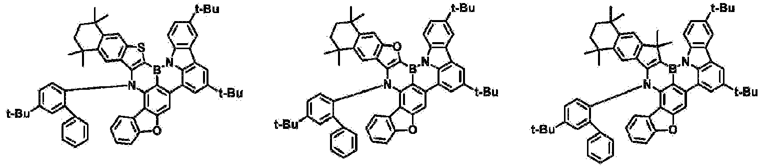 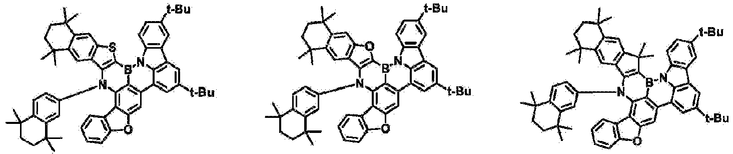 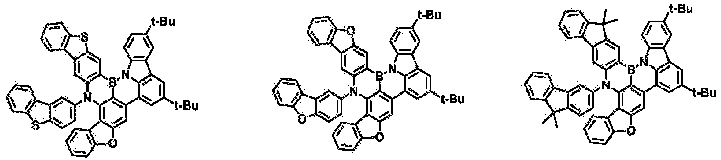 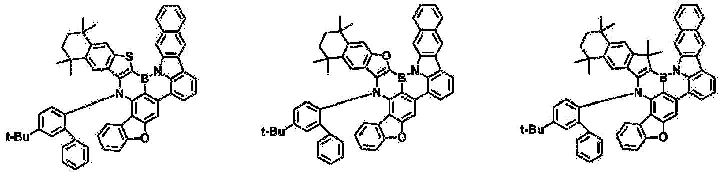 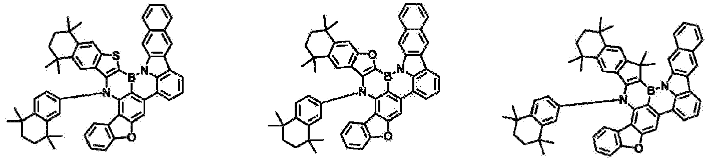 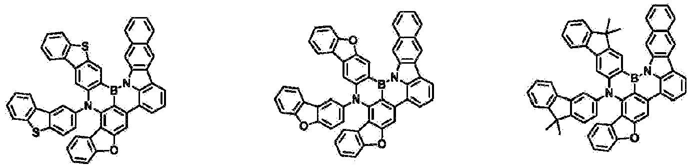 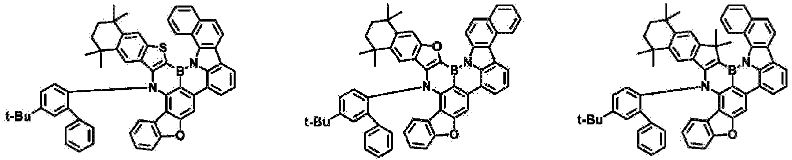 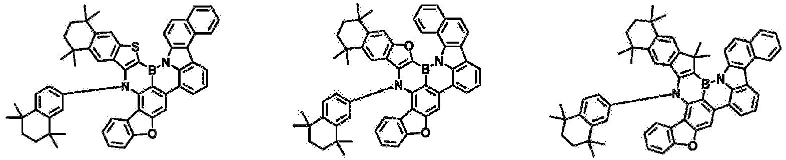 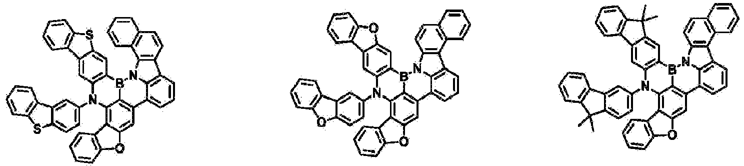 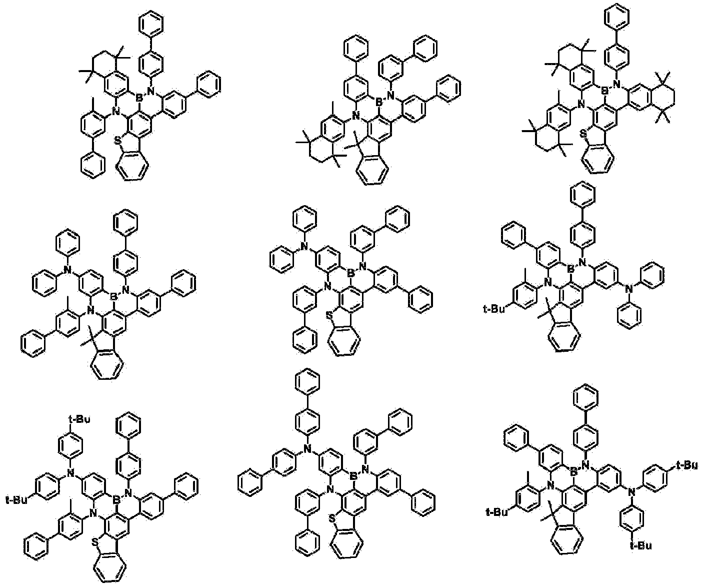 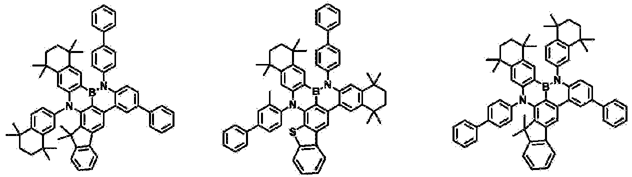 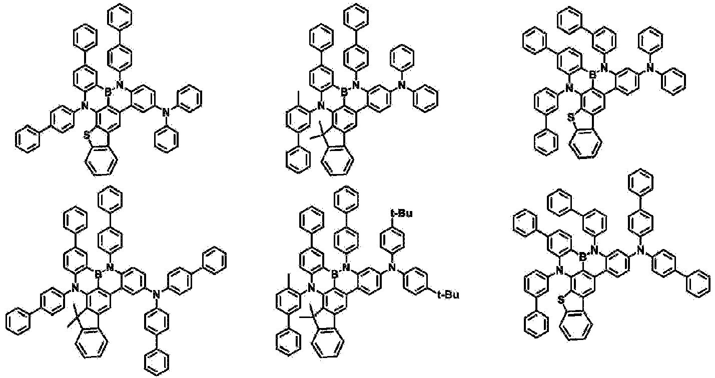 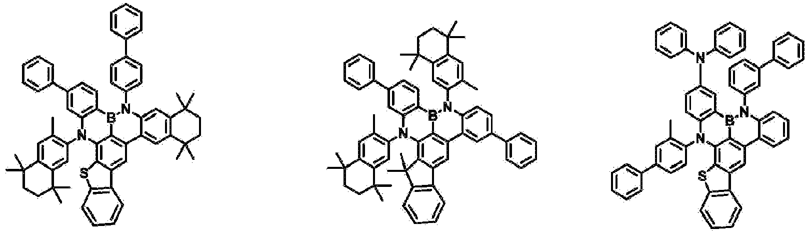 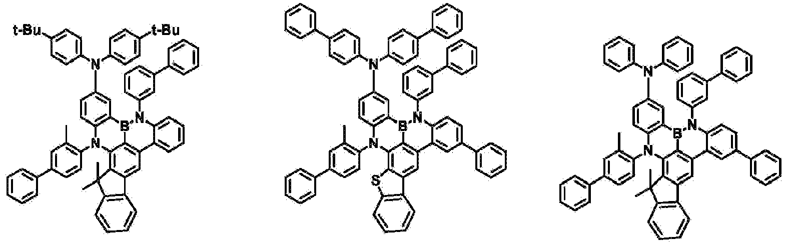 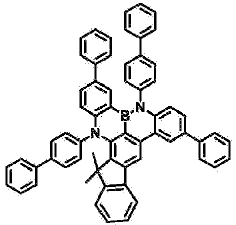 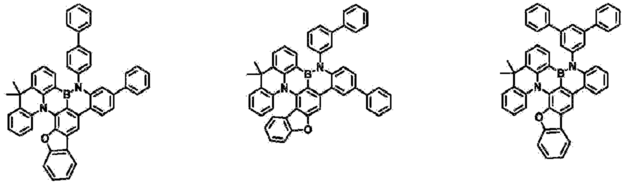 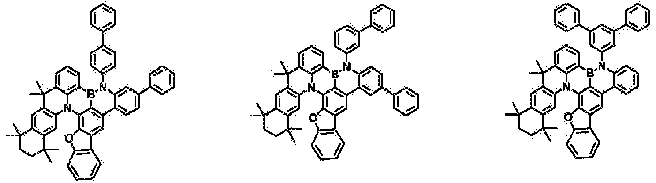 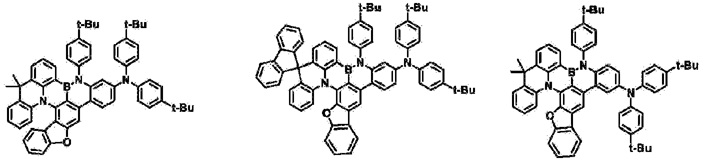 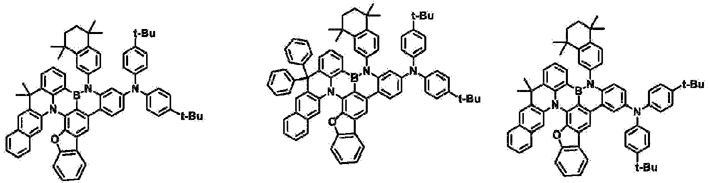 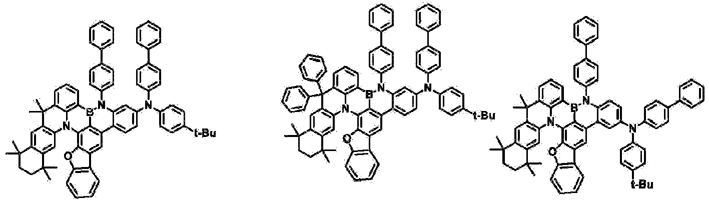 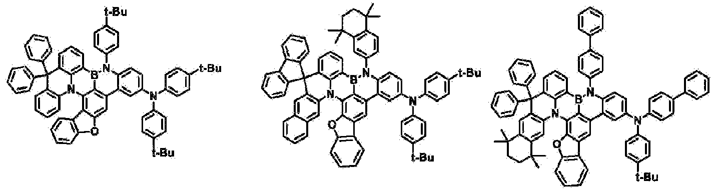 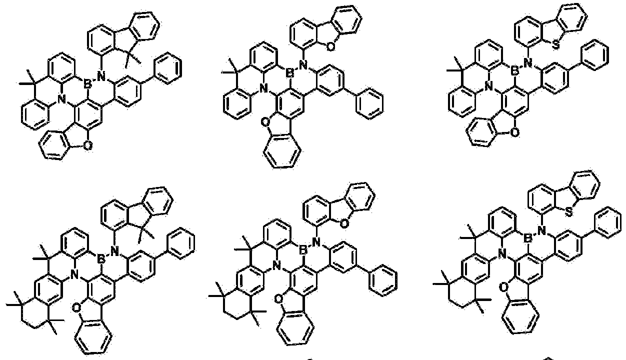 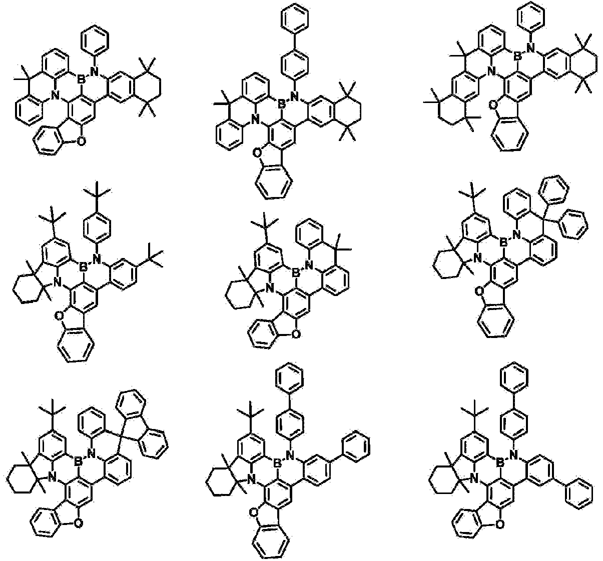 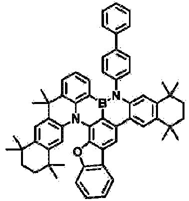 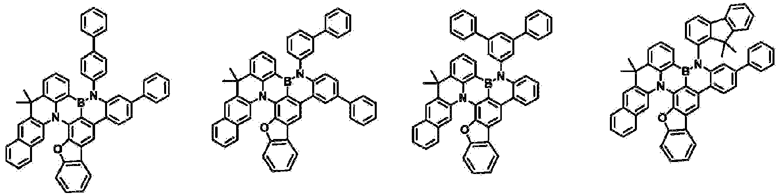 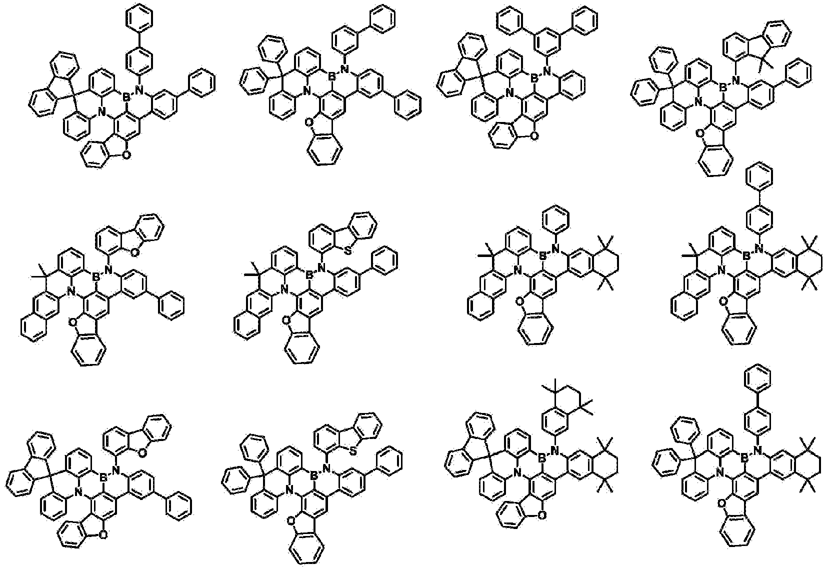 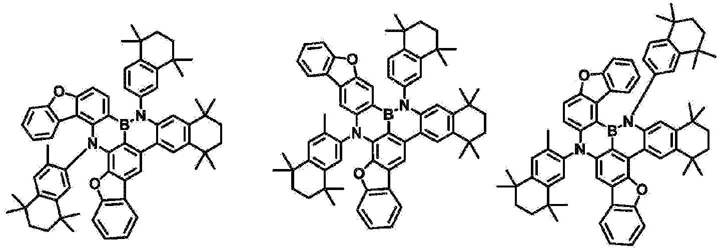 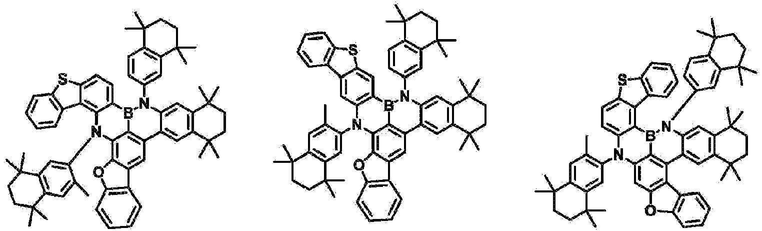 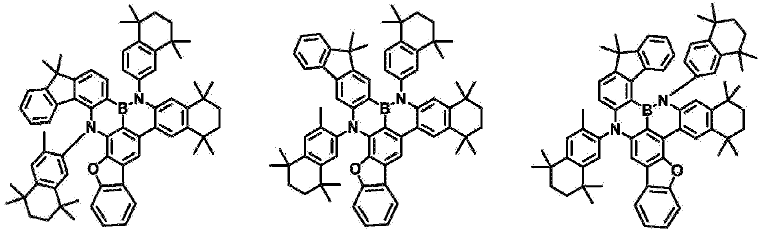 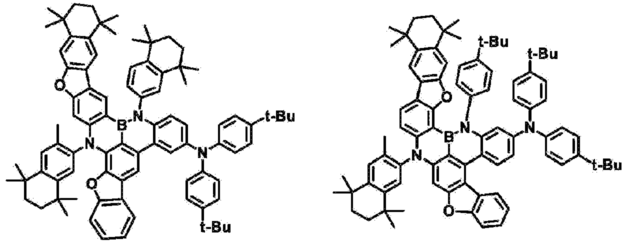 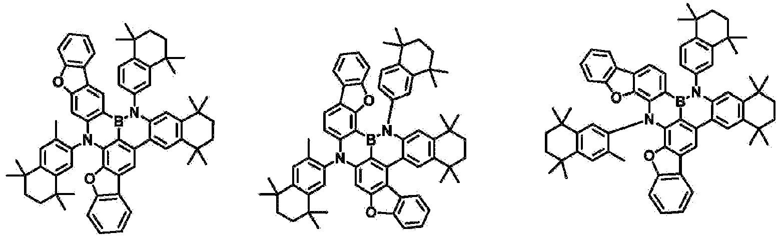 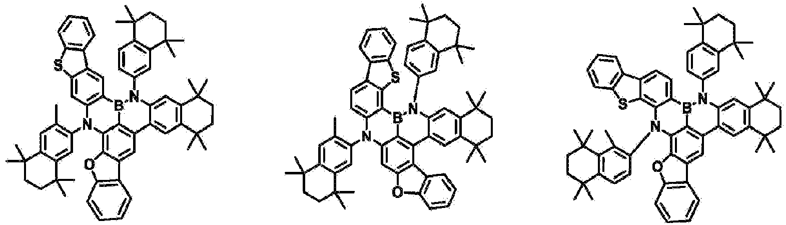 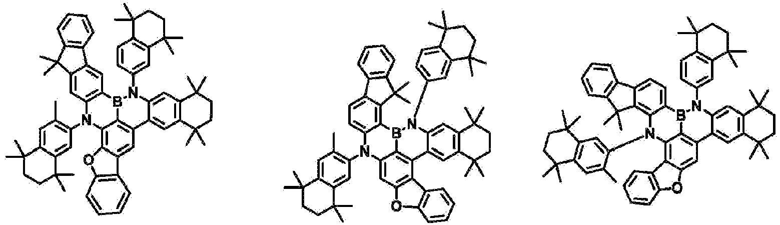 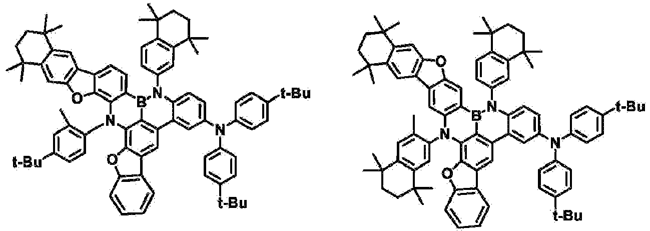 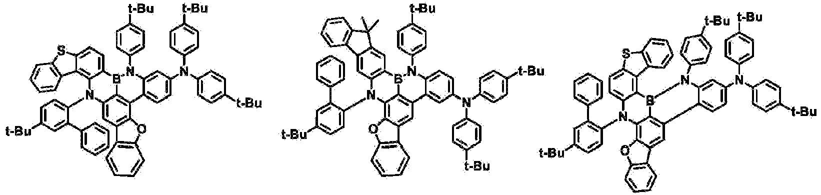 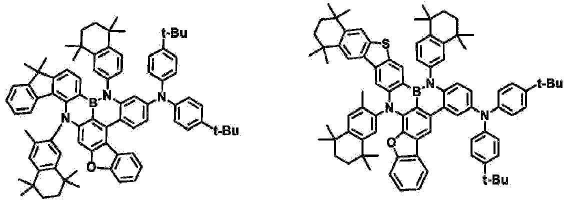 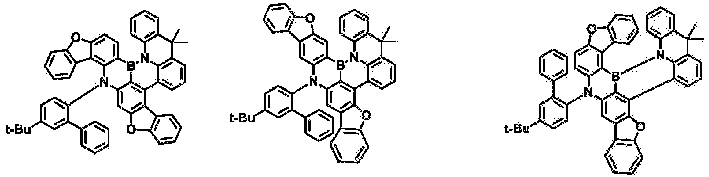 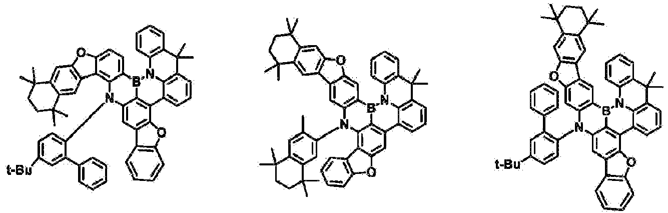 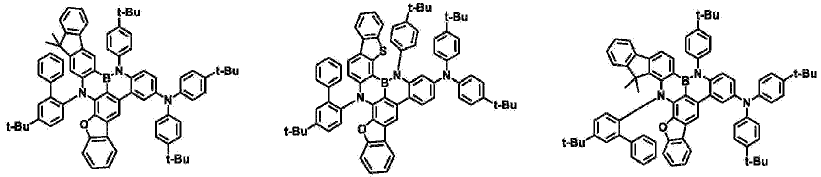 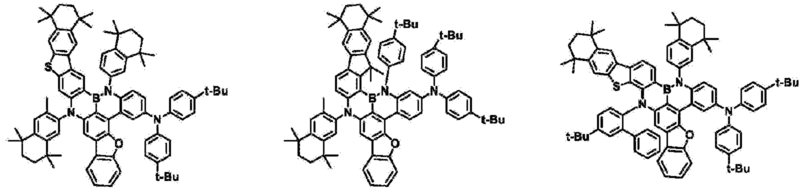 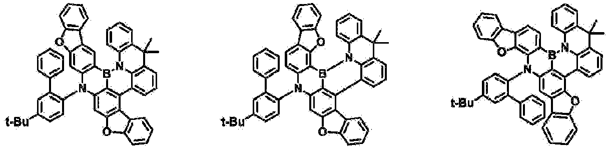 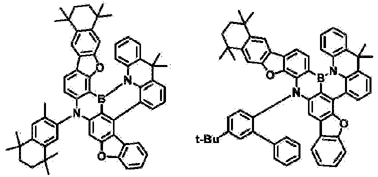 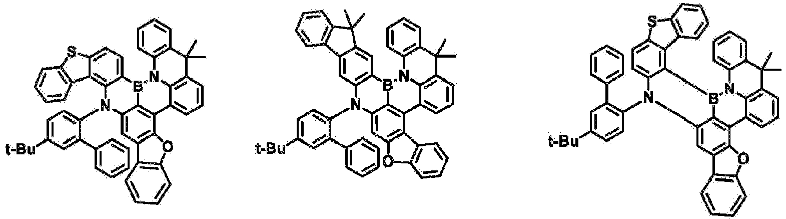 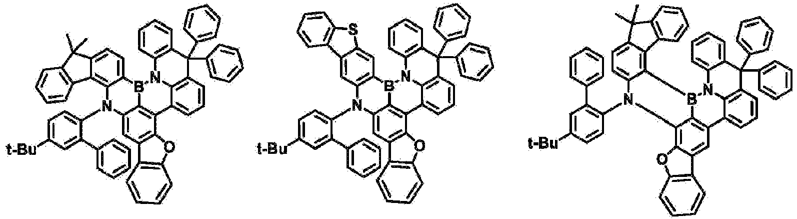 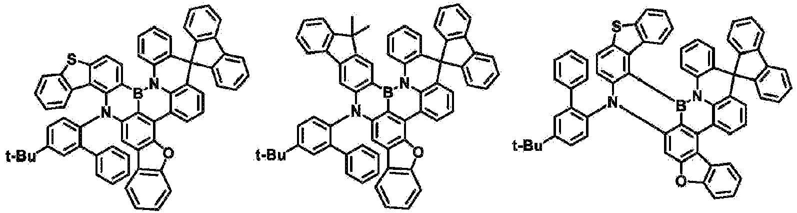 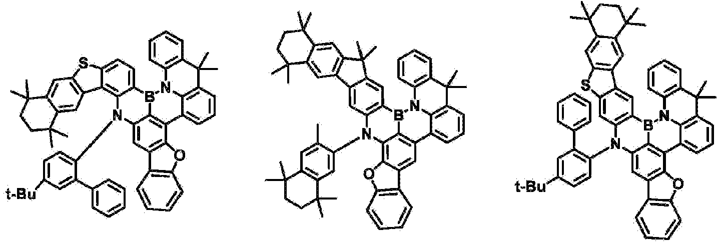 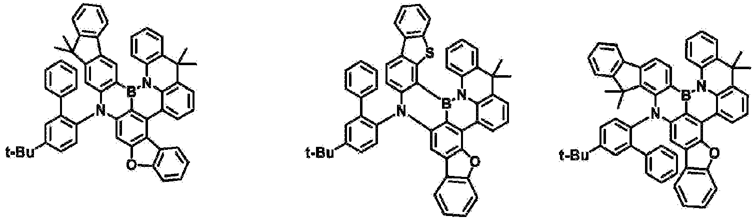 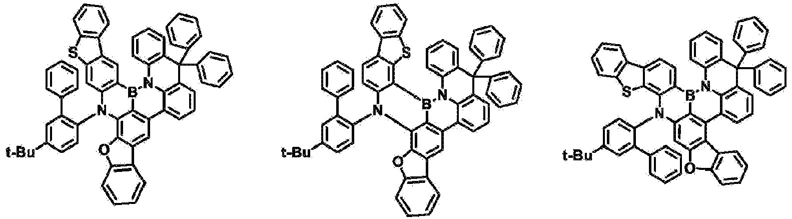 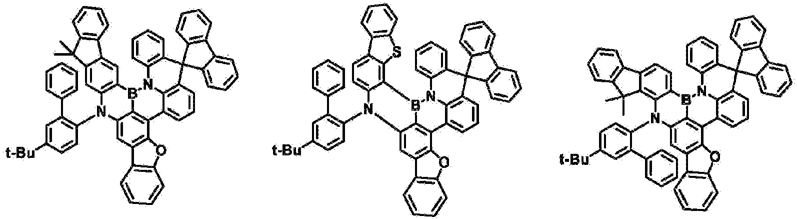 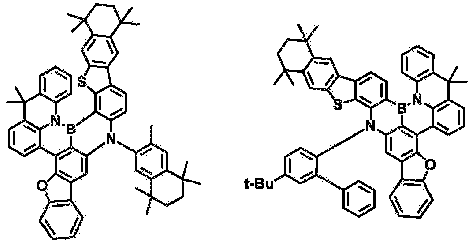 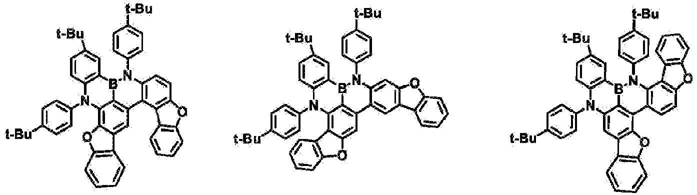 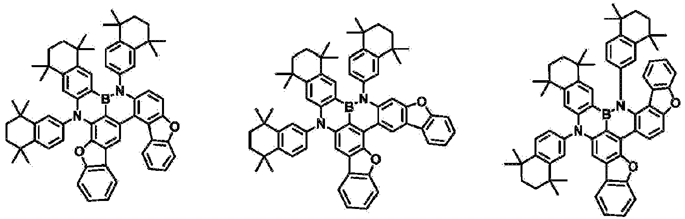 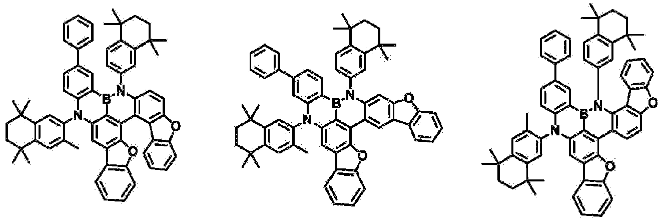 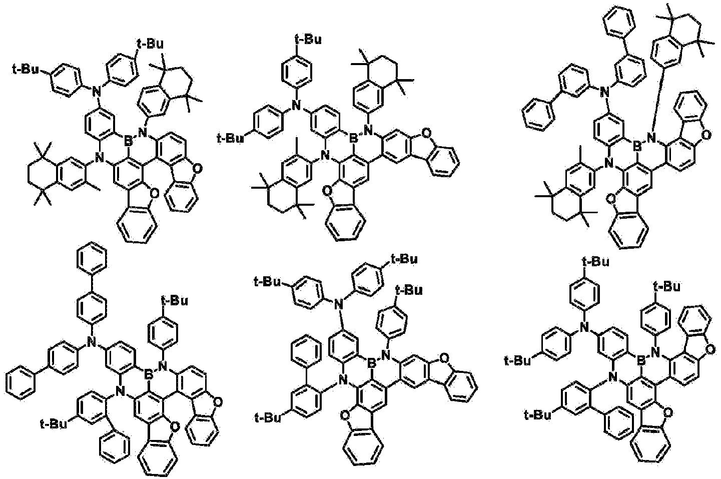 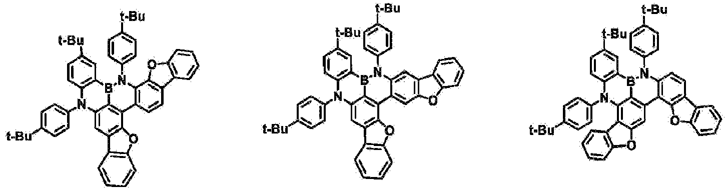 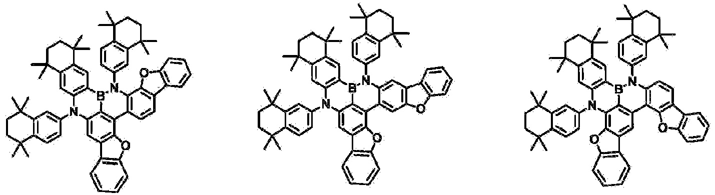 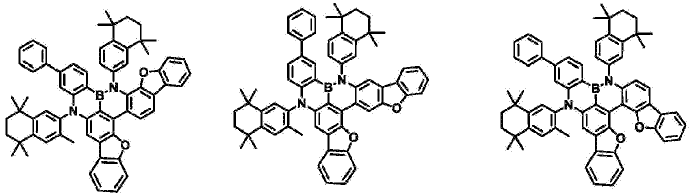 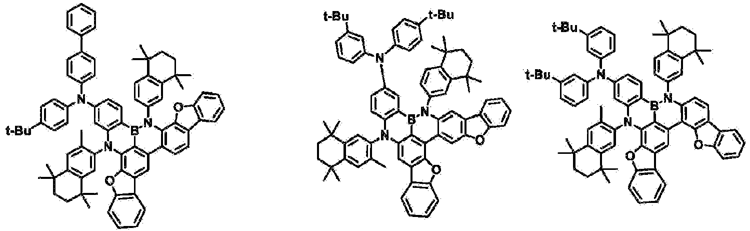 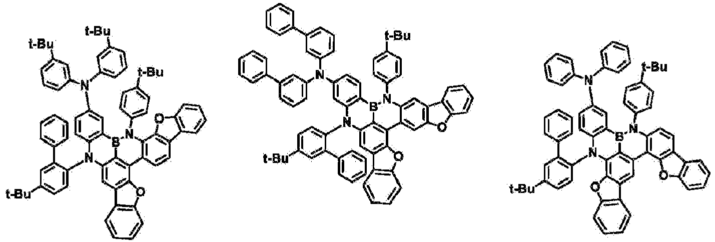 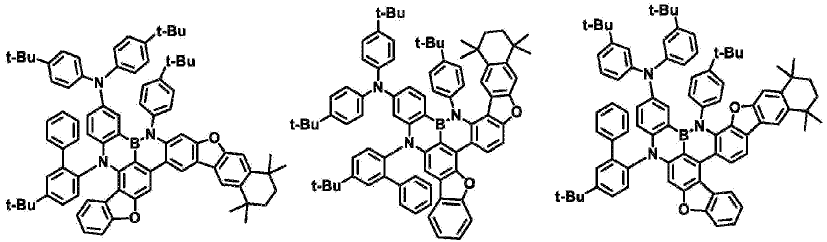 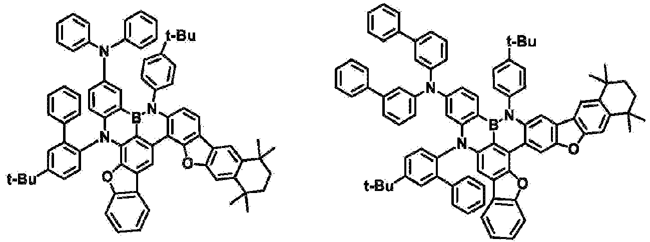 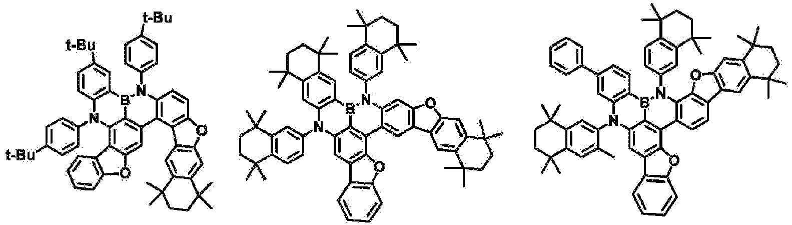 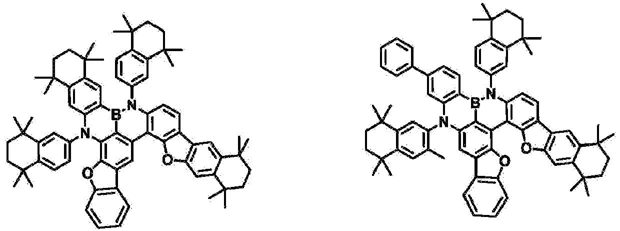 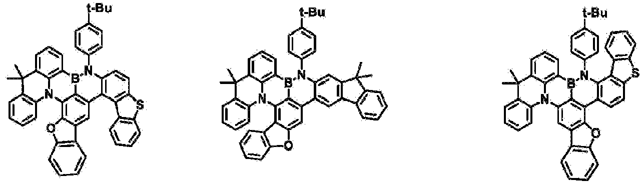 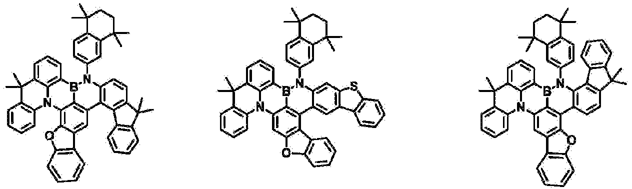 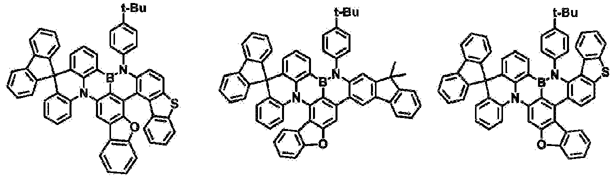 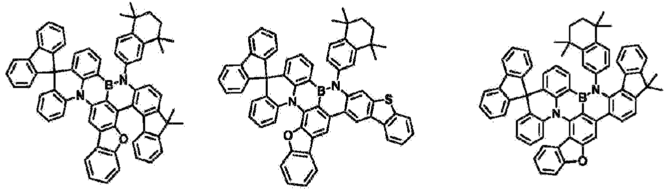 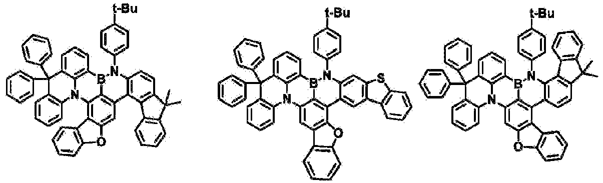 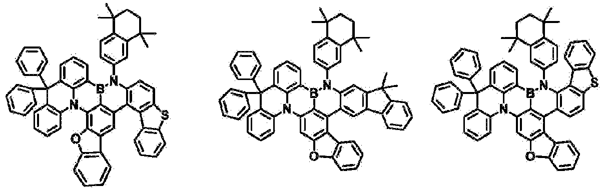 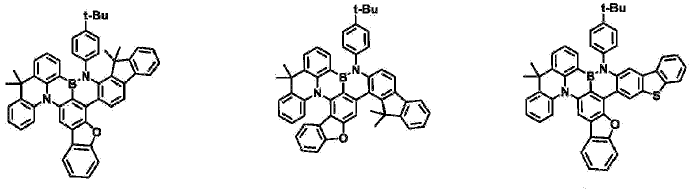 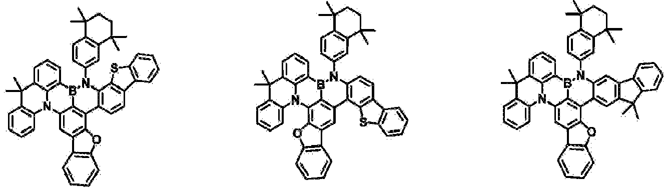 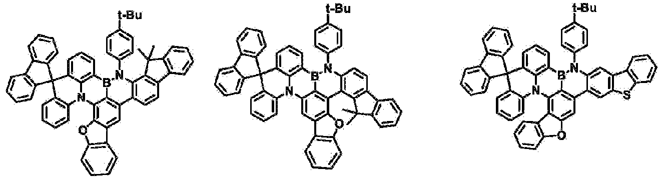 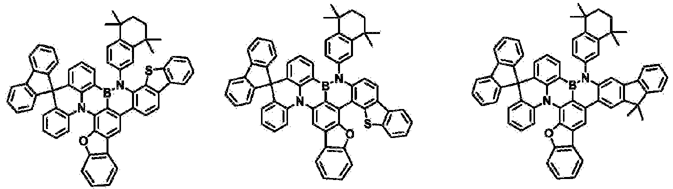 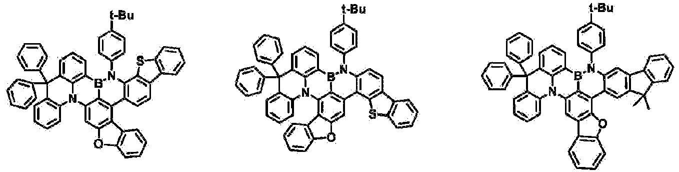 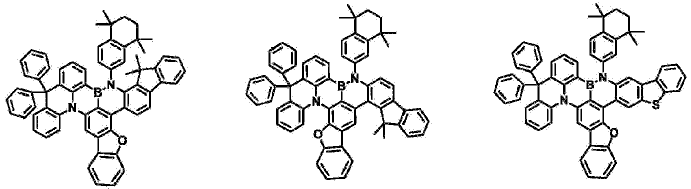 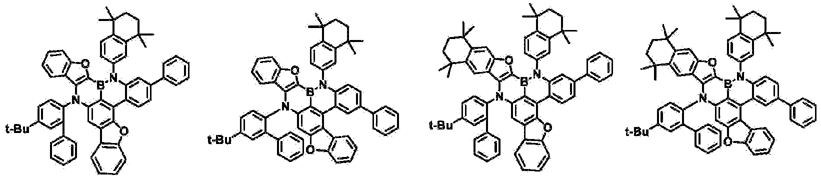 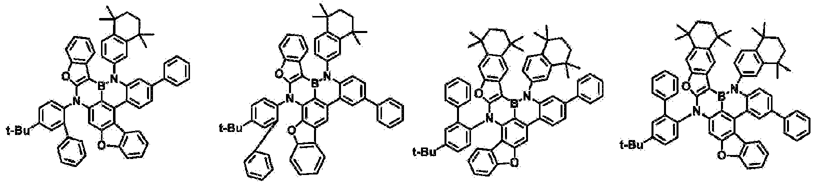 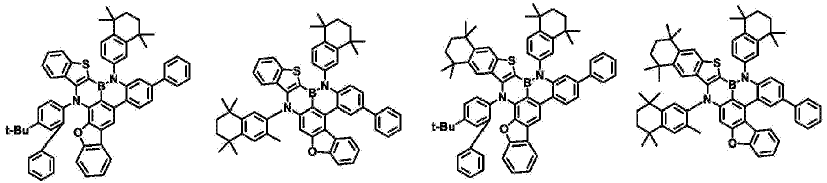 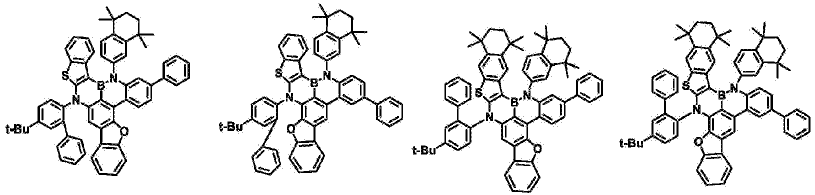 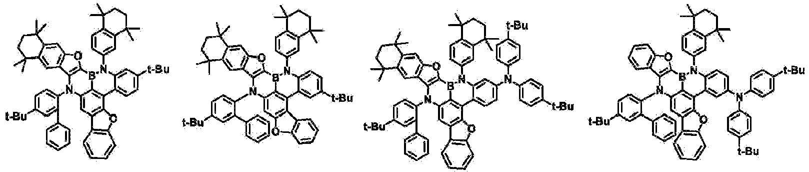 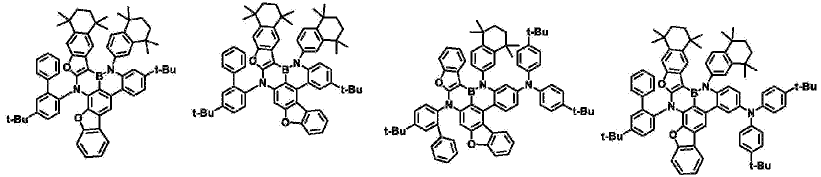 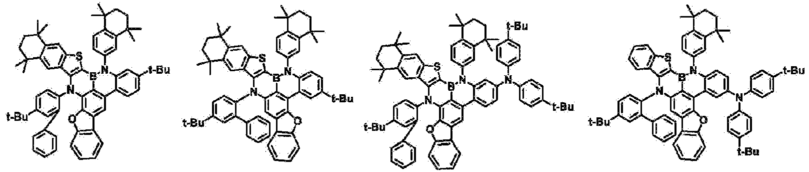 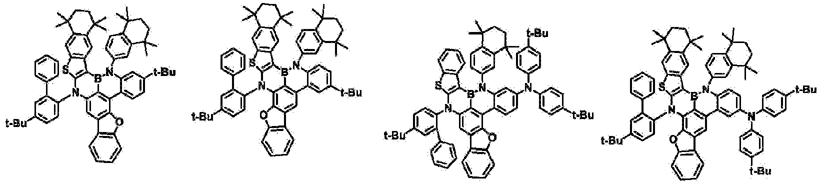 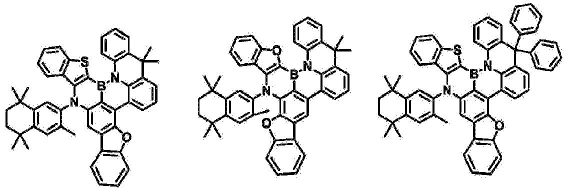 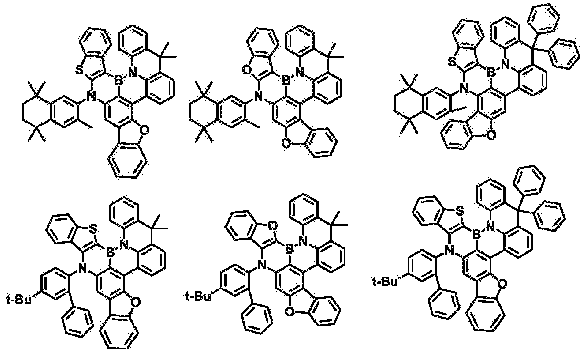 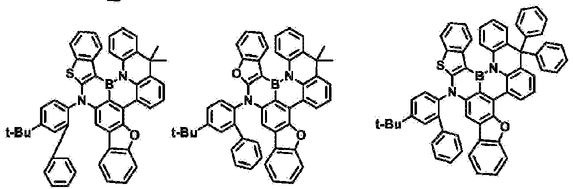 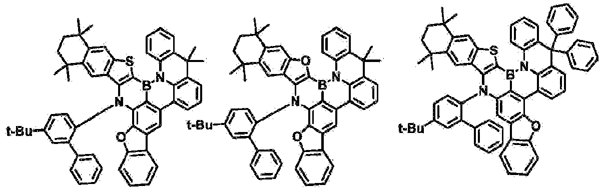 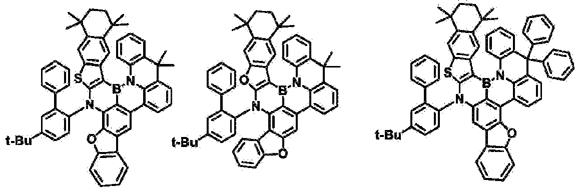 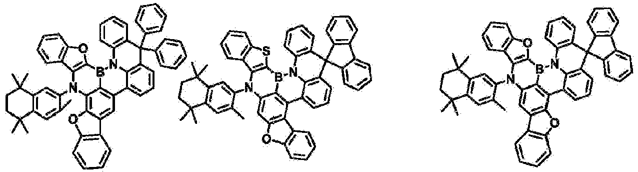 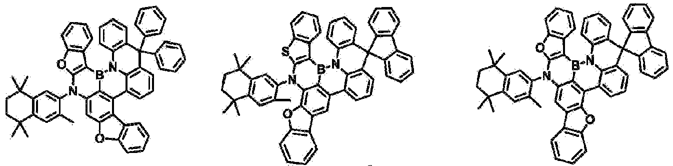 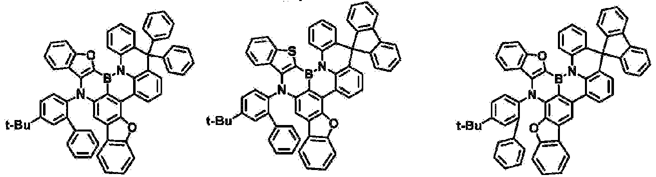 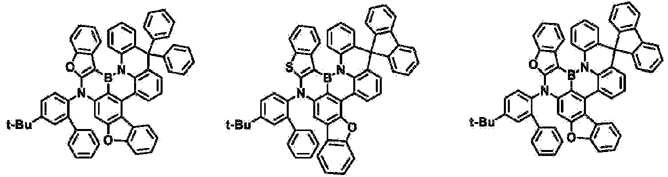 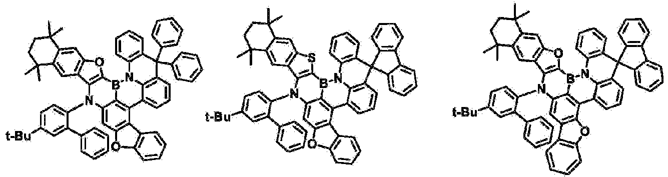 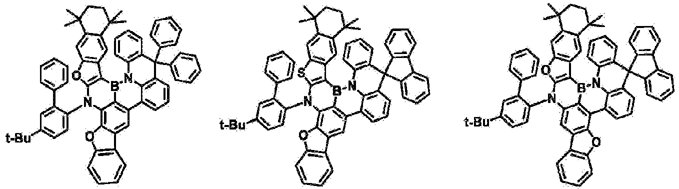 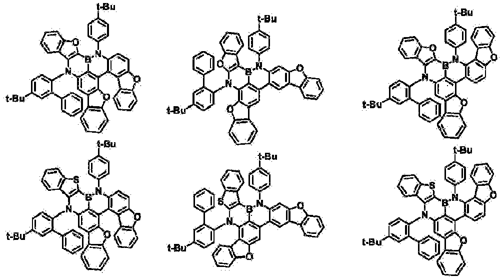 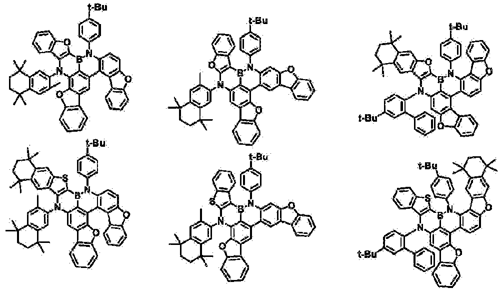 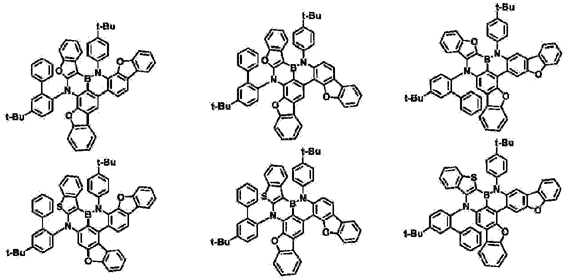 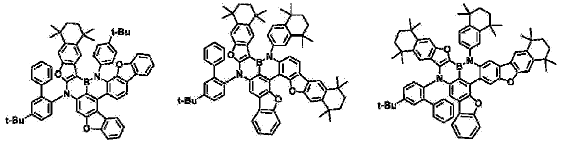 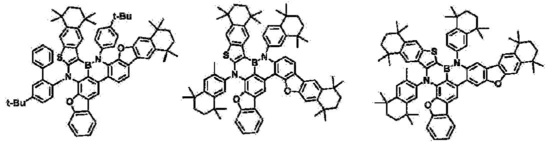 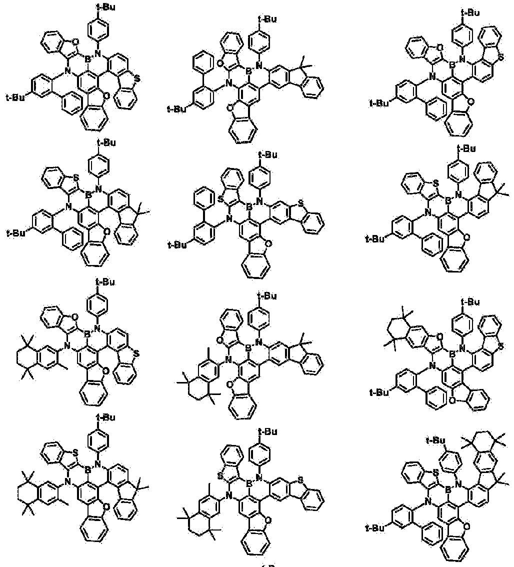 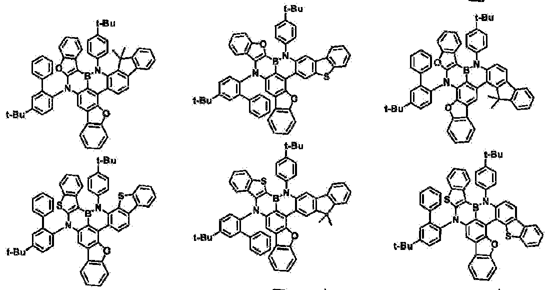 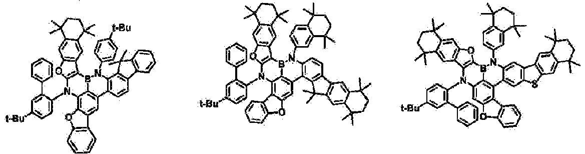 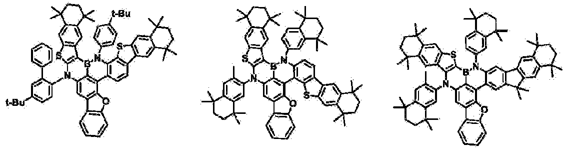 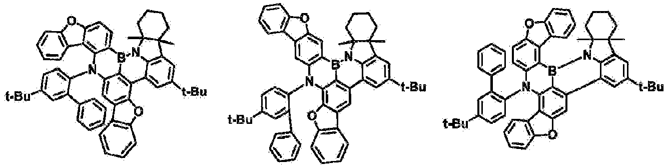 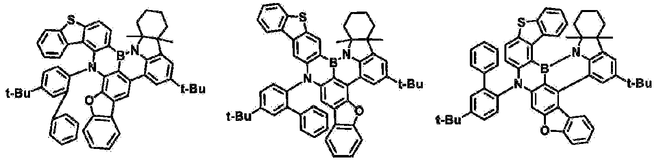 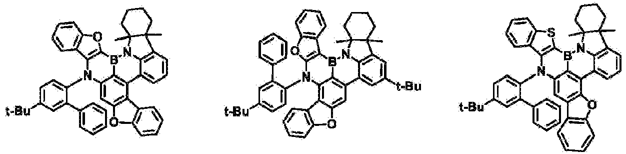 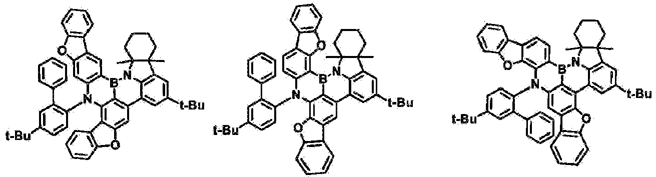 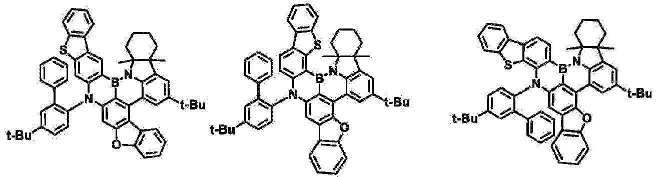 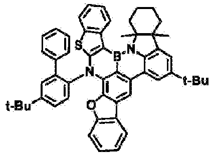 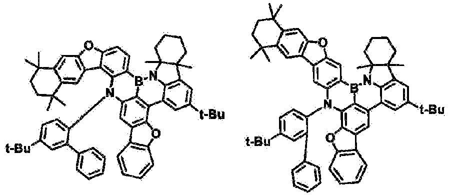 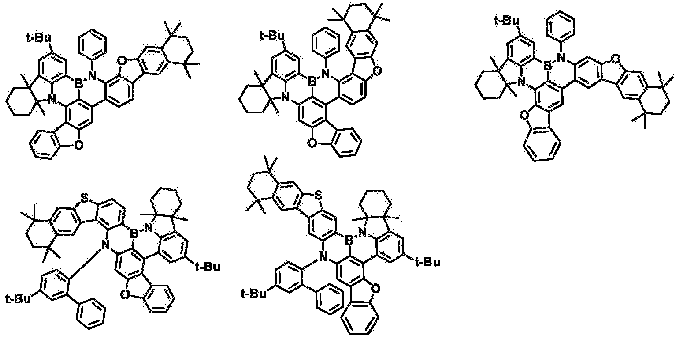 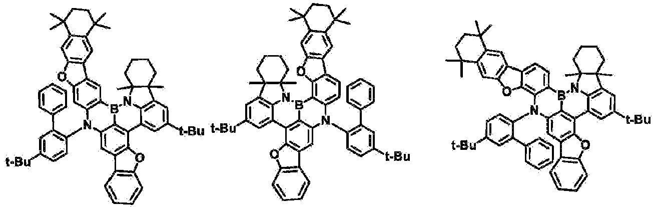 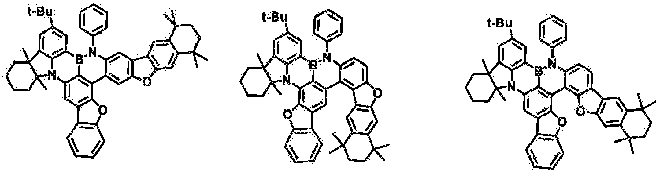 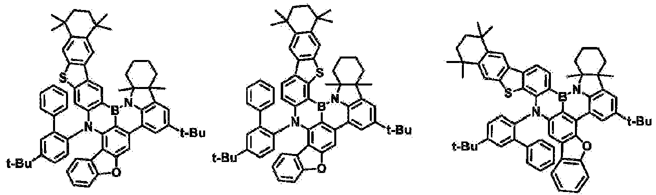 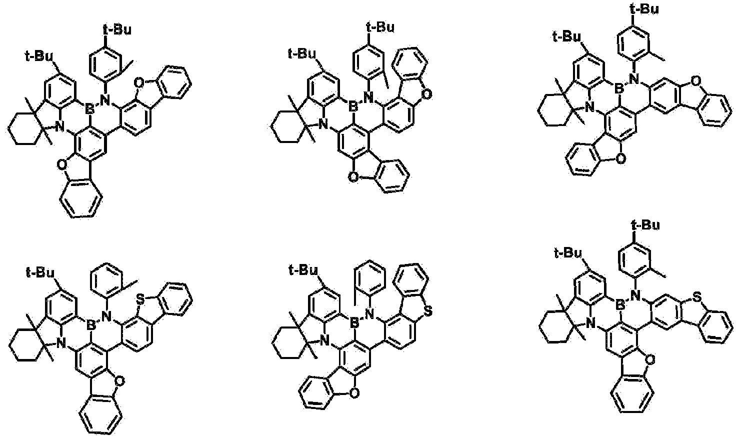 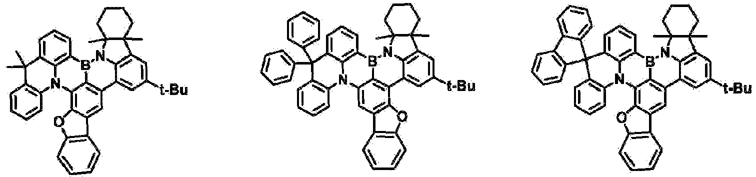 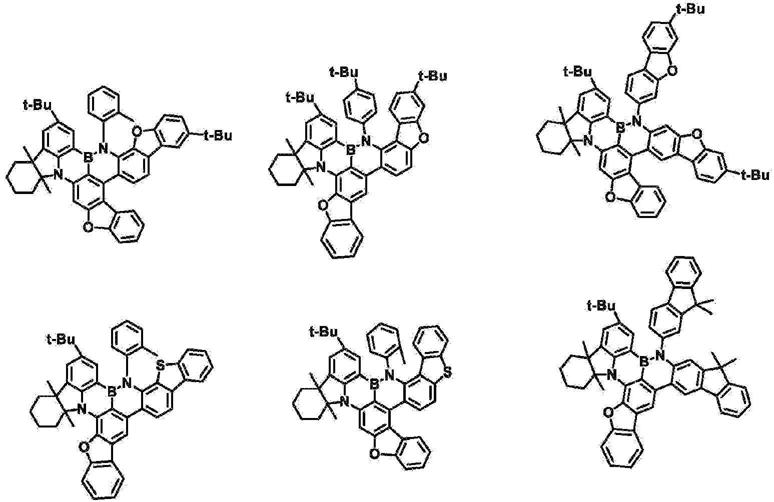 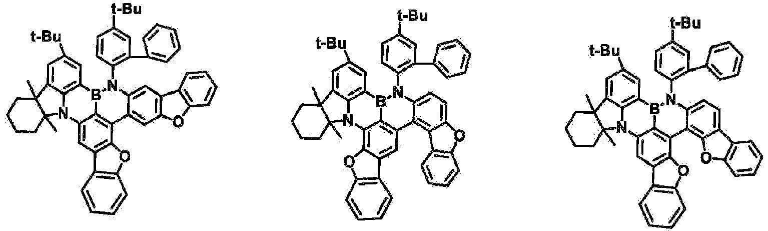 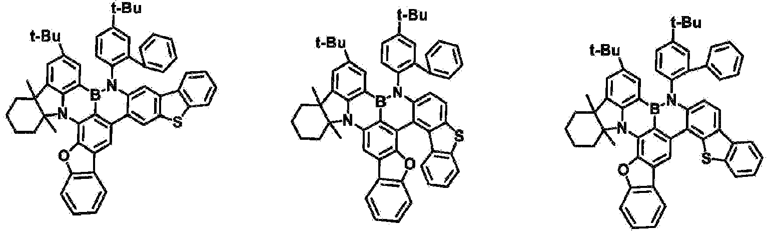 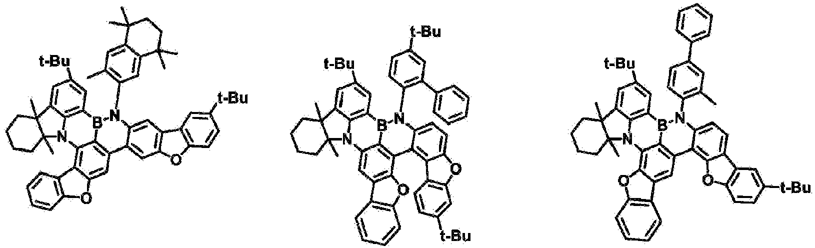 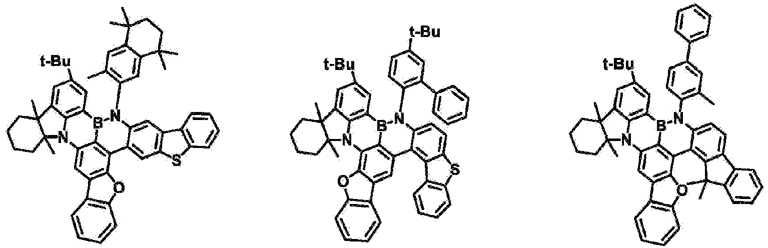 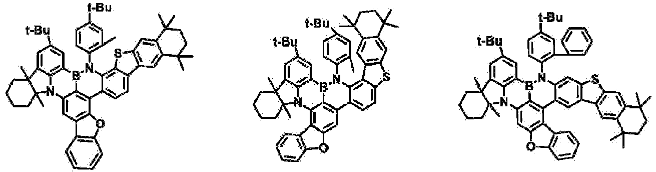 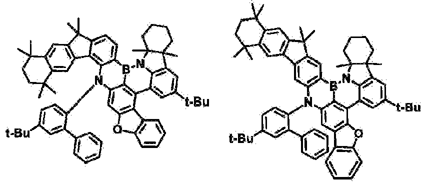 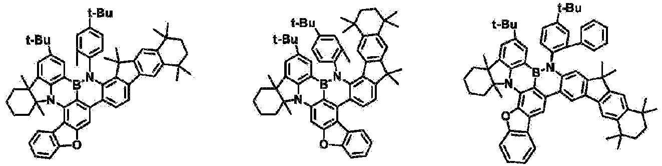 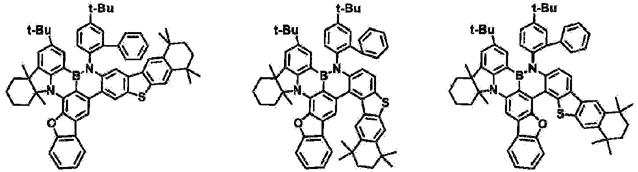 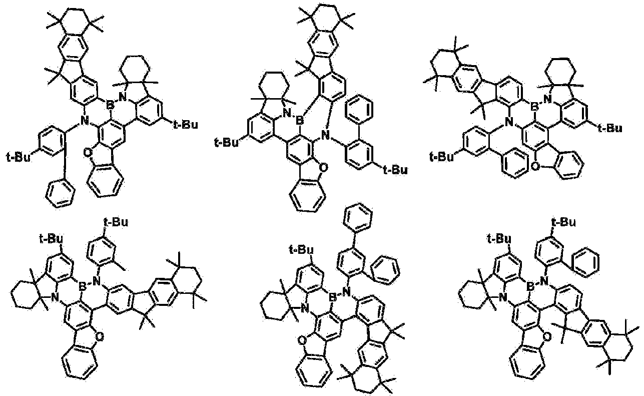 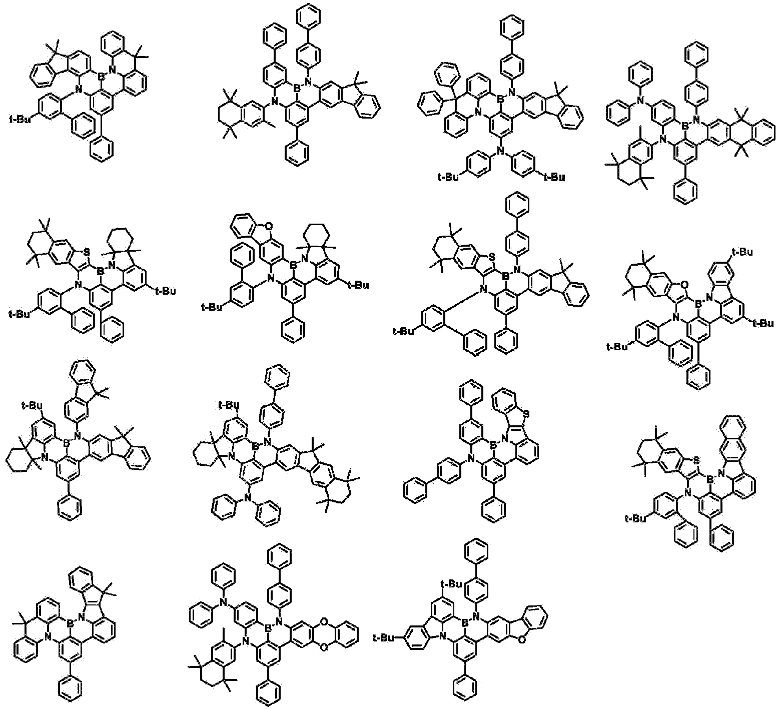 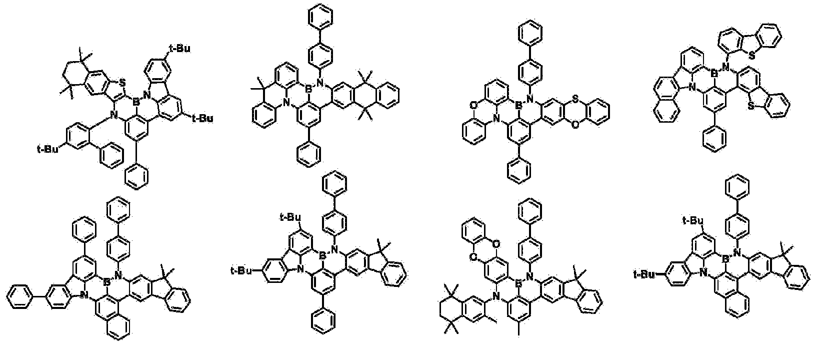 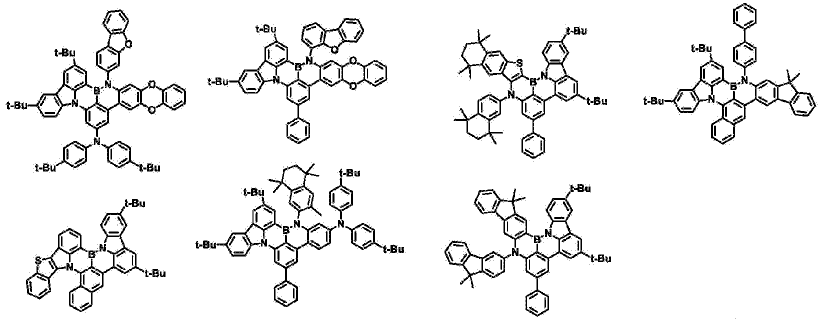 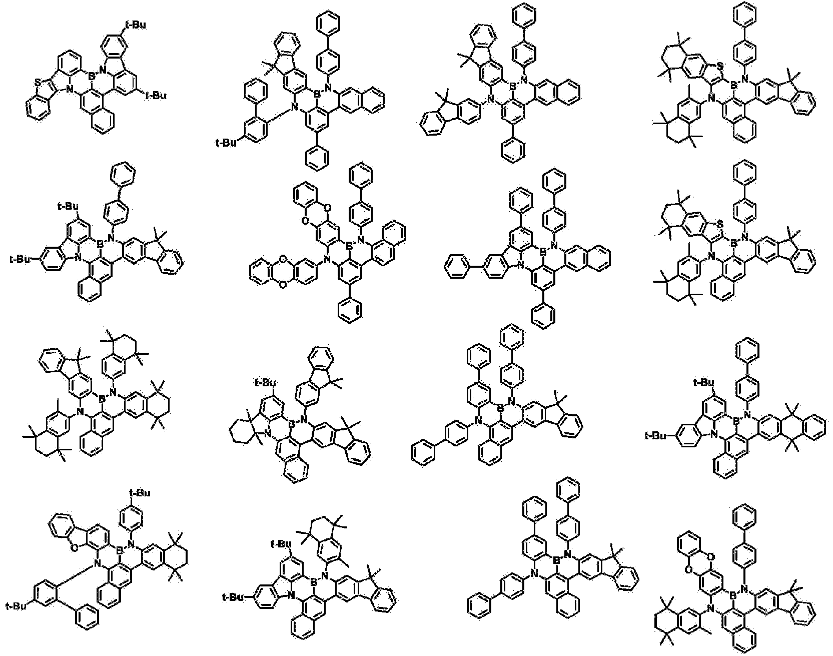 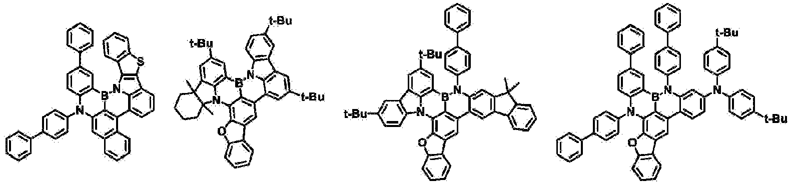 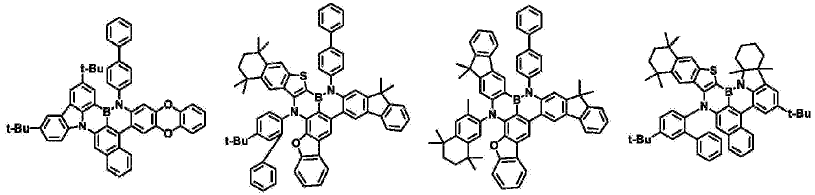 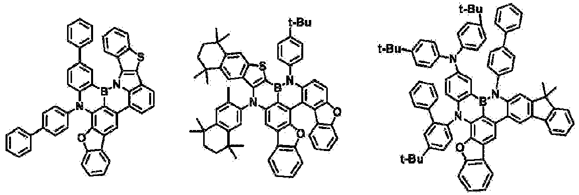 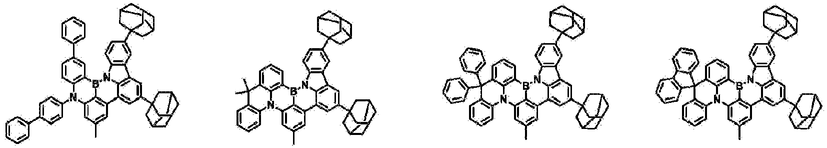 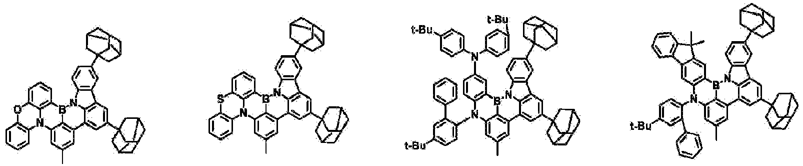 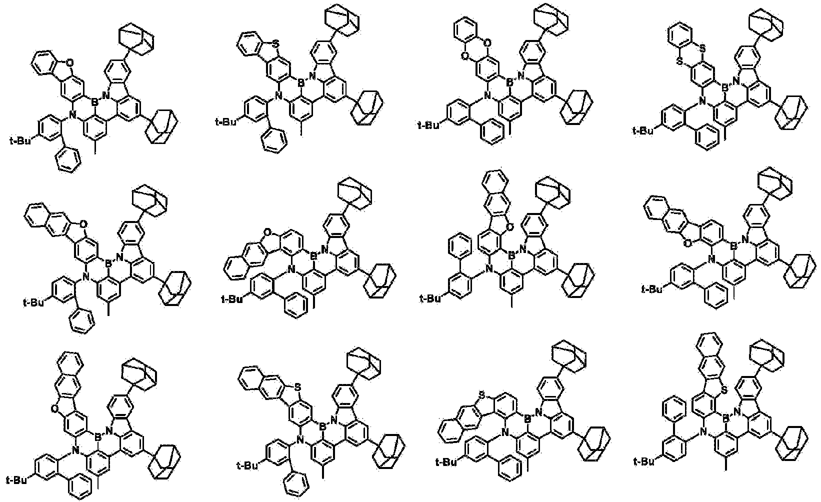 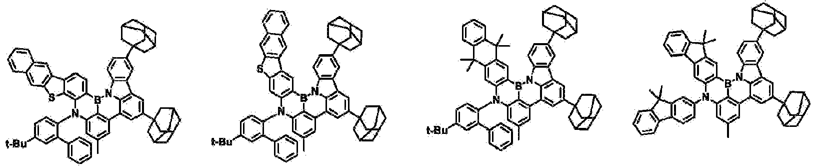 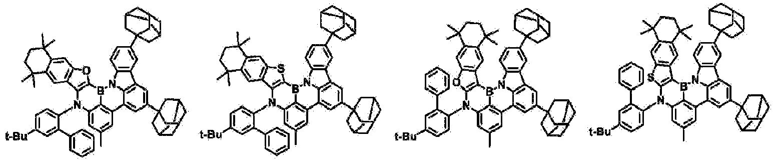 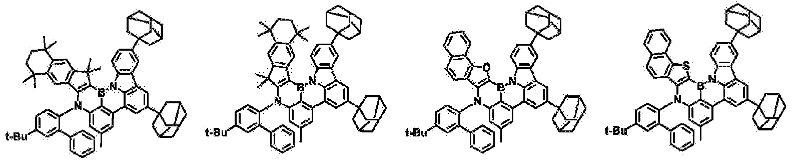 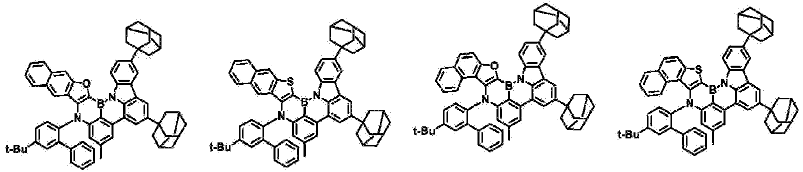 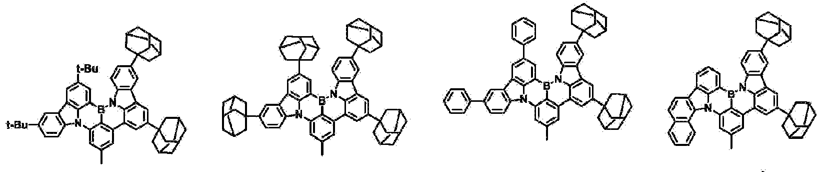 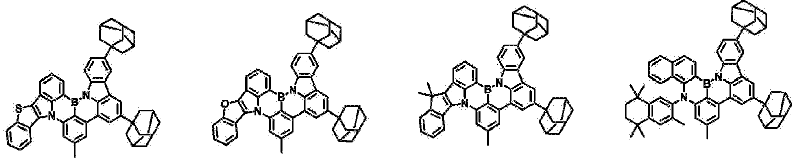 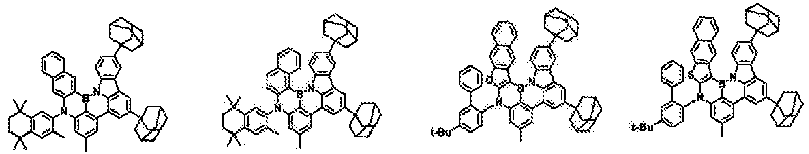 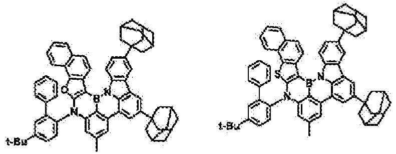 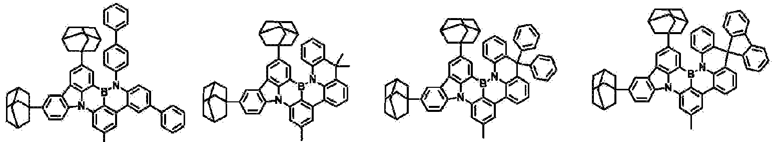 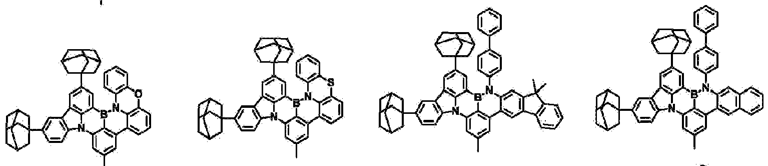 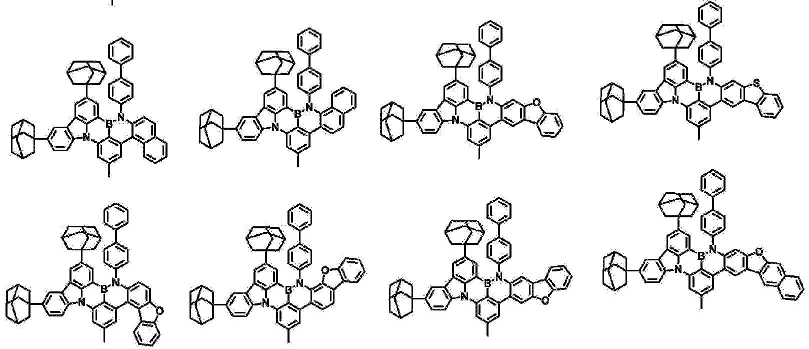 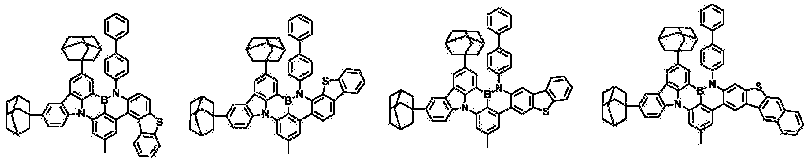 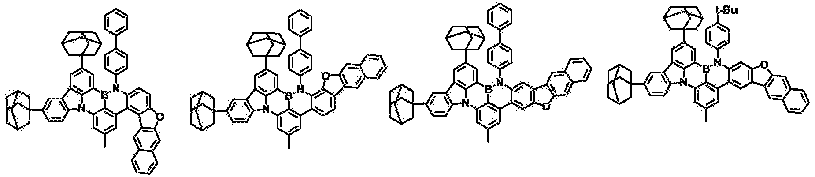 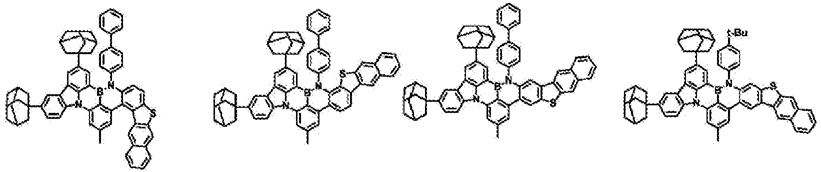 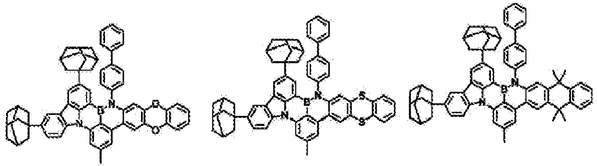 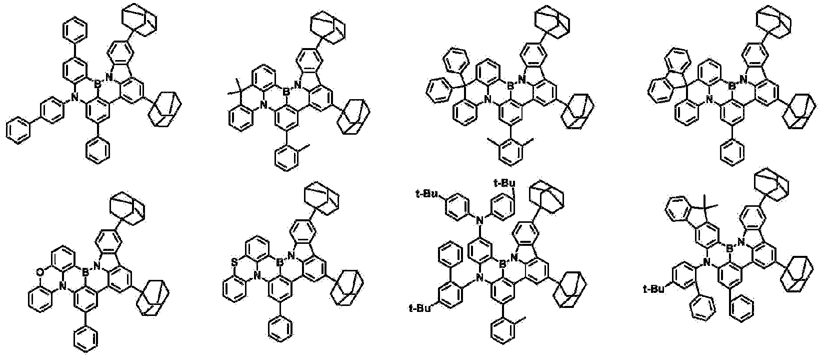 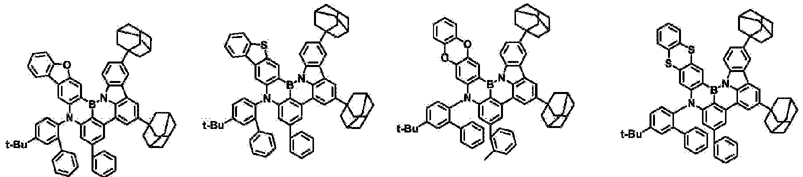 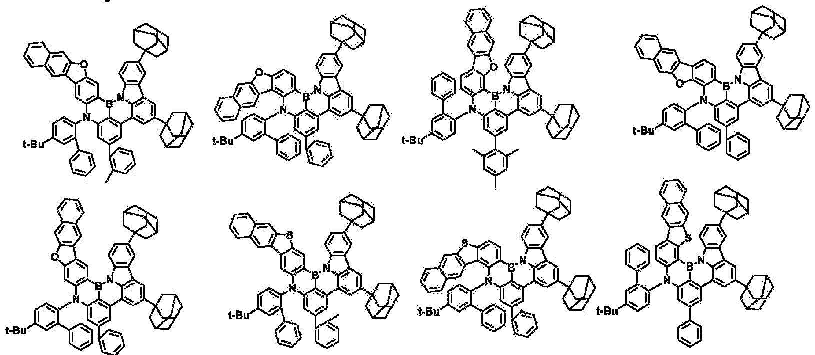 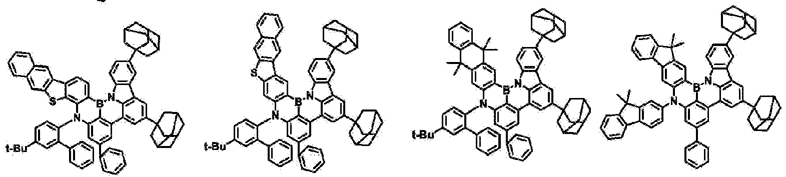 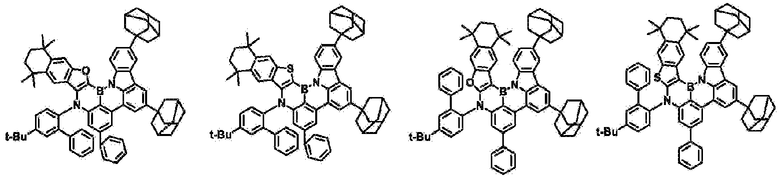 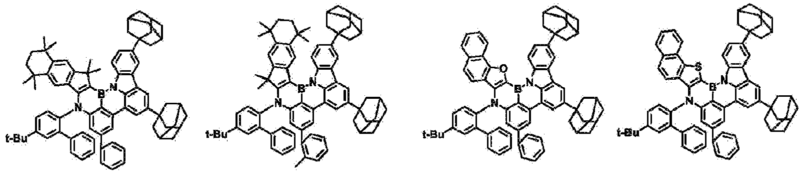 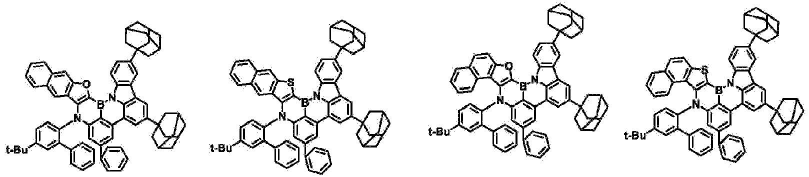 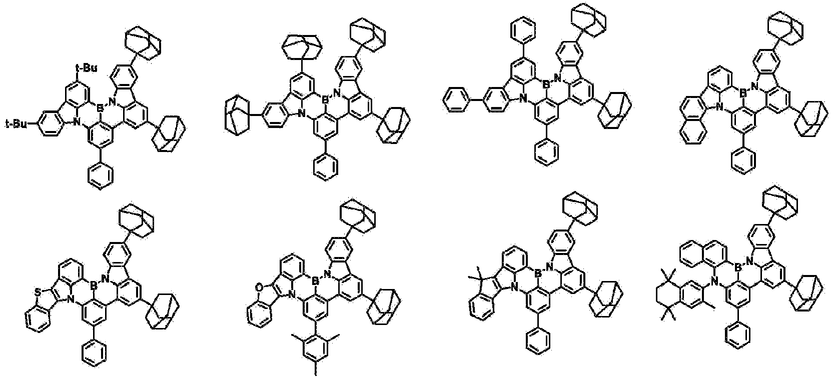 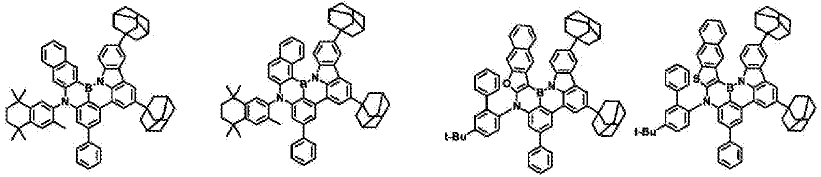 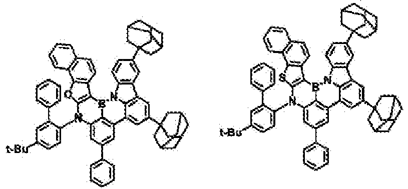 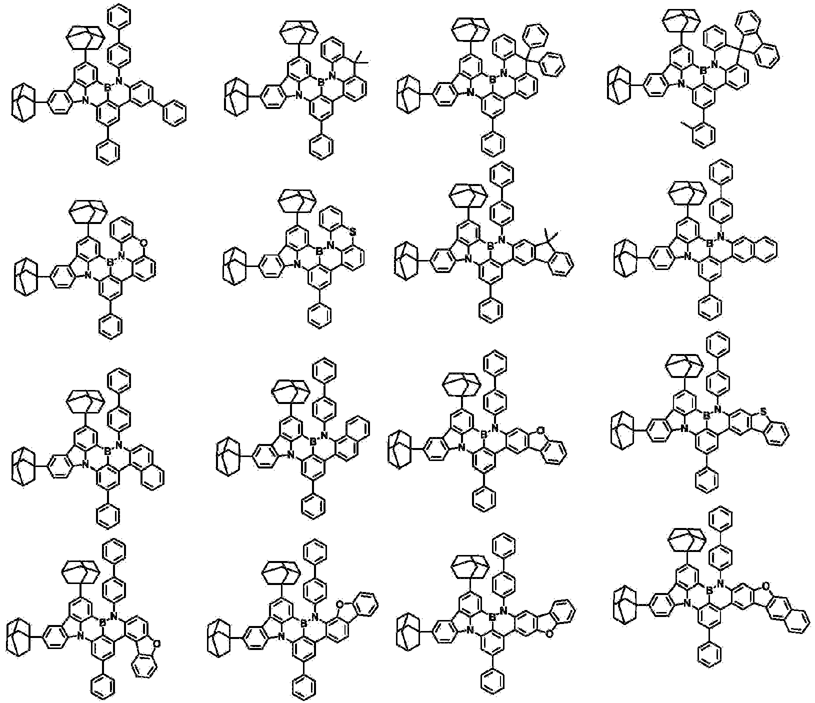 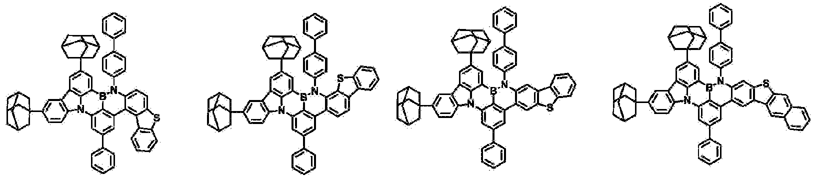 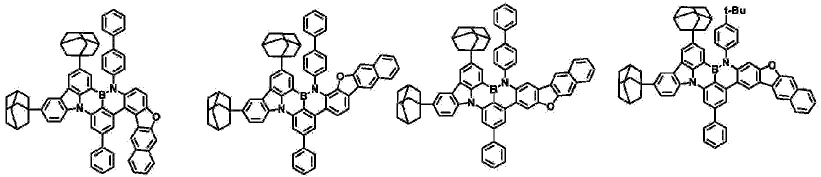 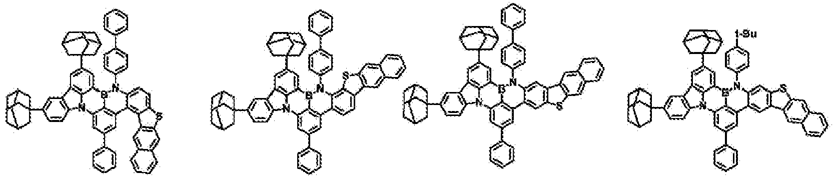 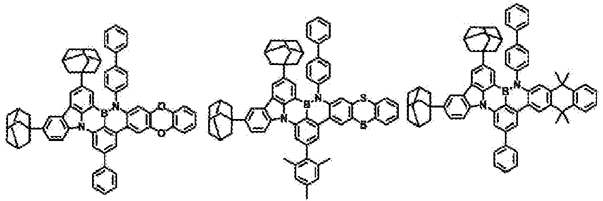 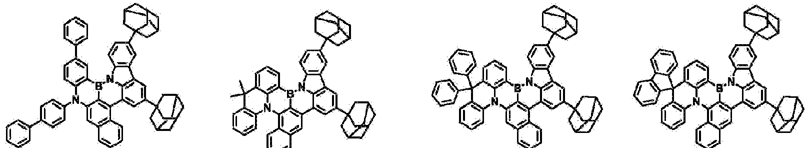 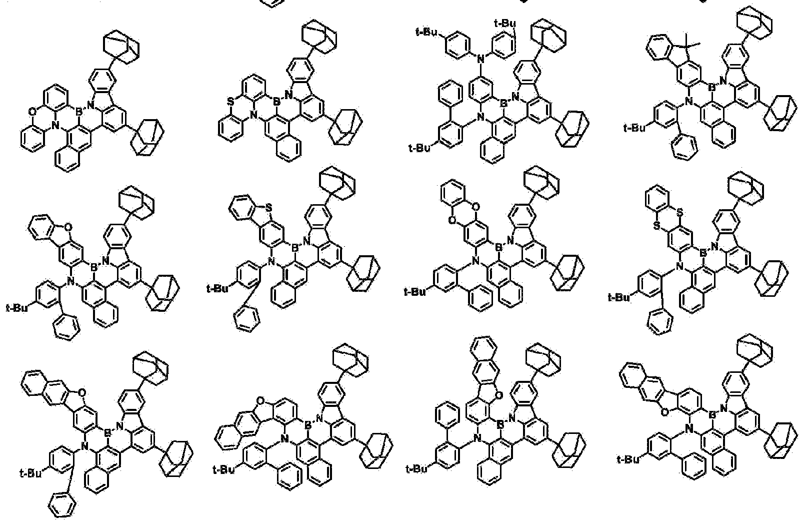 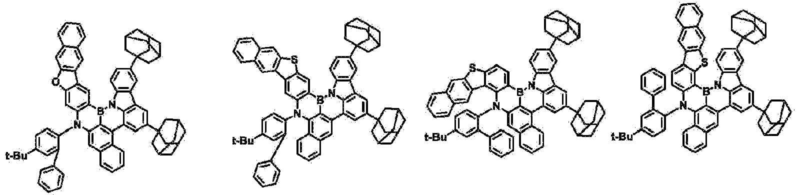 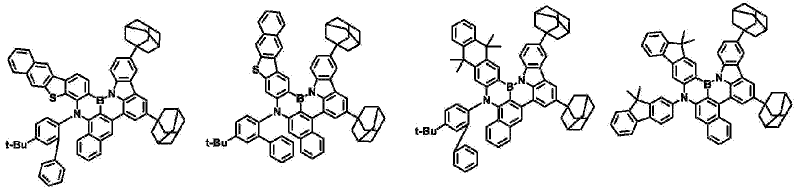 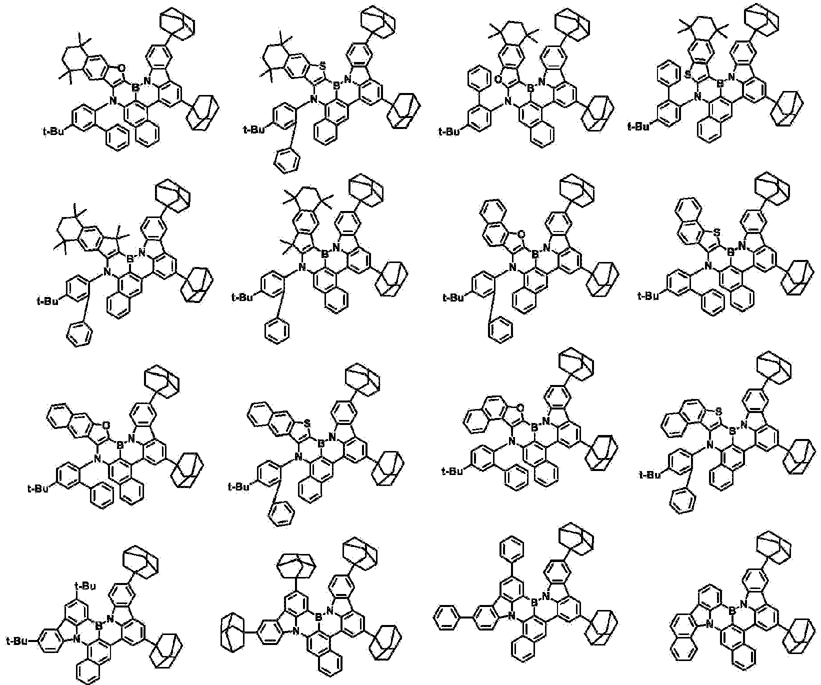 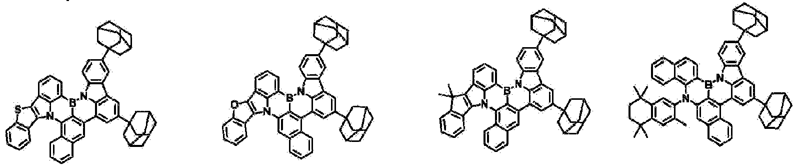 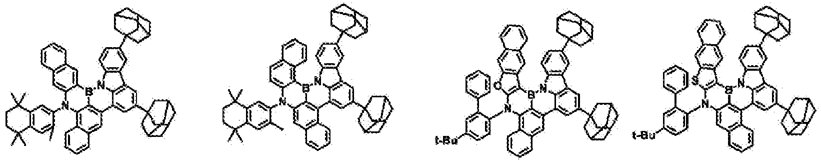 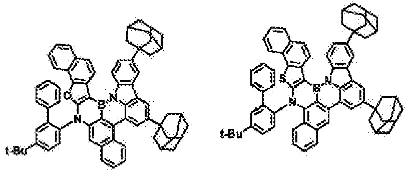 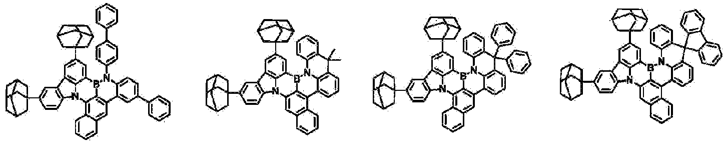 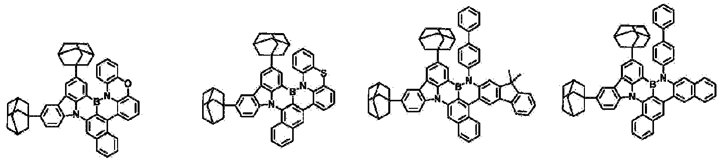 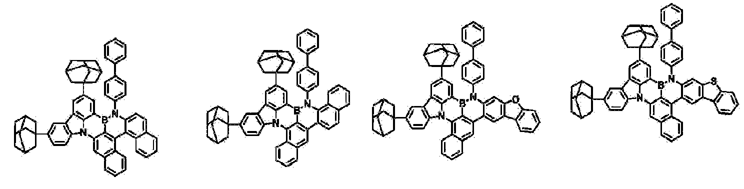 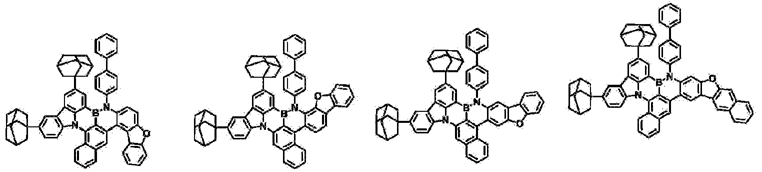 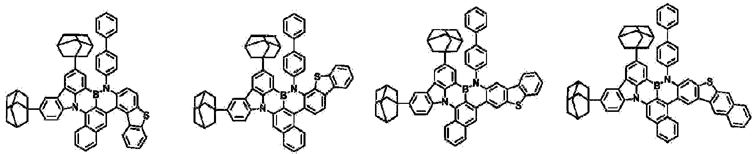 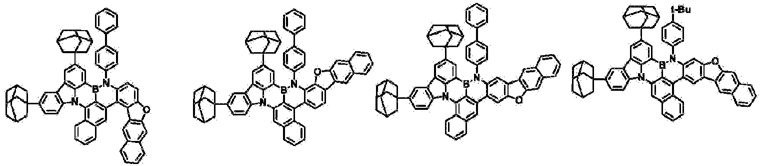 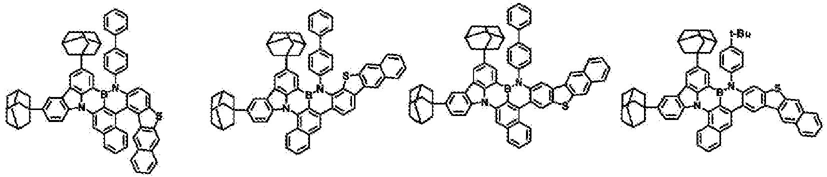 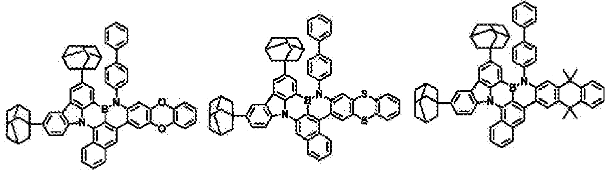 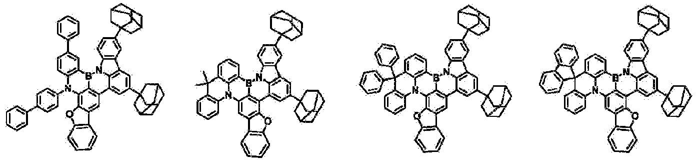 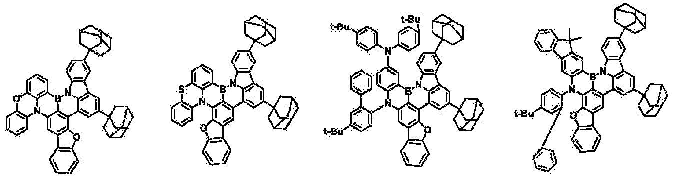 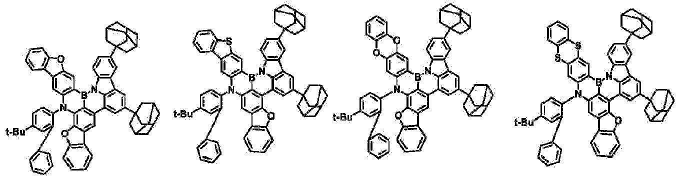 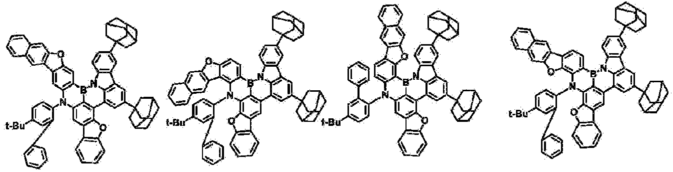 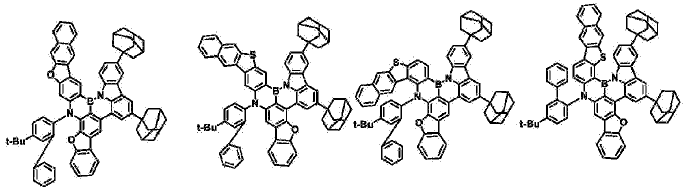 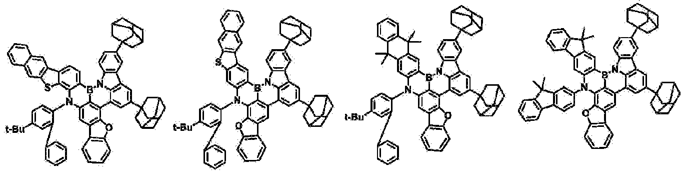 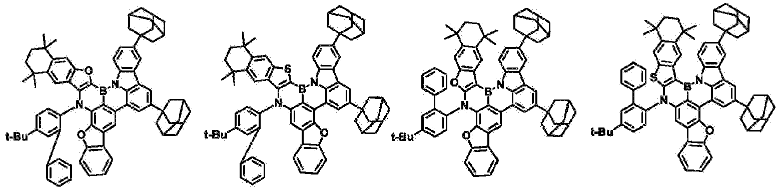 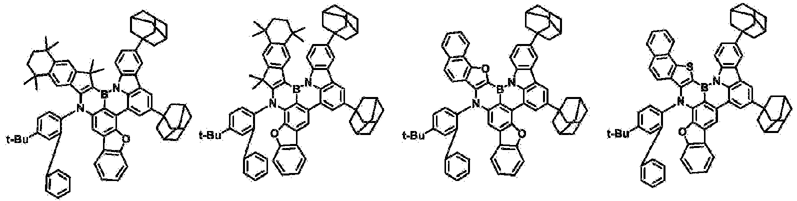 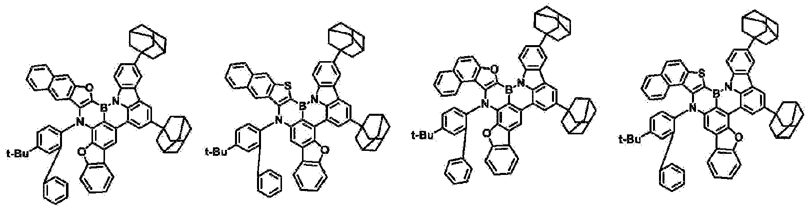 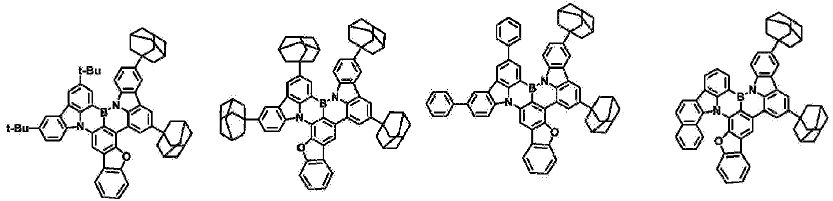 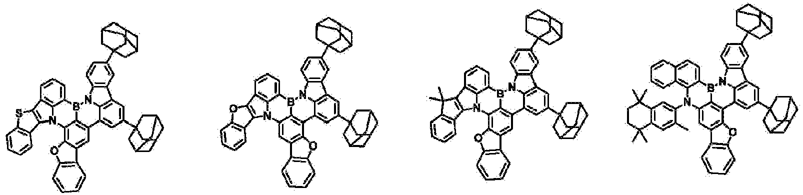 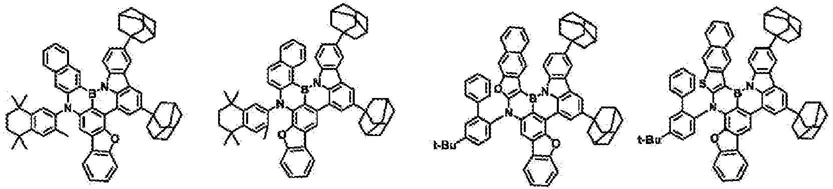 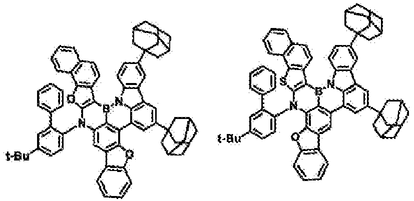 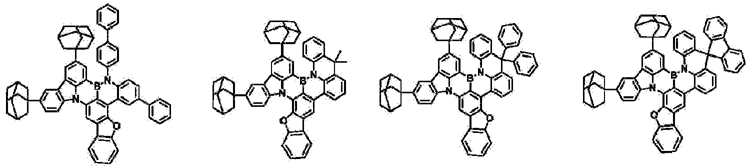 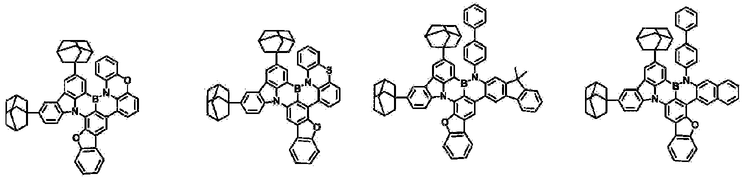 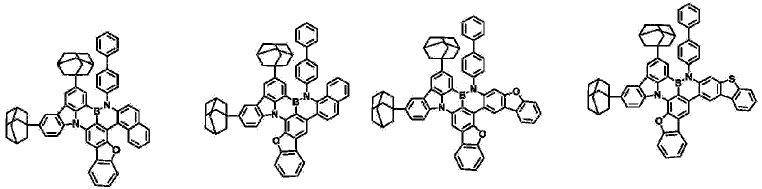 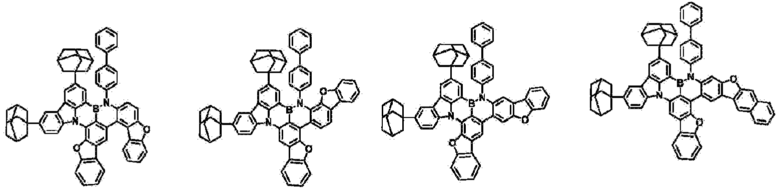 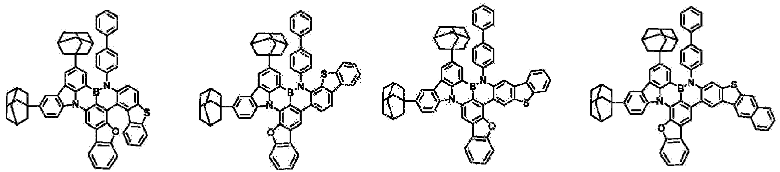 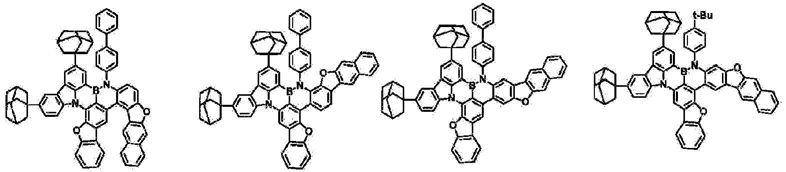 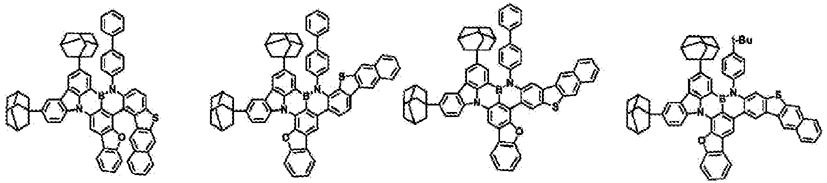 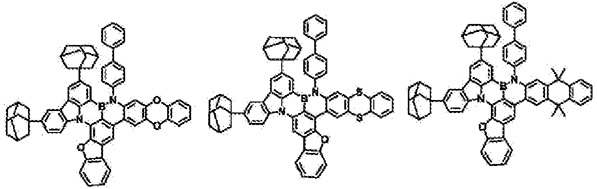 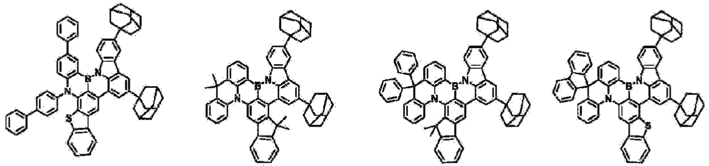 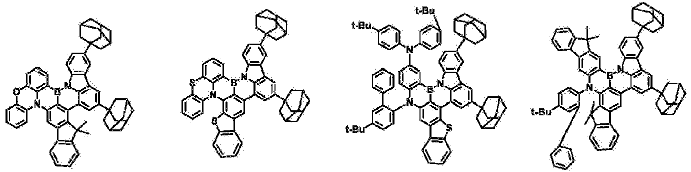 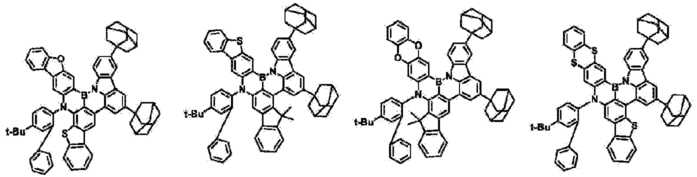 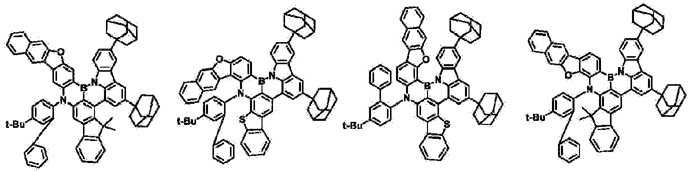 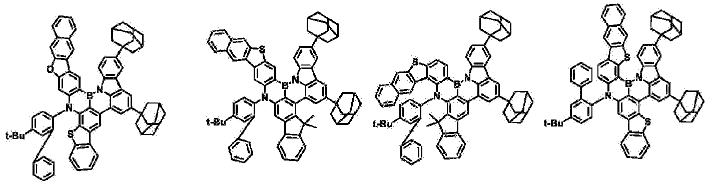 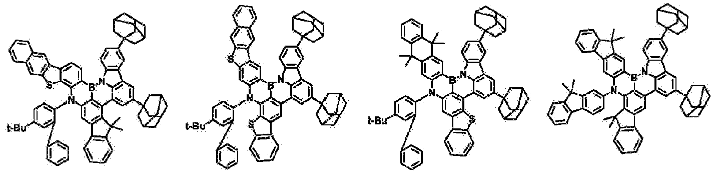 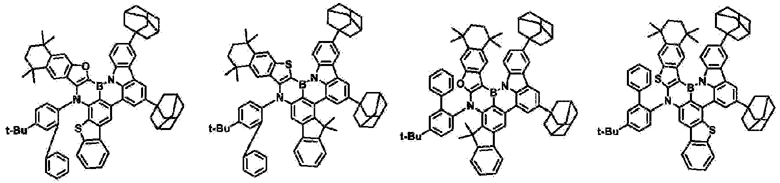 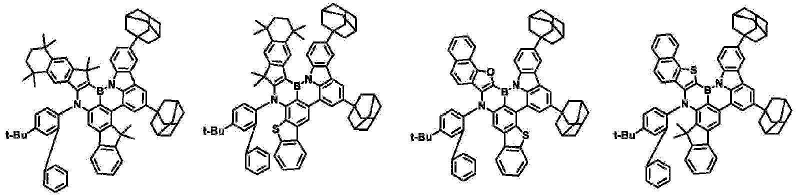 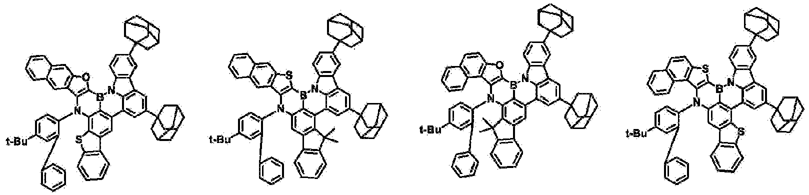 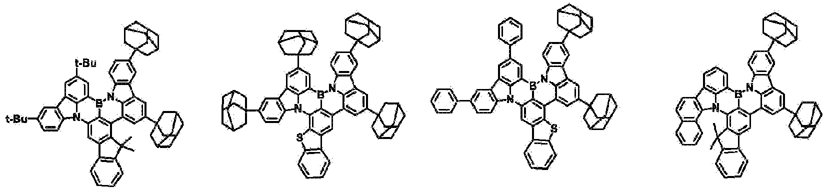 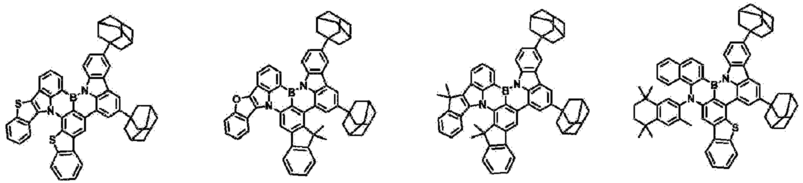 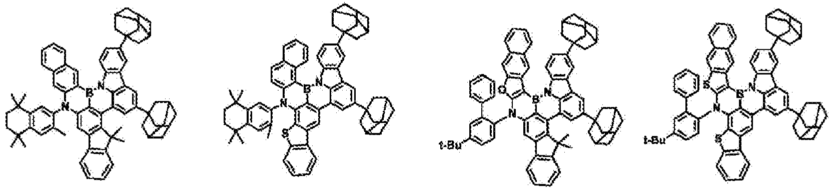 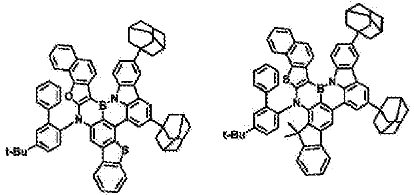 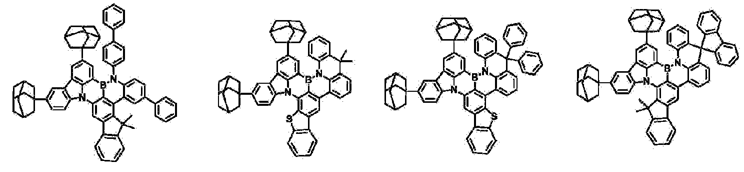 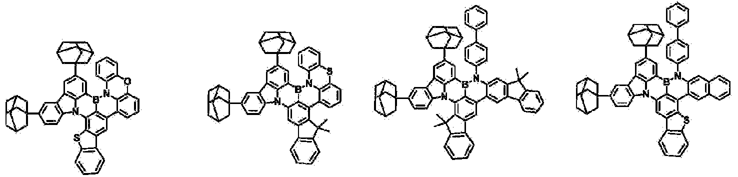 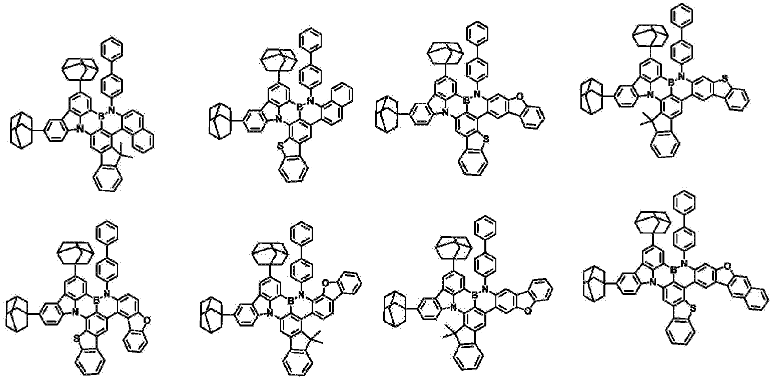 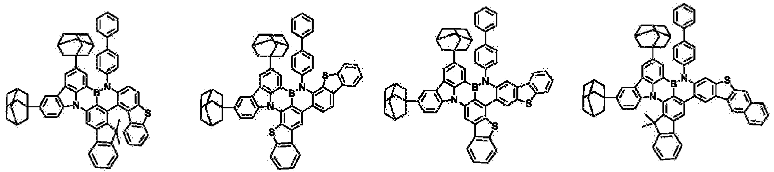 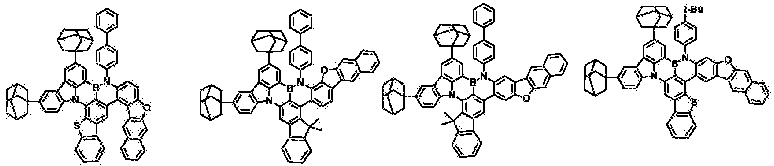 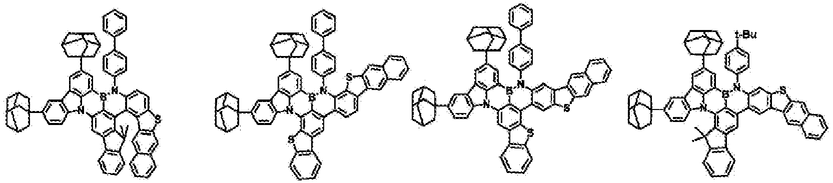 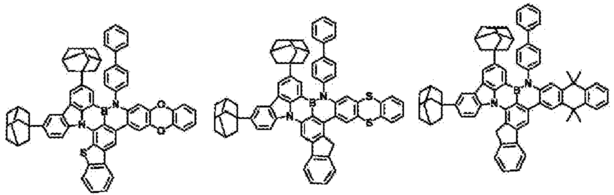 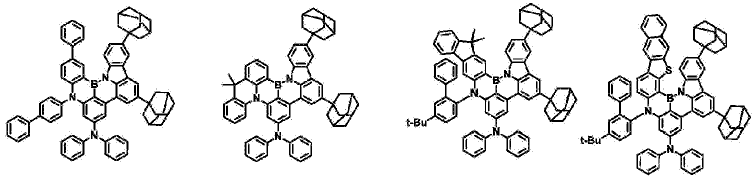 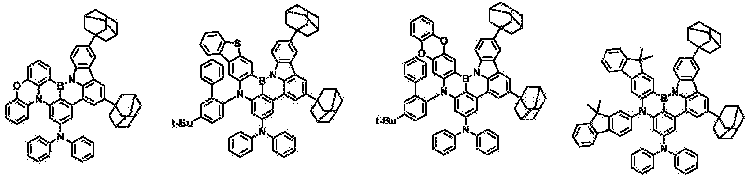 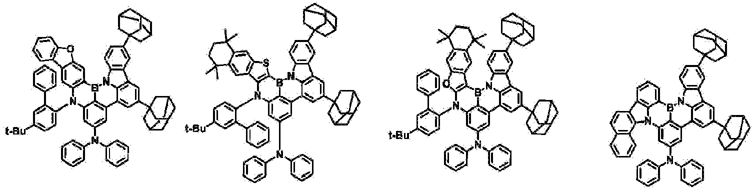 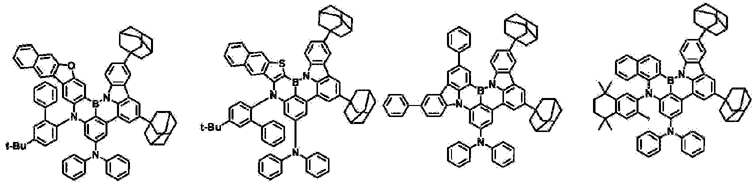 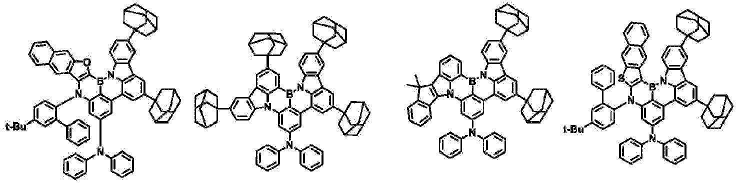 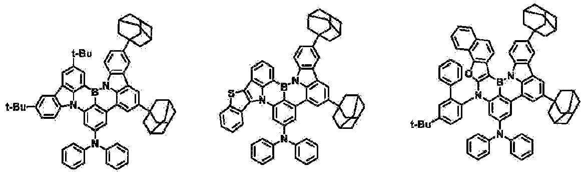 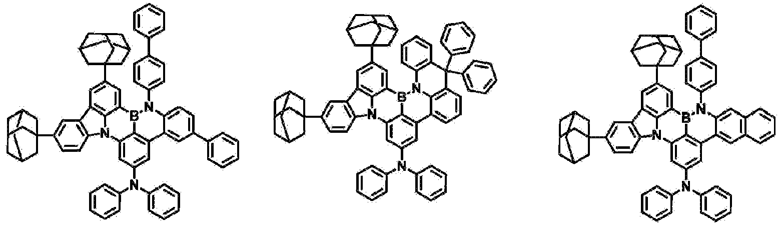 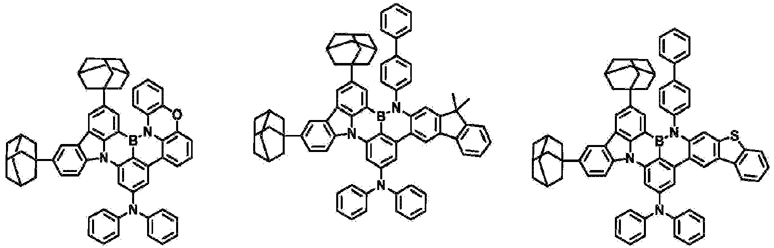 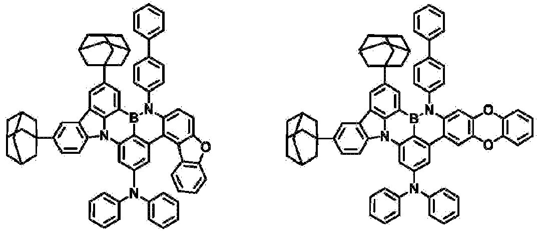 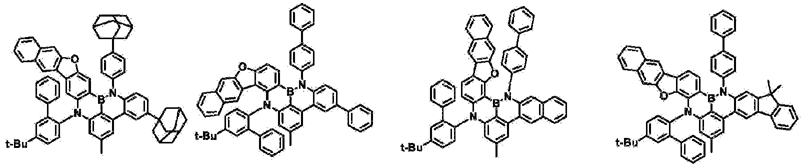 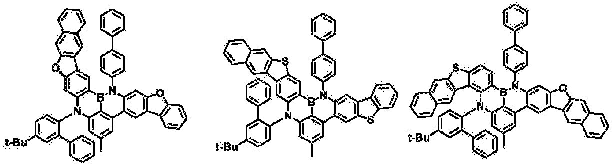 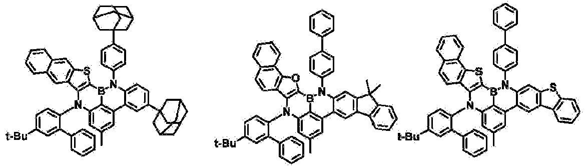 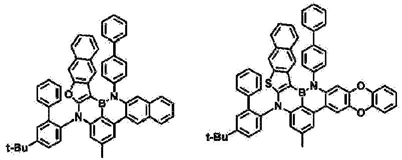 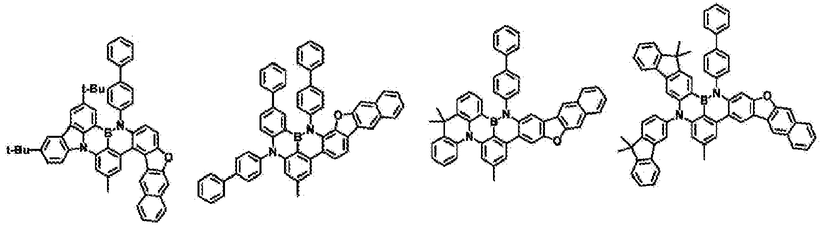 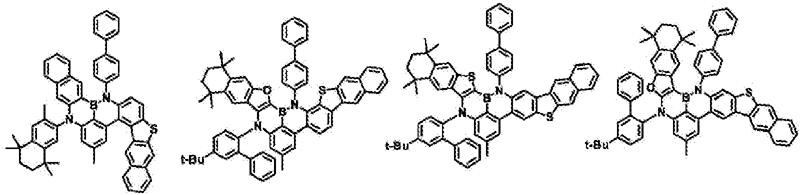 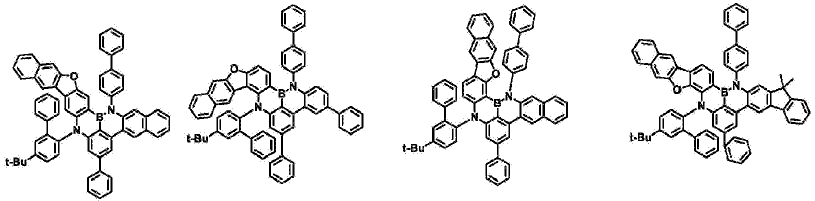 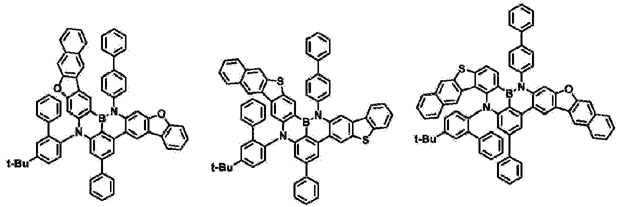 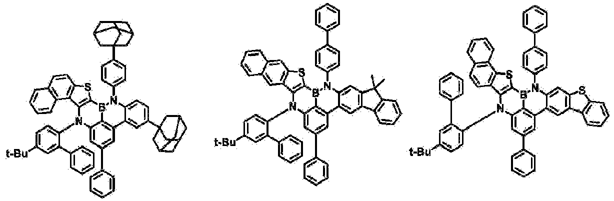 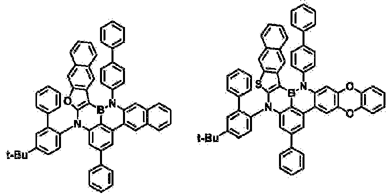 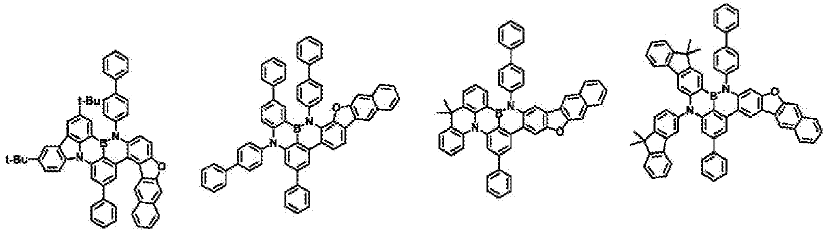 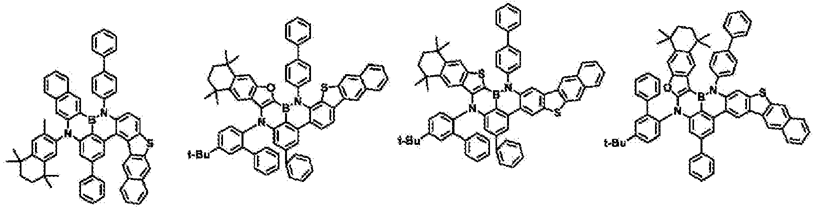 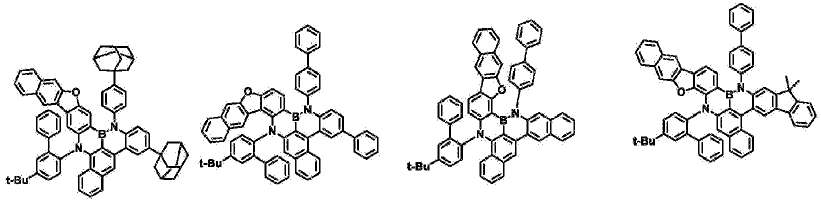 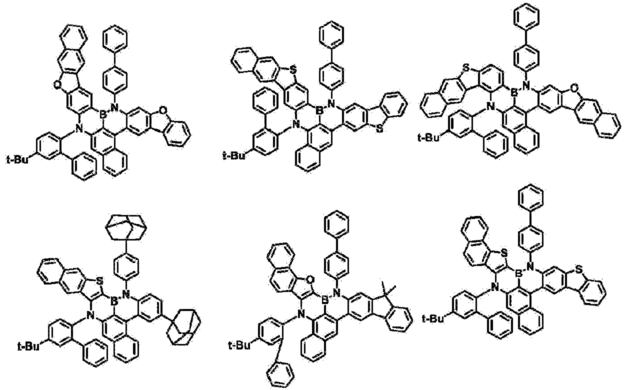 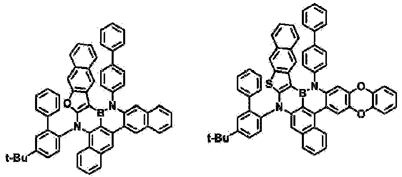 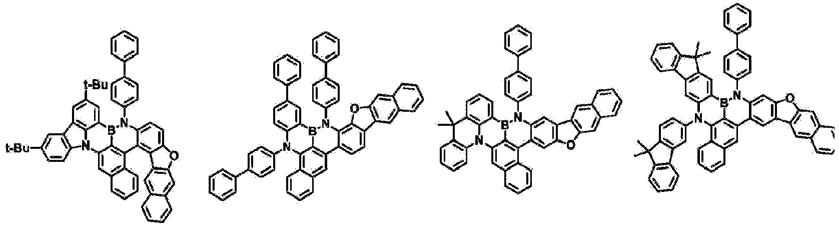 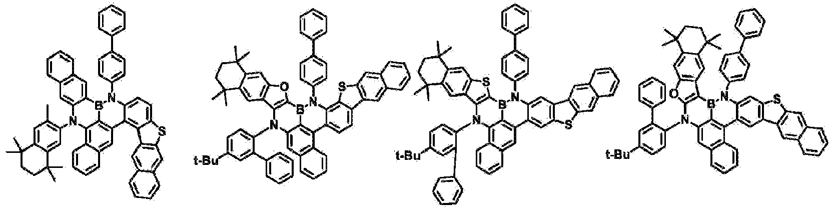 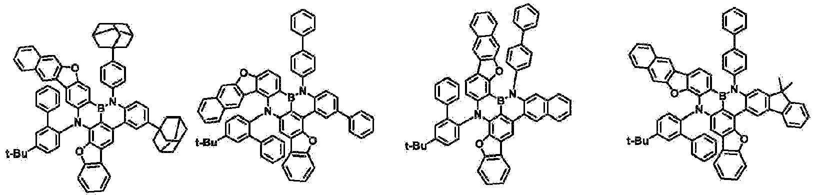 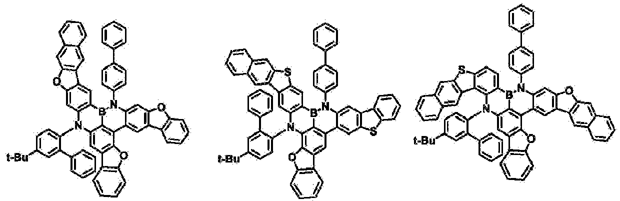 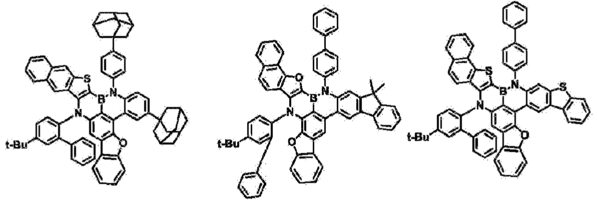 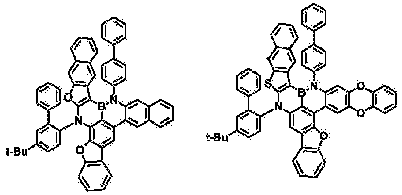 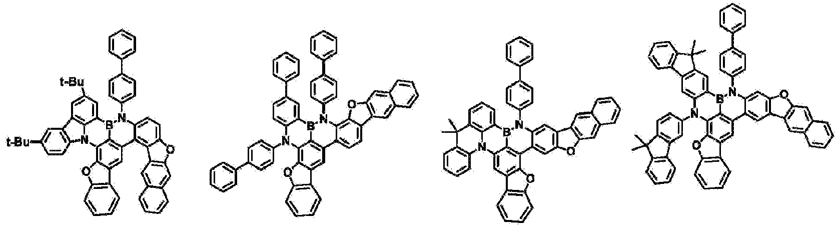 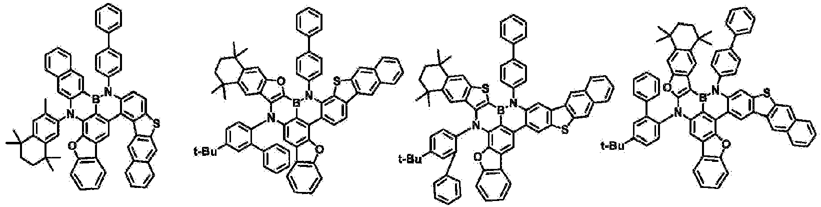 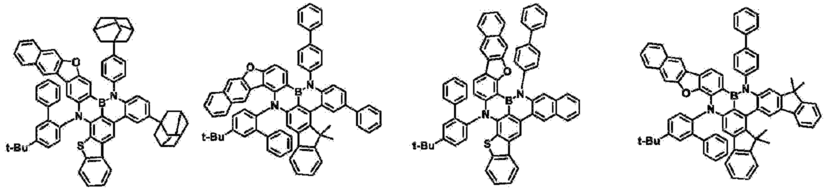 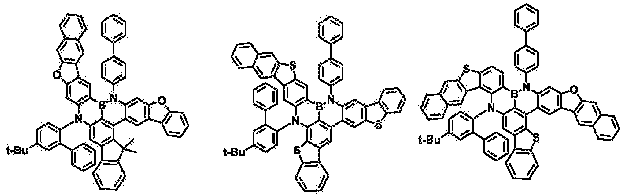 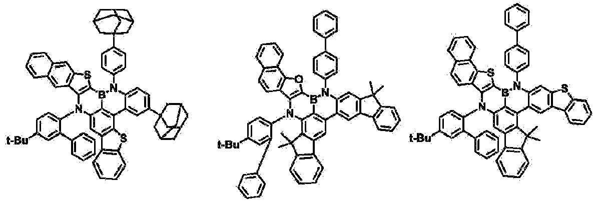 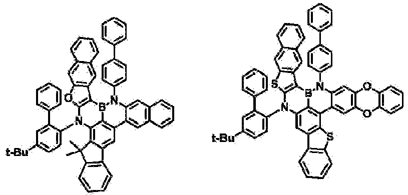 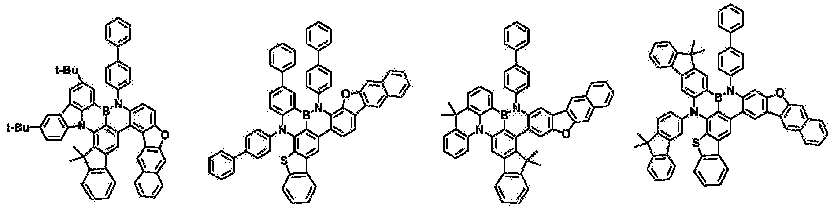 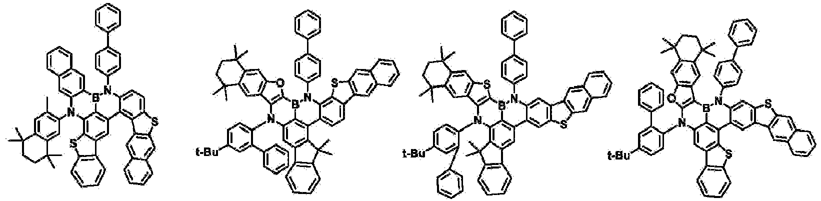 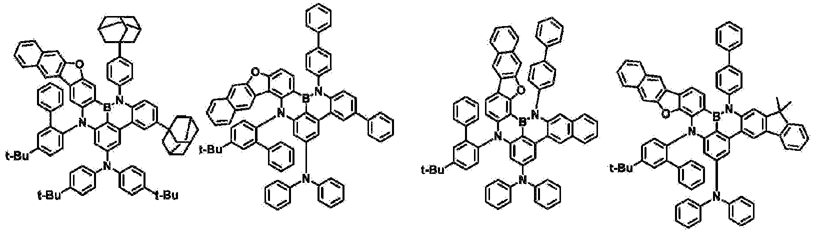 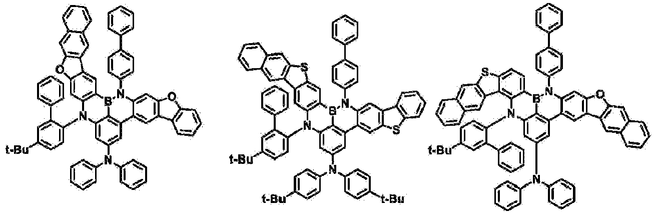 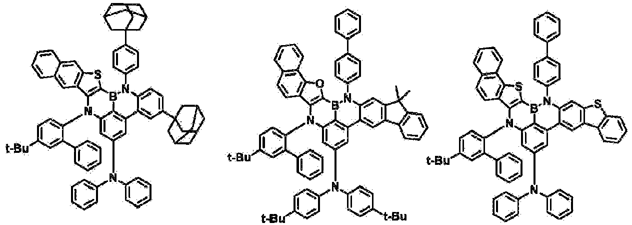 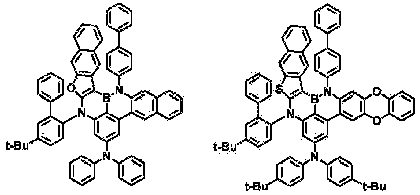 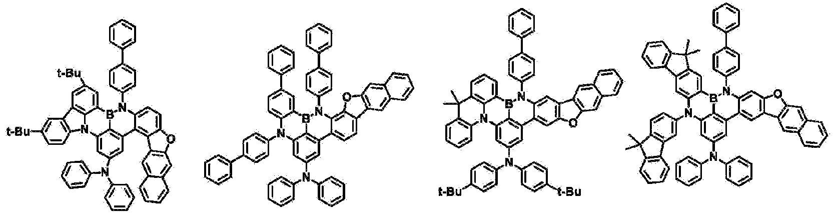 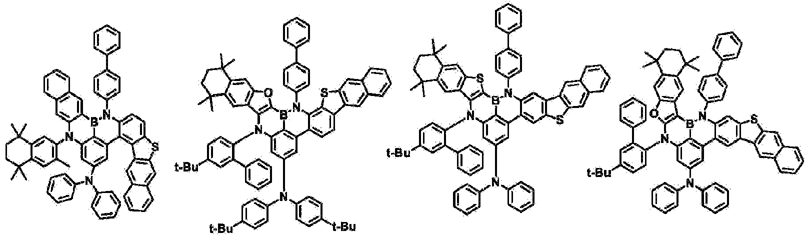 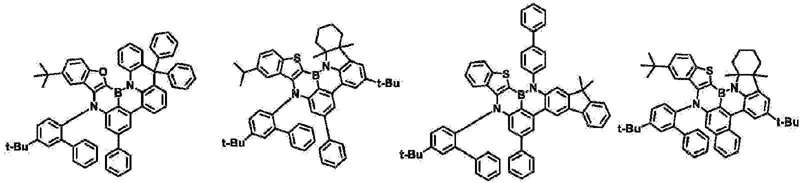 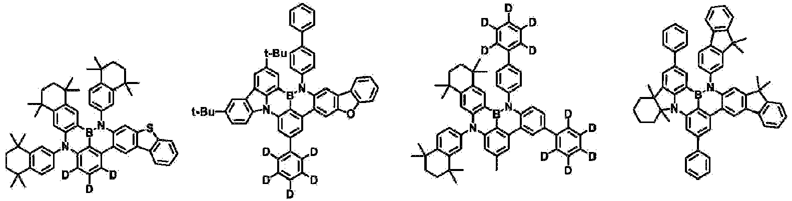 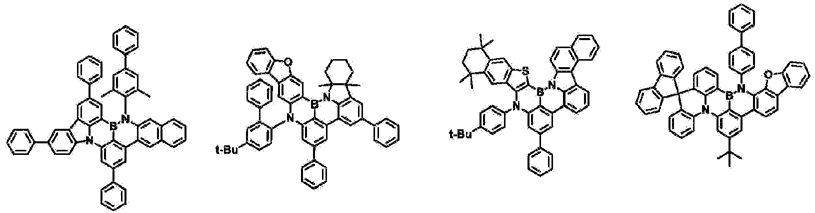 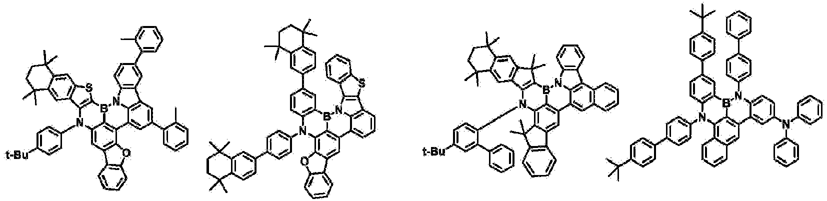 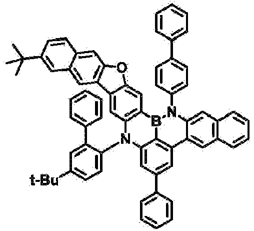 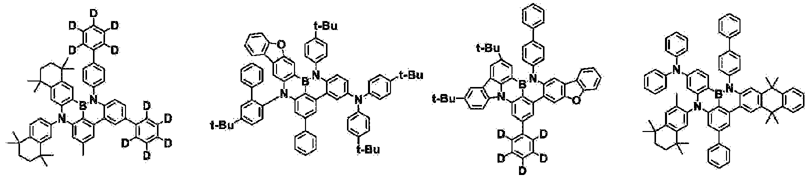 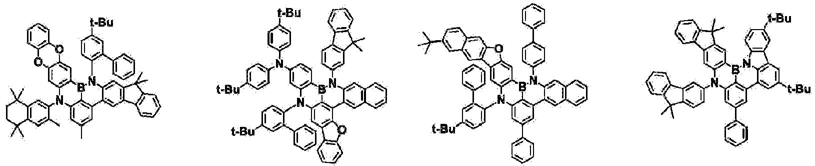 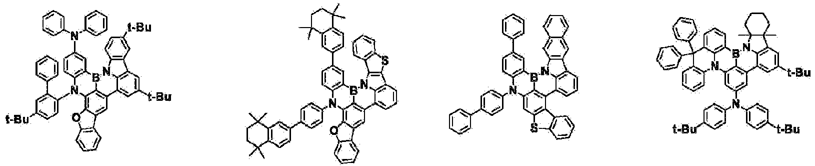 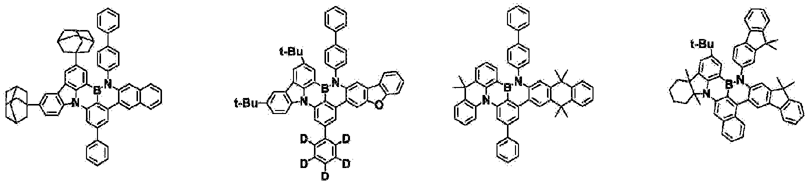 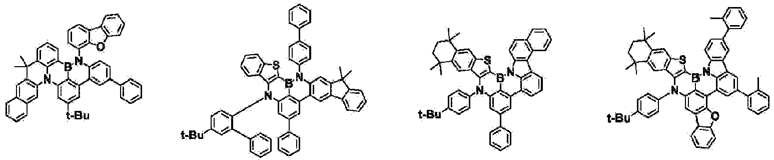 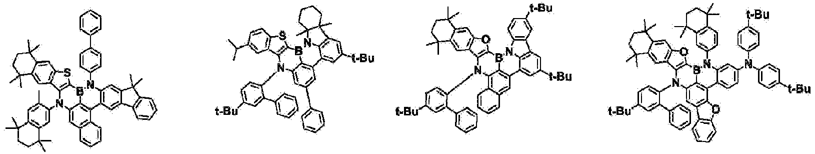 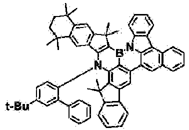 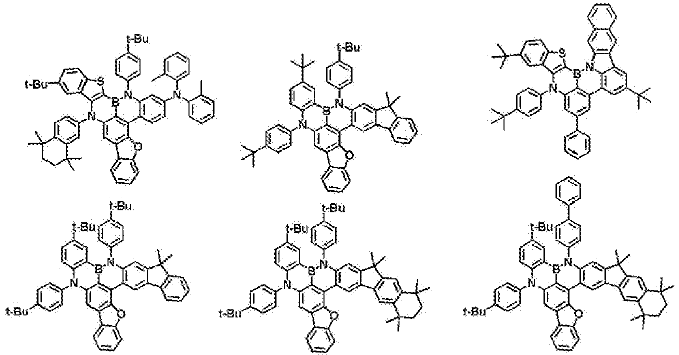 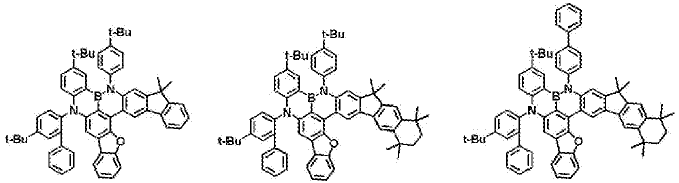 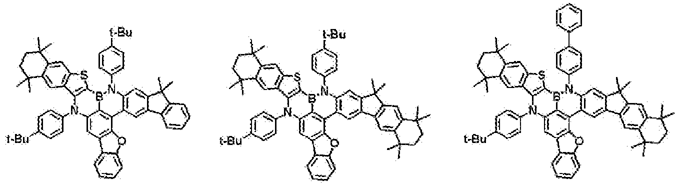 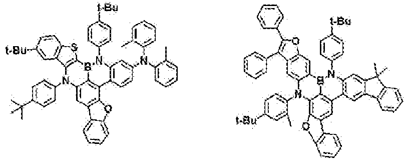 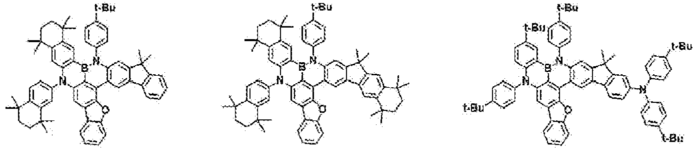 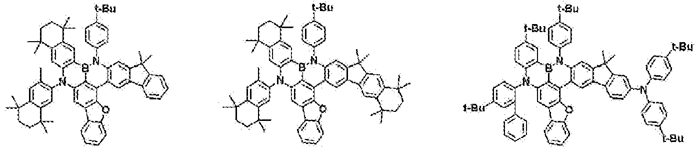 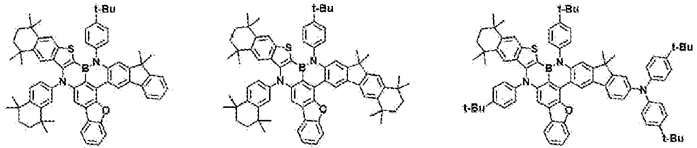 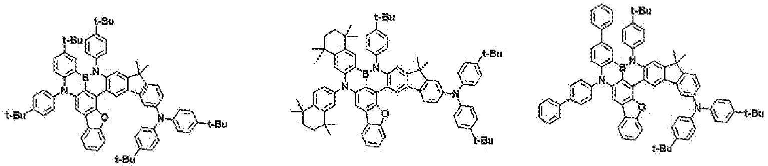 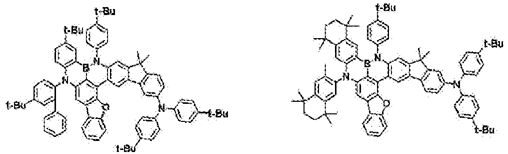 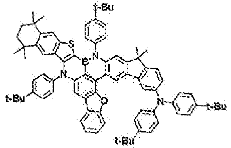 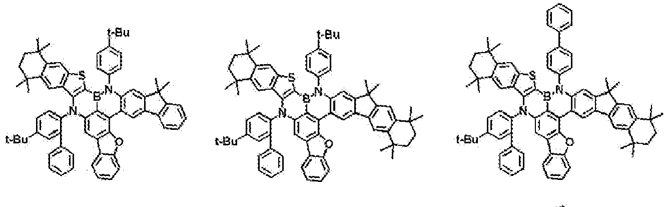 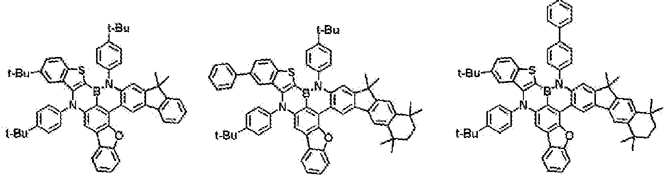 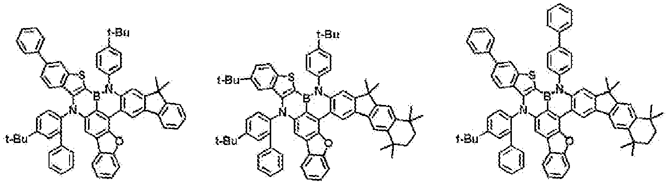 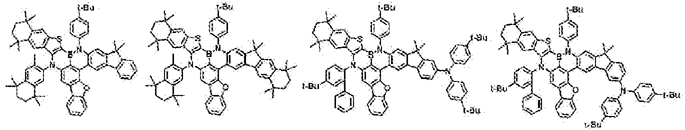 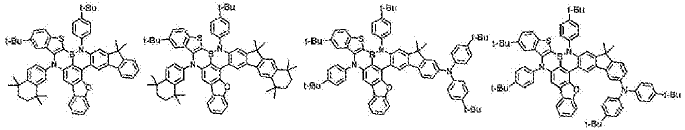 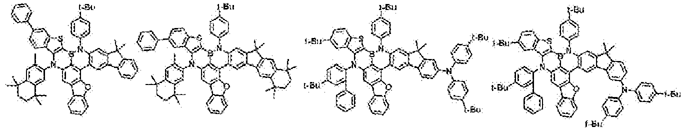 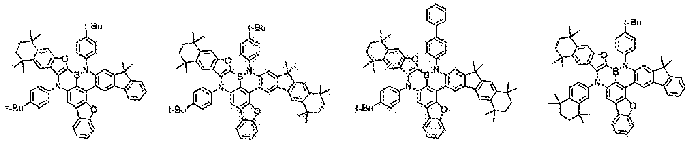 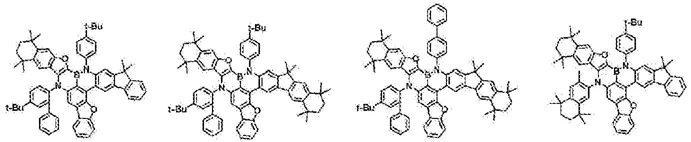 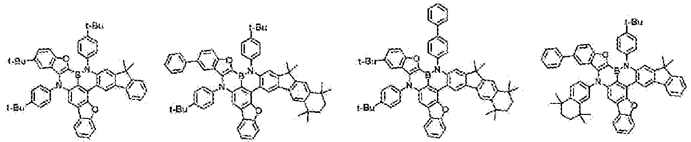 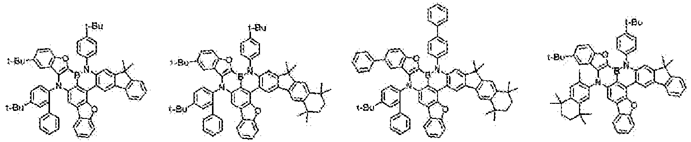 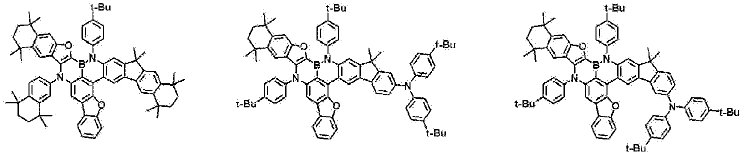 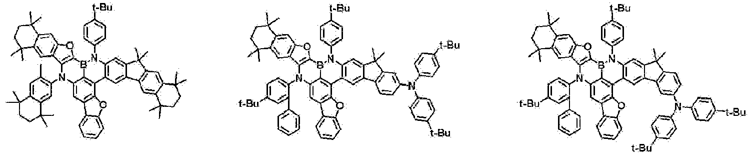 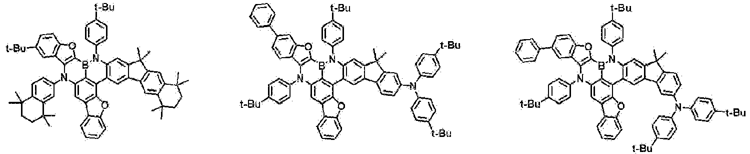 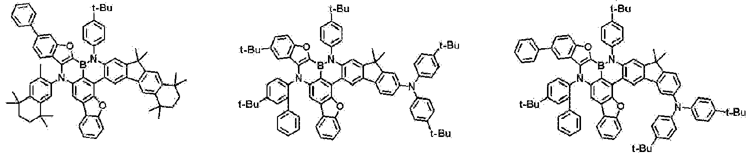 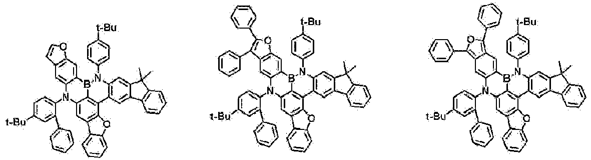 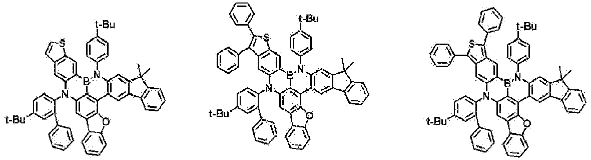 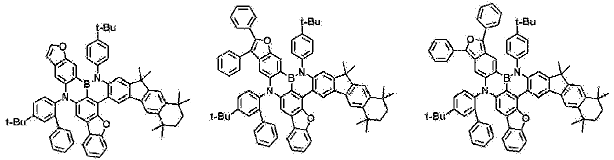 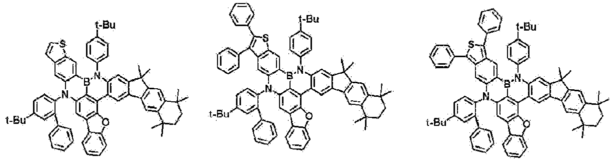 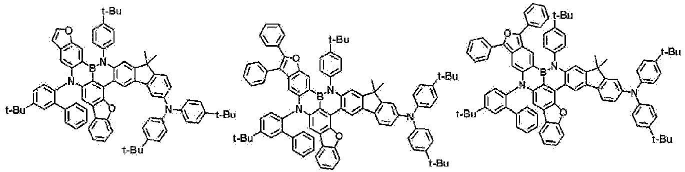 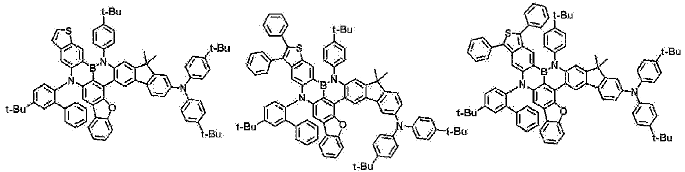 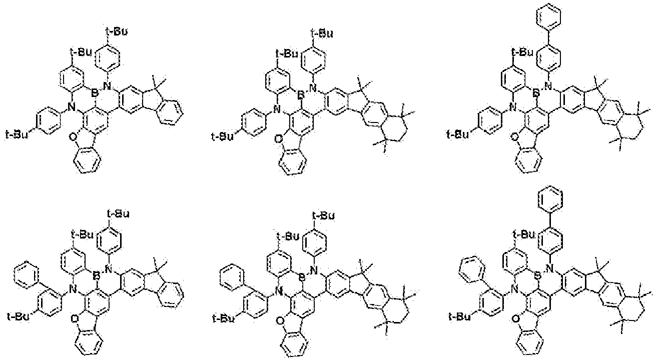 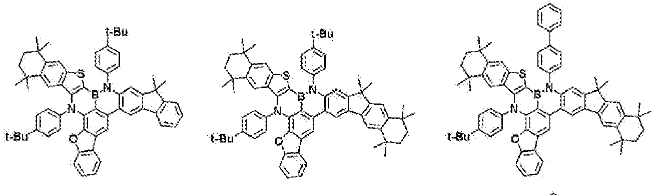 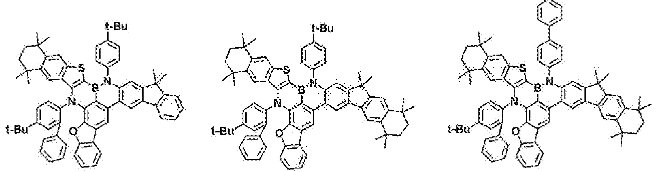 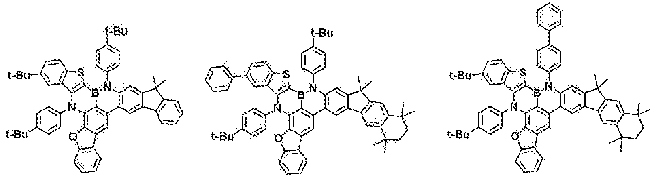 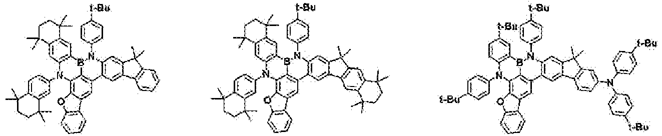 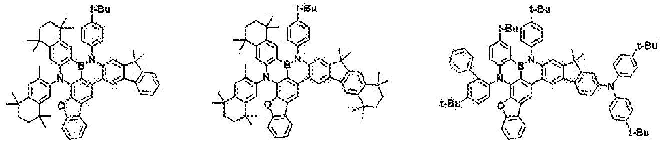 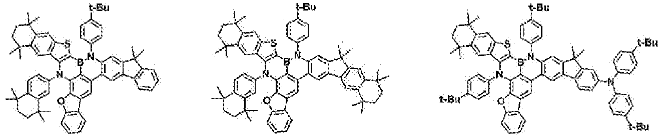 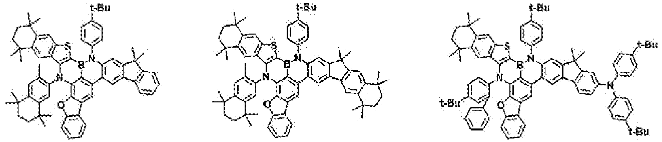 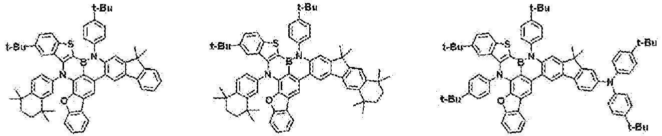 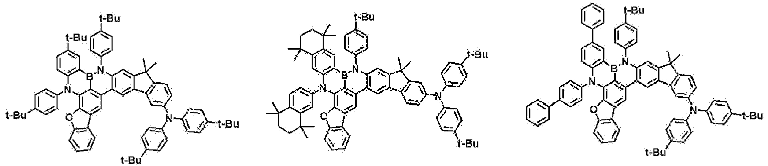 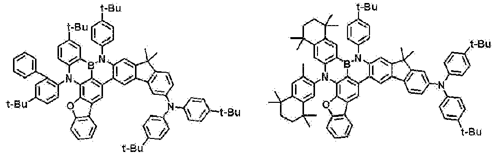 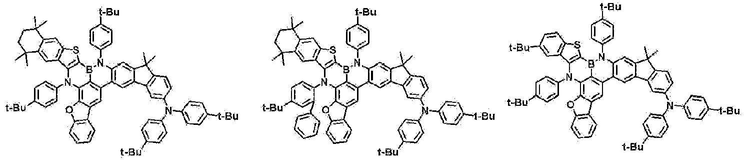 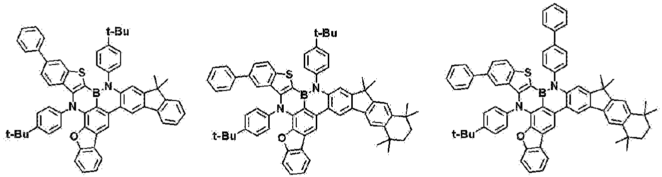 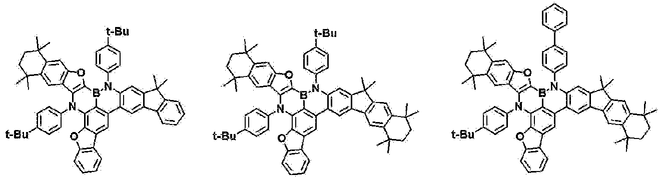 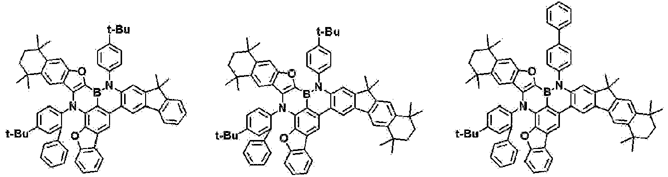 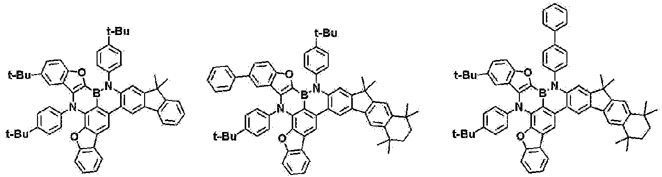 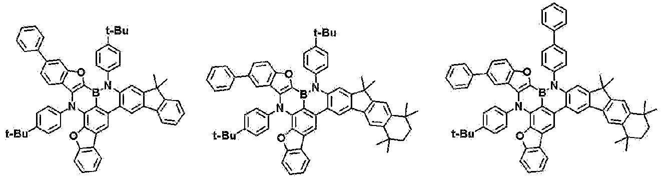 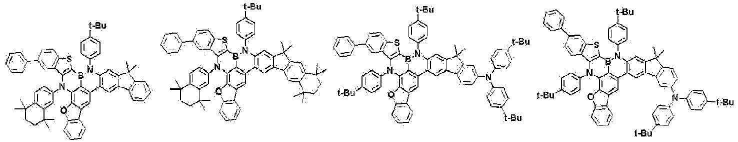 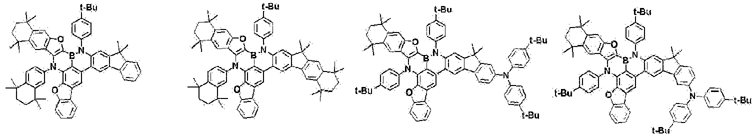 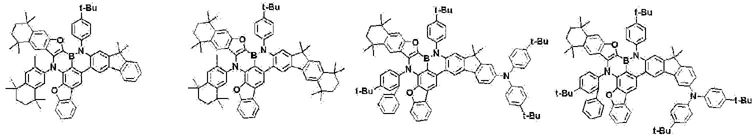 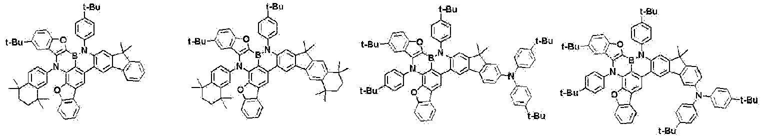 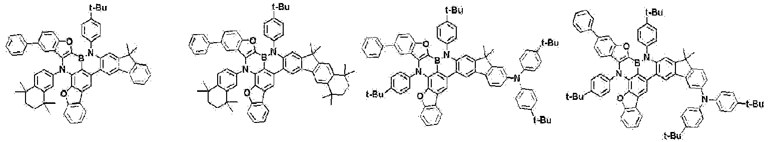 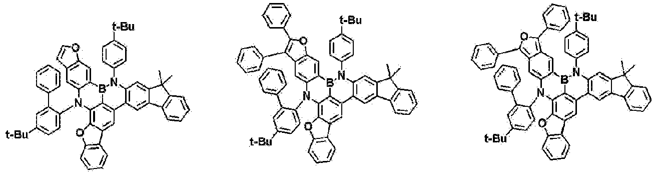 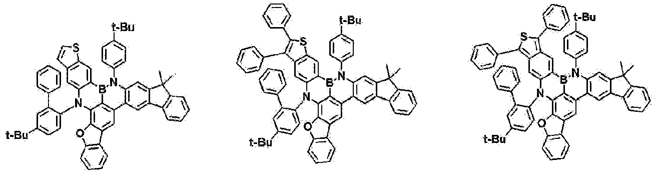 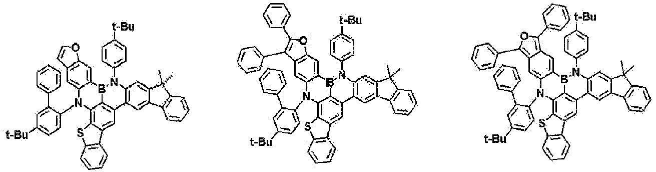 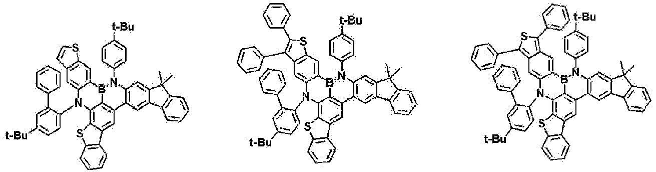 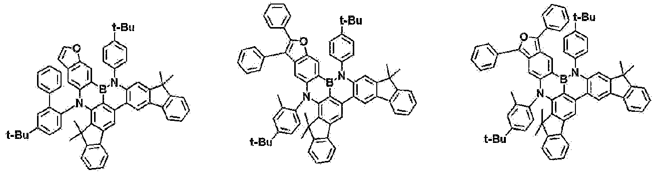 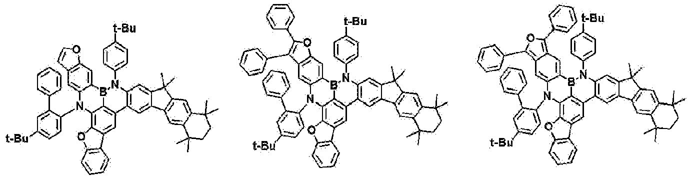 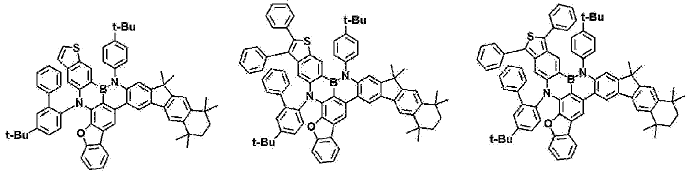 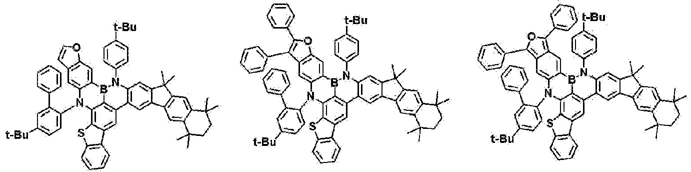 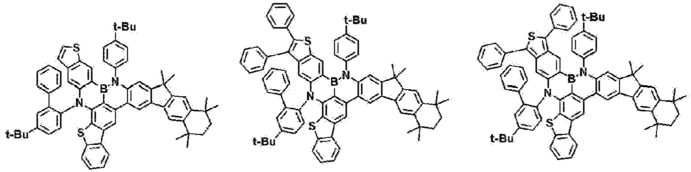 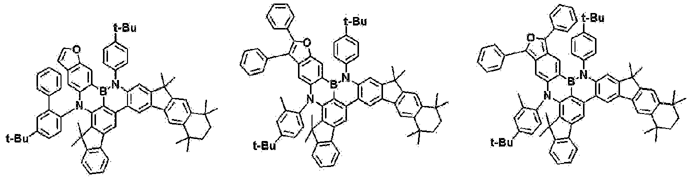 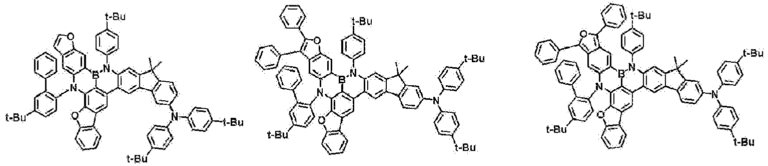 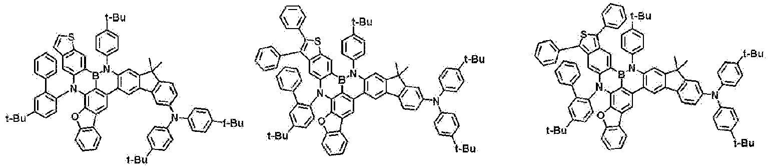 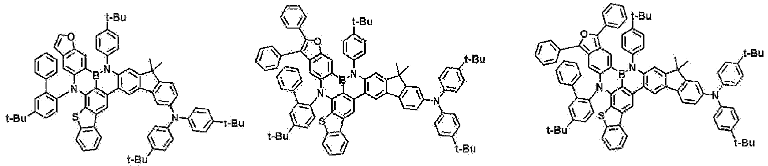 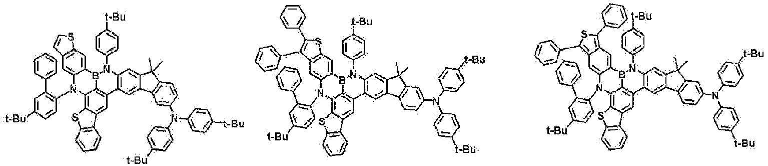 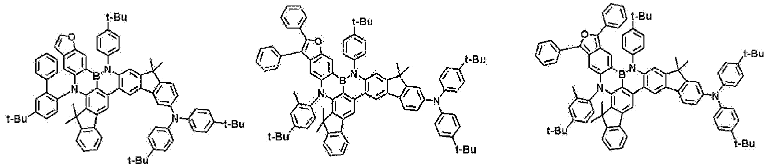 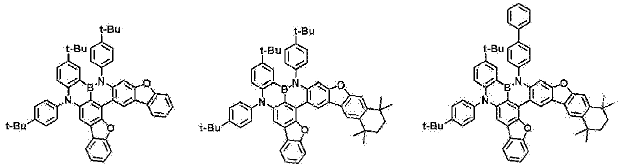 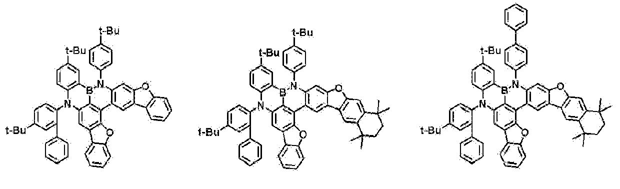 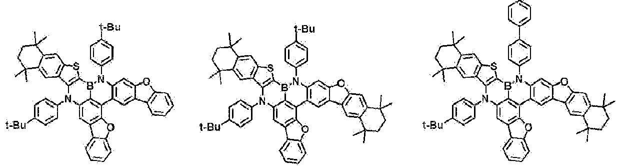 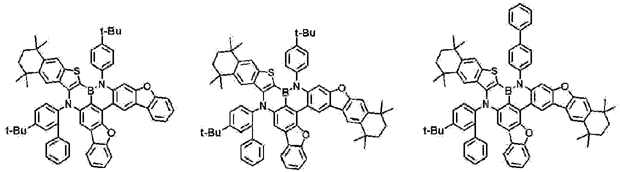 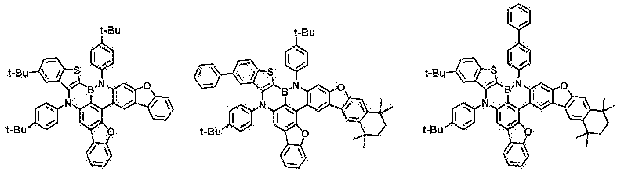 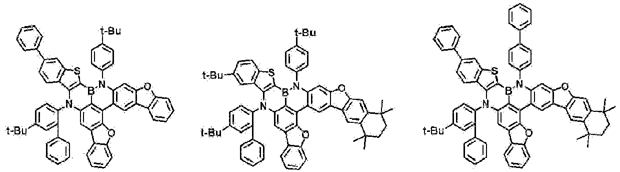 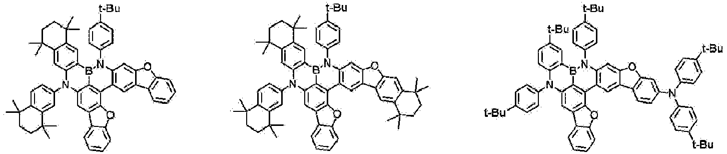 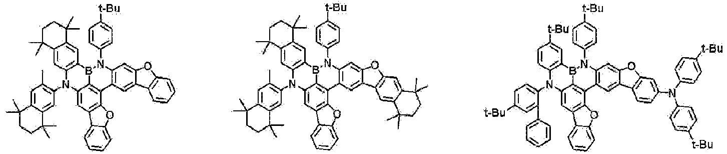 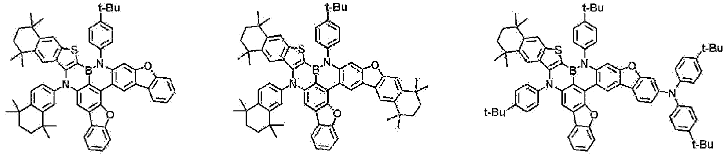 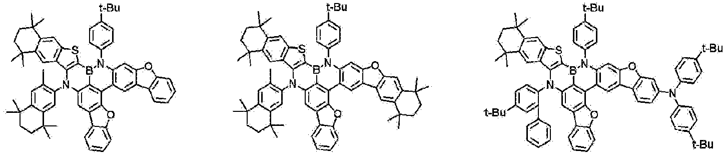 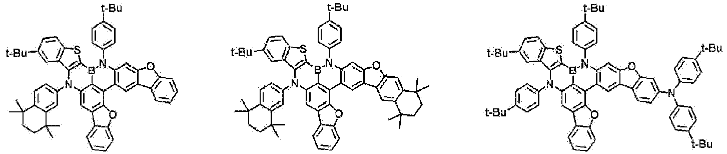 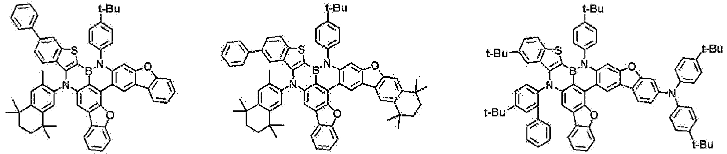 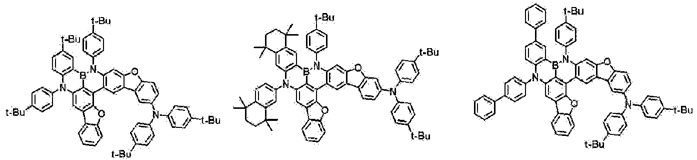 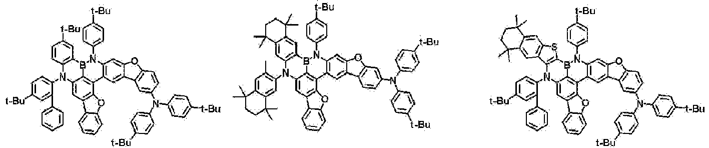 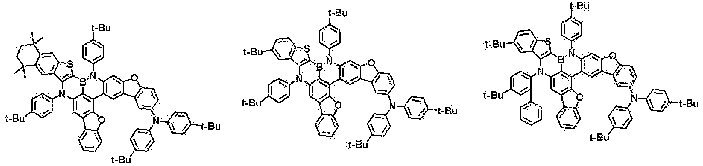 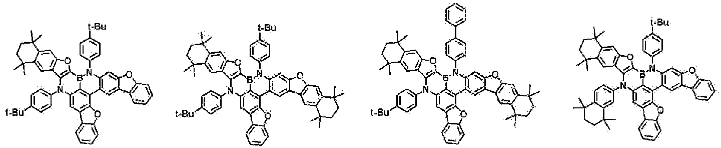 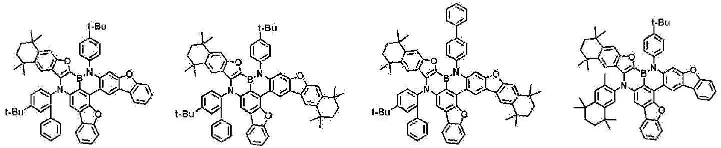 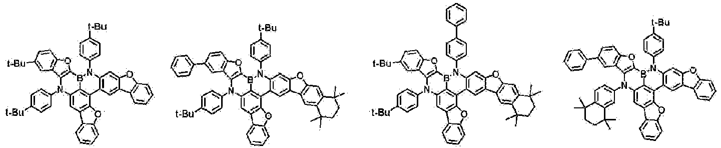 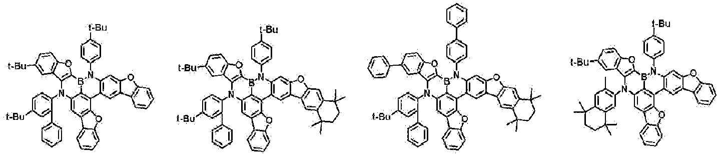 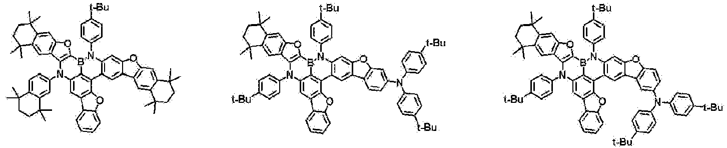 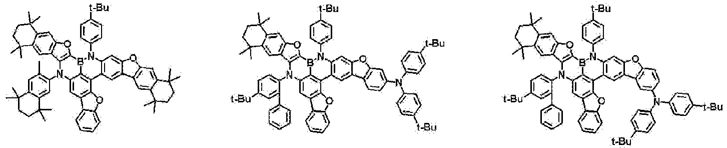 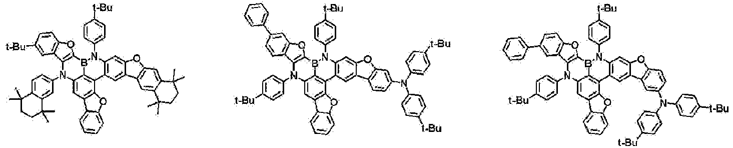 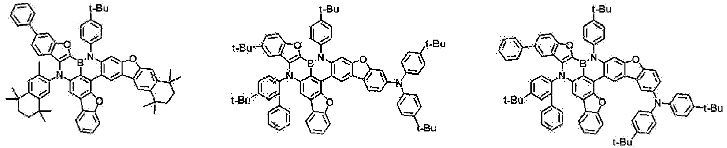 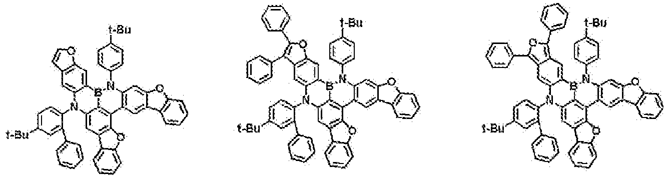 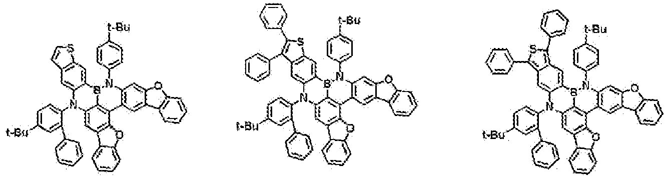 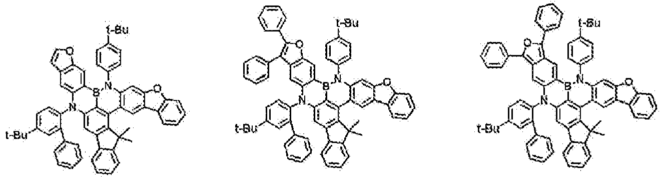 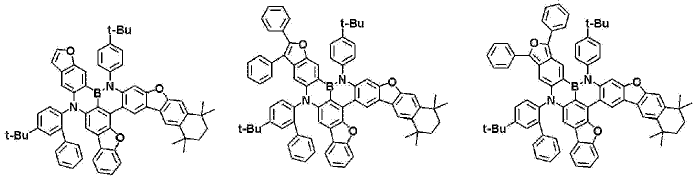 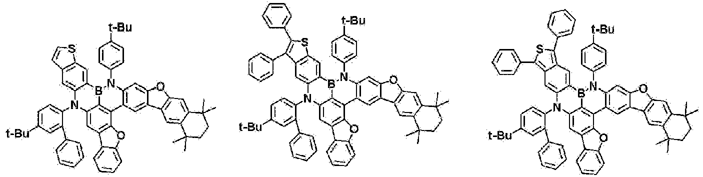 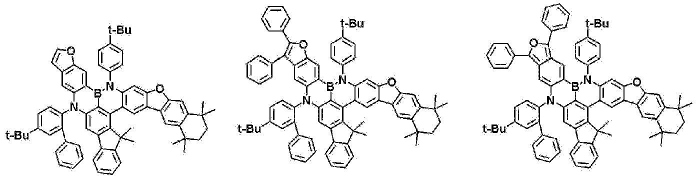 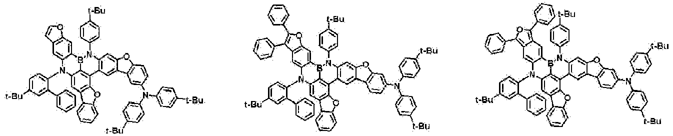 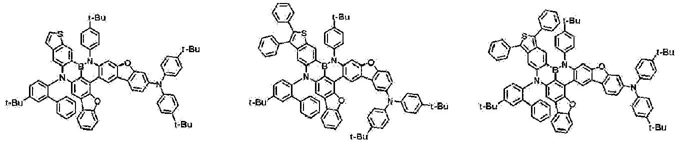 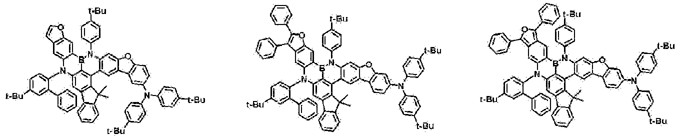 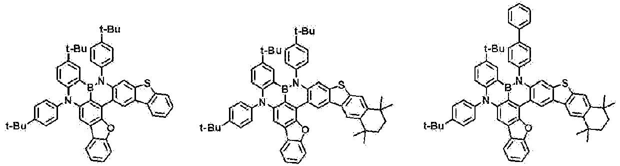 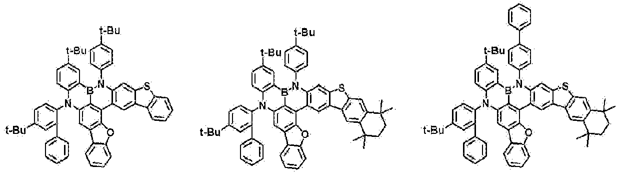 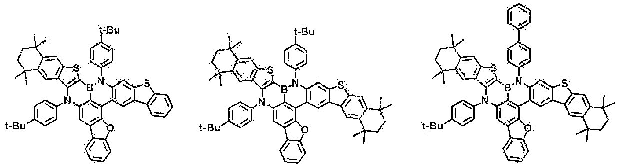 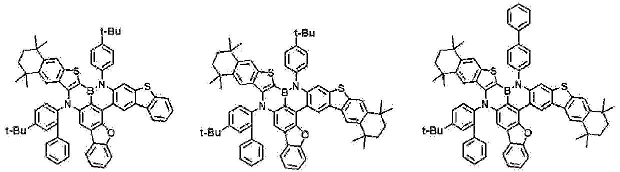 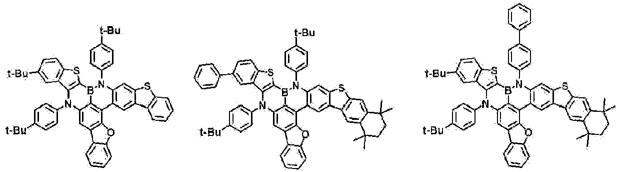 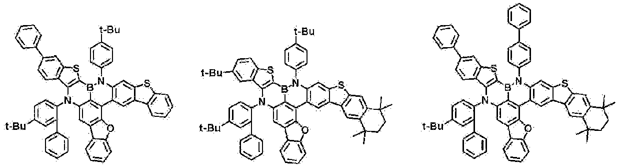 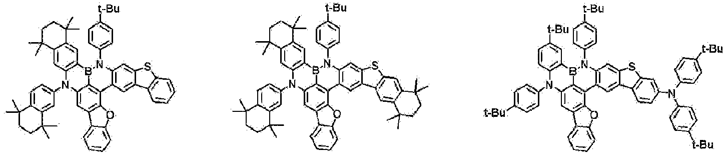 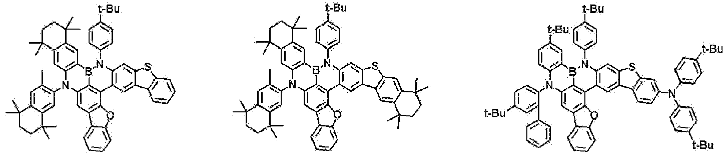 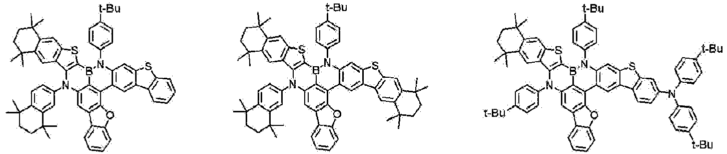 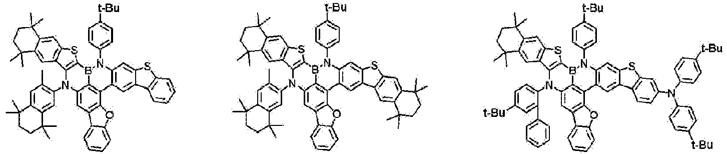 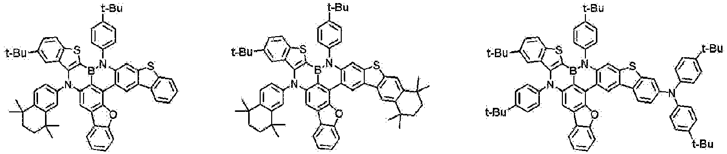 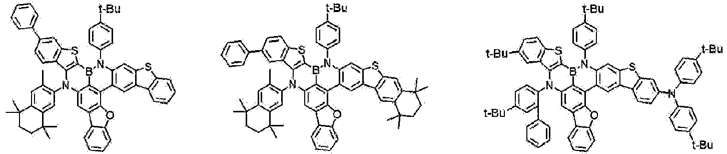 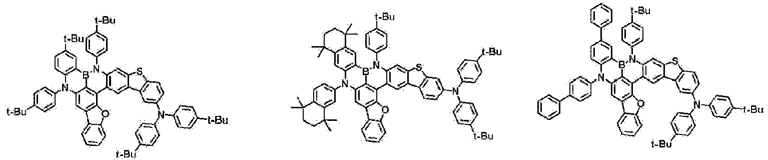 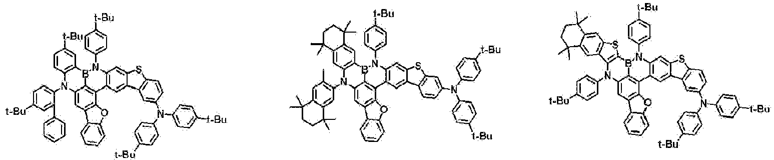 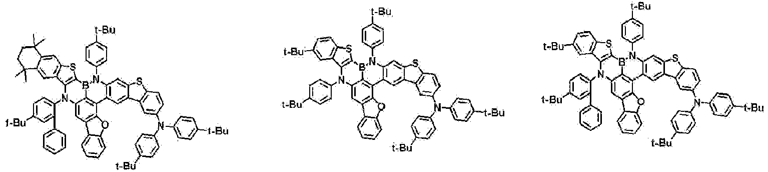 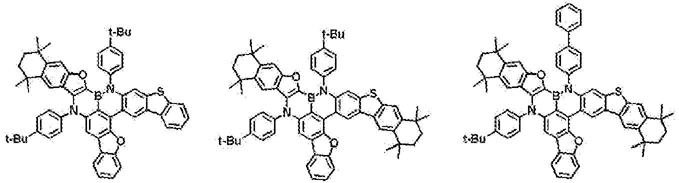 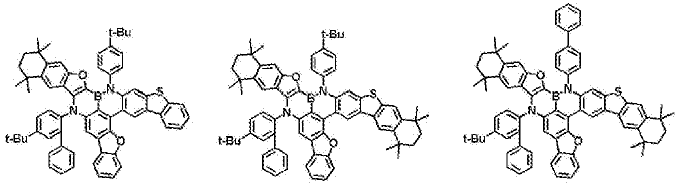 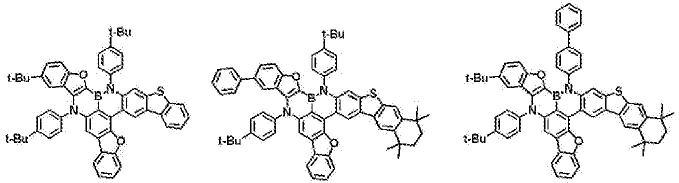 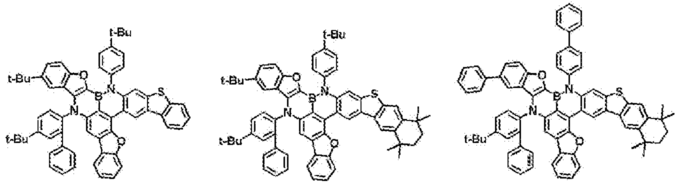 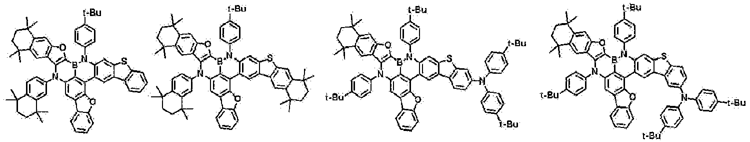 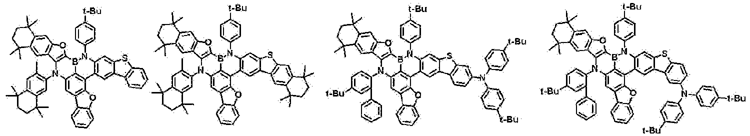 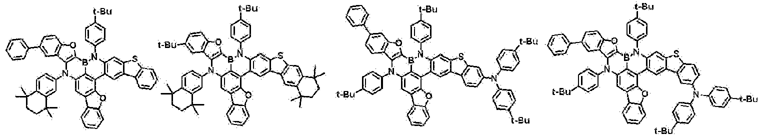 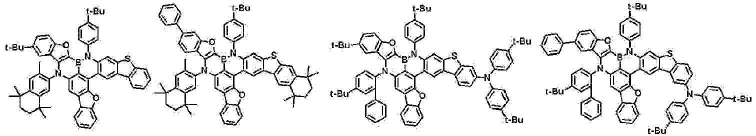 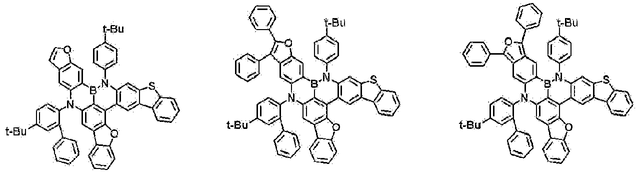 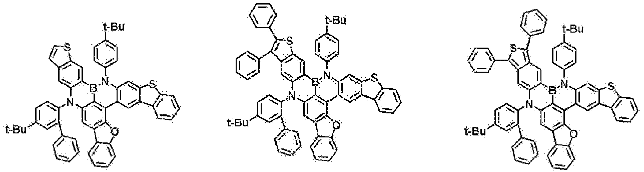 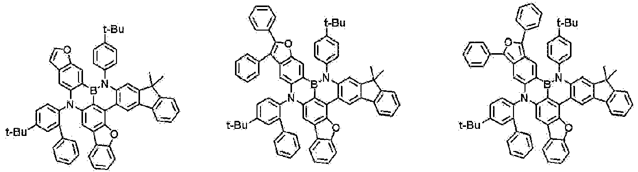 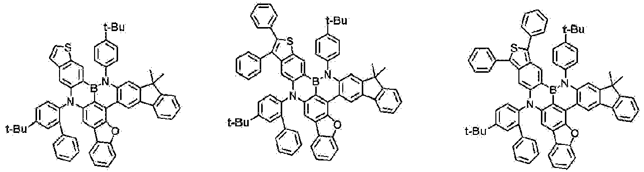 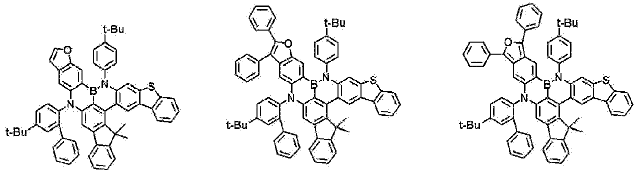 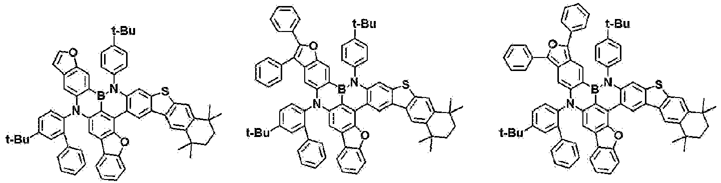 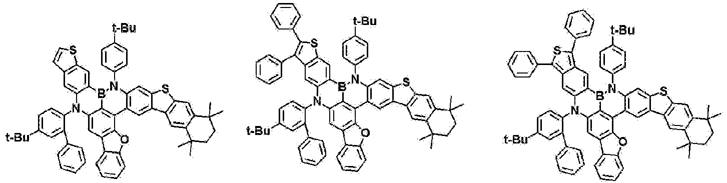 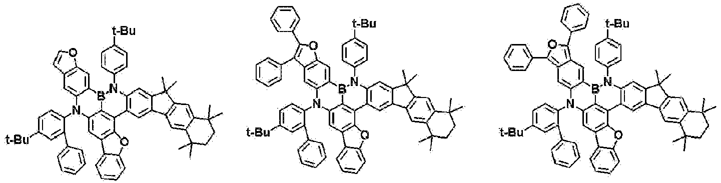 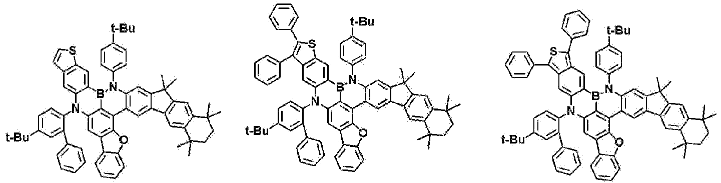 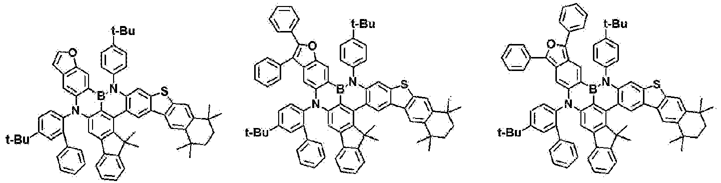 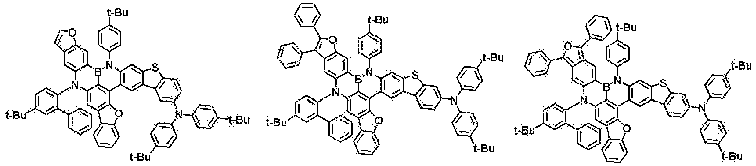 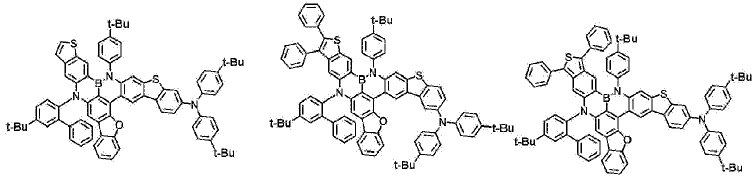 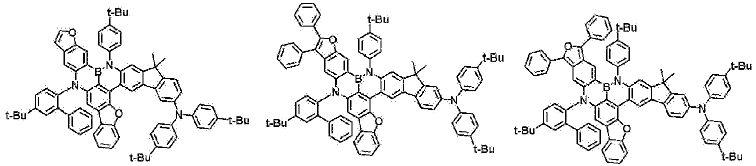 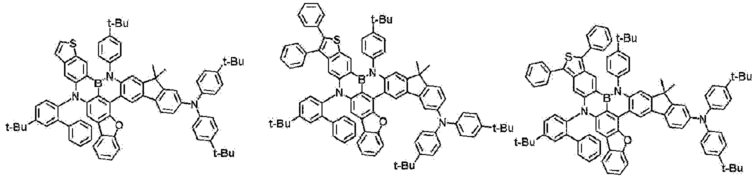 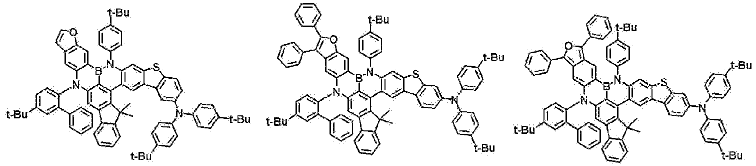 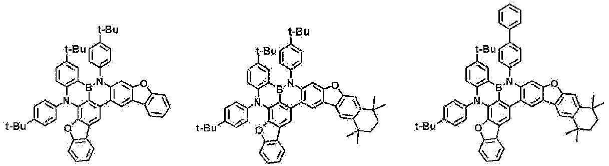 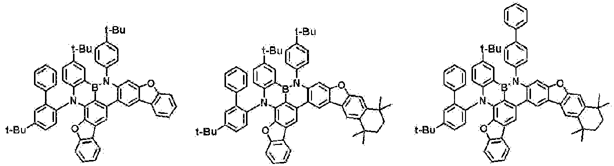 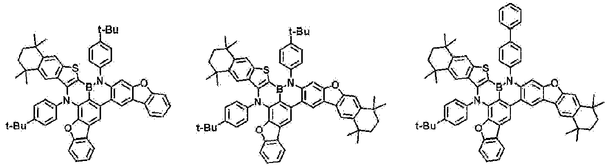 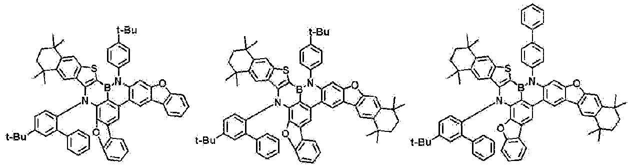 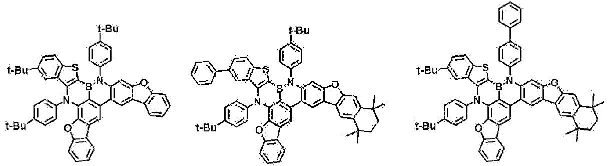 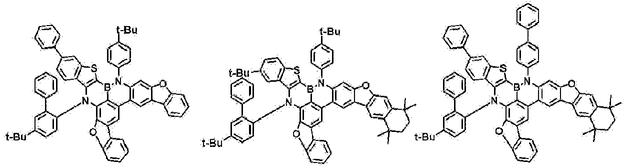 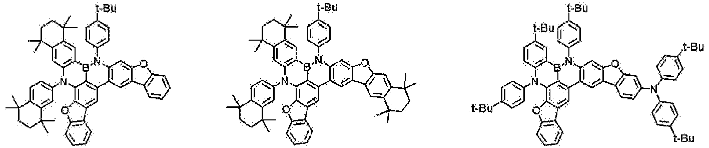 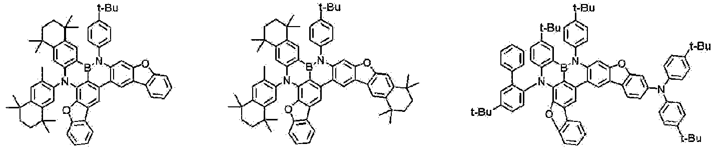 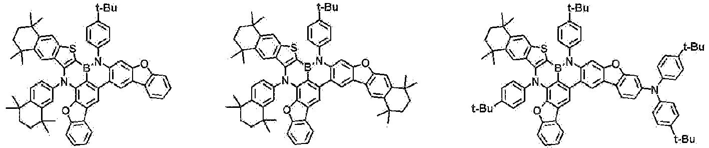 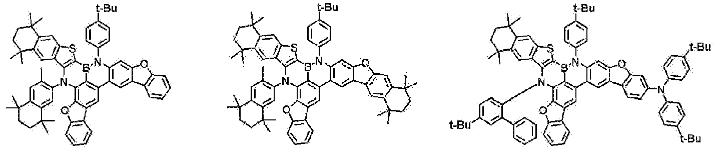 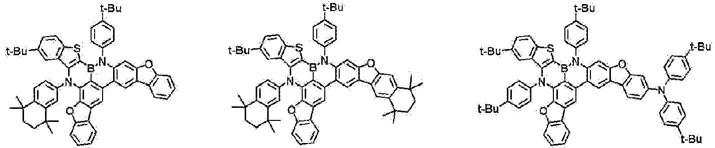 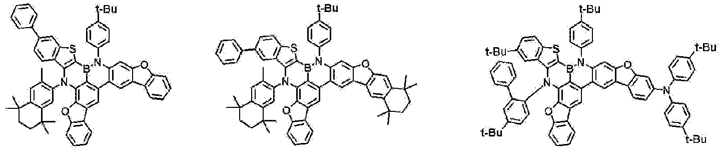 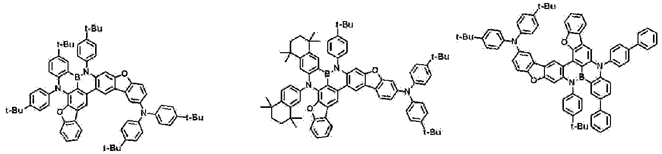 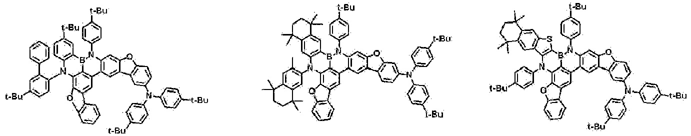 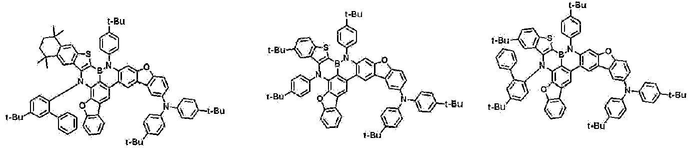 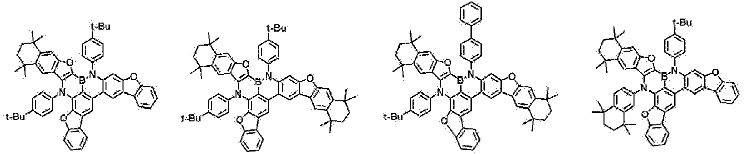 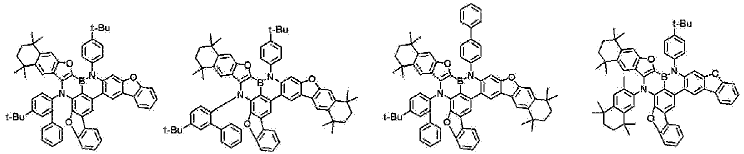 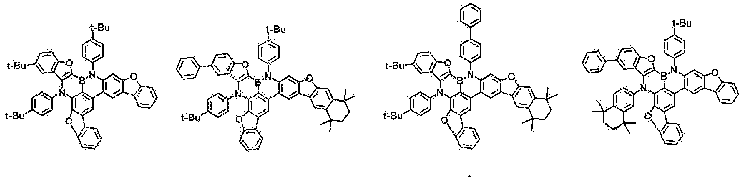 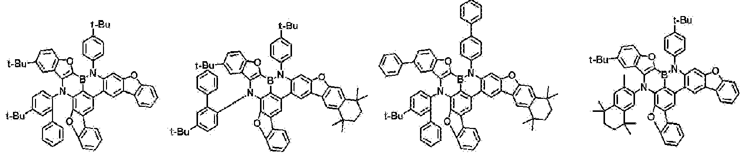 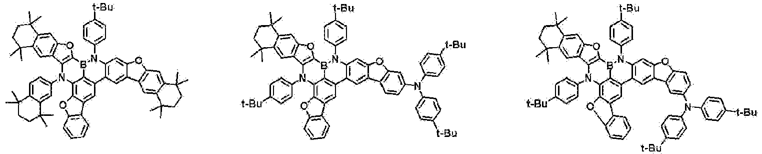 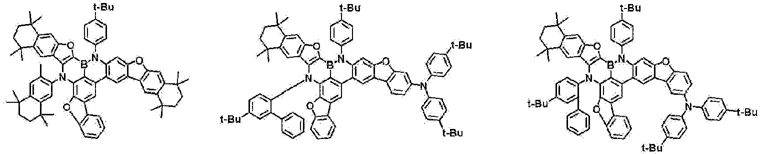 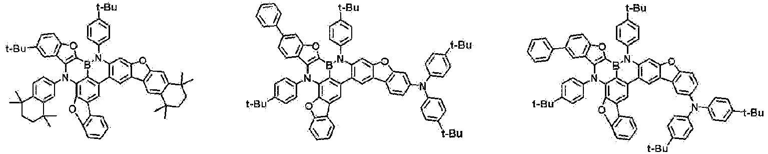 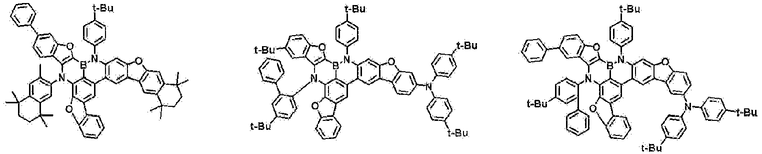 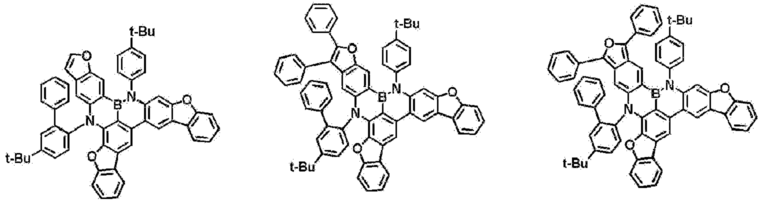 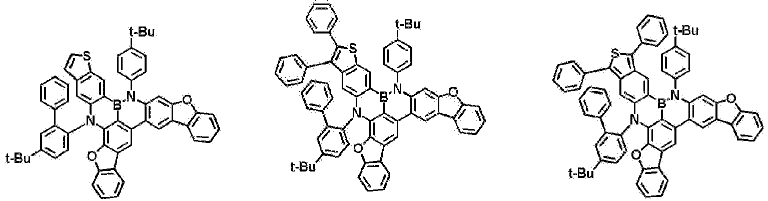 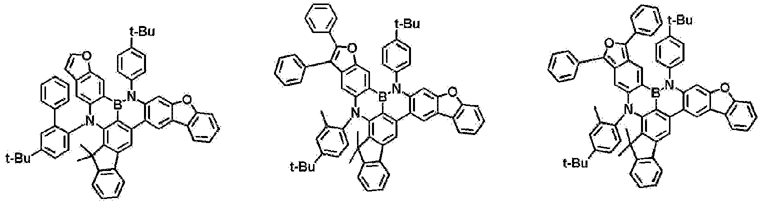 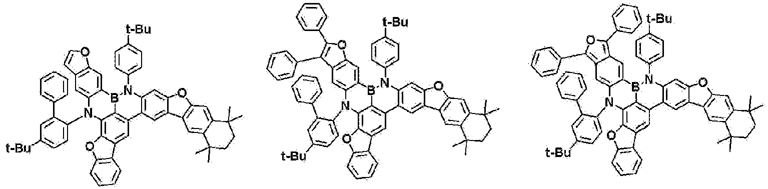 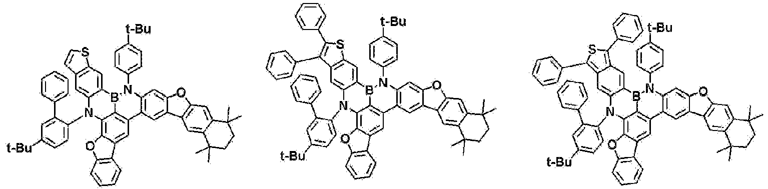 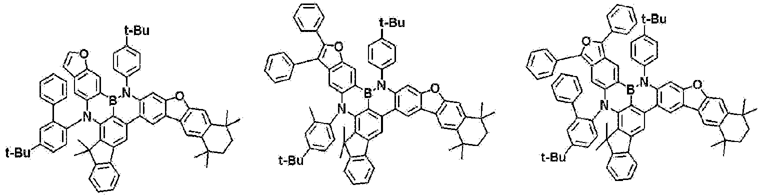 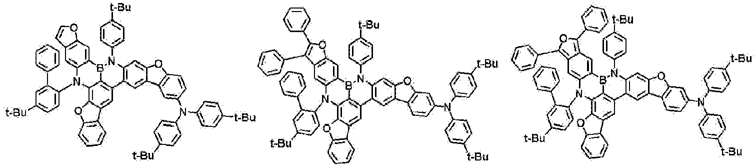 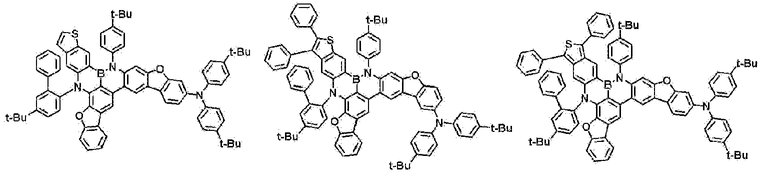 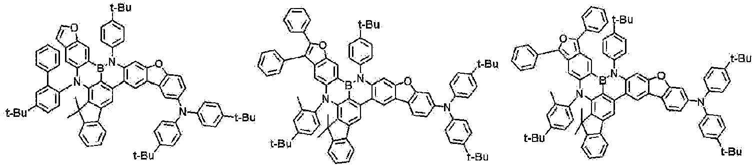 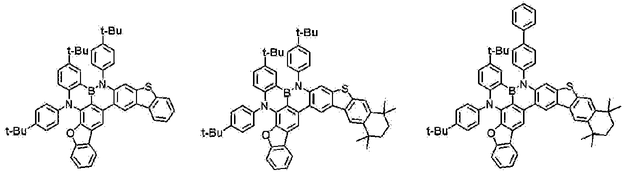 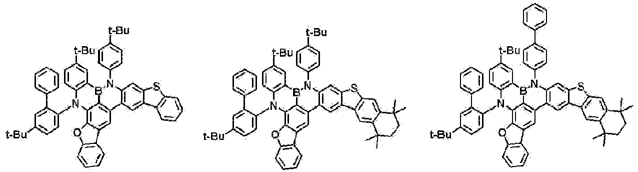 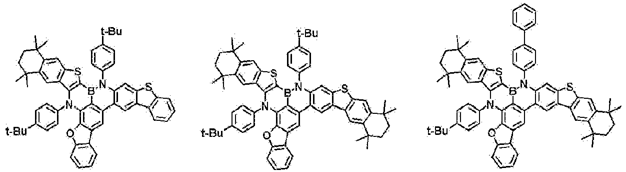 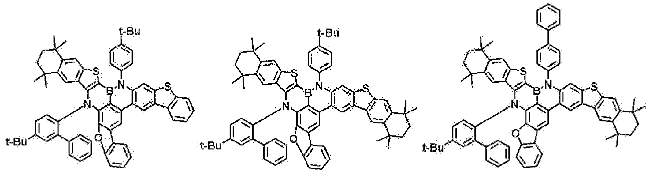 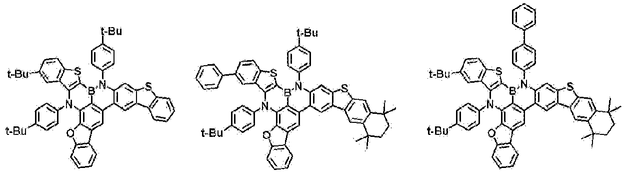 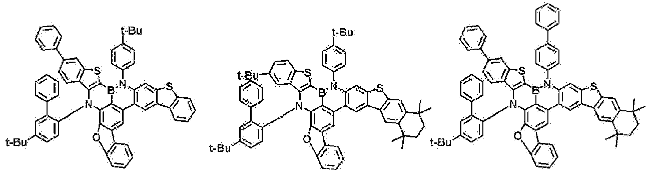 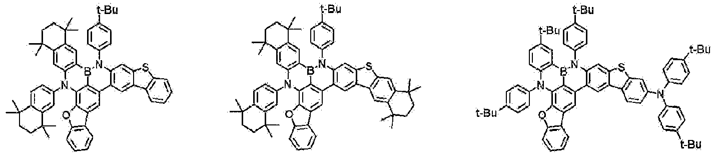 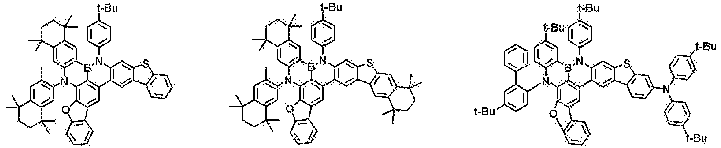 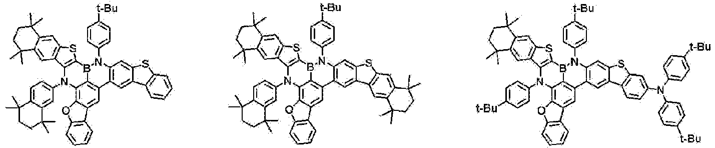 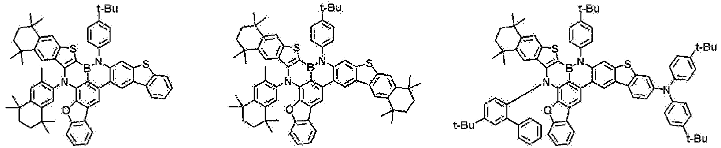 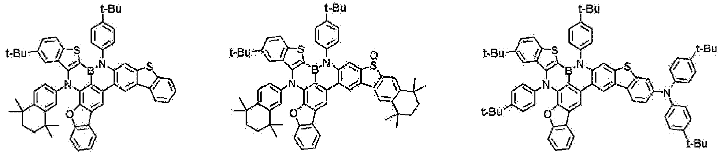 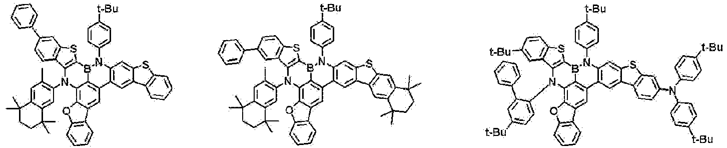 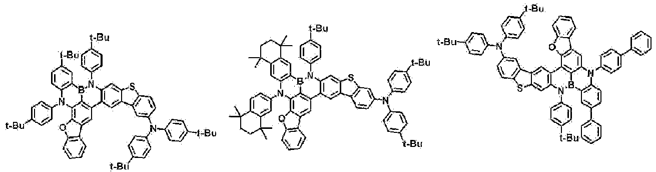 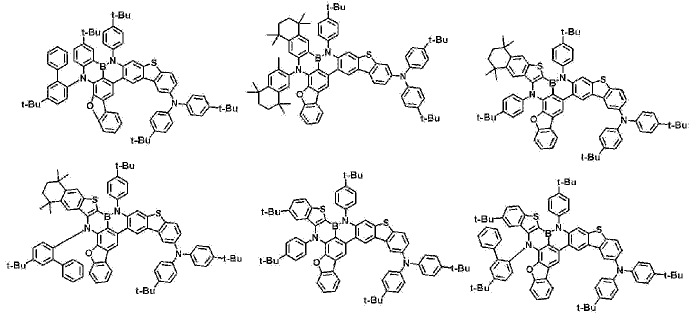 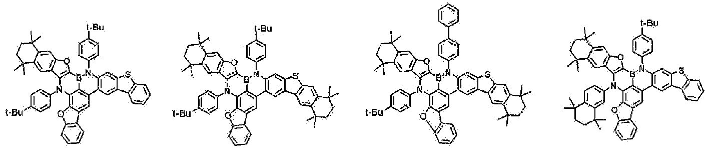 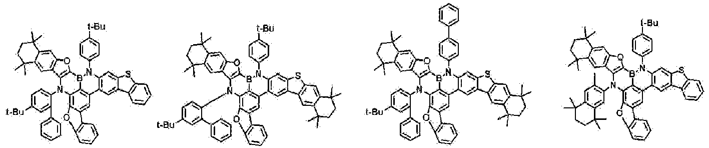 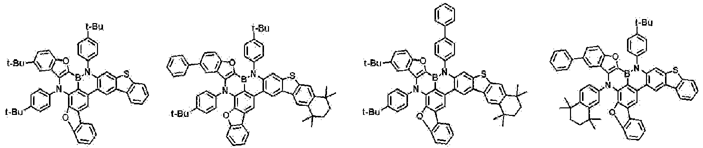 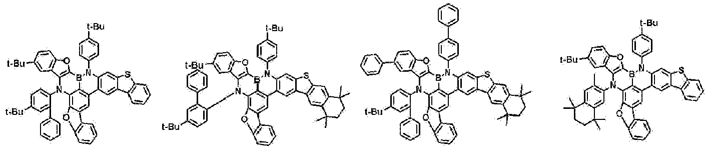 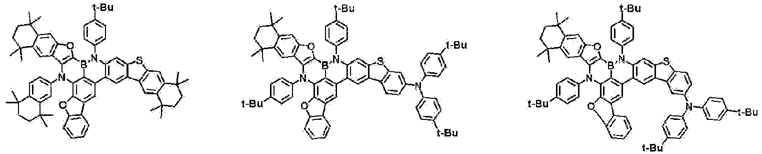 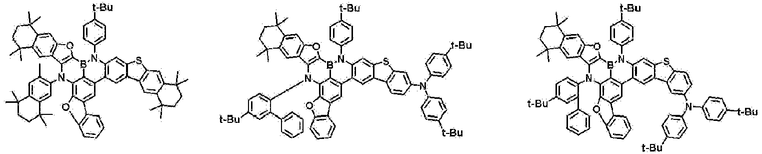 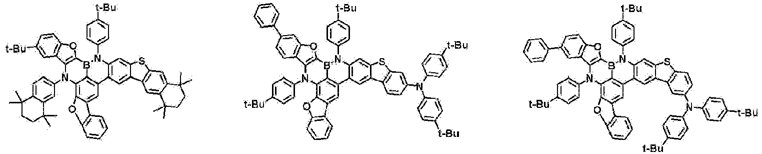 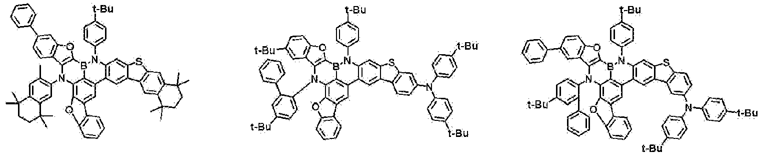 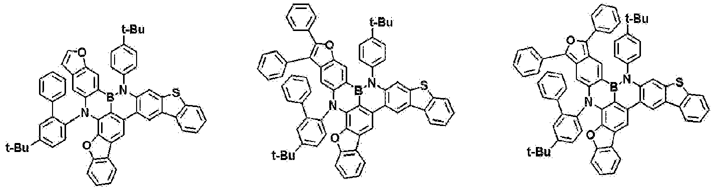 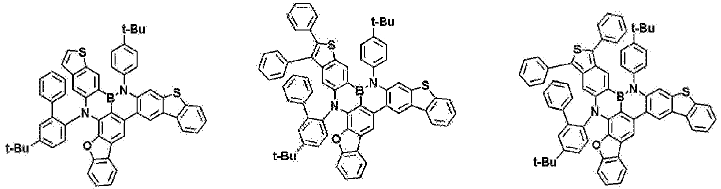 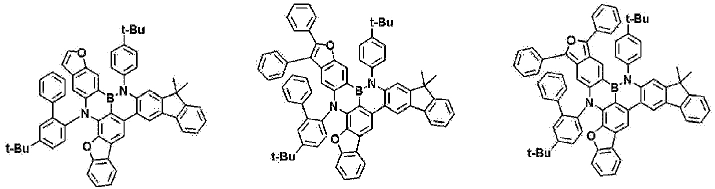 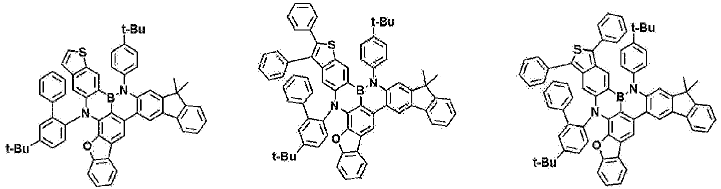 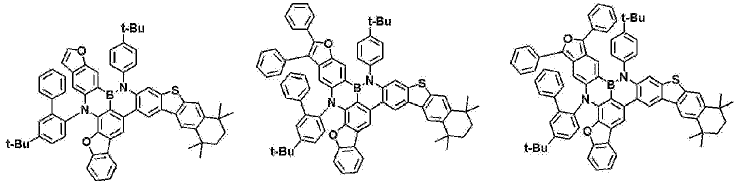 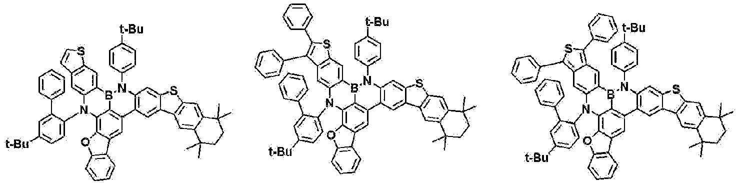 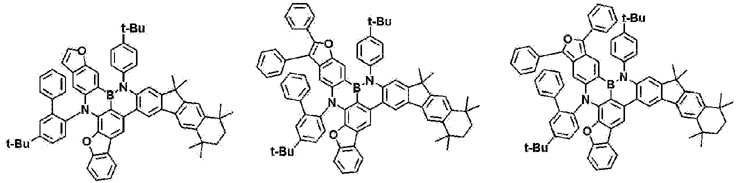 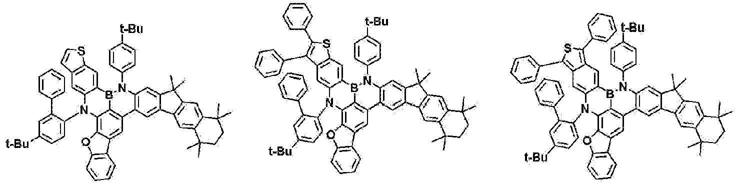 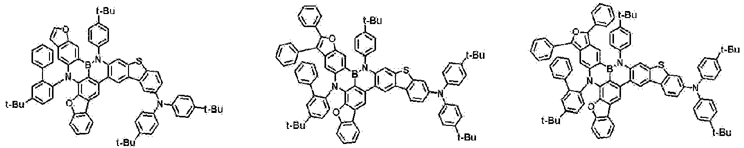 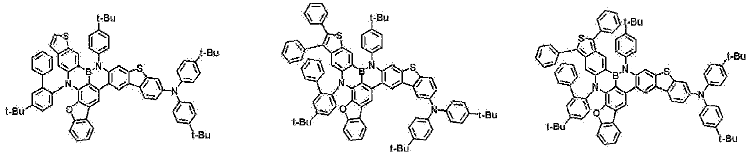 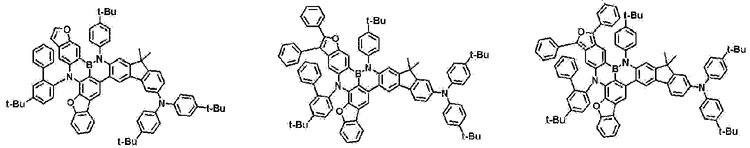 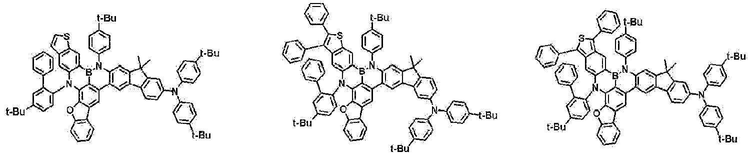 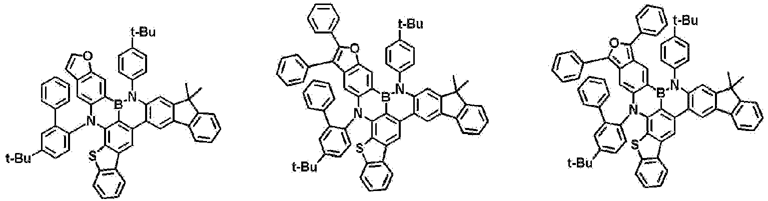 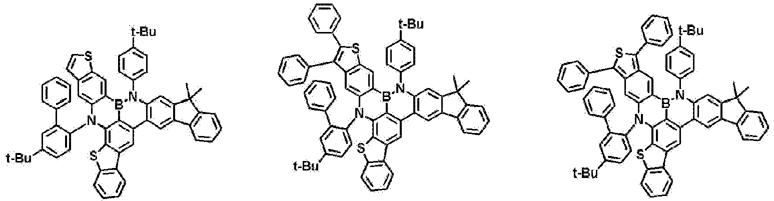 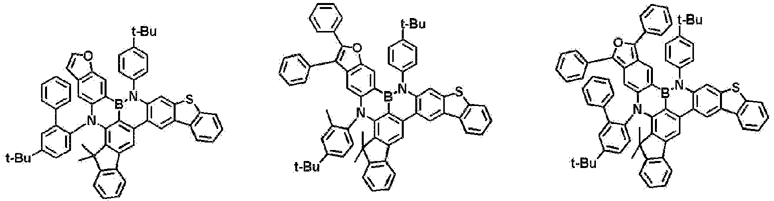 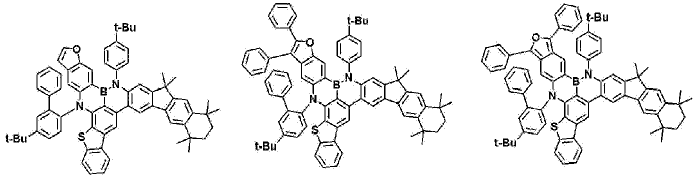 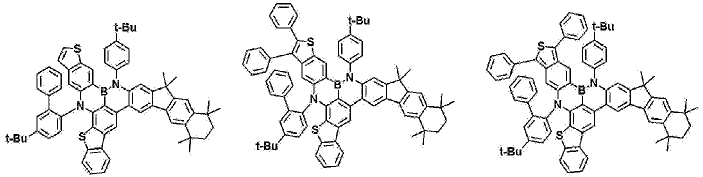 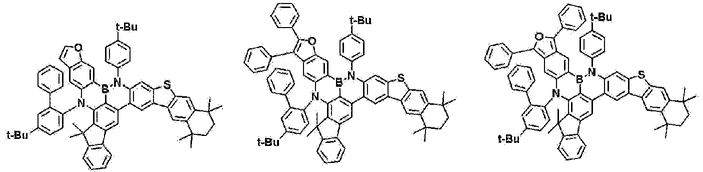 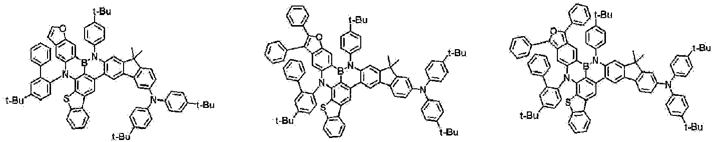 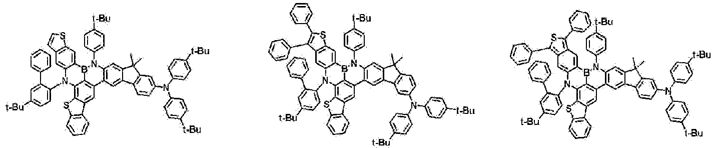 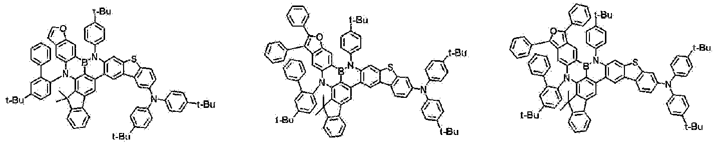 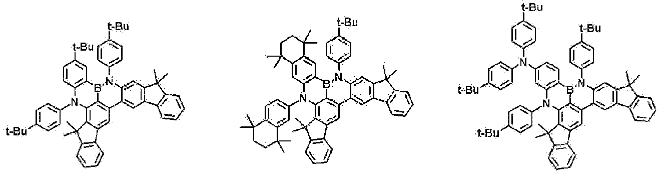 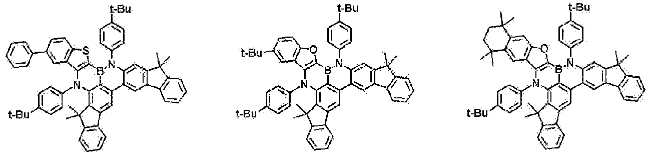 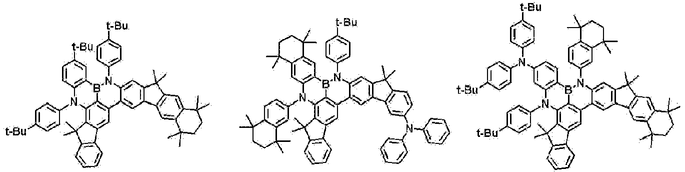 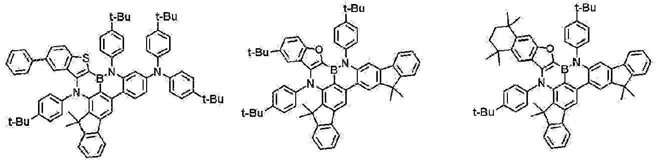 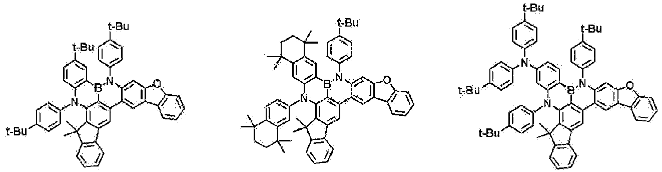 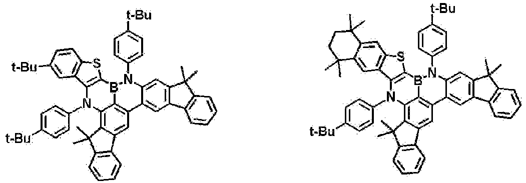 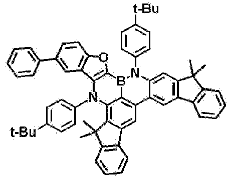 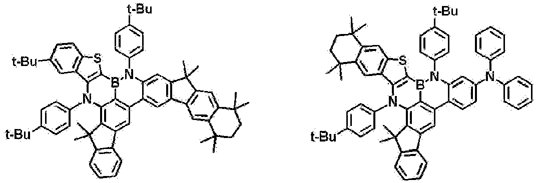 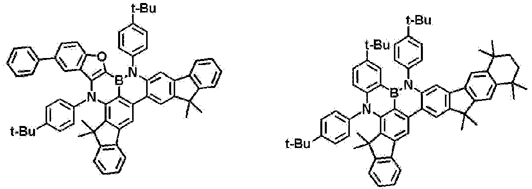 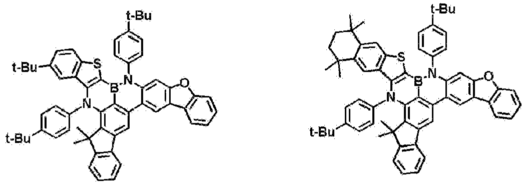 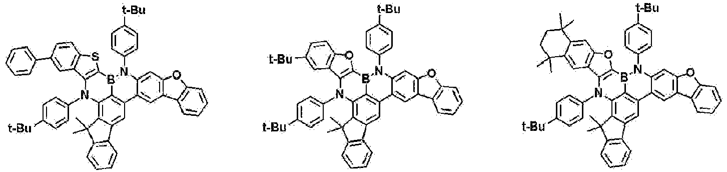 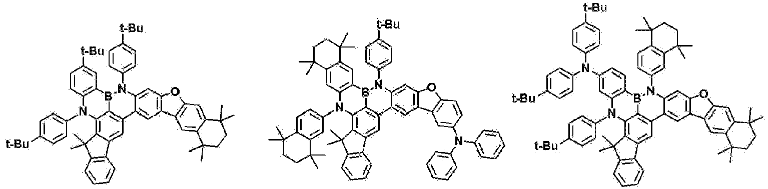 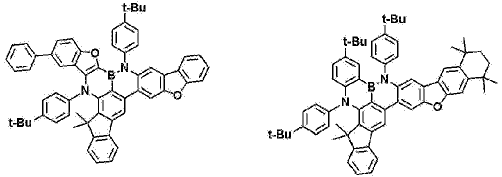 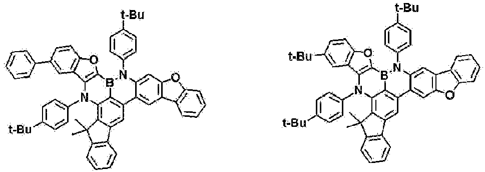 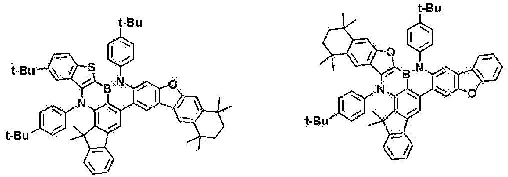 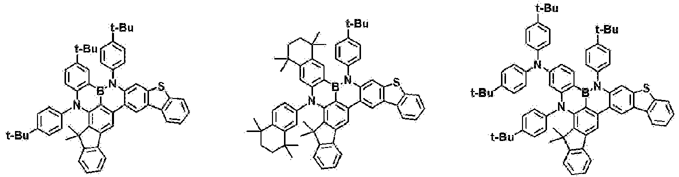 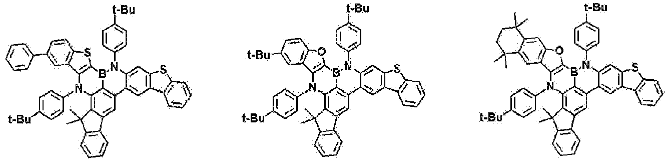 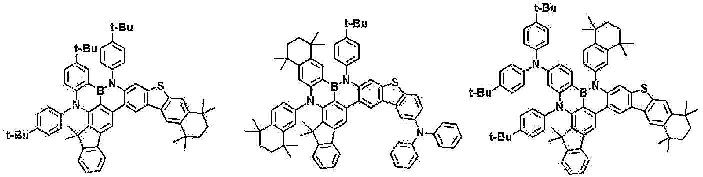 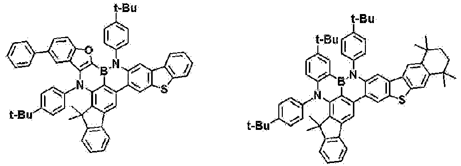 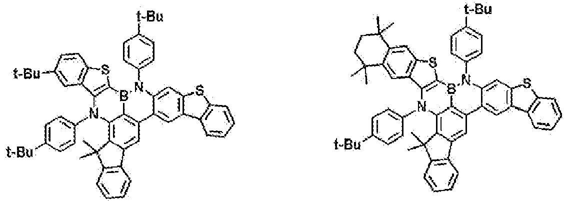 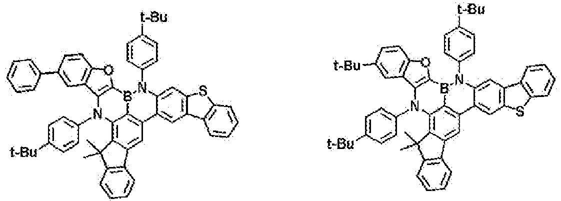 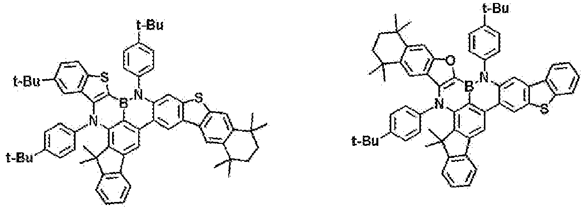 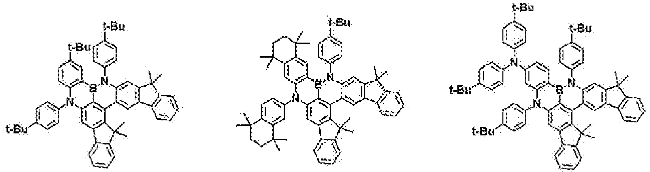 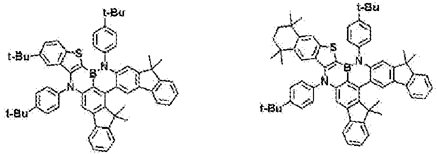 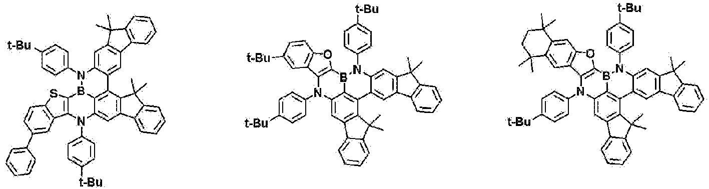 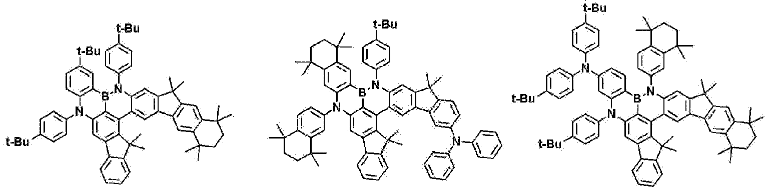 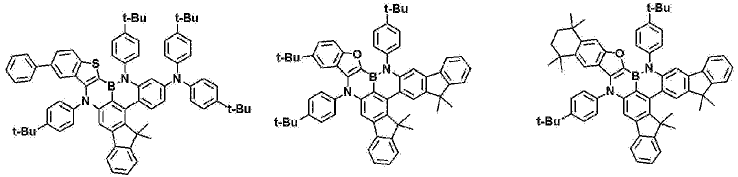 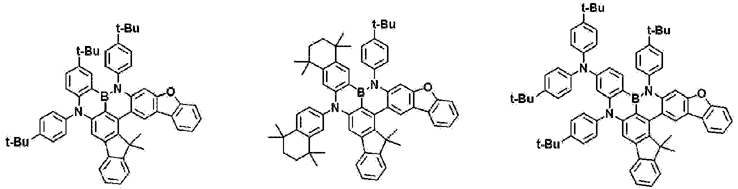 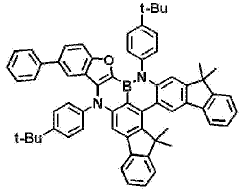 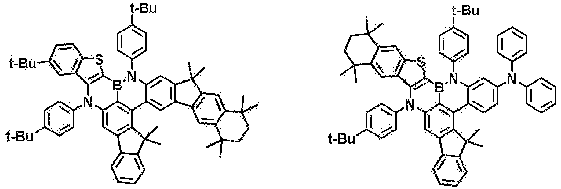 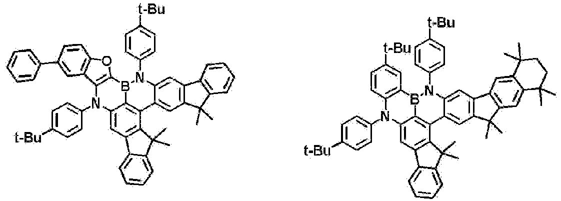 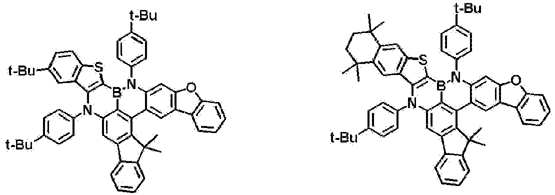 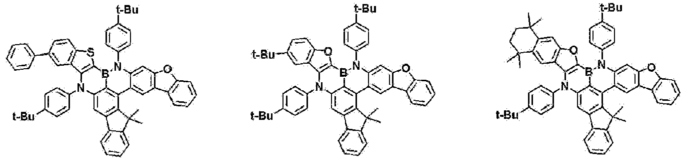 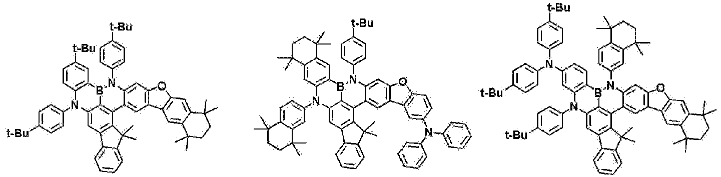 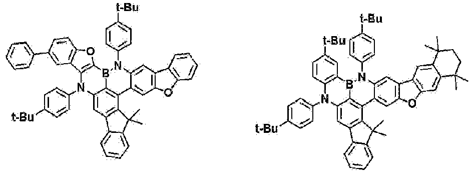 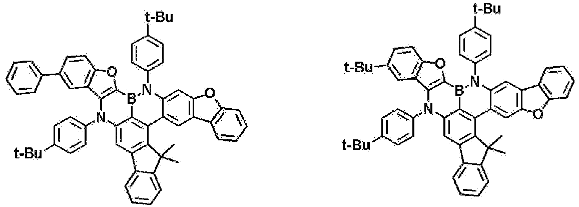 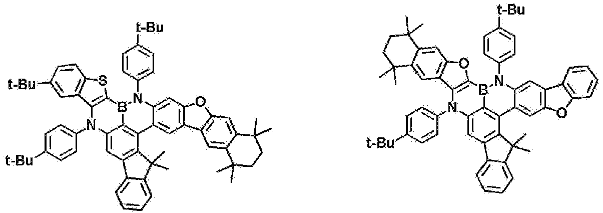 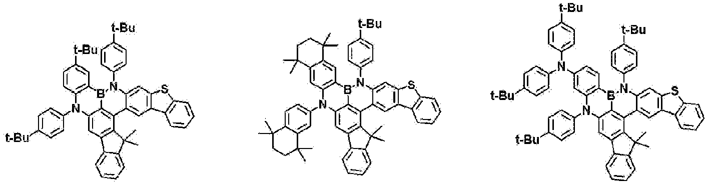 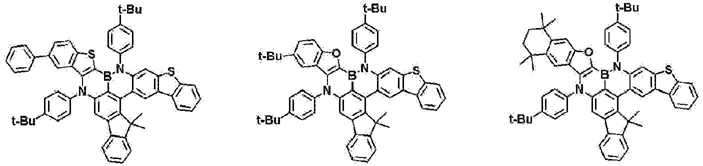 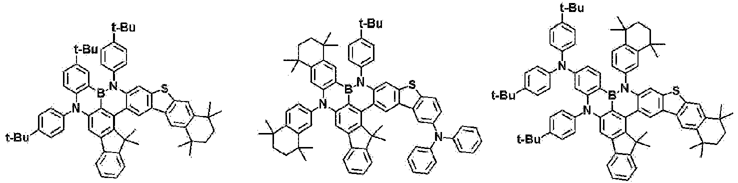 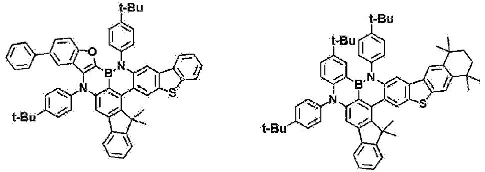 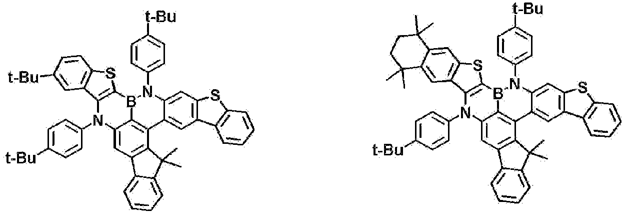 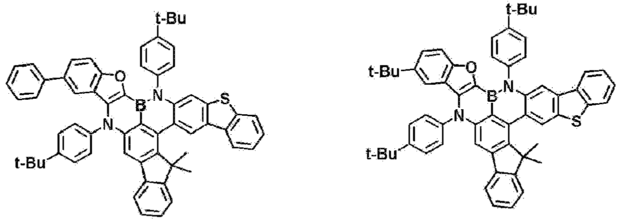 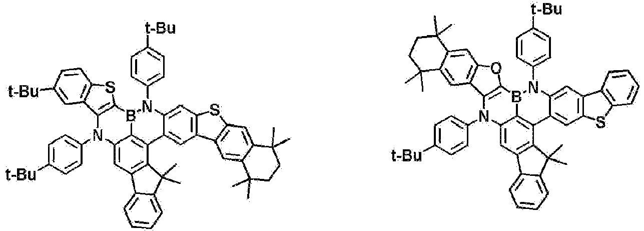 wherein the compounds, t-Bu is a tert-butyl group.

Hereinafter, Chemical Formula H will be described in detail.

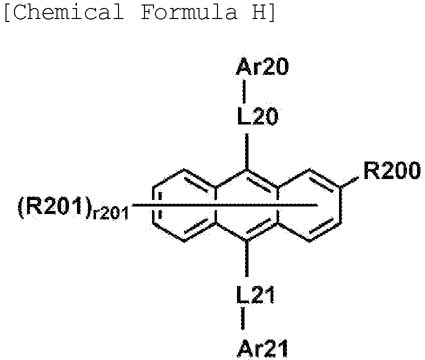

In Chemical Formula H,
L20 and L21 are the same as or different from each other, and each independently a direct bond; or a substituted or unsubstituted arylene group,
Ar20 and Ar21 are the same as or different from each other, and each independently hydrogen; deuterium; a substituted or unsubstituted aryl group; or a substituted or unsubstituted heterocyclic group,
at least one of Ar20 and Ar21 is a substituted or unsubstituted heterocyclic group,
R200 and R201 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r201 is an integer of 1 to 7, and when r201 is 2 or greater, the two or more R201s are the same as or different from each other.

In the present specification, Chemical Formula H may be substituted with deuterium even when being substituted with deuterium is not specified.

In one embodiment of the present specification, L20 and L21 are the same as or different from each other, and each independently a direct bond; or a substituted or unsubstituted monocyclic or polycyclic arylene group having 6 to 30 carbon atoms.

In one embodiment of the present specification, L20 and L21 are the same as or different from each other, and each independently a direct bond; or a substituted or unsubstituted monocyclic or polycyclic arylene group having 6 to 20 carbon atoms.

In one embodiment of the present specification, L20 and L21 are unsubstituted or substituted with deuterium.

In one embodiment of the present specification, L20 and L21 are the same as or different from each other, and each independently a direct bond; a phenylene group unsubstituted or substituted with deuterium; a biphenylene group unsubstituted or substituted with deuterium; or a naphthylene group unsubstituted or substituted with deuterium.

In one embodiment of the present specification, L20 is a direct bond.

In one embodiment of the present specification, L21 is a direct bond; a phenylene group unsubstituted or substituted with deuterium; a biphenylene group unsubstituted or substituted with deuterium; or a naphthylene group unsubstituted or substituted with deuterium.

In one embodiment of the present specification, at least one of L20 and L21 is a direct bond.

In one embodiment of the present specification, at least one of L20 and L21 is a substituted or unsubstituted arylene group.

In one embodiment of the present specification, L20 and L21 are the same as or different from each other, and each independently a direct bond; or one selected from the following structures.

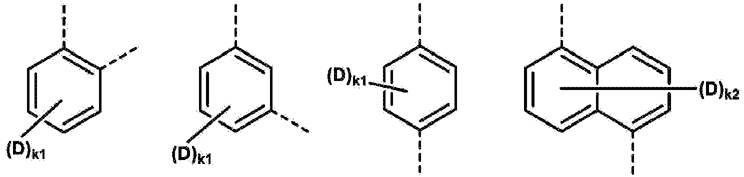

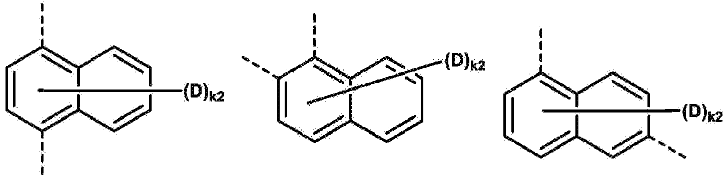

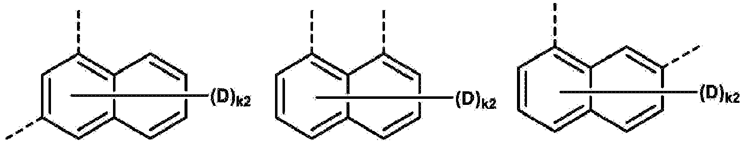

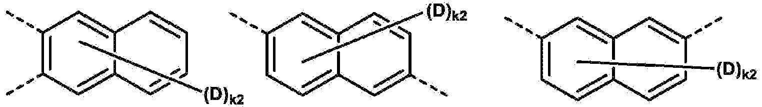

In the structures,
the dotted line is a position linked to Chemical Formula H, and
D means deuterium, k1 is an integer of 0 to 4, and k2 is an integer of 0 to 6.

In one embodiment of the present specification, k1 is 0. In another embodiment, k1 is 4.

In one embodiment of the present specification, k2 is 0. In another embodiment, k2 is 6.

In one embodiment of the present specification, L20 and L21 may each be deuterated.

In one embodiment of the present specification, Ar20 and Ar21 are the same as or different from each other, and each independently a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, Ar20 and Ar21 are the same as or different from each other, and each independently a substituted or unsubstituted monocyclic or polycyclic aryl group having 6 to 20 carbon atoms; or a substituted or unsubstituted monocyclic or polycyclic heterocyclic group having 2 to 20 carbon atoms.

In one embodiment of the present specification, Ar20 and Ar21 are the same as or different from each other, and each independently a substituted or unsubstituted monocyclic or polycyclic aryl group having 6 to 20 carbon atoms; a substituted or unsubstituted monocyclic or polycyclic O-containing heterocyclic group having 2 to 20 carbon atoms; a substituted or unsubstituted monocyclic or polycyclic S-containing heterocyclic group having 2 to 20 carbon atoms; or a substituted or unsubstituted monocyclic or polycyclic N-containing heterocyclic group having 2 to 20 carbon atoms.

In one embodiment of the present specification, Ar20 and Ar21 are the same as or different from each other, and each independently a substituted or unsubstituted monocyclic to tetracyclic aryl group having 6 to 20 carbon atoms; or a substituted or unsubstituted monocyclic to tetracyclic heterocyclic group having 6 to 20 carbon atoms.

In one embodiment of the present specification, Ar20 and Ar21 are the same as or different from each other, and each independently a substituted or unsubstituted phenyl group; a substituted or unsubstituted biphenyl group; a substituted or unsubstituted terphenyl group; a substituted or unsubstituted naphthyl group; a substituted or unsubstituted fluorene group; a substituted or unsubstituted benzofluorene group; a substituted or unsubstituted furan group; a substituted or unsubstituted thiophene group; a substituted or unsubstituted dibenzofuran group; a substituted or unsubstituted naphthobenzofuran group; a substituted or unsubstituted dibenzothiophene group; a substituted or unsubstituted naphthobenzothiophene group; a substituted or unsubstituted carbazole group; or a substituted or unsubstituted benzocarbazole group.

In one embodiment of the present specification, Ar20 and Ar21 are the same as or different from each other, and each independently a phenyl group unsubstituted or substituted with an aryl group having 6 to 20 carbon atoms; a biphenyl group unsubstituted or substituted with an aryl group having 6 to 20 carbon atoms; a naphthyl group unsubstituted or substituted with an aryl group having 6 to 20 carbon atoms; a fluorene group unsubstituted or substituted with an alkyl group having 1 to 6 carbon atoms or an aryl group having 6 to 20 carbon atoms; a benzofluorene group unsubstituted or substituted with an alkyl group having 1 to 6 carbon atoms or an aryl group having 6 to 20 carbon atoms; a dibenzofuran group unsubstituted or substituted with an aryl group having 6 to 20 carbon atoms or a heterocyclic group having 2 to 20 carbon atoms; a naphthobenzofuran group unsubstituted or substituted with an aryl group having 6 to 20 carbon atoms or a heterocyclic group having 2 to 20 carbon atoms; a dibenzothiophene group unsubstituted or substituted with an aryl group having 6 to 20 carbon atoms or a heterocyclic group having 2 to 20 carbon atoms; a naphthobenzothiophene group unsubstituted or substituted with an aryl group having 6 to 20 carbon atoms or a heterocyclic group having 2 to 20 carbon atoms; a carbazole group unsubstituted or substituted with an aryl group having 6 to 20 carbon atoms; or a benzocarbazole group unsubstituted or substituted with an aryl group having 6 to 20 carbon atoms, and Ar20 and Ar21 may each be deuterated.

In one embodiment of the present specification, Ar20 and Ar21 are the same as or different from each other, and each independently a phenyl group unsubstituted or substituted with deuterium; a biphenyl group unsubstituted or substituted with deuterium; a terphenyl group unsubstituted or substituted with deuterium; a naphthyl group unsubstituted or substituted with deuterium; a fluorene group unsubstituted or substituted with deuterium, a methyl group, a phenyl group or a deuterated phenyl group; a benzofluorene group unsubstituted or substituted with deuterium, a methyl group, a phenyl group or a deuterated phenyl group; a dibenzofuran group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a naphthobenzofuran group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a dibenzothiophene group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a naphthobenzothiophene group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a carbazole group unsubstituted or substituted with deuterium, a phenyl group, a biphenyl group, a naphthyl group or a deuterated substituent thereof; or a benzocarbazole group unsubstituted or substituted with deuterium, a phenyl group, a biphenyl group, a naphthyl group or a deuterated substituent thereof.

In one embodiment of the present specification, at least one of Ar20 and Ar21 is a substituted or unsubstituted heterocyclic group.

In one embodiment of the present specification, at least one of Ar20 and Ar21 is a substituted or unsubstituted O-containing heterocyclic group; or a substituted or unsubstituted S-containing heterocyclic group.

In one embodiment of the present specification, at least one of Ar20 and Ar21 is a substituted or unsubstituted tricyclic or tetracyclic O-containing heterocyclic group; or a substituted or unsubstituted tricyclic or tetracyclic S-containing heterocyclic group.

In one embodiment of the present specification, at least one of Ar20 and Ar21 is a substituted or unsubstituted O-containing heterocyclic group having 2 to 30 carbon atoms; or a substituted or unsubstituted S-containing heterocyclic group having 2 to 30 carbon atoms.

In one embodiment of the present specification, at least one of Ar20 and Ar21 is a substituted or unsubstituted O-containing heterocyclic group having 2 to 20 carbon atoms; or a substituted or unsubstituted S-containing heterocyclic group having 2 to 20 carbon atoms.

In one embodiment of the present specification, at least one of Ar20 and Ar21 is an O- or S-containing heterocyclic group, and the heterocyclic group is unsubstituted or substituted with one or more groups selected from the group consisting of deuterium, an alkyl group and an aryl group; or a group linking two or more groups selected from the above-described group.

In one embodiment of the present specification, at least one of Ar20 and Ar21 is an O- or S-containing heterocyclic group, and the heterocyclic group is unsubstituted or substituted with deuterium; an alkyl group; a deuterated alkyl group; an aryl group; a deuterated aryl group; an alkylaryl group; a deuterated alkylaryl group; a heterocyclic group; a deuterated heterocyclic group; an arylheterocyclic group; or a deuterated arylheterocyclic group.

In one embodiment of the present specification, at least one of Ar20 and Ar21 is a substituted or unsubstituted dibenzofuran group; a substituted or unsubstituted naphthobenzofuran group; a substituted or unsubstituted dibenzothiophene group; or a substituted or unsubstituted naphthobenzothiophene group.

In one embodiment of the present specification, at least one of Ar20 and Ar21 is represented by the following Chemical Formula Het1.

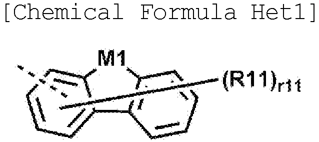

In Chemical Formula Het1,
the dotted line is linked to Chemical Formula H,
M1 is O; or S,
R11 is hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, or bonds to adjacent groups to form a substituted or unsubstituted ring, and
r11 is an integer of 0 to 7, and when r11 is 2 or greater, R11s are the same as or different from each other.

In one embodiment of the present specification, M is O.

In one embodiment of the present specification, M is S.

In one embodiment of the present specification, R11 is hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, or bonds to adjacent groups to form a substituted or unsubstituted ring.

In one embodiment of the present specification, R11 is hydrogen; deuterium; a halogen group; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms, or bonds to adjacent groups to form a substituted or unsubstituted ring having 5 to 30 carbon atoms.

In one embodiment of the present specification, R11 is hydrogen; deuterium; a halogen group; a substituted or unsubstituted linear or branched alkyl group having 1 to 10 carbon atoms; a substituted or unsubstituted monocyclic or polycyclic cycloalkyl group having 3 to 10 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms, or bonds to adjacent groups to form a substituted or unsubstituted ring having 5 to 30 carbon atoms.

In one embodiment of the present specification, R11 is hydrogen; deuterium; an aryl group having 6 to 30 carbon atoms unsubstituted or substituted with an alkyl group having 1 to 10 carbon atoms; or a heterocyclic group having 2 to 30 carbon atoms unsubstituted or substituted with an aryl group having 6 to 30 carbon atoms, or bonds to adjacent groups to form a ring having 5 to 30 carbon atoms unsubstituted or substituted with an aryl group having 6 to 30 carbon atoms or a heterocyclic group having 2 to 30 carbon atoms, and R11 or the ring may be deuterated.

In one embodiment of the present specification, R11 is hydrogen; deuterium; a substituted or unsubstituted phenyl group; a substituted or unsubstituted biphenyl group; a substituted or unsubstituted terphenyl group; a substituted or unsubstituted naphthyl group; a substituted or unsubstituted fluorene group; a substituted or unsubstituted dibenzofuran group; a substituted or unsubstituted naphthobenzothiophene group; a substituted or unsubstituted dibenzothiophene group; a substituted or unsubstituted naphthobenzothiophene group; a substituted or unsubstituted carbazole group; or a substituted or unsubstituted benzocarbazole group, or bonds to adjacent groups to form a substituted or unsubstituted benzene ring.

In one embodiment of the present specification, R11 is hydrogen; deuterium; a phenyl group unsubstituted or substituted with deuterium; a biphenyl group unsubstituted or substituted with deuterium; a terphenyl group unsubstituted or substituted with deuterium; a naphthyl group unsubstituted or substituted with deuterium; a fluorene group unsubstituted or substituted with deuterium, a methyl group, a phenyl group or a deuterated phenyl group; a benzofluorene group unsubstituted or substituted with deuterium, a methyl group, a phenyl group or a deuterated phenyl group; a dibenzofuran group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a naphthobenzofuran group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a dibenzothiophene group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a naphthobenzothiophene group unsubstituted or substituted with deuterium, a phenyl group, a biphenyl group, a naphthyl group, a dimethylfluorene group, a dibenzofuran group, a dibenzothiophene group, a naphthobenzofuran group, a naphthobenzothiophene group, an N-phenylcarbazole group, an N-biphenylcarbazole group or a deuterated substituent thereof; a carbazole group unsubstituted or substituted with deuterium, a phenyl group, a biphenyl group, a naphthyl group or a deuterated substituent thereof; or a benzocarbazole group unsubstituted or substituted with deuterium, a phenyl group, a biphenyl group, a naphthyl group or a deuterated substituent thereof.

In one embodiment of the present specification, r11 is an integer of 0 to 7.

In one embodiment of the present specification, R11 is a substituted or unsubstituted aryl group; or a substituted or unsubstituted heterocyclic group, and r11 is 1 or 2.

In one embodiment of the present specification, Chemical Formula Het1 is the following Chemical Formula Het1-1.

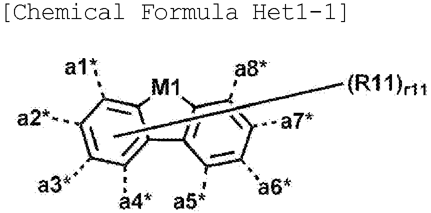

In Chemical Formula Het1-1,
M1, R11 and r11 have the same definitions as in Chemical Formula Het1, and
one of a1* to a8* is linked to Chemical Formula H.

In one embodiment of the present specification, the rest of a1* to a8* not linked to Chemical Formula H are R11.

In one embodiment of the present specification, Chemical Formula Het1 is represented by one of the following Chemical Formulae Het2 to Het4.

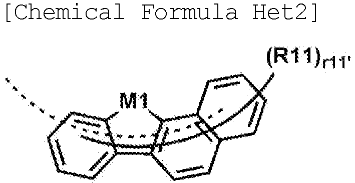

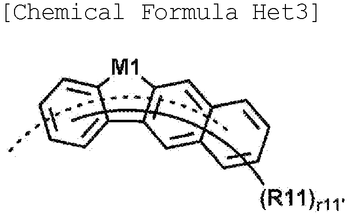

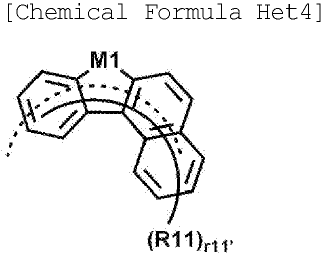

In Chemical Formulae Het2 to Het4,
the dotted line and M1 have the same definitions as in Chemical Formula Het1,
R11 is hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r11' is an integer of 0 to 9, and when r11' is 2 or greater, R11s are the same as or different from each other.

In one embodiment of the present specification, r11' is an integer of 0 to 7.

In one embodiment of the present specification, R11 is a substituted or unsubstituted aryl group; or a substituted or unsubstituted heteroaryl group, and r11' is 1 or 2.

In one embodiment of the present specification, Chemical Formula Het2 is represented by the following Chemical Formula Het2-1.

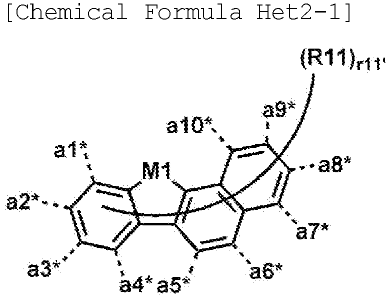

In Chemical Formula Het2-1,
M1, R11 and r11' have the same definitions as in Chemical Formula Het2, and
one of a1* to a10* is linked to Chemical Formula H.

In one embodiment of the present specification, Chemical Formula Het3 is represented by the following Chemical Formula Het3-1.

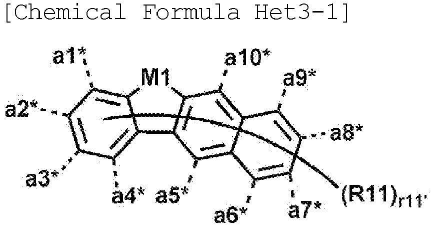

In Chemical Formula Het3-1,
M1, R11 and r11' have the same definitions as in Chemical Formula Het3, and
one of a1* to a10* is linked to Chemical Formula H.

In one embodiment of the present specification, Chemical Formula Het4 is represented by the following Chemical Formula Het4-1.

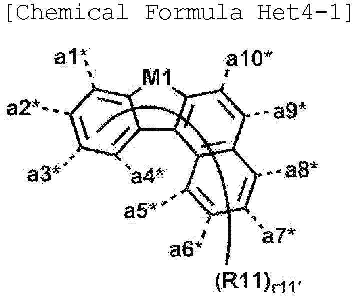

In Chemical Formula Het4-1,
M1, R11 and r11' have the same definitions as in Chemical Formula Het3, and
one of a1* to a10* is linked to Chemical Formula H.

In one embodiment of the present specification, the rest of a1* to a10* not linked to Chemical Formula H are R11.

In one embodiment of the present specification, a1* is linked to Chemical Formula H. In another embodiment, a2* is linked to Chemical Formula H. In another embodiment, a3* is linked to Chemical Formula H. In another embodiment, a4* is linked to Chemical Formula H. In another embodiment, a5* is linked to Chemical Formula H. In another embodiment, a6* is linked to Chemical Formula H. In another embodiment, a7* is linked to Chemical Formula H. In another embodiment, a8* is linked to Chemical Formula H. In another embodiment, a9* is linked to Chemical Formula H. In another embodiment, a10* is linked to Chemical Formula H.

When Chemical Formula Het1 is linked to Chemical Formula H through a3* or a4*, a voltage decreases and efficiency increases in a device.

In one embodiment of the present specification, Chemical Formula Het1 may be deuterated.

In one embodiment of the present specification, one of Ar20 and Ar21 is a substituted or unsubstituted heterocyclic group, and the other one is a substituted or unsubstituted aryl group.

In one embodiment of the present specification, Ar20 and Ar21 are the same as or different from each other, and each independently a substituted or unsubstituted heterocyclic group.

In one embodiment of the present specification, Ar20 is a substituted or unsubstituted heterocyclic group, and Ar21 is a substituted or unsubstituted aryl group.

In one embodiment of the present specification, Ar20 is a substituted or unsubstituted aryl group, and Ar21 is a substituted or unsubstituted heterocyclic group.

In one embodiment of the present specification, one of Ar20 and Ar21 is represented by Chemical Formula Het1, and the other one is a substituted or unsubstituted aryl group.

In one embodiment of the present specification, one of Ar20 and Ar21 is represented by Chemical Formula Het1, and the other one is a substituted or unsubstituted N-containing heterocyclic group.

In one embodiment of the present specification, Ar20 and Ar21 are the same as or different from each other, and each independently represented by Chemical Formula Het1.

In one embodiment of the present specification, Ar20 is represented by Chemical Formula Het1, and Ar21 is a substituted or unsubstituted aryl group.

In one embodiment of the present specification, Ar20 is represented by Chemical Formula Het1, and Ar21 is a substituted or unsubstituted aryl group or a substituted or unsubstituted N-containing heterocyclic group.

In one embodiment of the present specification, Ar20 is a substituted or unsubstituted aryl group, and Ar21 is represented by Chemical Formula Het1.

In one embodiment of the present specification, Ar20 is a substituted or unsubstituted aryl group or a substituted or unsubstituted N-containing heterocyclic group, and Ar21 is represented by Chemical Formula Het1.

In one embodiment of the present specification, the compound of Chemical Formula H is represented by one of the following Chemical Formulae H-1 to H-4.

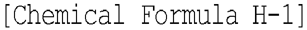

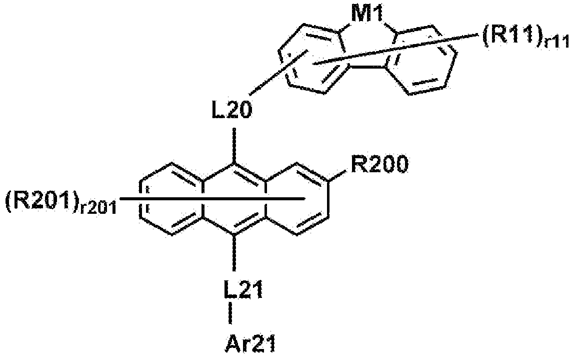

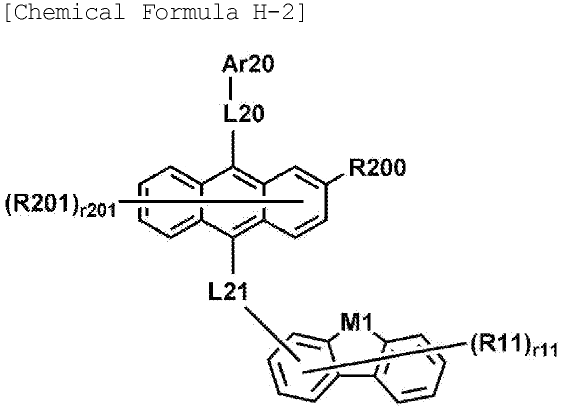

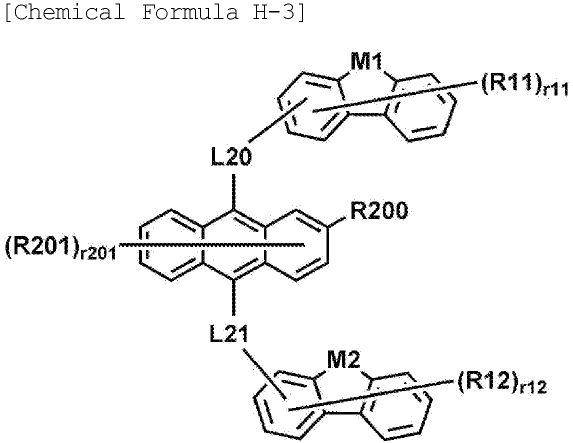

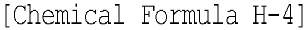

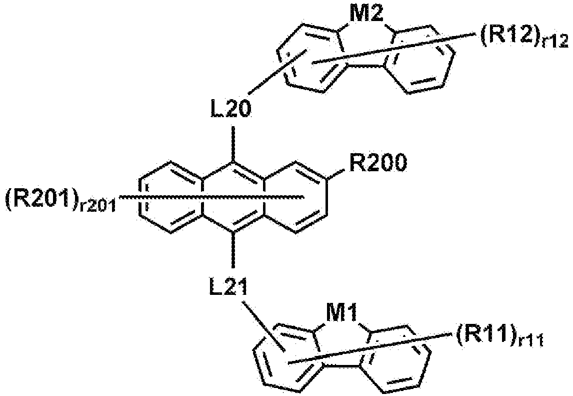

In Chemical Formulae H-1 to H-4,
L20, L21, R200, R201 and r201 have the same definitions as in Chemical Formula H,
M1 is O; or S,
M2 is O; S; or NR13,
Ar20 and Ar21 are the same as or different from each other, and each independently a substituted or unsubstituted aryl group,
R11 to R13 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, or bond to adjacent groups to form a substituted or unsubstituted ring, and
r11 and r12 are an integer of 0 to 7, and when r11 and r12 are 2 or greater, substituents in the parentheses are the same as or different from each other.

In one embodiment of the present specification, the descriptions on R11 provided above are applied to R12.

In one embodiment of the present specification, the descriptions on r11 provided above are applied to r12.

In one embodiment of the present specification, R13 is hydrogen; deuterium; a halogen group; a substituted or unsubstituted alkyl group; or a substituted or unsubstituted aryl group.

In one embodiment of the present specification, R13 is a substituted or unsubstituted monocyclic or polycyclic aryl group having 6 to 30 carbon atoms.

In one embodiment of the present specification, R13 is a monocyclic or polycyclic aryl group having 6 to 20 carbon atoms unsubstituted or substituted with deuterium.

In one embodiment of the present specification, R13 is a phenyl group unsubstituted or substituted with deuterium; a biphenyl group unsubstituted or substituted with deuterium; or a naphthyl group unsubstituted or substituted with deuterium.

In one embodiment of the present specification, R200 is hydrogen; deuterium; a halogen group; a substituted or unsubstituted linear or branched alkyl group having 1 to 30 carbon atoms; a substituted or unsubstituted monocyclic or polycyclic cycloalkyl group having 3 to 30 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; deuterium; fluorine; a substituted or unsubstituted linear or branched alkyl group having 1 to 10 carbon atoms; a substituted or unsubstituted monocyclic or polycyclic cycloalkyl group having 3 to 10 carbon atoms; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; deuterium; a substituted or unsubstituted monocyclic or polycyclic aryl group having 6 to 30 carbon atoms; or a substituted or unsubstituted monocyclic or polycyclic heterocyclic group having 2 to 30 carbon atoms.

In one embodiment of the present specification, R200 is hydrogen; deuterium; a substituted or unsubstituted monocyclic or polycyclic aryl group having 6 to 20 carbon atoms; or a substituted or unsubstituted monocyclic or polycyclic heterocyclic group having 2 to 20 carbon atoms.

In one embodiment of the present specification, R200 is hydrogen; deuterium; a substituted or unsubstituted monocyclic to tetracyclic aryl group having 6 to 20 carbon atoms; or a substituted or unsubstituted monocyclic to tetracyclic heterocyclic group having 6 to 20 carbon atoms.

In one embodiment of the present specification, R200 is hydrogen; deuterium; or a substituted or unsubstituted aryl group.

In one embodiment of the present specification, R200 is hydrogen; deuterium; a substituted or unsubstituted phenyl group; a substituted or unsubstituted biphenyl group; a substituted or unsubstituted terphenyl group; a substituted or unsubstituted naphthyl group; a substituted or unsubstituted anthracene group; a substituted or unsubstituted phenanthrene group; a substituted or unsubstituted phenalene group; or a substituted or unsubstituted fluorene group.

In one embodiment of the present specification, R200 is hydrogen; deuterium; a phenyl group unsubstituted or substituted with deuterium, or a monocyclic or polycyclic aryl group having 6 to 20 carbon atoms; a biphenyl group unsubstituted or substituted with a monocyclic or polycyclic aryl group having 6 to 20 carbon atoms; or a naphthyl group unsubstituted or substituted with deuterium, or a monocyclic or polycyclic aryl group having 6 to 20 carbon atoms.

In one embodiment of the present specification, R200 is hydrogen; deuterium; a phenyl group unsubstituted or substituted with deuterium, a phenyl group or a naphthyl group; a biphenyl group; or a naphthyl group unsubstituted or substituted with deuterium, a phenyl group or a naphthyl group.

In one embodiment of the present specification, R200 is a phenyl group unsubstituted or substituted with deuterium; a biphenyl group unsubstituted or substituted with deuterium; or a naphthyl group substituted with deuterium.

According to one embodiment of the present specification, R201 is hydrogen.

According to one embodiment of the present specification, R201 is deuterium.

According to one embodiment of the present specification, R201 is deuterium, and r201 is 4 or greater.

According to one embodiment of the present specification, R200 and R201 are deuterium, and n201 is 7.

In one embodiment of the present specification, Chemical Formula H is represented by the following Chemical Formula H-5.

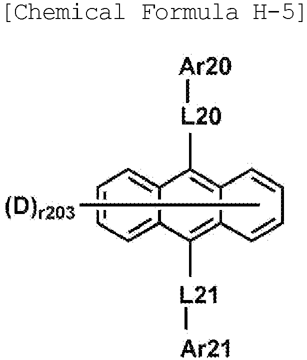

In Chemical Formula H-5,
Ar20, Ar21, L20 and L21 have the same definitions as in Chemical Formula H, and
D is deuterium, and r203 is from 0 to 8.

In one embodiment of the present specification, r203 is an integer of 4 to 8.

In one embodiment of the present specification, r203 is 8.

In one embodiment of the present specification, when the compound represented by Chemical Formula H is substituted with deuterium, 30% or more of hydrogens at a substitutable position are substituted with deuterium. In another embodiment, 40% or more of hydrogens at a substitutable position are substituted with deuterium in the structure of Chemical Formula H. In another embodiment, 60% or more of hydrogens at a substitutable position are substituted with deuterium in the structure of Chemical Formula H. In another embodiment, 80% or more of hydrogens at a substitutable position are substituted with deuterium in the structure of Chemical Formula H. In another embodiment, 100% of hydrogens at a substitutable position are substituted with deuterium in the structure of Chemical Formula H.

In one embodiment of the present specification, the compound of Chemical Formula H is one selected from the following compounds.

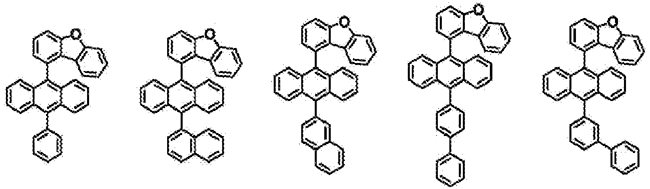

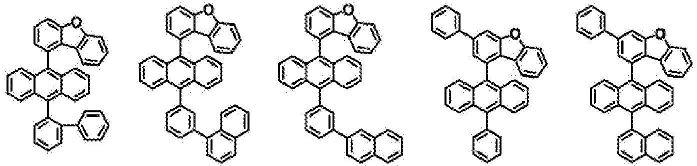

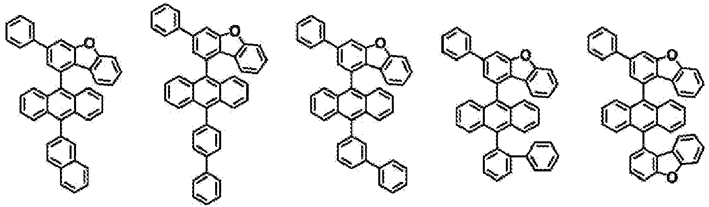

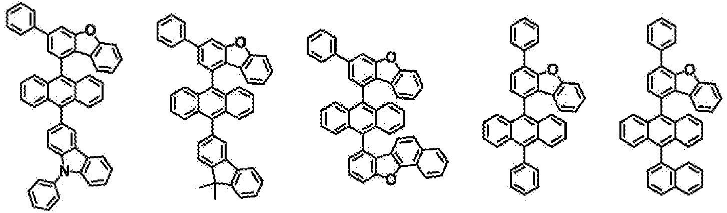

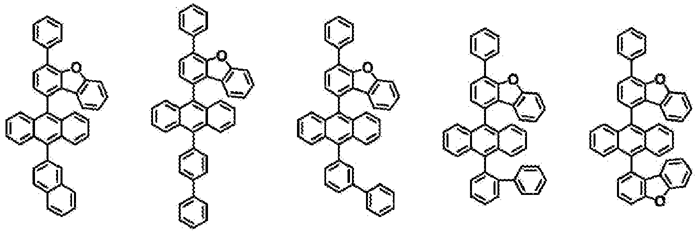

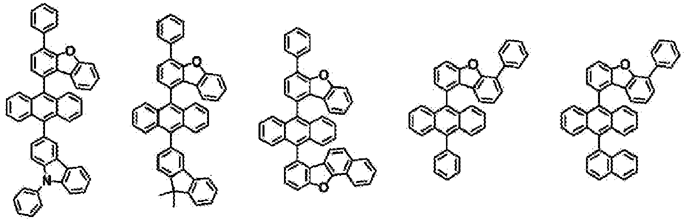

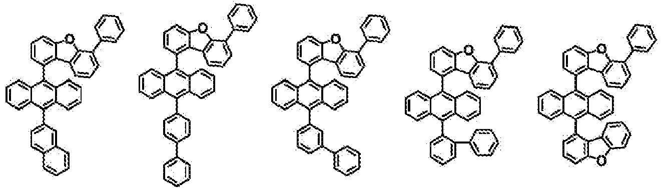

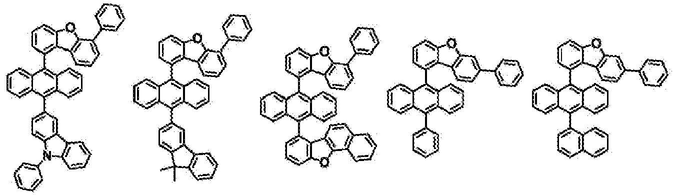

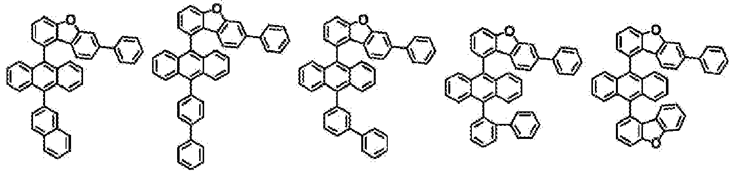

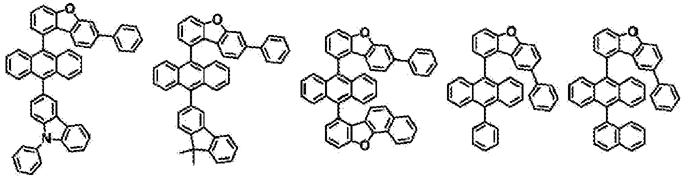

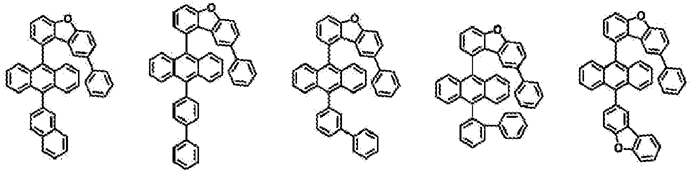

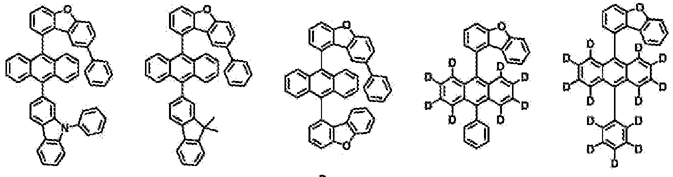

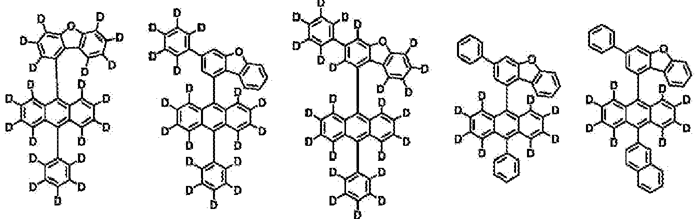

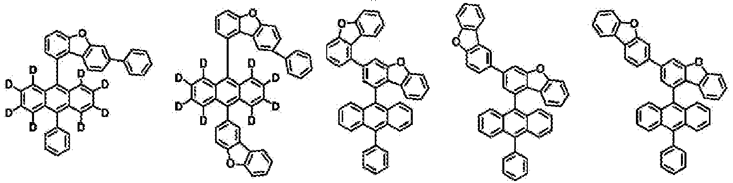

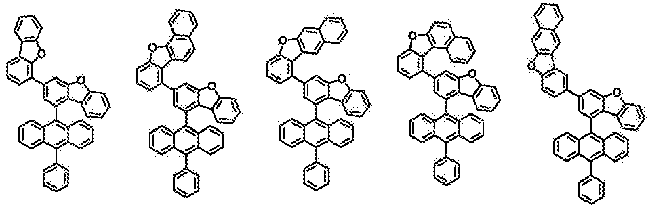

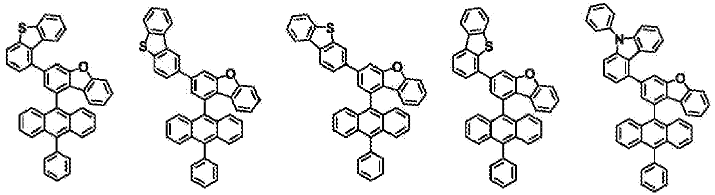

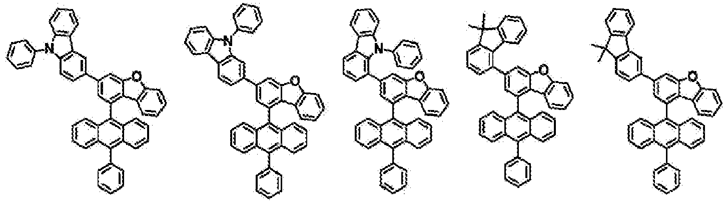

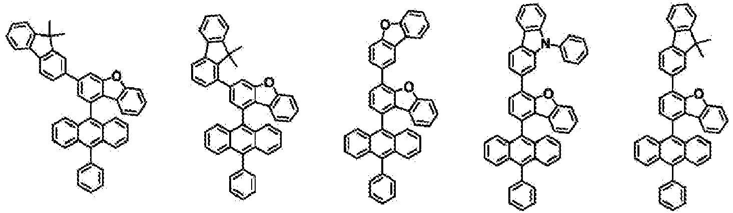

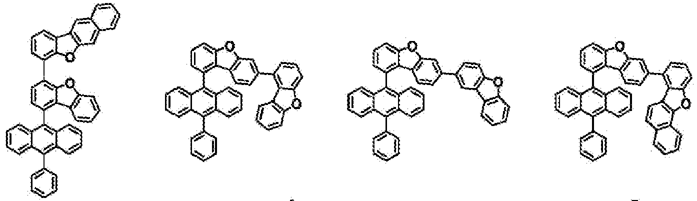

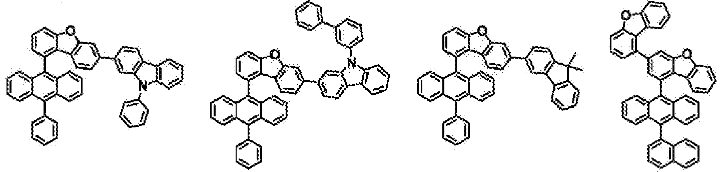

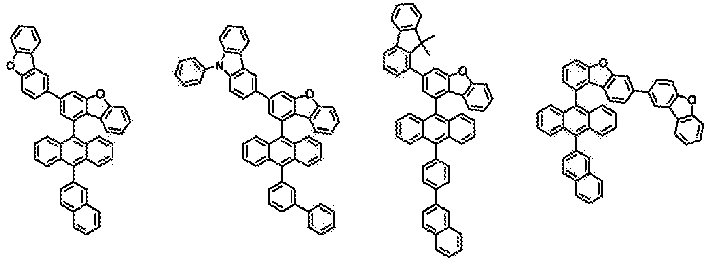

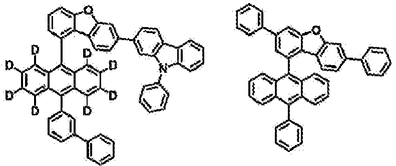

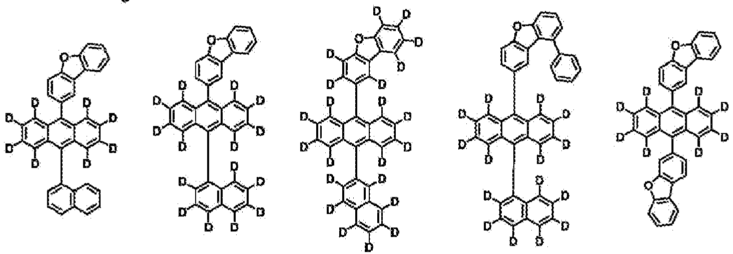

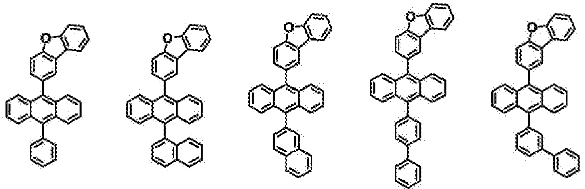

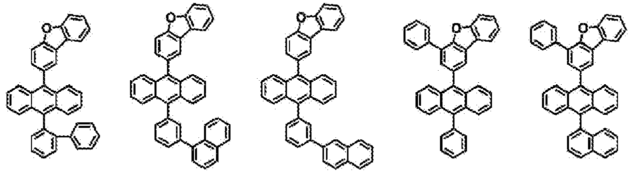

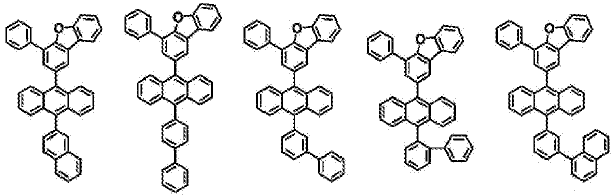

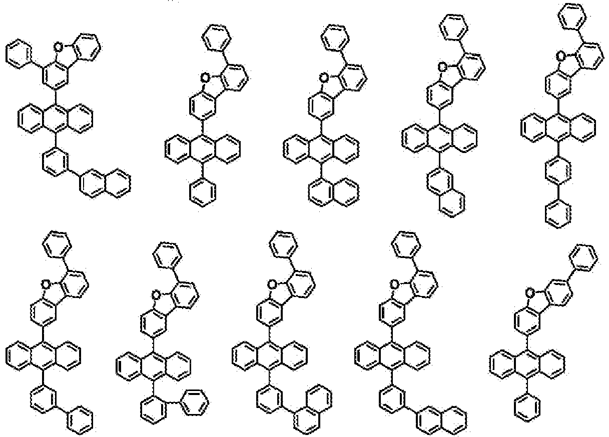

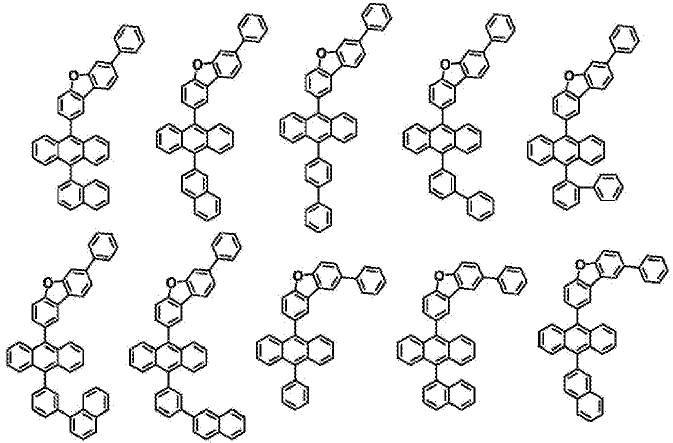

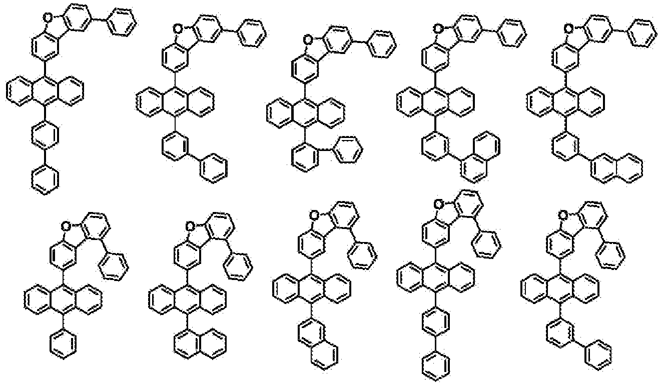

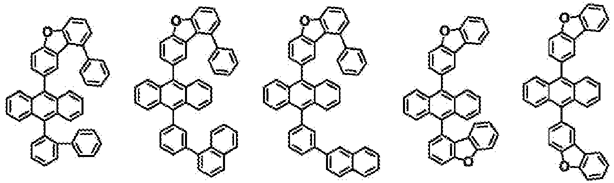

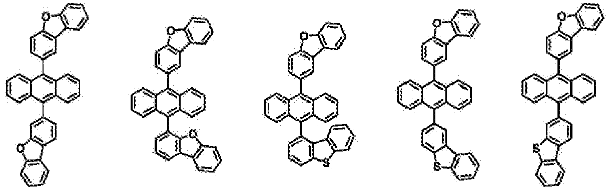

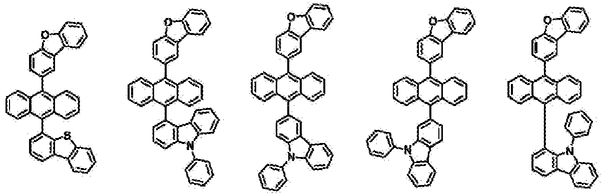

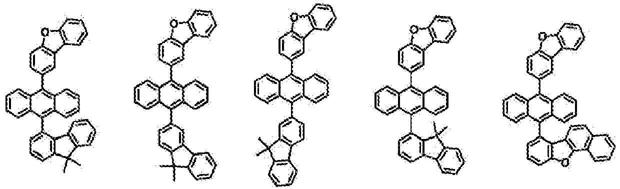

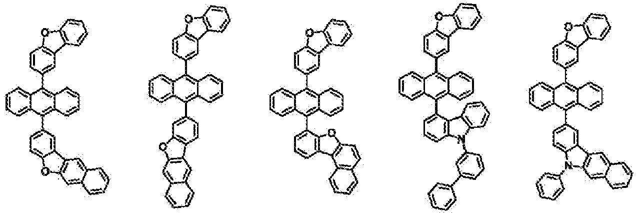

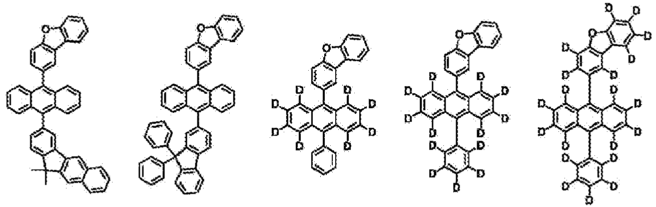

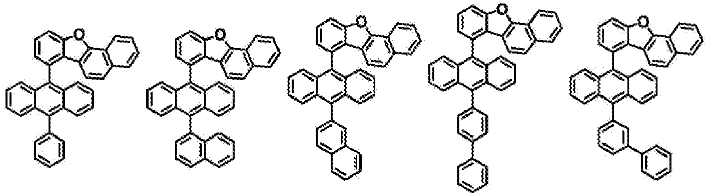

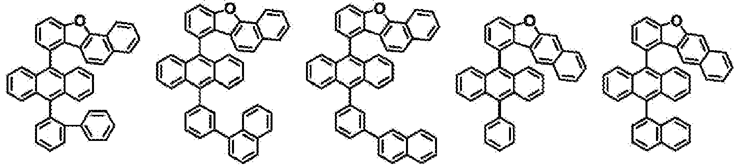

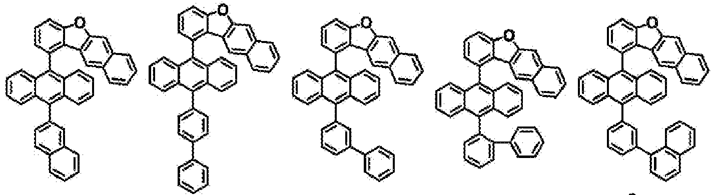

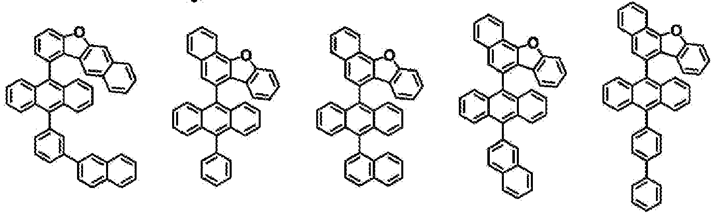

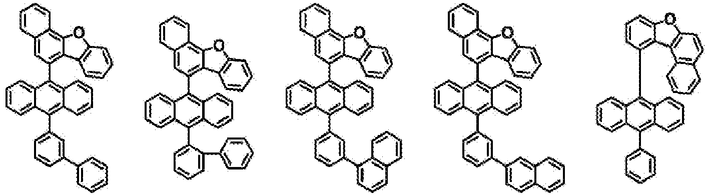

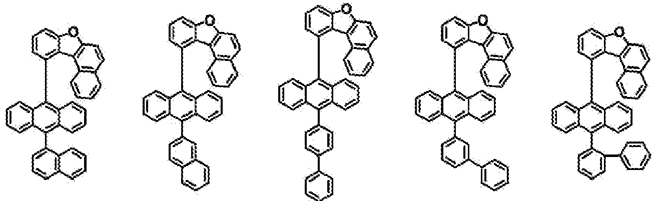

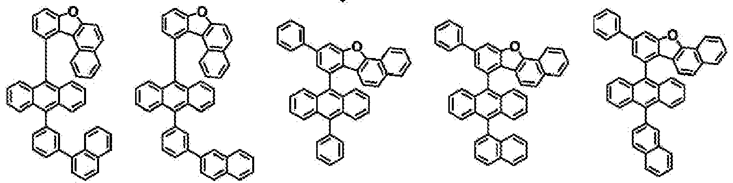

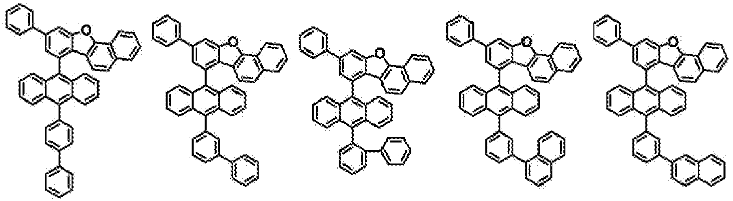

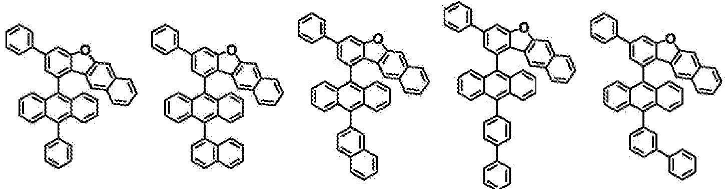

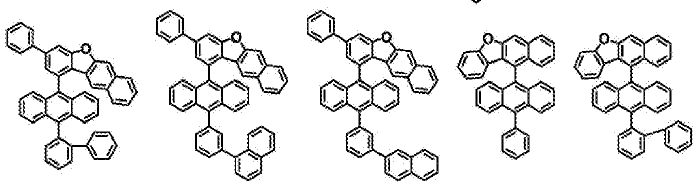

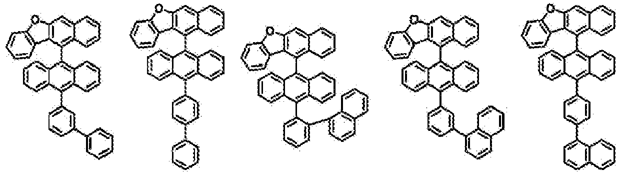

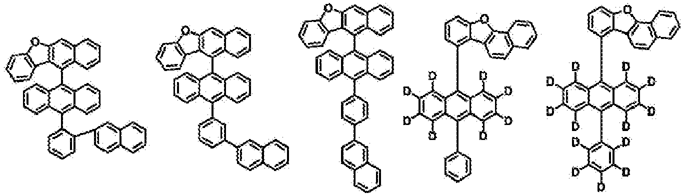

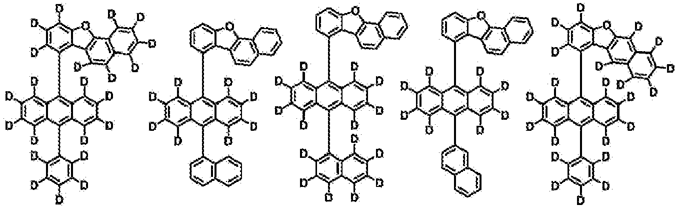

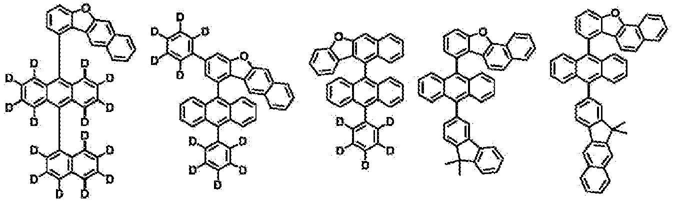

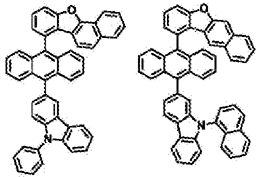

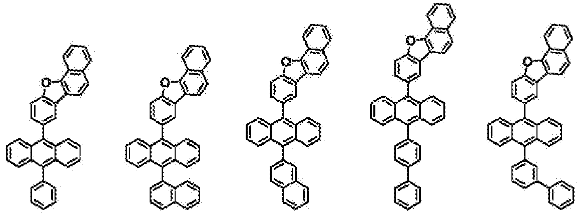

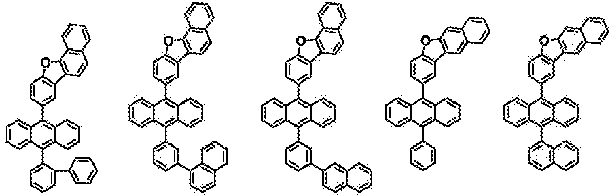

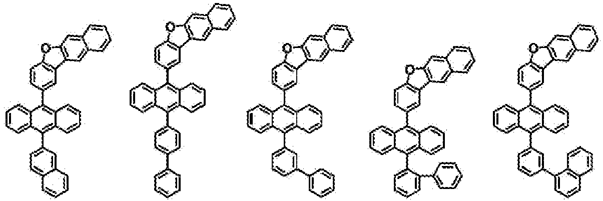

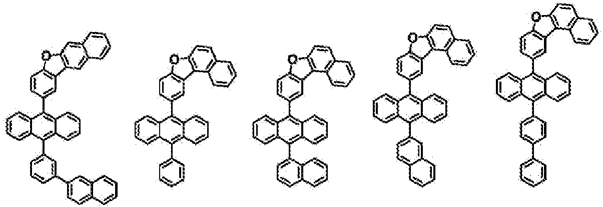

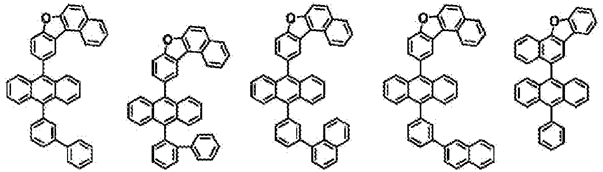

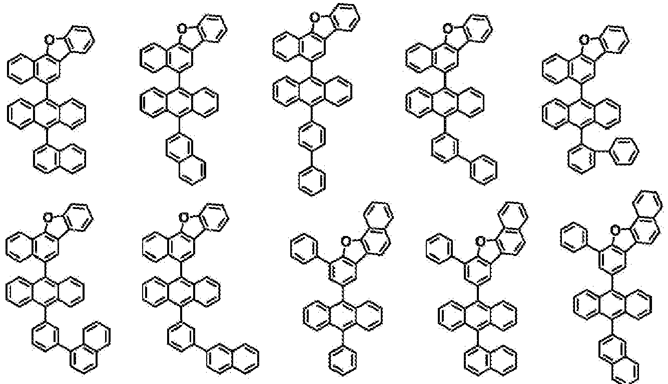

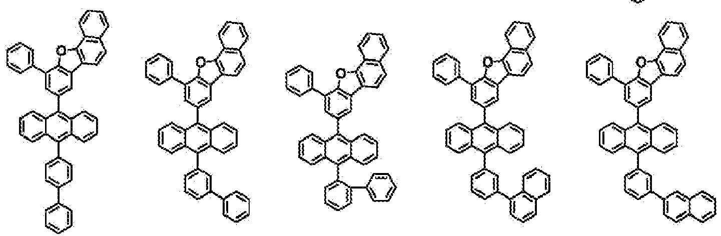

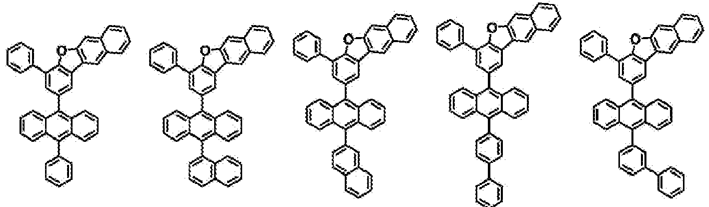

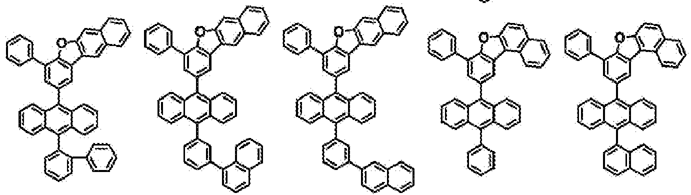

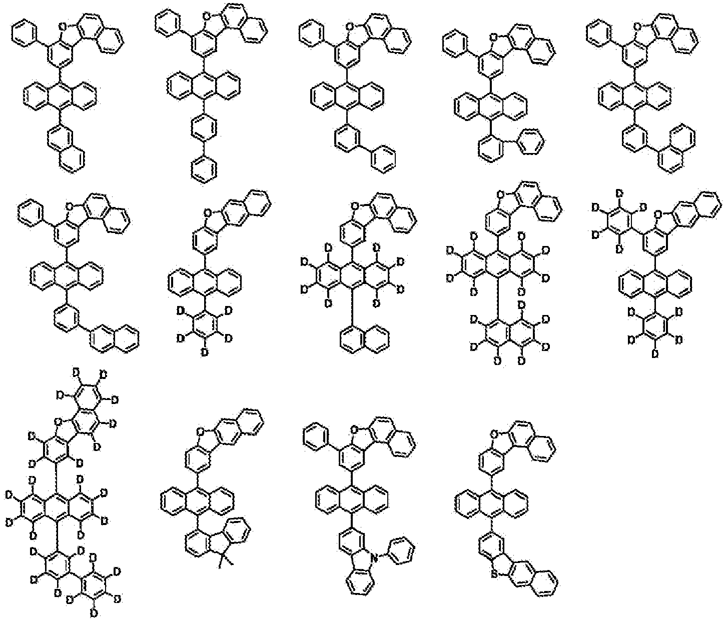

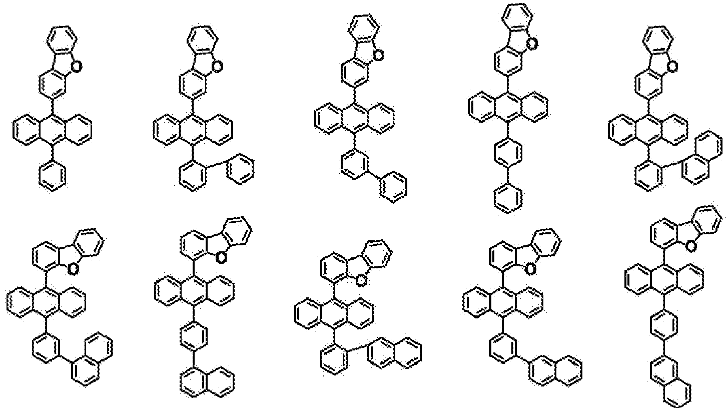

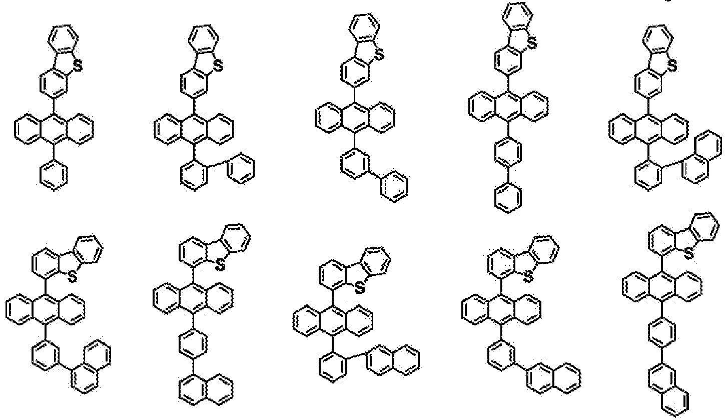

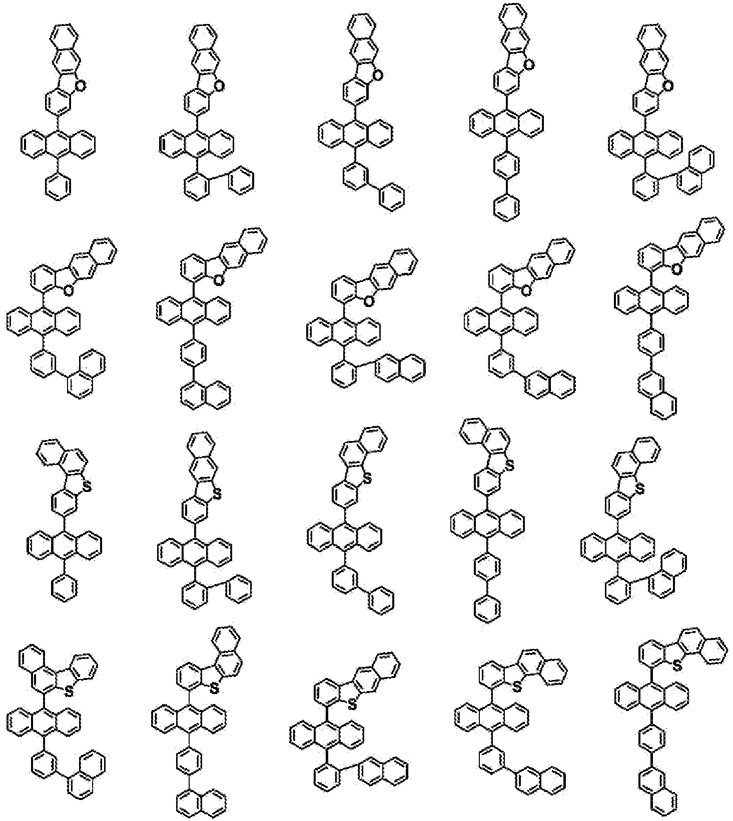

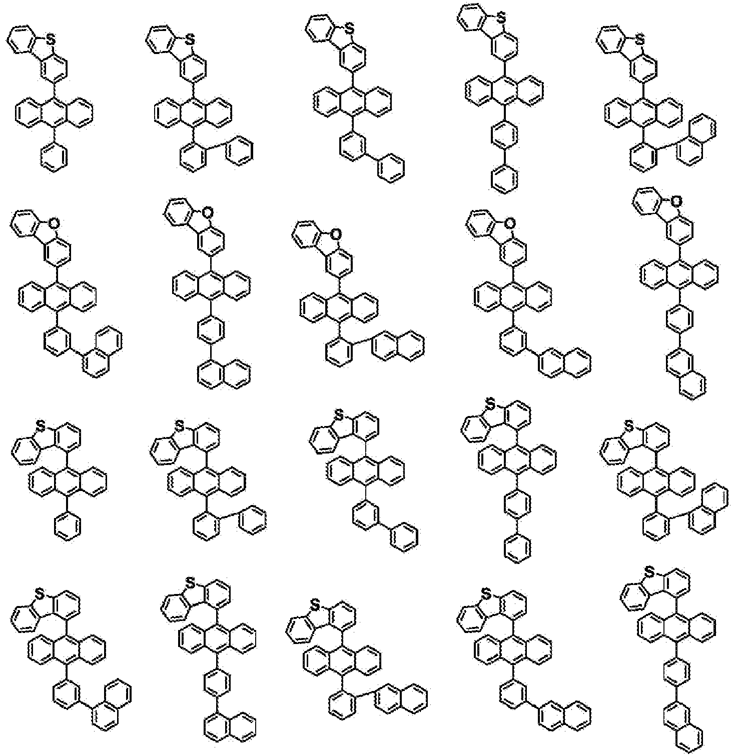

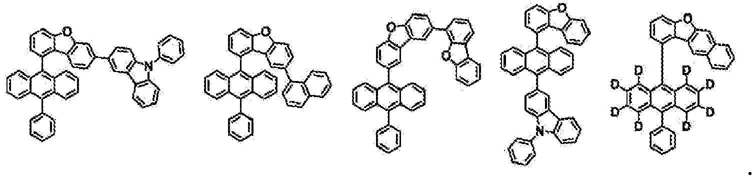

One embodiment of the present specification provides an organic light emitting device including the compound described above.

The organic light emitting device of the present specification includes an anode; a cathode; and an organic material layer provided between the anode and the cathode, wherein the organic material layer includes a light emitting layer, and the light emitting layer includes the compound represented by Chemical Formula 1; and the compound represented by Chemical Formula H.

In one embodiment of the present specification, the light emitting layer has a maximum emission peak present in a range of 400 nm to 500 nm. In other words, the light emitting layer emits blue light.

In one embodiment of the present specification, the light emitting layer includes the compound represented by Chemical Formula 1 as a dopant of the light emitting layer, and the compound represented by Chemical Formula H as a host of the light emitting layer. Specifically, the compound represented by Chemical Formula 1 is a blue fluorescent dopant.

In one embodiment of the present specification, the light emitting layer includes the compound represented by Chemical Formula 1; and the compound represented by Chemical Formula H in a weight ratio of 1:99 to 30:70. More preferably, the weight ratio is from 1:99 to 10:90.

The light emitting layer may further include a host material, and the host includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds or the like, and the heteroring-containing compound includes carbazole derivatives, dibenzofuran derivatives, ladder-type furan compounds, pyrimidine derivatives, triazine derivatives or the like, and may include mixtures of two or more types thereof, however, the fused aromatic ring derivative and the heteroring-containing compound are not limited thereto.

According to one embodiment of the present specification, the organic material layer includes a light emitting layer, and the light emitting layer includes one or more types of dopants, and a host.

According to one embodiment of the present specification, the organic material layer includes a light emitting layer, and the light emitting layer includes two or more types of mixed dopants of and a host.

According to one embodiment of the present specification, one or more of the two or more types of mixed dopants include Chemical Formula 1, and the host includes the compound represented by Chemical Formula H. One or more of the two or more types of mixed dopants include Chemical Formula 1, and as the rest, dopant materials known in the art may be used, however, the material is not limited thereto.

According to one embodiment of the present specification, one or more of the two or more types of mixed dopants include Chemical Formula 1, and as the rest, one or more of a boron-based compound, a pyrene-based compound and a delayed fluorescence-based compound different from Chemical Formula 1 may be used, however, the material is not limited thereto.

According to one embodiment of the present specification, the organic material layer includes a light emitting layer, and the light emitting layer includes one or more types of hosts.

According to one embodiment of the present specification, the organic material layer includes a light emitting layer, and the light emitting layer includes two or more types of mixed hosts.

According to one embodiment of the present specification, one or more of the two or more types of mixed hosts are the compound represented by Chemical Formula H.

According to one embodiment of the present specification, the organic material layer includes a light emitting layer, the light emitting layer includes two types of mixed hosts, the two types of mixed hosts are different from each other, and the two types of hosts are the compound represented by Chemical Formula H.

The organic material layer of the organic light emitting device of the present specification may be formed in a single layer structure, but may also be formed in a multilayer structure in which two or more organic material layers are laminated. For example, the organic light emitting device of the present specification may have a structure including a hole injection layer, a hole transfer layer, a light emitting layer, an electron transfer layer, an electron injection layer, an electron blocking layer, a hole blocking layer and the like. However, the structure of the organic light emitting device is not limited thereto, and may include a smaller number of organic layers.

In one embodiment of the present specification, the organic material layer of the organic light emitting device further includes one, two or more layers selected from the group consisting of a hole injection layer, a hole transfer layer, a light emitting layer, an electron transfer layer, an electron injection layer, a hole blocking layer and an electron blocking layer.

In one embodiment of the present specification, as the two or more organic material layers, two or more may be selected from the group consisting of a light emitting layer, a hole transfer layer, a hole injection layer, a layer carrying out hole transfer and hole injection at the same time, and an electron blocking layer.

In one embodiment of the present specification, the organic light emitting device may include two or more electron transfer layers, but is not limited thereto.

In one embodiment of the present specification, the organic light emitting device may be an organic light emitting device having a structure in which an anode, one or more organic material layers and a cathode are consecutively laminated on a substrate (normal type).

In one embodiment of the present specification, the organic light emitting device may be an organic light emitting device having a structure in a reverse direction in which a cathode, one or more organic material layers and an anode are consecutively laminated on a substrate (inverted type).

For example, a structure of the organic light emitting device according to one embodiment of the present specification is illustrated in FIG. 1. FIG. 1 only illustrates the organic light emitting device, and the organic light emitting device is not limited thereto.

FIG. 1 illustrates a structure of the organic light emitting device in which a substrate (1), an anode (2), a light emitting layer (3) and a cathode (4) are consecutively laminated. In such a structure, the compound represented by Chemical Formula 1 and the compound represented by Chemical Formula H may be included in the light emitting layer (3).

The organic light emitting device of the present specification may be manufactured using materials and methods known in the art, except that the light emitting layer of the organic material layer includes the compound represented by Chemical Formula 1 and the compound represented by Chemical Formula H.

When the organic light emitting device includes a plurality of organic material layers, the organic material layers may be formed with materials the same as or different from each other.

For example, the organic light emitting device of the present specification may be manufactured by consecutively laminating a first electrode, an organic material layer and a second electrode on a substrate. Herein, the organic light emitting device may be manufactured by forming an anode on a substrate by depositing a metal, a metal oxide having conductivity, or an alloy thereof using a physical vapor deposition (PVD) method such as a sputtering method or an e-beam evaporation method, and forming an organic material layer including a hole injection layer, a hole transfer layer, a light emitting layer and an electron transfer layer thereon, and then depositing a material usable as a cathode thereon. In addition to such a method, the organic light emitting device may also be manufactured by consecutively depositing a cathode material, an organic material layer and an anode material on a substrate.

In addition, the compound represented by Chemical Formula 1 or the compound represented by Chemical Formula H may be formed into an organic material layer using a solution coating method as well as a vacuum deposition method when manufacturing the organic light emitting device. Herein, the solution coating method means spin coating, dip coating, doctor blading, inkjet printing, screen printing, a spray method, roll coating and the like, but is not limited thereto.

In addition to such a method, the organic light emitting device may also be manufactured by consecutively laminating a cathode material, an organic material layer and an anode material on a substrate. However, the manufacturing method is not limited thereto.

As the anode material, materials having large work function are normally preferred so that hole injection to an organic material layer is smooth. Examples thereof include metals such as vanadium, chromium, copper, zinc and gold, or alloys thereof; metal oxides such as zinc oxide, indium oxide, indium tin oxide (ITO) and indium zinc oxide (IZO); combinations of metals and oxides such as ZnO:Al or SnO₂:Sb; conductive polymers such as poly(3-methylthiophene), poly[3,4-(ethylene-1,2-dioxy)thiophene] (PEDOT), polypyrrole and polyaniline, but are not limited thereto.

As the cathode material, materials having small work function are normally preferred so that electron injection to an organic material layer is smooth. Examples thereof include metals such as magnesium, calcium, sodium, potassium, titanium, indium, yttrium, lithium, gadolinium, aluminum, silver, tin and lead, or alloys thereof; multilayer structure materials such as LiF/Al or LiO₂/Al, and the like, but are not limited thereto.

The light emitting layer may include a host material and a dopant material. The host material includes fused aromatic ring derivatives, heteroring-containing compounds or the like. Specifically, the fused aromatic ring derivative includes anthracene derivatives, pyrene derivatives, naphthalene derivatives, pentacene derivatives, phenanthrene compounds, fluoranthene compounds and the like, and the heteroring-containing compound includes dibenzofuran derivatives, ladder-type furan compounds, pyrimidine derivatives and the like, however, the material is not limited thereto.

When including additional compounds in addition to the compound represented by Chemical Formula 1, the dopant material includes aromatic amine derivatives, styrylamine compounds, boron complexes, fluoranthene compounds, metal complexes and the like. Specifically, the aromatic amine derivative is a fused aromatic ring derivative having a substituted or unsubstituted arylamine group and includes arylamine group-including pyrene, anthracene, chrysene, peryflanthene and the like. In addition, the styrylamine compound is a compound in which substituted or unsubstituted arylamine is substituted with at least one arylvinyl group, and one, two or more substituents selected from the group consisting of an aryl group, a silyl group, an alkyl group, a cycloalkyl group and an arylamine group are substituted or unsubstituted. Specifically, styrylamine, styryldiamine, styryltriamine, styryltetramine or the like is included, however, the styrylamine compound is not limited thereto. In addition, the metal complex includes iridium complexes, platinum complexes or the like, but is not limited thereto.

In the present specification, when the compound represented by Chemical Formula 1 is included in an organic material layer other than a light emitting layer, or an additional light emitting layer is provided, a light emitting material of the light emitting layer is a material capable of emitting light in a visible region by receiving holes and electrons from a hole transfer layer and an electron transfer layer, respectively, and binding the holes and the electrons, and is preferably a material having favorable quantum efficiency for fluorescence or phosphorescence. Examples thereof include 8-hydroxy-quinoline aluminum complexes (Alq₃); carbazole-based compounds; dimerized styryl compounds; BAlq; 10-hydroxybenzoquinoline-metal compounds; benzoxazole-, benzothiazole- and benzimidazole-based compounds; poly(p-phenylenevinylene) (PPV)-based polymers; spiro compounds; polyfluorene; rubrene and the like, but are not limited thereto.

The hole injection layer is a layer injecting holes from an electrode. The hole injection material preferably has, by having an ability to transfer holes, a hole injection effect from an anode and an excellent hole injection effect for a light emitting layer or a light emitting material. In addition, the hole injection material is preferably a material having an excellent ability to prevent excitons generated in the light emitting layer from moving to an electron injection layer or an electron injection material. In addition, a material having an excellent thin film forming ability is preferred. In addition, the HOMO (highest occupied molecular orbital) of the hole injection material is preferably in between the work function of an anode material and the HOMO of surrounding organic material layers. Specific examples of the hole injection material include metal porphyrins, oligothiophene, arylamine-based organic materials; carbazole-based organic materials; nitrile-based organic materials; hexanitrile hexaazatriphenylene-based organic materials; quinacridone-based organic materials; perylene-based organic materials; polythiophene-based conductive polymers such as anthraquinone or polyaniline, and the like, or a mixture of two or more of the examples described above, but are not limited thereto.

The hole transfer layer is a layer receiving holes from a hole injection layer and transferring the holes to a light emitting layer. As the hole transfer material, materials capable of receiving holes from an anode or a hole injection layer and moving the holes to a light emitting layer, and having high mobility for the holes are preferred. Specific examples thereof include arylamine-based organic materials, carbazole-based organic materials, conductive polymers, block copolymers having conjugated parts and non-conjugated parts together, and the like, but are not limited thereto.

The electron transfer layer is a layer receiving electrons from an electron injection layer and transferring the electrons to a light emitting layer. As the electron transfer material, materials capable of favorably receiving electrons from a cathode and moving the electrons to a light emitting layer, and having high mobility for the electrons are preferred. Specific examples thereof include Al complexes of 8-hydroxyquinoline; complexes including Alq₃; organic radical compounds; hydroxyflavon-metal complexes; triazine derivatives; LiQ and the like, but are not limited thereto. The electron transfer layer may be used together with any desired cathode material as used in the art. Particularly, the suitable cathode material is a common material having low work function and having an aluminum layer or a silver layer following. Specifically, cesium, barium, calcium, ytterbium, samarium and the like are included, and in each case, an aluminum layer or a silver layer follows.

The electron injection layer is a layer injecting electrons from an electrode. As the electron injection material, materials having an excellent electron transferring ability, having an electron injection effect from a cathode, and having an excellent electron injection effect for a light emitting layer or light emitting material are preferred. In addition, materials preventing excitons generated in the light emitting layer from moving to a hole injection layer, and having an excellent thin film forming ability are preferred. Specific examples thereof include fluorenone, anthraquinodimethane, diphenoquinone, thiopyran dioxide, oxazole, oxadiazole, triazole, triazine, imidazole, perylene tetracarboxylic acid, fluorenylidene methane, anthrone or the like, and derivatives thereof, metal complex compounds, nitrogen-containing 5-membered ring derivatives, a mixture of two or more of the examples described above, and the like, but are not limited thereto.

The metal complex compound includes 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium and the like, but is not limited thereto.

The electron blocking layer is a layer capable of enhancing lifetime and efficiency of a device by preventing electrons injected from an electron injection layer from passing a light emitting layer and entering a hole injection layer. Known material may be used without limit, and the electron blocking layer may be formed either between the light emitting layer and the hole injection layer, or between the light emitting layer and a layer carrying out hole injection and hole transfer at the same time.

The hole blocking layer is a layer blocking holes from passing a light emitting layer and reaching a cathode, and may be generally formed under the same condition as an electron injection layer. Specific examples thereof may include oxadiazole derivatives, triazole derivatives, phenanthroline derivatives, aluminum complexes, pyridine, pyrimidine, triazine derivatives or the like, but are not limited thereto.

The organic light emitting device according to the present specification may be a top-emission type, a bottom-emission type or a dual-emission type depending on the materials used.

The compound according to the present specification may also be used in an organic light emitting device including an organic phosphorescent device, an organic solar cell, an organic photo conductor, an organic transistor and the like under a similar principle used in the organic light emitting device. For example, the organic solar cell may have a structure including an anode, a cathode and a photoactive layer provided between the anode and the cathode, and the photoactive layer may include the compound.

The organic light emitting device of the present specification may be manufactured using common organic light emitting device manufacturing methods and materials except that one or more organic material layers are formed using the compound described above.

Hereinafter, the present specification will be described in detail with reference to examples, comparative examples and the like. However, the examples and the comparative examples according to the present specification may be modified to various other forms, and the scope of the present specification is not to be construed as being limited to the examples and the comparative examples described below. Examples and comparative examples of the present specification are provided in order to more fully describe the present specification to those having average knowledge in the art.

### Preparation Example 1. Preparation of Compound BH 1

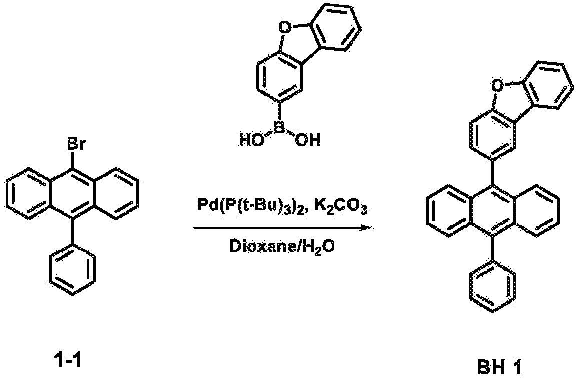

### Preparation Example 1-1) Preparation of BH 1

In a three-neck flask, Compound 1-1 (20.0 g, 60.0 mmol) and dibenzofuran-2-boronic acid (14.0 g, 66.0 mmol) were dissolved in 1,4-dioxane (300 ml), and K₂CO₃ (24.9 g, 180 mmol) dissolved in H₂O (100 ml) was introduced thereto. Pd(P(t-Bu)₃)₂ (0.68 g, 1.32 mmol) was introduced thereto, and the mixture was stirred for 5 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain BH 1 (11.5 g). (Yield 46%, MS[M+H]+=421)

### Preparation Example 2. Preparation of Compound BH 2

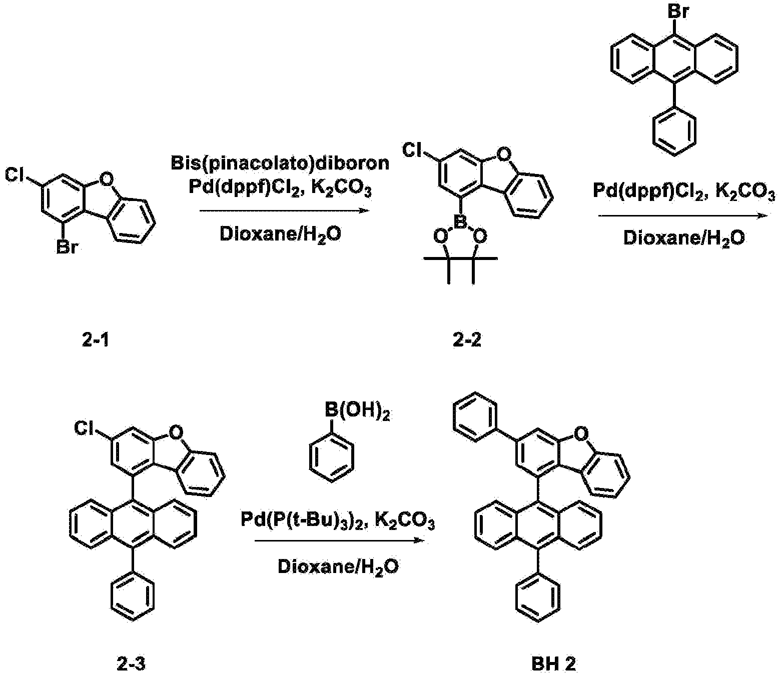

### Preparation Example 2-1) Preparation of Compound 2-2

In a three-neck flask, Compound 2-1 (20.0 g, 71.0 mmol), bis(pinacolato)diboron (27.1 g, 106.6 mmol) and KOAc (20.9 g, 213 mmol) were dissolved in 1,4-dioxane (300 ml). Pd(dppf)Cl₂ (1.09 g, 2.13 mmol) was introduced thereto, and the mixture was stirred for 8 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain Compound 2-2 (18.6 g). (Yield 80%, MS[M+H]+=329)

### Preparation Example 2-2) Preparation of Compound 2-3

In a three-neck flask, Compound 2-2 (20.0 g, 60.9 mmol) and Compound 1-1 (18.3 g, 54.8 mmol) were dissolved in 1,4-dioxane (300 ml), and K₂CO₃ (25.2 g, 183 mmol) dissolved in H₂O (100 ml) was introduced thereto. Pd(dppf)Cl₂ (0.80 g, 1.10 mmol) was introduced thereto, and the mixture was stirred for 5 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain Compound 2-3 (16.3 g). (Yield 65%, MS[M+H]+=455)

### Preparation Example 2-3) Preparation of Compound BH 2

In a three-neck flask, Compound 2-3 (20.0 g, 43.9 mmol) and phenylboronic acid (6.4 g, 52.7 mmol) were dissolved in 1,4-dioxane (200 ml), and K₂CO₃ (18.2 g, 132 mmol) dissolved in H₂O (70 ml) was introduced thereto. Pd(P(t-Bu)₃)₂ (0.45 g, 0.88 mmol) was introduced thereto, and the mixture was stirred for 5 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain Compound BH 2 (14.9 g). (Yield 68%, MS[M+H]+=497)

### Preparation Example 3. Preparation of Compound BH 3

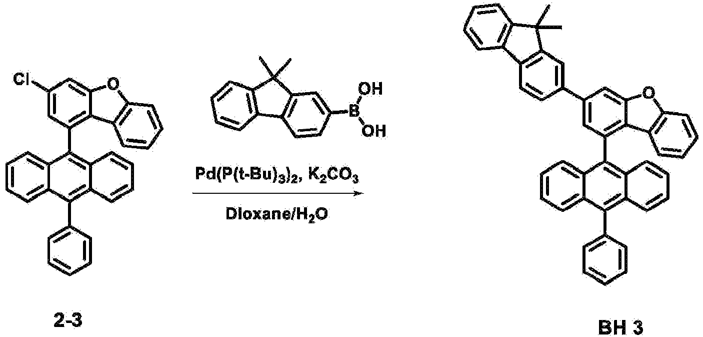

### Preparation Example 3-1) Preparation of Compound BH 3

Compound BH 3 (17.9 g) was obtained in the same manner as in Preparation Example 2-3. (Yield 65%, MS[M+H]+=613)

### Preparation Example 4. Preparation of Compound BH 4

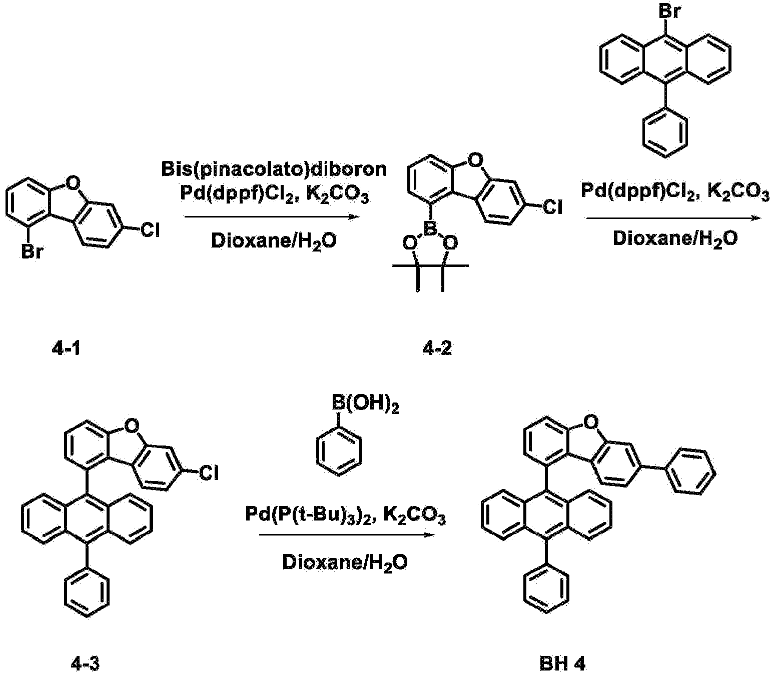

### Preparation Example 4-1) Preparation of Compound 4-2

Compound 4-2 (17.1 g) was obtained in the same manner as in Preparation Example 2-1. (Yield 74%, MS[M+H]+=329)

### Preparation Example 4-2) Preparation of Compound 4-3

Compound 4-3 (14.3 g) was obtained in the same manner as in Preparation Example 2-2. (Yield 57%, MS[M+H]+=455)

### Preparation Example 4-3) Preparation of Compound BH 4

Compound BH 4 (14.9 g) was obtained in the same manner as in Preparation Example 2-3. (Yield 68%, MS[M+H]+=497)

### Preparation Example 5. Preparation of Compound BH 5

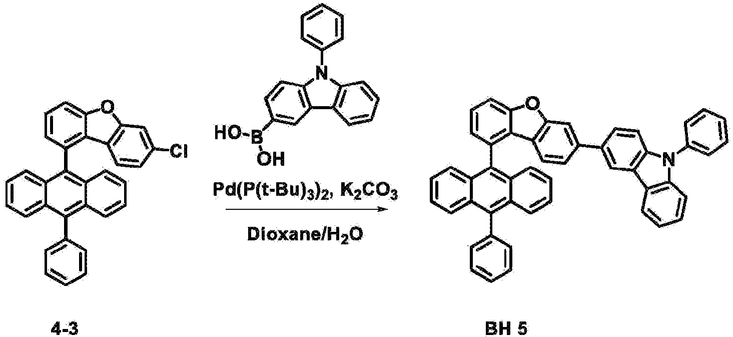

### Preparation Example 5-1) Preparation of Compound BH 5

Compound BH 5 (13.1 g) was obtained in the same manner as in Preparation Example 4-3. (Yield 45%, MS[M+H]+=662)

### Preparation Example 6. Preparation of Compound BH 6

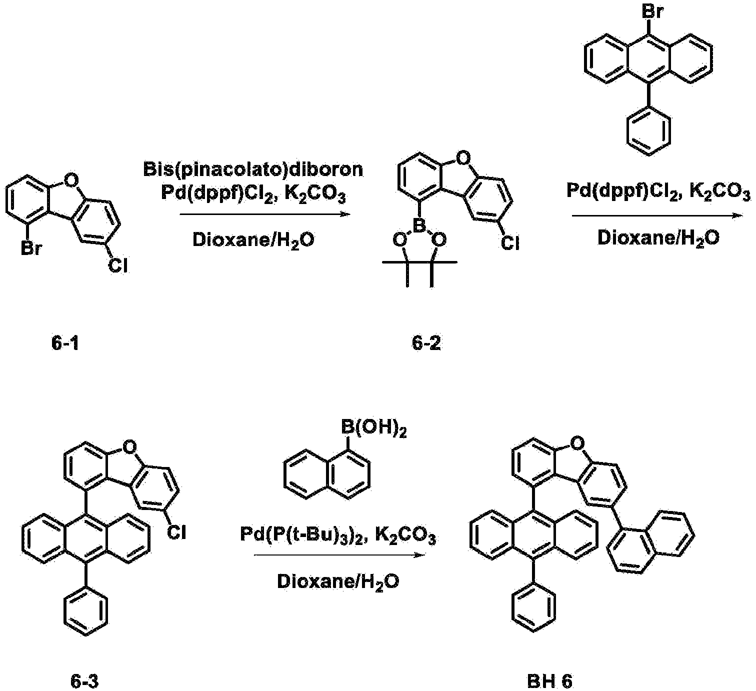

### Preparation Example 6-1) Preparation of Compound 6-2

Compound 6-2 (16.6 g) was obtained in the same manner as in Preparation Example 2-1. (Yield 72%, MS[M+H]+=329)

### Preparation Example 6-2) Preparation of Compound 6-3

Compound 6-3 (15.3 g) was obtained in the same manner as in Preparation Example 2-2. (Yield 61%, MS[M+H]+=455)

### Preparation Example 6-3) Preparation of Compound BH 6

Compound BH 6 (14.7 g) was obtained in the same manner as in Preparation Example 2-3. (Yield 68%, MS[M+H]+=497)

### Preparation Example 7. Preparation of Compound BH 7

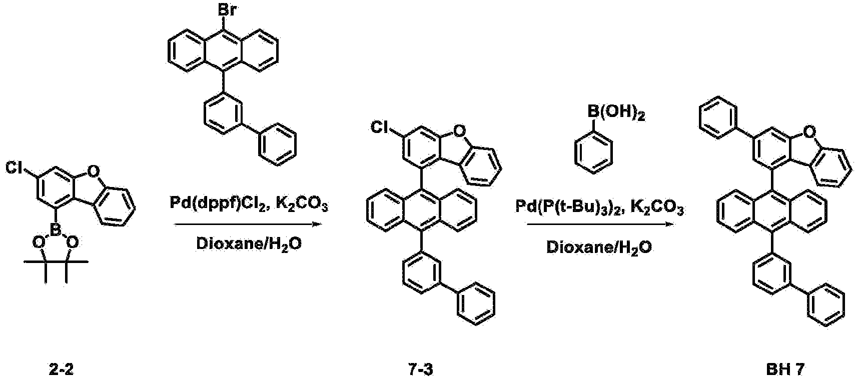

### Preparation Example 7-1) Preparation of Compound 7-3

Compound 7-3 (16.5 g) was obtained in the same manner as in Preparation Example 2-2. (Yield 64%, MS[M+H]+=532)

### Preparation Example 7-2) Preparation of Compound BH 7

Compound BH 7 (14.4 g) was obtained in the same manner as in Preparation Example 2-3. (Yield 67%, MS[M+H]+=573)

### Preparation Example 8. Preparation of Compound BH 8

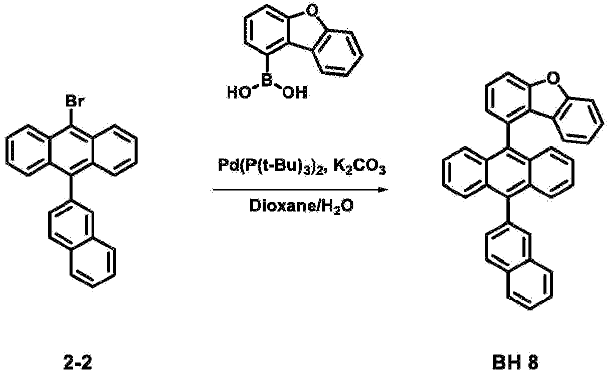

### Preparation Example 8-1) Preparation of Compound BH 8

Compound BH 8 (12.7 g) was obtained in the same manner as in Preparation Example 1-1. (Yield 52%, MS[M+H]+=471)

### Preparation Example 9. Preparation of Compound BH 9

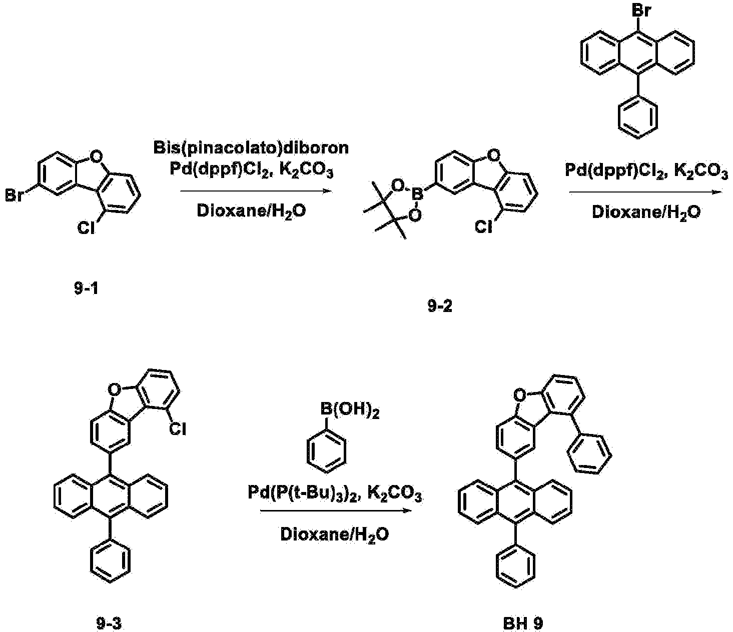

### Preparation Example 9-1) Preparation of Compound 9-2

Compound 9-2 (18.1 g) was obtained in the same manner as in Preparation Example 2-1. (Yield 72%, MS[M+H]+=329)

### Preparation Example 9-2) Preparation of Compound 9-3

Compound 9-3 (17.0 g) was obtained in the same manner as in Preparation Example 2-2. (Yield 68%, MS[M+H]+=455)

### Preparation Example 9-3) Preparation of Compound BH 9

Compound BH 9 (14.7 g) was obtained in the same manner as in Preparation Example 2-3. (Yield 68%, MS[M+H]+=497)

### Preparation Example 10. Preparation of Compound BH 10

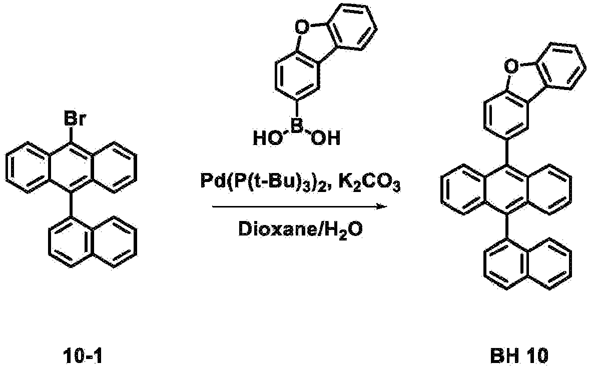

### Preparation Example 10-1) Preparation of Compound BH 10

Compound BH 10 (16.8 g) was obtained in the same manner as in Preparation Example 1-1. (Yield 68%, MS[M+H]+=471)

### Preparation Example 11. Preparation of Compound BH 11

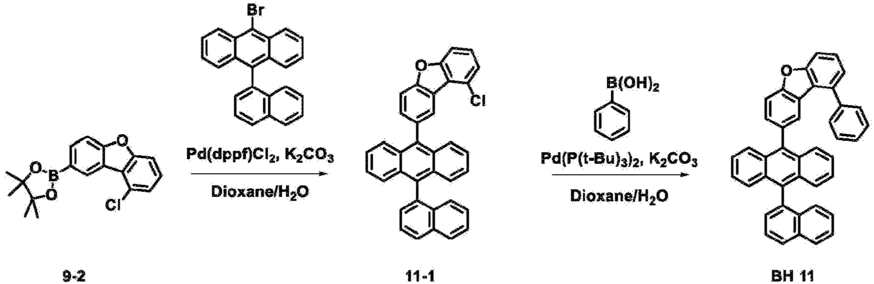

### Preparation Example 11-1) Preparation of Compound 11-1

Compound 11-1 (18.6 g) was obtained in the same manner as in Preparation Example 2-2. (Yield 71%, MS[M+H]+=506)

### Preparation Example 11-2) Preparation of Compound BH 11

Compound BH 11 (14.7 g) was obtained in the same manner as in Preparation Example 2-3. (Yield 68%, MS[M+H]+=497)

### Preparation Example 12. Preparation of Compound BH 12

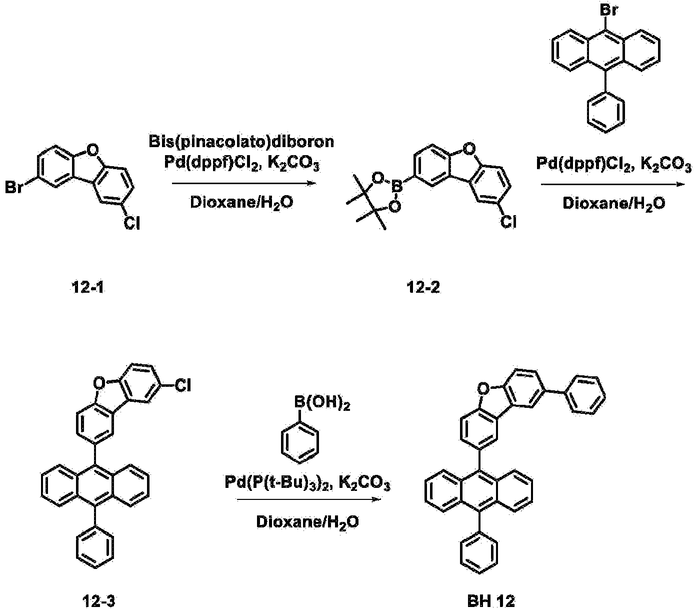

### Preparation Example 12-1) Preparation of Compound 12-2

Compound 12-2 (18.5 g) was obtained in the same manner as in Preparation Example 2-1. (Yield 74%, MS[M+H]+=329)

### Preparation Example 12-2) Preparation of Compound 12-3

Compound 12-3 (17.1 g) was obtained in the same manner as in Preparation Example 2-2. (Yield 68%, MS[M+H]+=455)

### Preparation Example 12-3) Preparation of Compound BH 12

Compound BH 12 (13.9 g) was obtained in the same manner as in Preparation Example 2-3. (Yield 64%, MS[M+H]+=497)

### Preparation Example 13. Preparation of Compound BH 13

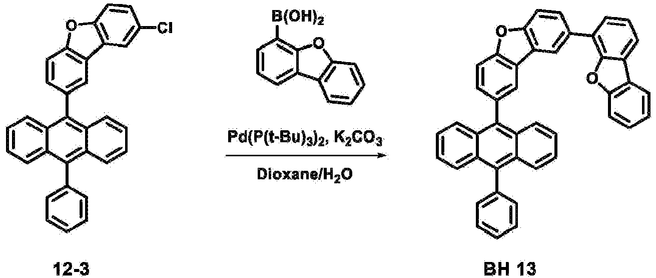

### Preparation Example 13-1) Preparation of Compound BH 13

Compound BH 13 (17.0 g) was obtained in the same manner as in Preparation Example 2-3. (Yield 73%, MS[M+H]+=587)

### Preparation Example 14. Preparation of Compound BH 14

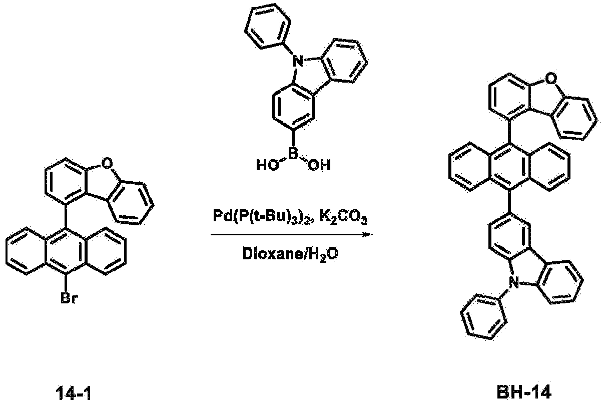

### Preparation Example 14-1) Preparation of Compound BH 14

Compound BH 14 (12.8 g) was obtained in the same manner as in Preparation Example 1-1. (Yield 46%, MS[M+H]+=586)

### Preparation Example 15. Preparation of Compound BH 15

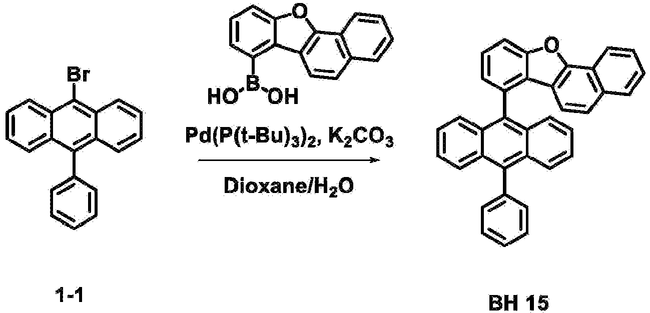

### Preparation Example 15-1) Preparation of Compound BH 15

Compound BH 15 (11.8 g) was obtained in the same manner as in Preparation Example 1-1. (Yield 42%, MS[M+H]+=471)

### Preparation Example 16. Preparation of Compound BH 16

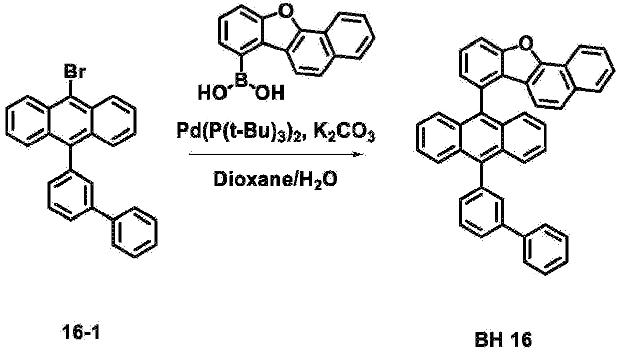

### Preparation Example 16-1) Preparation of Compound BH 16

Compound BH 16 (11.8 g) was obtained in the same manner as in Preparation Example 1-1. (Yield 42%, MS[M+H]+=471)

### Preparation Example 17. Preparation of Compound BH 17

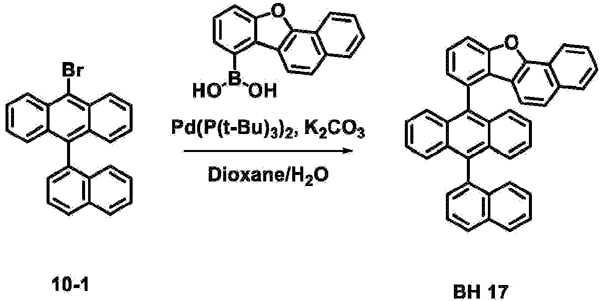

### Preparation Example 17-1) Preparation of Compound BH 17

Compound BH 17 (16.6 g) was obtained in the same manner as in Preparation Example 1-1. (Yield 61%, MS[M+H]+=521)

### Preparation Example 18. Preparation of Compound BH 18

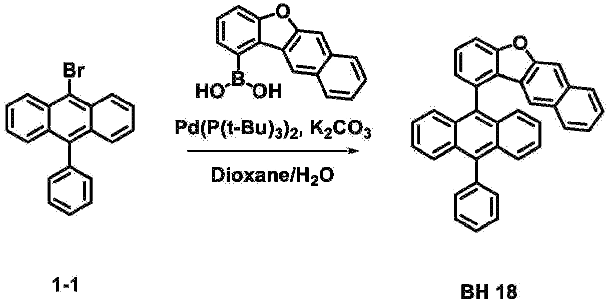

### Preparation Example 18-1) Preparation of Compound BH 18

Compound BH 18 (13.5 g) was obtained in the same manner as in Preparation Example 1-1. (Yield 48%, MS[M+H]+=471)

### Preparation Example 19. Preparation of Compound BH 19

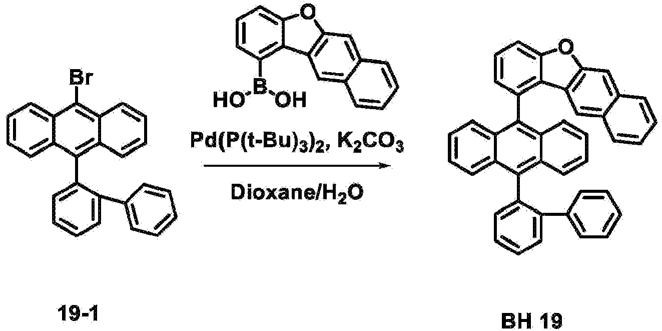

### Preparation Example 19-1) Preparation of Compound BH 19

Compound BH 19 (12.1 g) was obtained in the same manner as in Preparation Example 1-1. (Yield 43%, MS[M+H]+=471)

### Preparation Example 20. Preparation of Compound BH 20

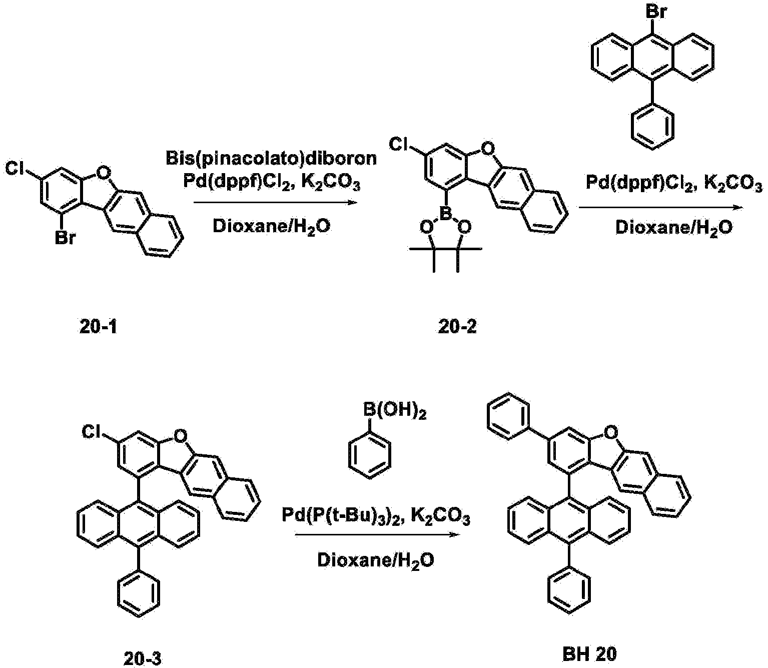

### Preparation Example 20-1) Preparation of Compound 20-2

Compound 20-2 (19.3 g) was obtained in the same manner as in Preparation Example 2-1. (Yield 85%, MS[M+H]+=379)

### Preparation Example 20-2) Preparation of Compound 20-3

Compound 20-3 (20.8 g) was obtained in the same manner as in Preparation Example 2-2. (Yield 69%, MS[M+H]+=506)

### Preparation Example 20-3) Preparation of Compound BH 20

Compound BH 20 (12.4 g) was obtained in the same manner as in Preparation Example 2-3. (Yield 57%, MS[M+H]+=547)

### Preparation Example 21. Preparation of Compound BH 21

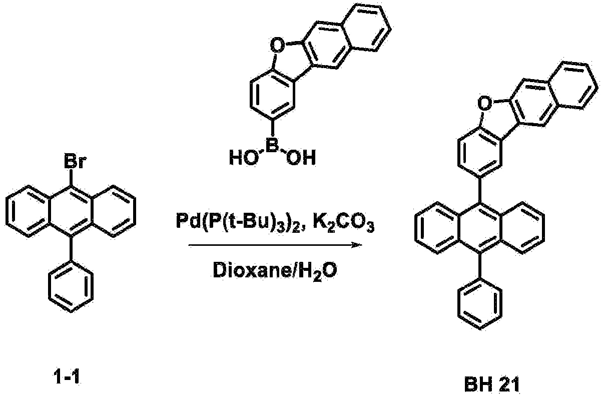

### Preparation Example 21-1) Preparation of Compound BH 21

Compound BH 21 (13.4 g) was obtained in the same manner as in Preparation Example 1-1. (Yield 47%, MS[M+H]+=471)

### Preparation Example 22. Preparation of Compound BH 22

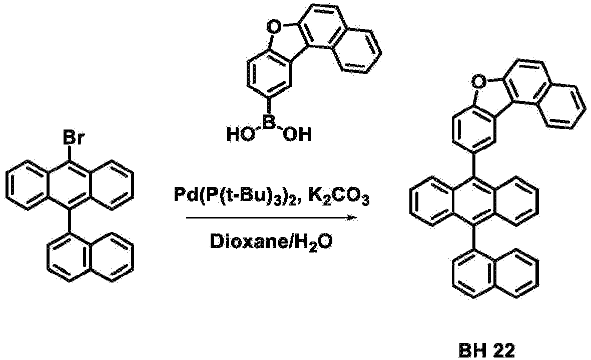

### Preparation Example 22-1) Preparation of Compound BH 22

Compound BH 22 (15.2 g) was obtained in the same manner as in Preparation Example 1-1. (Yield 56%, MS[M+H]+=521)

### Preparation Example 23. Preparation of Compound BH 23

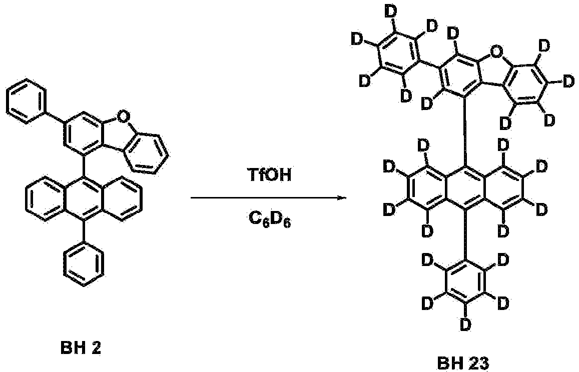

### Preparation Example 23-1) Preparation of Compound BH 23

Compound BH 2 (20 g) and TfOH (4 ml) were introduced to C₆D₆ (300 ml), and stirred for 2 hours. After the reaction was finished, D₂O (50 ml) was introduced thereto, and after stirring the result for 30 minutes, trimethylamine (6 ml) was added dropwise thereto. The reaction solution was transferred to a separatory funnel, and extracted with water and toluene. The extract was dried with MgSO₄, and then recrystallized with ethyl acetate to obtain Compound BH 23 (14.2 g). (Yield 68%, MS[M+H]+=521)

### Preparation Example 24. Preparation of Compound BH 24

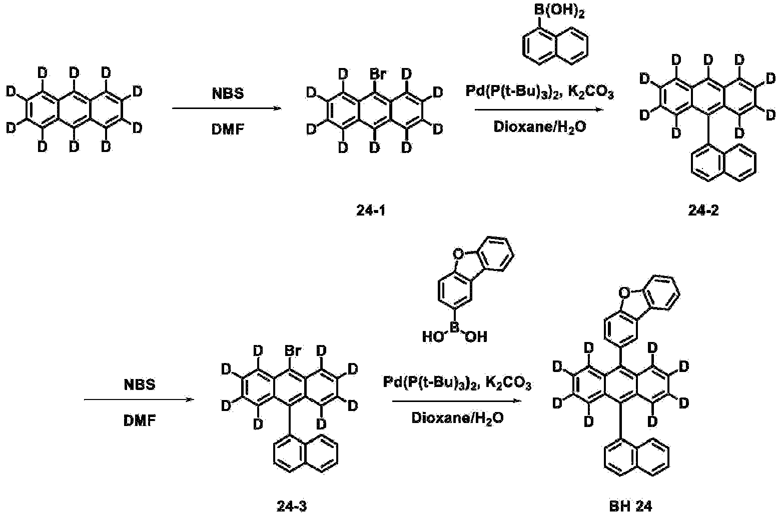

### Preparation Example 24-1) Preparation of Compound 24-1

To a two-neck flask, d10-anthracene (50.0 g, 265 mmol), N-bromosuccinimide (NBS) (47.3 g, 265 mmol) and dimethylformamide (DMF) (500 ml) were introduced, and stirred for 6 hours at room temperature under the argon atmosphere. After the reaction was finished, the reaction solution was transferred to a separatory funnel, and the organic layer was extracted with water and ethyl acetate. The extract was dried with MgSO₄, then filtered and concentrated, and the sample was purified by silica gel column chromatography to obtain Compound 24-1 (55.1 g). (Yield 78%, MS[M+H]+=267)

### Preparation Example 24-2) Preparation of Compound 24-2

In a three-neck flask, Compound 24-1 (50.0 g, 188 mmol) and naphthalen-1-ylboronic acid (35.6 g, 207 mmol) were dissolved in 1,4-dioxane (500 ml), and K₂CO₃ (77.9 g, 563 mmol) dissolved in H₂O (200 ml) was introduced thereto. Pd(P(t-Bu)₃)₂ (1.92 g, 3.8 mmol) was introduced thereto, and the mixture was stirred for 5 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain Compound 24-2 (40.5 g). (Yield 82%, MS[M+H]+=264)

### Preparation Example 24-3) Preparation of Compound 24-3

To a two-neck flask, Compound 24-2 (20.0 g, 75.9 mmol), N-bromosuccinimide (NBS) (14.9 g, 83.5 mmol) and dimethylformamide (DMF) (300 ml) were introduced, and stirred for 10 hours at room temperature under the argon atmosphere. After the reaction was finished, the reaction solution was transferred to a separatory funnel, and the organic layer was extracted with water and ethyl acetate. The extract was dried with MgSO₄, then filtered and concentrated, and the sample was purified by silica gel column chromatography to obtain Compound 24-3 (20.1 g). (Yield 77%, MS[M+H]+=342)

### Preparation Example 24-4) Preparation of Compound BH 24

In a three-neck flask, Compound 24-3 (20.0 g, 58.6 mmol) and dibenzofuran-2-boronic acid (13.7 g, 64.5 mmol) were dissolved in 1,4-dioxane (300 ml), and K₂CO₃ (24.3 g, 176 mmol) dissolved in H₂O (100 ml) was introduced thereto. Pd(P(t-Bu)₃)₂ (0.60 g, 1.2 mmol) was introduced thereto, and the mixture was stirred for 5 hours under an argon atmosphere reflux condition. When the reaction was finished, the result was cooled to room temperature, and the reaction solution was transferred to a separatory funnel and extracted with water and toluene. The extract was dried with MgSO₄, then filtered and concentrated, and the sample was purified by silica gel column chromatography to obtain Compound BH 24 (15.9 g). (Yield 63%, MS[M+H]+=429)

### Preparation Example 25. Preparation of Compound BH 25

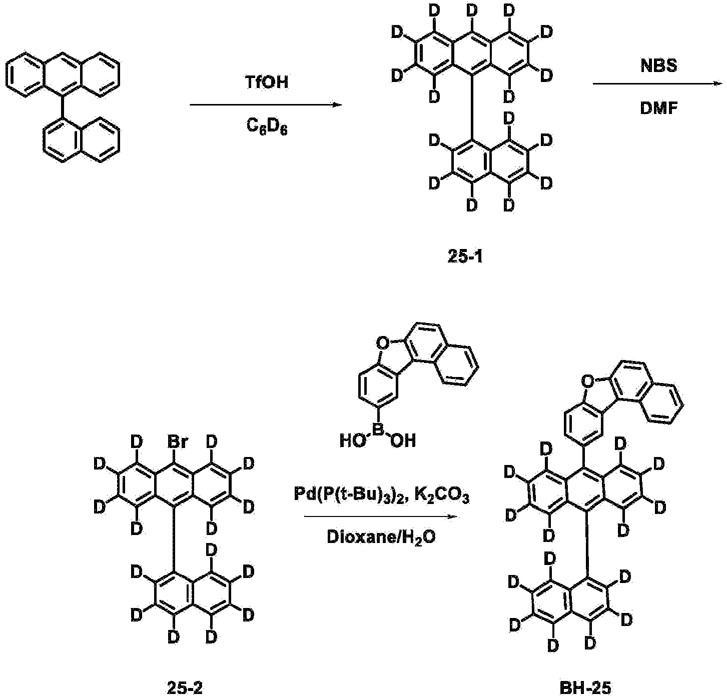

### Preparation Example 25-1) Preparation of Compound 25-1

Compound 25-1 (18.2 g) was obtained in the same manner as in Preparation Example 23-1. (Yield 86%, MS[M+H]+=321)

### Preparation Example 25-2) Preparation of Compound 25-2

Compound 25-2 (17.8 g) was obtained in the same manner as in Preparation Example 24-3. (Yield 72%, MS[M+H]+=399)

### Preparation Example 25-3) Preparation of Compound BH 25

Compound BH 25 (14.3 g) was obtained in the same manner as in Preparation Example 2-3. (Yield 53%, MS[M+H]+=536)

### Preparation Example 26. Preparation of Compound BH 26

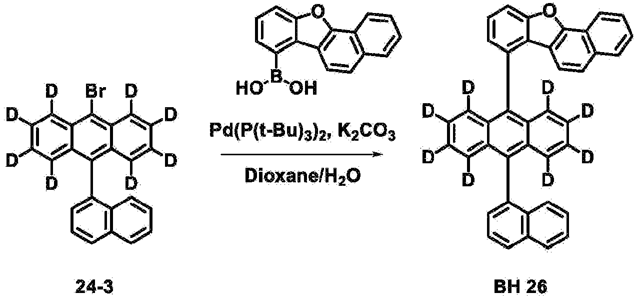

### Preparation Example 26-1) Preparation of Compound BH 26

Compound BH 26 (12.5 g) was obtained in the same manner as in Preparation Example 2-3. (Yield 50%, MS[M+H]+=529)

### Preparation Example 27. Preparation of Compound BH 27

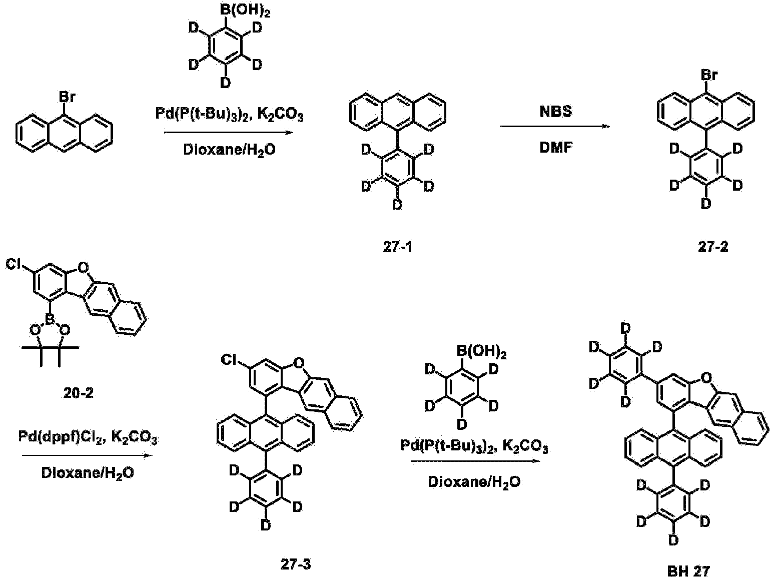

### Preparation Example 27-1) Preparation of Compound 27-1

Compound 27-1 (18.8 g) was obtained in the same manner as in Preparation Example 24-2. (Yield 93%, MS[M+H]+=260)

### Preparation Example 27-2) Preparation of Compound 27-2

Compound 27-2 (17 g) was obtained in the same manner as in Preparation Example 24-3. (Yield 65%, MS[M+H]+=339)

### Preparation Example 27-3) Preparation of Compound 27-3

Compound 27-3 (14.4 g) was obtained in the same manner as in Preparation Example 2-2. (Yield 48%, MS[M+H]+=511)

### Preparation Example 27-4) Preparation of Compound BH 27

Compound BH 27 (12.4 g) was obtained in the same manner as in Preparation Example 2-3. (Yield 57%, MS[M+H]+=547)

### Preparation Example 28. Preparation of Compound BH 28

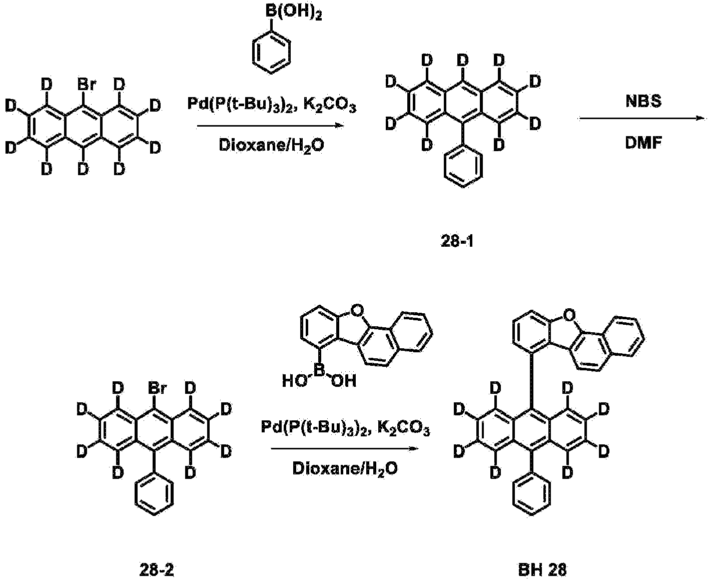

### Preparation Example 28-1) Preparation of Compound 28-1

Compound 28-1 (18.5 g) was obtained in the same manner as in Preparation Example 24-2. (Yield 93%, MS[M+H]+=260)

### Preparation Example 28-2) Preparation of Compound 28-2

Compound 28-2 (17.9 g) was obtained in the same manner as in Preparation Example 24-3. (Yield 69%, MS[M+H]+=342)

### Preparation Example 28-3) Preparation of Compound BH 28

Compound BH 28 (11.9 g) was obtained in the same manner as in Preparation Example 2-3. (Yield 42%, MS[M+H]+=479)

### Preparation Example 29. Preparation of Compound BH 29

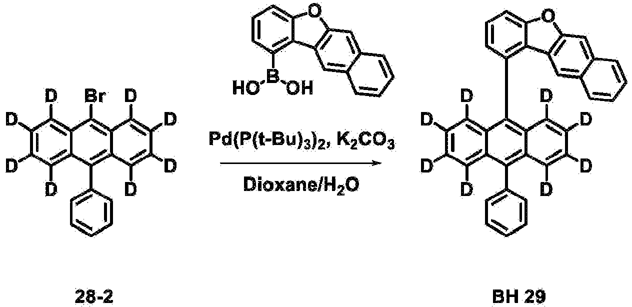

### Preparation Example 29-1) Preparation of Compound BH 29

Compound BH 29 (11.9 g) was obtained in the same manner as in Preparation Example 2-3. (Yield 42%, MS[M+H]+=479)

### Preparation Example 30. Preparation of Compound BH 30

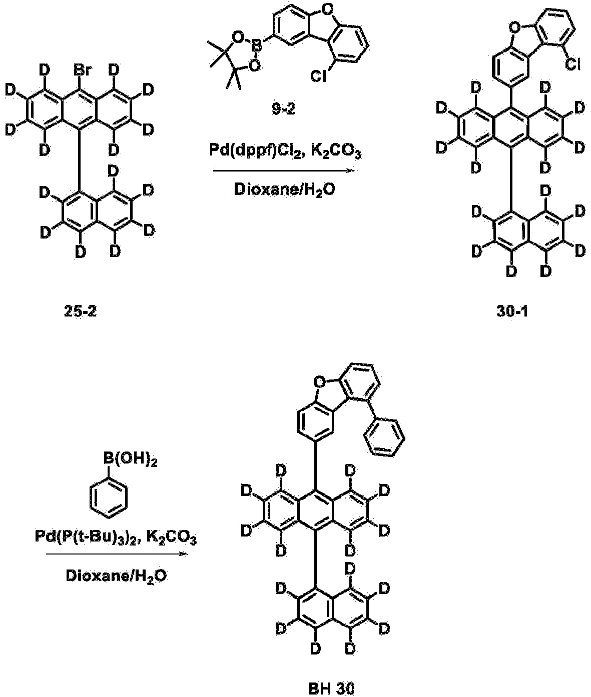

### Preparation Example 30-1) Preparation of Compound 30-1

Compound 30-1 (15.3 g) was obtained in the same manner as in Preparation Example 2-2. (Yield 59%, MS[M+H]+=521)

### Preparation Example 30-2) Preparation of Compound BH 30

Compound BH 30 (14.0 g) was obtained in the same manner as in Preparation Example 2-3. (Yield 65%, MS[M+H]+=562)

### Synthesis Example 31. Synthesis of Compound BD 1

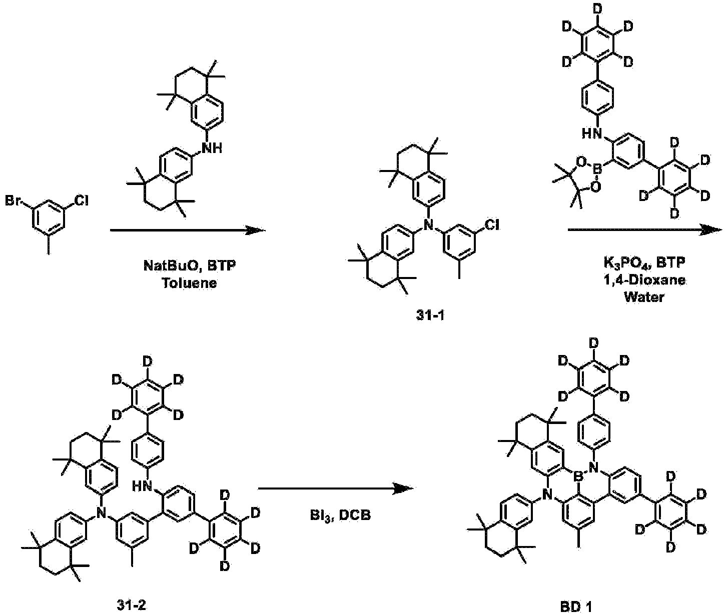

### 1) Synthesis of Compound 31-1

Under the nitrogen atmosphere, 1-bromo-3-chloro-5-methylbenzene (30 g), bis(5,5,8,8-tetramethyl-5,6,7,8-tetrahydronaphthalen-2-yl)amine (43.7 g), sodium-tert-butoxide (32.3 g) and bis(tri-tert-butylphosphine)palladium(0) (1.2 g) were introduced to toluene (600 ml), and refluxed for 2 hours. After the reaction was finished, the result was extracted, and then recrystallized to obtain Compound 31-1 (56 g, yield 75%). MS[M+H]+=515

### 2) Synthesis of Compound 31-2

Compound 31-1 (30 g), N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine (23.8 g), tripotassium phosphate (33.2 g) and bis(tri-tert-butylphosphine)palladium(0) (0.5 g) were introduced to 1,4-dioxane (300 ml) and water (100 ml), and refluxed for 4 hours. After the reaction was finished, the result was extracted, and then recrystallized to obtain Compound 31-2 (33 g, yield 72%) . MS[M+H]+=810

### 3) Synthesis of Compound BD 1

Under the nitrogen atmosphere, Compound 31-2 (25 g) and boron triiodide (20.6 g) were introduced to 1,2-dichlorobenzene (250 ml), and stirred for 4 hours at 160°C. After the reaction was finished, the result was extracted, and then recrystallized to obtain BD 1 (7.2 g, yield 29%). MS[M+H]+=818

### Synthesis Example 32. Synthesis of Compound BD 2

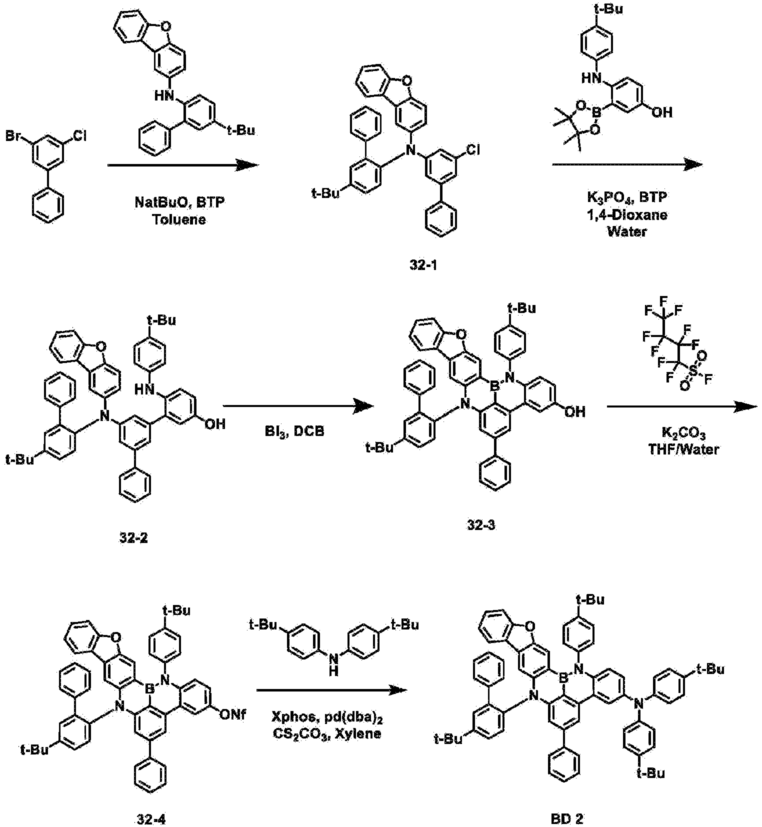

### 1) Synthesis of Compound 32-1

The same equivalents and method were used as in the synthesis process of Compound 31-1 using 3-bromo-5-chloro-1,1'-biphenyl and N-(5-(tert-butyl)-[1,1'-biphenyl]-2-yl)dibenzo[b,d]furan-2-amine instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 32-1 (49.2 g, yield 76%). MS[M+H]+=579

### 2) Synthesis of Compound 32-2

The same equivalents and method were used as in the synthesis process of Compound 31-2 using Compound 32-1 and 4-((4-(tert-butyl)phenyl)amino)-3-(4,4,5,5-tetramethyl-1,3,2-dioxaborolan-2-yl)phenol instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 32-2 (30.1 g, yield 74%). MS[M+H]+=784

### 3) Synthesis of Compound 32-3

Under the nitrogen atmosphere, Compound 32-2 (25 g) and boron triiodide (21.3 g) were introduced to 1,2-dichlorobenzene (250 ml), and stirred for 4 hours at 160°C. After the reaction was finished, the result was extracted, and then recrystallized to obtain Compound 32-3 (7.5 g, yield 30%). MS[M+H]+=792

### 4) Synthesis of Compound 32-4

Compound 32-3 (7 g), 1,1,2,2,3,3,4,4,4-nonafluorobutane-1-sulfonyl fluoride (2.4 ml) and potassium carbonate (3.7 g) were introduced to tetrahydrofuran (70 ml) and water (30 ml), and stirred for 2 hours under reflux. After the reaction was finished, the result was extracted, and then column purified to obtain Compound 32-4 (9.1 g, yield 96%). MS[M+H]+=1074

### 5) Synthesis of BD 2

Under the nitrogen atmosphere, Compound 32-4 (7 g), bis(4-(tert-butyl)phenyl)amine (1.84 g), pd(dba)₂ (0.11 g), Xphos (0.19 g) and cesium carbonate (6.4 g) were introduced to xylene (100 ml), and stirred for 12 hours under reflux. After the reaction was finished, the result was extracted, and then recrystallized to obtain BD 2 (5.2 g, yield 76%). MS[M+H]+=1055

### Synthesis Example 33. Synthesis of Compound BD 3

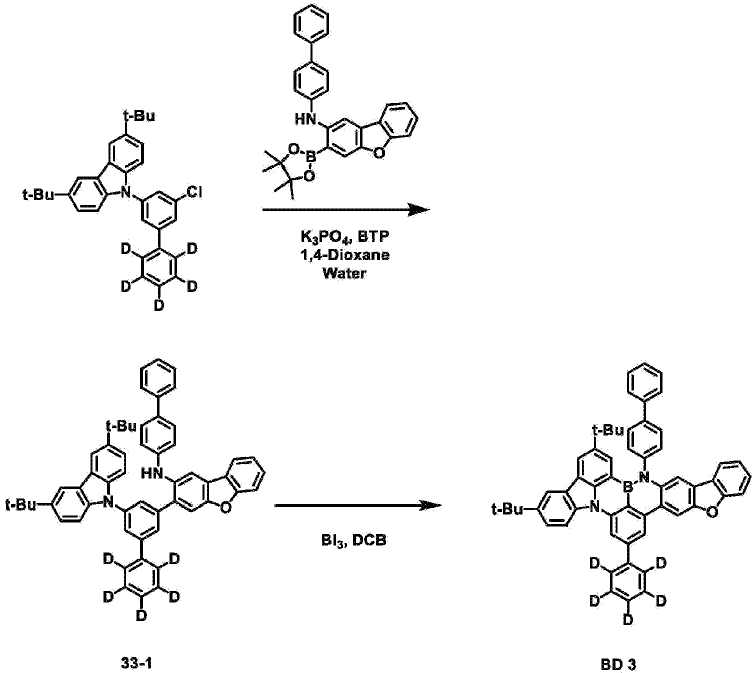

### 1) Synthesis of Compound 33-1

The same equivalents and method were used as in the synthesis process of Compound 31-2 using 3,6-di-tert-butyl-9-(5-chloro-[1,1'-biphenyl]-3-yl-2',3',4',5',6'-d5)-9H-carbazole and N-([1,1'-biphenyl]-4-yl)-3-(4,4,5,5-tetramethyl-1,3,2-dioxaborolan-2-yl)dibenzo[b,d]furan-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 33-1 (38.2 g, yield 78%). MS[M+H]+=771

### 2) Synthesis of BD 3

Under the nitrogen atmosphere, Compound 33-1 (25 g) and boron triiodide (21.6 g) were introduced to 1,2-dichlorobenzene (250 ml), and stirred for 4 hours at 160°C. After the reaction was finished, the result was extracted, and then recrystallized to obtain BD 3 (7.4 g, yield 29%). MS[M+H]+=779

### Synthesis Example 34. Synthesis of Compound BD 4

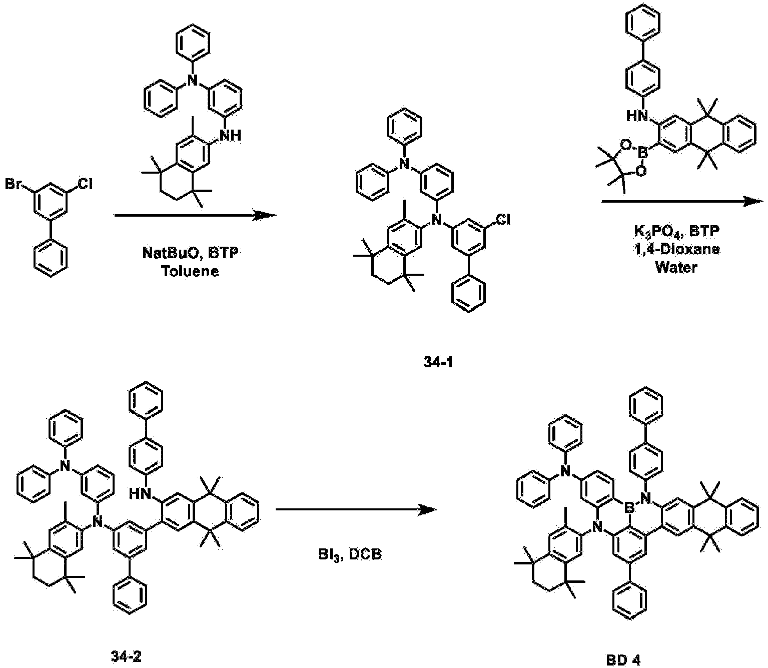

### 1) Synthesis of Compound 34-1

Under the nitrogen atmosphere, 3-bromo-5-chloro-1,1'-biphenyl (30 g), N1-(3,5,5,8,8-pentamethyl-5,6,7,8-tetrahydronaphthalen-2-yl)-N3,N3-diphenylbenzene-1,3-diamine (43.7 g), sodium-tert-butoxide (32.3 g) and bis(tri-tert-butylphosphine)palladium(0) (1.2 g) were introduced to toluene (600 ml), and refluxed for 2 hours. After the reaction was finished, the result was extracted and then recrystallized to obtain Compound 34-1 (54.3 g, yield 75%). MS[M+H]+=648

### 2) Synthesis of Compound 34-2

The same equivalents and method were used as in the synthesis process of Compound 31-2 using Compound 34-1 and N-([1,1'-biphenyl]-4-yl)-9,9,10,10-tetramethyl-3-(4,4,5,5-tetramethyl-1,3,2-dioxaborolan-2-yl)-9,10-dihydroanthracen-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 34-2 (35.2 g, yield 75%). MS[M+H]+=1015

### 3) Synthesis of BD 4

Under the nitrogen atmosphere, Compound 34-2 (25 g) and boron triiodide (16.4 g) were introduced to 1,2-dichlorobenzene (250 ml), and stirred for 4 hours at 160°C. After the reaction was finished, the result was extracted, and then recrystallized to obtain BD 4 (7.5 g, yield 30%). MS[M+H]+=1023

### Synthesis Example 35. Synthesis of Compound BD 5

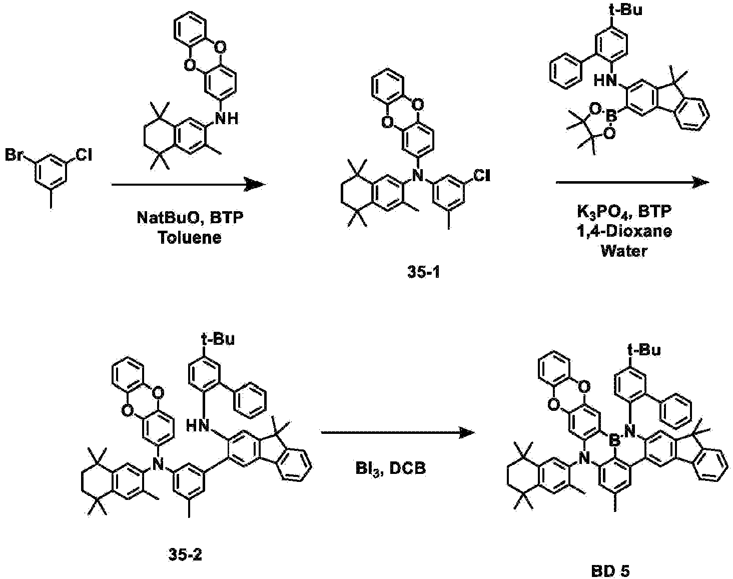

### 1) Synthesis of Compound 35-1

Under the nitrogen atmosphere, 1-bromo-3-chloro-5-methylbenzene (30 g), N-(3,5,5,8,8-pentamethyl-5,6,7,8-tetrahydronaphthalen-2-yl)dibenzo[b,e][1,4]dioxin-2-amine (58.4 g), sodium-tert-butoxide (32.3 g) and bis(tri-tert-butylphosphine)palladium(0) (1.2 g) were introduced to toluene (600 ml), and refluxed for 2 hours. After the reaction was finished, the result was extracted and then recrystallized to obtain Compound 35-1 (55 g, yield 72%). MS[M+H]+=525

### 2) Synthesis of Compound 35-2

The same equivalents and method were used as in the synthesis process of Compound 31-2 using Compound 35-1 and N-(5-(tert-butyl)-[1,1'-biphenyl]-2-yl)-9,9-dimethyl-3-(4,4,5,5-tetramethyl-1,3,2-dioxaborolan-2-yl)-9H-fluoren-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 35-2 (37.7 g, yield 73%). MS[M+H]+=906

### 3) Synthesis of BD 5

Under the nitrogen atmosphere, Compound 35-2 (25 g) and boron triiodide (18.4 g) were introduced to 1,2-dichlorobenzene (250 ml), and stirred for 4 hours at 160°C. After the reaction was finished, the result was extracted, and then recrystallized to obtain BD 5 (7.7 g, yield 31%). MS[M+H]+=914

### Synthesis Example 36. Synthesis of Compound BD 6

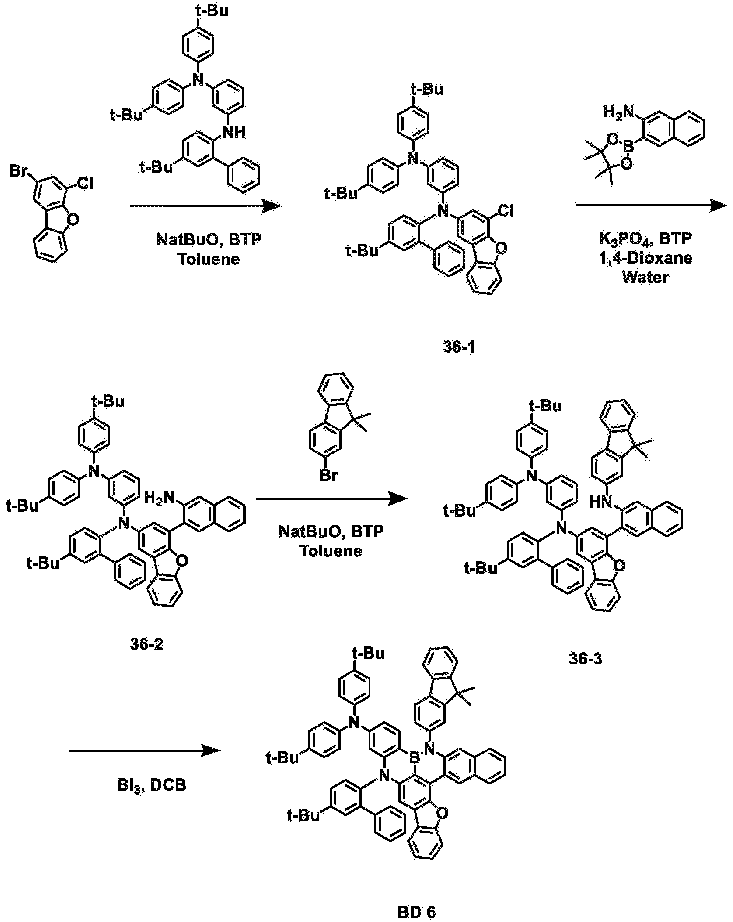

### 1) Synthesis of Compound 36-1

Under the nitrogen atmosphere, 2-bromo-4-chlorodibenzo[b,d]furan (30 g), N1-(5-(tert-butyl)-[1,1'-biphenyl]-2-yl)-N3,N3-bis(4-(tert-butyl)phenyl)benzene-1,3-diamine (43.2 g), sodium-tert-butoxide (31 g) and bis(tri-tert-butylphosphine)palladium(0) (1.1 g) were introduced to toluene (600 ml), and refluxed for 4 hours. After the reaction was finished, the result was extracted and then recrystallized to obtain Compound 36-1 (61.1 g, yield 73%). MS[M+H]+=782

### 2) Synthesis of Compound 36-2

Compound 36-1 (30 g), 3-(4,4,5,5-tetramethyl-1,3,2-dioxaborolan-2-yl)naphthalen-2-amine (23.3 g), tripotassium phosphate (36.6 g) and bis(tri-tert-butylphosphine)palladium(0) (0.6 g) were introduced to 1,4-dioxane (300 ml) and water (100 ml), and refluxed for 6 hours. After the reaction was finished, the result was extracted and then recrystallized to obtain Compound 36-2 (27.1 g, yield 79%). MS[M+H]+=889

### 3) Synthesis of Compound 36-3

Under the nitrogen atmosphere, Compound 36-2 (30 g), 2-bromo-9,9-dimethyl-9H-fluorene (43.2 g), sodium-tert-butoxide (31 g) and bis(tri-tert-butylphosphine)palladium(0) (1.1 g) were introduced to toluene (600 ml), and refluxed for 4 hours. After the reaction was finished, the result was extracted and then recrystallized to obtain Compound 36-3 (25.6 g, yield 78%). MS[M+H]+=1080

### 4) Synthesis of BD 6

Under the nitrogen atmosphere, Compound 36-3 (25 g) and boron triiodide (15.4 g) were introduced to 1,2-dichlorobenzene (250 ml), and stirred for 4 hours at 160°C. After the reaction was finished, the result was extracted, and then recrystallized to obtain BD 6 (7.3 g, yield 29%). MS[M+H]+=1088

### Synthesis Example 37. Synthesis of Compound BD 7

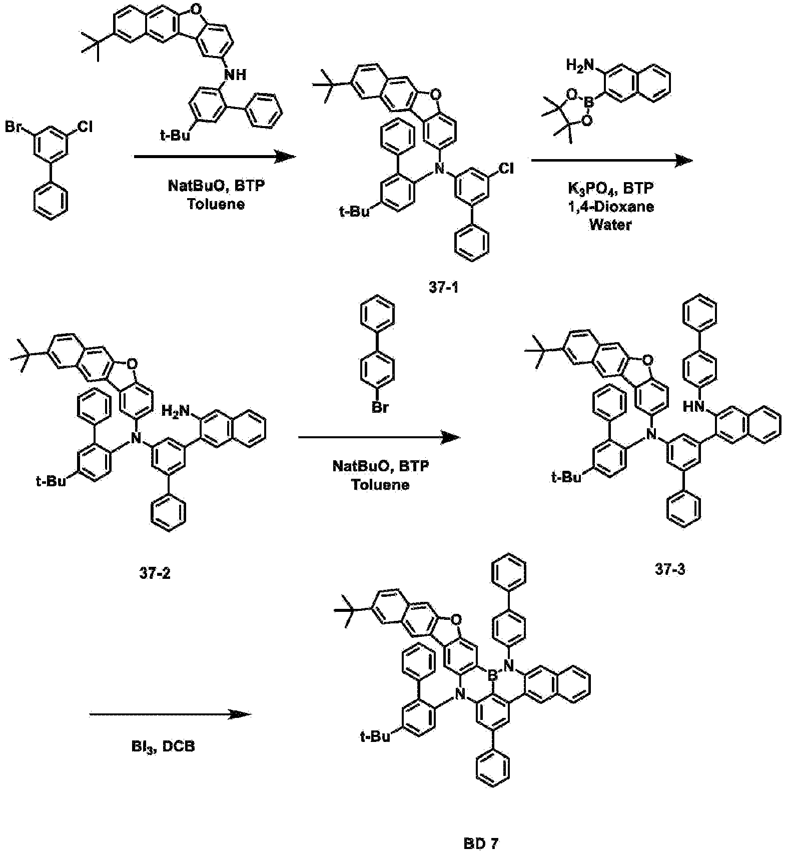

### 1) Synthesis of Compound 37-1

The same equivalents and method were used as in the synthesis process of Compound 31-1 using 9-(tert-butyl)-N-(5-(tert-butyl)-[1,1'-biphenyl]-2-yl)naphtho[2,3-b]benzofuran-2-amine instead of bis(5,5,8,8-tetramethyl-5,6,7,8-tetrahydronaphthalen-2-yl)amine, and after the reaction was finished, the result was extracted and then recrystallized to obtain Compound 37-1 (55.3 g, yield 72%). MS[M+H]+=629

### 2) Synthesis of Compound 37-2

The same equivalents and method were used as in the synthesis process of Compound 31-2 using Compound 37-1 and 3-(4,4,5,5-tetramethyl-1,3,2-dioxaborolan-2-yl)naphthalen-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 37-2 (27.2 g, yield 78%). MS[M+H]+=792

### 3) Synthesis of Compound 37-3

The same equivalents and method were used as in the synthesis process of Compound 31-1 using Compound 37-2 (27 g) and 4-bromo-1,1'-biphenyl (10.4 g) instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 37-3 (25.1 g, yield 78%). MS[M+H]+=944

### 4) Synthesis of BD 7

Under the nitrogen atmosphere, Compound 37-3 (25 g) and boron triiodide (17.6 g) were introduced to 1,2-dichlorobenzene (250 ml), and stirred for 4 hours at 160°C. After the reaction was finished, the result was extracted, and then recrystallized to obtain BD 7 (7.1 g, yield 28%). MS[M+H]+=952

### Synthesis Example 38. Synthesis of Compound BD 8

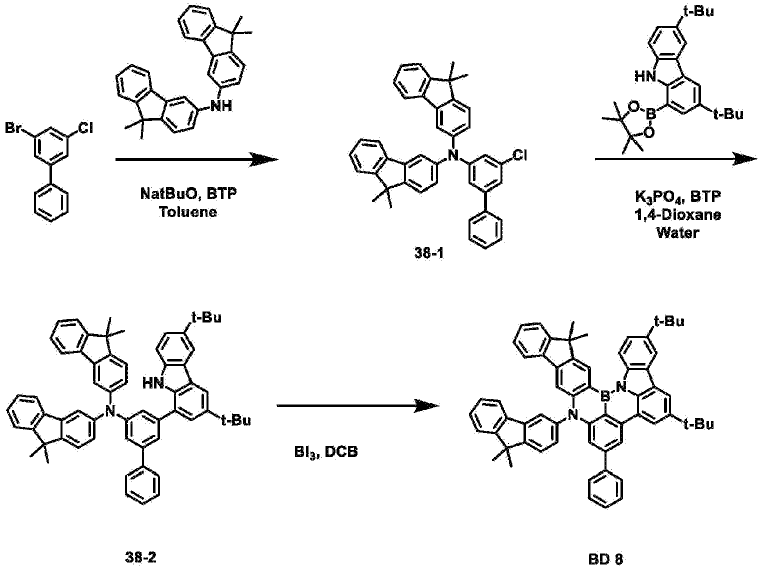

### 1) Synthesis of Compound 38-1

The same equivalents and method were used as in the synthesis process of Compound 31-1 using bis(9,9-dimethyl-9H-fluoren-3-yl)amine instead of bis(5,5,8,8-tetramethyl-5,6,7,8-tetrahydronaphthalen-2-yl)amine, and after the reaction was finished, the result was extracted and then recrystallized to obtain Compound 38-1 (49.5 g, yield 75%). MS[M+H]+=589

### 2) Synthesis of Compound 38-2

The same equivalents and method were used as in the synthesis process of Compound 31-2 using Compound 38-1 and 3,6-di-tert-butyl-1-(4,4,5,5-tetramethyl-1,3,2-dioxaborolan-2-yl)-9H-carbazole instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 38-2 (31.2 g, yield 74%). MS[M+H]+=832

### 3) Synthesis of BD 8

Under the nitrogen atmosphere, Compound 38-2 (25 g) and boron triiodide (20.0 g) were introduced to 1,2-dichlorobenzene (250 ml), and stirred for 4 hours at 160°C. After the reaction was finished, the result was extracted, and then recrystallized to obtain BD 8 (7.3 g, yield 29%). MS[M+H]+=840

### Synthesis Example 39. Synthesis of Compound BD 9

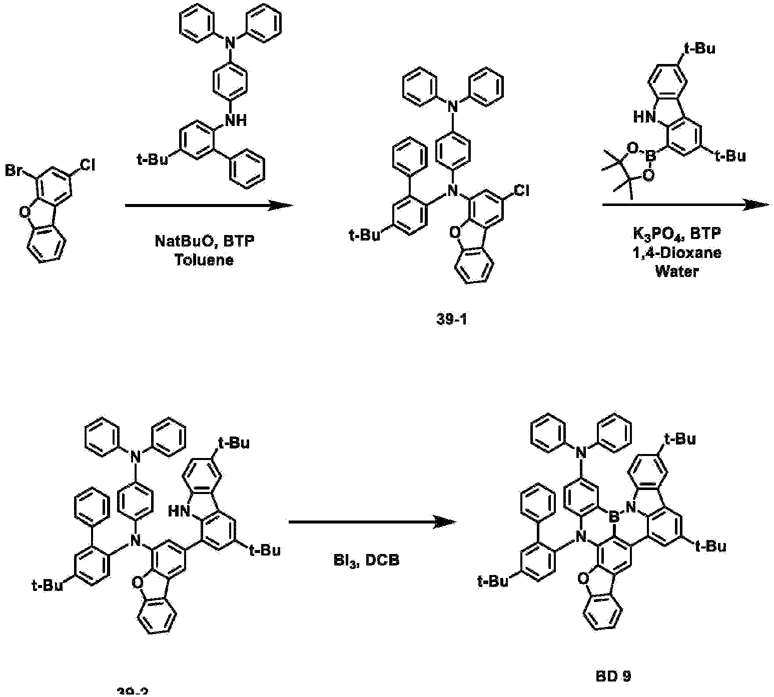

### 1) Synthesis of Compound 39-1

The same equivalents and method were used as in the synthesis process of Compound 36-1 using 4-bromo-2-chlorodibenzo[b,d]furan and N1-(5-(tert-butyl)-[1,1'-biphenyl]-2-yl)-N4,N4-diphenylbenzene-1,4-diamine instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 39-1 (55 g, yield 77%). MS[M+H]+=670

### 2) Synthesis of Compound 39-2

The same equivalents and method were used as in the synthesis process of Compound 36-2 using Compound 39-1 and 3,6-di-tert-butyl-1-(4,4,5,5-tetramethyl-1,3,2-dioxaborolan-2-yl)-9H-carbazole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 39-2 (31.2 g, yield 76%). MS[M+H]+=913

### 3) Synthesis of BD 9

Under the nitrogen atmosphere, Compound 39-2 (25 g) and boron triiodide (18.3 g) were introduced to 1,2-dichlorobenzene (250 ml), and stirred for 4 hours at 160°C. After the reaction was finished, the result was extracted, and then recrystallized to obtain BD 9 (7.3 g, yield 29%). MS[M+H]+=921

### Synthesis Example 40. Synthesis of Compound BD 10

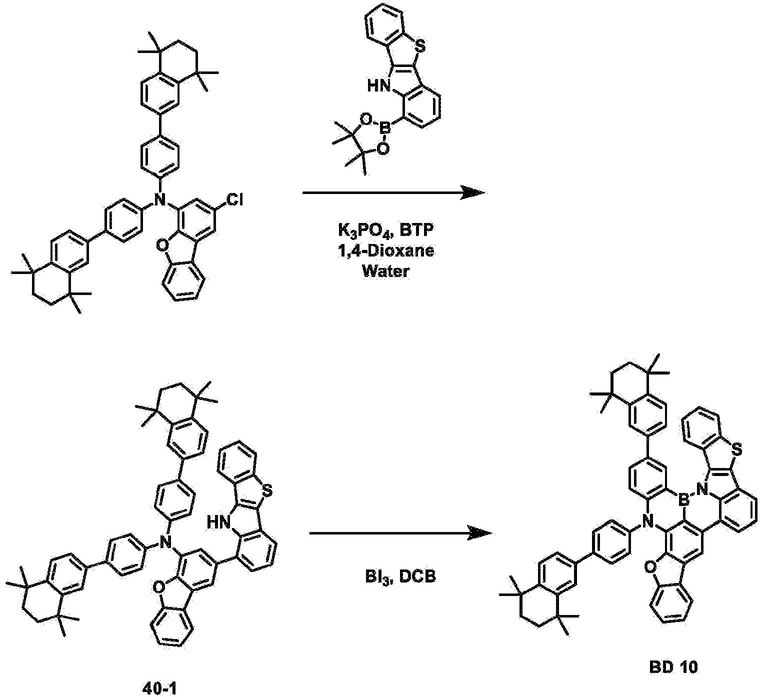

### 1) Synthesis of Compound 40-1

The same equivalents and method were used as in the synthesis process of Compound 36-2 using 2-chloro-N,N-bis(4-(5,5,8,8-tetramethyl-5,6,7,8-tetrahydronaphthalen-2-yl)phenyl)dibenzo[b,d]furan-4-amine and 1-(4,4,5,5-tetramethyl-1,3,2-dioxaborolan-2-yl)-10H-benzo[4,5]thieno[3,2-b]indole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 40-1 (28 g, yield 75%). MS[M+H]+=930

### 2) Synthesis of BD 10

Under the nitrogen atmosphere, Compound 40-1 (25 g) and boron triiodide (17.9 g) were introduced to 1,2-dichlorobenzene (250 ml), and stirred for 4 hours at 160°C. After the reaction was finished, the result was extracted, and then recrystallized to obtain BD 10 (7.1 g, yield 28%). MS[M+H]+=938

### Synthesis Example 41. Synthesis of Compound BD 11

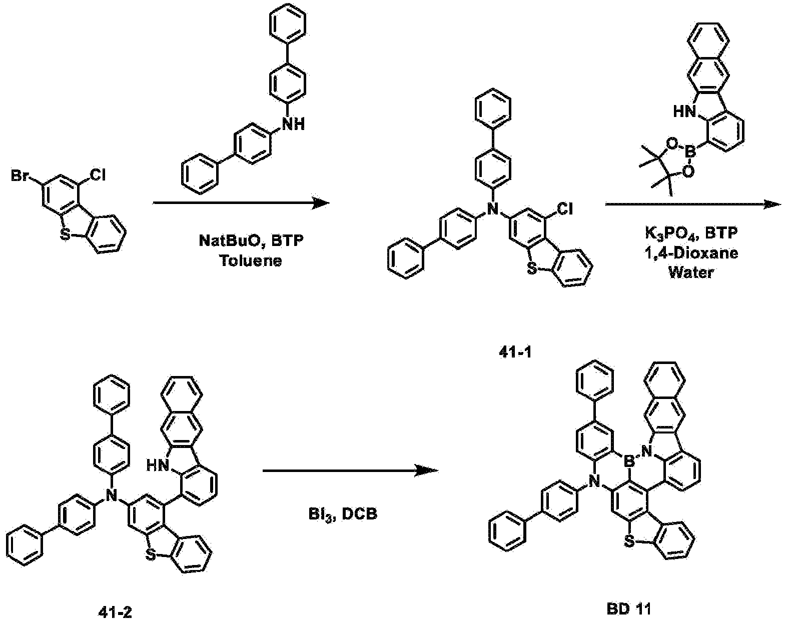

### 1) Synthesis of Compound 41-1

The same equivalents and method were used as in the synthesis process of Compound 36-1 using 3-bromo-1-chlorodibenzo[b,d]thiophene and di([1,1'-biphenyl]-4-yl)amine instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 41-1 (41.4 g, yield 72%). MS[M+H]+=539

### 2) Synthesis of Compound 41-2

The same equivalents and method were used as in the synthesis process of Compound 36-2 using Compound 41-1 and 4-(4,4,5,5-tetramethyl-1,3,2-dioxaborolan-2-yl)-5H-benzo[b]carbazole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 41-2 (28.8 g, yield 72%). MS[M+H]+=720

### 3) Synthesis of BD 11

Under the nitrogen atmosphere, Compound 41-2 (25 g) and boron triiodide (23.1 g) were introduced to 1,2-dichlorobenzene (250 ml), and stirred for 4 hours at 160°C. After the reaction was finished, the result was extracted, and then recrystallized to obtain BD 11 (7.6 g, yield 30%). MS[M+H]+=728

### Synthesis Example 42. Synthesis of Compound BD 12

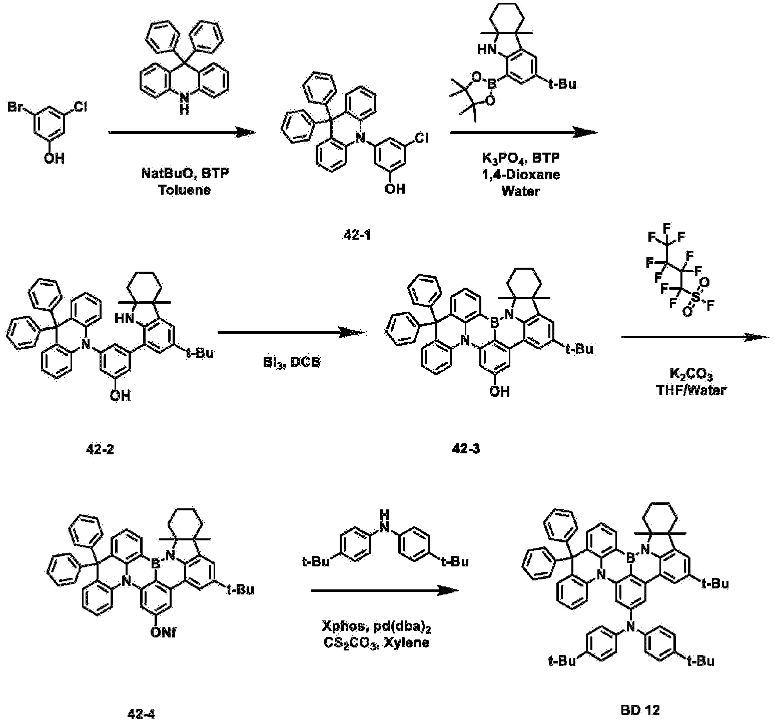

### 1) Synthesis of Compound 42-1

3-Bromo-5-chlorophenol (30 g), 9,9-diphenyl-9,10-dihydroacridine (37.2 g), sodium-tert-butoxide (42 g) and bis(tri-tert-butylphosphine)palladium(0) (1.5 g) were introduced to toluene (600 ml), and refluxed for 1 hour. After the reaction was finished, the result was extracted and then recrystallized to obtain Compound 42-1 (51 g, yield 77%). MS[M+H]+=461

### 2) Synthesis of Compound 42-2

Compound 42-1 (30 g), 6-(tert-butyl)-4a,9a-dimethyl-8-(4,4,5,5-tetramethyl-1,3,2-dioxaborolan-2-yl)-2,3,4,4a,9,9a-hexahydro-1H-carbazole (31.7 g), tripotassium phosphate (49.8 g) and bis(tri-tert-butylphosphine)palladium(0) (0.8 g) were introduced to 1,4-dioxane (300 ml) and water (100 ml), and refluxed for 2 hours. After the reaction was finished, the result was extracted and then recrystallized to obtain Compound 42-2 (32.3 g, yield 73%). MS[M+H]+=682

### 3) Synthesis of Compound 42-3

Under the nitrogen atmosphere, Compound 42-2 (25 g) and boron triiodide (24.4 g) were introduced to 1,2-dichlorobenzene (250 ml), and stirred for 4 hours at 160°C. After the reaction was finished, the result was extracted, and then recrystallized to obtain Compound 42-3 (7.3 g, yield 29%). MS[M+H]+=690

### 4) Synthesis of Compound 42-4

Compound 42-3 (7 g), 1,1,2,2,3,3,4,4,4-nonafluorobutane-1-sulfonyl fluoride (2.8 ml) and potassium carbonate (4.3 g) were introduced to tetrahydrofuran (70 ml) and water (30 ml), and stirred for 2 hours under reflux. After the reaction was finished, the result was extracted, and then column purified to obtain Compound 42-4 (9.1 g, yield 92%). MS[M+H]+=972

### 5) Synthesis of BD 12

Under the nitrogen atmosphere, Compound 42-4 (7 g), bis(4-(tert-butyl)phenyl)amine (2.1 g), pd(dba)₂ (0.13 g), Xphos (0.21 g) and cesium carbonate (7.1 g) were introduced to xylene (100 ml), and stirred for 12 hours under reflux. After the reaction was finished, the result was extracted, and then recrystallized to obtain BD 12 (5.1 g, yield 74%). MS[M+H]+=953

### Synthesis Example 43. Synthesis of Compound BD 13

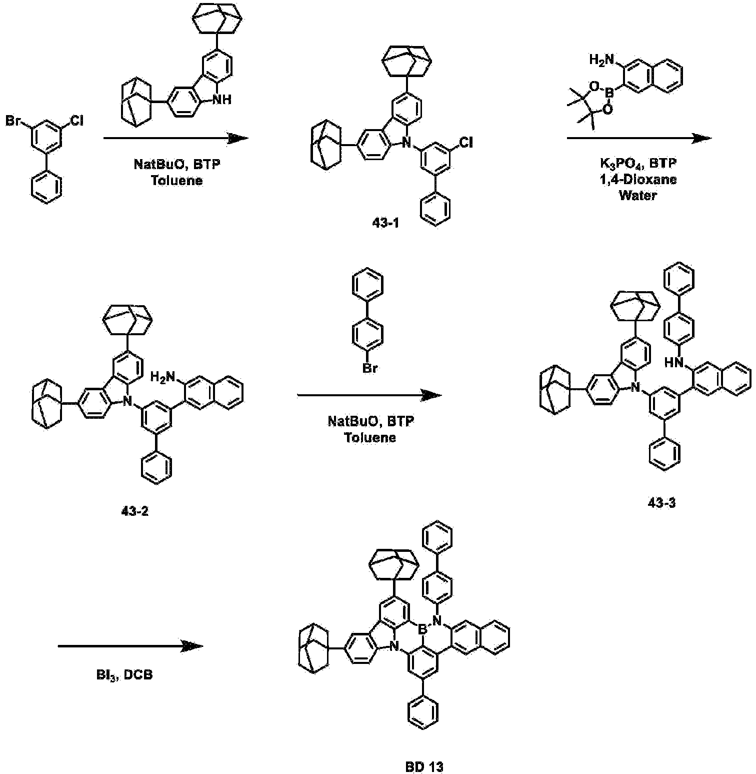

### 1) Synthesis of Compound 43-1

The same equivalents and method were used as in the synthesis process of Compound 31-1 using 3-bromo-5-chloro-1,1'-biphenyl and 3,6-di(adamantan-1-yl)-1-(4,4,5,5-tetramethyl-1,3,2-dioxaborolan-2-yl)-9H-carbazole instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 43-1 (51 g, yield 73%). MS[M+H]+=623

### 2) Synthesis of Compound 43-2

The same equivalents and method were used as in the synthesis process of Compound 36-2 using Compound 43-1 instead of Compound 36-1, and after the reaction was finished, the result was extracted and then recrystallized to obtain Compound 43-2 (27.3 g, yield 78%). MS[M+H]+=730

### 3) Synthesis of Compound 43-3

Under the nitrogen atmosphere, Compound 43-2 (27 g), 4-bromo-1,1'-biphenyl (10.4 g), sodium-tert-butoxide (32.3 g) and bis(tri-tert-butylphosphine)palladium(0) (1.2 g) were introduced to toluene (600 ml), and refluxed for 2 hours. After the reaction was finished, the result was extracted and then recrystallized to obtain Compound 43-3 (25.4 g, yield 78%). MS[M+H]+=882

### 4) Synthesis of BD 13

Under the nitrogen atmosphere, Compound 43-3 (25 g) and boron triiodide (18.9 g) were introduced to 1,2-dichlorobenzene (250 ml), and stirred for 4 hours at 160°C. After the reaction was finished, the result was extracted, and then recrystallized to obtain BD 13 (7.3 g, yield 29%). MS[M+H]+=890

### Synthesis Example 44. Synthesis of Compound BD 14

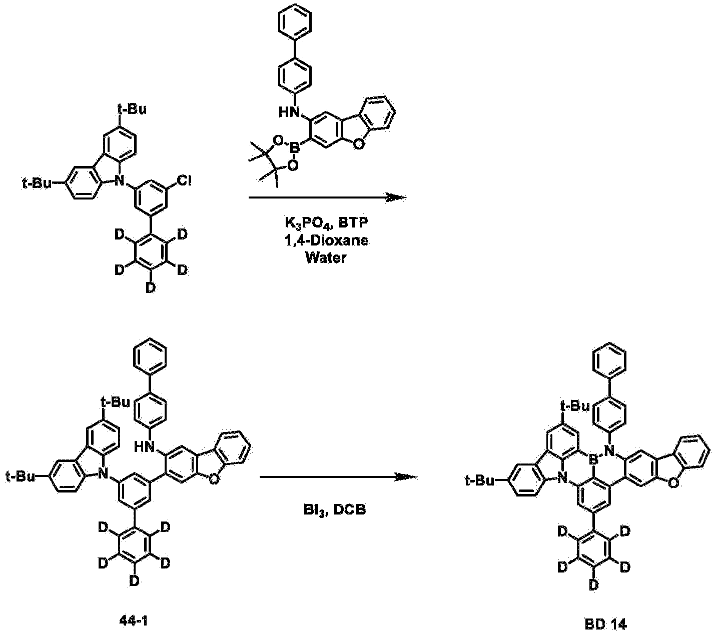

### 1) Synthesis of Compound 44-1

The same equivalents and method were used as in the synthesis process of Compound 31-2 using 3,6-di-tert-butyl-9-(5-chloro-[1,1'-biphenyl]-3-yl-2',3',4',5',6'-d5)-9H-carbazole and N-([1,1'-biphenyl]-4-yl)-3-(4,4,5,5-tetramethyl-1,3,2-dioxaborolan-2-yl)dibenzo[b,d]furan-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 44-1 (38.2 g, yield 78%). MS[M+H]+=771

### 2) Synthesis of BD 14

Under the nitrogen atmosphere, Compound 44-1 (25 g) and boron triiodide (21.6 g) were introduced to 1,2-dichlorobenzene (250 ml), and stirred for 4 hours at 160°C. After the reaction was finished, the result was extracted, and then recrystallized to obtain BD 14 (7.4 g, yield 29%). MS[M+H]+=779

### Synthesis Example 45. Synthesis of Compound BD 15

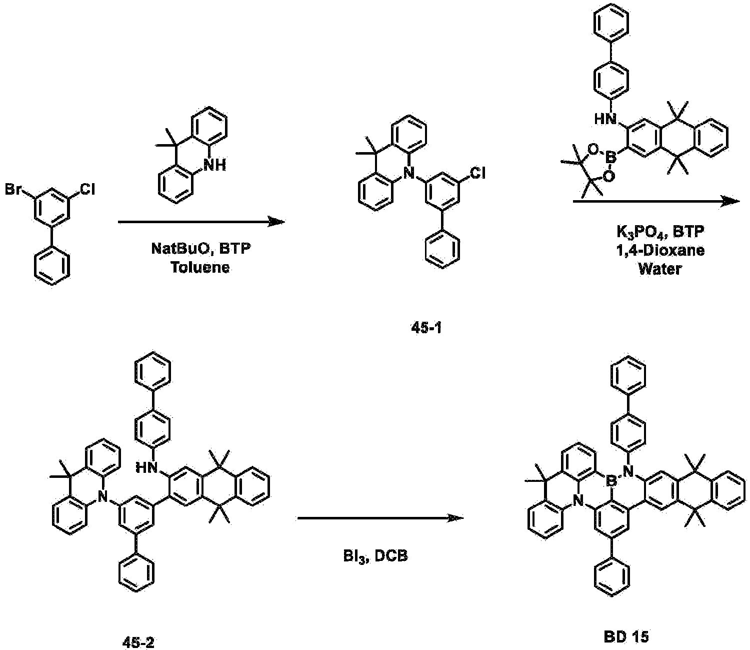

### 1) Synthesis of Compound 45-1

The same equivalents and method were used as in the synthesis process of Compound 31-1 using 3-bromo-5-chloro-1,1'-biphenyl and 9,9-dimethyl-9,10-dihydroacridine instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 45-1 (34 g, yield 77%). MS[M+H]+=396

### 2) Synthesis of Compound 45-2

The same equivalents and method were used as in the synthesis process of Compound 31-2 using Compound 45-1 and N-([1,1'-biphenyl]-4-yl)-9,9,10,10-tetramethyl-3-(4,4,5,5-tetramethyl-1,3,2-dioxaborolan-2-yl)-9,10-dihydroanthracen-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 45-2 (43.1 g, yield 75%). MS[M+H]+=764

### 3) Synthesis of BD 15

Under the nitrogen atmosphere, Compound 45-2 (25 g) and boron triiodide (21.8 g) were introduced to 1,2-dichlorobenzene (250 ml), and stirred for 4 hours at 160°C. After the reaction was finished, the result was extracted, and then recrystallized to obtain BD 15 (7.3 g, yield 29%). MS[M+H]+=772

### Synthesis Example 46. Synthesis of Compound BD 16

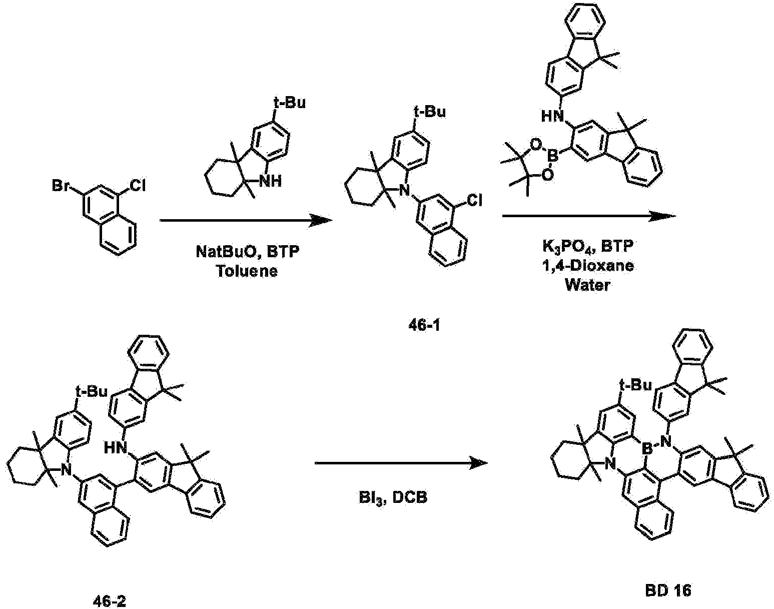

### 1) Synthesis of Compound 46-1

The same equivalents and method were used as in the synthesis process of Compound 36-1 using 3-bromo-1-chloronaphthalene and 6-(tert-butyl)-4a,9a-dimethyl-2,3,4,4a,9,9a-hexahydro-1H-carbazole instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 46-1 (38.7 g, yield 75%). MS[M+H]+=419

### 2) Synthesis of Compound 46-2

The same equivalents and method were used as in the synthesis process of Compound 36-2 using Compound 46-1 and N-(9,9-dimethyl-9H-fluoren-2-yl)-9,9-dimethyl-3-(4,4,5,5-tetramethyl-1,3,2-dioxaborolan-2-yl)-9H-fluoren-2-amine instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 46-2 (43.2 g, yield 77%). MS[M+H]+=784

### 3) Synthesis of BD 16

Under the nitrogen atmosphere, Compound 46-2 (25 g) and boron triiodide (21.3 g) were introduced to 1,2-dichlorobenzene (250 ml), and stirred for 4 hours at 160°C. After the reaction was finished, the result was extracted, and then recrystallized to obtain BD 16 (7.3 g, yield 29%). MS[M+H]+=792

### Synthesis Example 47. Synthesis of Compound BD 17

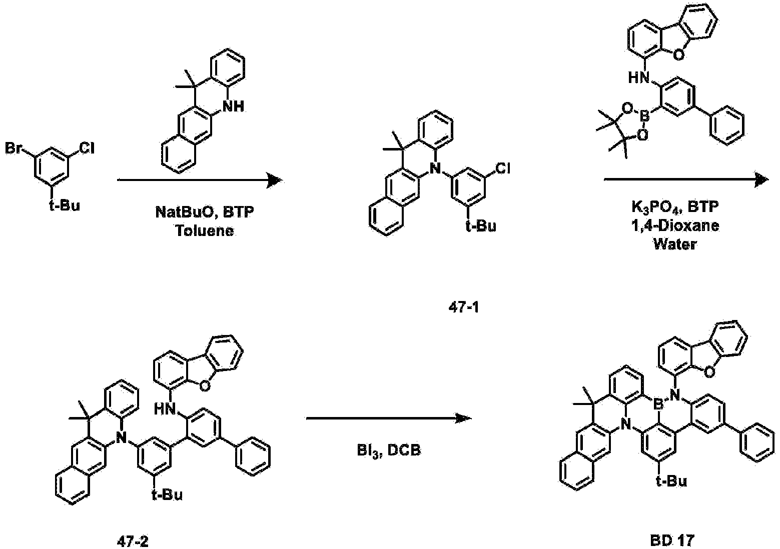

### 1) Synthesis of Compound 47-1

The same equivalents and method were used as in the synthesis process of Compound 31-1 using 1-bromo-3-(tert-butyl)-5-chlorobenzene (30 g) and 12,12-dimethyl-5,12-dihydrobenzo[b]acridine (31.4 g) instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 47-1 (38.9 g, yield 75%). MS[M+H]+=427

### 2) Synthesis of Compound 47-2

The same equivalents and method were used as in the synthesis process of Compound 31-2 using Compound 47-1 and N-(3-(4,4,5,5-tetramethyl-1,3,2-dioxaborolan-2-yl)-[1,1'-biphenyl]-4-yl)dibenzo[b,d]furan-4-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 47-2 (37.7 g, yield 74%). MS[M+H]+=726

### 3) Synthesis of BD 17

Under the nitrogen atmosphere, Compound 47-2 (25 g) and boron triiodide (22.9 g) were introduced to 1,2-dichlorobenzene (250 ml), and stirred for 4 hours at 160°C. After the reaction was finished, the result was extracted, and then recrystallized to obtain BD 17 (7.2 g, yield 28%). MS[M+H]+=734

### Synthesis Example 48. Synthesis of Compound BD 18

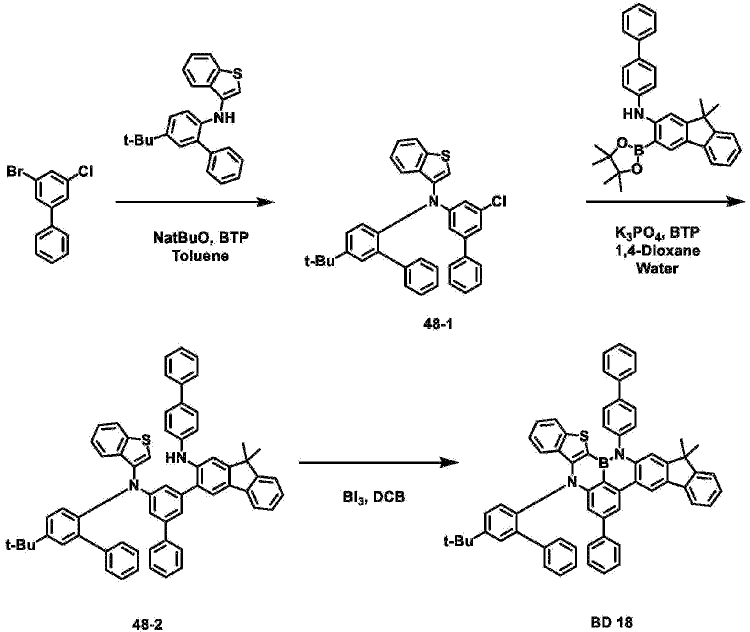

### 1) Synthesis of Compound 48-1

The same equivalents and method were used as in the synthesis process of Compound 31-1 using 3-bromo-5-chloro-1,1'-biphenyl and N-(S-(tert-butyl)-[1,1'-biphenyl]-2-yl)benzo[b]thiophen-3-amine instead of 1-bromo-3-chloro-5-methylbenzene and bis(5,5,8,8-tetramethyl-5,6,7,8-tetrahydronaphthalen-2-yl)amine, and after the reaction was finished, the result was extracted and then recrystallized to obtain Compound 48-1 (44 g, yield 72%). MS[M+H]+=545

### 2) Synthesis of Compound 48-2

The same equivalents and method were used as in the synthesis process of Compound 31-2 using Compound 48-1 and N-([1,1'-biphenyl]-4-yl)-9,9-dimethyl-3-(4,4,5,5-tetramethyl-1,3,2-dioxaborolan-2-yl)-9H-fluoren-2-amine instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 48-2 (34.2 g, yield 71%). MS[M+H]+=870

### 3) Synthesis of BD 18

Under the nitrogen atmosphere, Compound 48-2 (25 g) and boron triiodide (19.1 g) were introduced to 1,2-dichlorobenzene (250 ml), and stirred for 4 hours at 160°C. After the reaction was finished, the result was extracted, and then recrystallized to obtain BD 18 (7.2 g, yield 29%). MS[M+H]+=878

### Synthesis Example 49. Synthesis of Compound BD 19

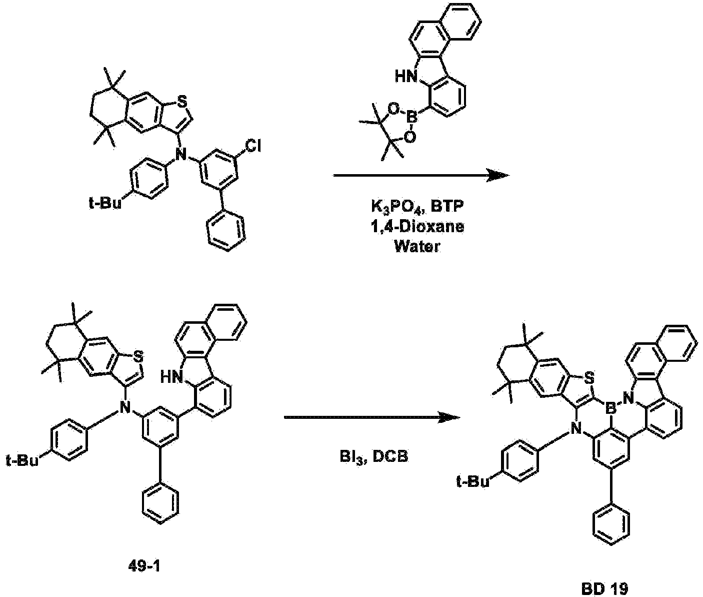

### 1) Synthesis of Compound 49-1

The same equivalents and method were used as in the synthesis process of Compound 31-2 using N-(4-(tert-butyl)phenyl)-N-(5-chloro-[1,1'-biphenyl]-3-yl)-5,5,8,8-tetramethyl-5,6,7,8-tetrahydronaphtho[2,3-b]thiophen-3-amine and 8-(4,4,5,5-tetramethyl-1,3,2-dioxaborolan-2-yl)-7H-benzo[c]carbazole instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 49-1 (28.9 g, yield 73%). MS[M+H]+=760

### 2) Synthesis of BD 19

Under the nitrogen atmosphere, Compound 49-1 (25 g) and boron triiodide (21.9 g) were introduced to 1,2-dichlorobenzene (250 ml), and stirred for 4 hours at 160°C. After the reaction was finished, the result was extracted, and then recrystallized to obtain BD 19 (7.3 g, yield 29%). MS[M+H]+=768

### Synthesis Example 50. Synthesis of Compound BD 20

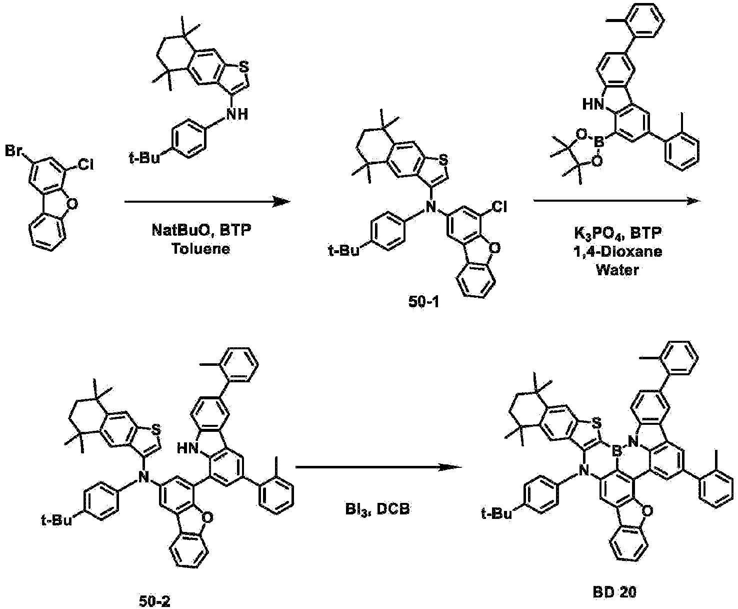

### 1) Synthesis of Compound 50-1

The same equivalents and method were used as in the synthesis process of Compound 36-1 using N-(4-(tert-butyl)phenyl)-5,5,8,8-tetramethyl-5,6,7,8-tetrahydronaphtho[2,3-b]thiophen-3-amine instead of N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 50-1 (46.1 g, yield 73%). MS[M+H]+=593

### 2) Synthesis of Compound 50-2

The same equivalents and method were used as in the synthesis process of Compound 36-2 using Compound 50-1 and 1-(4,4,5,5-tetramethyl-1,3,2-dioxaborolan-2-yl)-3,6-di-o-tolyl-9H-carbazole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 50-2 (33.2 g, yield 73%). MS[M+H]+=904

### 3) Synthesis of BD 20

Under the nitrogen atmosphere, Compound 50-2 (25 g) and boron triiodide (18.4 g) were introduced to 1,2-dichlorobenzene (250 ml), and stirred for 4 hours at 160°C. After the reaction was finished, the result was extracted, and then recrystallized to obtain BD 20 (7.1 g, yield 28%). MS[M+H]+=912

### Synthesis Example 51. Synthesis of Compound BD 21

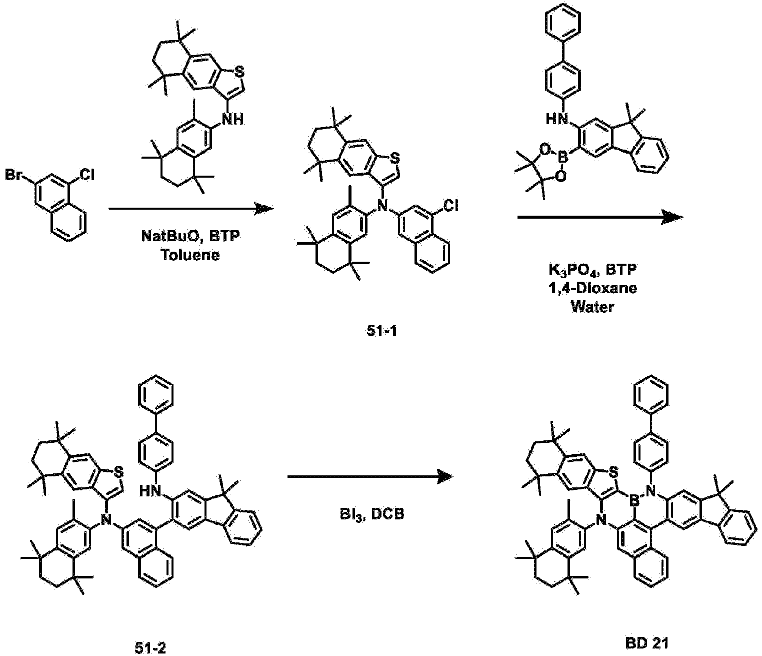

### 1) Synthesis of Compound 51-1

The same equivalents and method were used as in the synthesis process of Compound 36-1 using 3-bromo-1-chloronaphthalene and 5,5,8,8-tetramethyl-N-(3,5,5,8,8-pentamethyl-5,6,7,8-tetrahydronaphthalen-2-yl)-5,6,7,8-tetrahydronaphtho[2,3-b]thiophen-3-amine instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 51-1 (55.5 g, yield 72%). MS[M+H]+=621

### 2) Synthesis of Compound 51-2

The same equivalents and method were used as in the synthesis process of Compound 36-2 using Compound 51-1 and N-([1,1'-biphenyl]-4-yl)-9,9-dimethyl-3-(4,4,5,5-tetramethyl-1,3,2-dioxaborolan-2-yl)-9H-fluoren-2-amine instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 51-2 (32.4 g, yield 71%). MS[M+H]+=946

### 3) Synthesis of BD 21

Under the nitrogen atmosphere, Compound 51-2 (25 g) and boron triiodide (17.6 g) were introduced to 1,2-dichlorobenzene (250 ml), and stirred for 4 hours at 160°C. After the reaction was finished, the result was extracted, and then recrystallized to obtain BD 21 (7.3 g, yield 29%). MS[M+H]+=954

### Synthesis Example 52. Synthesis of Compound BD 22

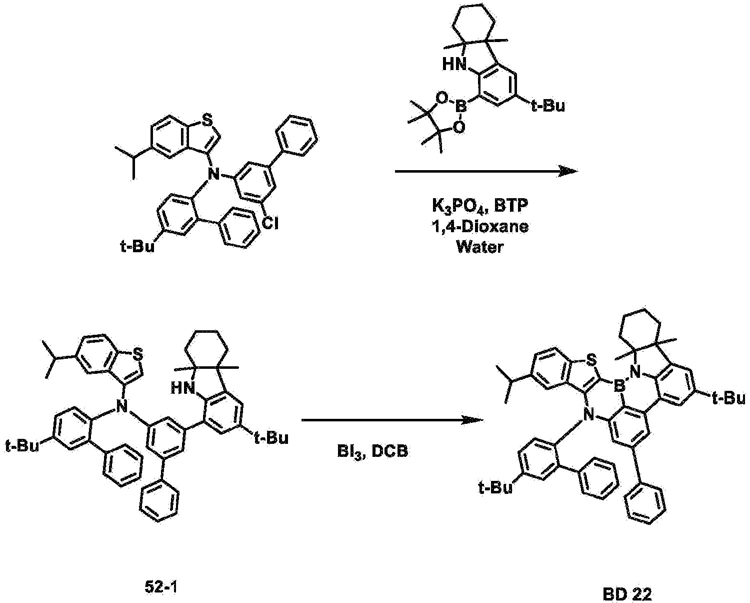

### 1) Synthesis of Compound 52-1

The same equivalents and method were used as in the synthesis process of Compound 31-2 using N-(5-(tert-butyl)-[1,1'-biphenyl]-2-yl)-N-(5-chloro-[1,1'-biphenyl]-3-yl)-5-isopropylbenzo[b]thiophen-3-amine and 6-(tert-butyl)-4a,9a-dimethyl-8-(4,4,5,5-tetramethyl-1,3,2-dioxaborolan-2-yl)-2,3,4,4a,9,9a-hexahydro-1H-carbazole instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 52-1 (31.1 g, yield 75%). MS[M+H]+=808

### 2) Synthesis of BD 22

Under the nitrogen atmosphere, Compound 52-1 (25 g) and boron triiodide (20.6 g) were introduced to 1,2-dichlorobenzene (250 ml), and stirred for 4 hours at 160°C. After the reaction was finished, the result was extracted, and then recrystallized to obtain BD 22 (7.3 g, yield 29%). MS[M+H]+=816

### Synthesis Example 53. Synthesis of Compound BD 23

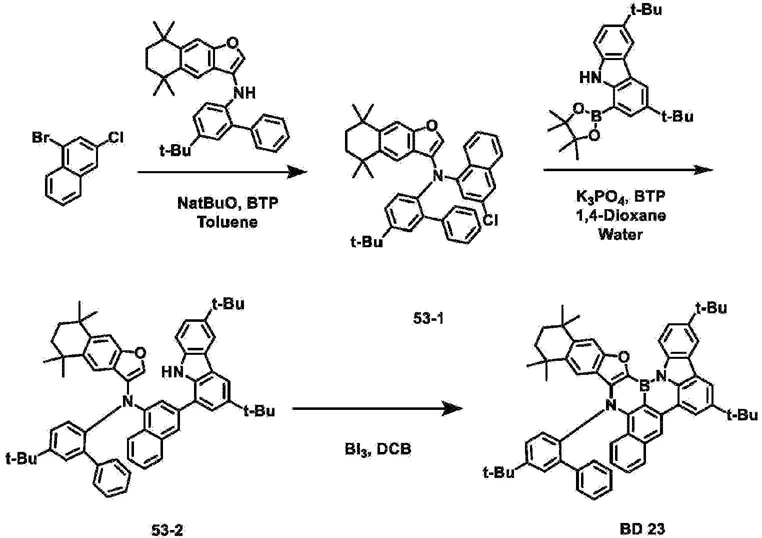

### 1) Synthesis of Compound 53-1

The same equivalents and method were used as in the synthesis process of Compound 36-1 using 1-bromo-3-chloronaphthalene and N-(5-(tert-butyl)-[1,1'-biphenyl]-2-yl)-5,5,8,8-tetramethyl-5,6,7,8-tetrahydronaphtho[2,3-b]furan-3-amine instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 53-1 (54.5 g, yield 72%). MS[M+H]+=613

### 2) Synthesis of Compound 53-2

The same equivalents and method were used as in the synthesis process of Compound 36-2 using Compound 53-1 and 3,6-di-tert-butyl-1-(4,4,5,5-tetramethyl-1,3,2-dioxaborolan-2-yl)-9H-carbazole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 53-2 (31.1 g, yield 74%). MS[M+H]+=856

### 3) Synthesis of BD 23

Under the nitrogen atmosphere, Compound 53-2 (25 g) and boron triiodide (19.5 g) were introduced to 1,2-dichlorobenzene (250 ml), and stirred for 4 hours at 160°C. After the reaction was finished, the result was extracted, and then recrystallized to obtain BD 23 (7.1 g, yield 28%). MS[M+H]+=864

### Synthesis Example 54. Synthesis of Compound BD 24

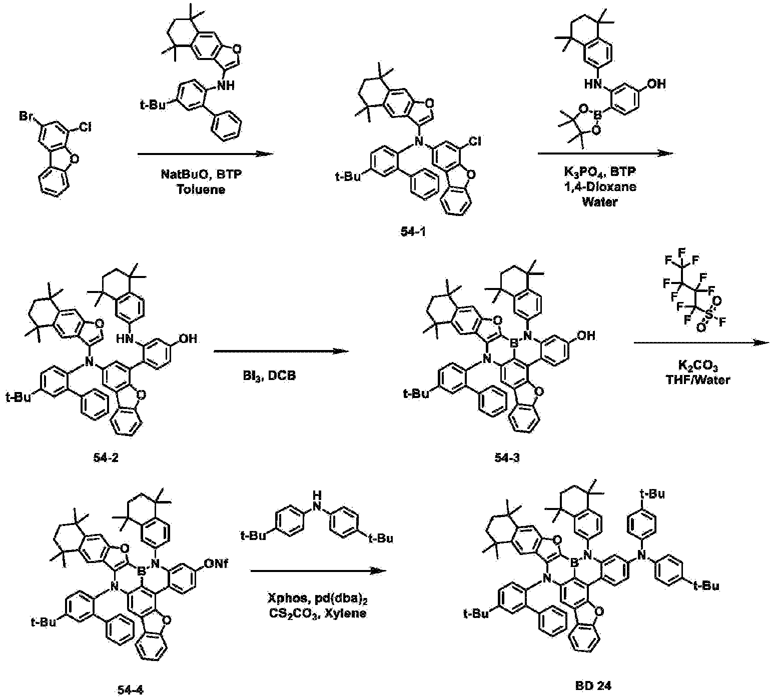

### 1) Synthesis of Compound 54-1

The same equivalents and method were used as in the synthesis process of Compound 36-1 using N-(5-(tert-butyl)-[1,1'-biphenyl]-2-yl)-5,5,8,8-tetramethyl-5,6,7,8-tetrahydronaphtho[2,3-b]furan-3-amine instead of N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 54-1 (54 g, yield 78%). MS[M+H]+=653

### 2) Synthesis of Compound 54-2

The same equivalents and method were used as in the synthesis process of Compound 36-2 using Compound 54-1 and 4-(4,4,5,5-tetramethyl-1,3,2-dioxaborolan-2-yl)-3-((5,5,8,8-tetramethyl-5,6,7,8-tetrahydronaphthalen-2-yl)amino)phenol instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 54-2 (32.2 g, yield 77%). MS[M+H]+=912

### 3) Synthesis of Compound 54-3

Under the nitrogen atmosphere, Compound 54-2 (25 g) and boron triiodide (18.3 g) were introduced to 1,2-dichlorobenzene (250 ml), and stirred for 4 hours at 160°C. After the reaction was finished, the result was extracted, and then recrystallized to obtain Compound 54-3 (7.3 g, yield 29%). MS[M+H]+=920

### 4) Synthesis of Compound 54-4

Compound 54-3 (7 g), 1,1,2,2,3,3,4,4,4-nonafluorobutane-1-sulfonyl fluoride (2.1 ml) and potassium carbonate (3.2 g) were introduced to tetrahydrofuran (70 ml) and water (30 ml), and stirred for 2 hours under reflux. After the reaction was finished, the result was extracted, and then column purified to obtain Compound 54-4 (8.8 g, yield 96%). MS[M+H]+=1201

### 5) Synthesis of BD 24

Under the nitrogen atmosphere, Compound 54-4 (7 g), bis(4-(tert-butyl)phenyl)amine (1.7 g), pd(dba)₂ (0.11 g), Xphos (0.18 g) and cesium carbonate (5.7 g) were introduced to xylene (100 ml), and stirred for 12 hours under reflux. After the reaction was finished, the result was extracted, and then recrystallized to obtain BD 24 (5.1 g, yield 74%). MS[M+H]+=1183

### Synthesis Example 55. Synthesis of Compound BD 25

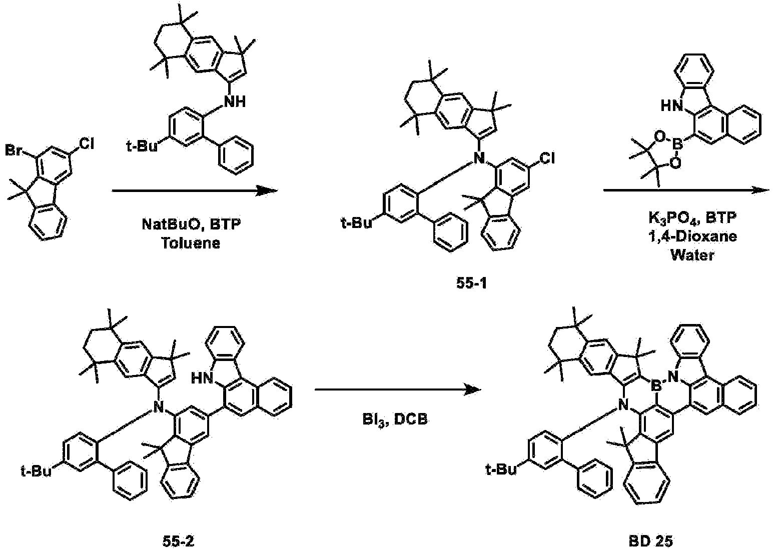

### 1) Synthesis of Compound 55-1

The same equivalents and method were used as in the synthesis process of Compound 36-1 using 1-bromo-3-chloro-9,9-dimethyl-9H-fluorene and N-(5-(tert-butyl)-[1,1'-biphenyl]-2-yl)-1,1,5,5,8,8-hexamethyl-5,6,7,8-tetrahydro-1H-cyclopenta[b]naphthalen-3-amine instead of 2-bromo-4-chlorodibenzo[b,d]furan and N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 55-1 (52 g, yield 76%). MS[M+H]+=705

### 2) Synthesis of Compound 55-2

The same equivalents and method were used as in the synthesis process of Compound 36-2 using Compound 55-1 and 6-(4,4,5,5-tetramethyl-1,3,2-dioxaborolan-2-yl)-7H-benzo[c]carbazole instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 55-2 (27.7 g, yield 73%). MS[M+H]+=886

### 3) Synthesis of BD 25

Under the nitrogen atmosphere, Compound 55-2 (25 g) and boron triiodide (18.8 g) were introduced to 1,2-dichlorobenzene (250 ml), and stirred for 4 hours at 160°C. After the reaction was finished, the result was extracted, and then recrystallized to obtain BD 25 (7.5 g, yield 30%). MS[M+H]+=894

### Synthesis Example 56. Synthesis of Compound BD 26

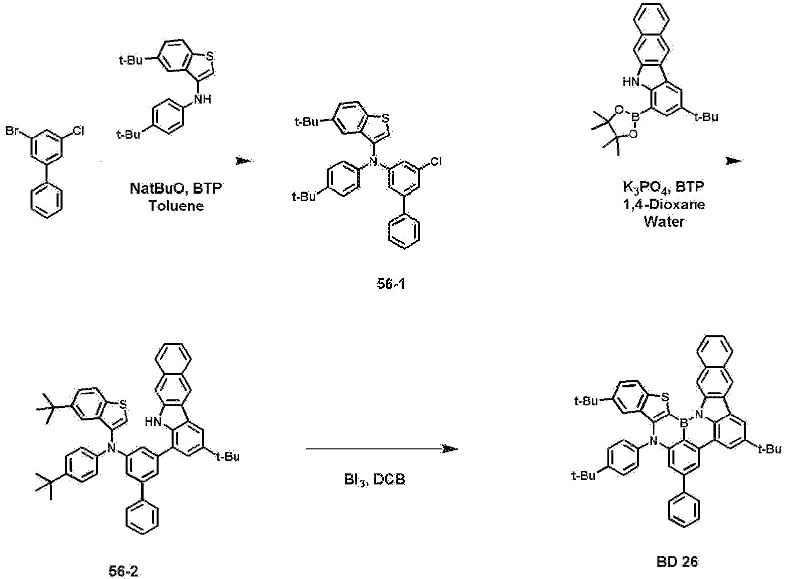

### 1) Synthesis of Compound 56-1

The same equivalents and method were used as in the synthesis process of Compound 34-1 using 5-(tert-butyl)-N-(4-(tert-butyl)phenyl)benzo[b]thiophen-3-amine instead of N1-(3,5,5,8,8-pentamethyl-5,6,7,8-tetrahydronaphthalen-2-yl)-N3,N3-diphenylbenzene-1,3-diamine, and after the reaction was finished, the result was extracted and then recrystallized to obtain Compound 56-1 (44 g, yield 75%). MS[M+H]+=525

### 2) Synthesis of Compound 56-2

The same equivalents and method were used as in the synthesis process of Compound 31-2 using Compound 56-1 and 2-(tert-butyl)-4-(4,4,5,5-tetramethyl-1,3,2-dioxaborolan-2-yl)-5H-benzo[b]carbazole instead of Compound 31-1 and N-([1,1'-biphenyl]-4-yl-2',3',4',5',6'-d5)-3-(4,4,5,5-tetramethyl-1,3,2-dioxaborolan-2-yl)-[1,1'-biphenyl]-2',3',4',5',6'-d5-4-amine, and after the reaction was finished, the result was extracted and then recrystallized to obtain Compound 56-2 (31.1 g, yield 71%). MS[M+H]+=762

### 3) Synthesis of BD 26

Under the nitrogen atmosphere, Compound 56-2 (25 g) and boron triiodide (21.9 g) were introduced to 1,2-dichlorobenzene (250 ml), and stirred for 4 hours at 160°C. After the reaction was finished, the result was extracted, and then recrystallized to obtain BD 26 (7.2 g, yield 29%). MS[M+H]+=770

### Synthesis Example 57. Synthesis of Compound BD 27

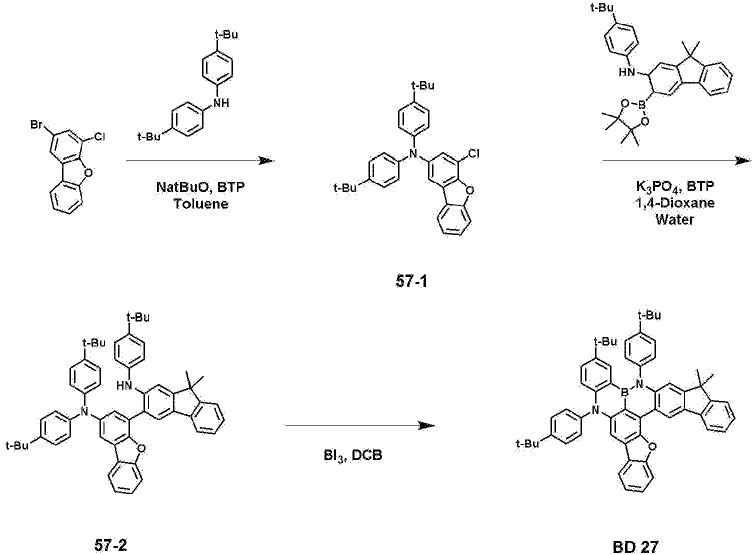

### 1) Synthesis of Compound 57-1

The same equivalents and method were used as in the synthesis process of Compound 36-1 using bis(4-(tert-butyl) phenyl) amine instead of N1-(5-(tert-butyl)-[1,1'-biphenyl]-2-yl)-N3,N3-bis(4-(tert-butyl)phenyl)benzene-1,3-diamine, and after the reaction was finished, the result was extracted and then recrystallized to obtain Compound 57-1 (37 g, yield 72%). MS[M+H]+=483

### 2) Synthesis of Compound 57-2

The same equivalents and method were used as in the synthesis process of Compound 36-2 using Compound 57-1 and N-(4-(tert-butyl)phenyl)-9,9-dimethyl-3-(4,4,5,5-tetramethyl-1,3,2-dioxaborolan-2-yl)-9H-fluoren-2-amine instead of Compound 36-1 and 3-(4,4,5,5-tetramethyl-1,3,2-dioxaborolan-2-yl)naphthalen-2-amine, and after the reaction was finished, the result was extracted and then recrystallized to obtain Compound 57-2 (35.2 g, yield 72%). MS[M+H]+=788

### 3) Synthesis of BD 27

Under the nitrogen atmosphere, Compound 57-2 (25 g) and boron triiodide (21.1 g) were introduced to 1,2-dichlorobenzene (250 ml), and stirred for 4 hours at 160°C. After the reaction was finished, the result was extracted, and then recrystallized to obtain BD 27 (7.6 g, yield 30%). MS[M+H]+=796

### [Example]

### Example 1

A glass substrate on which ITO (indium tin oxide) was coated as a thin film to a thickness of 150 nm was placed in detergent-dissolved distilled water and ultrasonic cleaned. Herein, a product of Fischer Co. was used as the detergent, and as the distilled water, distilled water filtered twice with a filter manufactured by Millipore Co. was used. After the ITO was cleaned for 30 minutes, ultrasonic cleaning was repeated twice using distilled water for 10 minutes. After the cleaning with distilled water was finished, the substrate was ultrasonic cleaned with solvents of isopropyl alcohol, acetone and methanol, then dried, and then transferred to a plasma cleaner. In addition, the substrate was cleaned for 5 minutes using nitrogen plasma, and then transferred to a vacuum deposition apparatus.

On the transparent ITO electrode prepared as above, the following HAT-CN compound was thermal vacuum deposited to a thickness of 5 nm to form a hole injection layer. Subsequently, HTL1 was thermal vacuum deposited to a thickness of 100 nm to form a first hole transfer layer, and then HTL2 was thermal vacuum deposited to a thickness of 10 nm to form a second hole transfer layer. Then, a light emitting layer having a thickness of 20 nm was formed by simultaneously vacuum depositing the following Compound BD 1 as a dopant and Compound BH 1 as a host (weight ratio 5:95). Then, ETL1 was vacuum deposited to a thickness of 20 nm to form an electron transfer layer. Then, LiF was vacuum deposited to a thickness of 0.5 nm to form an electron injection layer. Then, aluminum was deposited to a thickness of 100 nm to form a cathode, and as a result, an organic light emitting device was manufactured.

In the above-described process, the deposition rates of the organic materials were maintained at 0.04 nm/sec to 0.09 nm/sec, the deposition rate of the lithium fluoride of the electron transfer layer was maintained at 0.03 nm/sec and the deposition rate of the aluminum of the cathode was maintained at 0.2 nm/sec, and the degree of vacuum during the deposition was maintained at 1×10⁻⁷ torr to 5×10⁻⁵ torr to manufacture the organic light emitting device.

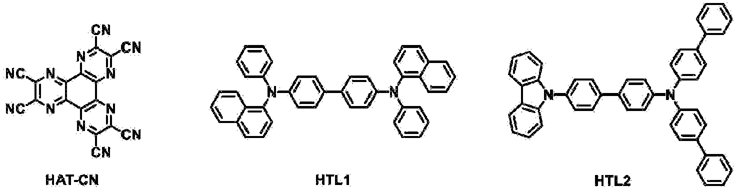

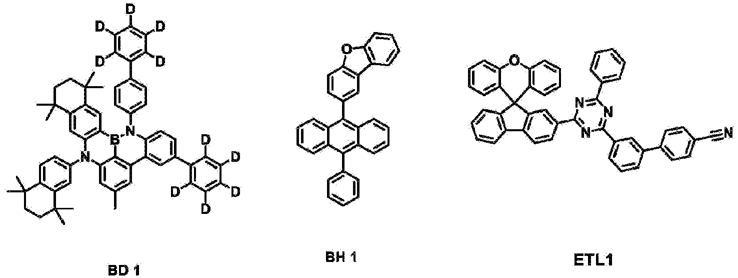

### Examples 2 to 97

Organic light emitting devices were manufactured in the same manner as in Example 1 except that Compounds BH 2 to BH 30 were used instead of BH 1 as the host compound of the light emitting layer, or Compounds BD 2 to BD 27 were used instead of BD 1 as the dopant compound.

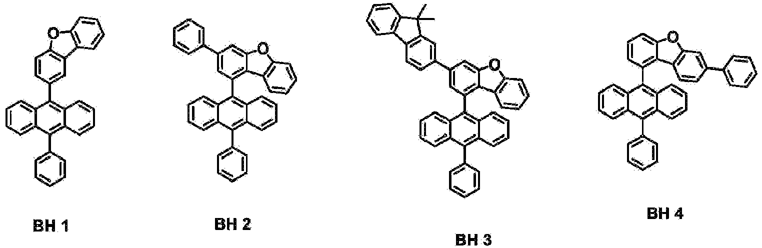

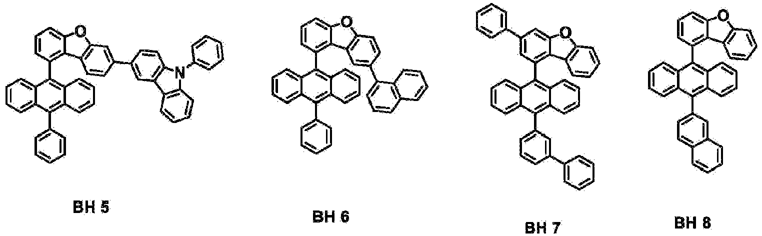

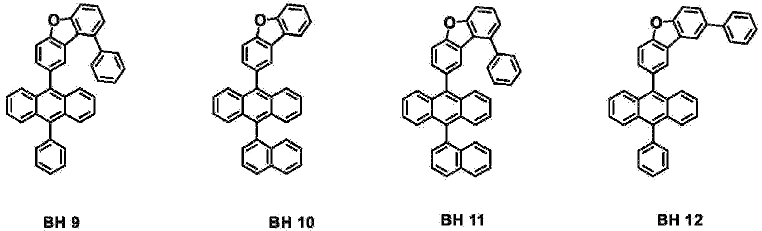

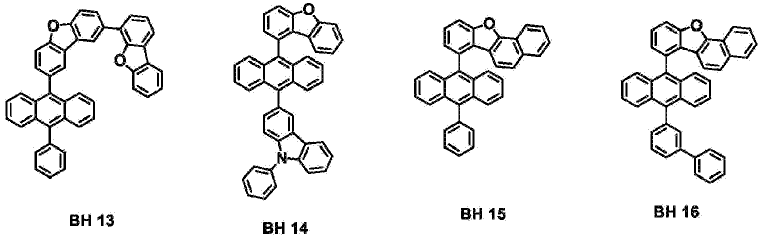

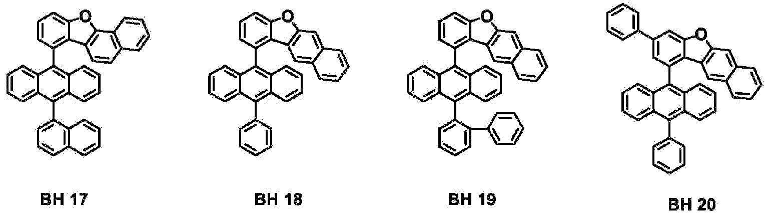

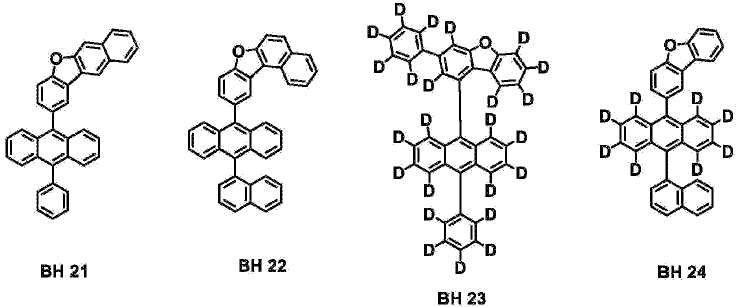

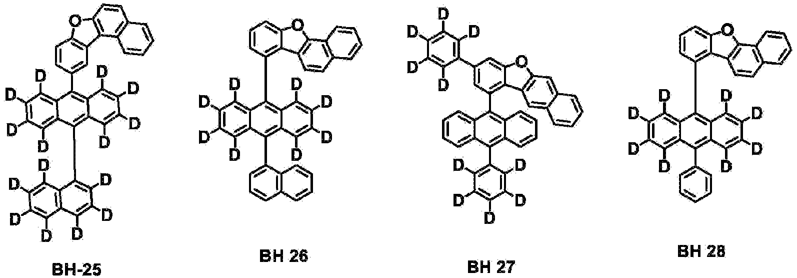

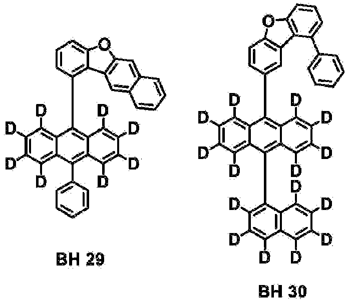

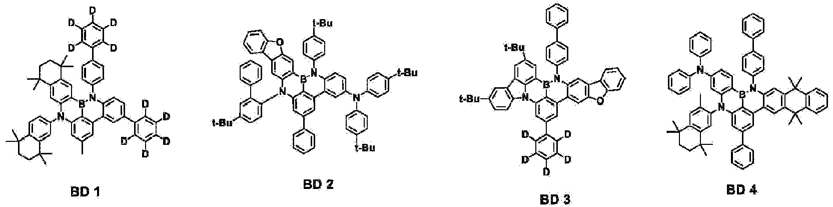

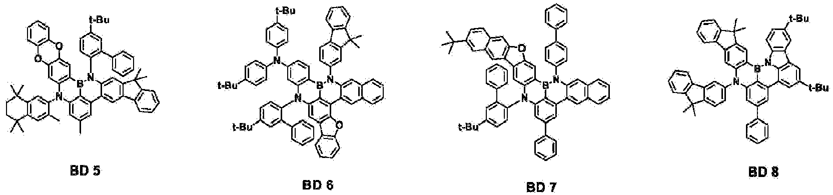

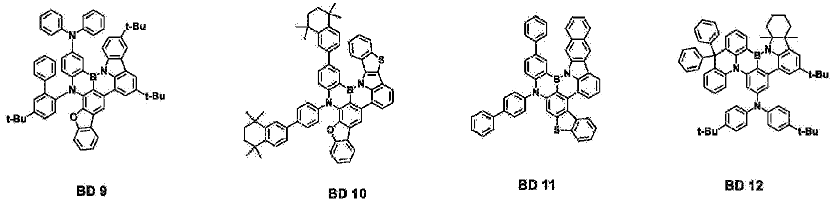

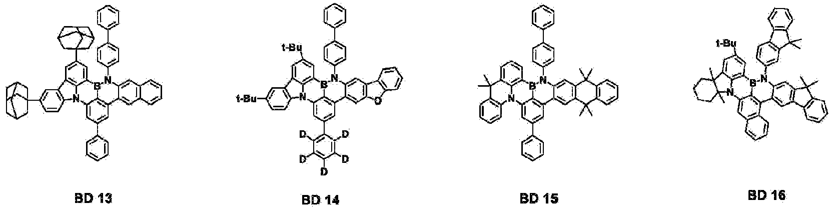

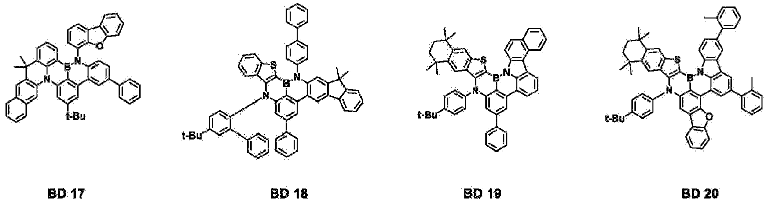

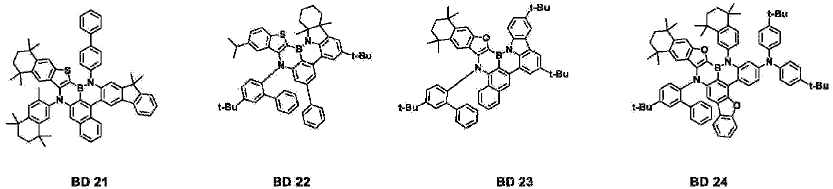

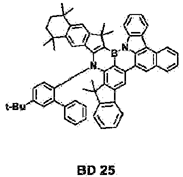

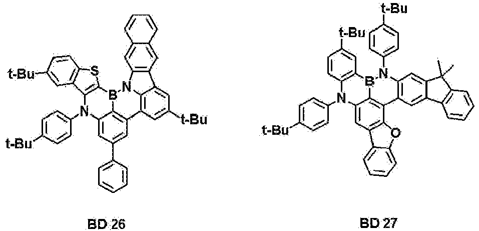

### Comparative Examples 1 to 15

Organic light emitting devices were manufactured in the same manner as in Example 1 except that Compounds BH A to BH C were used instead of BH 1 as the host compound of the light emitting layer, or Compounds BD A to BD D were used instead of BD 1 as the dopant compound.

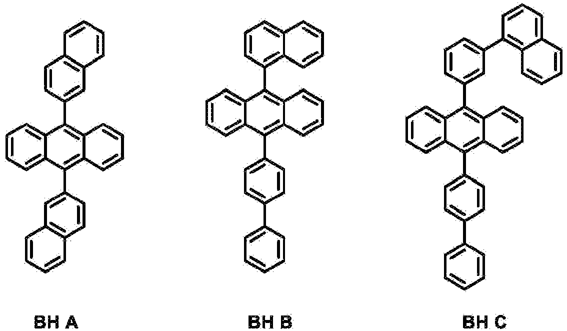

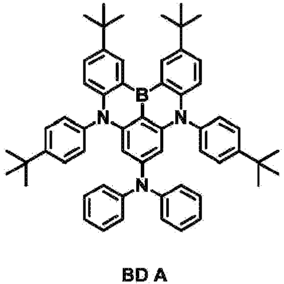

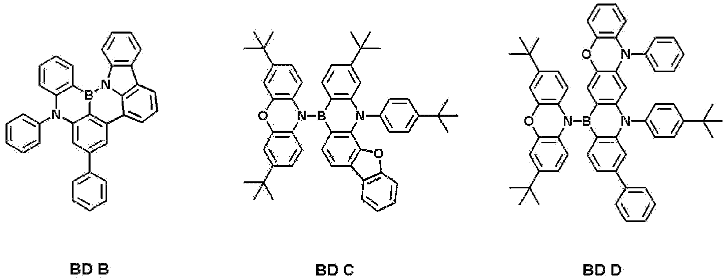

For each of the organic light emitting devices manufactured in the examples and the comparative examples, driving voltage and efficiency were measured at current density of 10 mA/cm², and time (T95) taken for luminance to become 95% with respect to initial luminance was measured at current density of 20 mA/cm². The results are shown in the following

### Table 1.

**[Table 1]**

| | Host | Dopant | Voltage (V) | Conversion Efficiency (Cd/A/y) | Lifetime (T95) (hr) |
|---|---|---|---|---|---|
| Example 1 | BH 1 | BD 1 | 3.75 | 61.4 | 280 |
| Example 2 | BH 1 | BD 2 | 3.76 | 63.3 | 275 |
| Example 3 | BH 1 | BD 3 | 3.68 | 64.7 | 290 |
| Example 4 | BH 1 | BD 4 | 3.65 | 61.1 | 275 |
| Example 5 | BH 1 | BD 5 | 3.66 | 62.5 | 275 |
| Example 6 | BH 2 | BD 3 | 3.70 | 65.8 | 275 |
| Example 7 | BH 2 | BD 6 | 3.64 | 65.5 | 285 |
| Example 8 | BH 2 | BD 7 | 3.81 | 63.2 | 285 |
| Example 9 | BH 3 | BD 3 | 3.60 | 64.1 | 292 |
| Example 10 | BH 3 | BD 6 | 3.48 | 64.0 | 295 |
| Example 11 | BH 3 | BD 8 | 3.55 | 63.9 | 285 |
| Example 12 | BH 4 | BD 6 | 3.59 | 64.9 | 295 |
| Example 13 | BH 4 | BD 9 | 3.47 | 64.4 | 285 |
| Example 14 | BH 4 | BD 10 | 3.49 | 64.5 | 280 |
| Example 15 | BH 5 | BD 11 | 3.55 | 62.5 | 290 |
| Example 16 | BH 5 | BD 12 | 3.64 | 64.8 | 295 |
| Example 17 | BH 5 | BD 20 | 3.51 | 64.9 | 295 |
| Example 18 | BH 6 | BD 13 | 3.58 | 61.0 | 290 |
| Example 19 | BH 6 | BD 14 | 3.56 | 63.2 | 295 |
| Example 20 | BH 6 | BD 25 | 3.40 | 64.2 | 300 |
| Example 21 | BH 7 | BD 15 | 3.65 | 64.2 | 275 |
| Example 22 | BH 7 | BD 20 | 3.58 | 65.1 | 285 |
| Example 23 | BH 7 | BD 25 | 3.47 | 64.9 | 285 |
| Example 24 | BH 8 | BD 16 | 3.66 | 64.1 | 290 |
| Example 25 | BH 8 | BD 17 | 3.74 | 62.6 | 275 |
| Example 26 | BH 8 | BD 20 | 3.55 | 65.3 | 290 |
| Example 27 | BH 9 | BD 18 | 3.58 | 62.8 | 290 |
| Example 28 | BH 9 | BD 19 | 3.58 | 62.9 | 295 |
| Example 29 | BH 9 | BD 20 | 3.48 | 63.5 | 305 |
| Example 30 | BH 9 | BD 25 | 3.39 | 63.1 | 310 |
| Example 31 | BH 10 | BD 3 | 3.70 | 65.1 | 280 |
| Example 32 | BH 10 | BD 21 | 3.71 | 64.5 | 280 |
| Example 33 | BH 10 | BD 25 | 3.52 | 66.1 | 285 |
| Example 34 | BH 10 | BD 26 | 3.68 | 65.4 | 280 |
| Example 35 | BH 11 | BD 6 | 3.59 | 63.1 | 295 |
| Example 36 | BH 11 | BD 22 | 3.66 | 63.1 | 290 |
| Example 37 | BH 11 | BD 25 | 3.42 | 65.2 | 298 |
| Example 38 | BH 11 | BD 27 | 3.55 | 65.8 | 300 |
| Example 39 | BH 12 | BD 1 | 3.77 | 61.1 | 285 |
| Example 40 | BH 12 | BD 20 | 3.58 | 65.4 | 292 |
| Example 41 | BH 12 | BD 23 | 3.77 | 63.9 | 293 |
| Example 42 | BH 13 | BD 3 | 3.59 | 62.9 | 305 |
| Example 43 | BH 13 | BD 24 | 3.38 | 62.1 | 305 |
| Example 44 | BH 13 | BD 25 | 3.35 | 63.9 | 310 |
| Example 45 | BH 14 | BD 3 | 3.60 | 63.7 | 285 |
| Example 46 | BH 14 | BD 6 | 3.55 | 63.0 | 280 |
| Example 47 | BH 14 | BD 10 | 3.44 | 63.2 | 278 |
| Example 48 | BH 15 | BD 13 | 3.62 | 61.5 | 295 |
| Example 49 | BH 15 | BD 20 | 3.56 | 64.8 | 305 |
| Example 50 | BH 15 | BD 24 | 3.41 | 63.8 | 299 |
| Example 51 | BH 16 | BD 9 | 3.44 | 64.5 | 295 |
| Example 52 | BH 16 | BD 11 | 3.54 | 63.5 | 292 |
| Example 53 | BH 16 | BD 25 | 3.48 | 65.7 | 288 |
| Example 54 | BH 17 | BD 3 | 3.66 | 64.8 | 291 |
| Example 55 | BH 17 | BD 8 | 3.68 | 65.0 | 282 |
| Example 56 | BH 17 | BD 20 | 3.59 | 65.8 | 295 |
| Example 57 | BH 17 | BD 27 | 3.55 | 66.3 | 295 |
| Example 58 | BH 18 | BD 5 | 3.51 | 61.0 | 320 |
| Example 59 | BH 18 | BD 10 | 3.33 | 61.8 | 305 |
| Example 60 | BH 18 | BD 20 | 3.41 | 62.9 | 312 |
| Example 61 | BH 19 | BD 8 | 3.64 | 64.8 | 284 |
| Example 62 | BH 19 | BD 20 | 3.55 | 65.8 | 285 |
| Example 63 | BH 19 | BD 25 | 3.48 | 65.1 | 295 |
| Example 64 | BH 19 | BD 26 | 3.51 | 65.0 | 305 |
| Example 65 | BH 20 | BD 9 | 3.44 | 64.4 | 287 |
| Example 66 | BH 20 | BD 14 | 3.66 | 65.4 | 285 |
| Example 67 | BH 20 | BD 25 | 3.48 | 65.8 | 280 |
| Example 68 | BH 21 | BD 6 | 3.44 | 61.8 | 298 |
| Example 69 | BH 21 | BD 9 | 3.31 | 62.5 | 312 |
| Example 70 | BH 21 | BD 20 | 3.42 | 63.7 | 305 |
| Example 71 | BH 22 | BD 3 | 3.60 | 64.5 | 284 |
| Example 72 | BH 22 | BD 9 | 3.45 | 64.0 | 288 |
| Example 73 | BH 22 | BD 25 | 3.46 | 65.3 | 295 |
| Example 74 | BH 23 | BD 3 | 3.68 | 65.7 | 420 |
| Example 75 | BH 23 | BD 6 | 3.62 | 65.3 | 410 |
| Example 76 | BH 23 | BD 25 | 3.47 | 65.2 | 430 |
| Example 77 | BH 24 | BD 3 | 3.70 | 65.0 | 410 |
| Example 78 | BH 24 | BD 21 | 3.73 | 64.5 | 415 |
| Example 79 | BH 24 | BD 25 | 3.51 | 66.2 | 430 |
| Example 80 | BH 25 | BD 3 | 3.58 | 64.4 | 430 |
| Example 81 | BH 25 | BD 9 | 3.45 | 64.1 | 428 |
| Example 82 | BH 25 | BD 25 | 3.48 | 65.4 | 442 |
| Example 83 | BH 26 | BD 3 | 3.67 | 64.8 | 410 |
| Example 84 | BH 26 | BD 8 | 3.66 | 65.1 | 408 |
| Example 85 | BH 26 | BD 20 | 3.60 | 65.7 | 437 |
| Example 86 | BH 27 | BD 9 | 3.42 | 64.3 | 413 |
| Example 87 | BH 27 | BD 14 | 3.67 | 65.4 | 415 |
| Example 88 | BH 27 | BD 25 | 3.47 | 65.6 | 410 |
| Example 89 | BH 28 | BD 13 | 3.63 | 61.6 | 420 |
| Example 90 | BH 28 | BD 20 | 3.55 | 64.7 | 442 |
| Example 91 | BH 28 | BD 24 | 3.41 | 63.8 | 435 |
| Example 92 | BH 29 | BD 5 | 3.52 | 61.1 | 435 |
| Example 93 | BH 29 | BD 10 | 3.31 | 61.6 | 445 |
| Example 94 | BH 29 | BD 20 | 3.42 | 62.9 | 437 |
| Example 95 | BH 30 | BD 6 | 3.56 | 62.9 | 421 |
| Example 96 | BH 30 | BD 22 | 3.67 | 63.1 | 418 |
| Example 97 | BH 30 | BD 25 | 3.42 | 65.1 | 430 |
| Comparative Example 1 | BH A | BD A | 4.05 | 54.8 | 128 |
| Comparative Example 2 | BH B | BD A | 4.12 | 50.5 | 153 |
| Comparative Example 3 | BH C | BD A | 4.08 | 52.6 | 135 |
| Comparative Example 4 | BH A | BD 6 | 4.05 | 52.8 | 150 |
| Comparative Example 5 | BH B | BD 6 | 4.09 | 52.1 | 146 |
| Comparative Example 6 | BH C | BD 9 | 4.05 | 52.2 | 140 |
| Comparative Example 7 | BH 1 | BD A | 4.09 | 53.0 | 155 |
| Comparative Example 8 | BH 10 | BD A | 4.08 | 53.1 | 140 |
| Comparative Example 9 | BH 17 | BD A | 4.02 | 53.4 | 136 |
| Comparative Example 10 | BH 1 | BD B | 4.10 | 51.0 | 135 |
| Comparative Example 11 | BH 16 | BD B | 4.04 | 51.5 | 130 |
| Comparative Example 12 | BH 2 | BD C | 4.17 | 52.8 | 130 |
| Comparative Example 13 | BH 19 | BD C | 4.05 | 50.0 | 160 |
| Comparative Example 14 | BH 8 | BD D | 4.11 | 51.6 | 140 |
| Comparative Example 15 | BH 24 | BD D | 4.18 | 52.9 | 180 |

As identified in Table 1, it is seen that the devices of Examples 1 to 97 including both the compound represented by Chemical Formula 1 and the compound represented by Chemical Formula H of the present disclosure have properties of low voltage, high efficiency and long lifetime. Particularly, the devices including only one of Chemical Formula 1 and Chemical Formula H of the present disclosure (Comparative Examples 4 to 15) show equal or inferior properties compared to the devices not including Chemical Formula 1 and Chemical Formula H (Comparative Examples 1 to 3), however, the devices including both Chemical Formula 1 and Chemical Formula H of the present disclosure (Examples 1 to 97) show excellent properties.

## Claims

1. An organic light emitting device comprising:
an anode;
a cathode; and
an organic material layer between the anode and the cathode,
wherein the organic material layer includes a light emitting layer, and
the light emitting layer includes a compound represented by the following Chemical Formula 1; and a compound represented by the following Chemical Formula H: 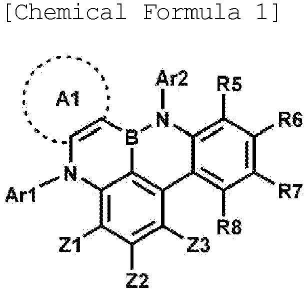 wherein in Chemical Formula 1,
A1 is one selected from the group consisting of a substituted or unsubstituted aromatic hydrocarbon ring; a substituted or unsubstituted aliphatic hydrocarbon ring; a substituted or unsubstituted heteroring; and a fused ring thereof,
R5 to R8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among R5 to R8 to form a substituted or unsubstituted ring,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to A1 to form a substituted or unsubstituted ring,
Ar2 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R5 to form a substituted or unsubstituted ring,
when Ar2 and R5 form a benzoxazine ring, the benzoxazine ring is an unsubstituted benzoxazine ring,
Z1 to Z3 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among Z1 to Z3 to form a substituted or unsubstituted ring; and
when Ar1 is a phenyl group, and A1 is substituted or unsubstituted benzene, and R6 to R8 are hydrogen, and adjacent groups among Z1 to Z3 do not bond to each other to form a substituted or unsubstituted ring, and Ar2 and R5 form an indole group at the same time, the indole group is a substituted indole group, 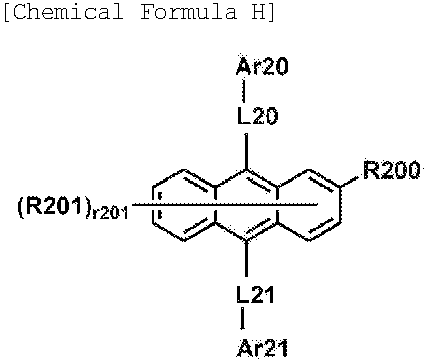 wherein in Chemical Formula H,
L20 and L21 are the same as or different from each other, and each independently a direct bond; or a substituted or unsubstituted arylene group,
Ar20 and Ar21 are the same as or different from each other, and each independently hydrogen; deuterium; a substituted or unsubstituted aryl group; or a substituted or unsubstituted heterocyclic group,
at least one of Ar20 and Ar21 is a substituted or unsubstituted heterocyclic group,
R200 and R201 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r201 is an integer of 1 to 7, and when r201 is 2 or greater, two or more R201s are the same as or different from each other.

2. The organic light emitting device of Claim 1, wherein the compound of Chemical Formula 1 is represented by the following Chemical Formula 1-1: 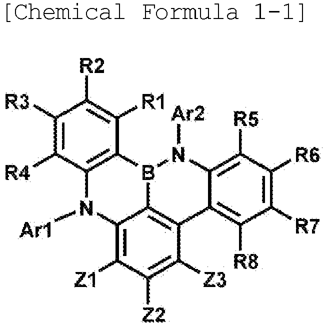 wherein in Chemical Formula 1-1,
R5 to R8, Ar2 and Z1 to Z3 have the same definitions as in Chemical Formula 1,
R1 to R4 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups to form one selected from the group consisting of a substituted or unsubstituted aromatic hydrocarbon ring; a substituted or unsubstituted aliphatic hydrocarbon ring; a substituted or unsubstituted heteroring; and a fused ring thereof,
Ar1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, or bonds to R4 to form a substituted or unsubstituted ring, and
when Ar1 is a phenyl group, and R1 to R4 and R6 to R8 are hydrogen, and adjacent groups among Z1 to Z3 do not bond to each other to form a substituted or unsubstituted ring, and Ar2
and R5 form an indole group at the same time, the indole group is a substituted indole group.

3. The organic light emitting device of Claim 1, wherein the compound of Chemical Formula 1 is represented by the following Chemical Formula 1-2: 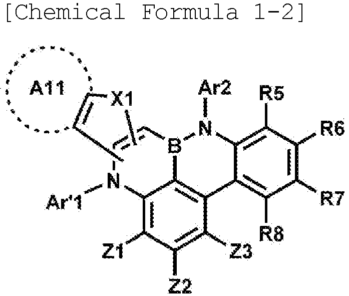 wherein in Chemical Formula 1-2,
R5 to R8, Ar2 and Z1 to Z3 have the same definitions as in Chemical Formula 1,
X1 is CRR'; O; or S,
A11 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
R and R' are the same as or different from each other, and each independently a substituted or unsubstituted alkyl group; a substituted or unsubstituted aryl group; or a substituted or unsubstituted heterocyclic group, or bond to each other to form a substituted or unsubstituted ring.

4. The organic light emitting device of Claim 2, wherein the compound of Chemical Formula 1-1 is represented by one of the following Chemical Formulae 1-1-1 to 1-1-36: 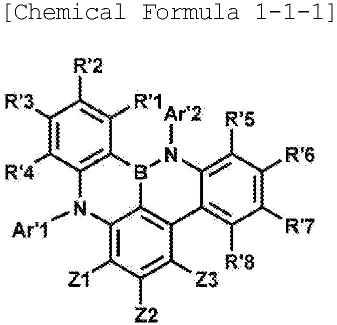 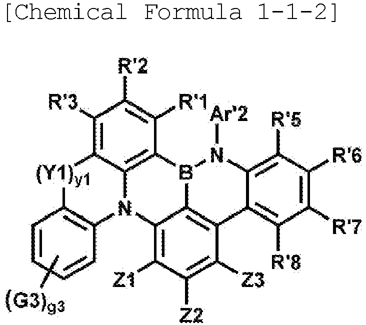 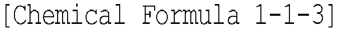 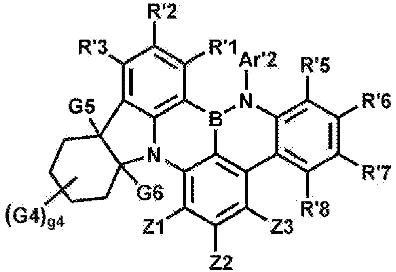 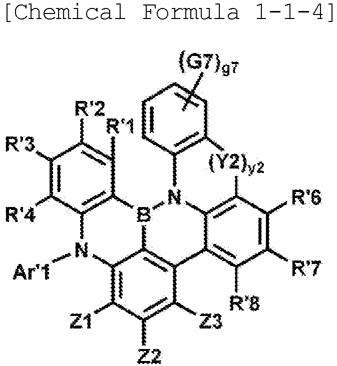 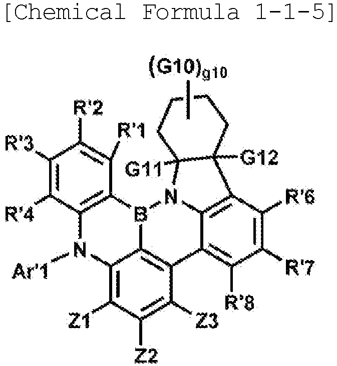 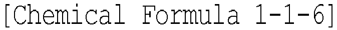 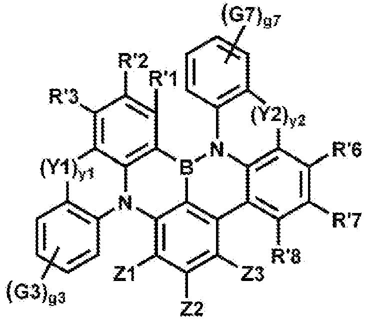 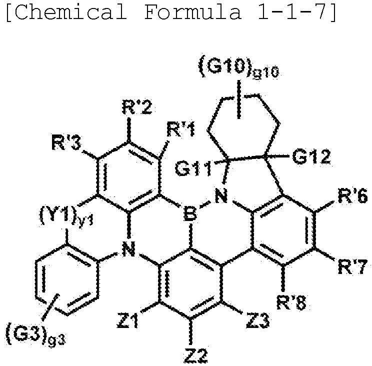 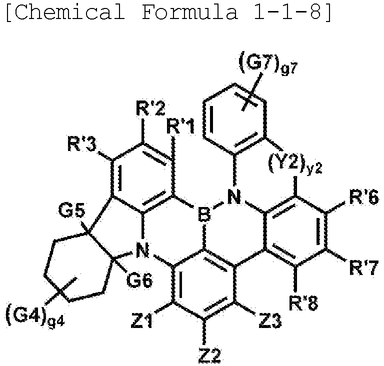 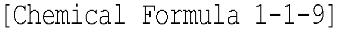 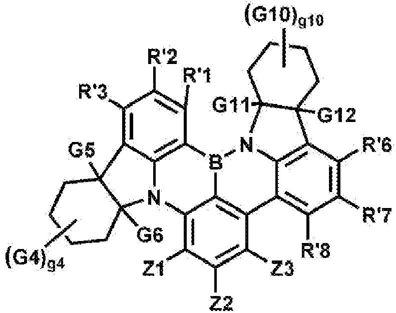 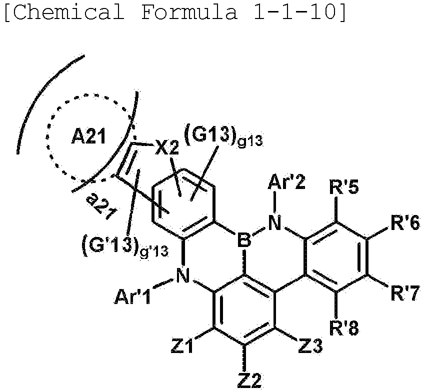 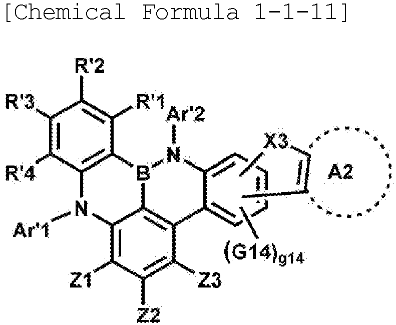 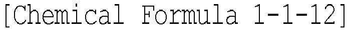 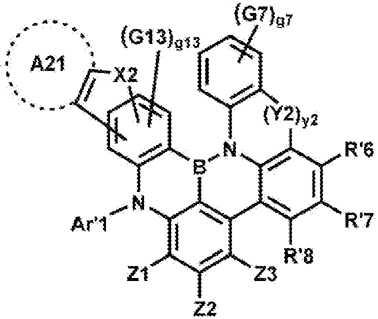 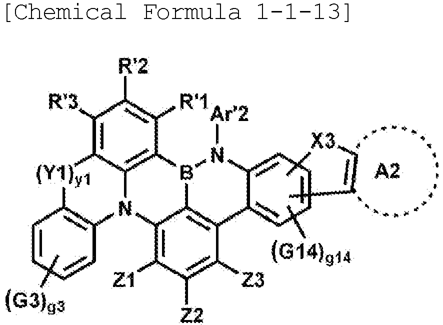 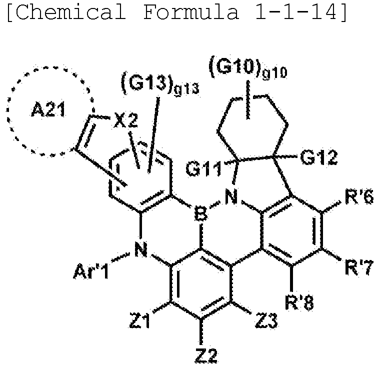 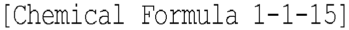 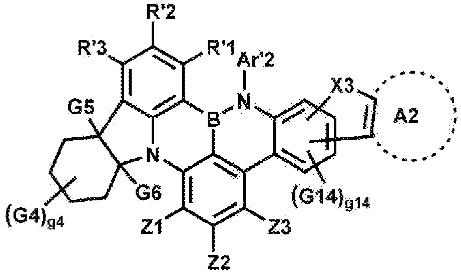 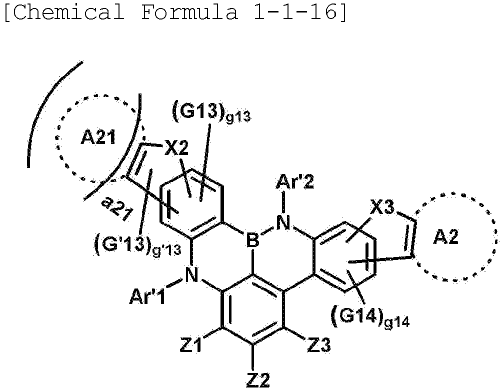 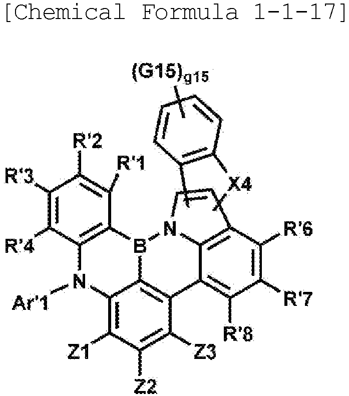 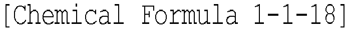 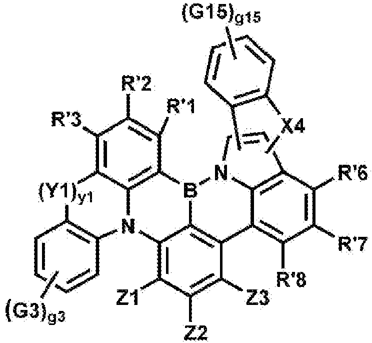 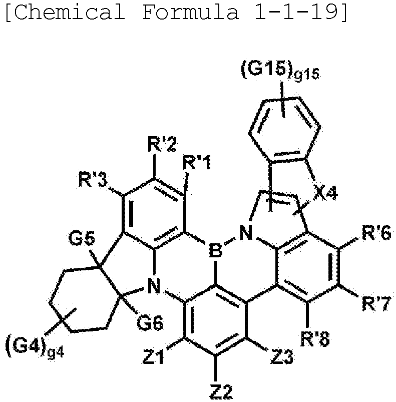 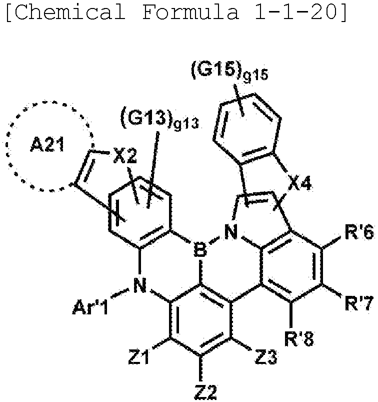 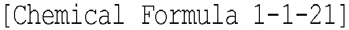 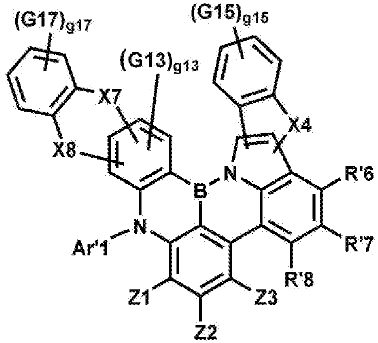 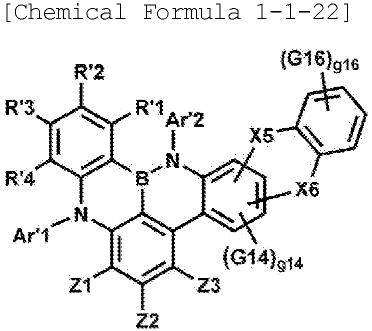 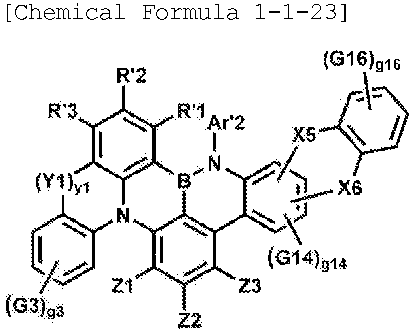 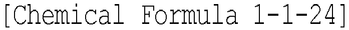 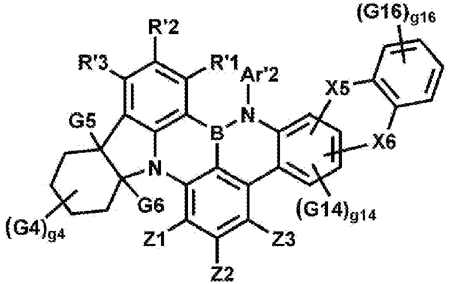 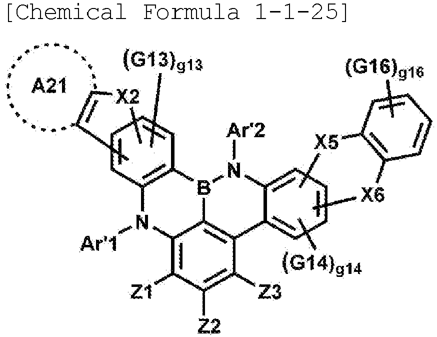 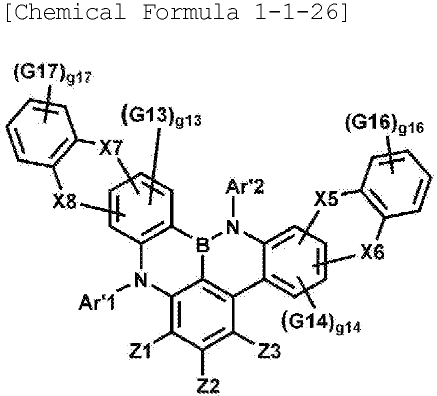 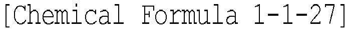 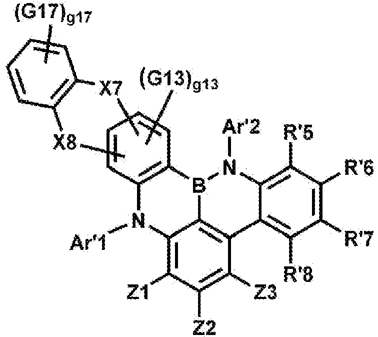 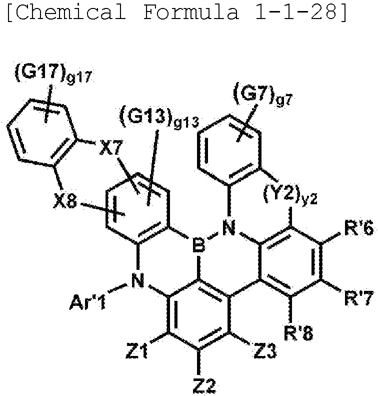 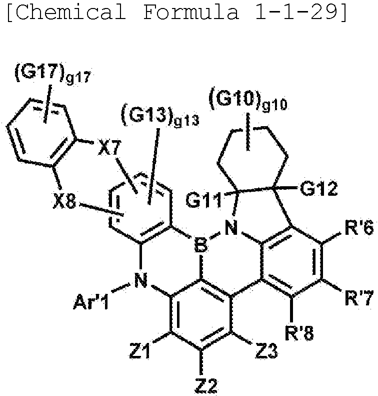 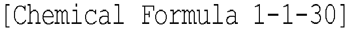 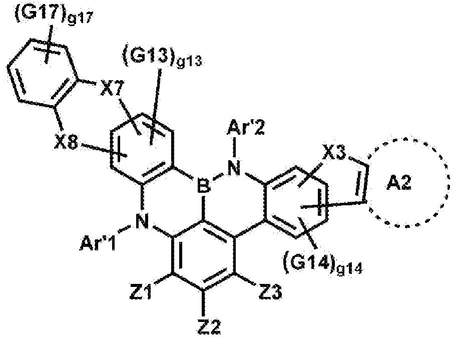 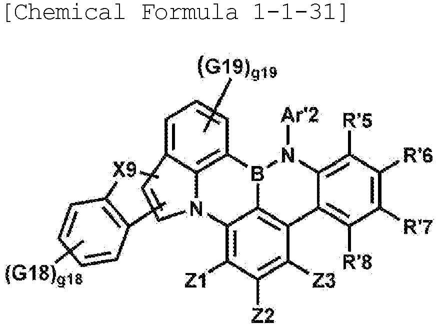 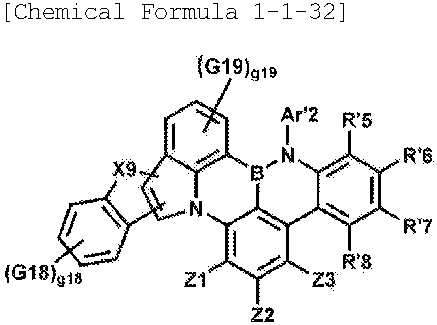 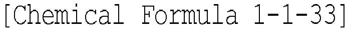 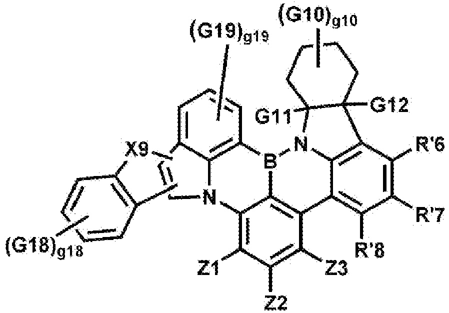 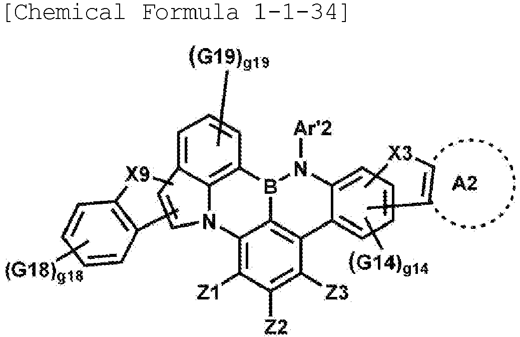 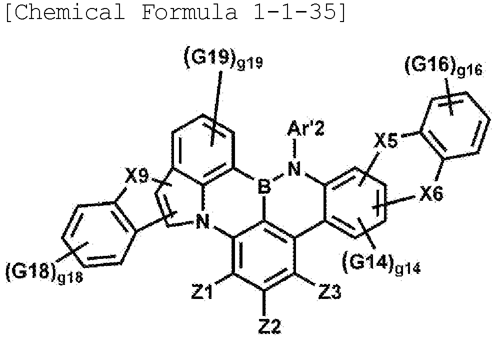 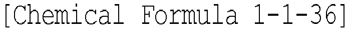 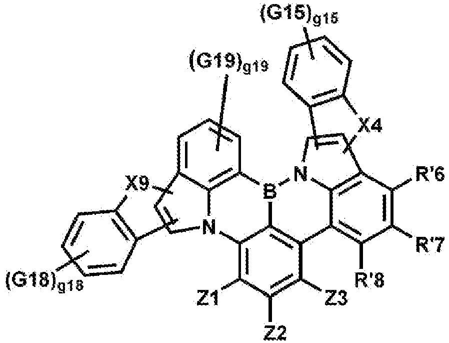 wherein in Chemical Formulae 1-1-1 to 1-1-36,
Z1 to Z3 have the same definitions as in Chemical Formula 1-1,
X2 to X9 are the same as or different from each other, and each independently CRR'; NR"; O; or S,
Y1 and Y2 are the same as or different from each other, and each independently CG1G2; SiG8G9; NG101; O; or S,
y1 is 0 or 1, and when y1 is 0, Y1 is a direct bond,
y2 is 0 or 1, and when y2 is 0, Y2 is a direct bond, R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'1 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1 to G19, G'13 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g3, g7, and g15 to g18 are each an integer of 1 to 4,
g4 and g10 are each an integer of 1 to 8,
g13 and g14 are each 1 or 2,
g'13 is an integer of 0 to 2,
g19 is an integer of 1 to 3,
a21 is 0 or 1,
when g3, g4, g7, g10, and g15 to g19 are each 2 or greater, substituents in the two or more parentheses are the same as or different from each other,
when g13, g'13 and g14 are each 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
A2 and A21 are the same as or different from each other, and each independently a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring, and
wherein in Chemical Formulae 1-1-4, 1-1-6, 1-1-8, 1-1-12, 1-1-28 and 1-1-32,
when y2 is 1 and Y2 is O, G7 and R'6 to R'8 are hydrogen.

5. The organic light emitting device of Claim 3, wherein the compound of Chemical Formula 1-2 is represented by one of the following Chemical Formulae 1-2-1 to 1-2-6: 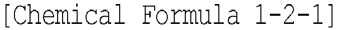 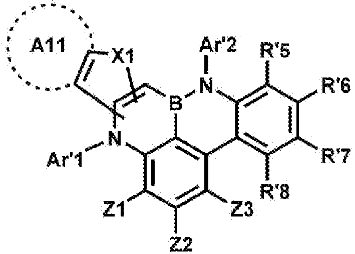 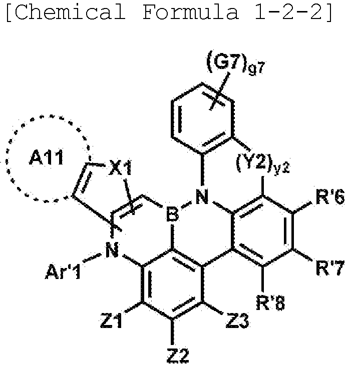 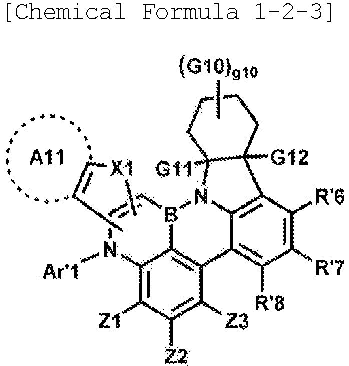 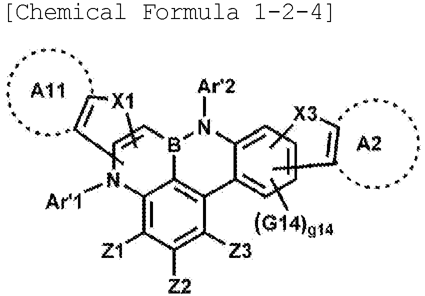 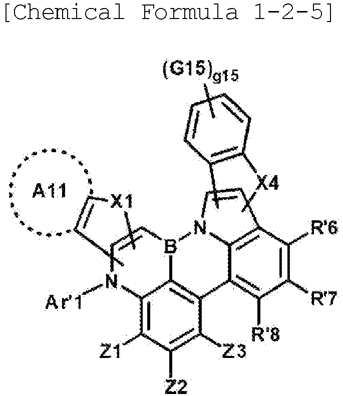 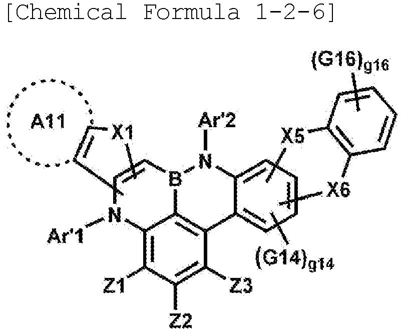 wherein in Chemical Formulae 1-2-1 to 1-2-6,
X1, A11 and Z1 to Z3 have the same definitions as in Chemical Formula 1-2,
X3 to X6 are the same as or different from each other, and each independently CRR'; NR"; O or S,
Y2 is CG1G2; SiG8G9; NG101; O; or S,
y2 is 0 or 1, and when y2 is 0, Y2 is a direct bond,
A2 is a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
Ar'1 is a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group,
R, R' and R" are the same as or different from each other, and each independently a substituted or unsubstituted alkyl group; a substituted or unsubstituted aryl group; or a substituted or unsubstituted heterocyclic group, or bond to each other to form a substituted or unsubstituted ring,
R'5 to R'8 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group,
G1, G2, G7 to G12, G14, G15, G16 and G101 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or adjacent groups among G1, G2, G7 to G12, G14, G15, G16 and G101 bond to each other to form a substituted or unsubstituted aromatic hydrocarbon ring; a substituted or unsubstituted aliphatic hydrocarbon ring; or a substituted or unsubstituted fused ring of an aromatic hydrocarbon ring and an aliphatic hydrocarbon ring,
g7, g15 and g16 are each an integer of 1 to 4,
g10 is an integer of 1 to 8,
g14 is 1 or 2,
when g7, g10, g15 and g16 are each 2 or greater, substituents in the two or more parentheses are the same as or different from each other,
when g14 is 2, substituents in the two parentheses are the same as or different from each other,
Ar'1 and Ar'2 are the same as or different from each other, and each independently a substituted or unsubstituted cycloalkyl group; a substituted or unsubstituted aryl group; a substituted or unsubstituted fused ring group of an aromatic hydrocarbon ring and an aliphatic hydrocarbon ring; or a substituted or unsubstituted heterocyclic group, and
wherein in Chemical Formula 1-2-2,
when y2 is 1 and Y2 is O, G7 and R'6 to R'8 are hydrogen.

6. The organic light emitting device of Claim 1, wherein the compound of Chemical Formula 1 is represented by one of the following Chemical Formulae 1-3 to 1-5: 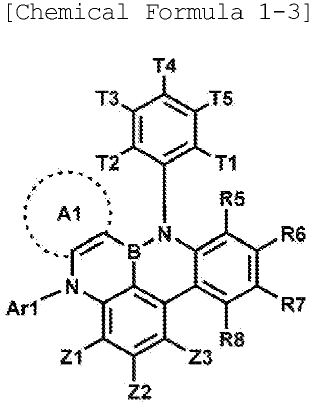 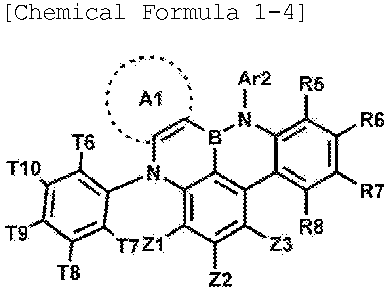 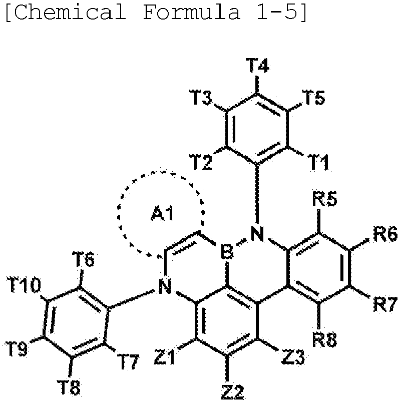 wherein in Chemical Formulae 1-3 to 1-5,
Ar1, Ar2, A1, R5 to R8 and Z1 to Z3 have the same definitions as in Chemical Formula 1,
T1 to T10 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among T1 to T10 to form a substituted or unsubstituted ring,
at least one of T1 and T2 is a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, and
at least one of T6 and T7 is a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group.

7. The organic light emitting device of Claim 1, wherein adjacent groups among Z1 to Z3 bond to each other to form a ring represented by the following Chemical Formula C-1 or C-2: 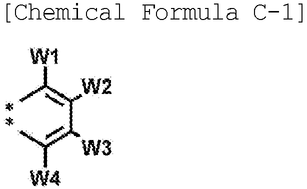 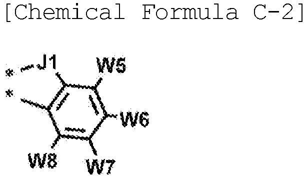 wherein in Chemical Formulae C-1 and C-2,
J1 is O; S; NQ7; CQ8Q9; or SiQ10Q11,
W1 to W8 and Q7 to Q11 are the same as or different from each other, and each independently hydrogen; deuterium; a halogen group; a cyano group; a substituted or unsubstituted alkyl group; a substituted or unsubstituted cycloalkyl group; a substituted or unsubstituted alkoxy group; a substituted or unsubstituted arylalkyl group; a substituted or unsubstituted aryloxy group; a substituted or unsubstituted silyl group; a substituted or unsubstituted amine group; a substituted or unsubstituted aryl group; a substituted or unsubstituted fused ring group of an aromatic hydrocarbon ring and an aliphatic hydrocarbon ring; or a substituted or unsubstituted heterocyclic group, or bond to adjacent groups among W1 to W8 and Q7 to Q11 to form a substituted or unsubstituted ring, and
* is a site bonding to Chemical Formula 1.

8. The organic light emitting device of Claim 1, wherein at least one of Ar20 and Ar21 is represented by the following Chemical Formula Het1: 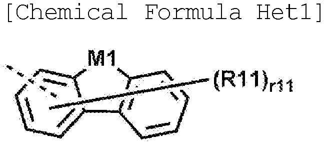 wherein in Chemical Formula Het1,
dotted line is a bond to Chemical Formula H,
M1 is O or S,
R11 is hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, or bonds to adjacent groups to form a substituted or unsubstituted ring, and
r11 is an integer of 0 to 7, and when r11 is 2 or greater, R11s are the same as or different from each other.

9. The organic light emitting device of Claim 8, wherein Chemical Formula Het1 is represented by one of the following Chemical Formulae Het2 to Het4: 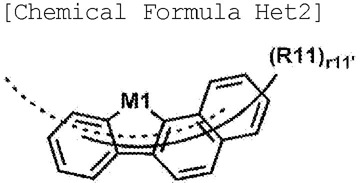 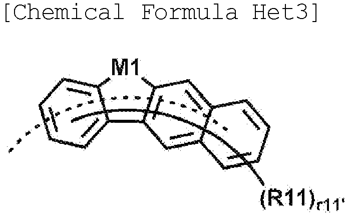 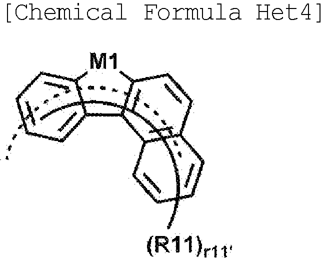 wherein in Chemical Formulae Het2 to Het4,
dotted line and M1 have the same definitions as in Chemical Formula Het1,
R11 is hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, and
r11' is an integer of 0 to 9, and when r11' is 2 or greater, R11s are the same as or different from each other.

10. The organic light emitting device of Claim 1, wherein the compound of Chemical Formula H is represented by one of the following Chemical Formulae H-1 to H-4: 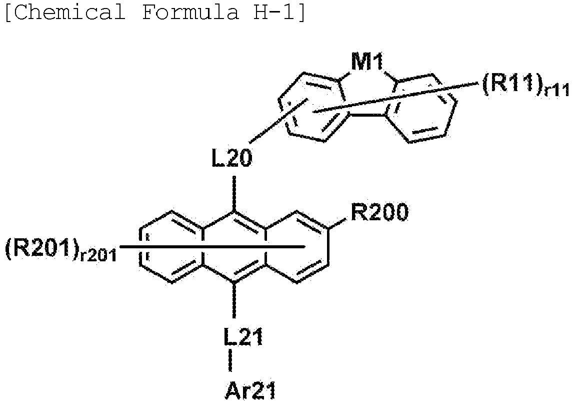 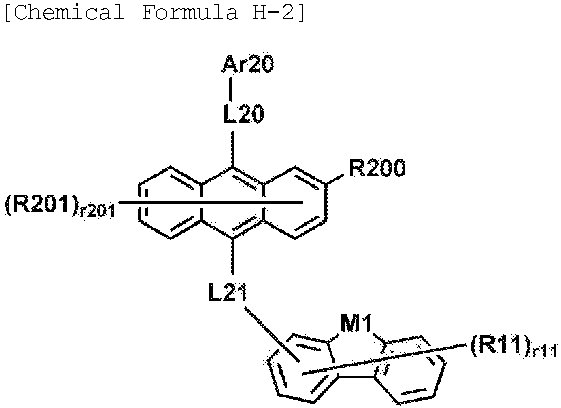 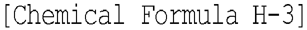 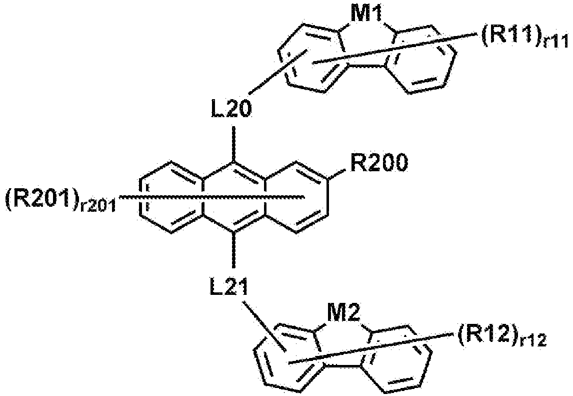 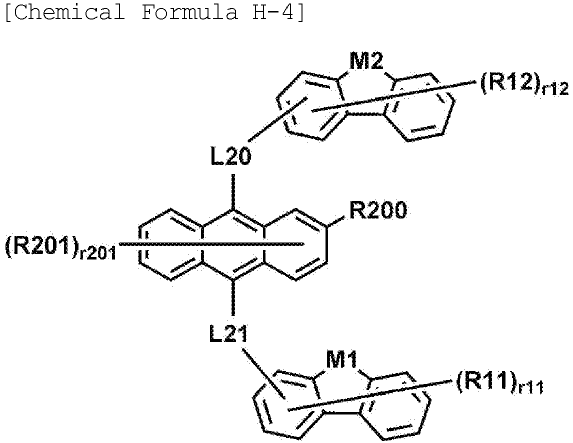 wherein in Chemical Formulae H-1 to H-4,
L20, L21, R200, R201 and r201 have the same definitions as in Chemical Formula H,
M1 is O or S,
M2 is O; S; or NR13,
Ar20 and Ar21 are the same as or different from each other, and each independently a substituted or unsubstituted aryl group,
R11 to R13 are the same as or different from each other, and each independently hydrogen; deuterium; a halogen group; a substituted or unsubstituted alkyl group; a substituted or unsubstituted cycloalkyl group; a substituted or unsubstituted aryl group; or a substituted or unsubstituted heterocyclic group, or bond to adjacent groups among R11 to R13 to form a substituted or unsubstituted ring, and
r11 and r12 are an integer of 0 to 7, and when r11 and r12 are 2 or greater, substituents in the parentheses are the same as or different from each other.

11. The organic light emitting device of Claim 1, wherein the compound of Chemical Formula 1 is one selected from the following compounds:

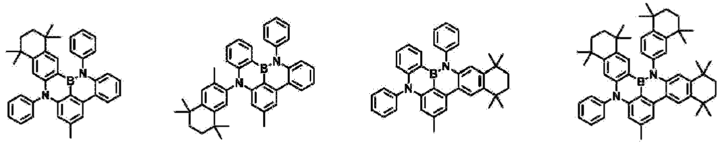

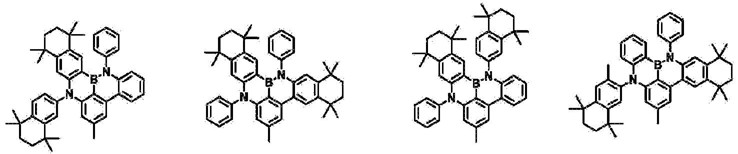

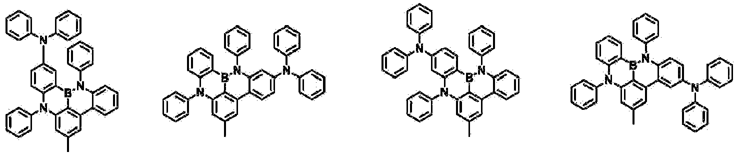

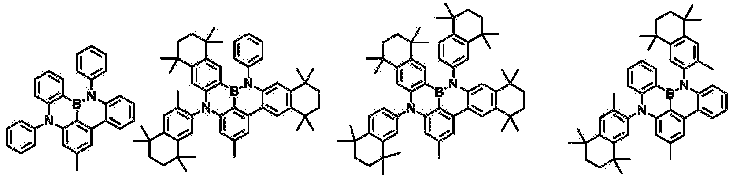

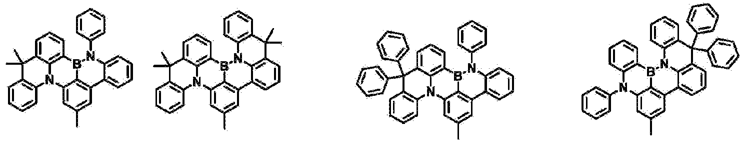

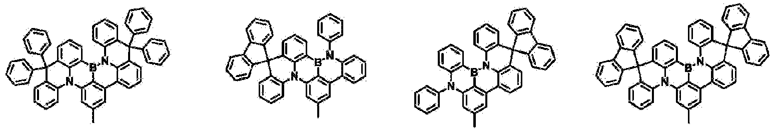

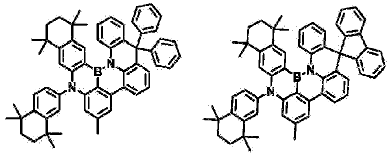

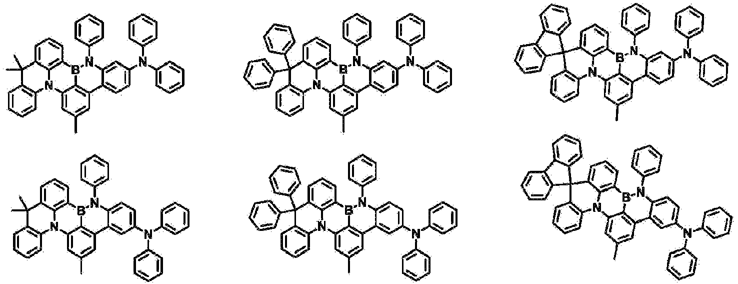

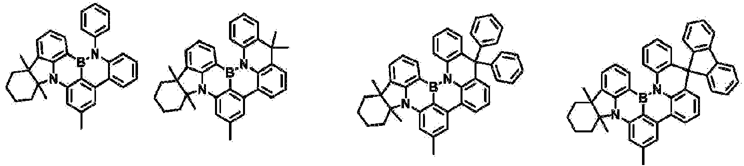

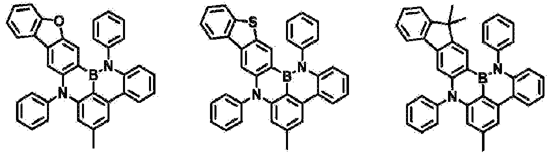

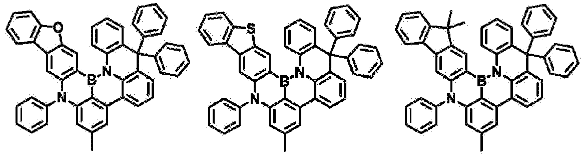

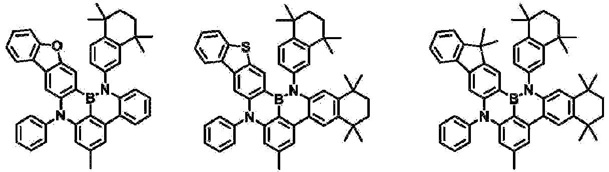

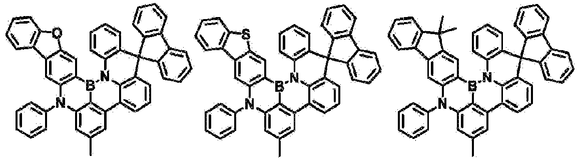

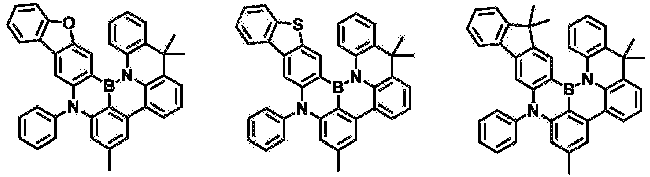

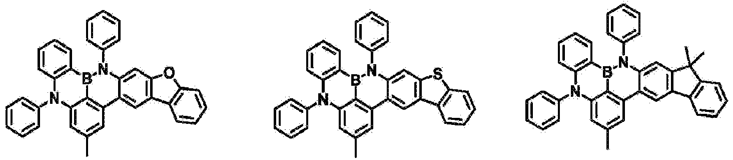

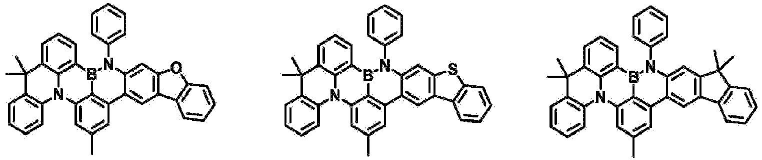

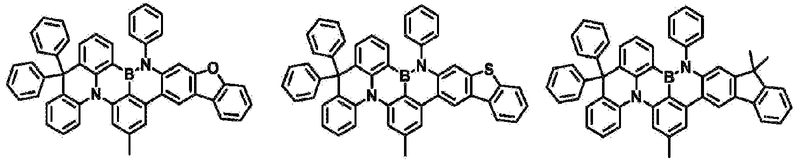

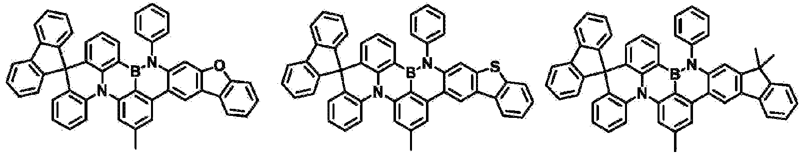

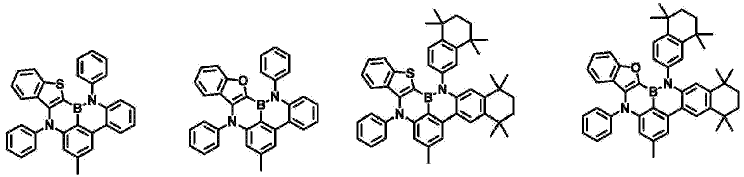

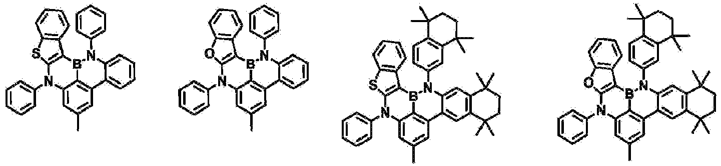

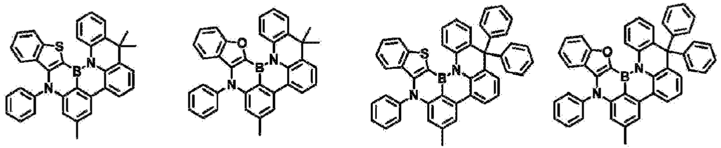

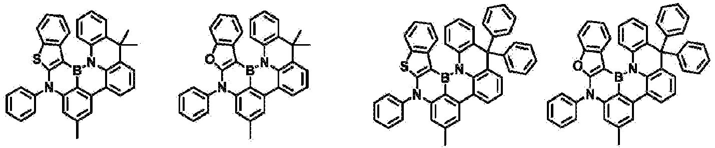

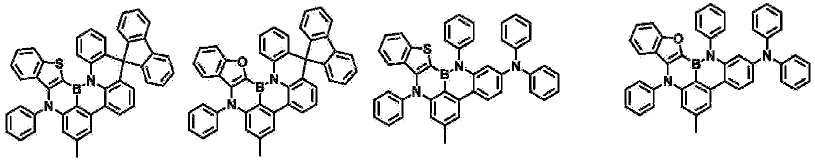

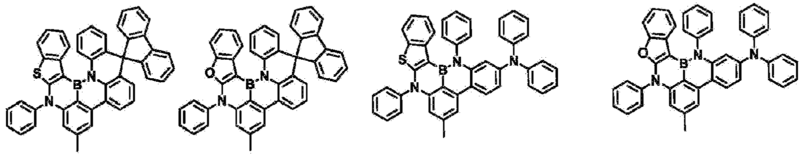

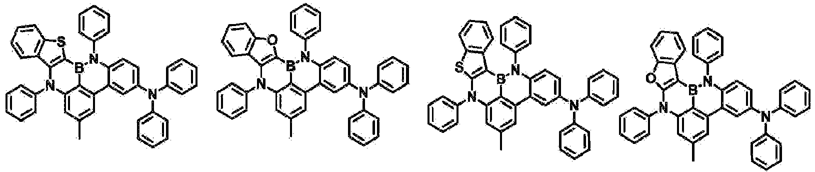

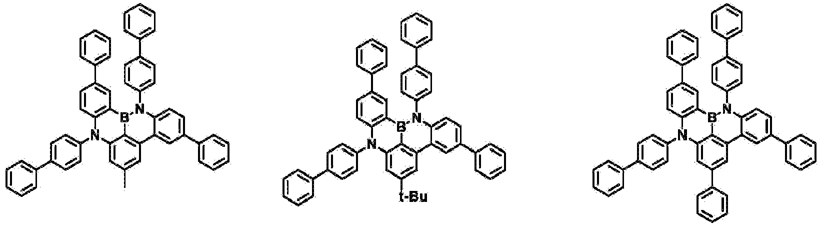

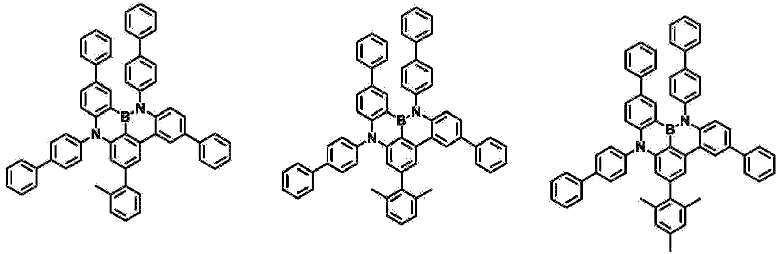

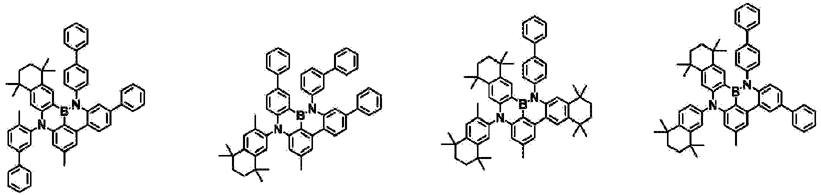

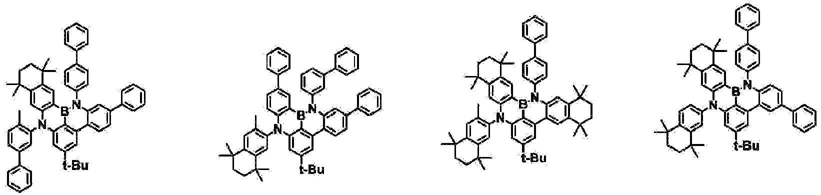

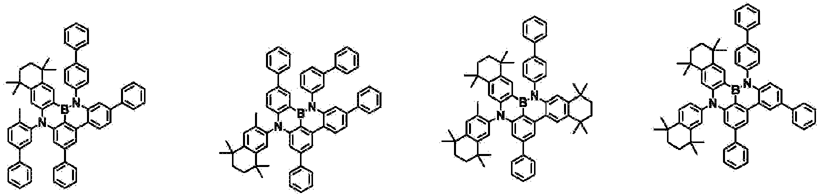

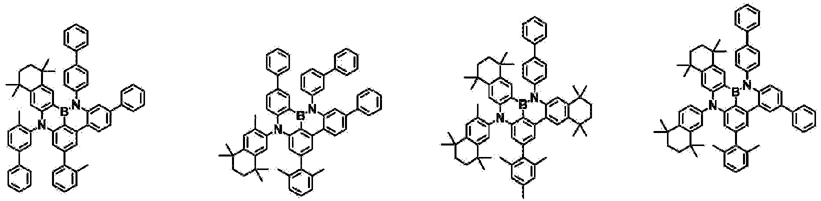

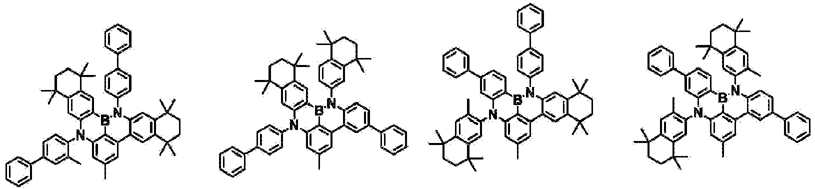

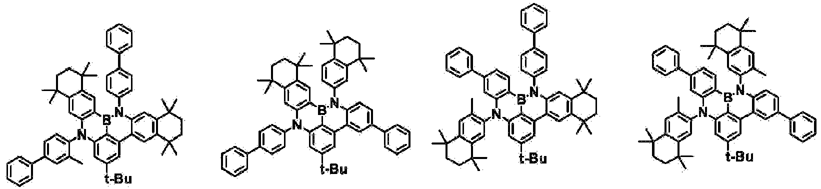

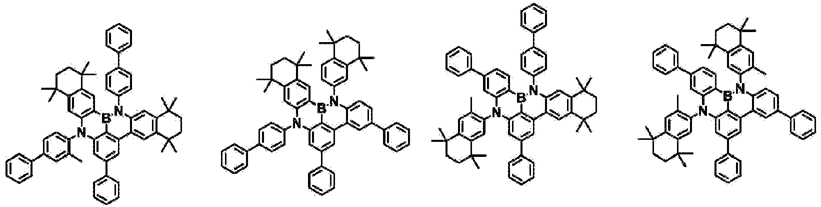

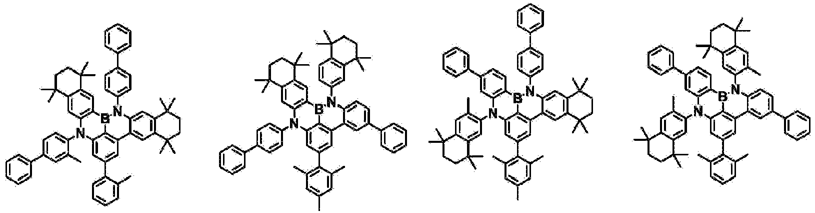

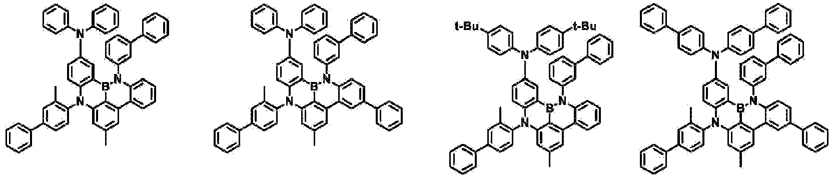

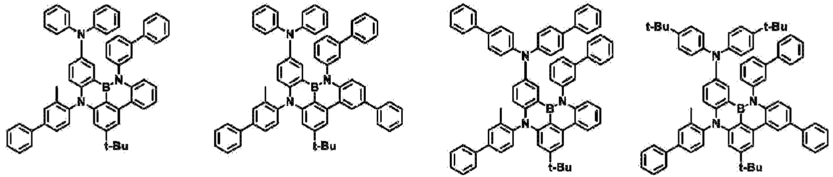

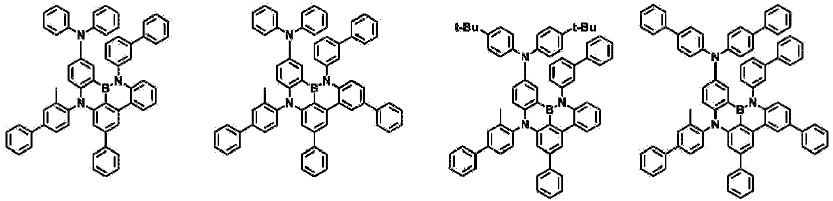

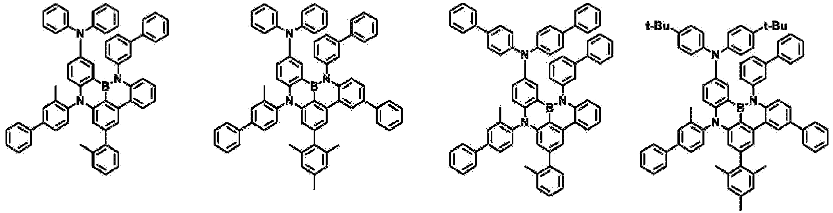

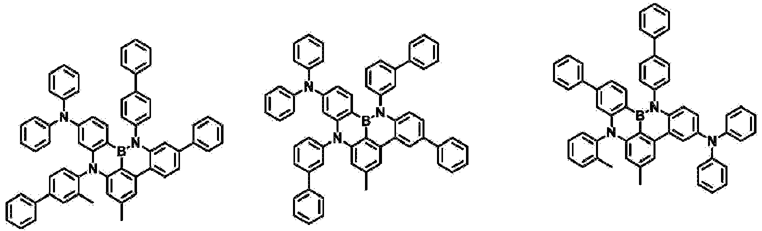

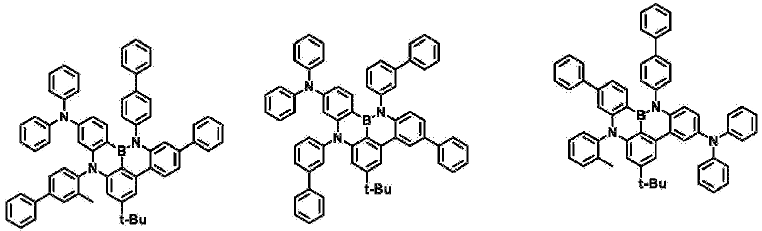

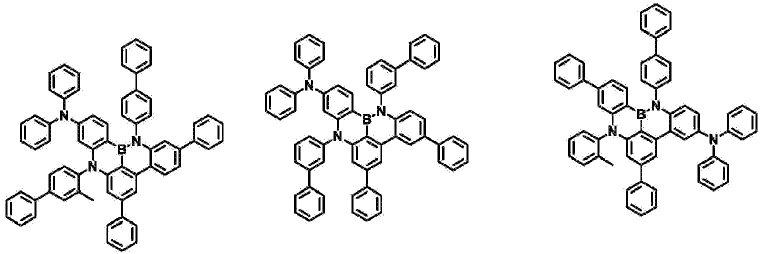

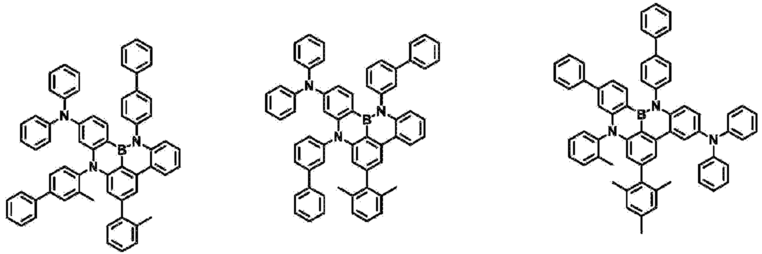

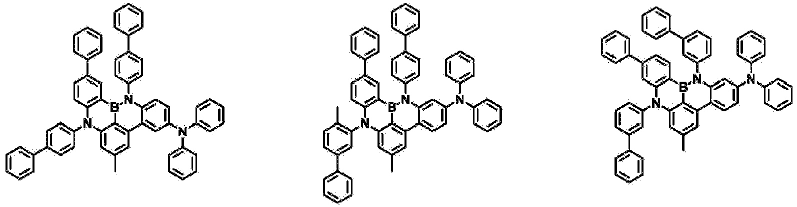

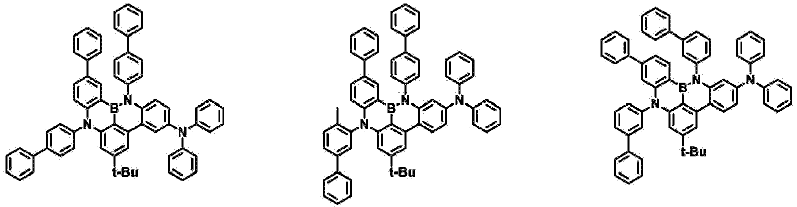

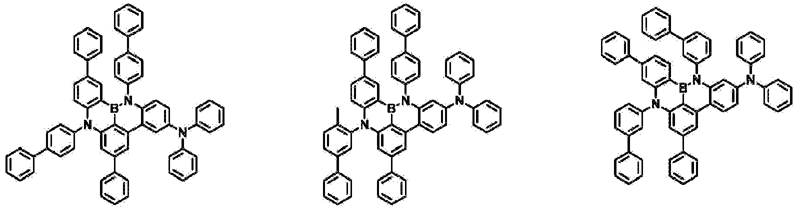

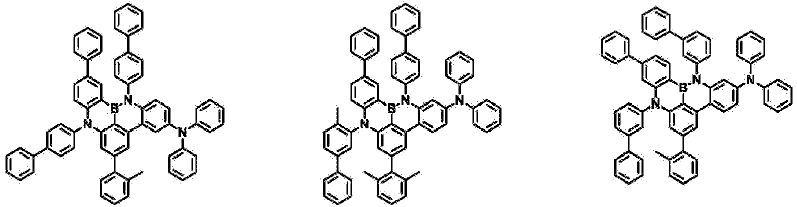

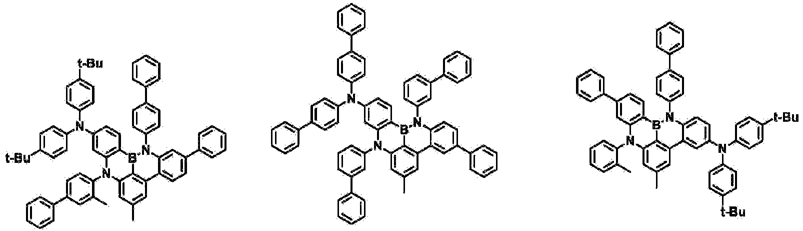

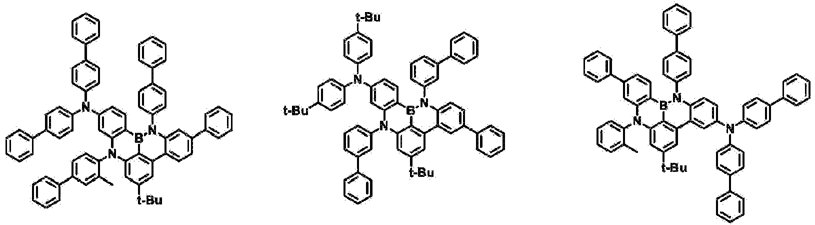

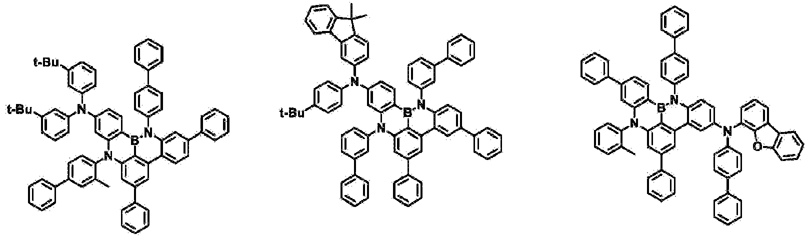

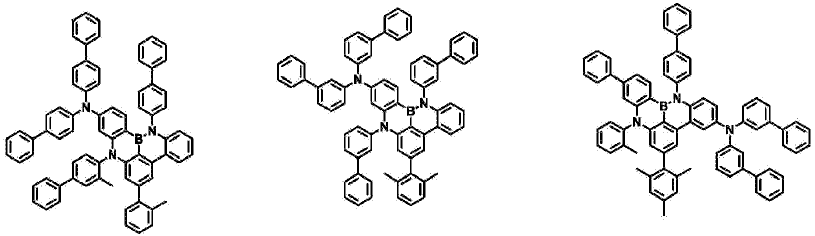

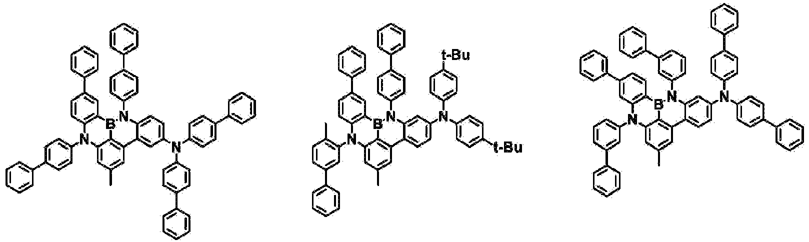

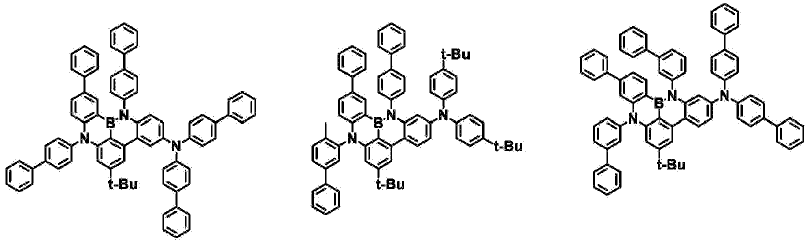

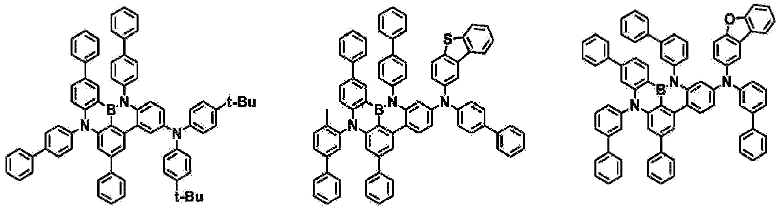

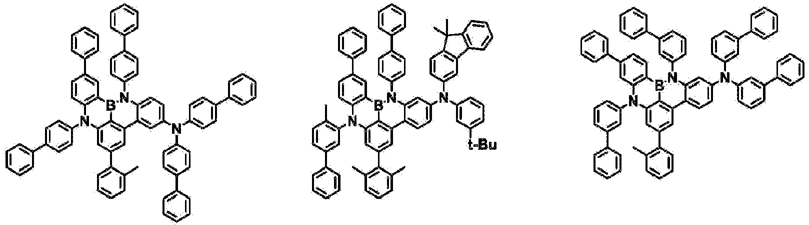

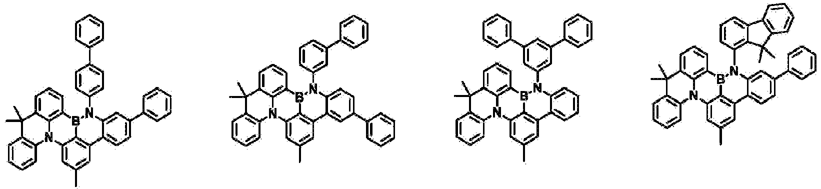

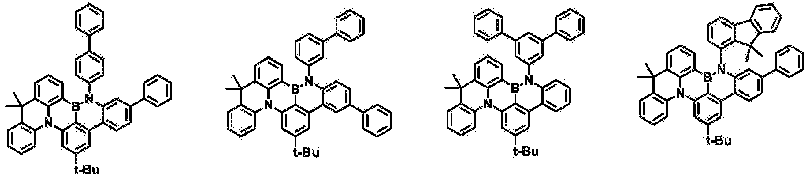

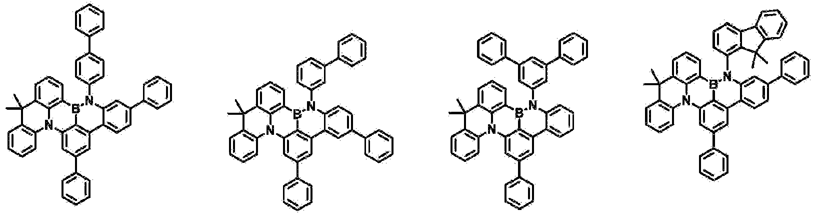

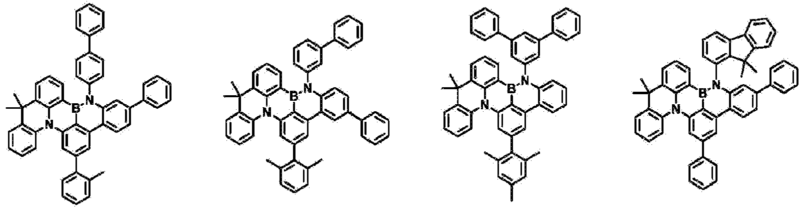

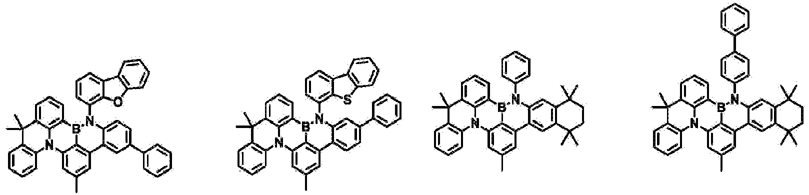

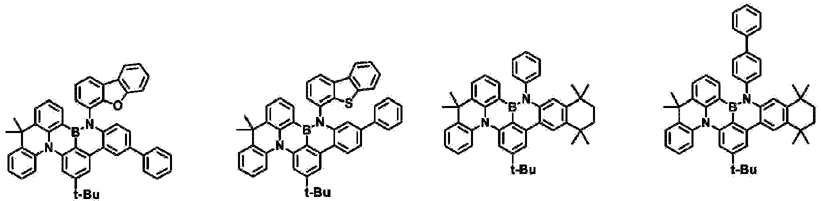

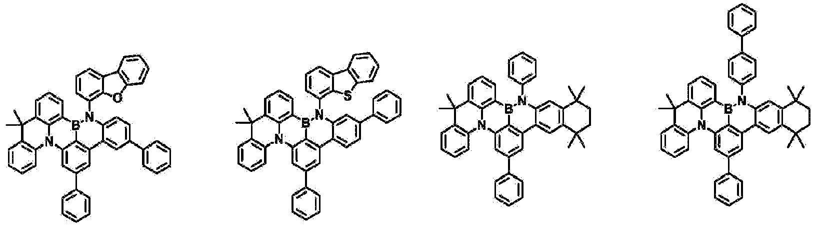

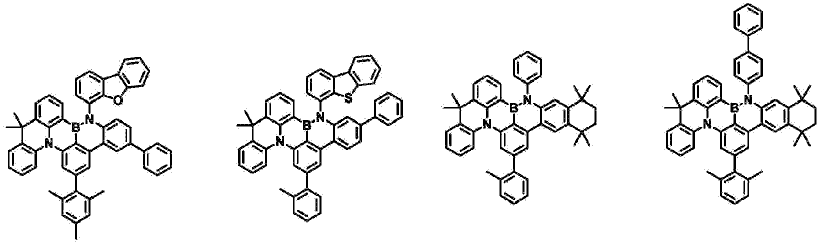

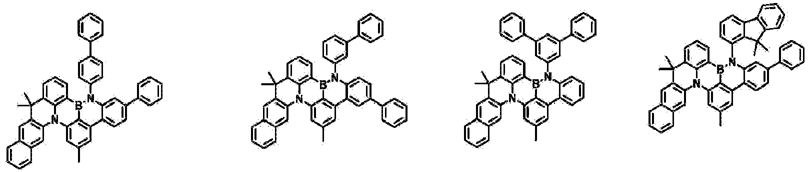

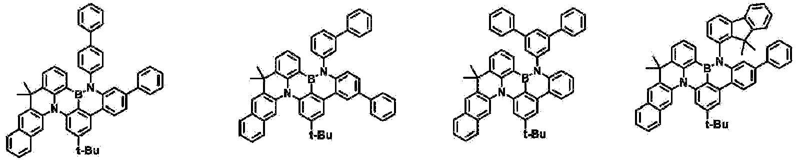

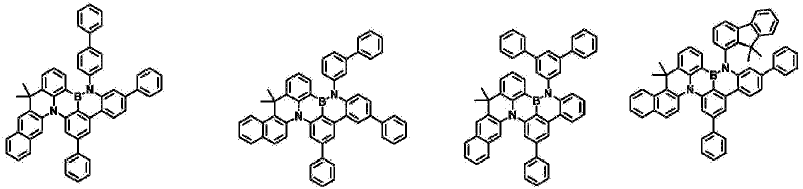

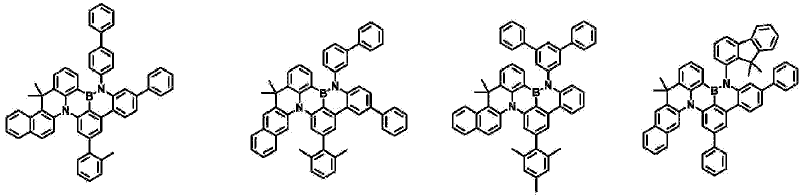

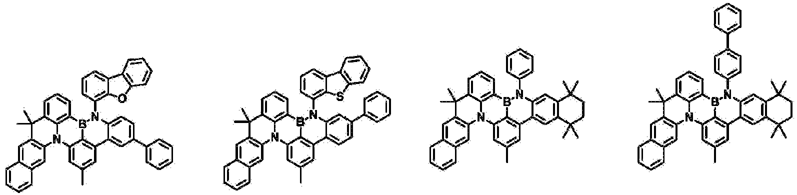

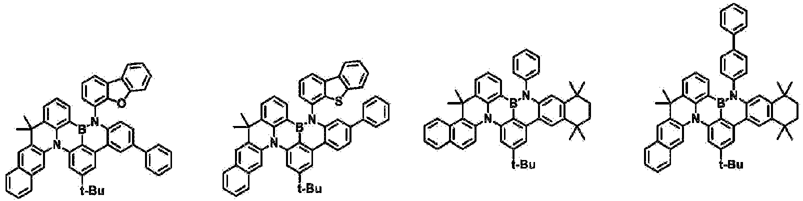

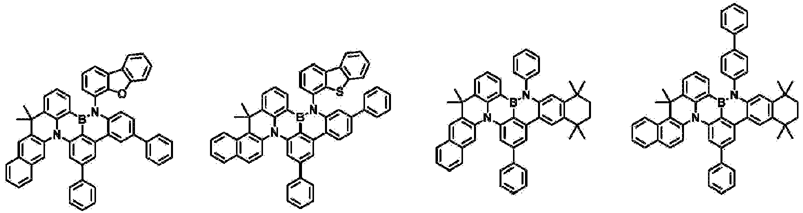

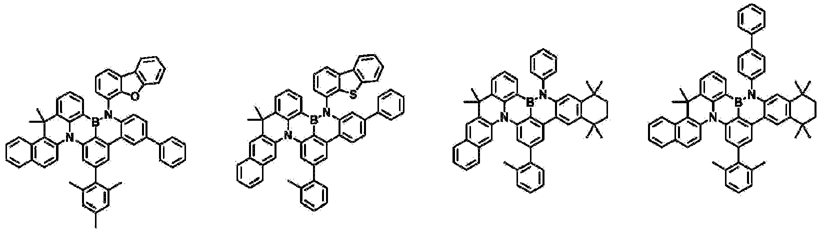

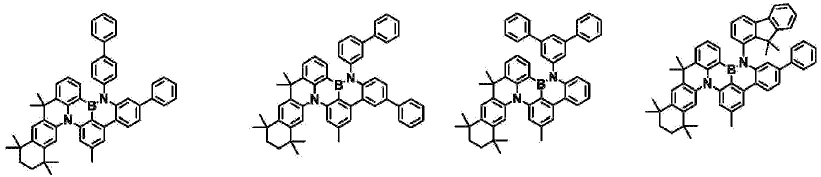

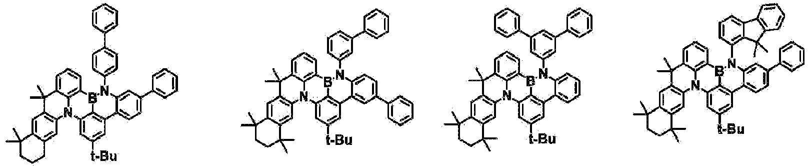

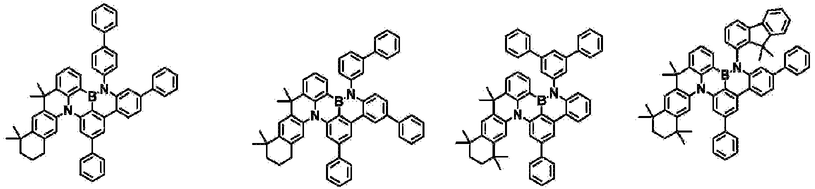

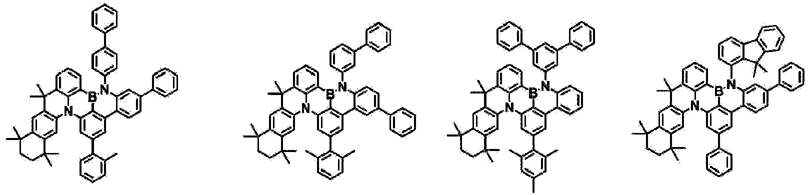

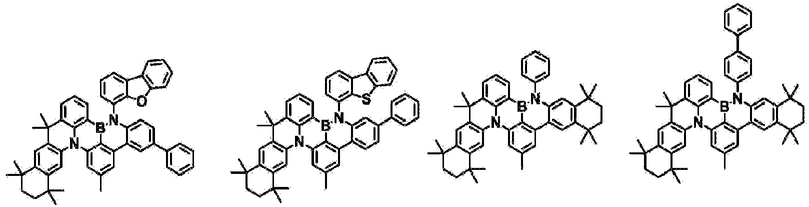

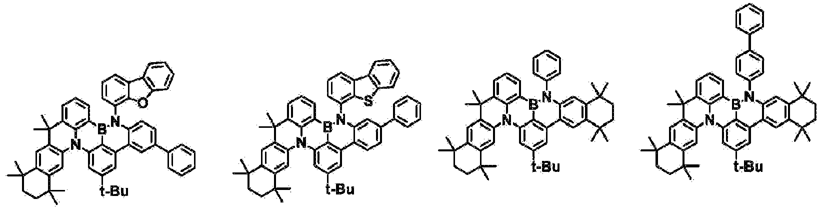

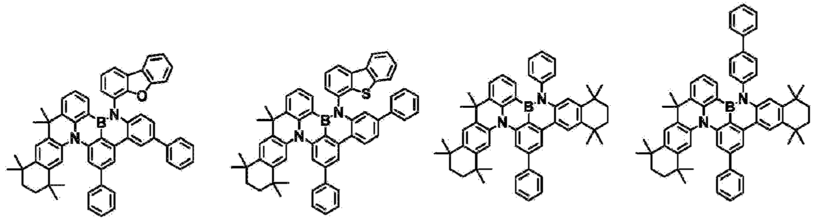

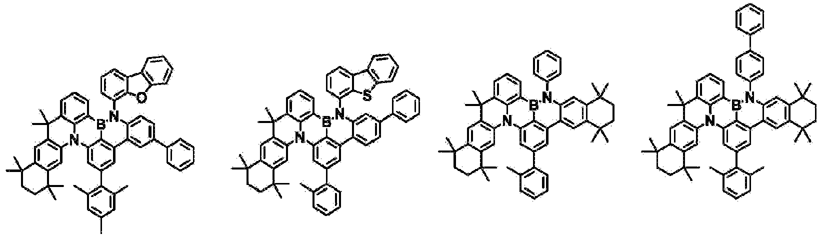

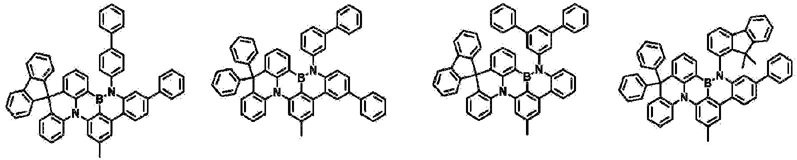

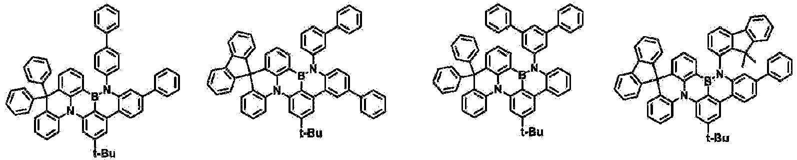

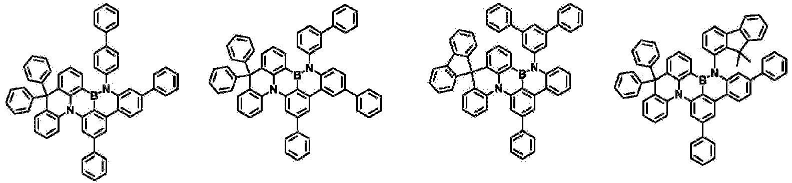

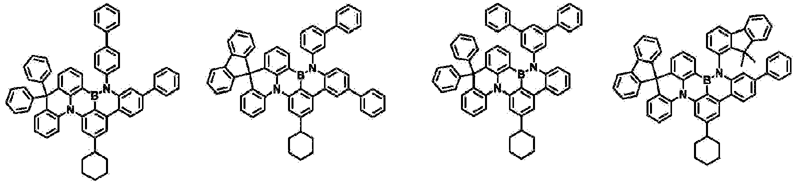

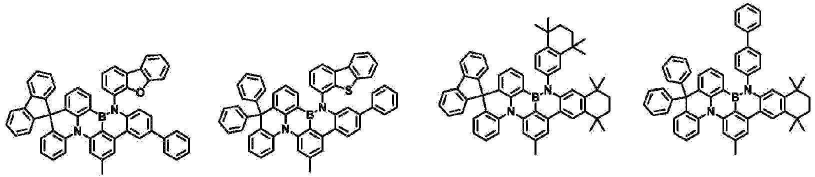

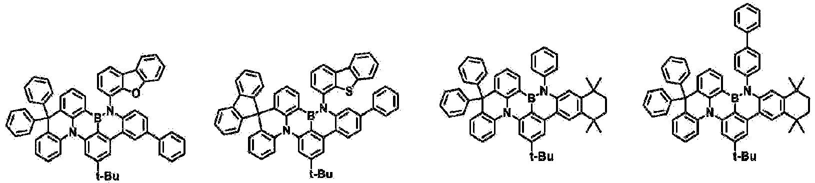

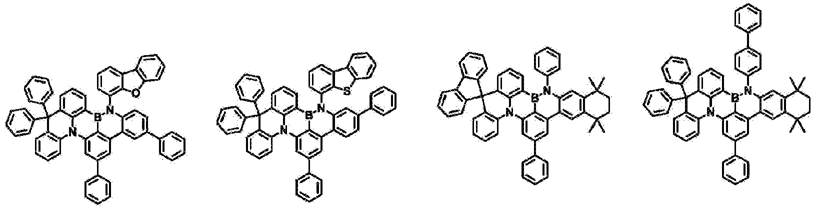

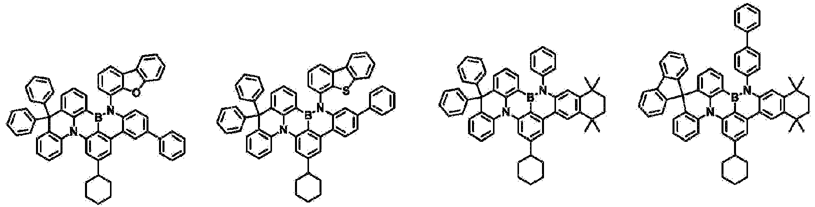

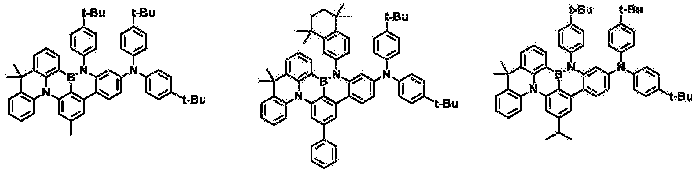

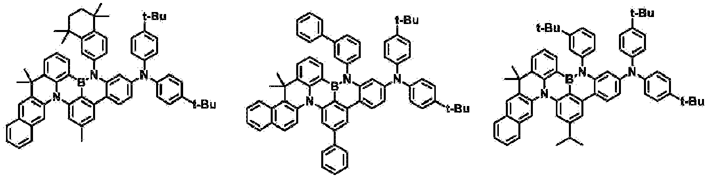

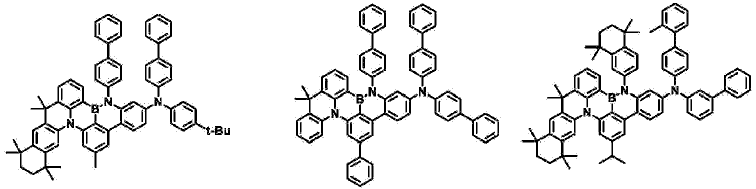

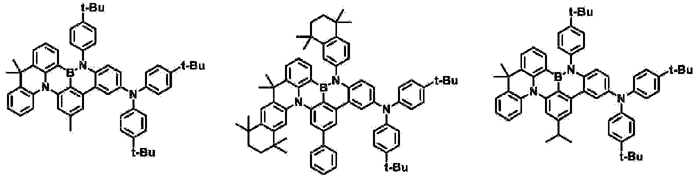

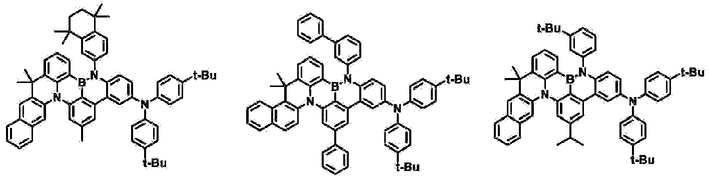

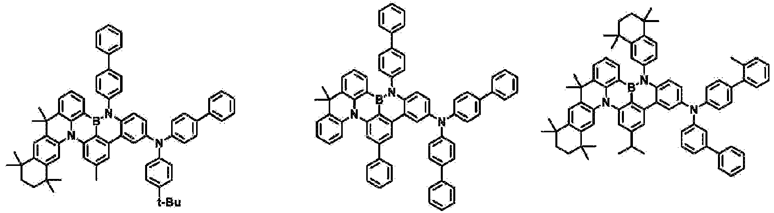

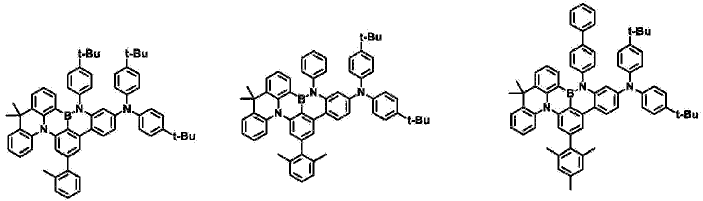

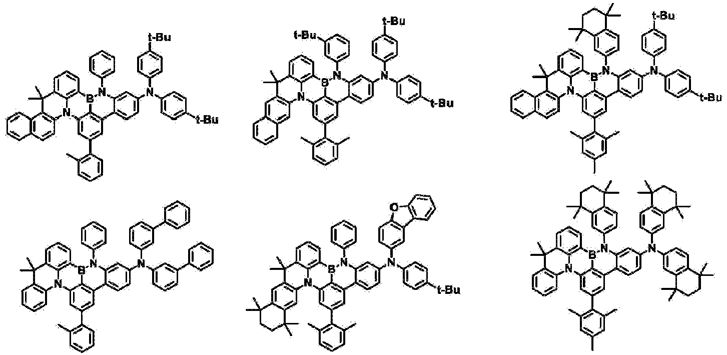

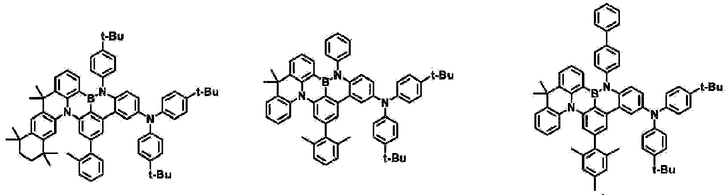

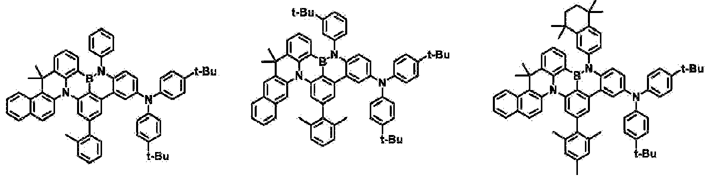

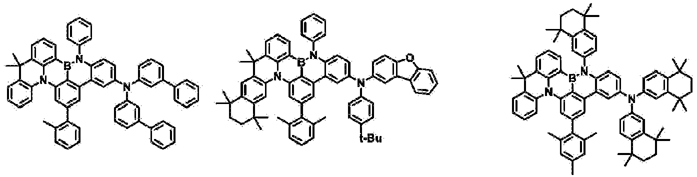

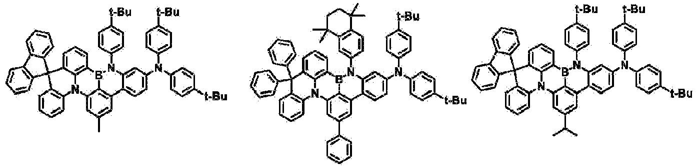

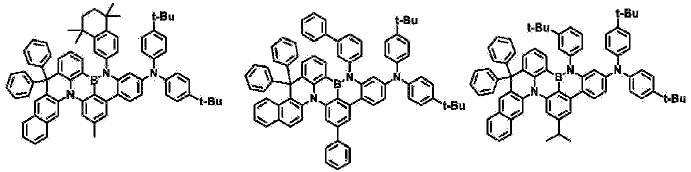

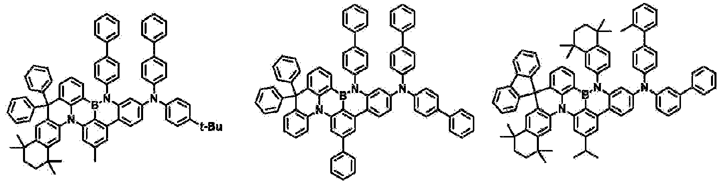

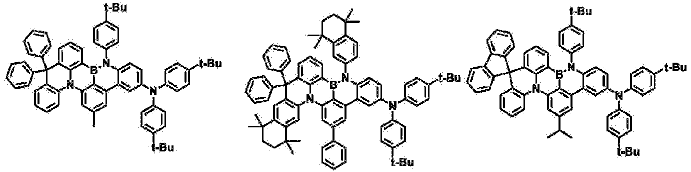

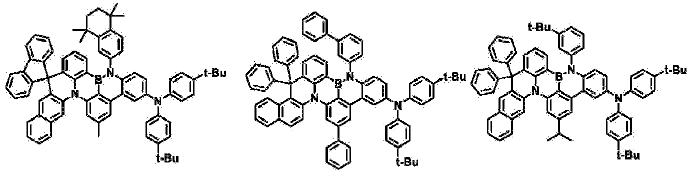

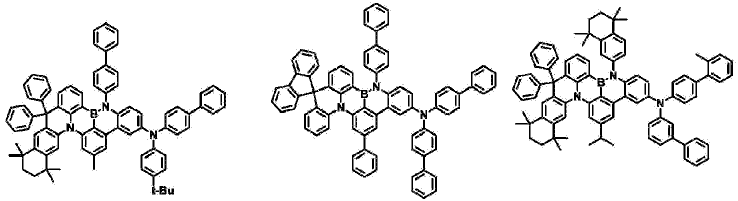

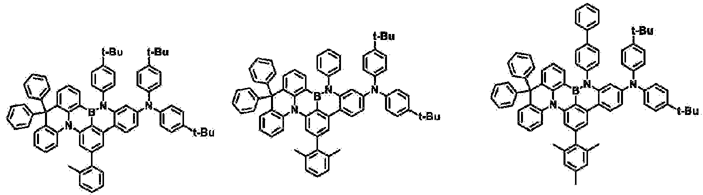

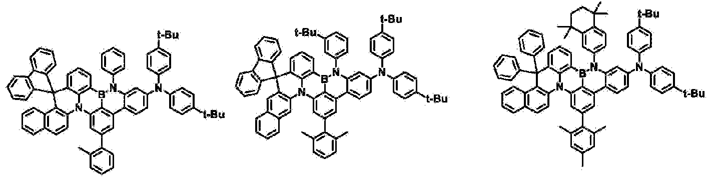

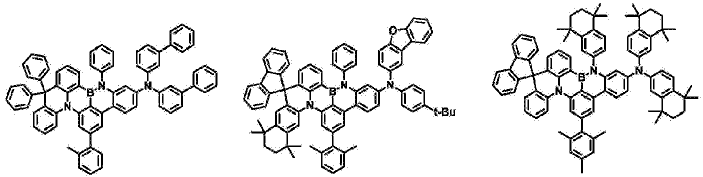

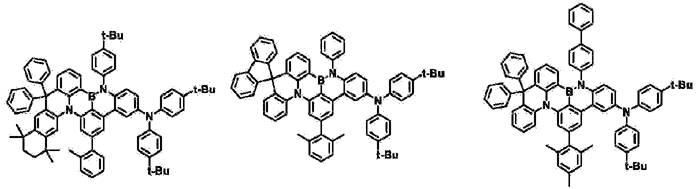

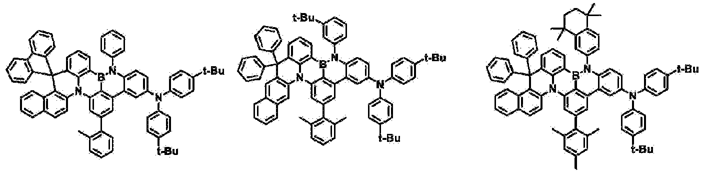

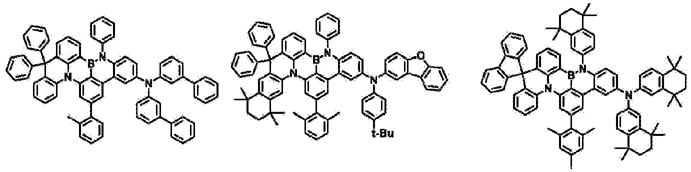

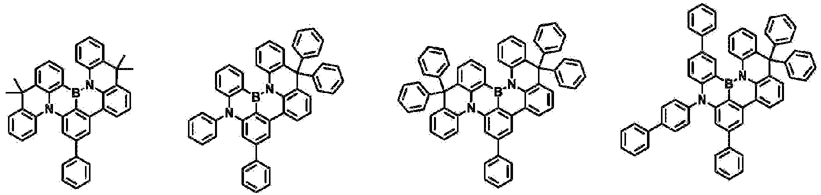

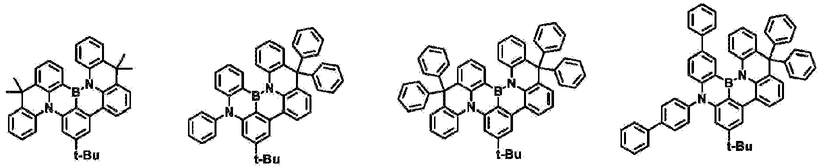

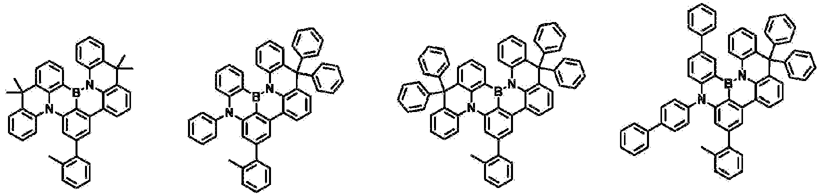

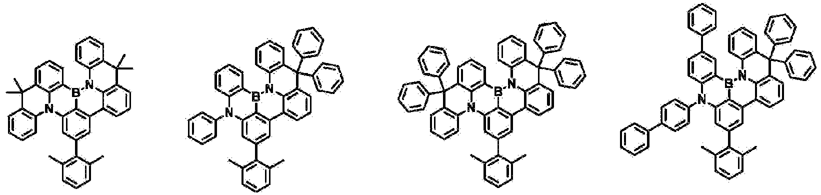

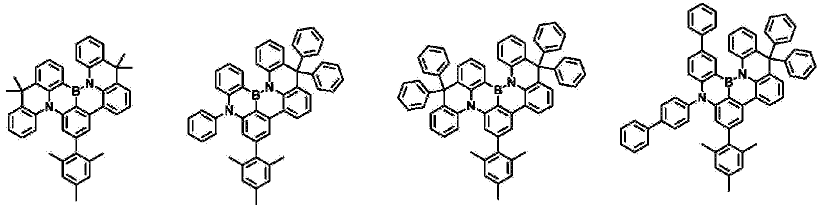

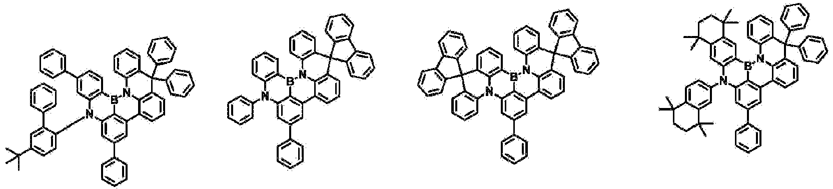

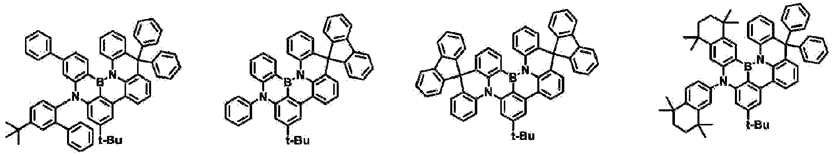

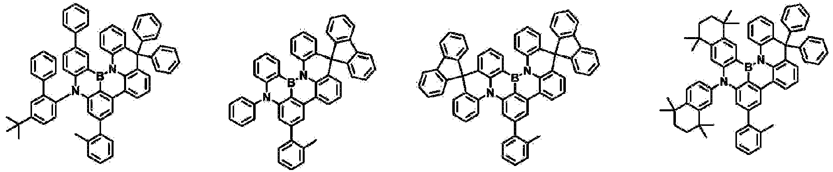

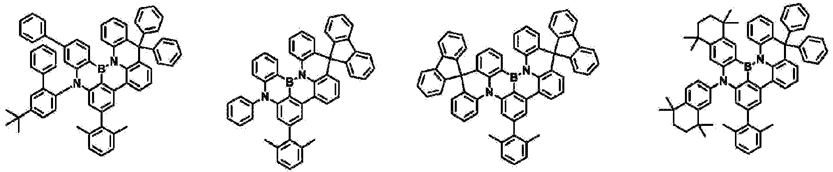

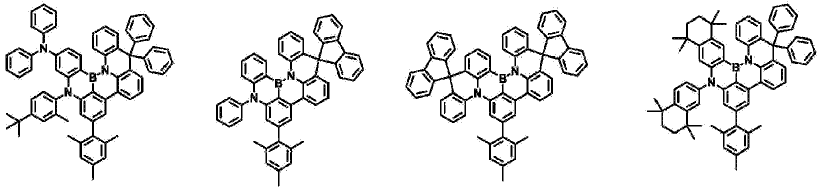

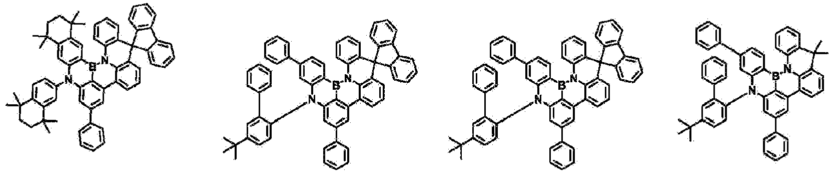

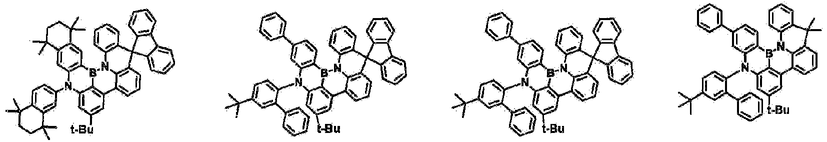

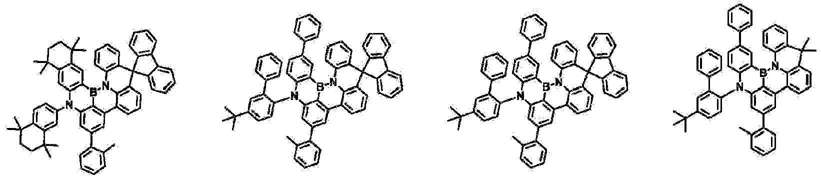

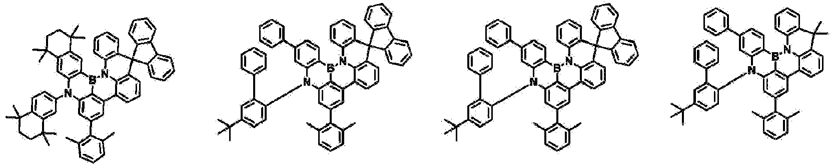

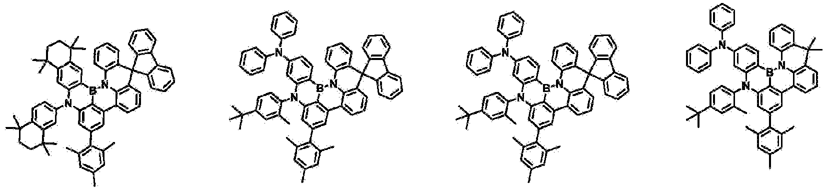

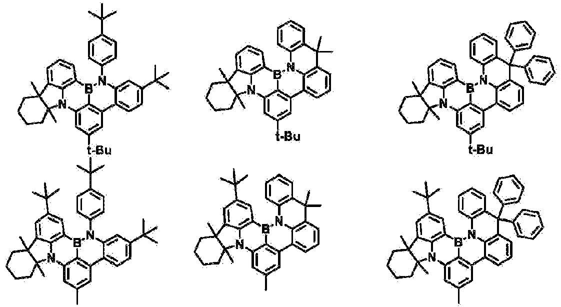

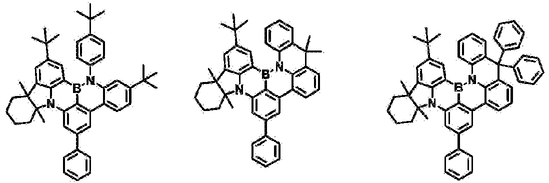

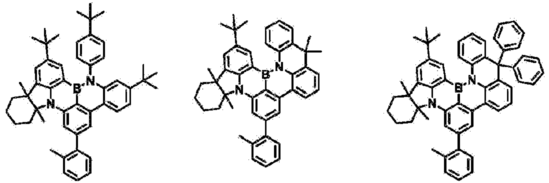

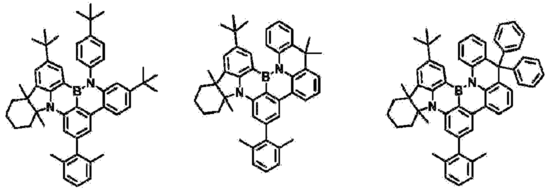

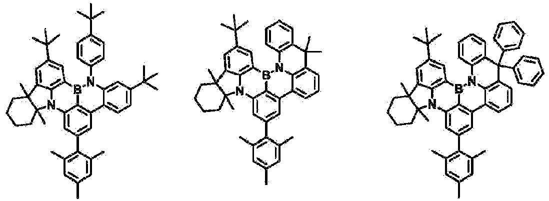

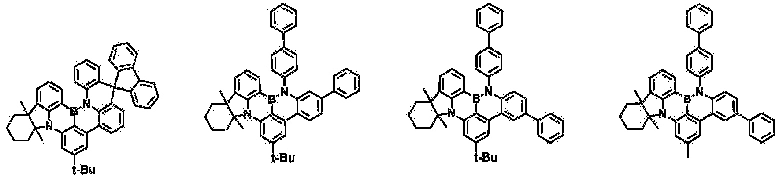

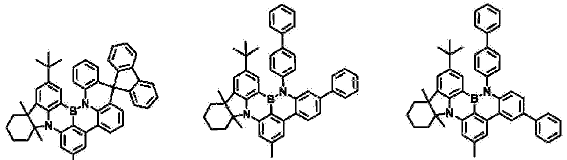

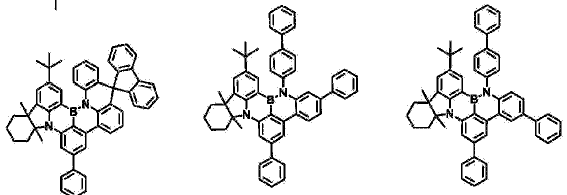

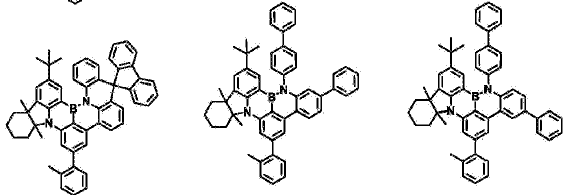

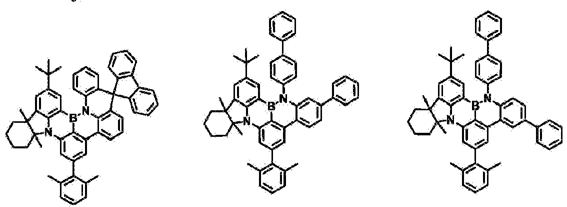

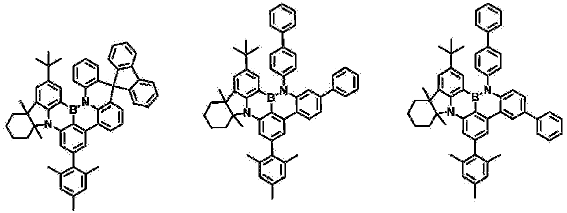

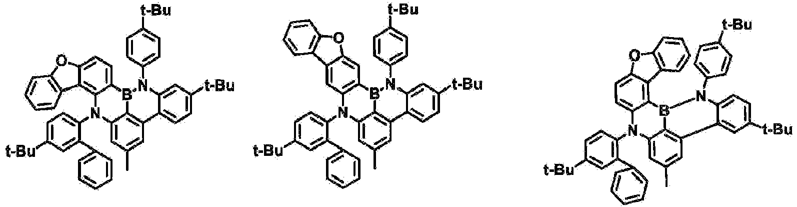

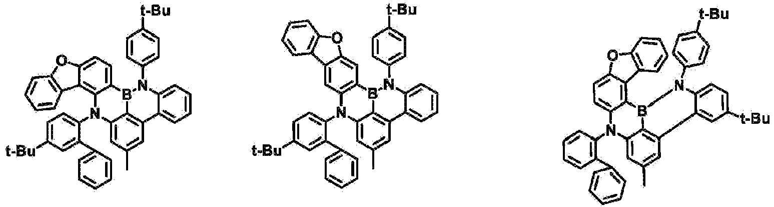

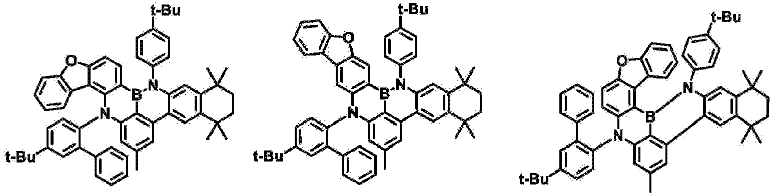

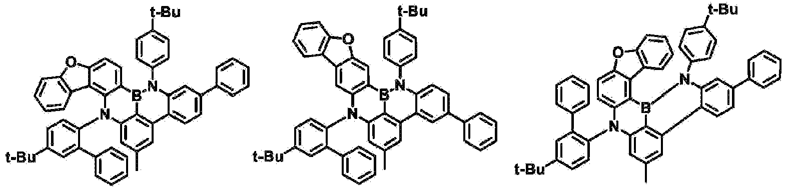

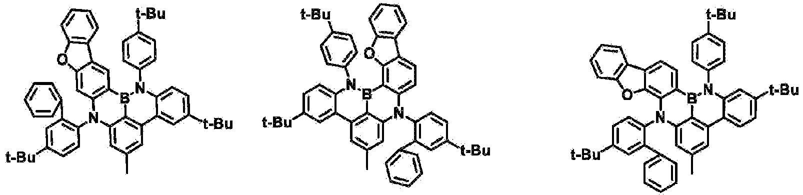

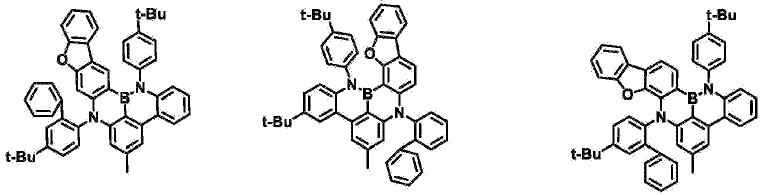

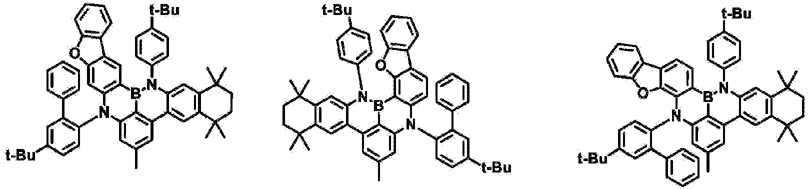

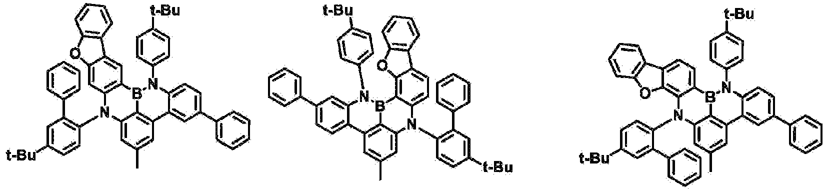

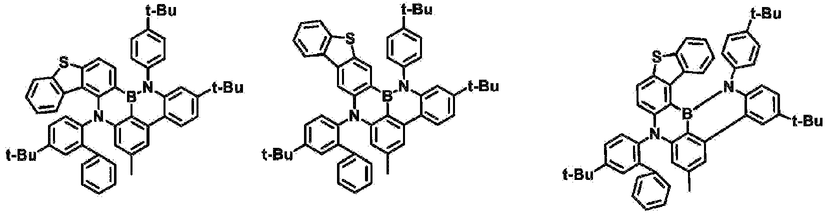

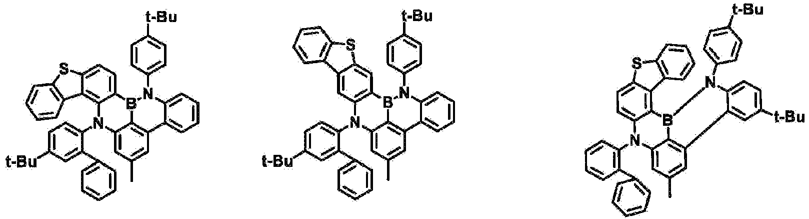

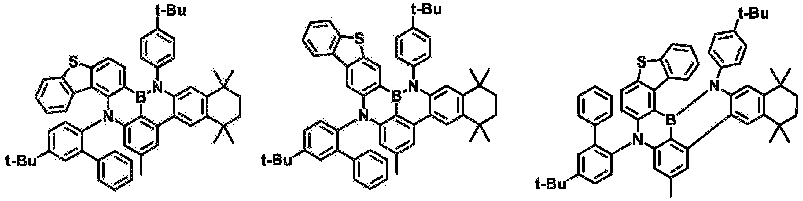

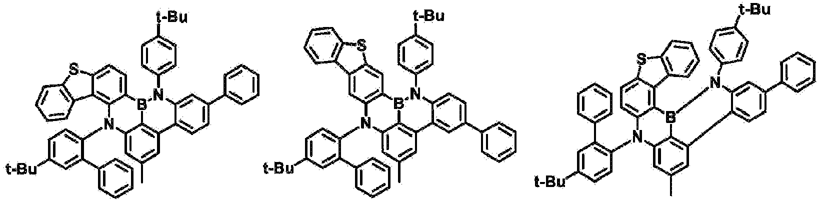

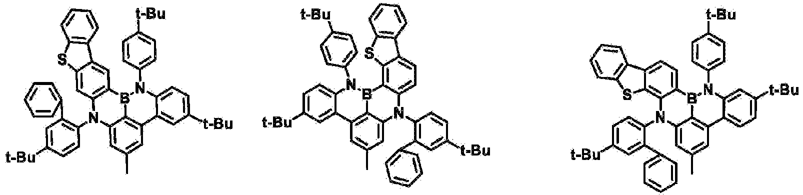

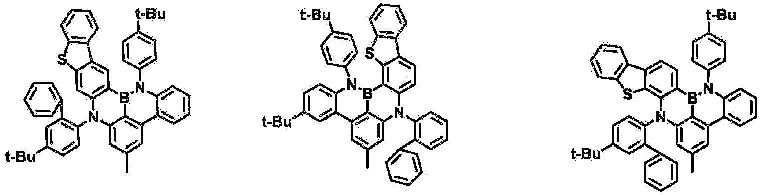

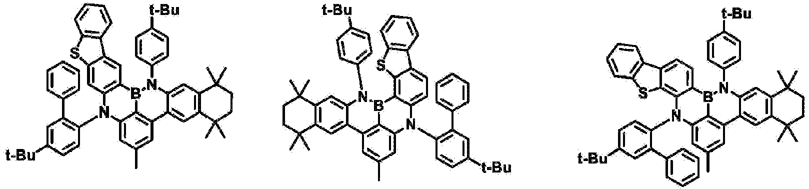

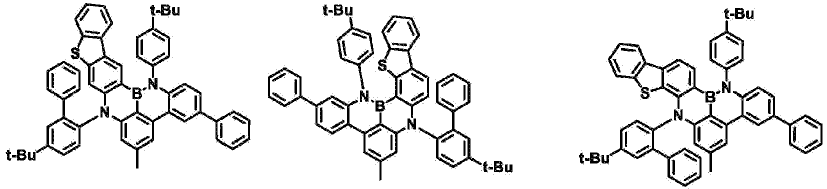

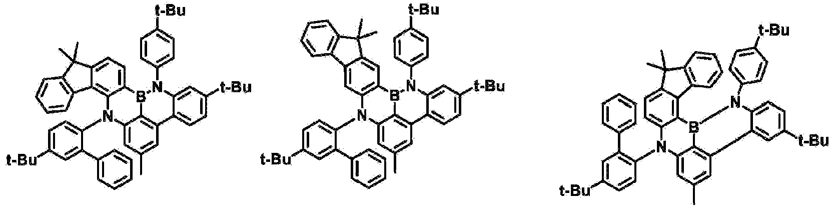

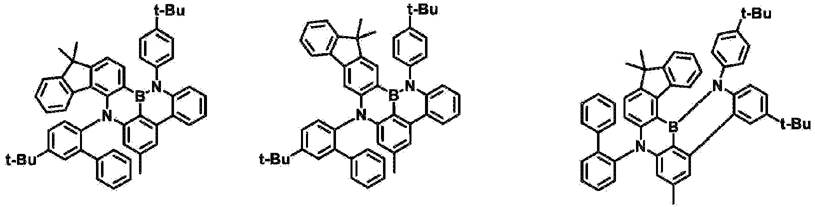

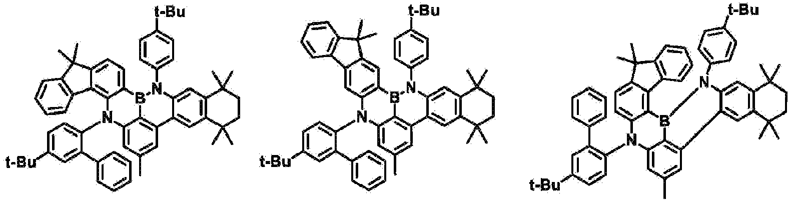

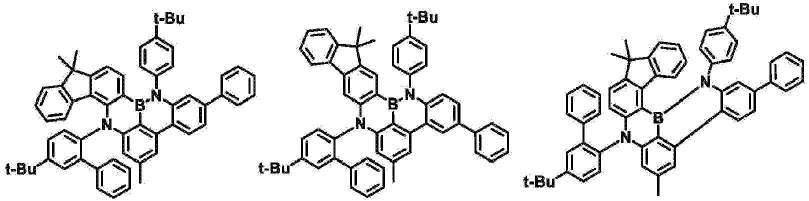

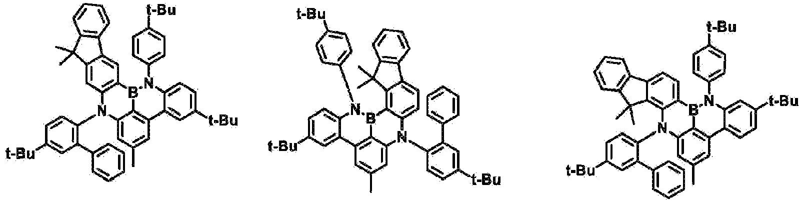

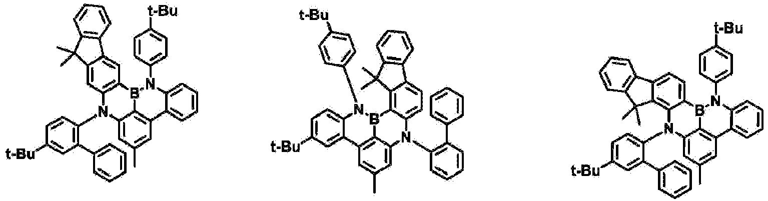

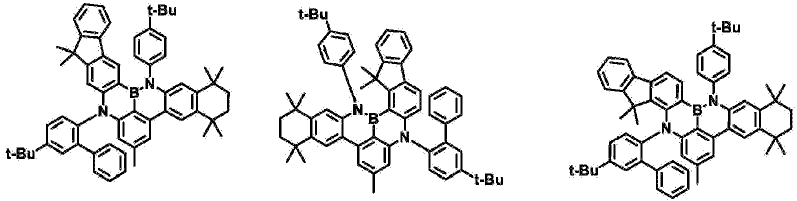

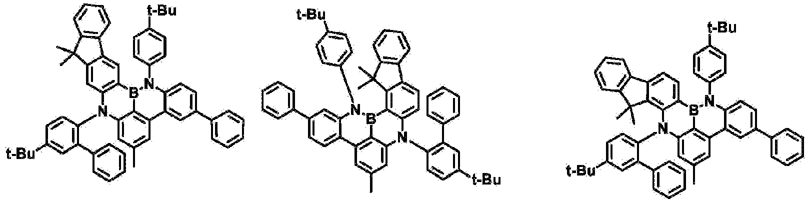

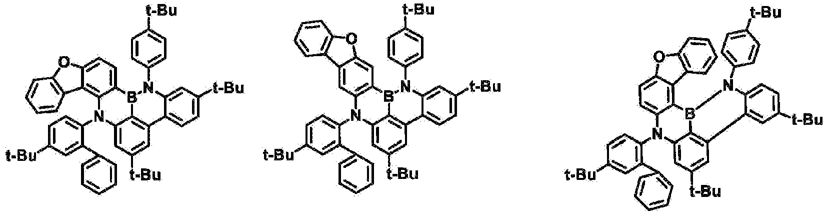

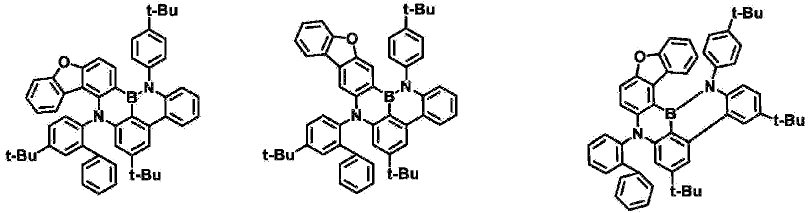

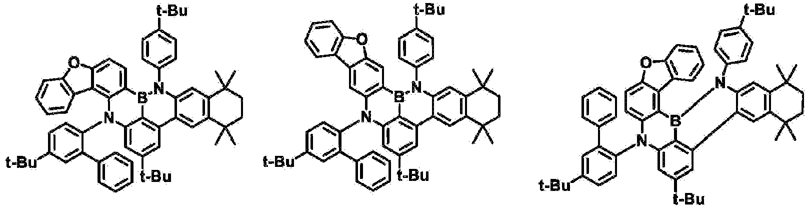

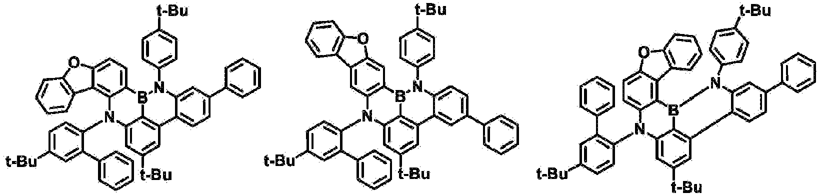

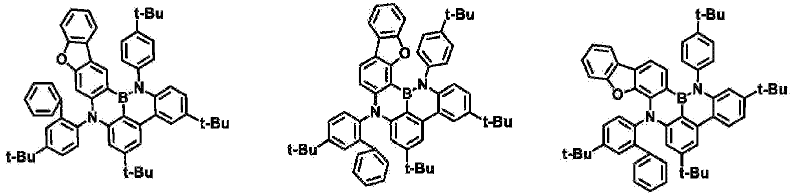

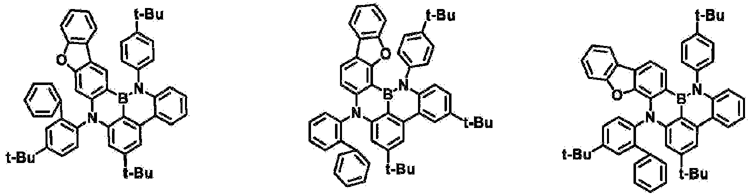

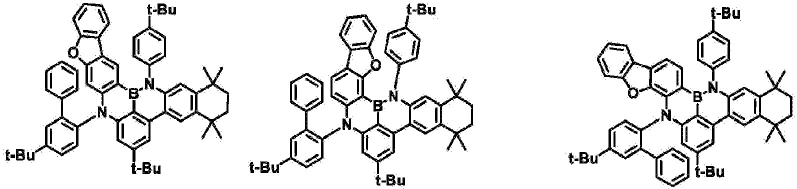

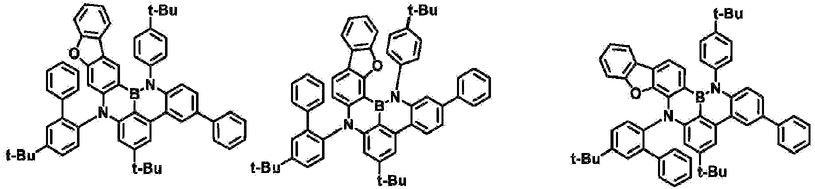

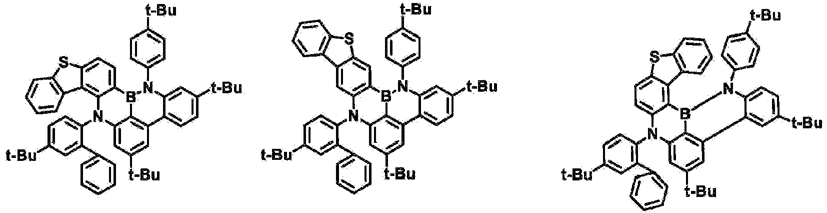

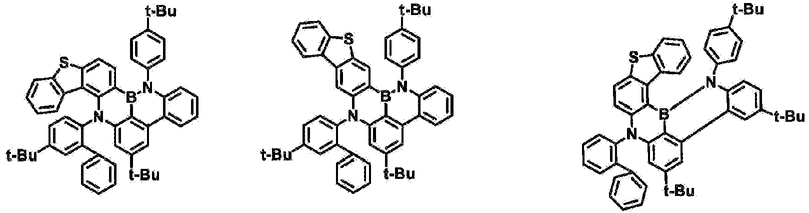

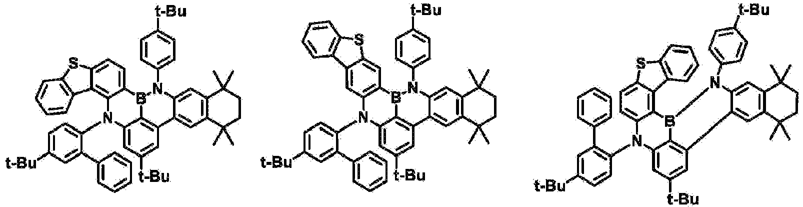

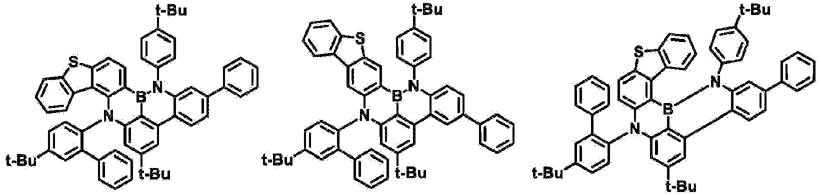

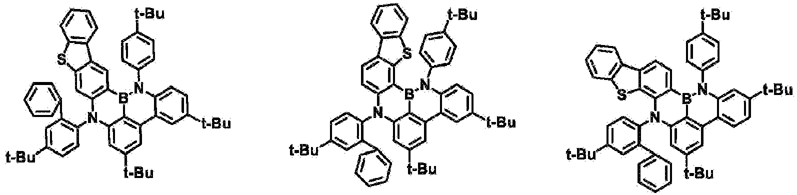

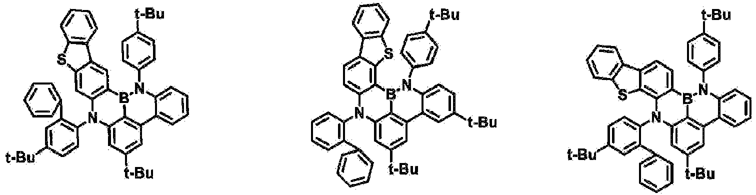

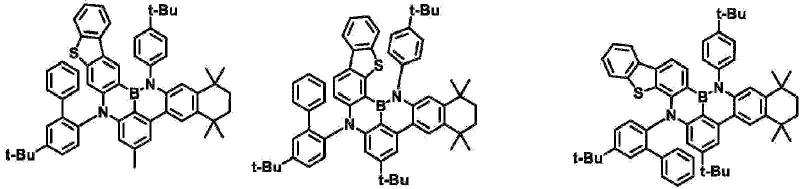

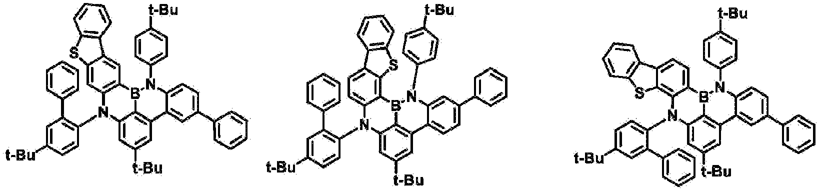

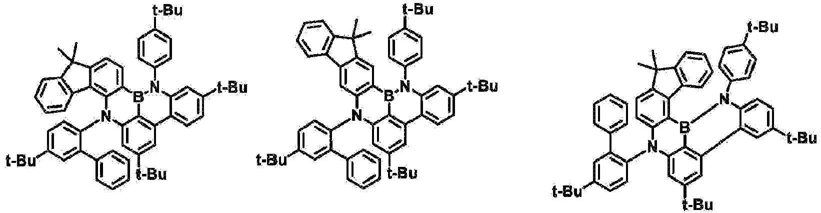

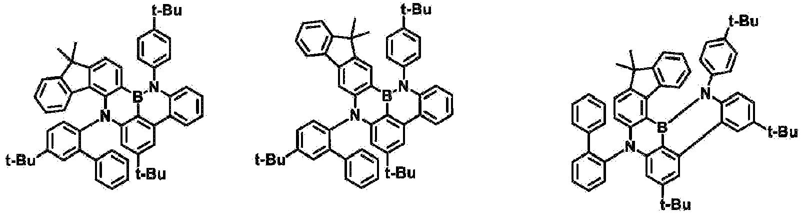

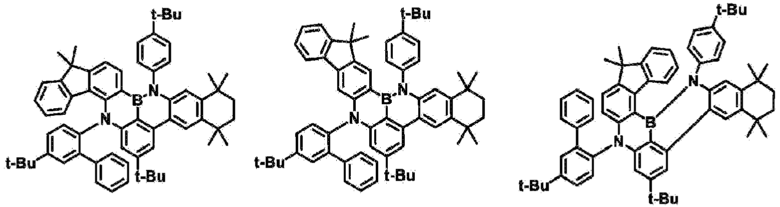

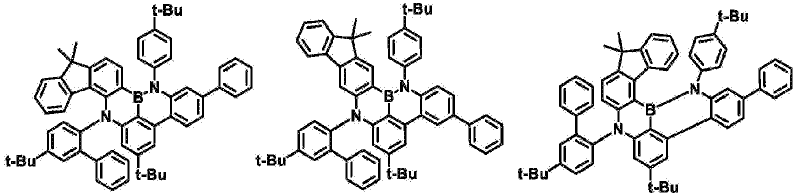

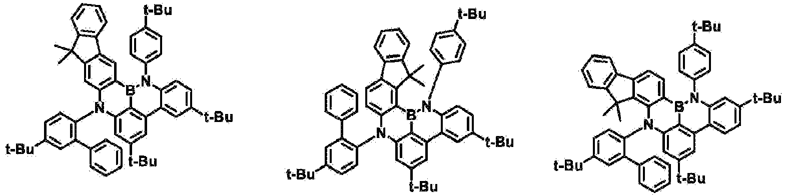

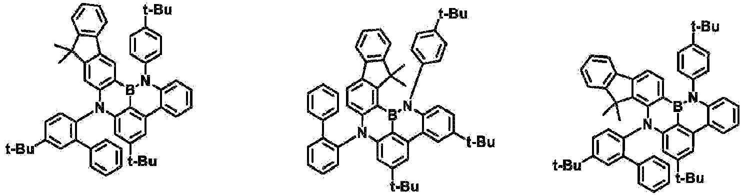

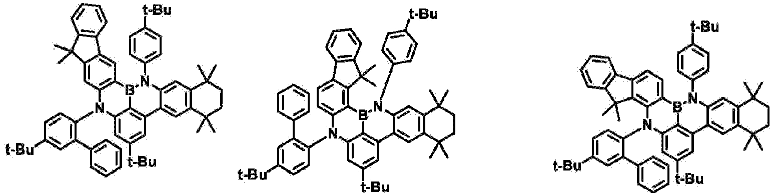

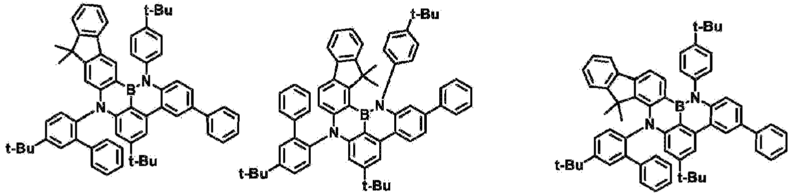

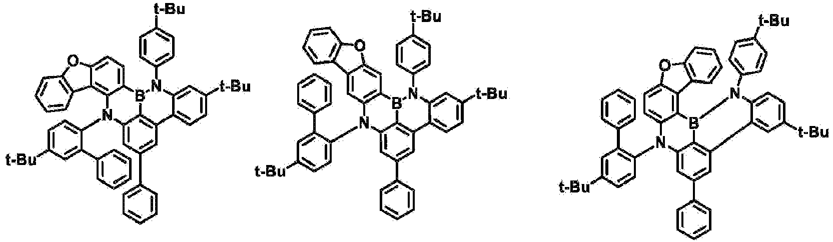

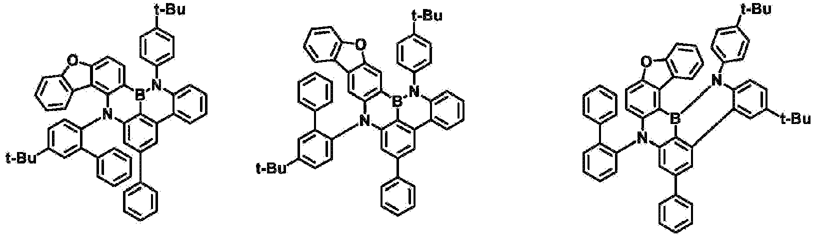

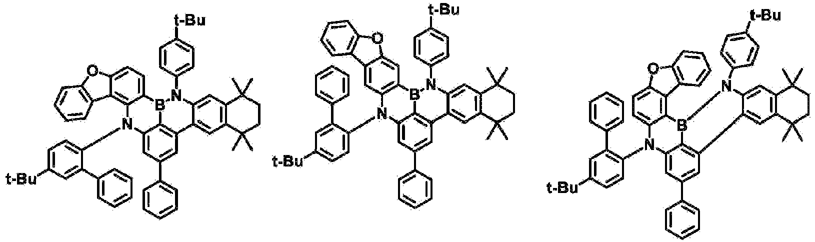

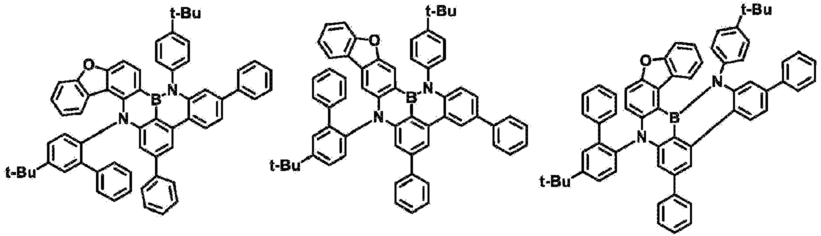

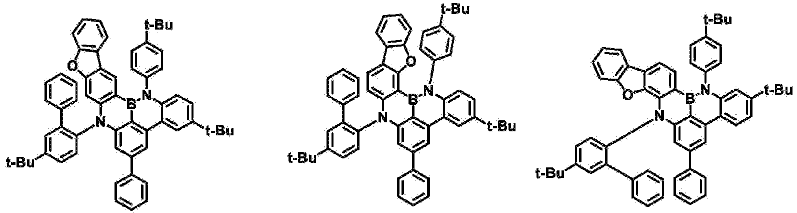

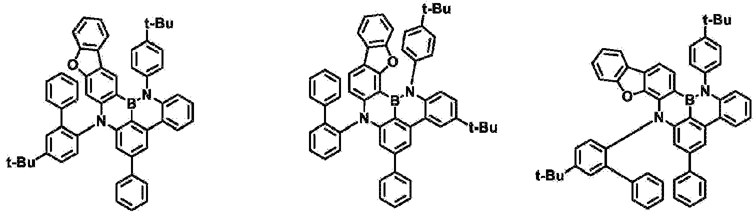

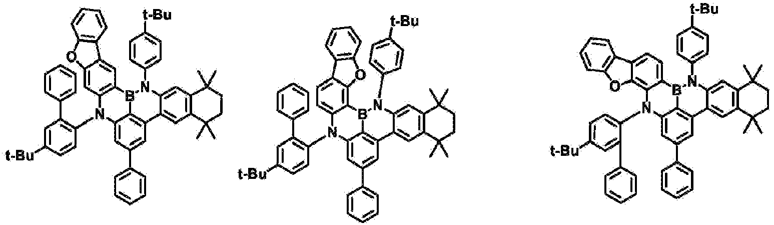

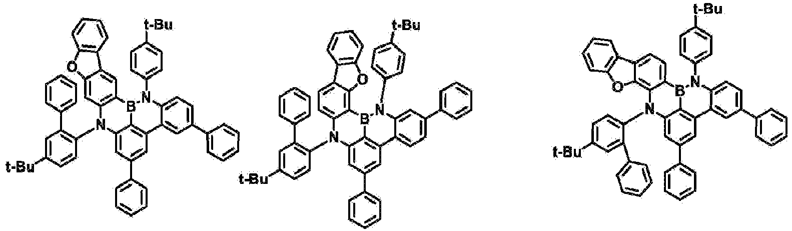

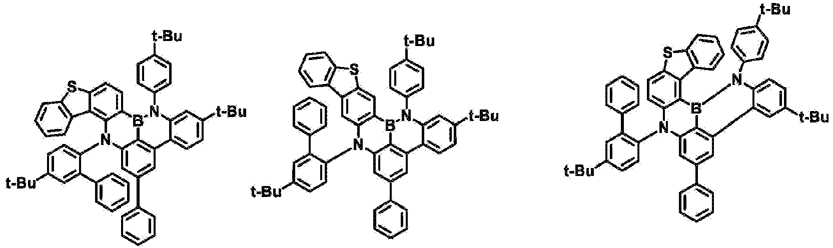

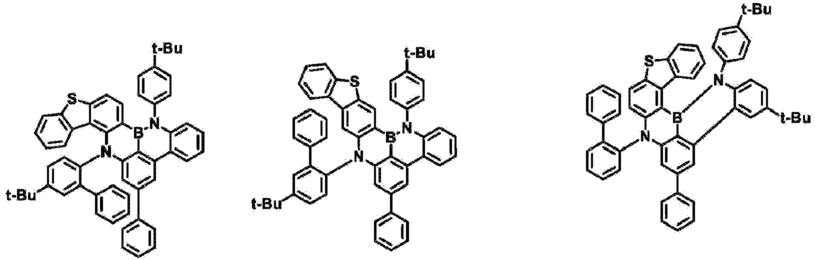

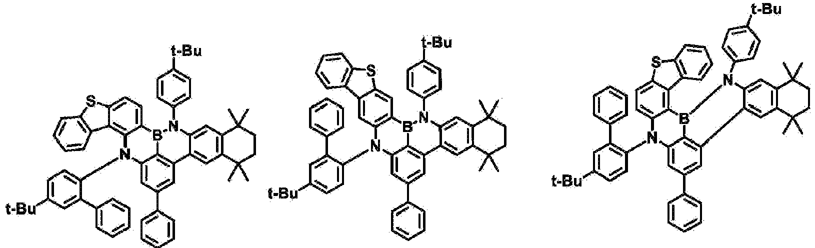

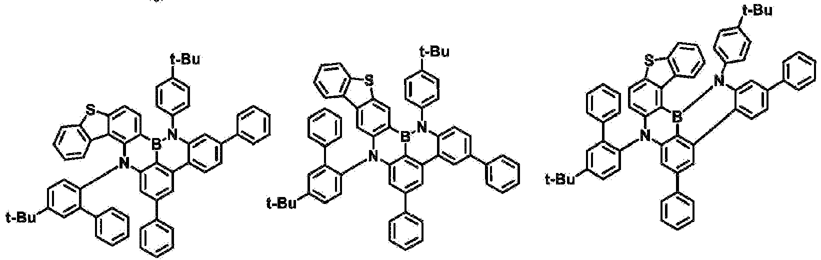

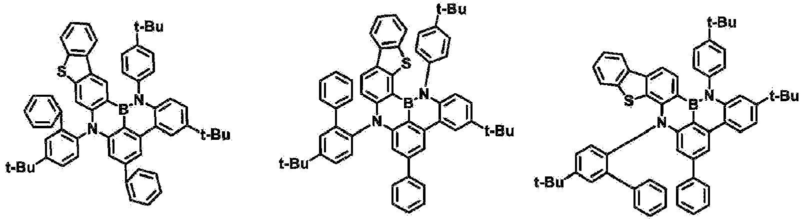

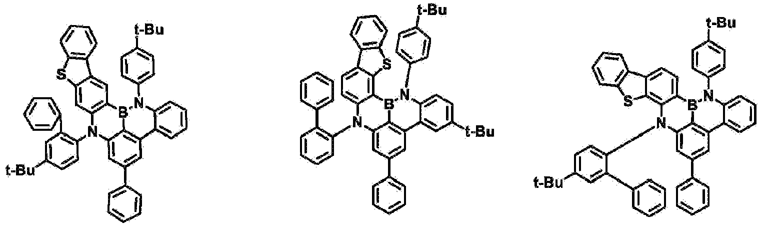

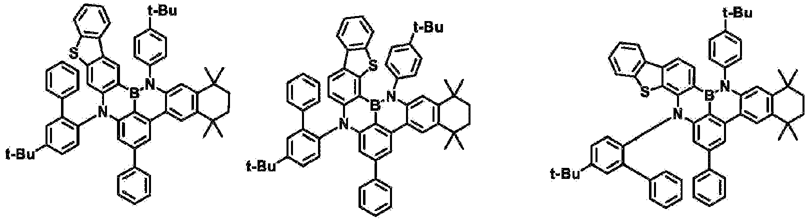

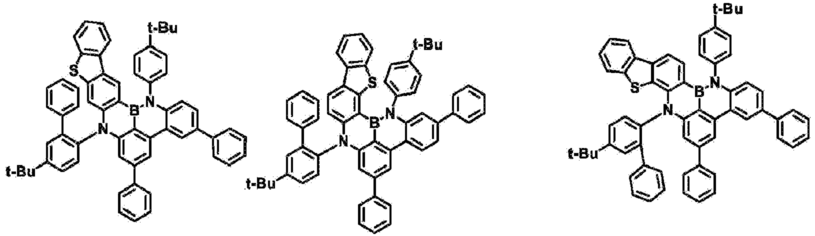

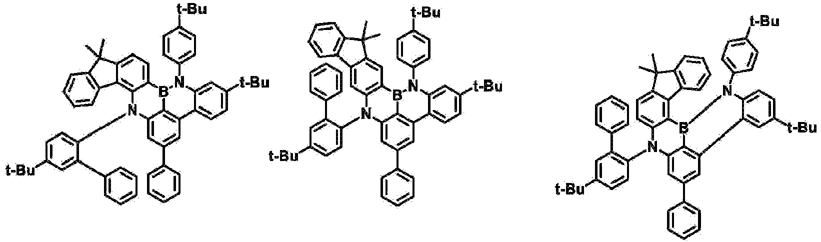

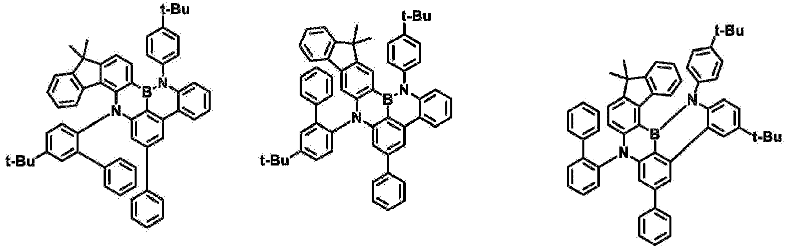

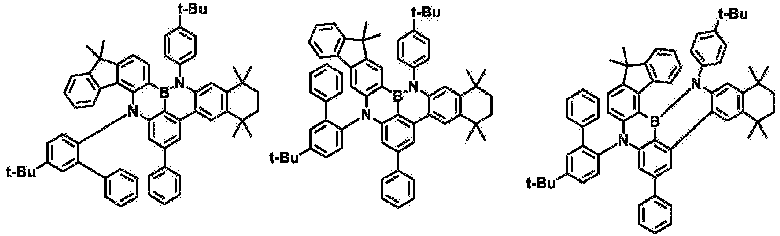

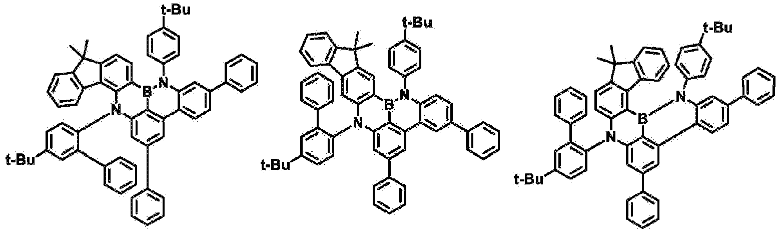

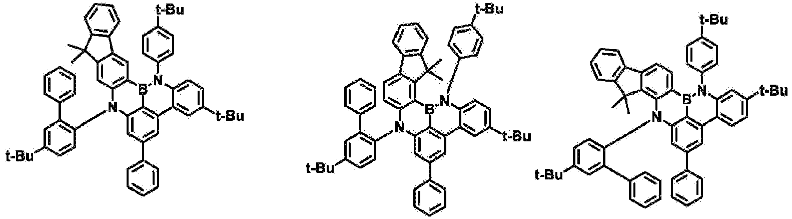

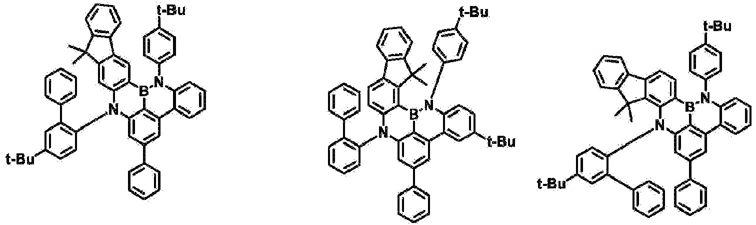

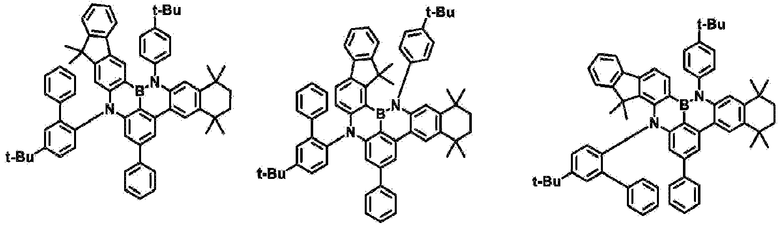

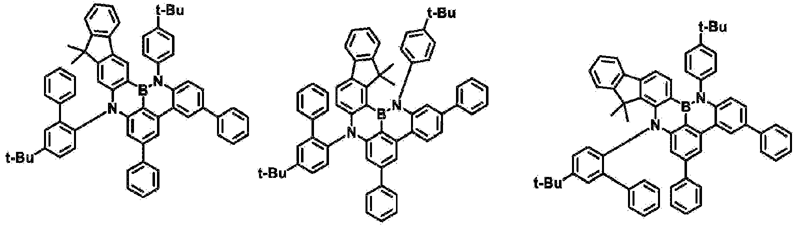

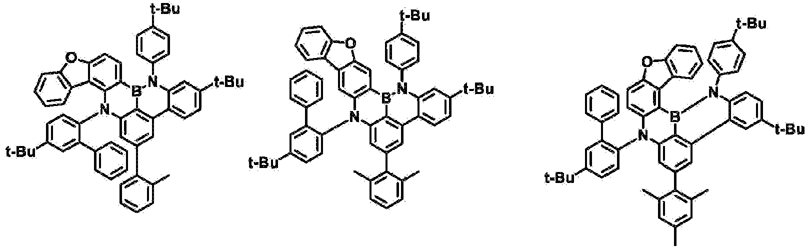

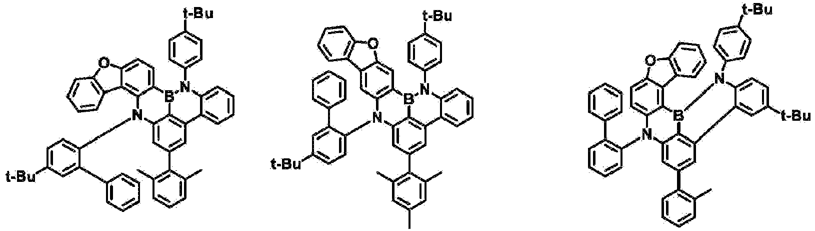

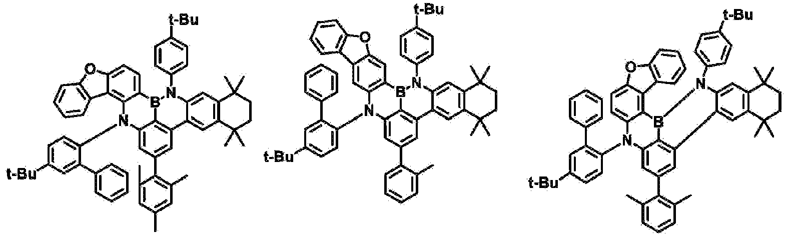

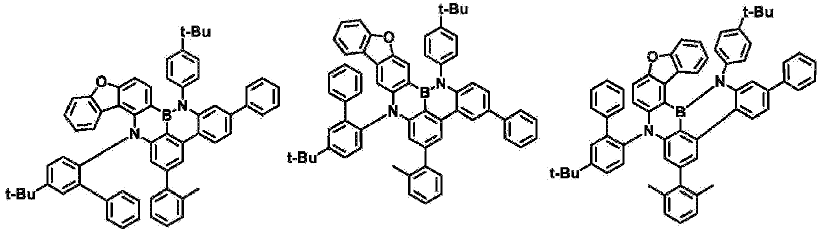

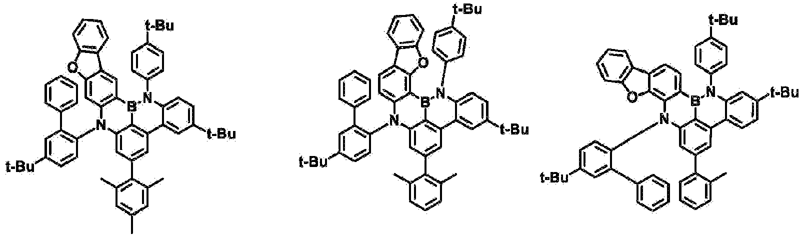

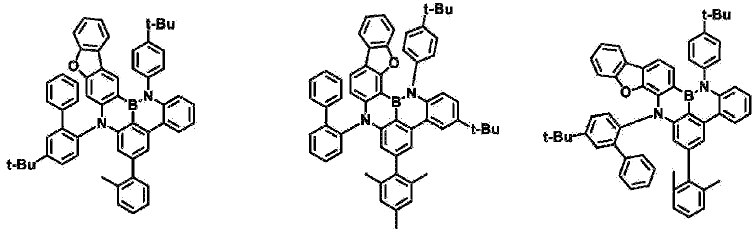

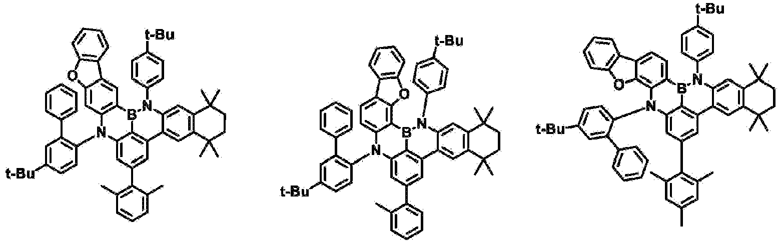

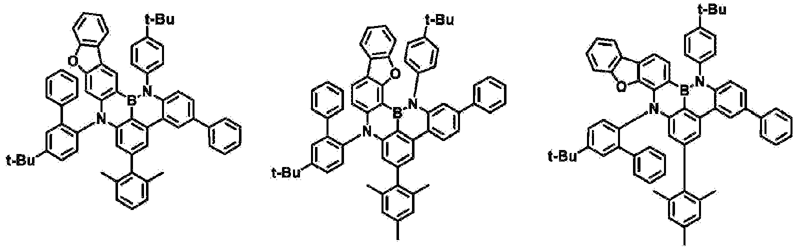

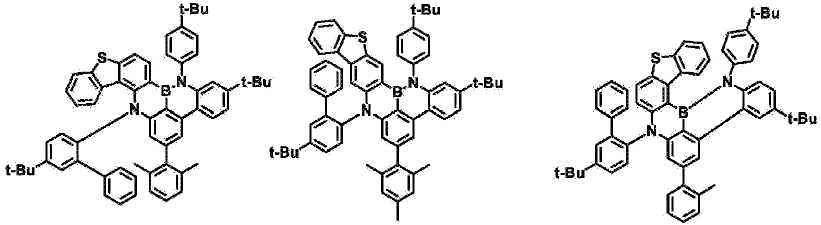

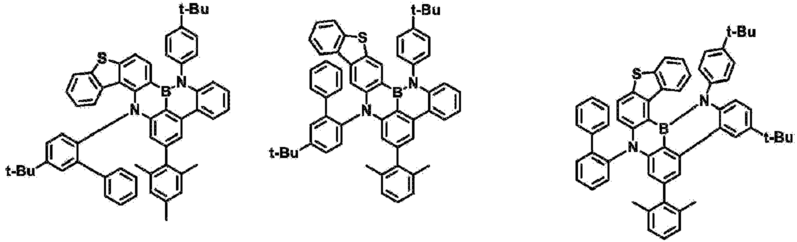

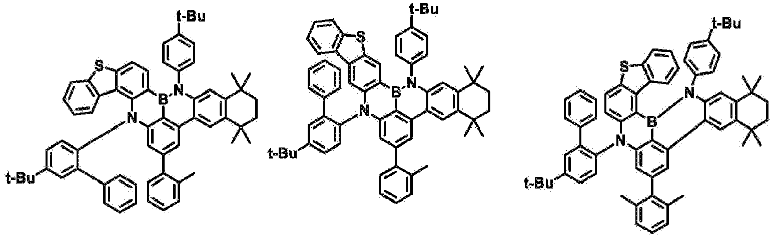

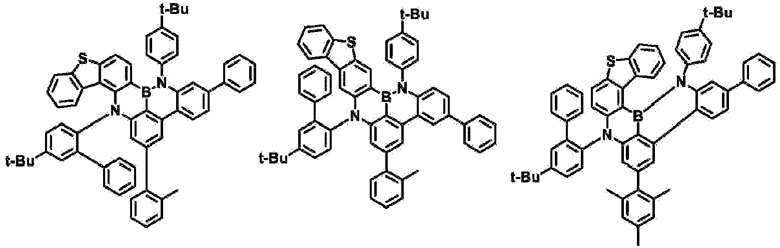

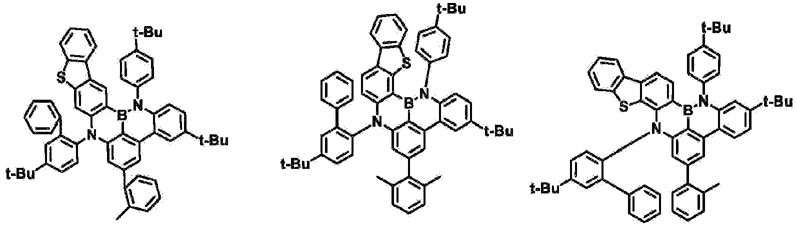

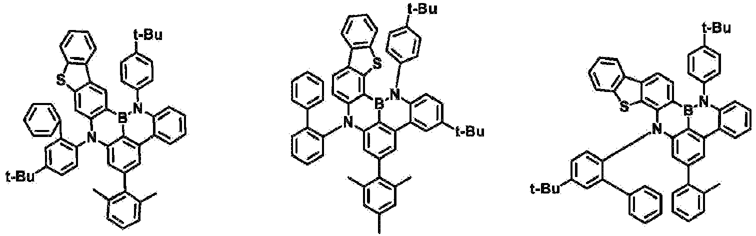

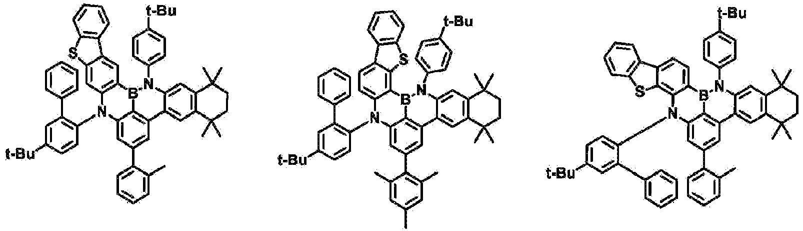

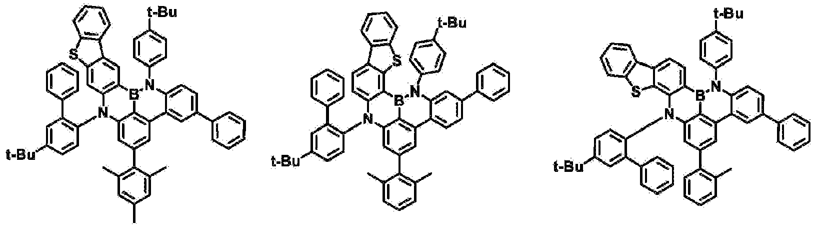

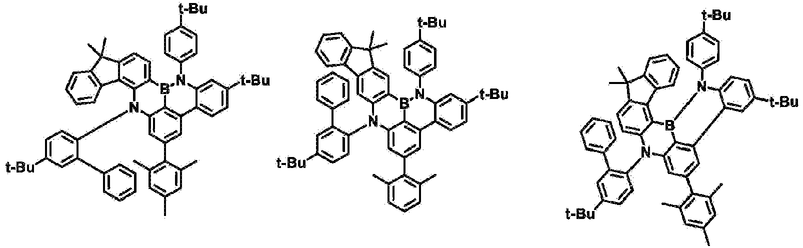

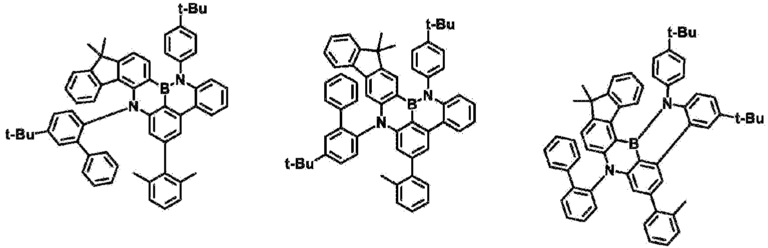

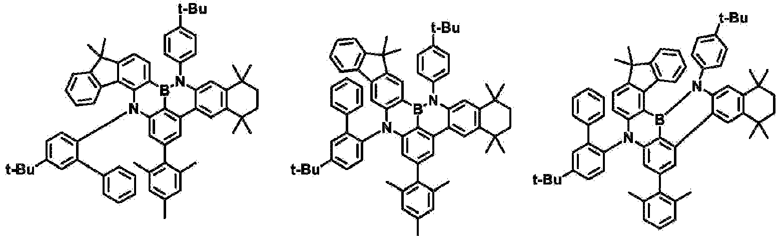

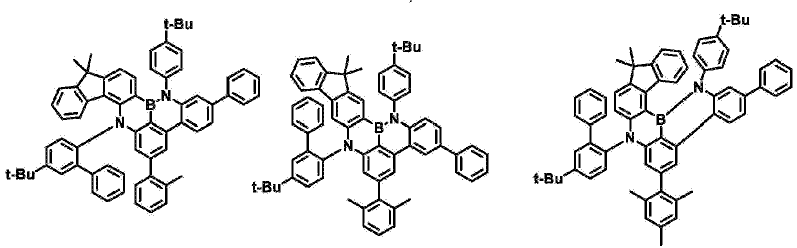

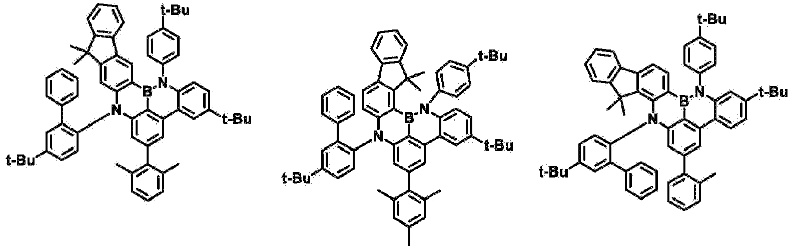

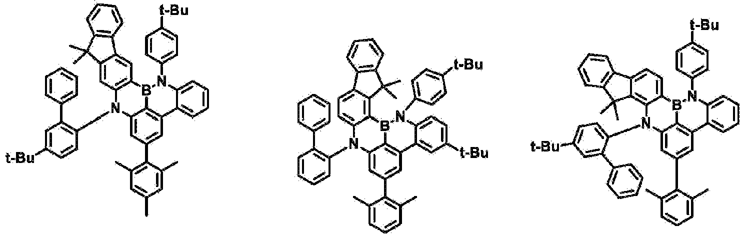

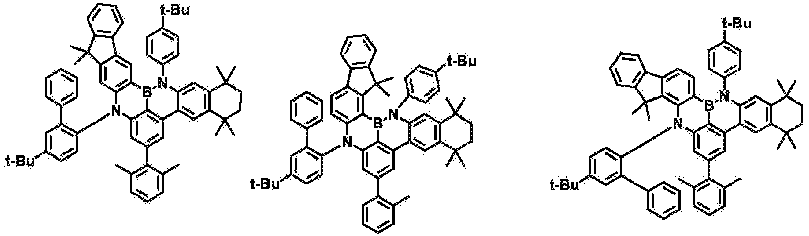

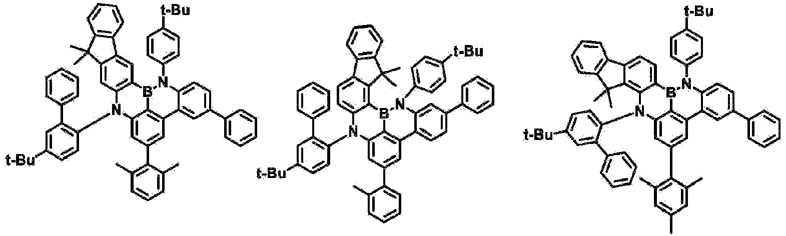

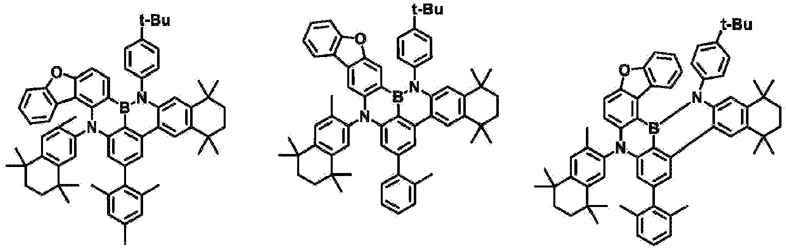

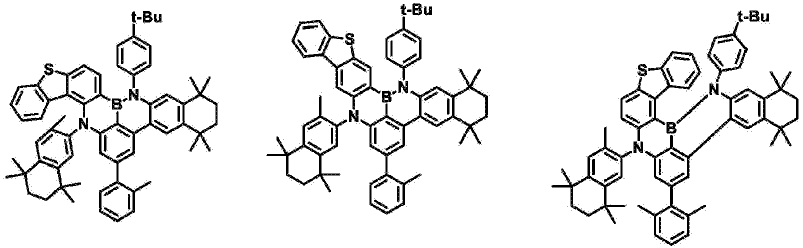

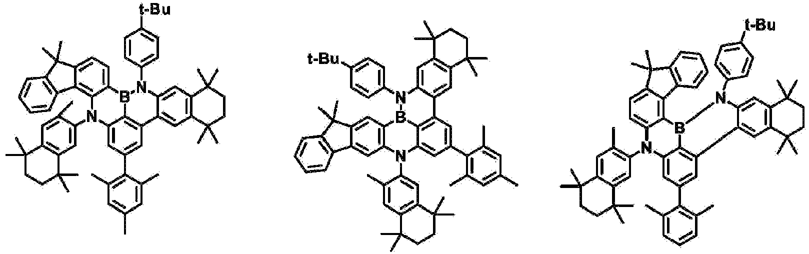

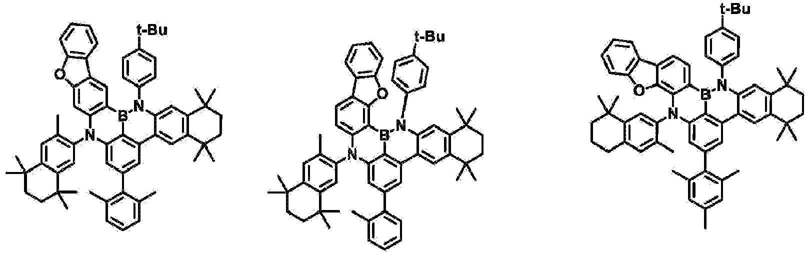

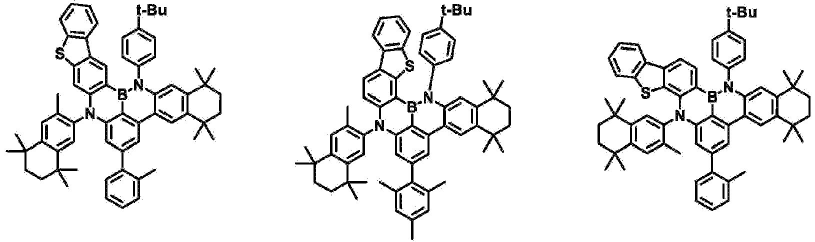

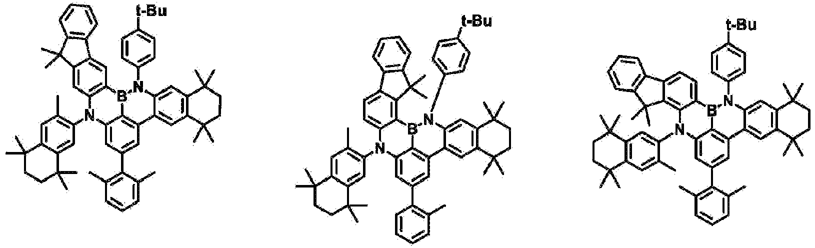

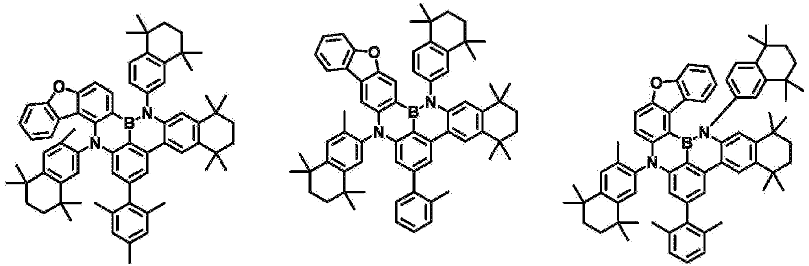

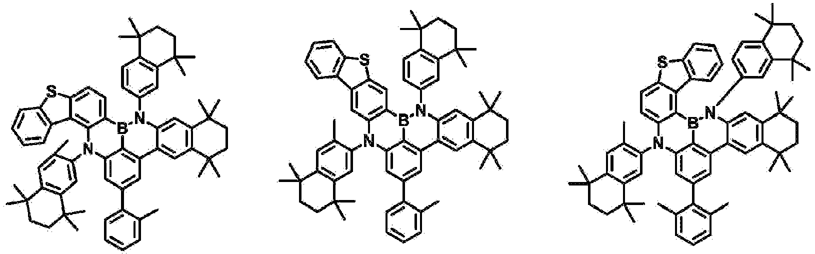

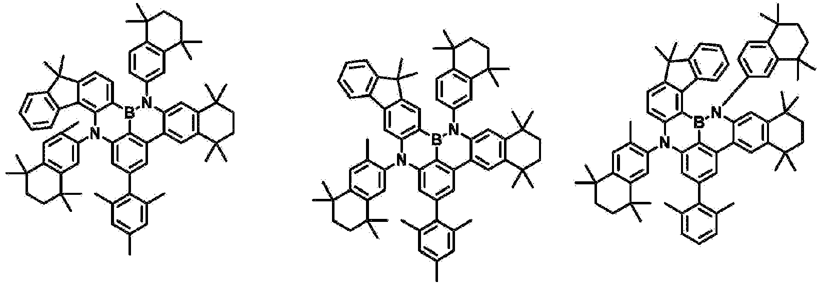

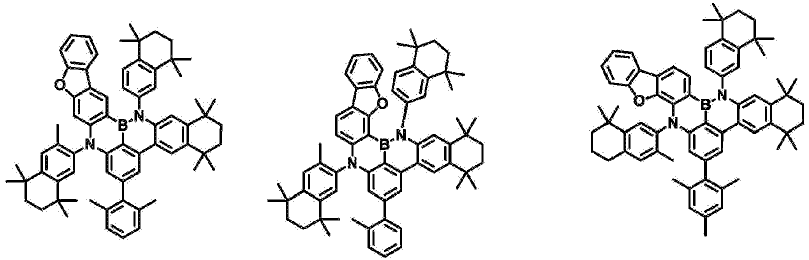

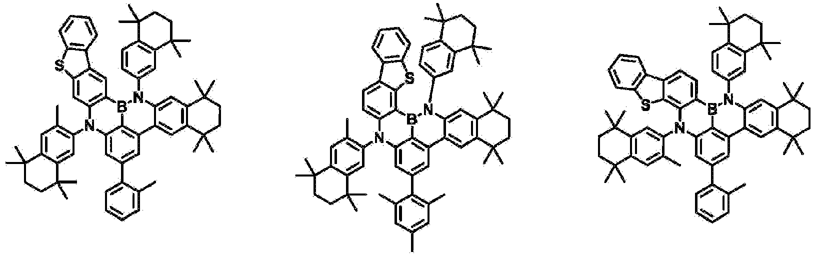

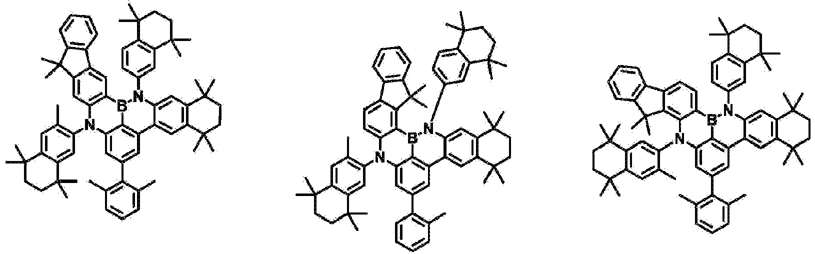

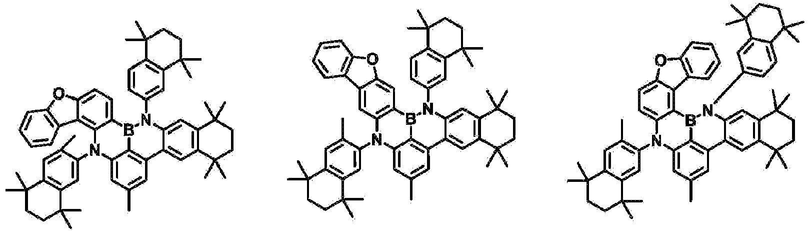

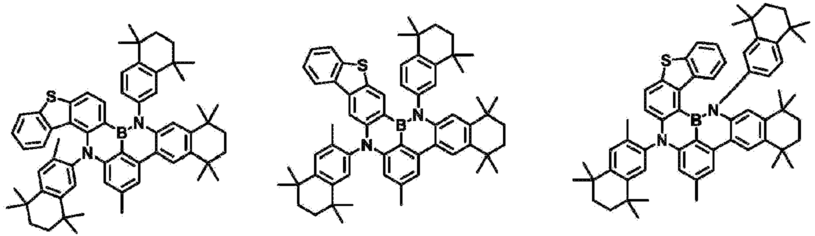

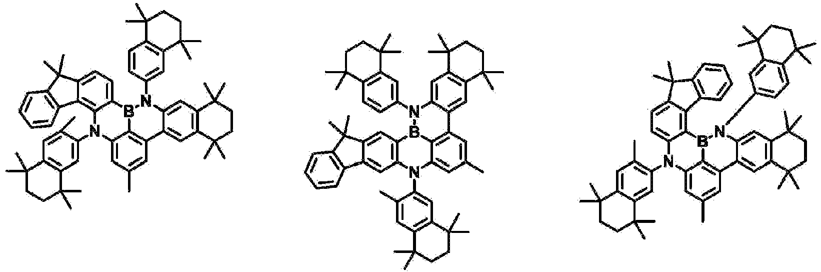

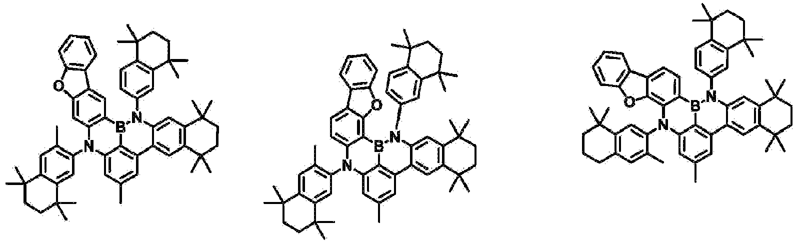

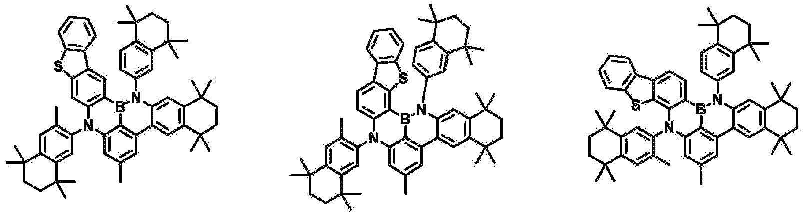

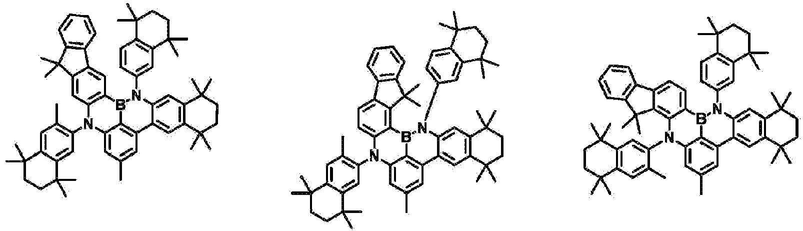

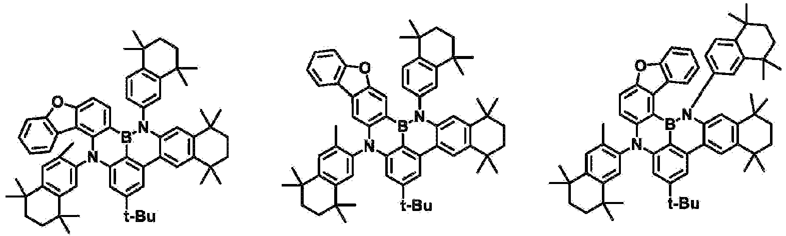

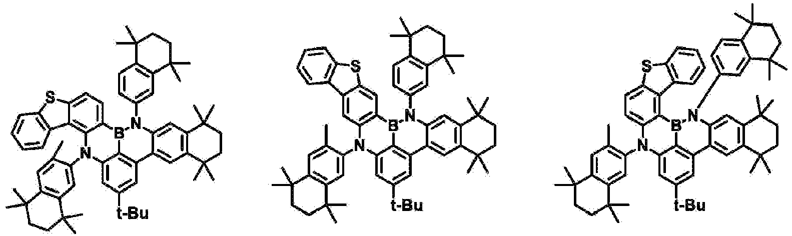

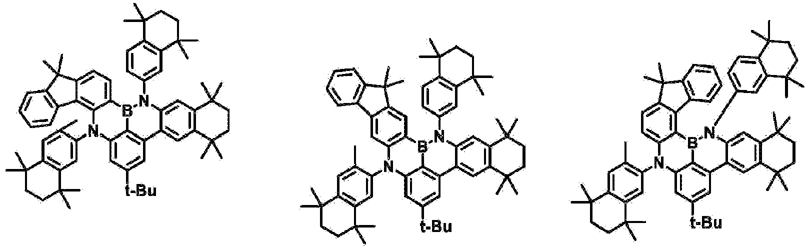

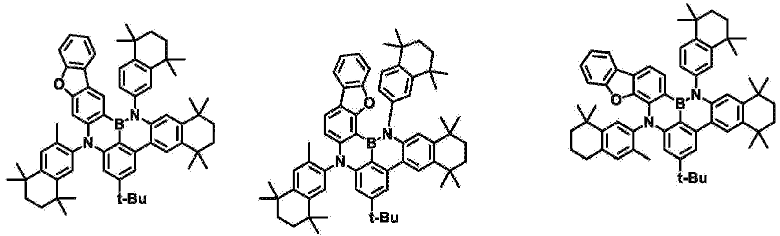

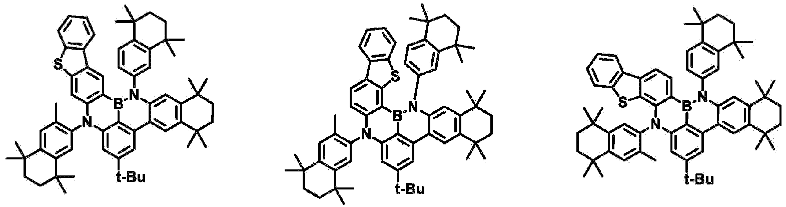

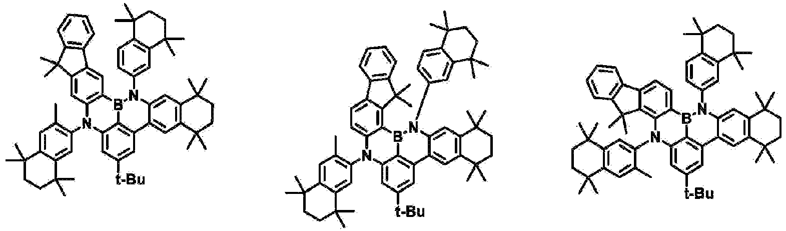

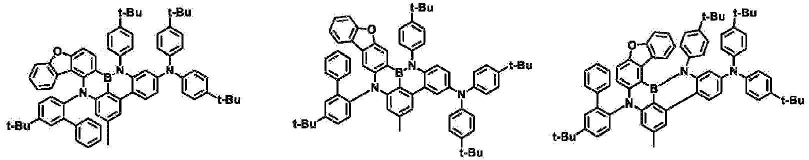

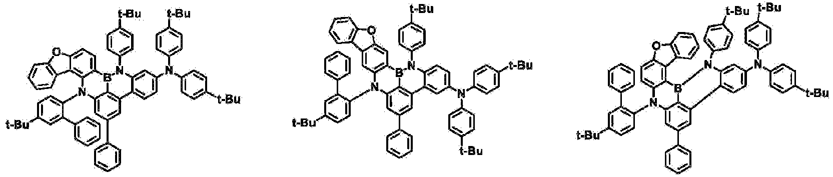

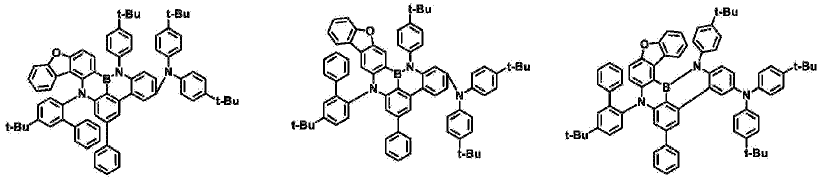

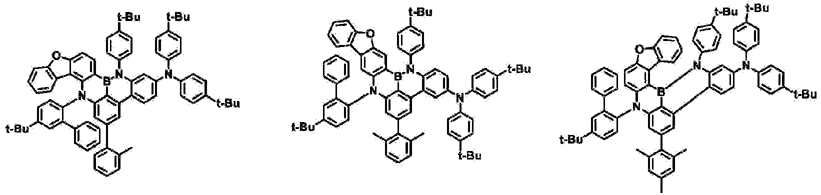

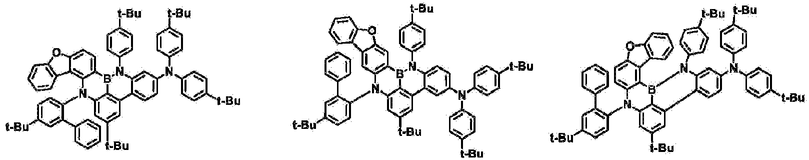

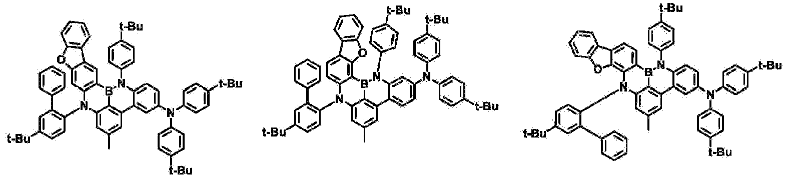

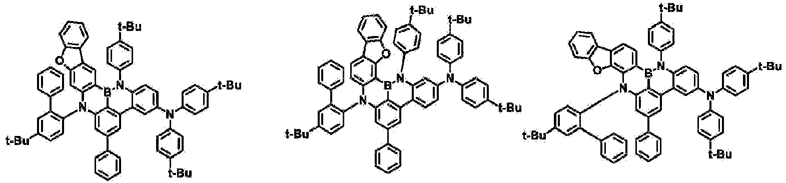

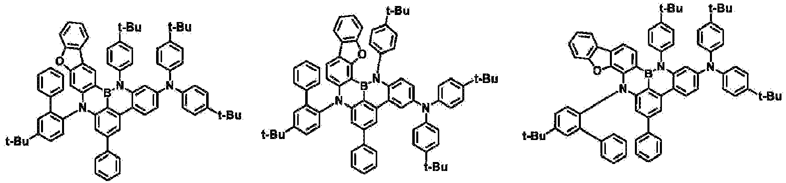

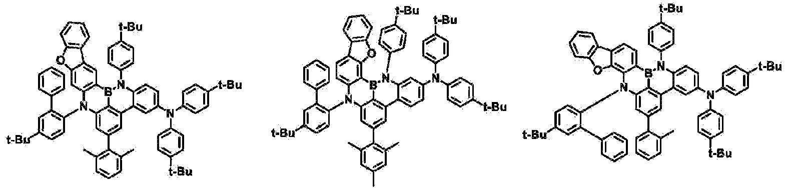

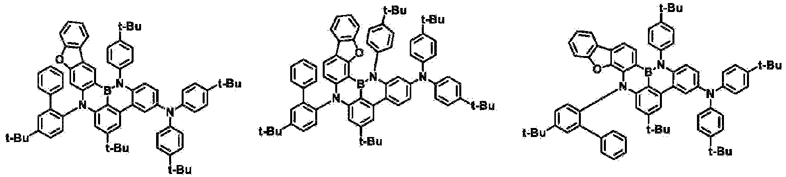

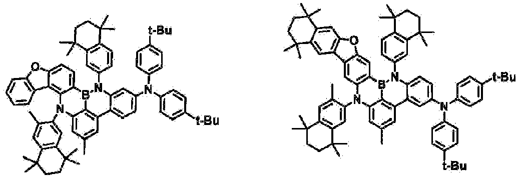

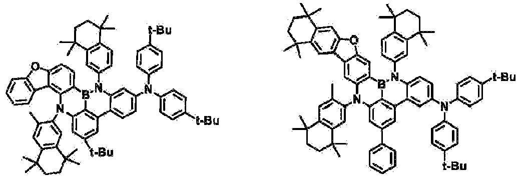

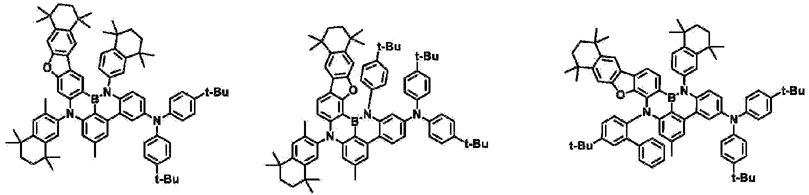

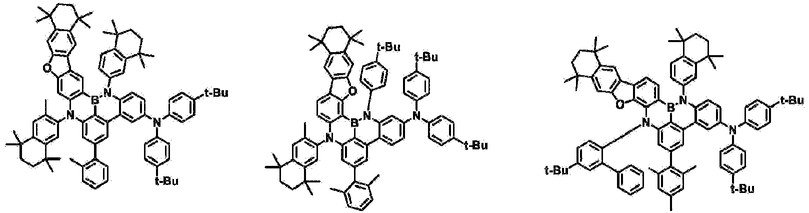

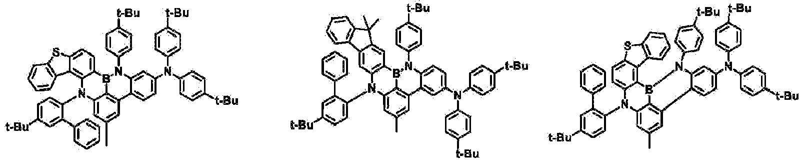

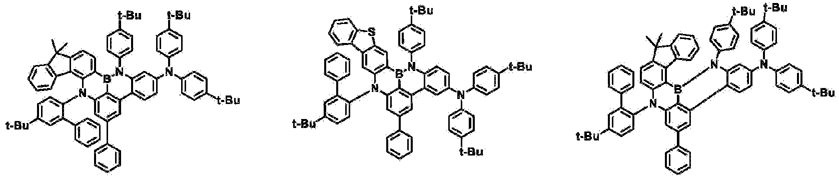

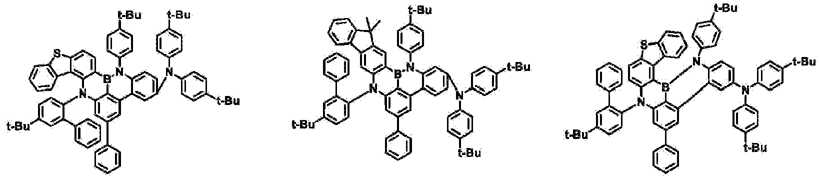

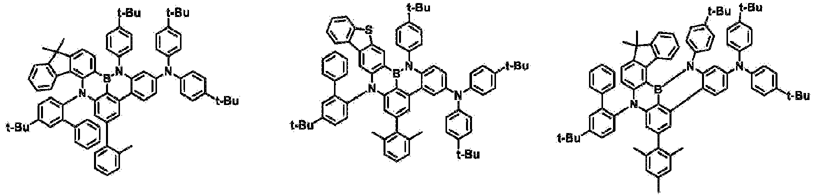

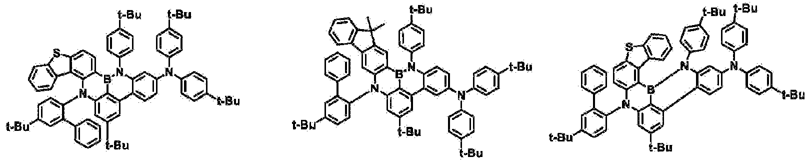

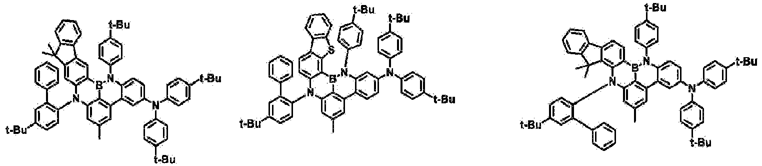

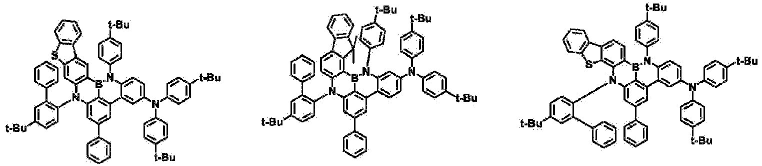

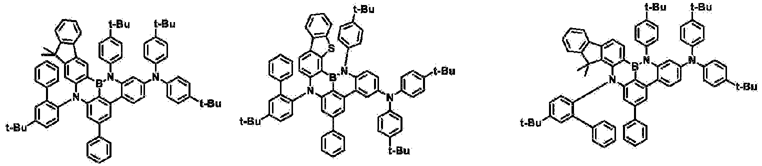

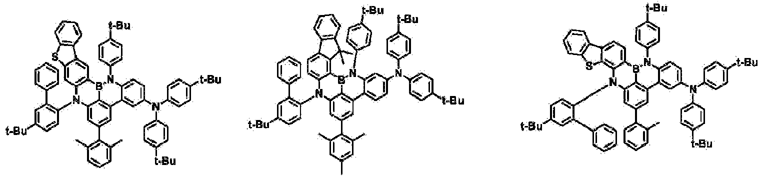

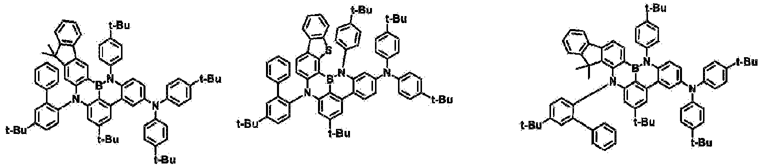

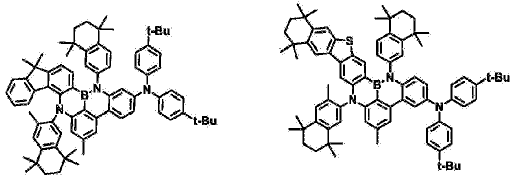

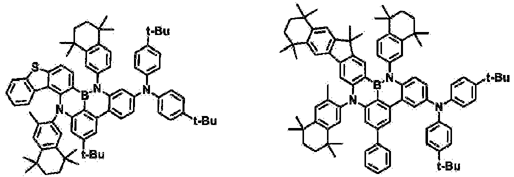

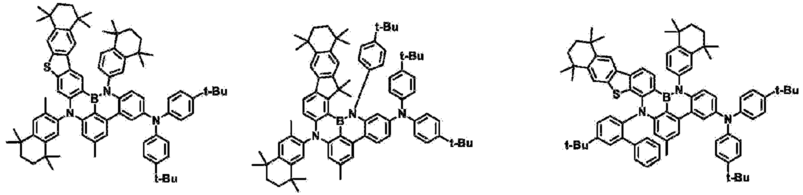

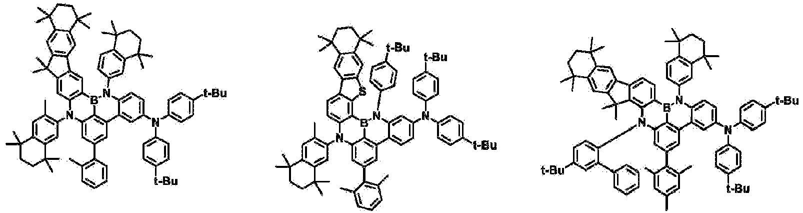

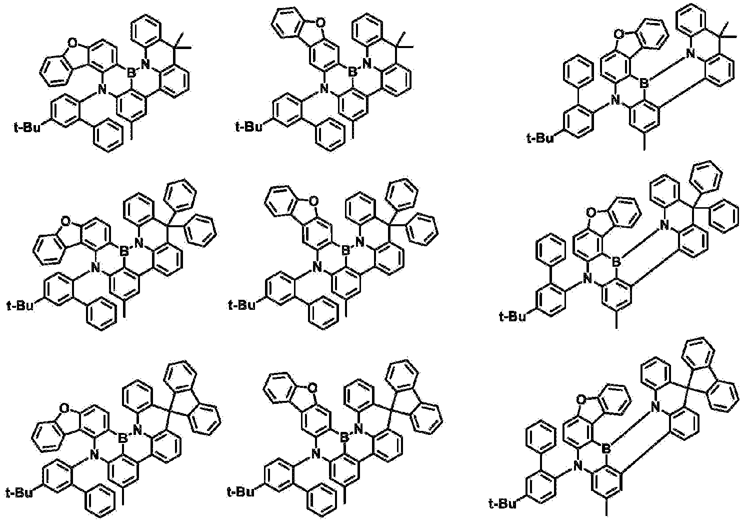

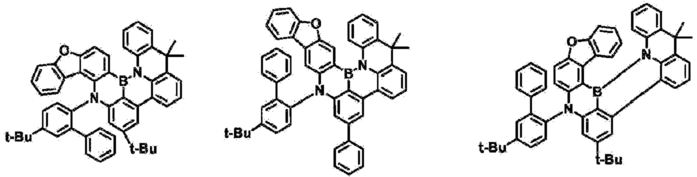

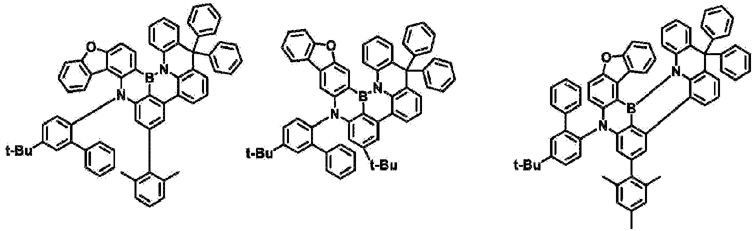

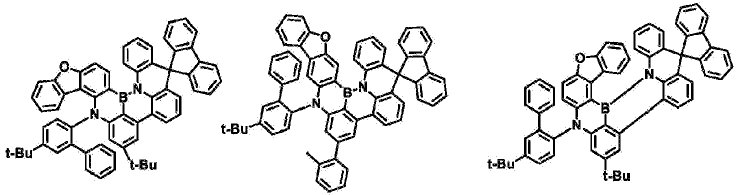

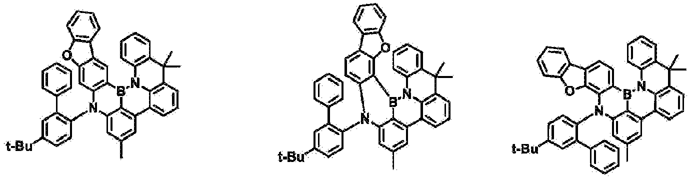

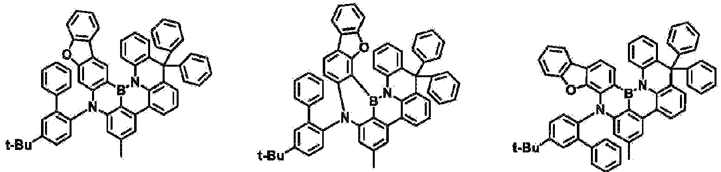

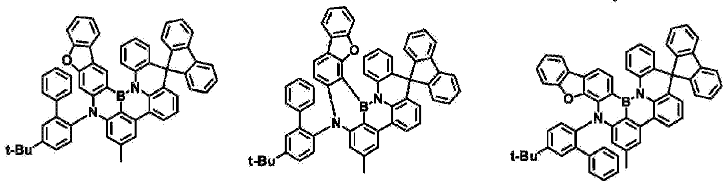

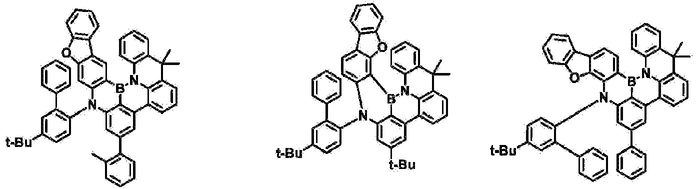

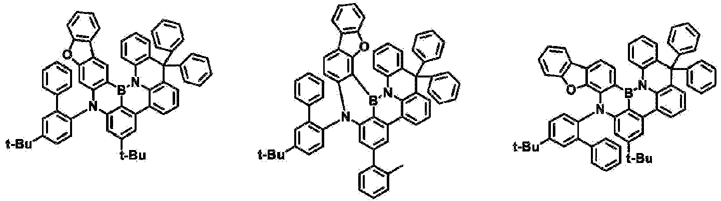

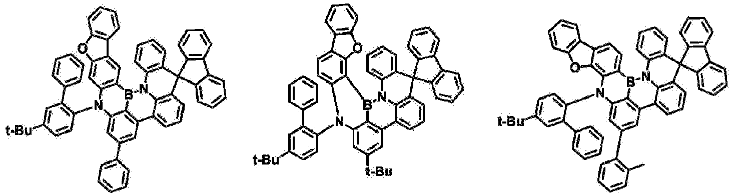

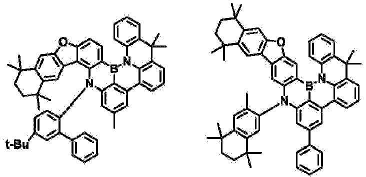

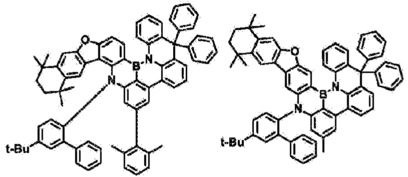

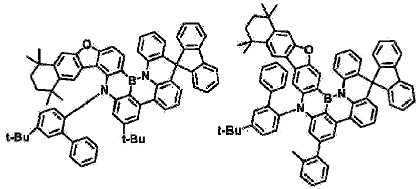

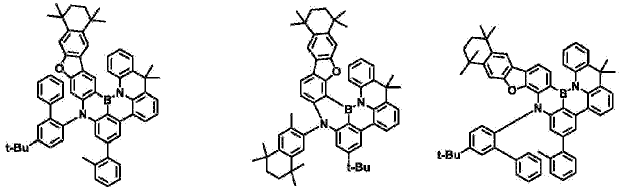

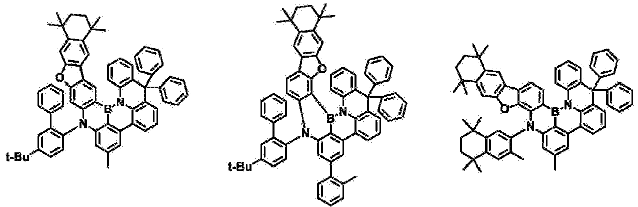

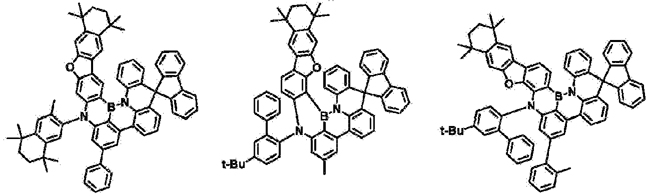

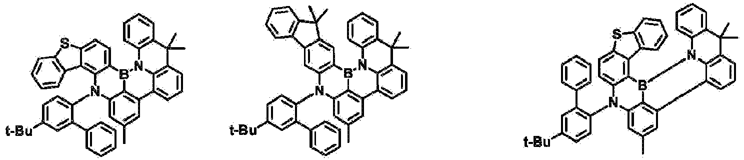

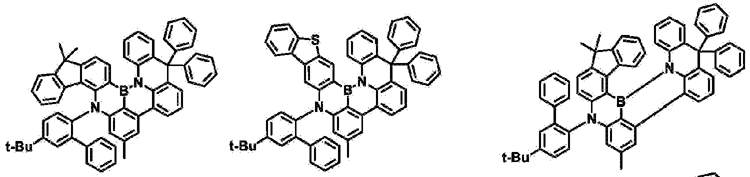

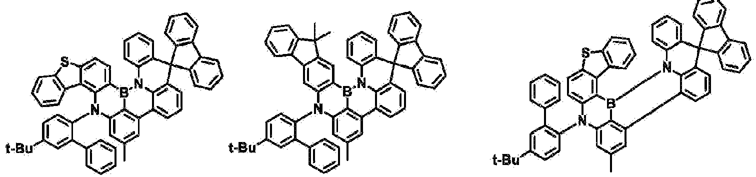

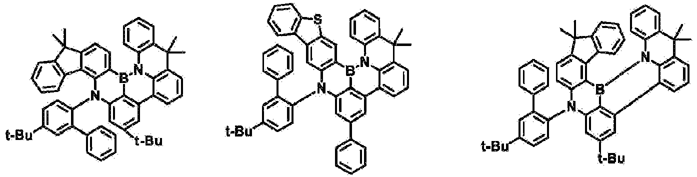

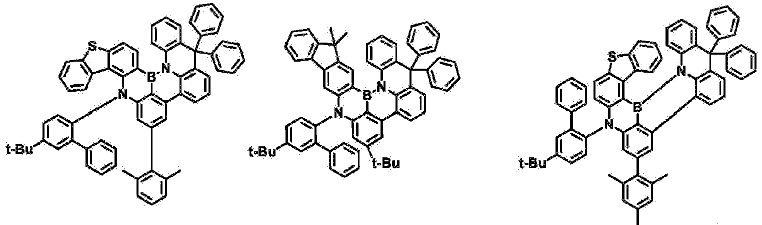

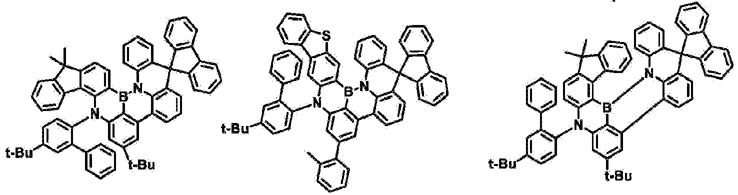

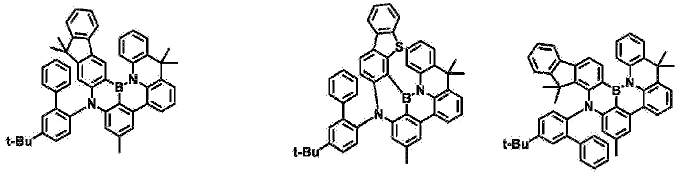

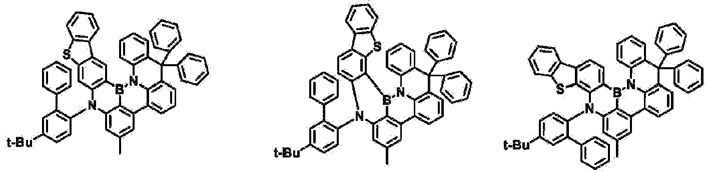

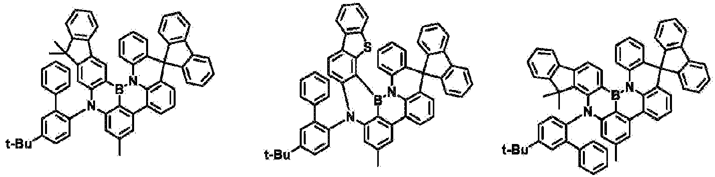

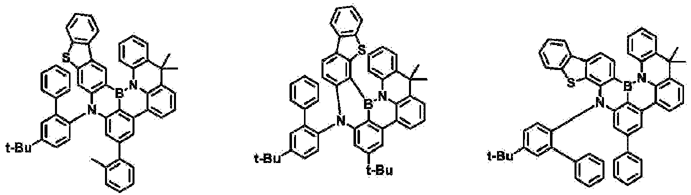

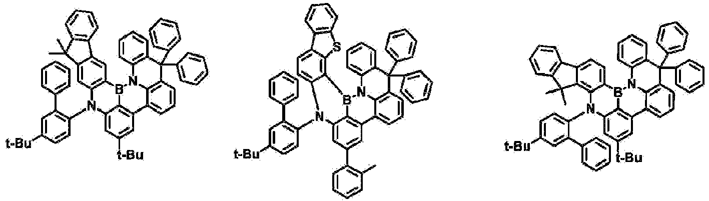

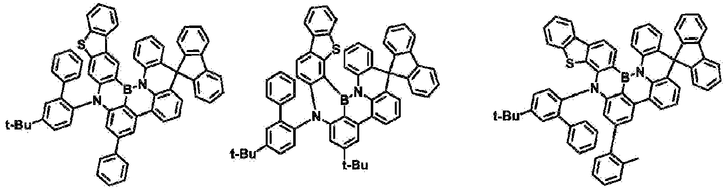

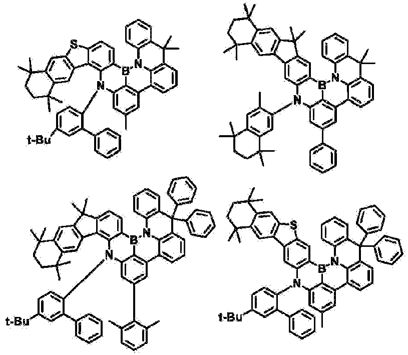

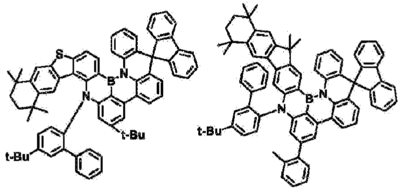

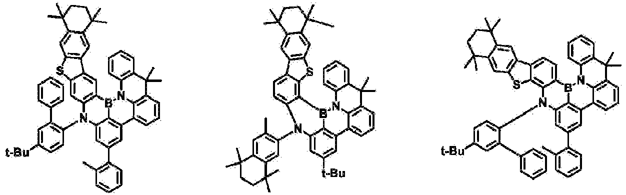

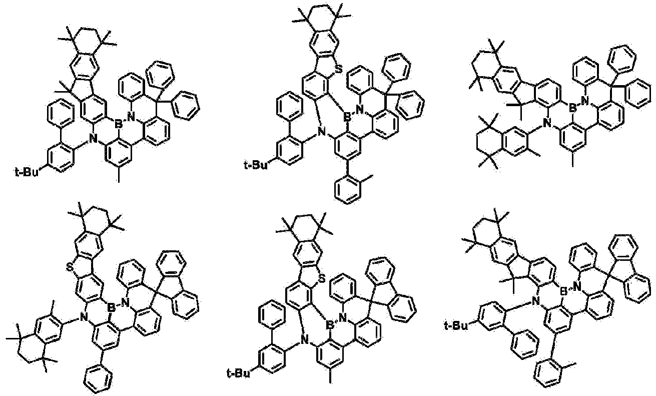

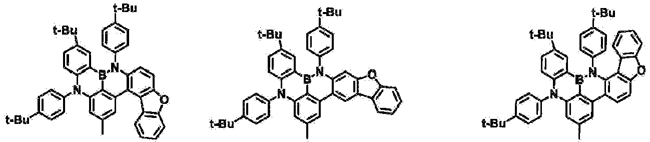

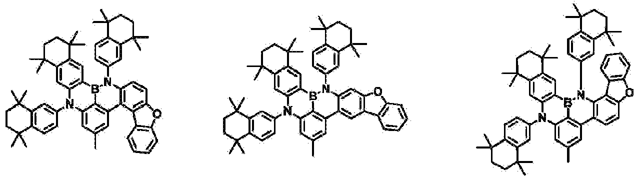

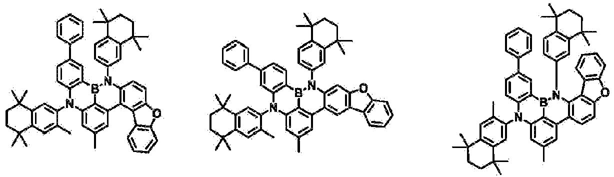

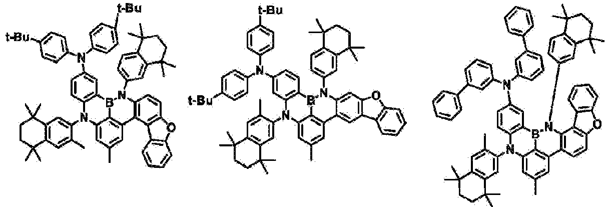

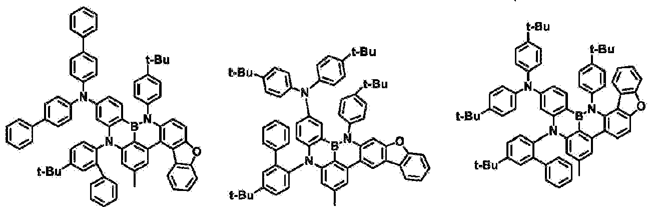

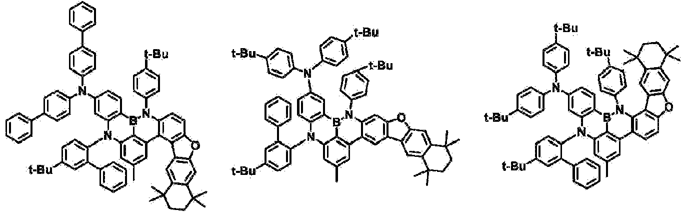

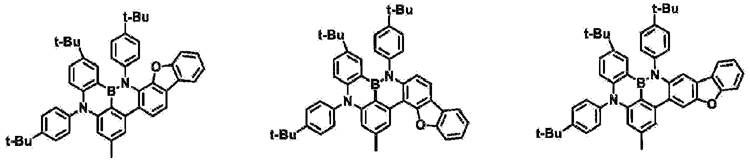

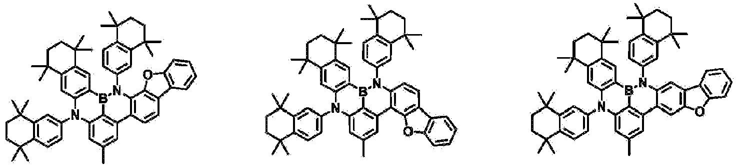

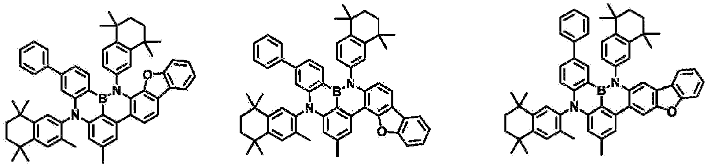

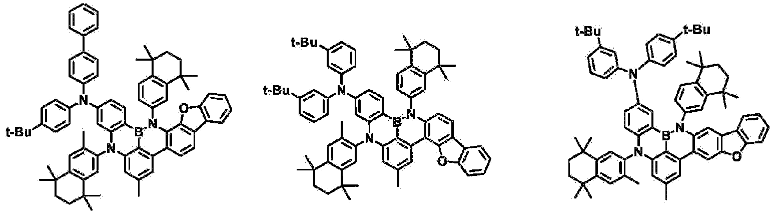

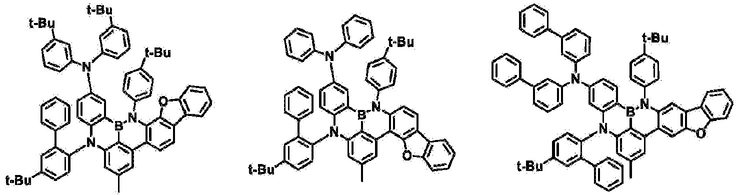

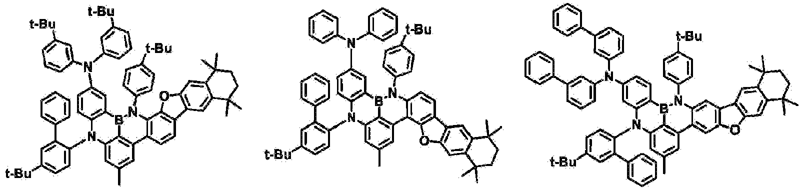

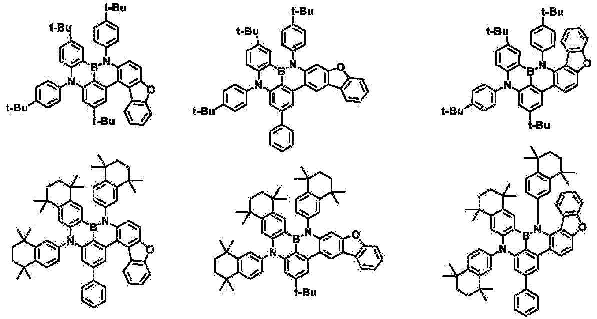

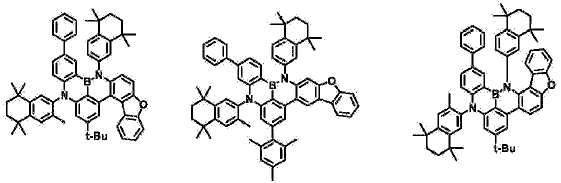

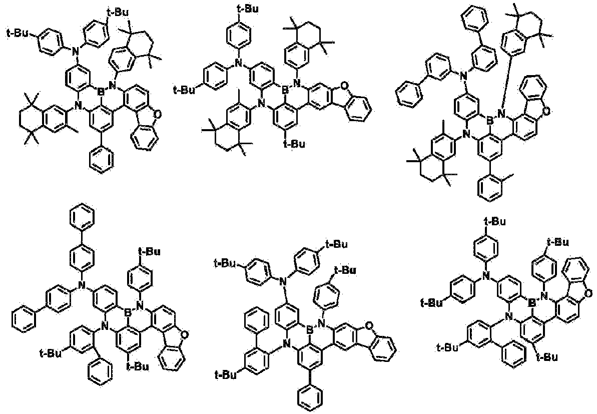

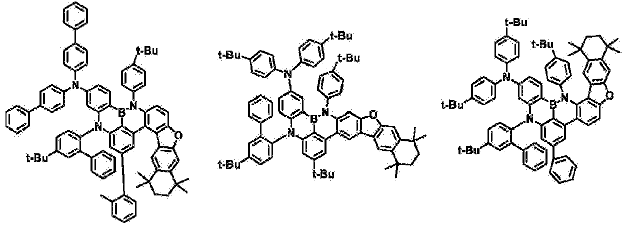

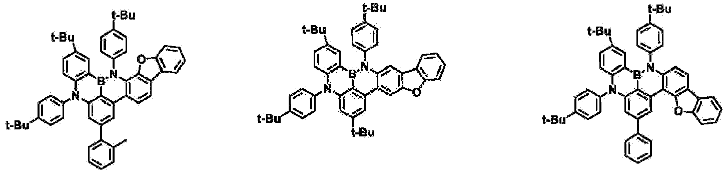

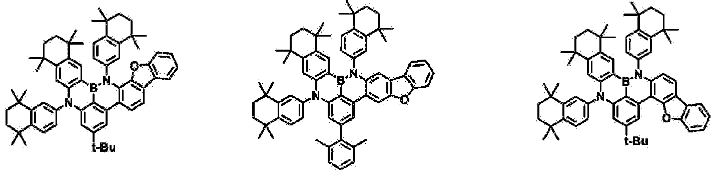

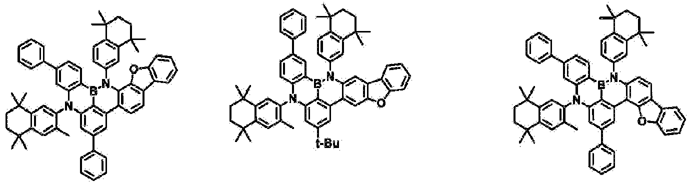

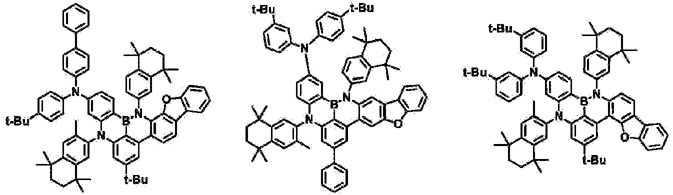

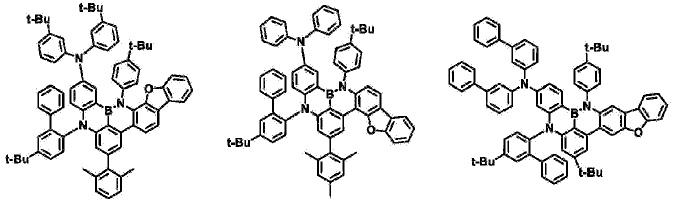

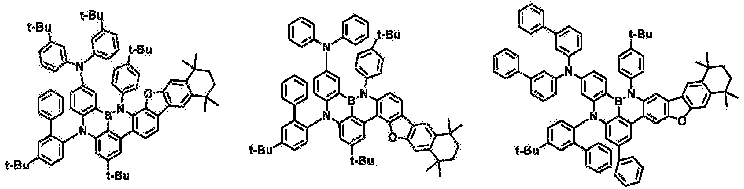

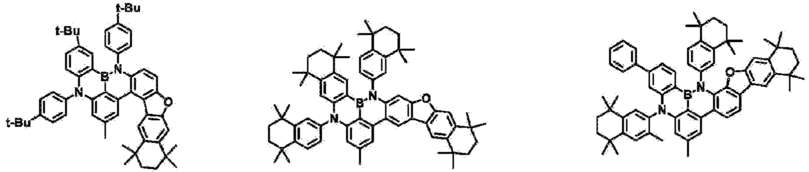

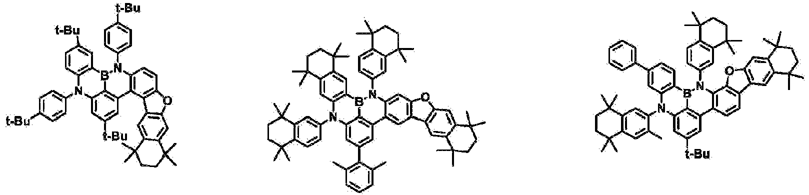

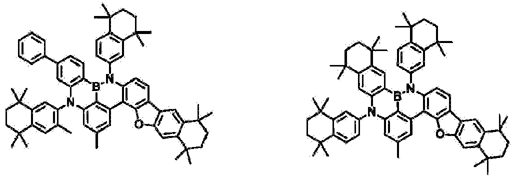

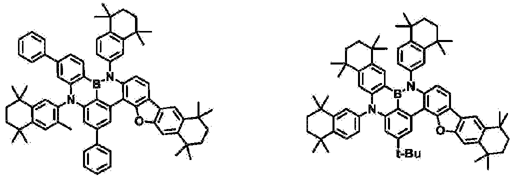

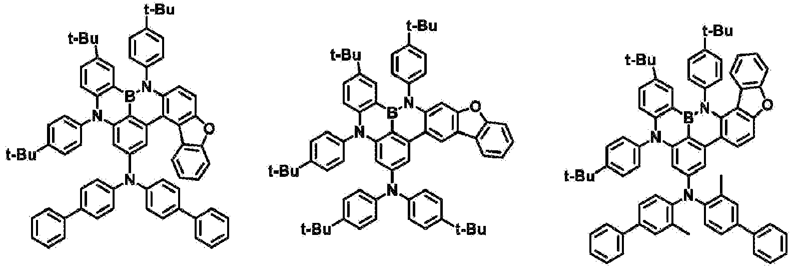

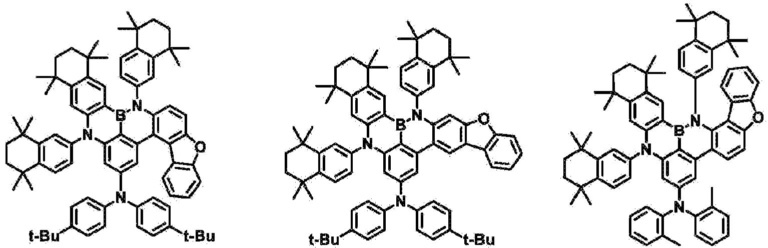

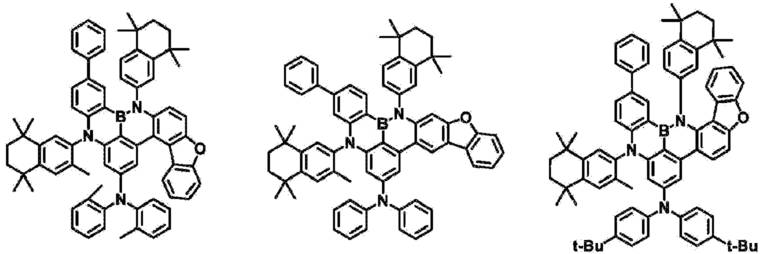

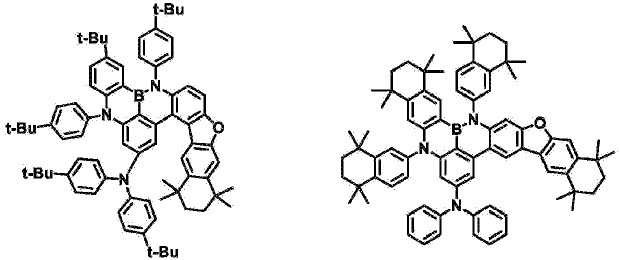

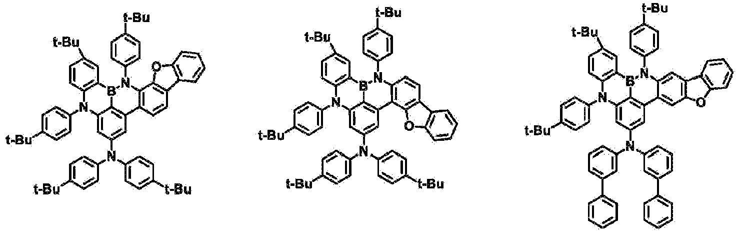

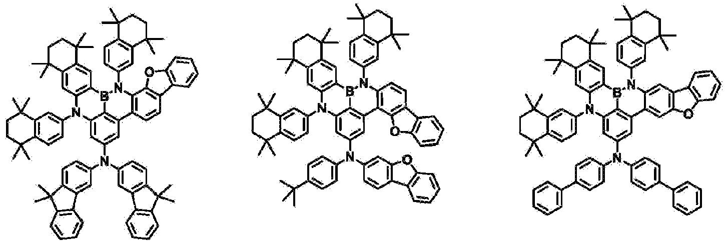

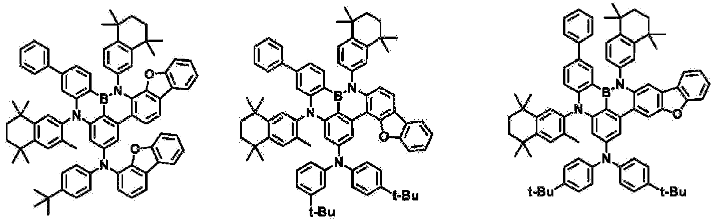

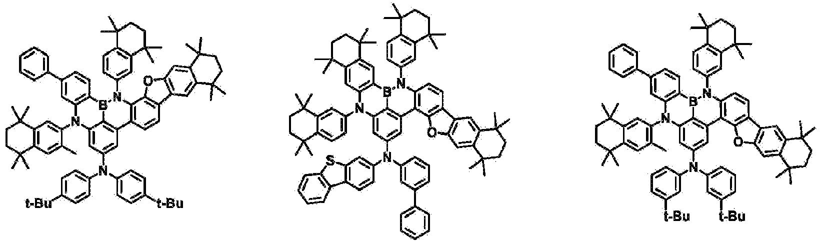

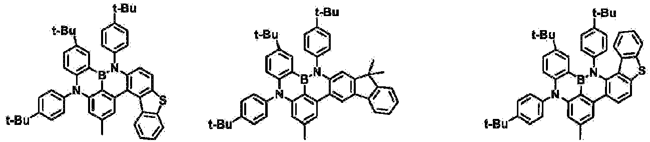

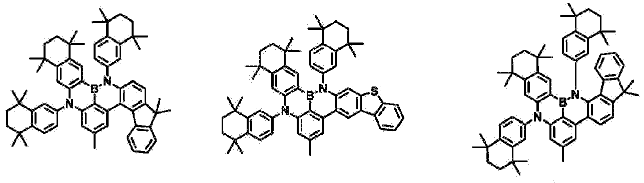

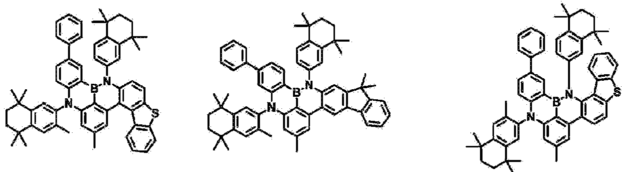

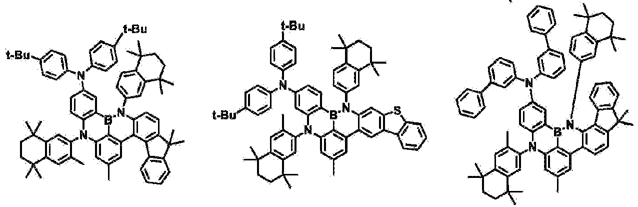

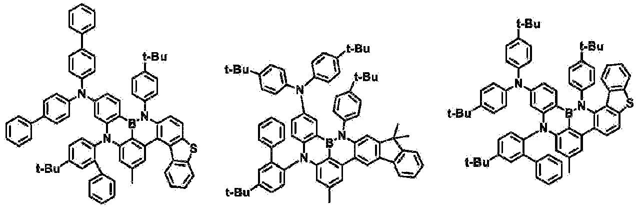

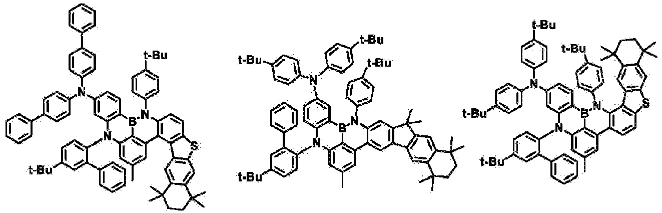

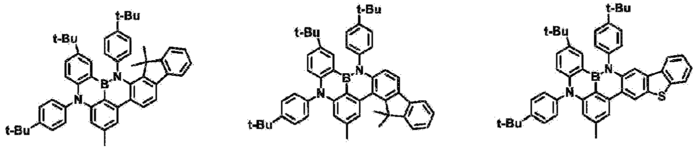

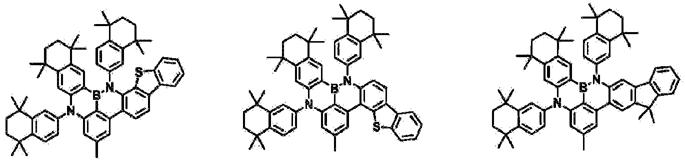

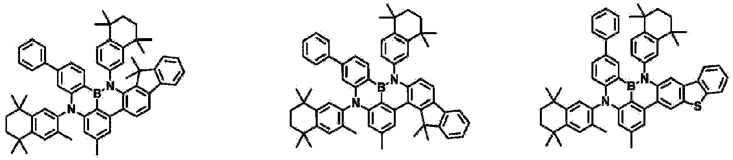

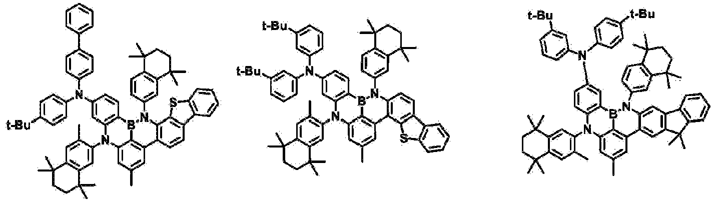

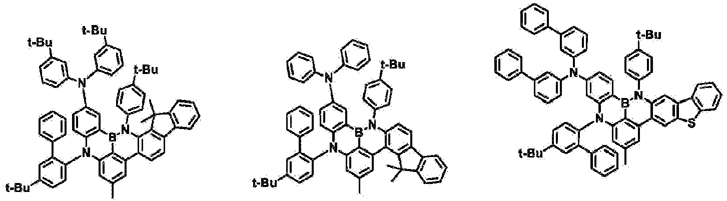

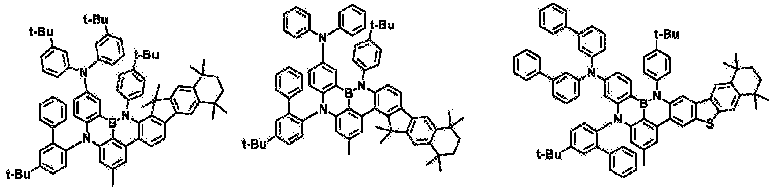

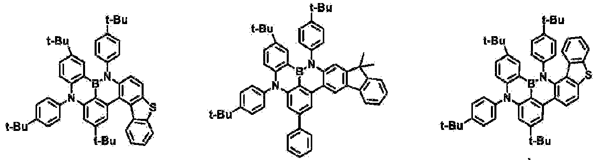

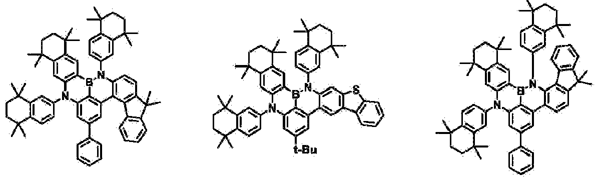

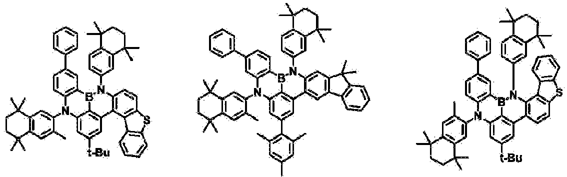

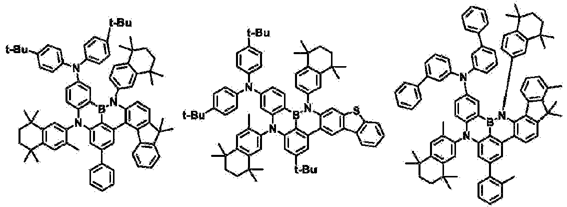

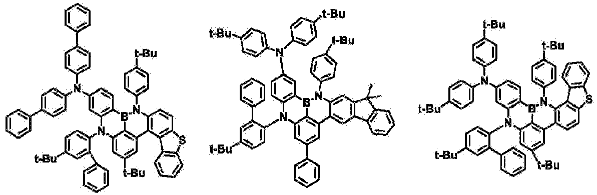

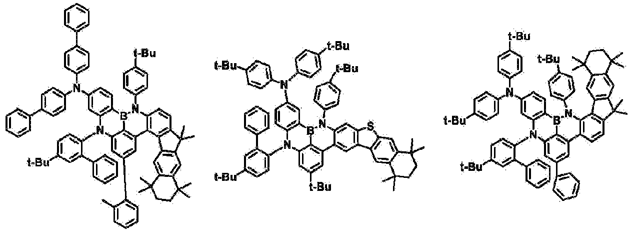

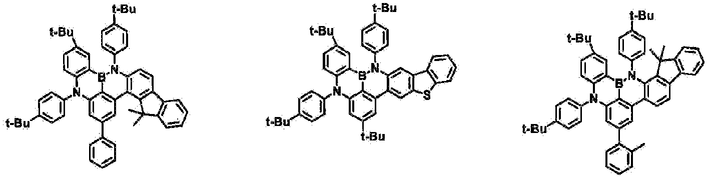

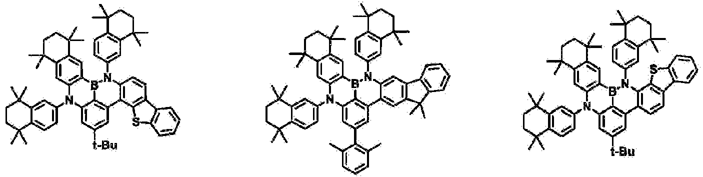

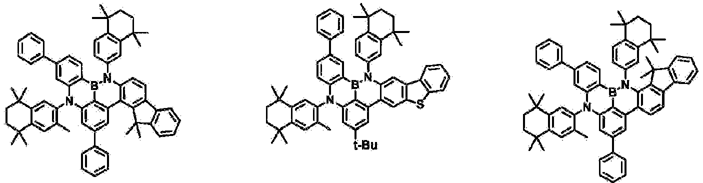

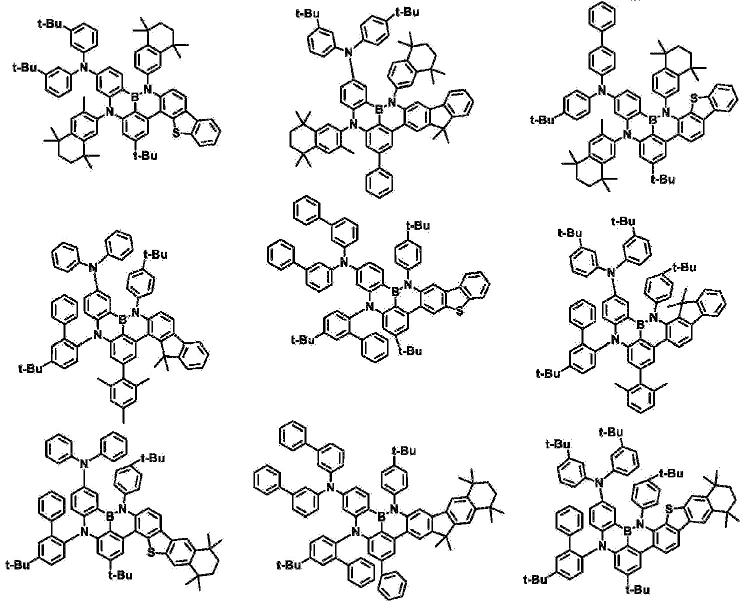

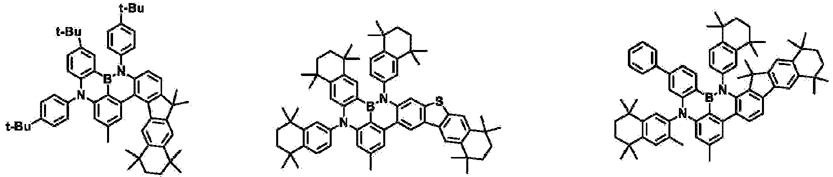

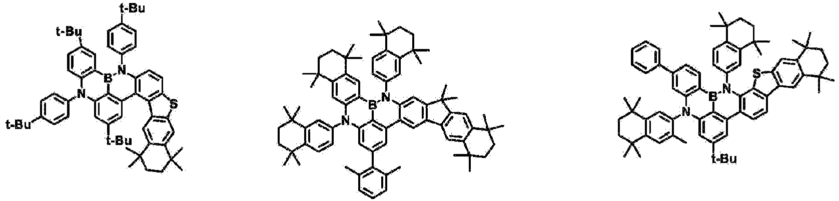

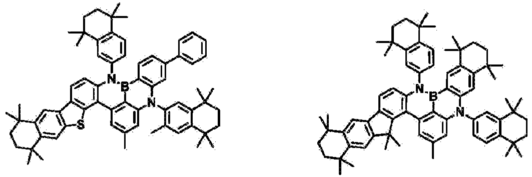

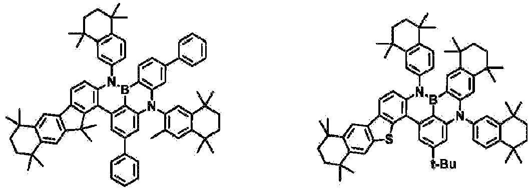

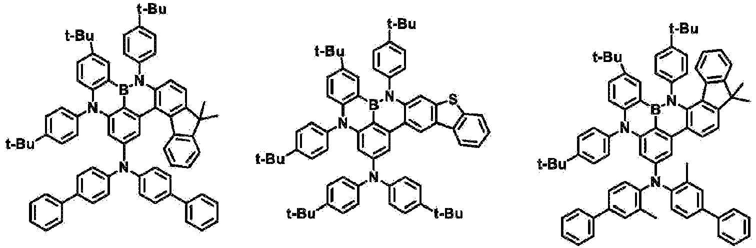

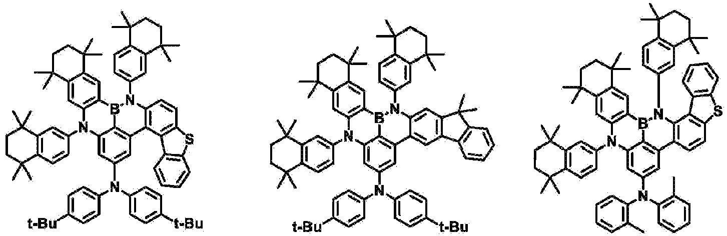

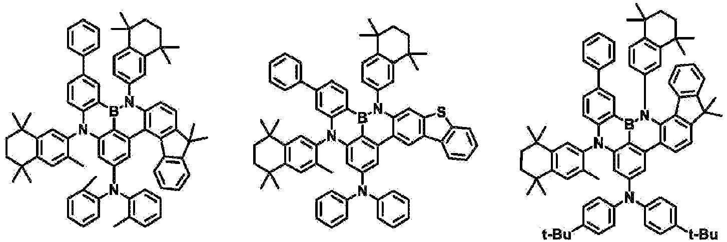

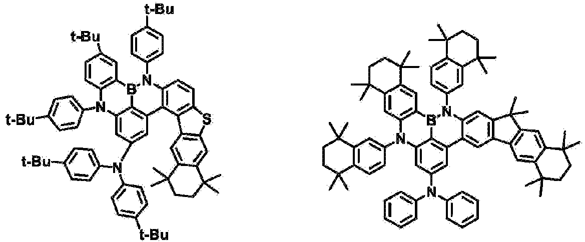

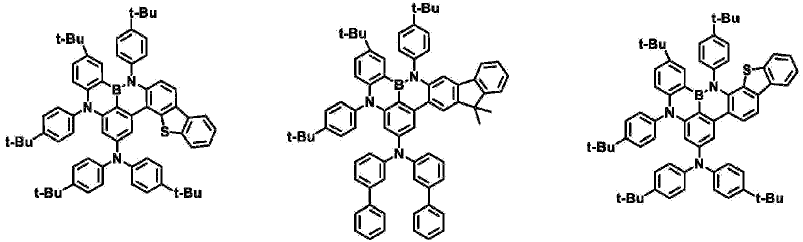

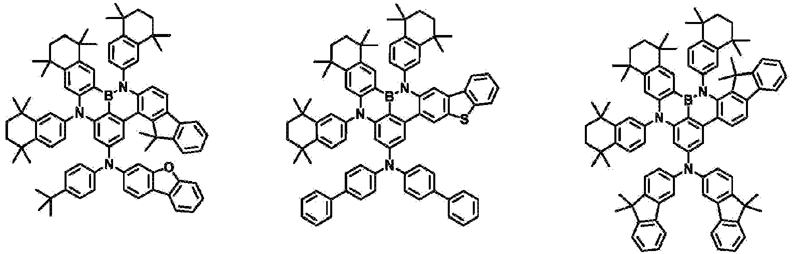

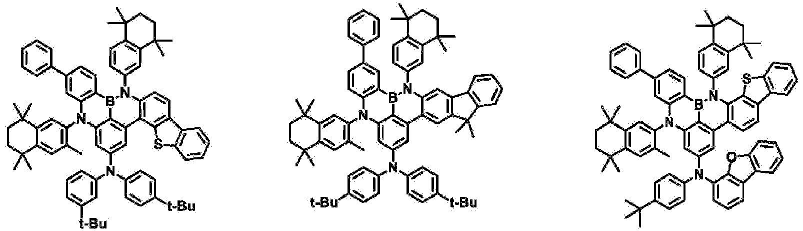

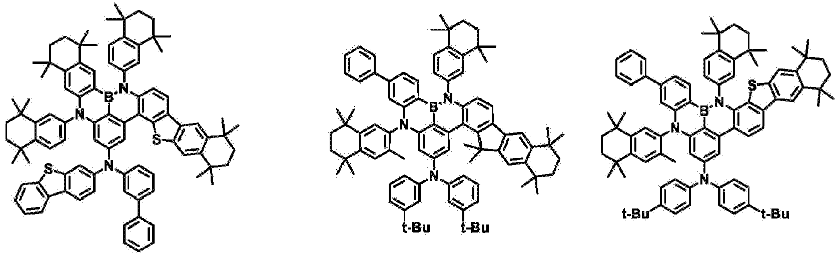

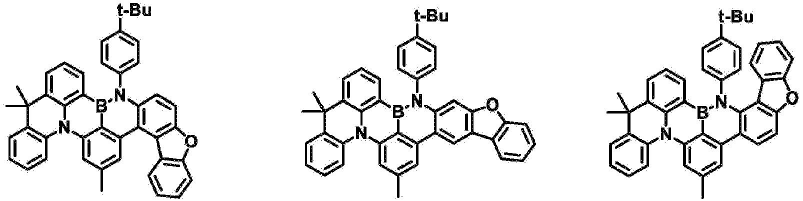

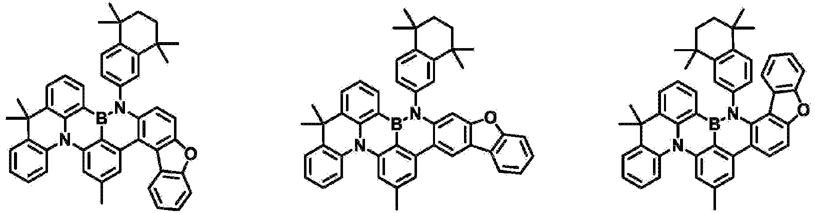

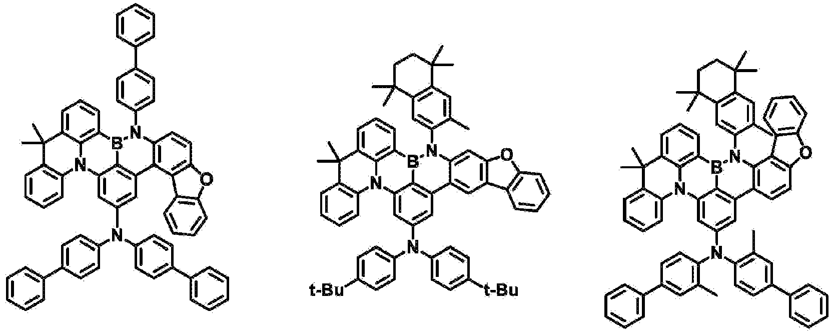

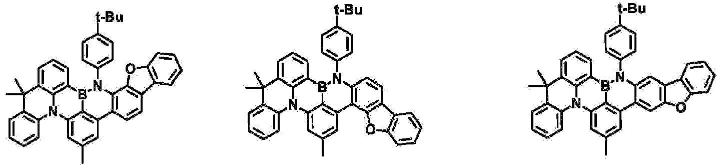

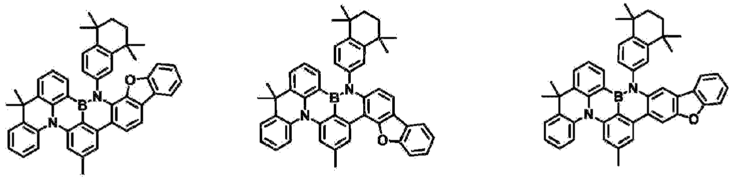

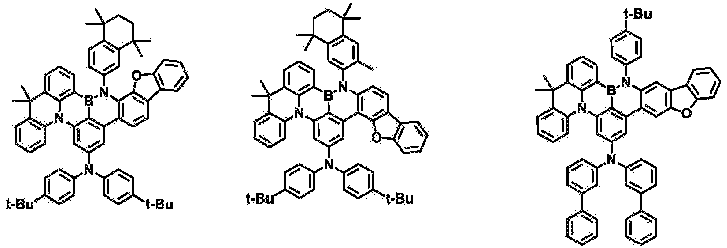

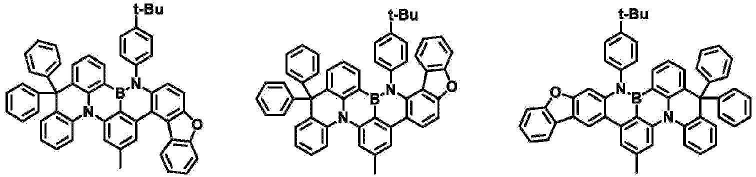

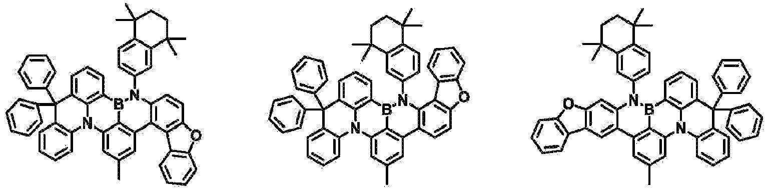

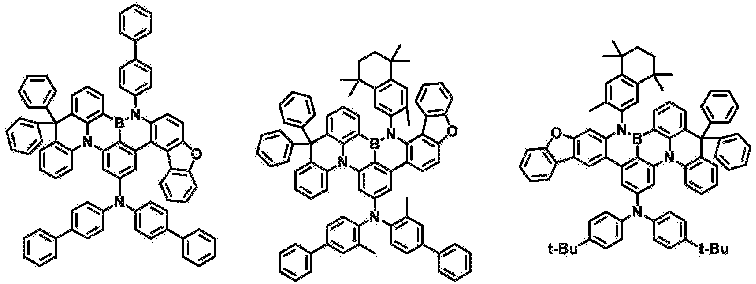

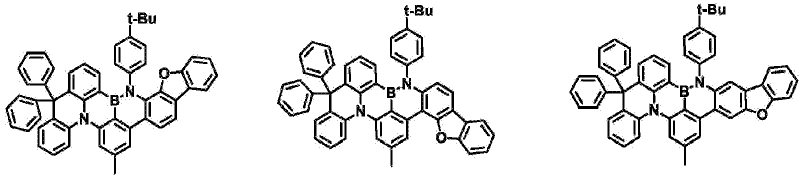

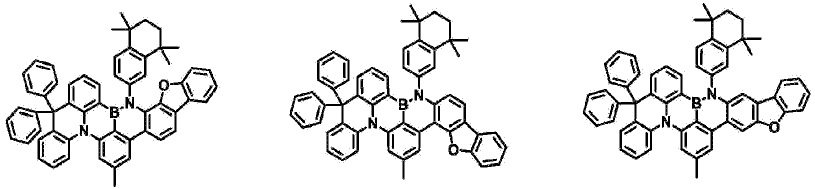

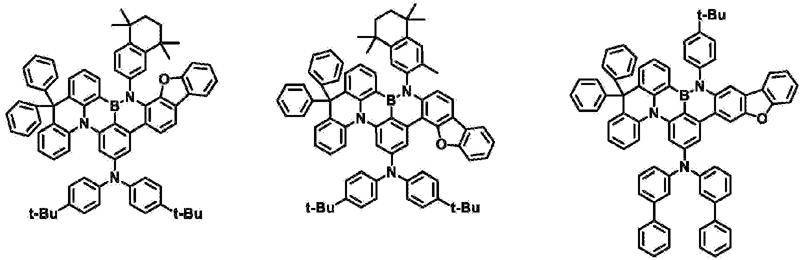

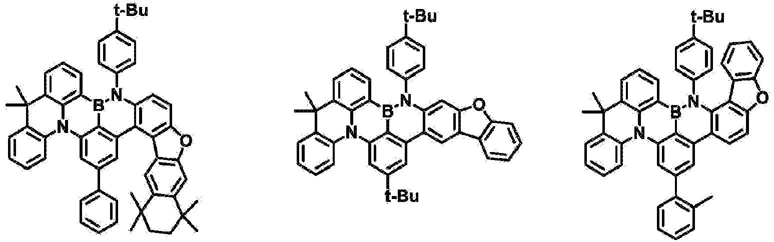

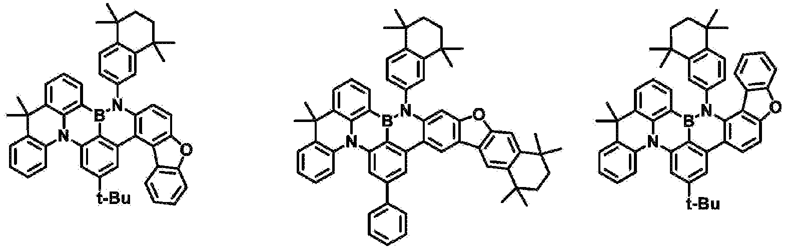

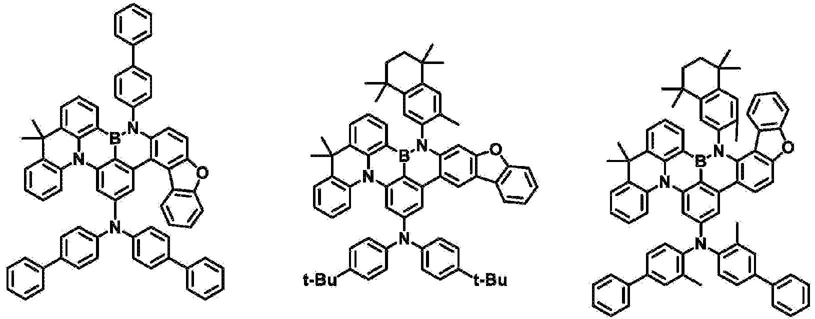

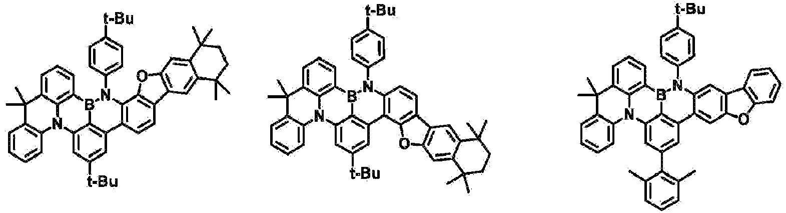

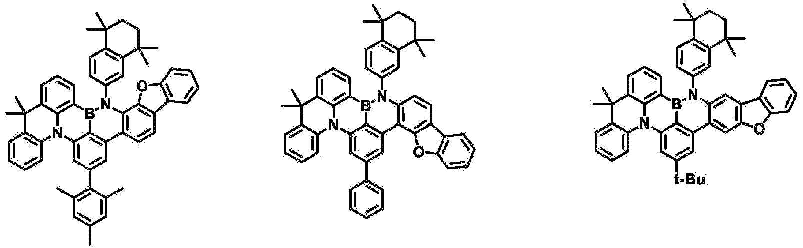

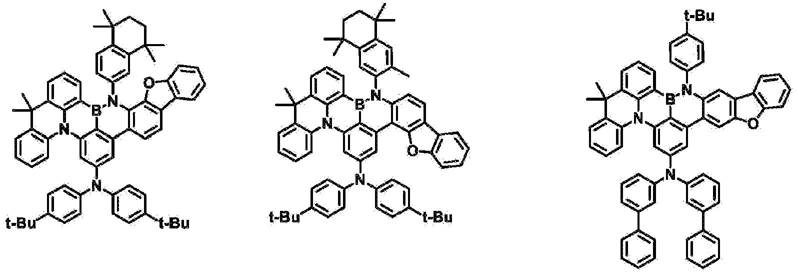

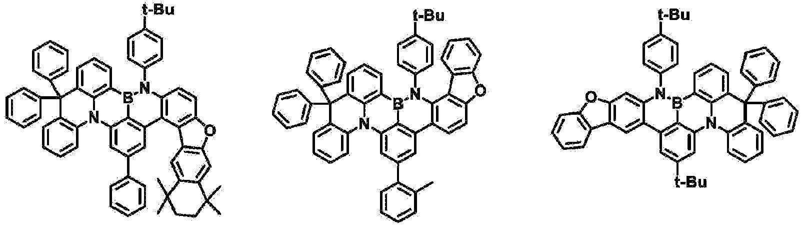

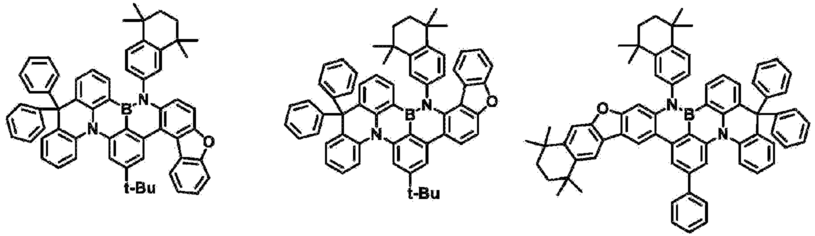

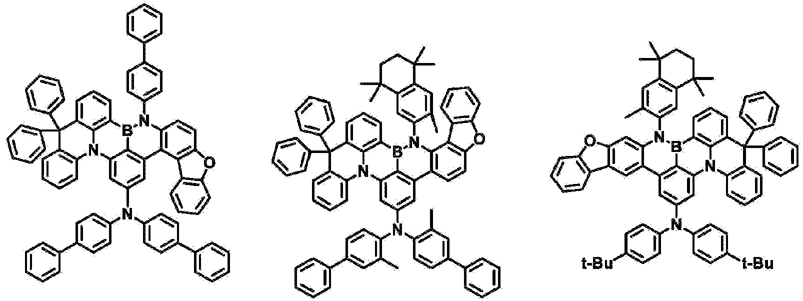

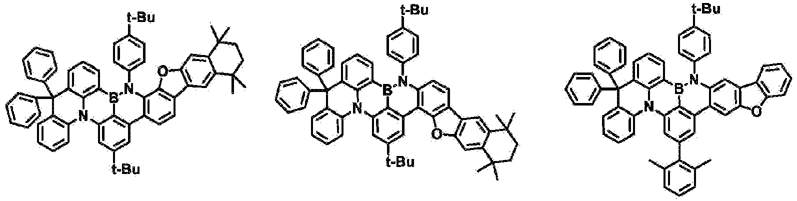

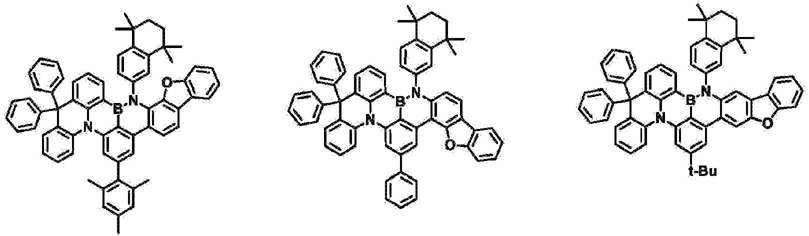

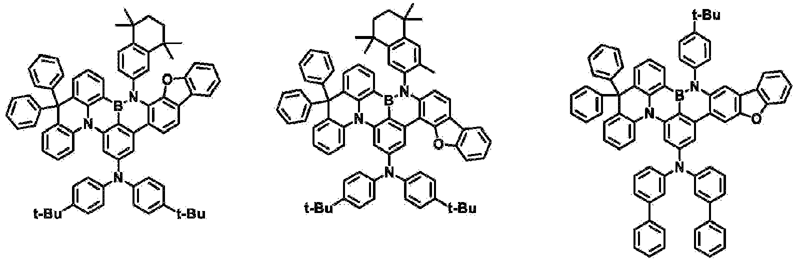

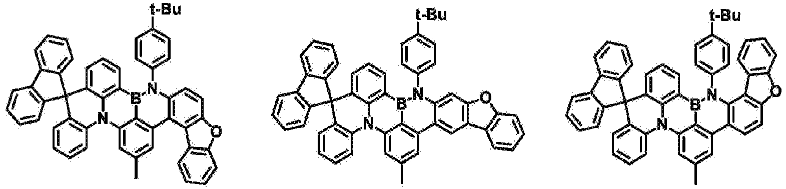

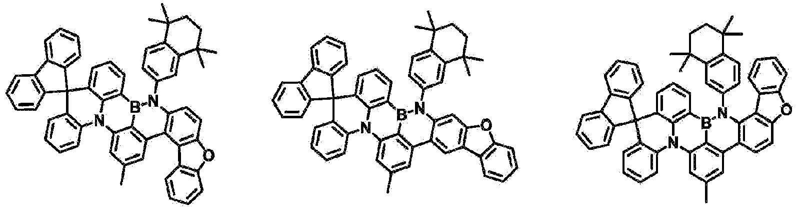

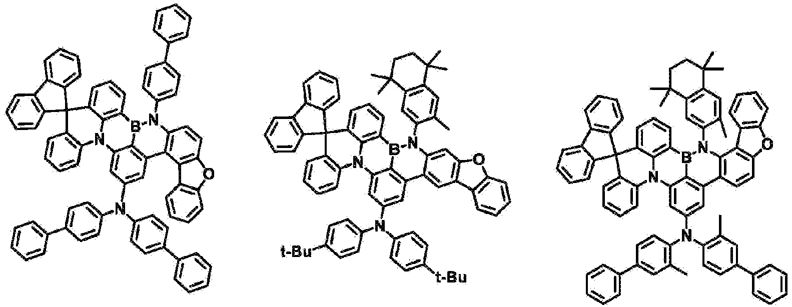

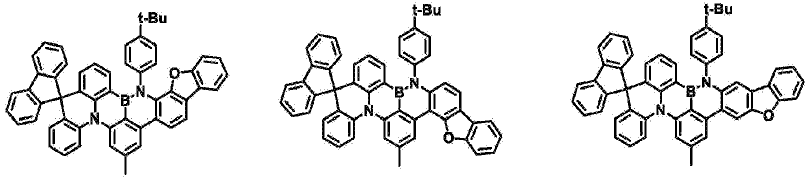

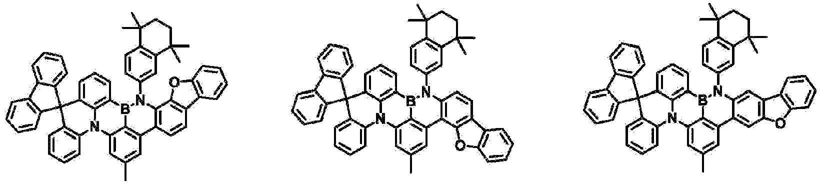

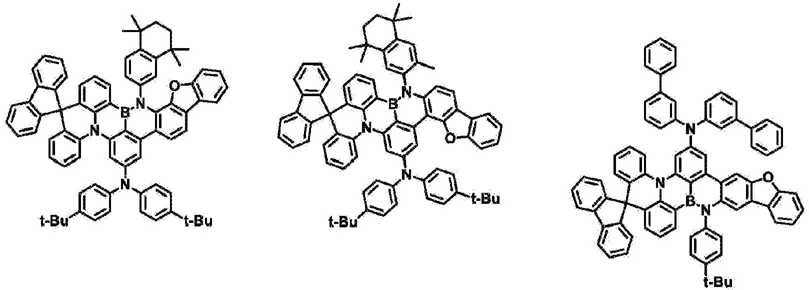

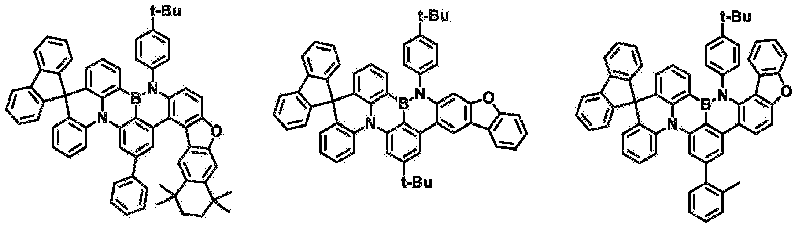

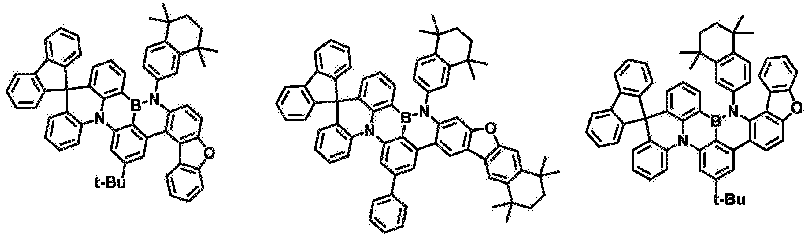

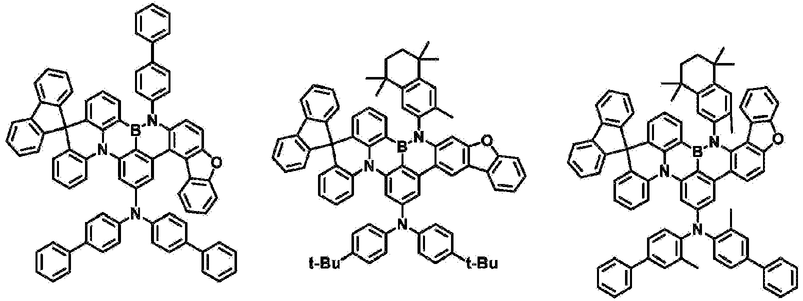

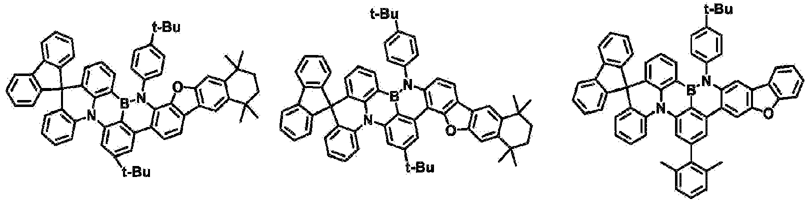

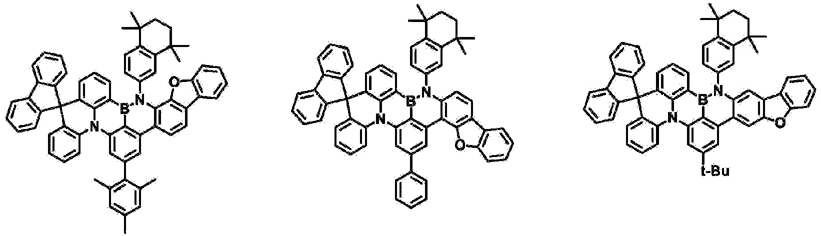

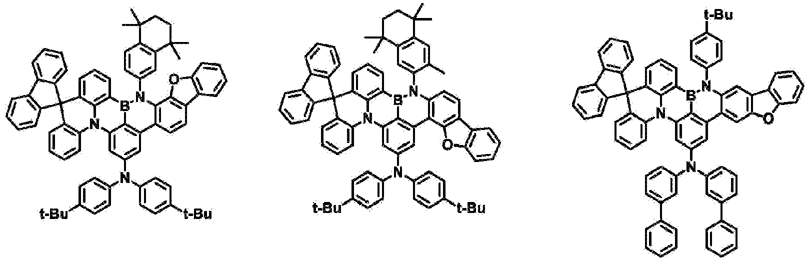

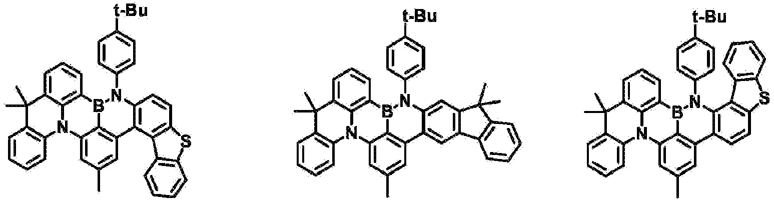

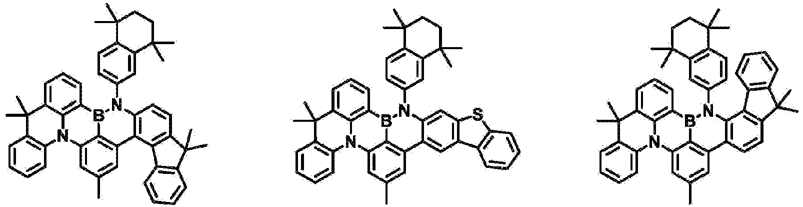

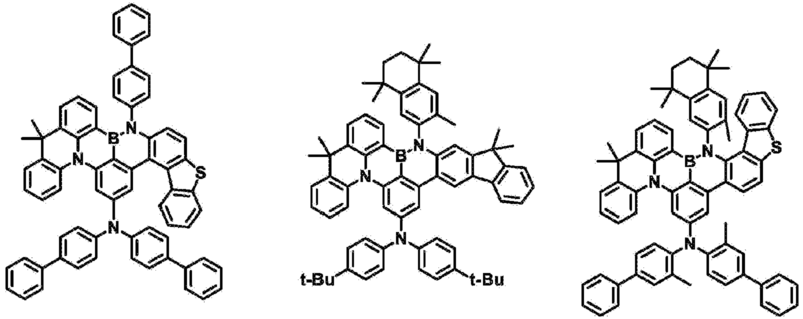

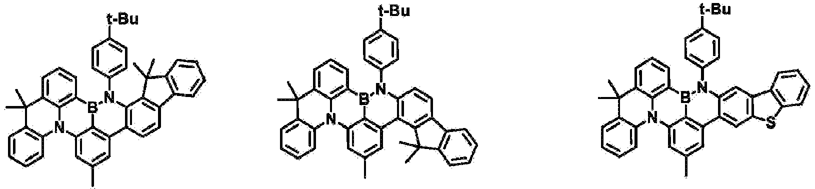

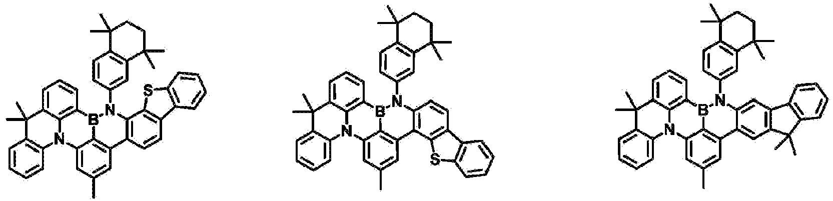

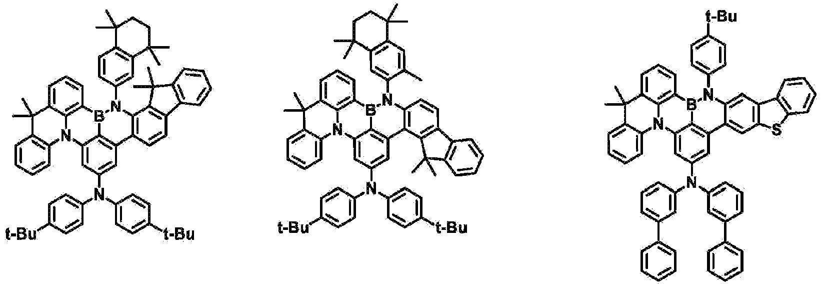

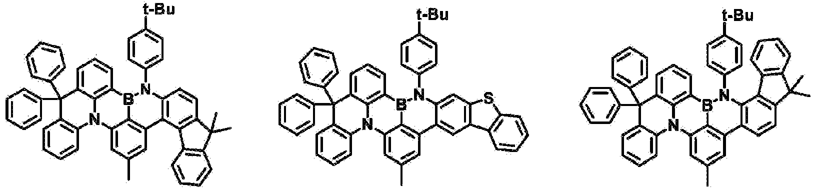

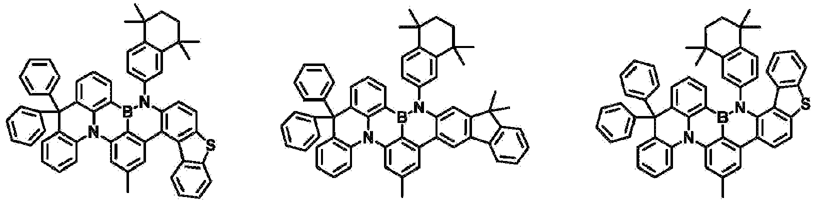

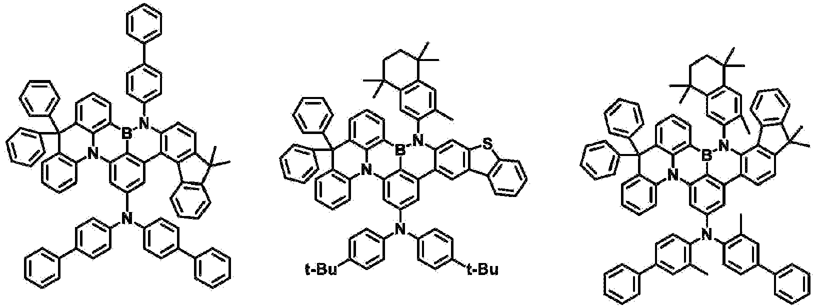

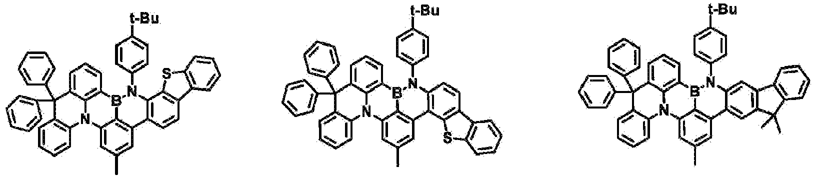

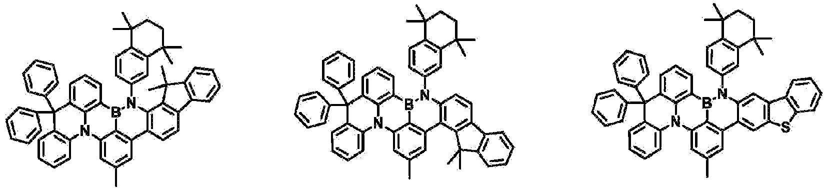

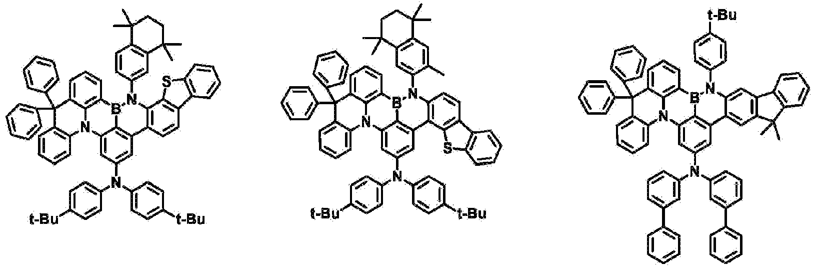

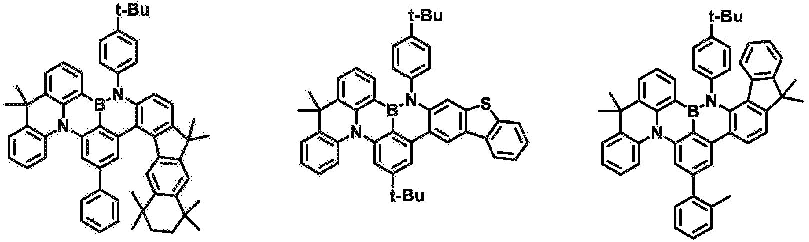

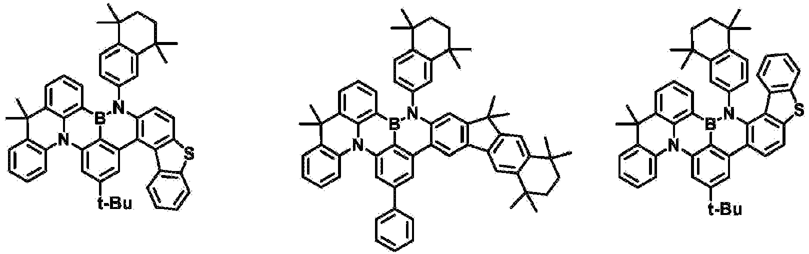

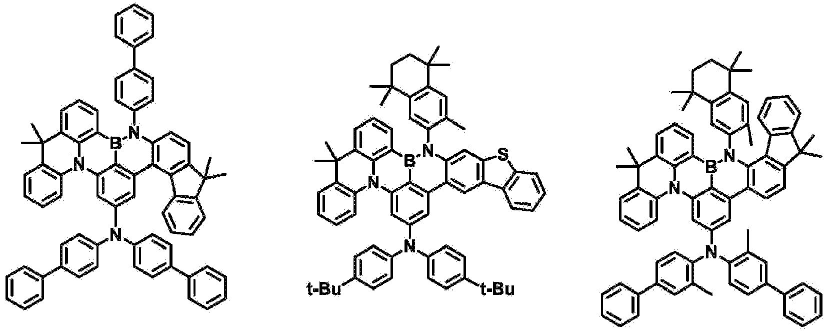

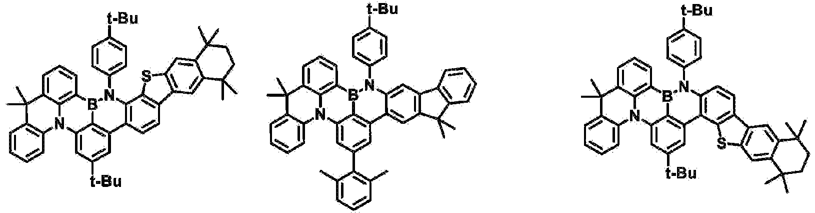

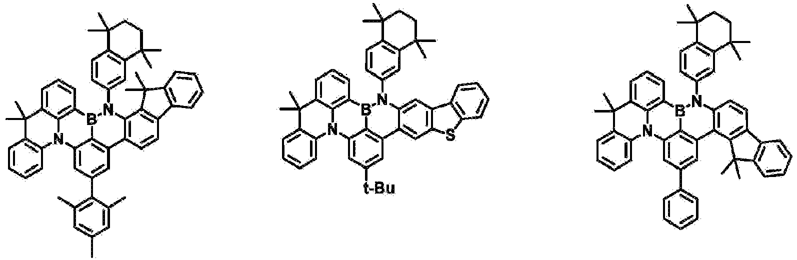

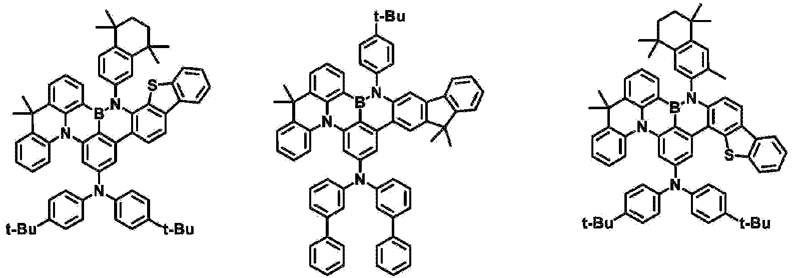

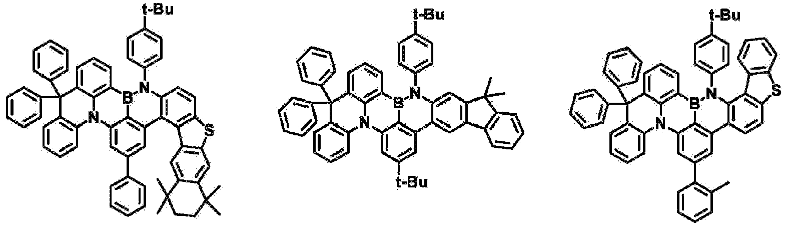

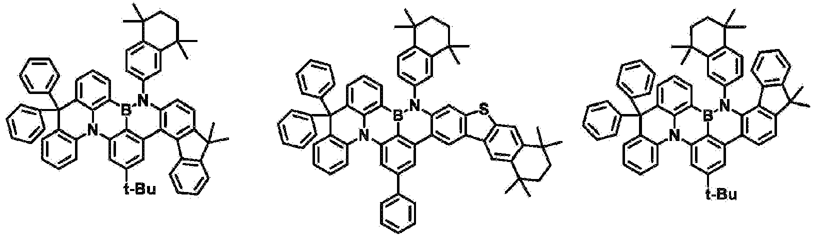

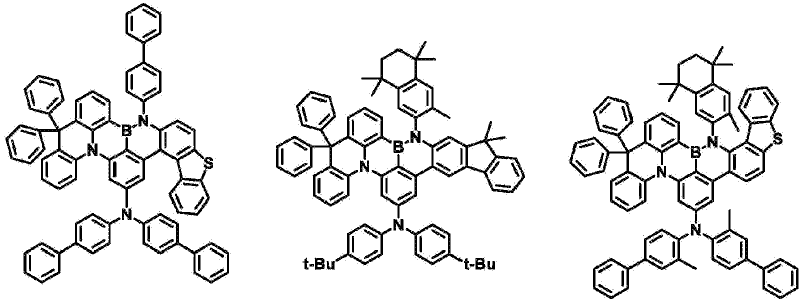

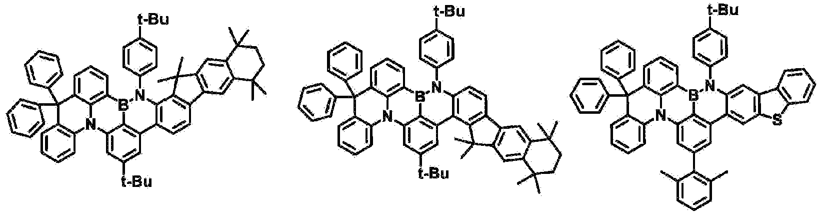

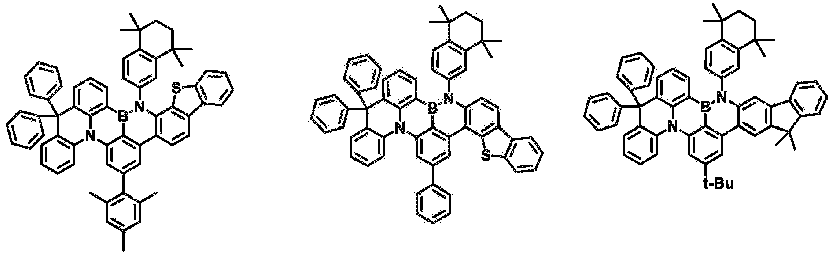

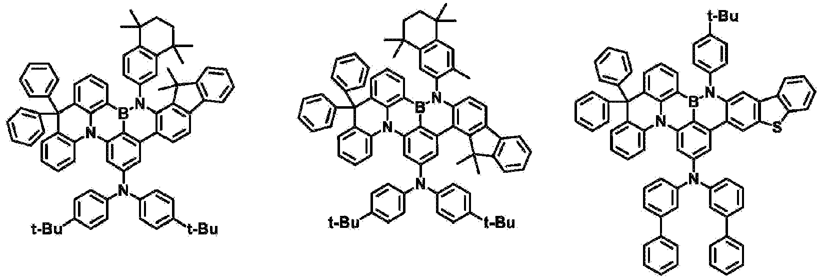

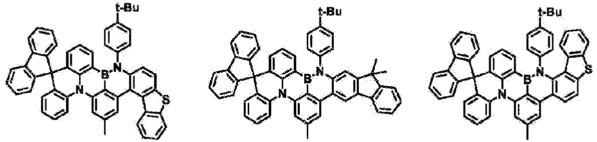

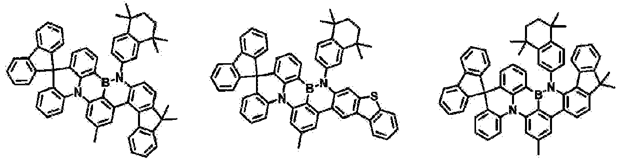

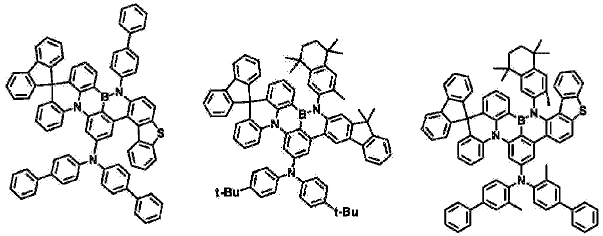

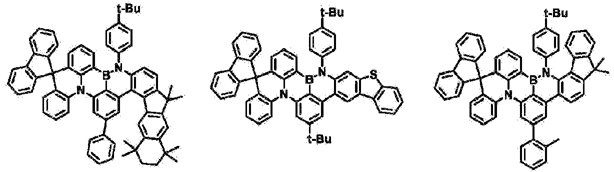

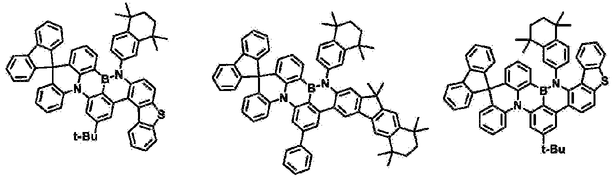

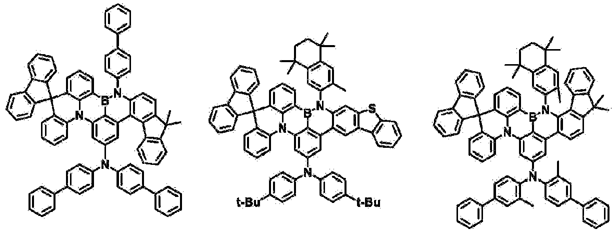

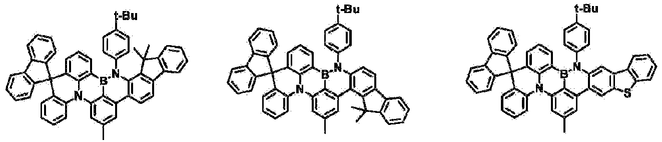

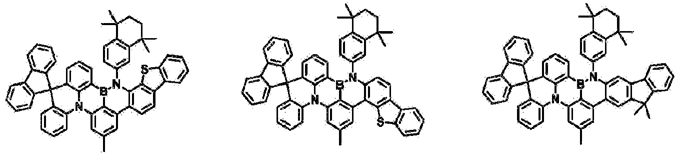

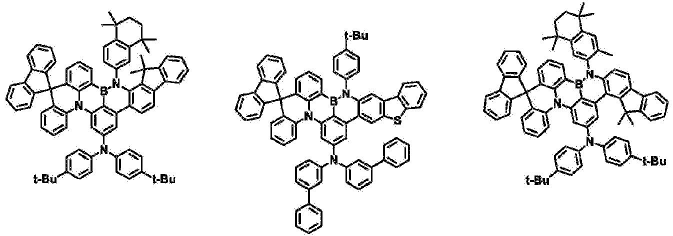

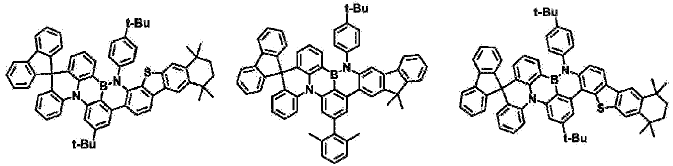

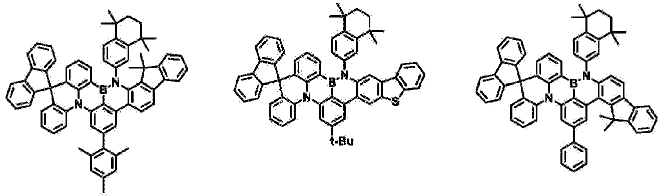

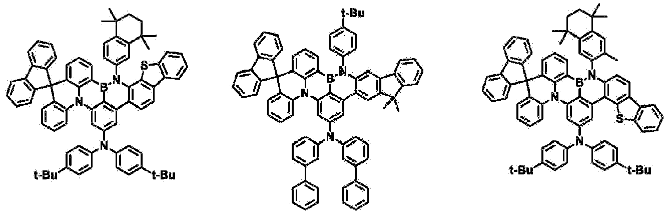

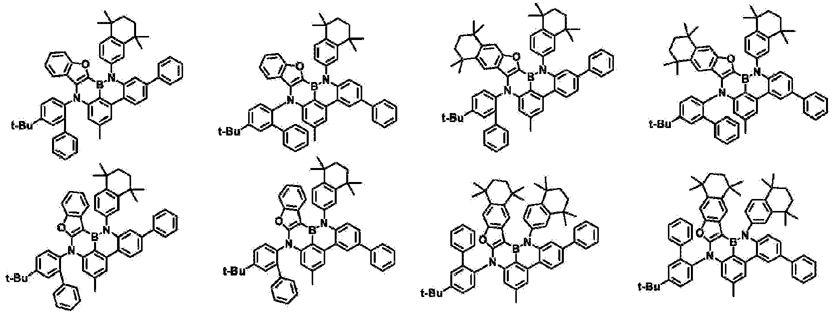

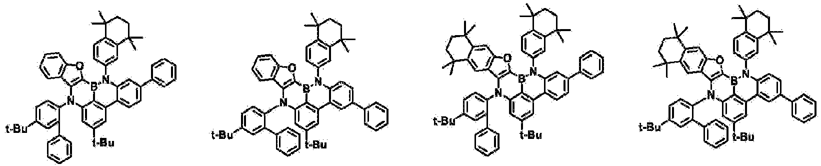

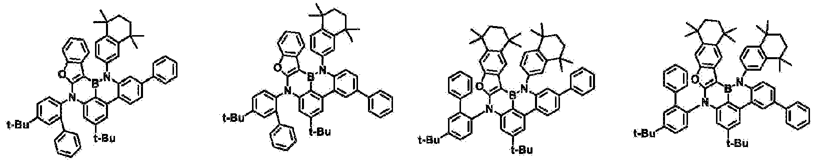

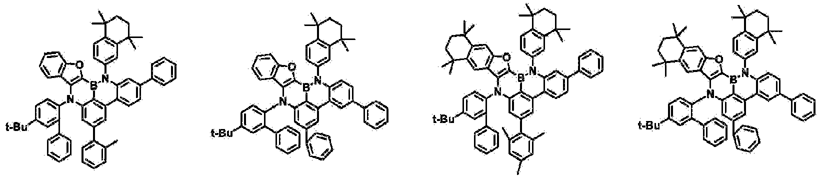

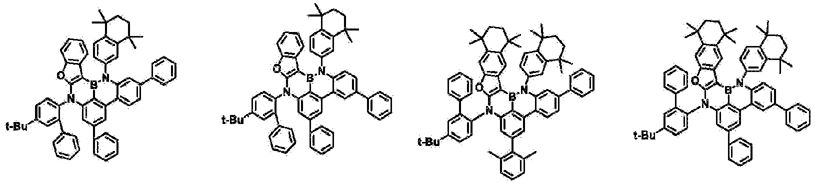

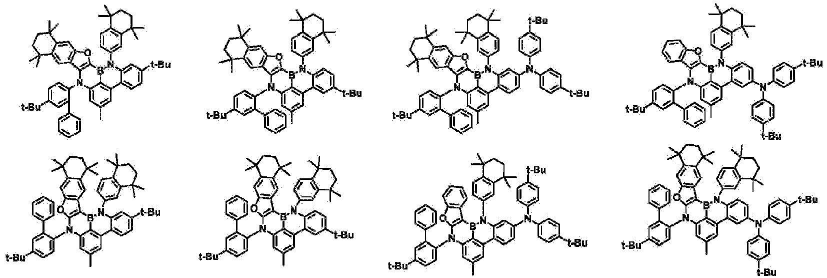

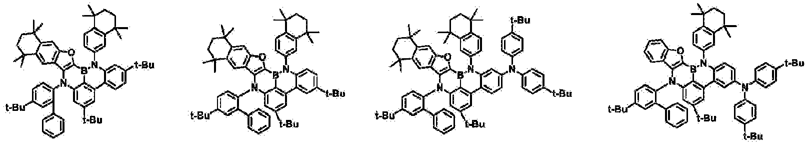

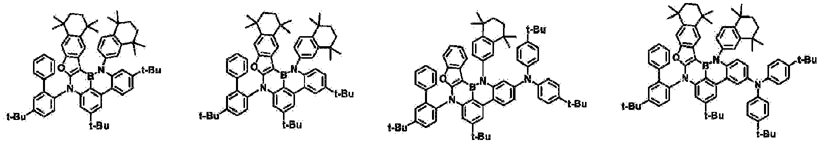

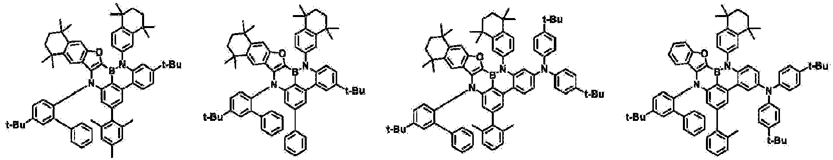

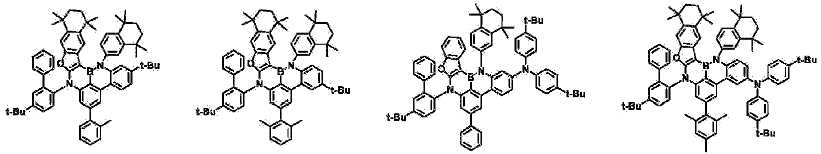

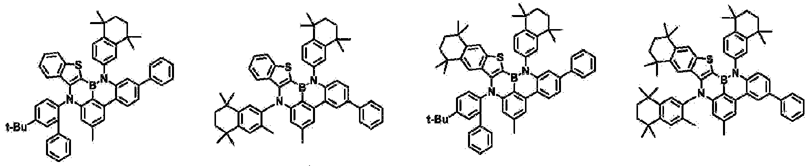

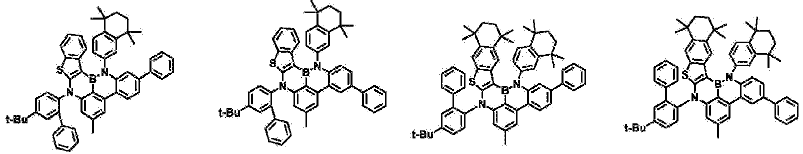

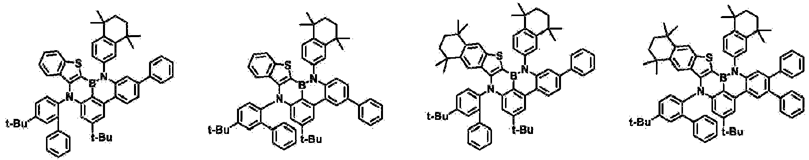

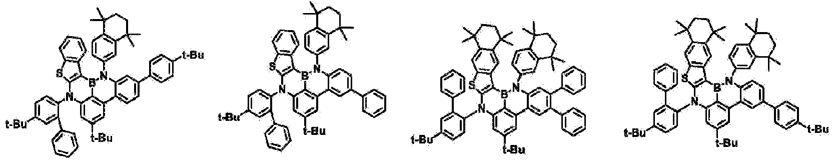

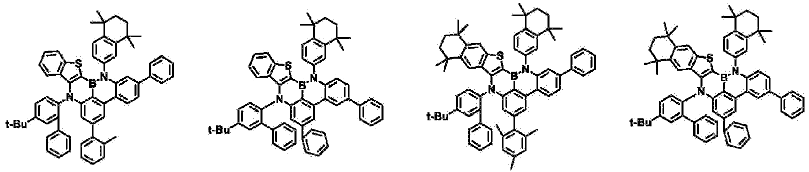

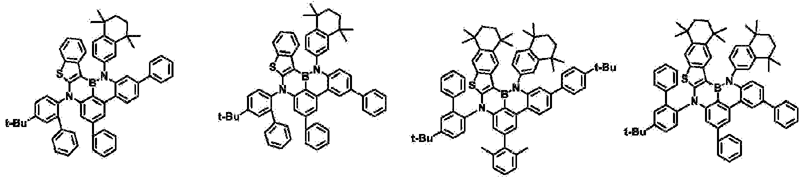

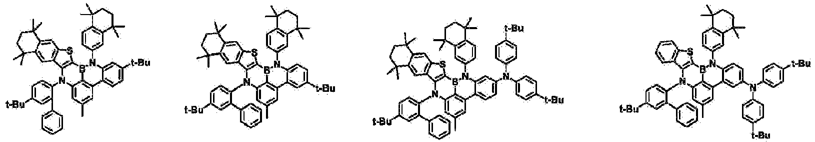

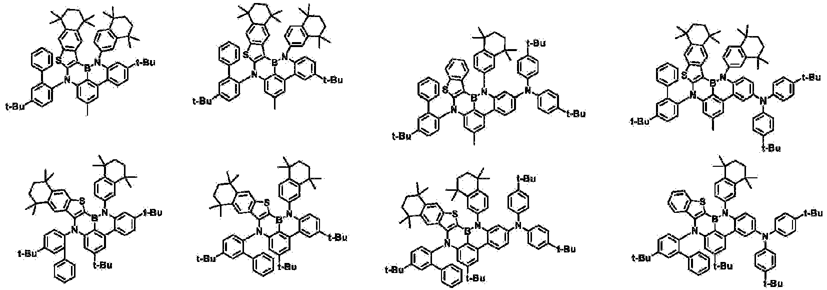

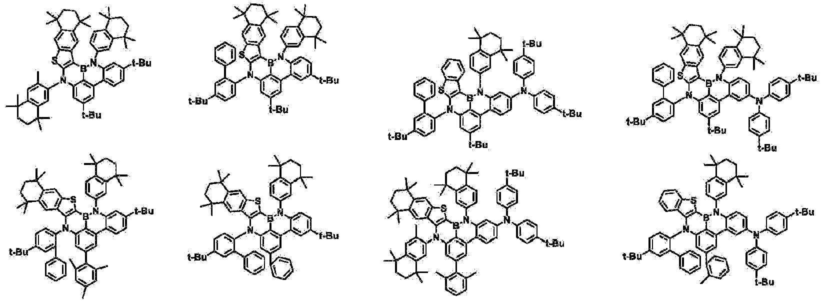

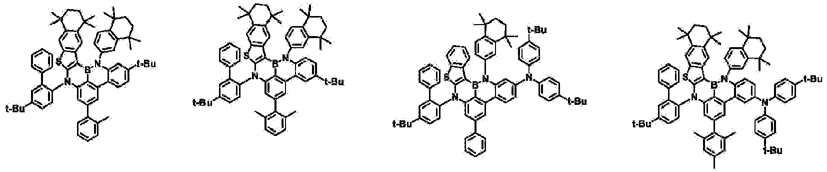

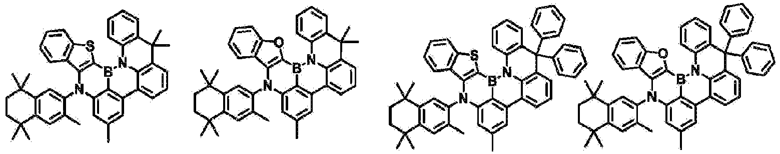

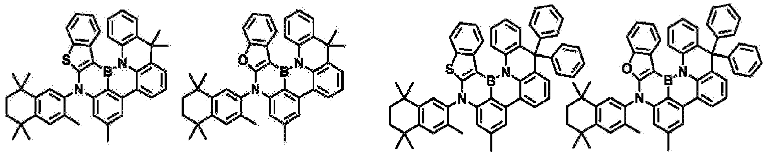

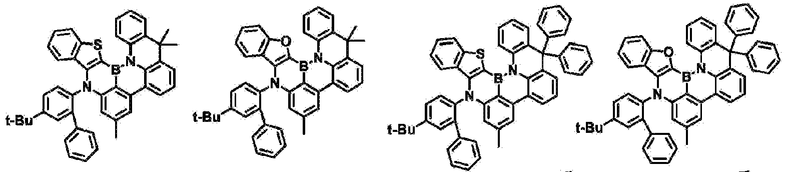

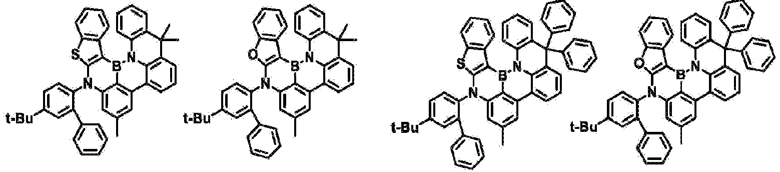

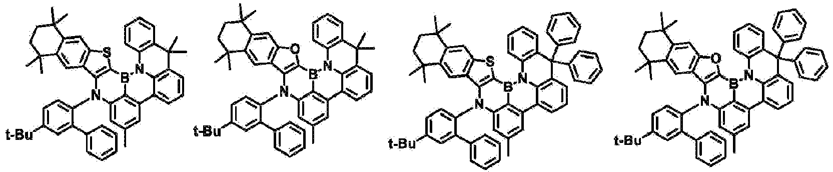

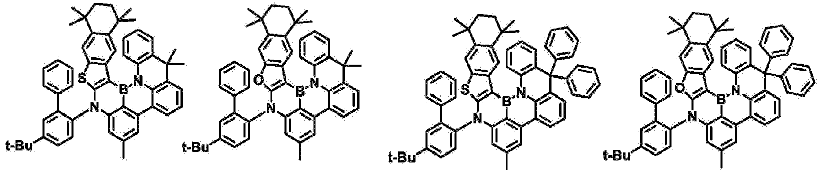

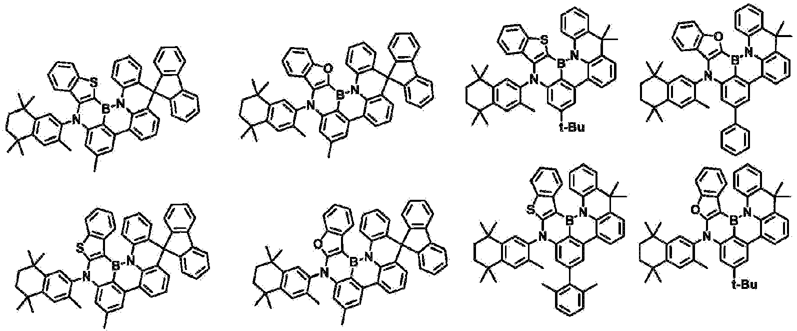

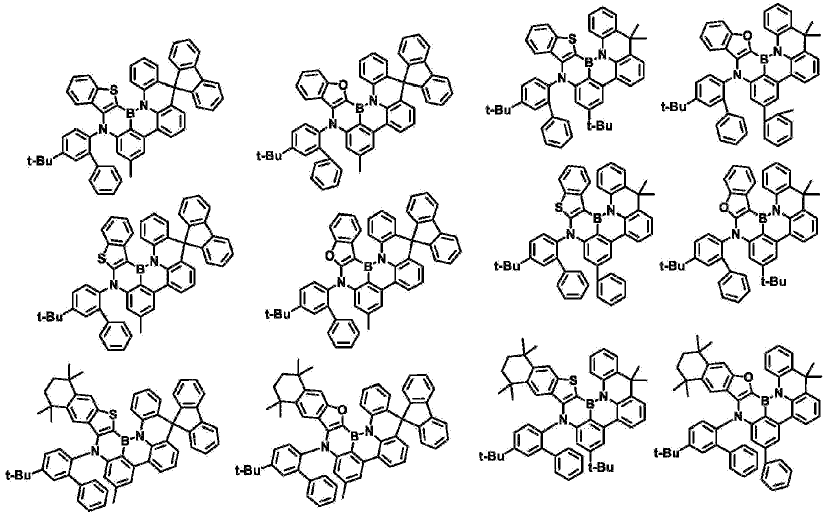

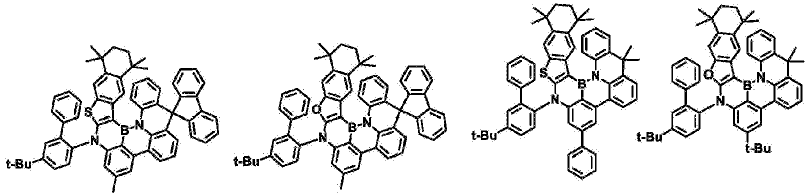

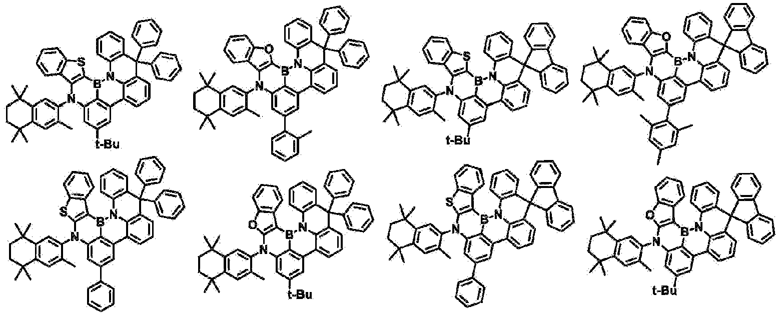

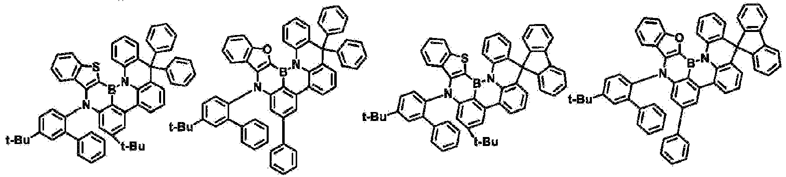

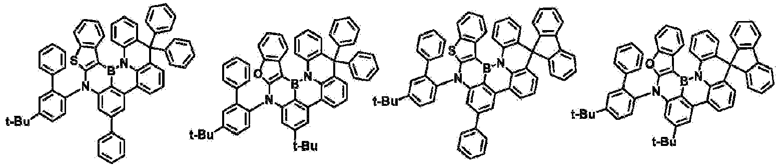

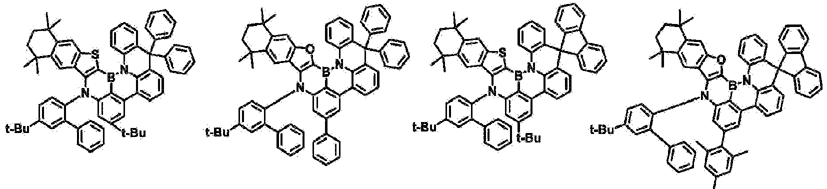

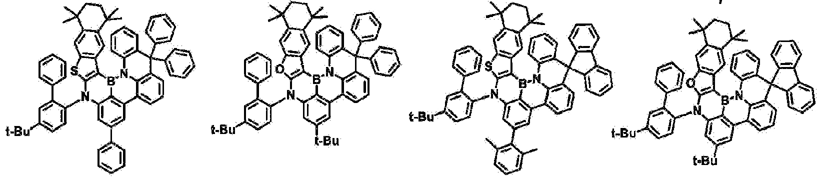

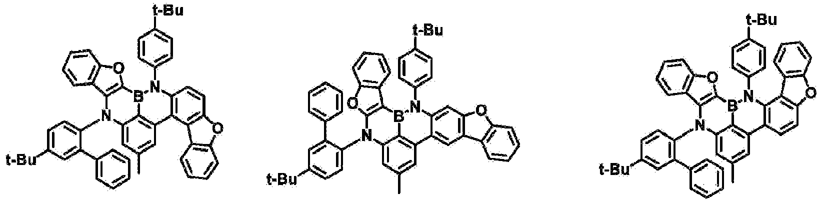

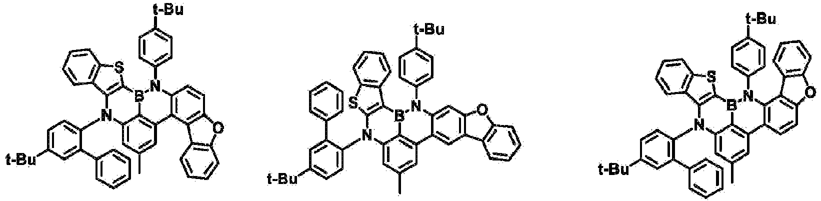

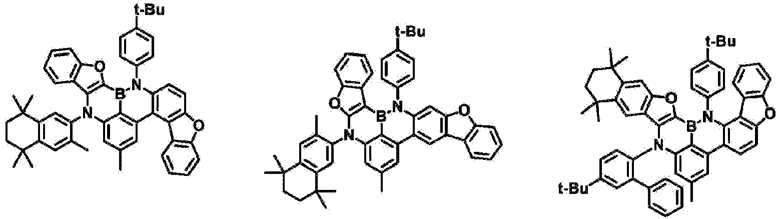

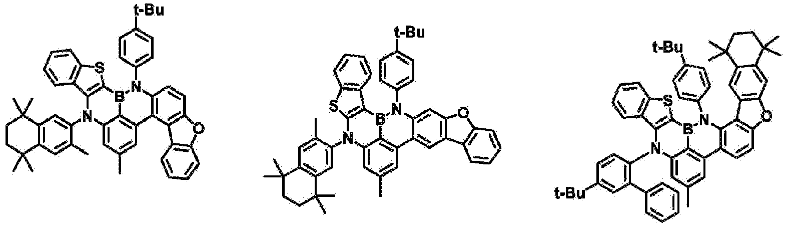

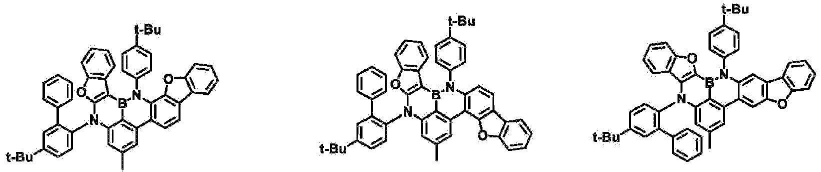

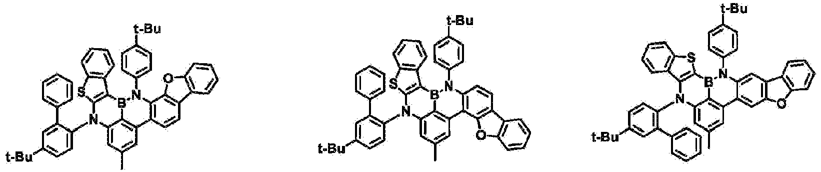

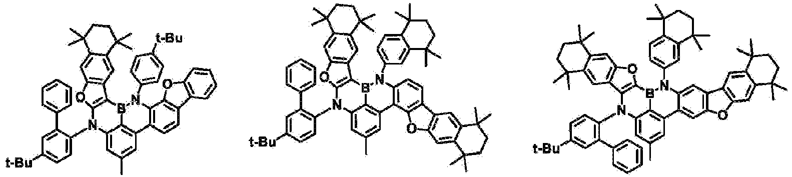

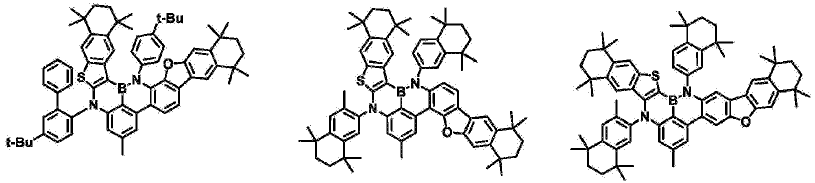

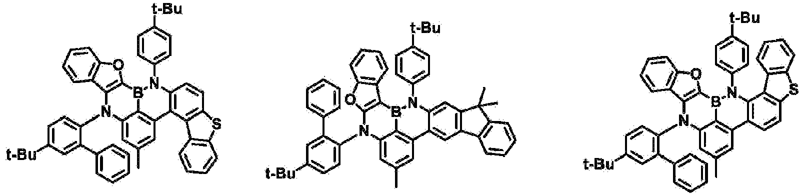

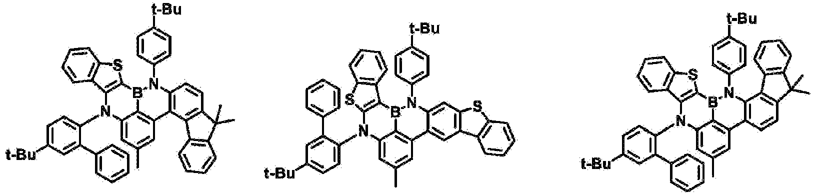

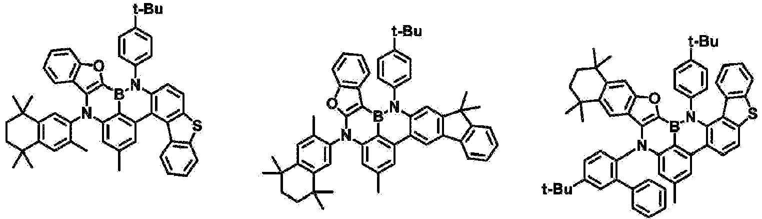

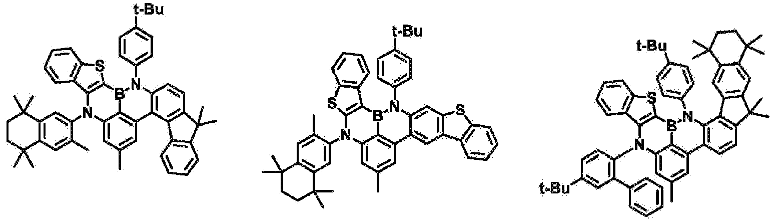

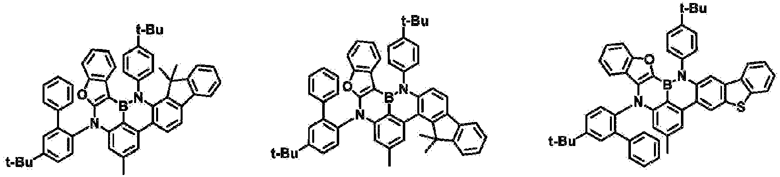

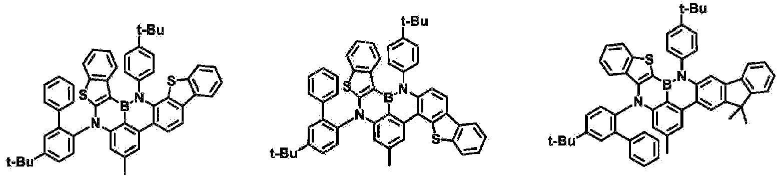

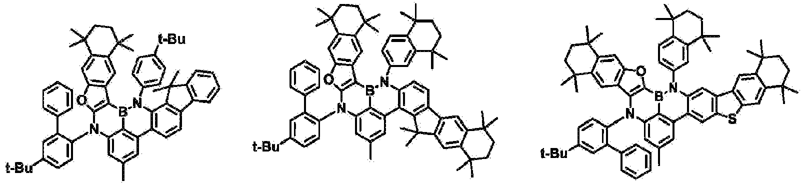

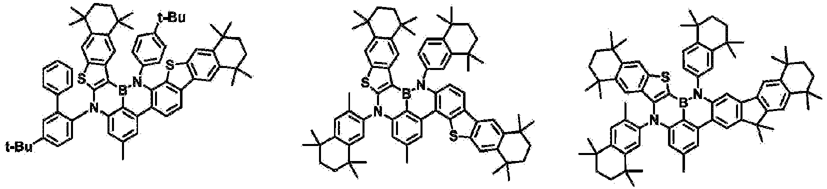

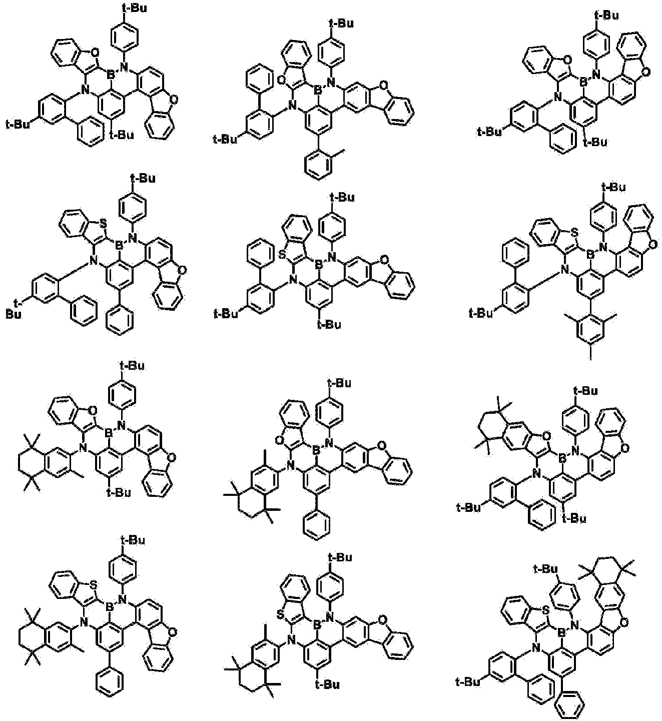

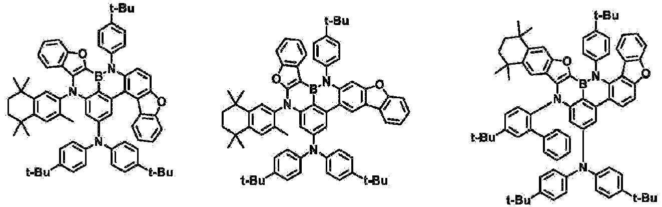

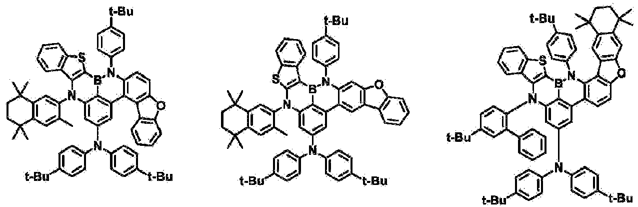

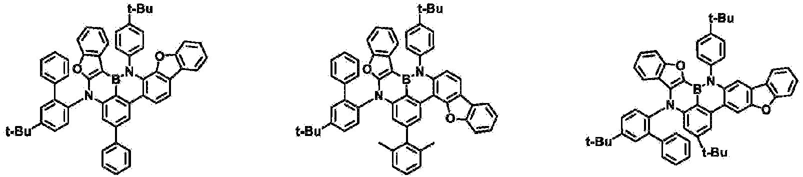

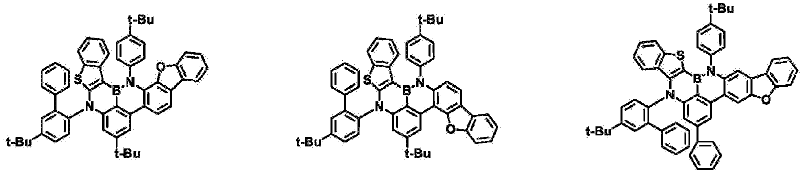

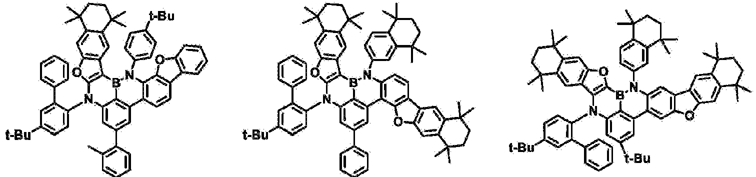

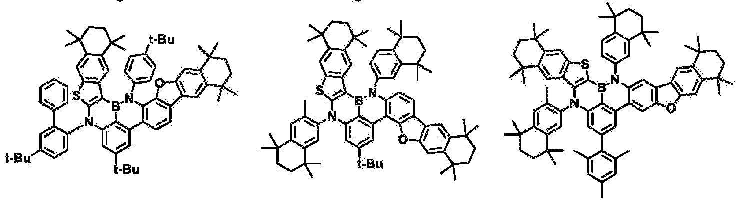

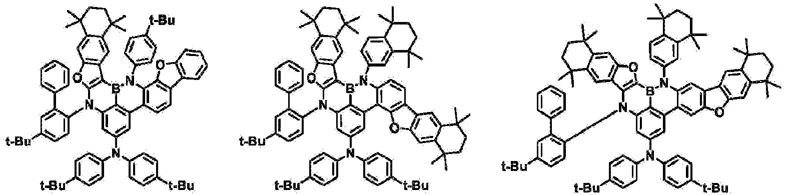

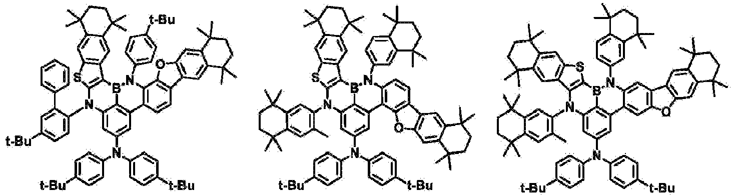

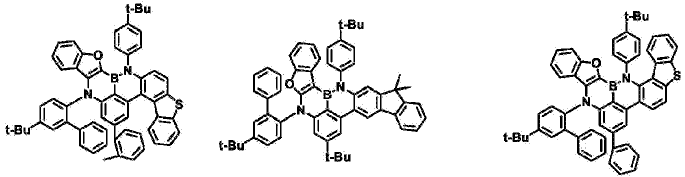

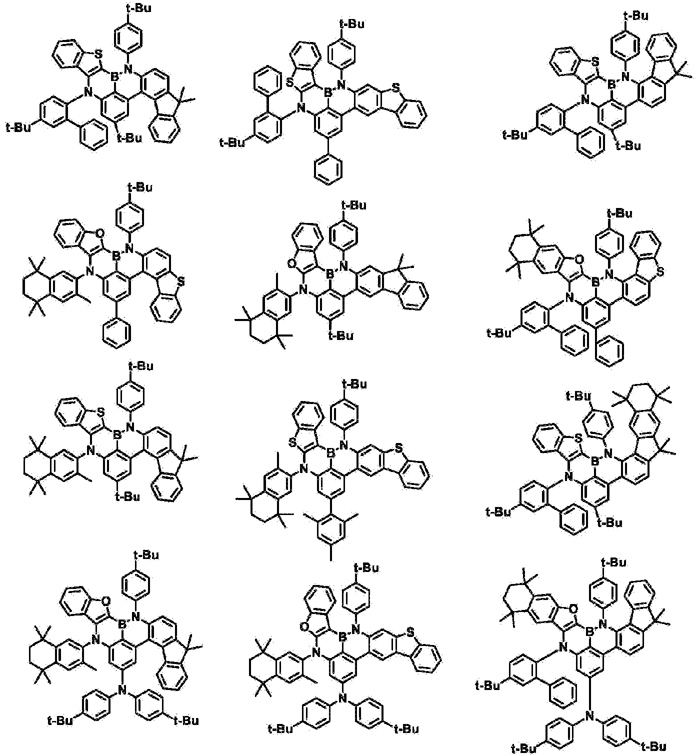

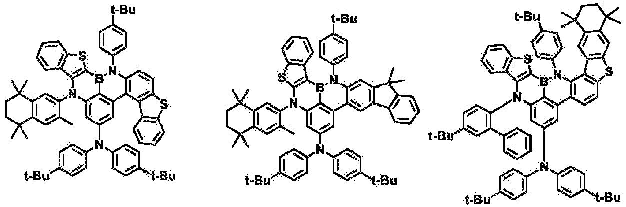

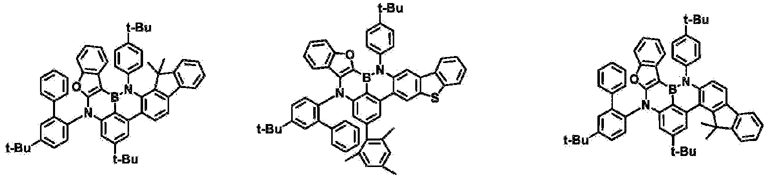

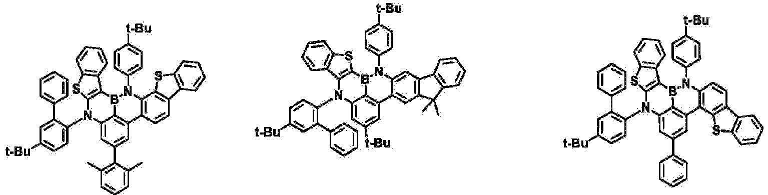

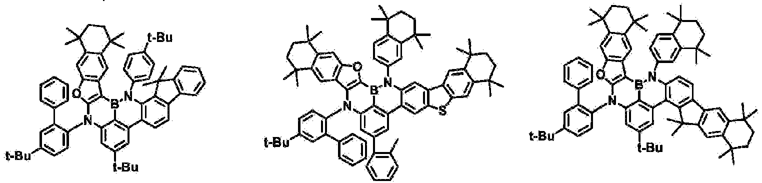

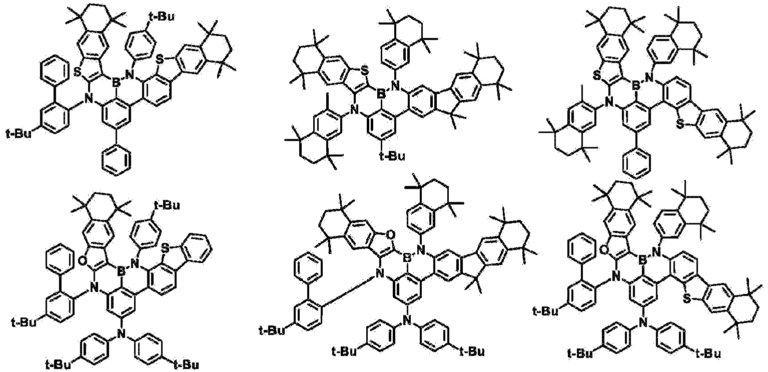

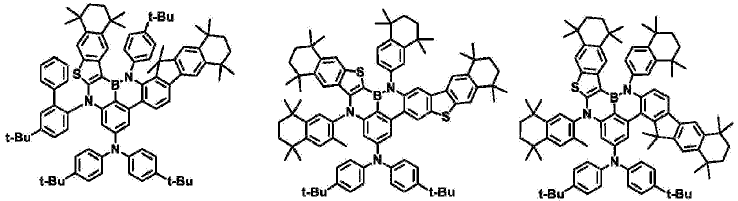

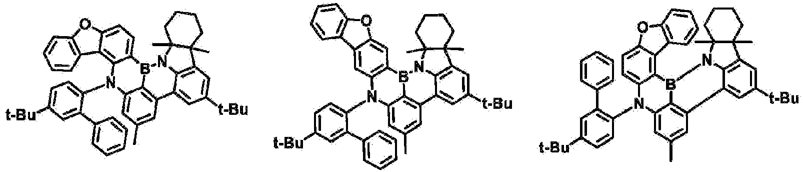

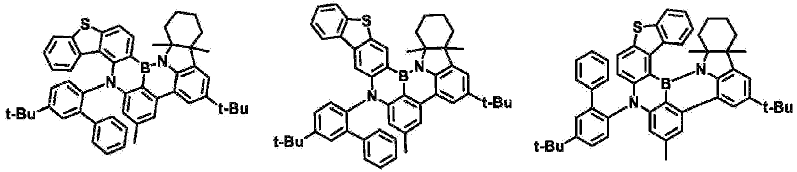

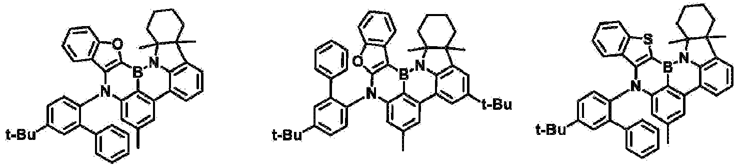

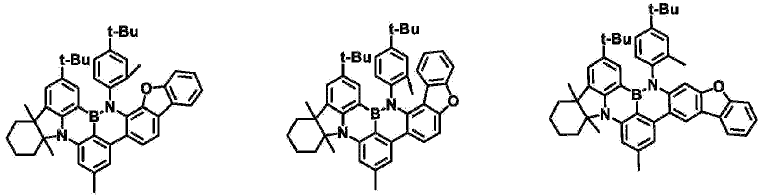

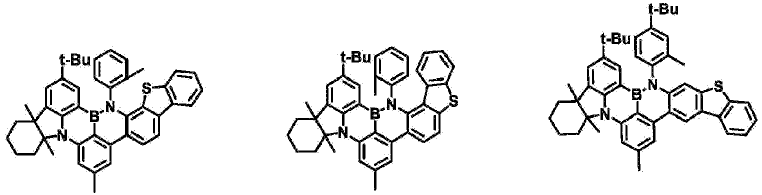

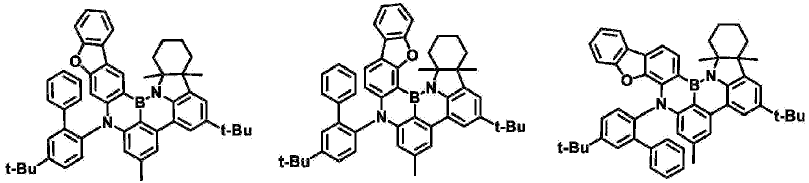

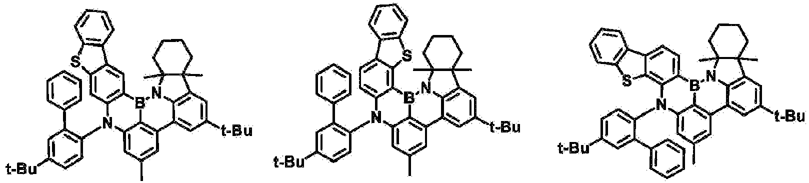

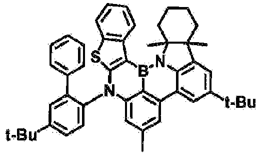

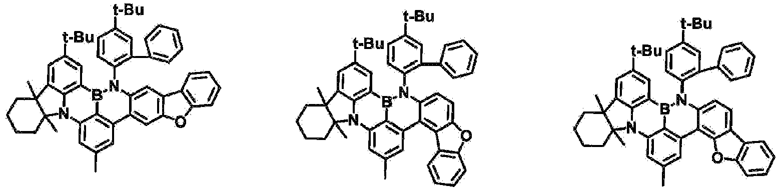

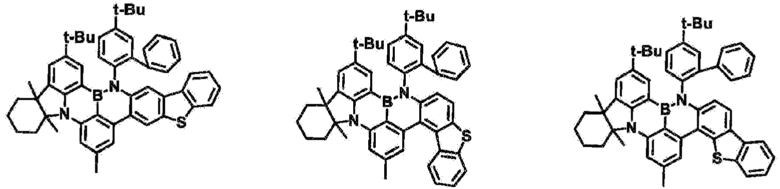

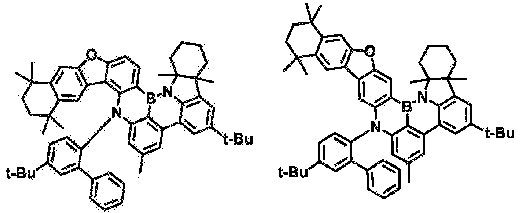

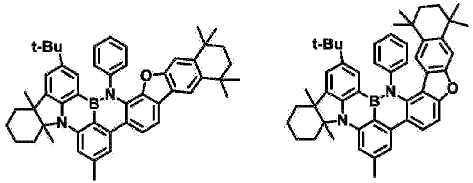

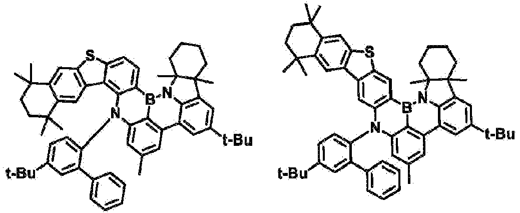

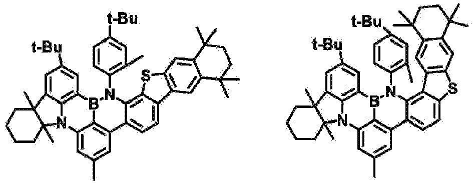

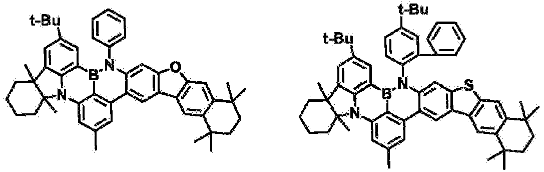

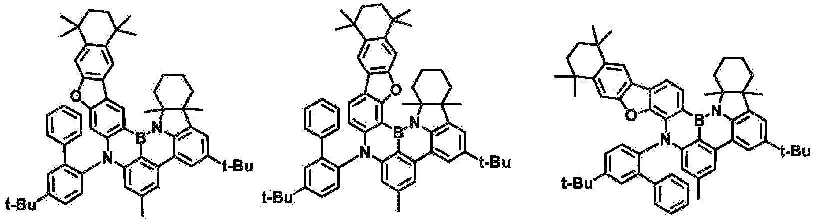

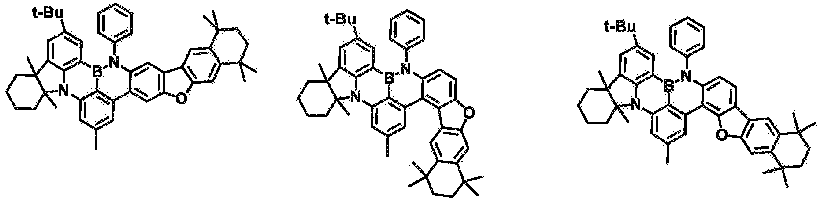

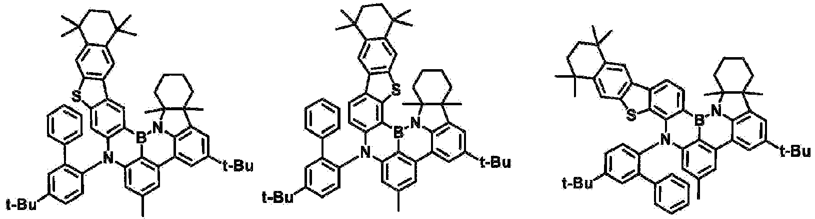

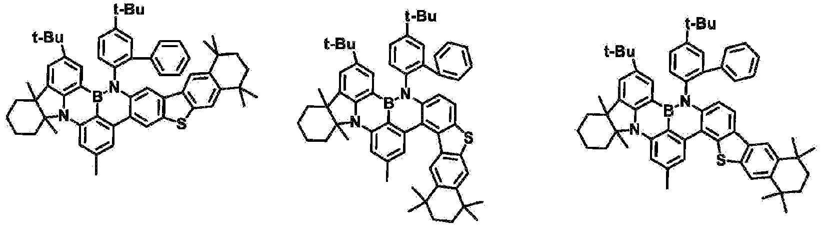

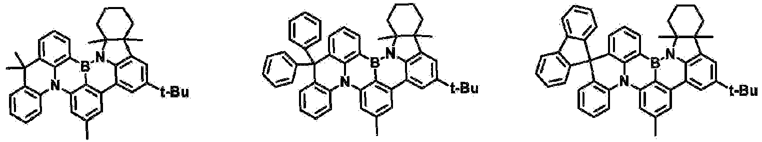

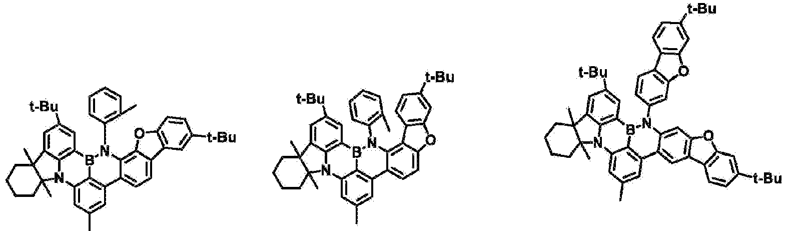

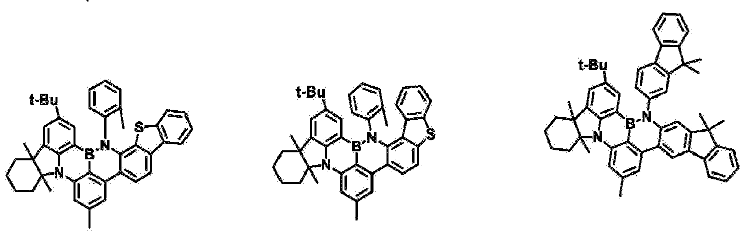

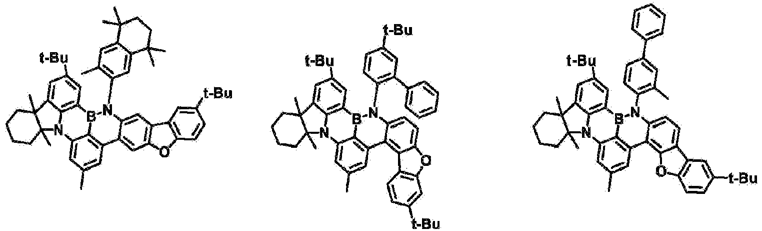

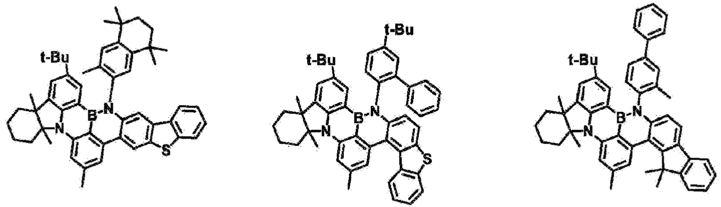

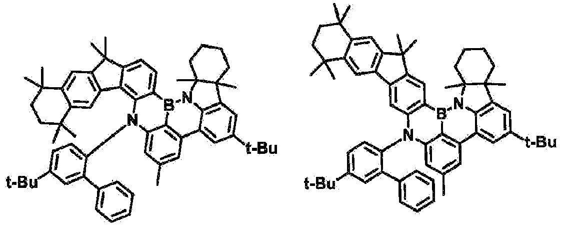

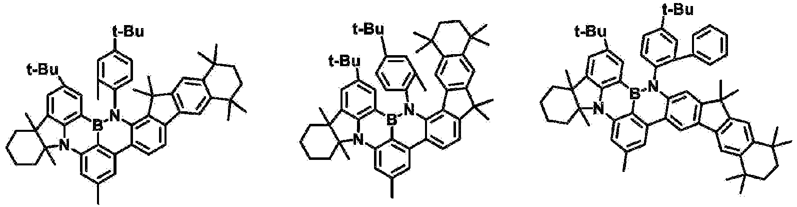

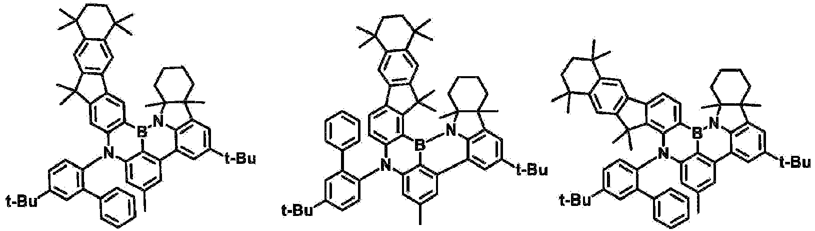

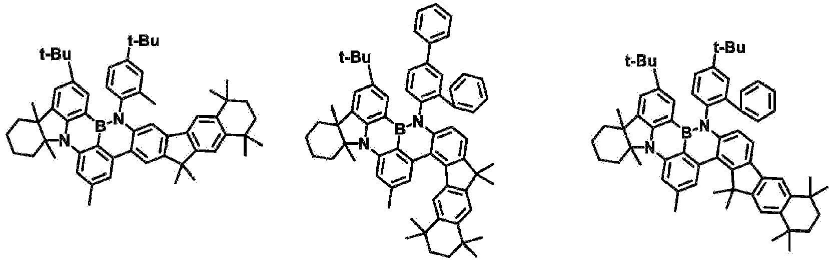

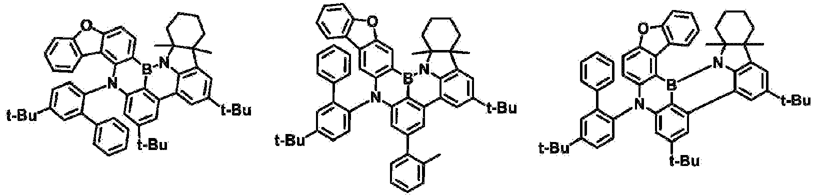

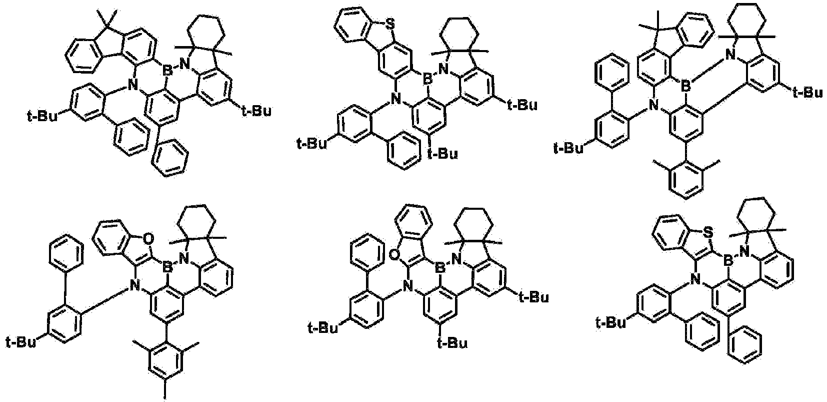

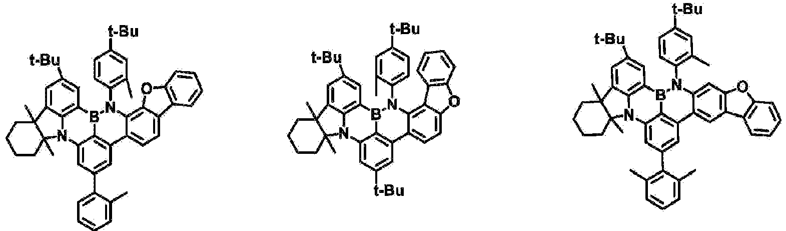

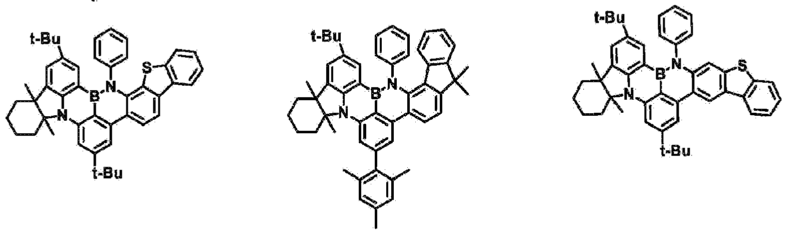

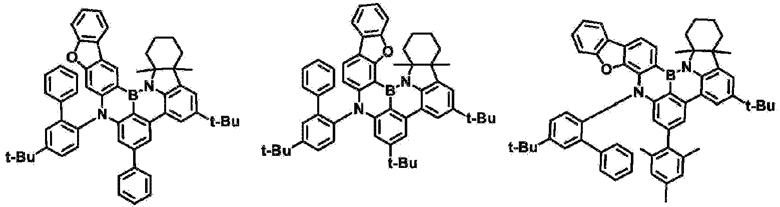

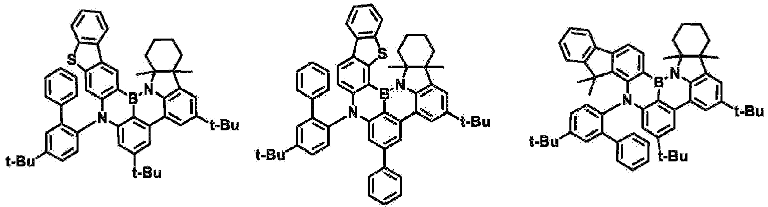

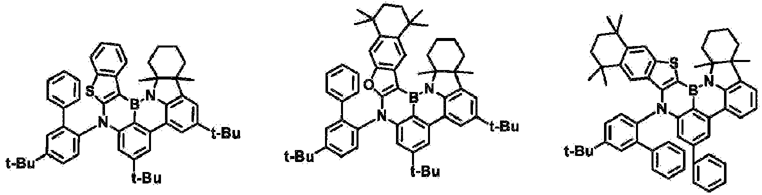

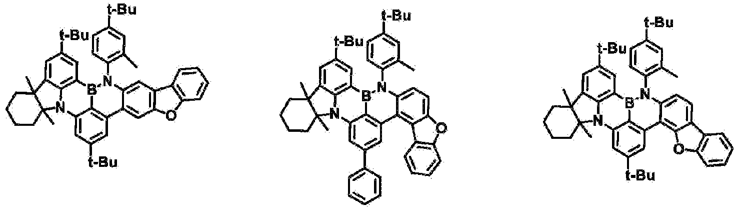

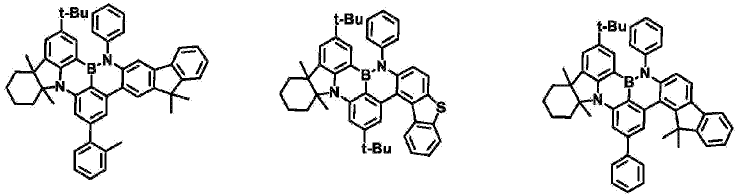

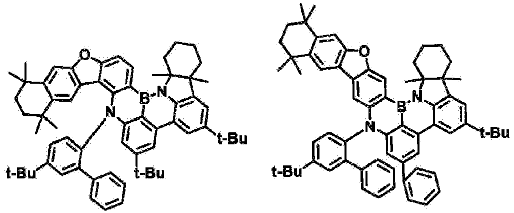

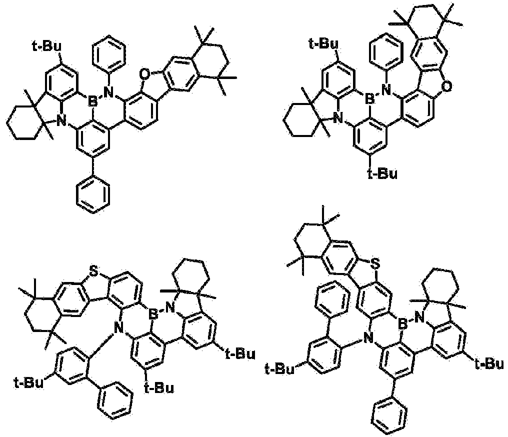

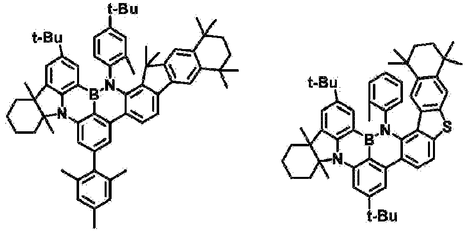

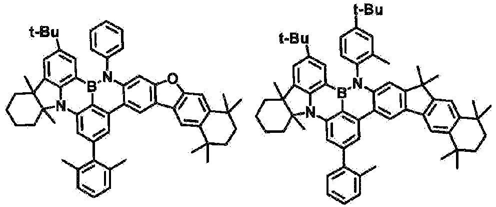

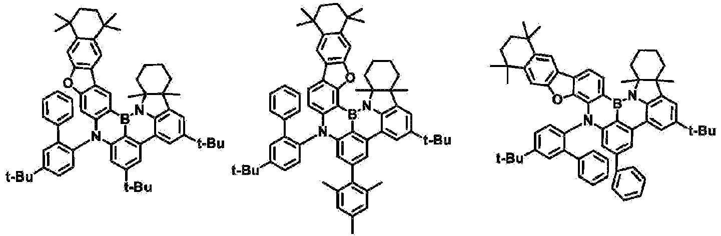

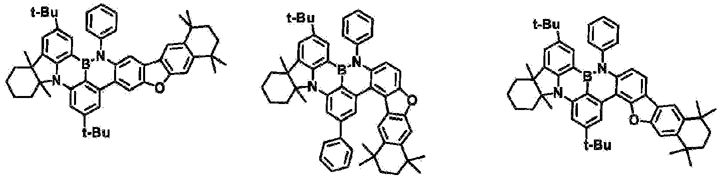

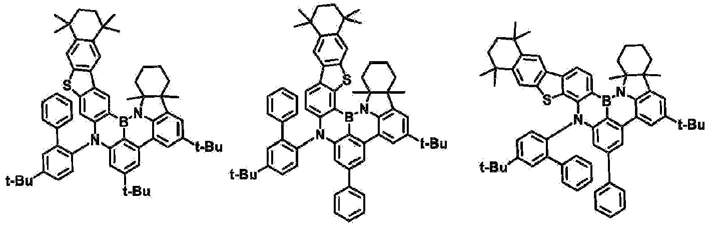

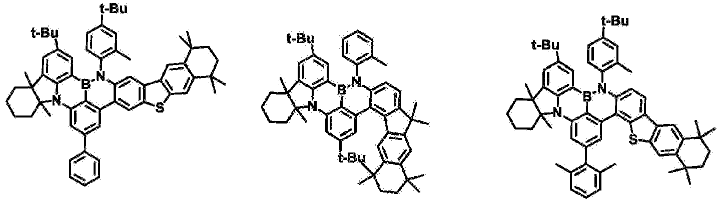

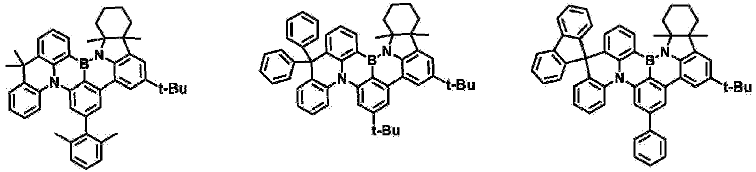

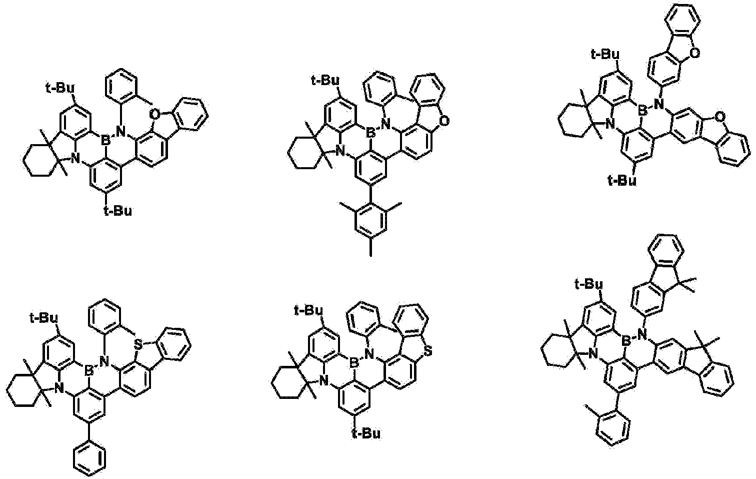

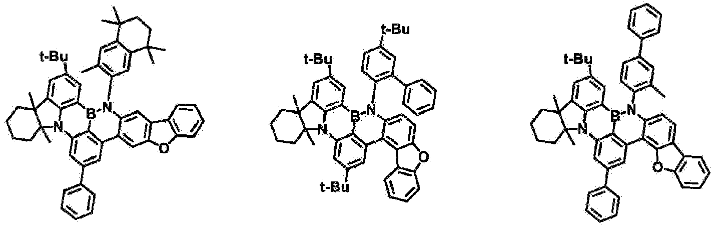

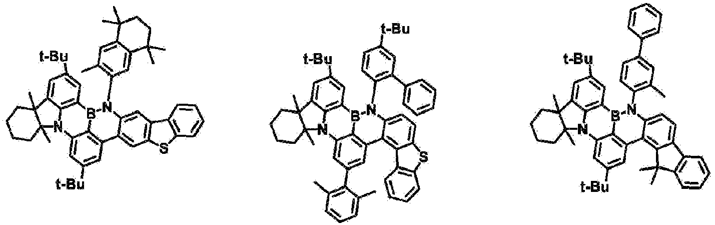

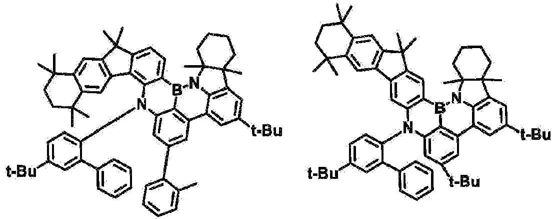

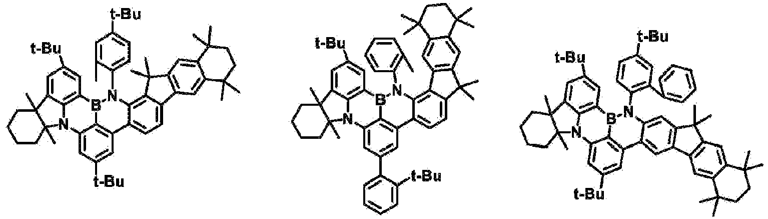

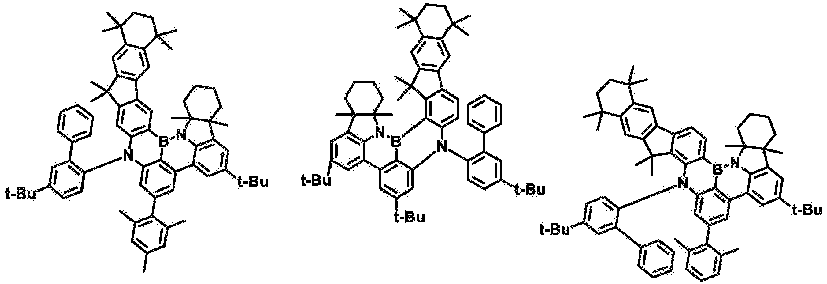

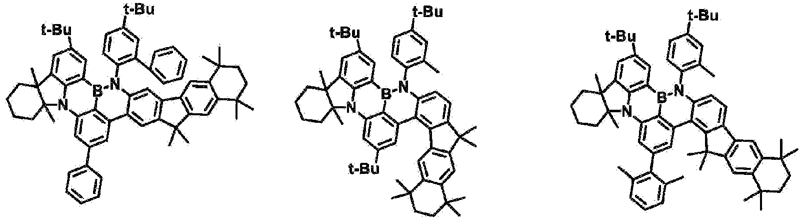

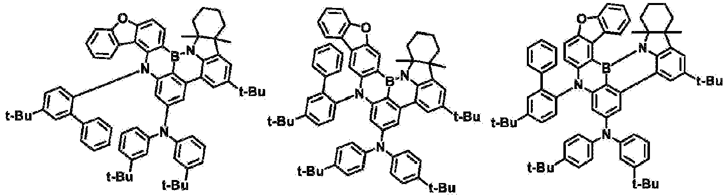

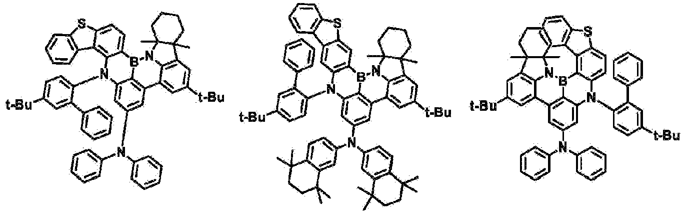

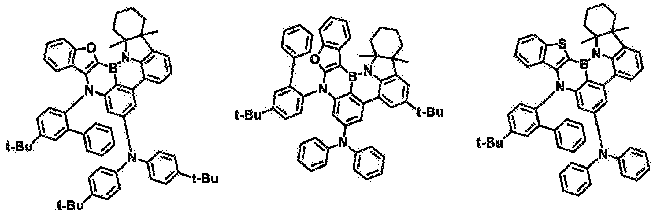

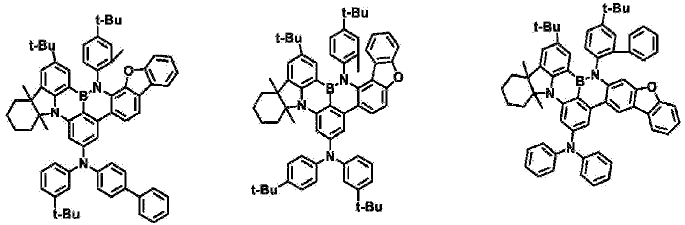

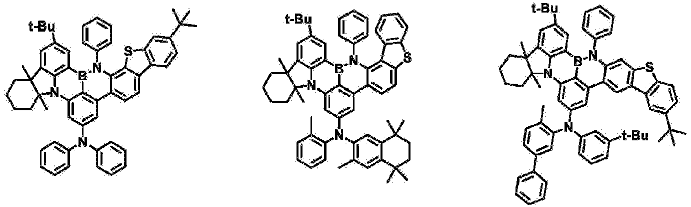

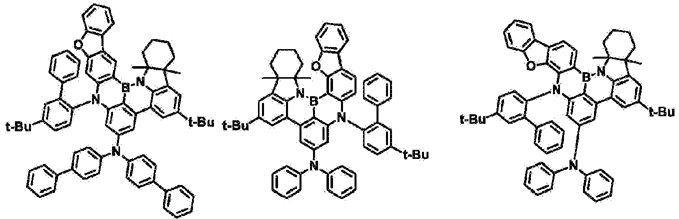

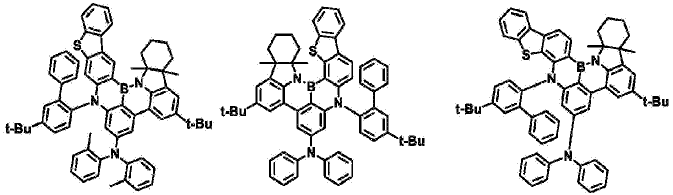

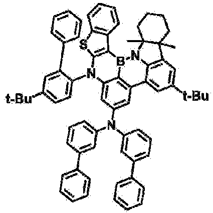

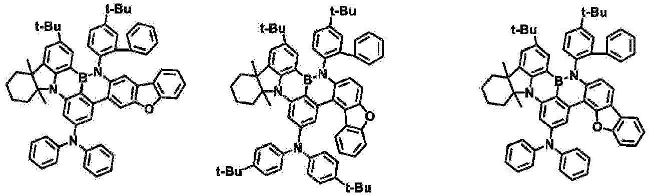

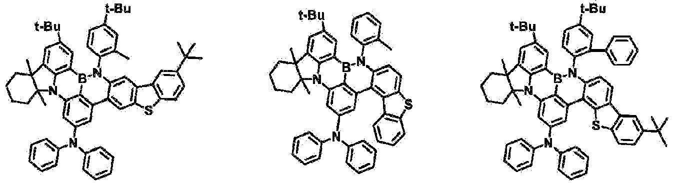

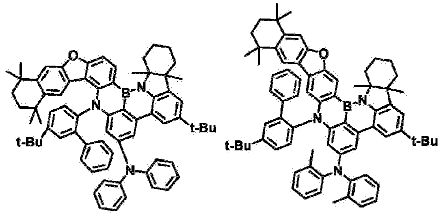

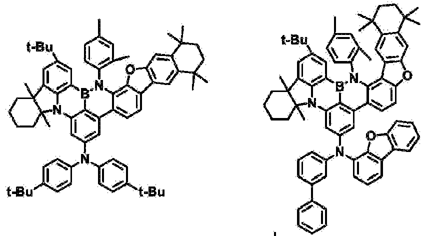

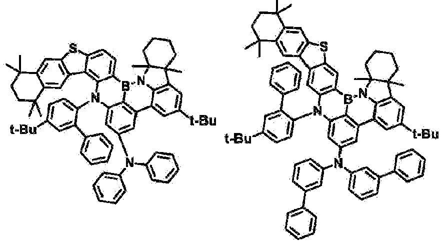

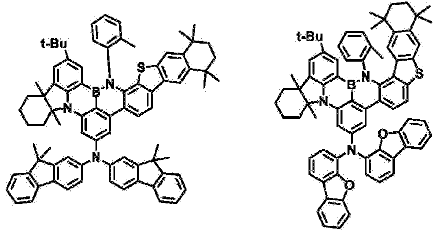

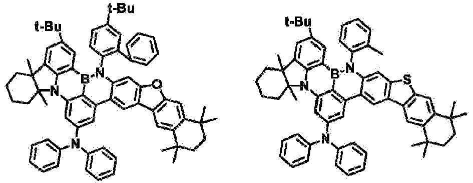

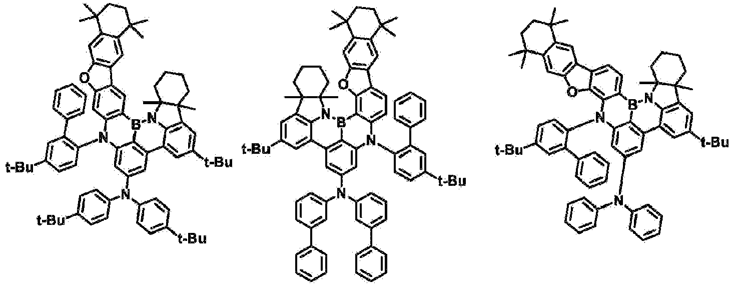

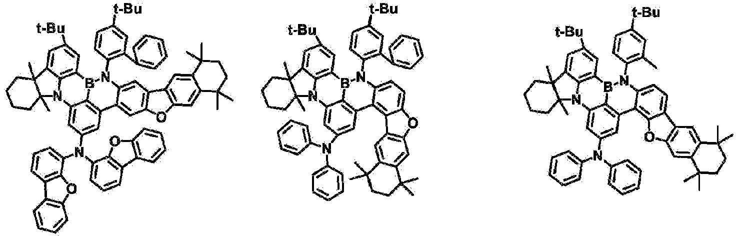

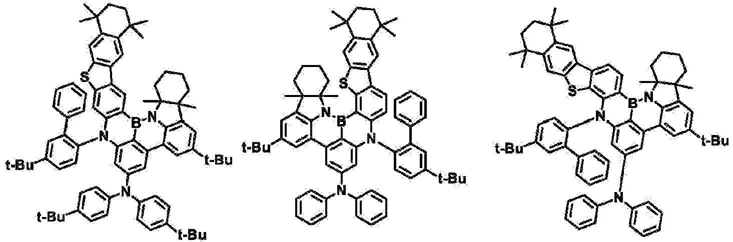

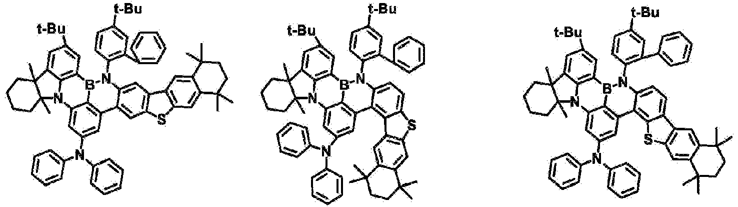

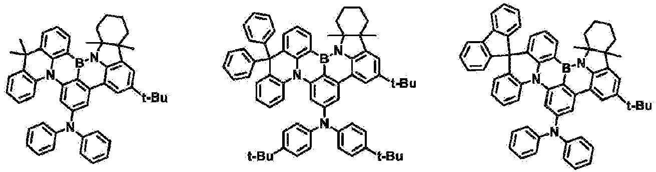

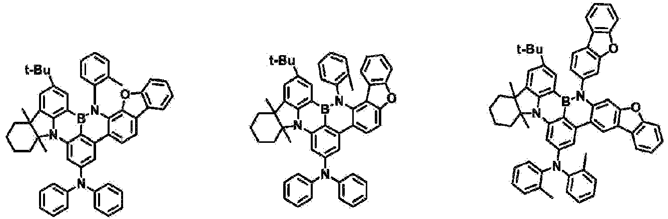

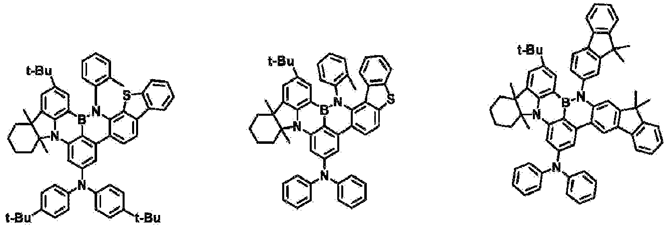

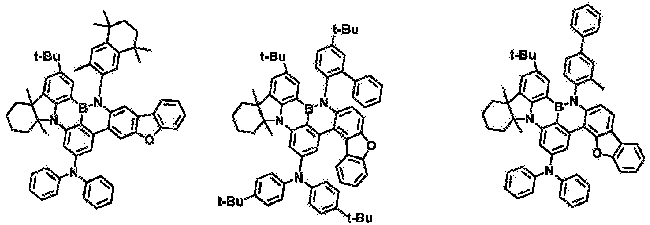

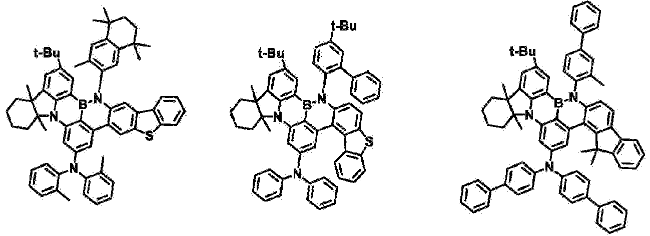

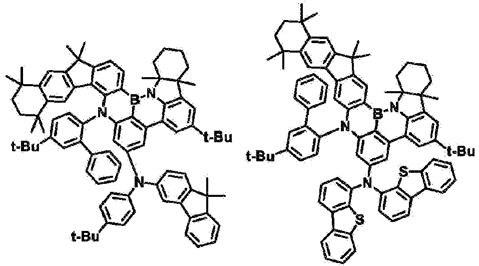

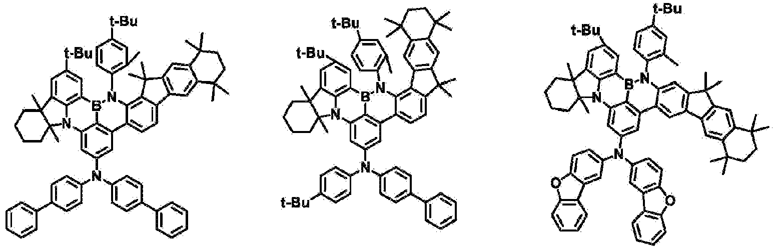

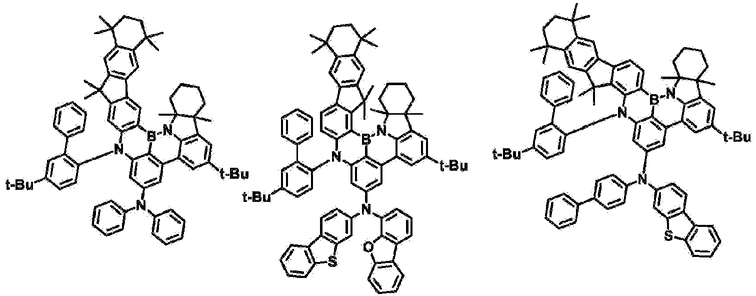

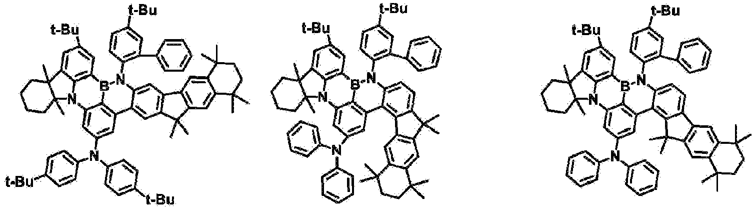

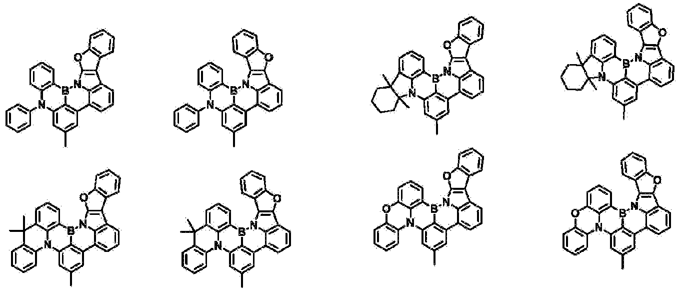

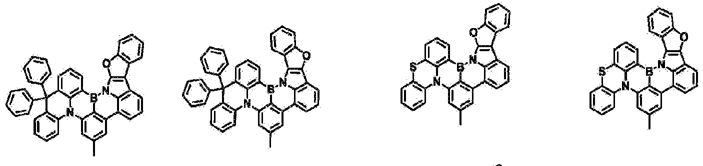

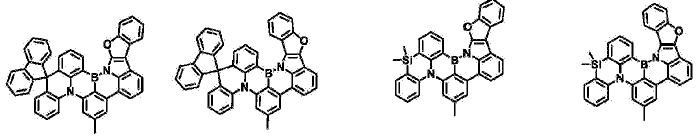

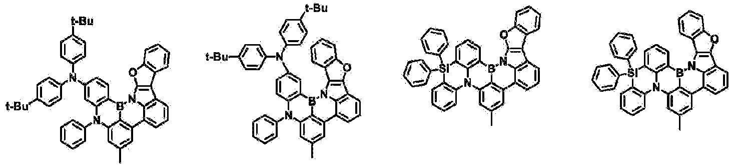

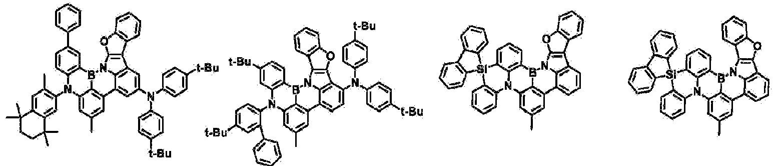

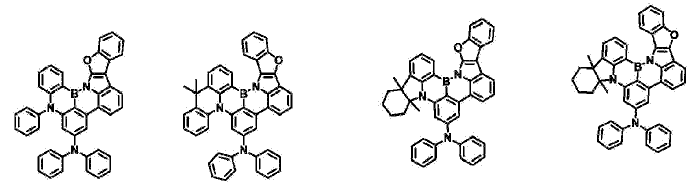

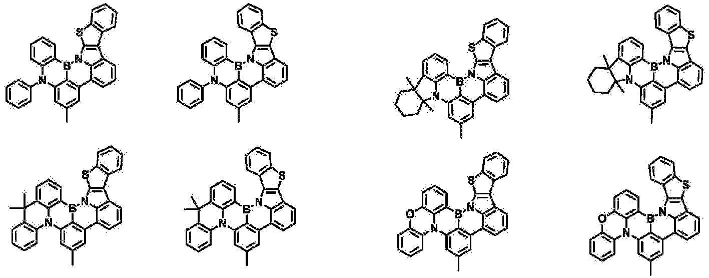

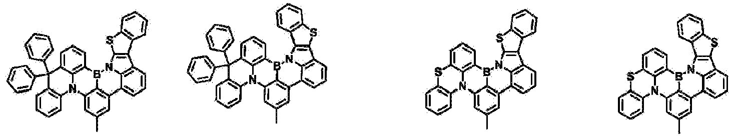

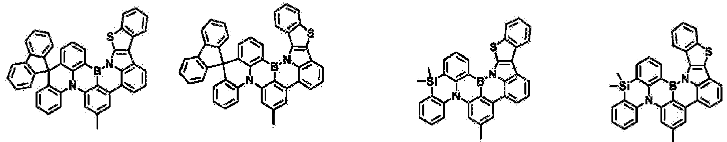

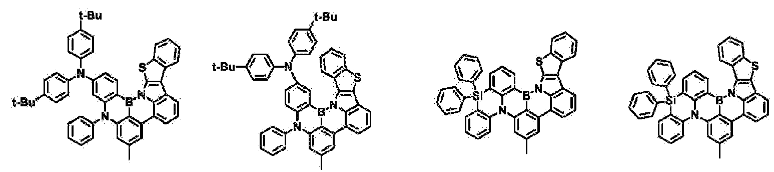

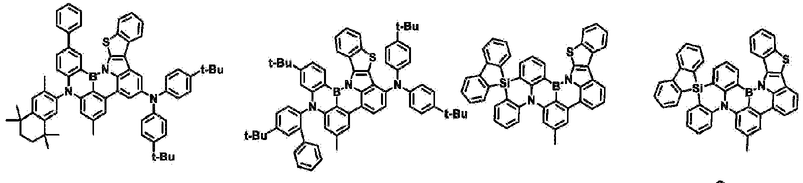

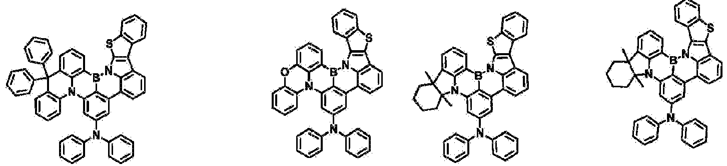

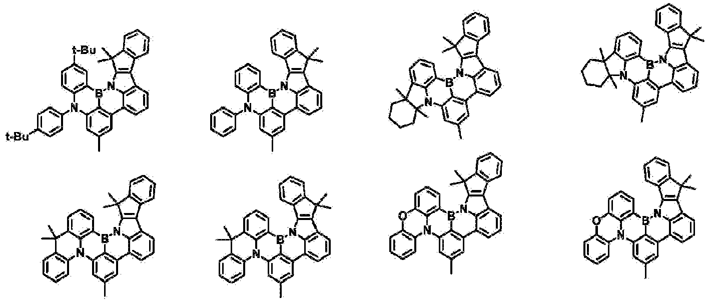

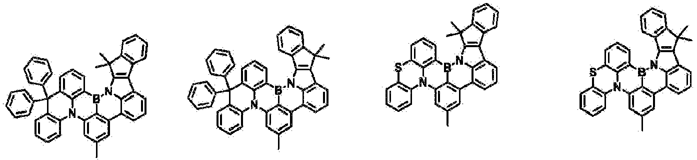

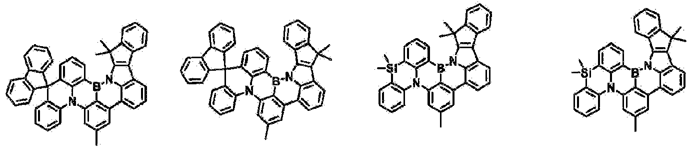

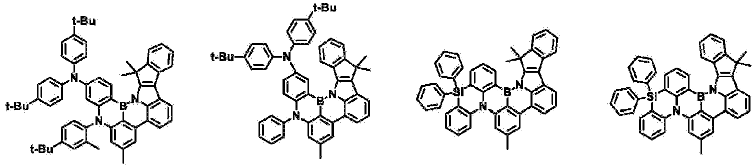

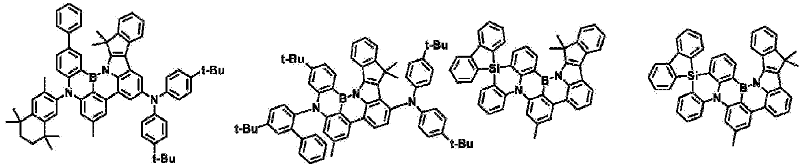

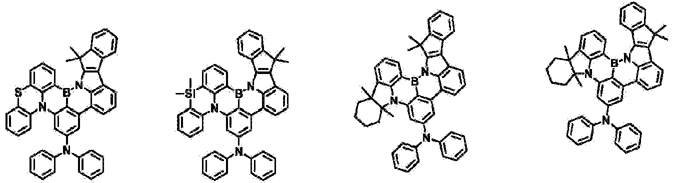

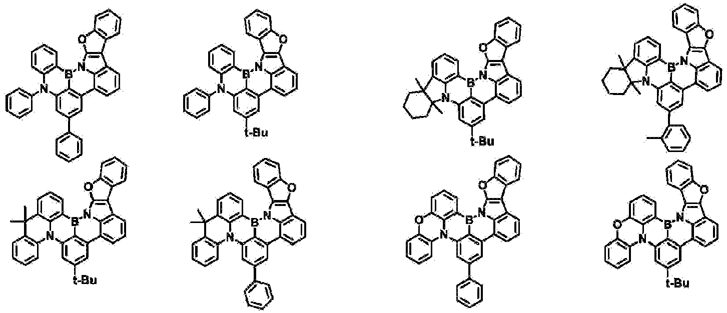

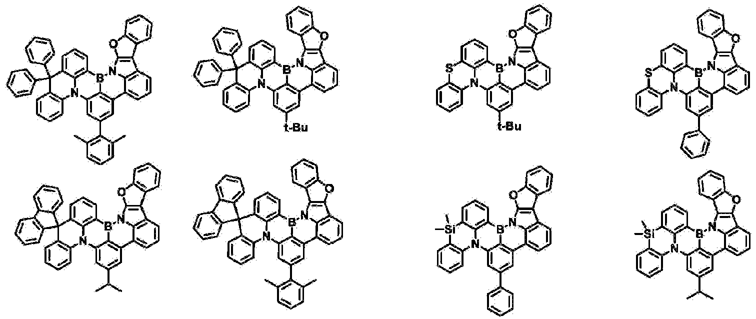

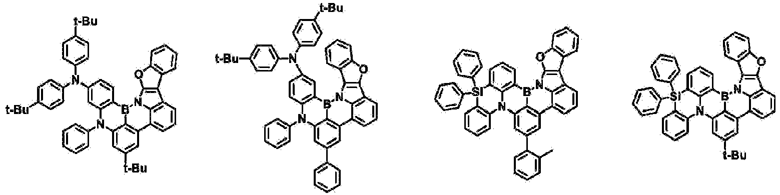

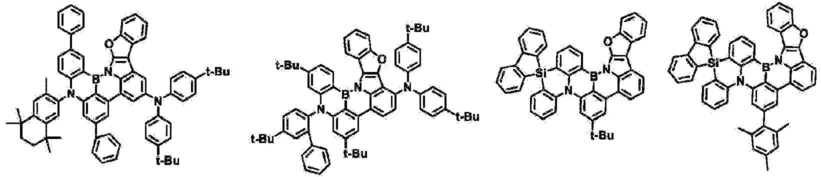

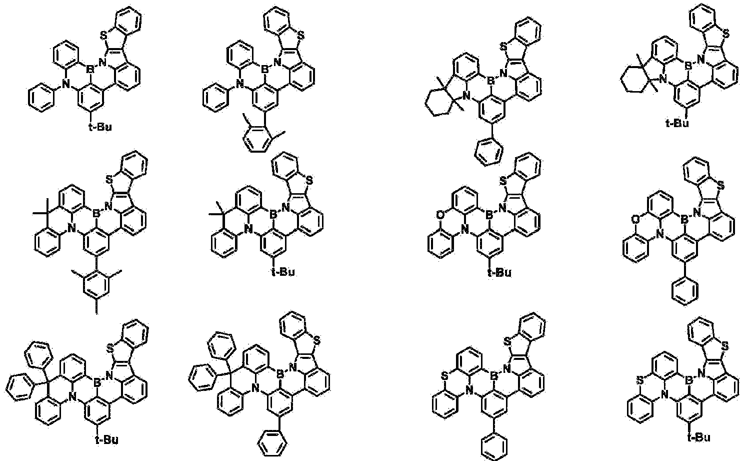

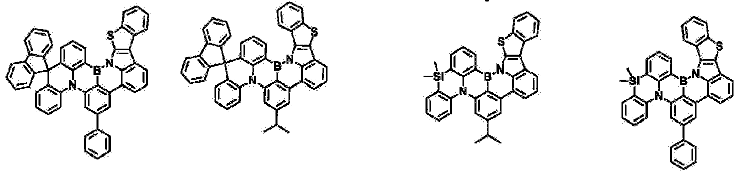

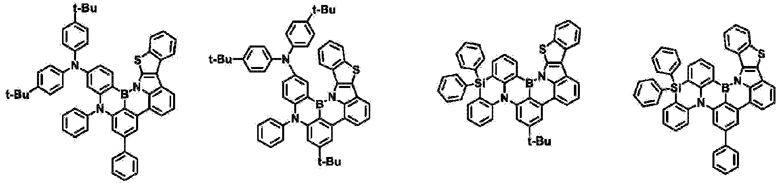

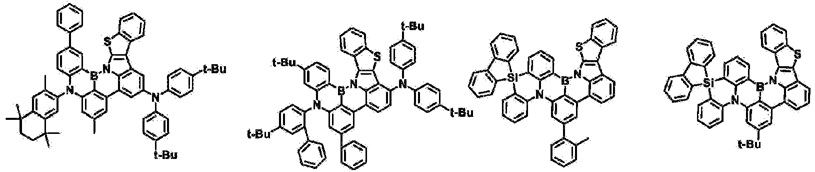

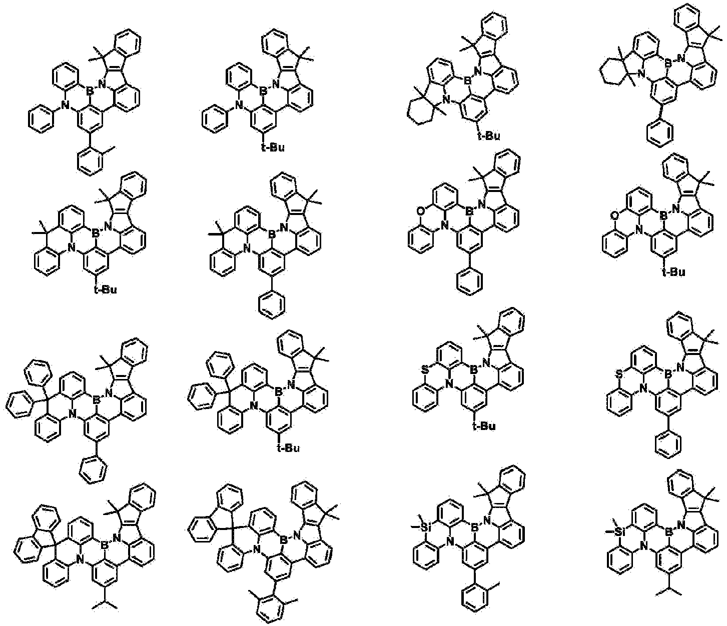

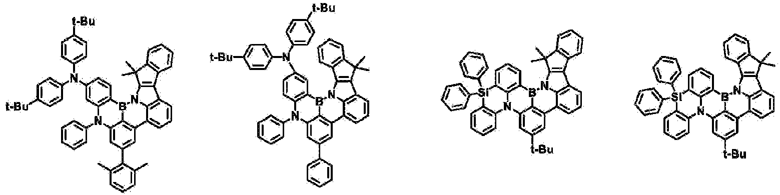

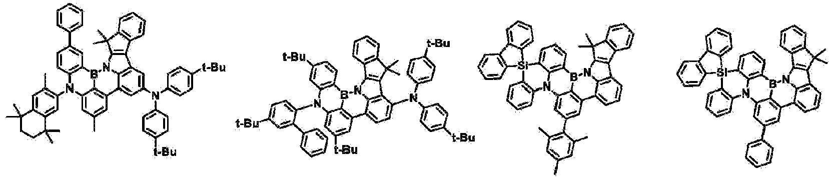

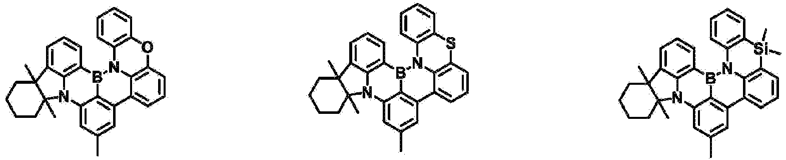

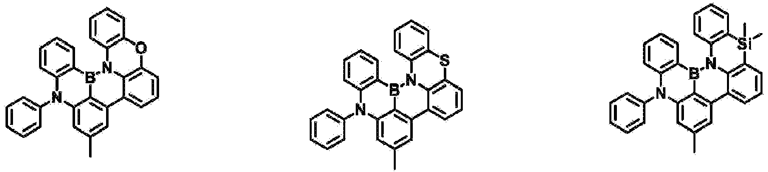

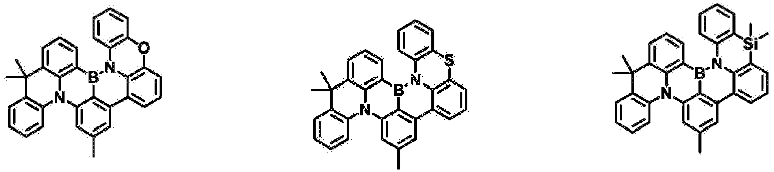

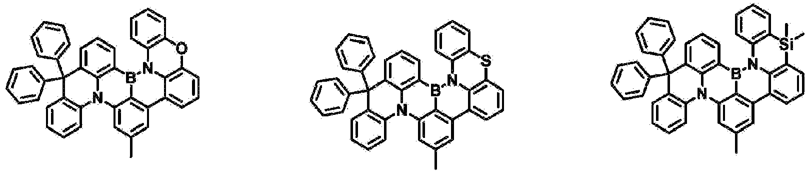

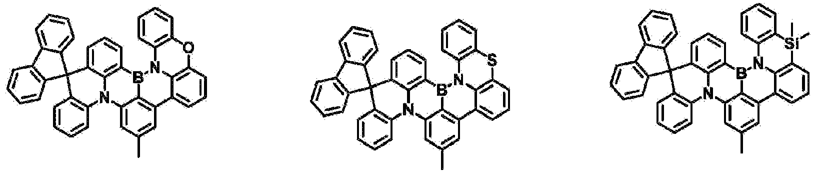

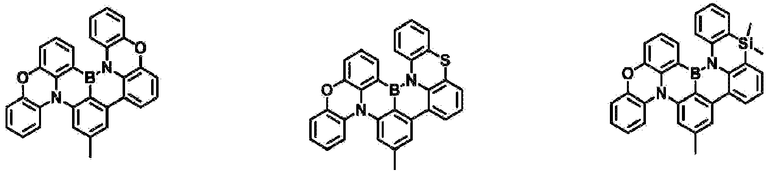

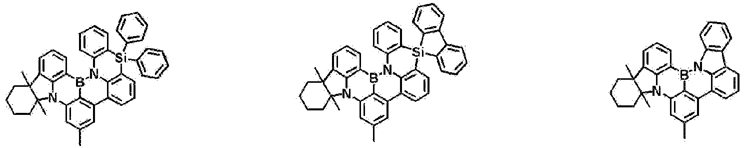

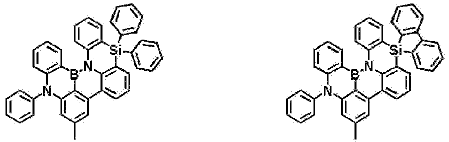

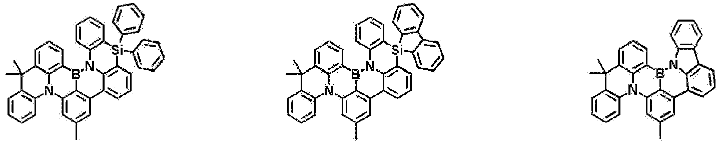

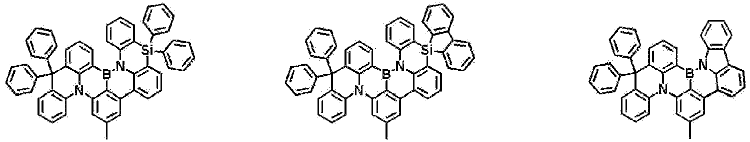

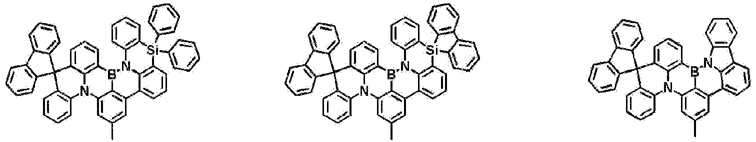

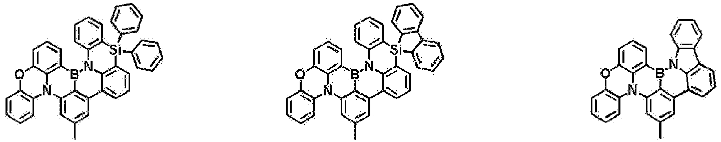

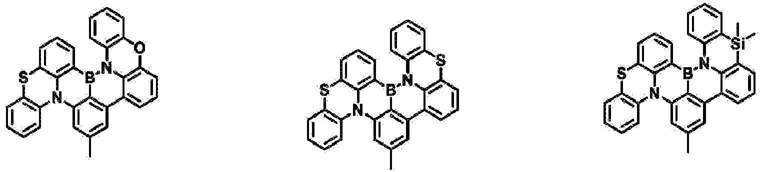

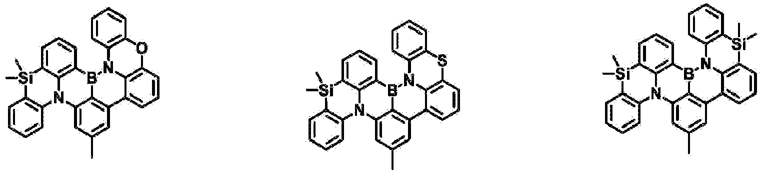

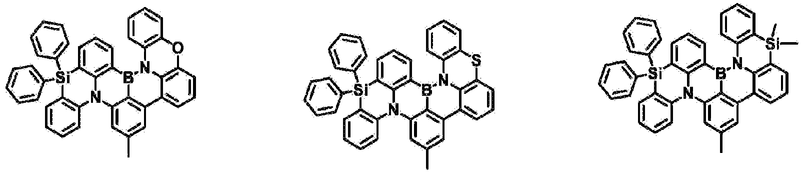

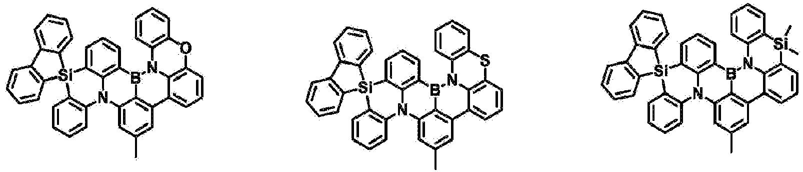

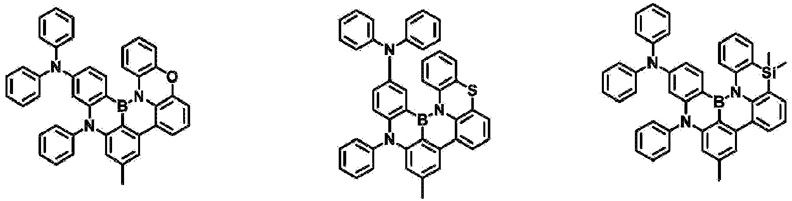

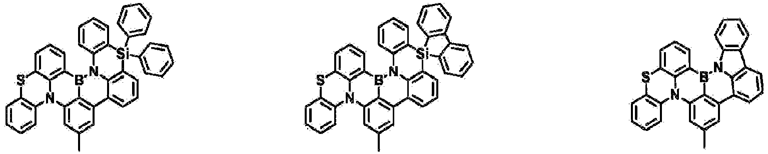

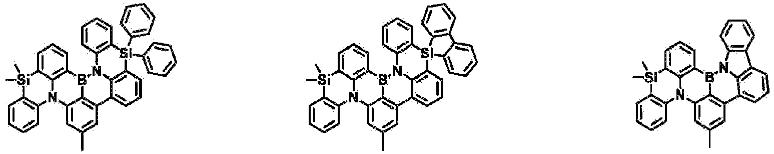

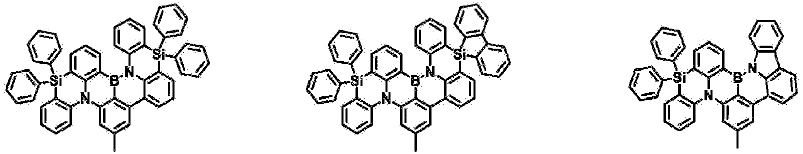

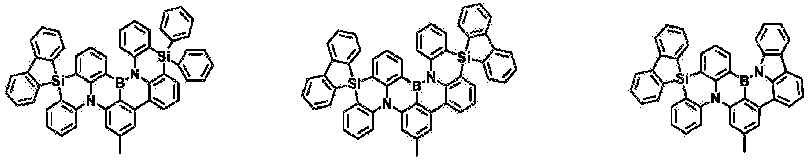

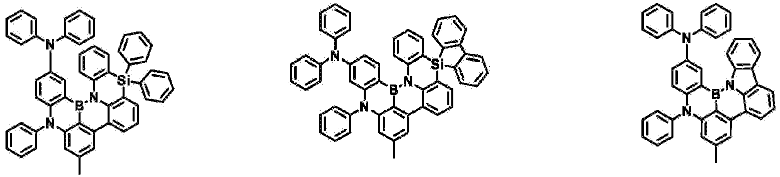

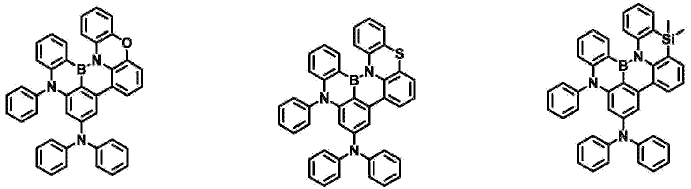

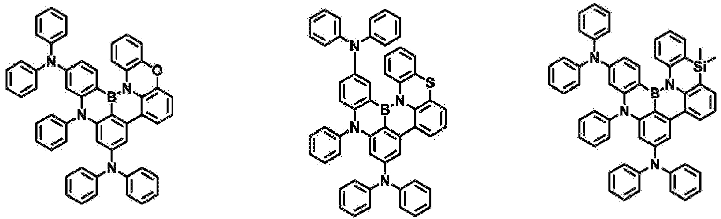

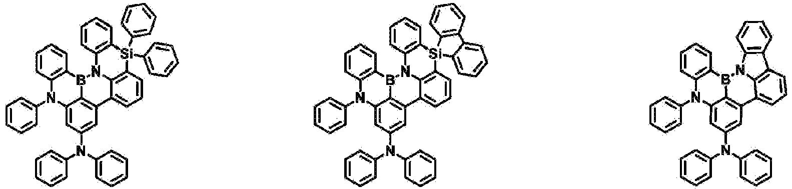

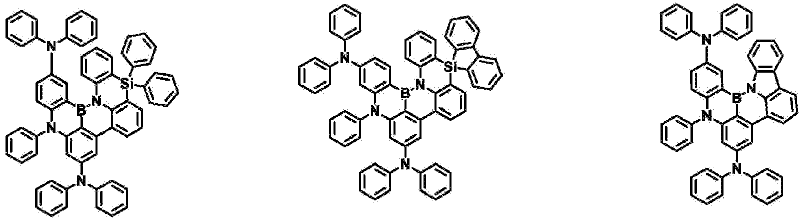

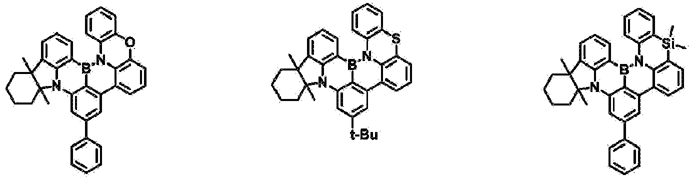

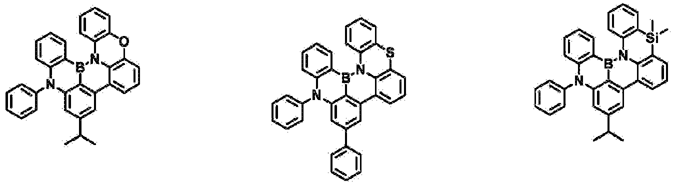

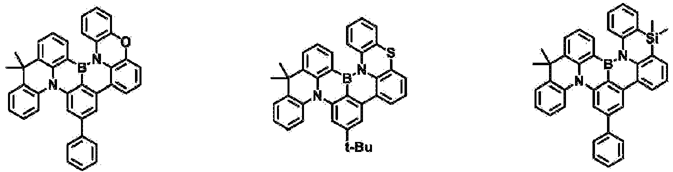

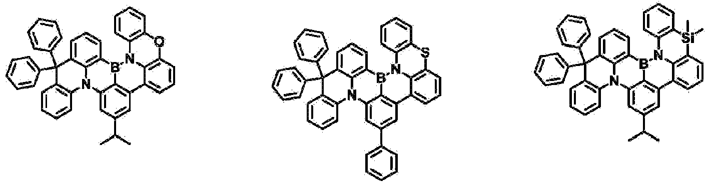

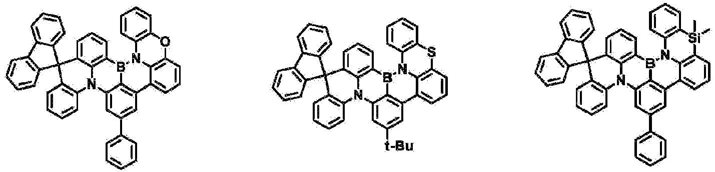

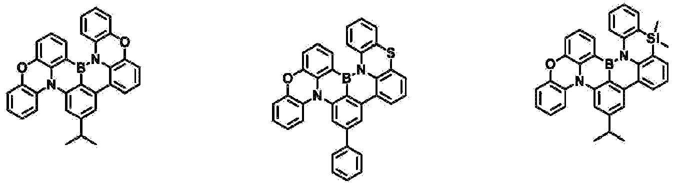

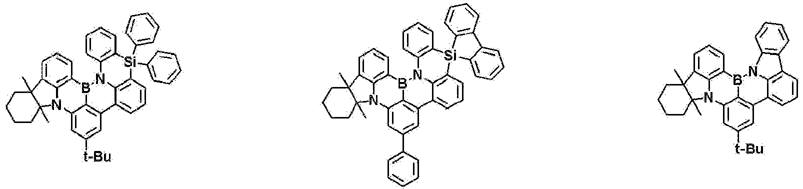

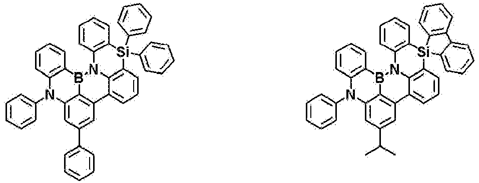

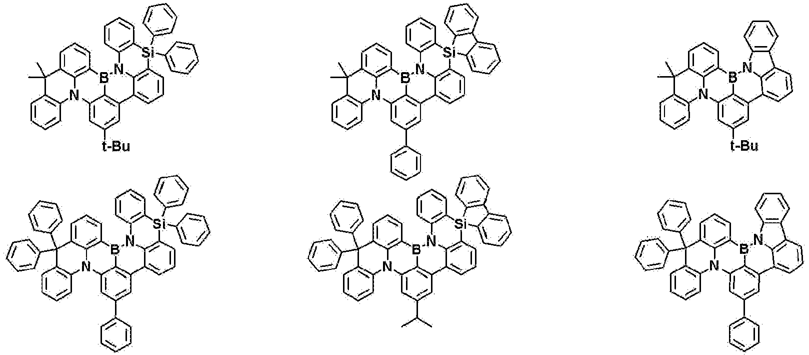

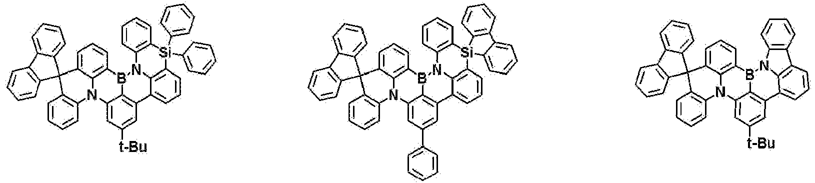

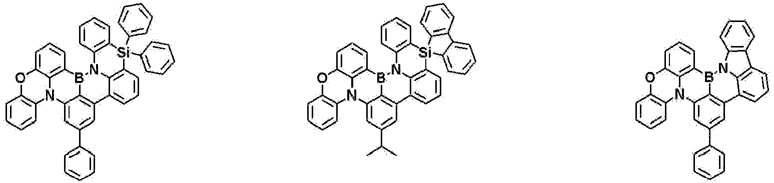

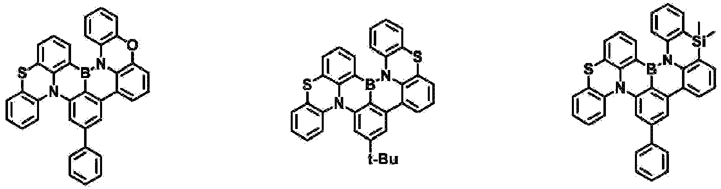

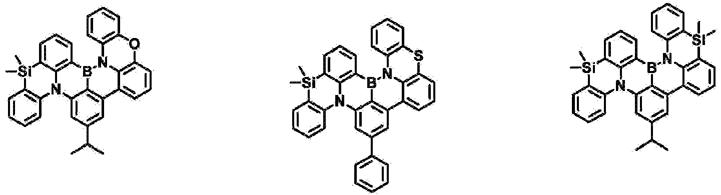

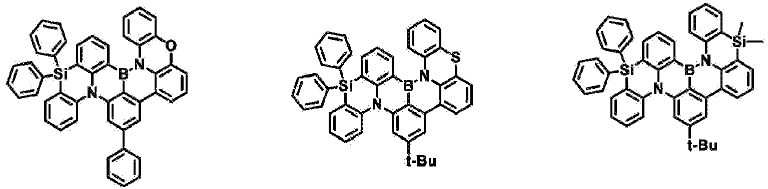

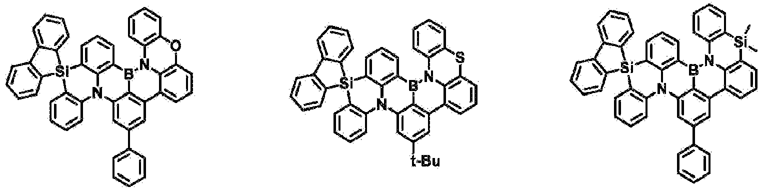

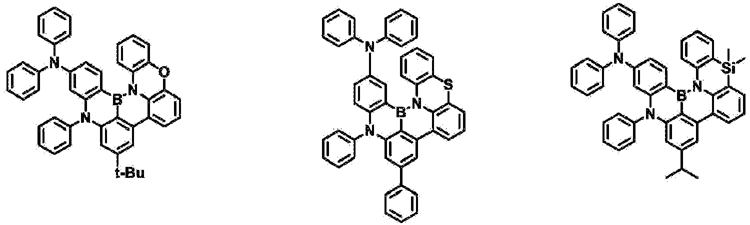

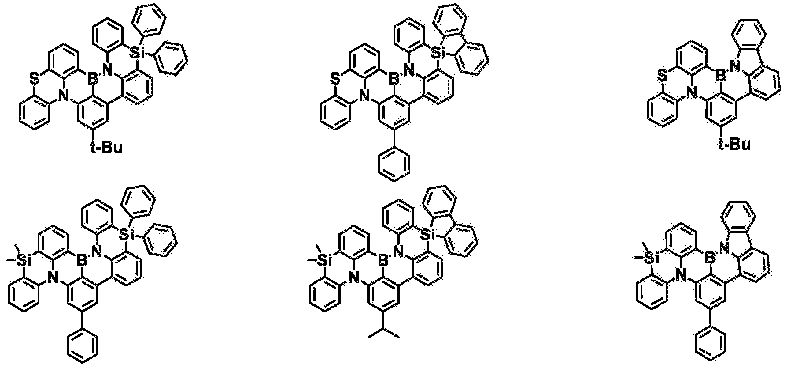

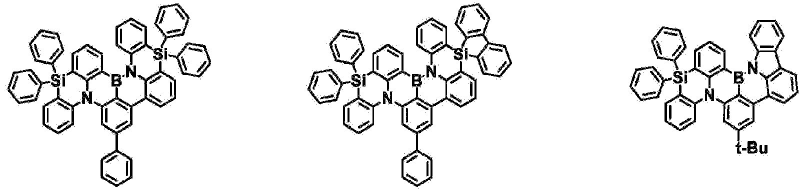

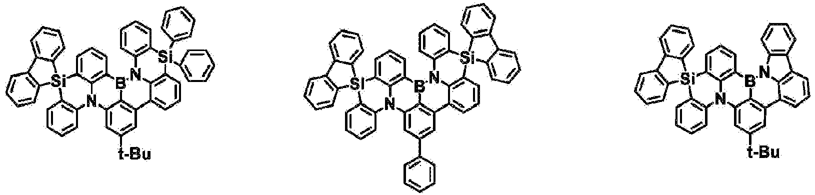

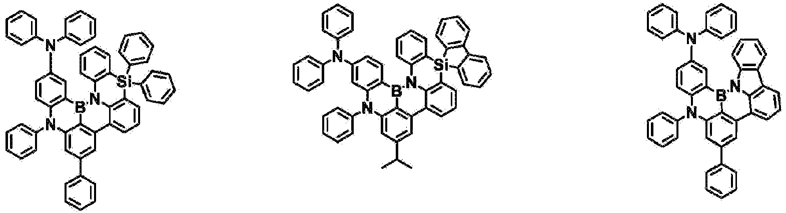

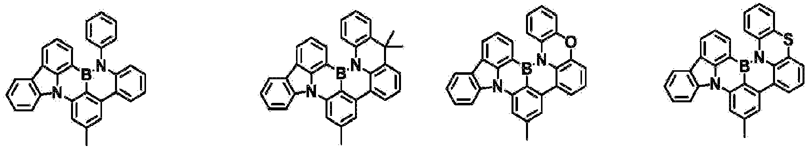

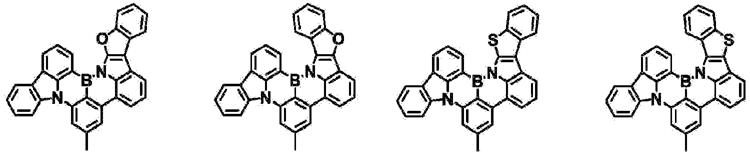

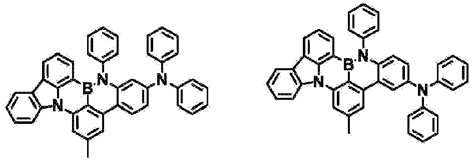

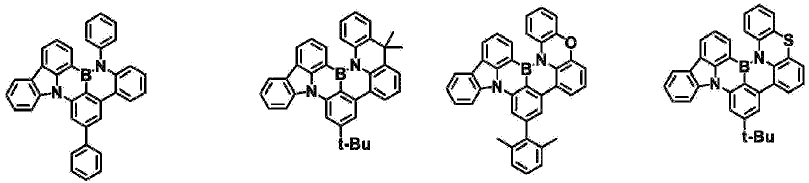

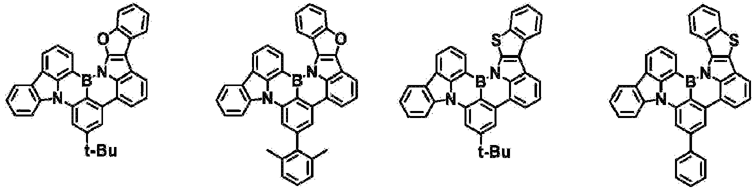

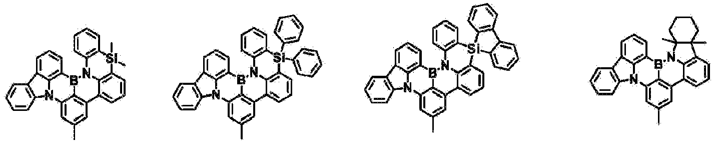

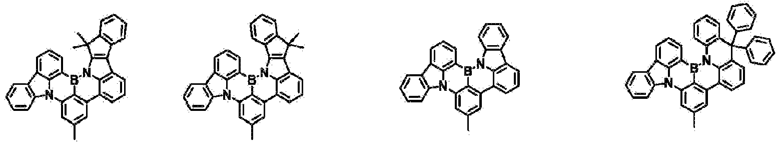

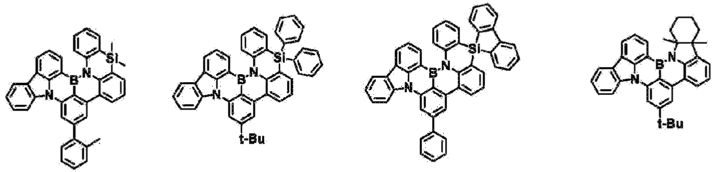

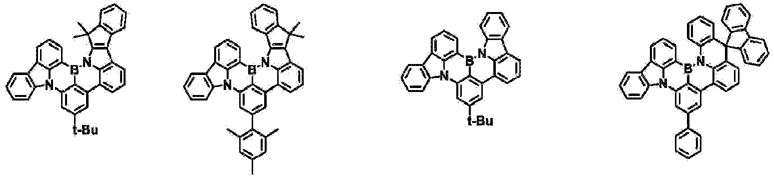

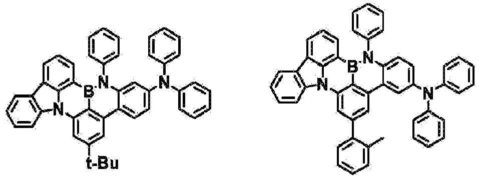

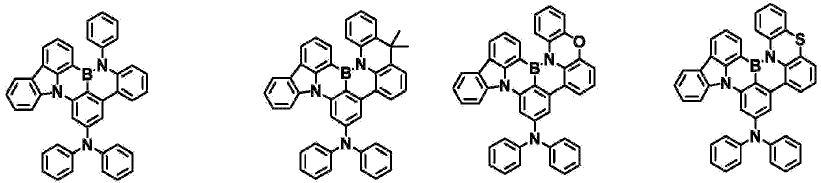

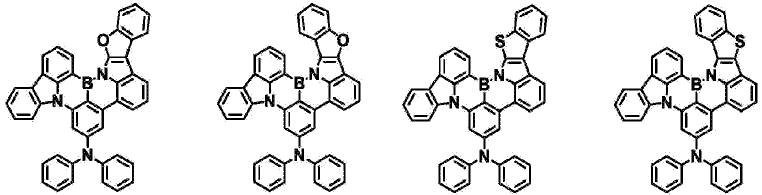

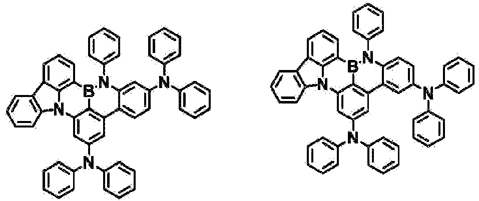

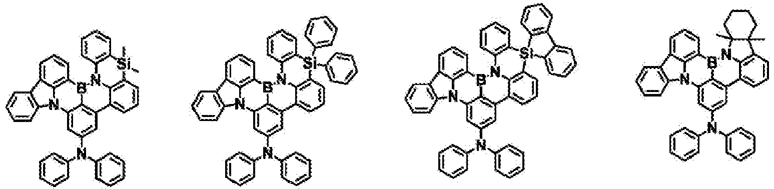

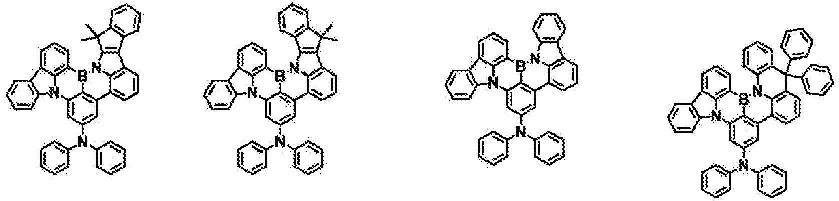

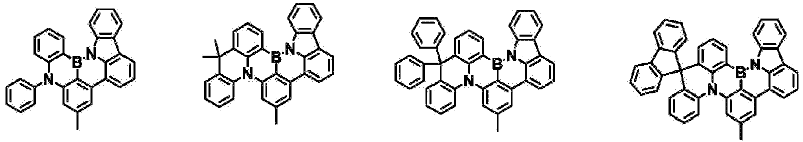

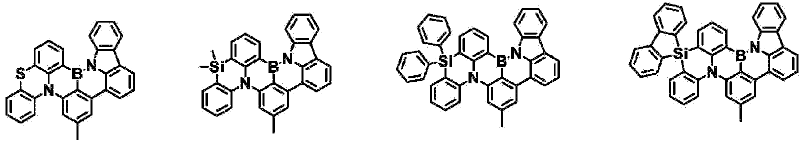

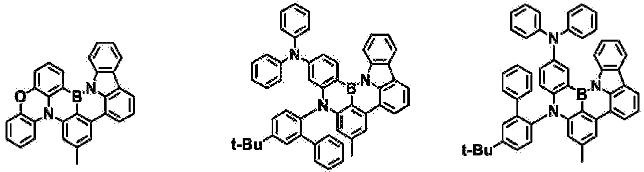

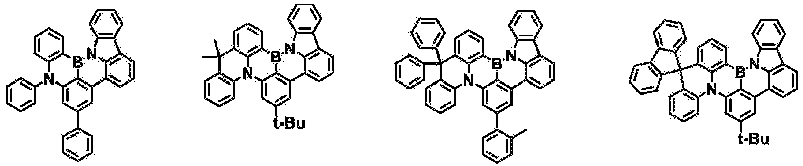

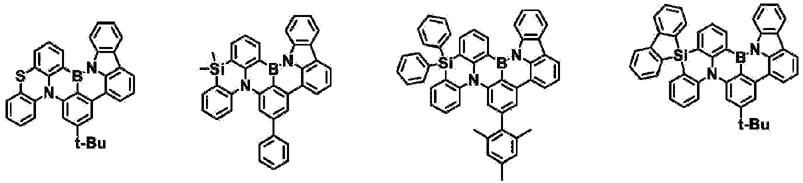

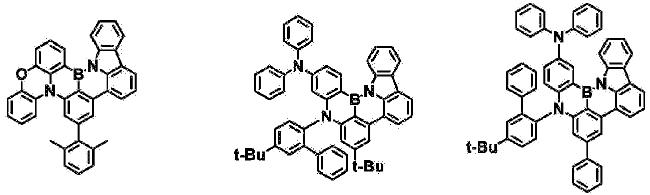

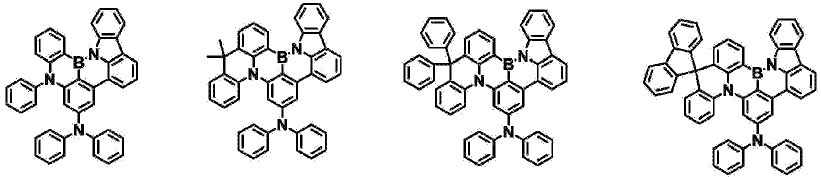

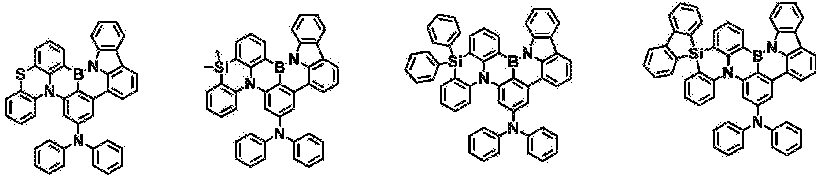

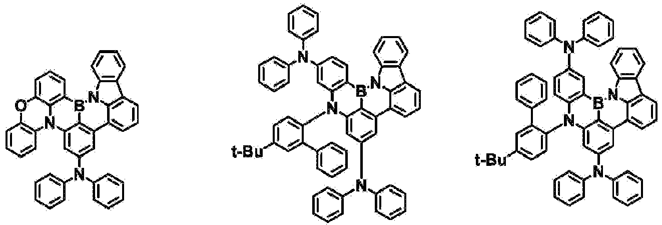

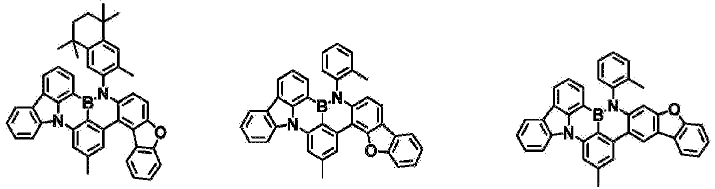

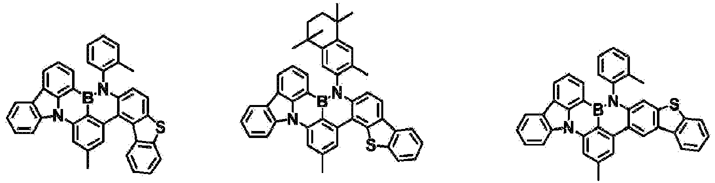

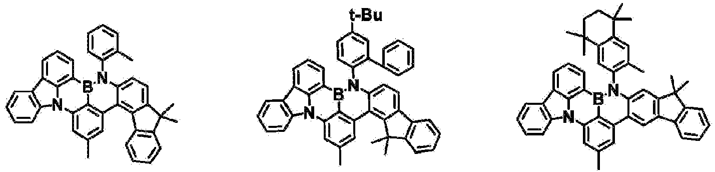

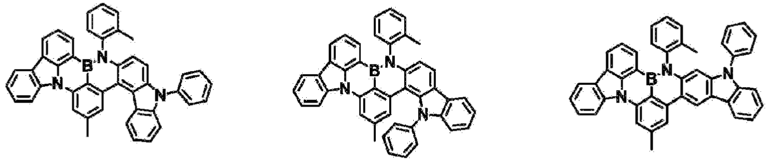

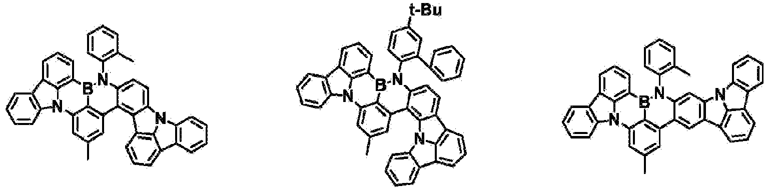

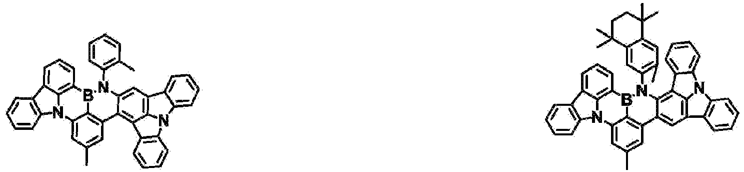

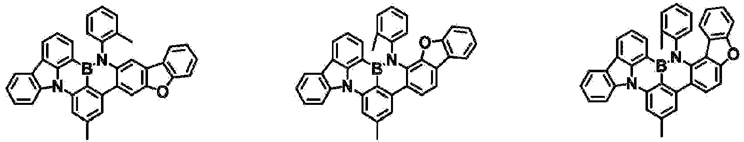

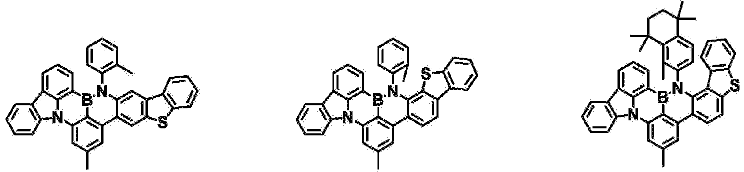

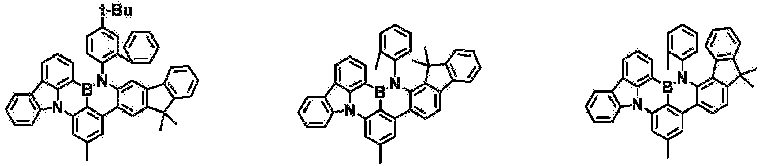

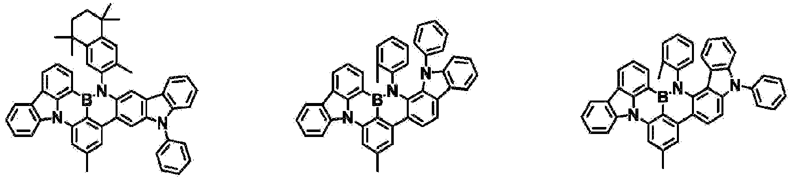

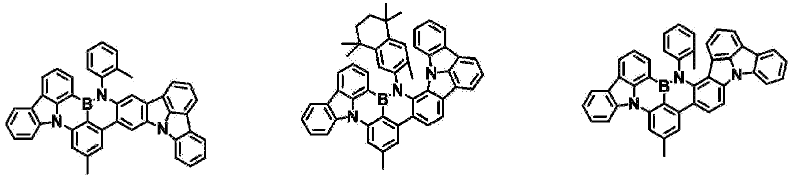

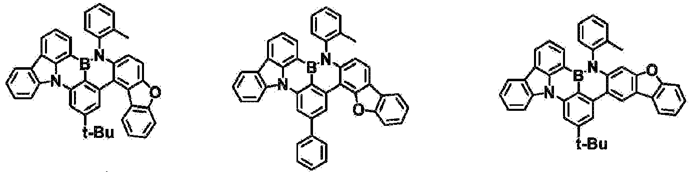

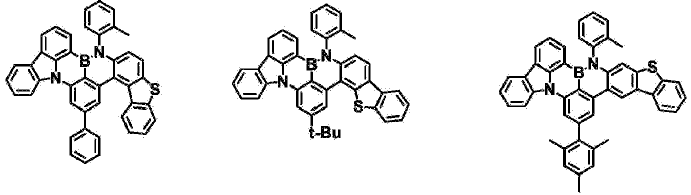

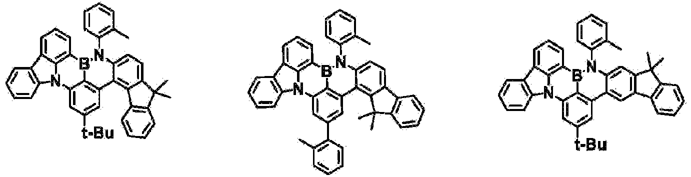

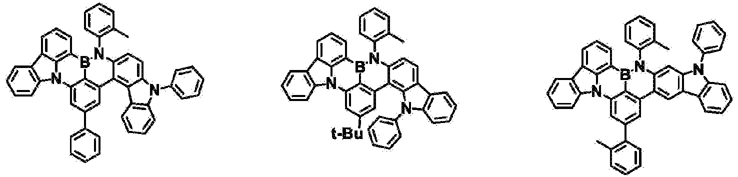

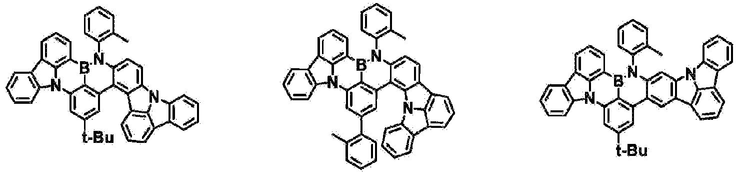

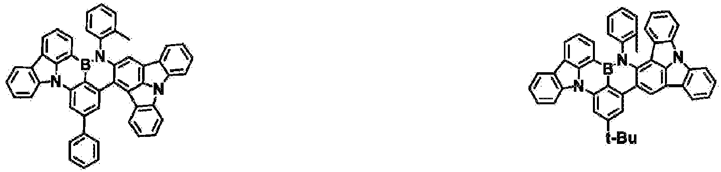

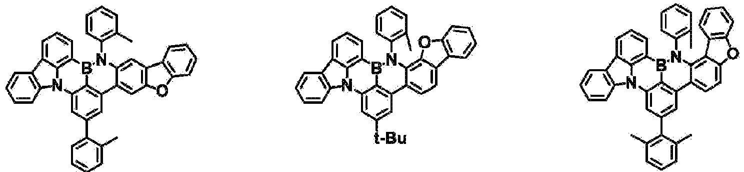

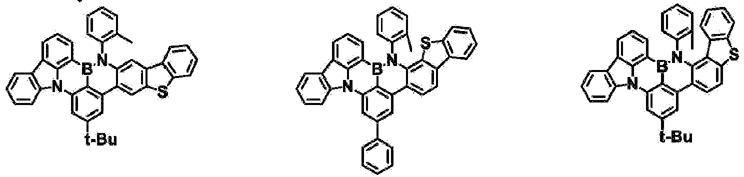

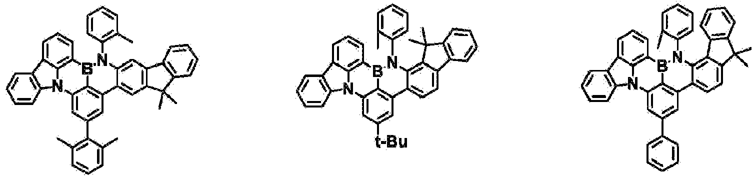

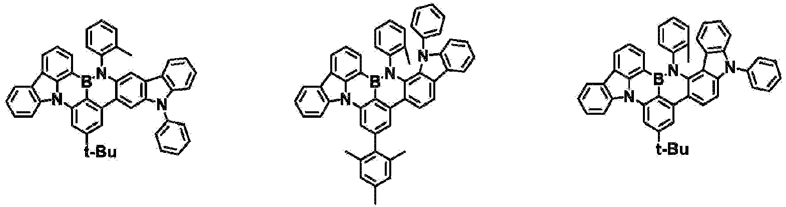

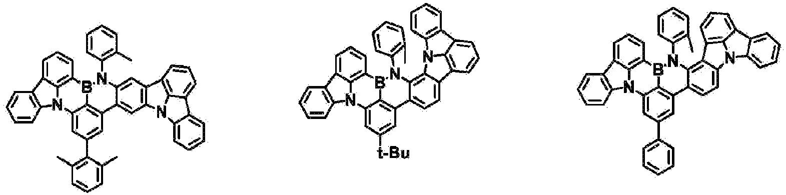

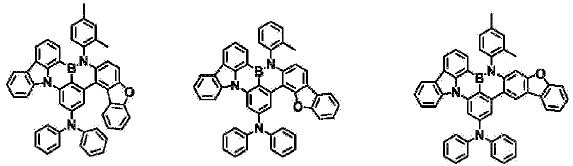

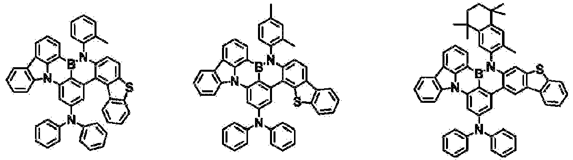

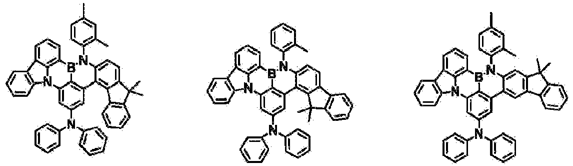

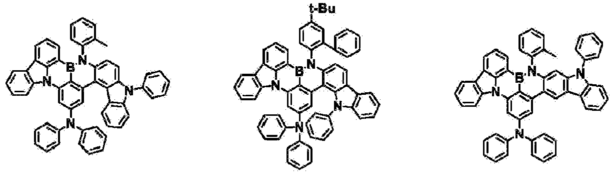

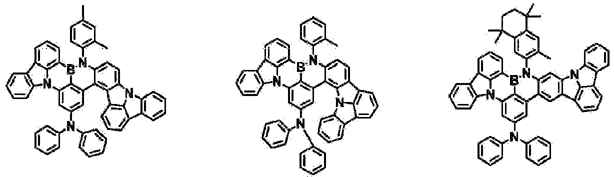

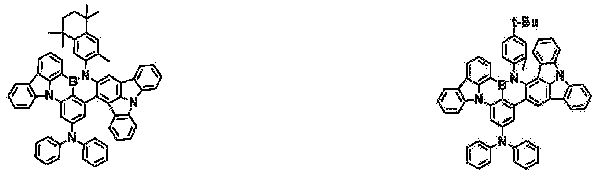

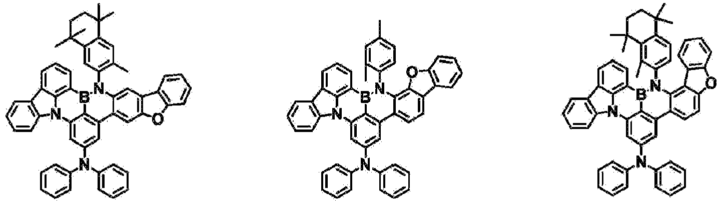

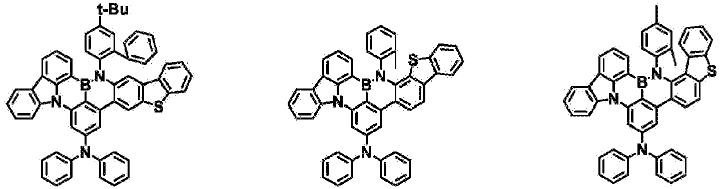

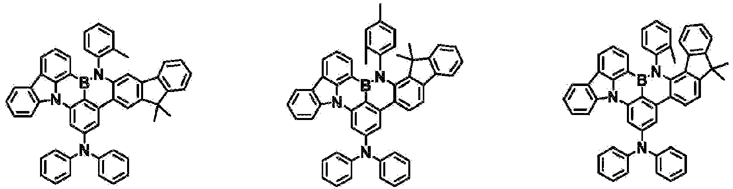

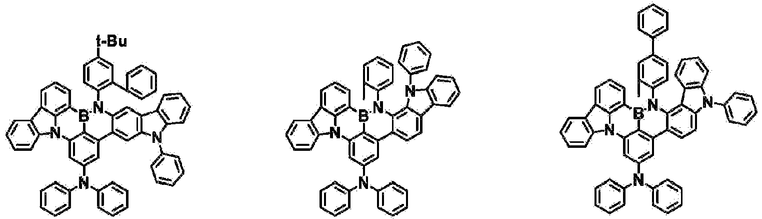

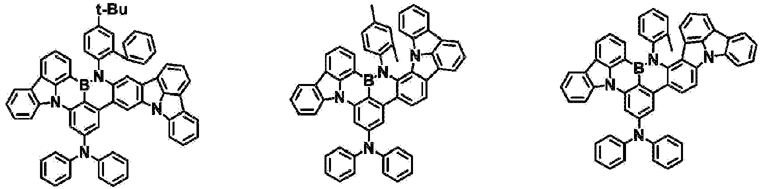

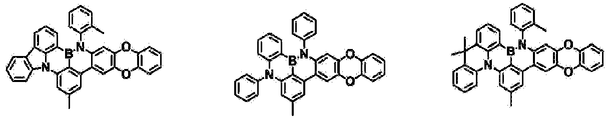

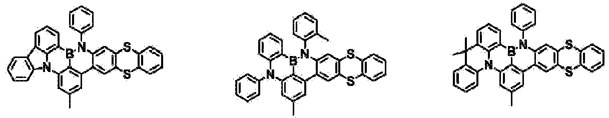

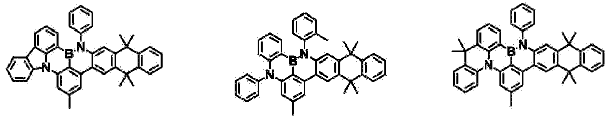

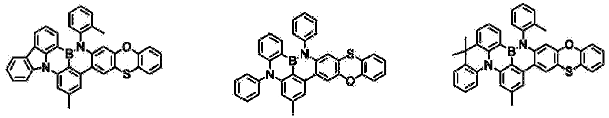

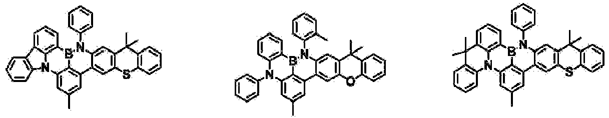

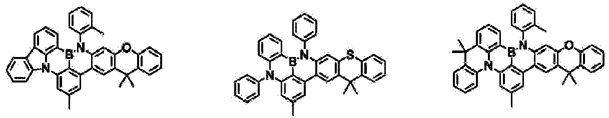

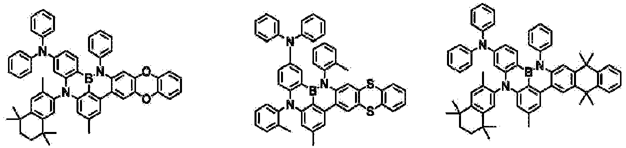

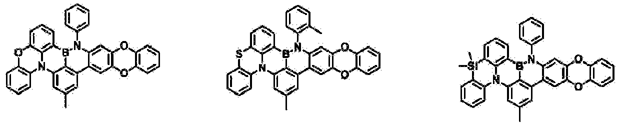

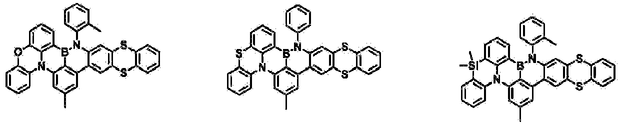

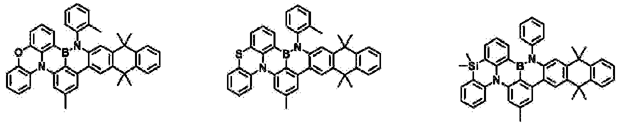

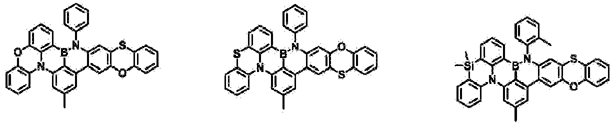

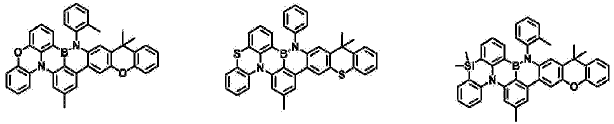

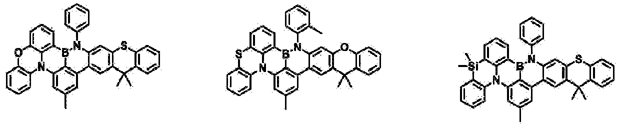

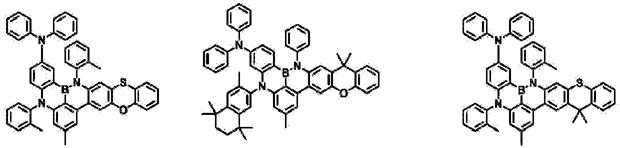

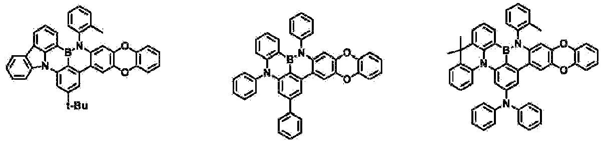

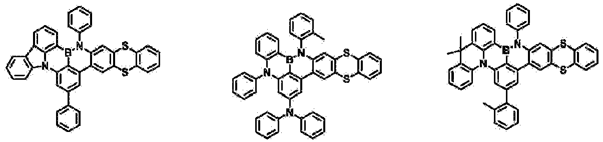

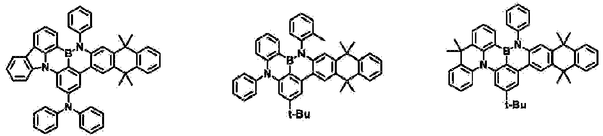

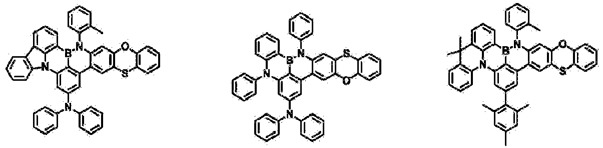

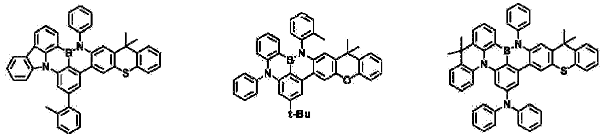

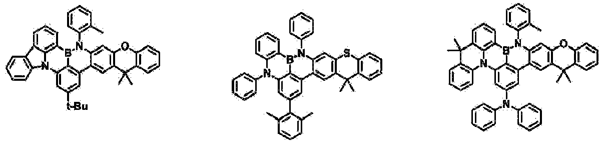

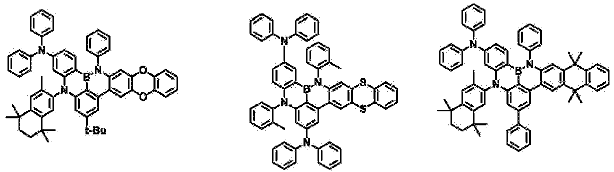

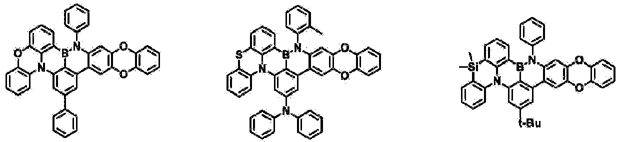

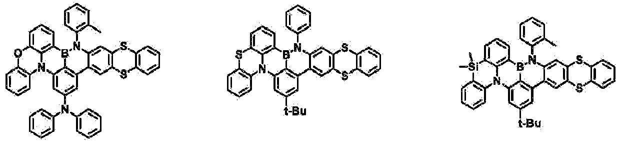

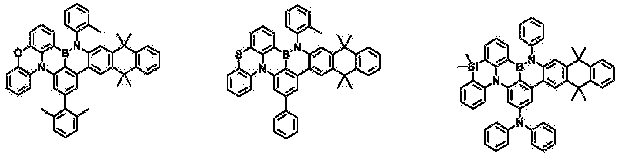

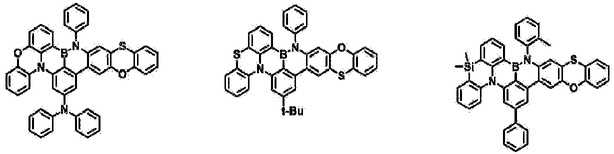

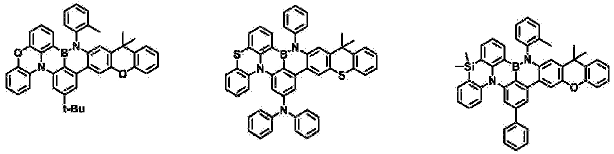

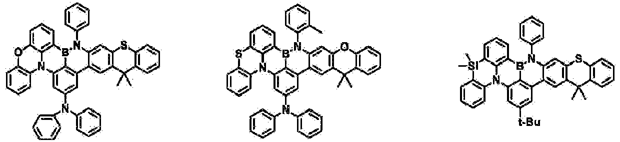

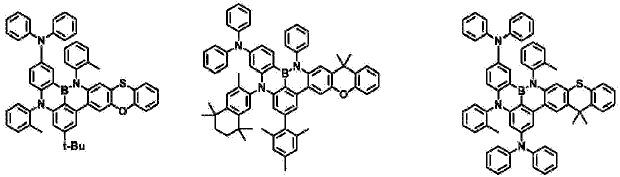

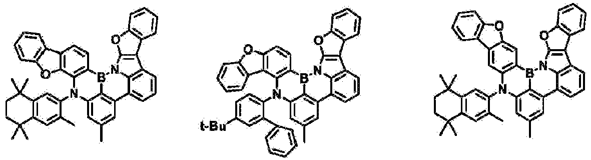

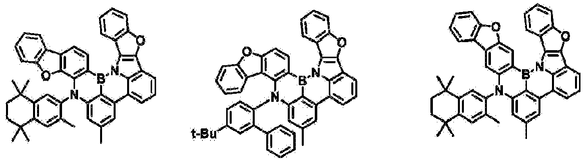

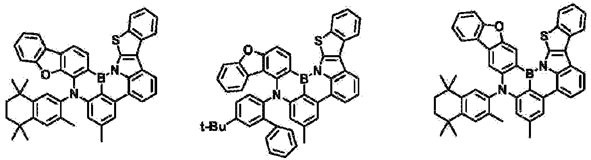

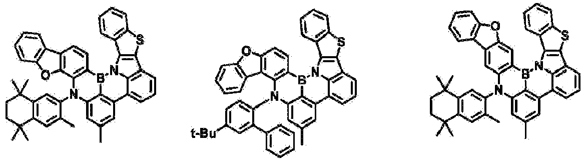

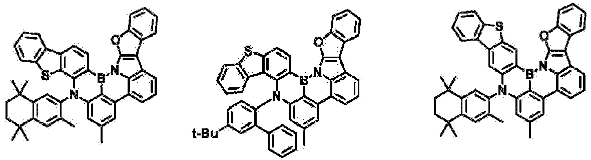

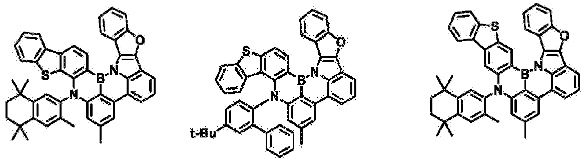

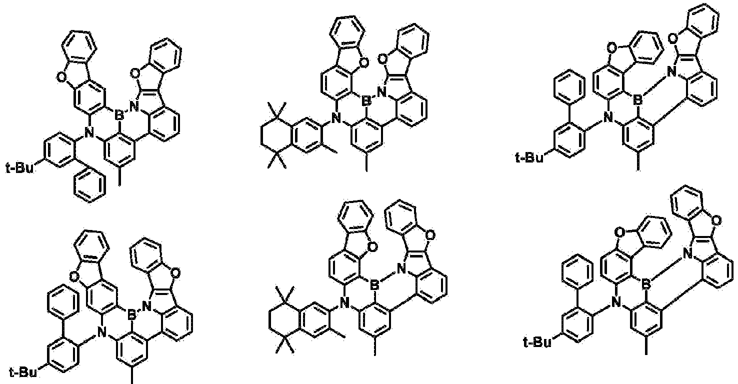

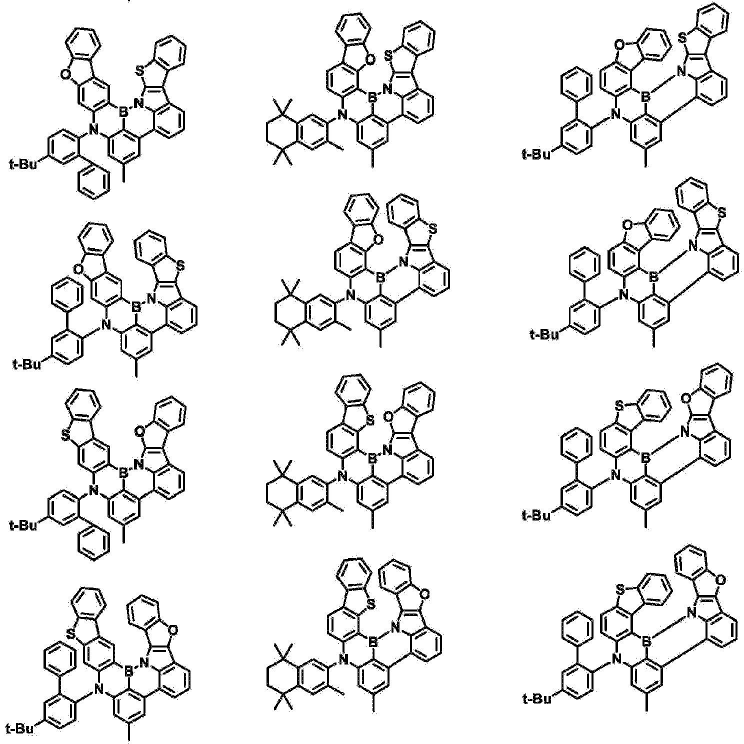

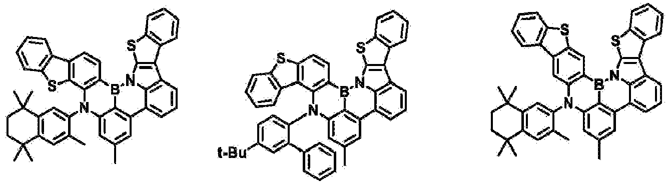

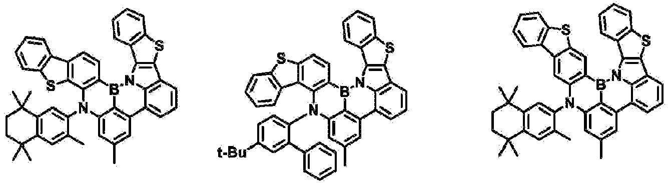

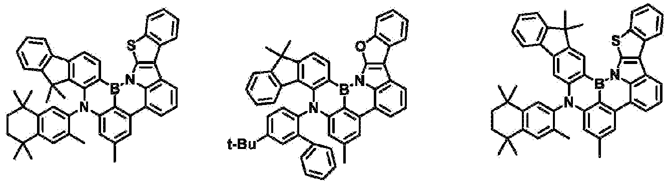

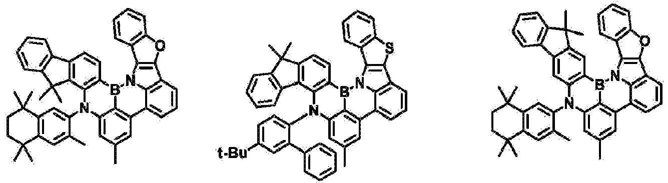

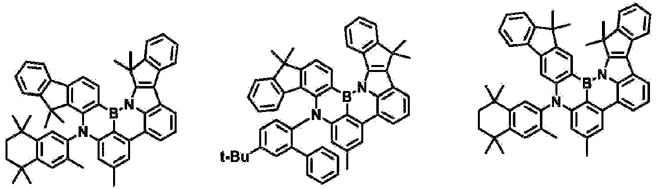

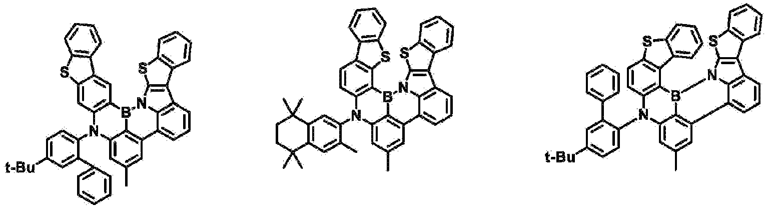

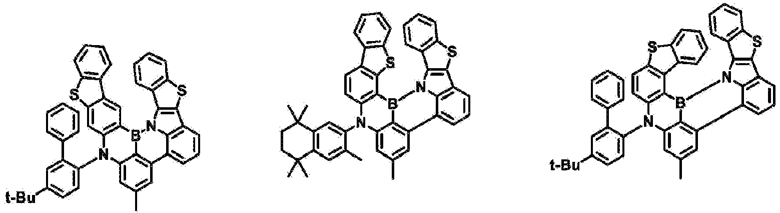

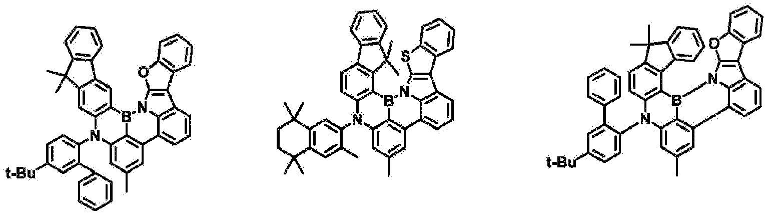

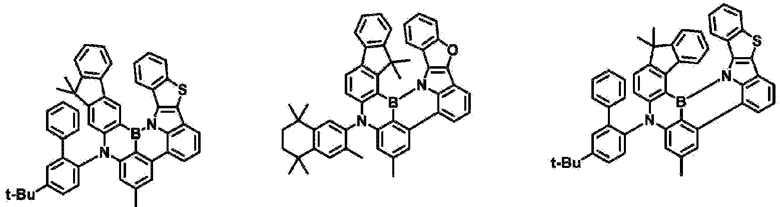

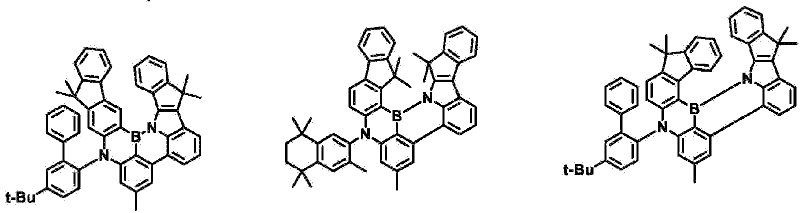

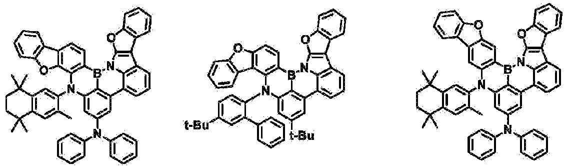

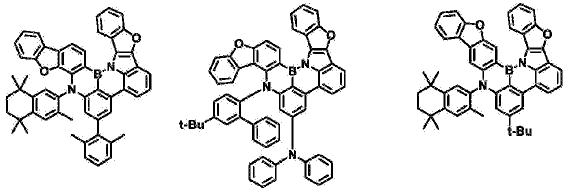

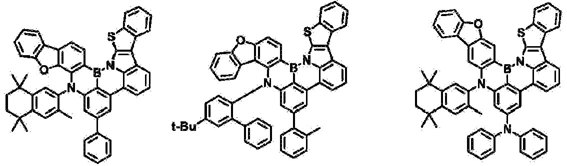

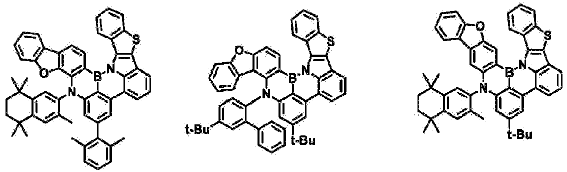

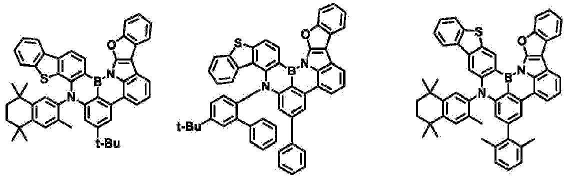

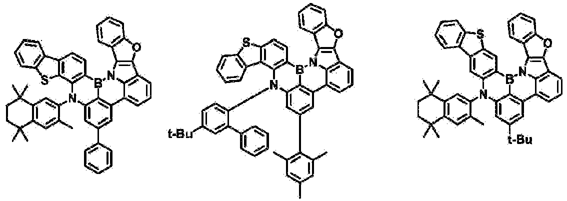

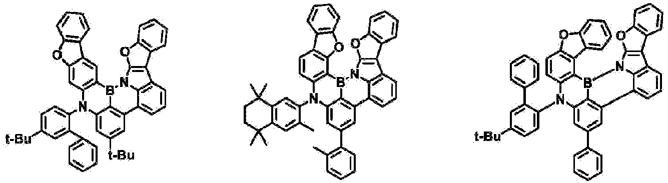

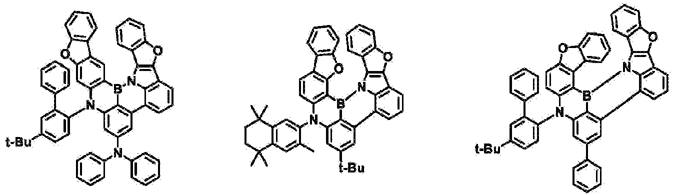

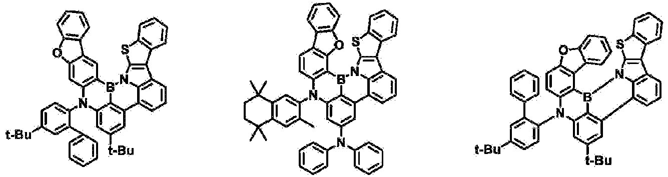

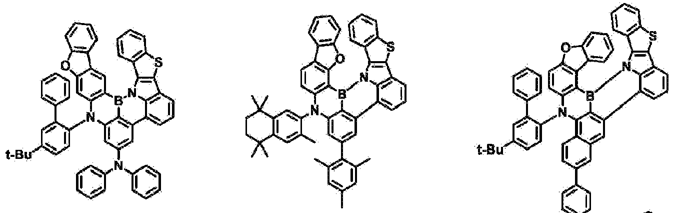

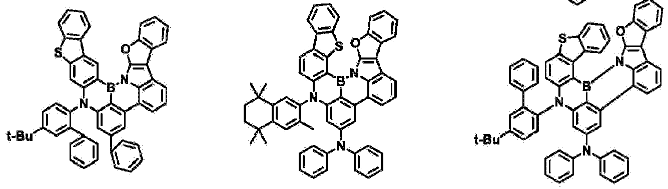

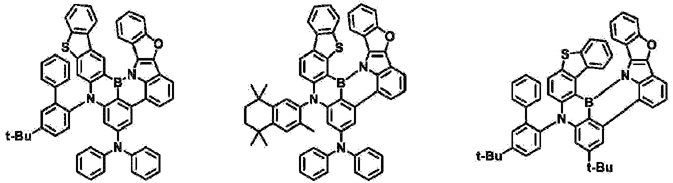

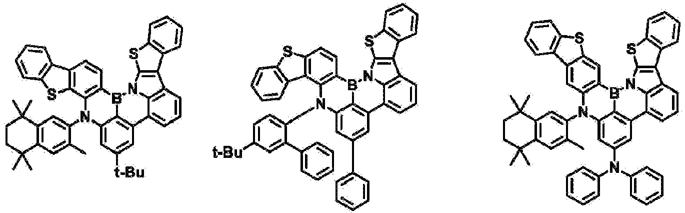

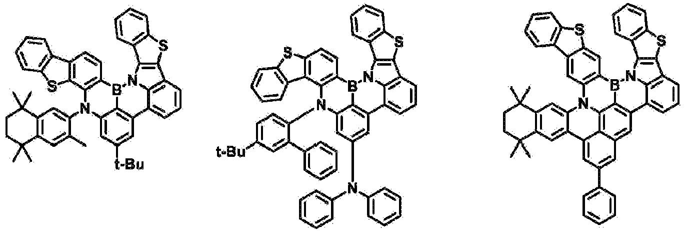

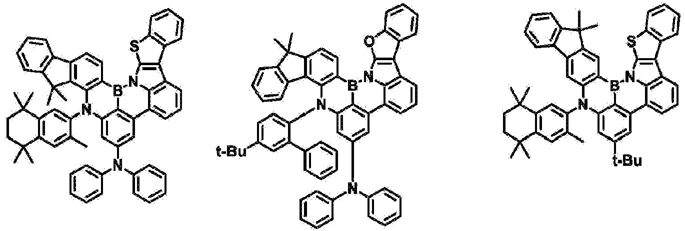

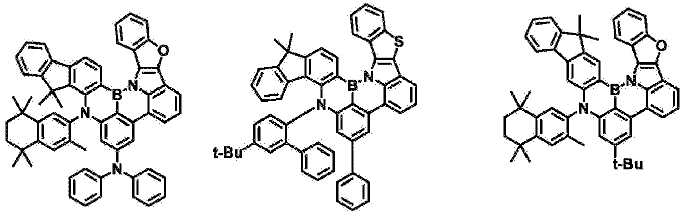

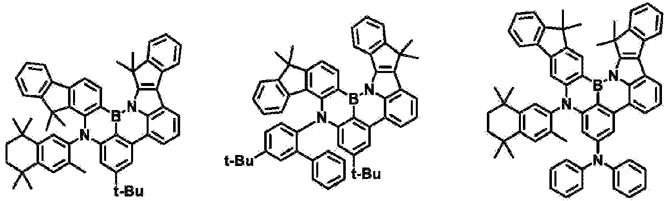

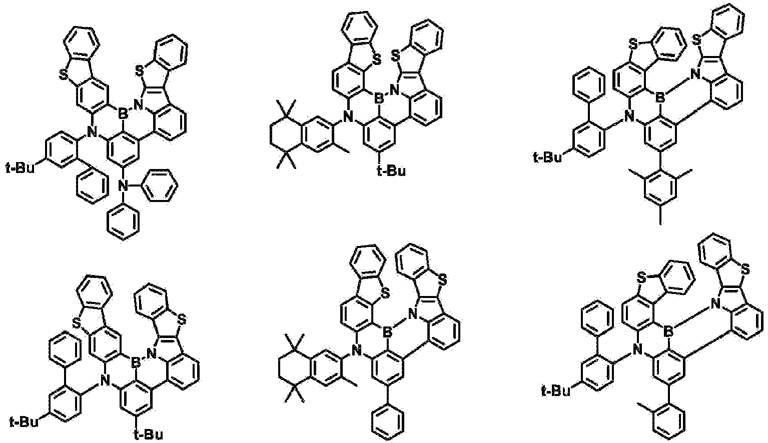

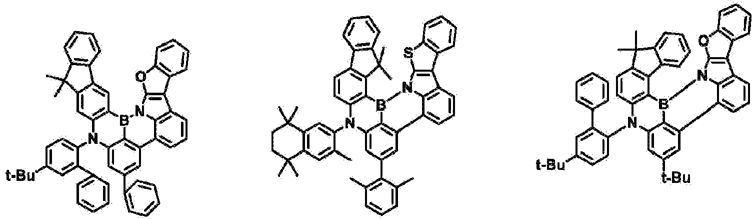

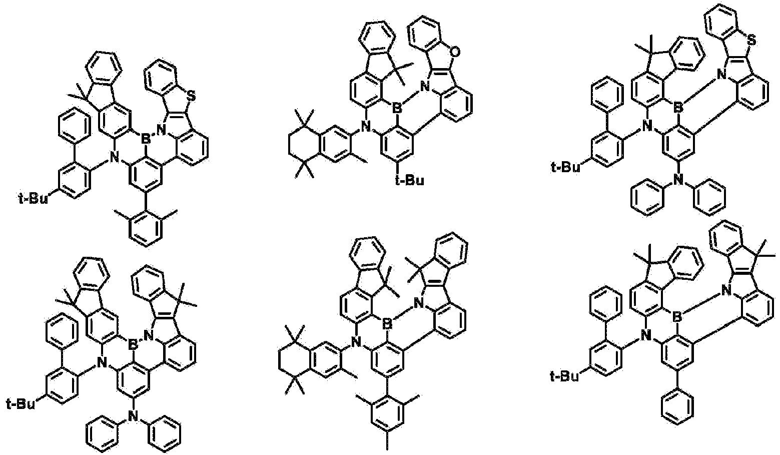

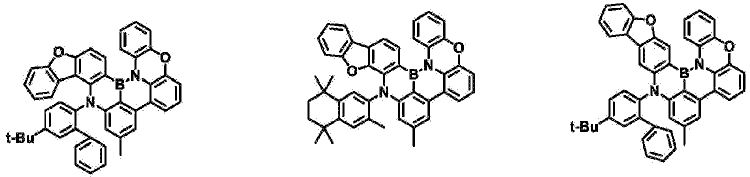

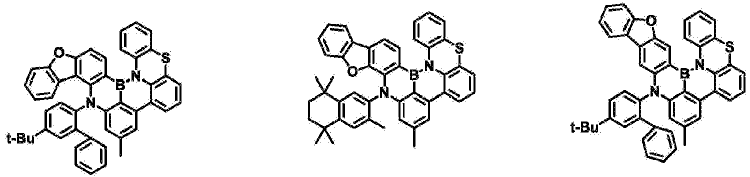

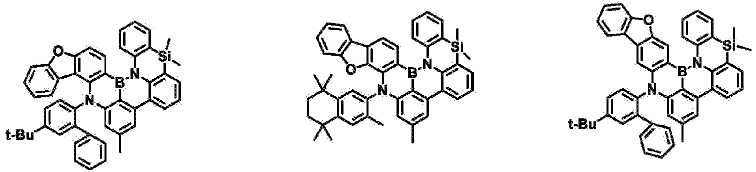

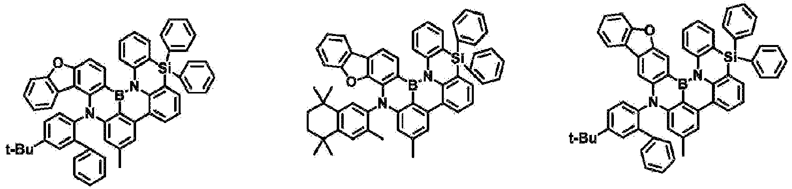

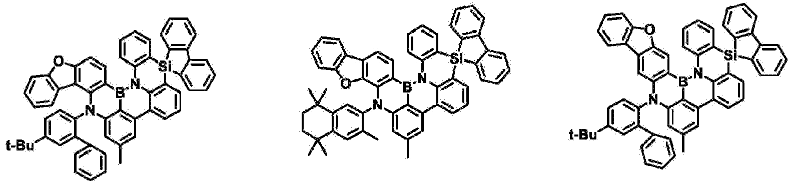

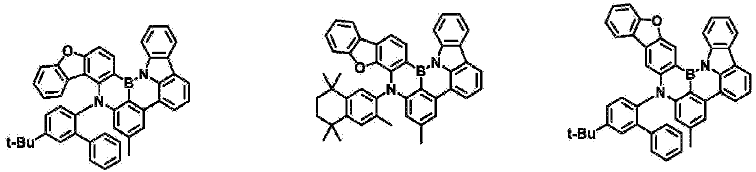

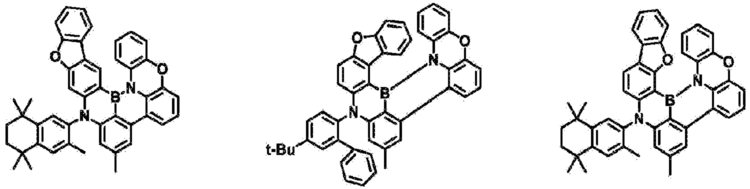

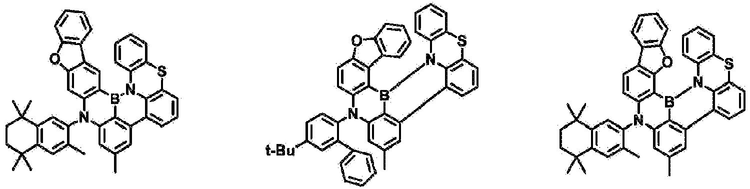

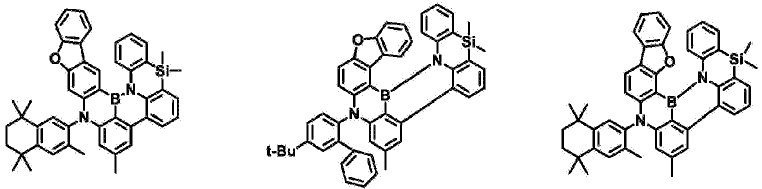

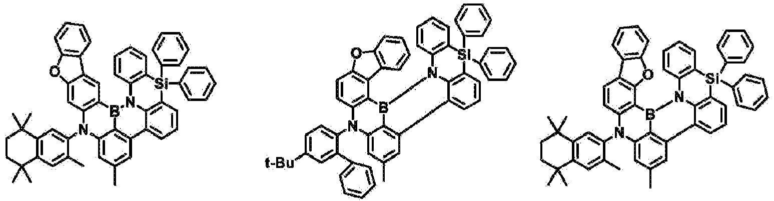

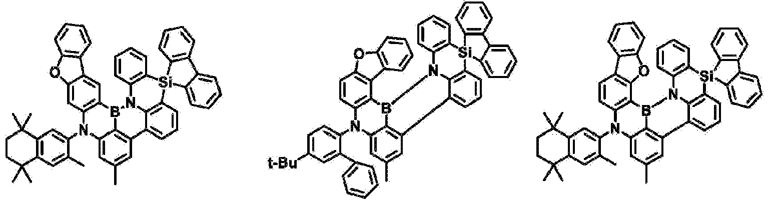

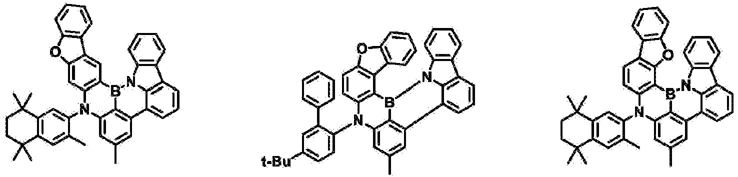

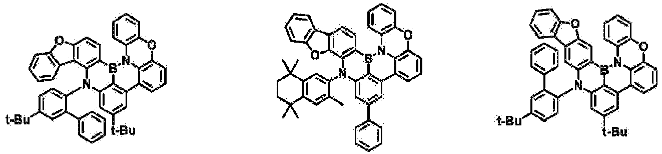

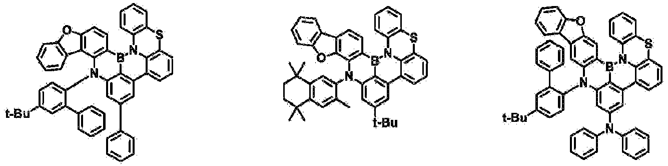

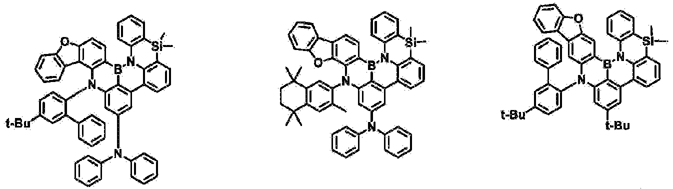

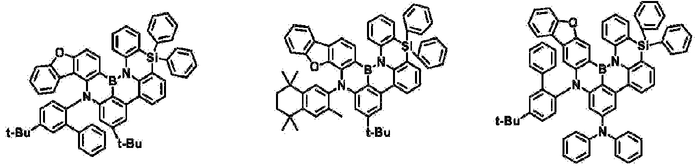

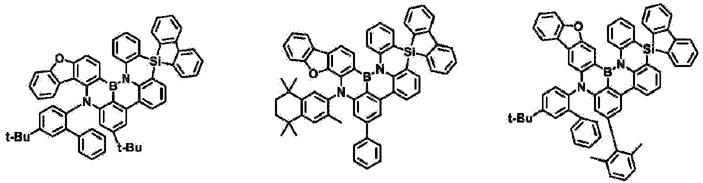

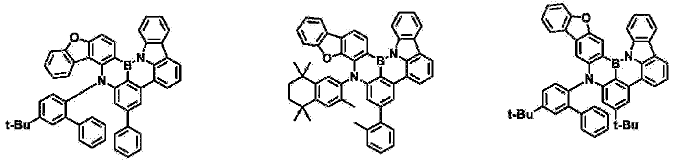

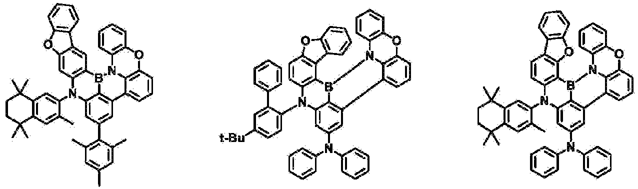

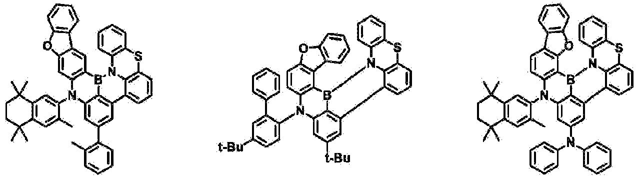

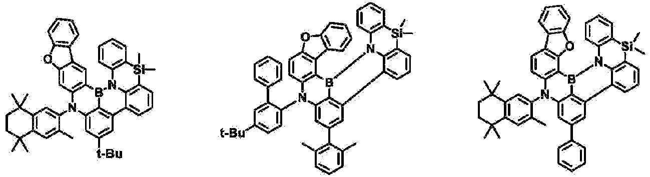

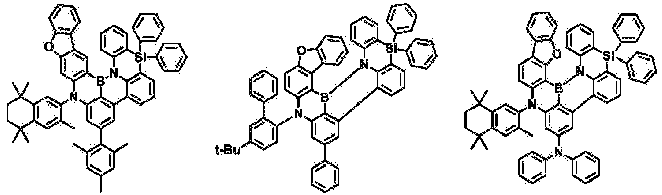

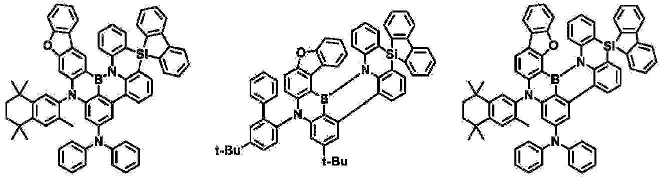

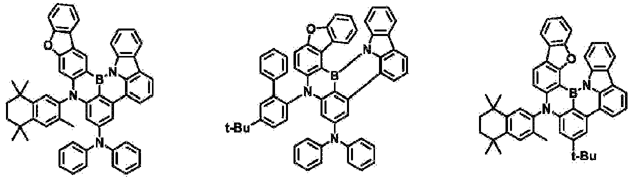

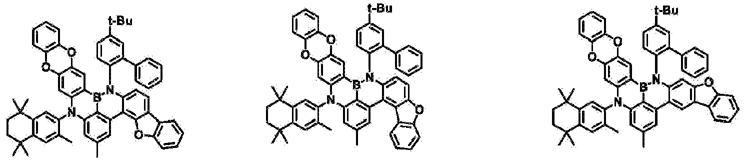

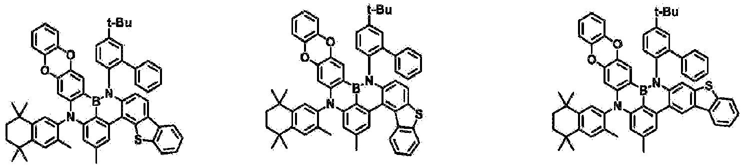

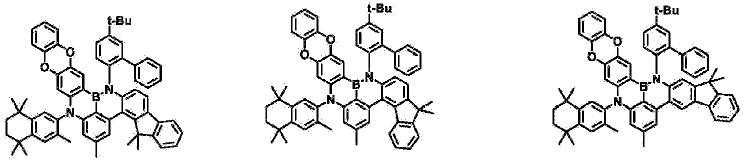

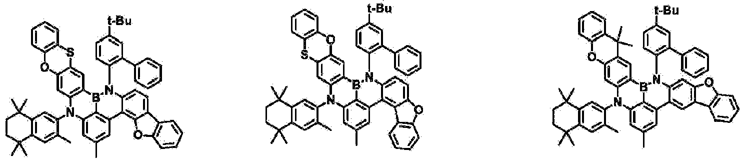

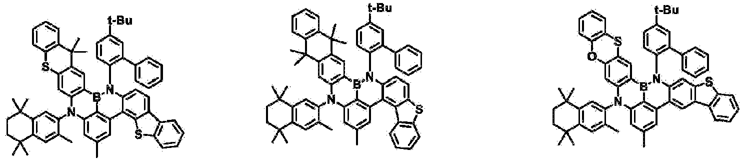

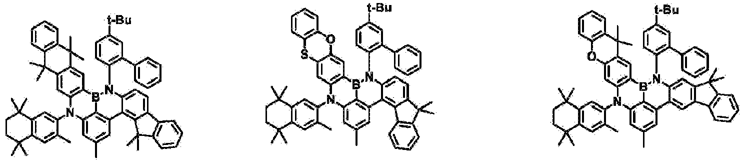

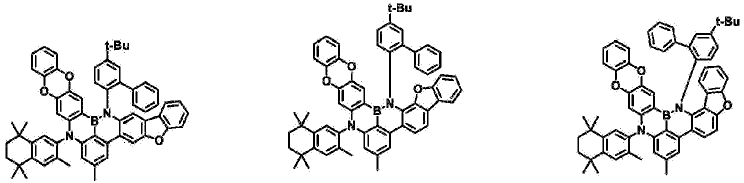

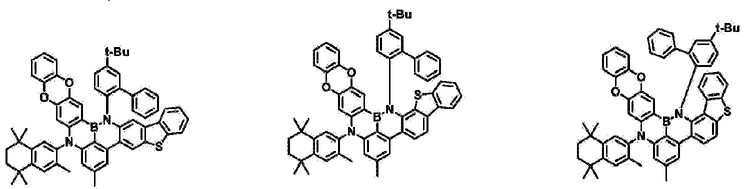

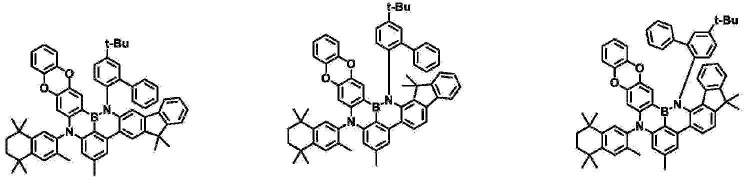

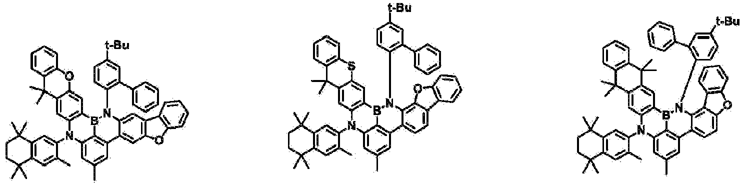

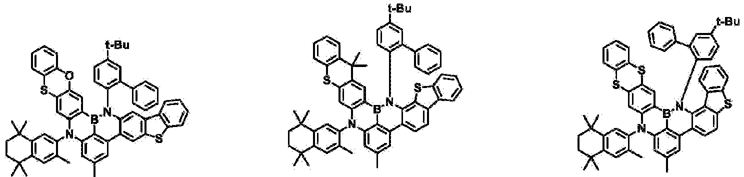

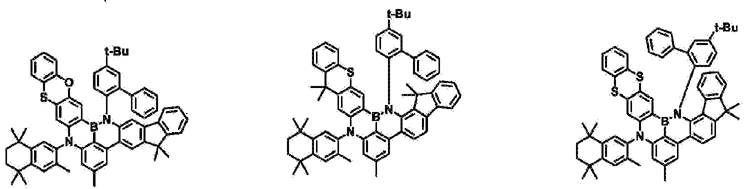

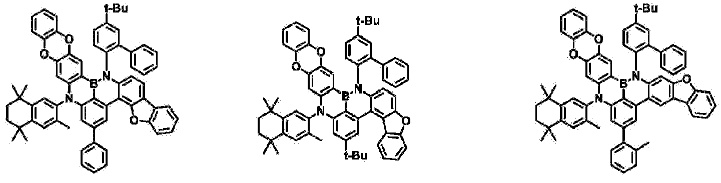

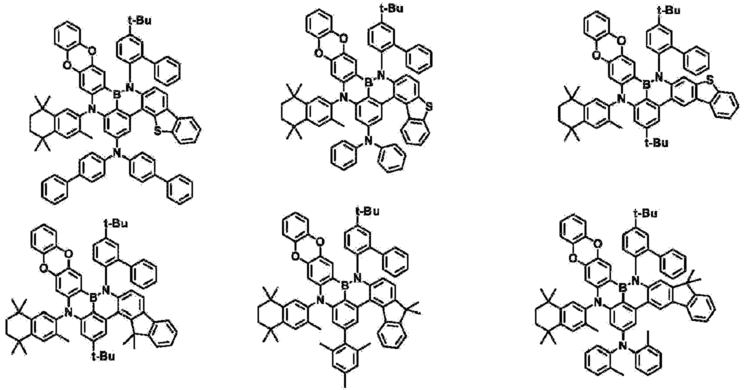

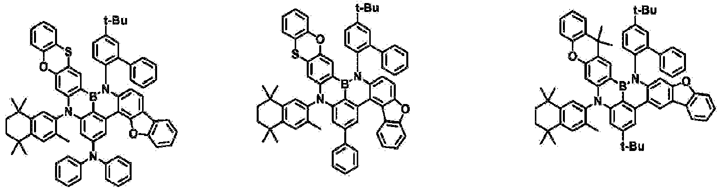

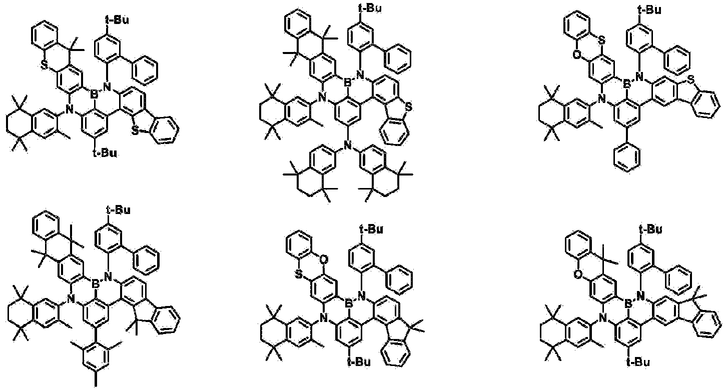

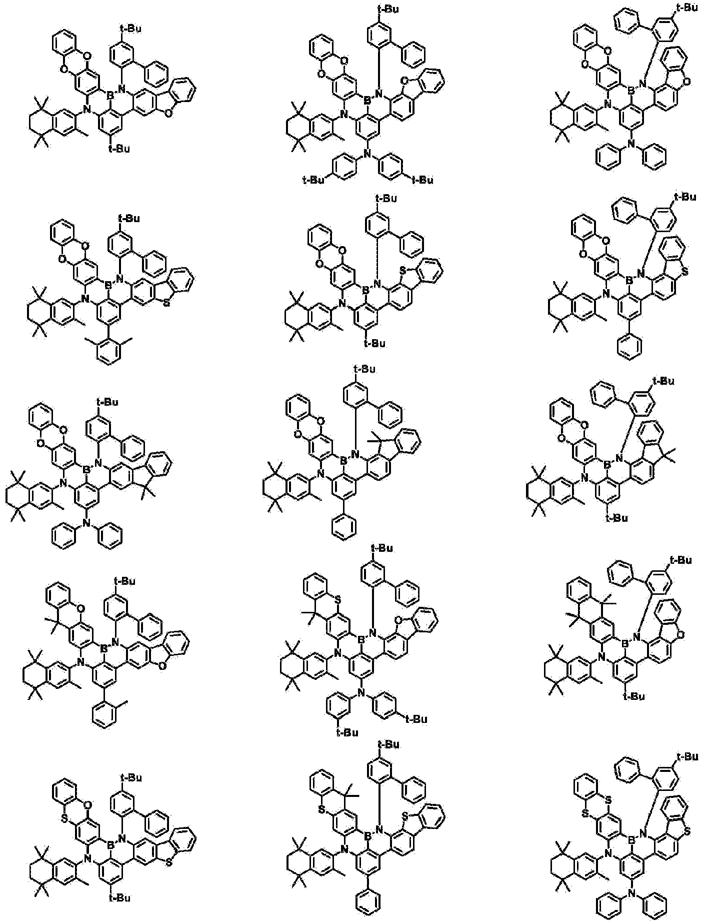

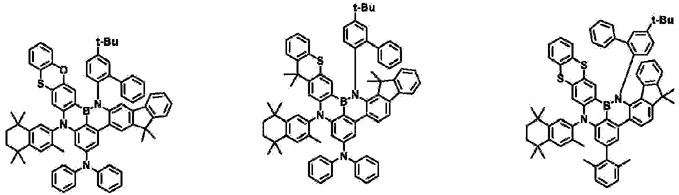

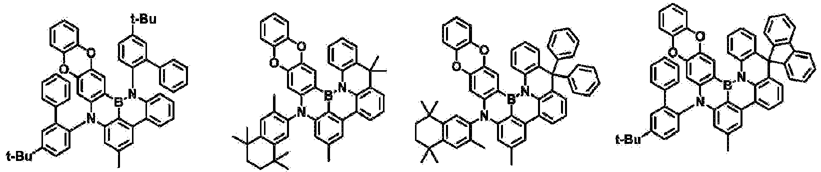

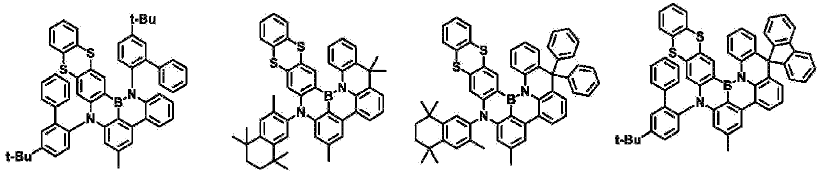

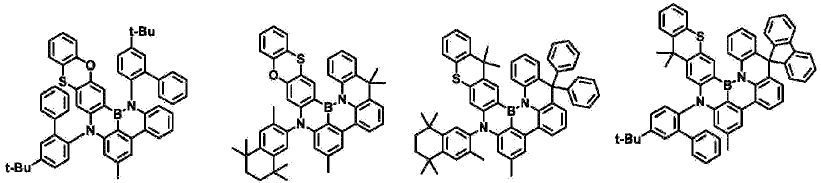

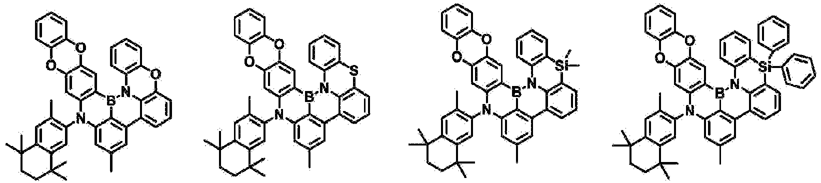

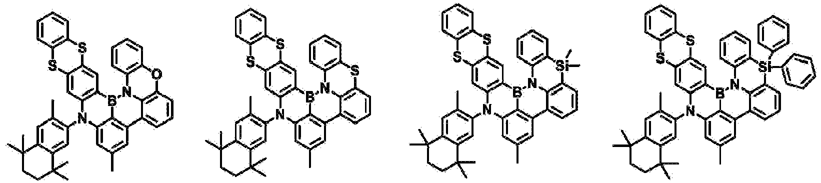

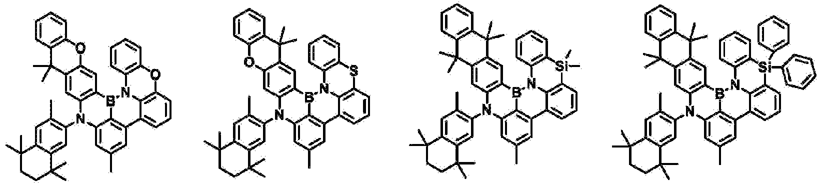

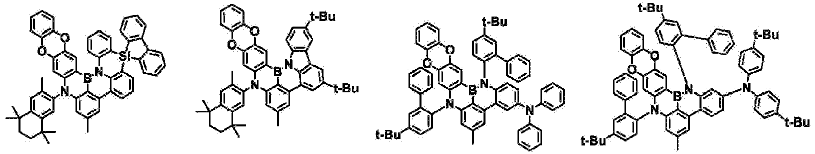

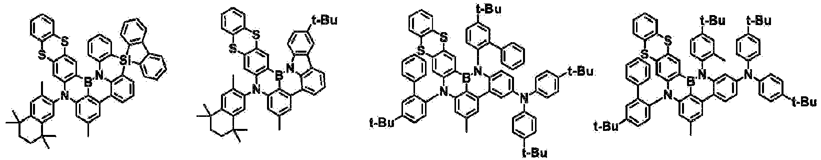

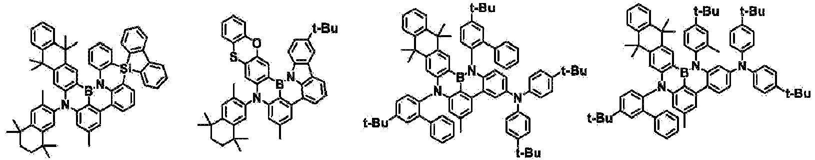

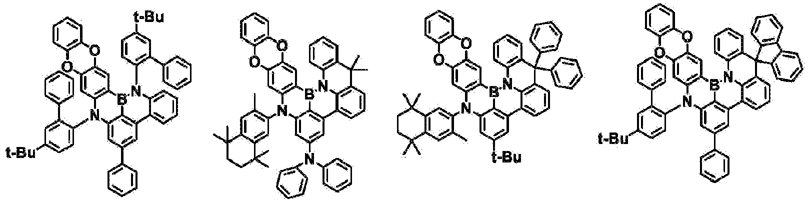

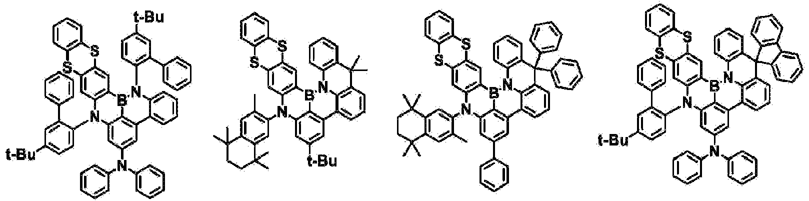

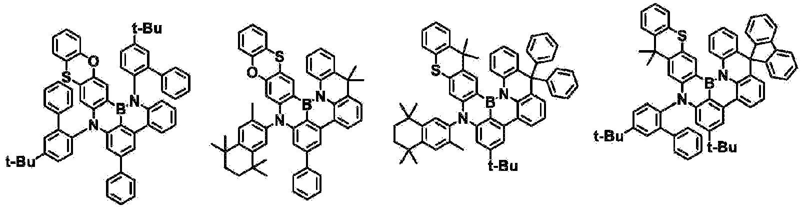

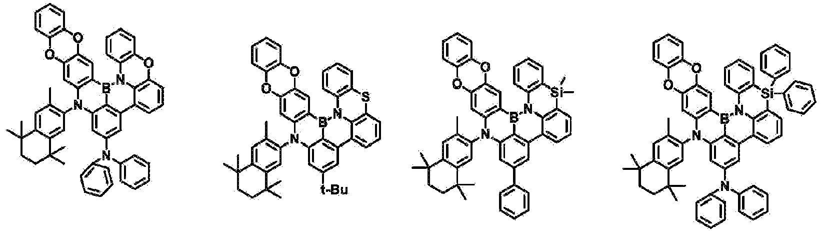

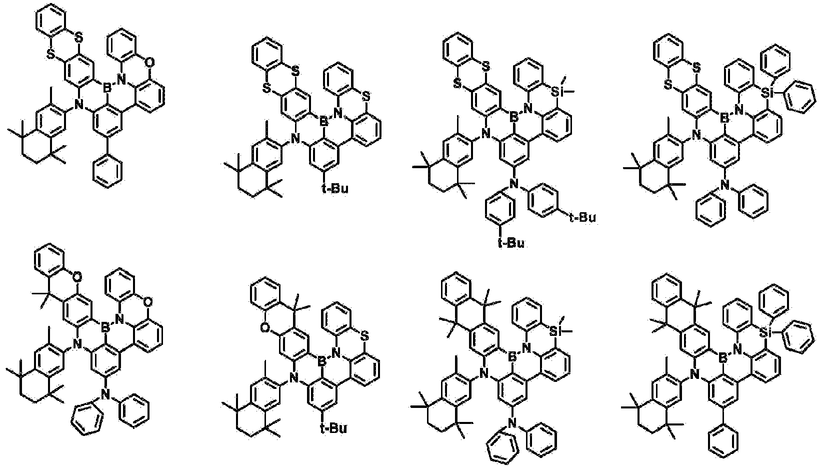

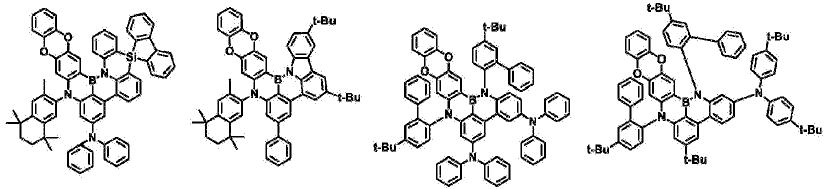

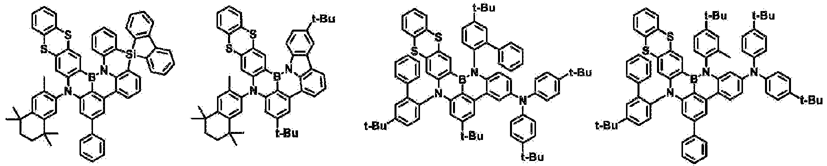

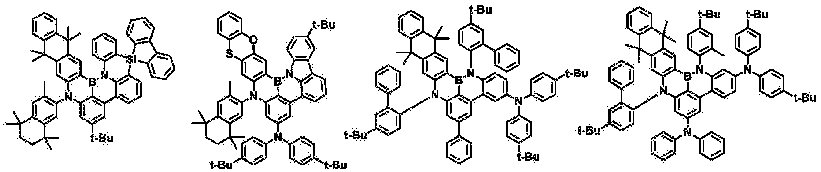

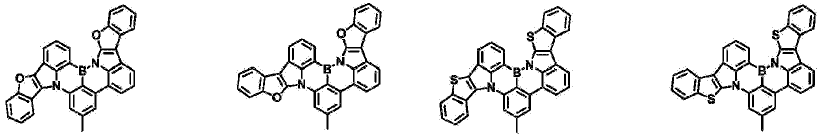

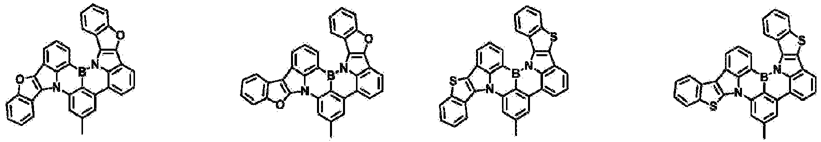

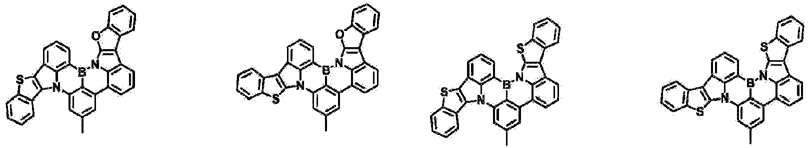

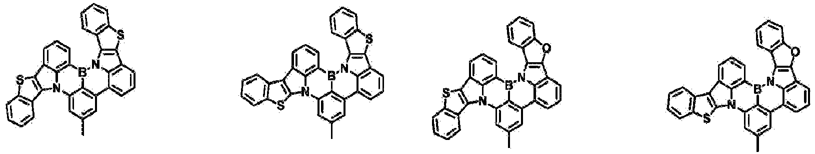

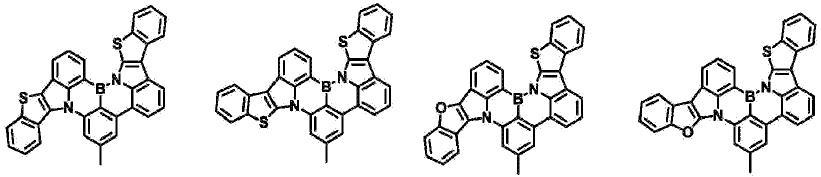

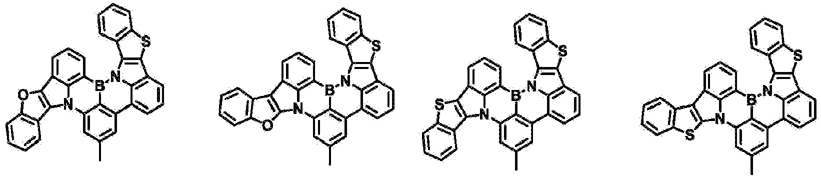

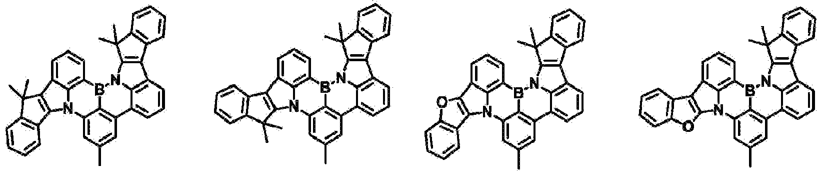

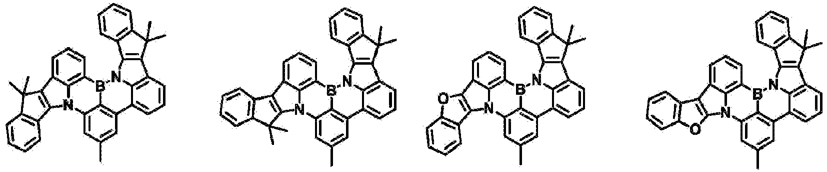

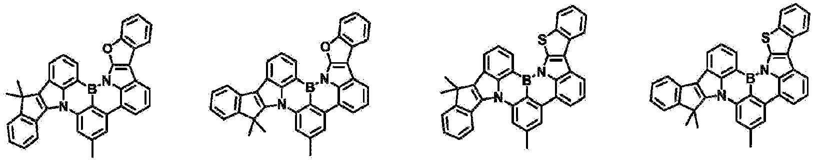

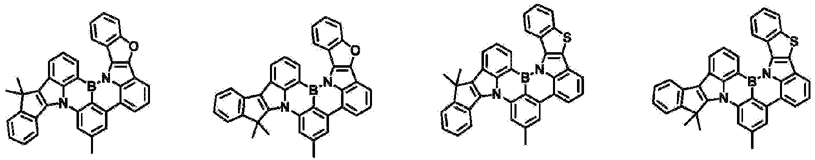

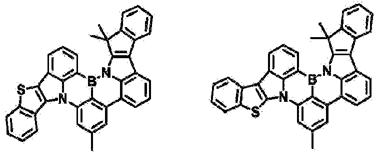

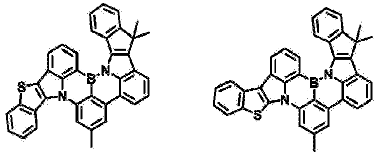

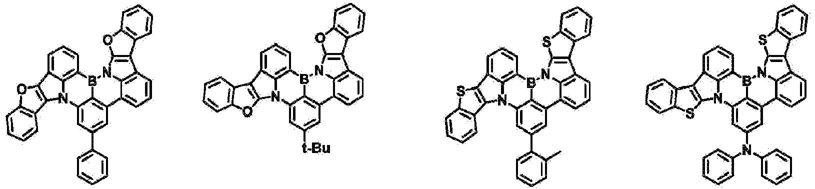

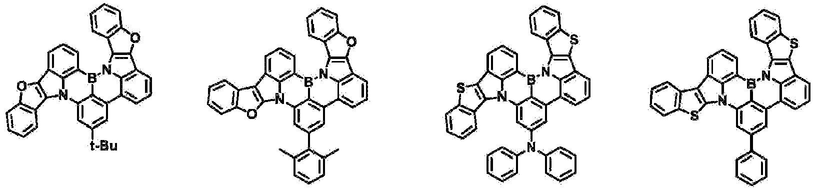

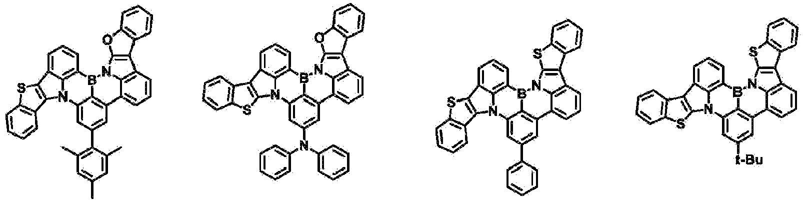

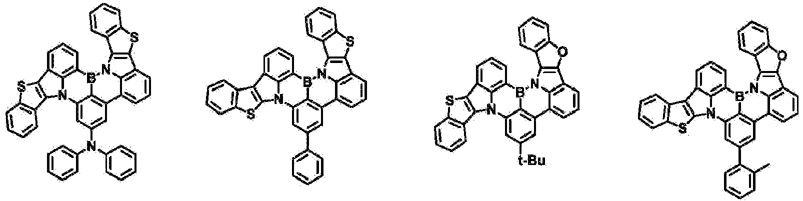

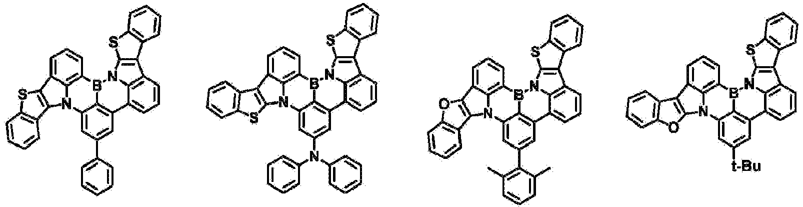

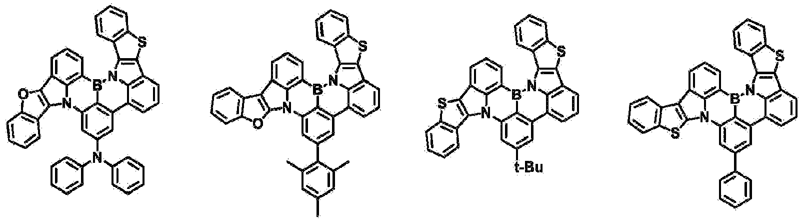

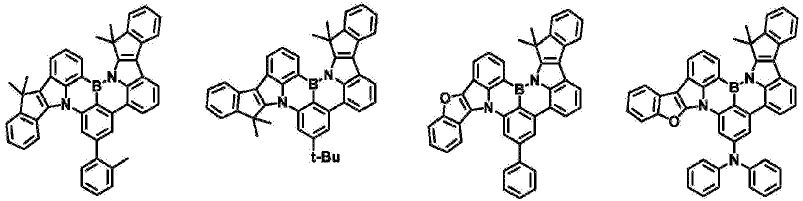

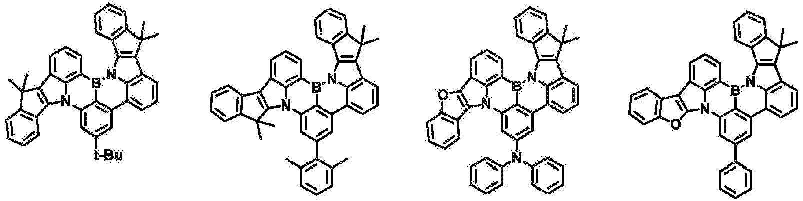

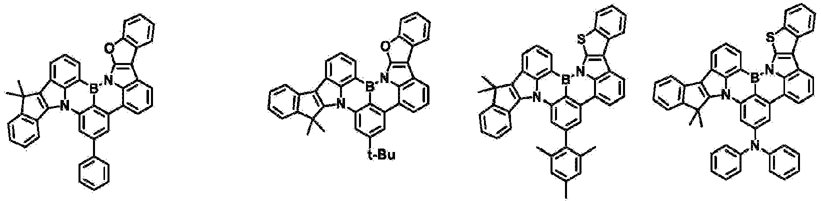

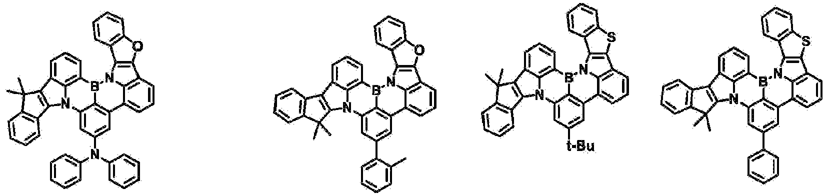

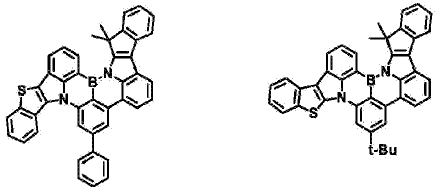

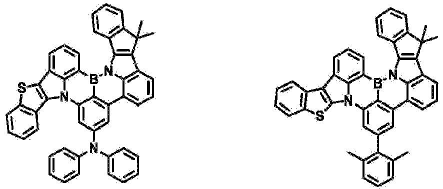

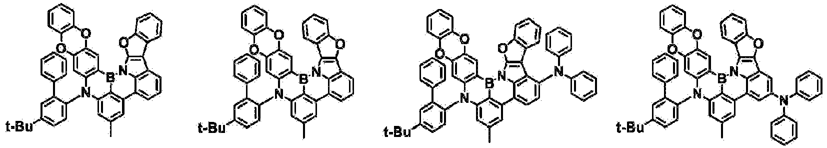

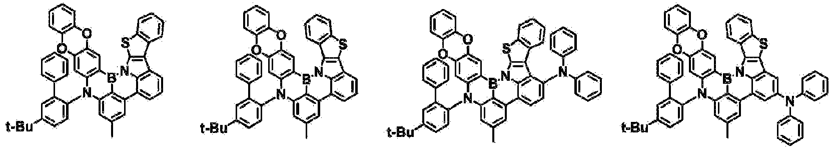

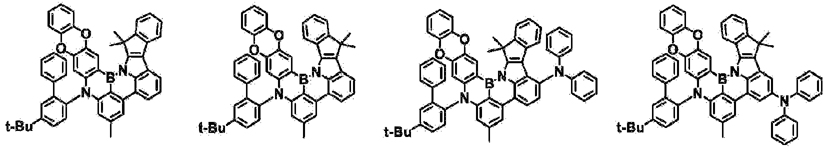

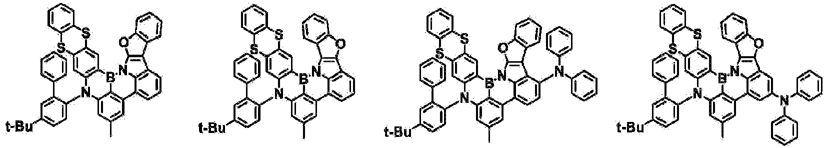

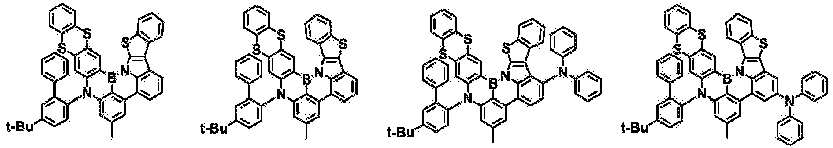

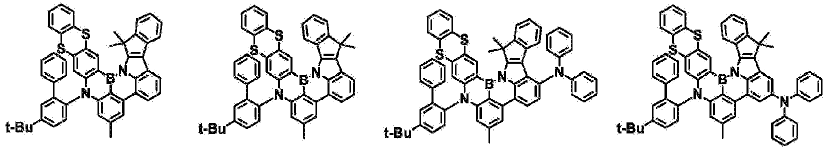

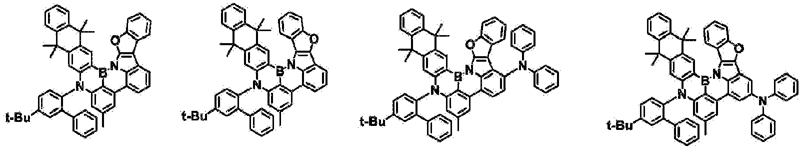

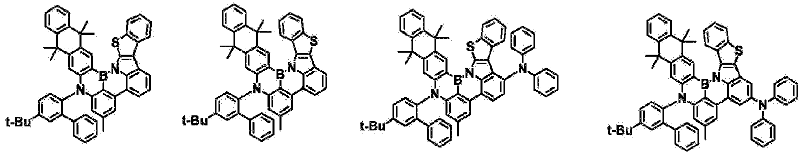

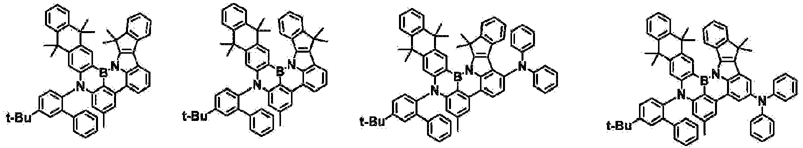

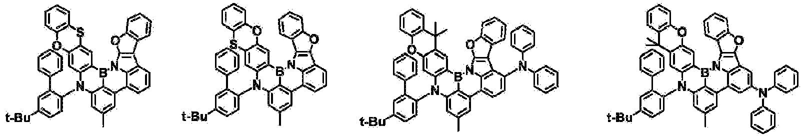

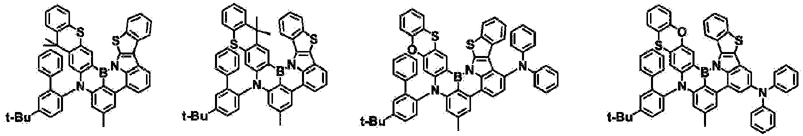

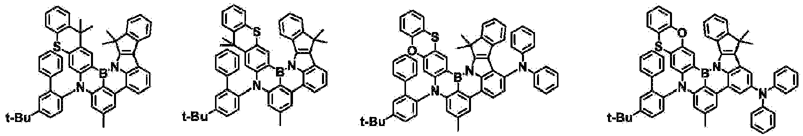

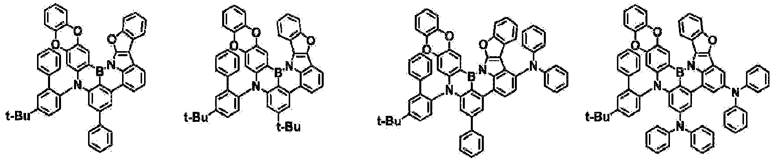

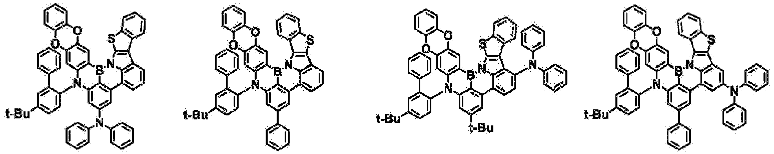

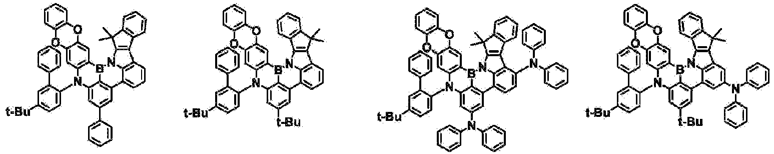

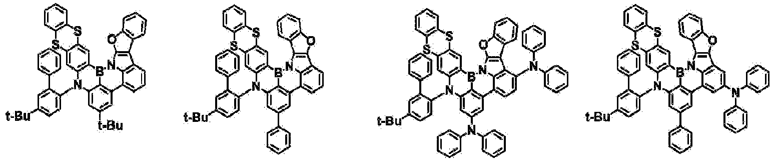

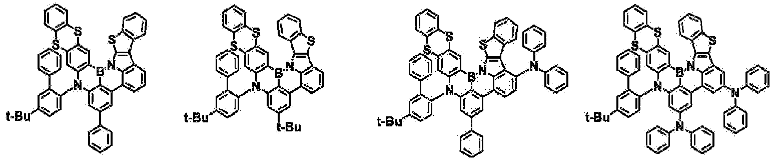

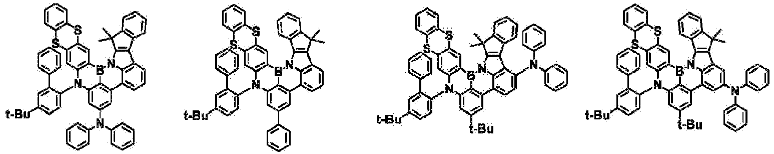

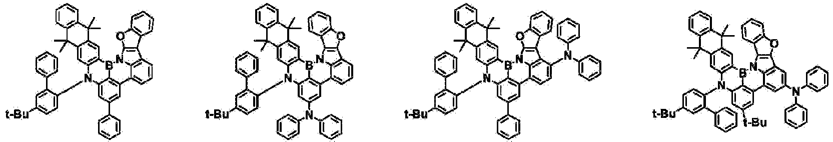

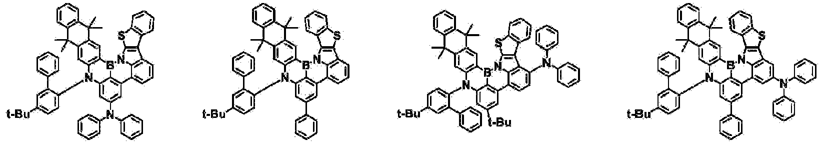

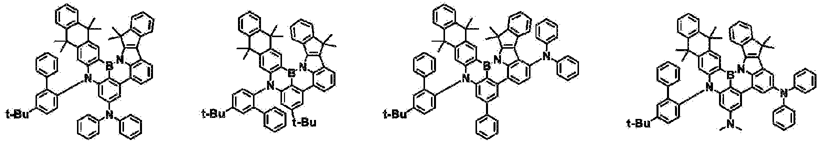

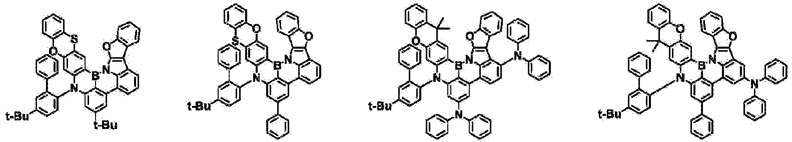

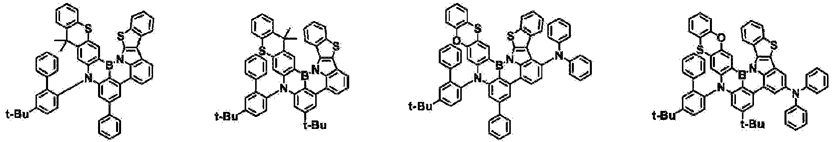

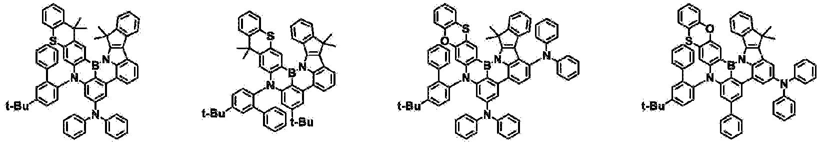

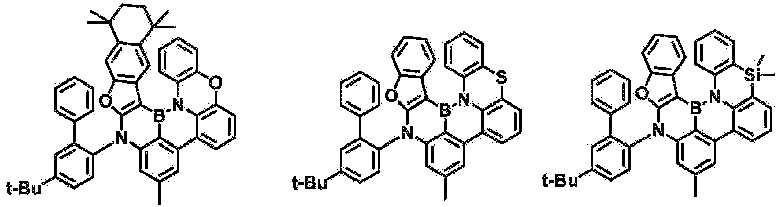

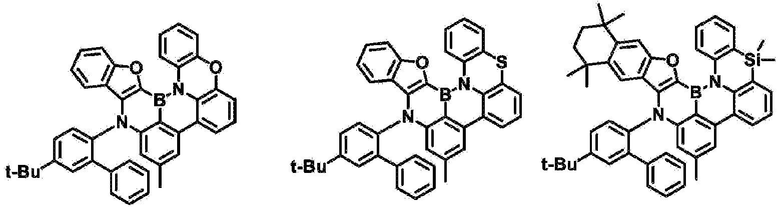

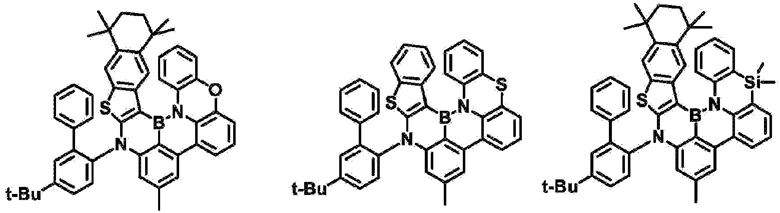

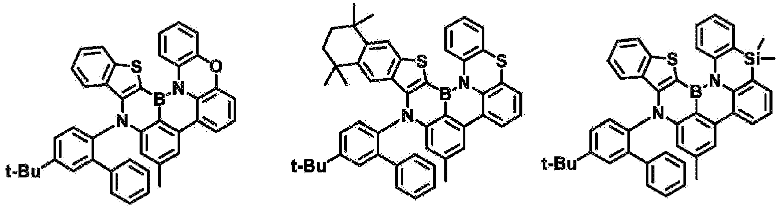

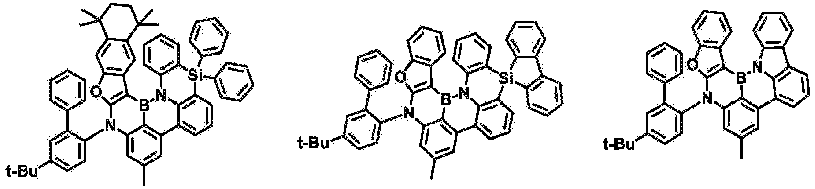

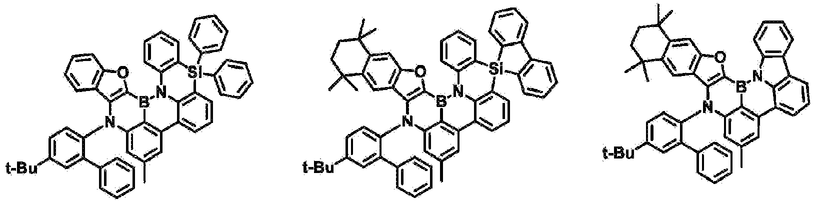

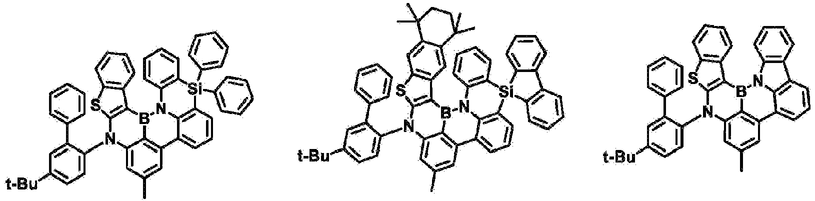

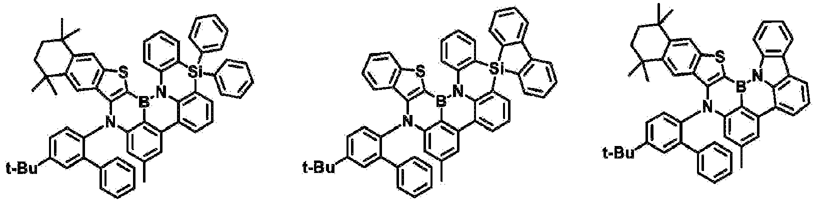

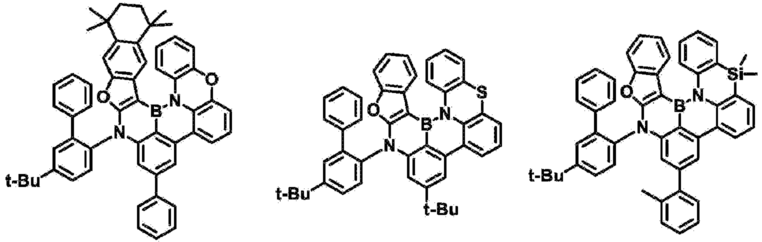

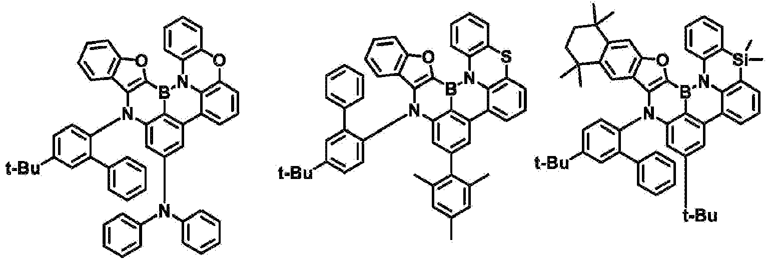

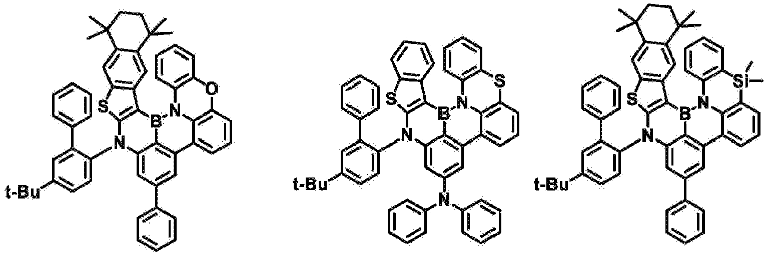

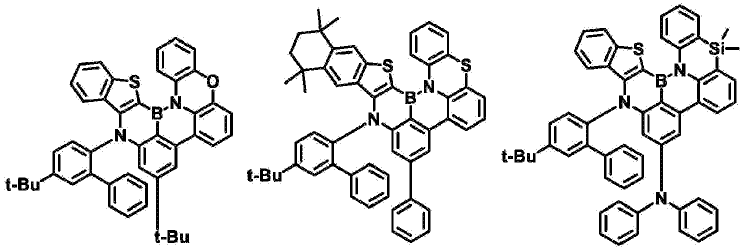

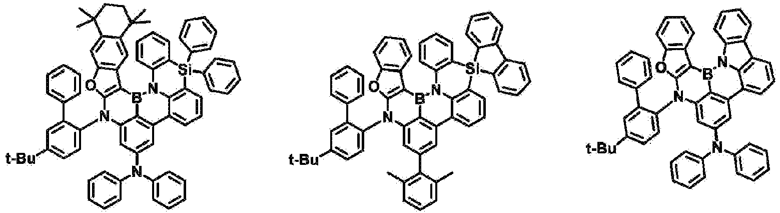

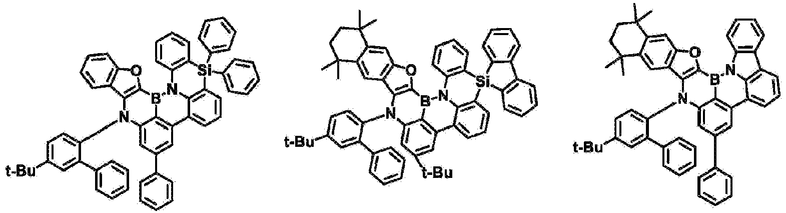

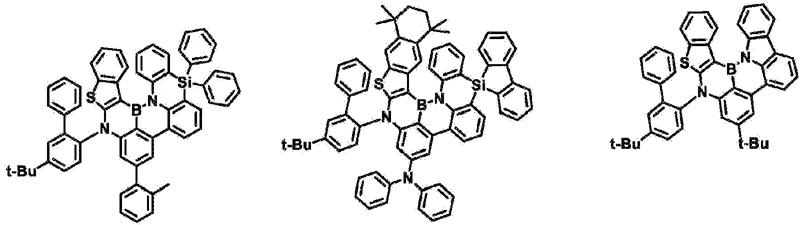

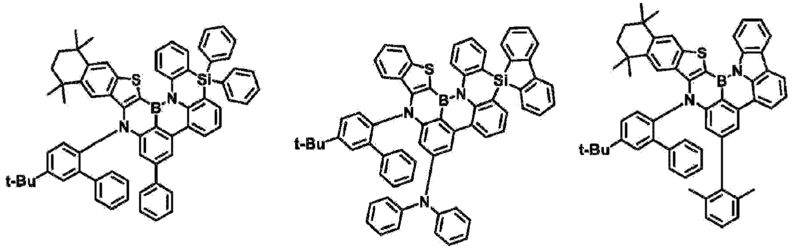

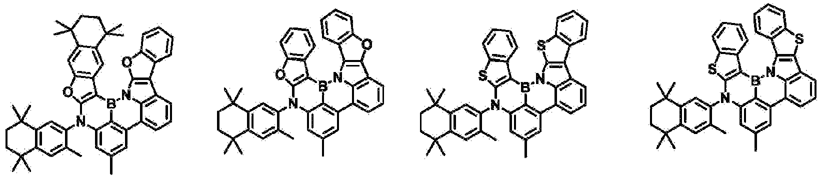

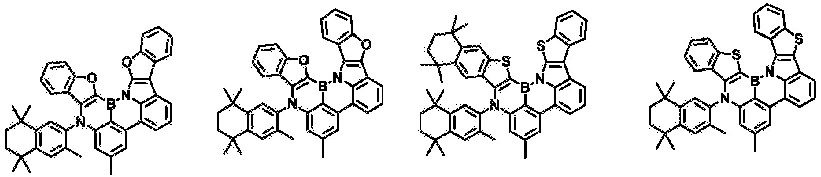

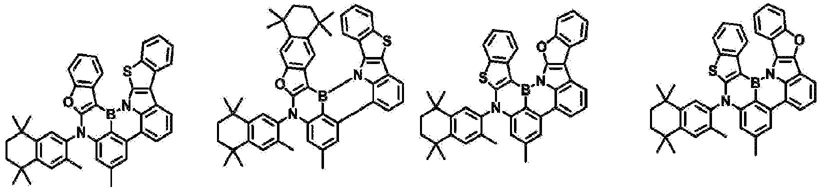

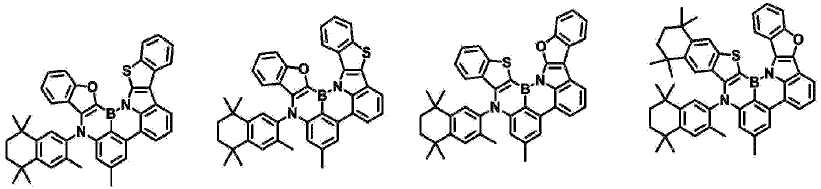

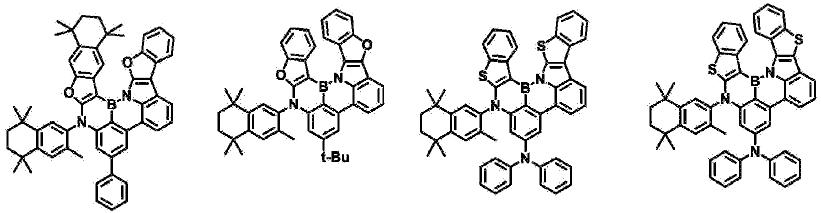

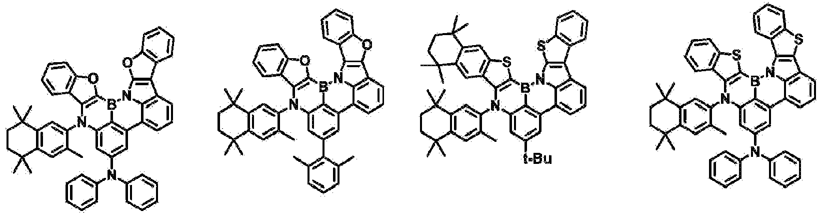

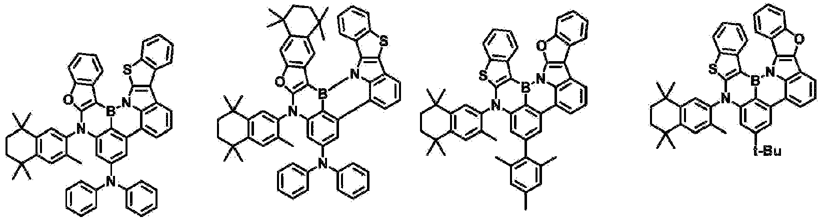

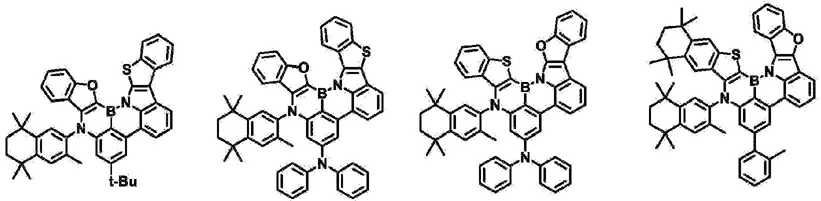

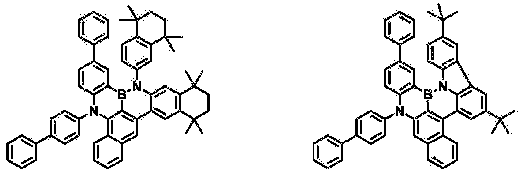

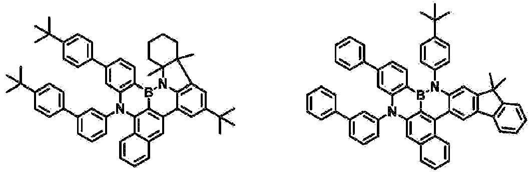

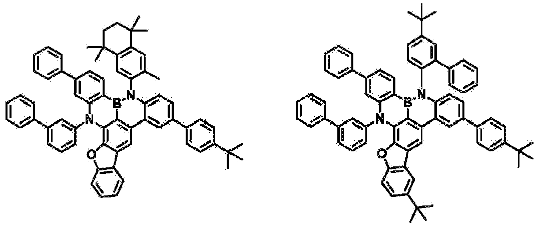

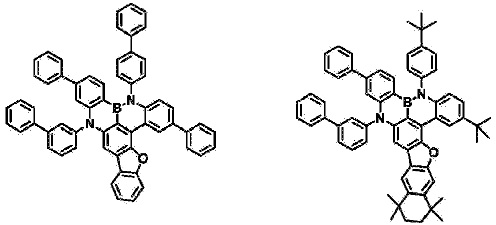

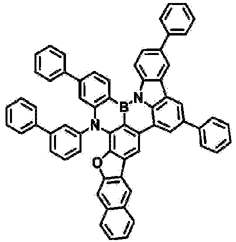

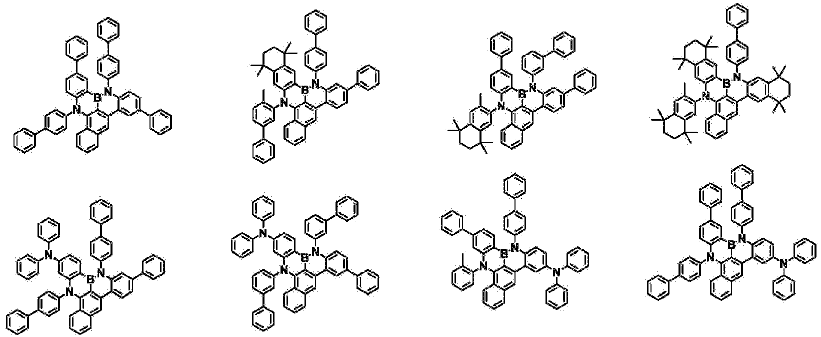

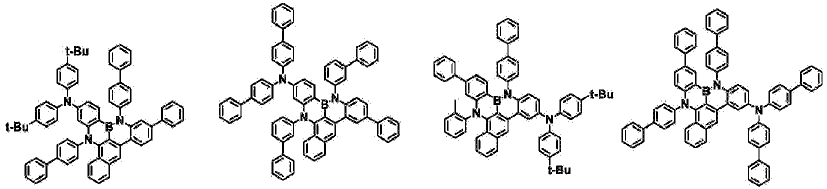

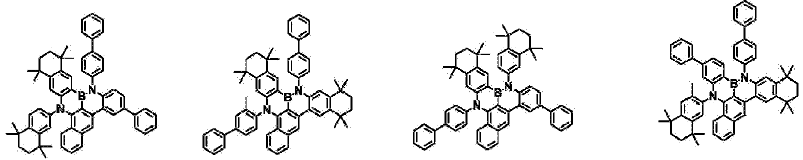

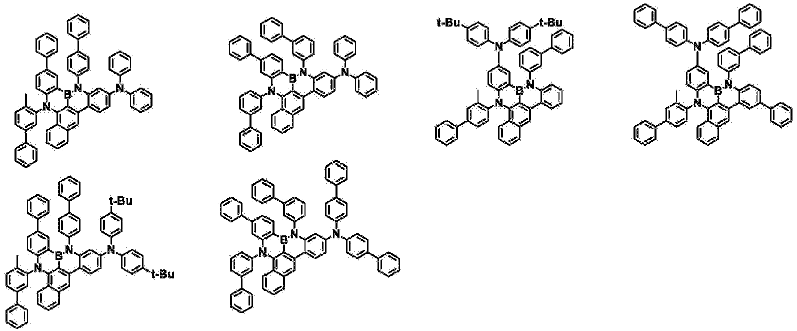

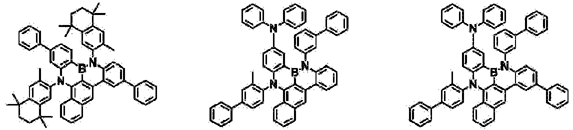

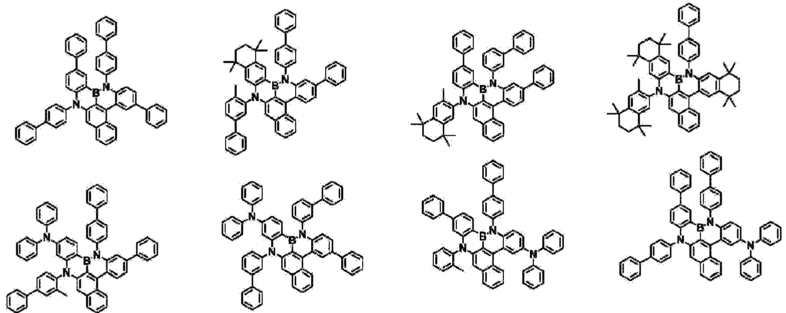

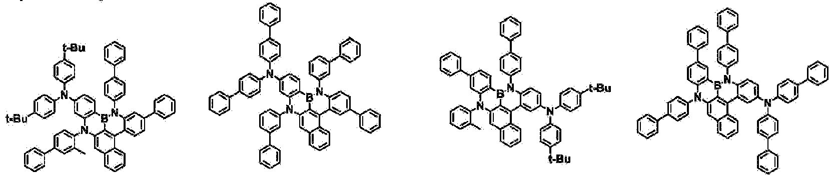

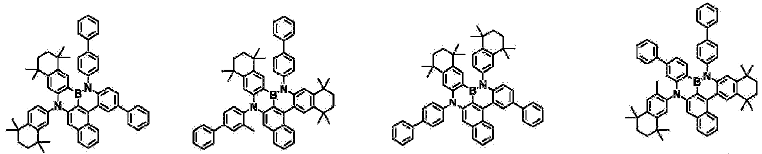

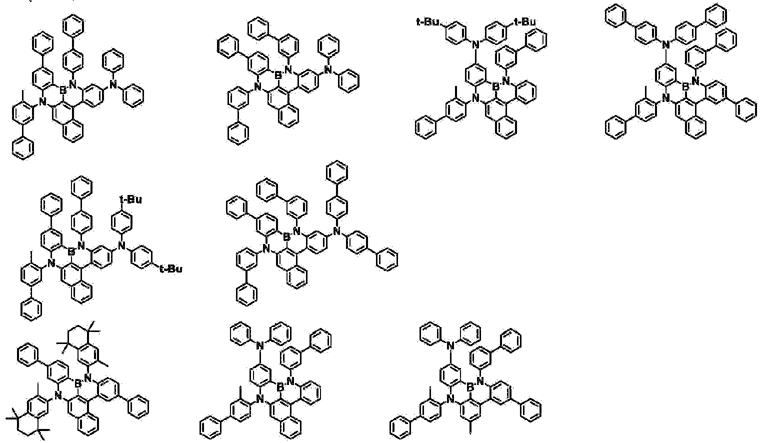

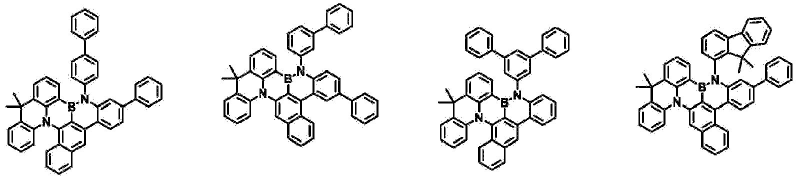

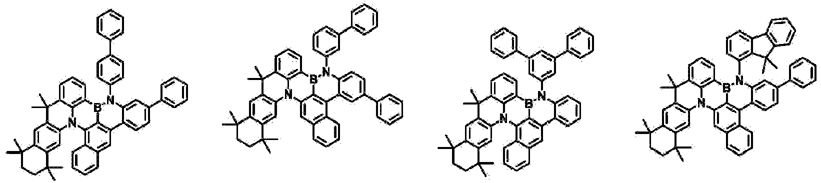

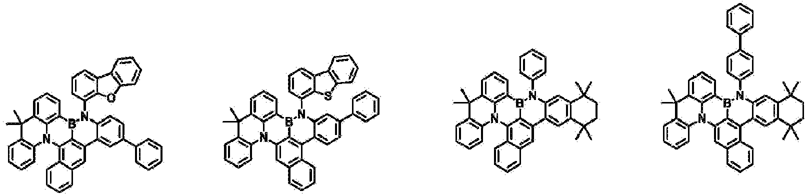

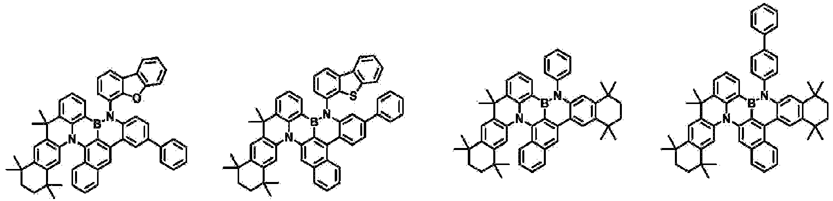

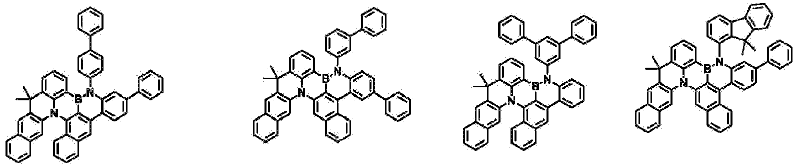

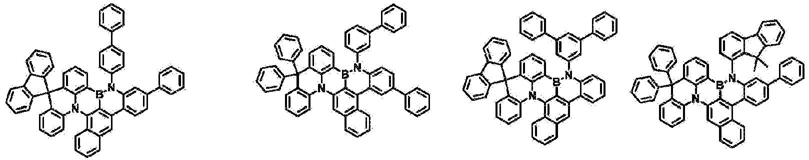

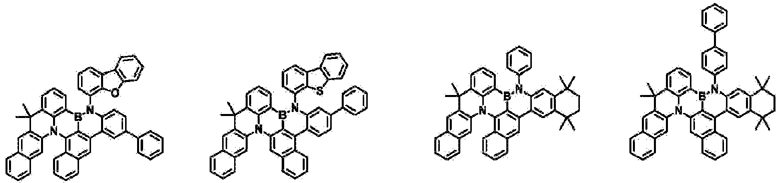

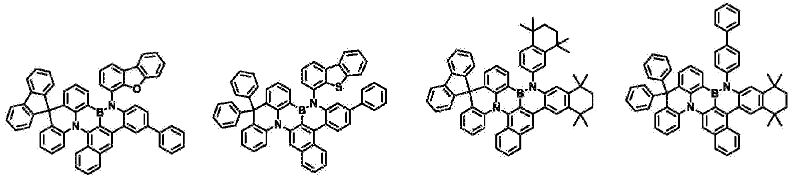

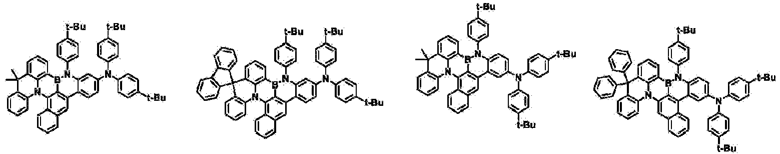

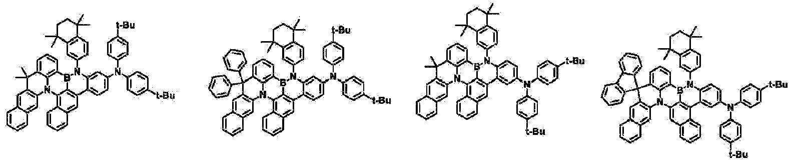

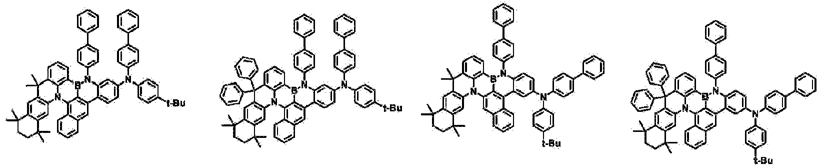

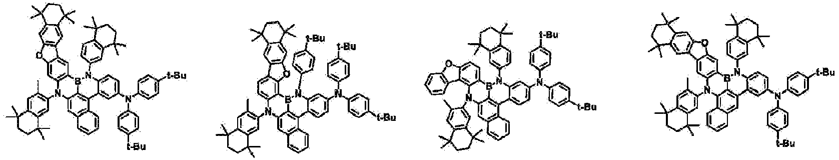

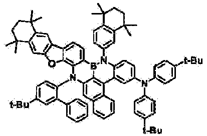

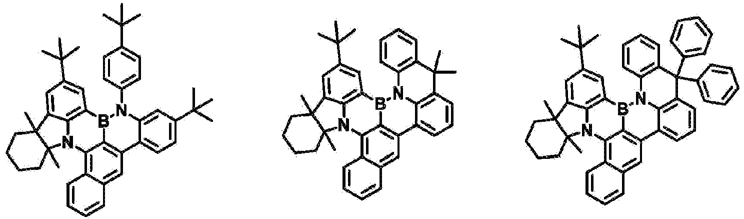

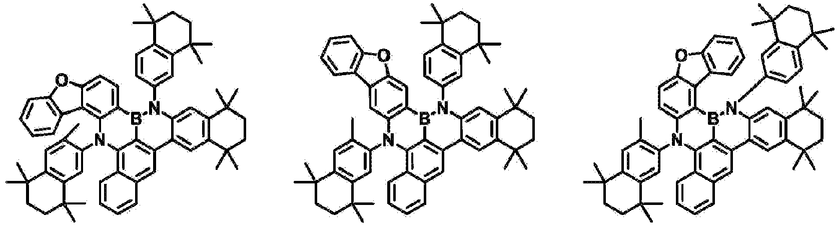

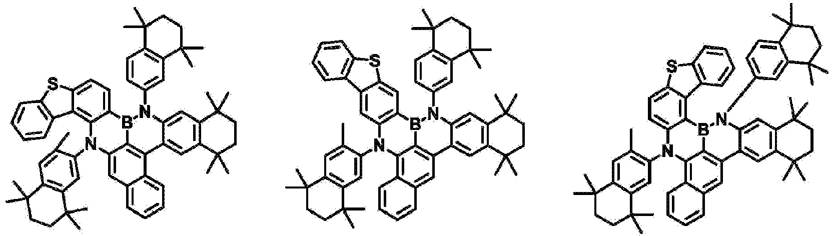

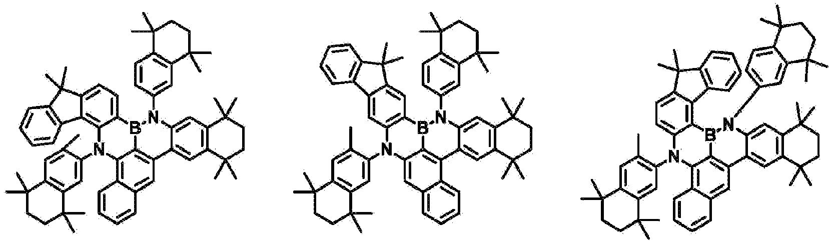

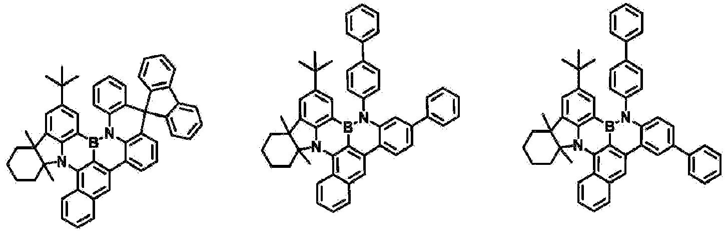

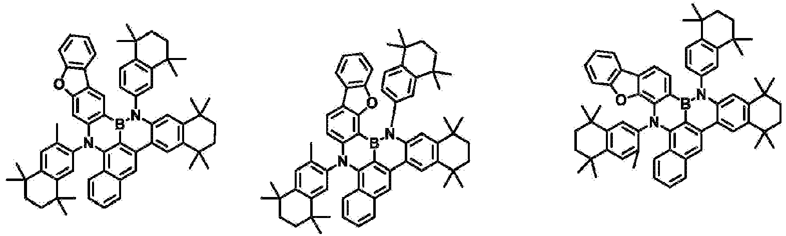

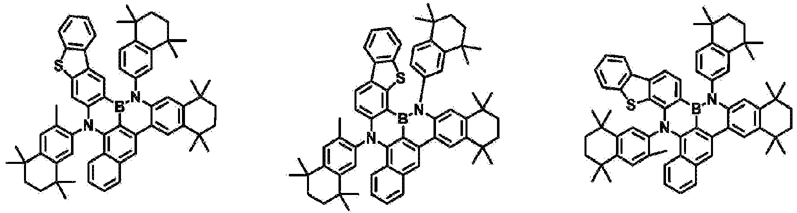

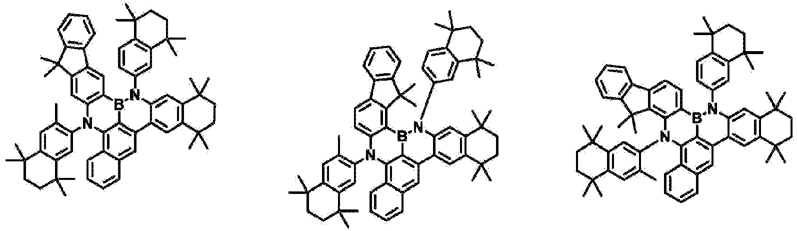

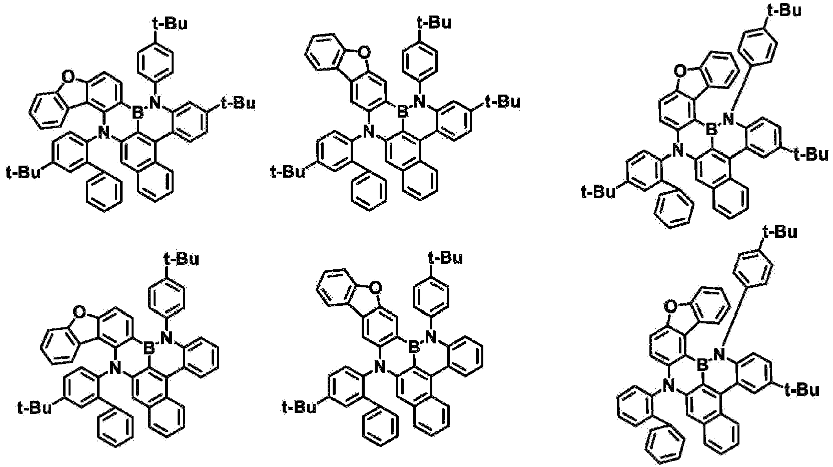

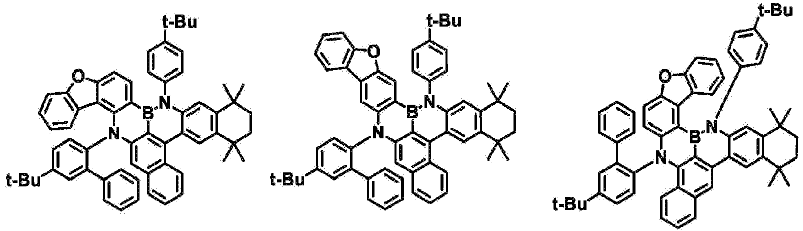

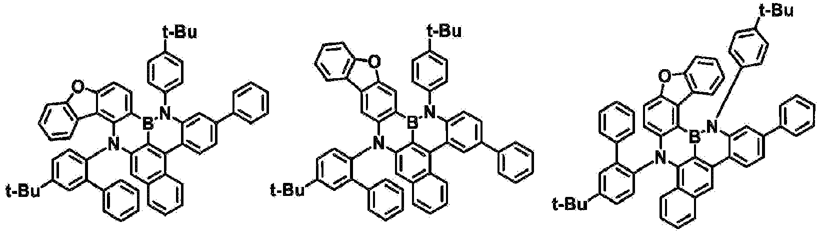

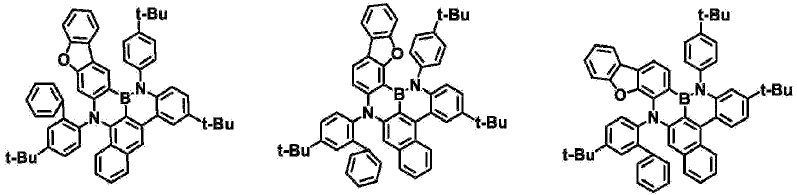

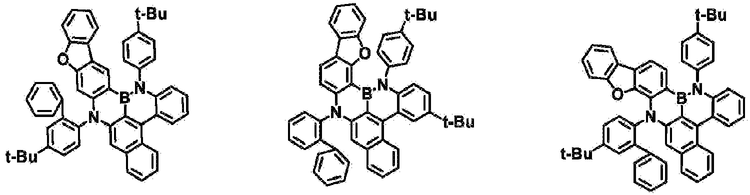

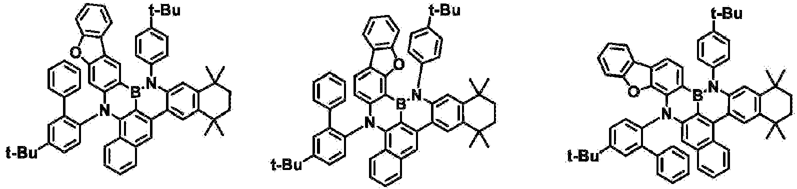

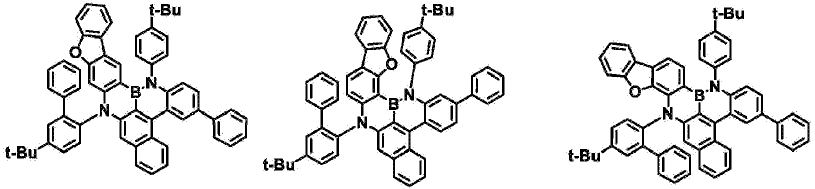

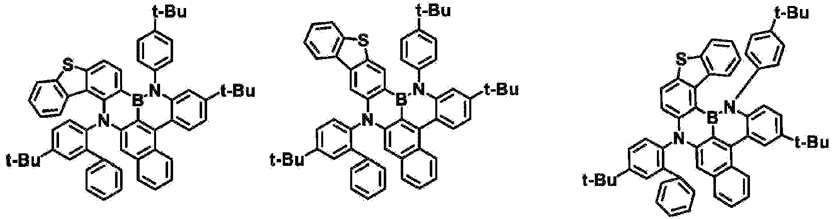

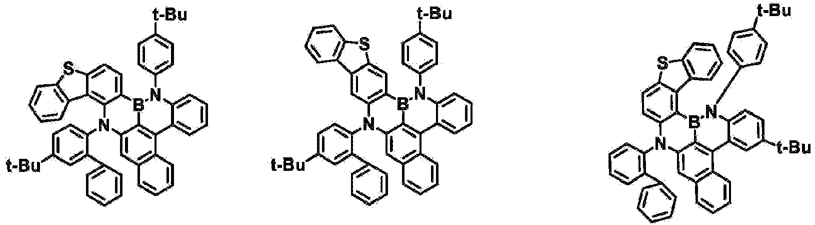

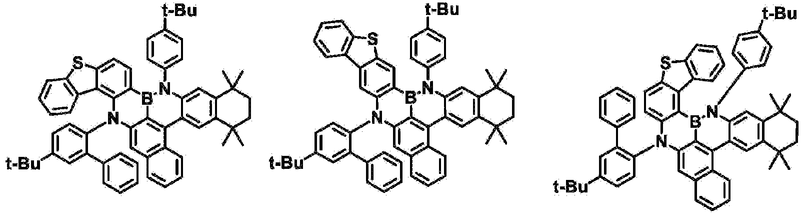

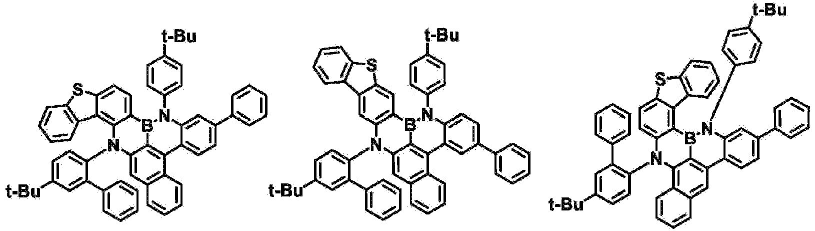

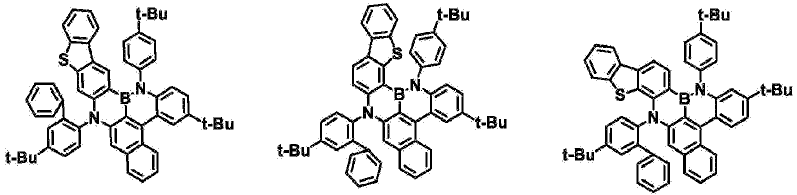

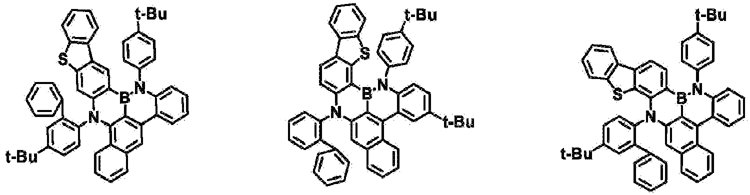

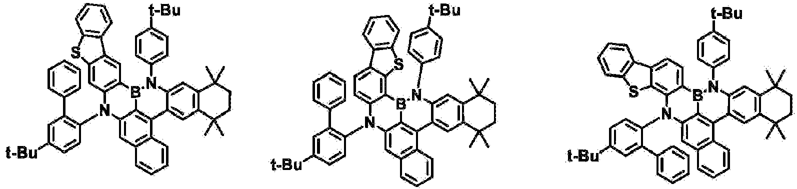

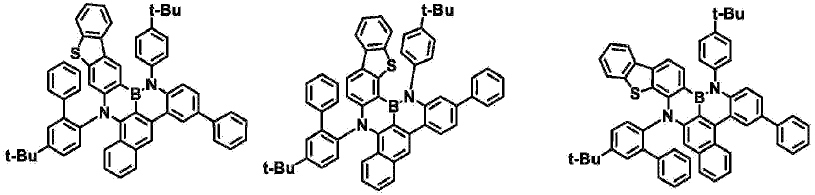

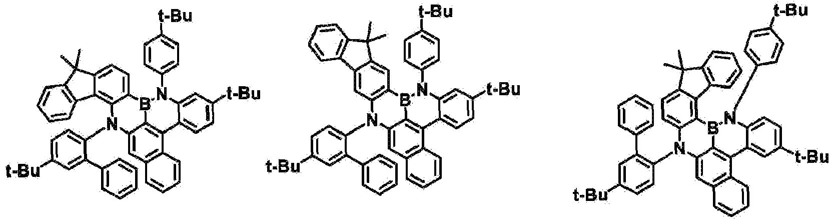

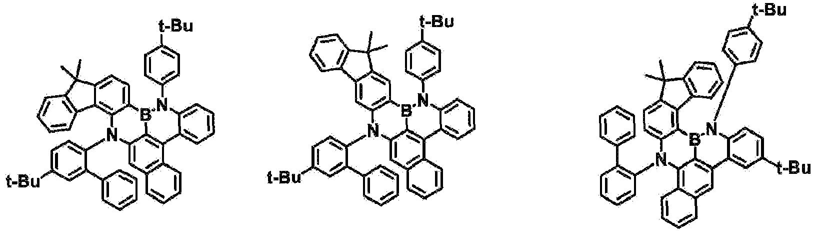

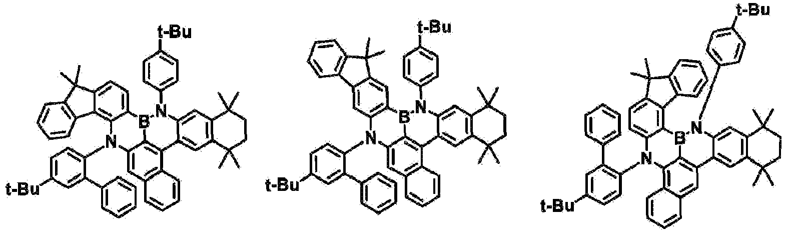

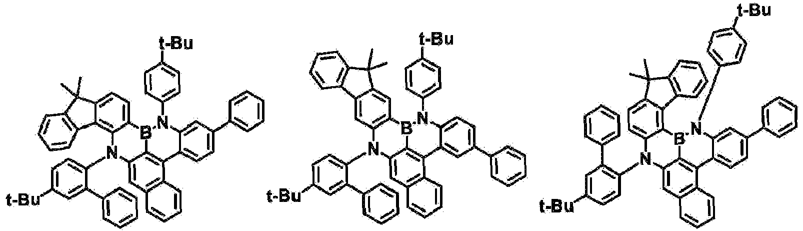

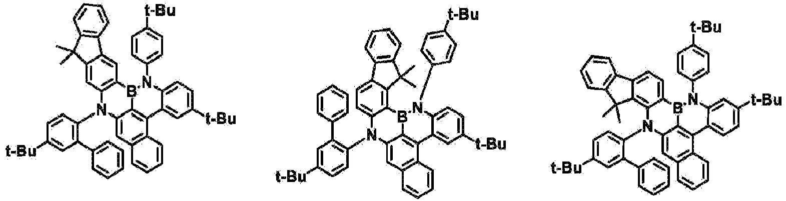

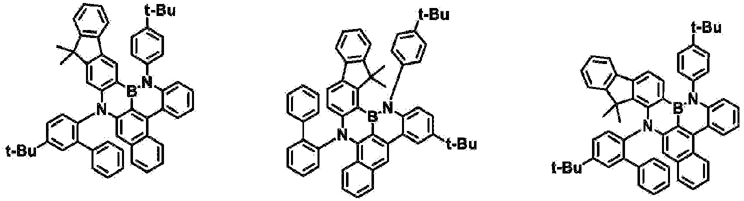

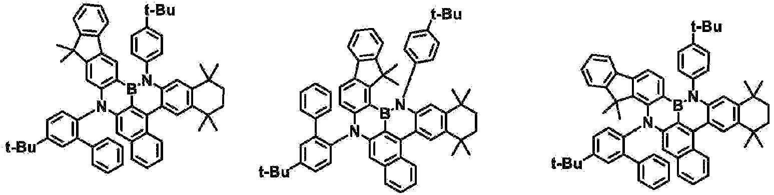

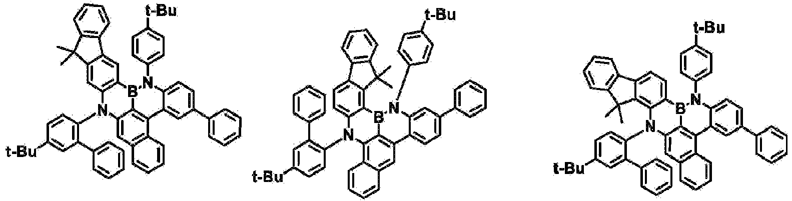

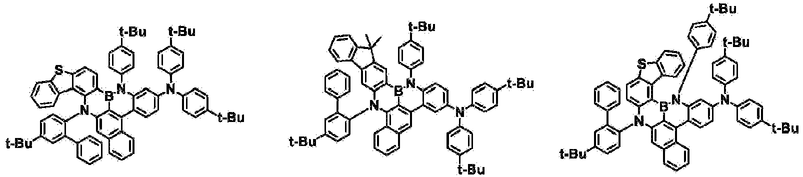

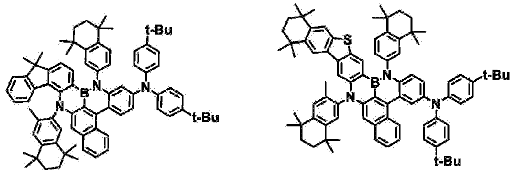

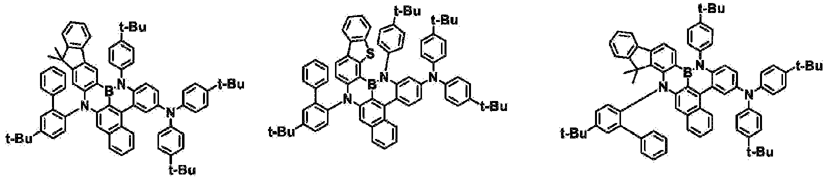

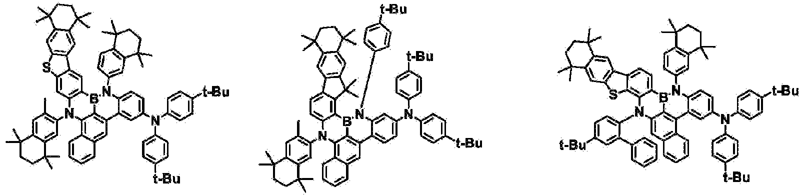

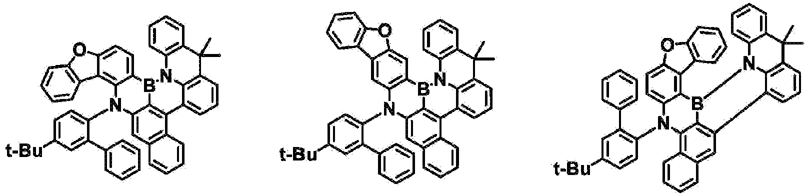

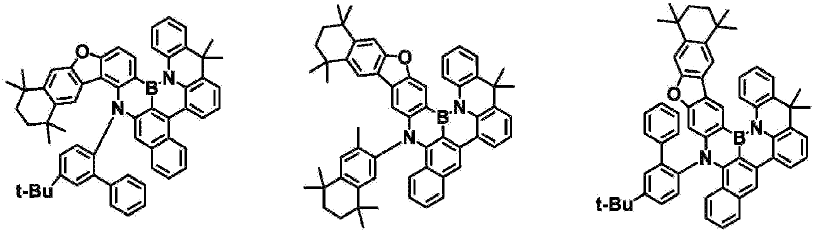

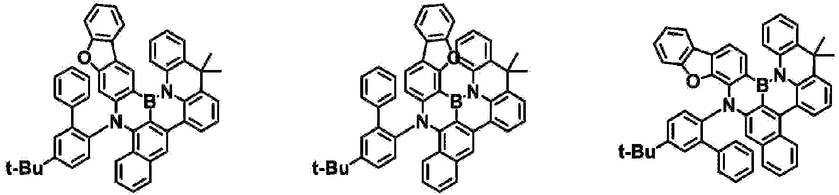

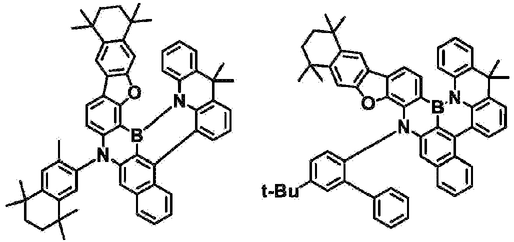

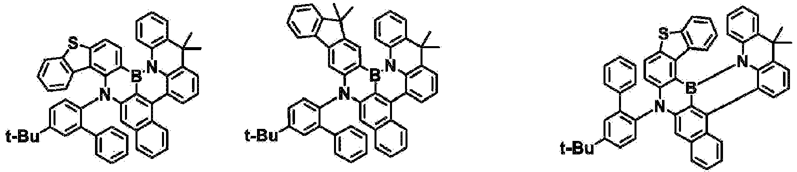

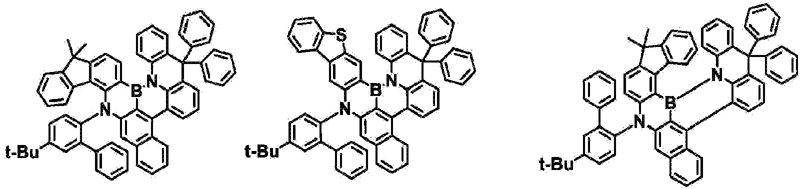

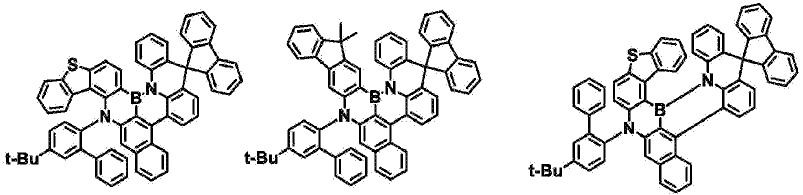

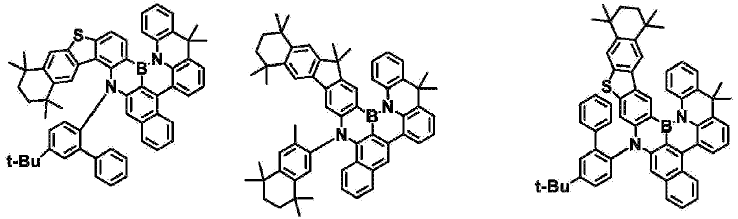

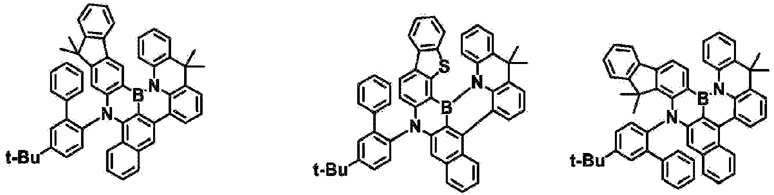

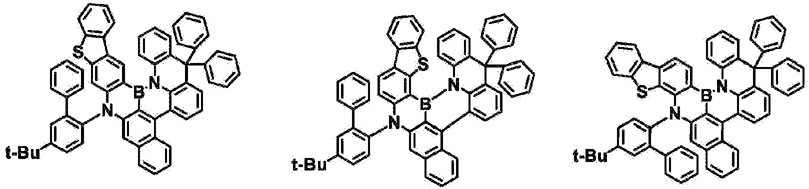

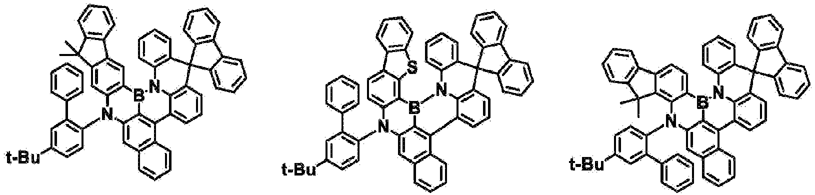

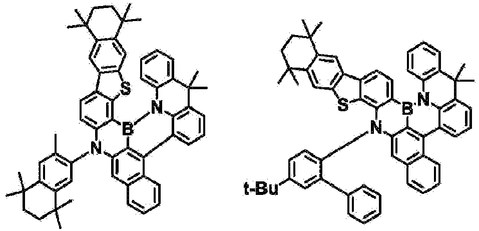

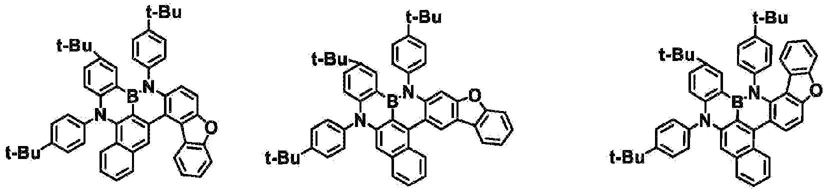

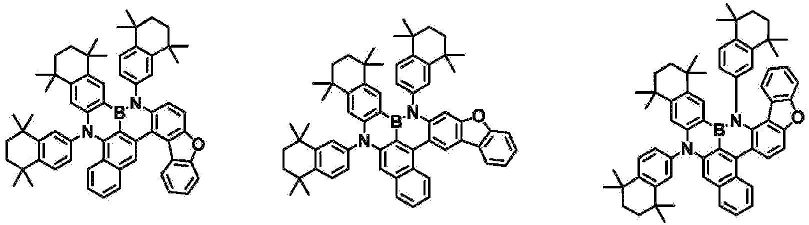

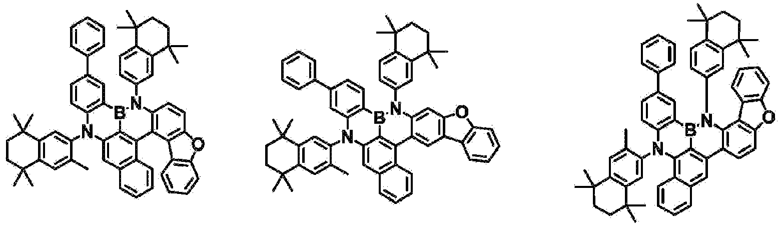

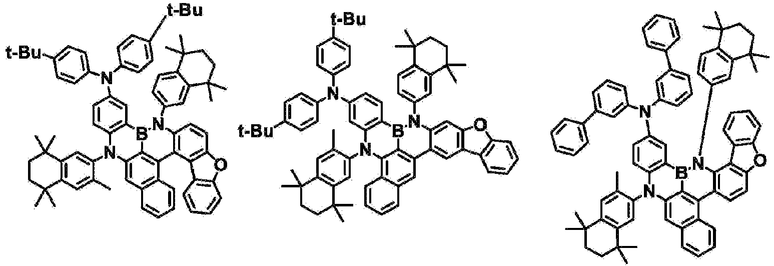

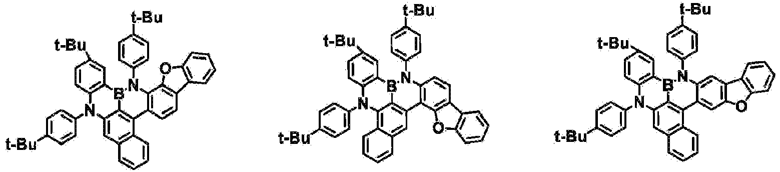

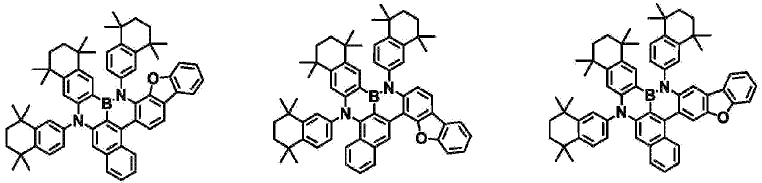

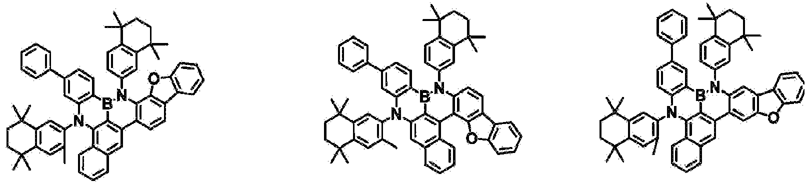

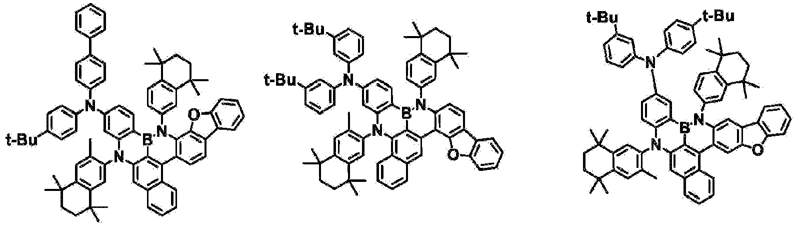

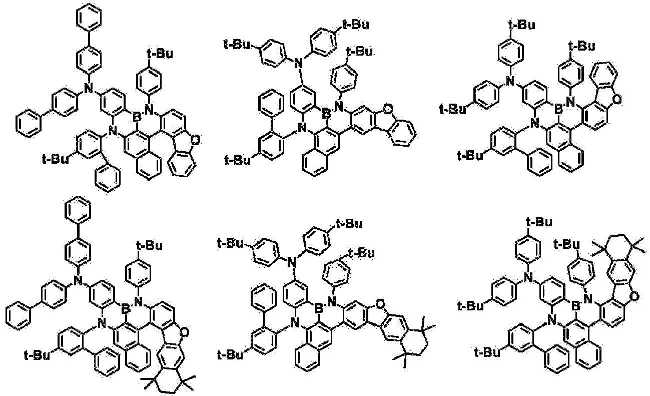

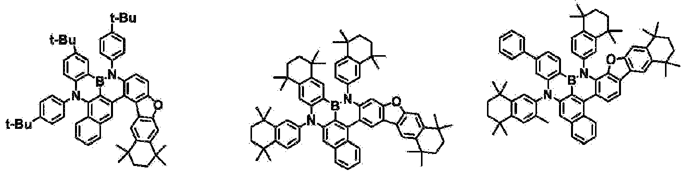

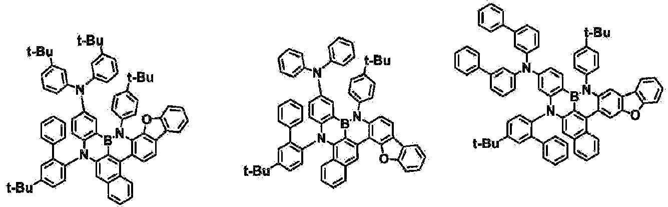

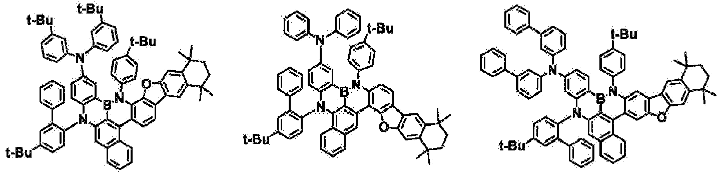

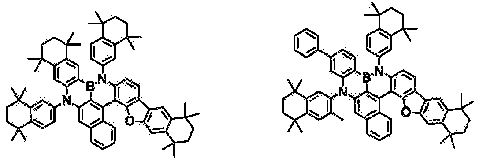

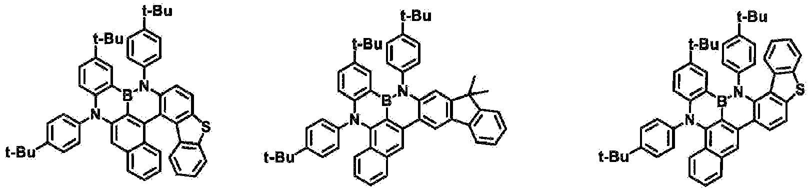

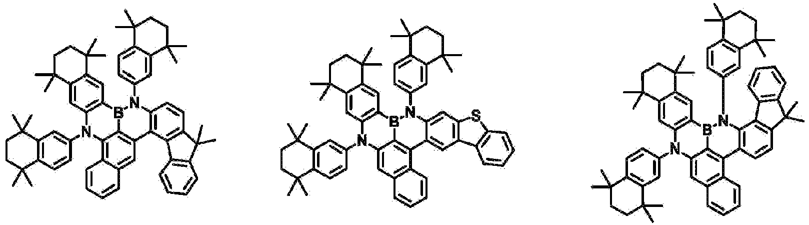

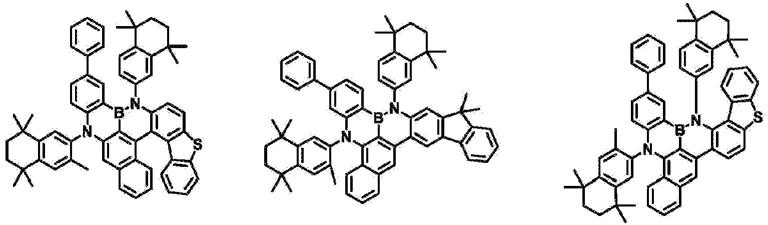

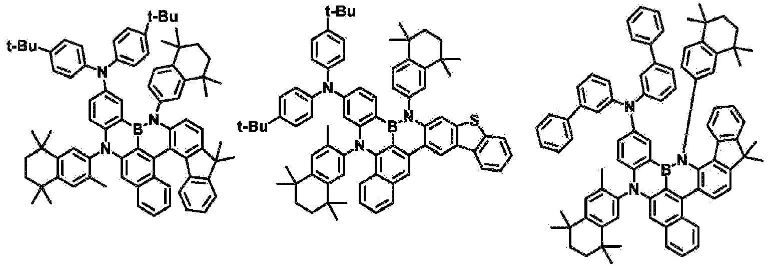

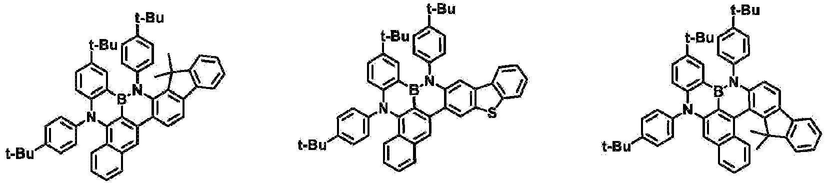

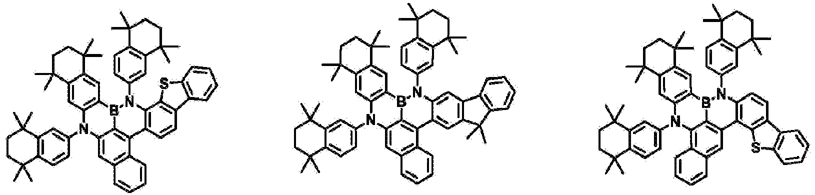

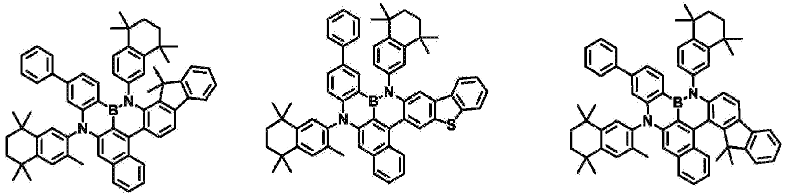

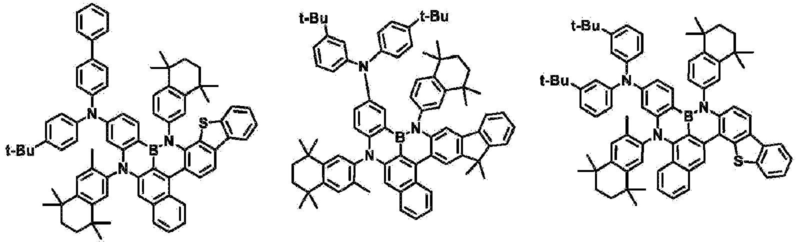

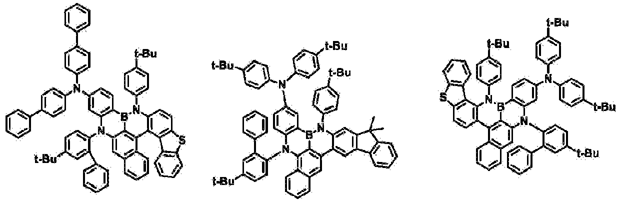

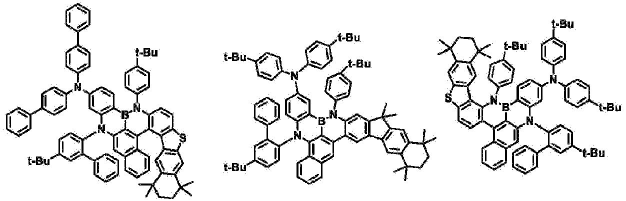

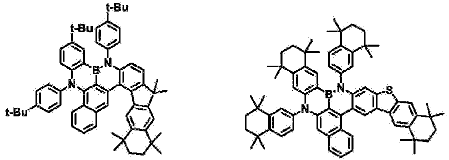

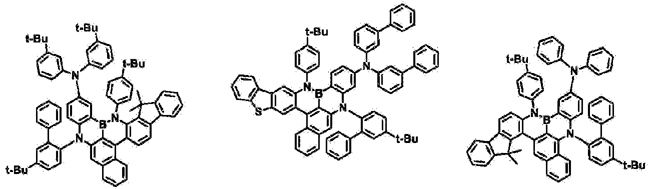

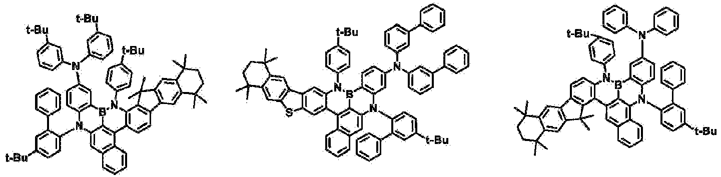

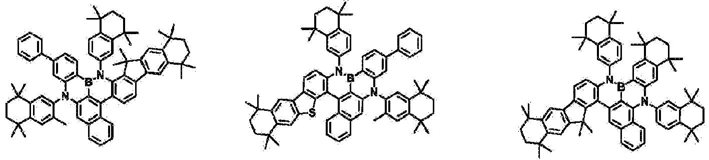

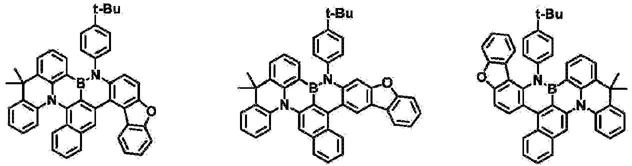

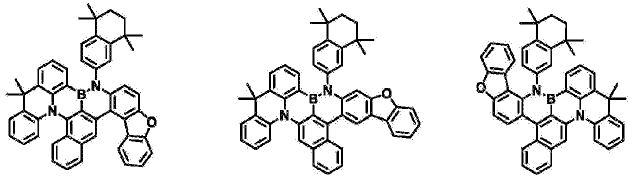

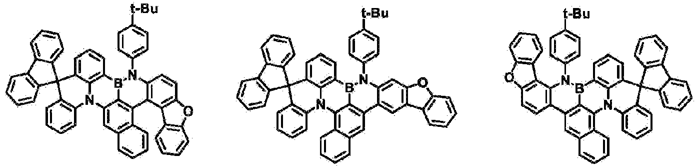

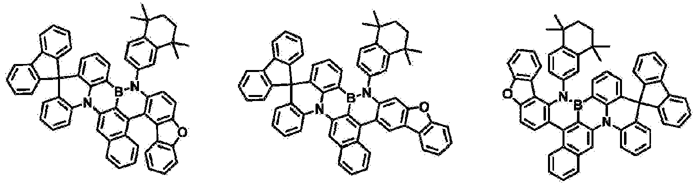

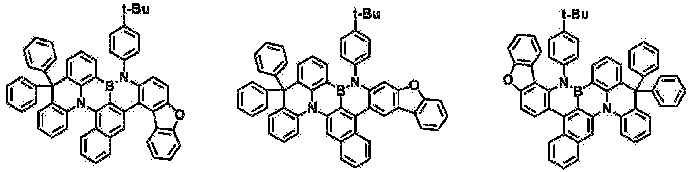

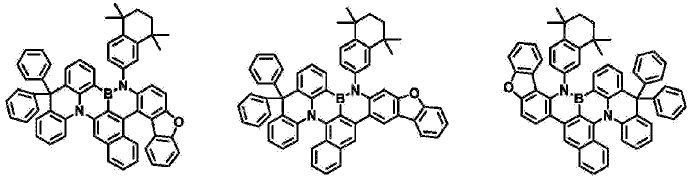

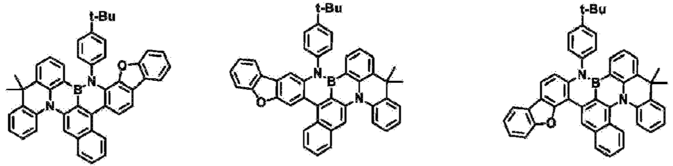

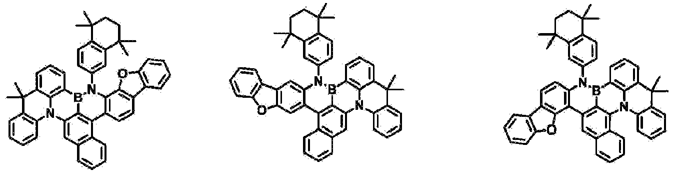

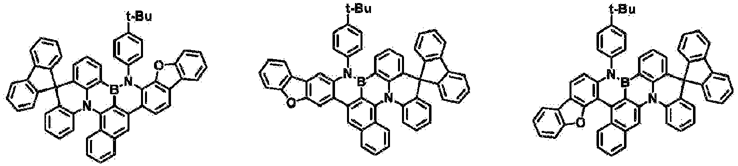

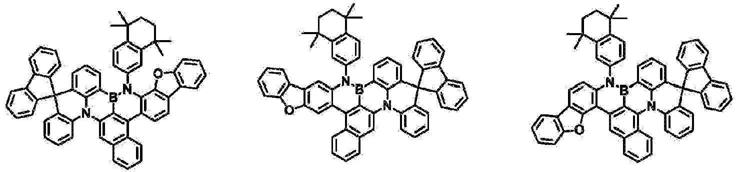

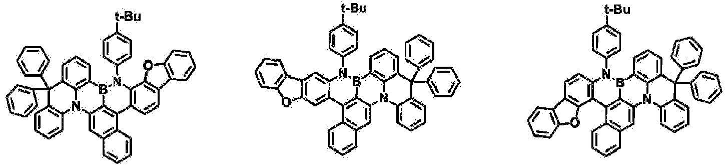

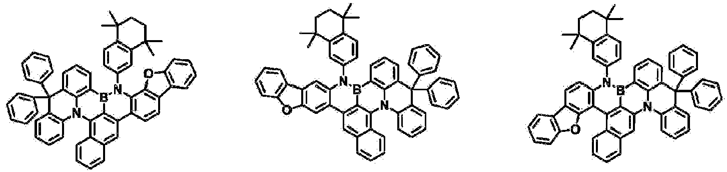

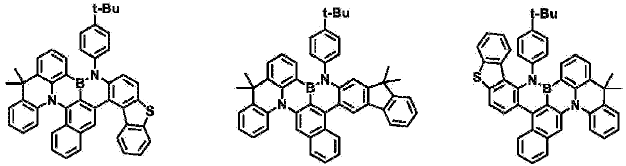

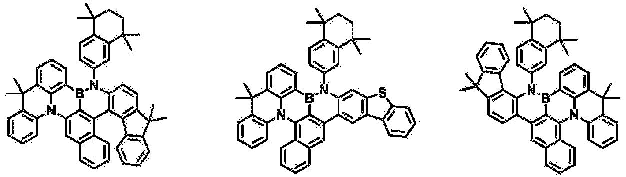

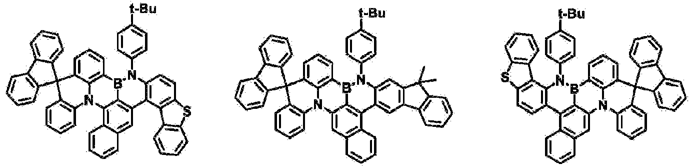

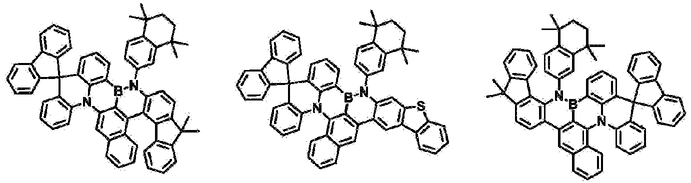

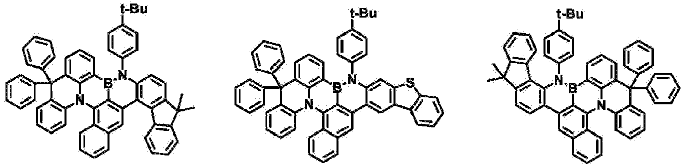

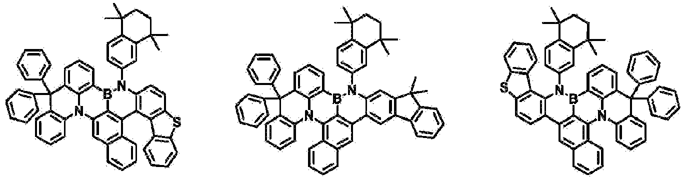

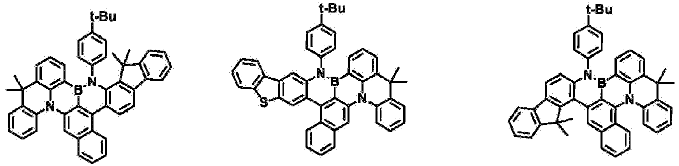

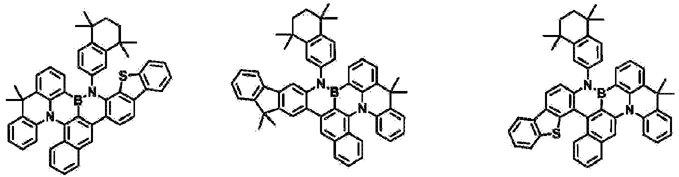

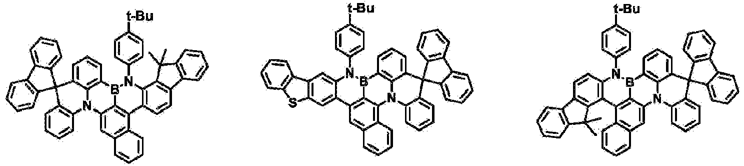

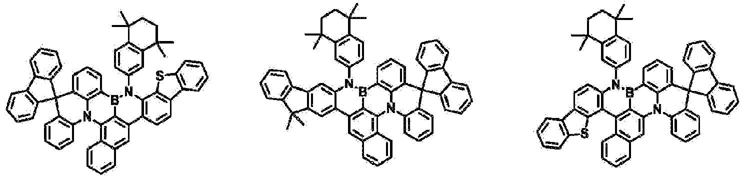

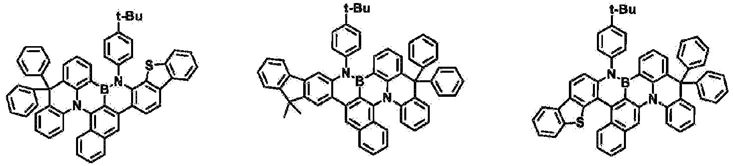

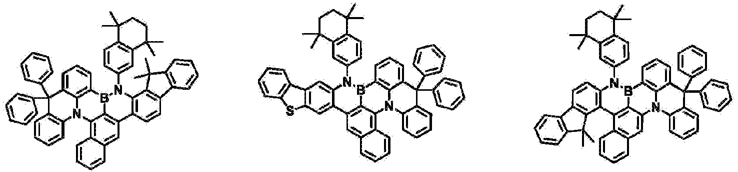

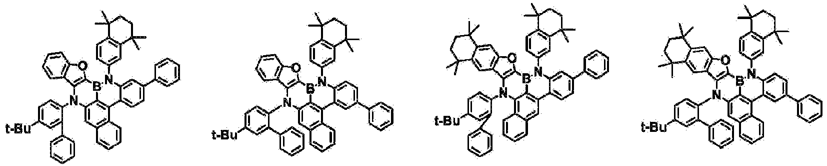

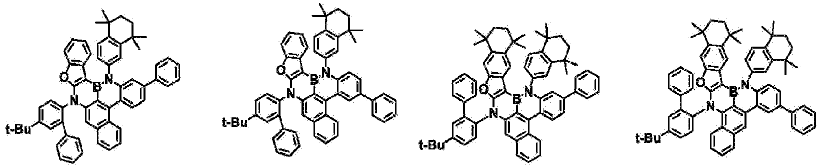

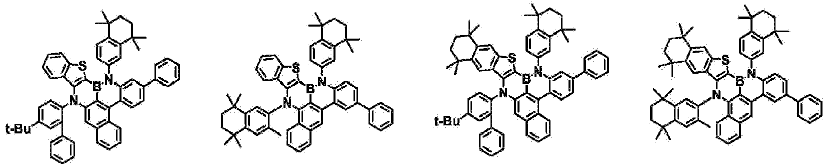

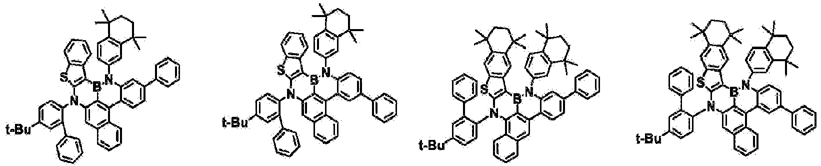

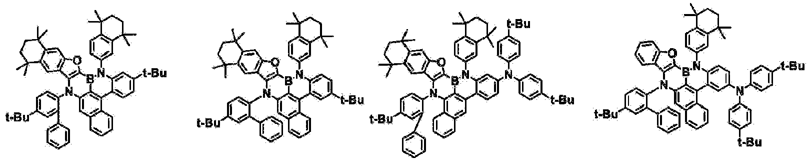

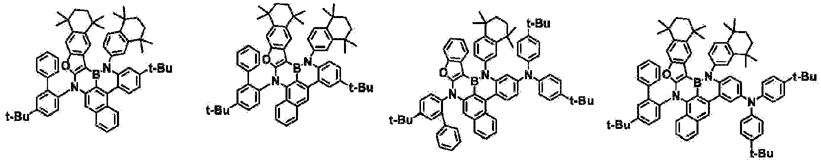

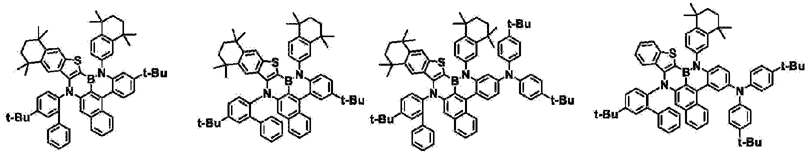

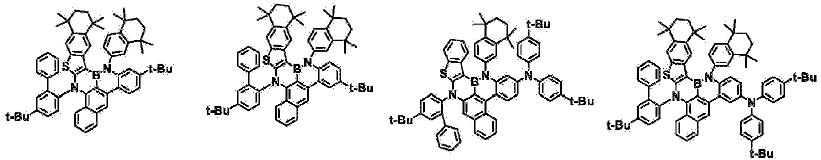

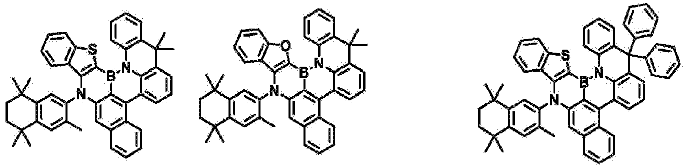

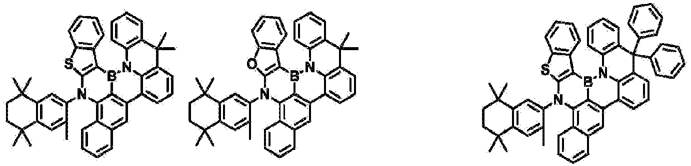

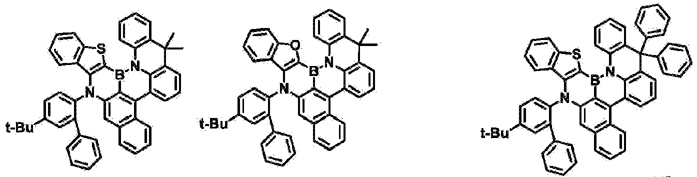

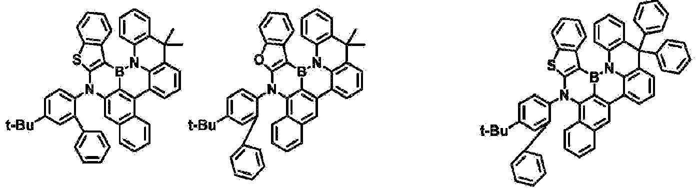

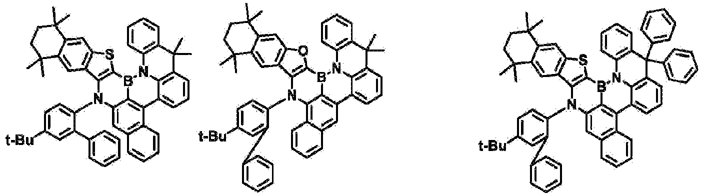

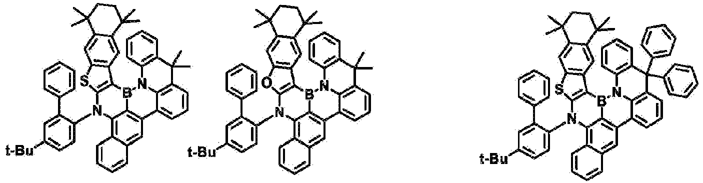

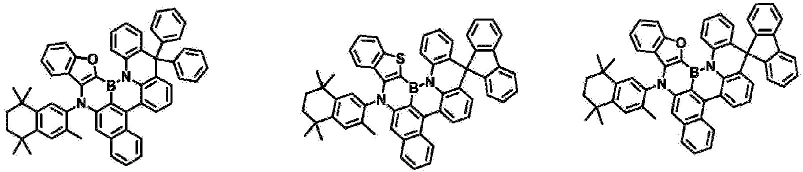

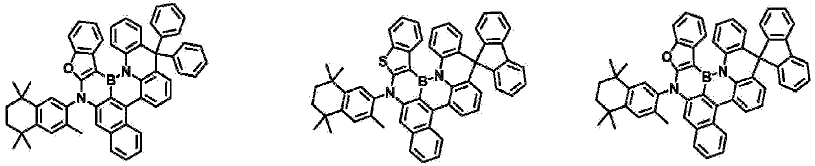

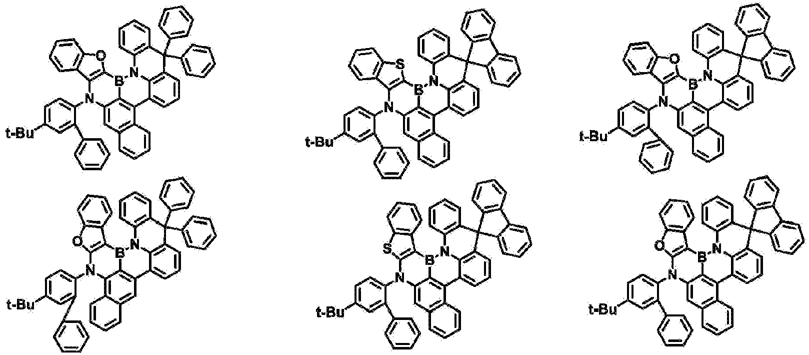

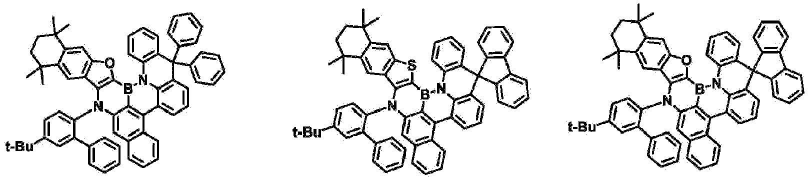

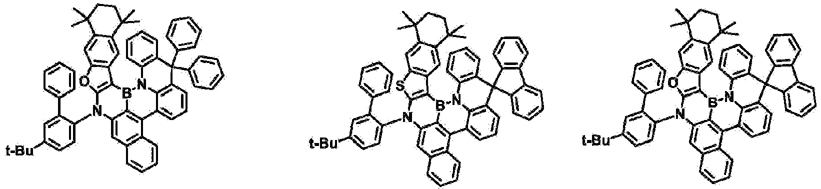

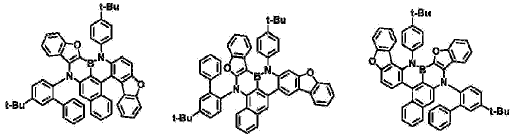

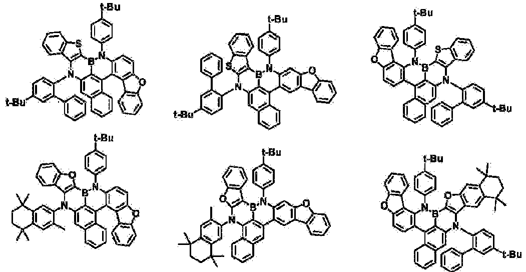

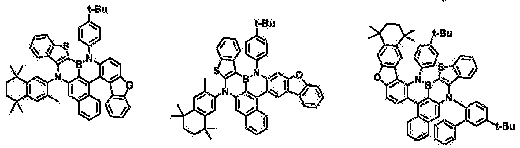

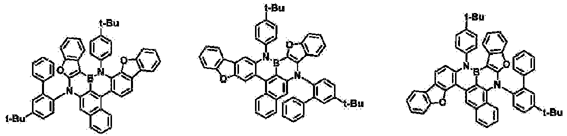

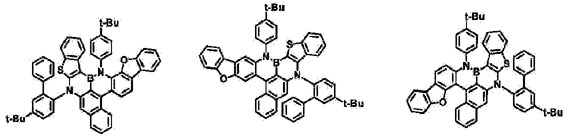

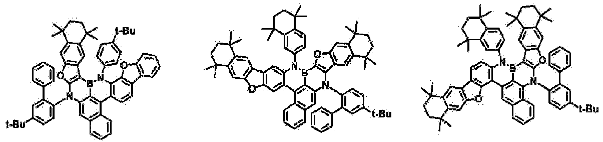

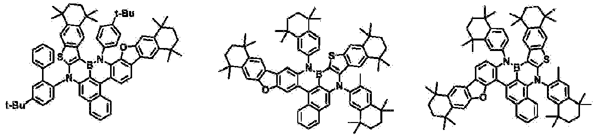

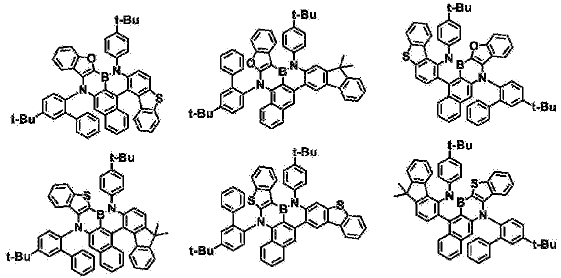

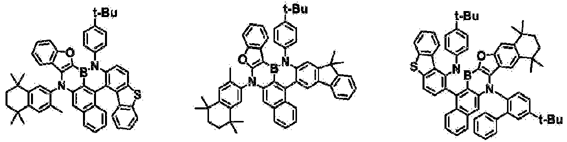

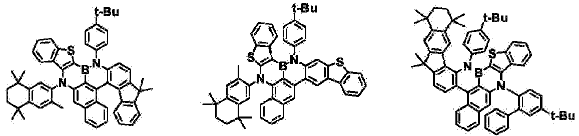

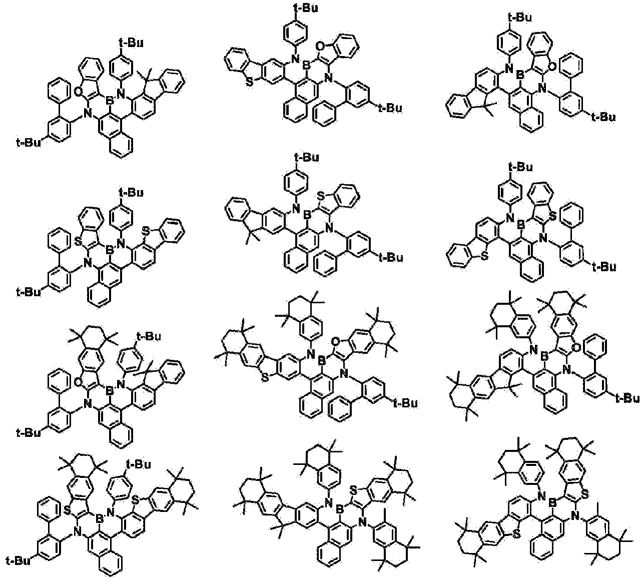

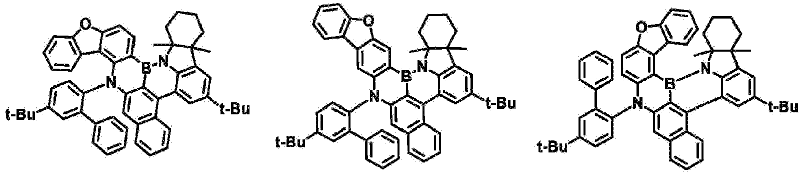

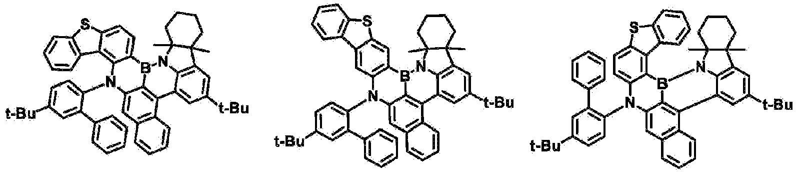

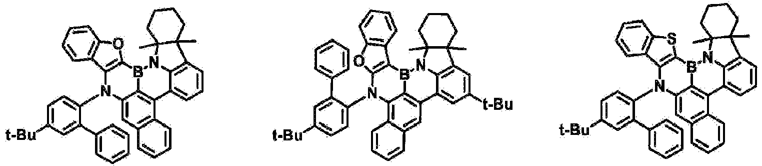

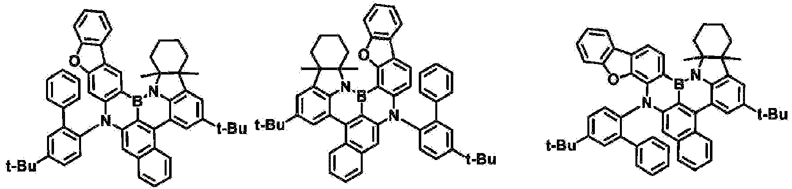

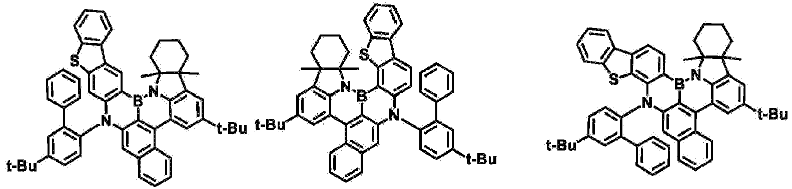

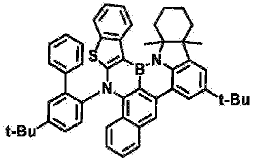

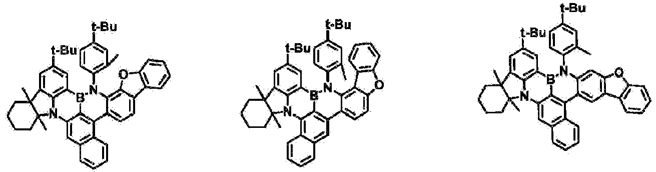

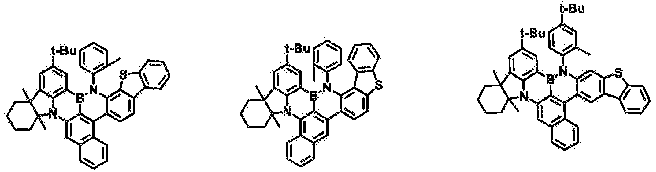

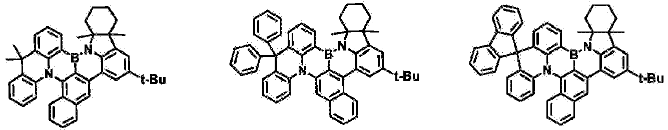

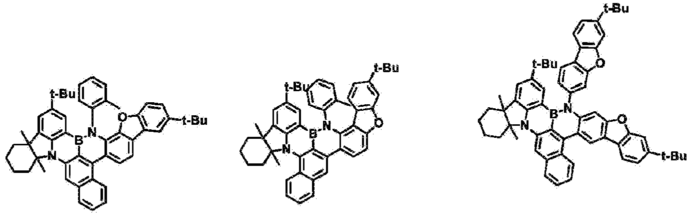

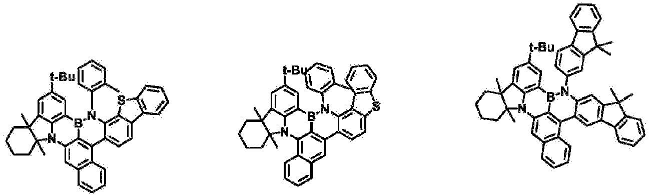

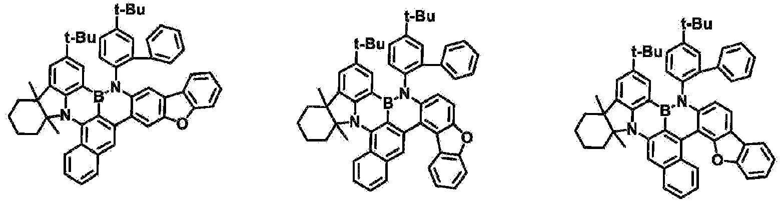

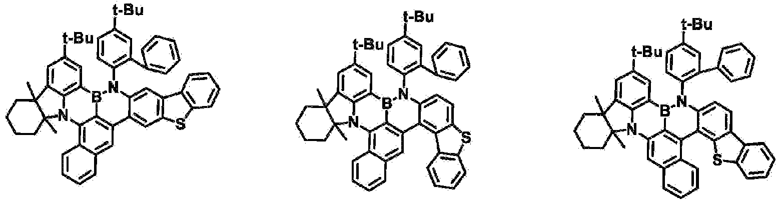

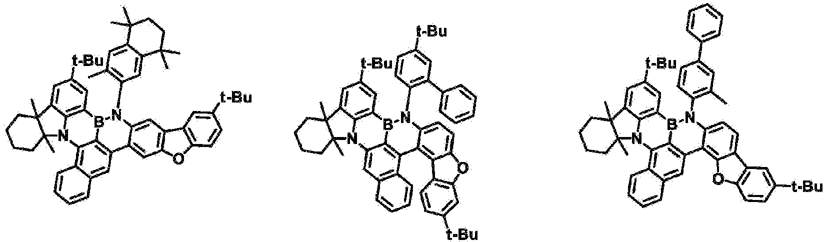

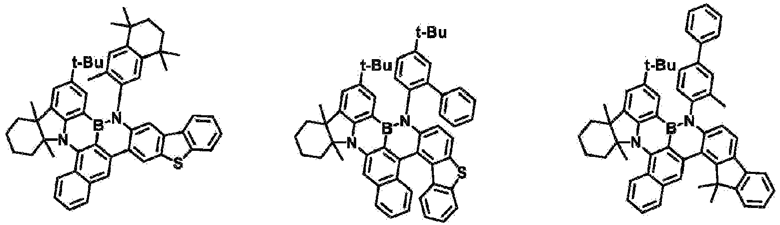

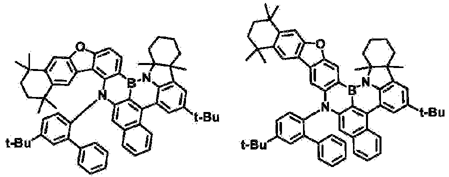

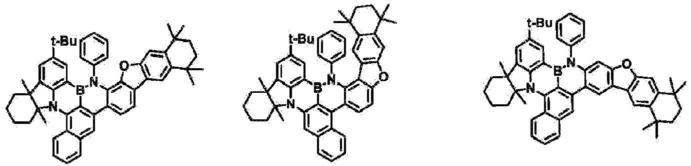

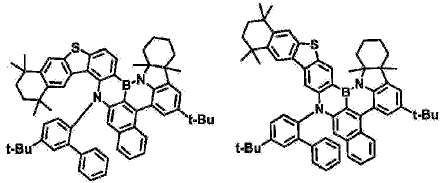

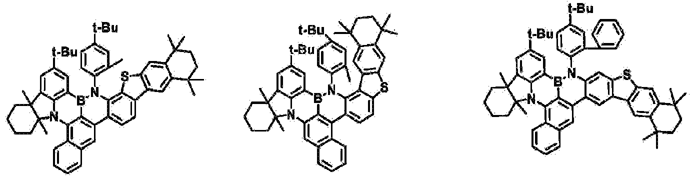

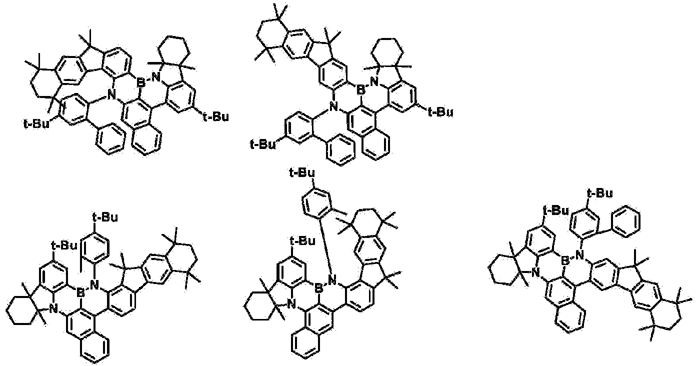

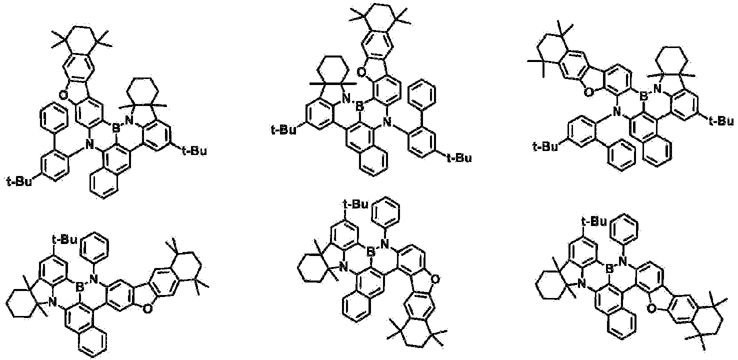

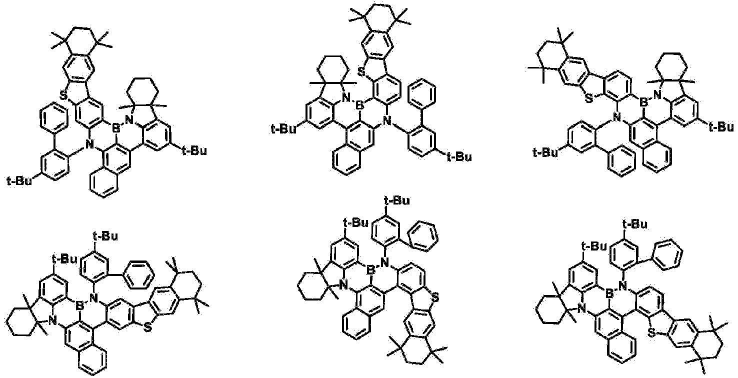

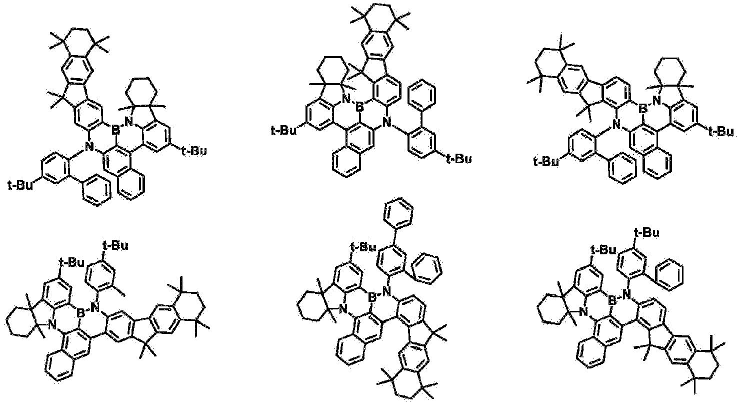

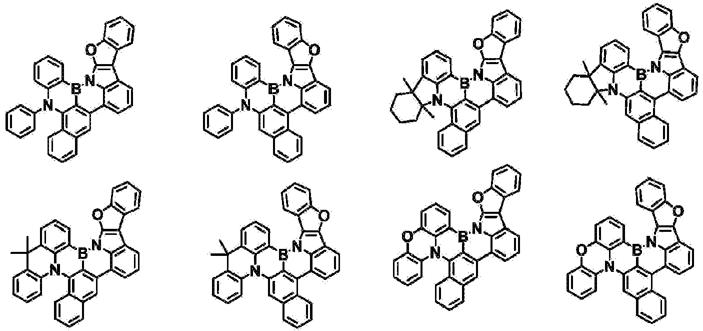

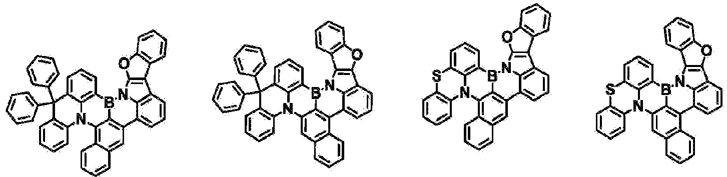

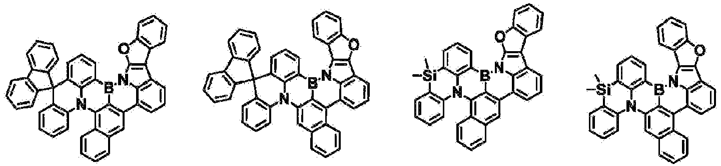

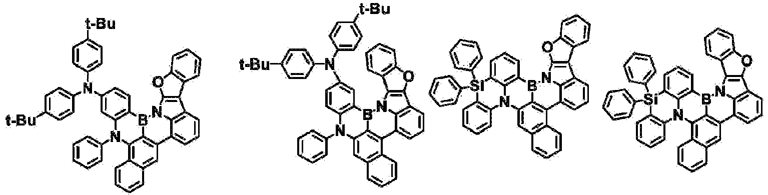

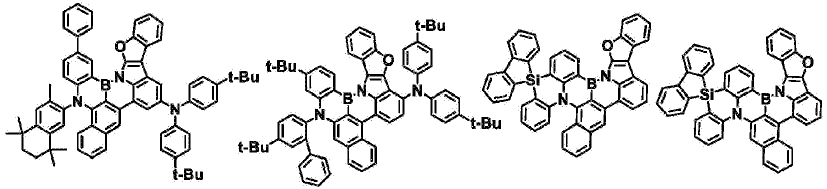

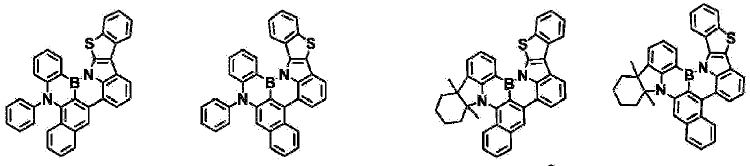

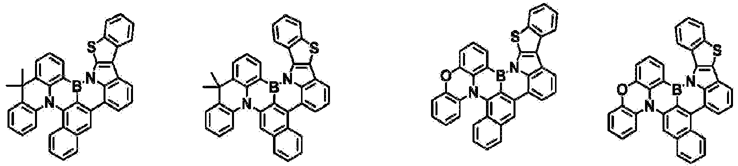

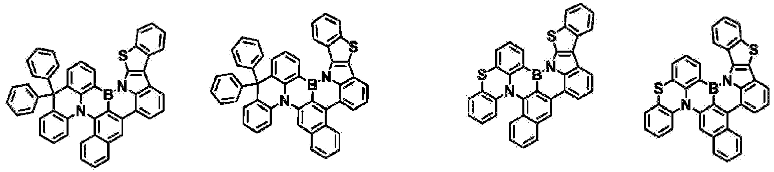

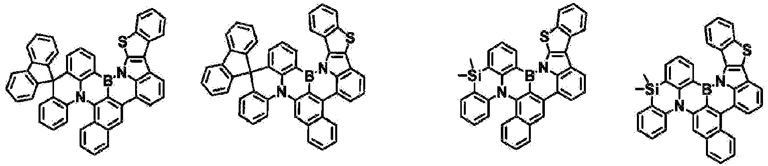

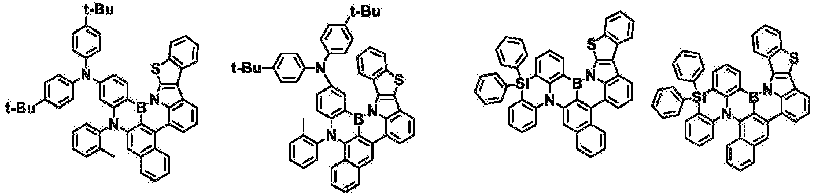

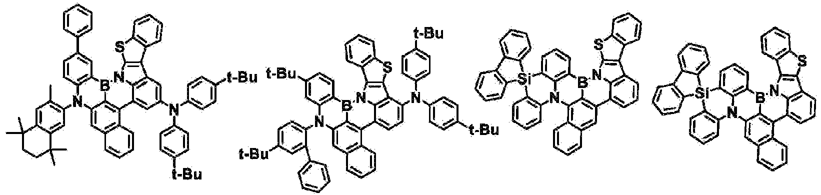

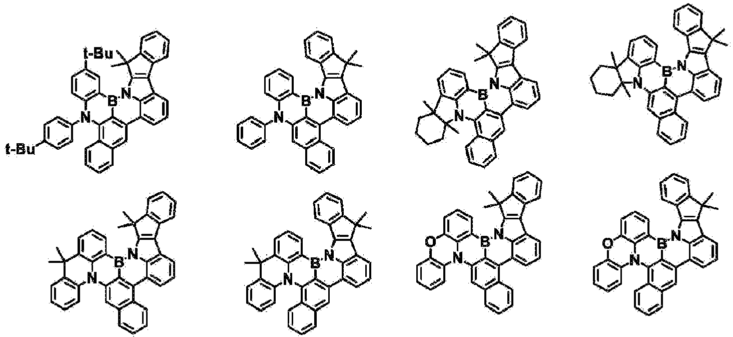

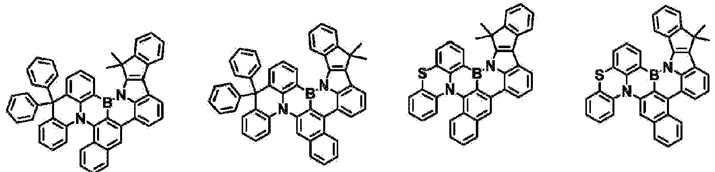

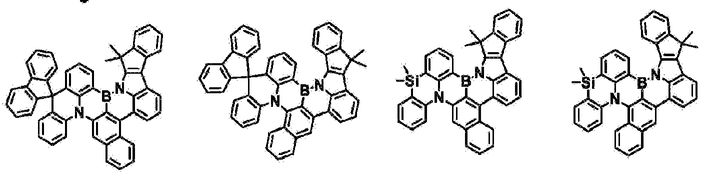

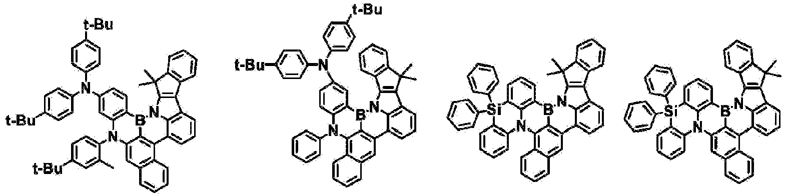

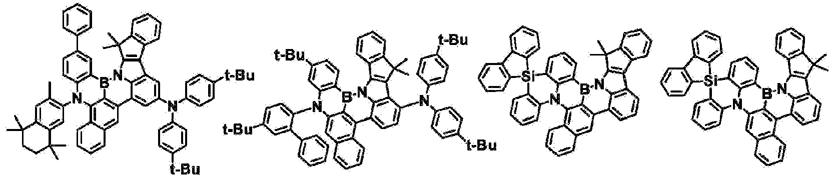

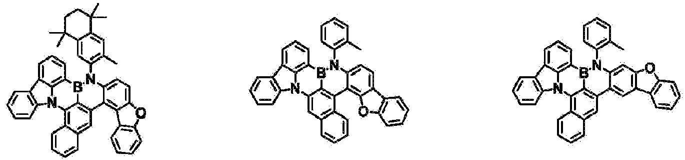

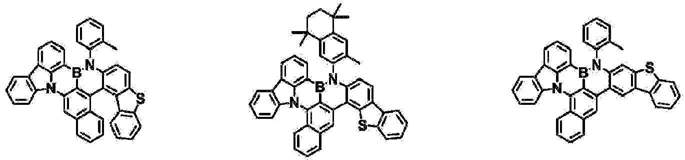

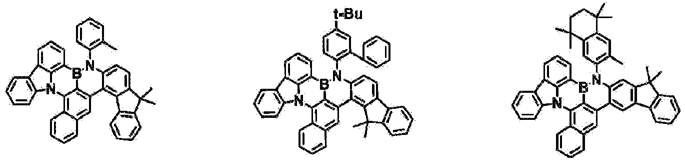

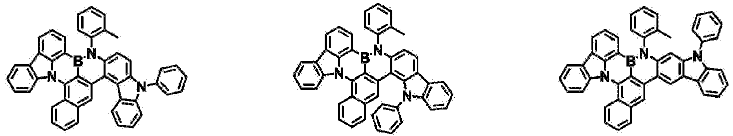

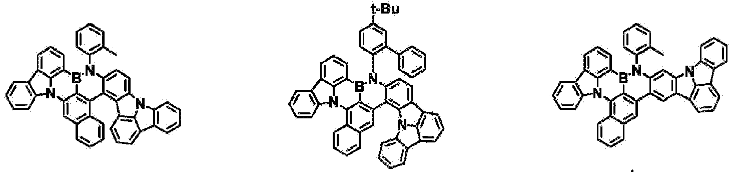

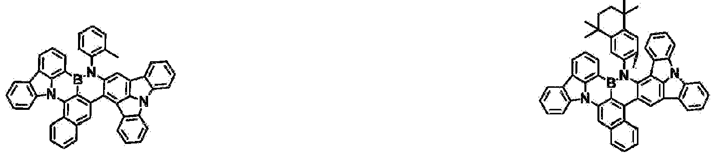

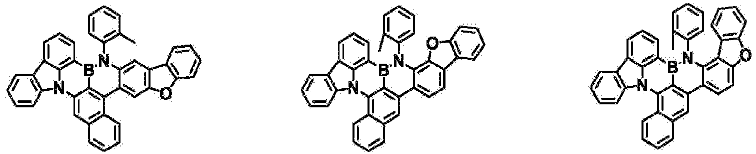

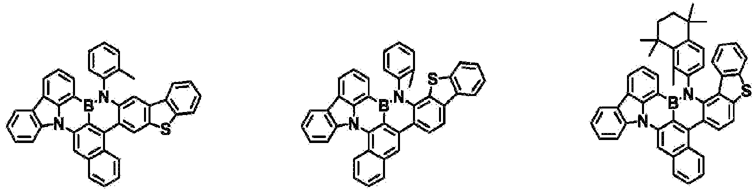

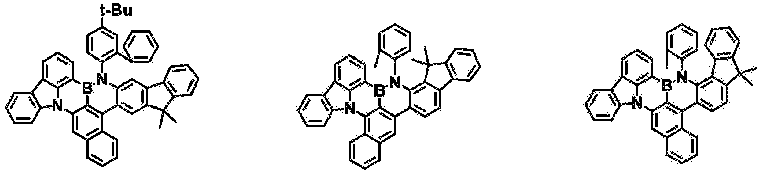

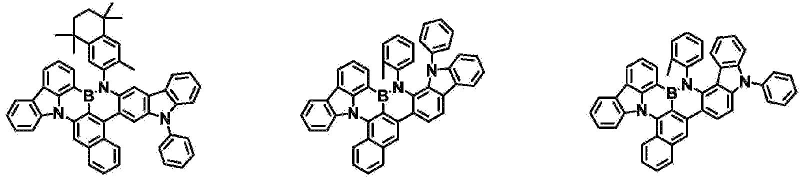

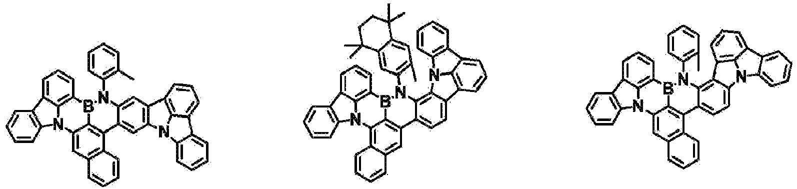

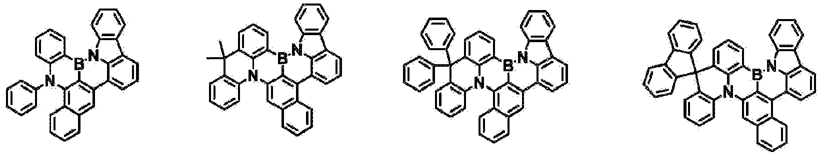

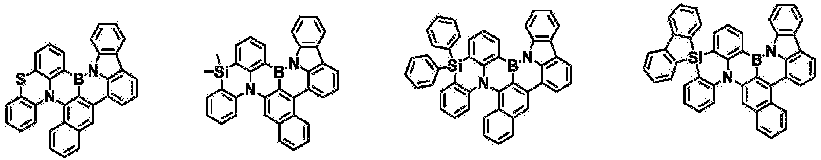

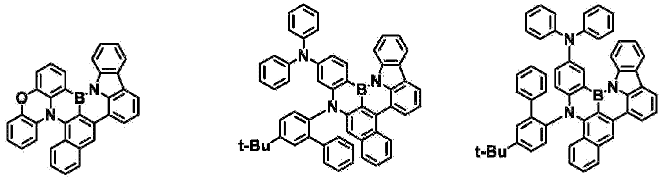

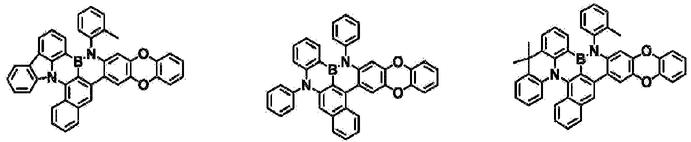

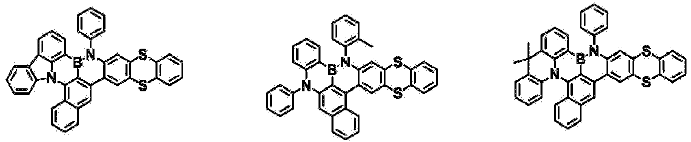

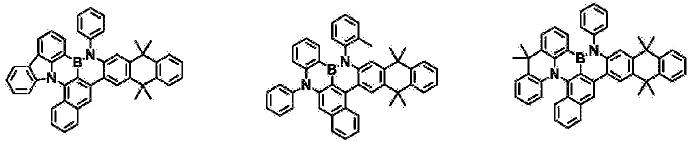

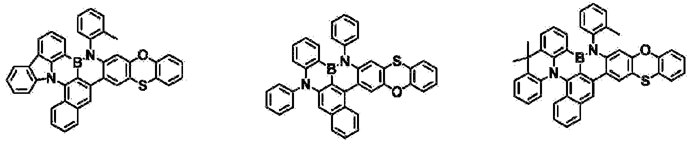

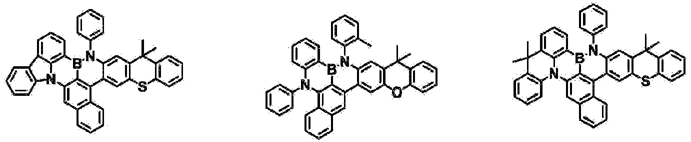

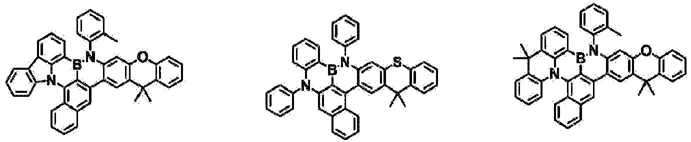

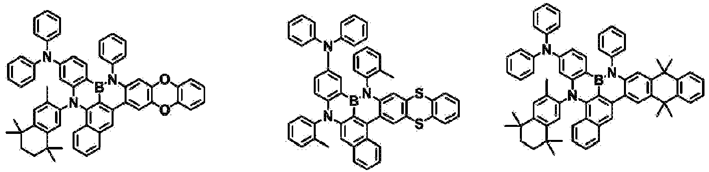

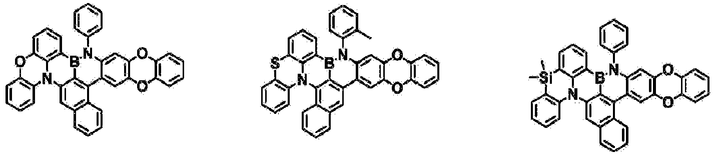

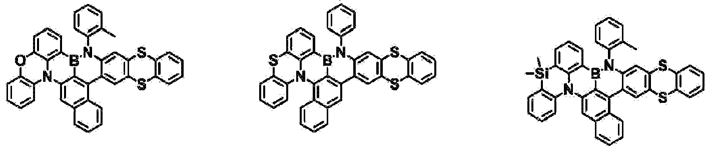

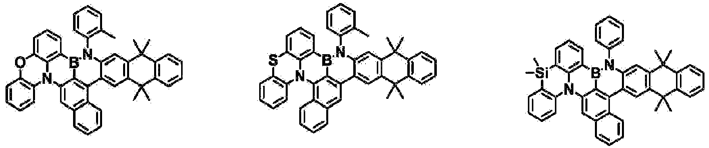

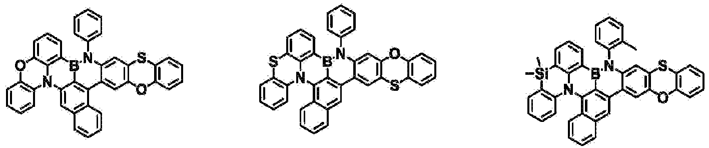

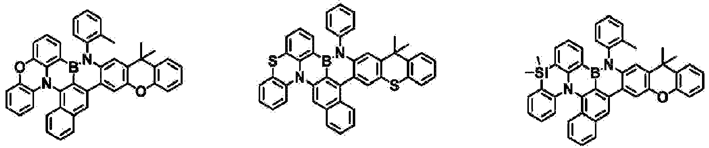

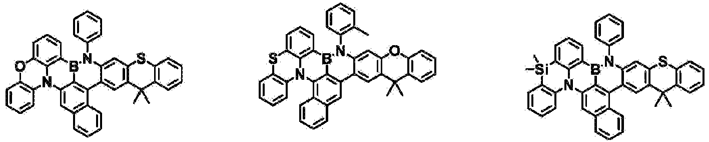

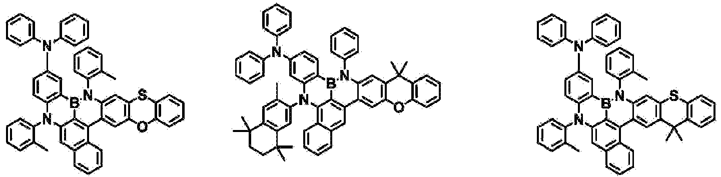

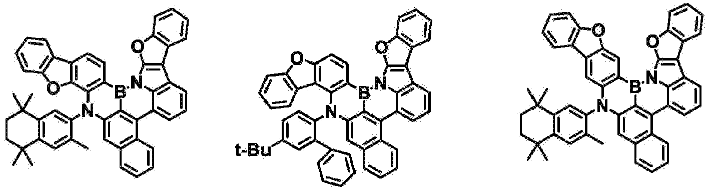

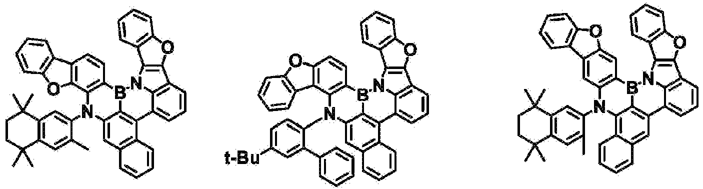

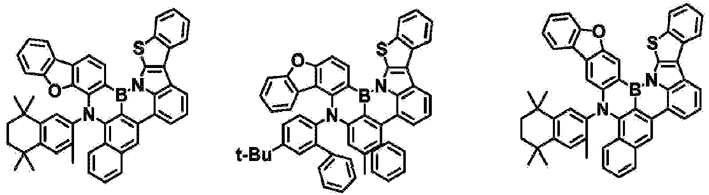

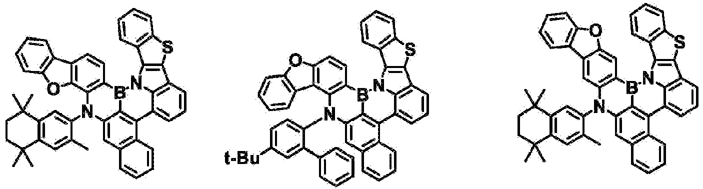

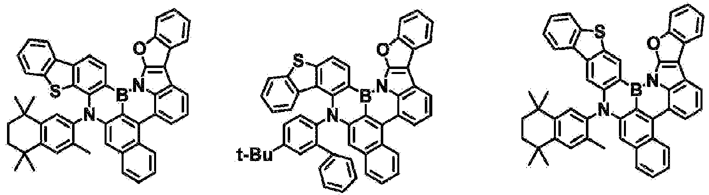

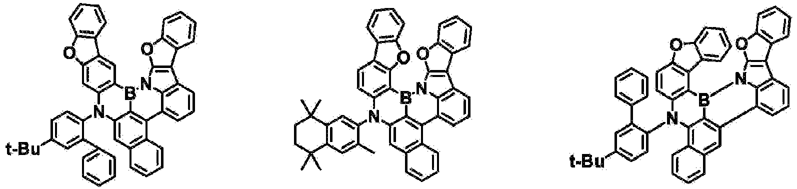

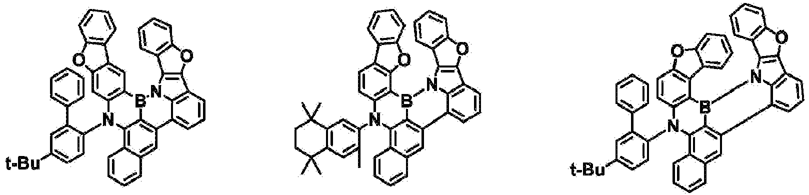

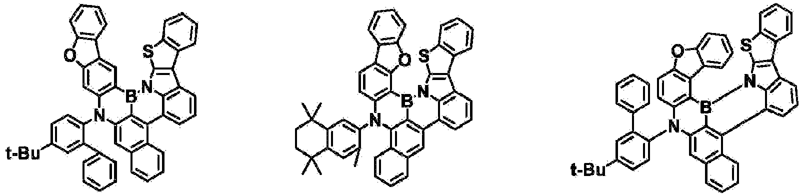

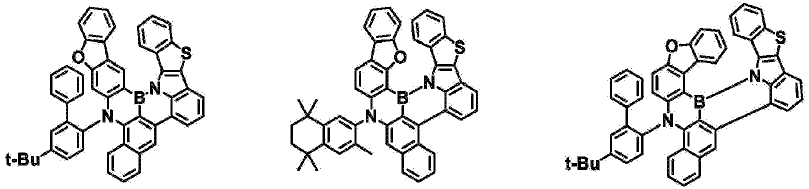

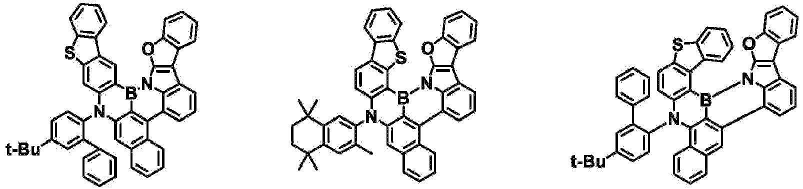

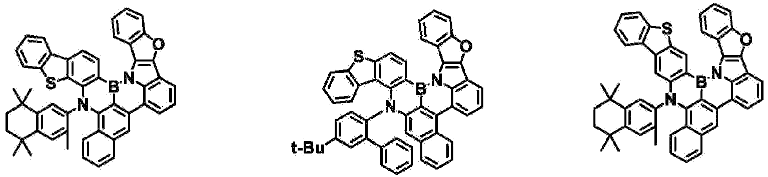

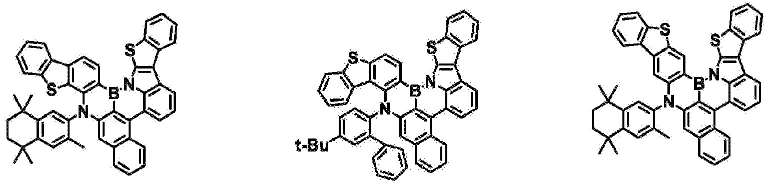

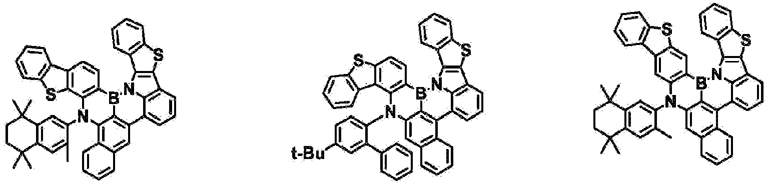

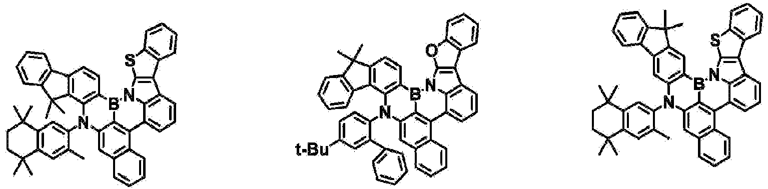

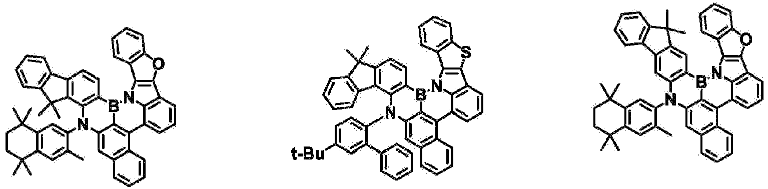

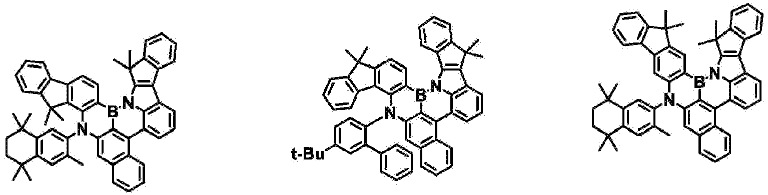

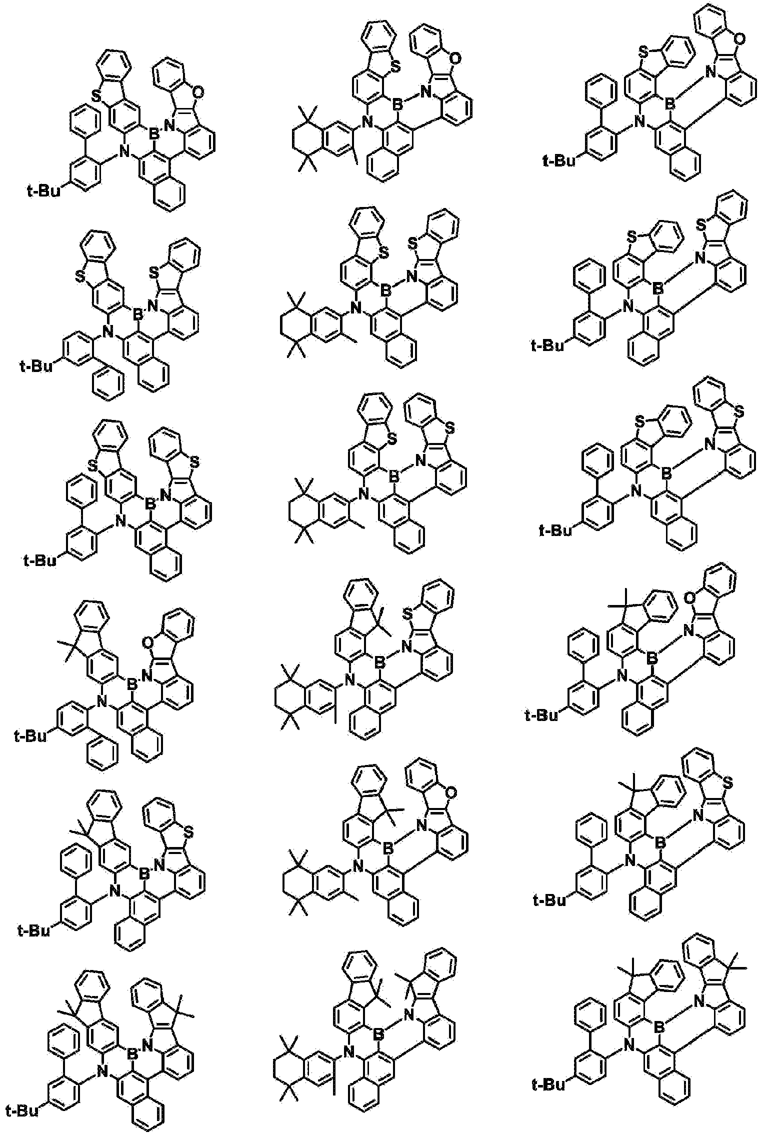

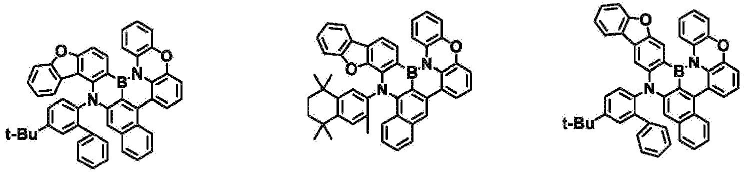

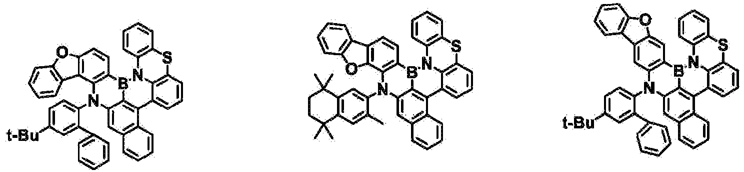

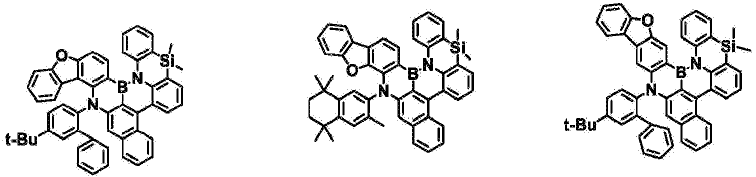

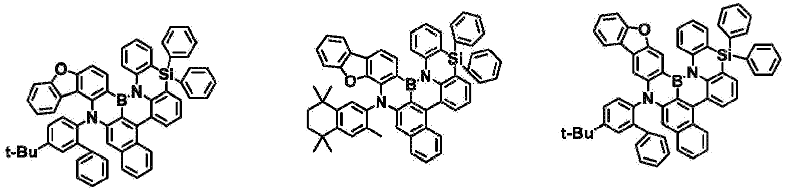

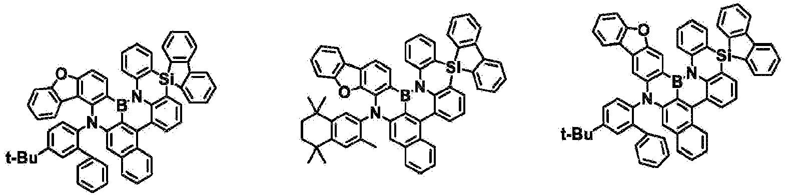

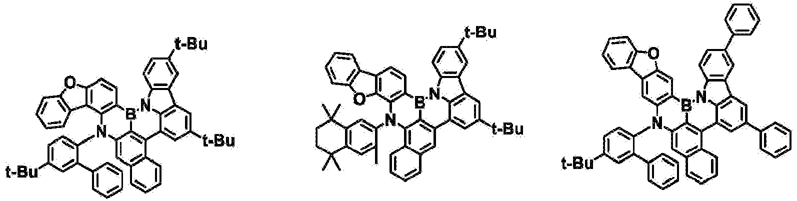

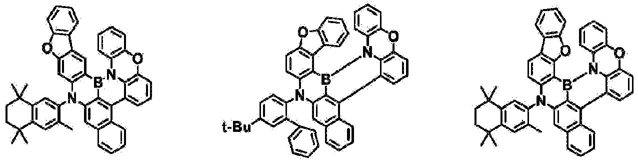

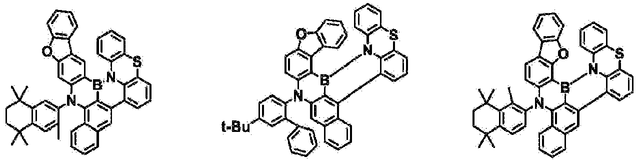

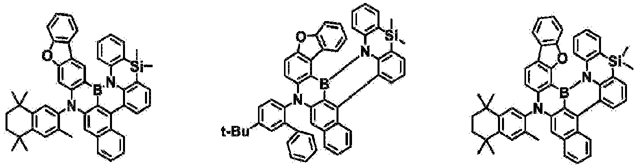

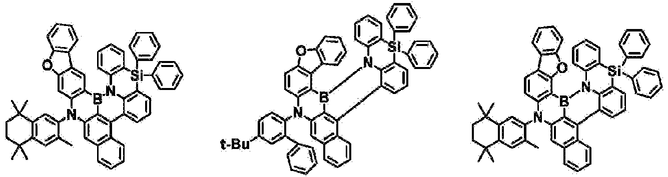

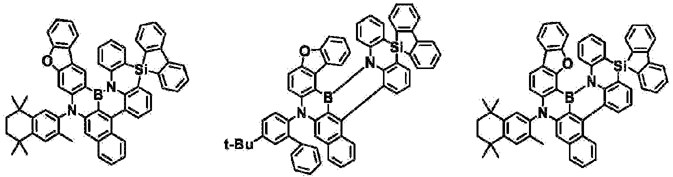

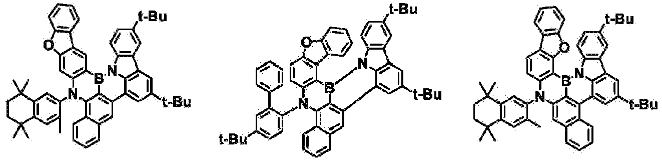

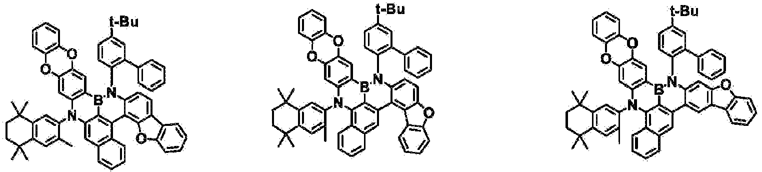

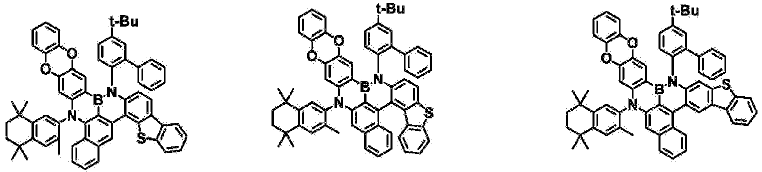

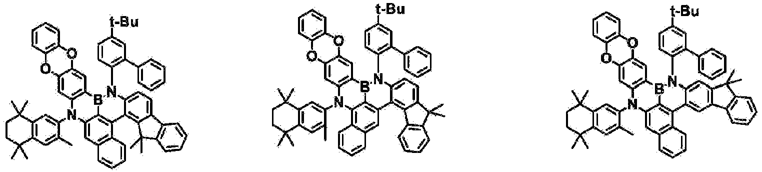

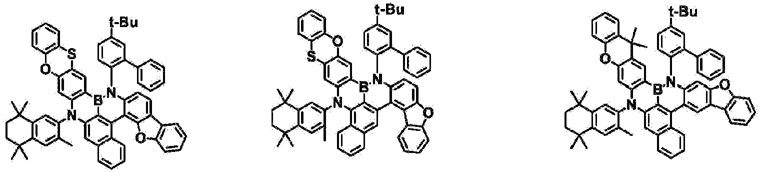

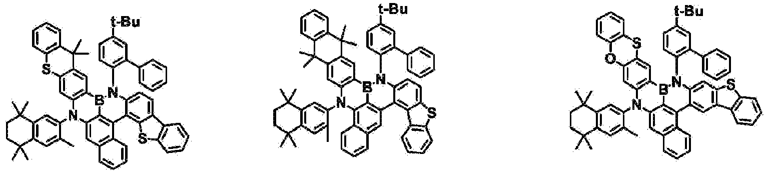

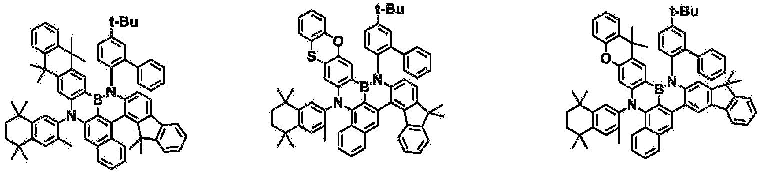

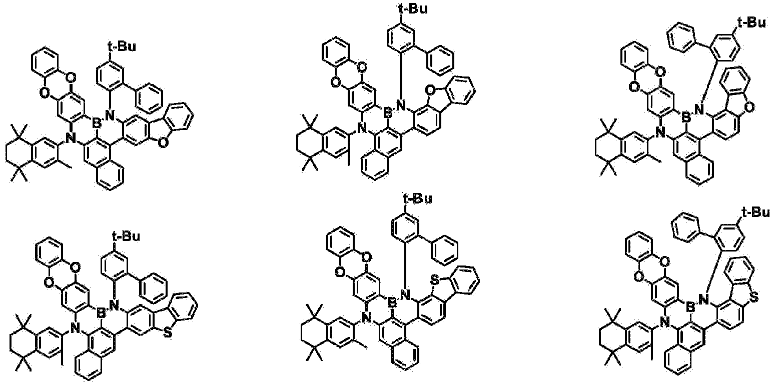

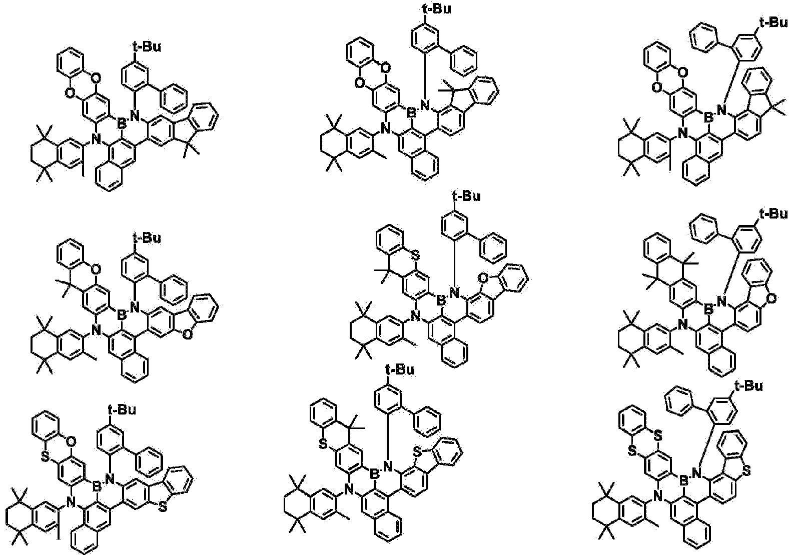

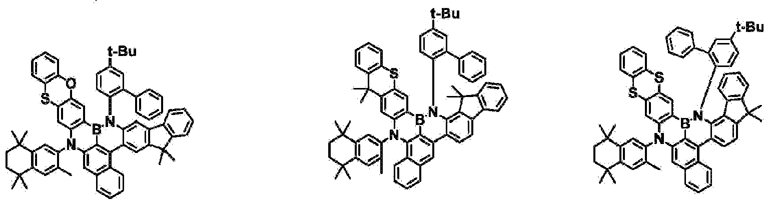

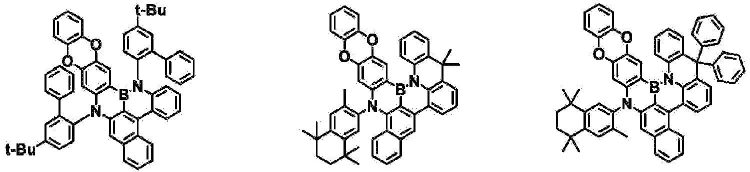

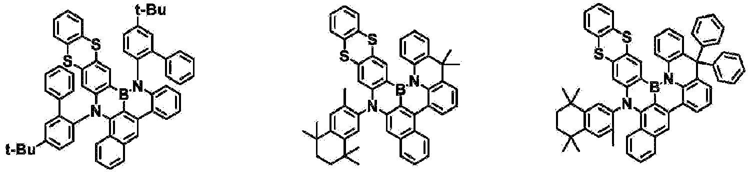

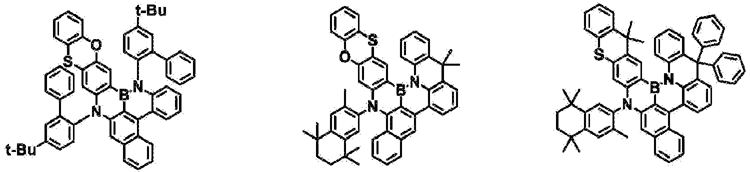

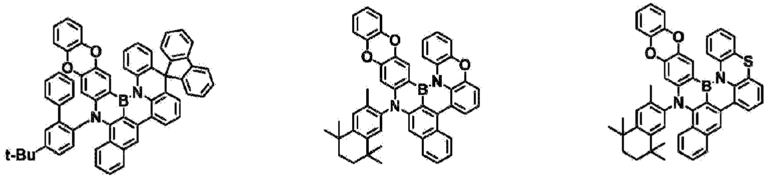

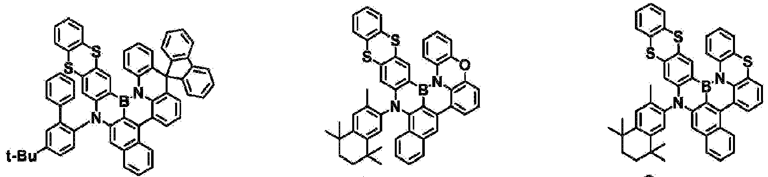

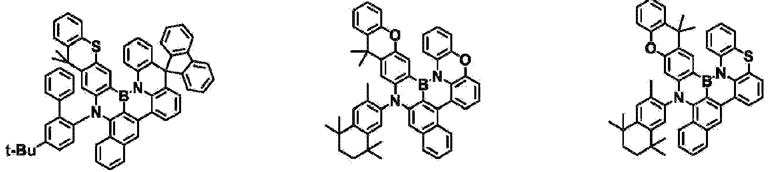

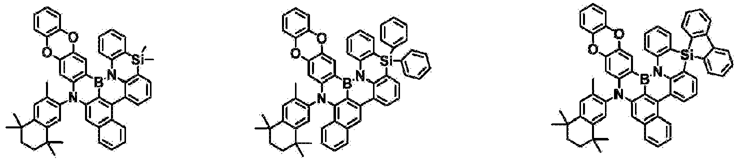

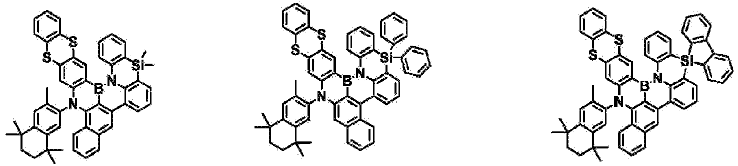

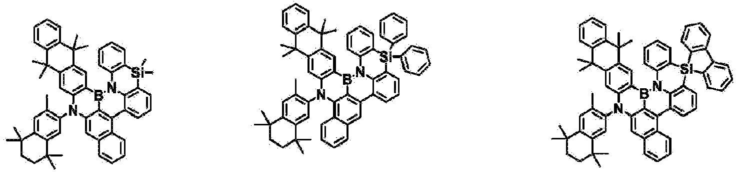

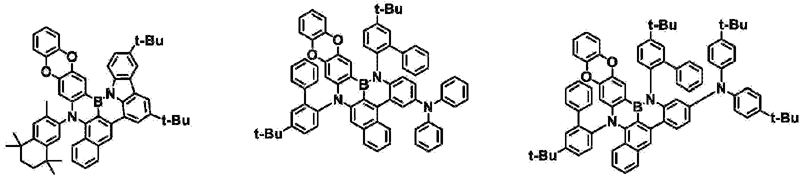

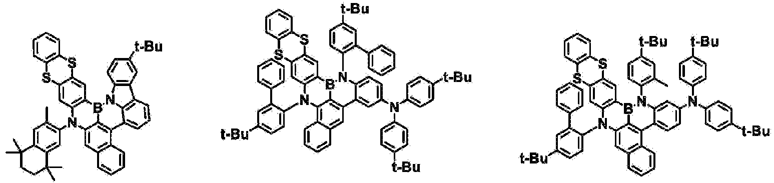

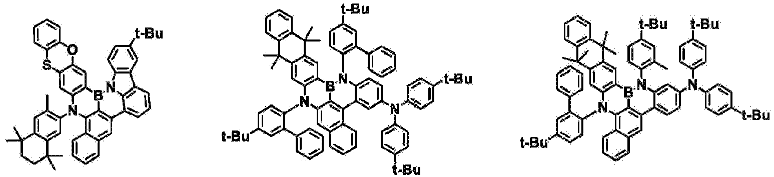

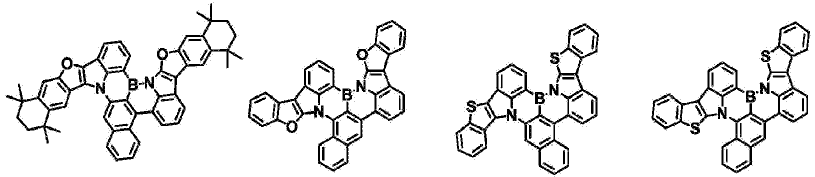

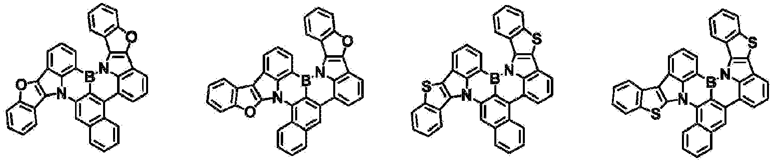

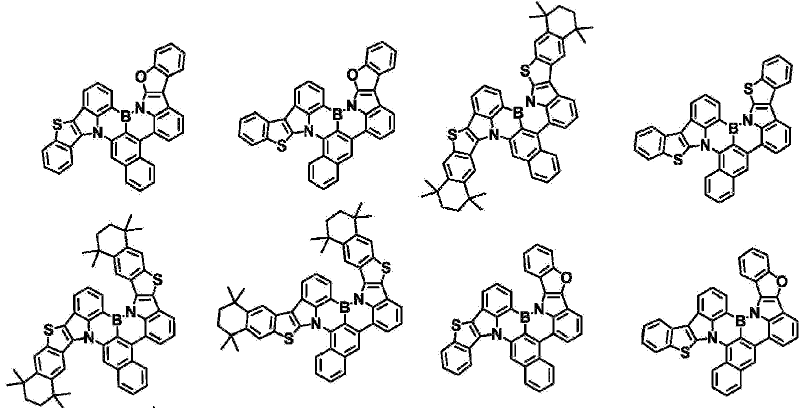

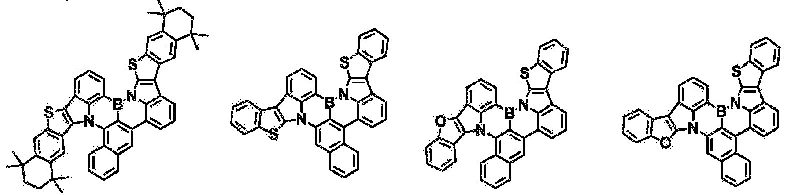

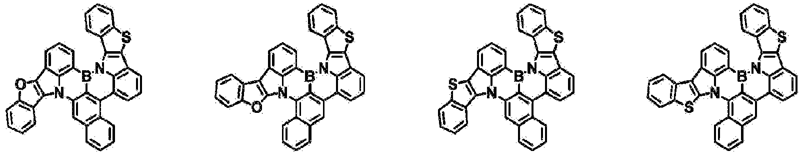

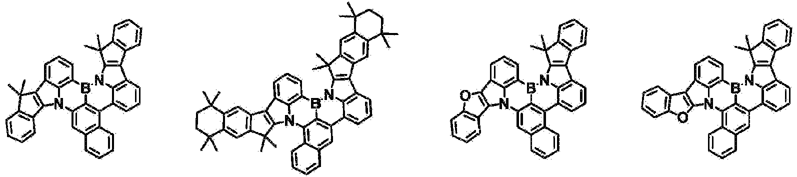

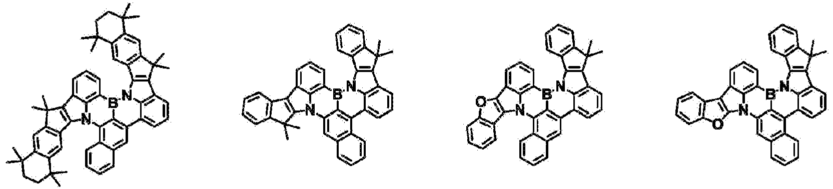

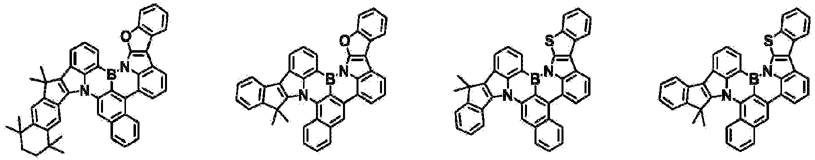

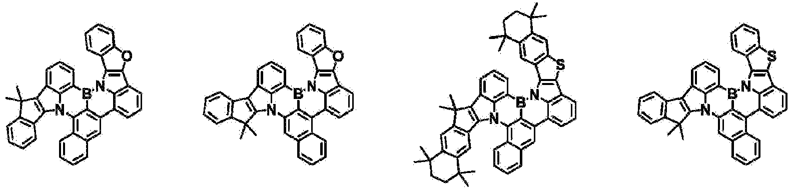

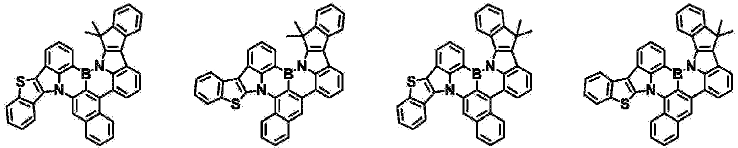

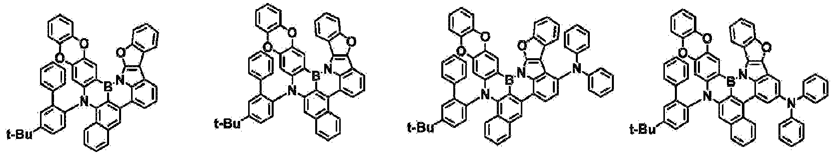

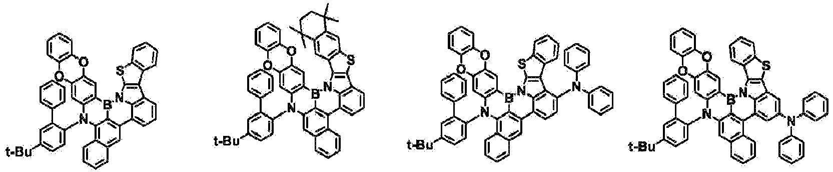

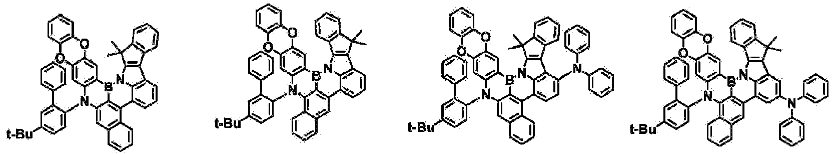

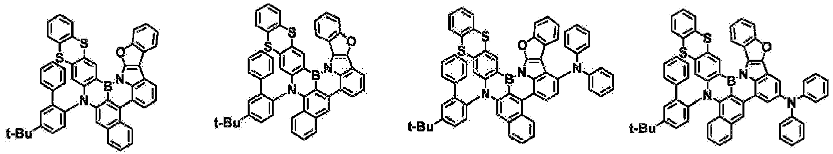

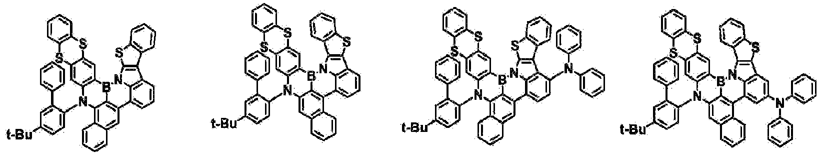

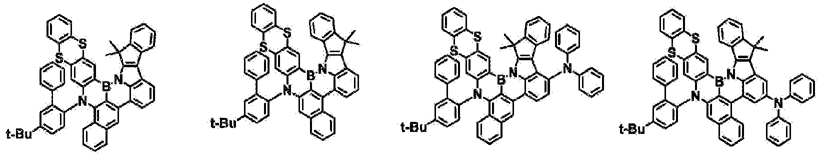

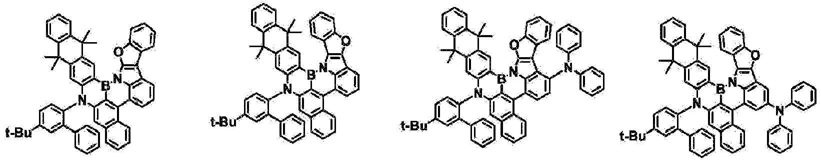

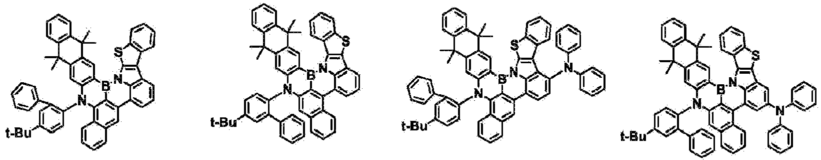

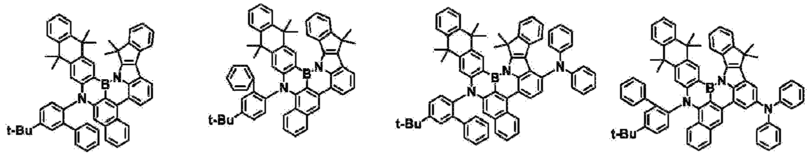

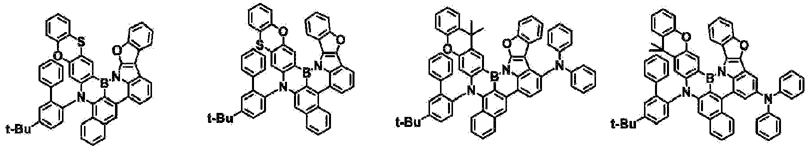

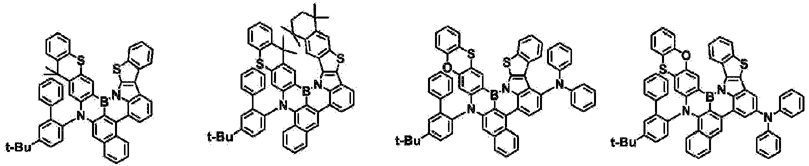

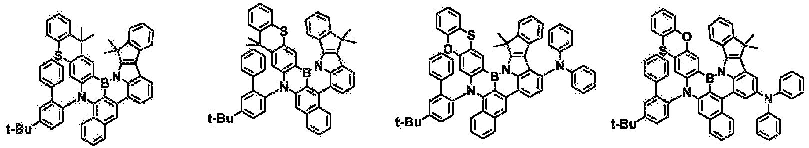

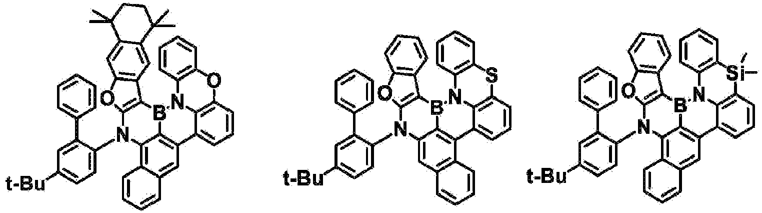

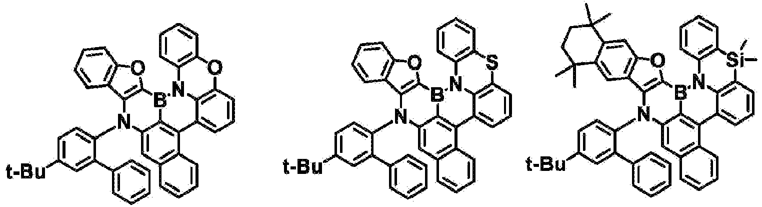

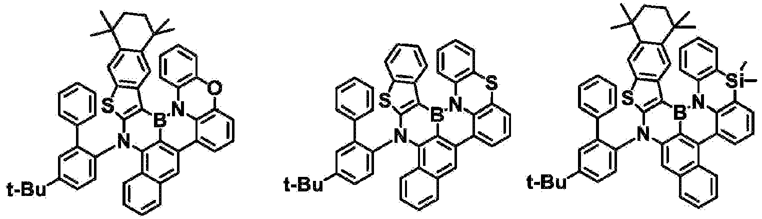

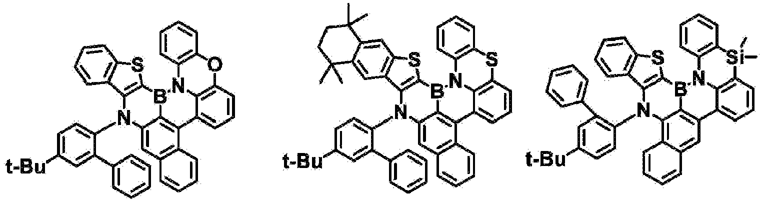

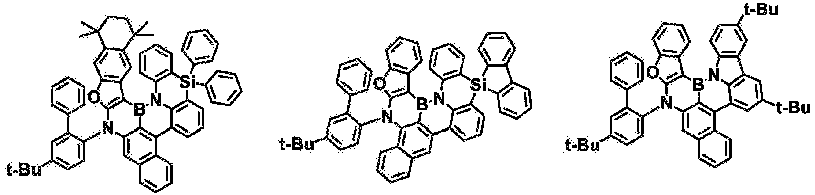

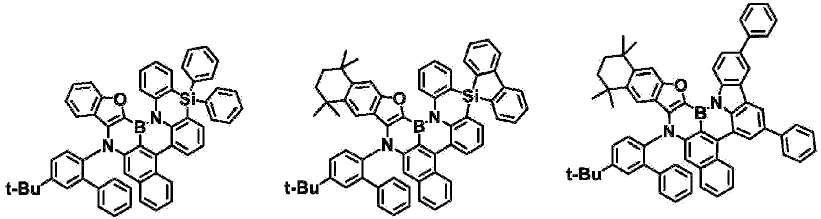

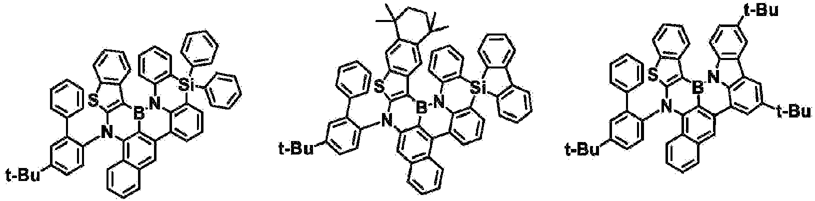

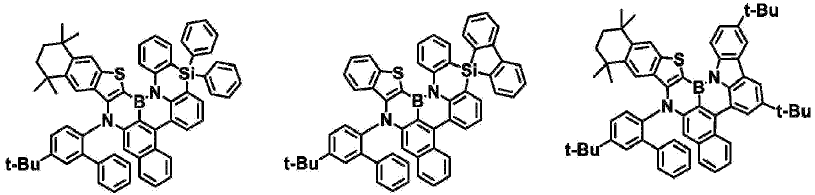

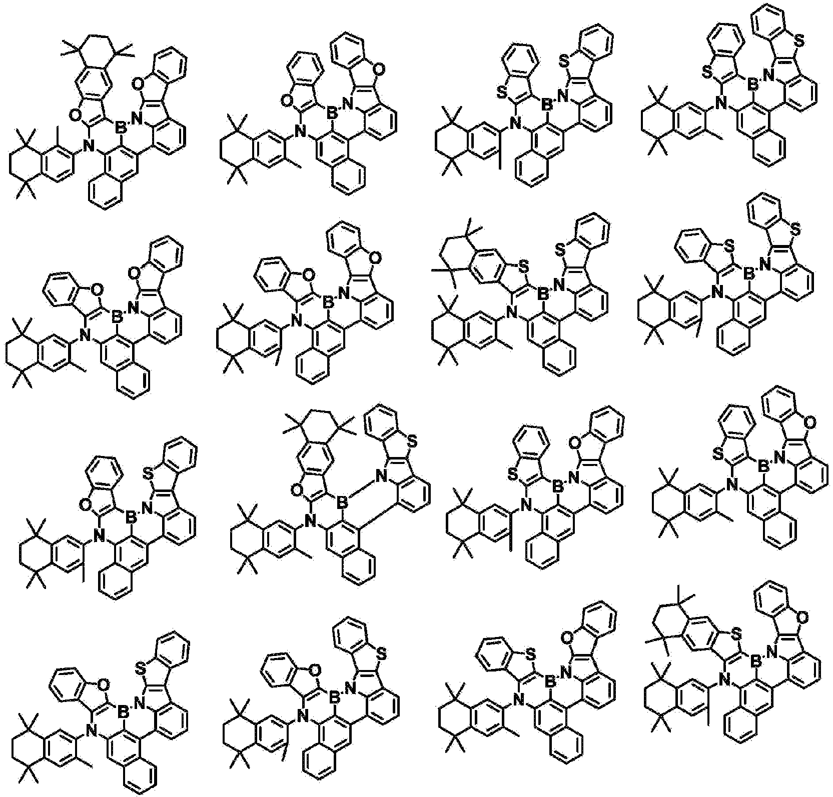

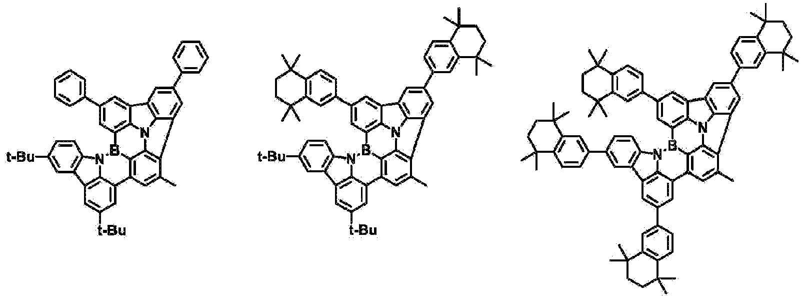

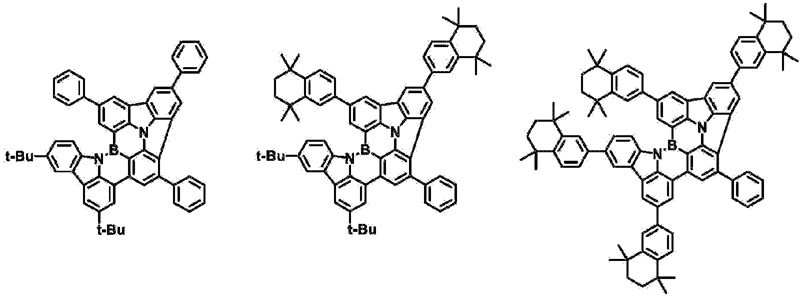

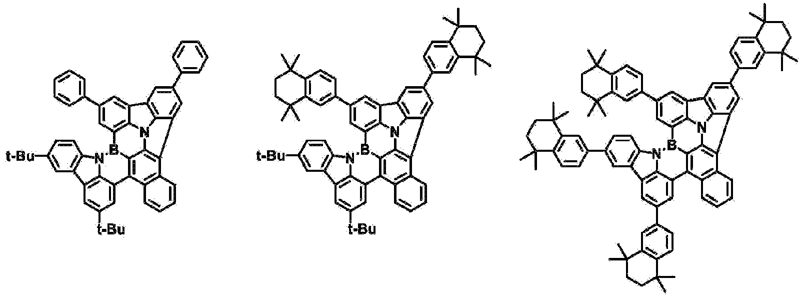

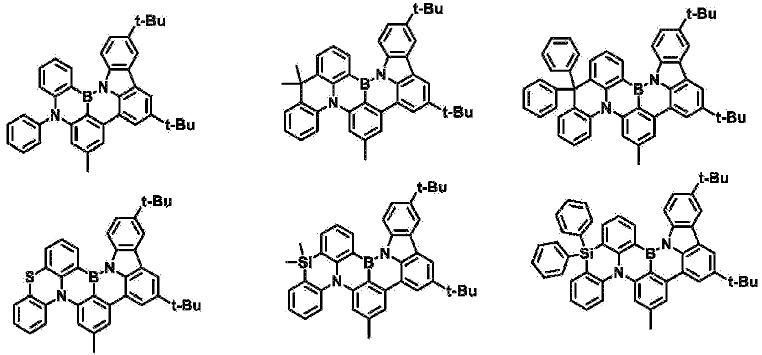

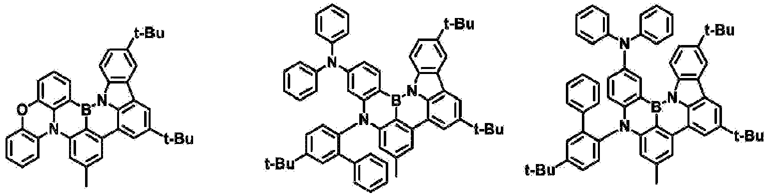

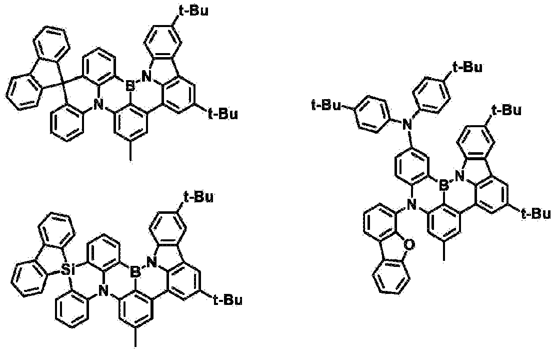

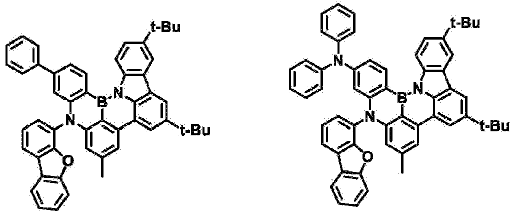

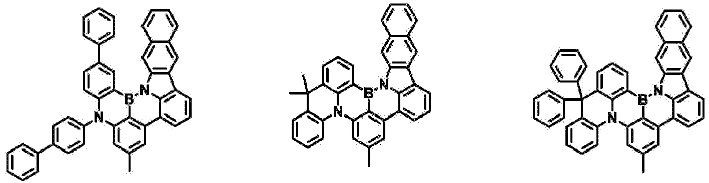

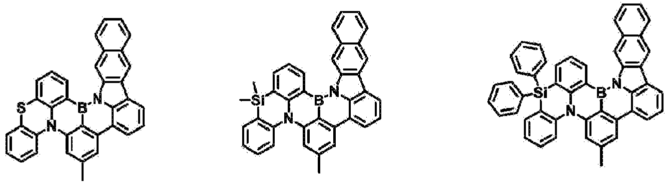

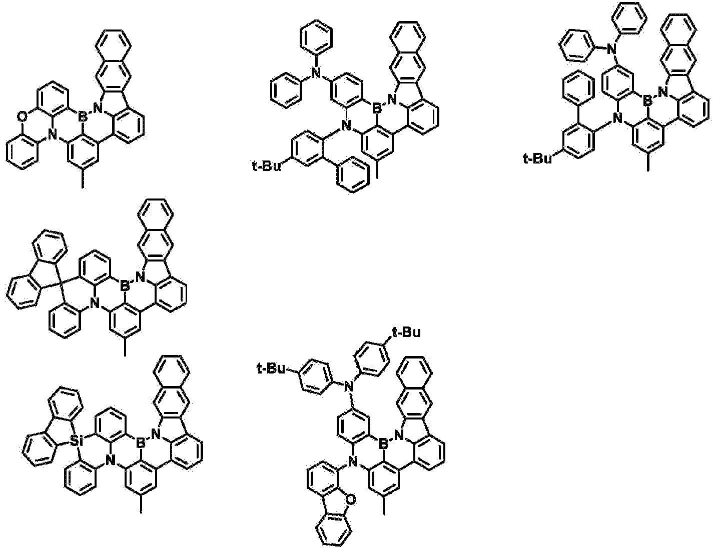

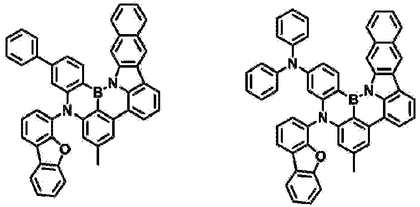

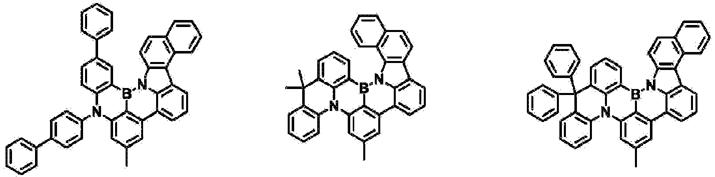

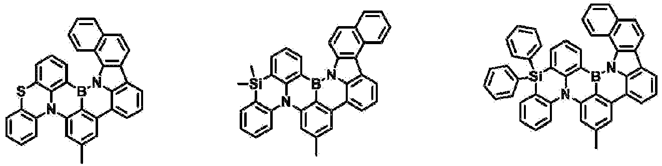

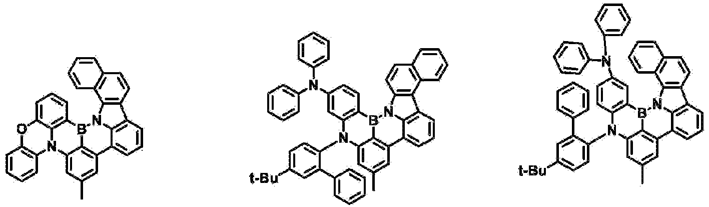

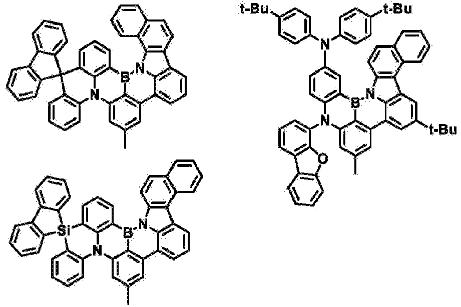

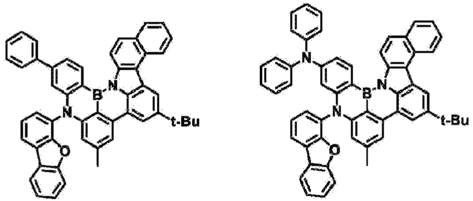

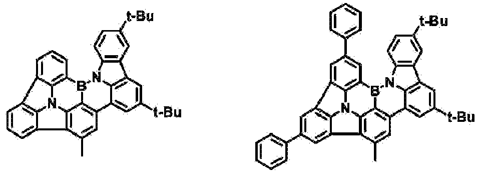

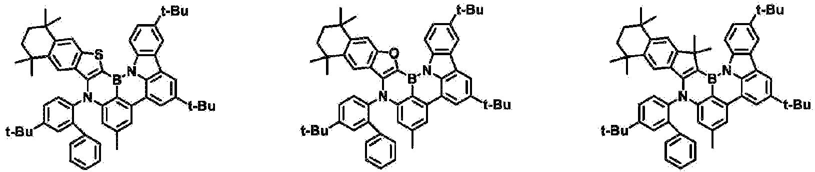

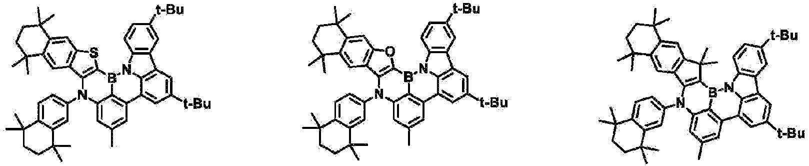

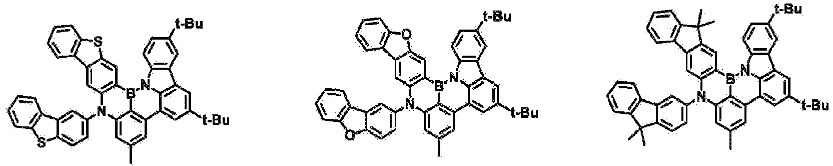

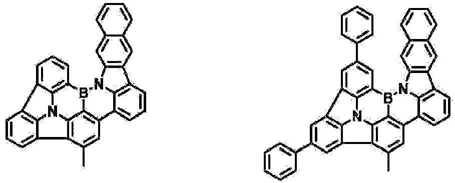

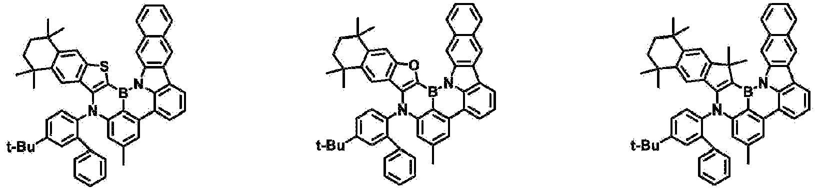

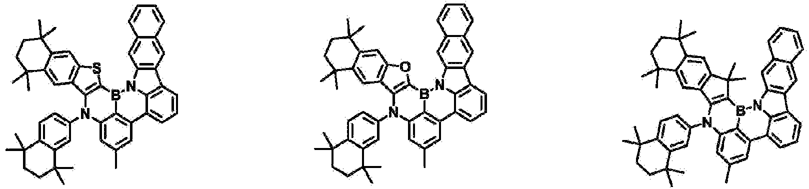

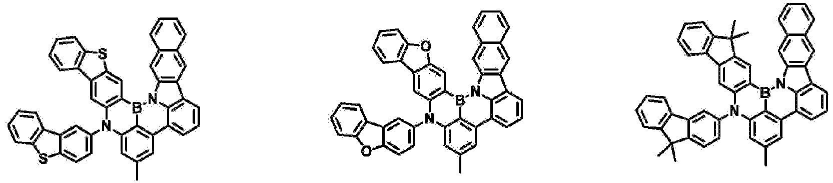

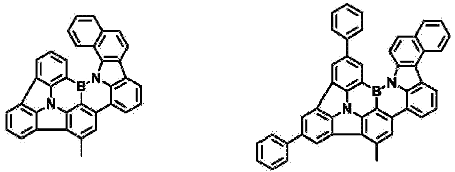

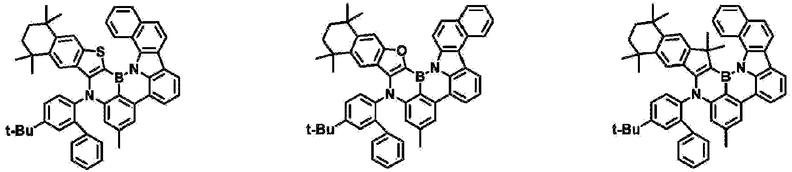

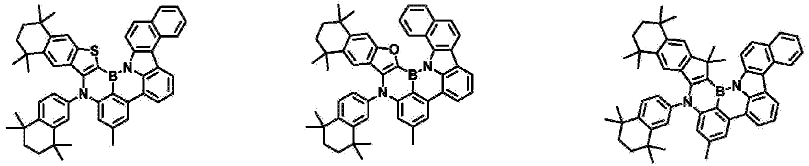

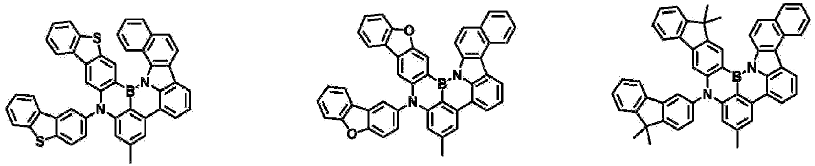

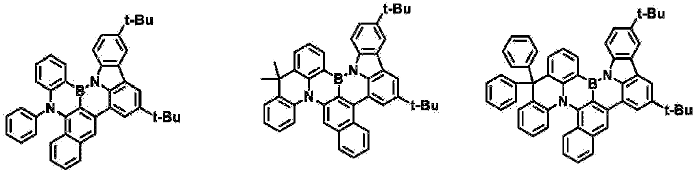

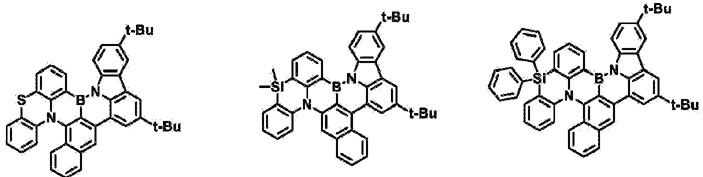

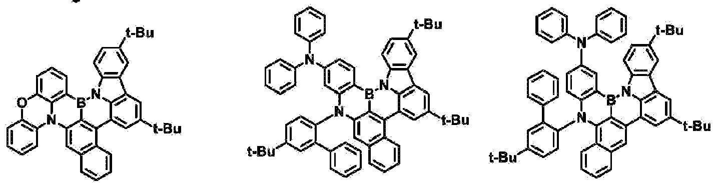

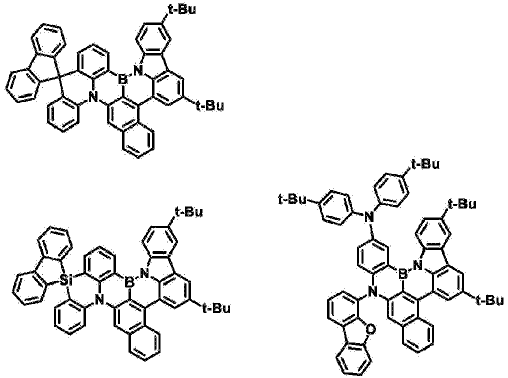

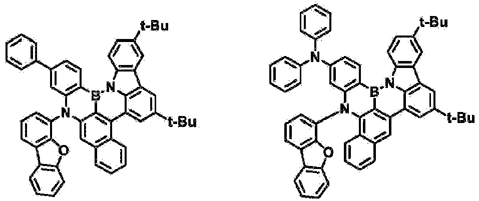

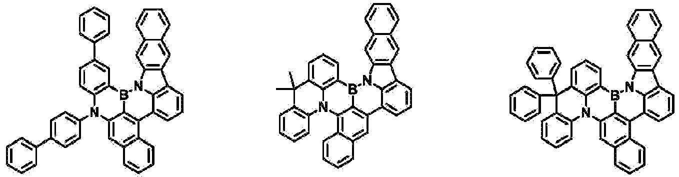

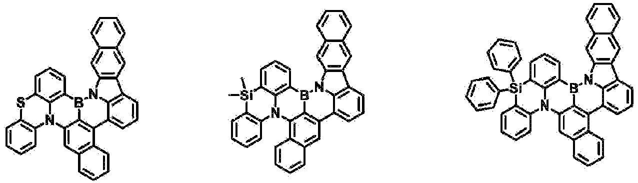

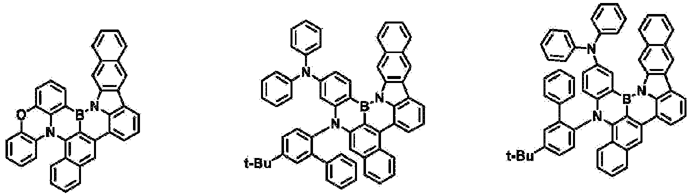

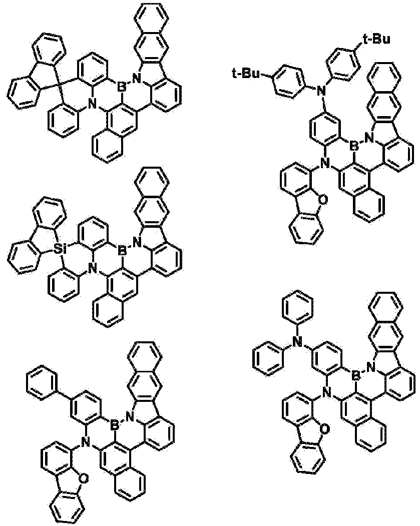

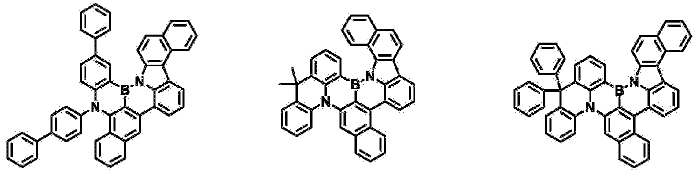

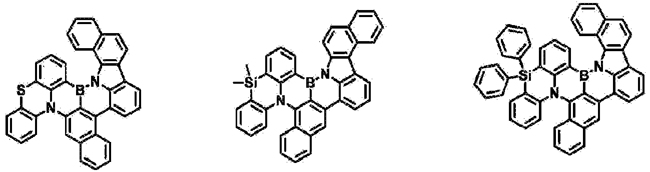

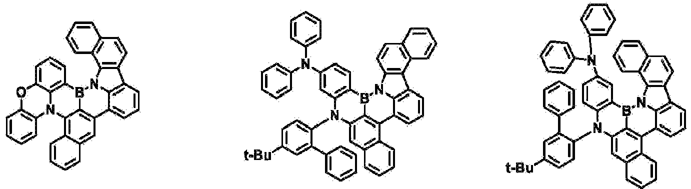

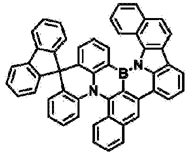

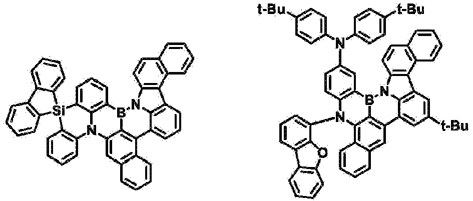

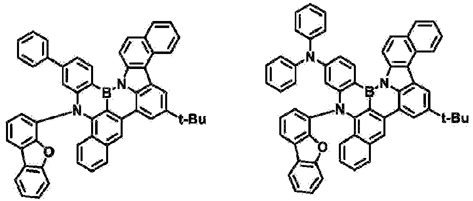

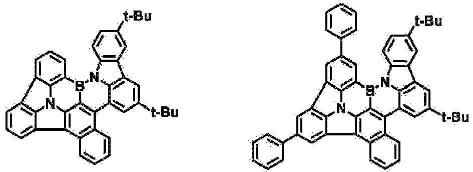

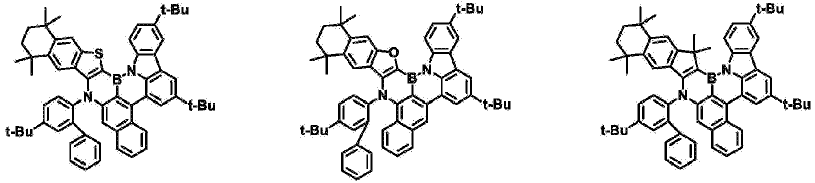

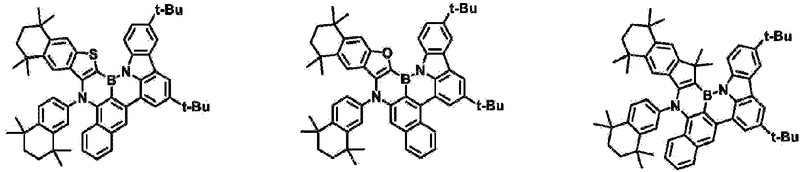

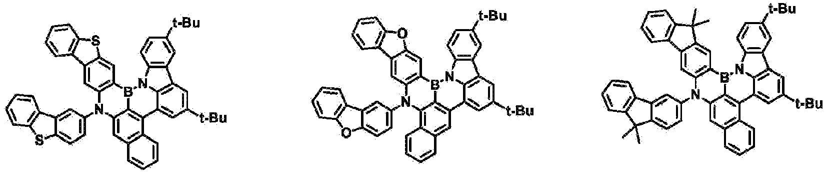

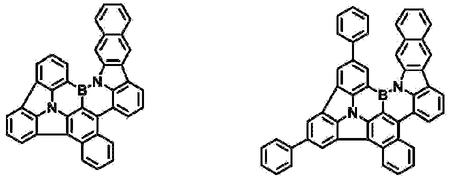

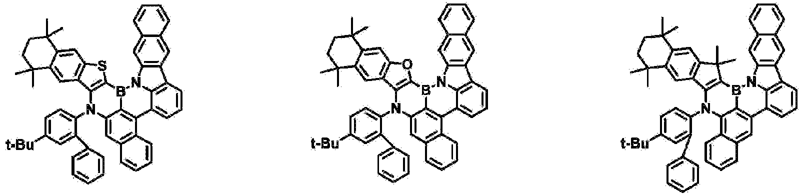

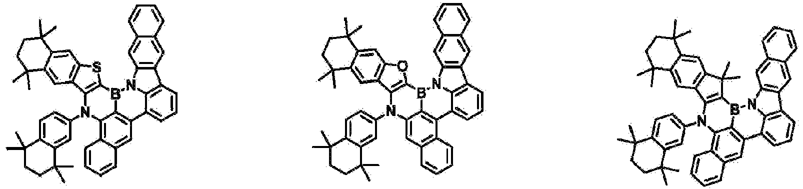

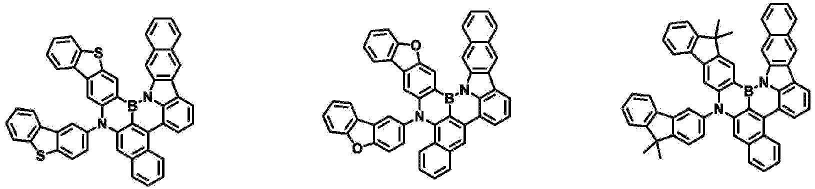

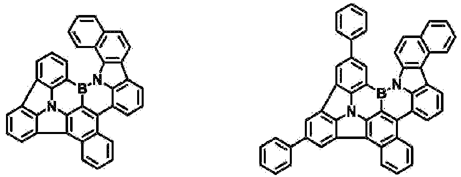

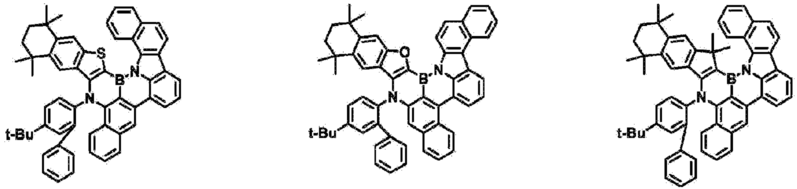

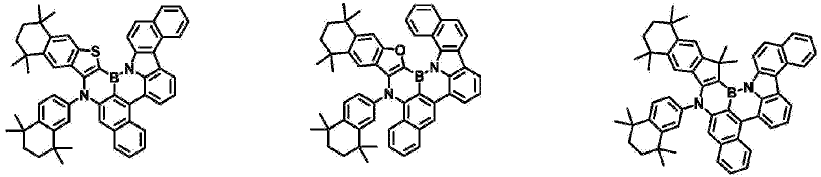

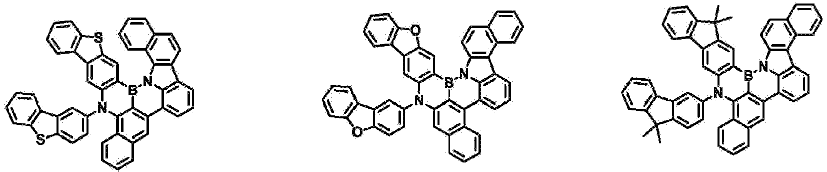

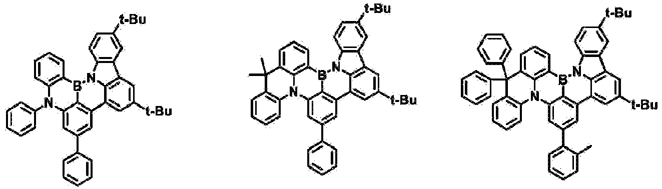

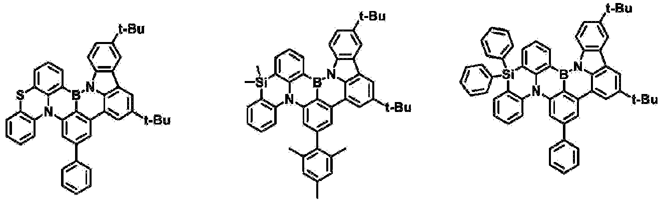

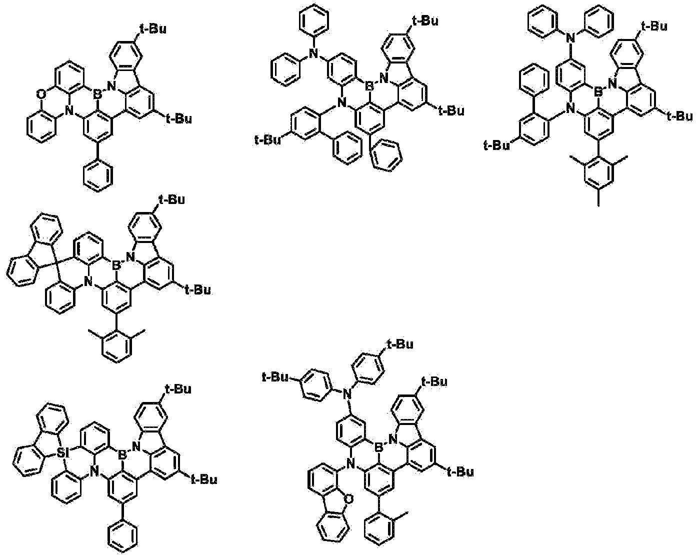

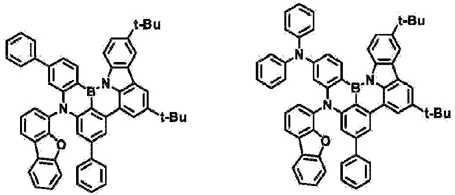

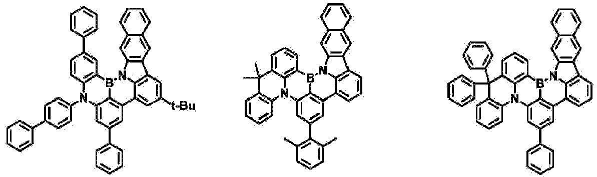

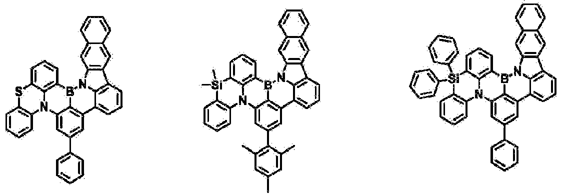

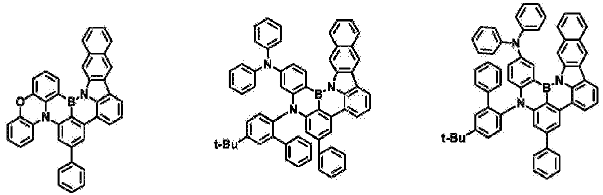

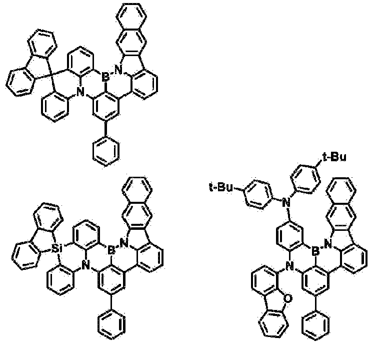

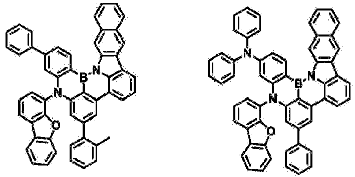

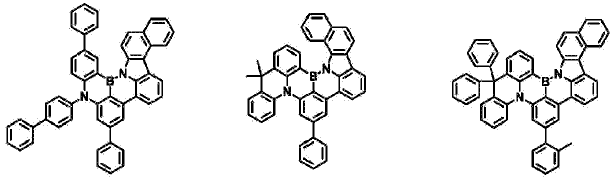

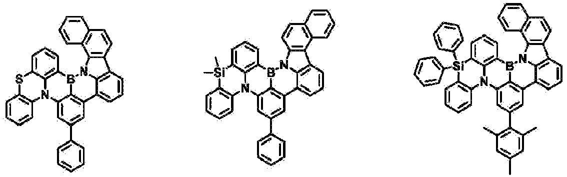

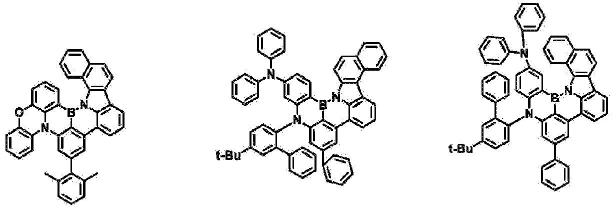

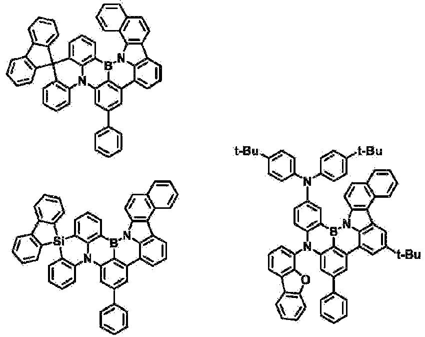

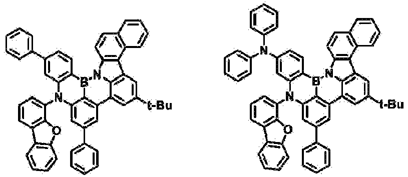

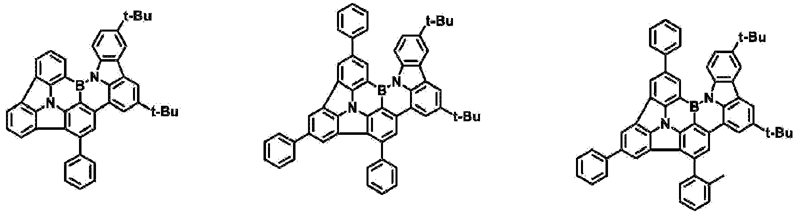

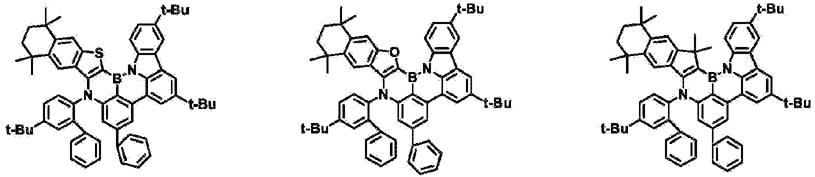

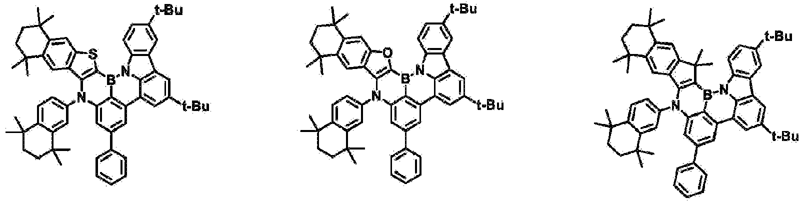

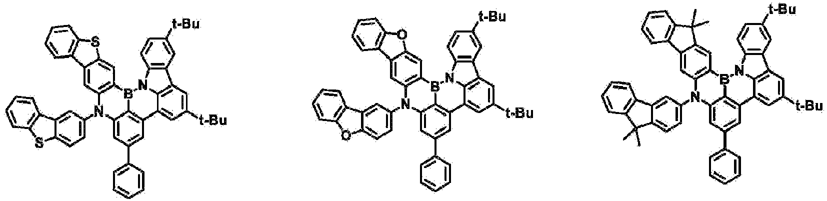

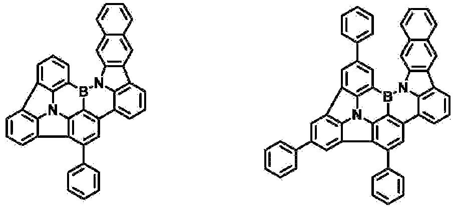

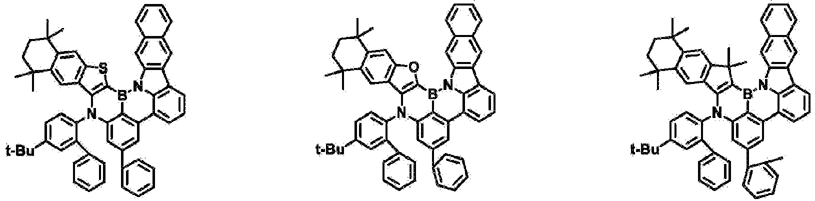

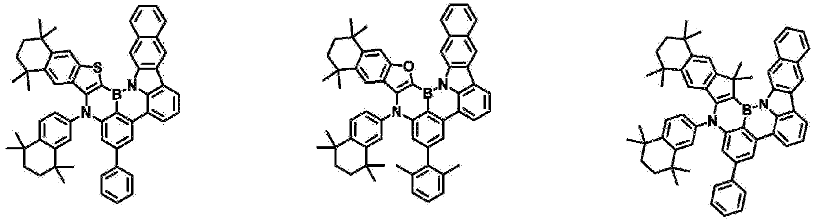

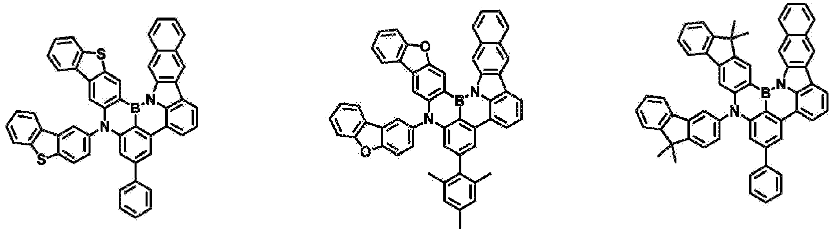

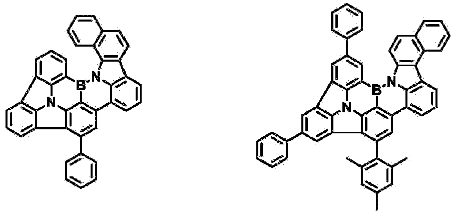

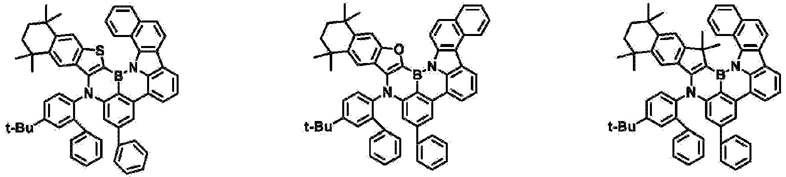

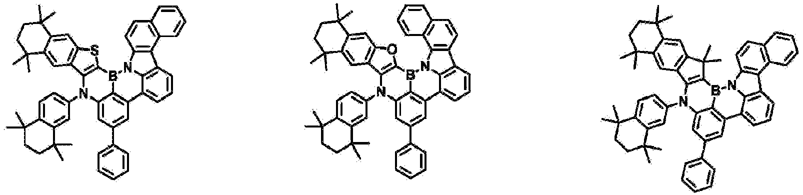

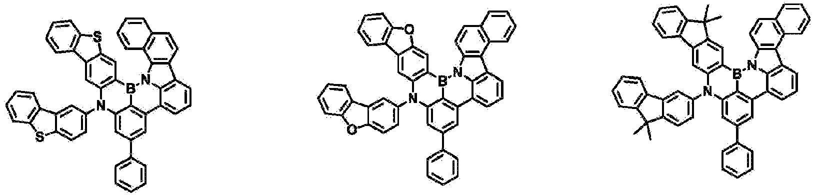

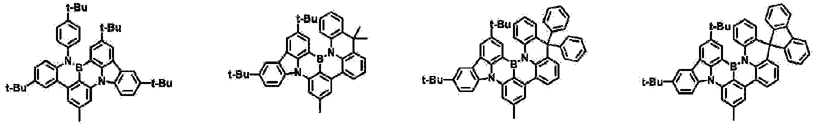

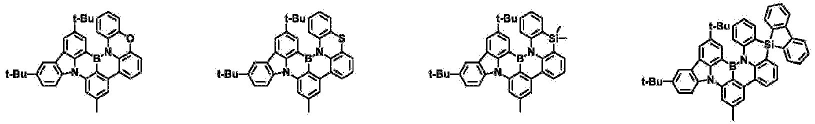

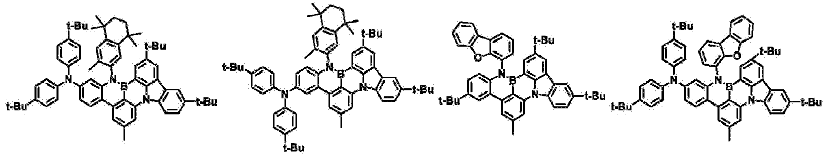

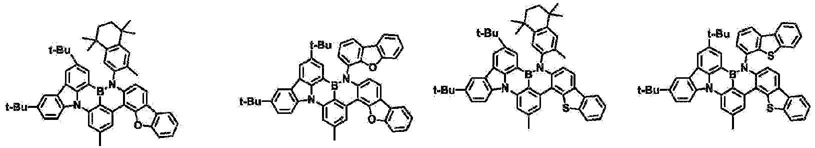

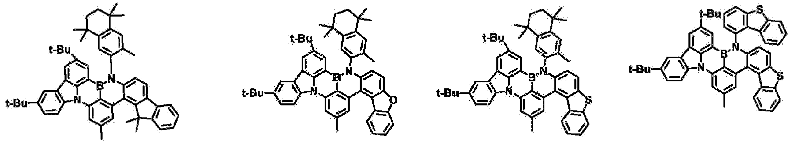

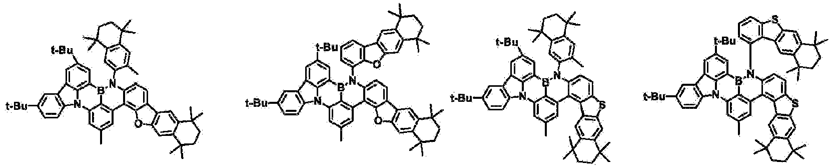

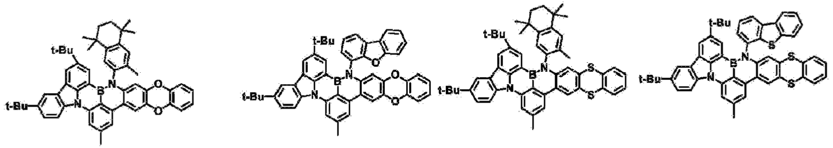

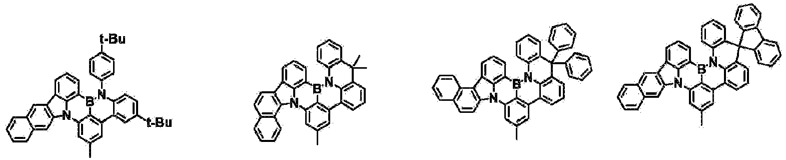

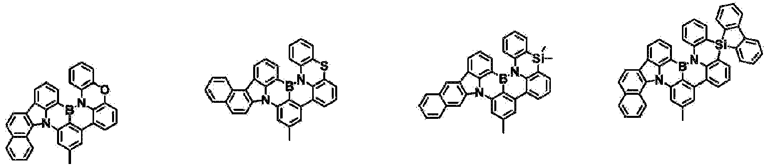

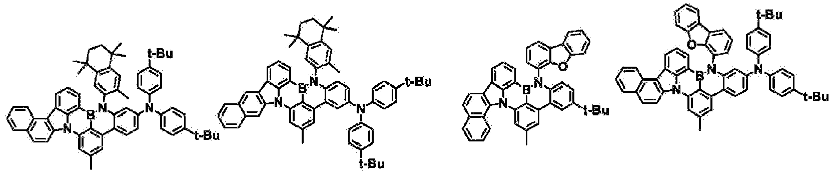

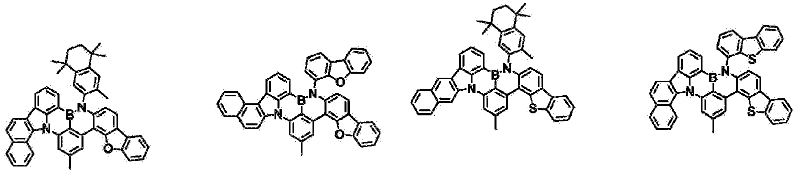

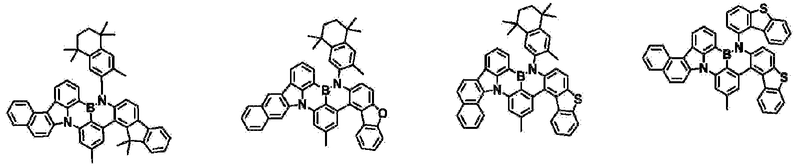

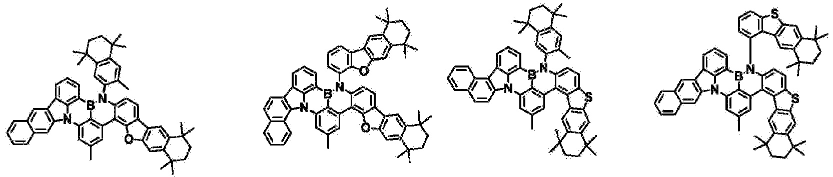

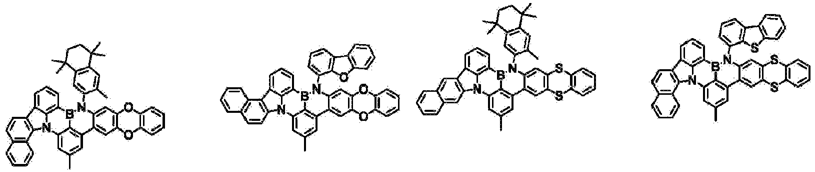

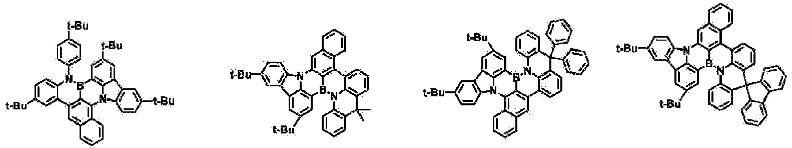

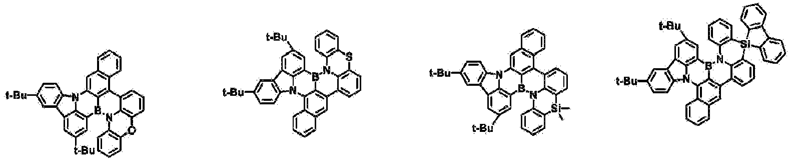

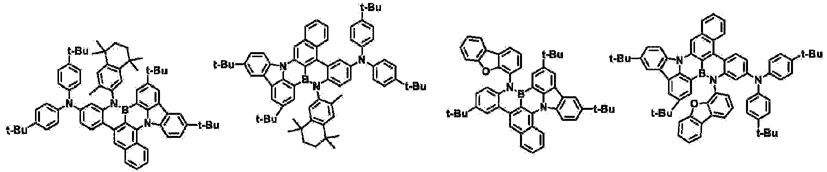

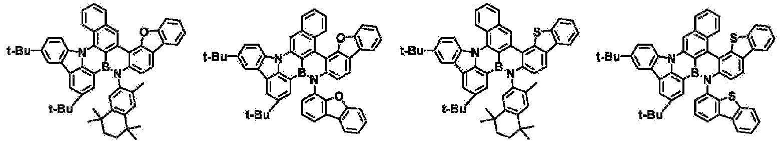

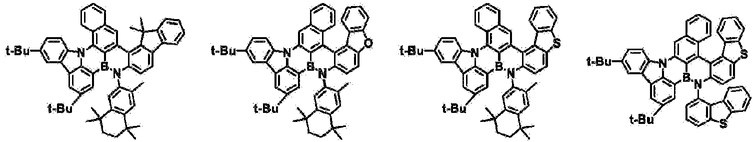

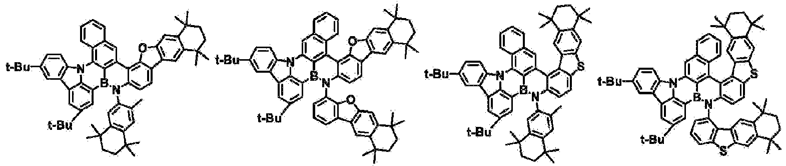

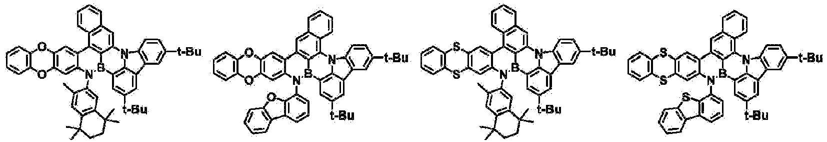

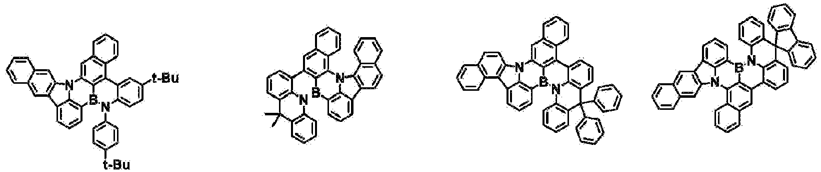

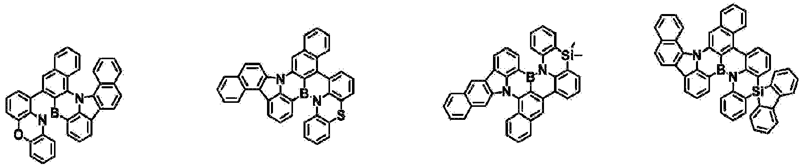

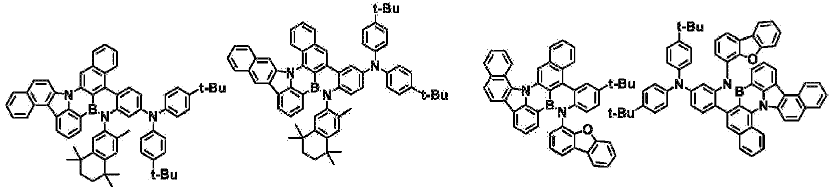

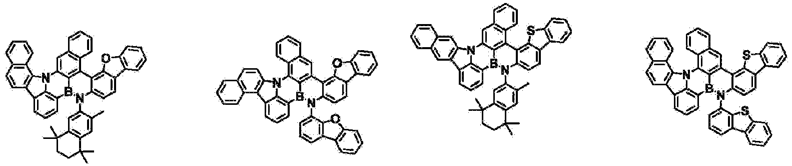

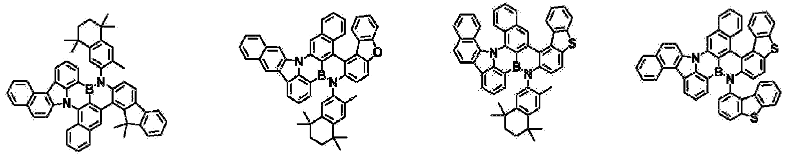

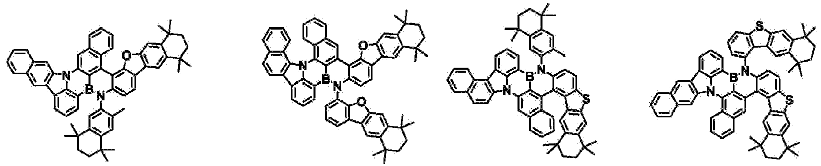

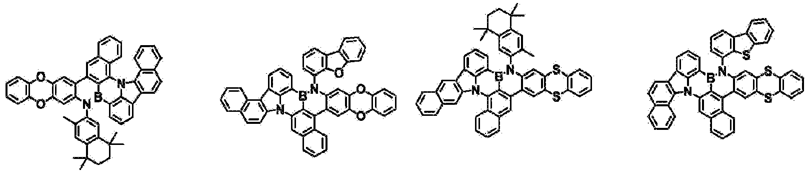

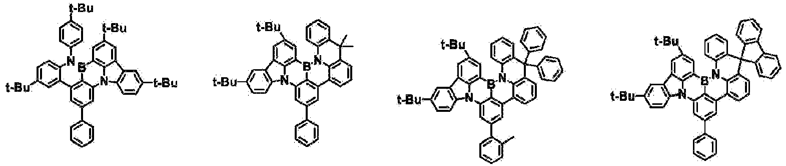

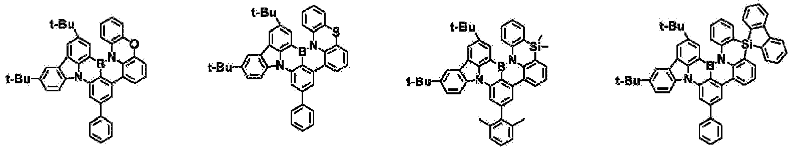

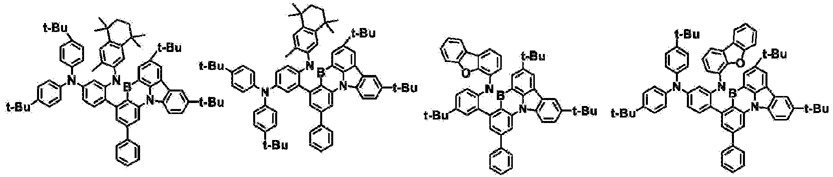

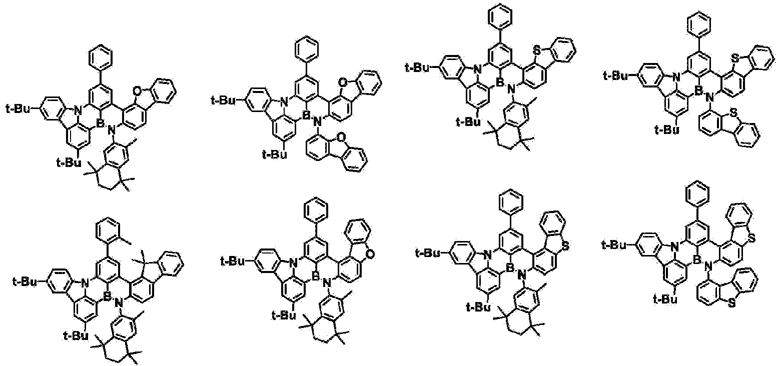

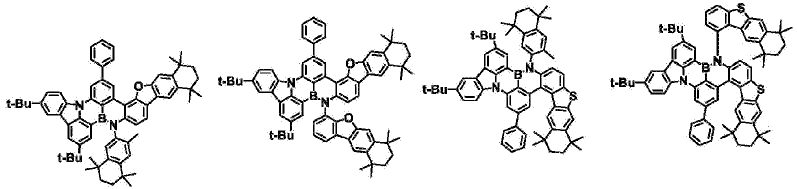

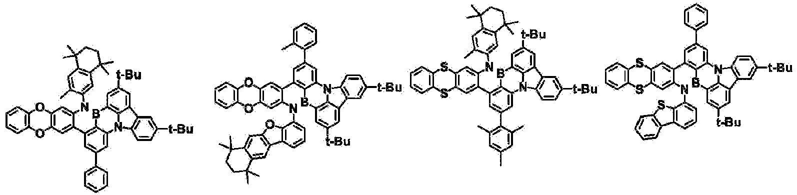

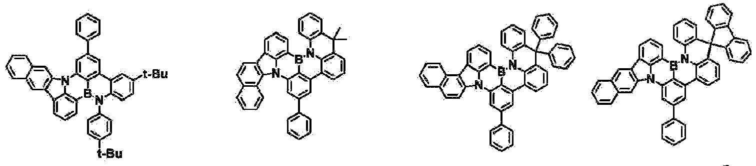

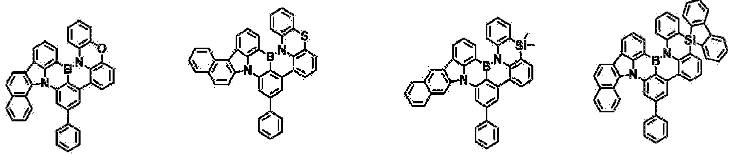

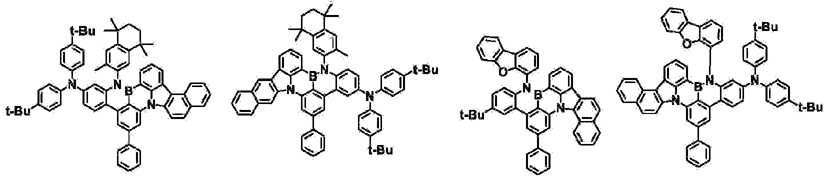

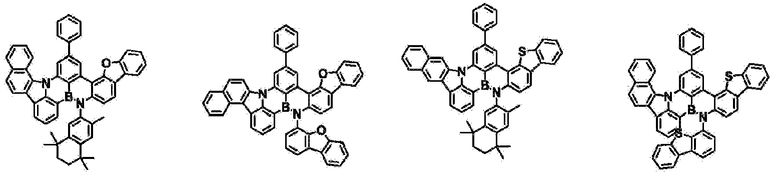

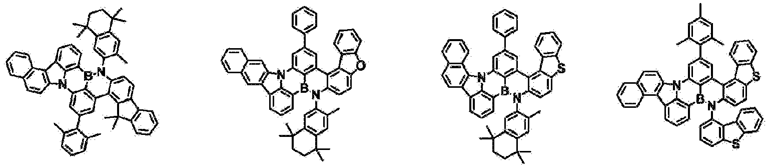

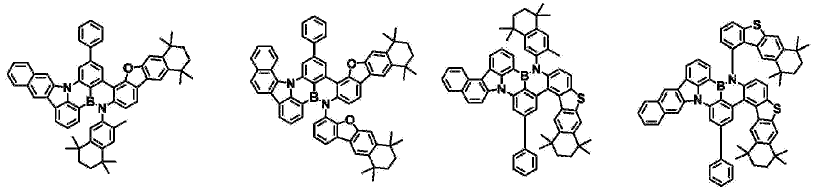

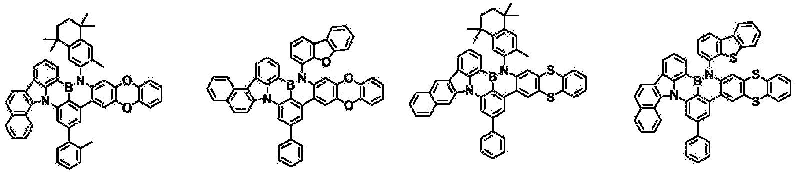

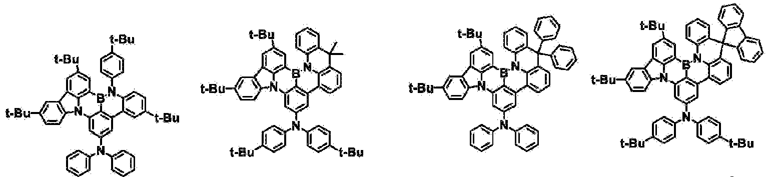

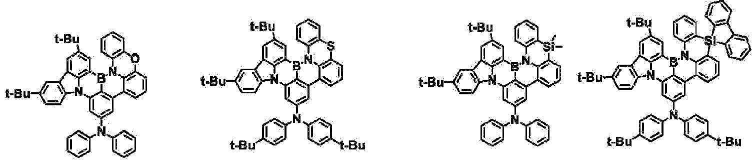

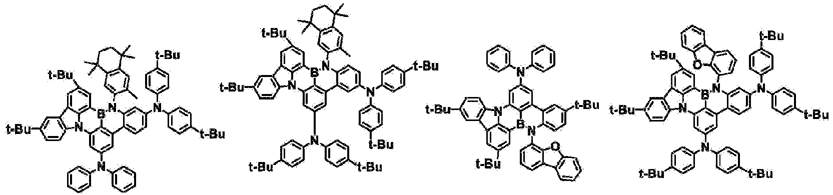

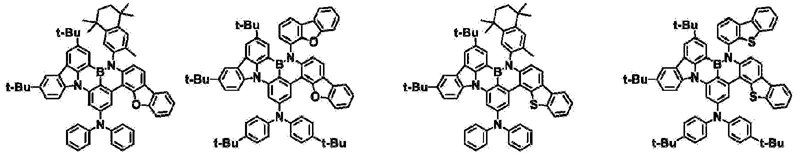

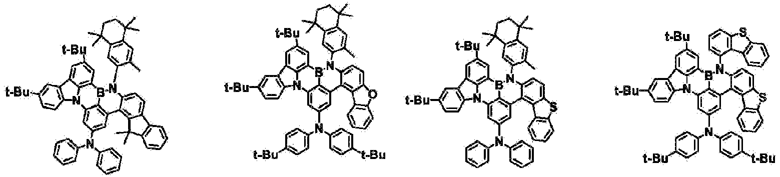

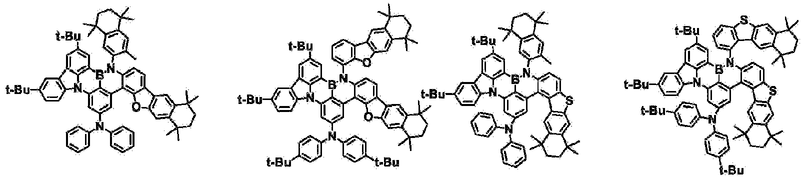

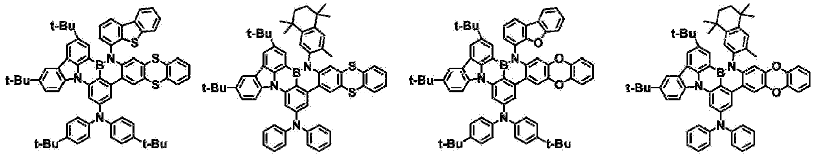

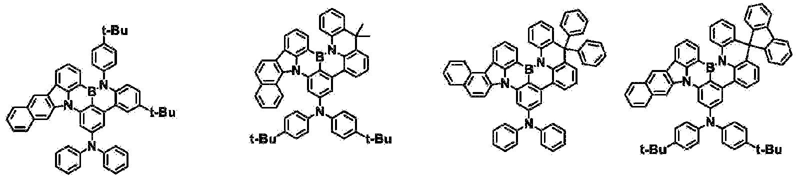

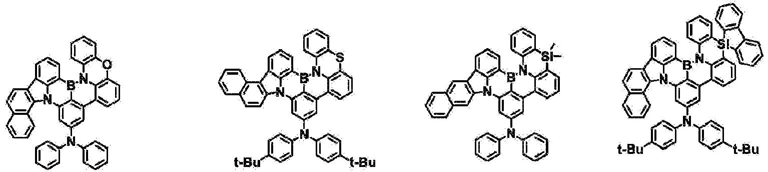

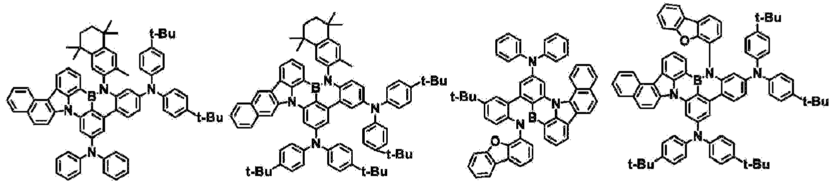

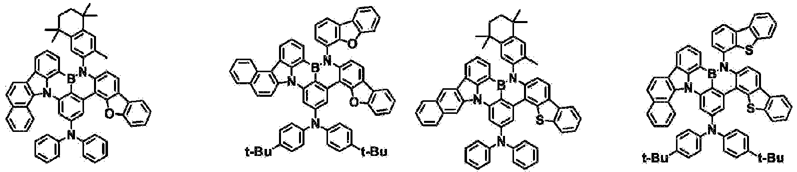

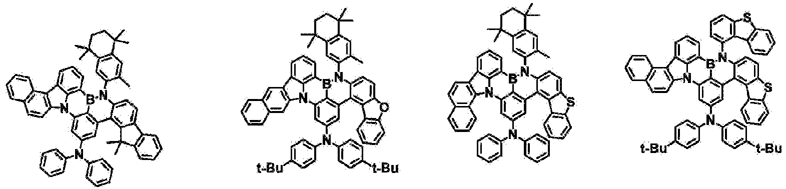

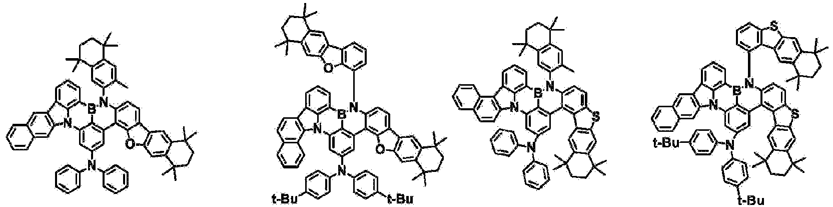

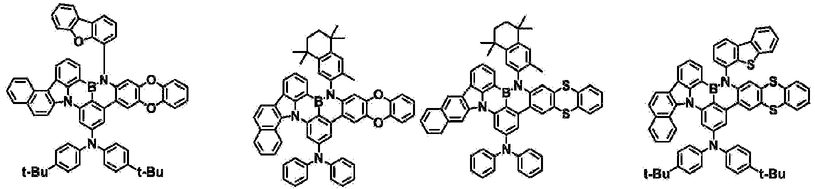

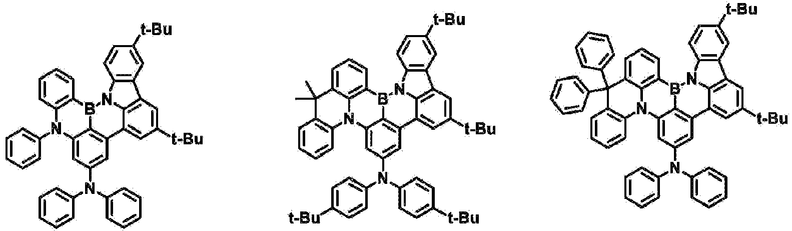

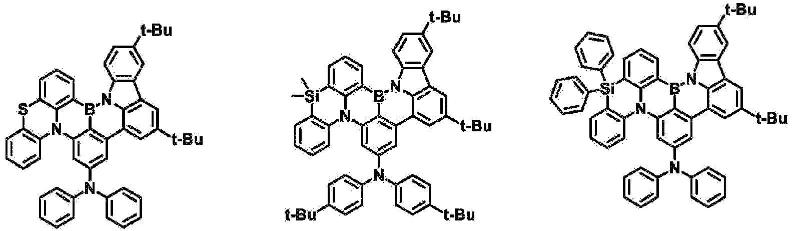

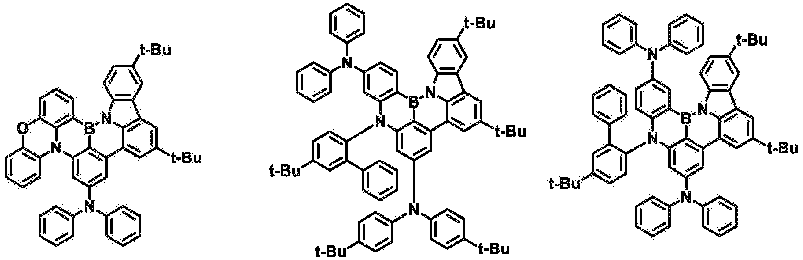

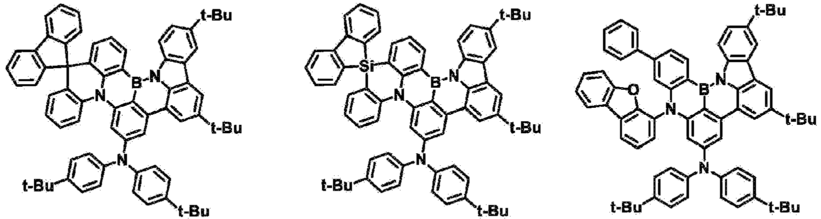

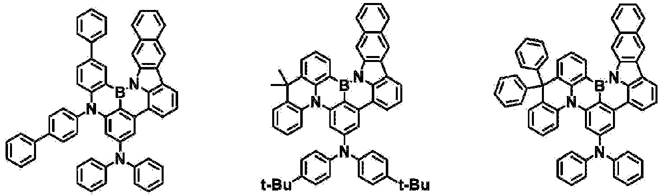

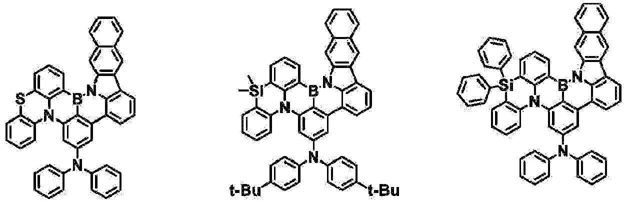

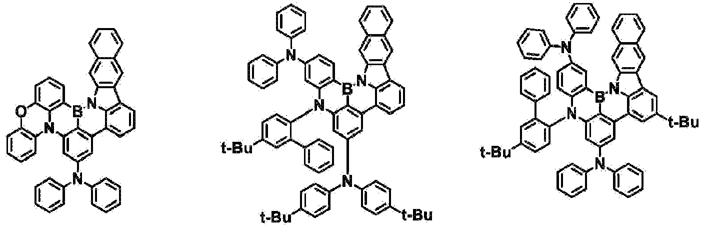

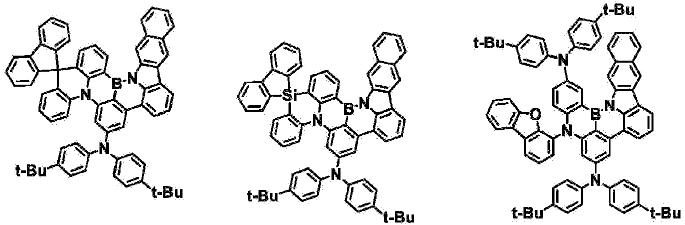

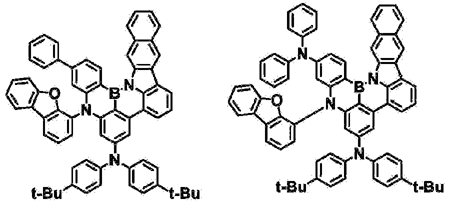

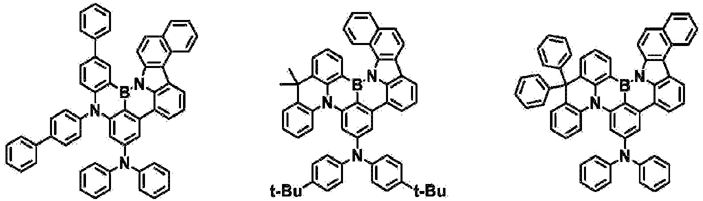

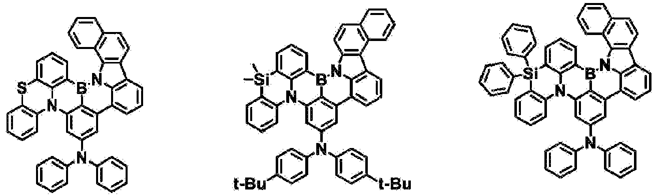

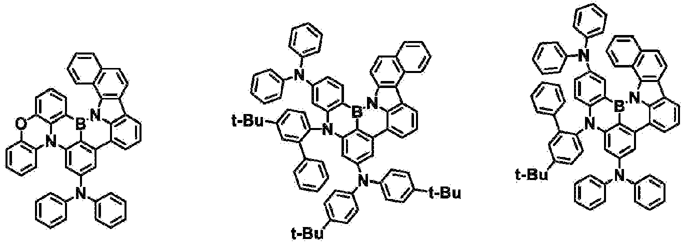

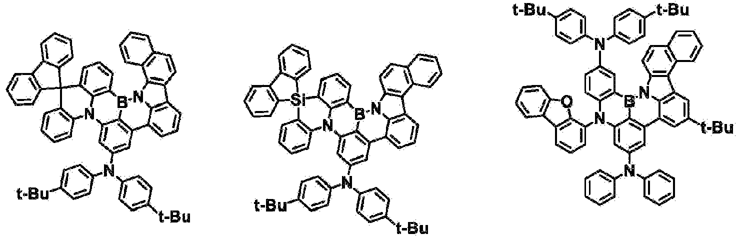

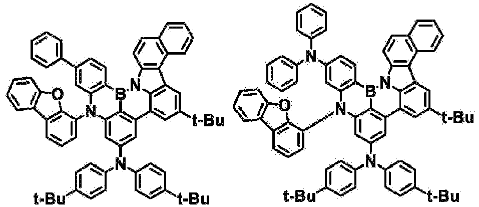

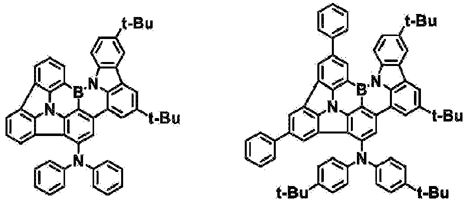

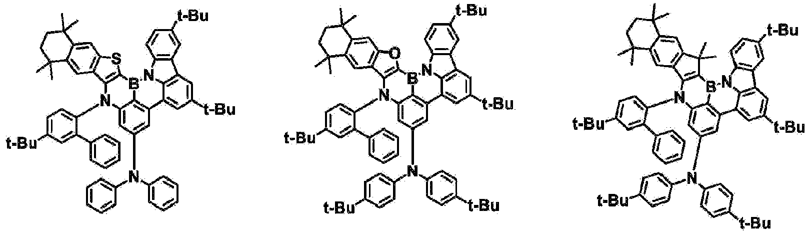

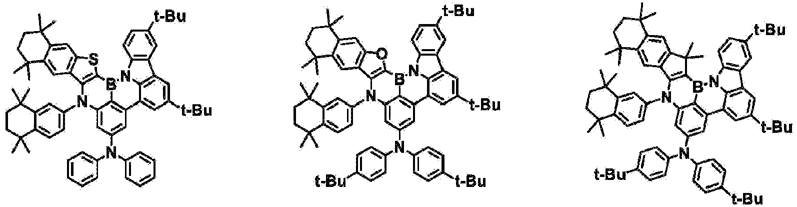

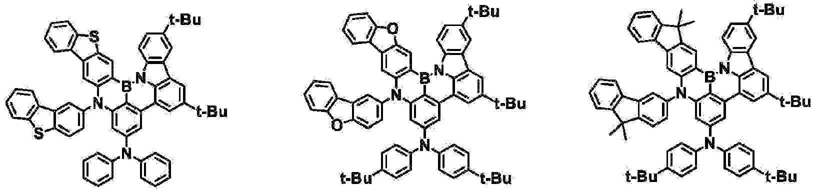

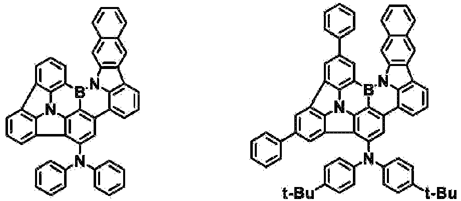

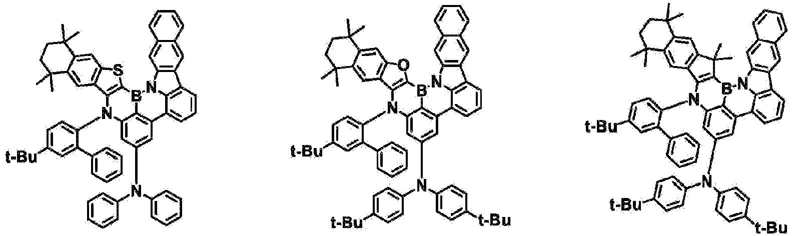

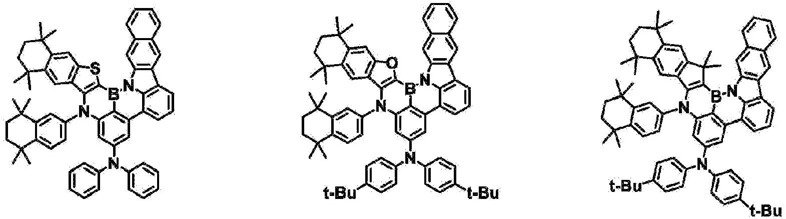

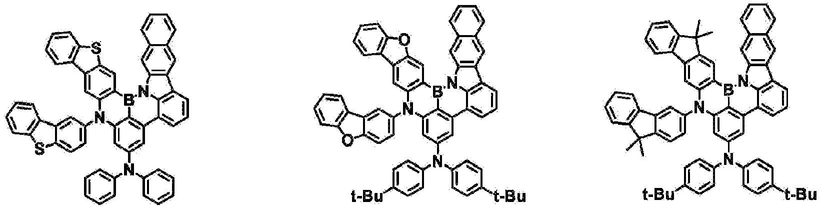

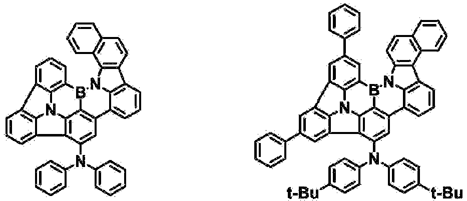

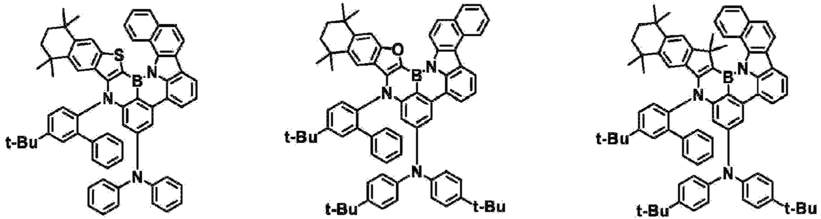

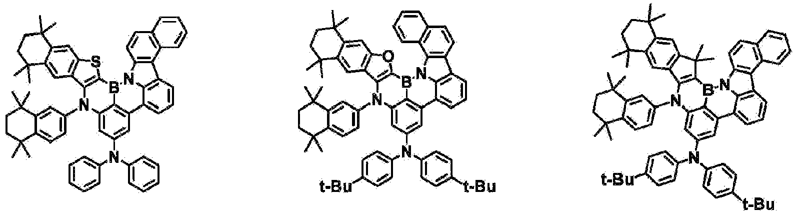

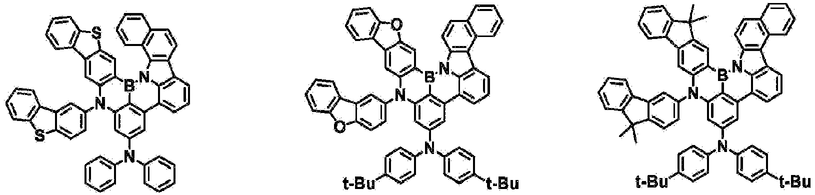

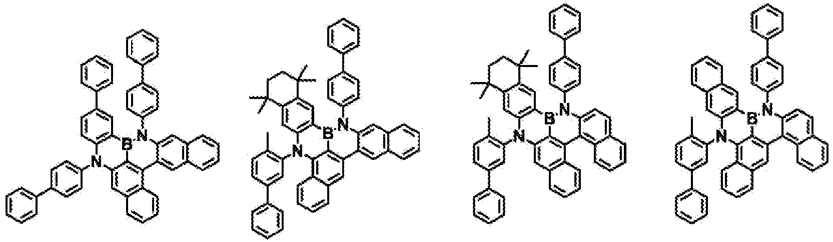

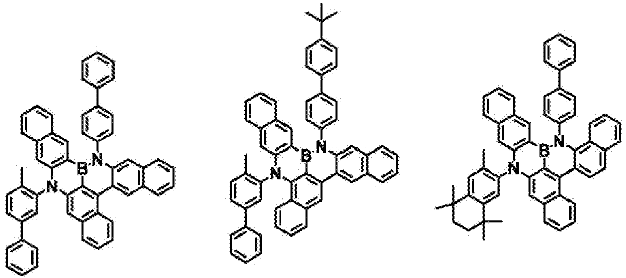

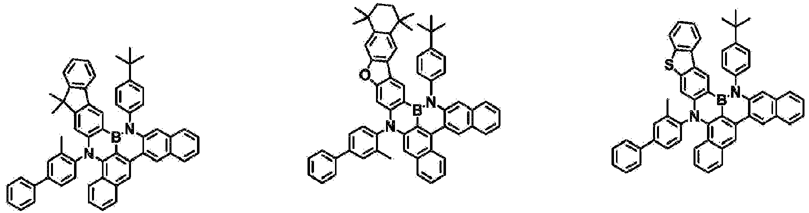

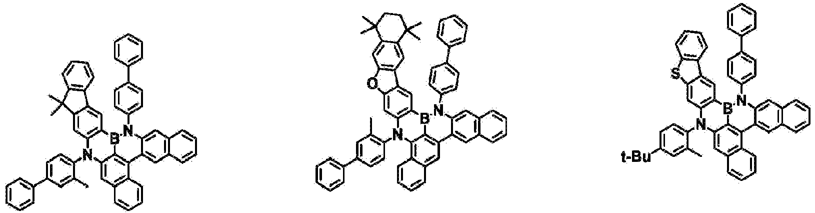

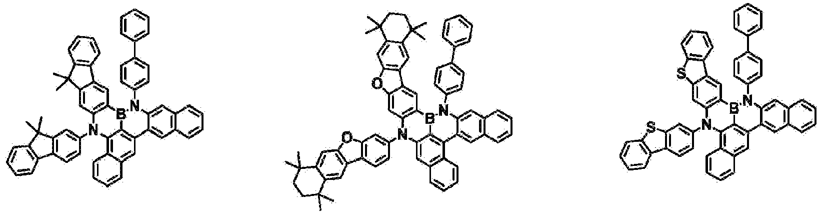

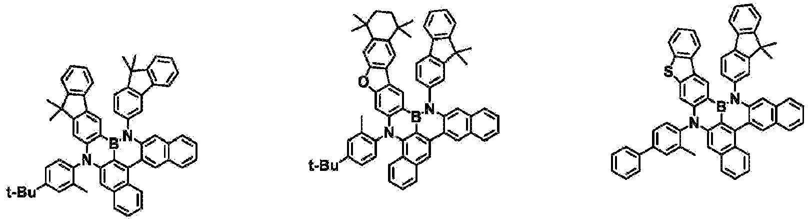

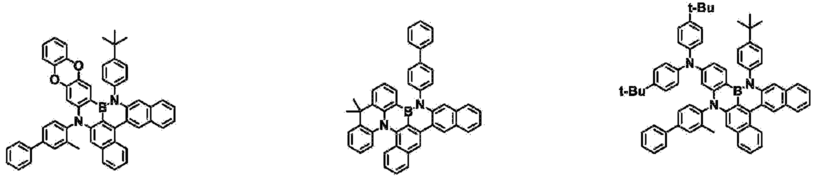

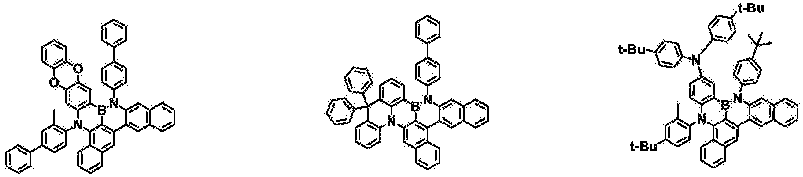

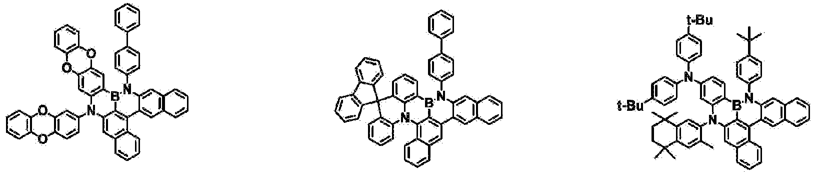

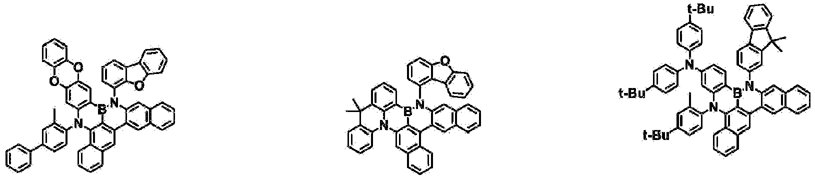

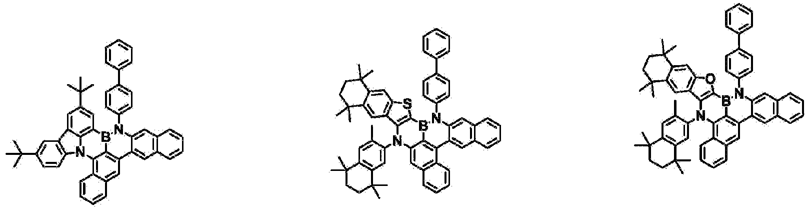

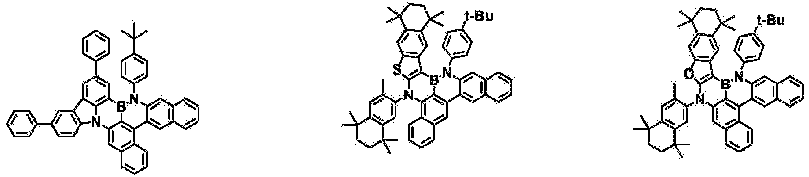

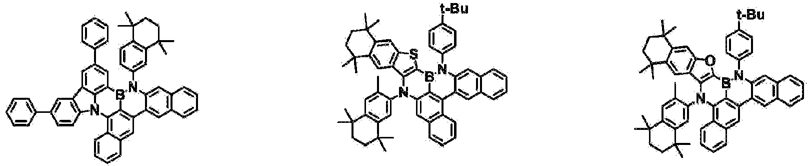

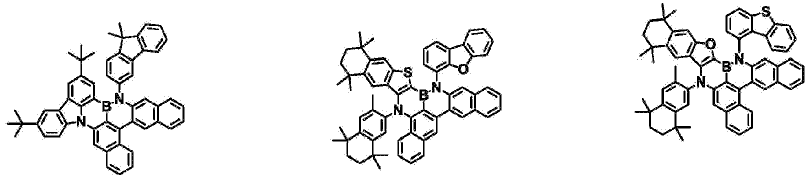

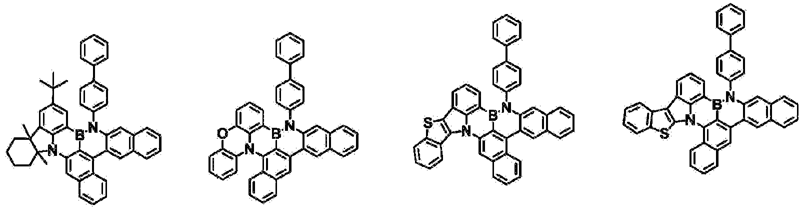

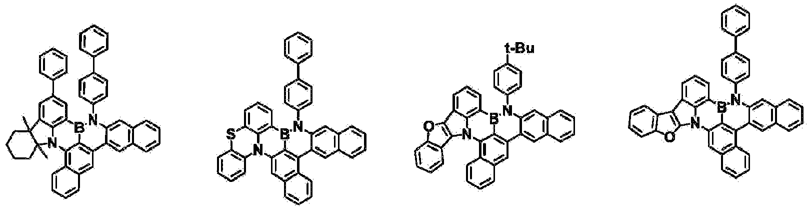

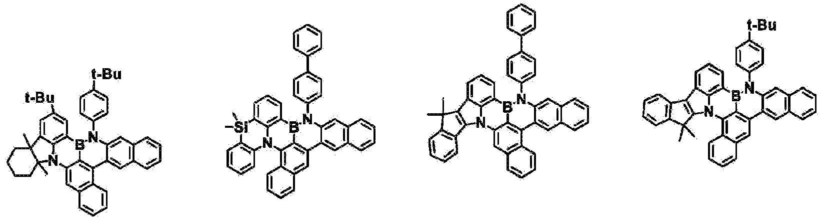

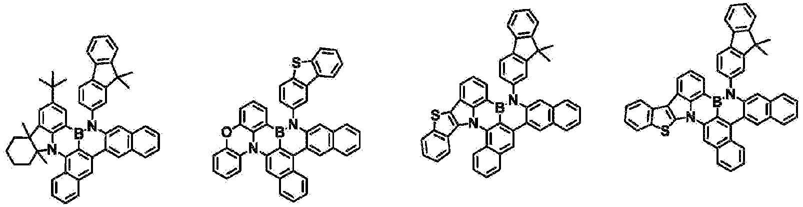

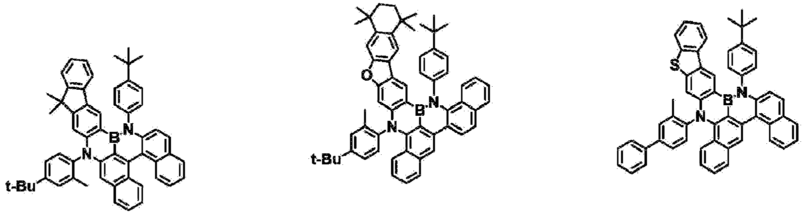

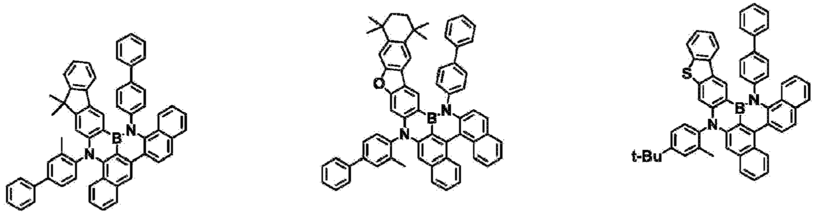

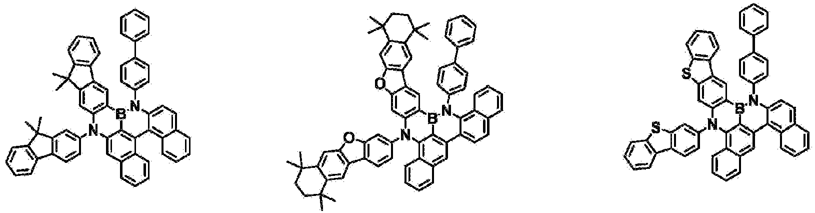

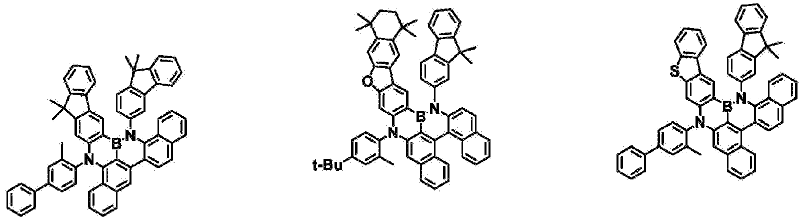

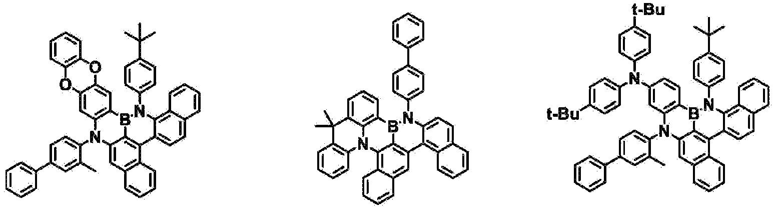

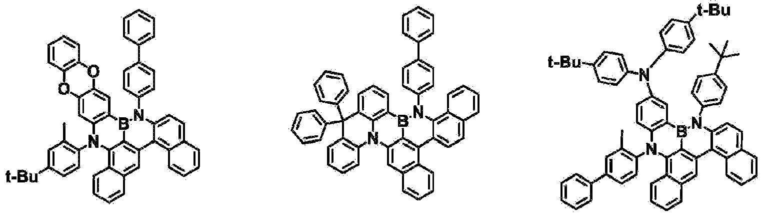

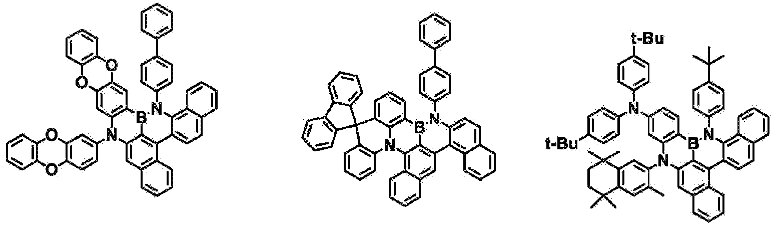

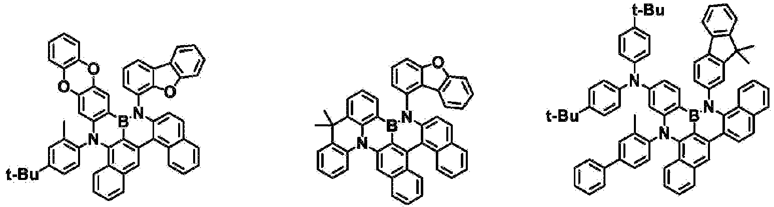

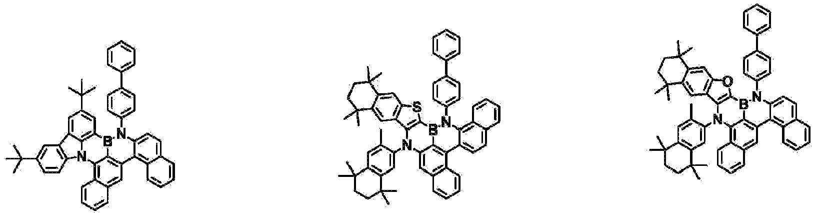

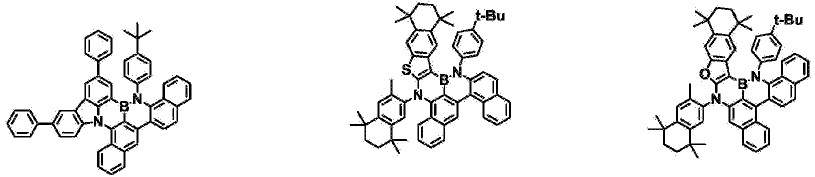

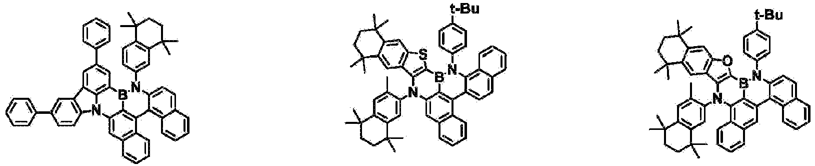

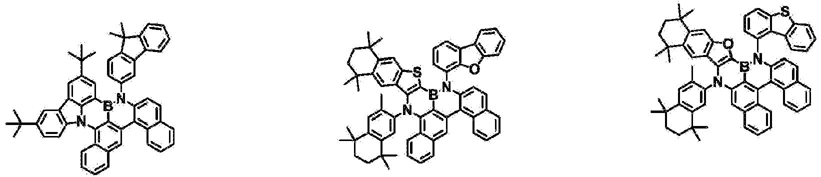

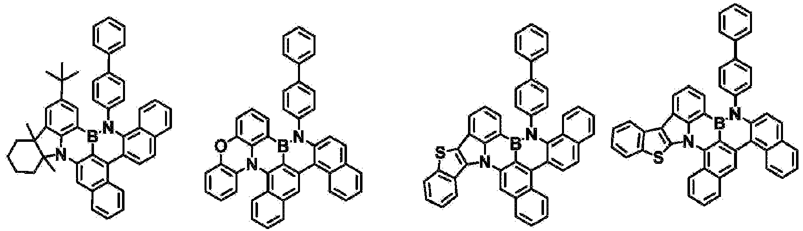

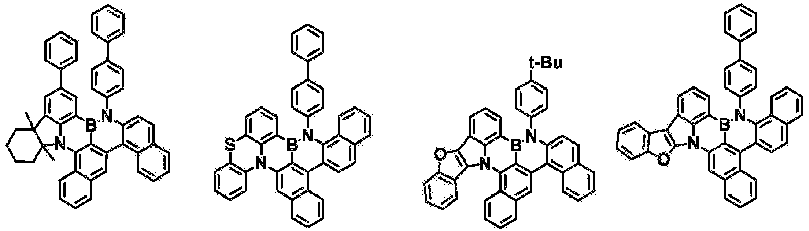

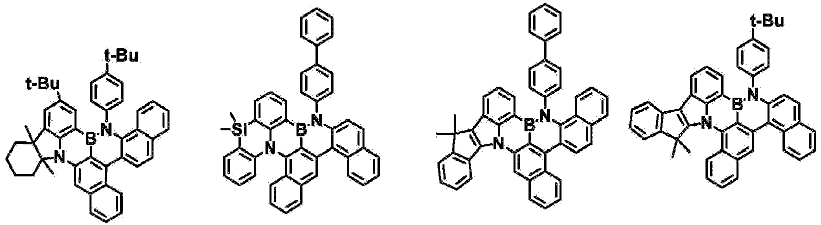

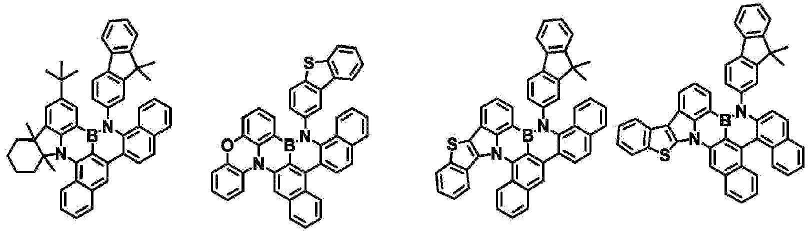

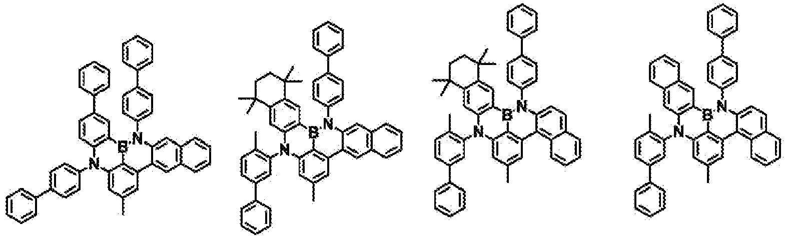

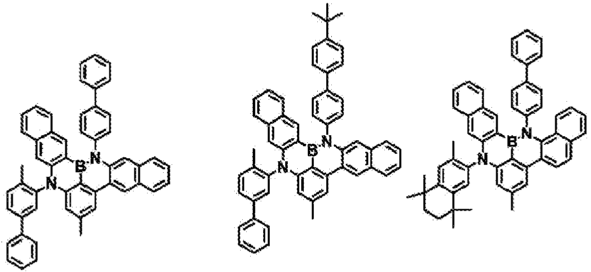

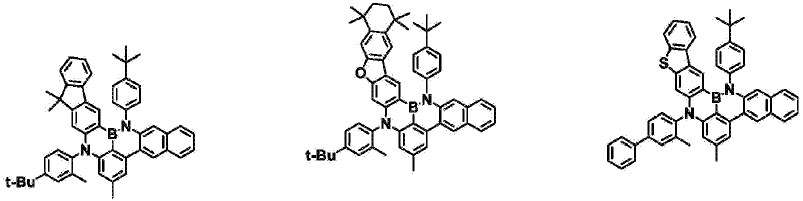

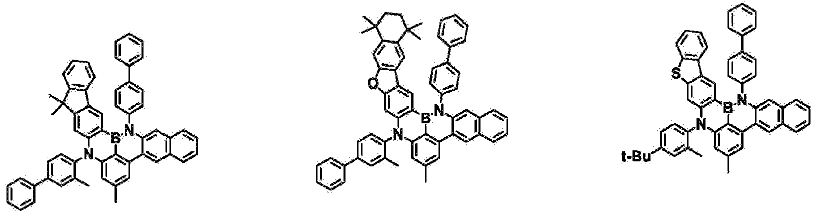

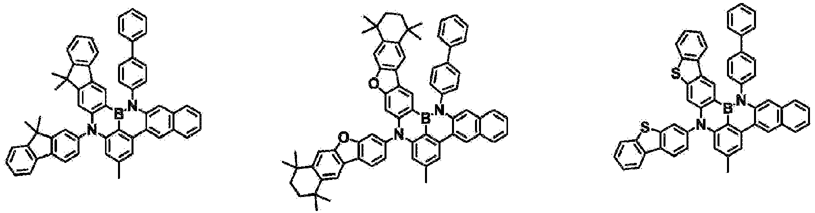

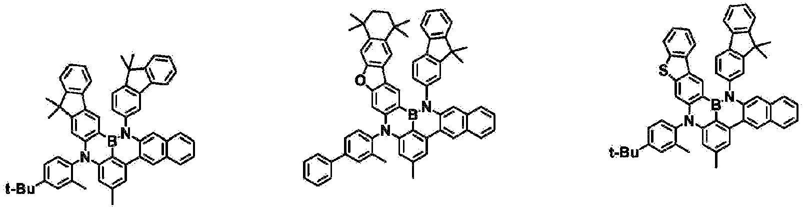

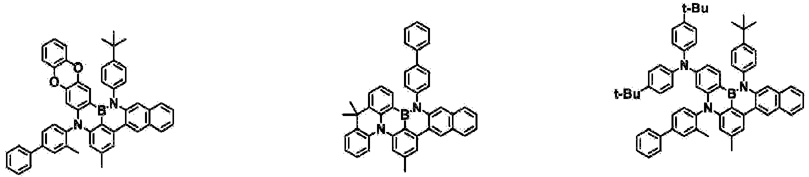

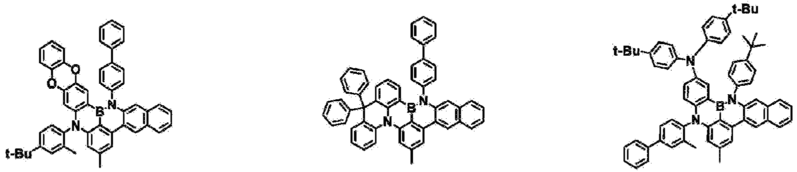

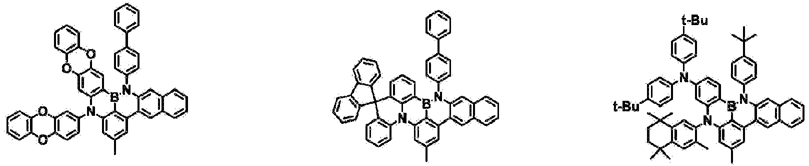

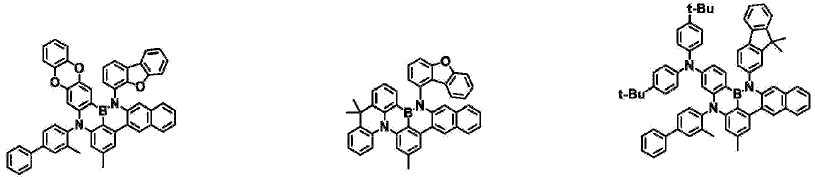

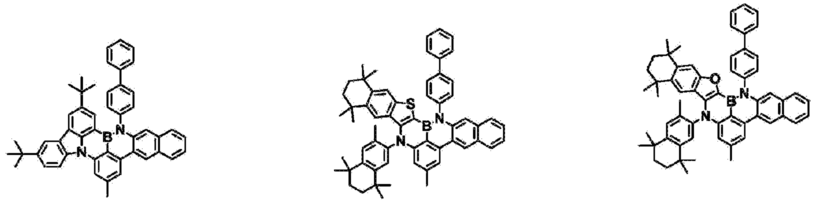

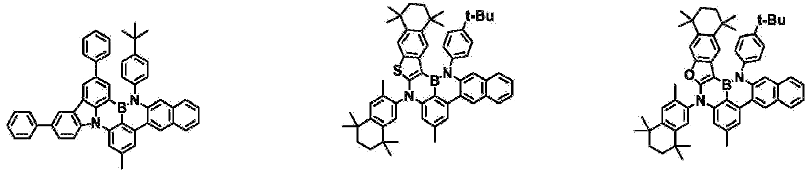

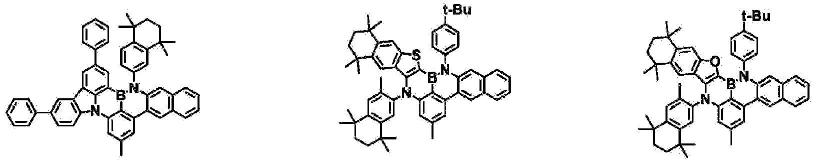

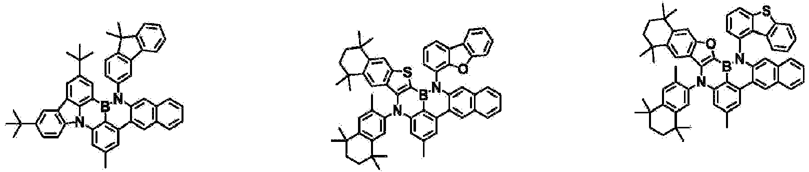

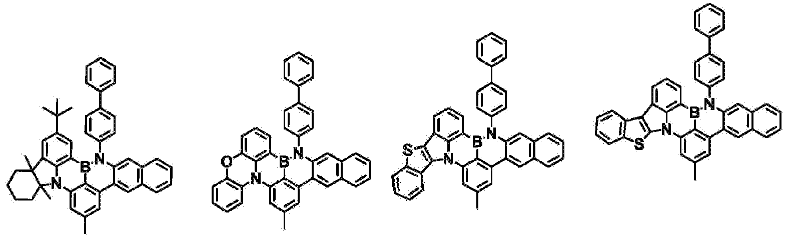

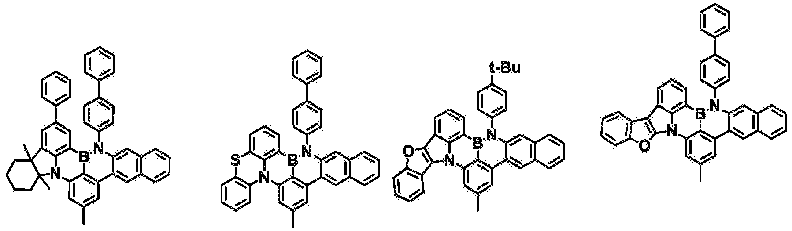

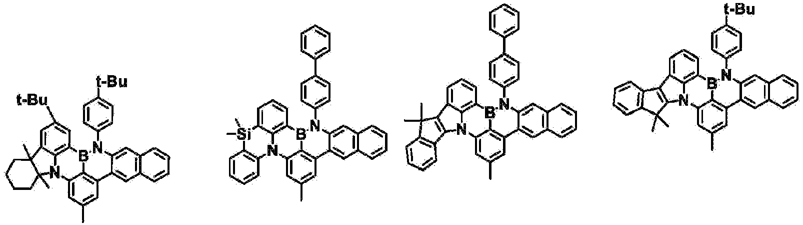

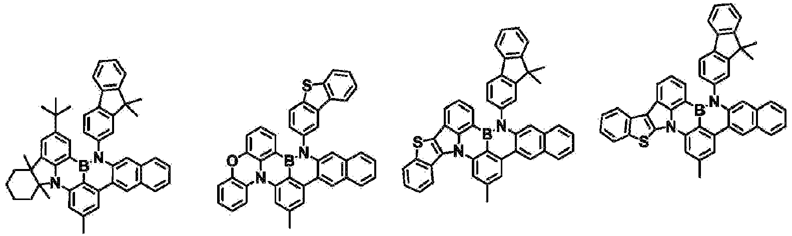

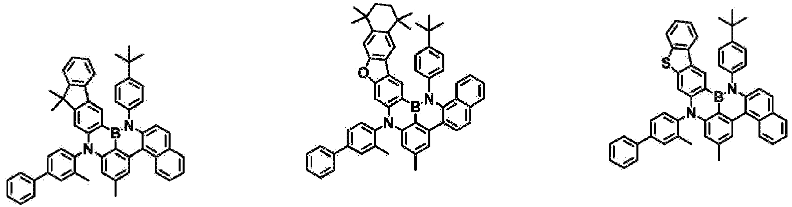

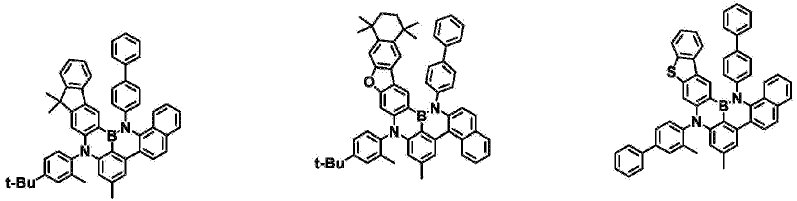

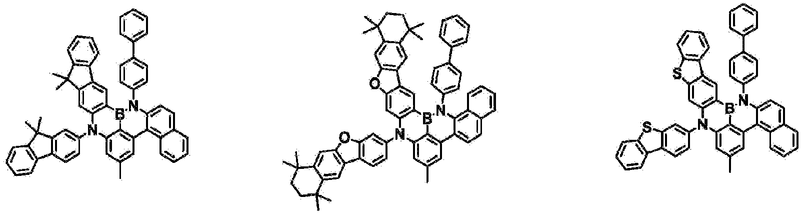

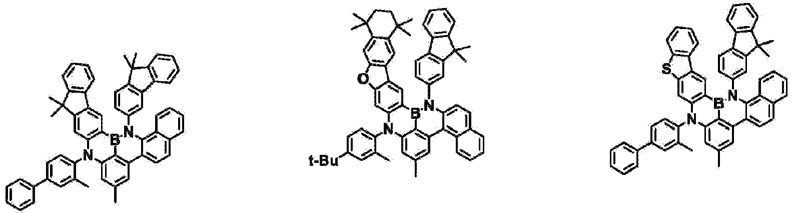

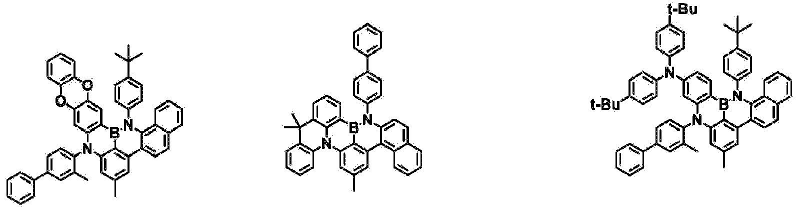

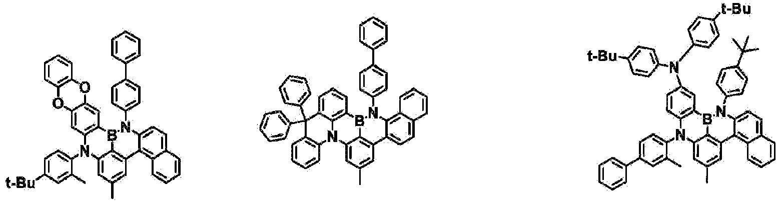

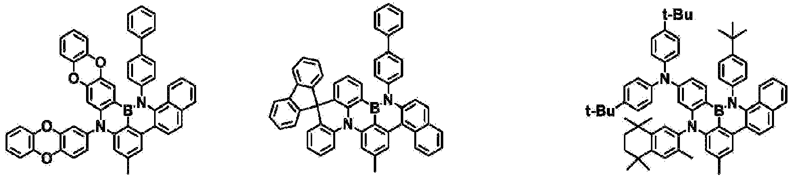

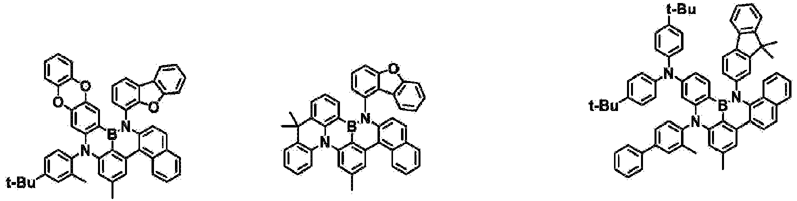

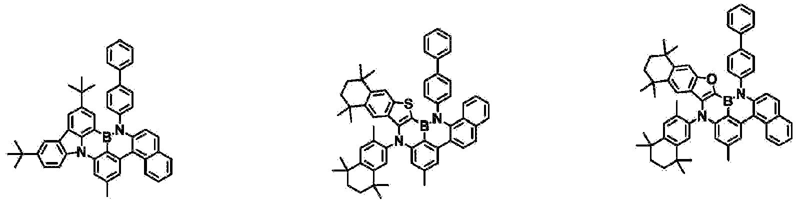

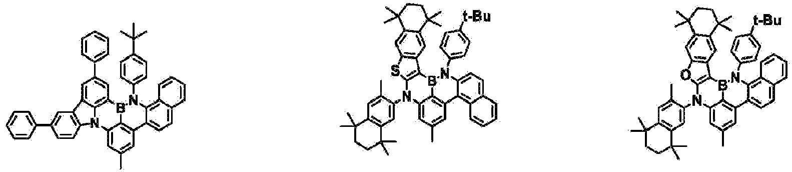

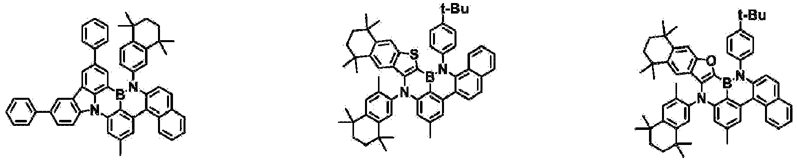

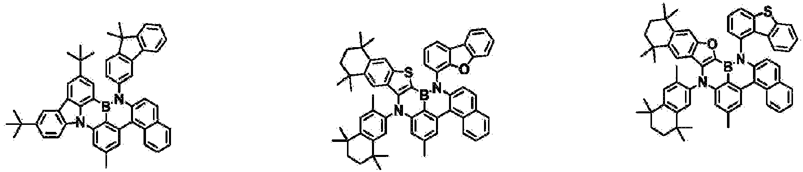

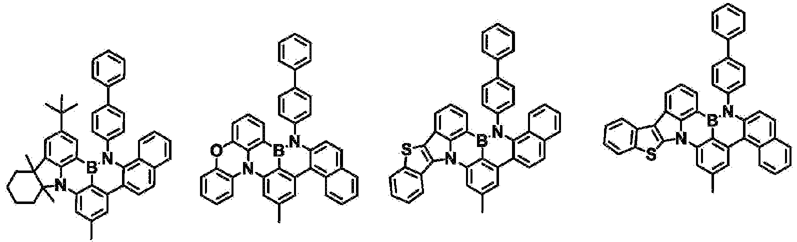

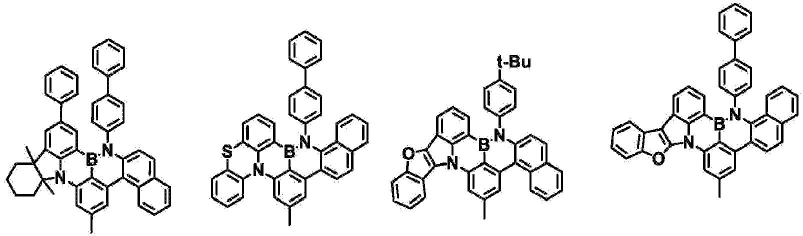

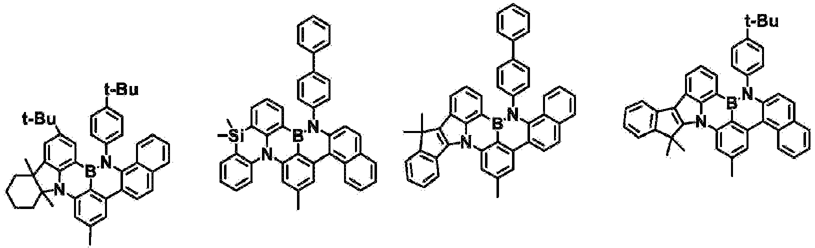

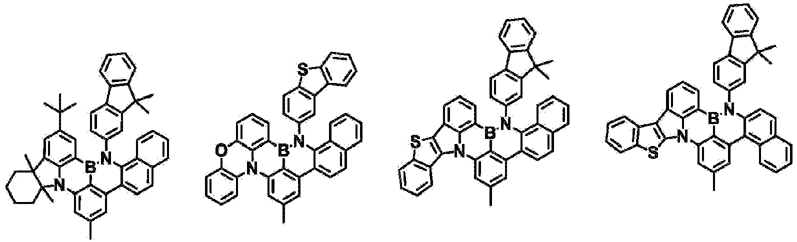

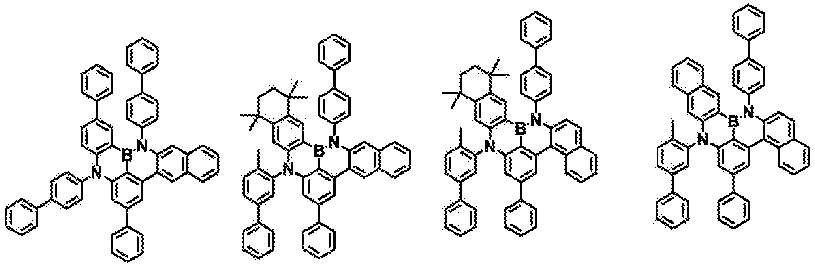

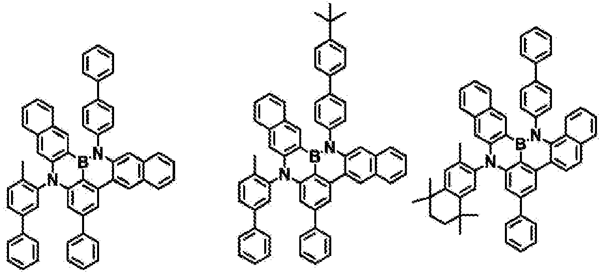

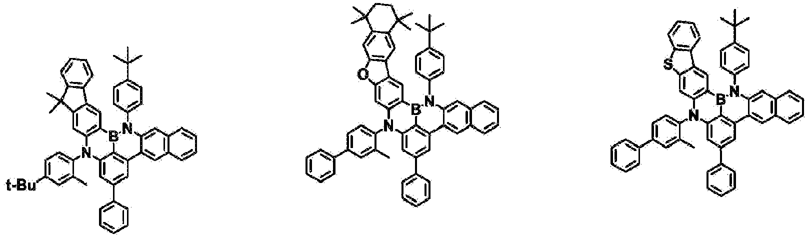

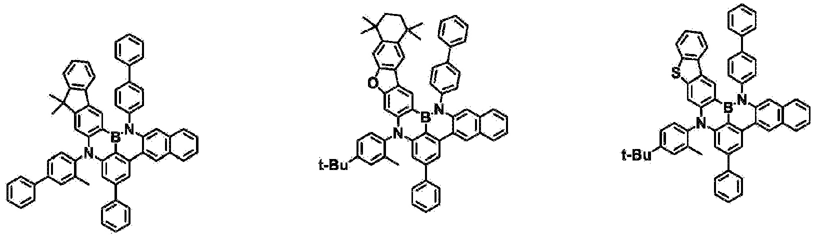

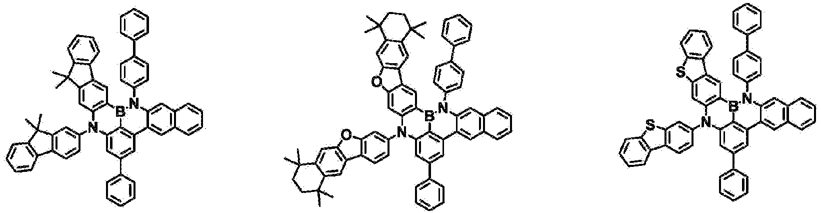

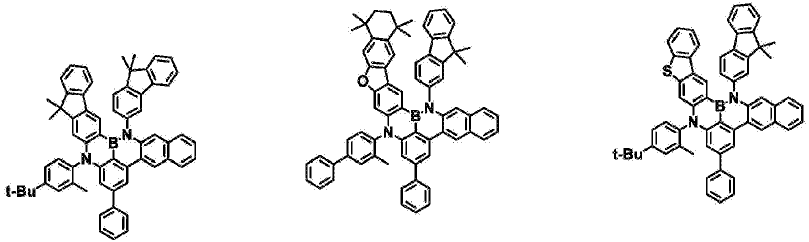

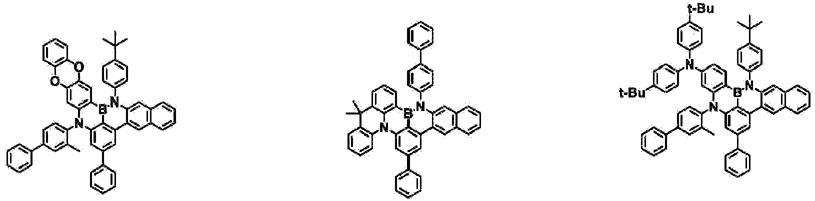

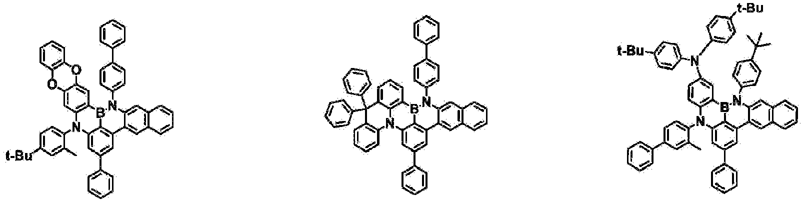

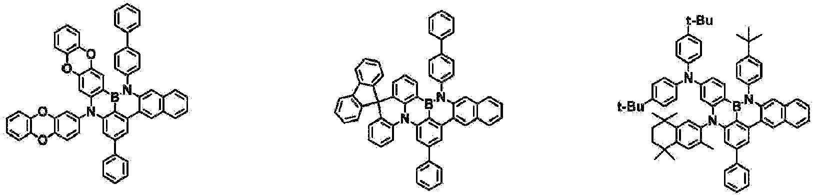

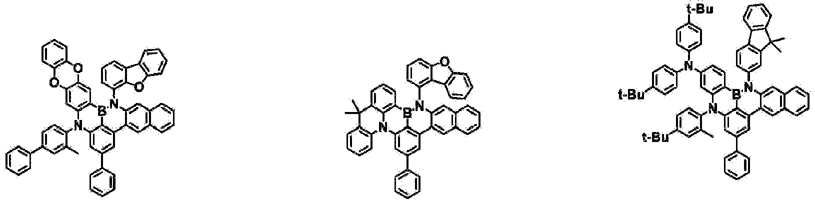

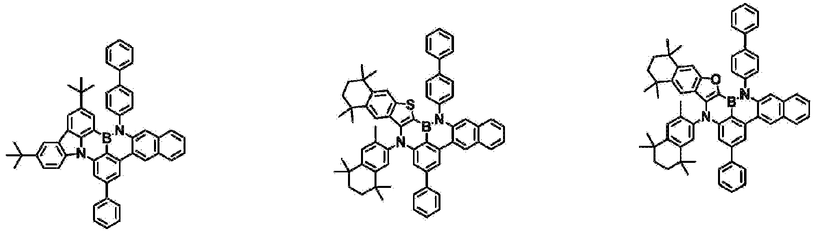

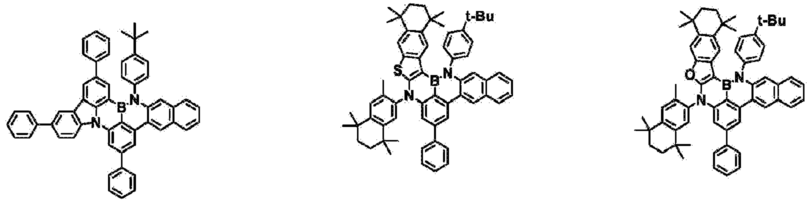

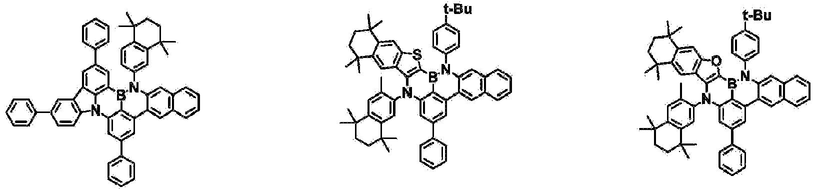

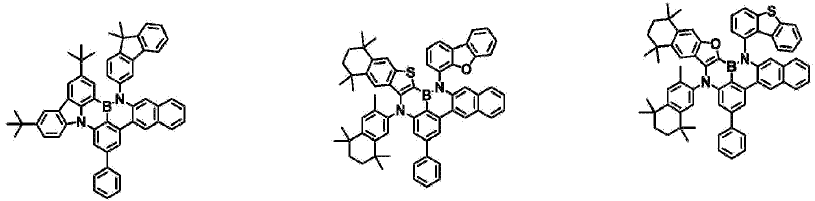

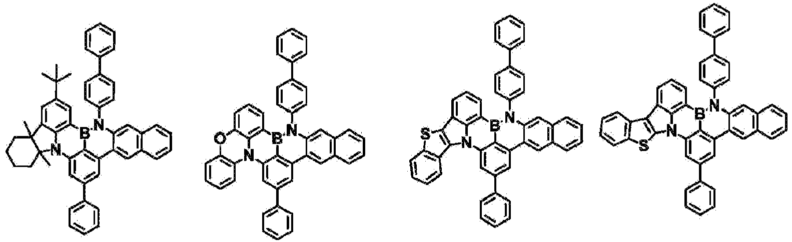

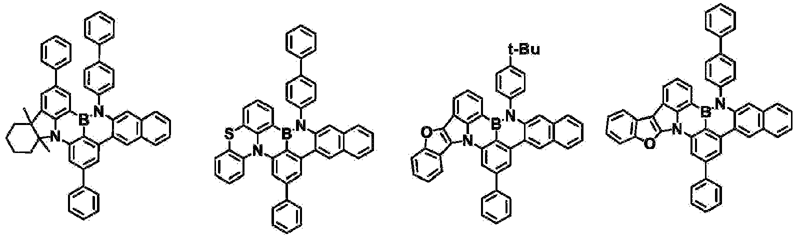

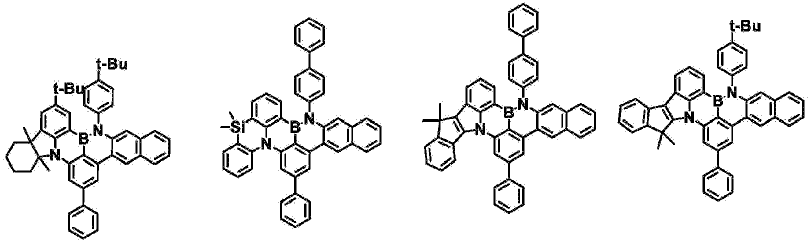

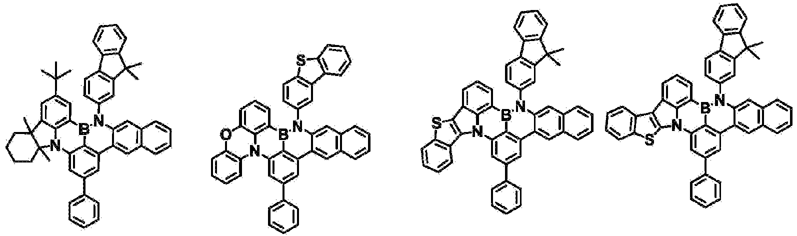

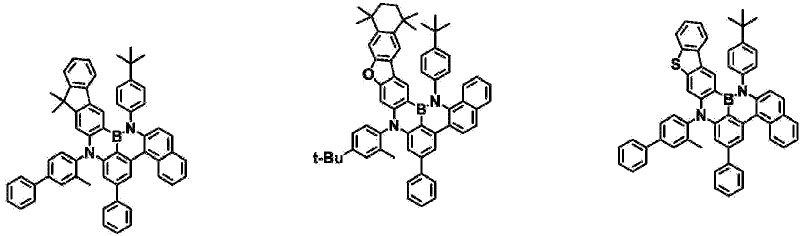

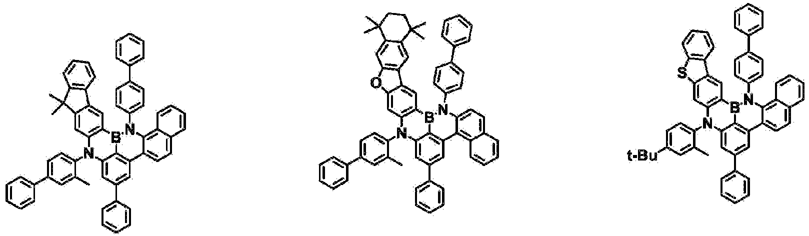

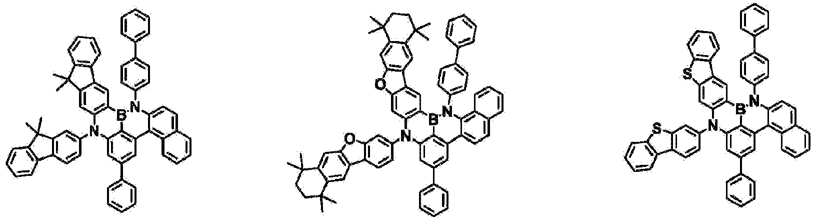

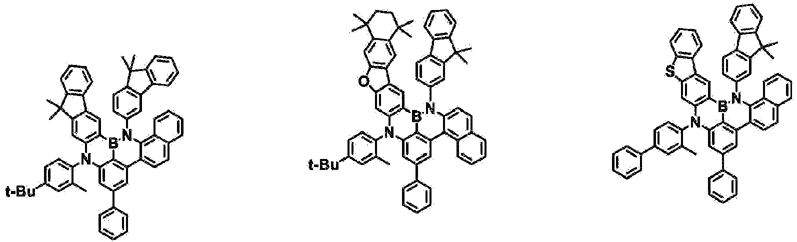

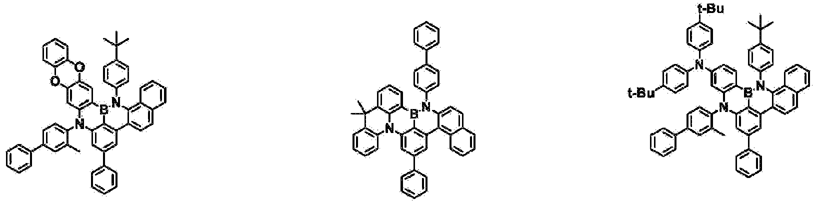

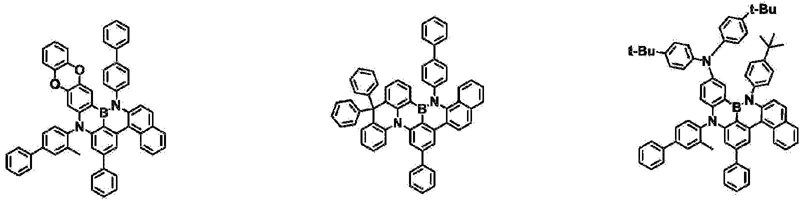

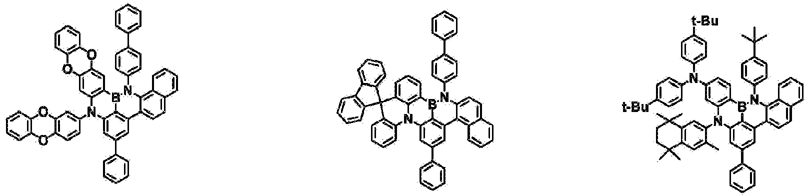

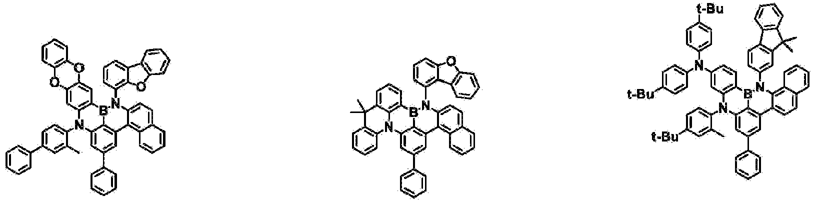

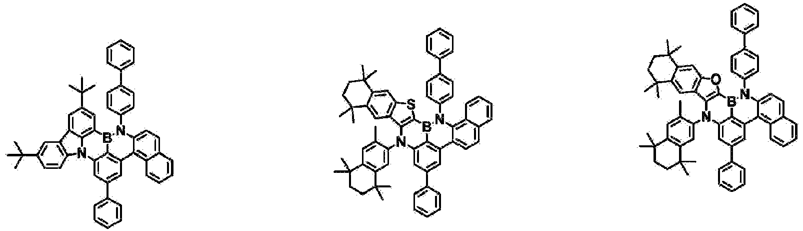

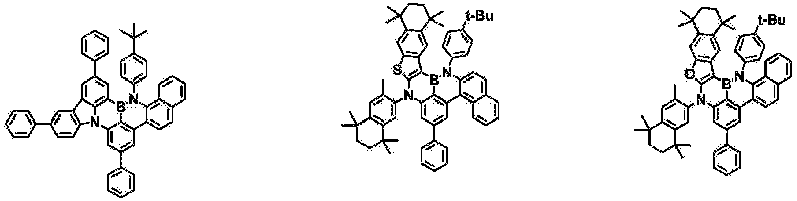

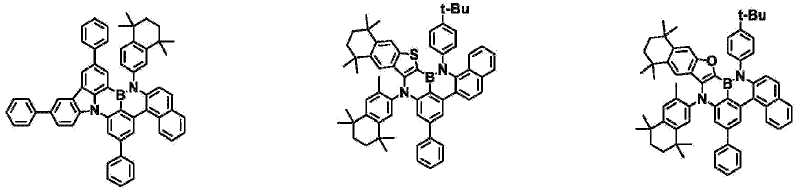

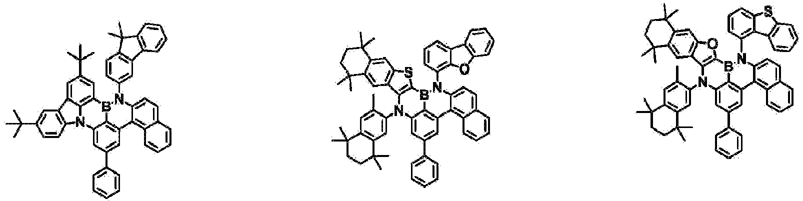

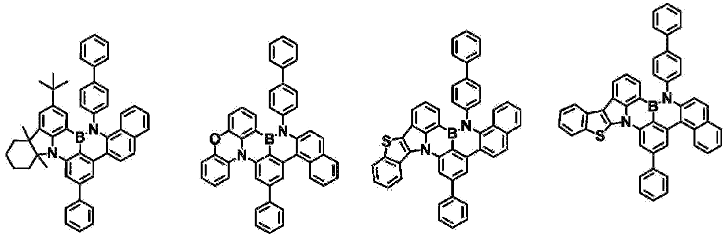

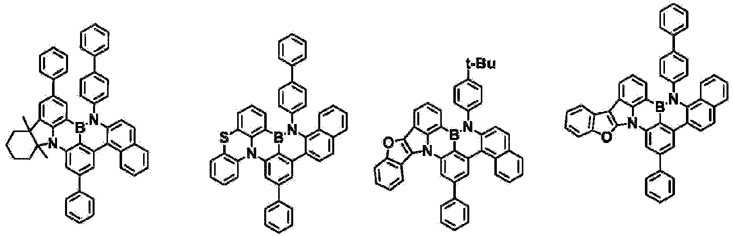

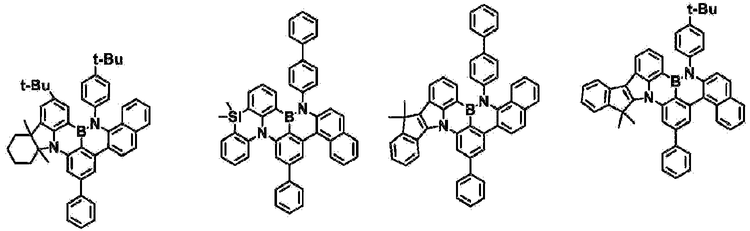

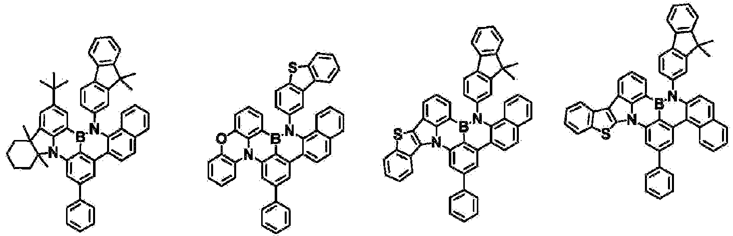

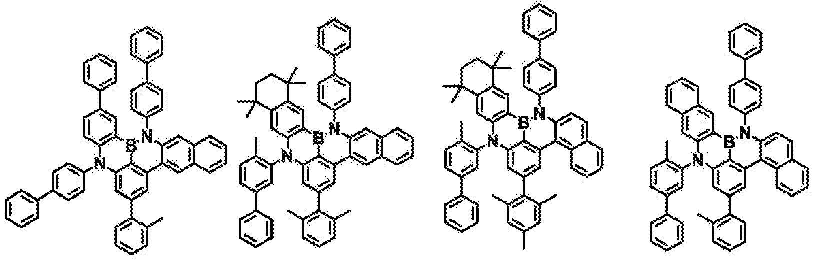

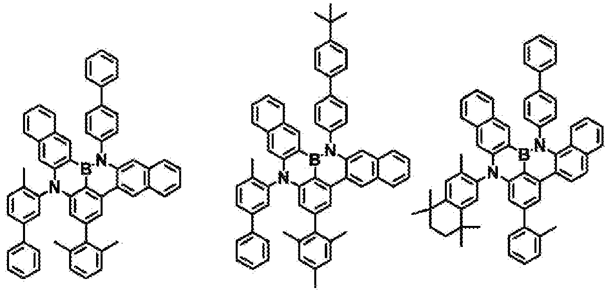

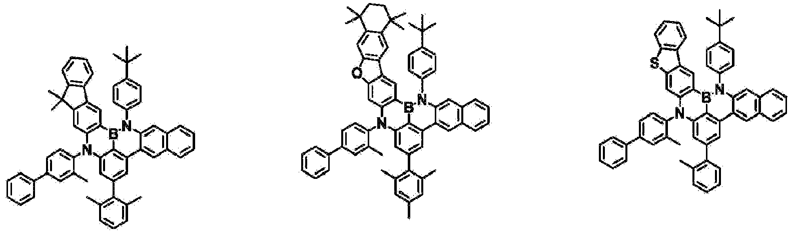

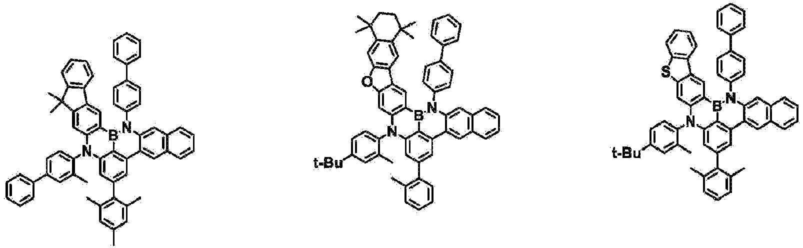

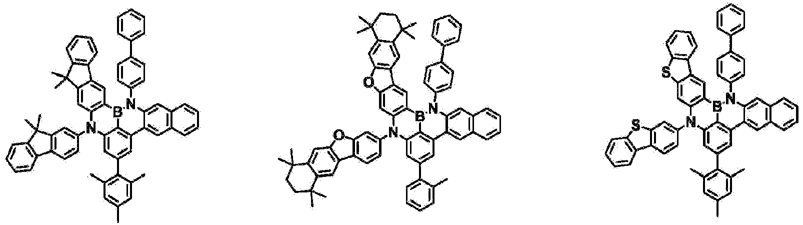

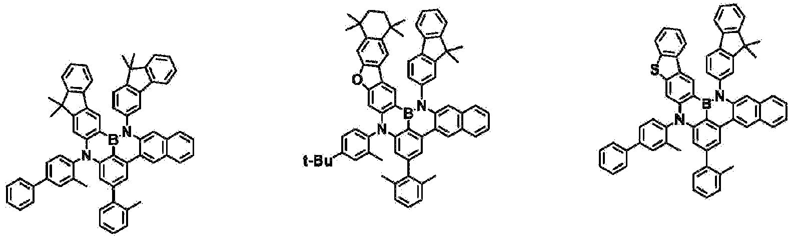

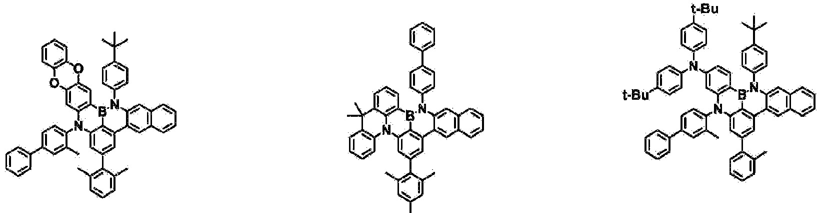

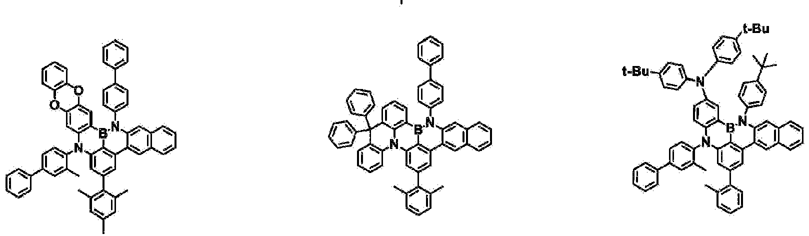

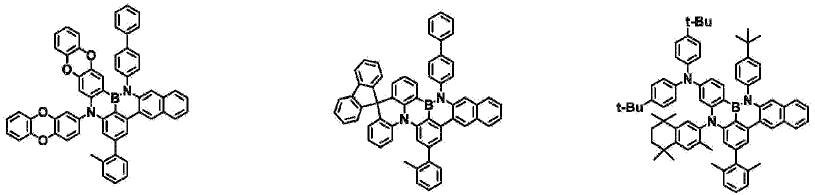

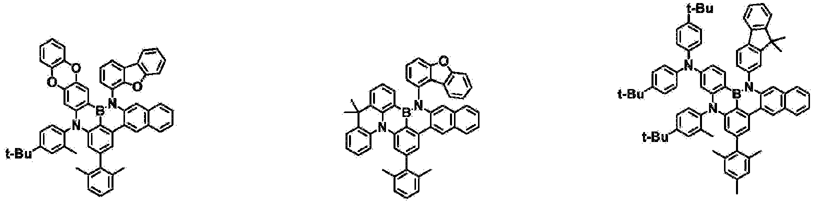

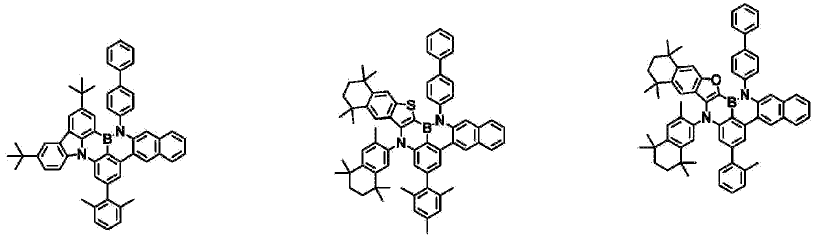

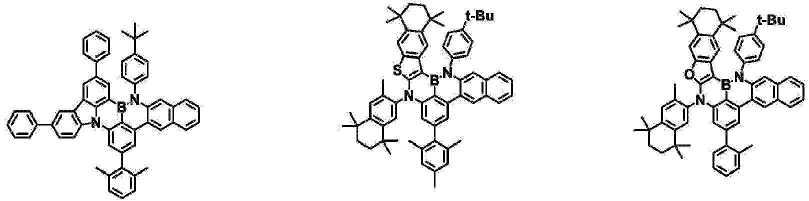

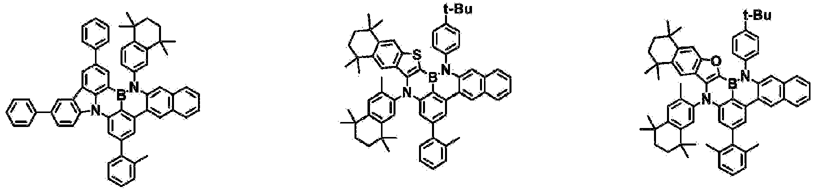

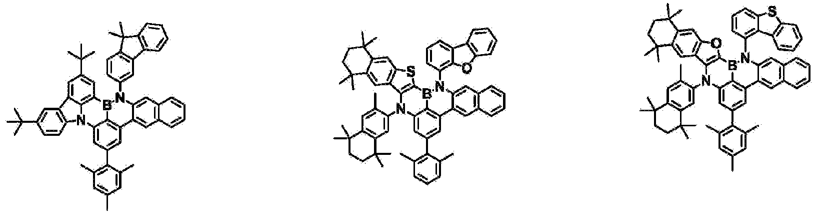

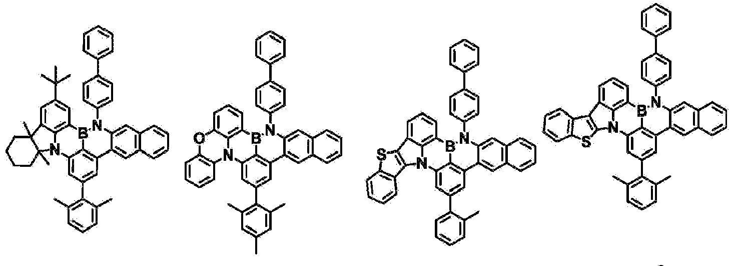

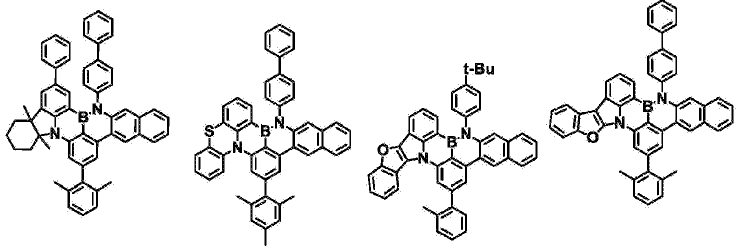

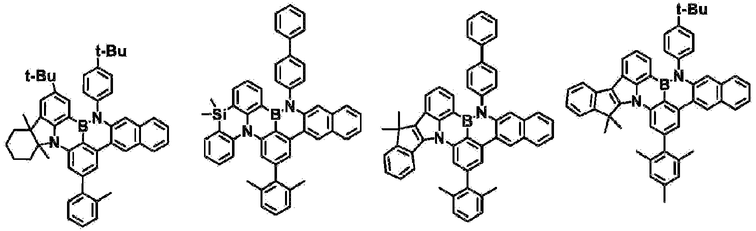

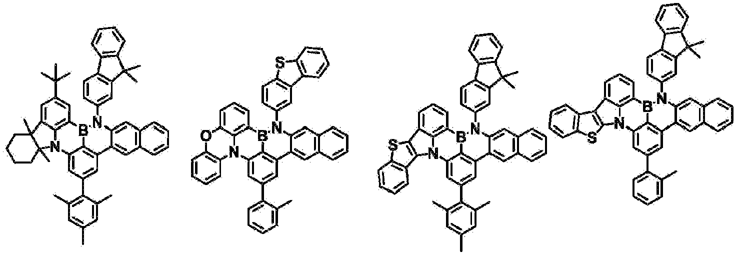

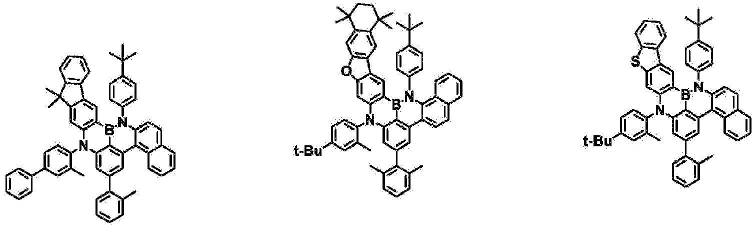

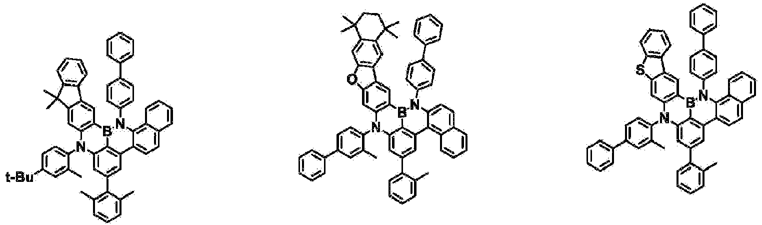

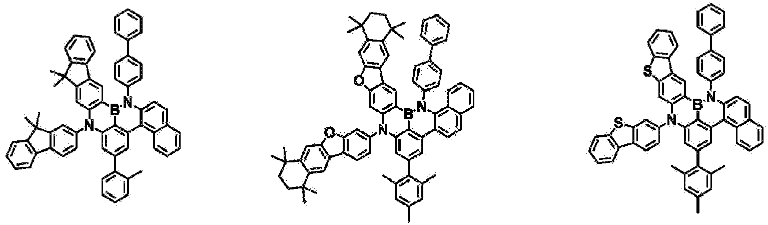

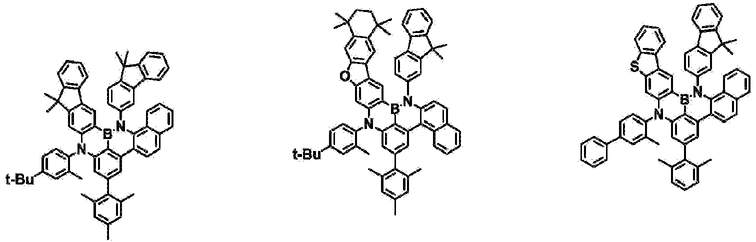

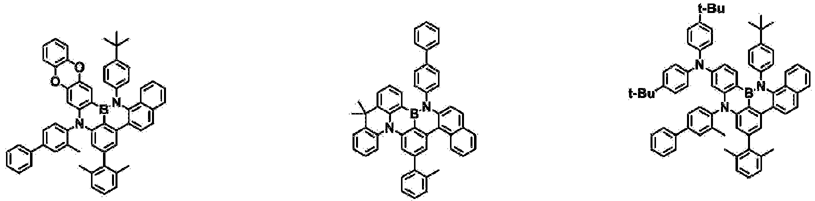

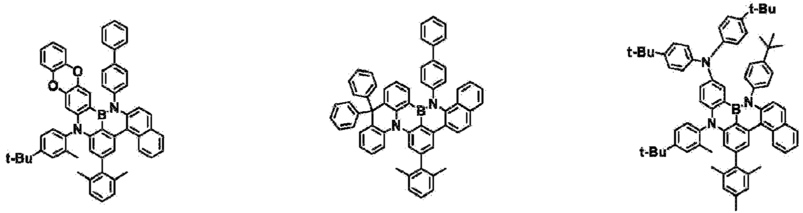

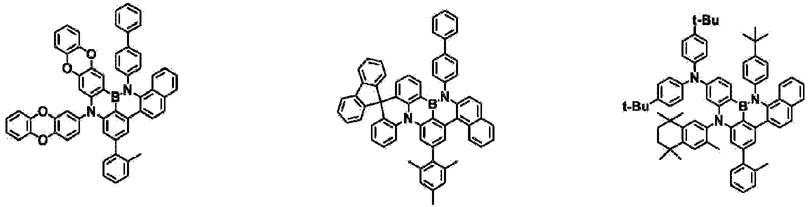

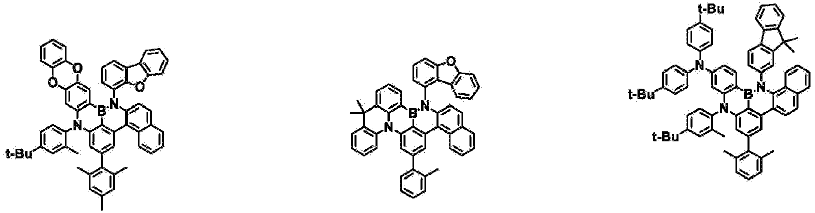

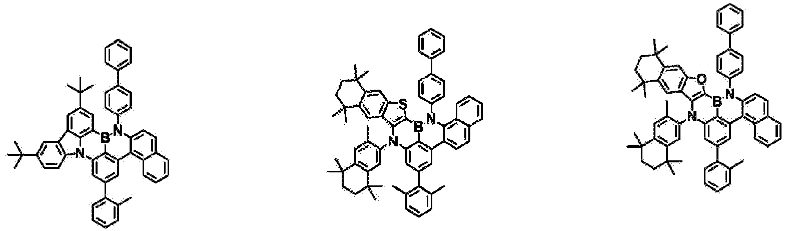

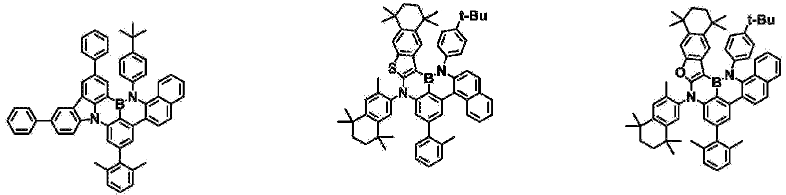

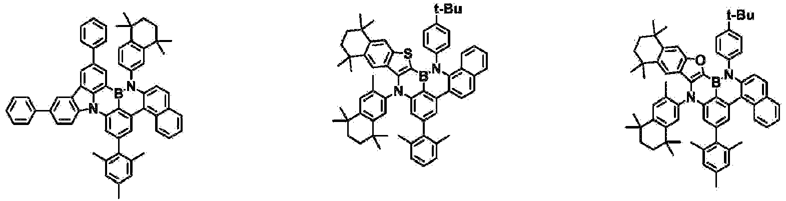

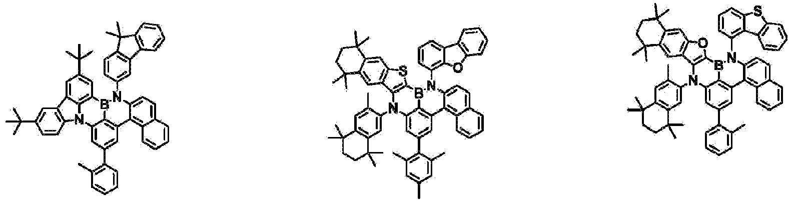

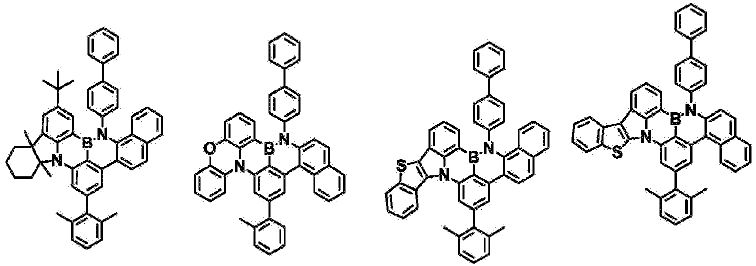

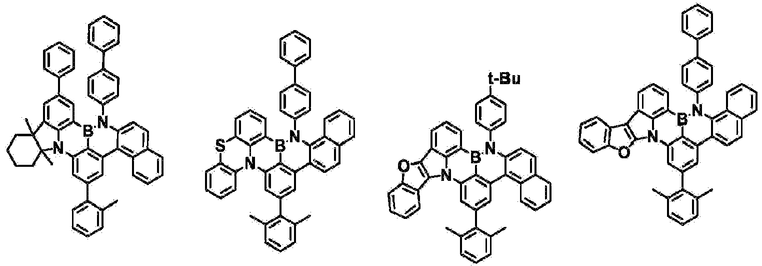

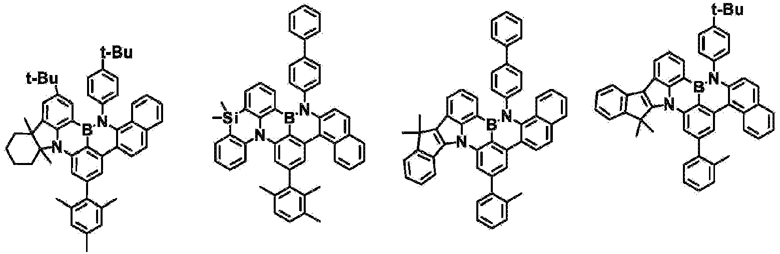

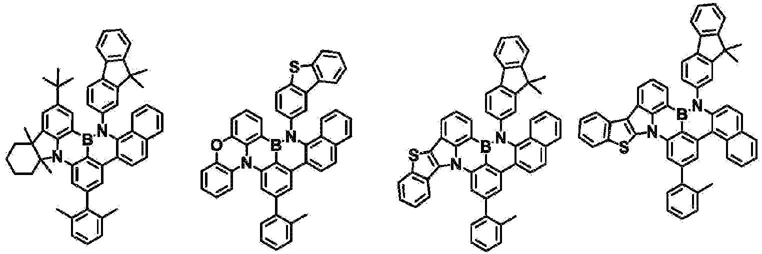

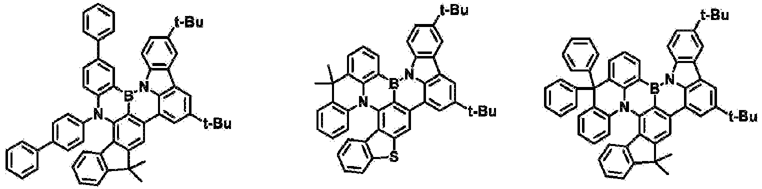

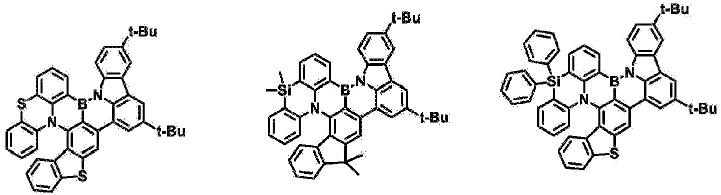

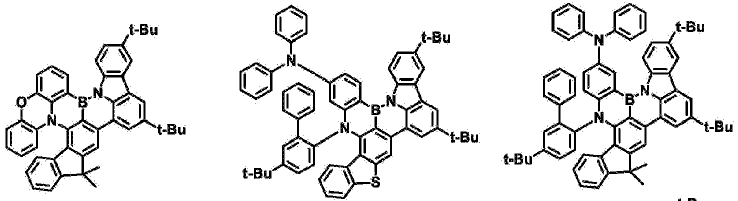

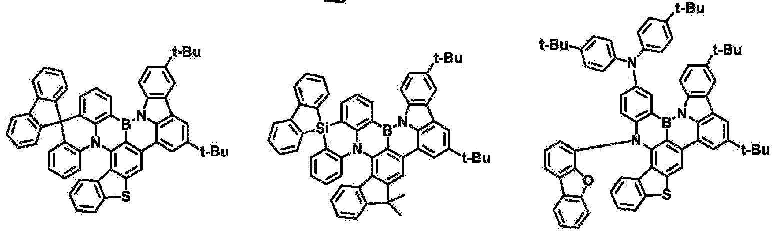

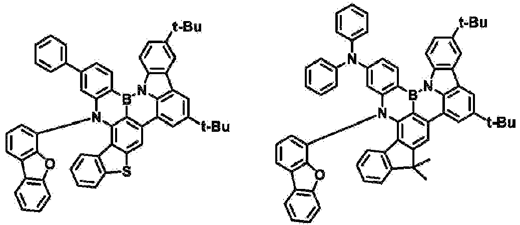

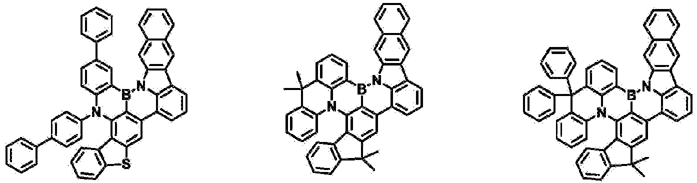

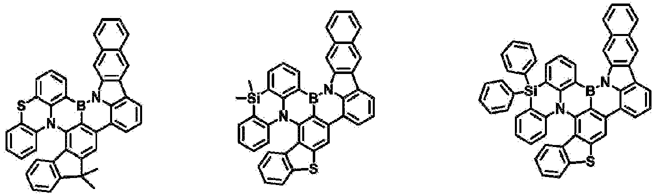

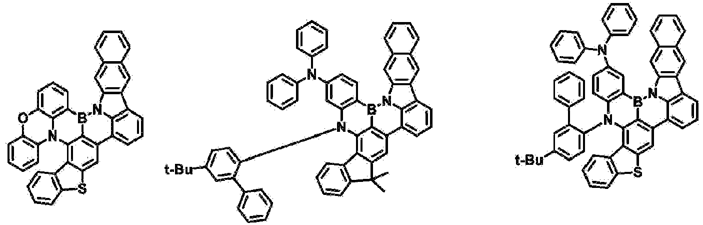

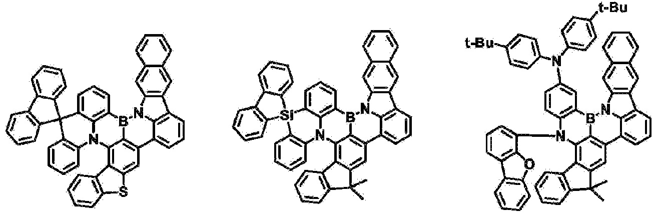

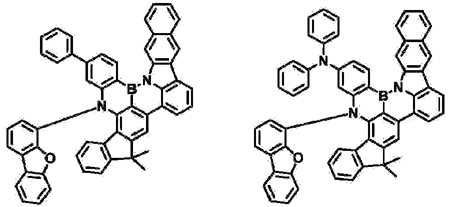

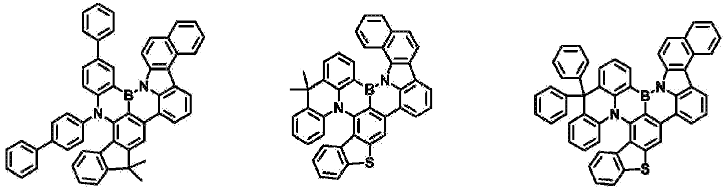

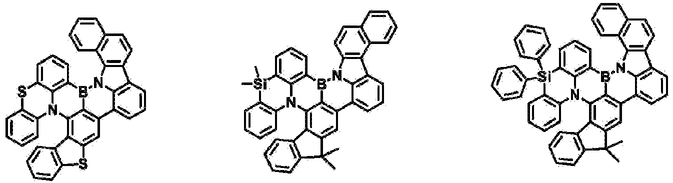

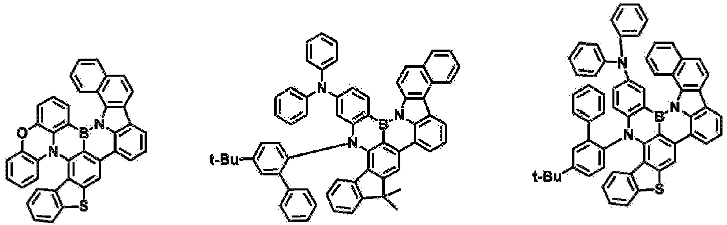

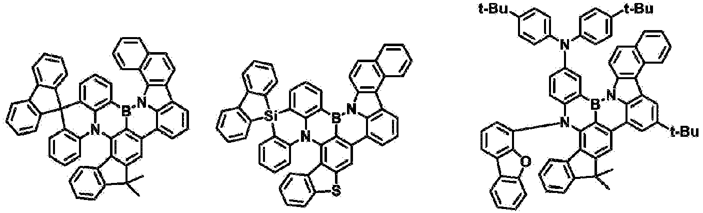

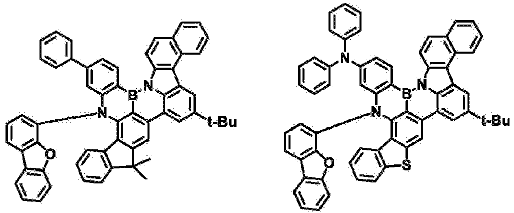

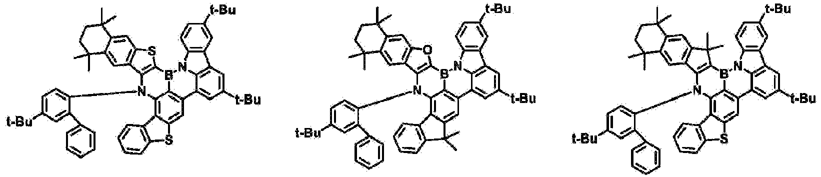

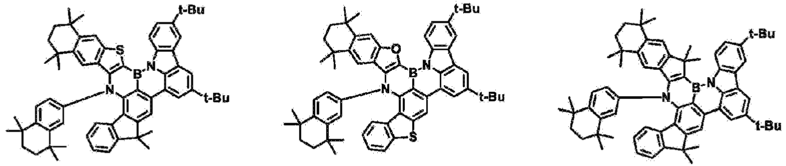

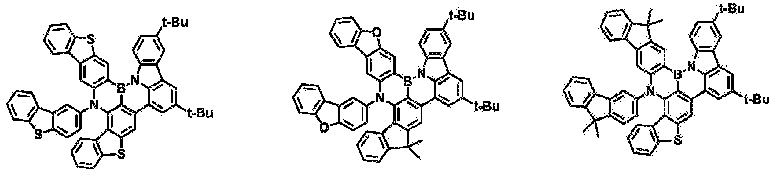

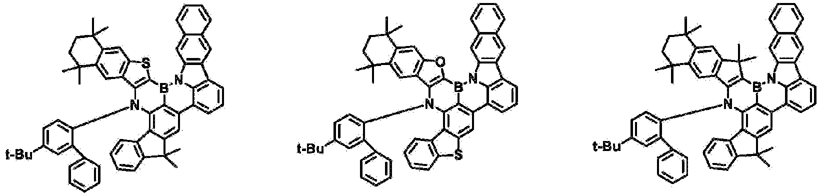

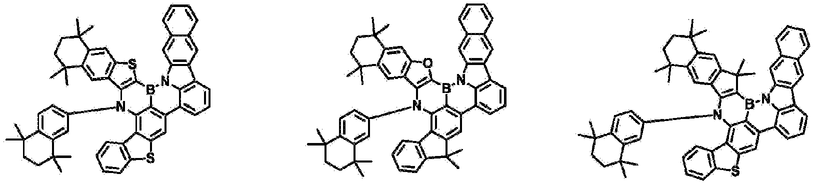

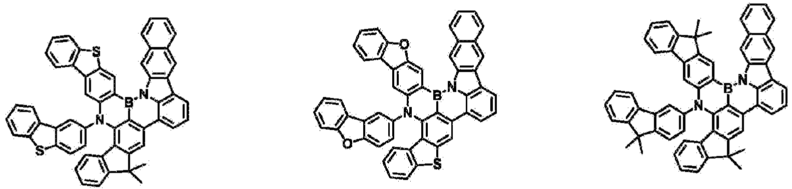

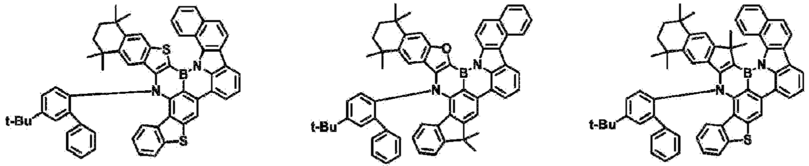

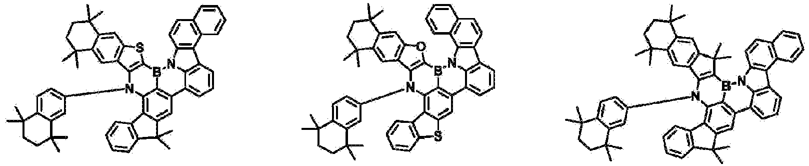

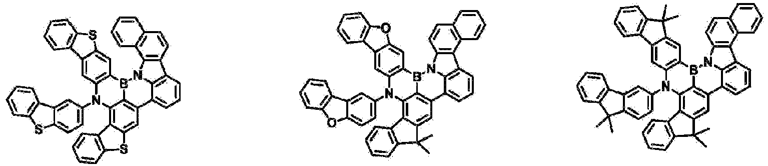

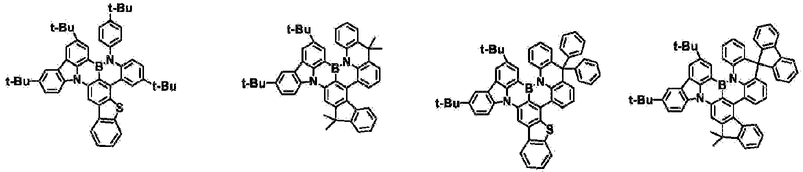

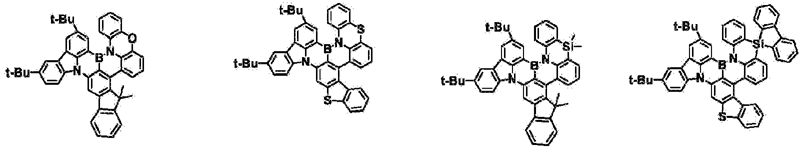

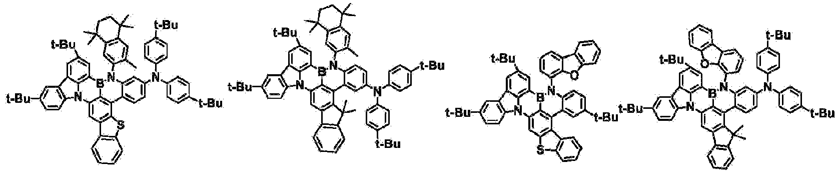

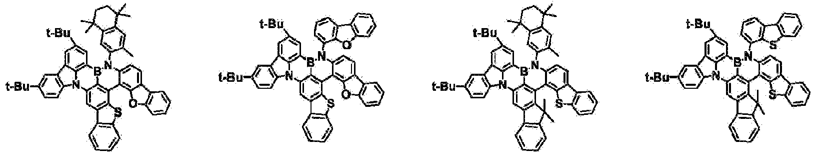

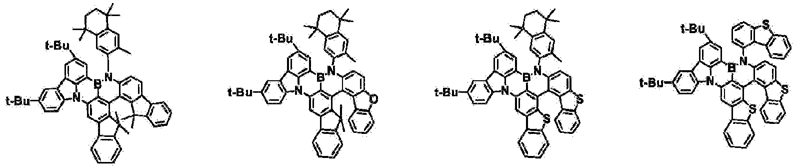

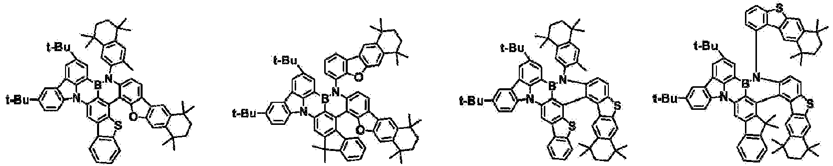

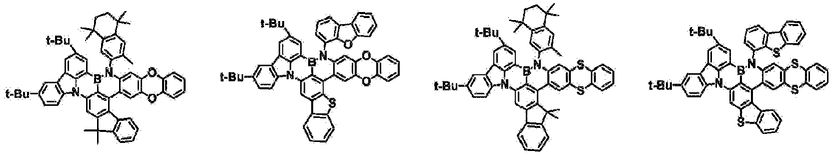

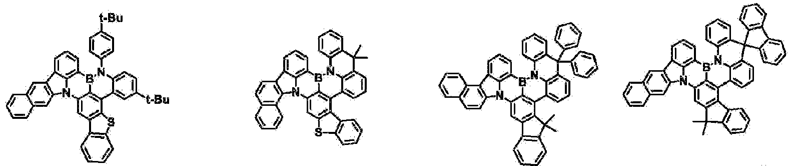

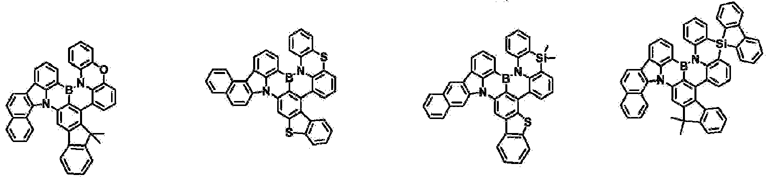

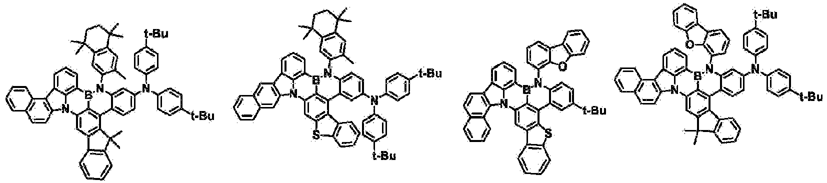

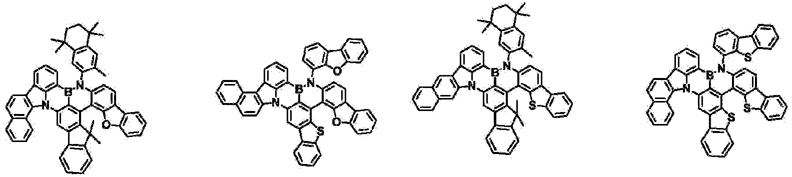

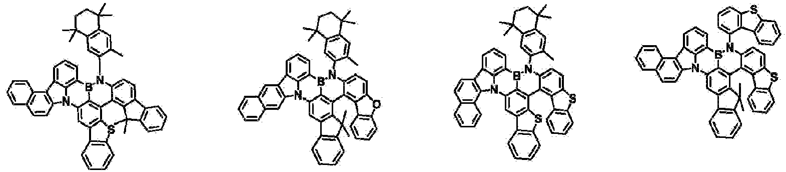

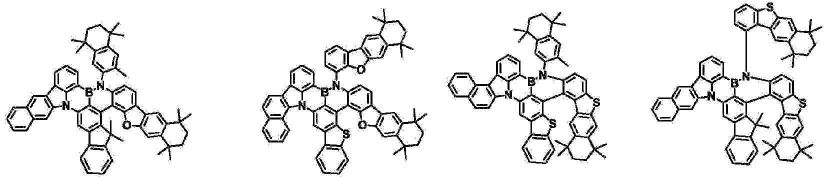

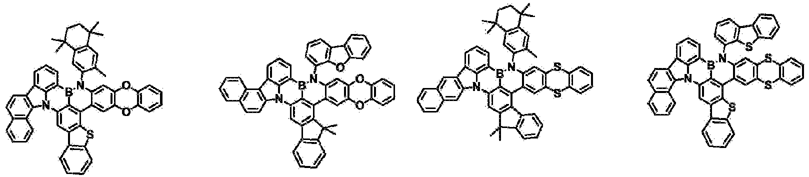

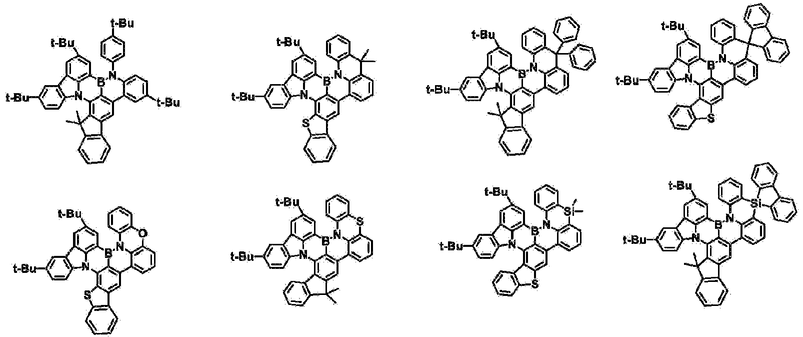

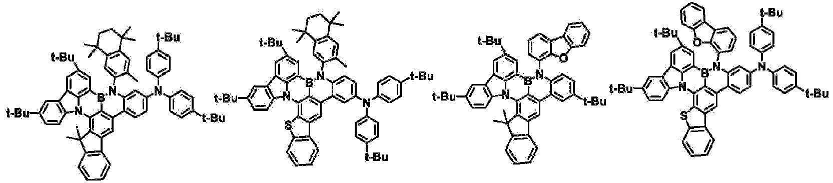

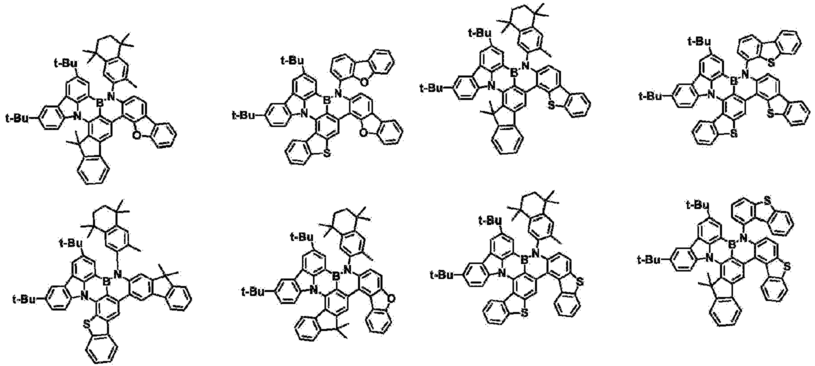

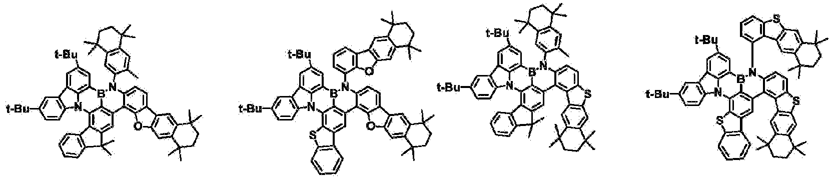

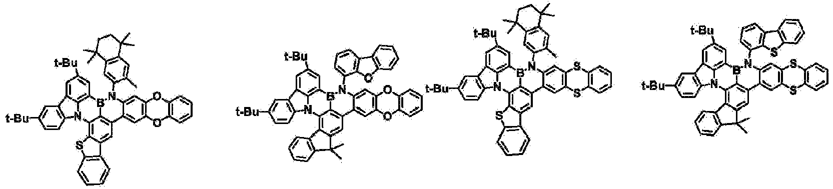

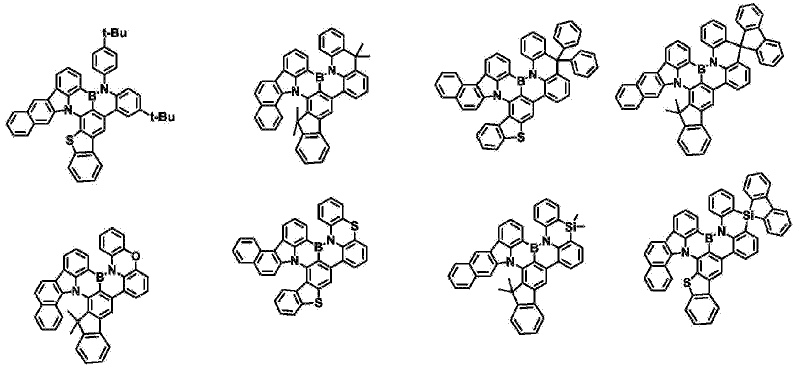

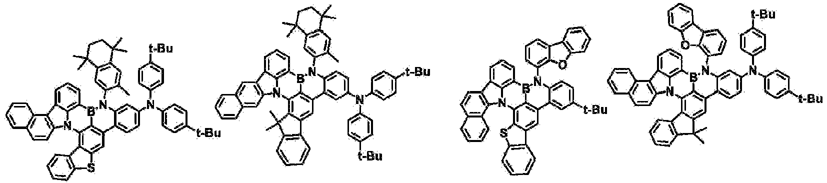

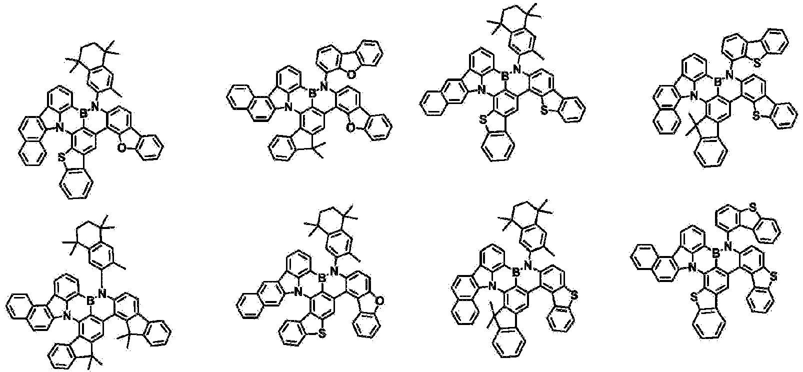

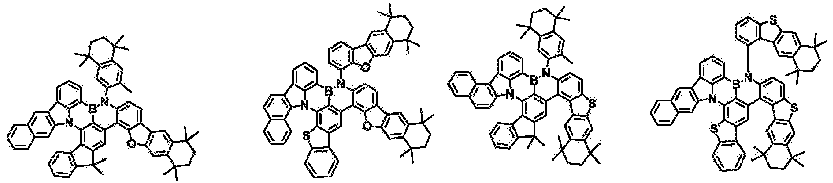

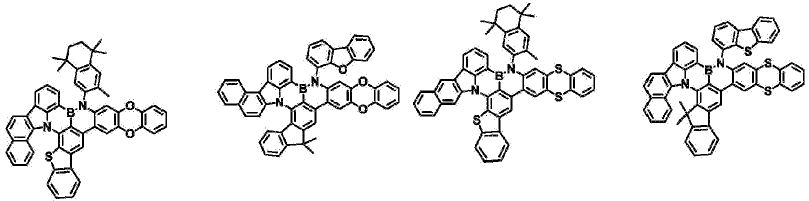

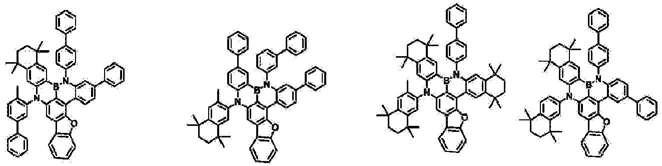

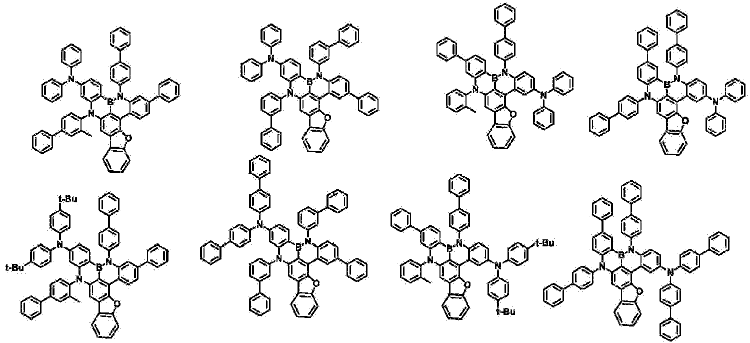

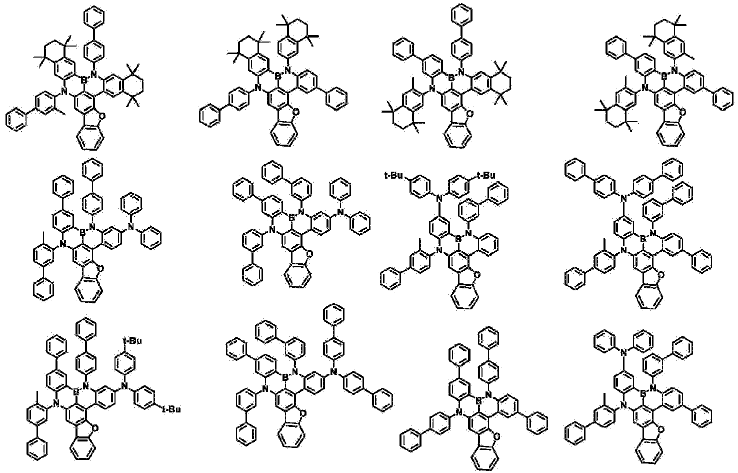

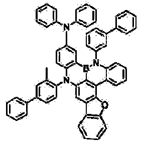

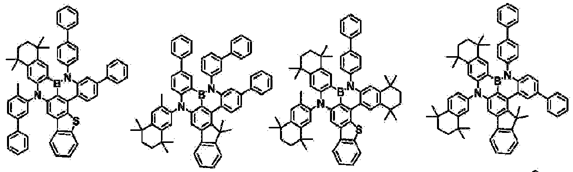

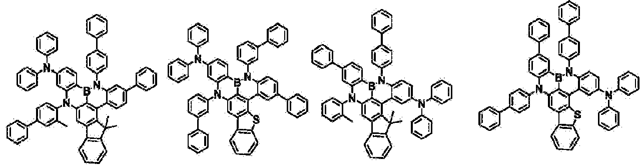

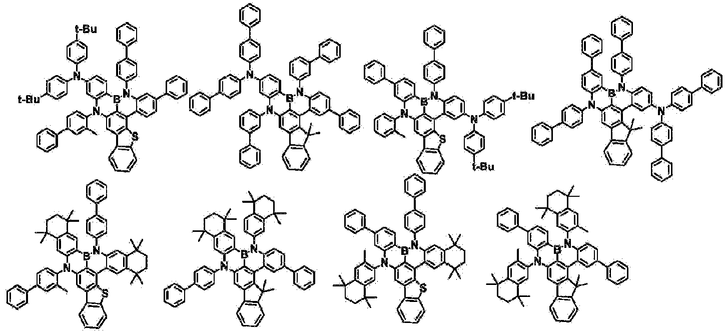

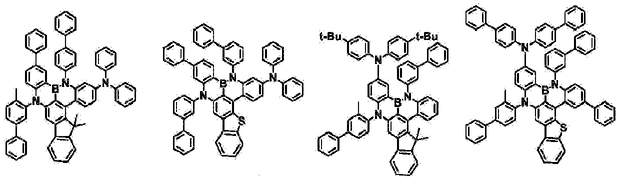

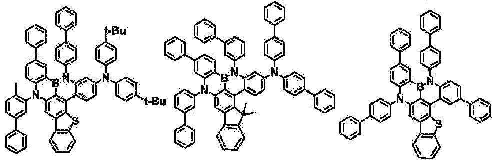

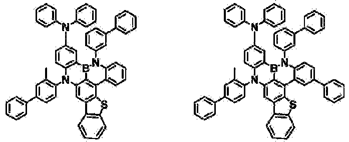

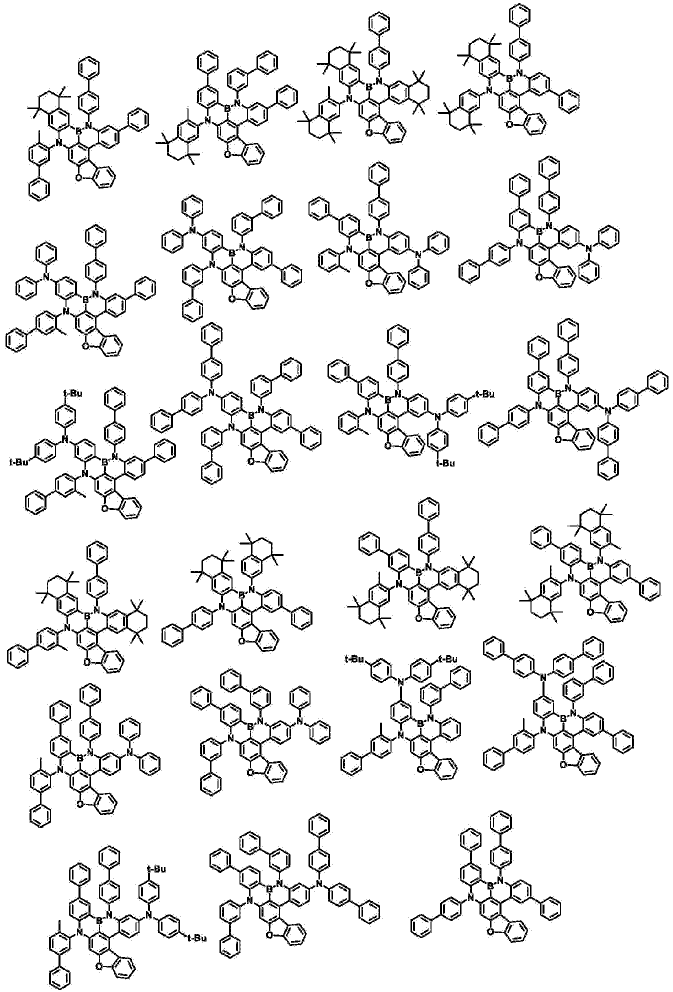

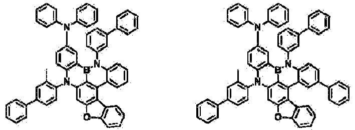

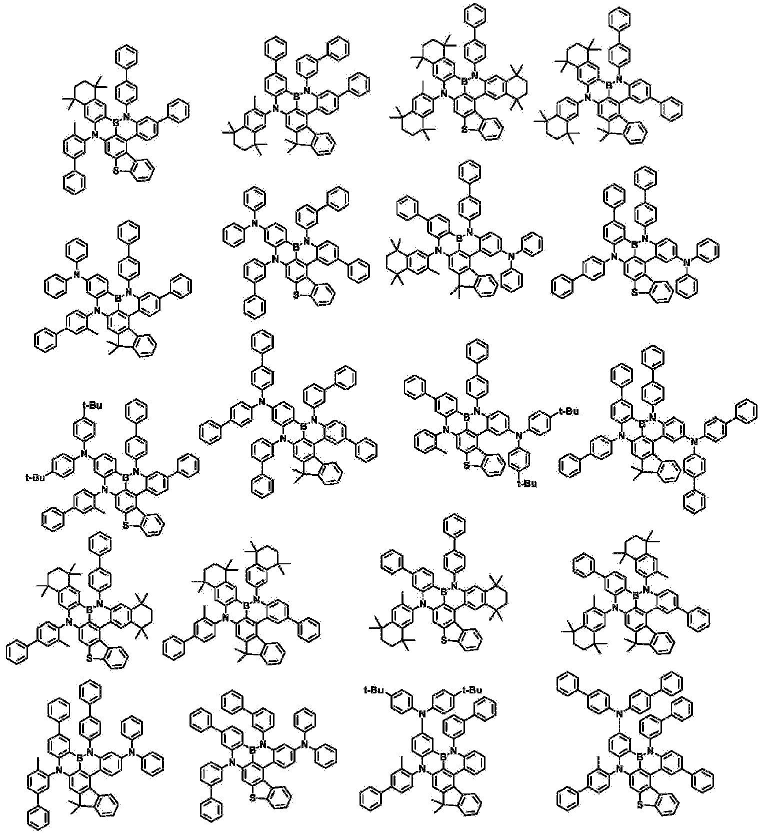

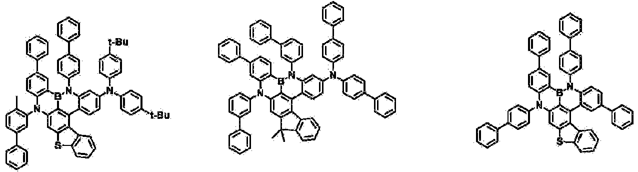

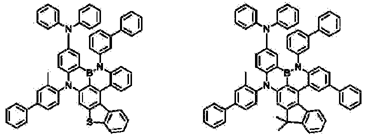

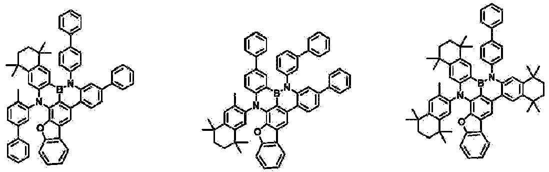

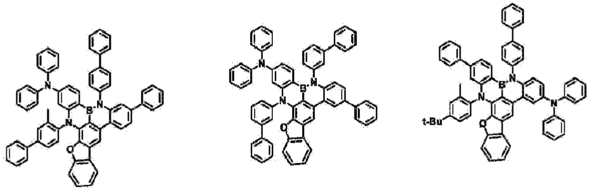

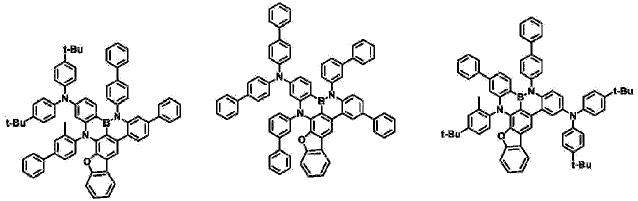

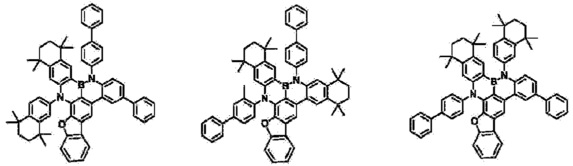

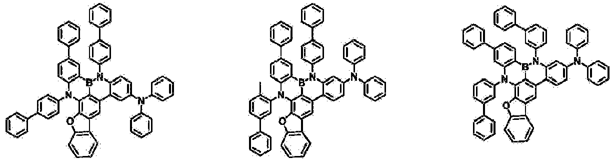

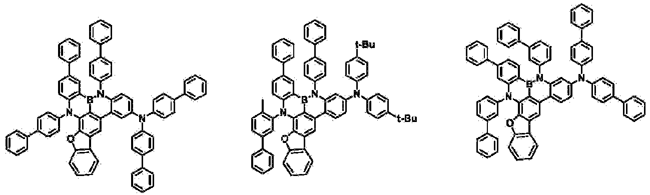

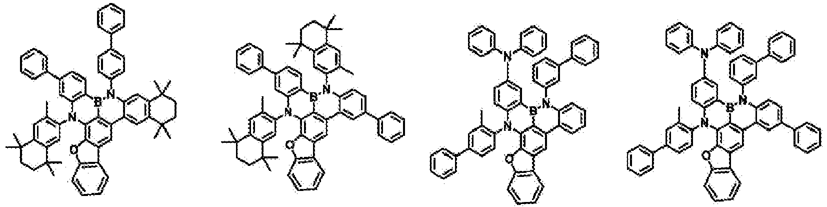

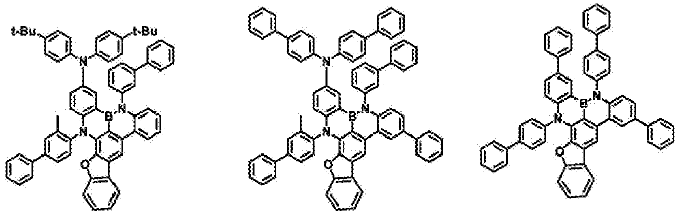

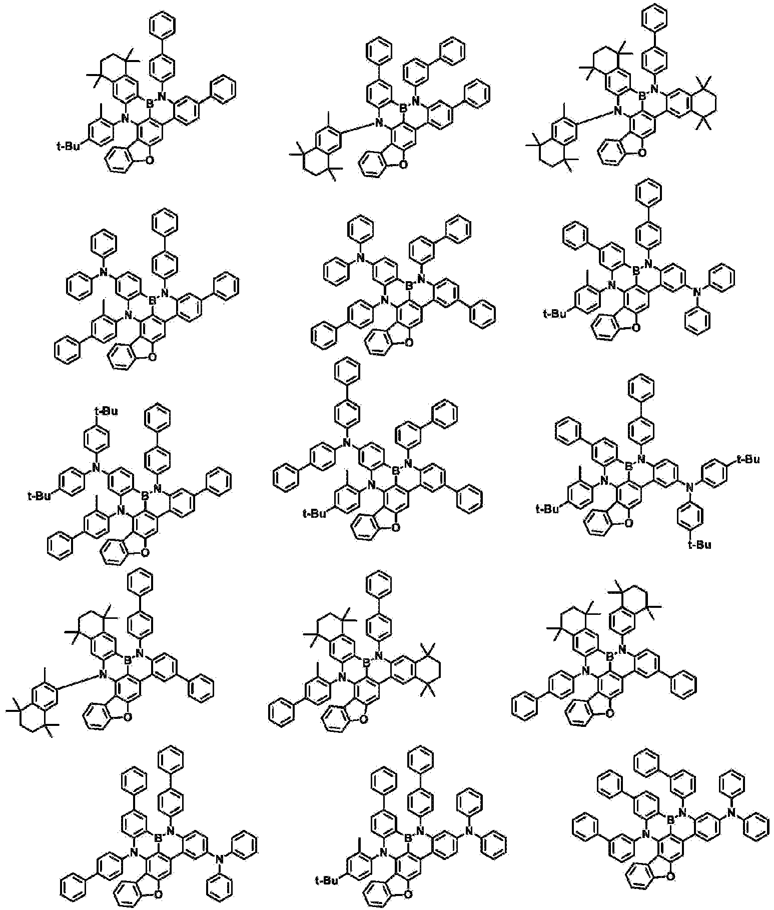

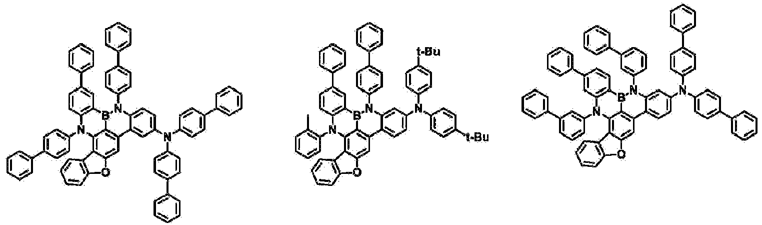

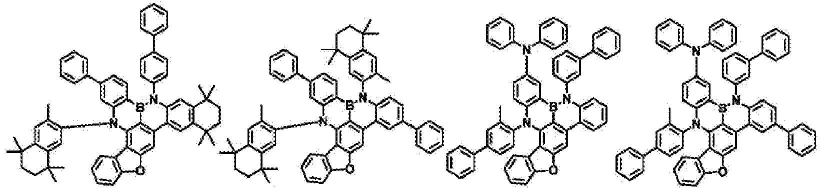

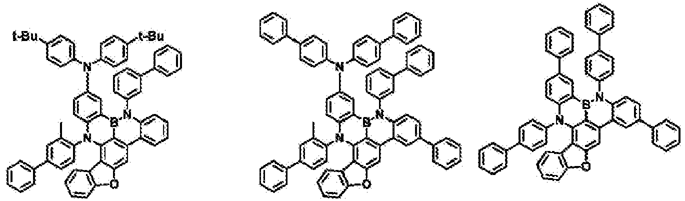

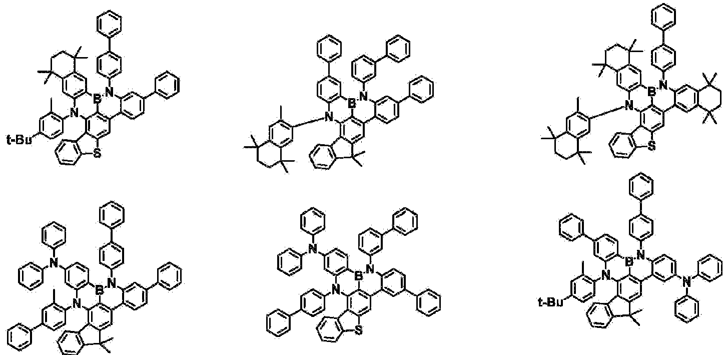

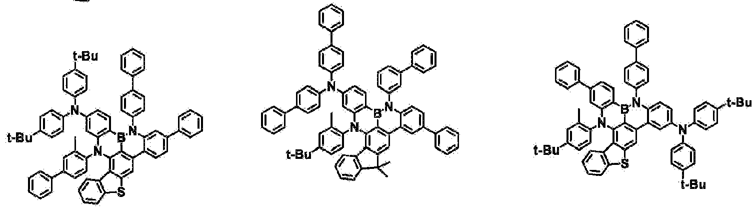

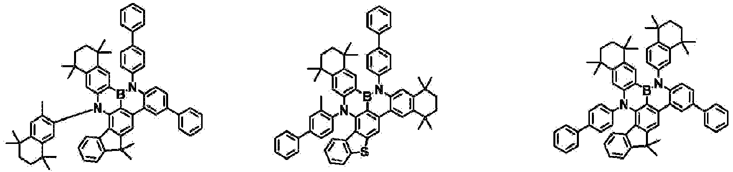

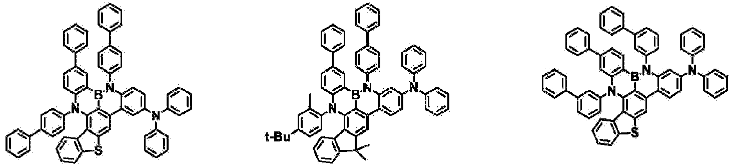

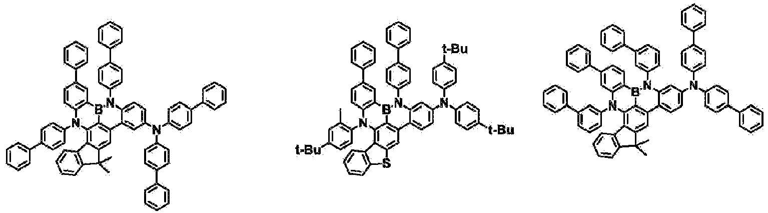

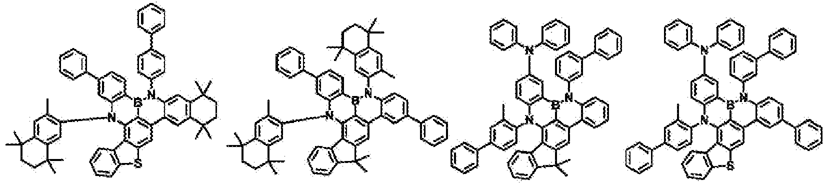

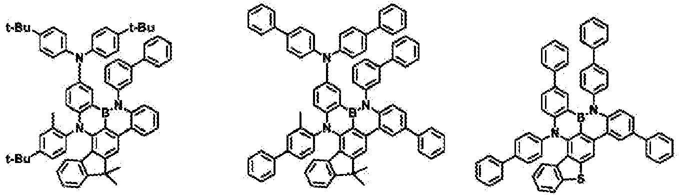

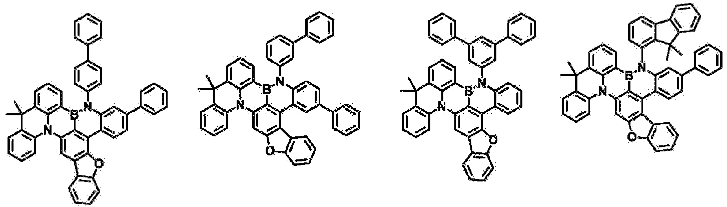

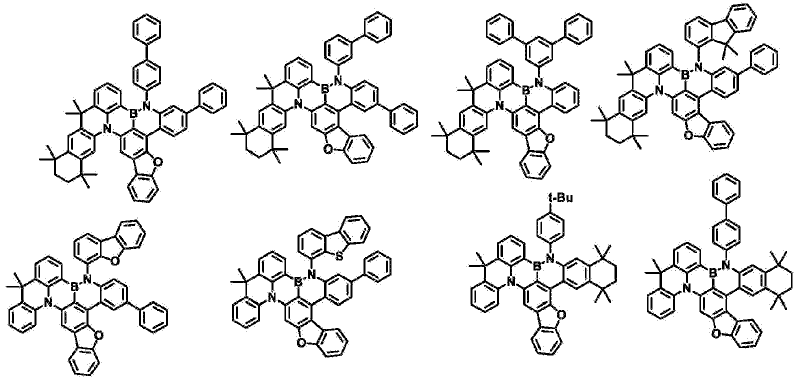

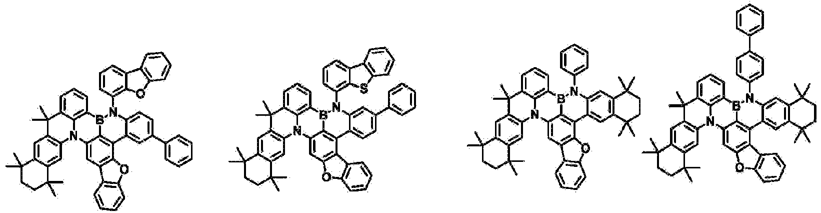

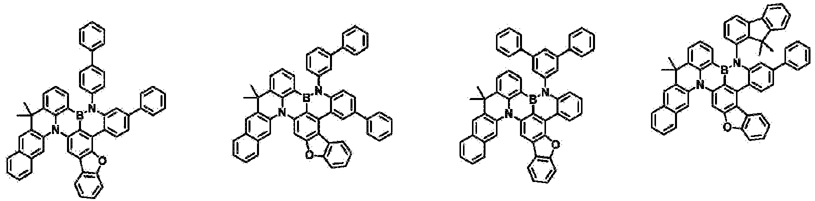

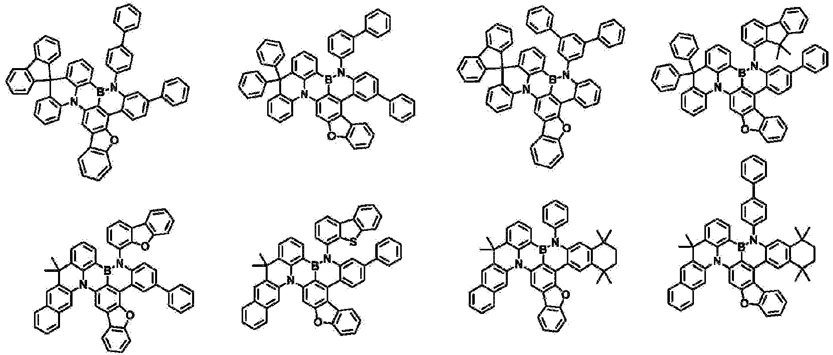

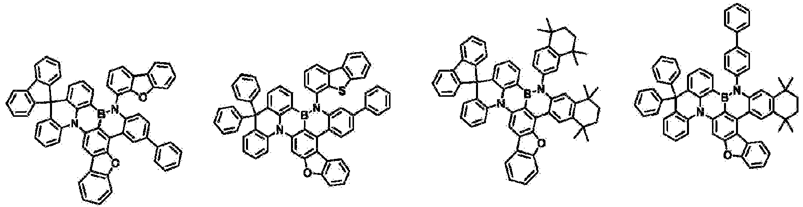

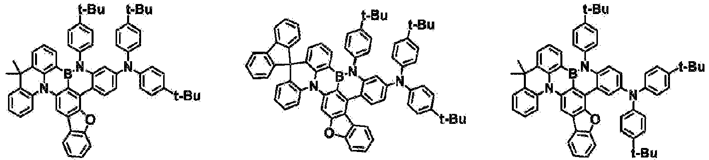

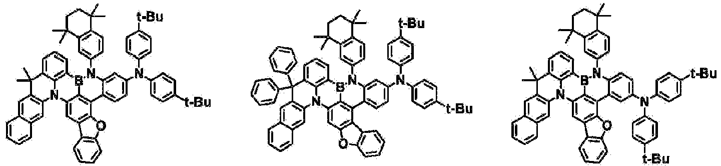

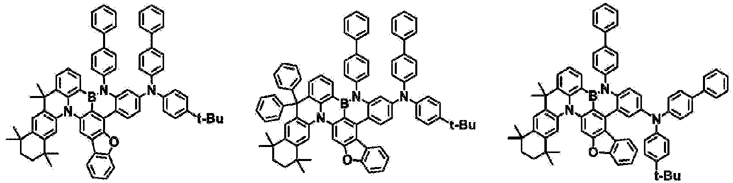

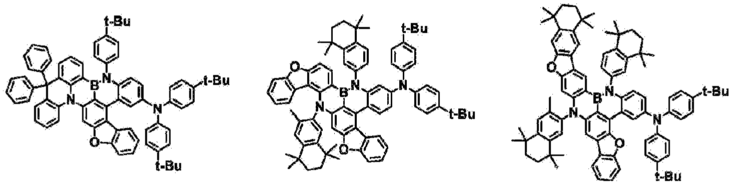

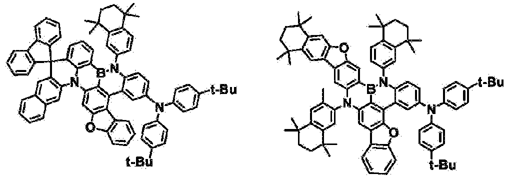

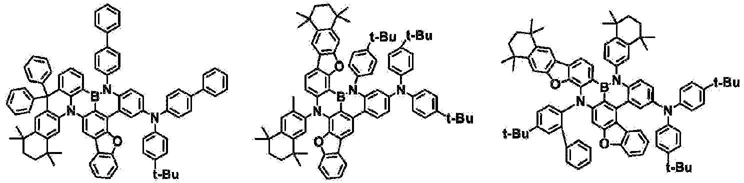

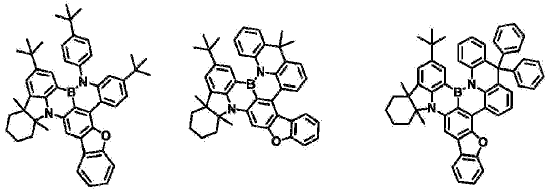

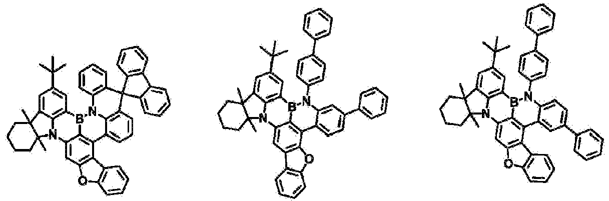

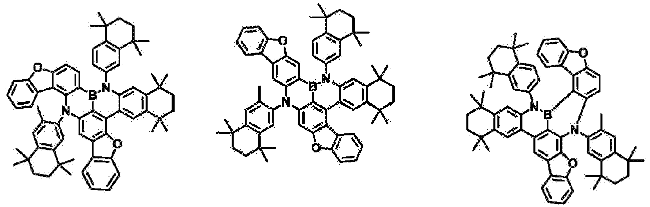

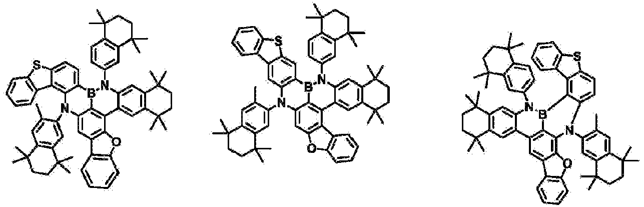

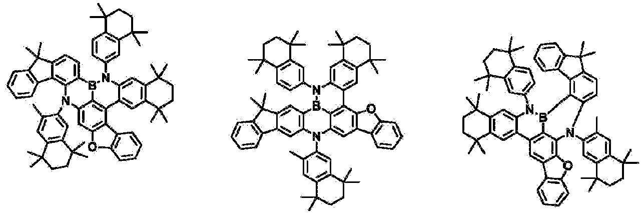

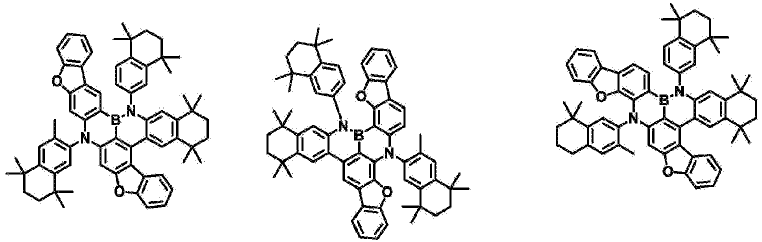

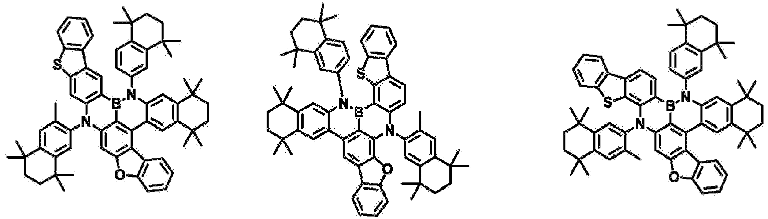

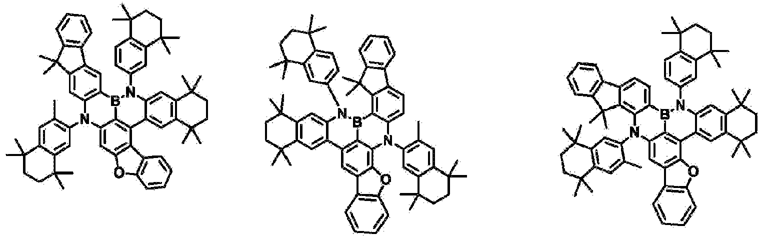

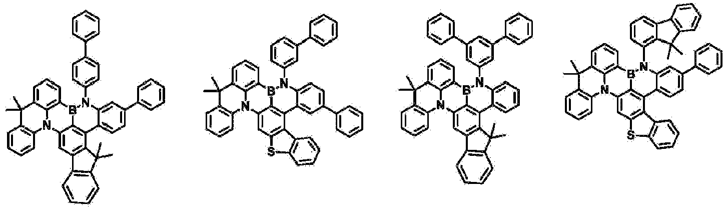

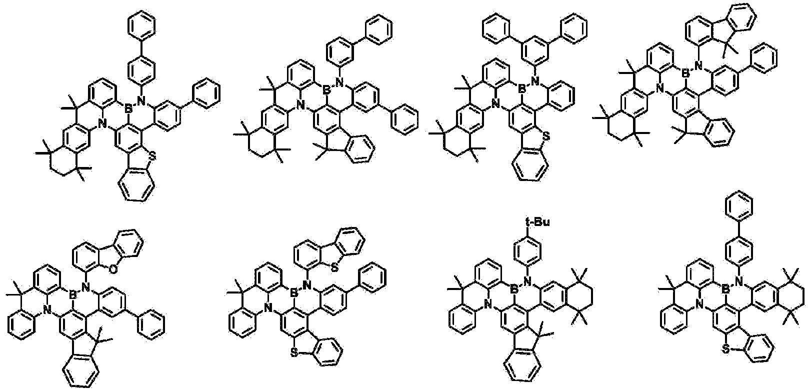

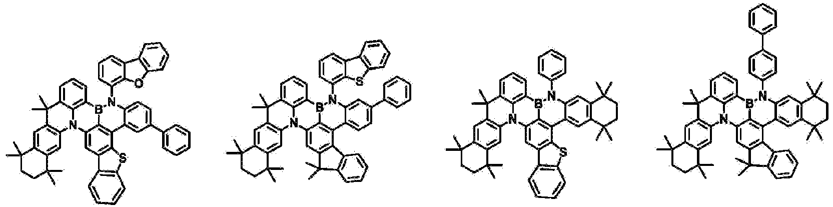

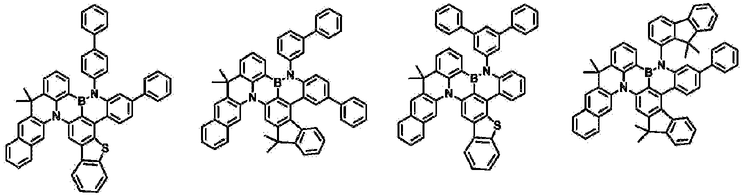

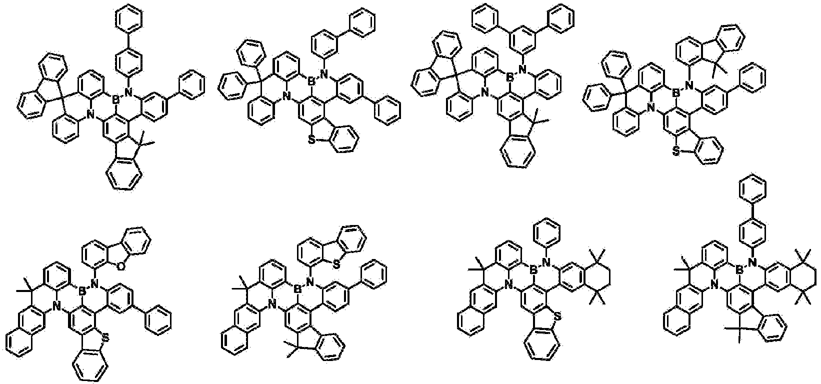

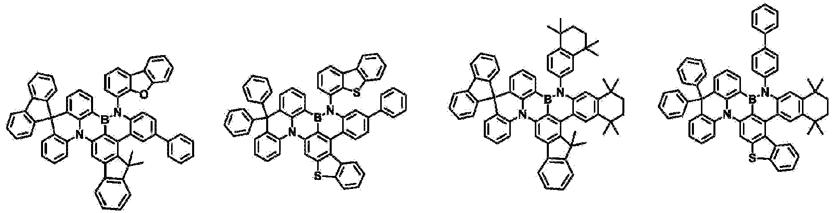

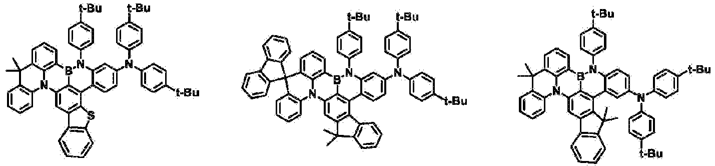

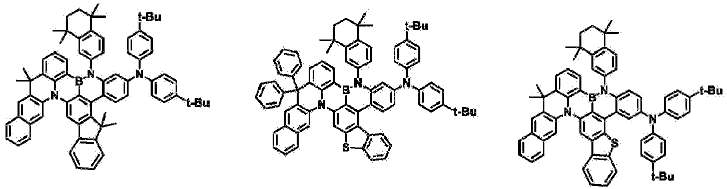

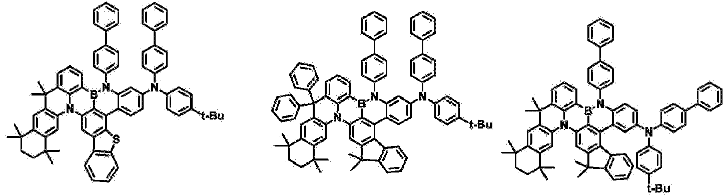

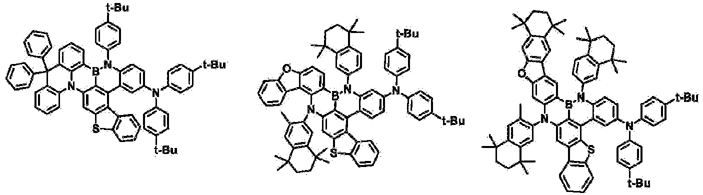

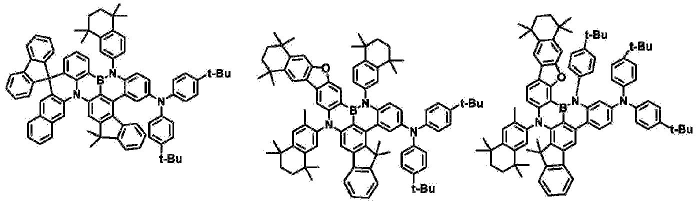

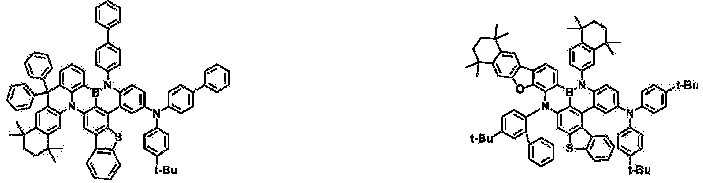

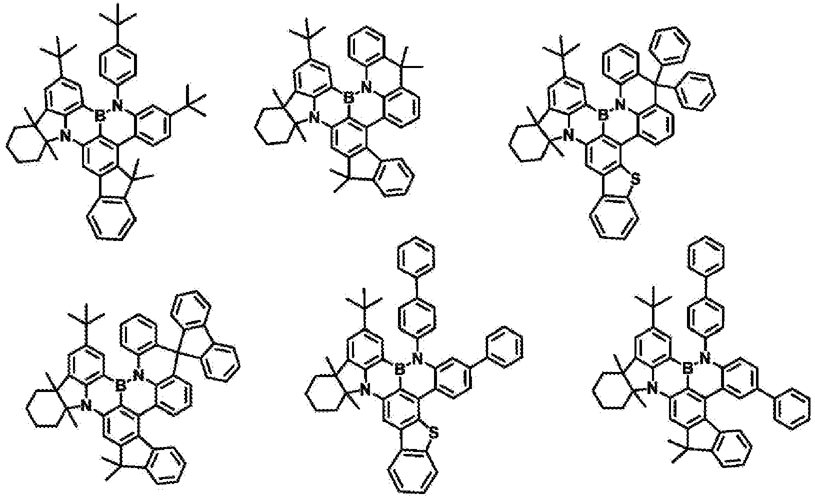

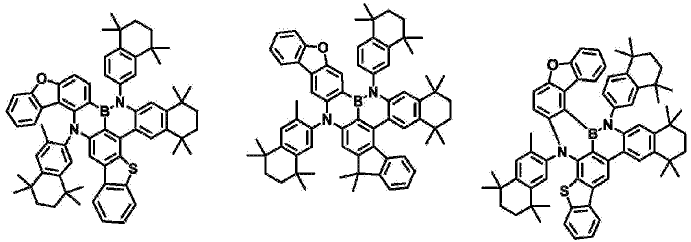

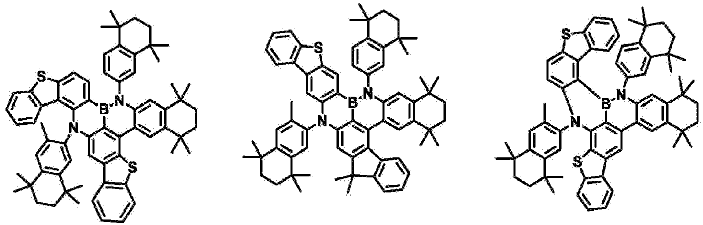

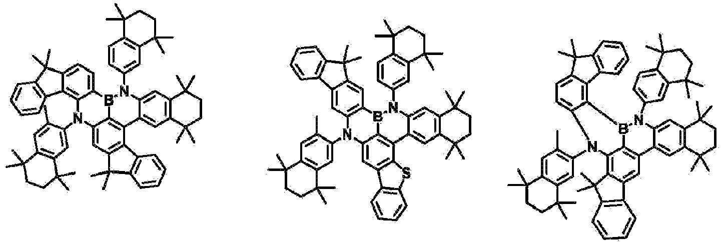

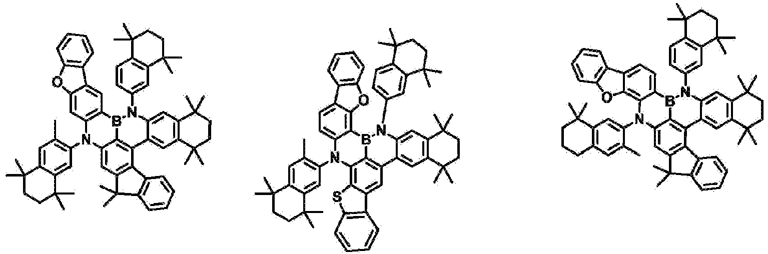

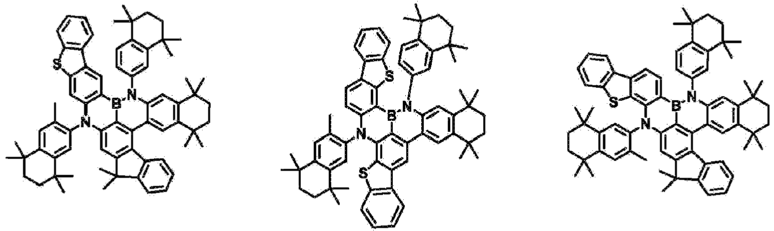

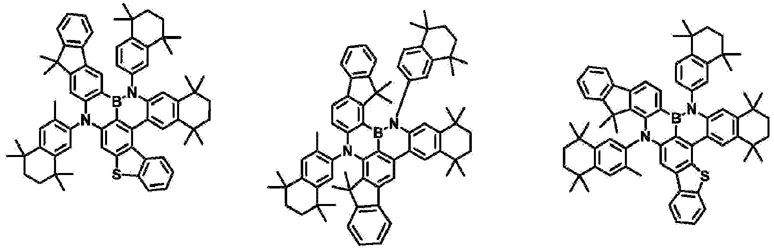

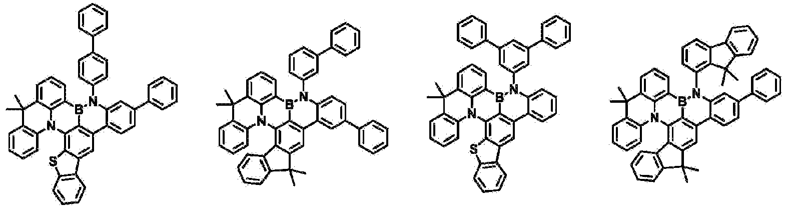

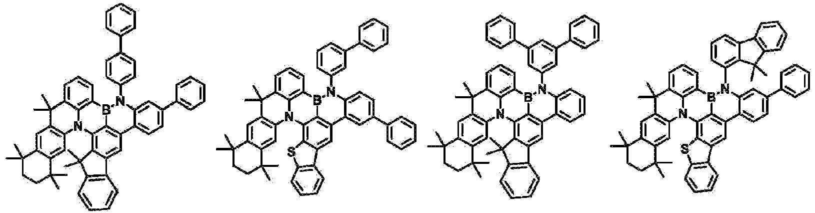

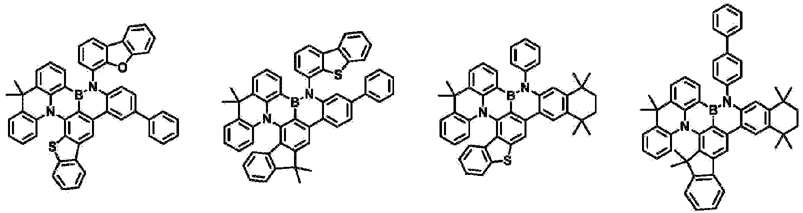

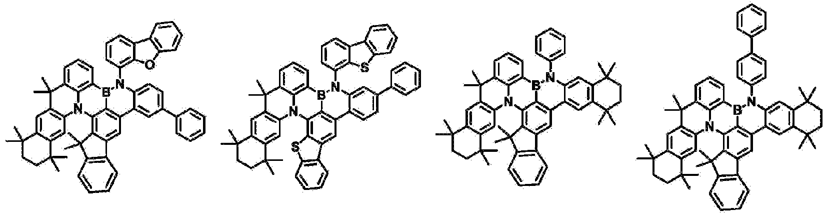

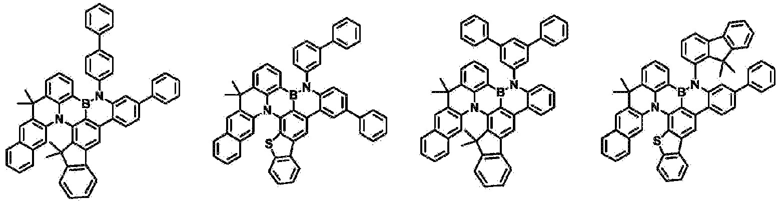

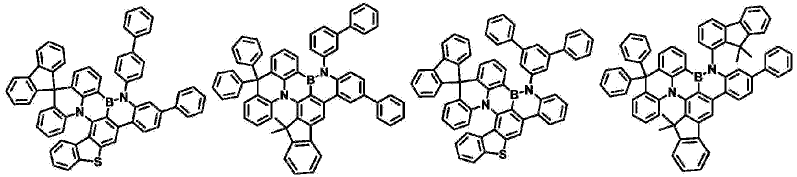

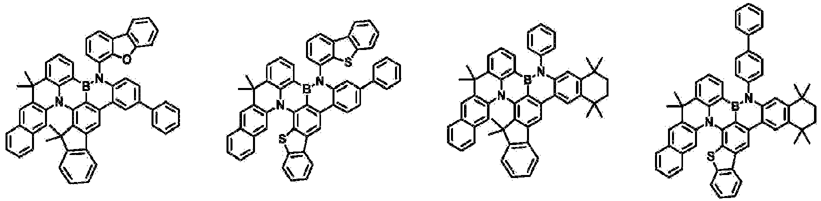

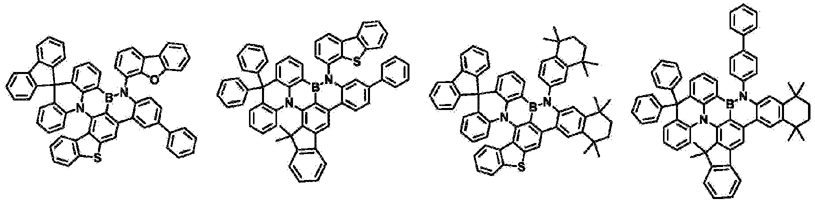

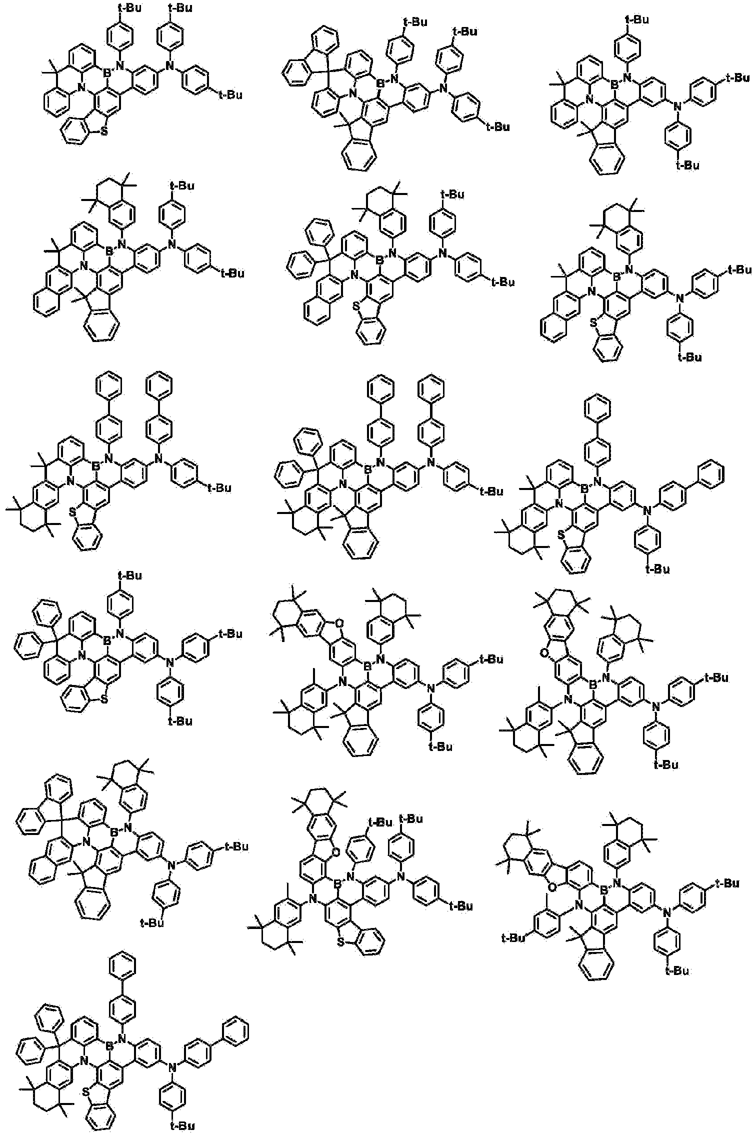

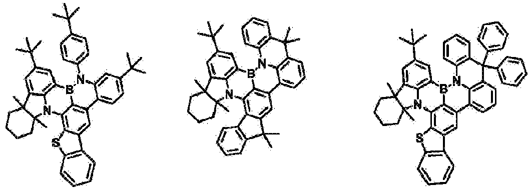

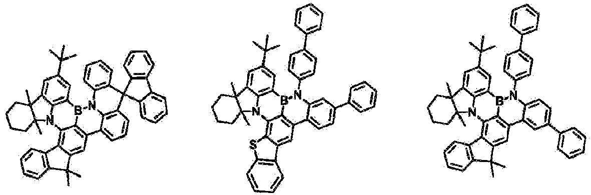

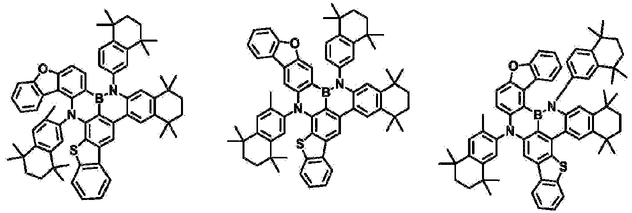

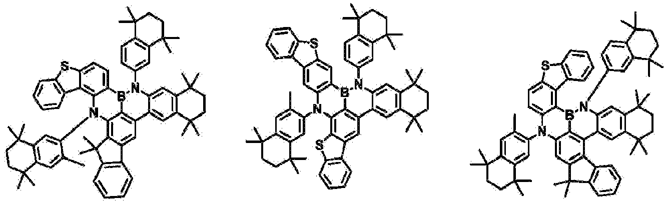

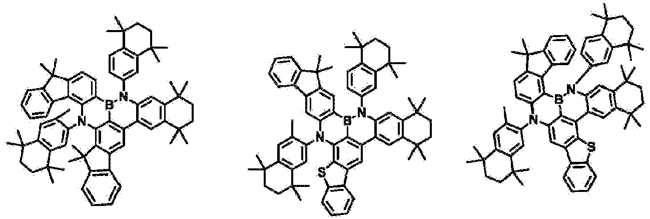

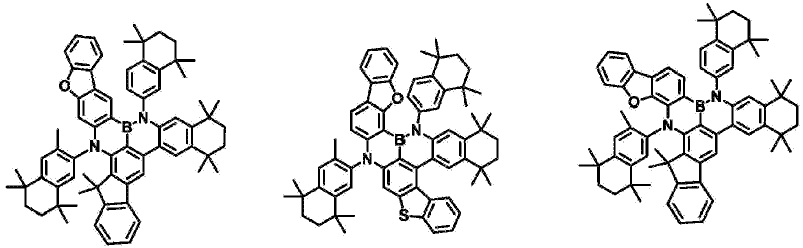

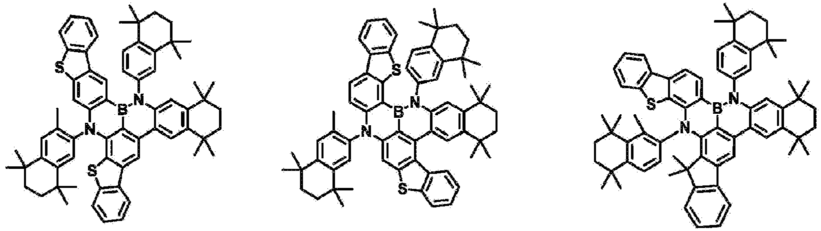

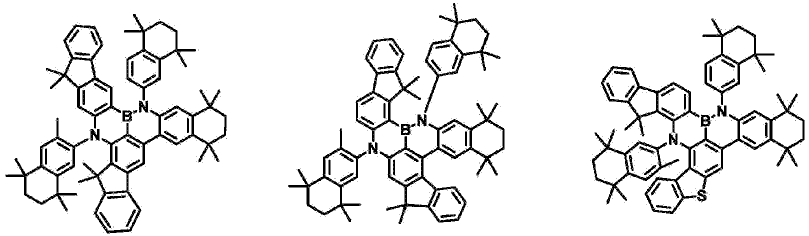

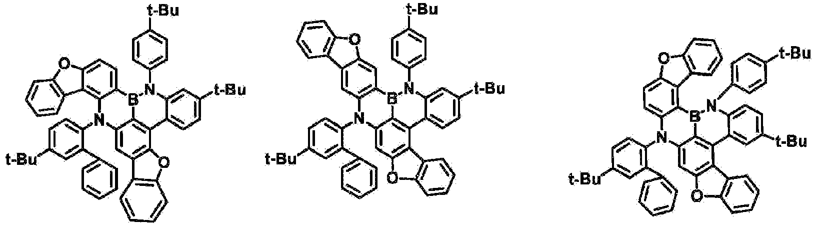

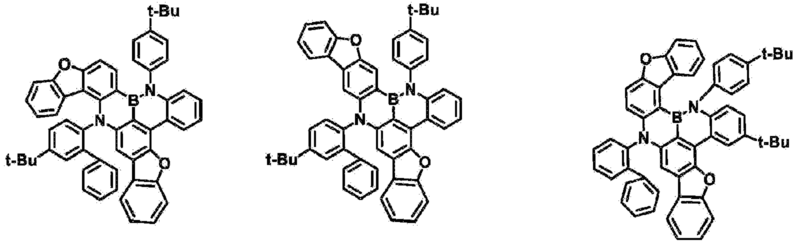

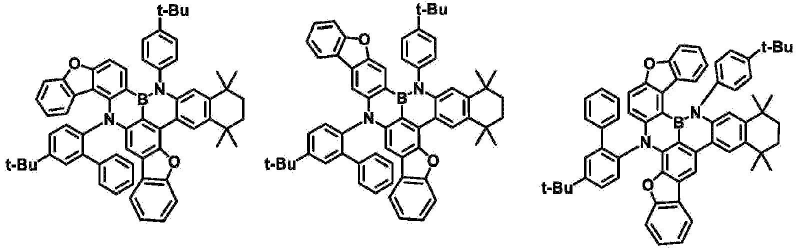

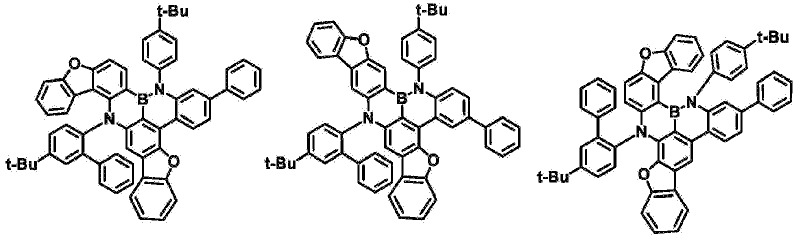

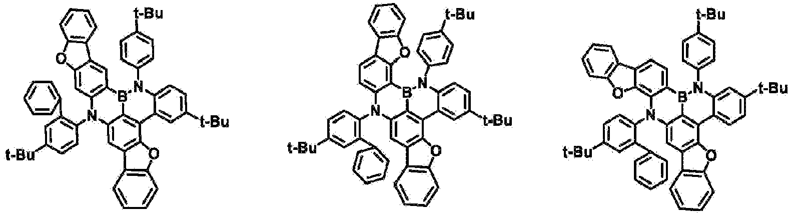

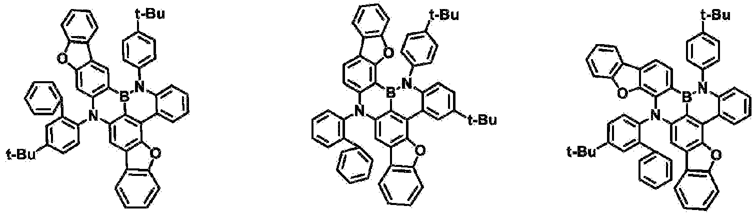

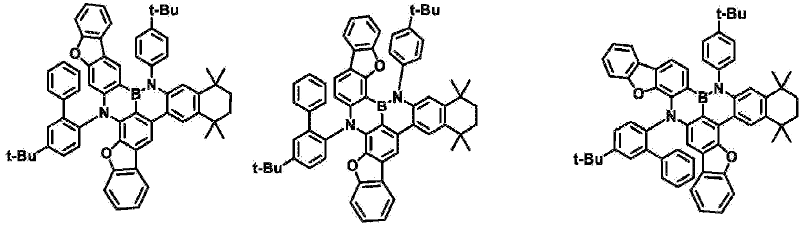

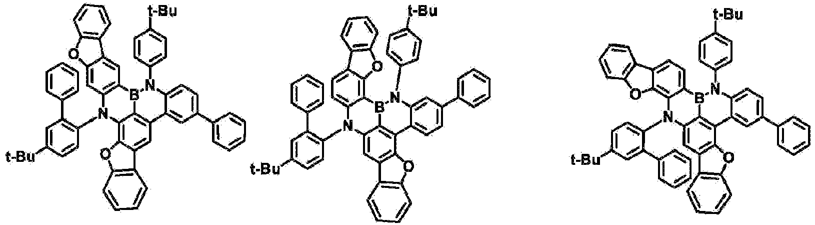

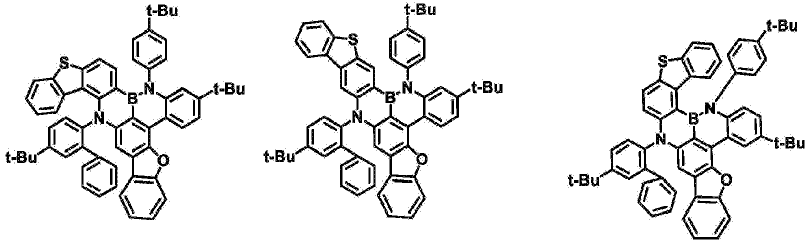

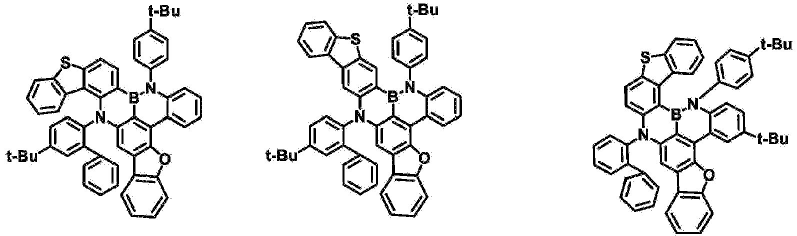

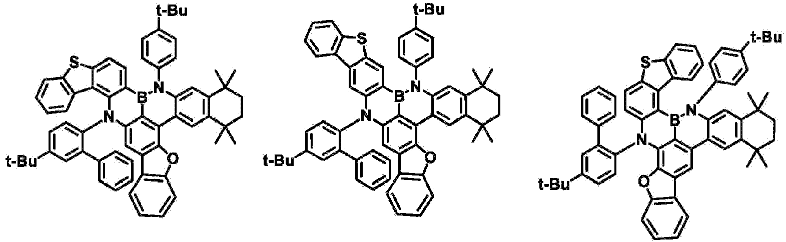

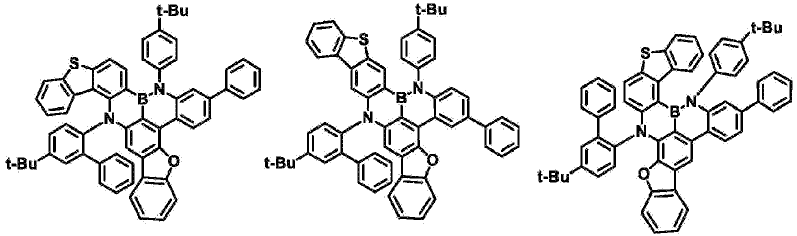

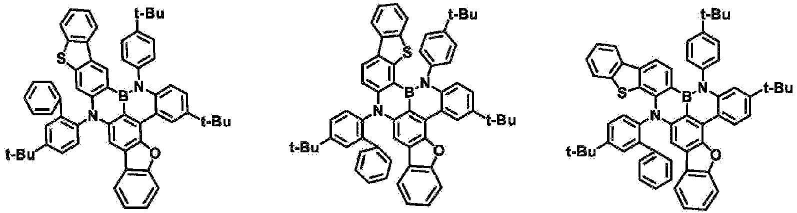

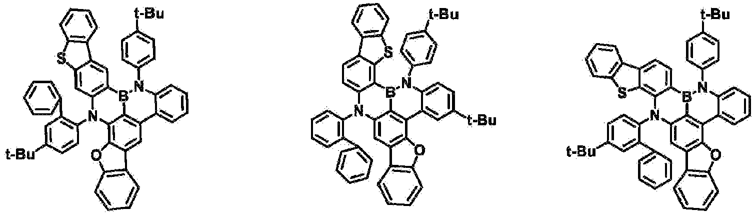

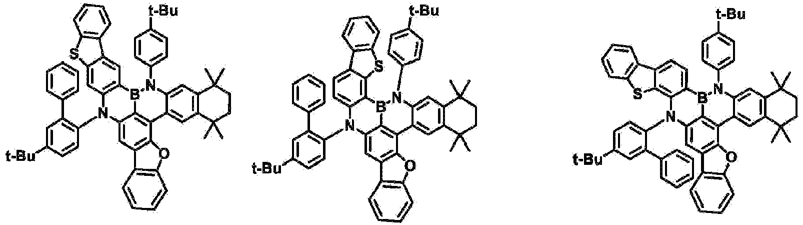

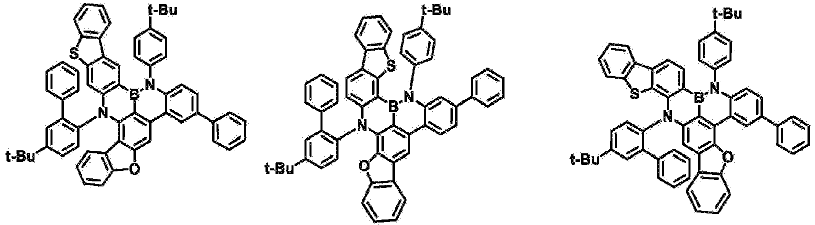

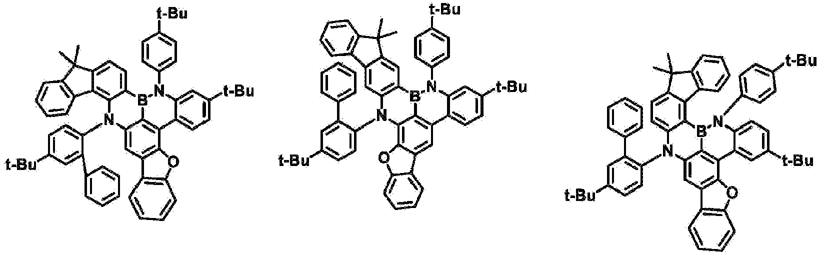

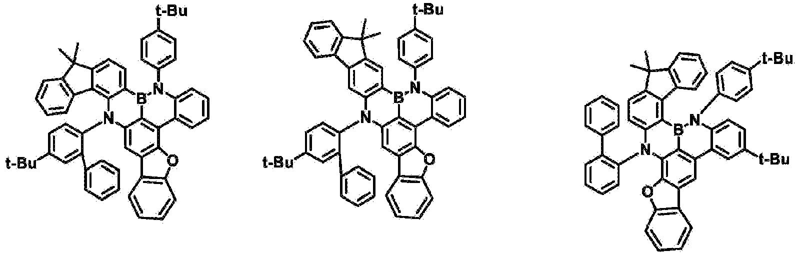

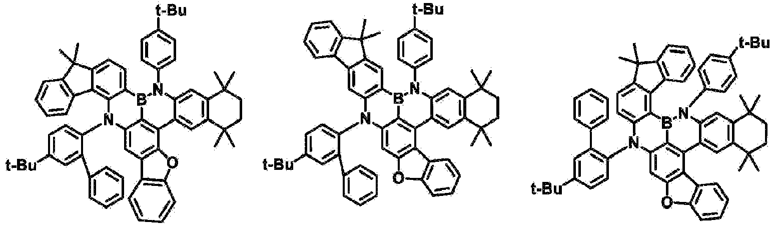

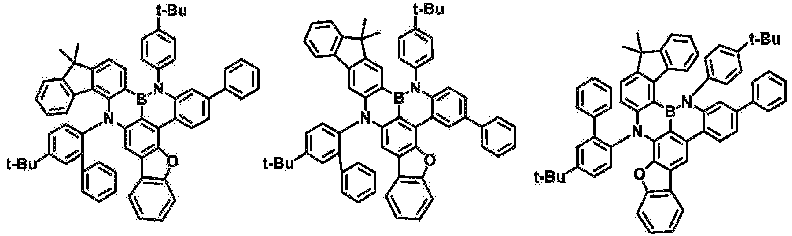

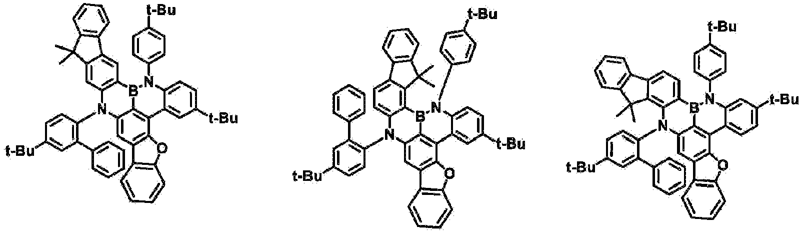

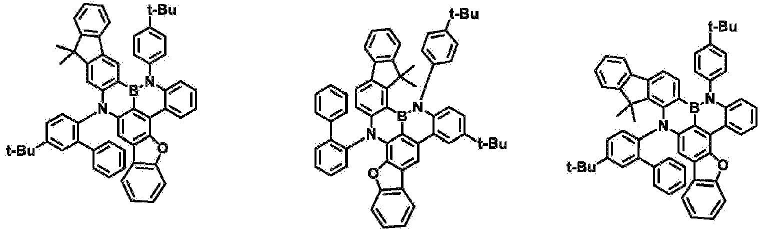

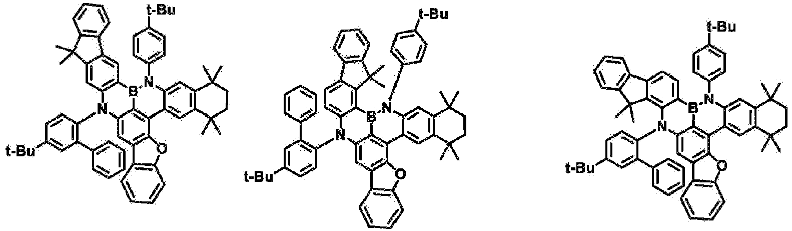

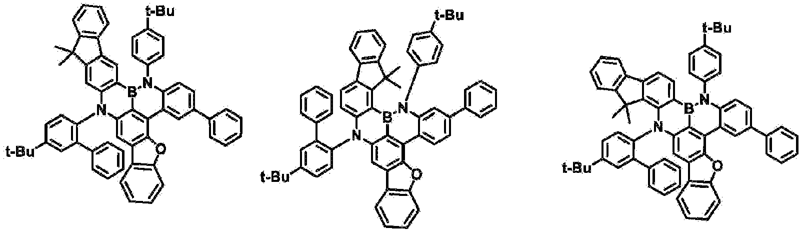

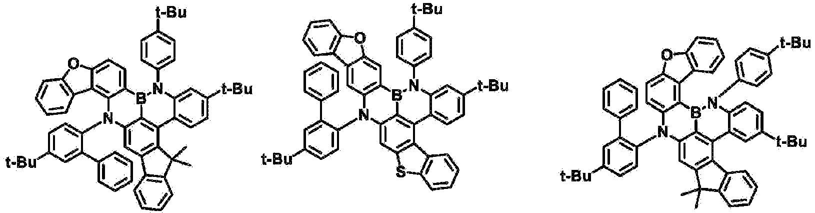

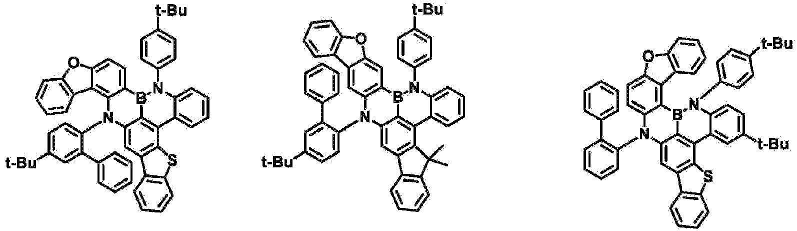

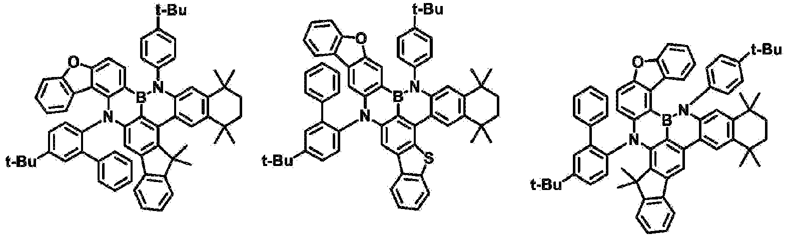

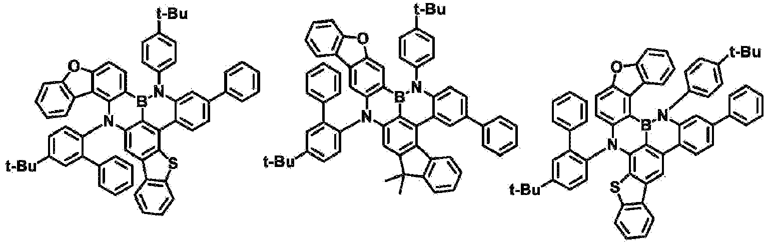

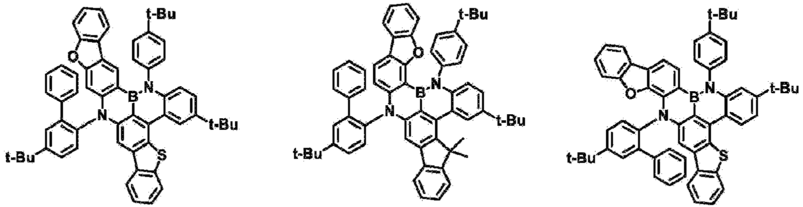

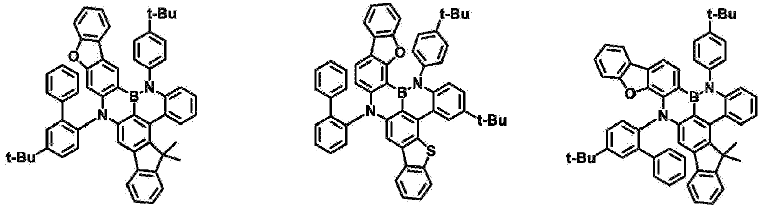

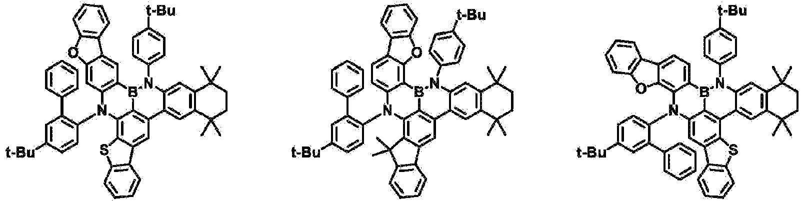

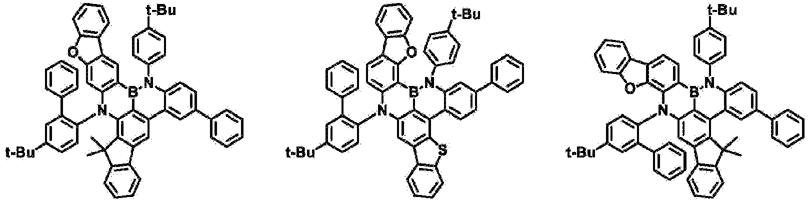

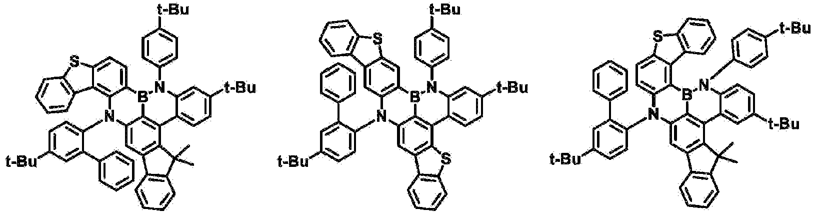

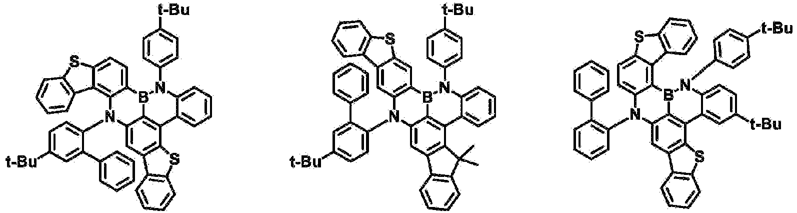

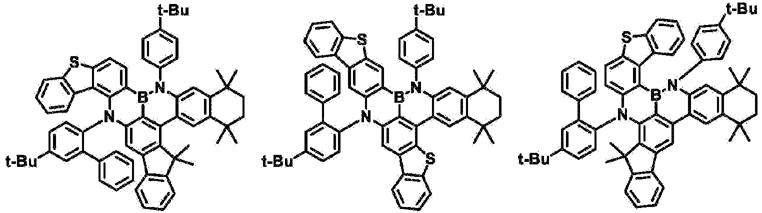

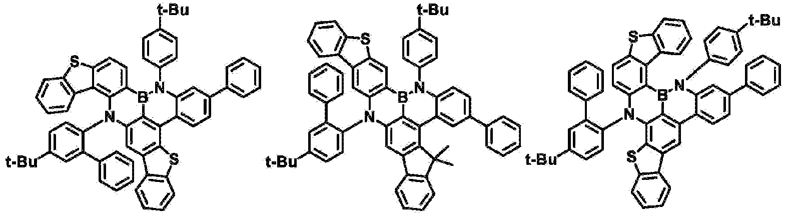

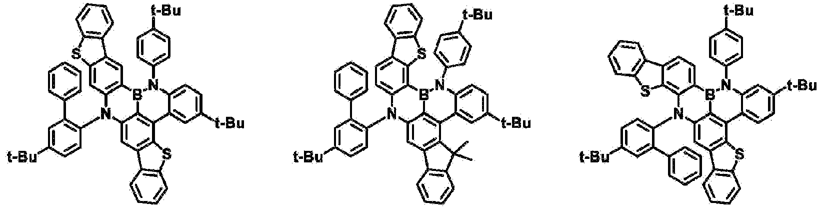

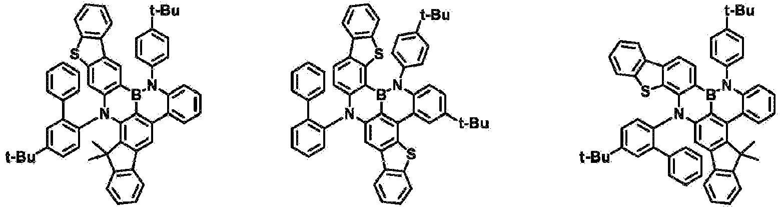

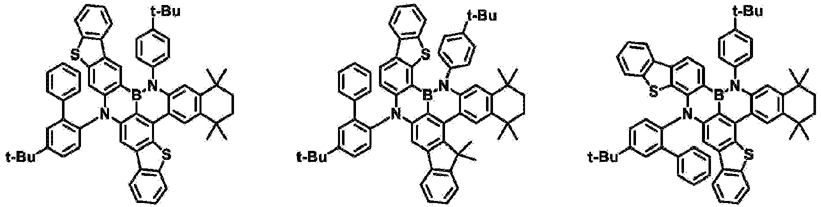

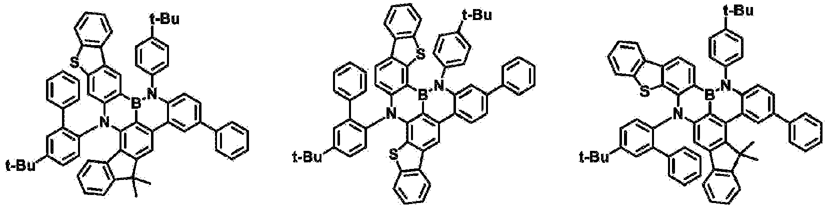

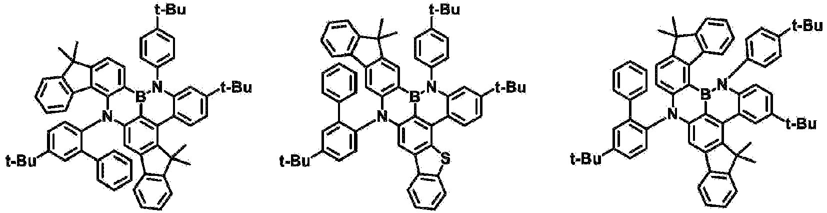

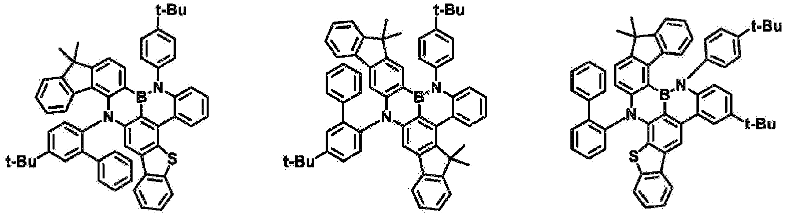

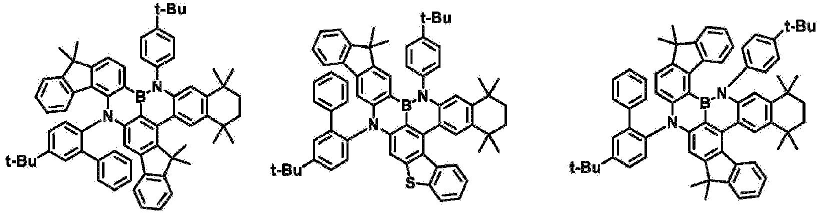

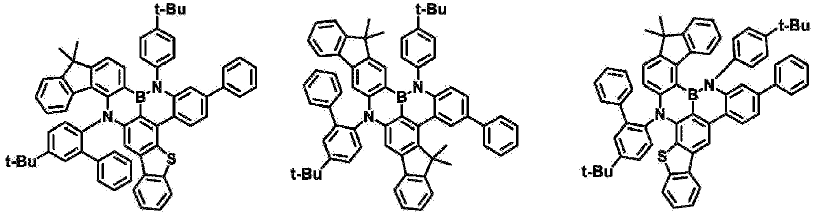

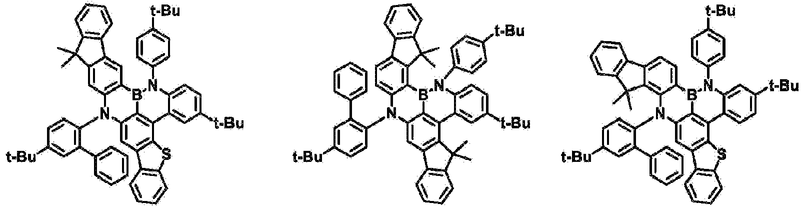

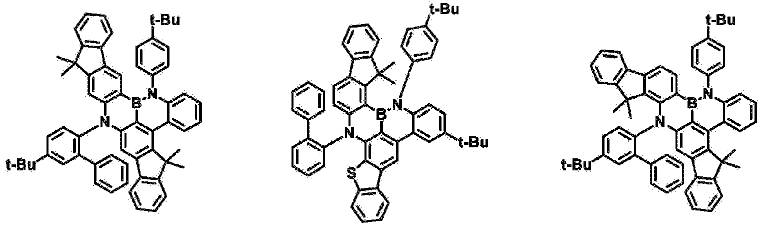

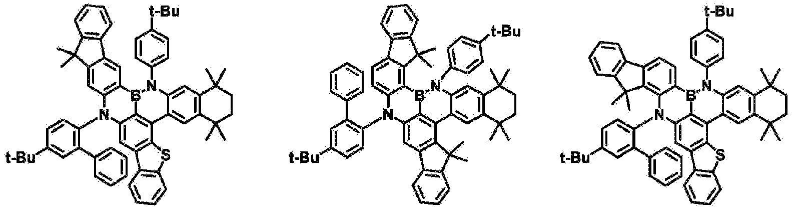

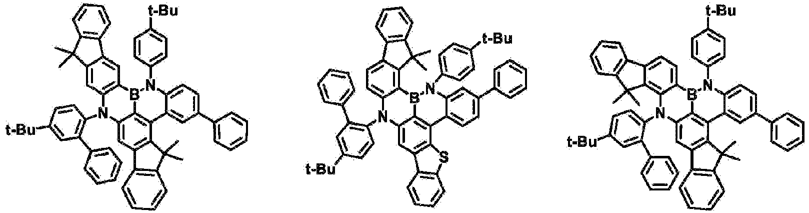

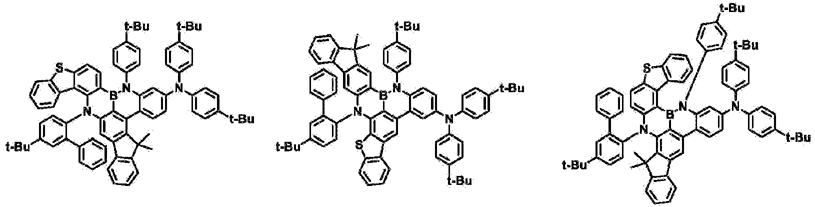

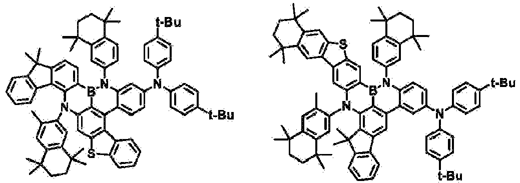

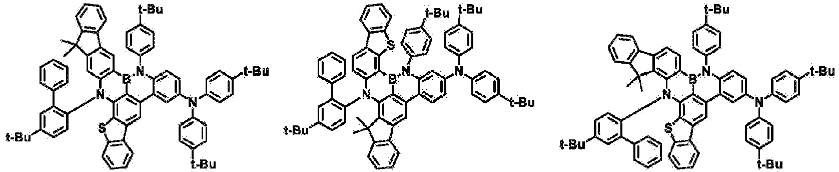

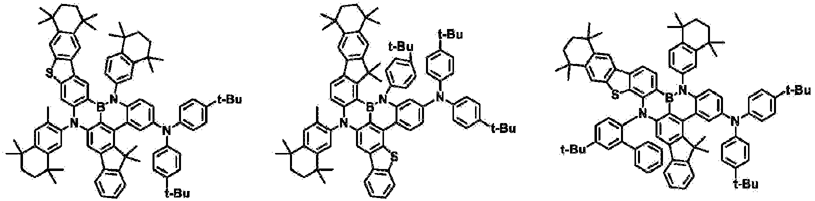

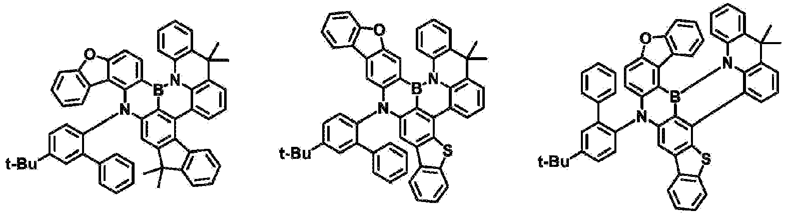

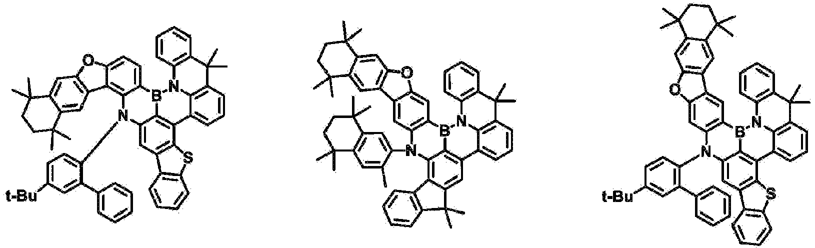

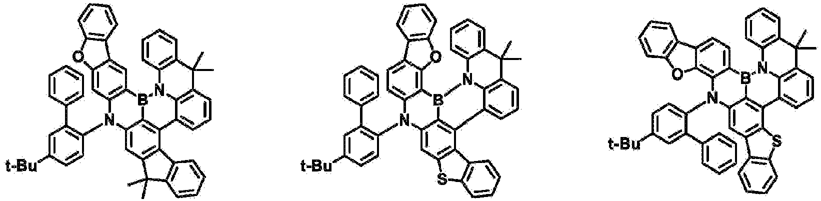

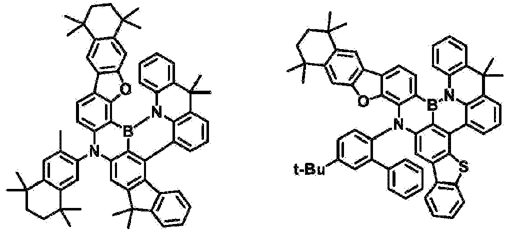

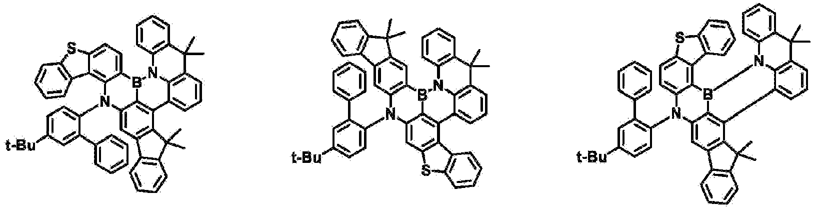

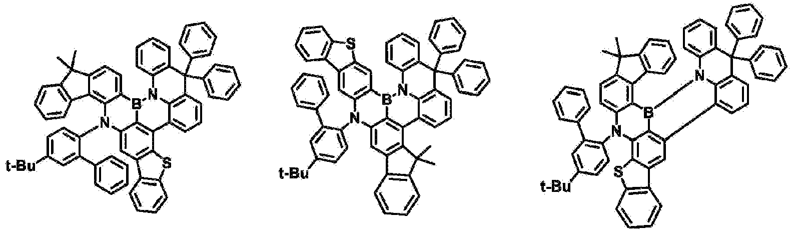

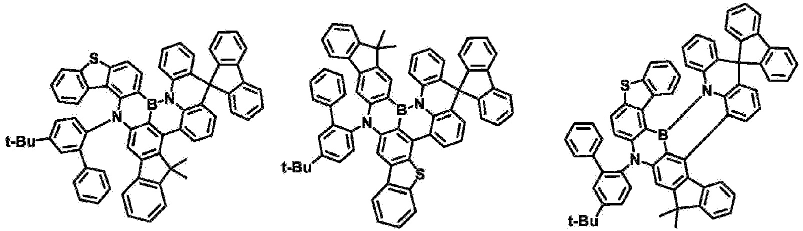

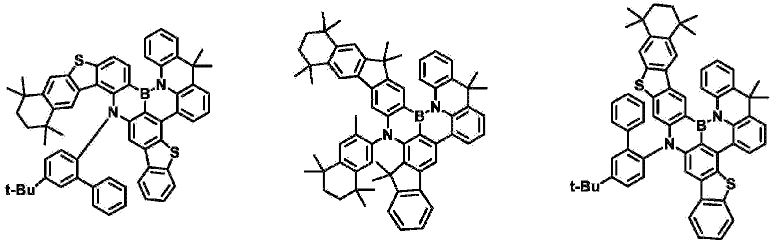

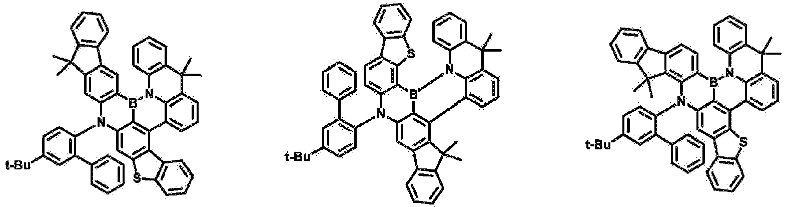

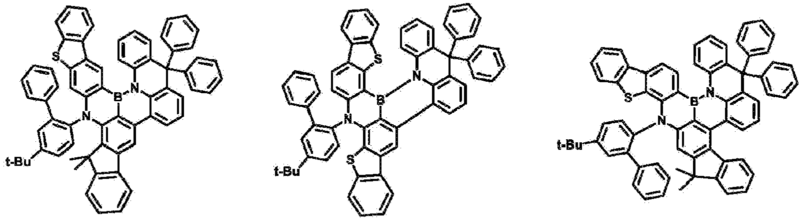

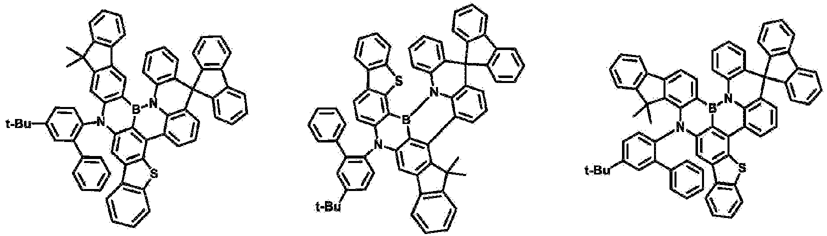

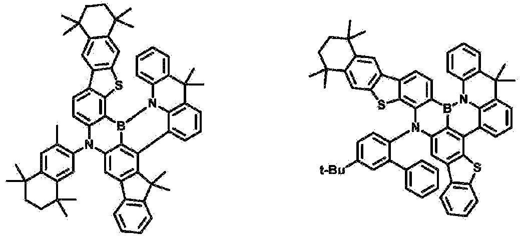

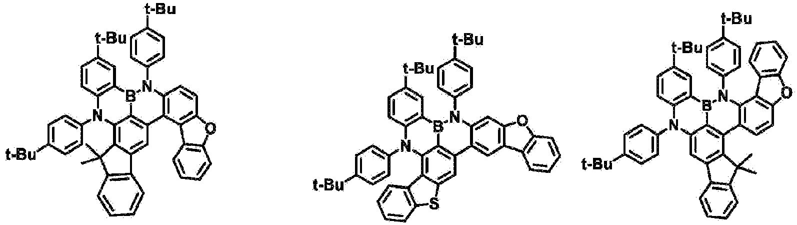

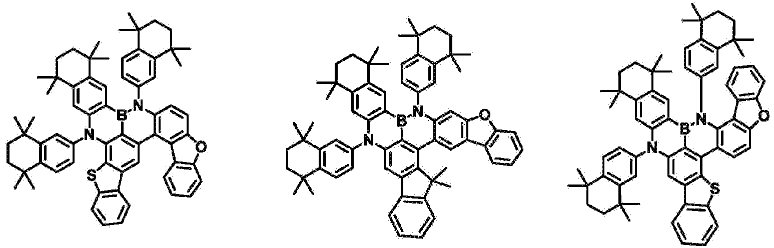

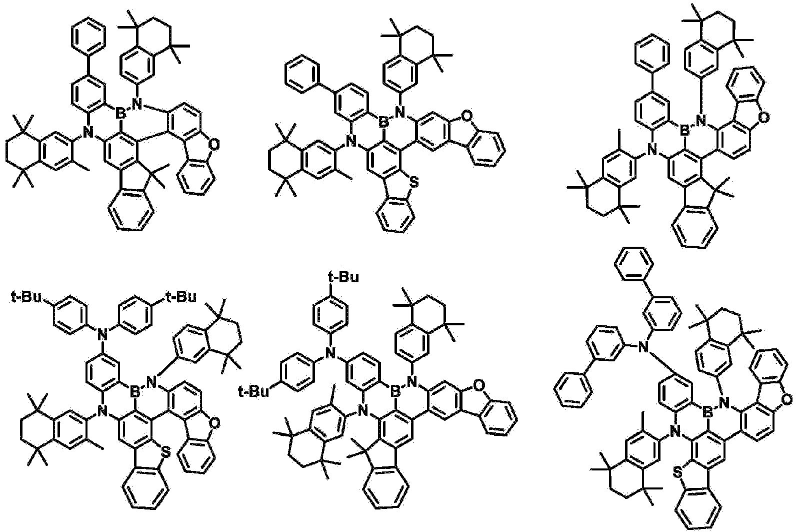

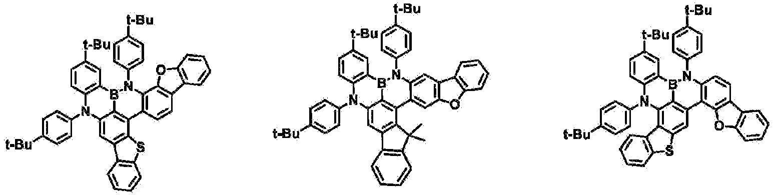

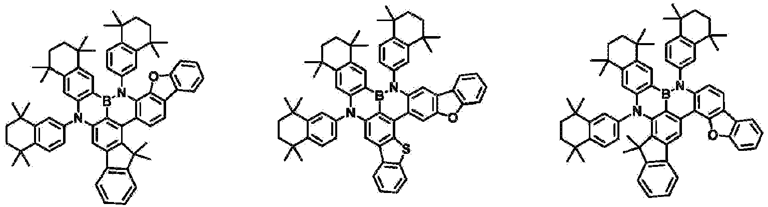

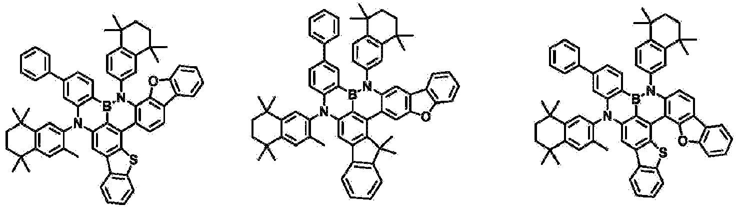

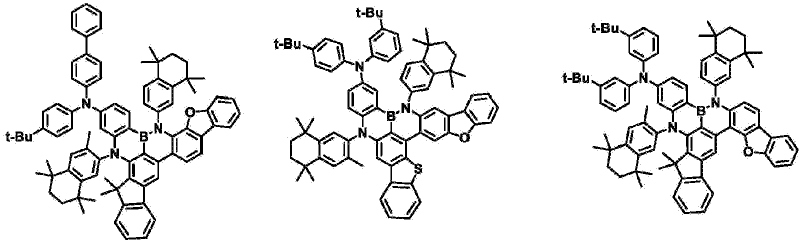

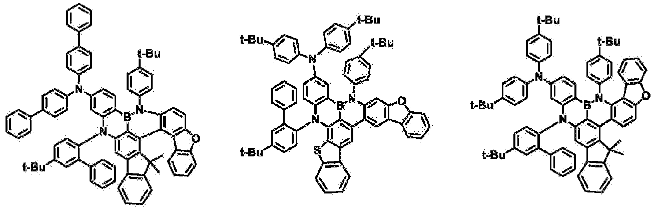

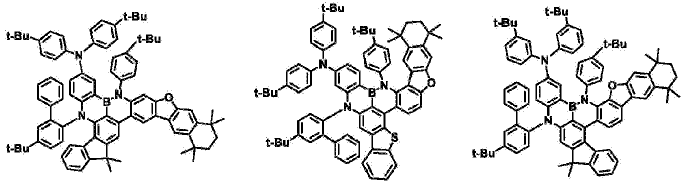

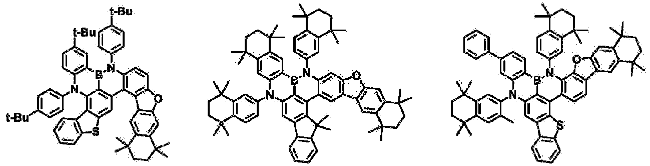

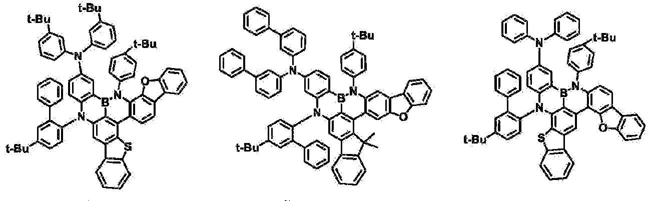

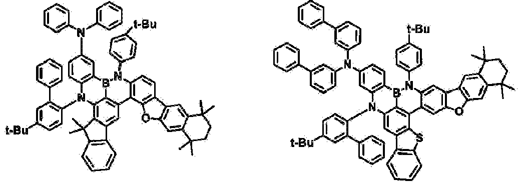

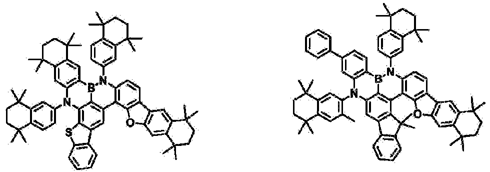

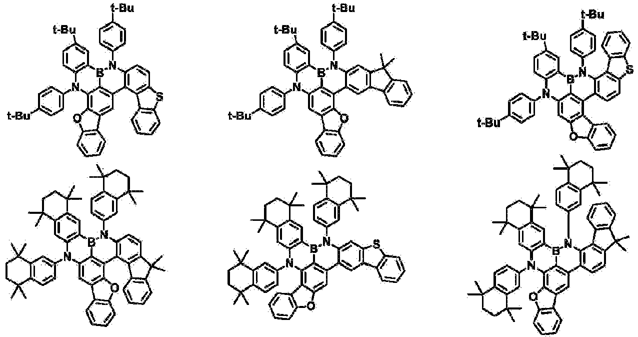

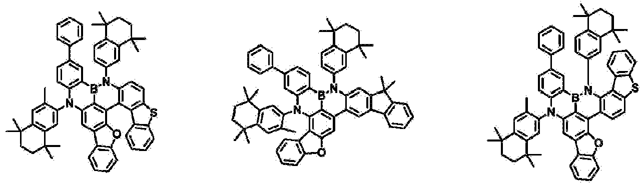

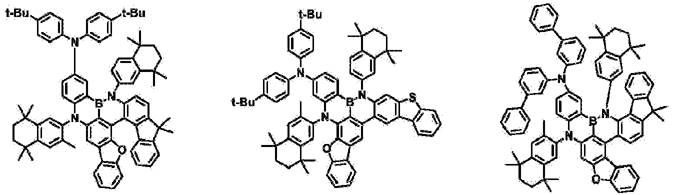

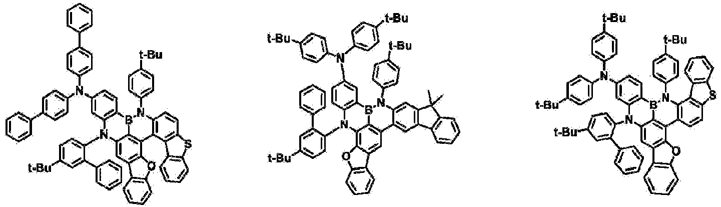

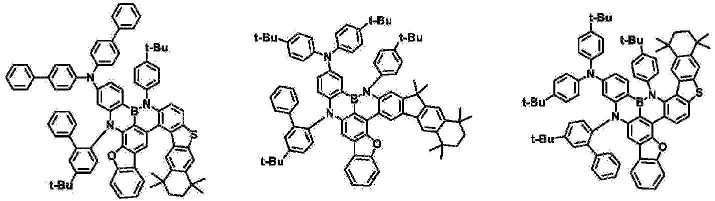

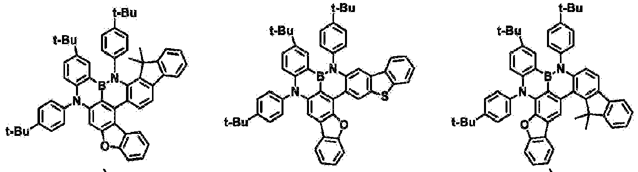

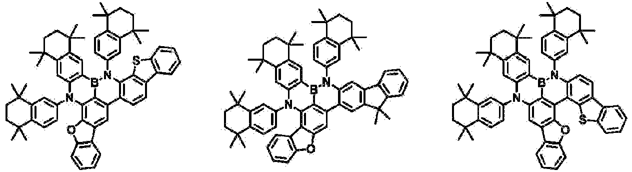

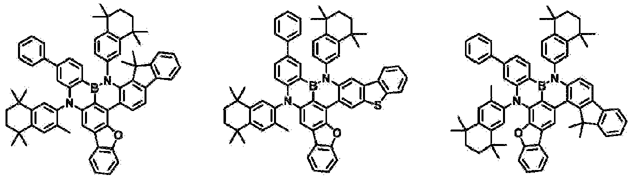

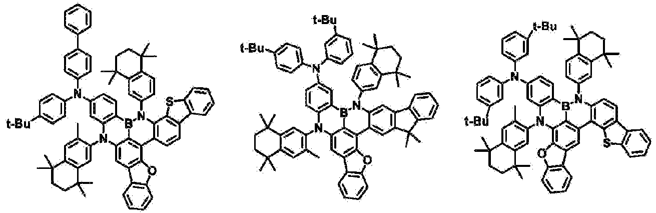

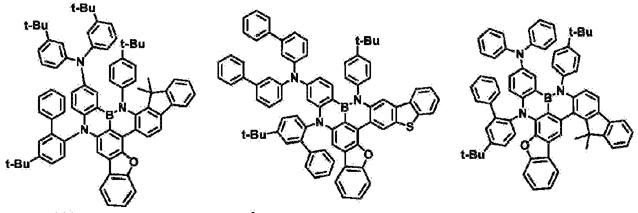

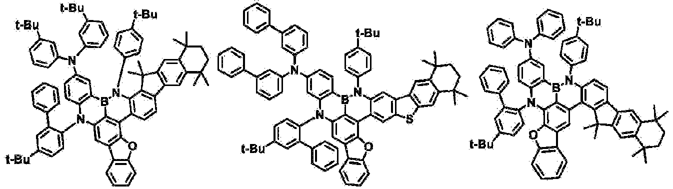

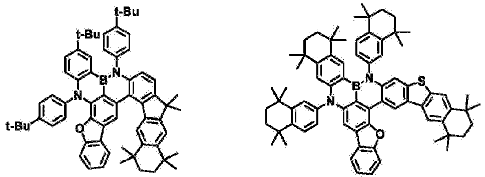

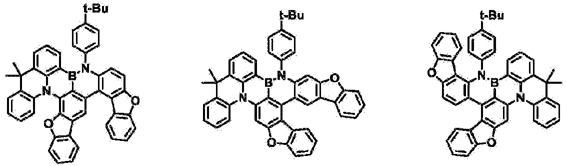

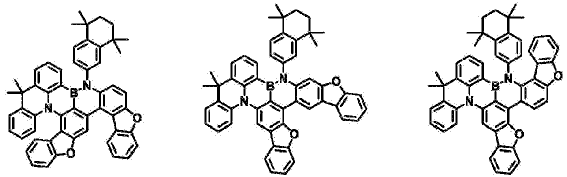

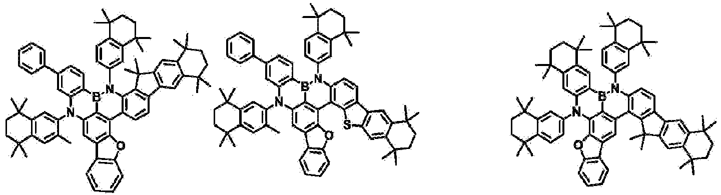

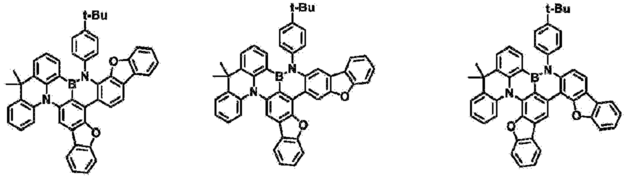

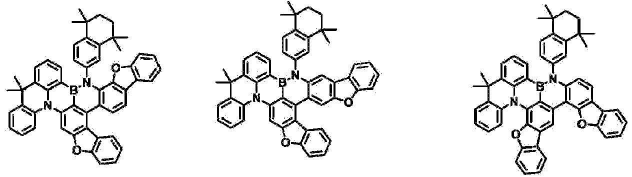

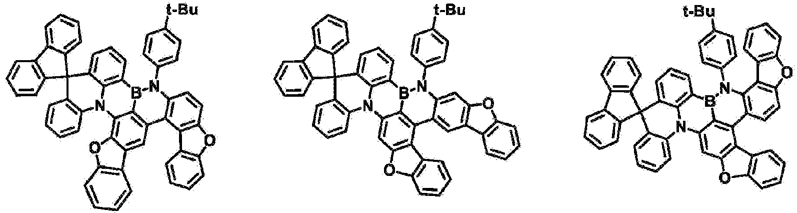

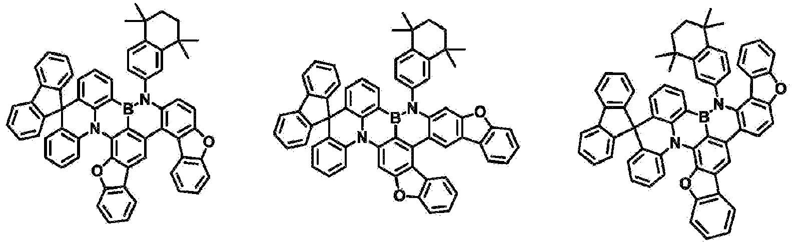

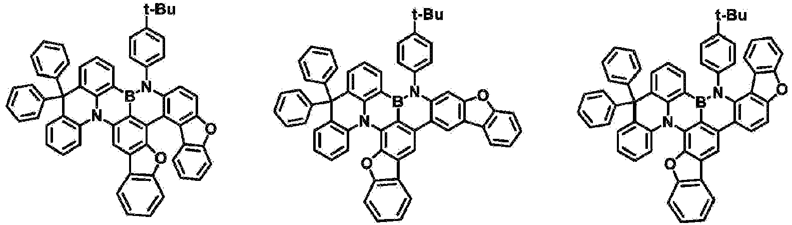

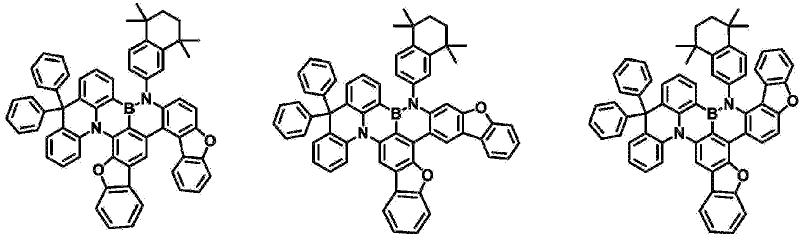

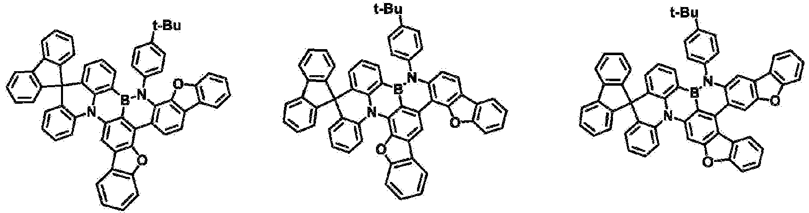

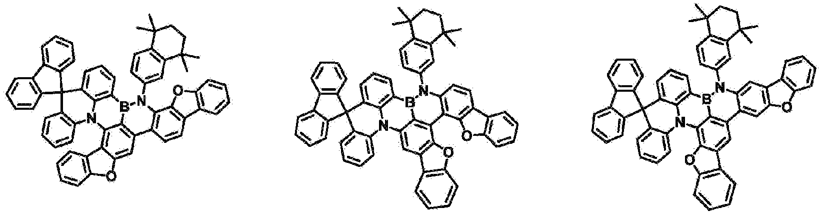

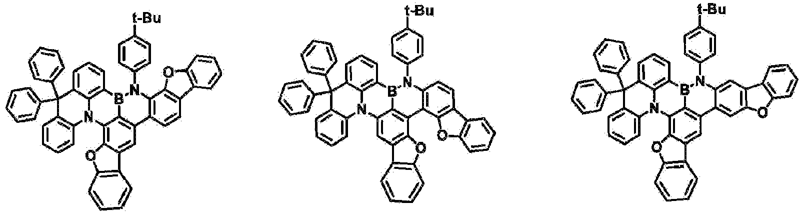

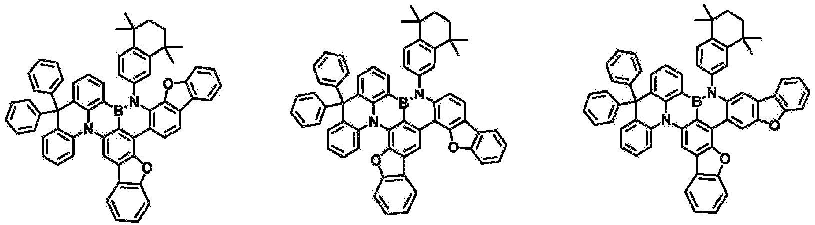

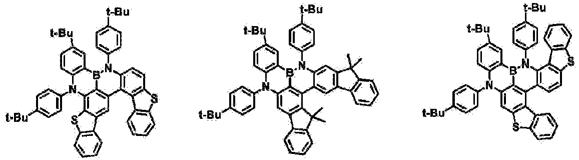

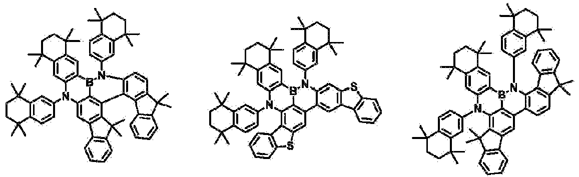

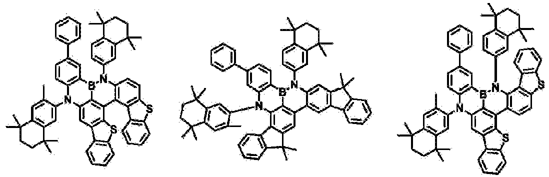

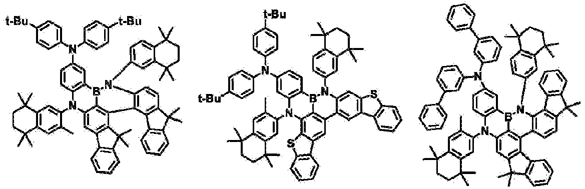

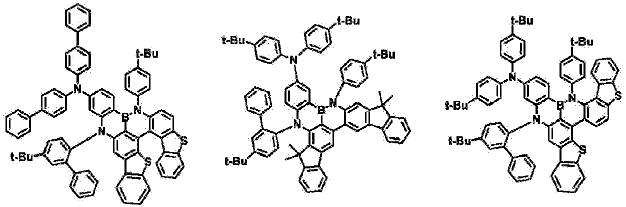

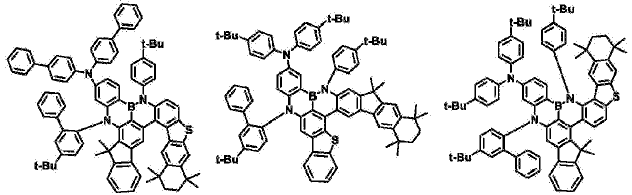

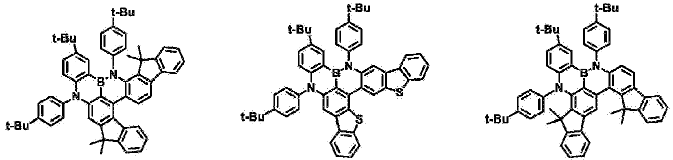

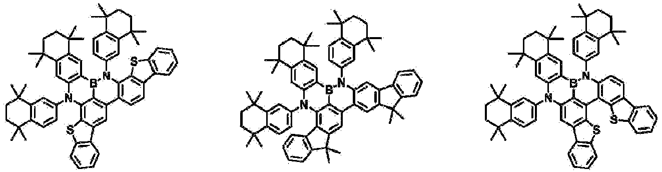

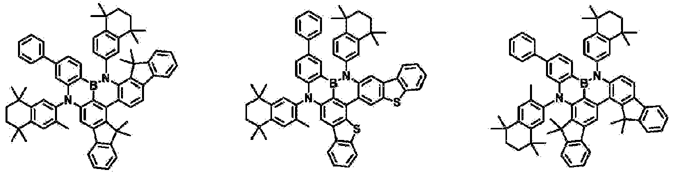

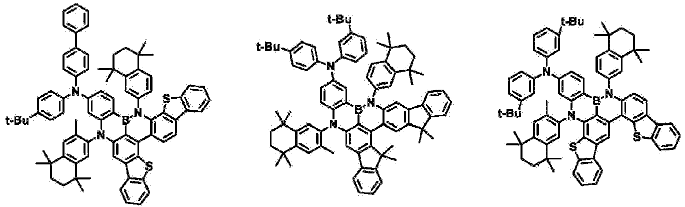

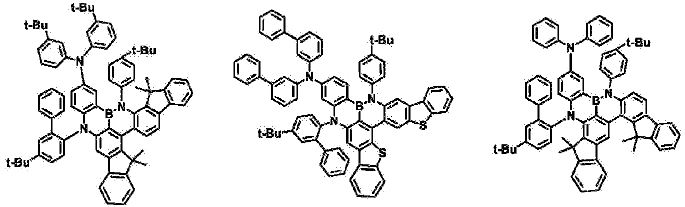

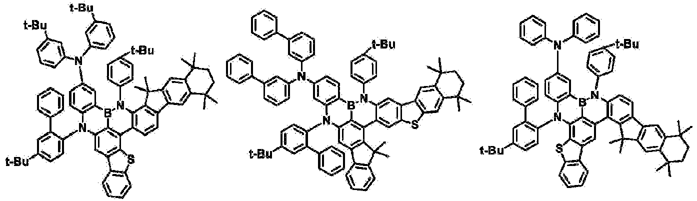

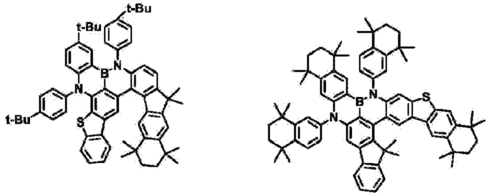

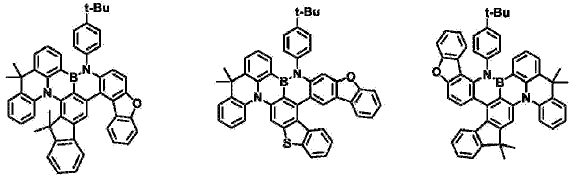

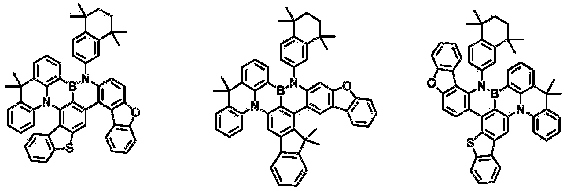

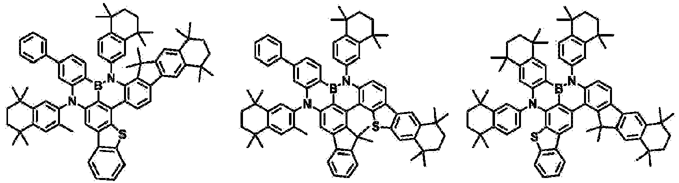

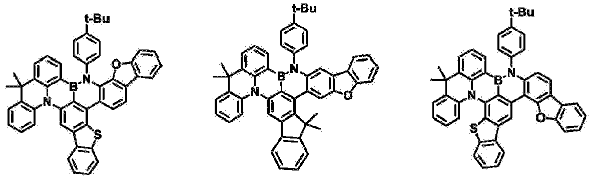

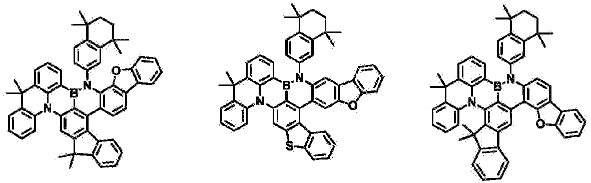

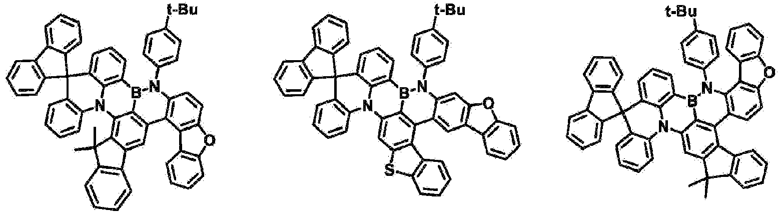

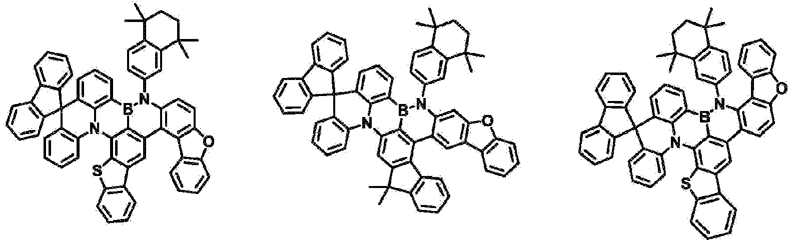

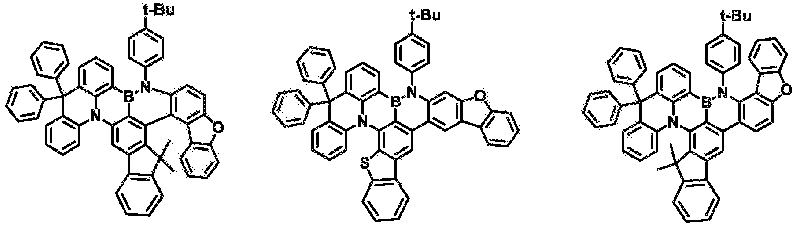

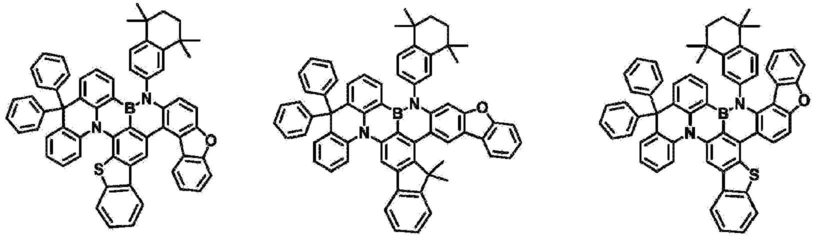

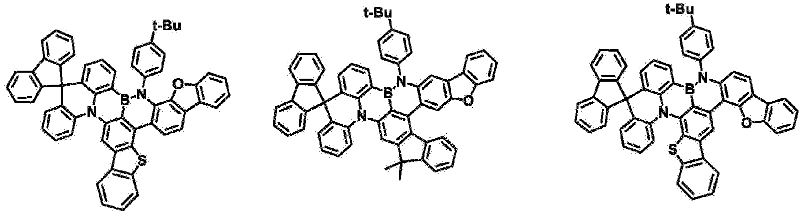

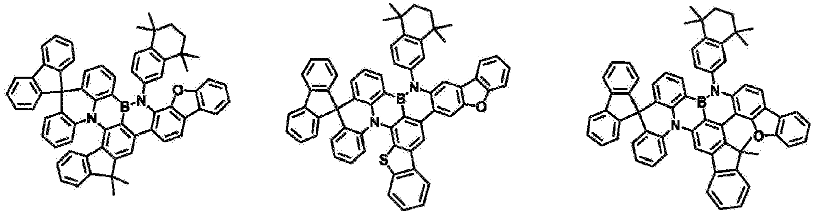

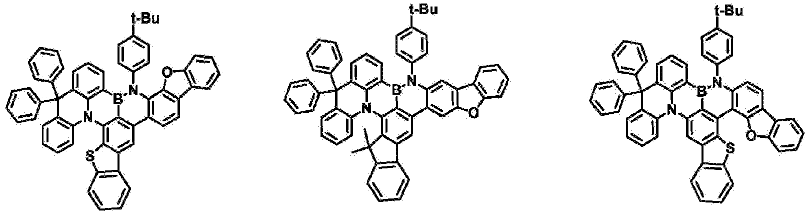

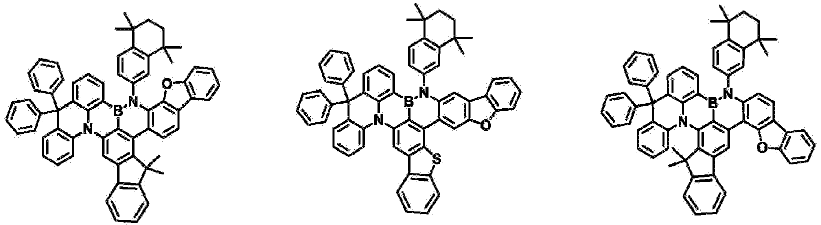

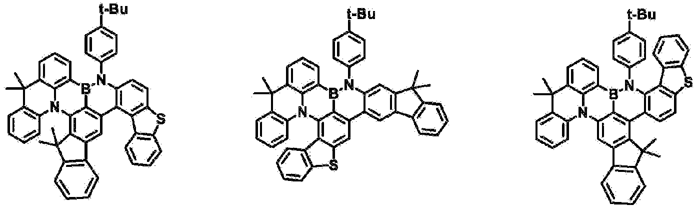

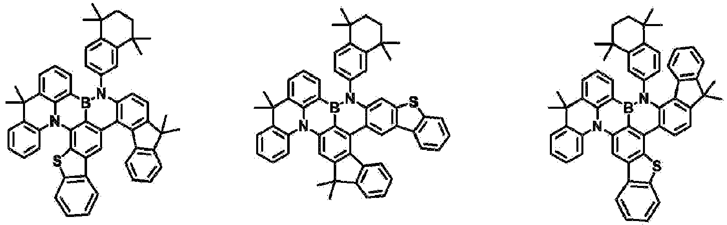

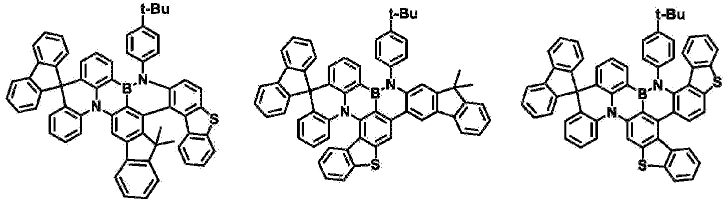

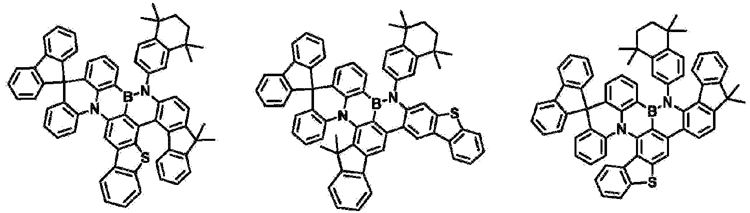

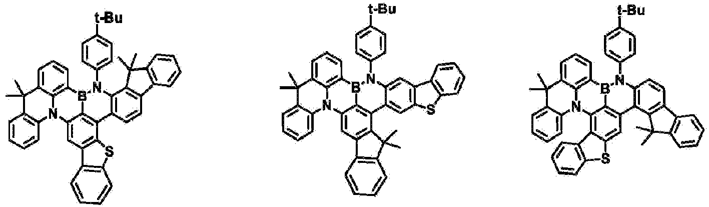

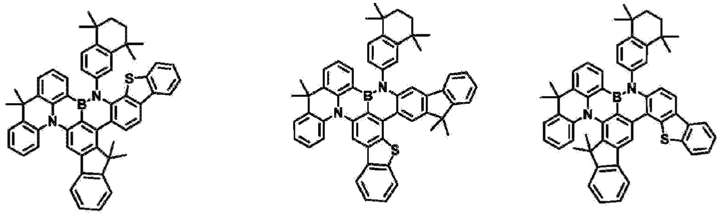

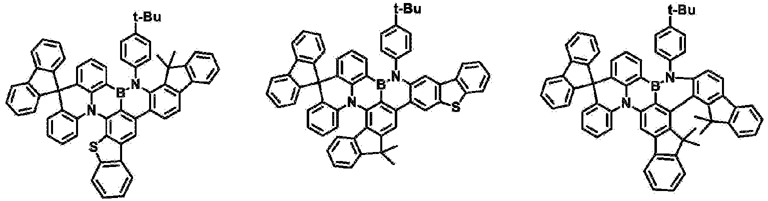

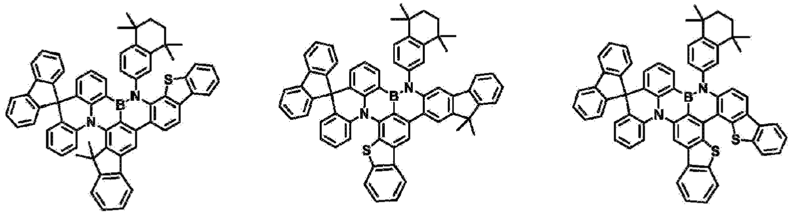

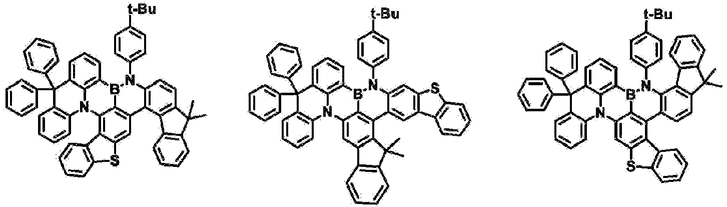

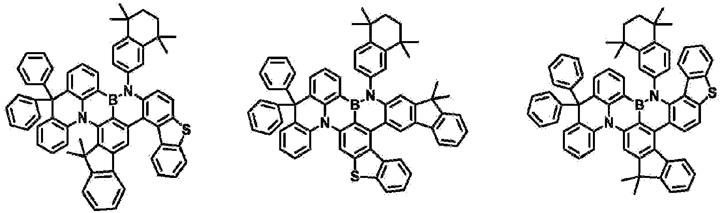

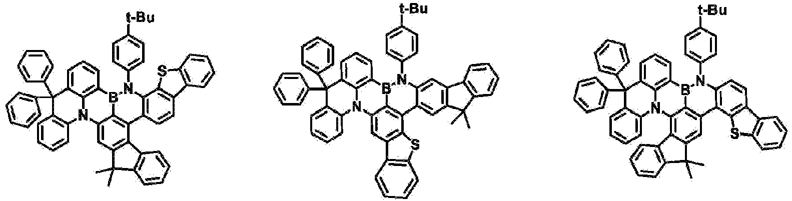

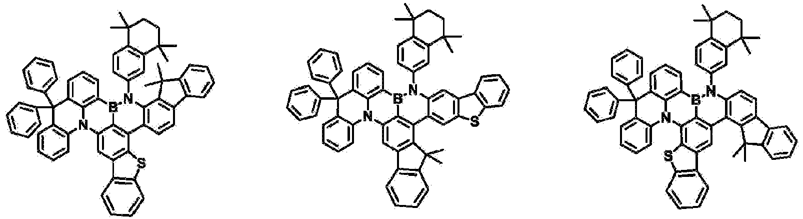

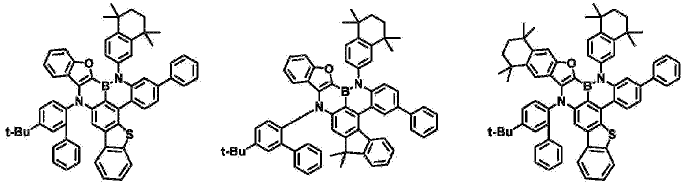

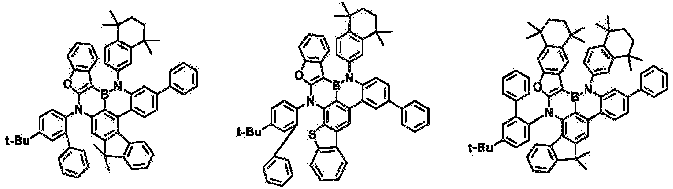

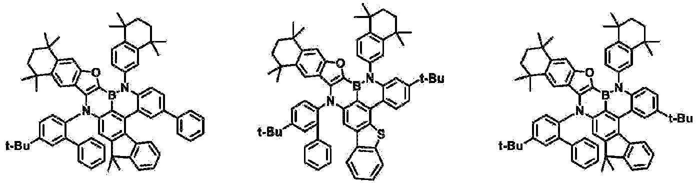

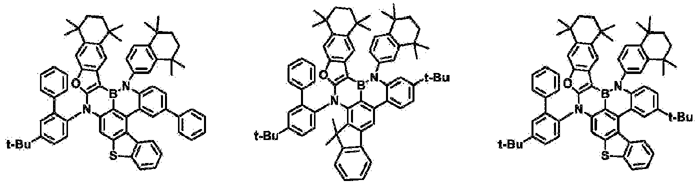

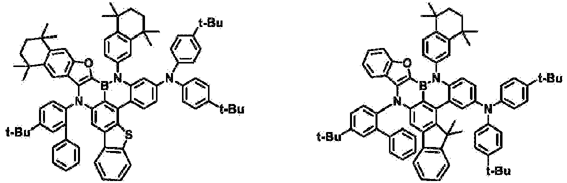

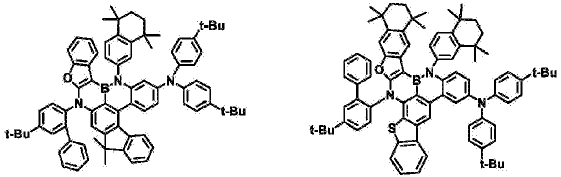

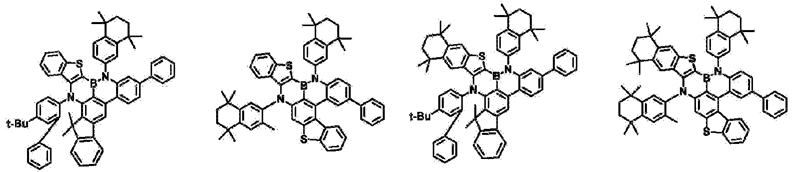

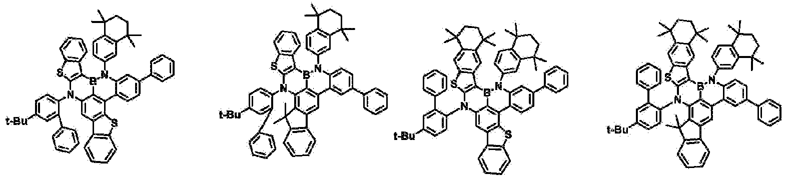

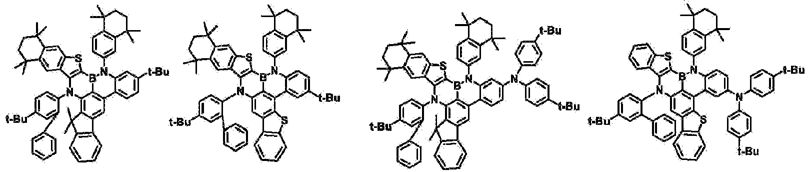

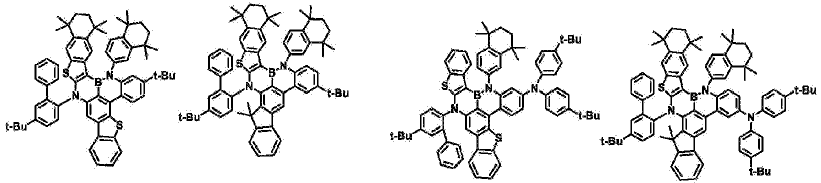

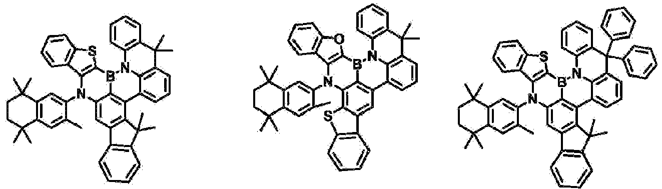

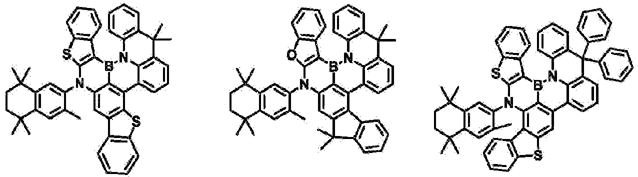

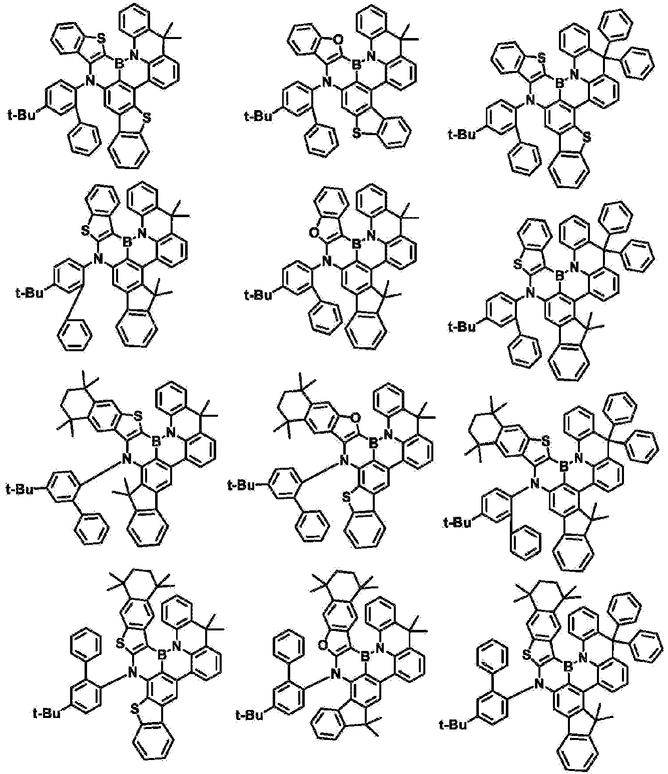

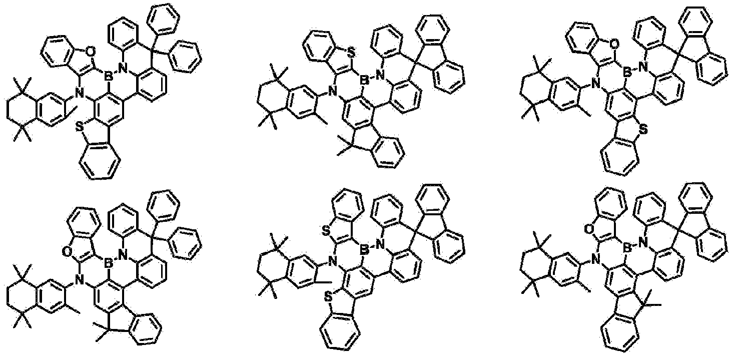

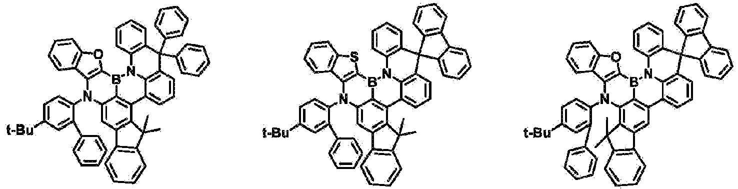

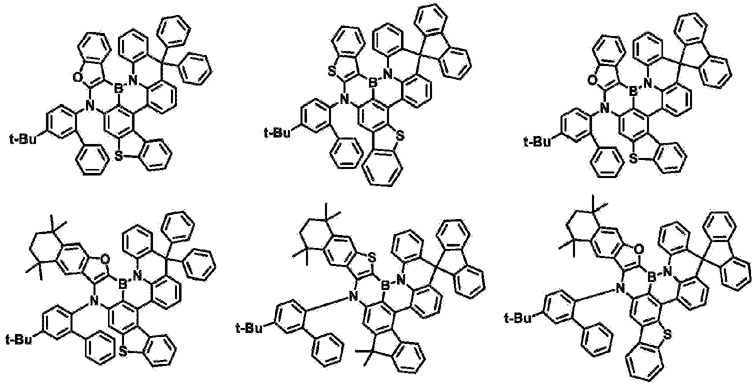

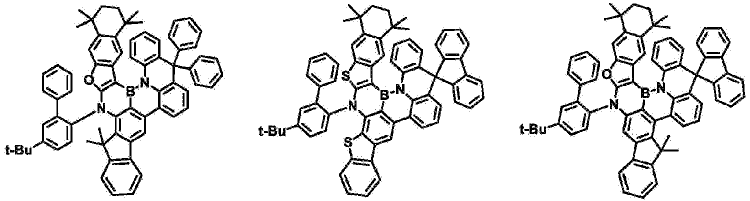

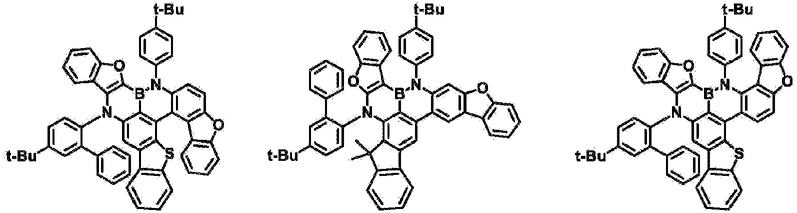

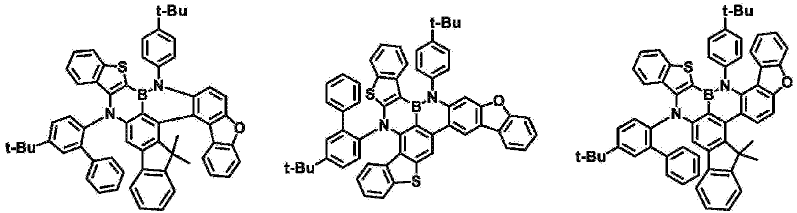

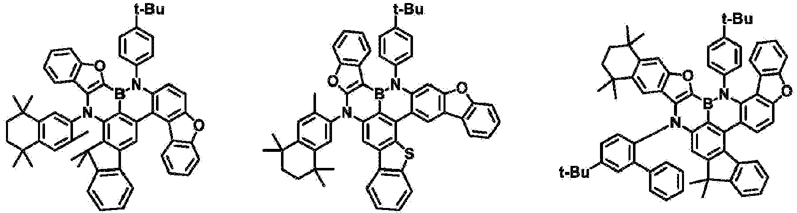

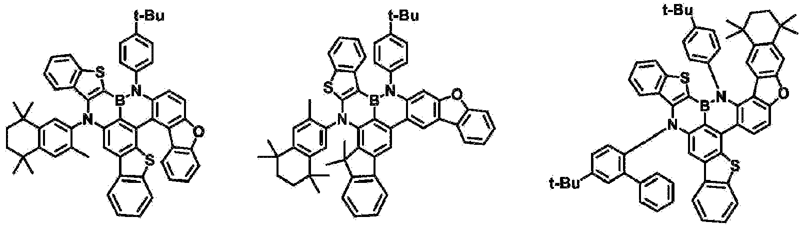

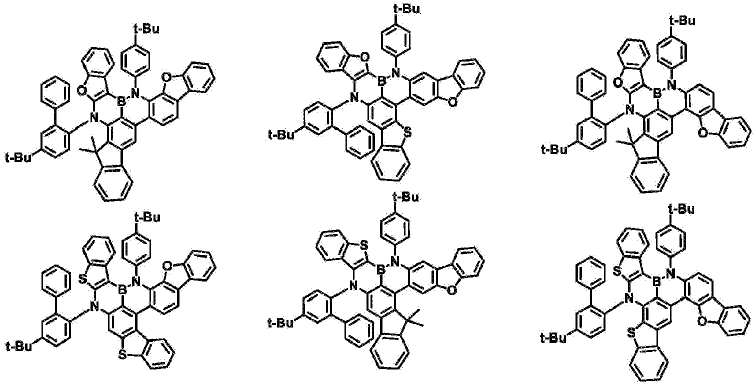

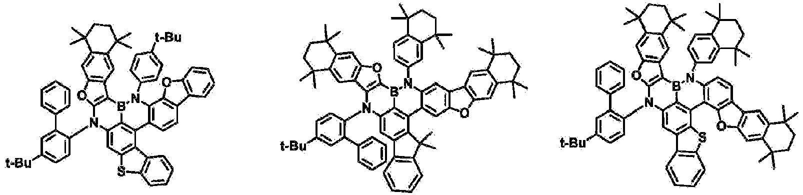

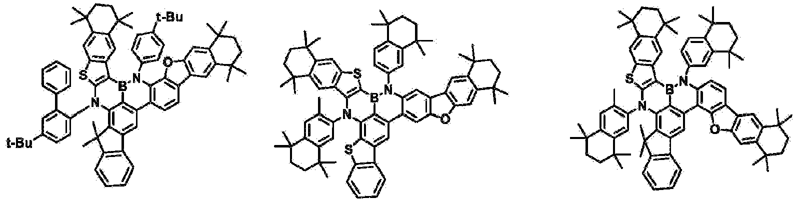

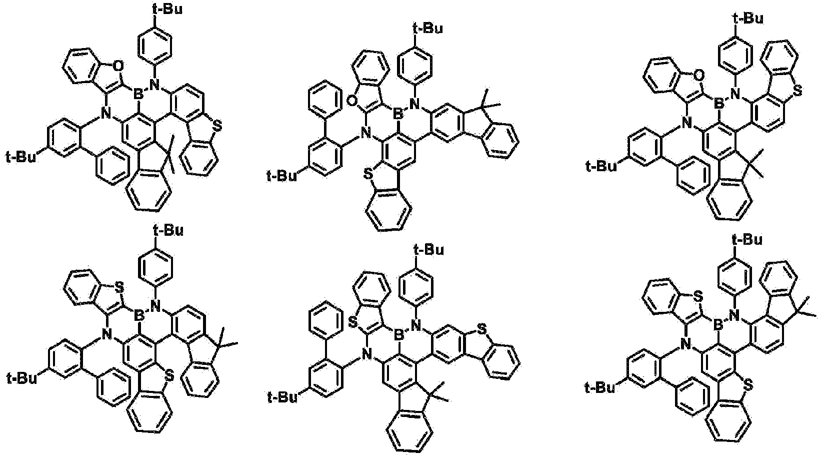

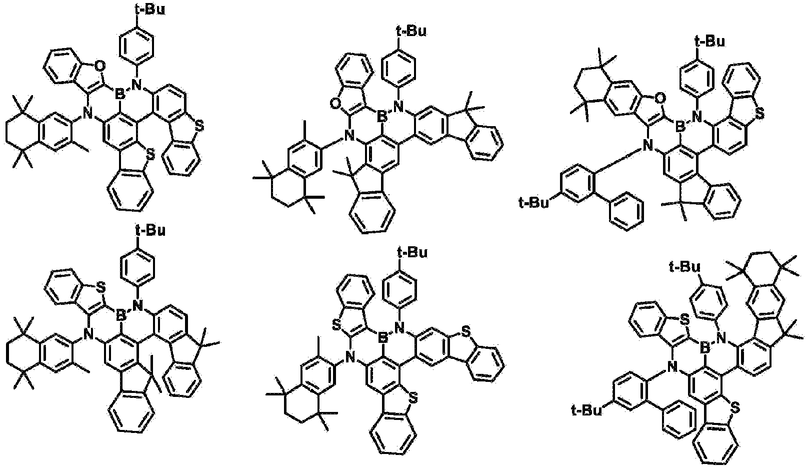

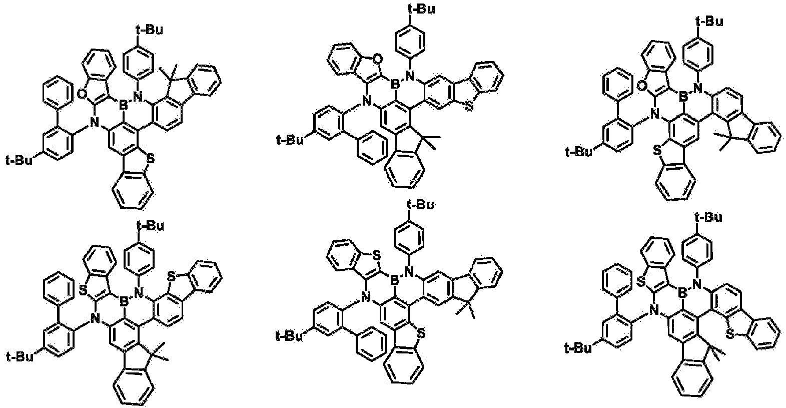

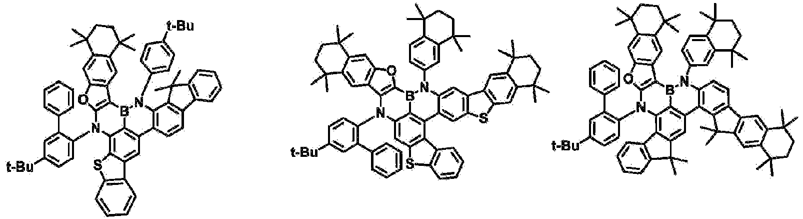

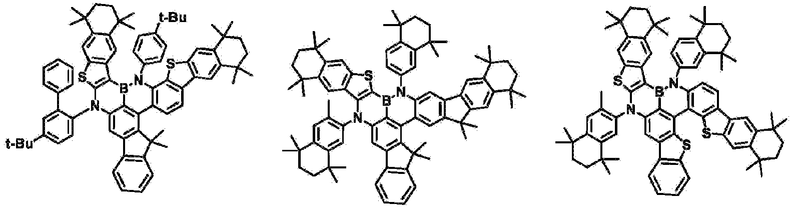

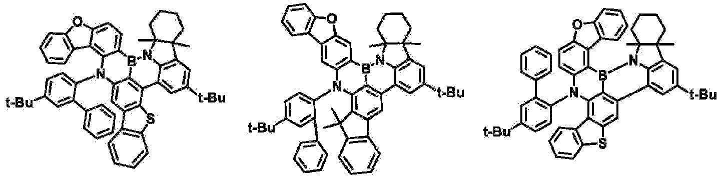

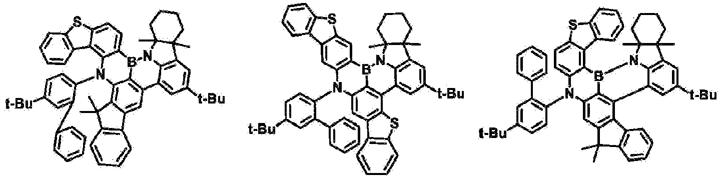

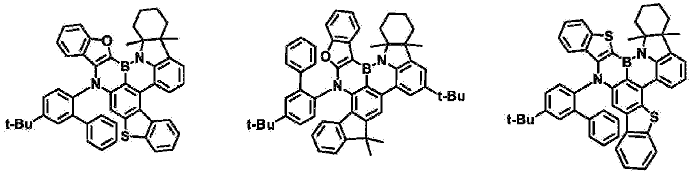

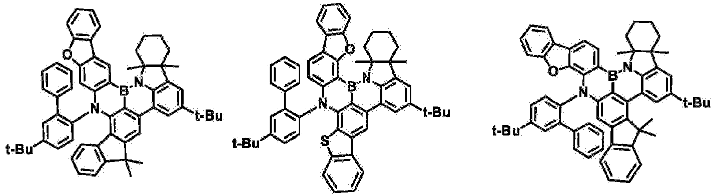

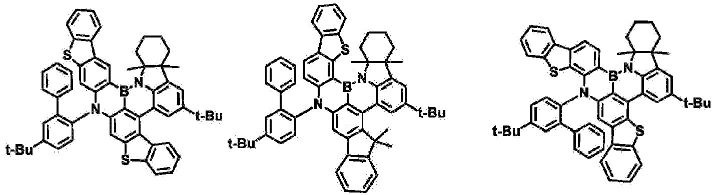

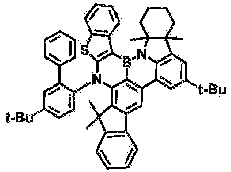

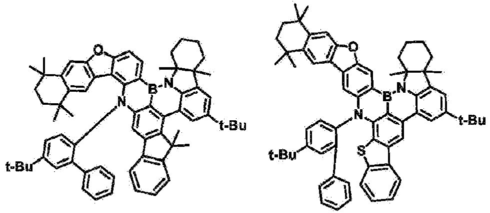

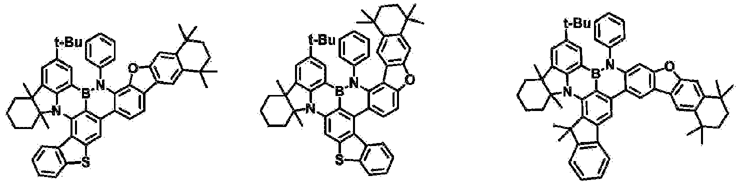

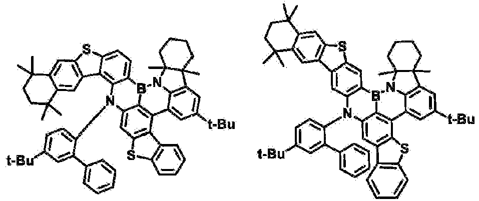

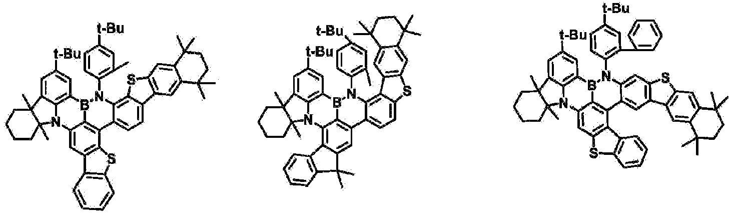

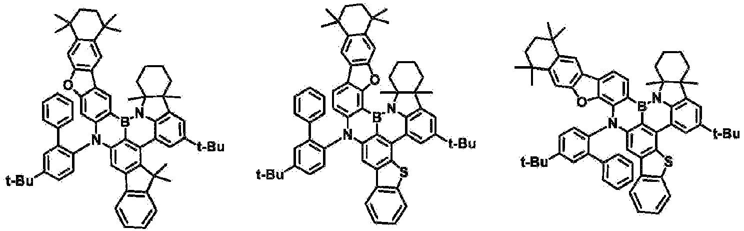

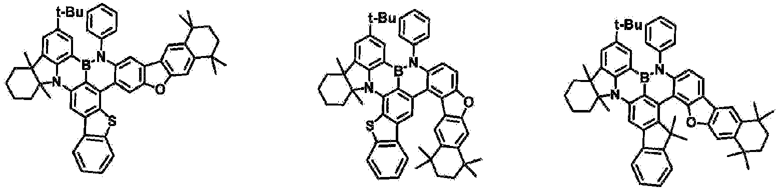

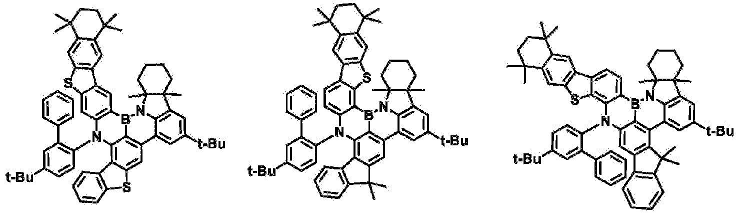

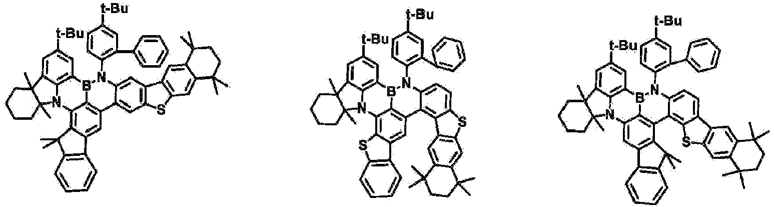

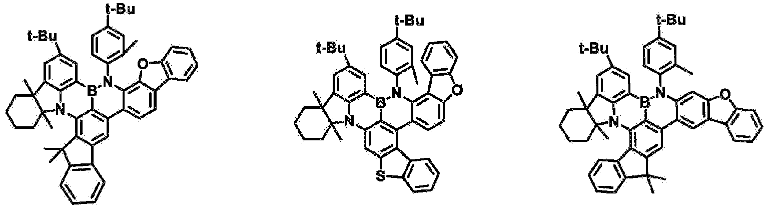

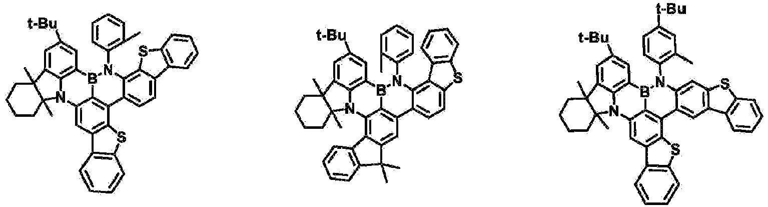

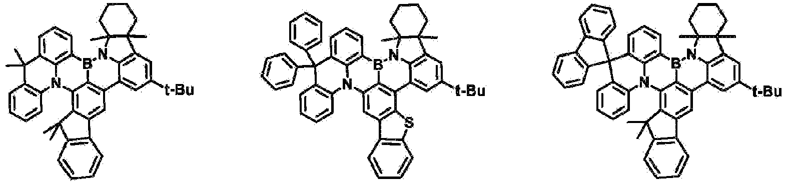

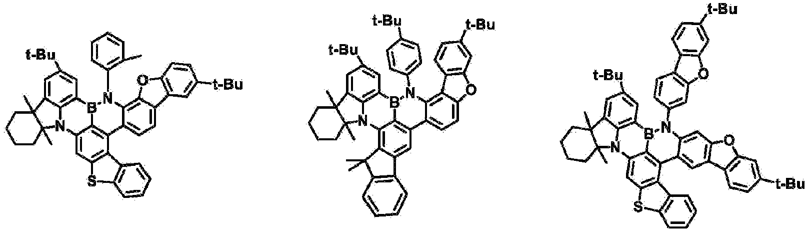

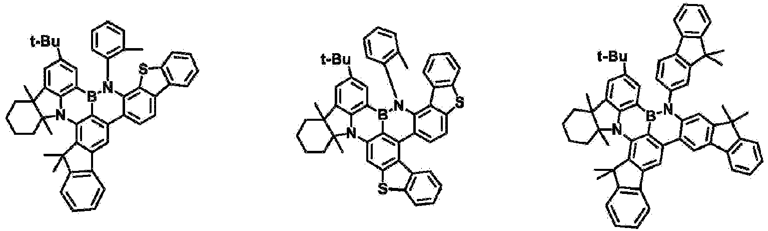

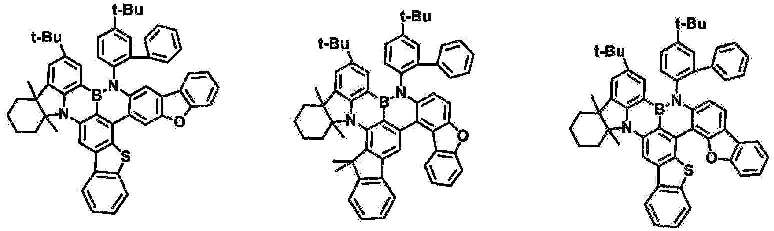

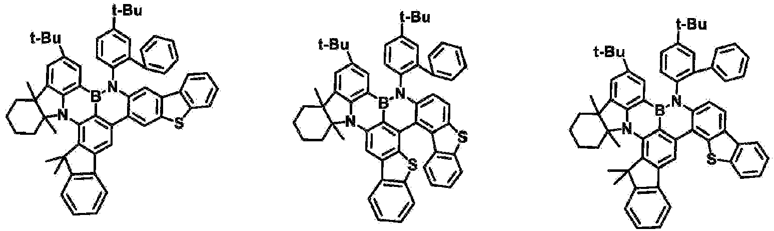

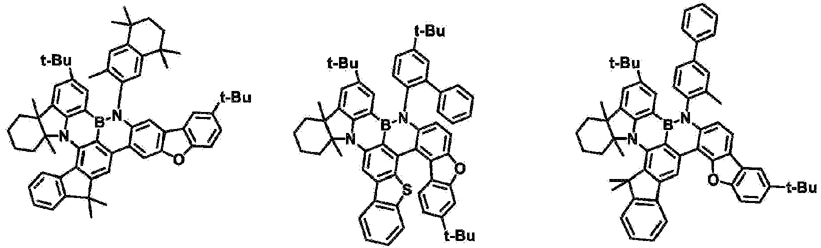

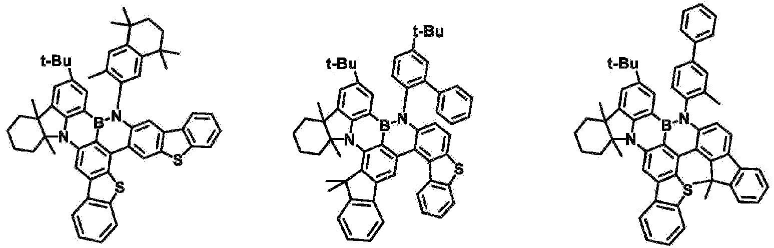

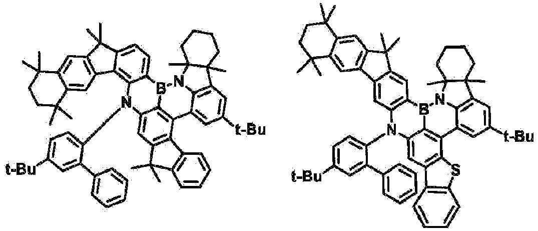

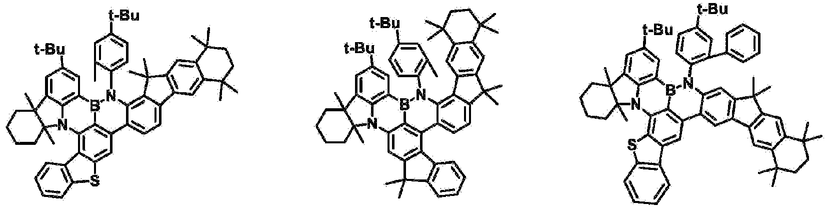

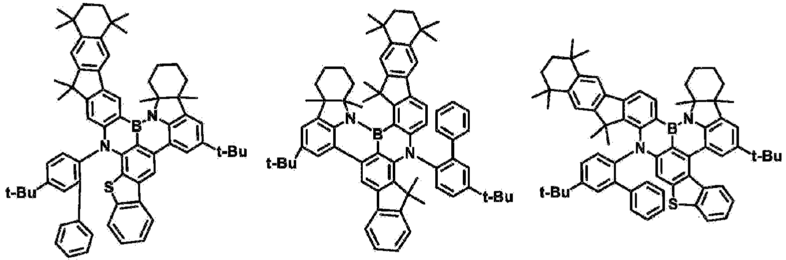

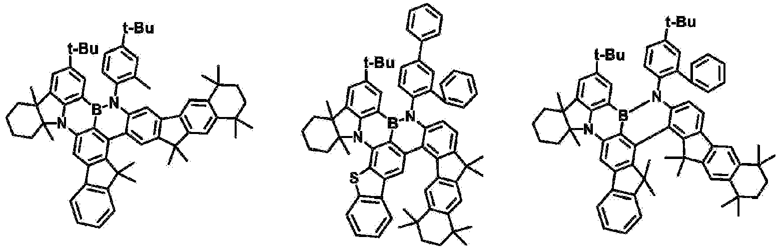

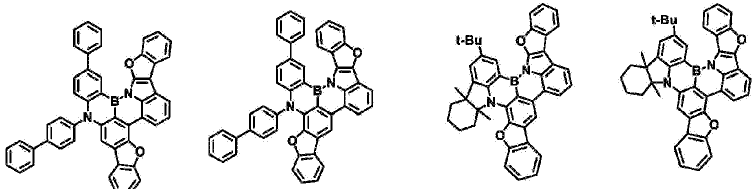

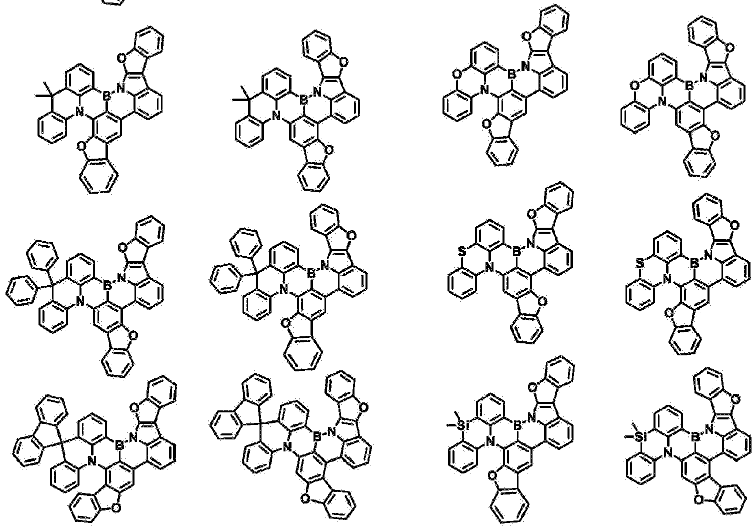

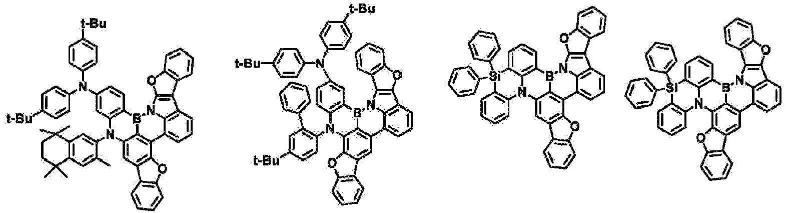

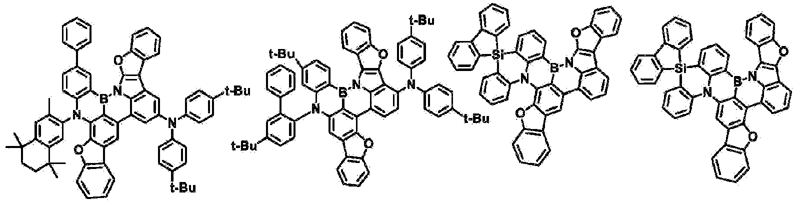

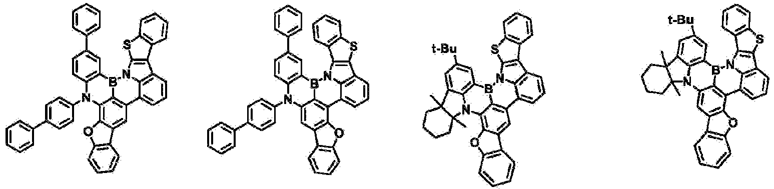

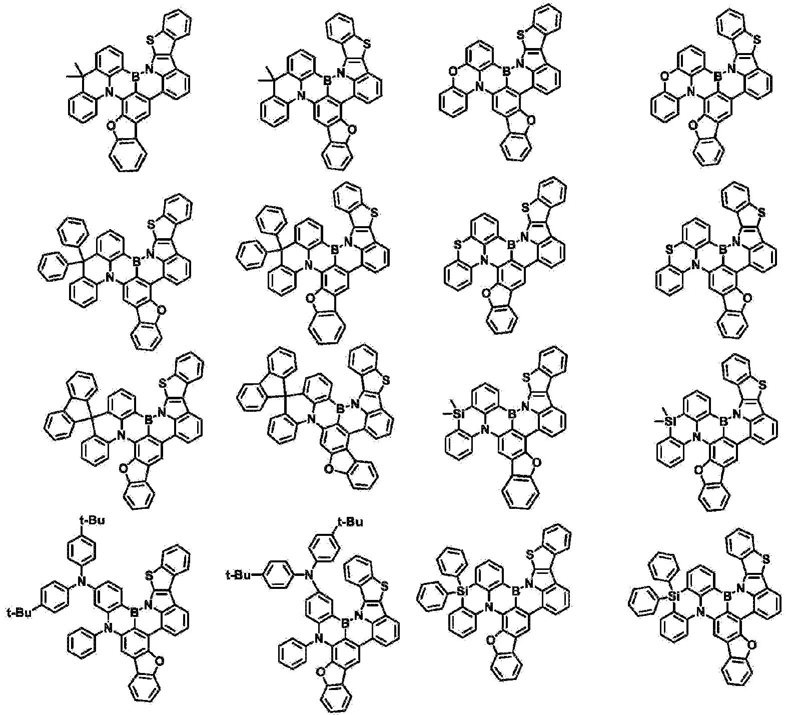

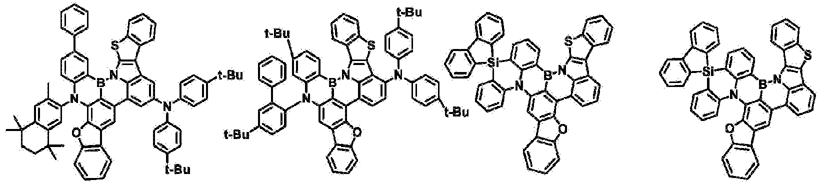

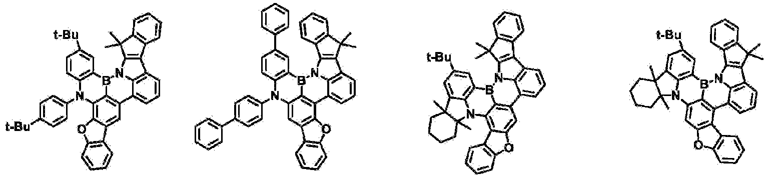

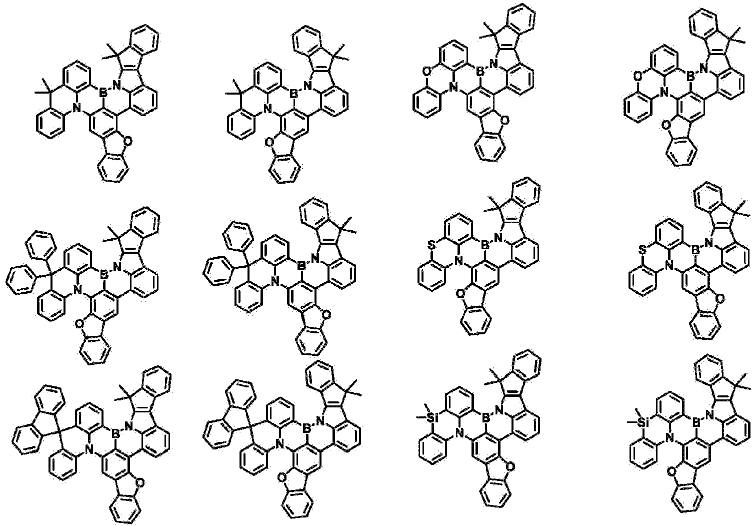

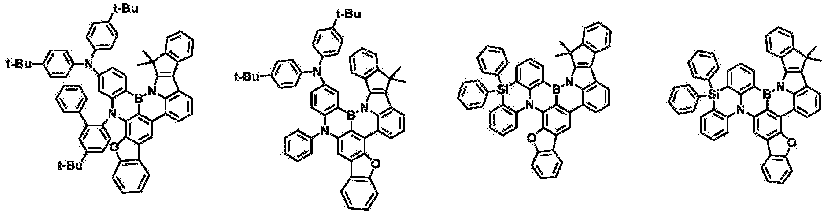

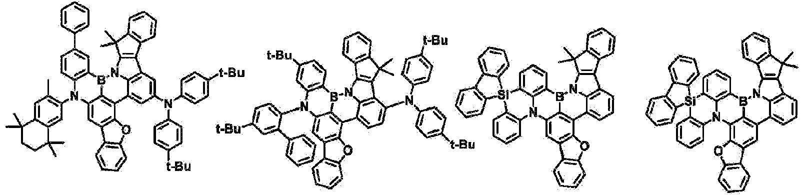

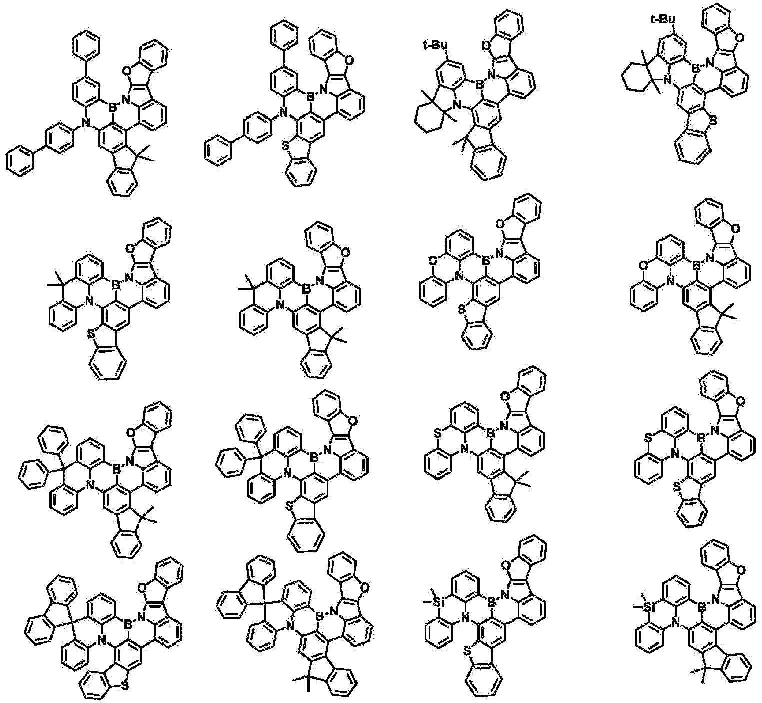

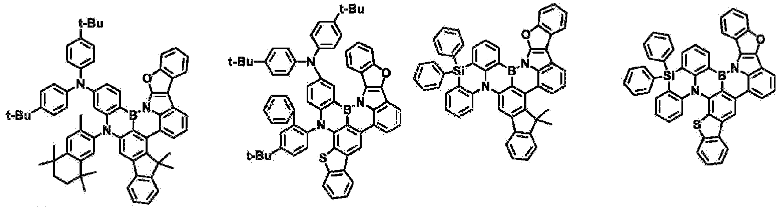

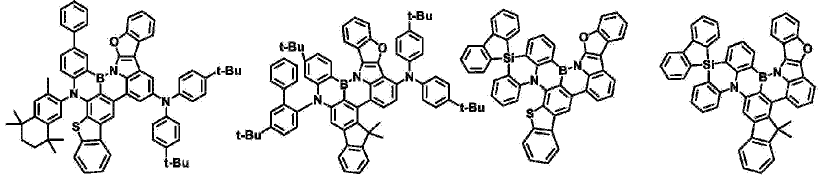

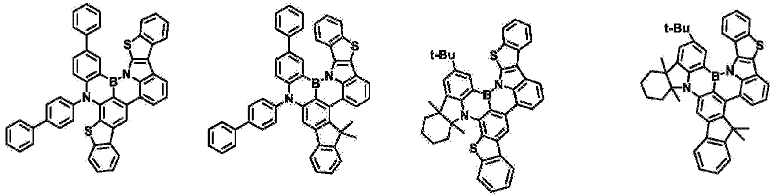

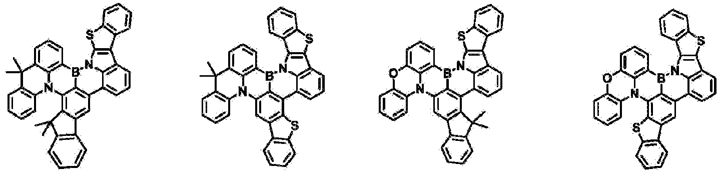

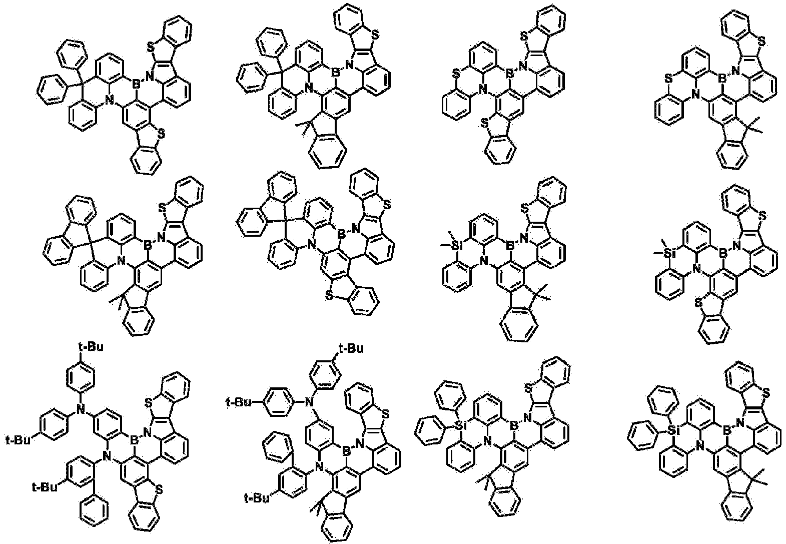

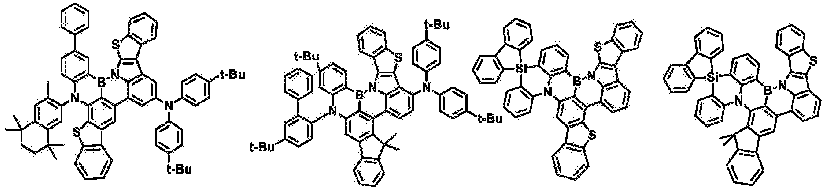

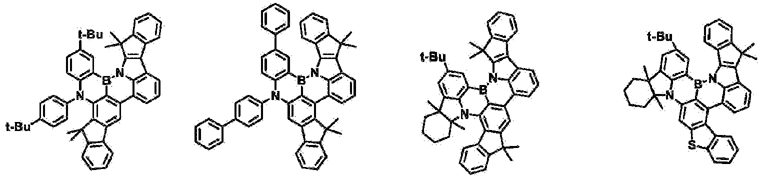

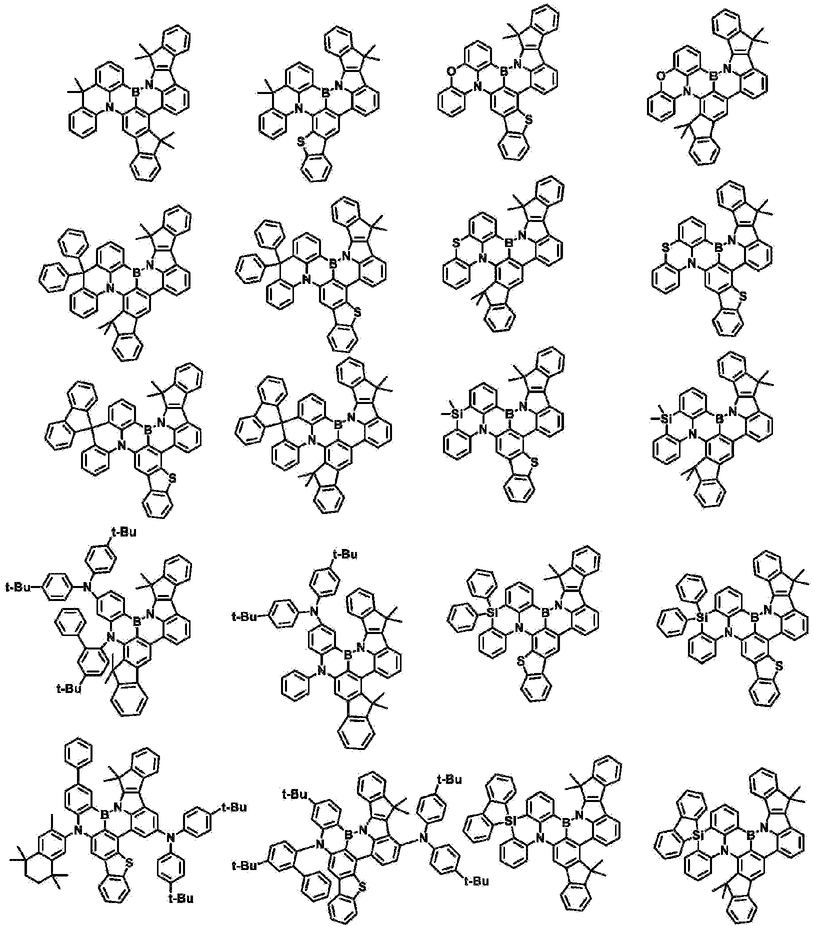

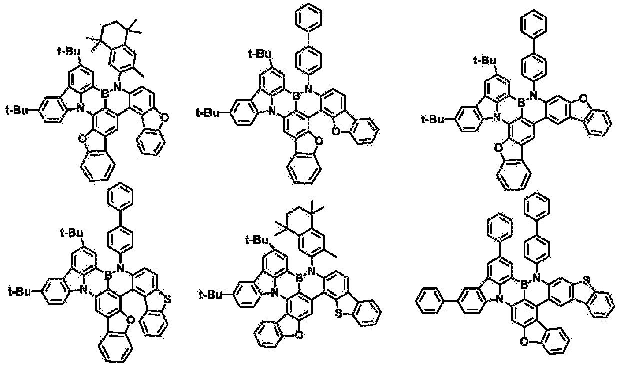

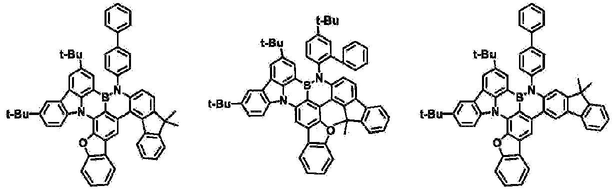

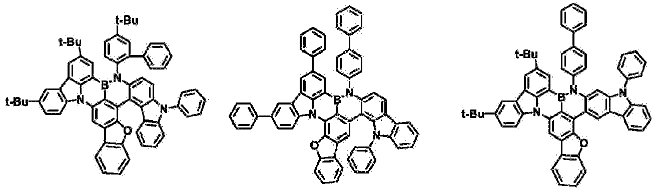

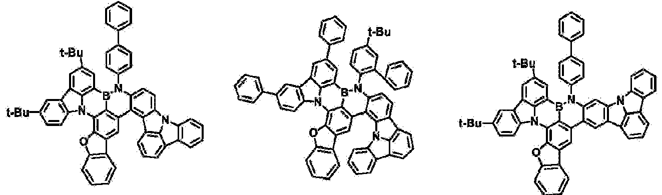

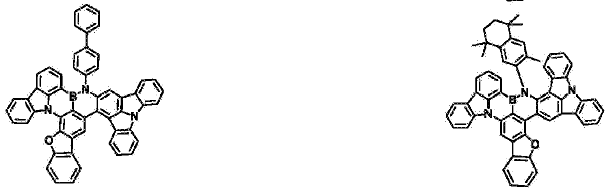

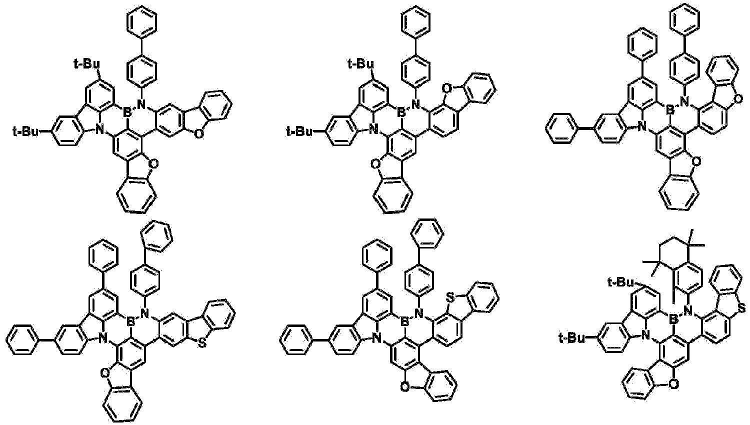

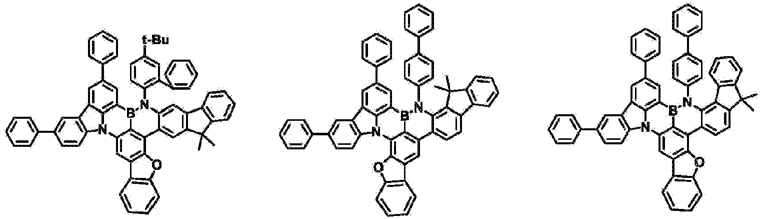

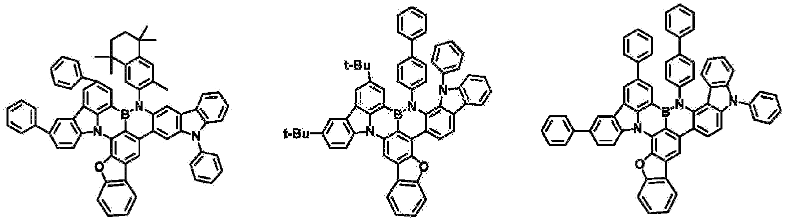

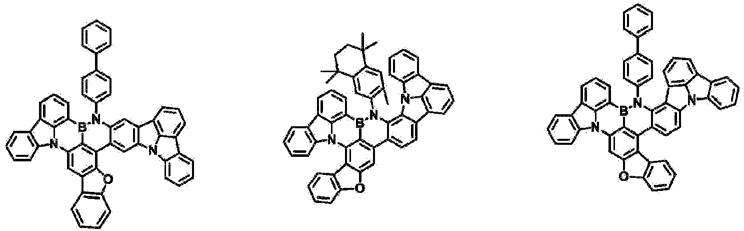

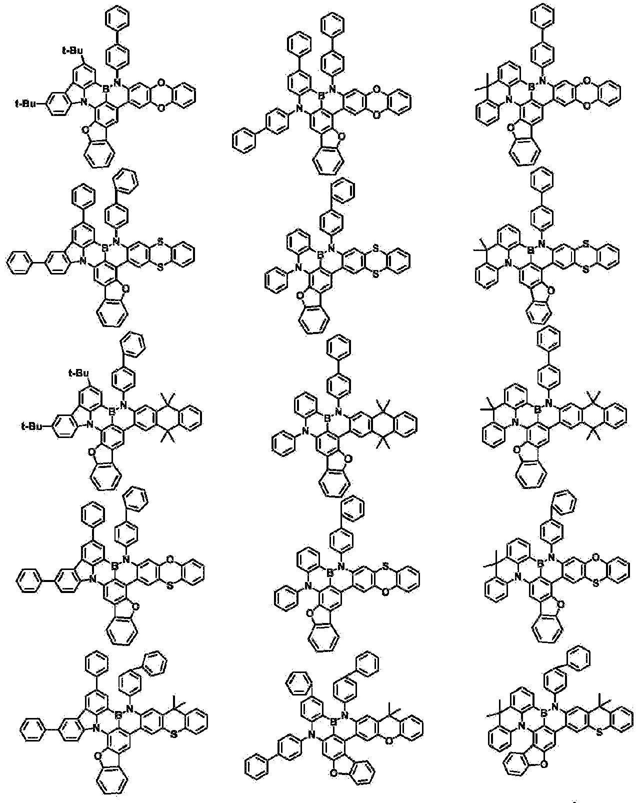

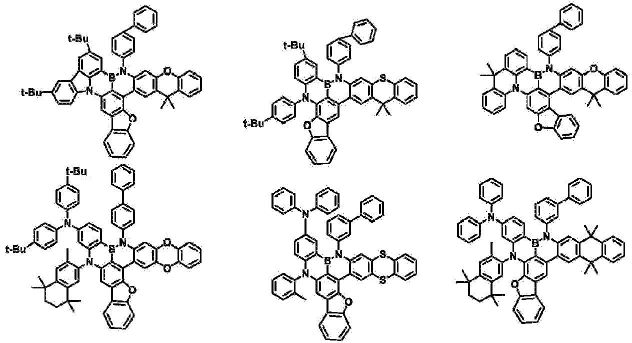

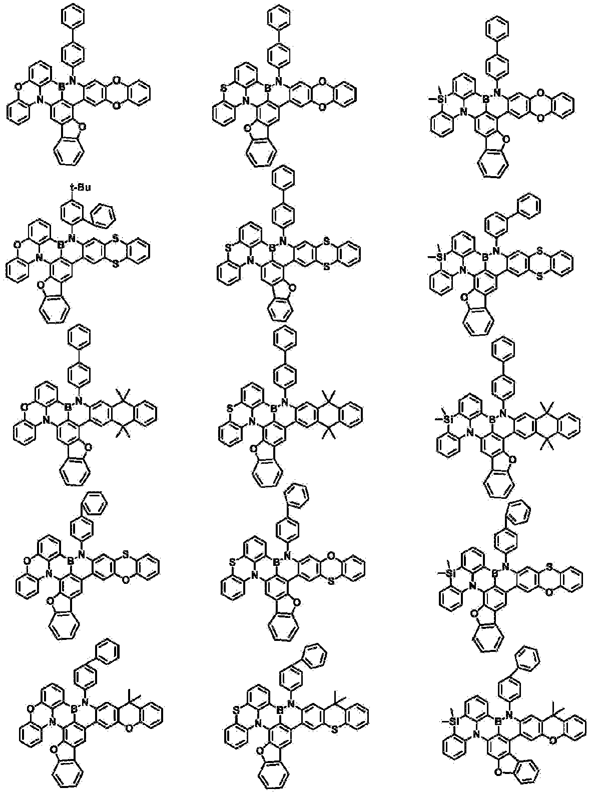

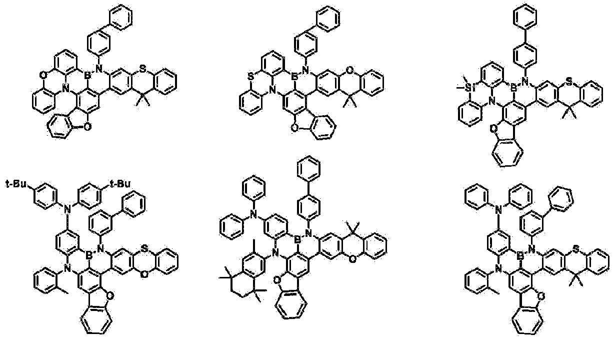

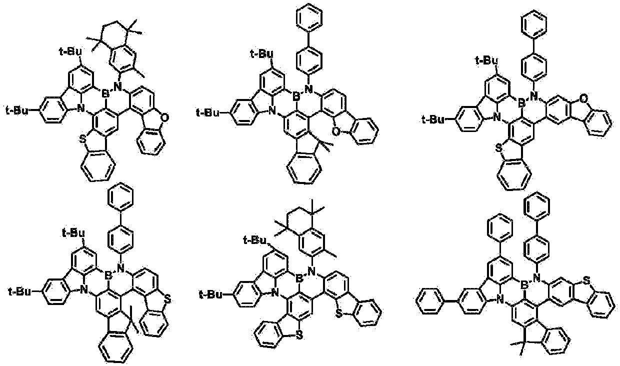

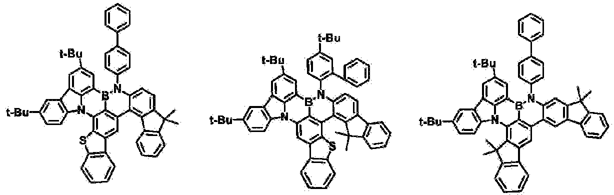

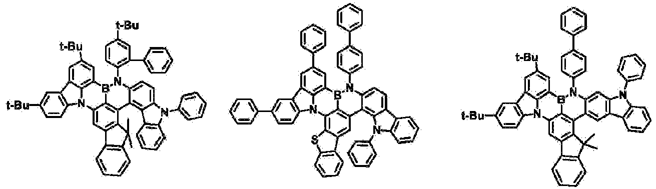

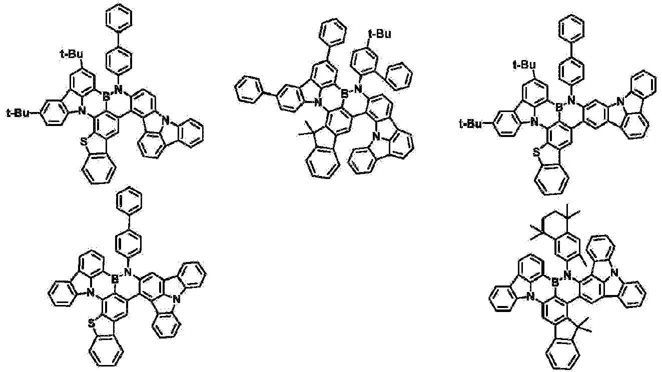

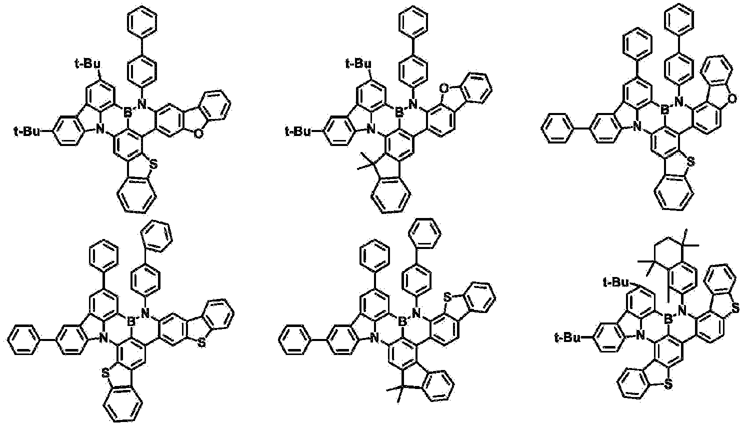

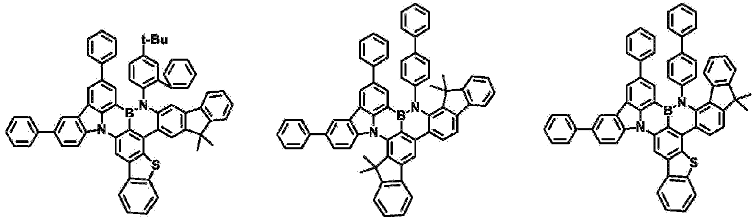

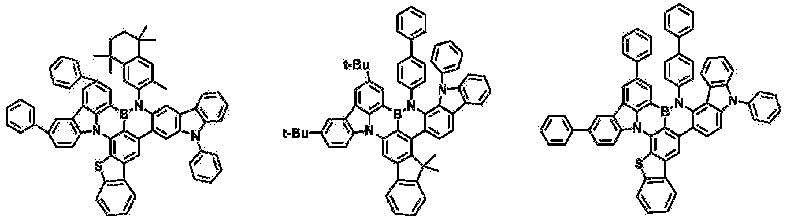

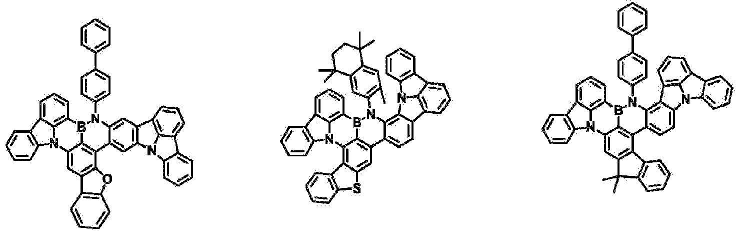

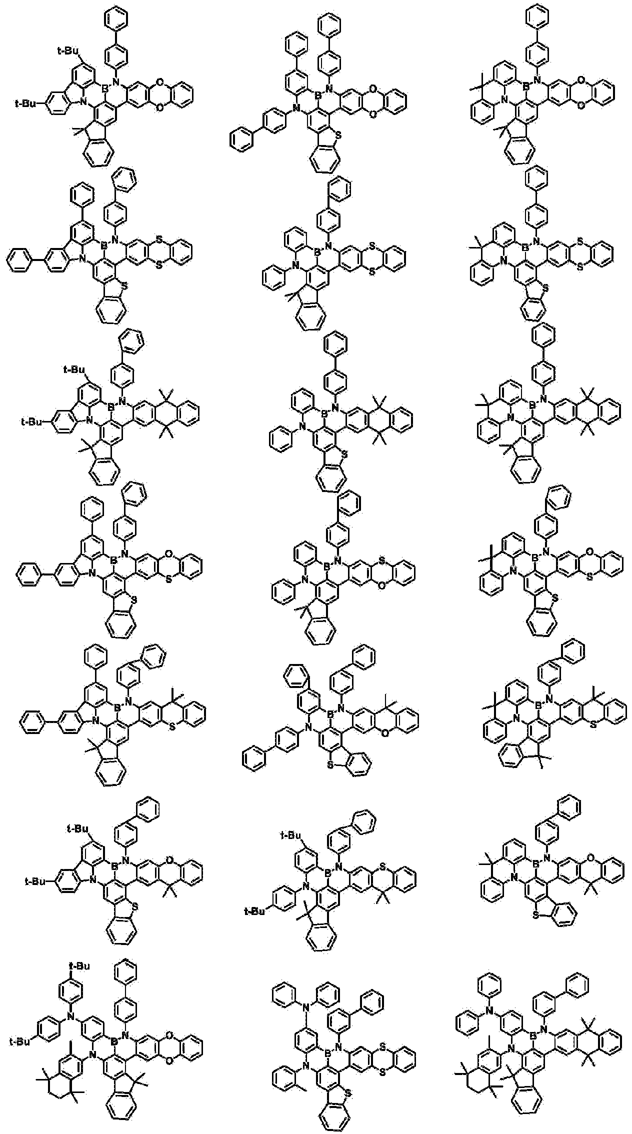

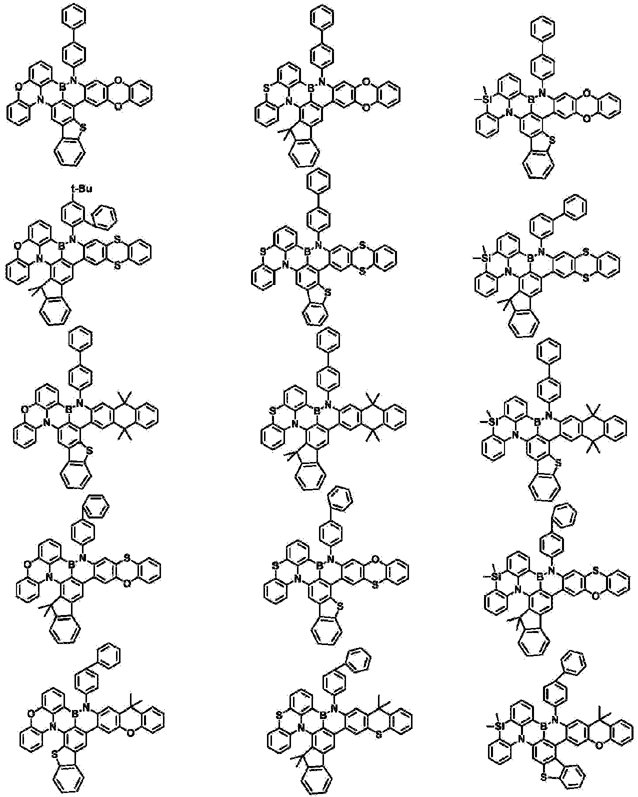

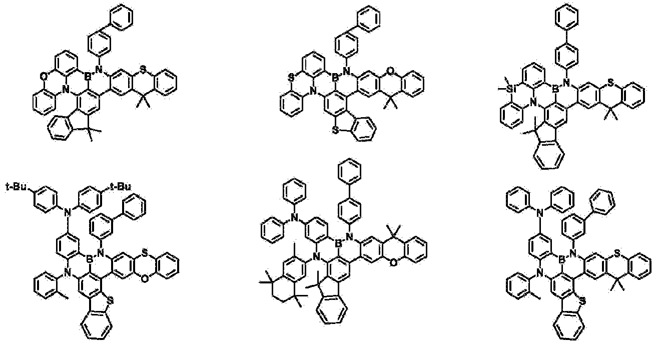

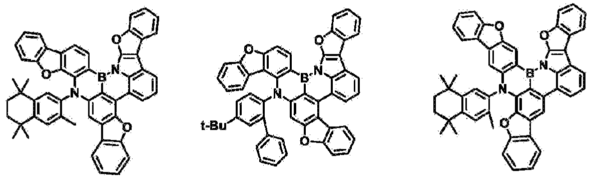

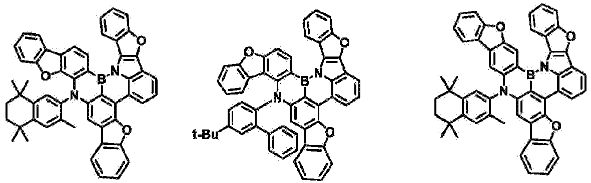

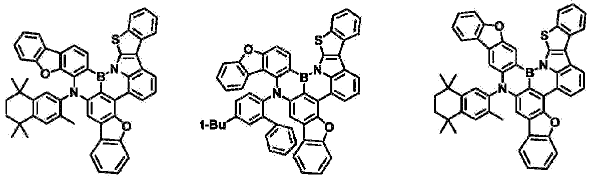

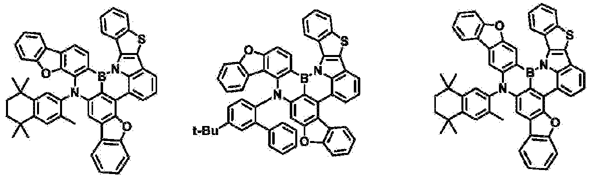

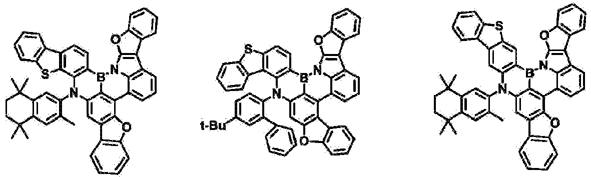

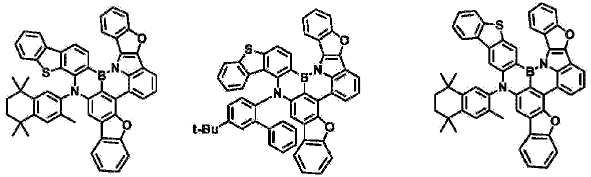

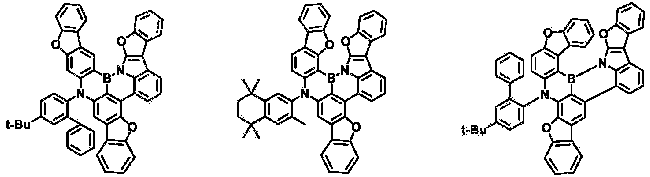

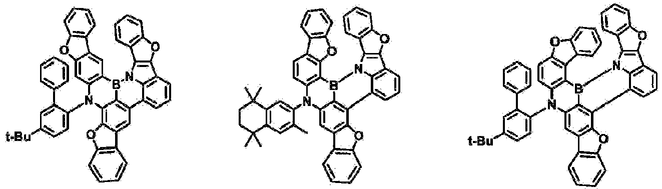

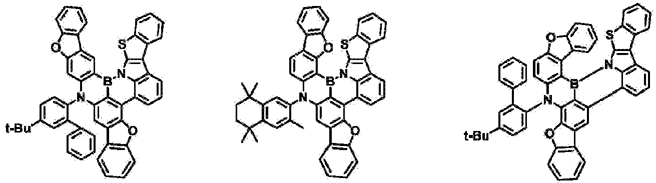

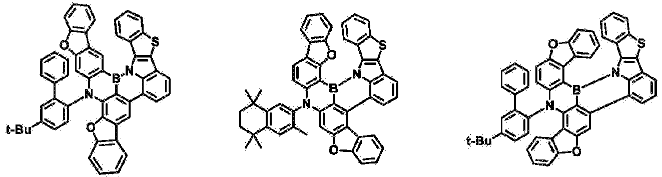

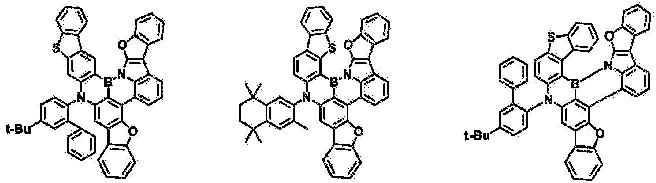

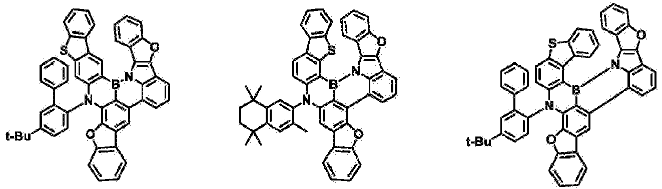

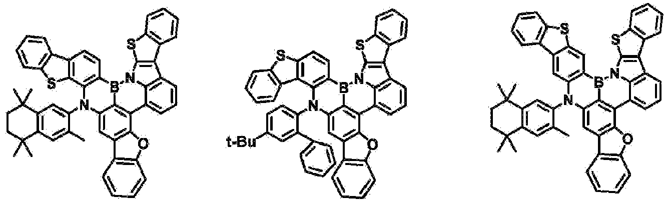

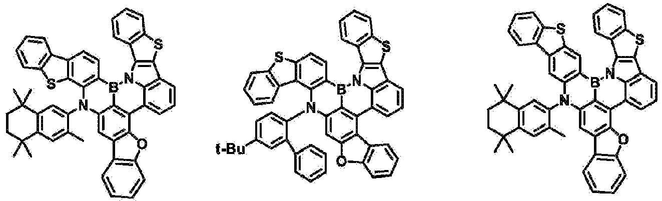

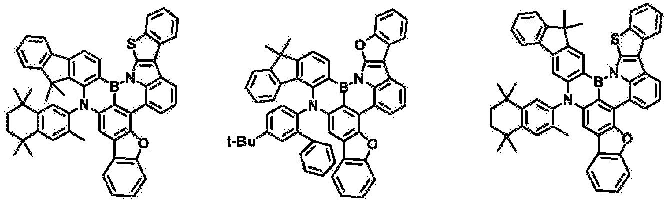

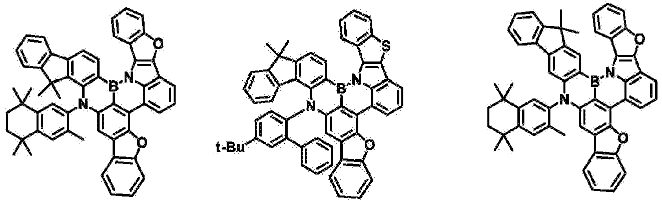

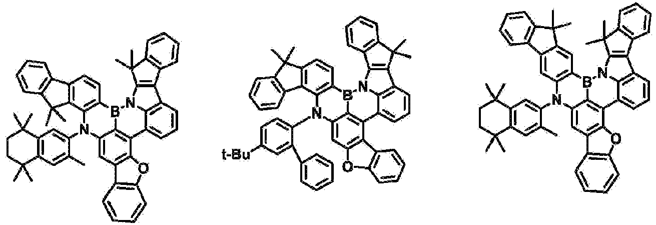

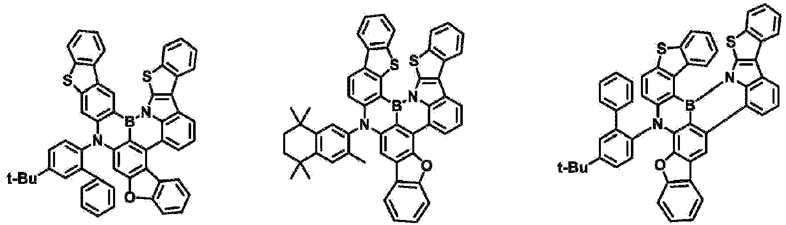

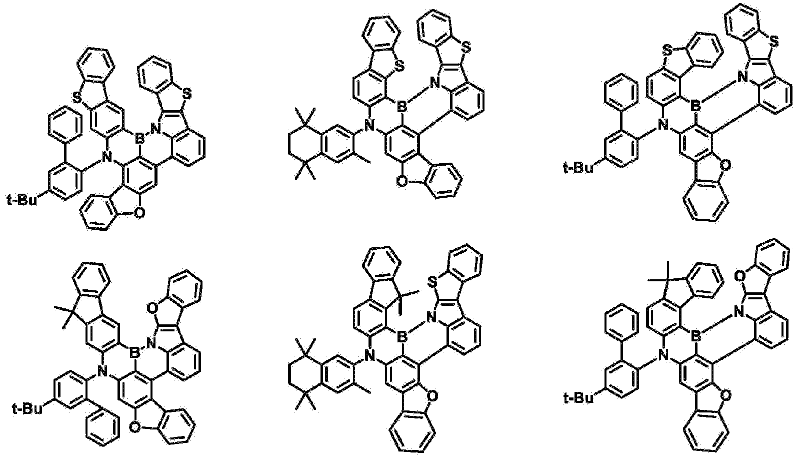

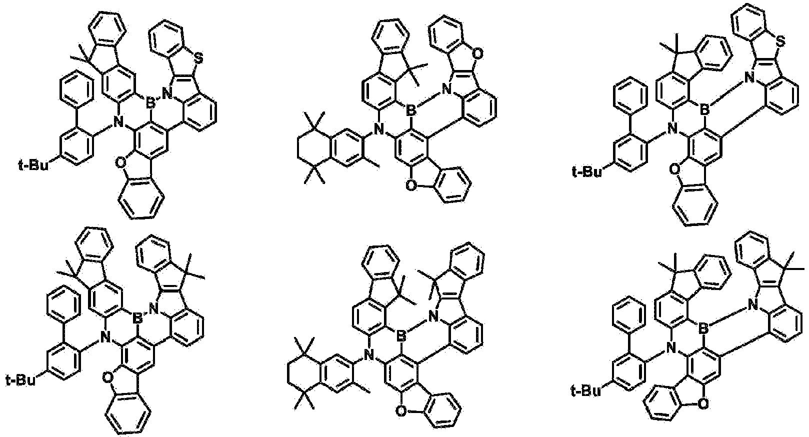

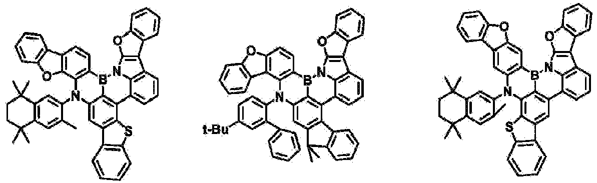

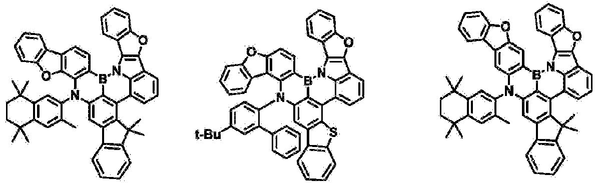

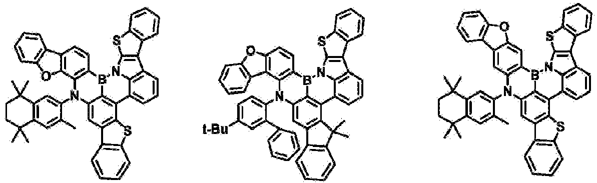

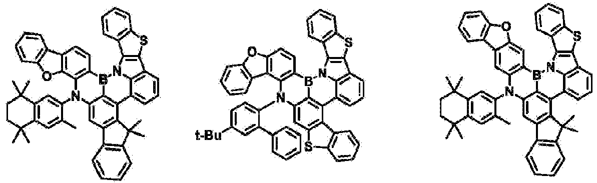

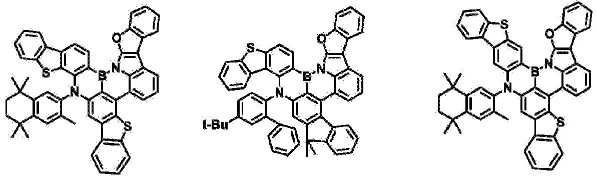

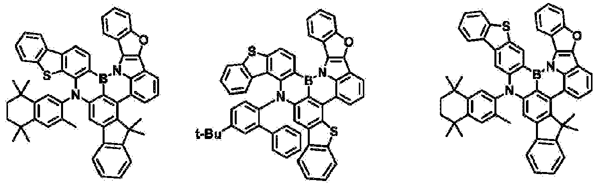

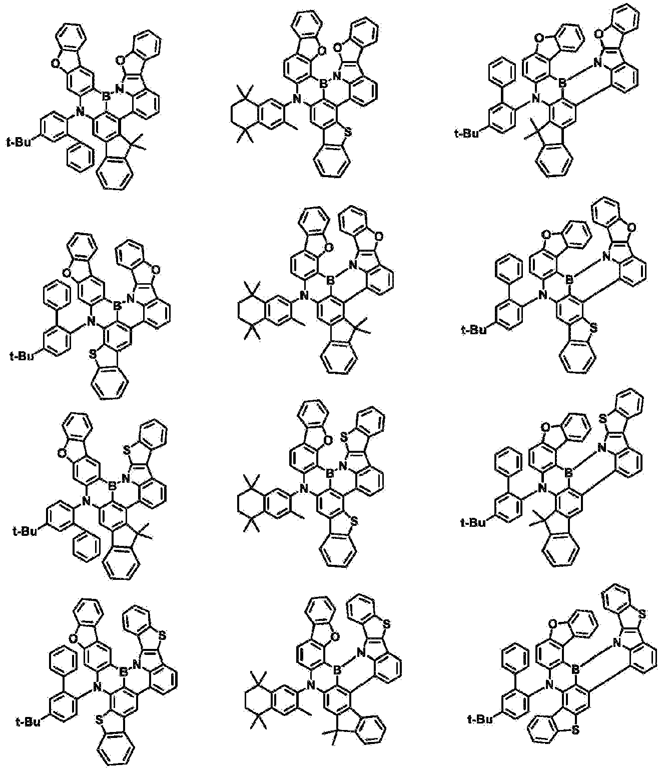

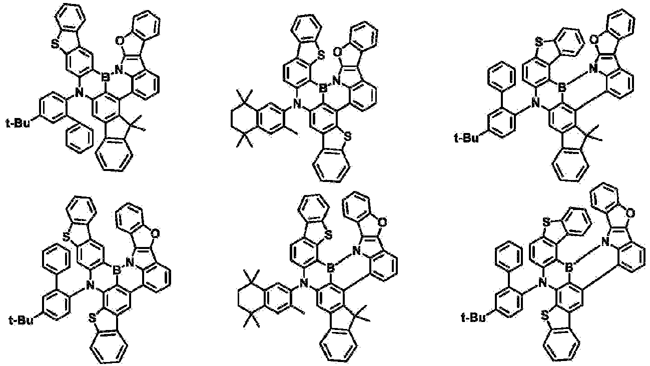

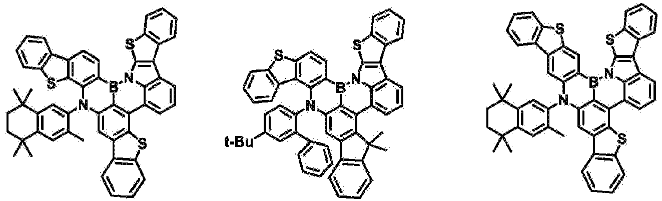

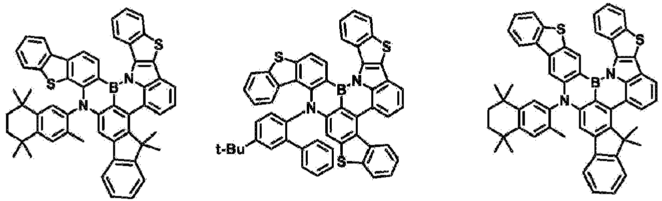

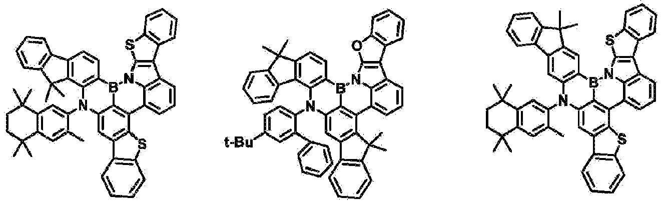

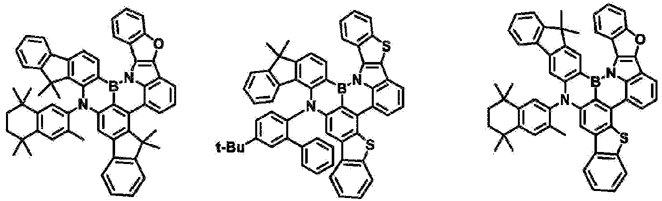

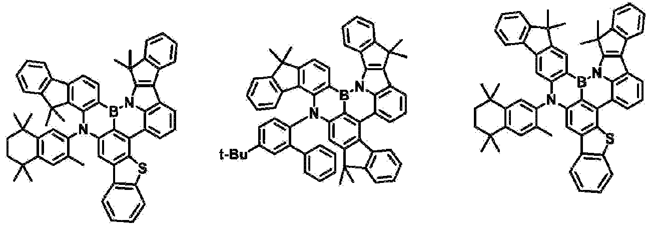

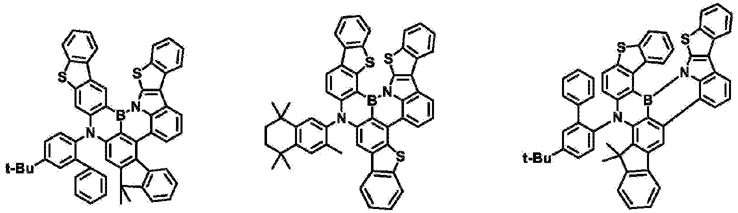

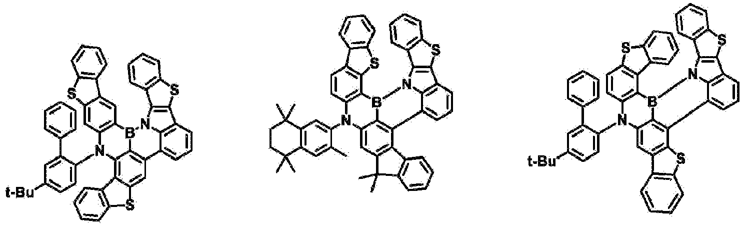

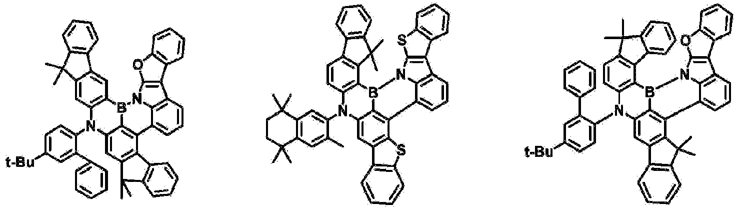

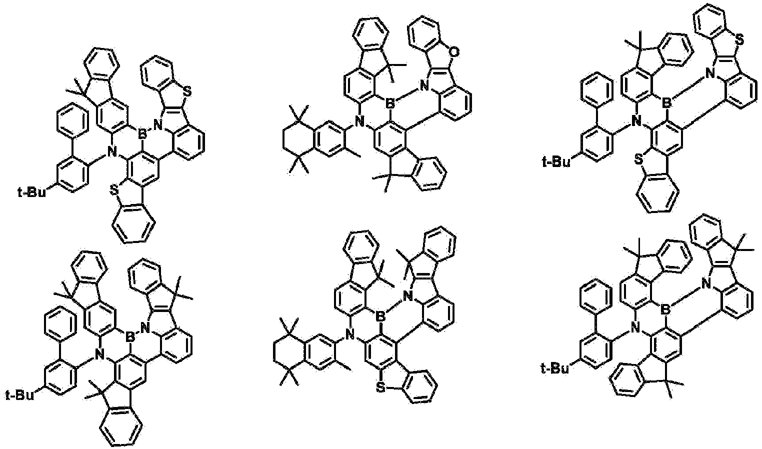

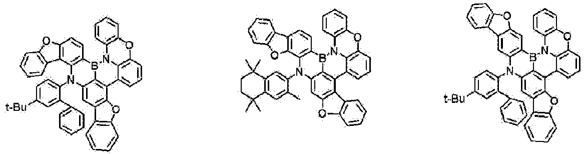

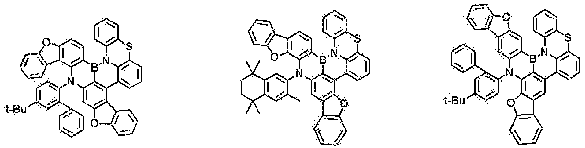

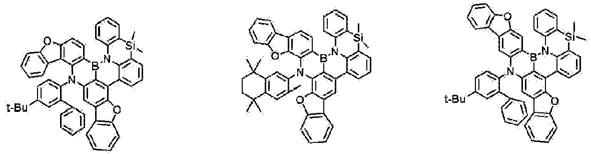

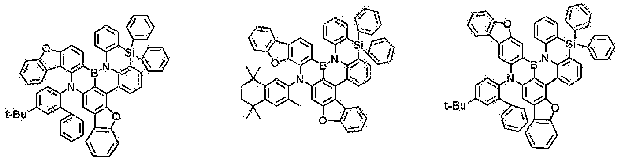

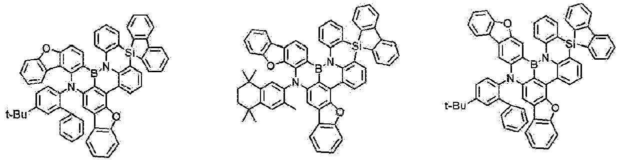

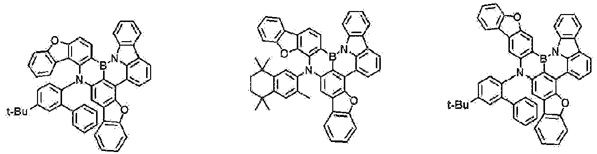

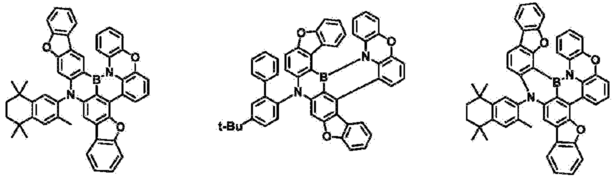

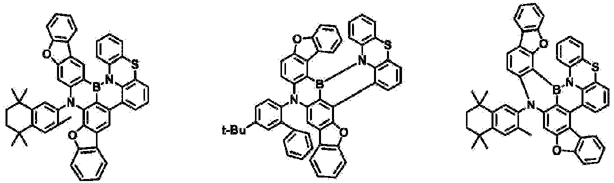

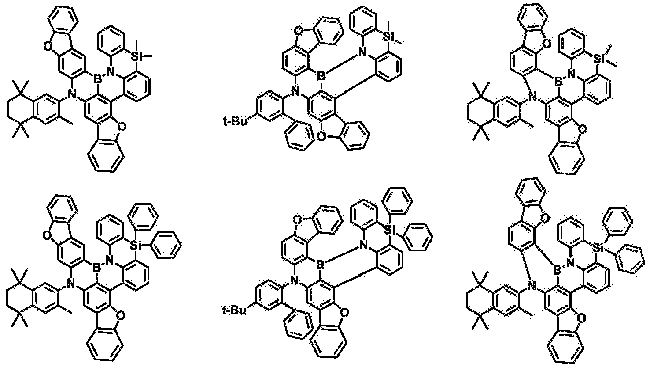

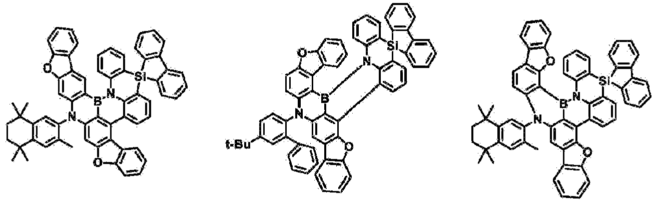

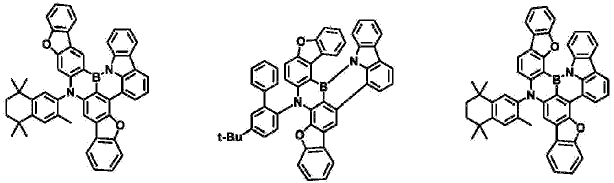

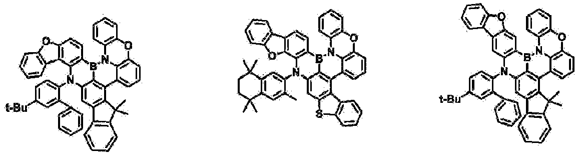

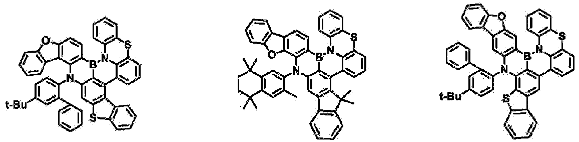

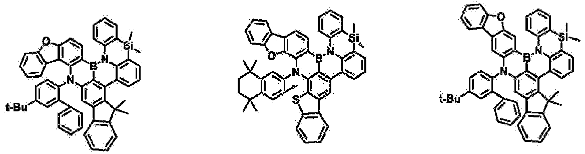

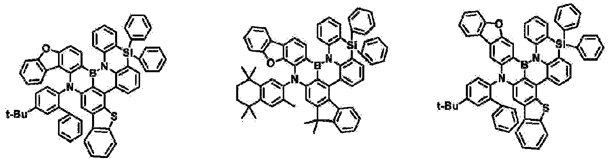

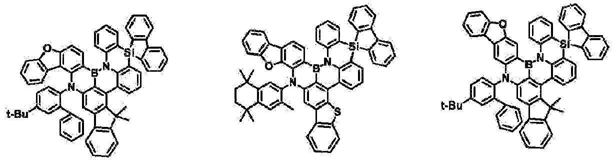

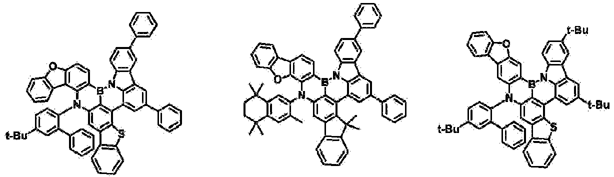

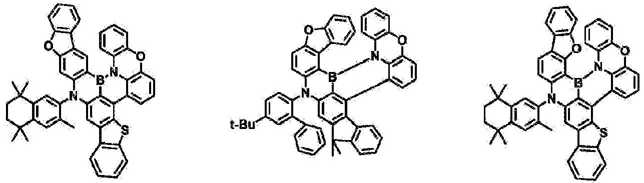

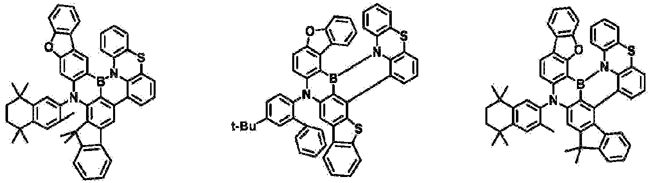

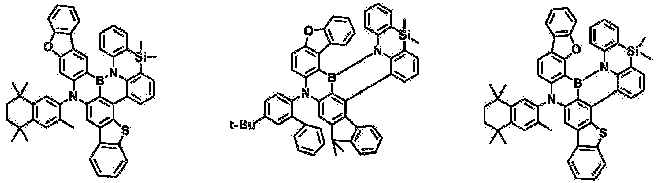

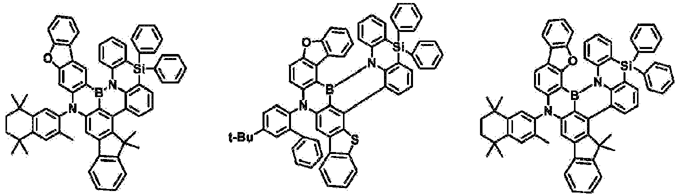

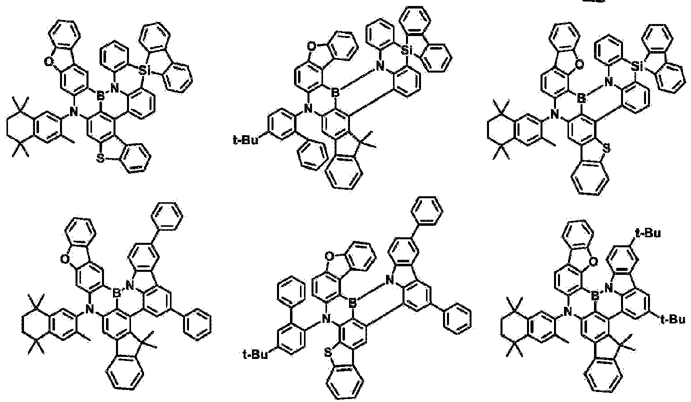

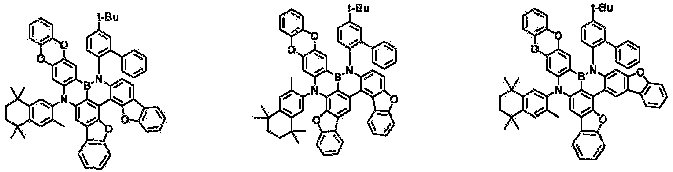

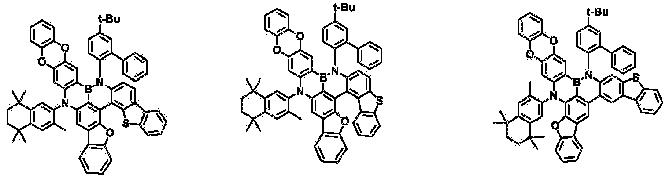

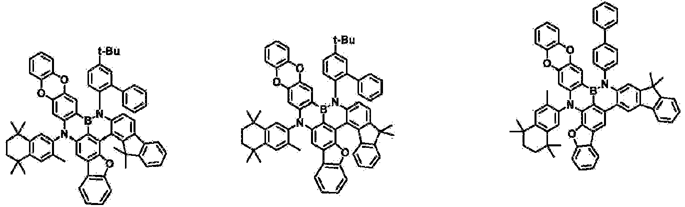

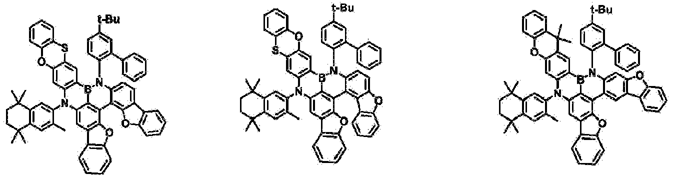

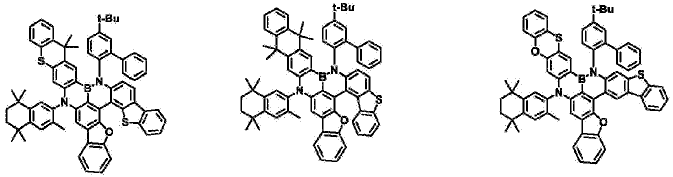

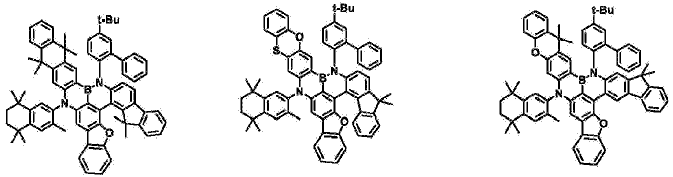

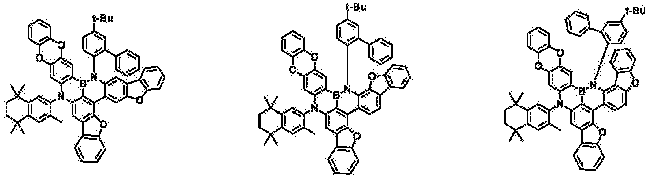

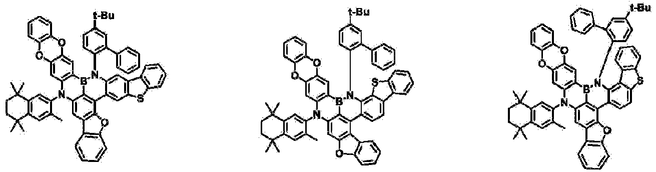

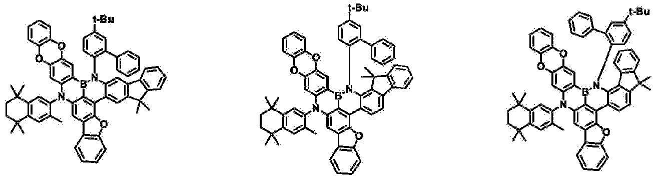

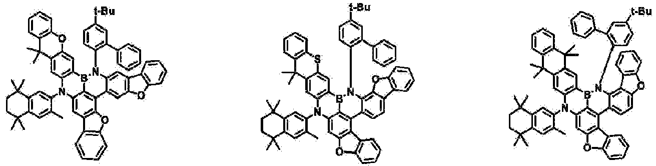

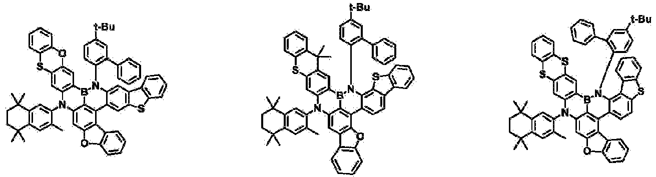

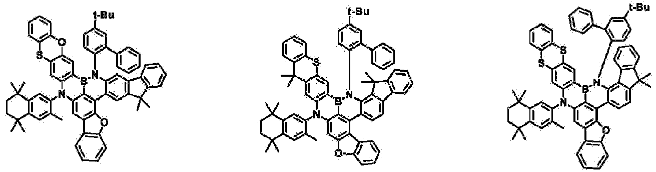

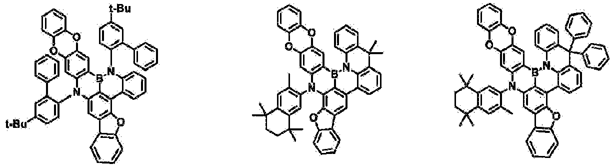

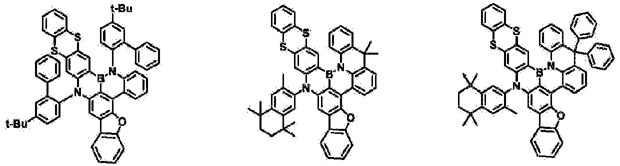

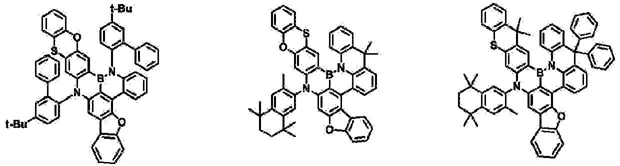

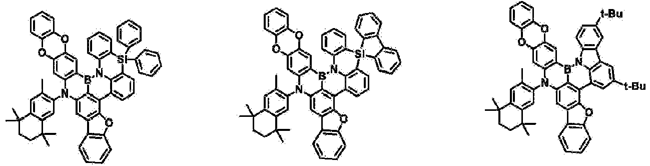

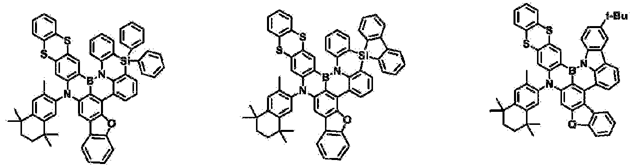

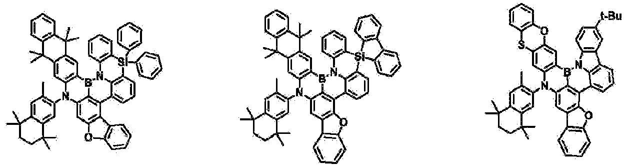

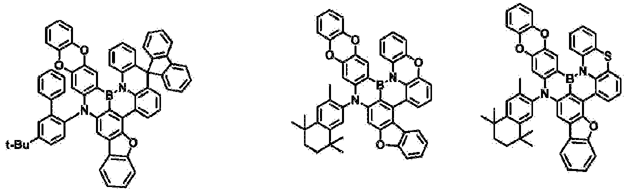

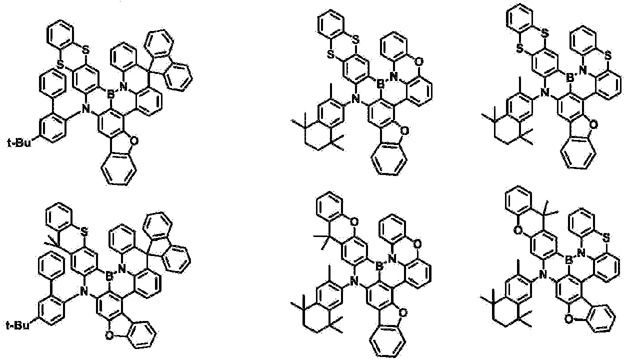

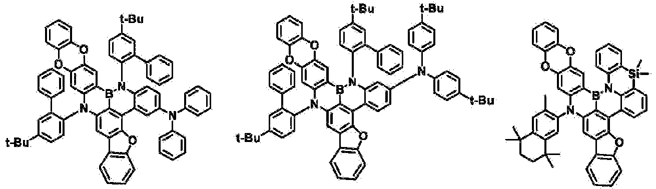

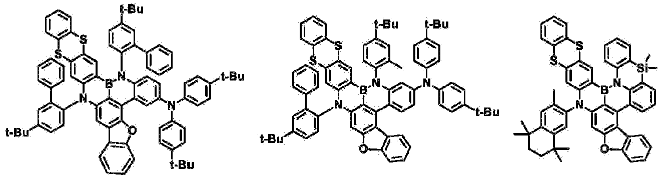

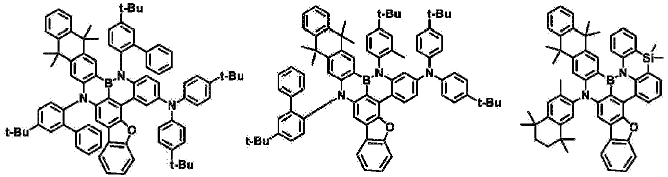

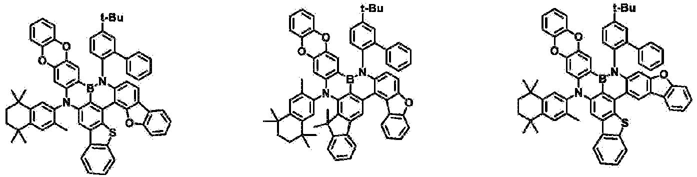

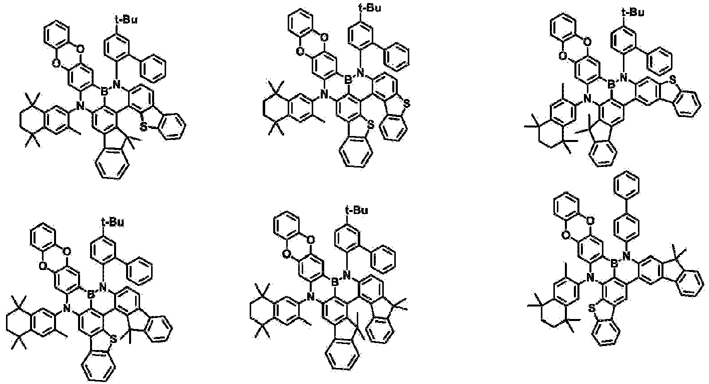

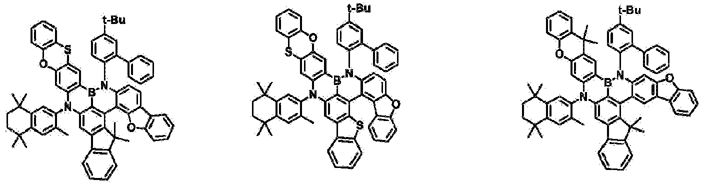

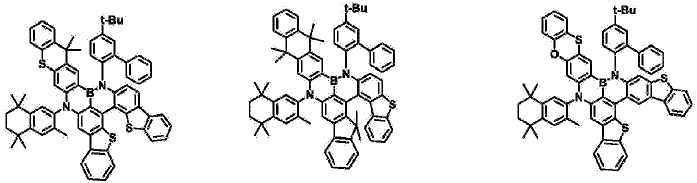

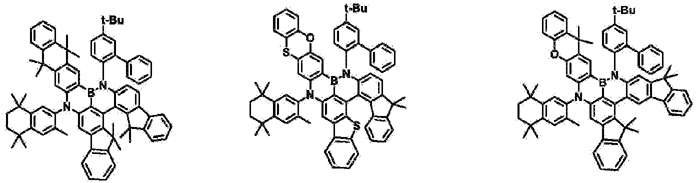

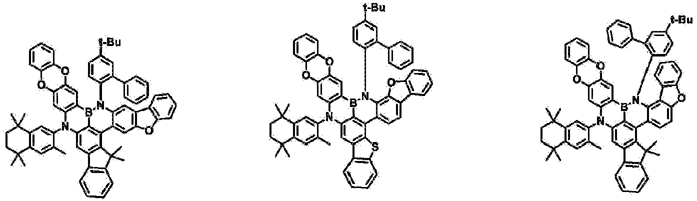

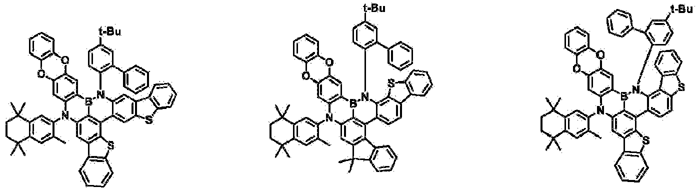

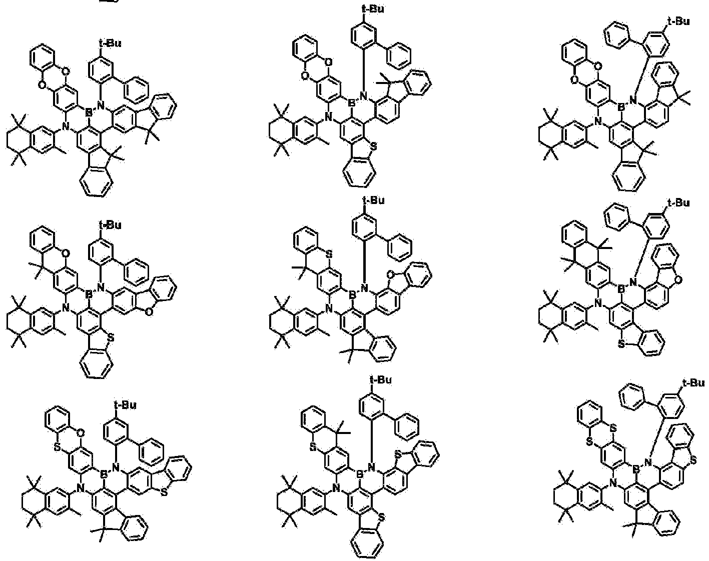

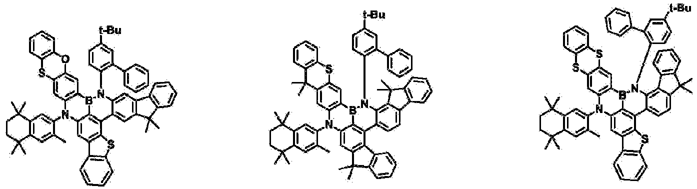

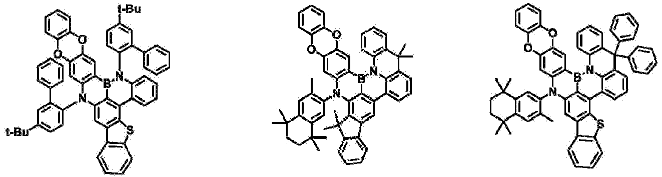

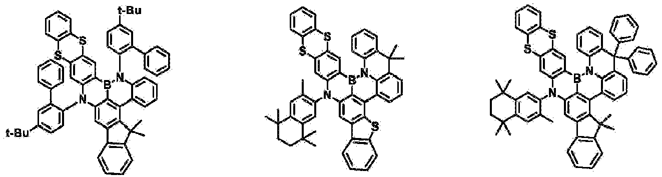

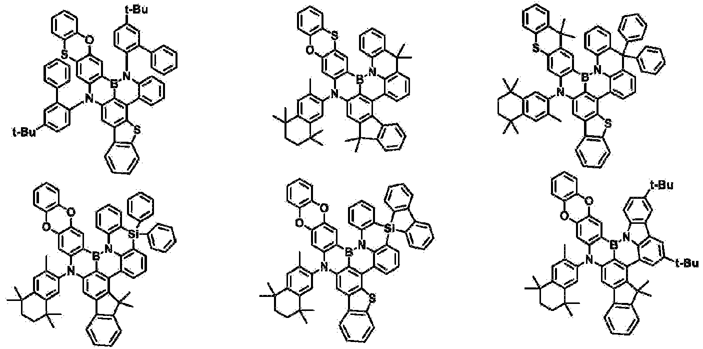

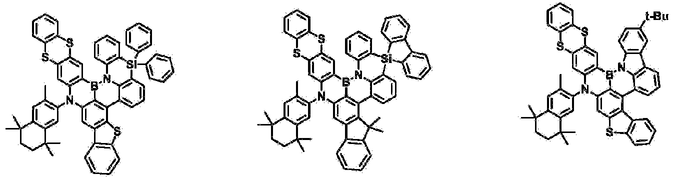

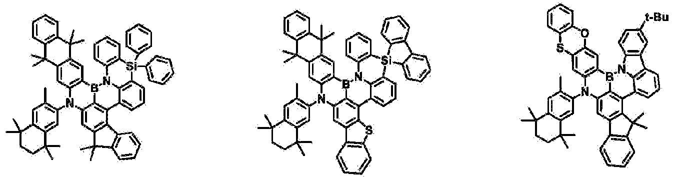

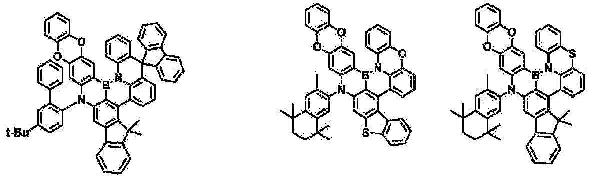

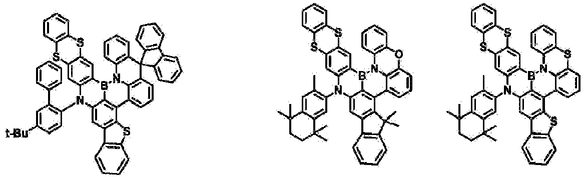

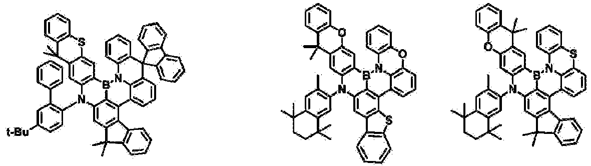

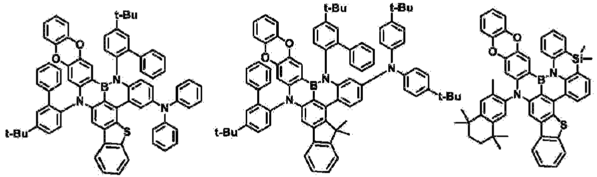

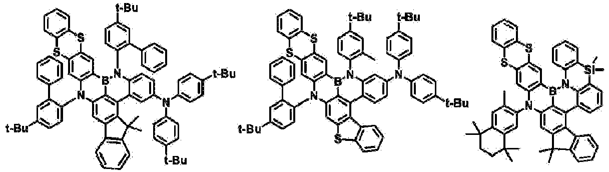

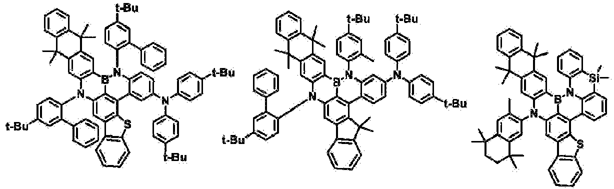

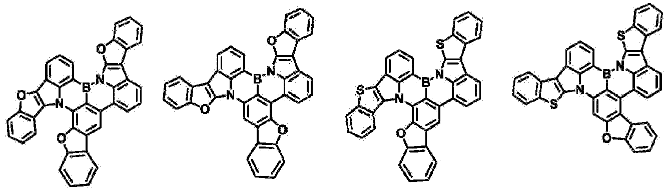

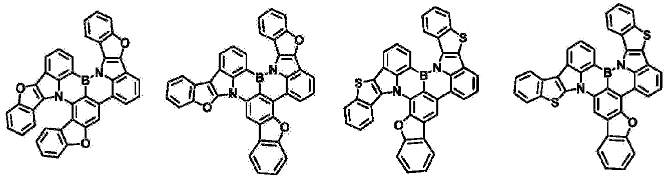

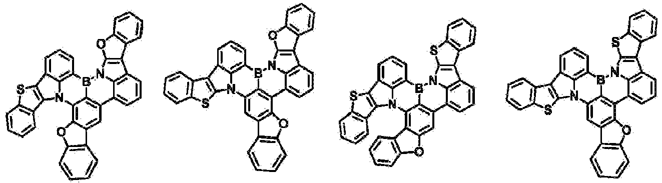

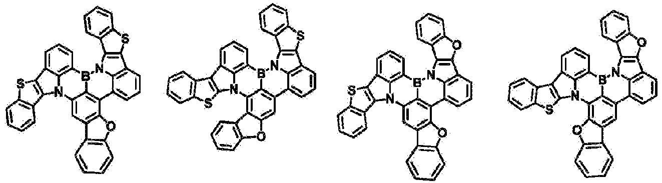

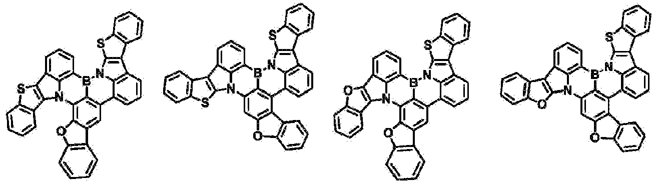

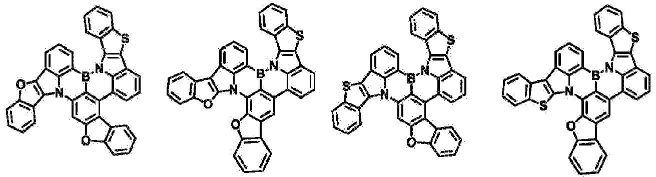

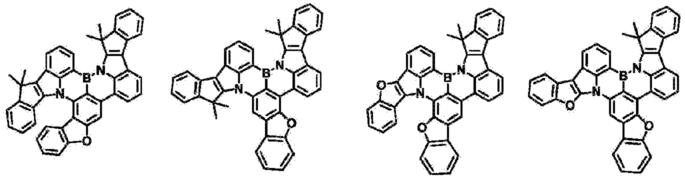

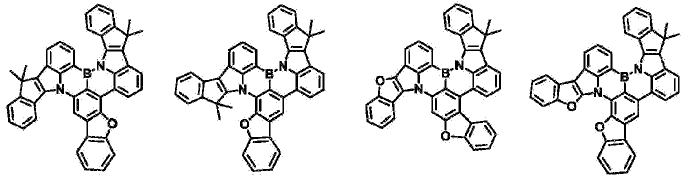

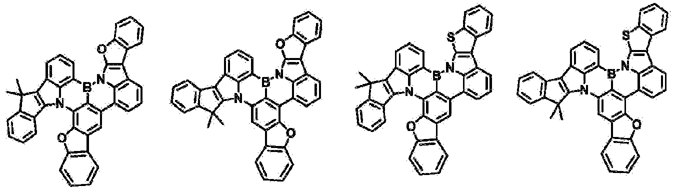

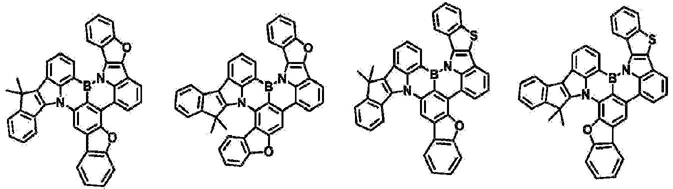

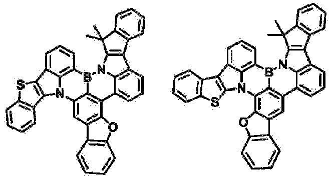

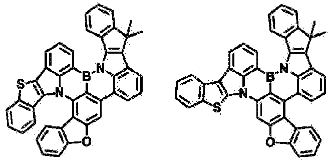

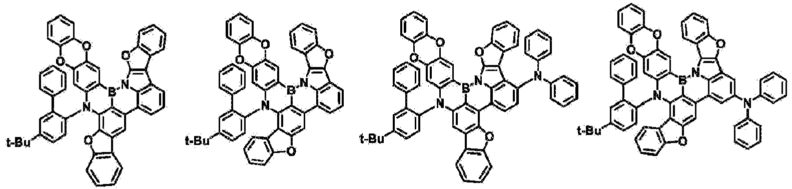

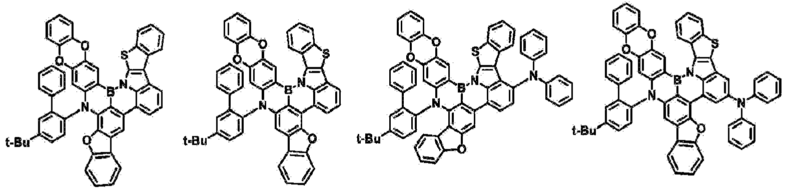

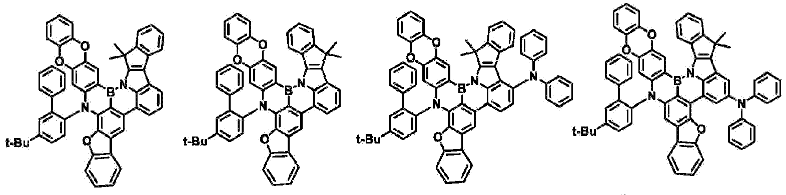

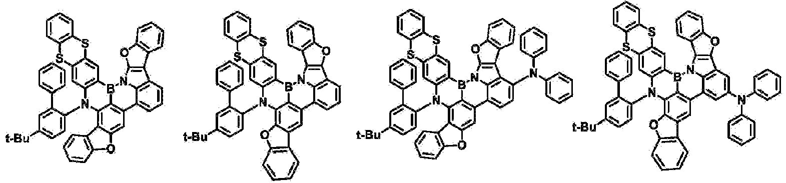

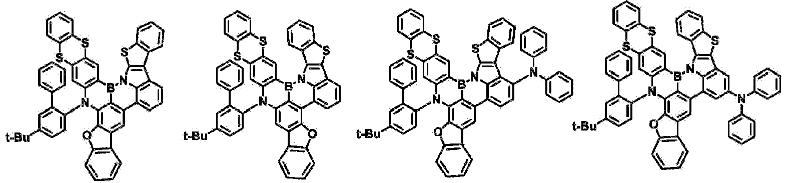

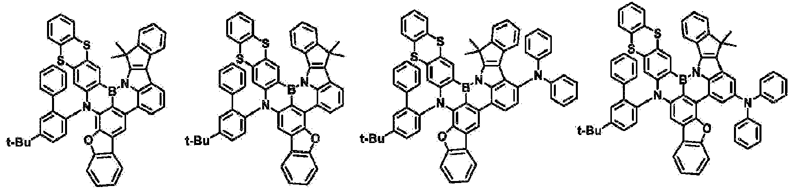

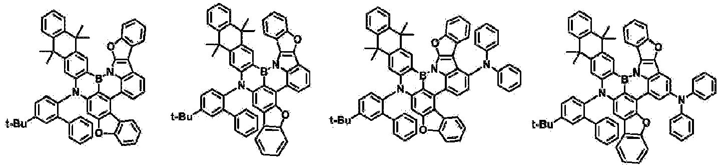

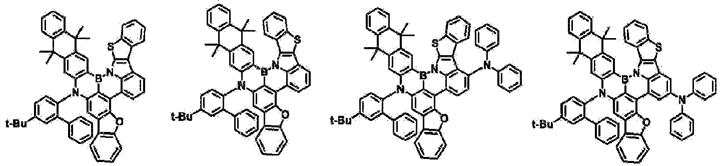

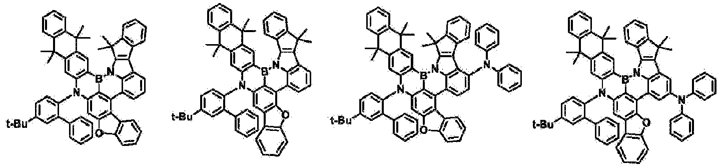

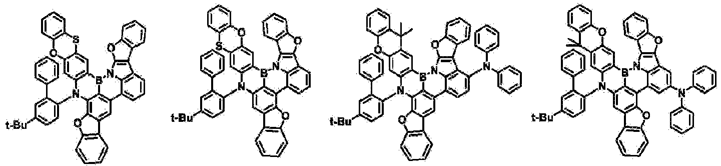

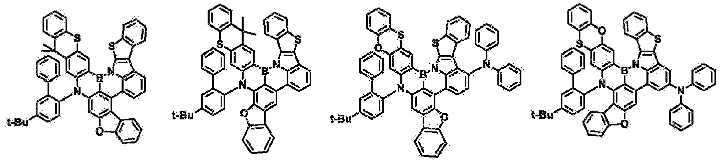

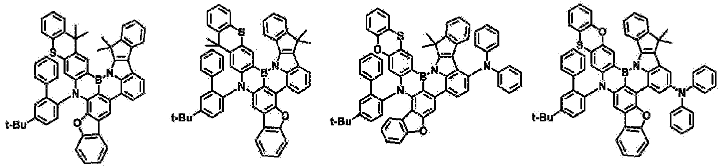

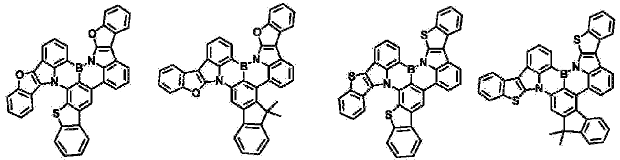

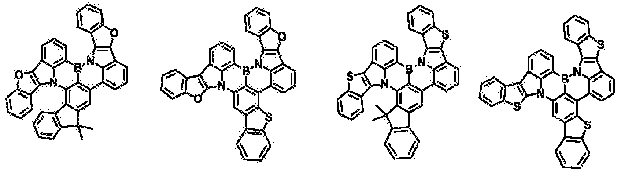

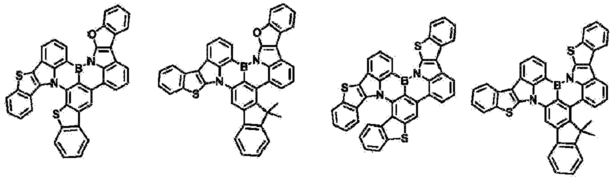

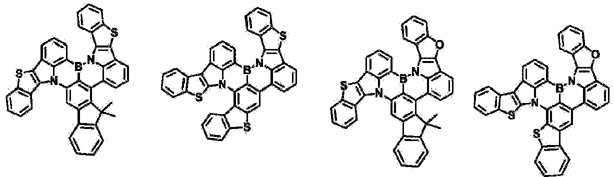

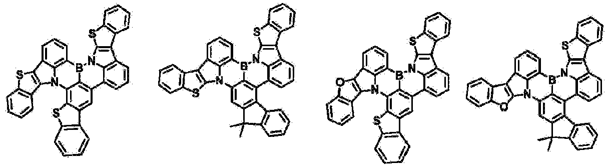

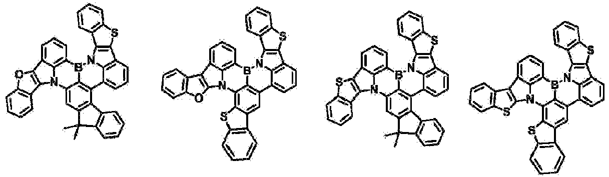

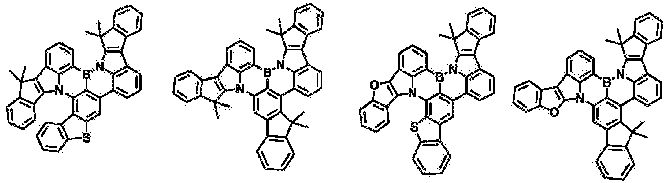

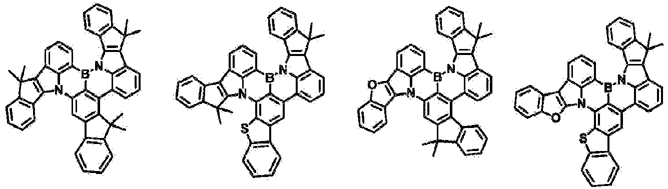

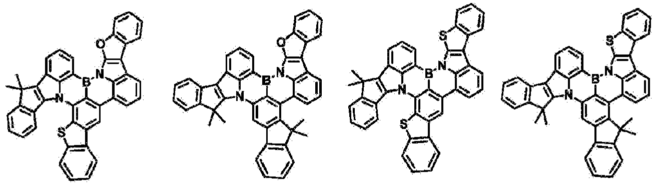

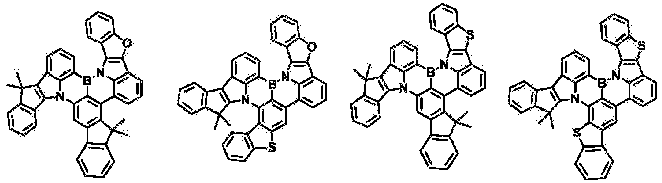

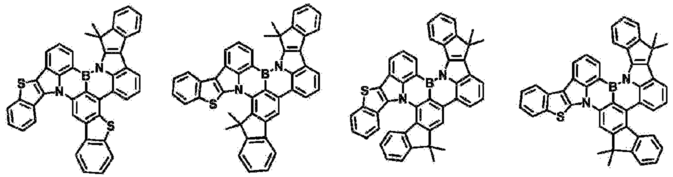

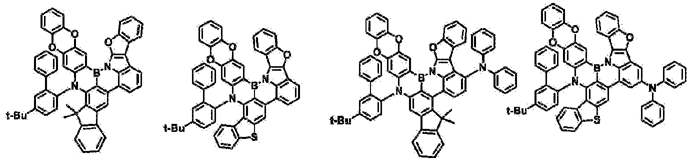

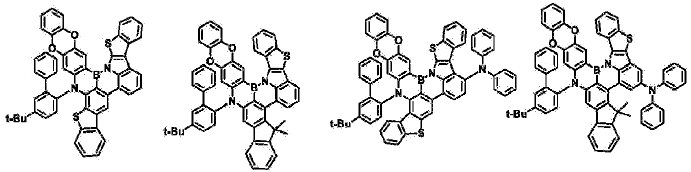

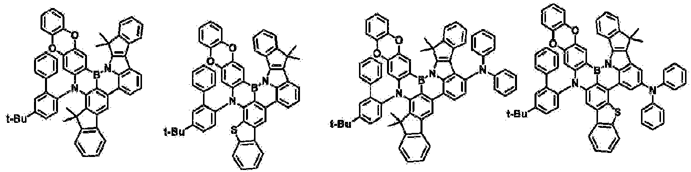

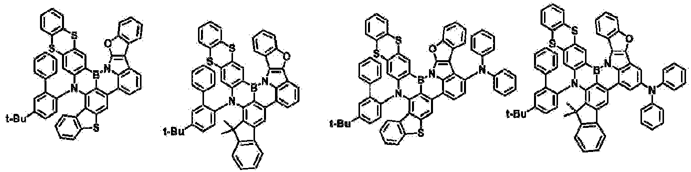

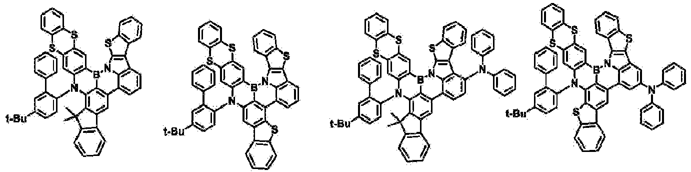

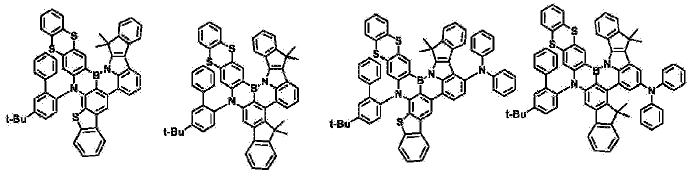

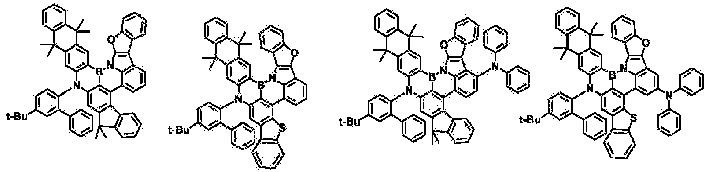

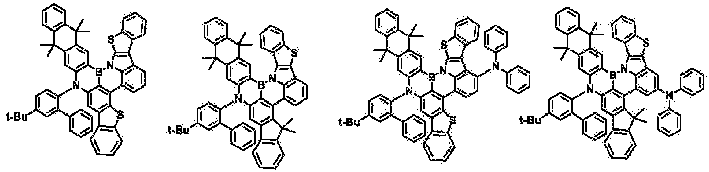

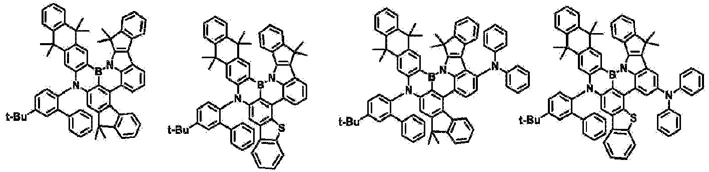

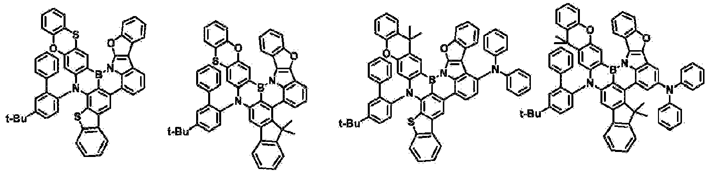

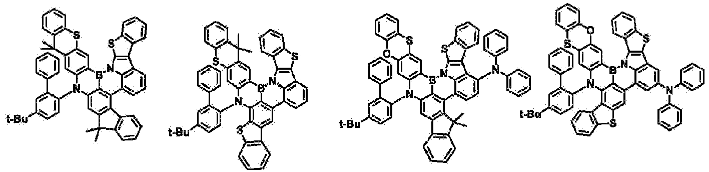

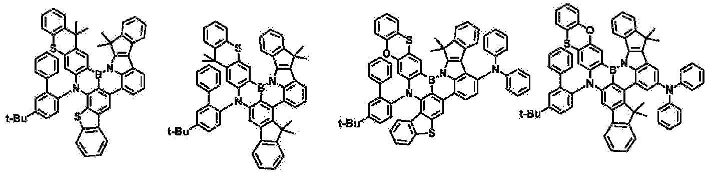

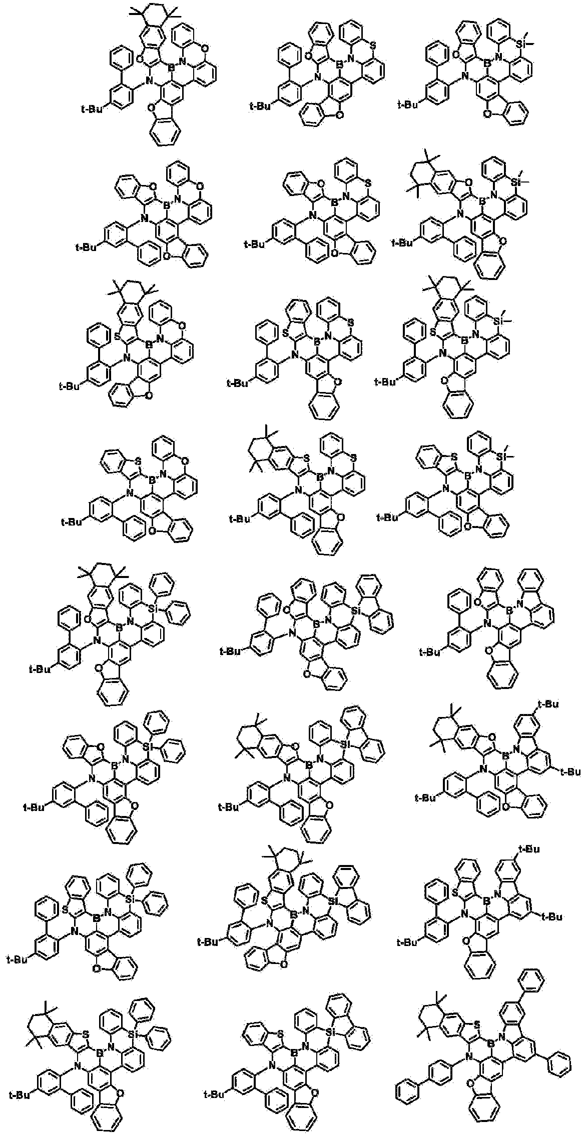

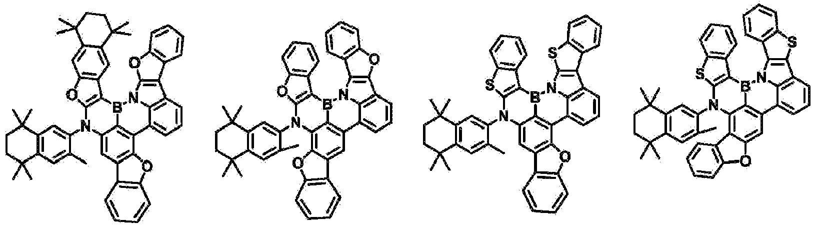

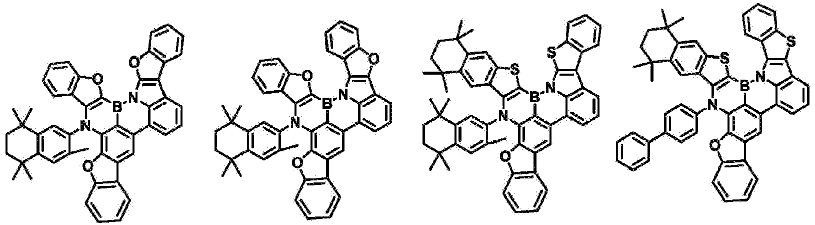

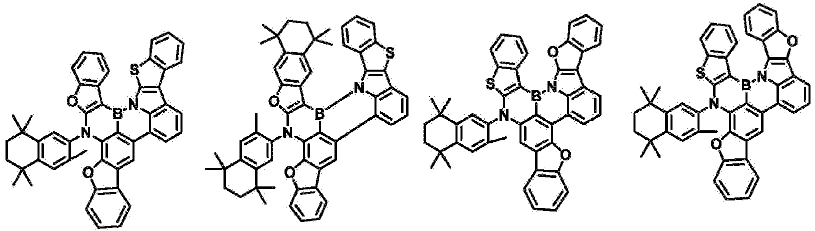

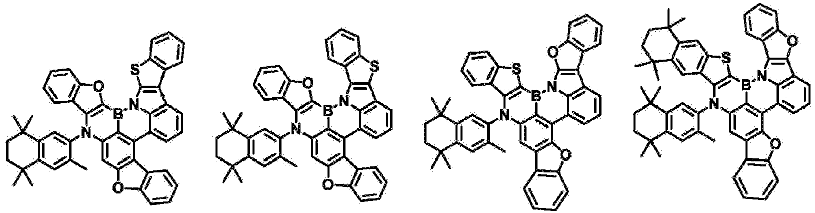

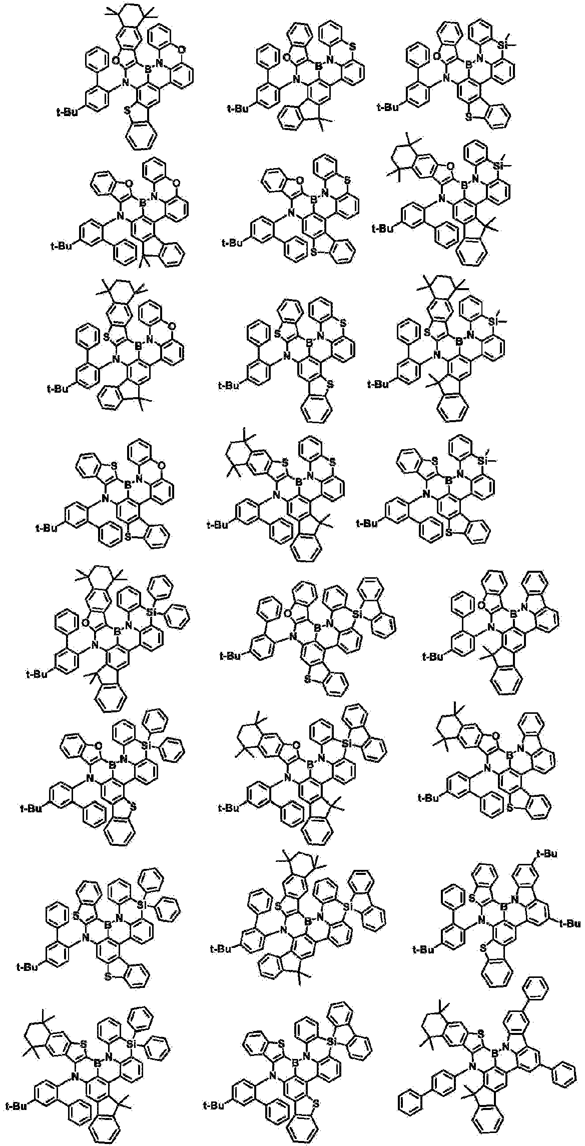

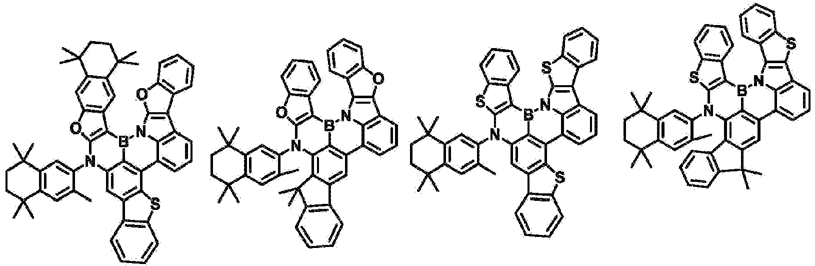

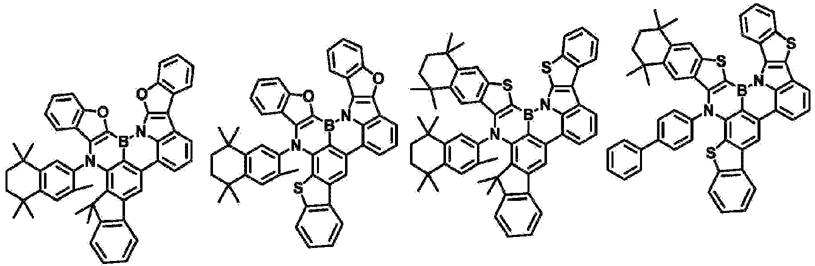

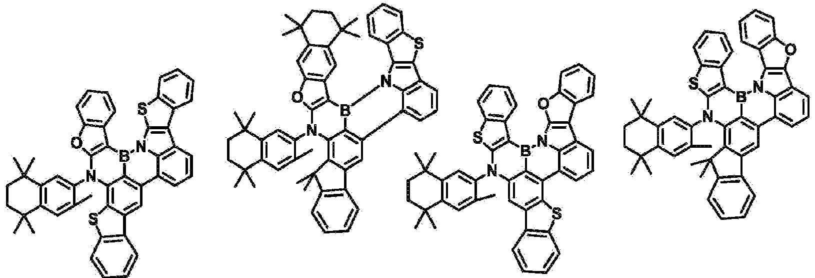

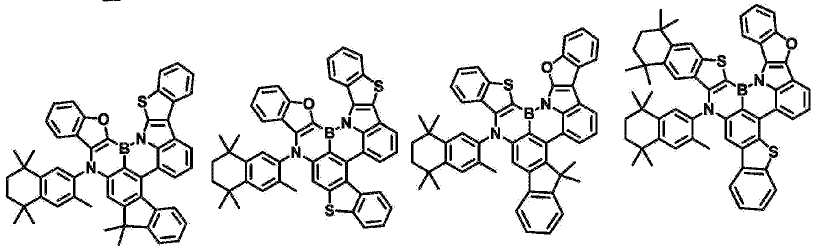

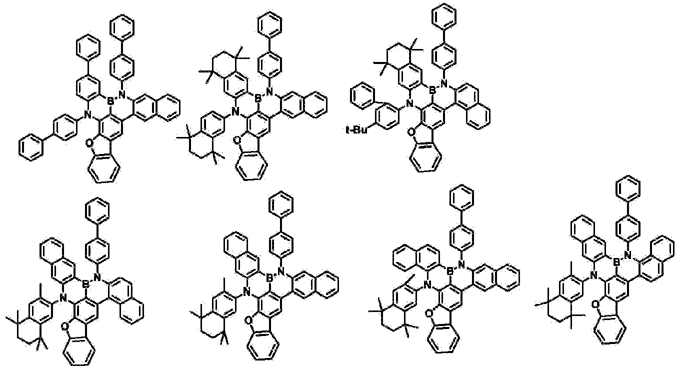

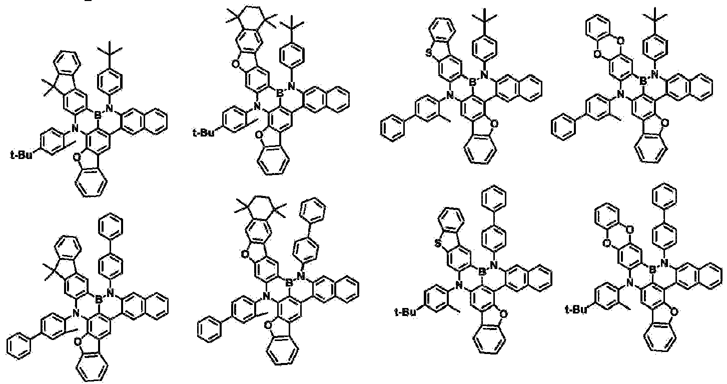

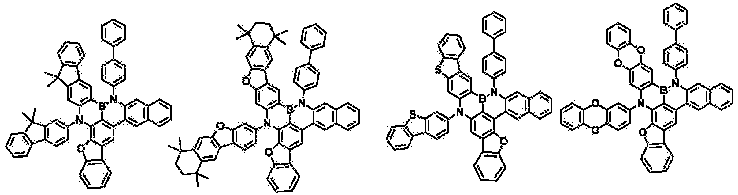

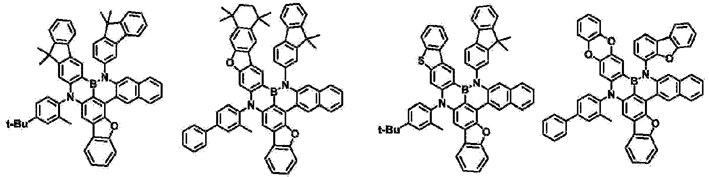

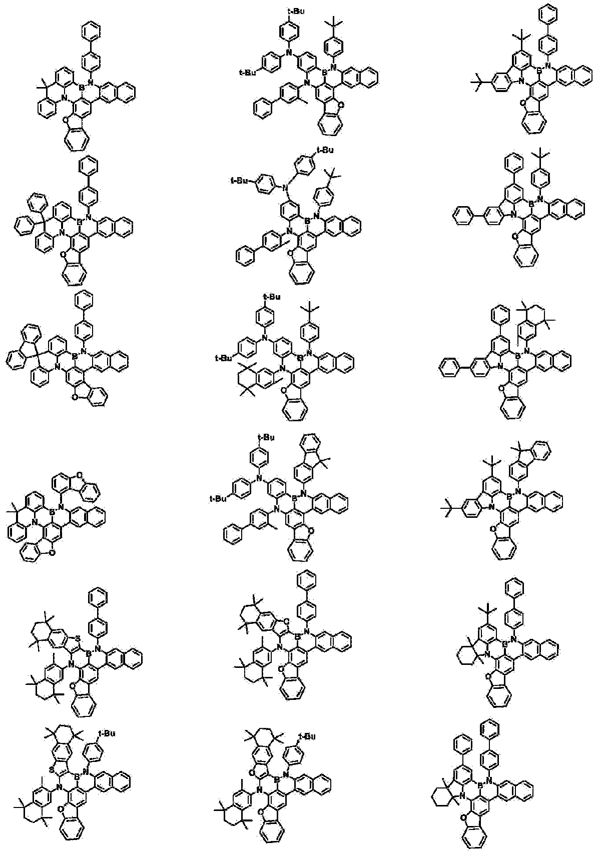

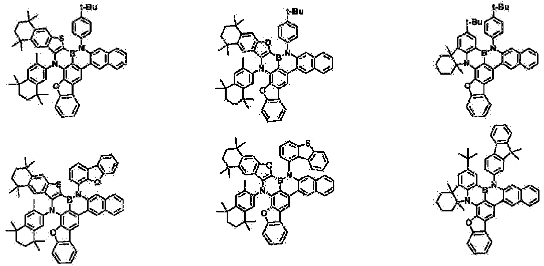

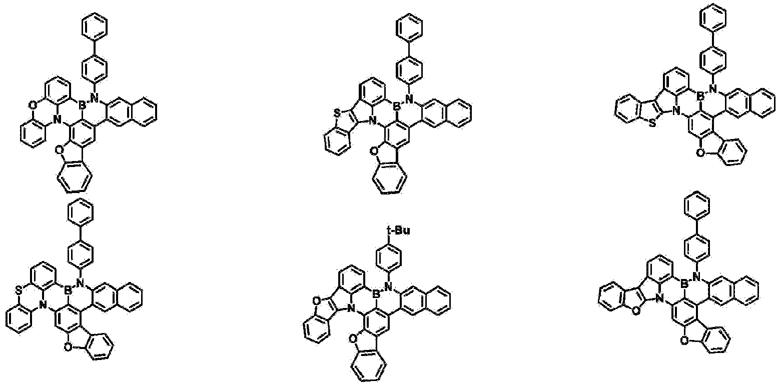

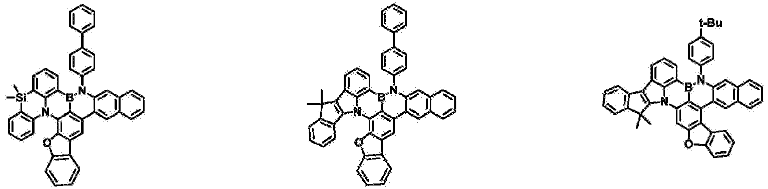

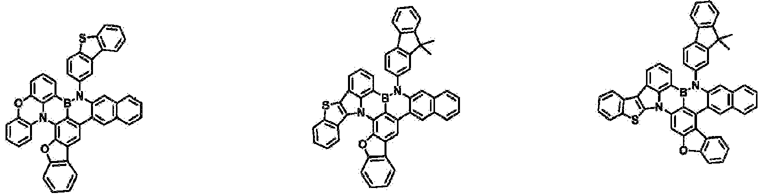

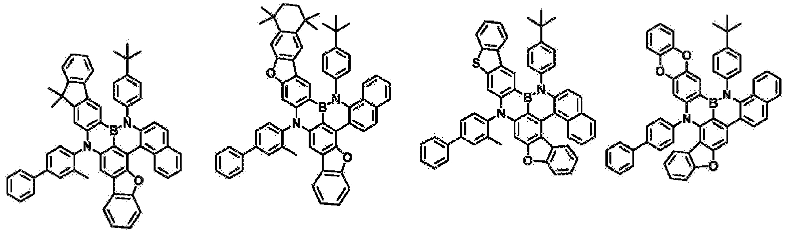

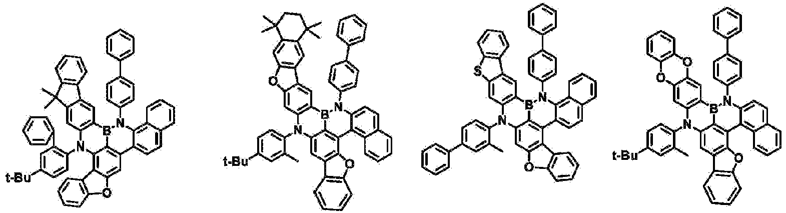

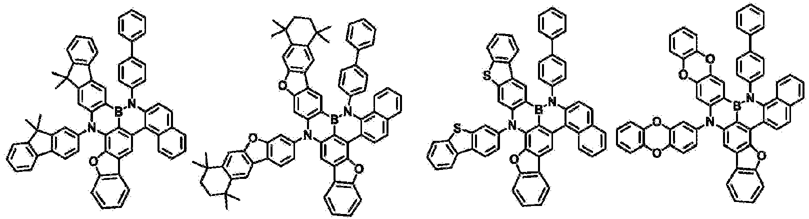

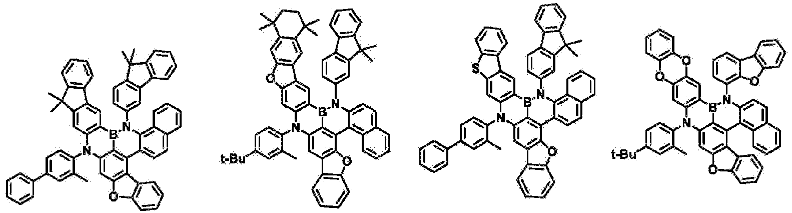

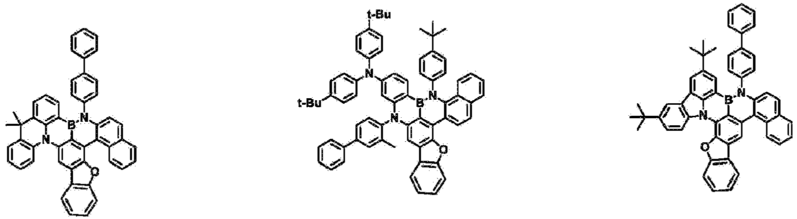

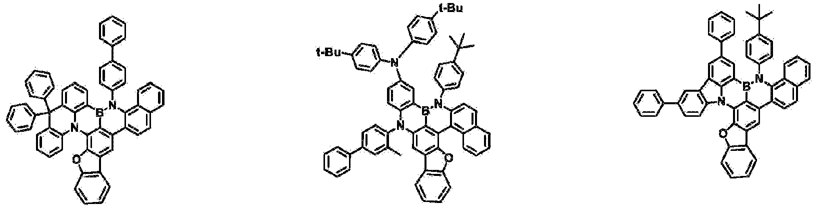

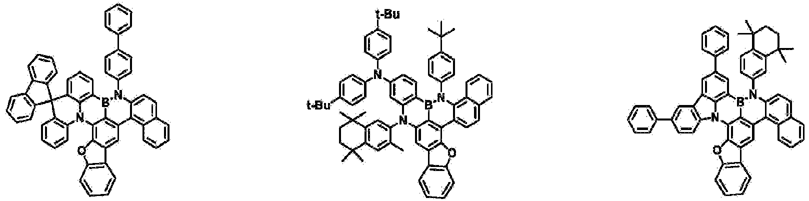

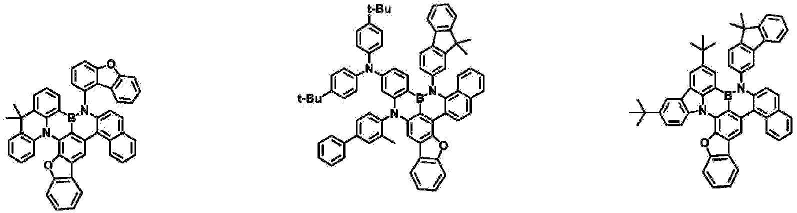

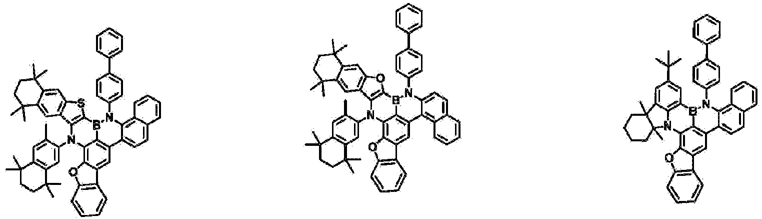

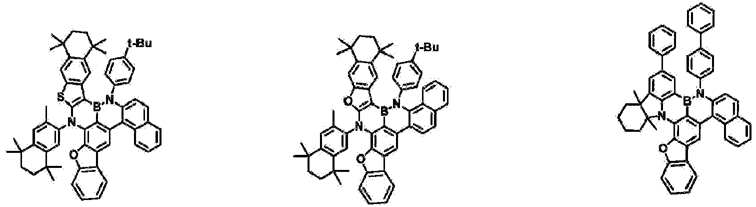

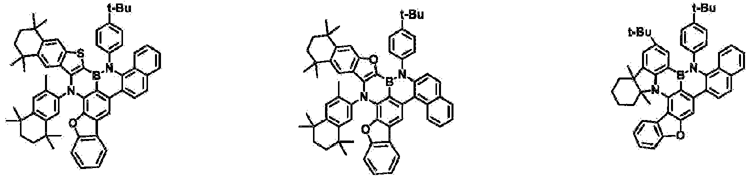

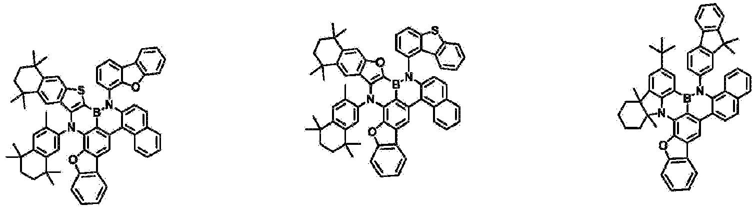

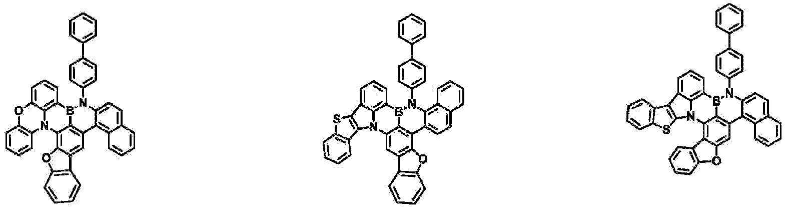

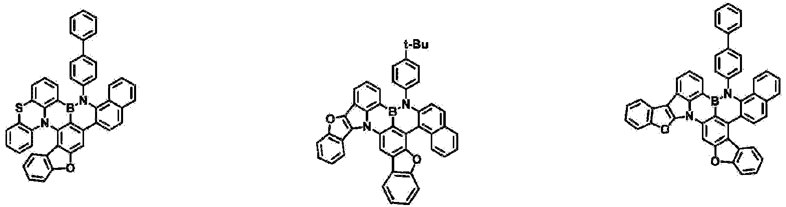

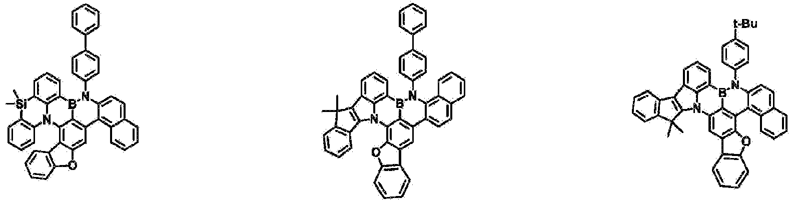

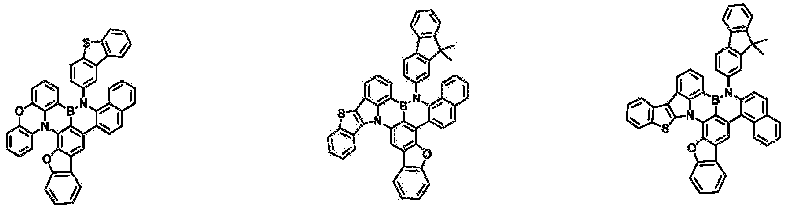

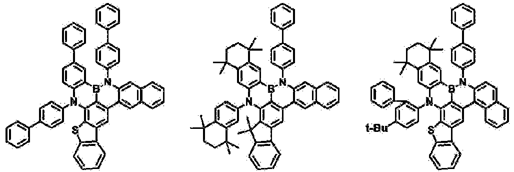

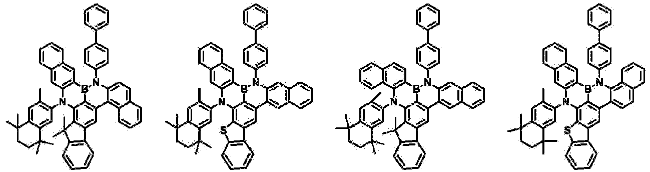

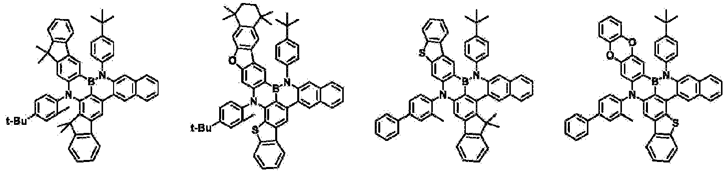

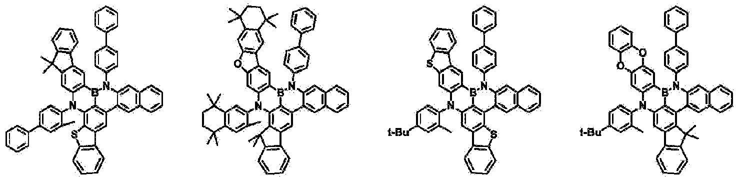

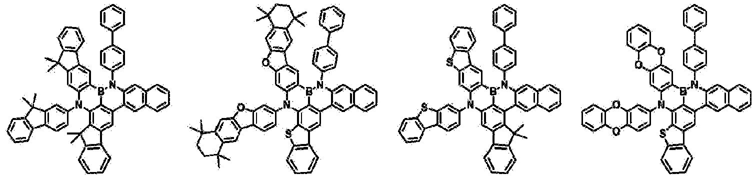

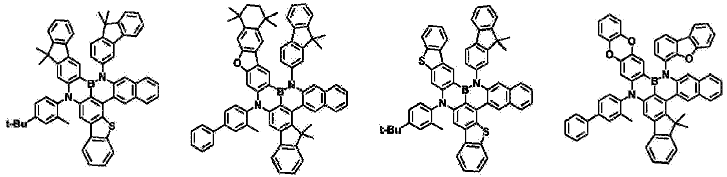

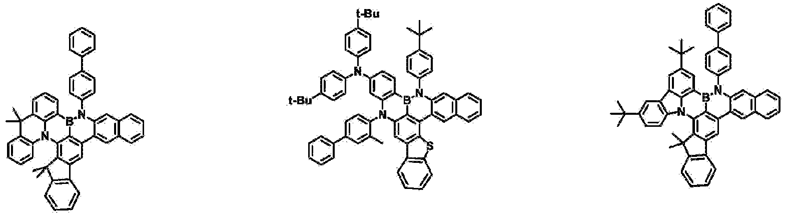

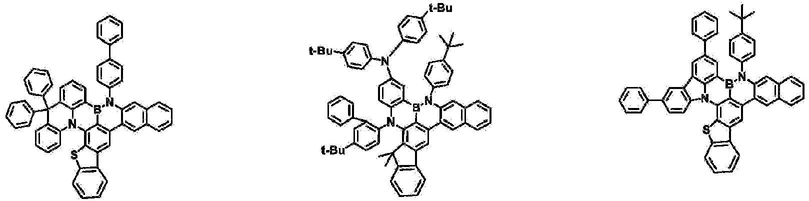

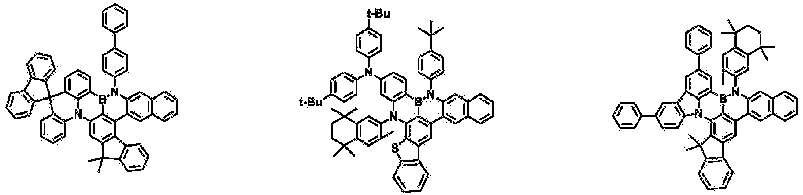

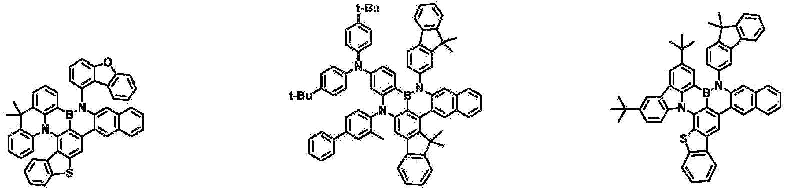

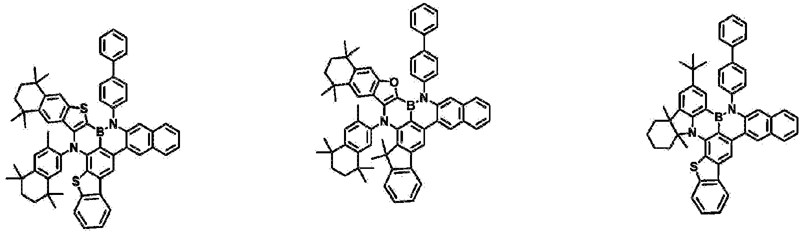

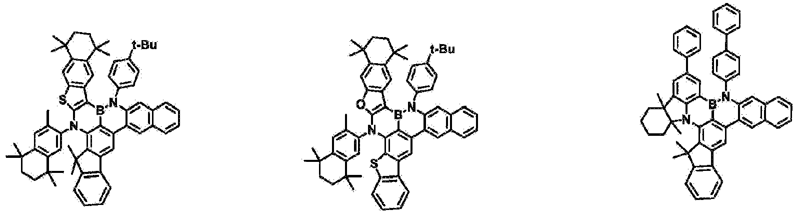

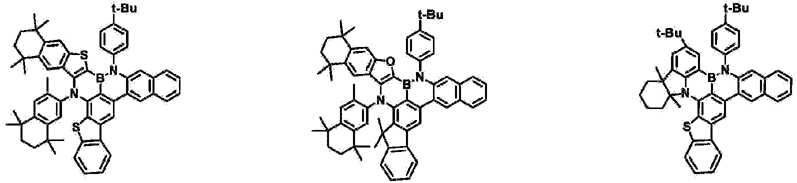

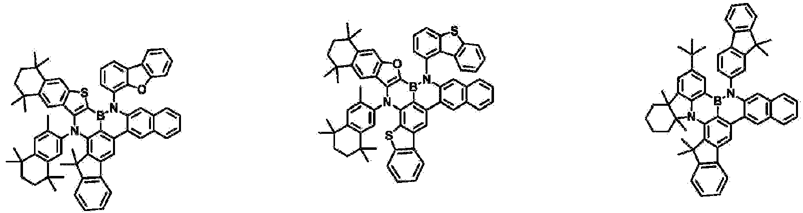

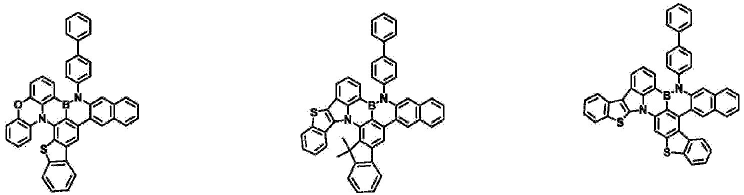

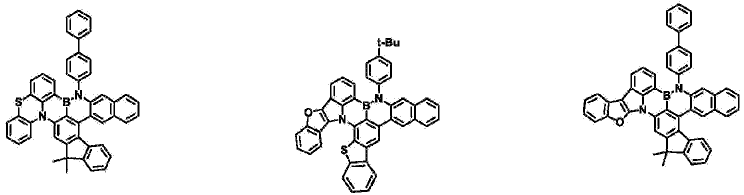

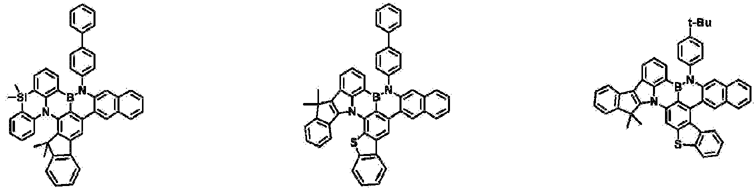

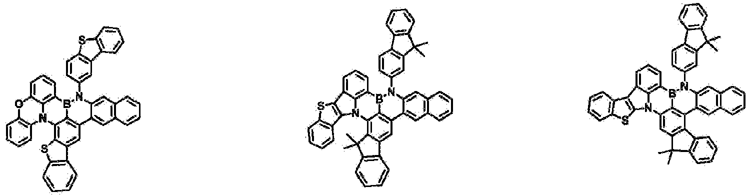

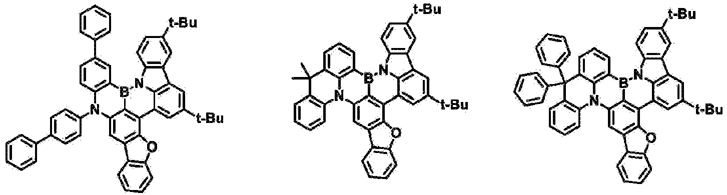

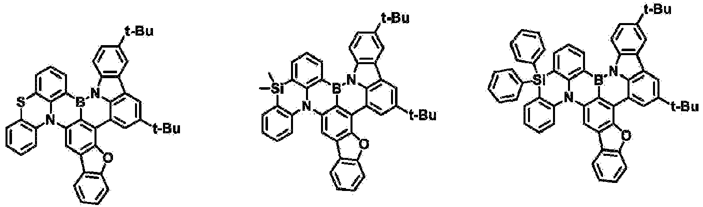

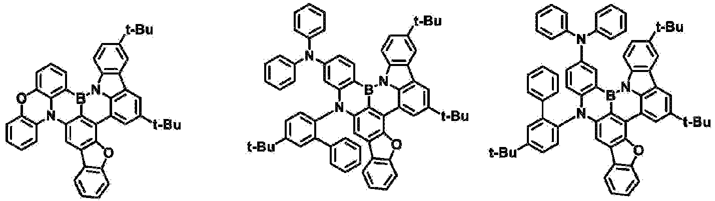

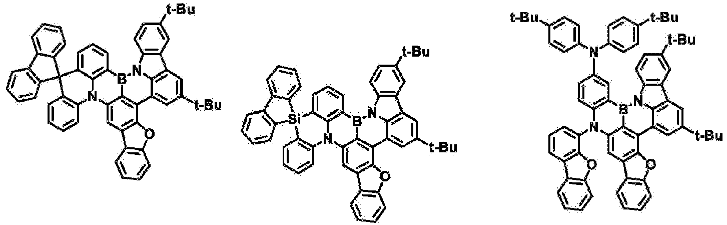

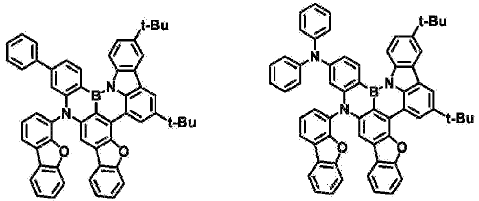

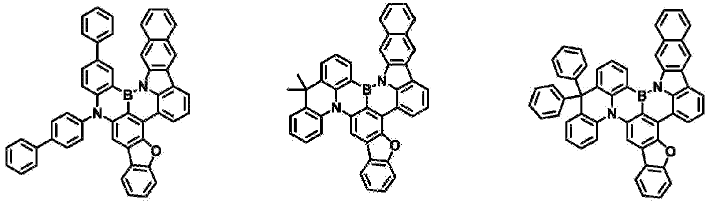

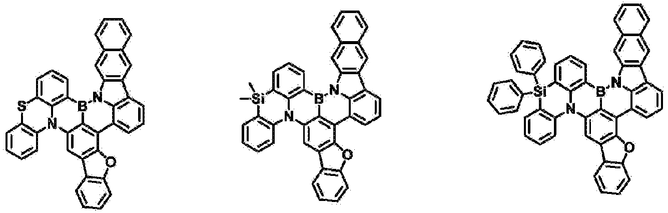

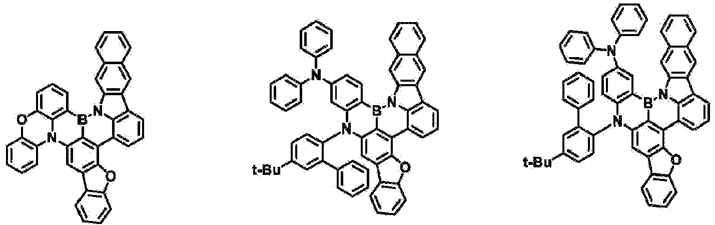

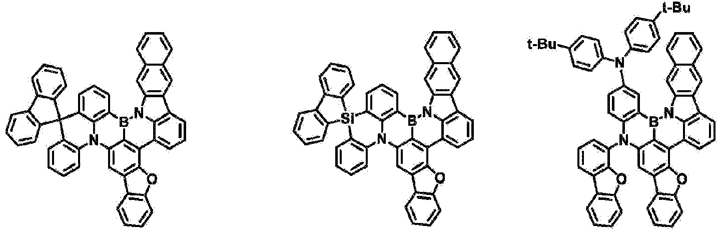

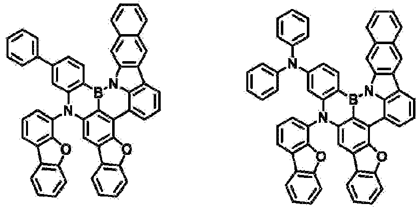

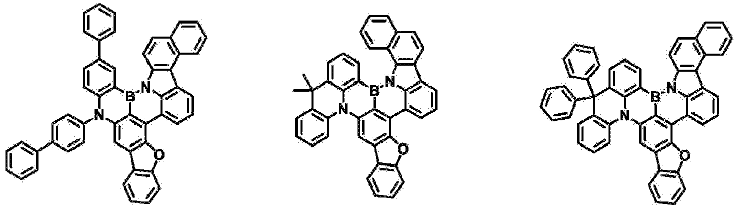

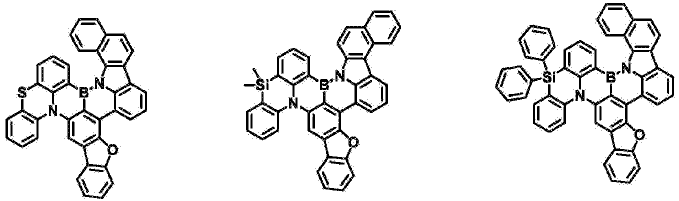

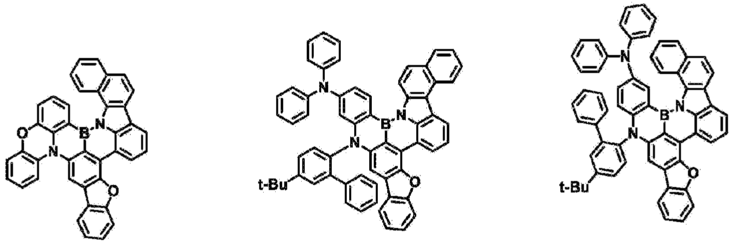

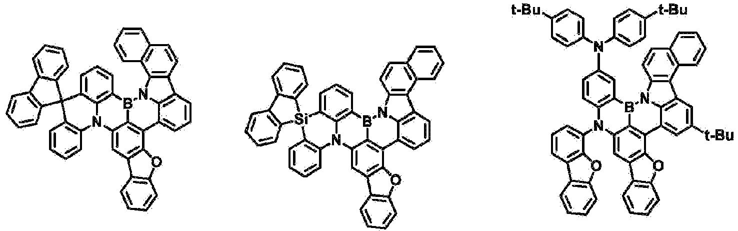

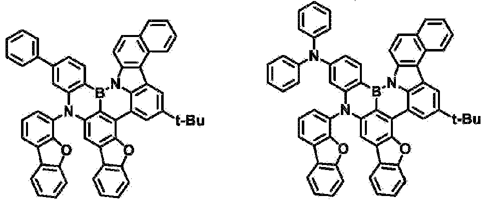

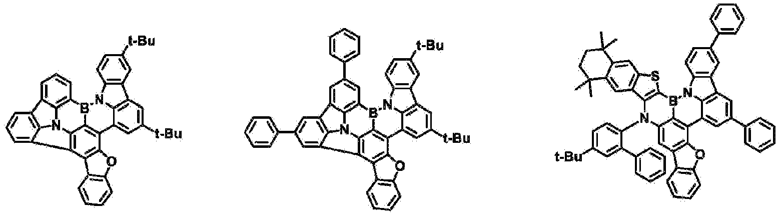

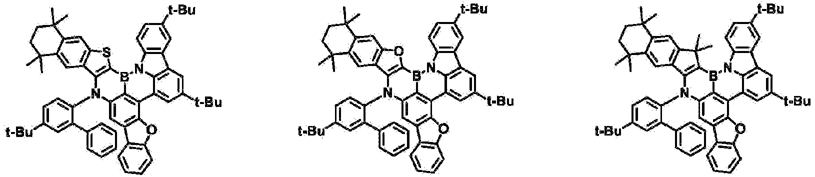

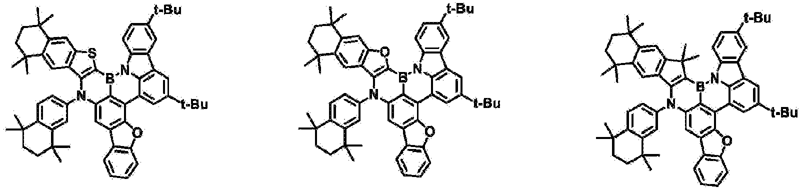

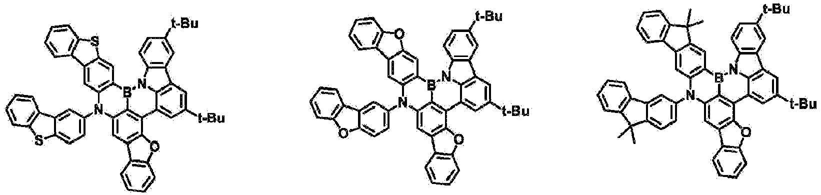

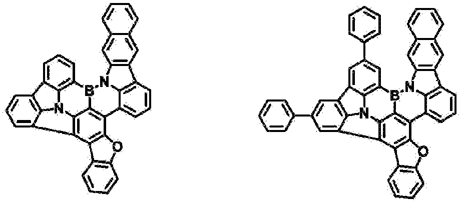

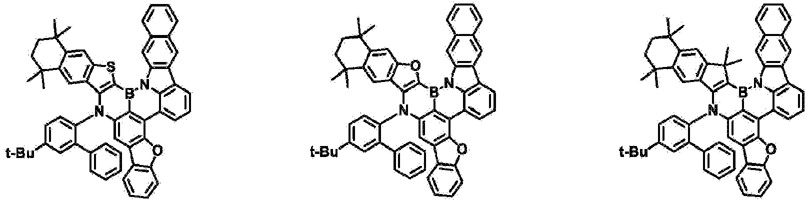

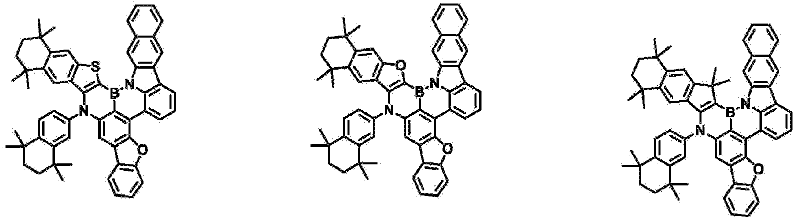

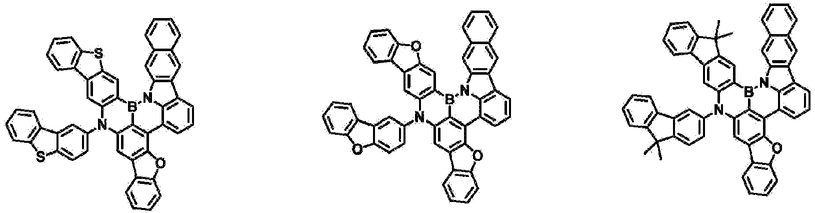

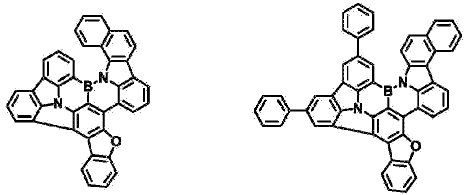

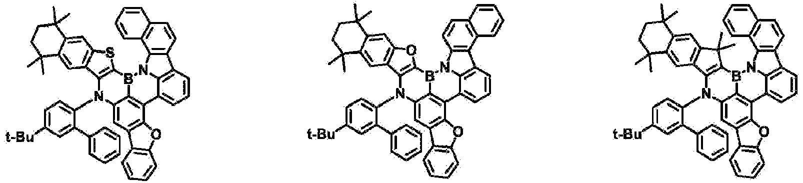

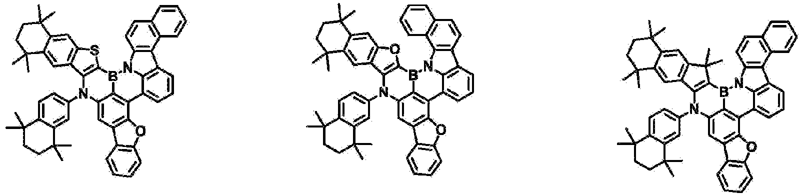

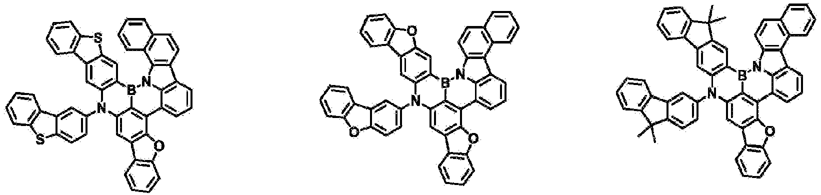

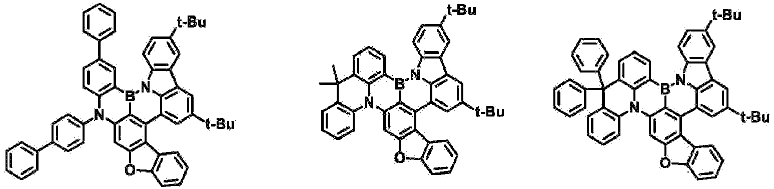

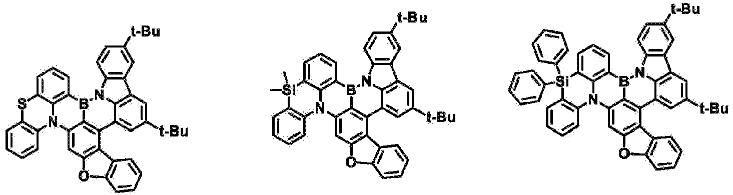

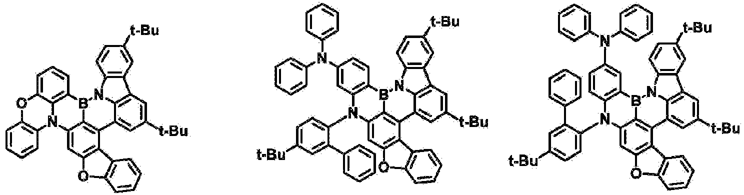

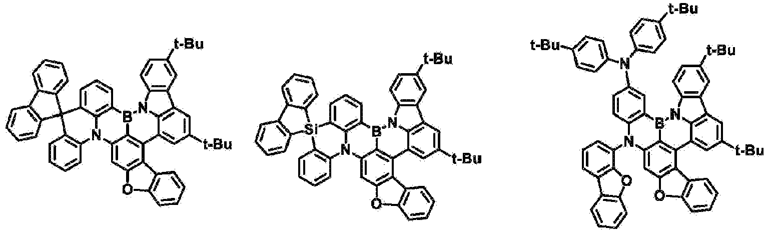

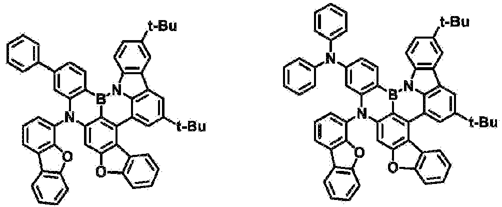

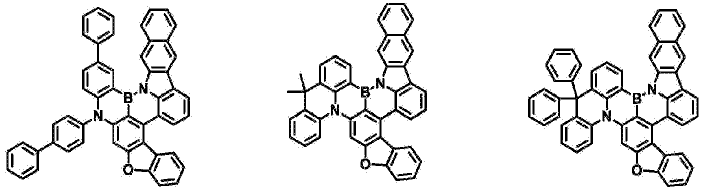

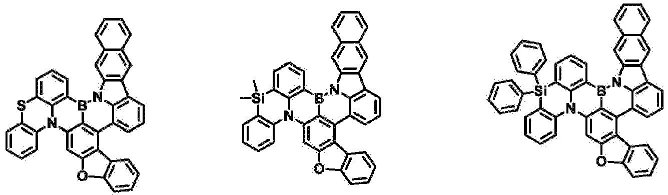

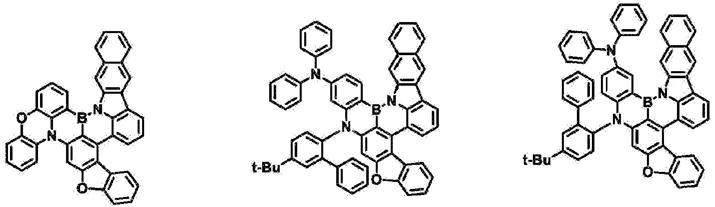

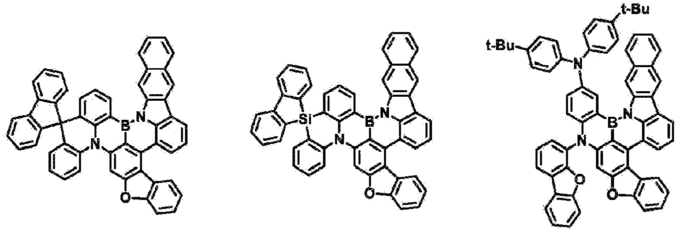

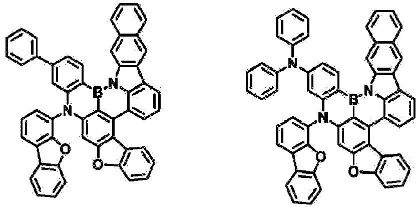

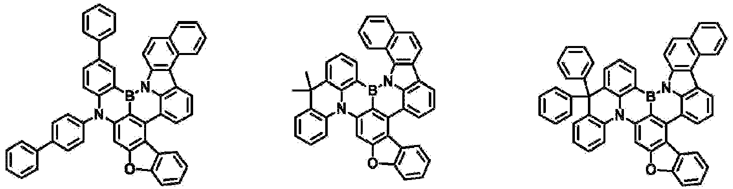

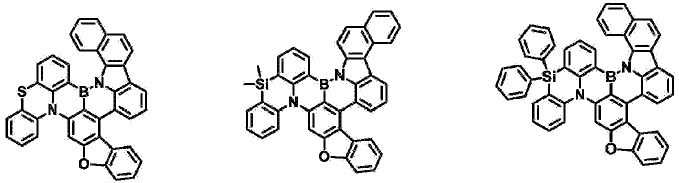

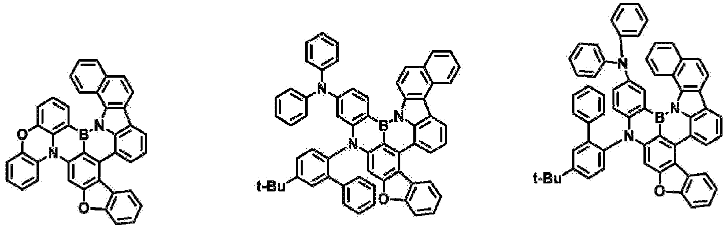

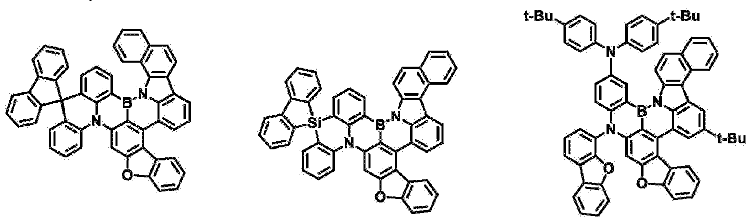

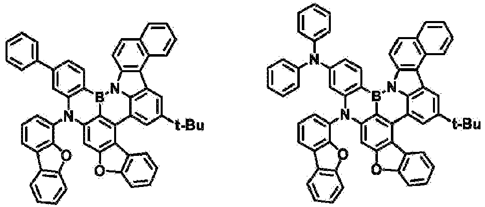

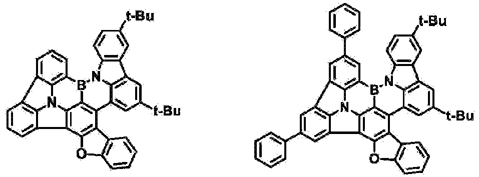

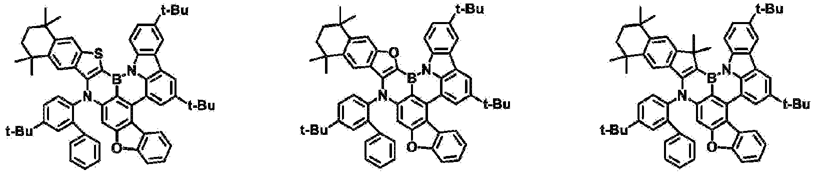

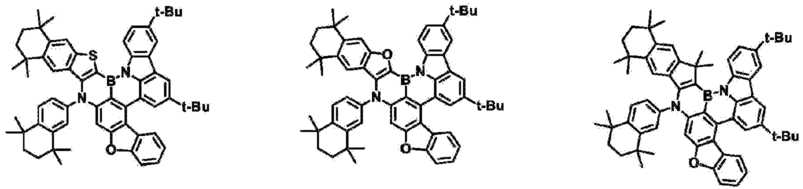

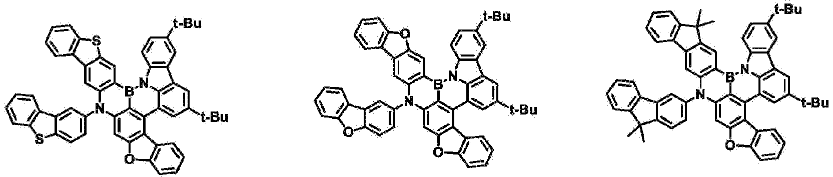

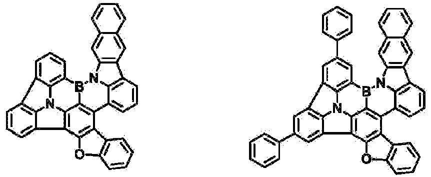

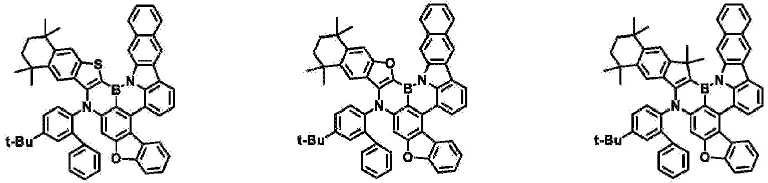

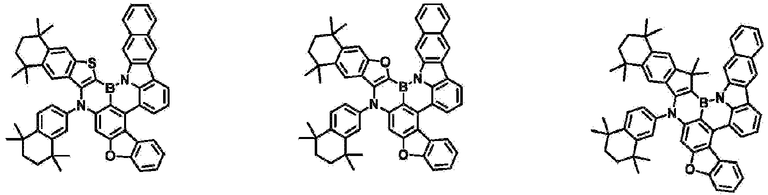

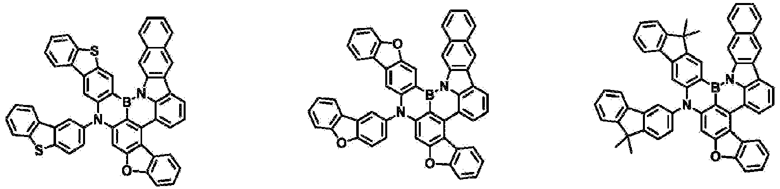

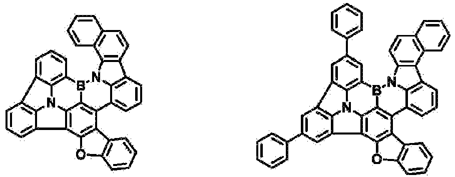

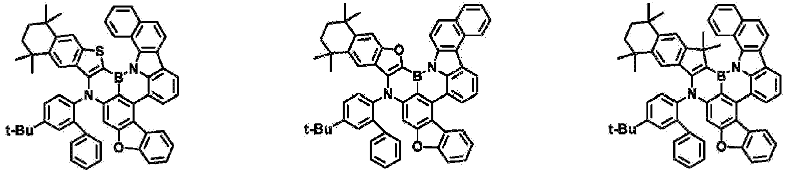

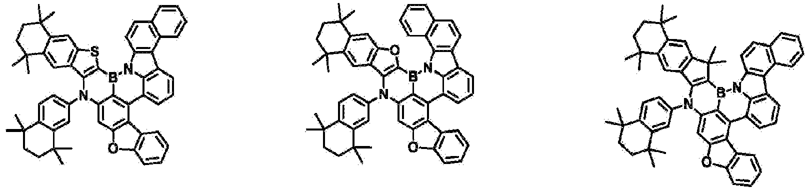

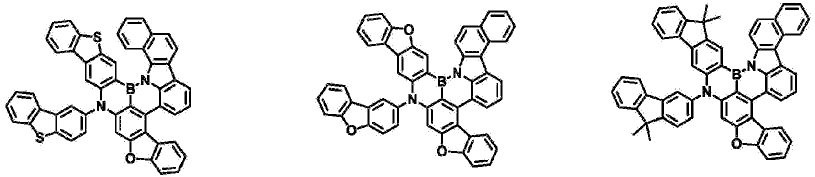

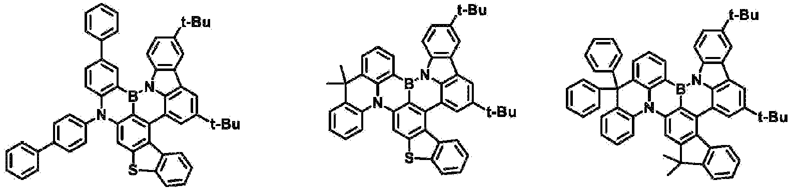

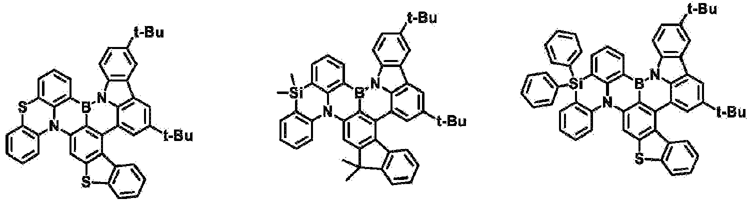

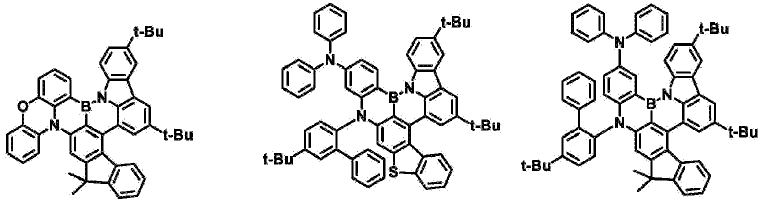

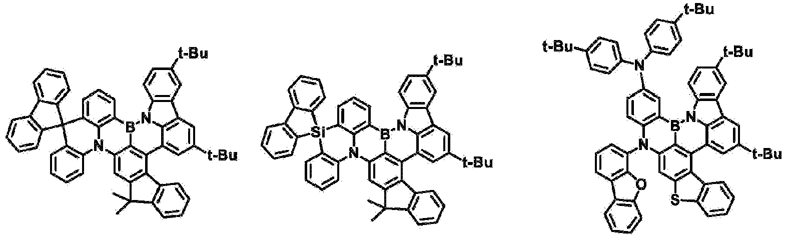

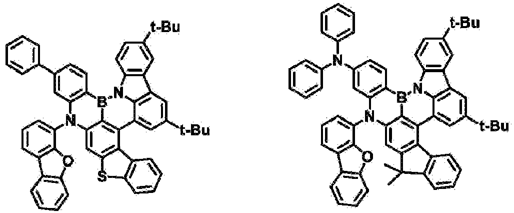

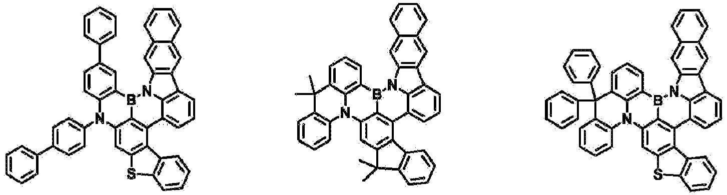

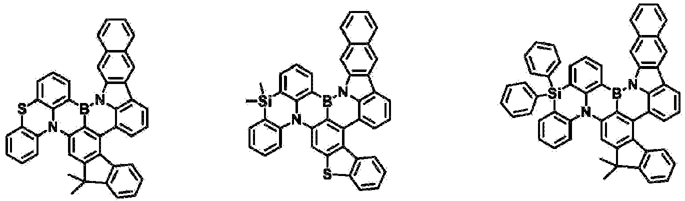

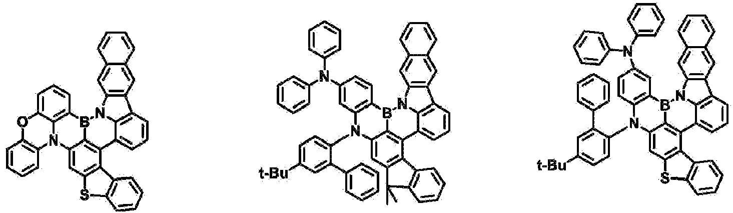

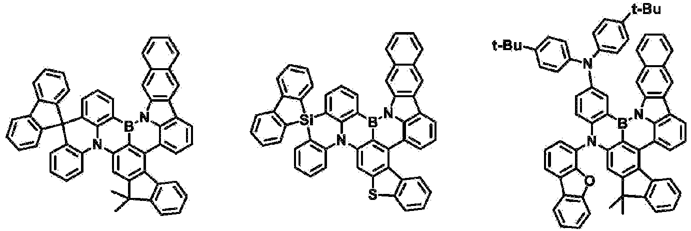

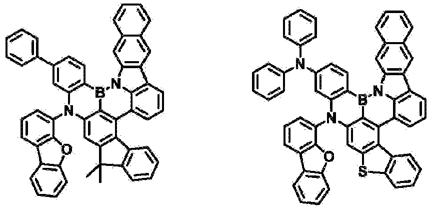

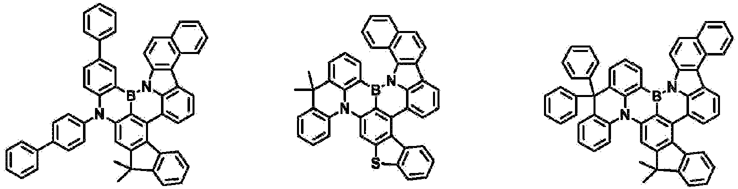

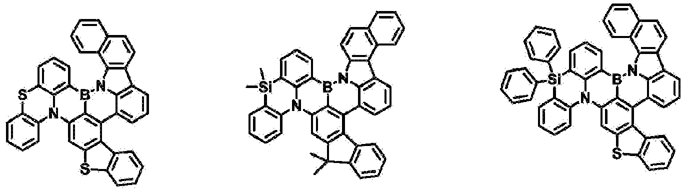

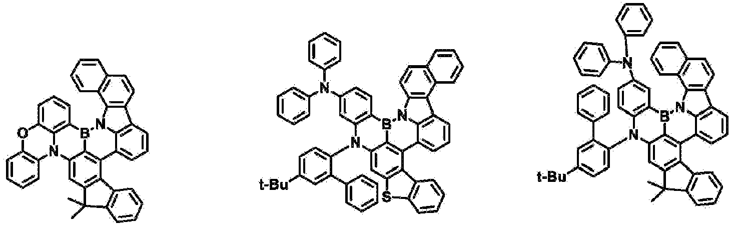

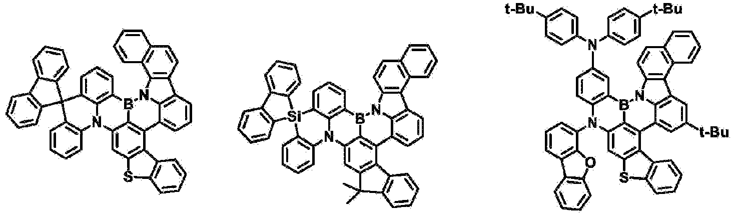

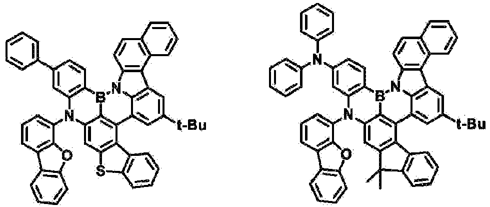

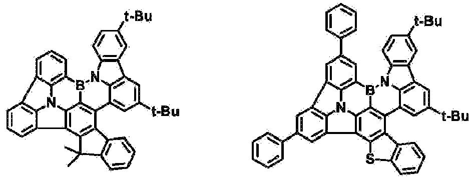

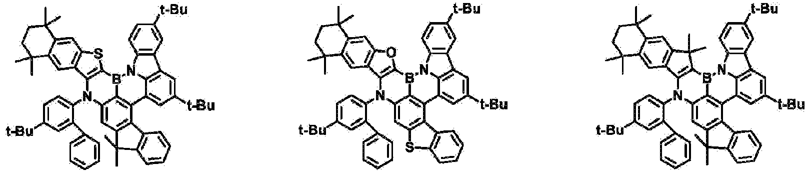

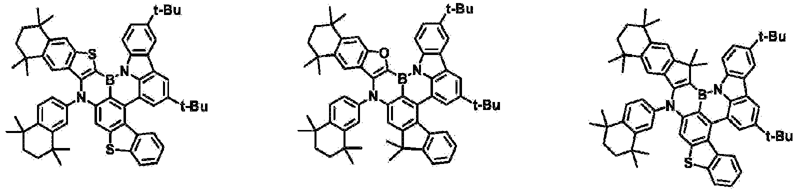

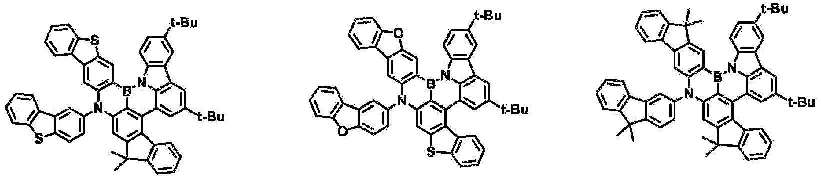

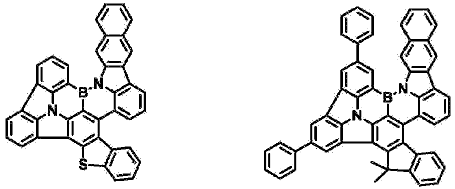

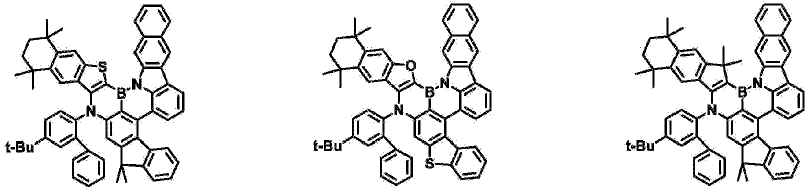

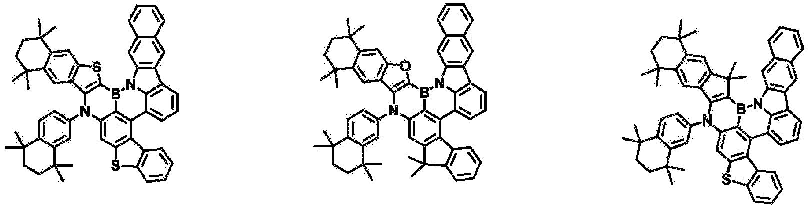

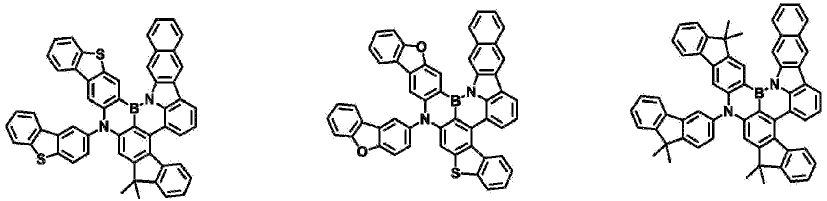

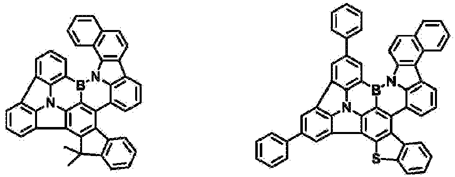

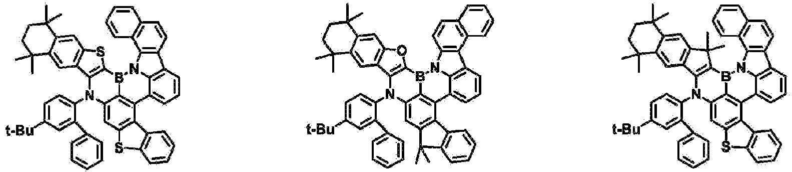

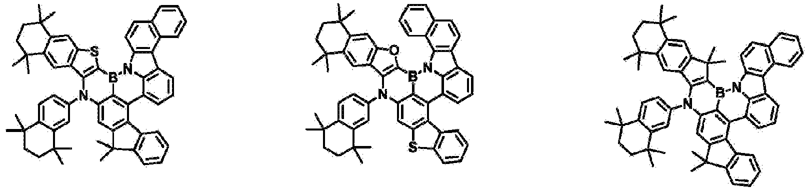

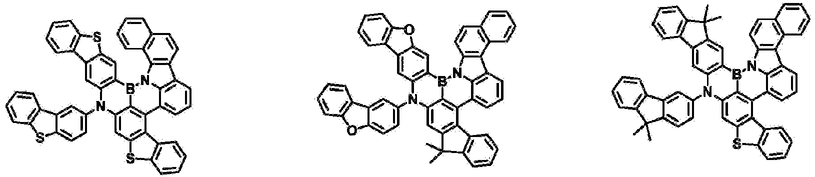

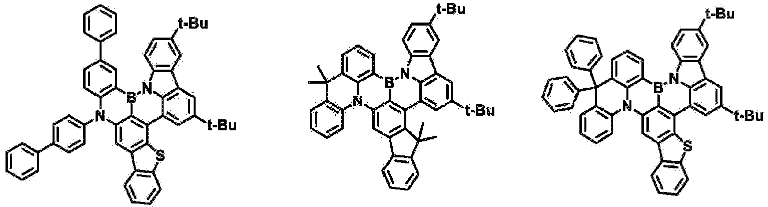

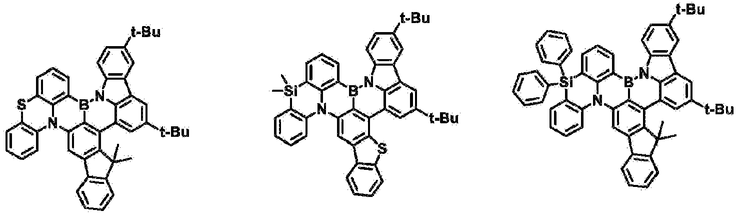

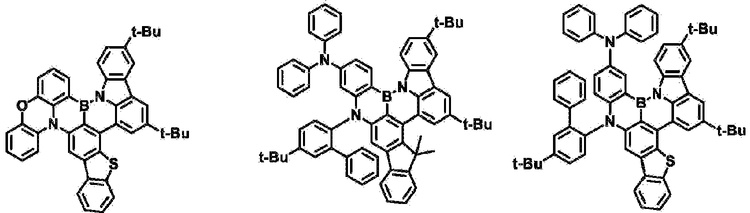

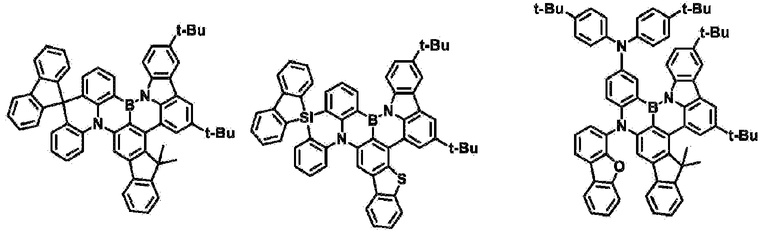

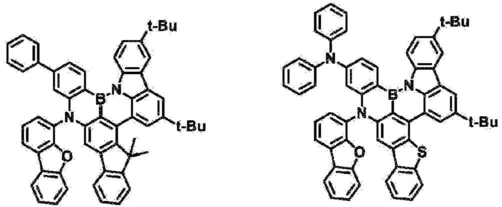

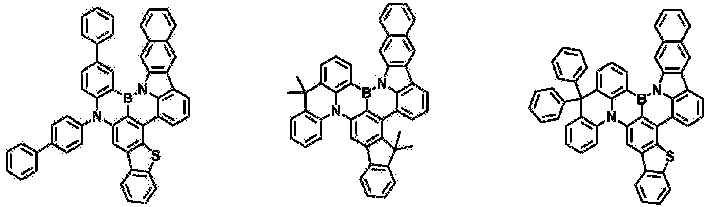

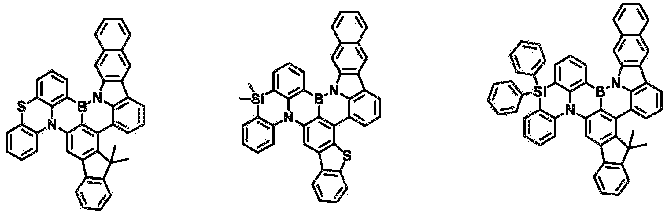

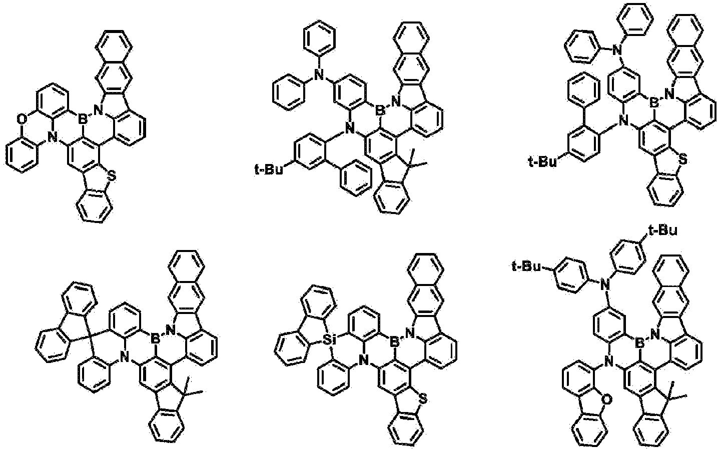

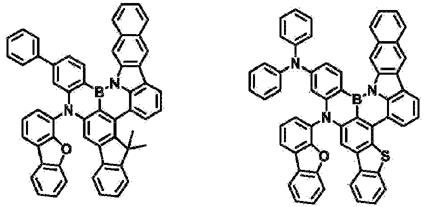

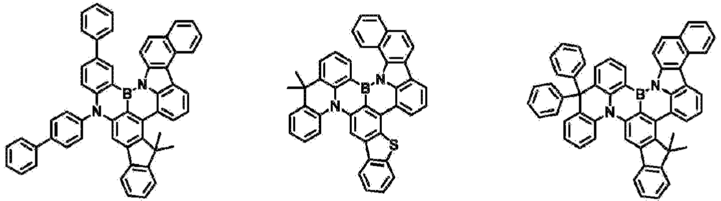

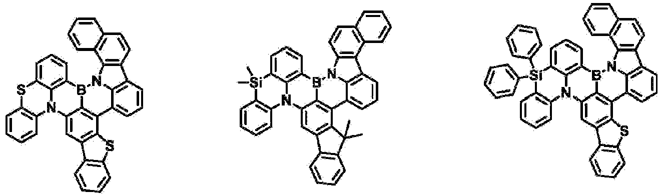

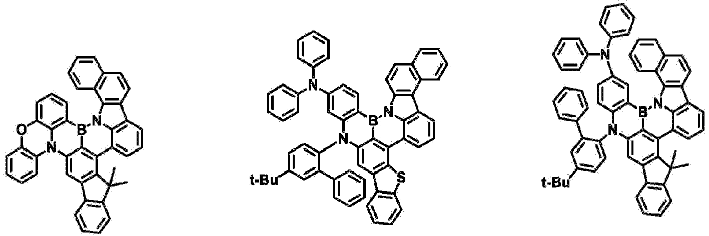

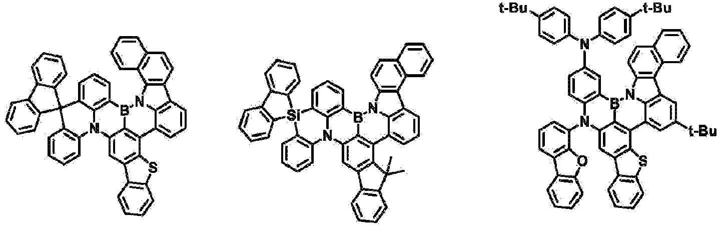

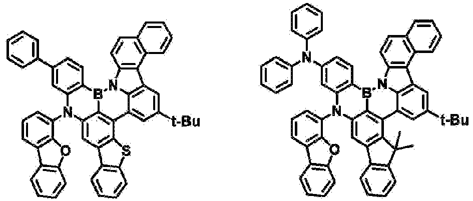

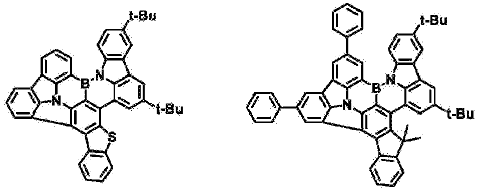

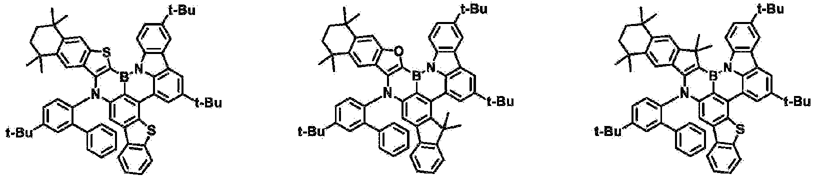

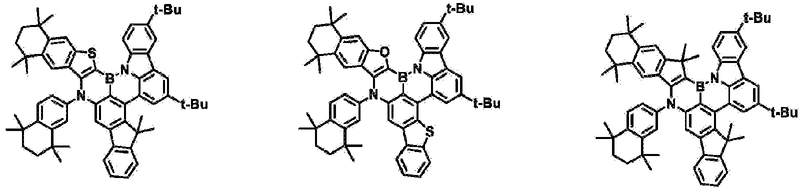

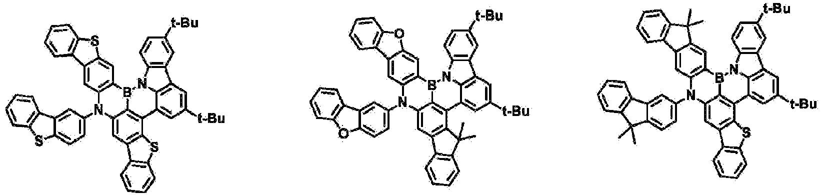

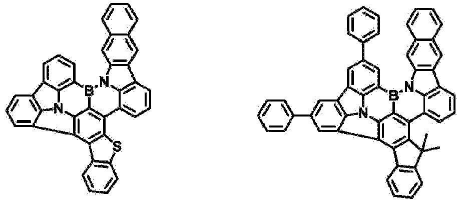

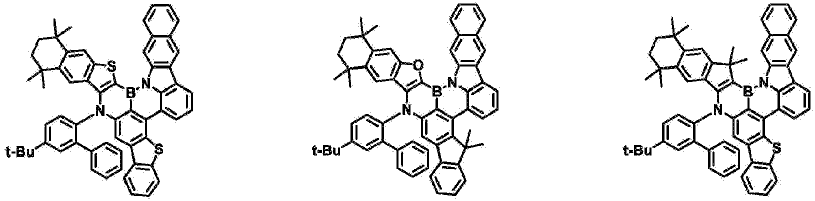

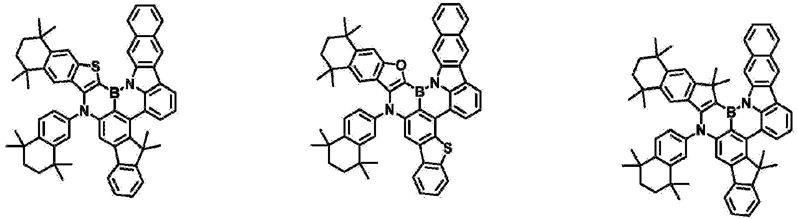

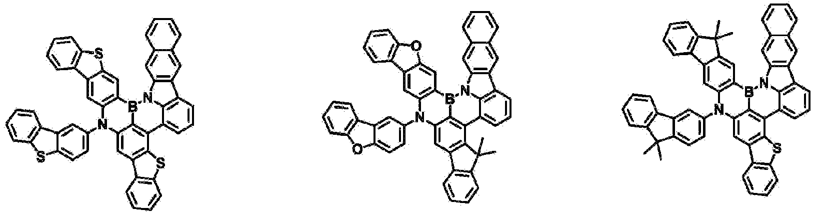

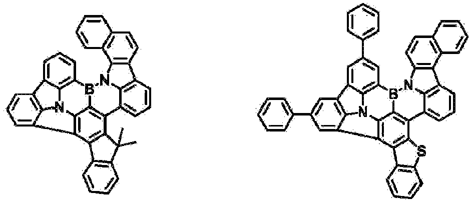

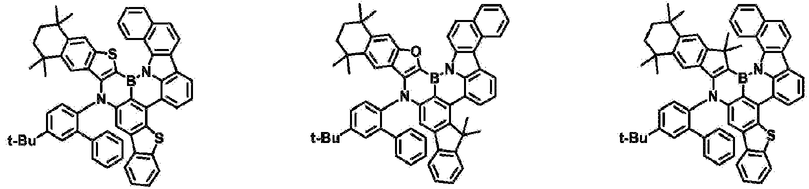

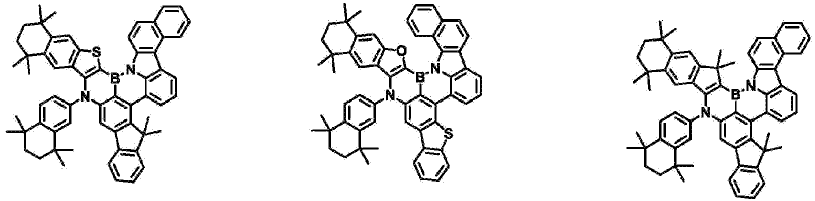

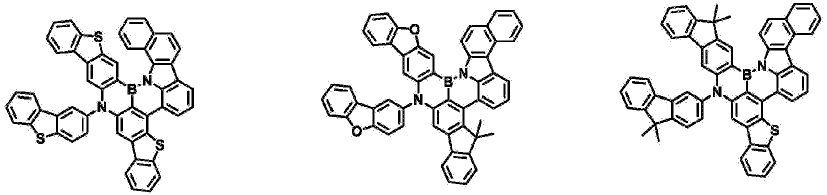

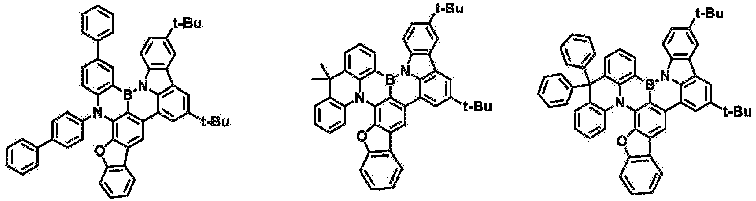

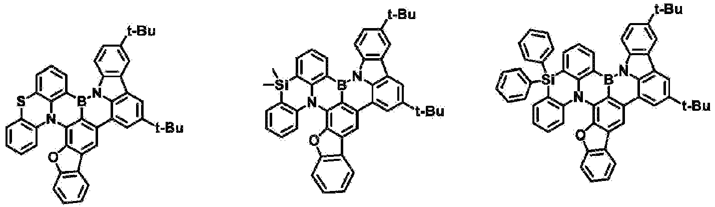

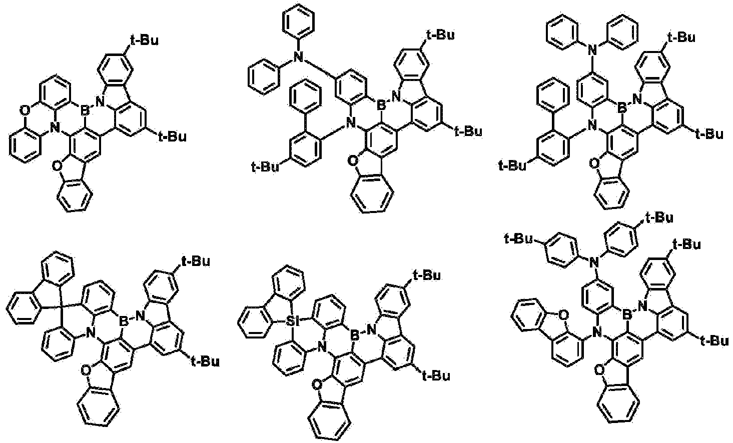

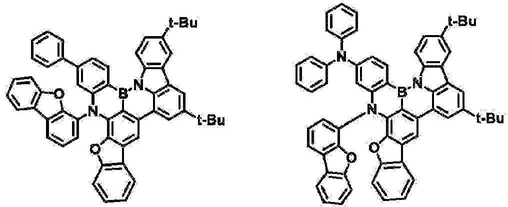

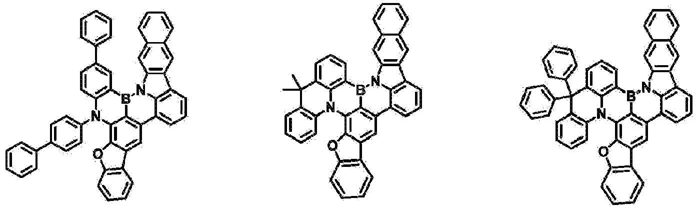

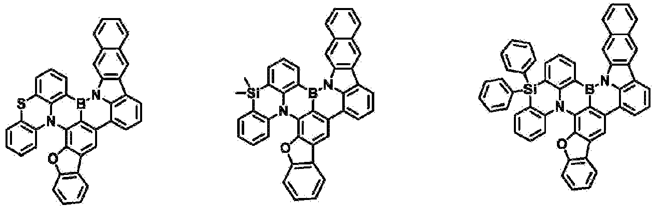

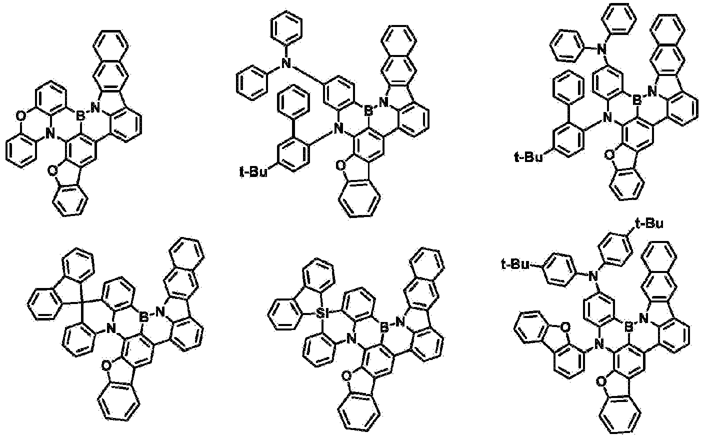

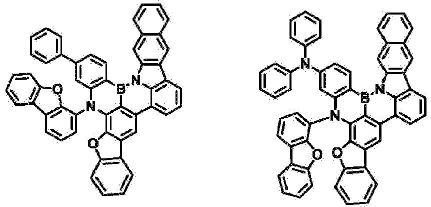

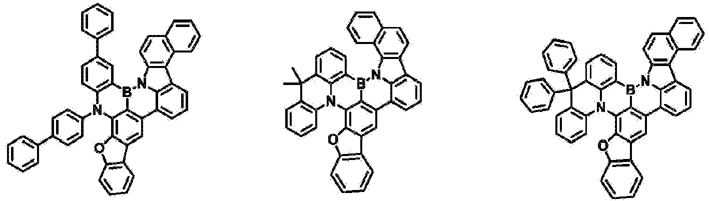

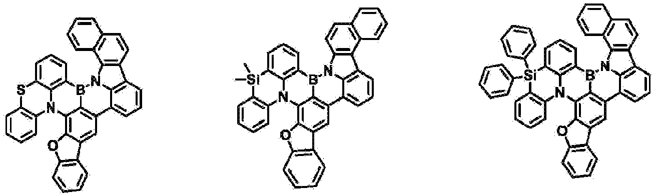

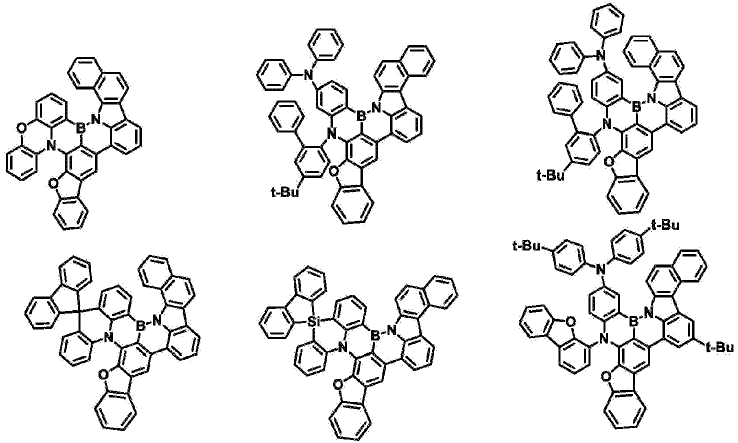

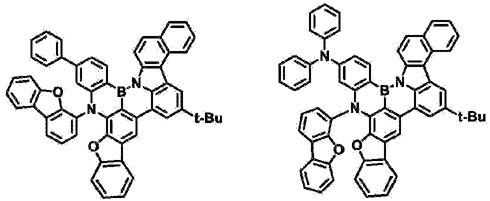

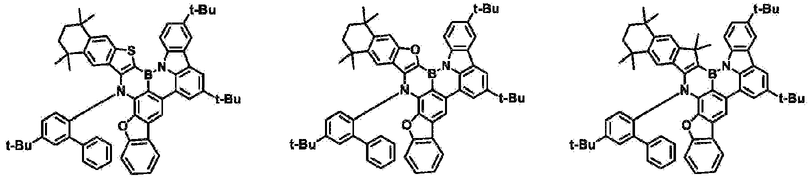

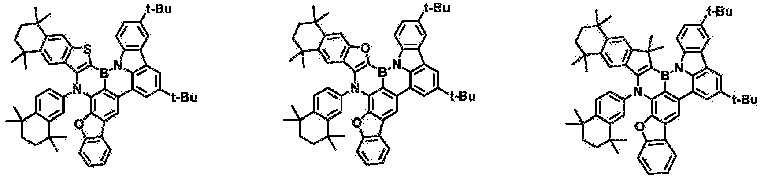

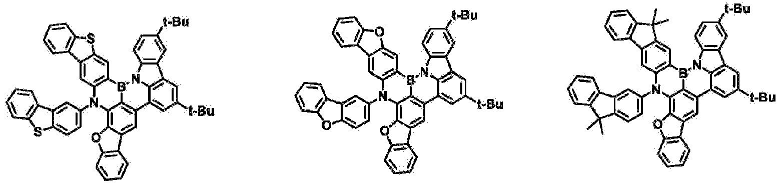

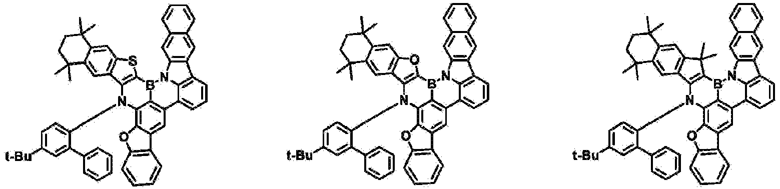

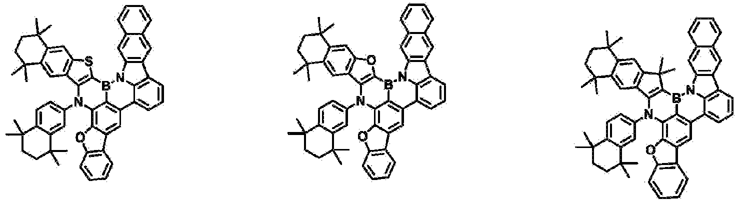

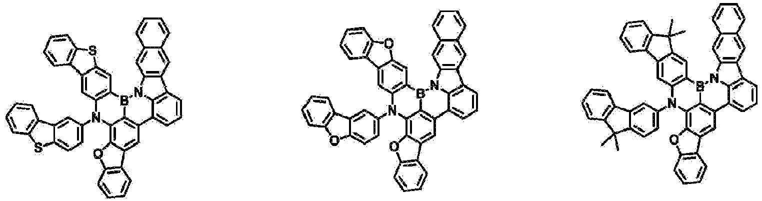

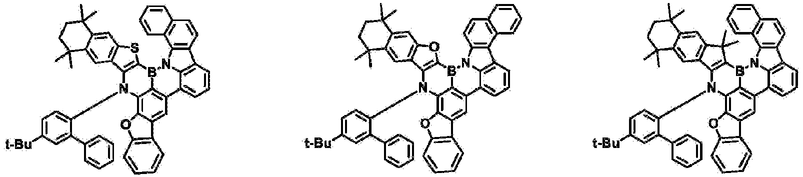

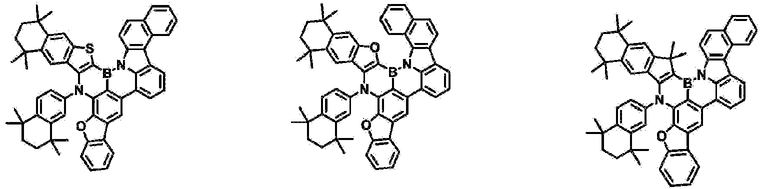

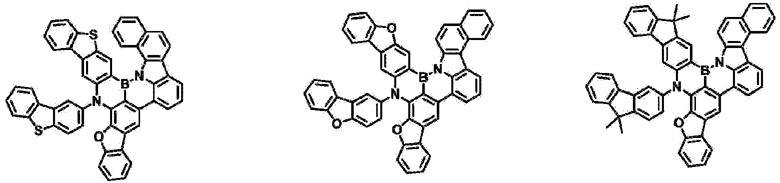

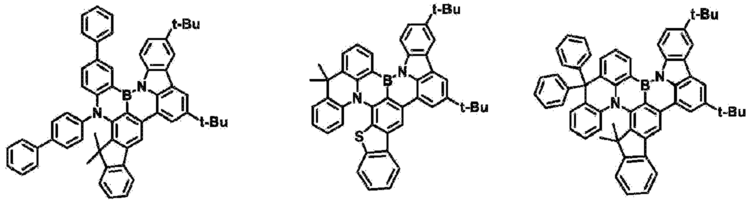

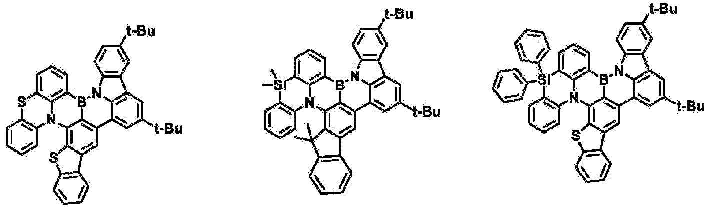

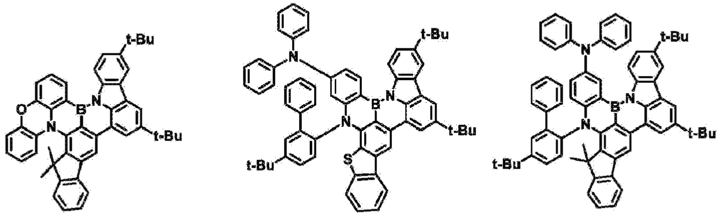

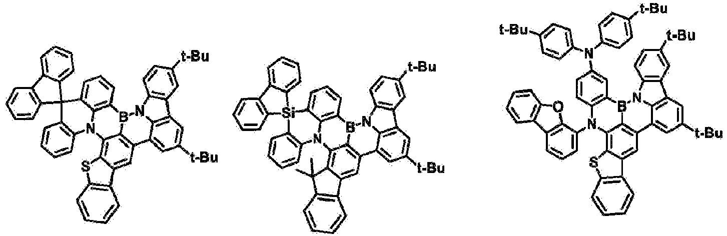

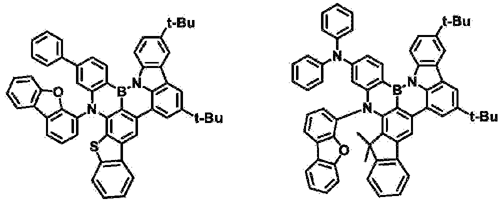

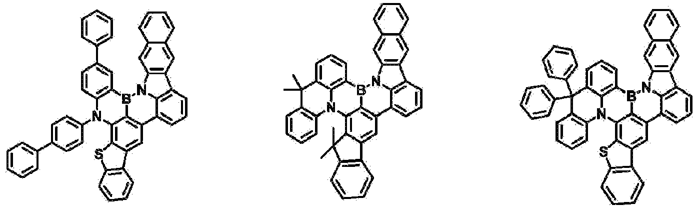

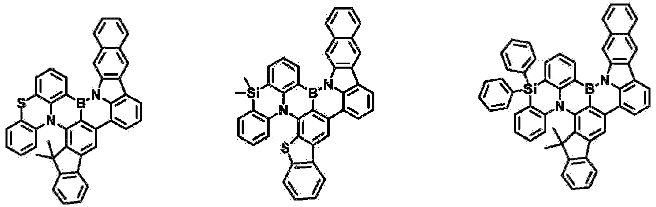

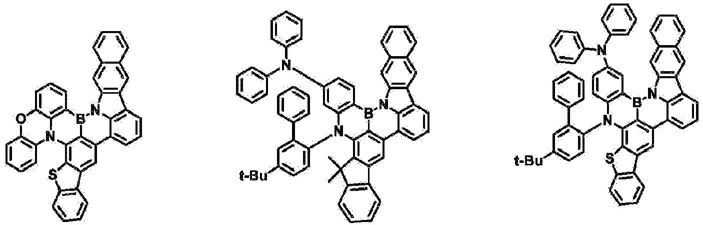

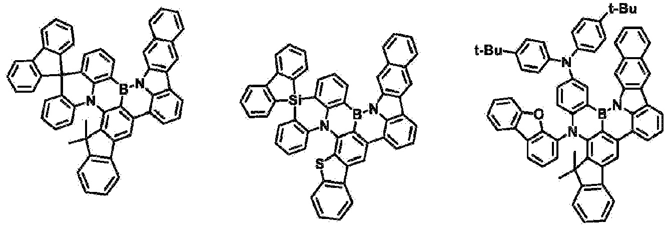

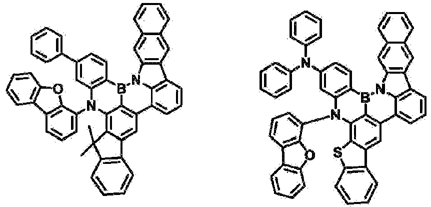

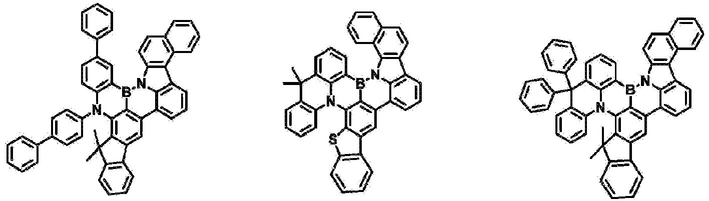

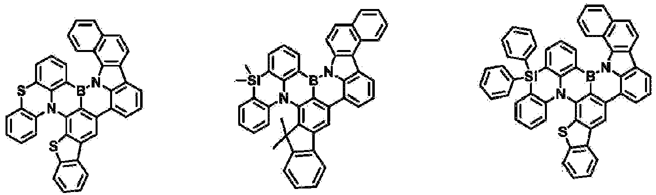

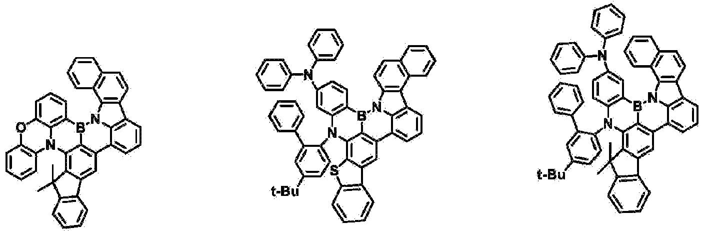

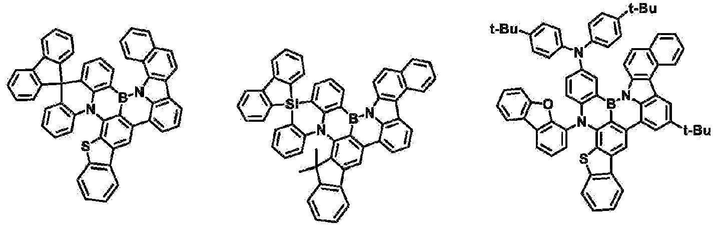

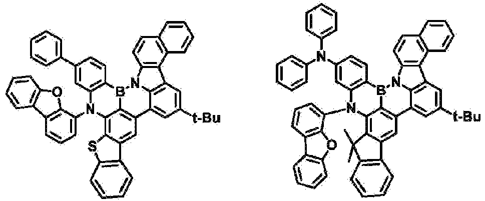

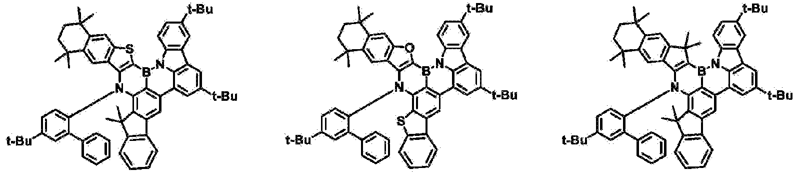

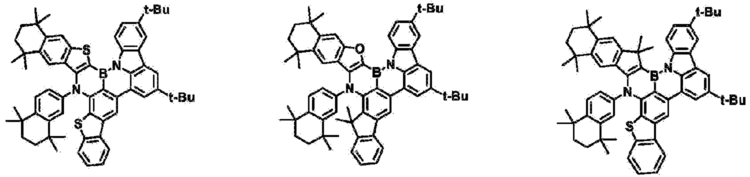

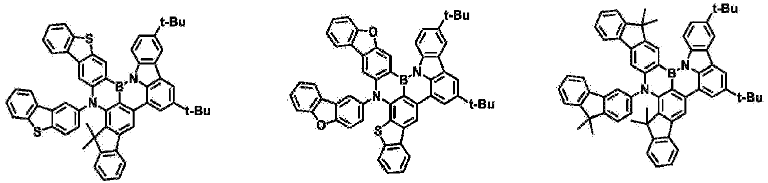

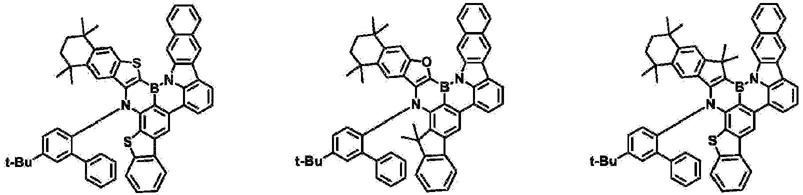

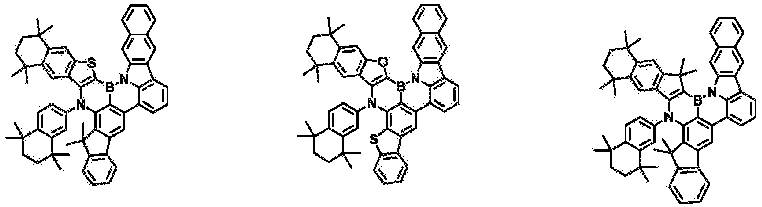

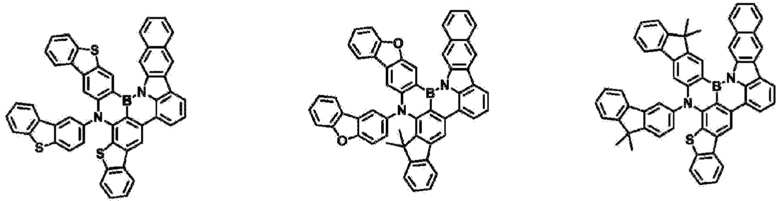

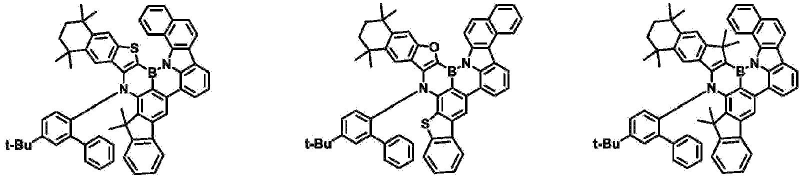

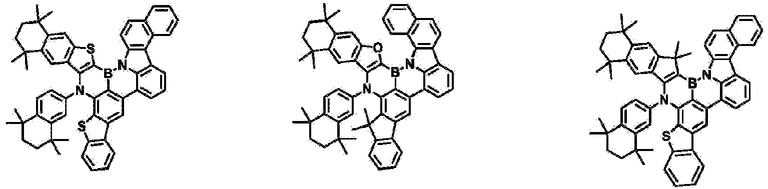

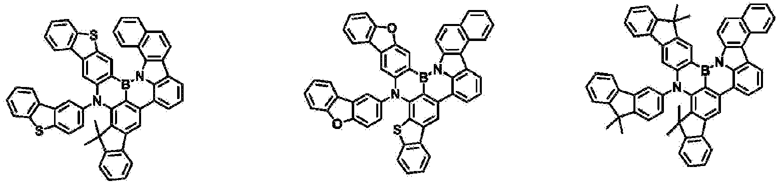

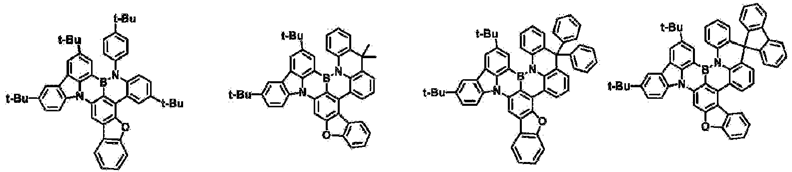

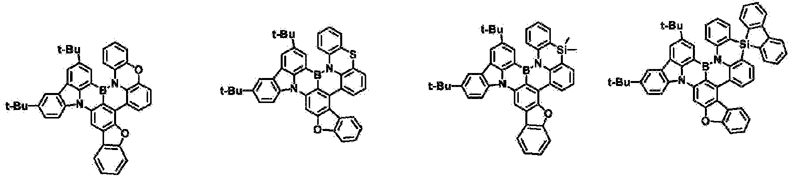

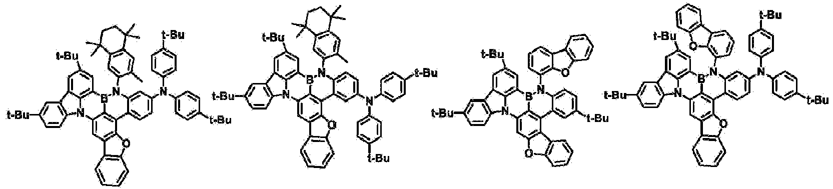

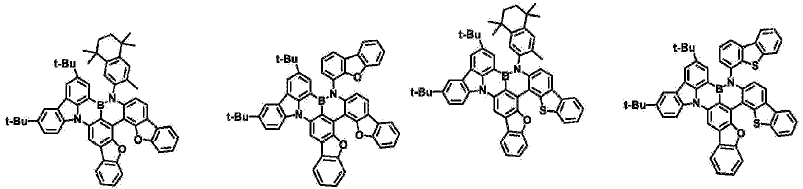

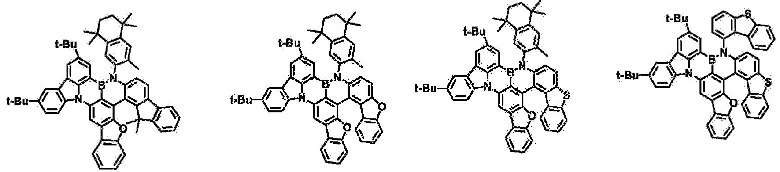

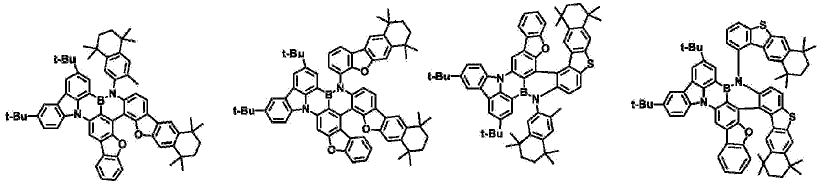

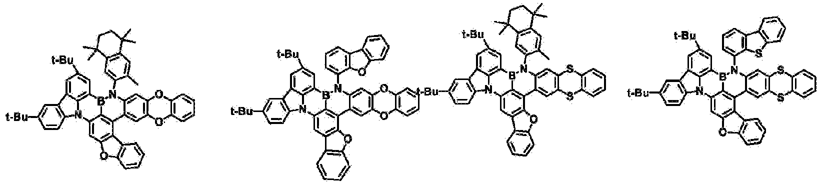

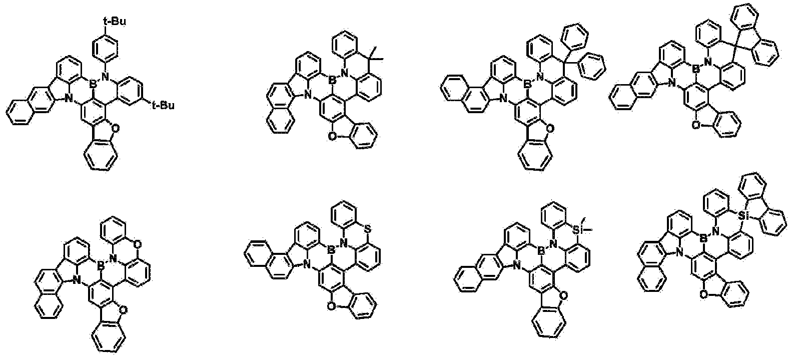

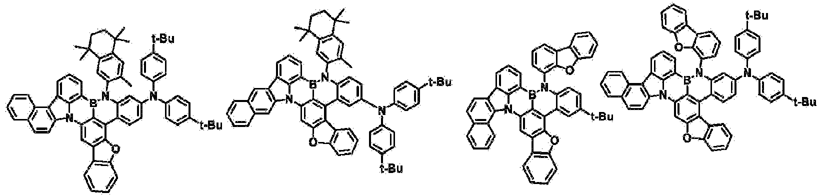

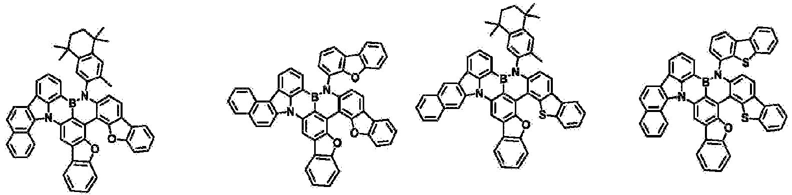

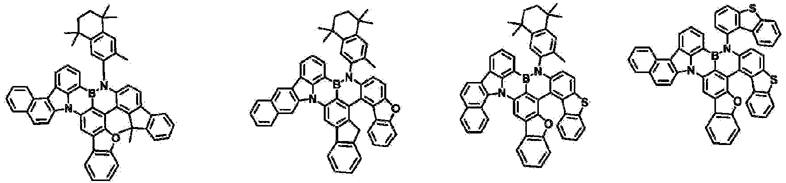

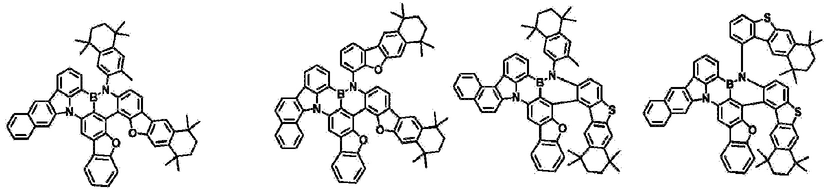

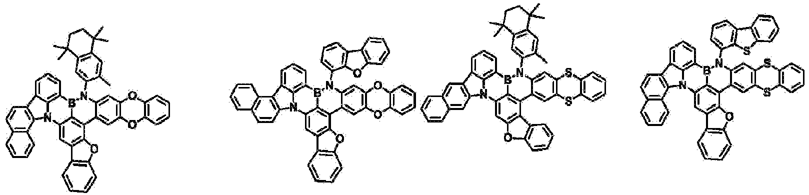

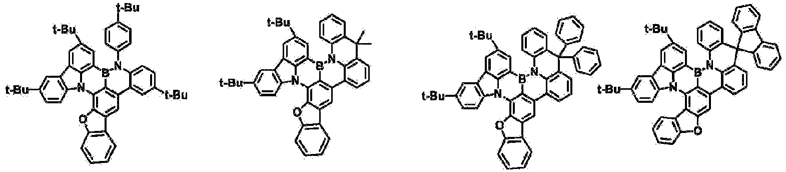

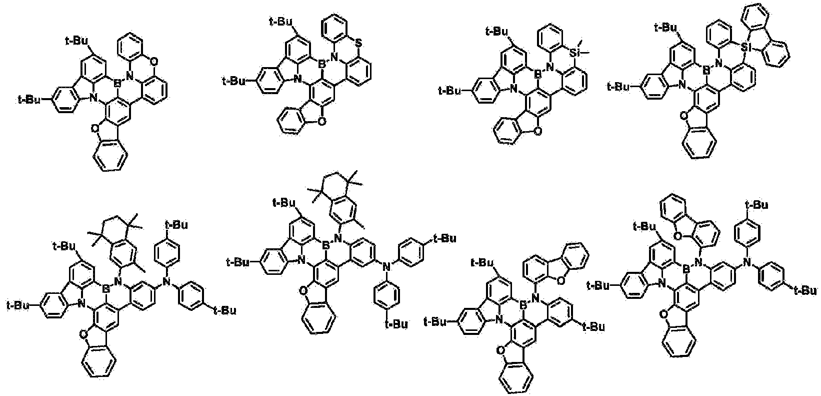

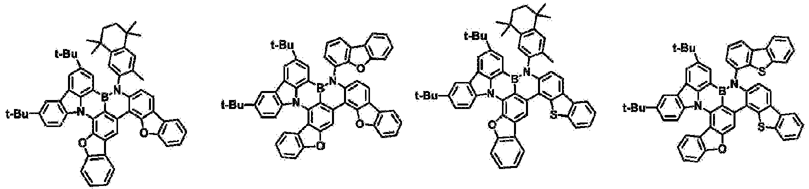

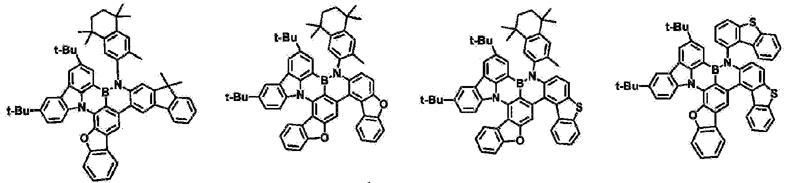

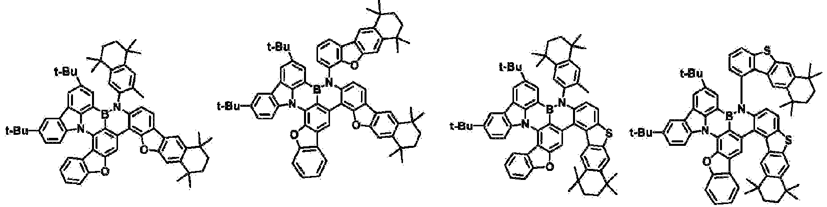

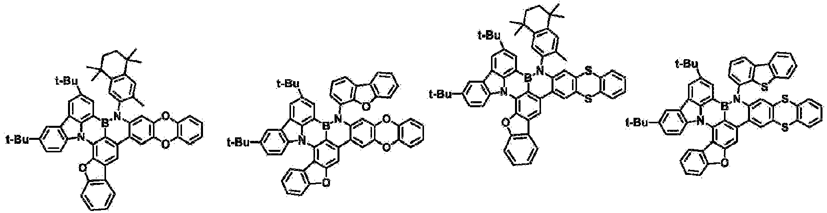

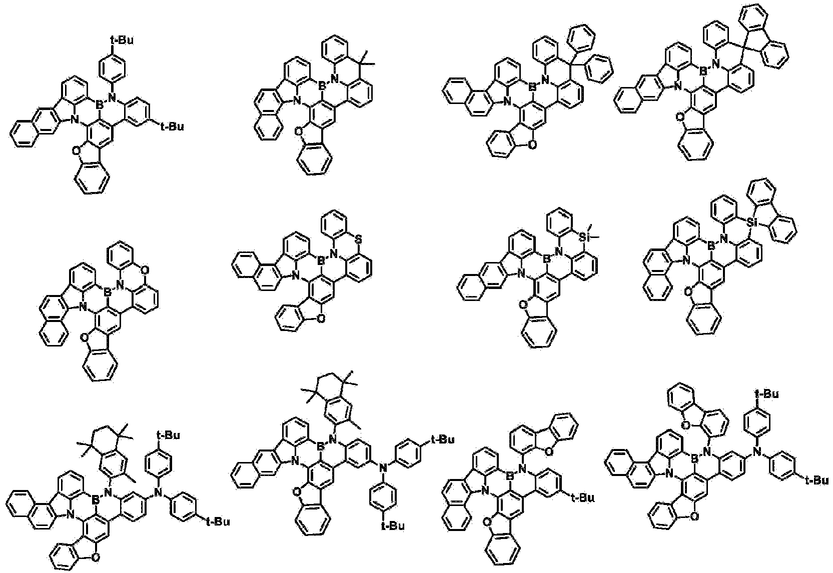

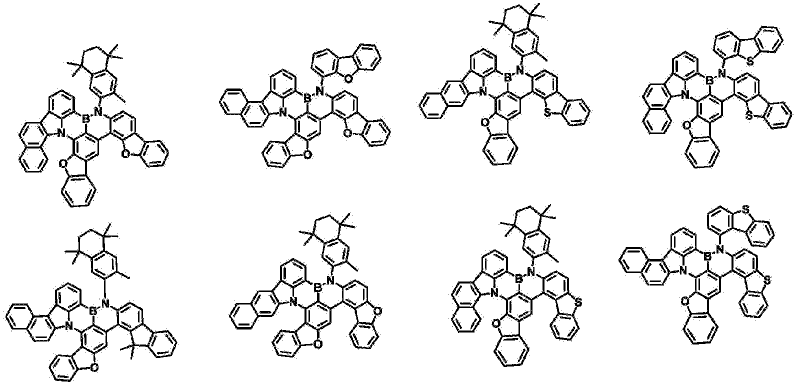

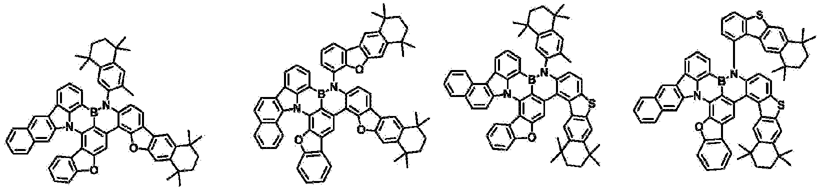

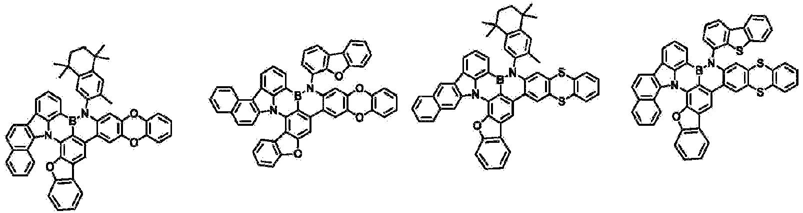

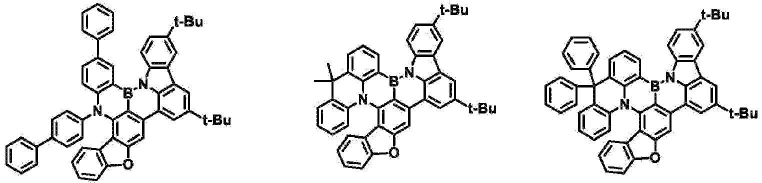

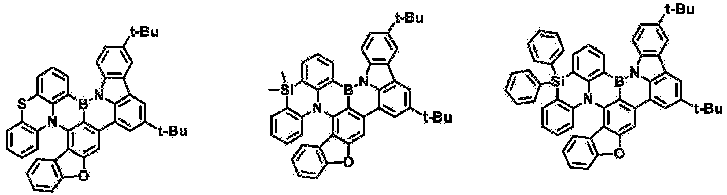

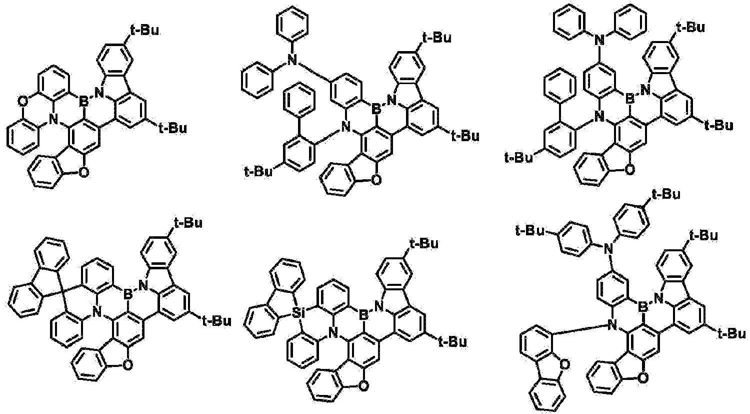

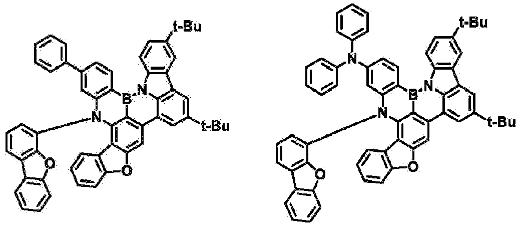

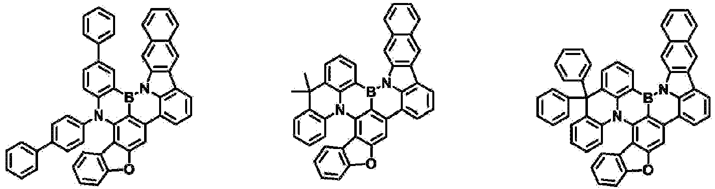

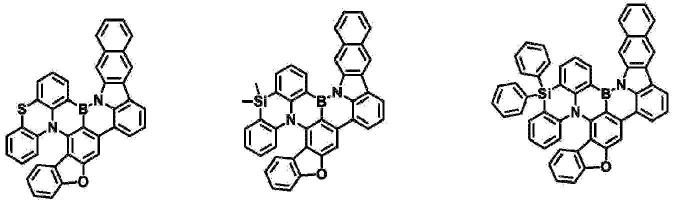

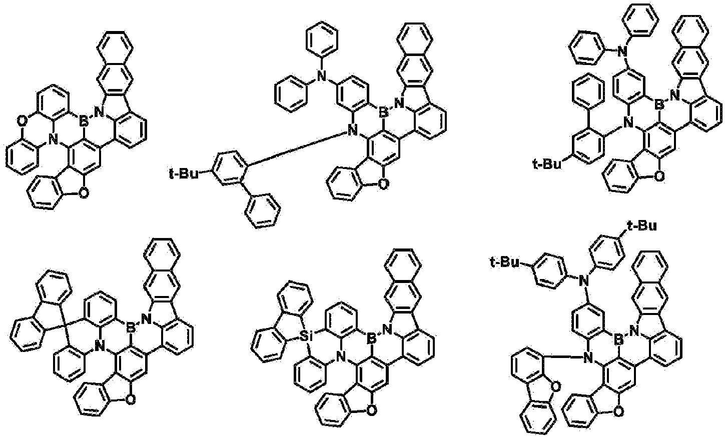

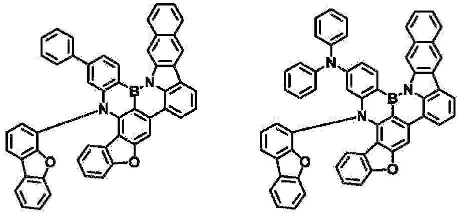

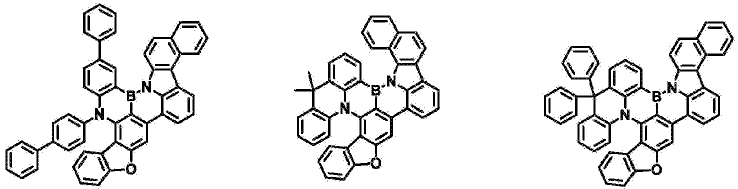

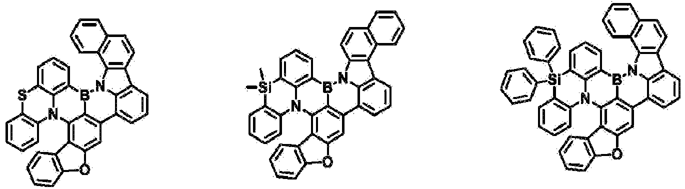

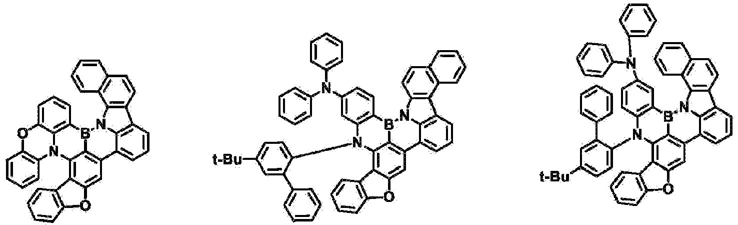

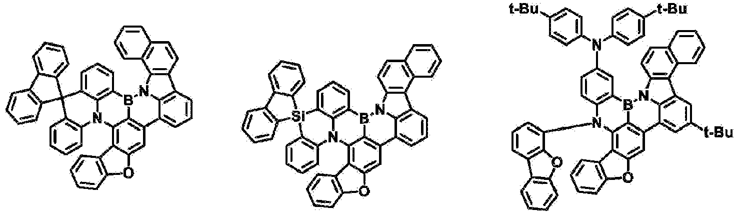

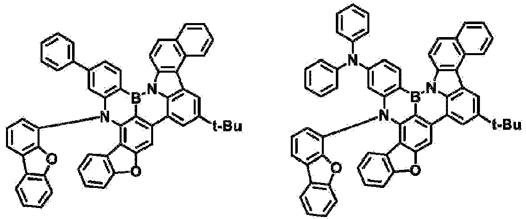

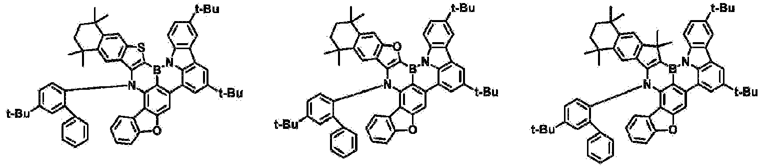

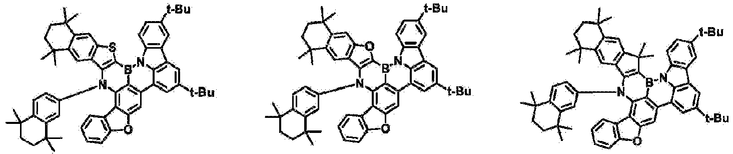

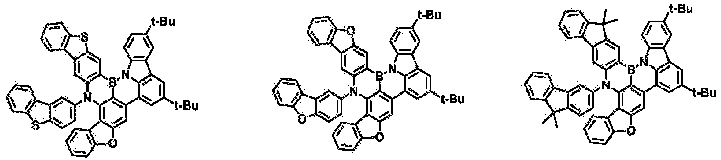

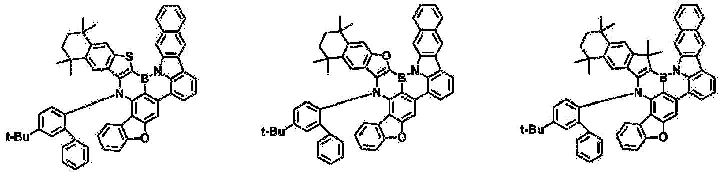

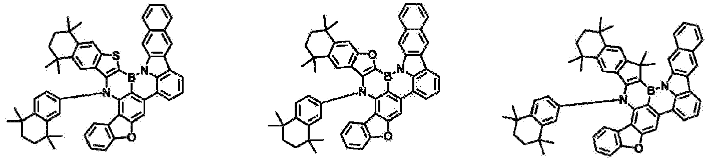

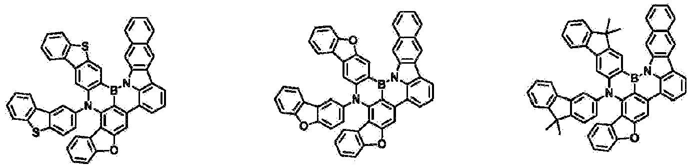

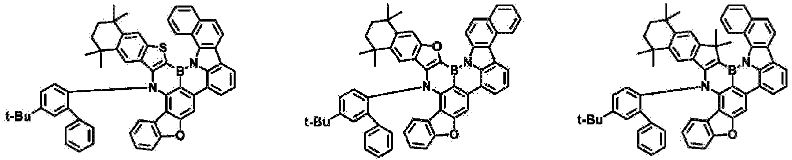

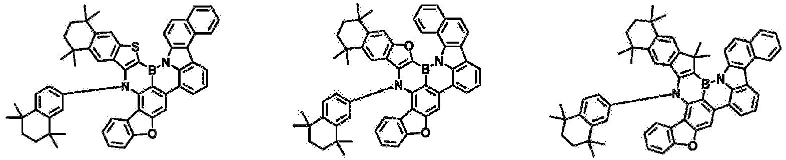

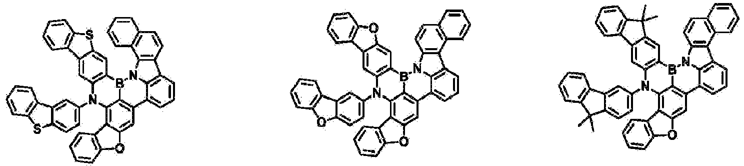

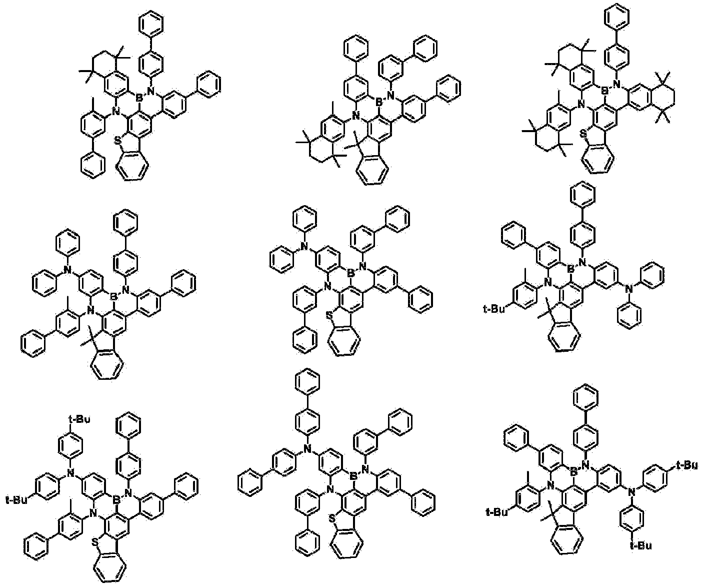

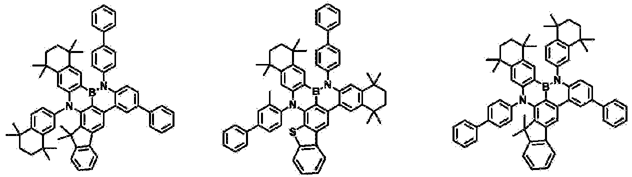

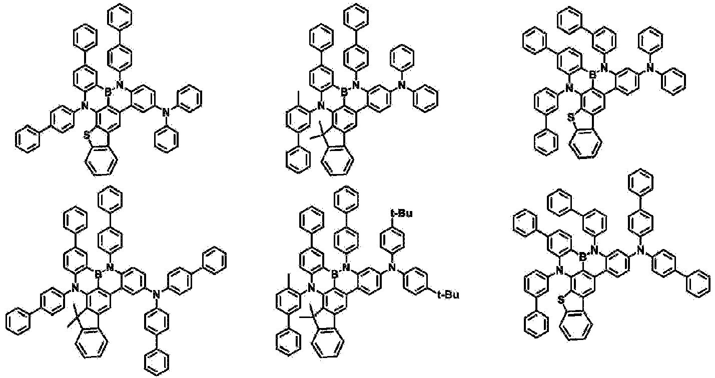

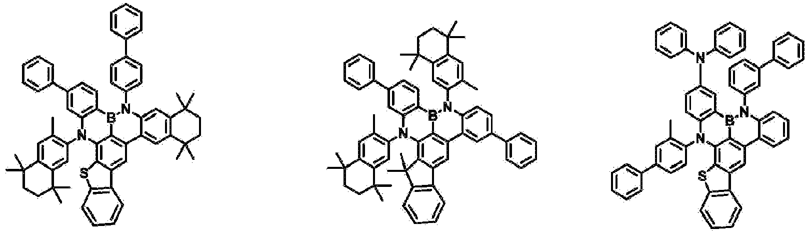

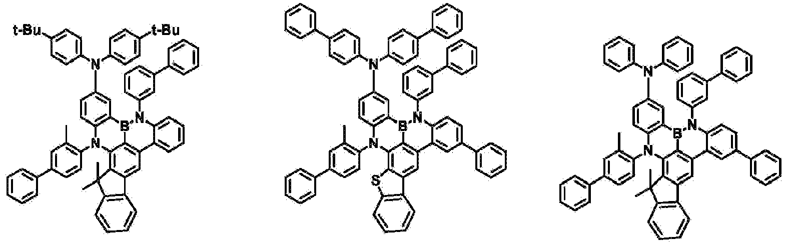

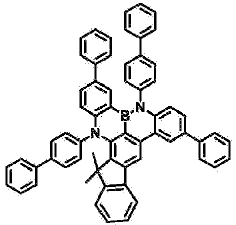

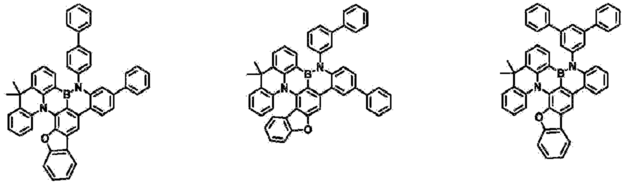

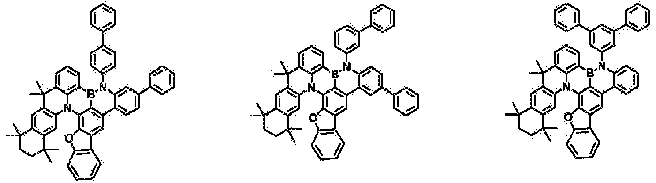

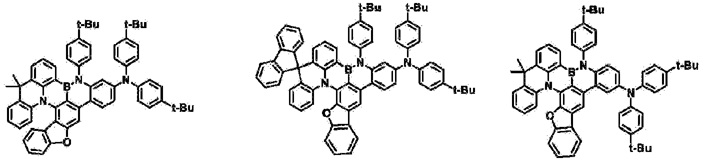

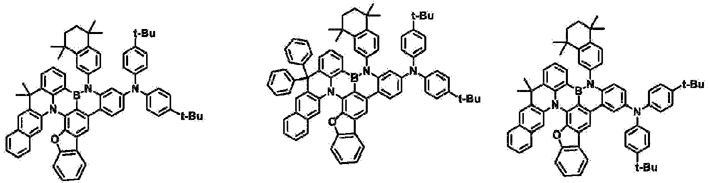

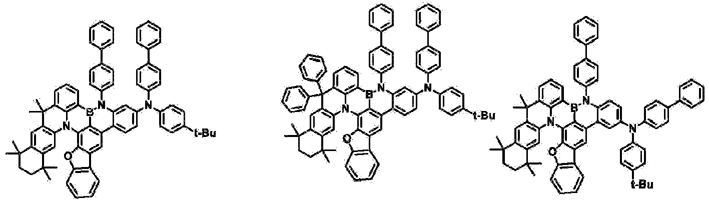

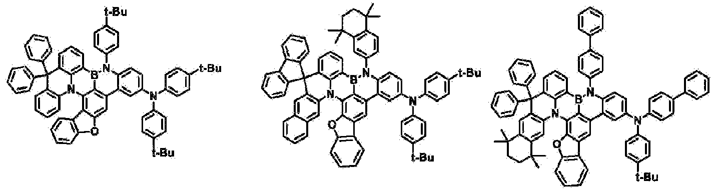

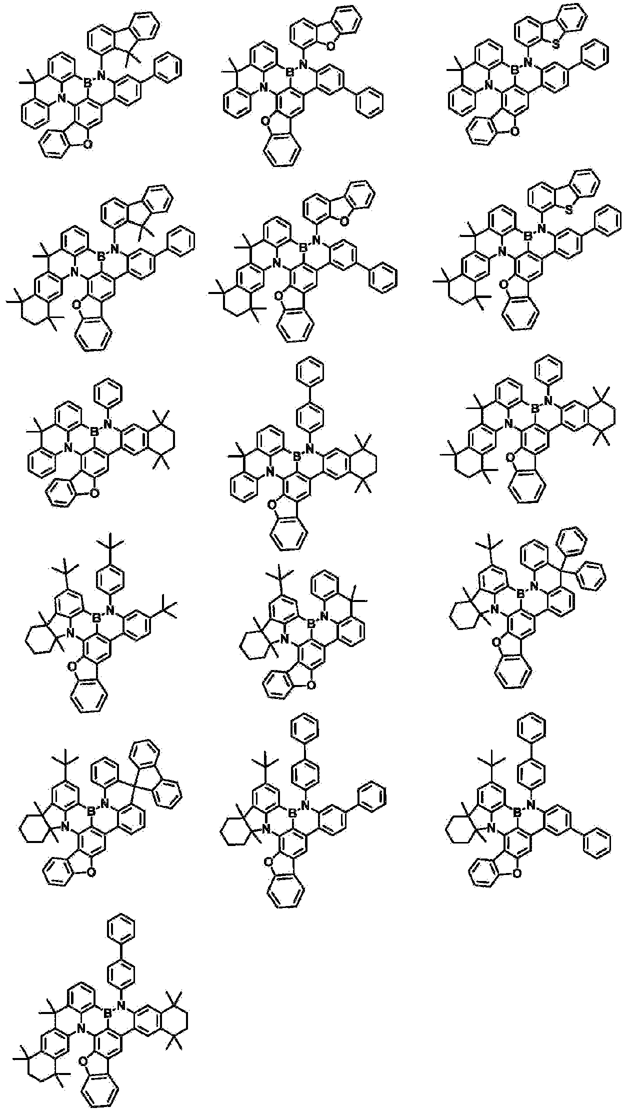

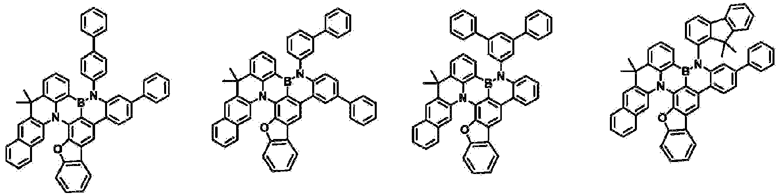

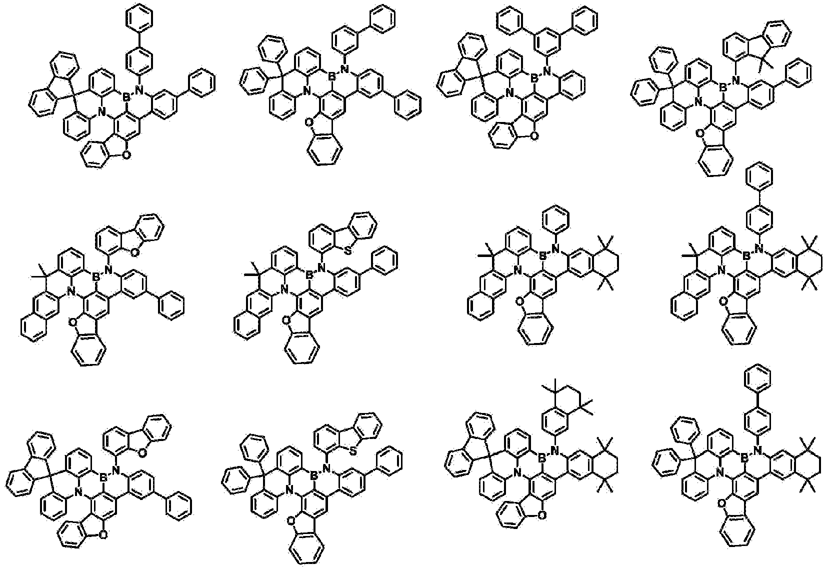

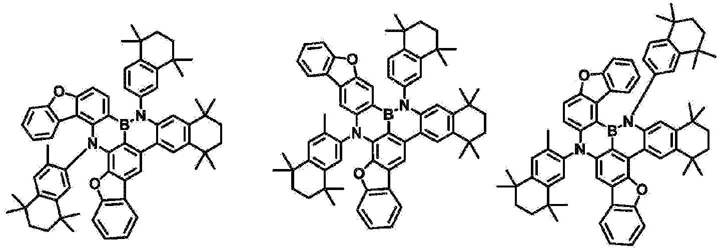

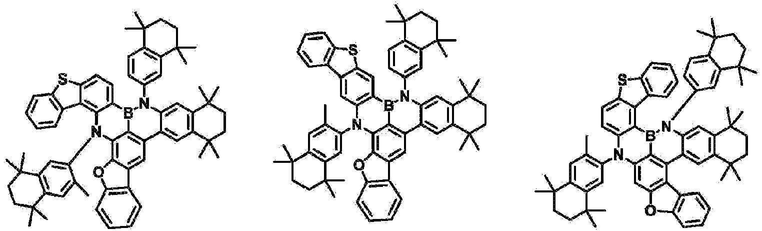

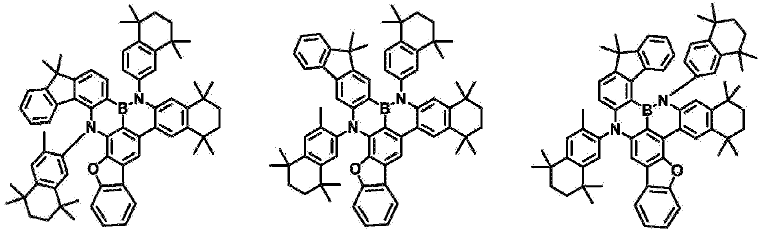

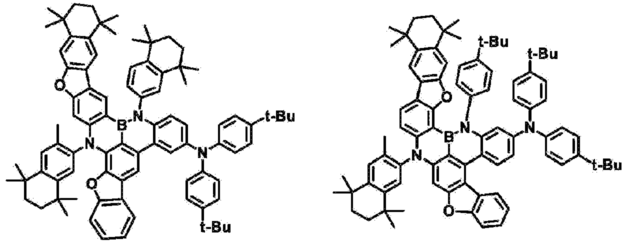

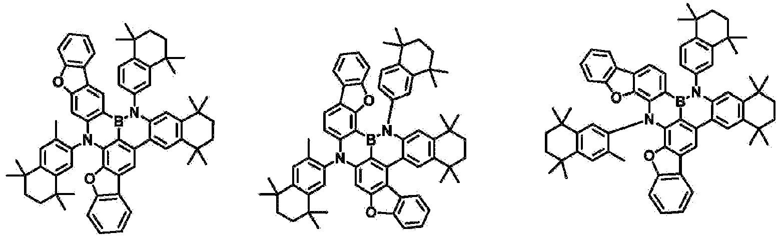

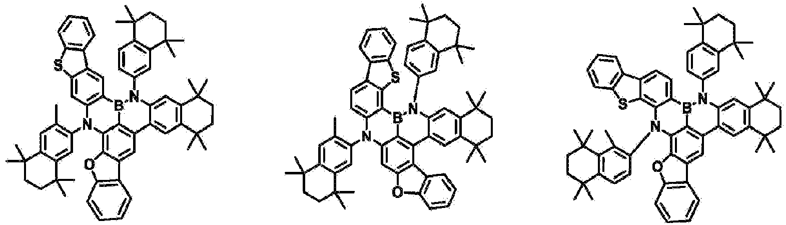

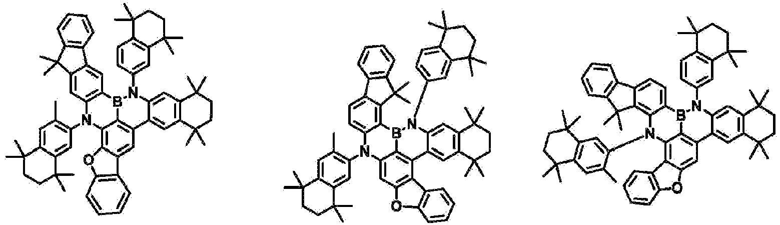

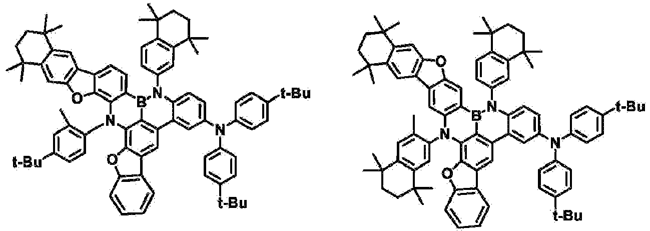

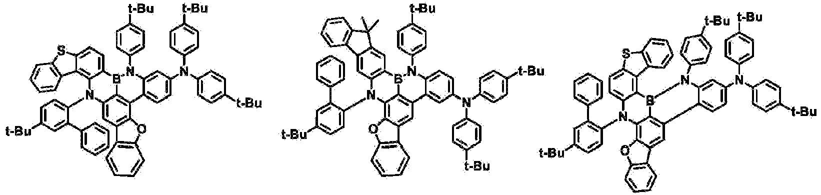

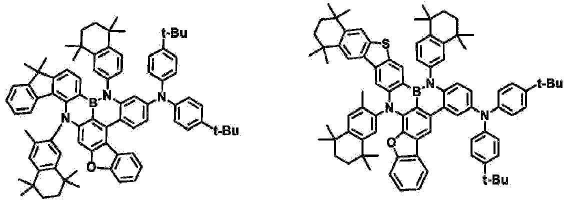

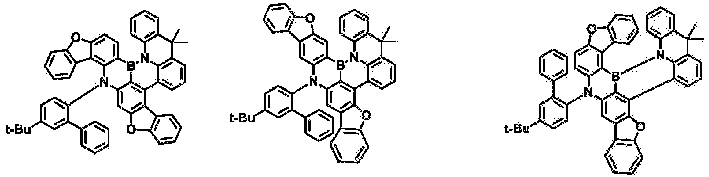

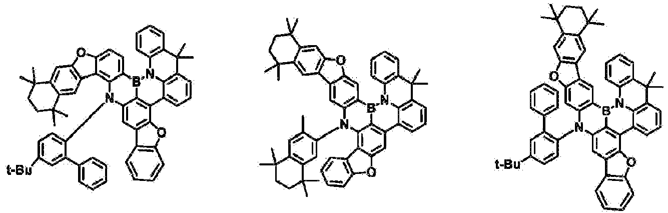

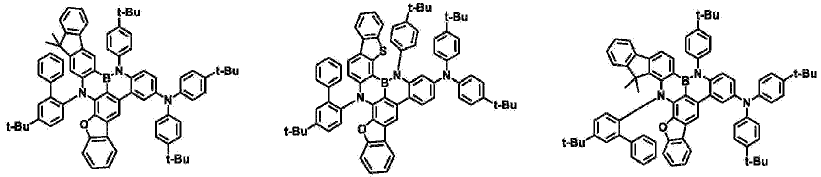

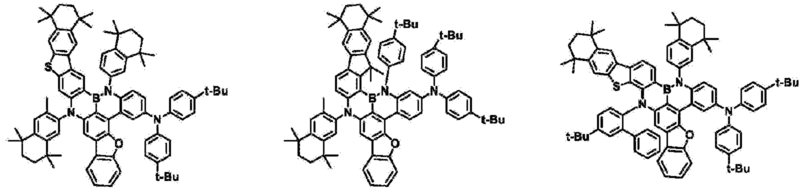

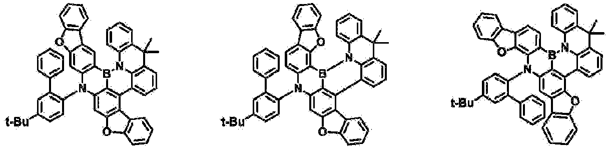

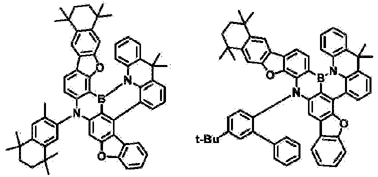

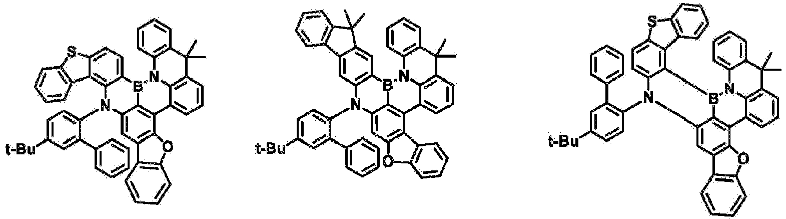

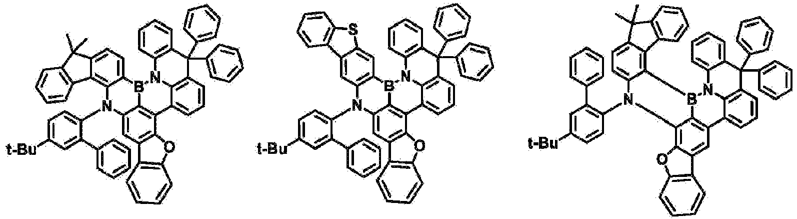

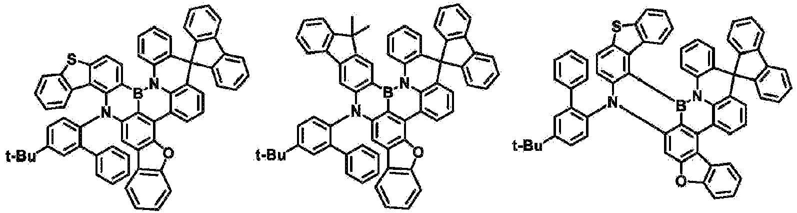

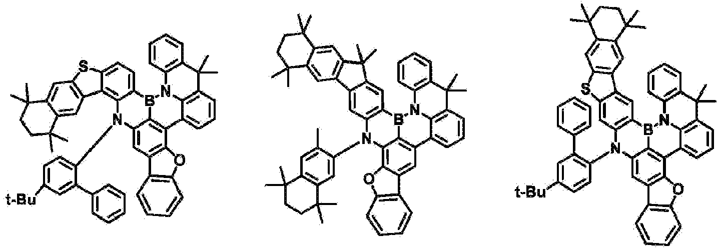

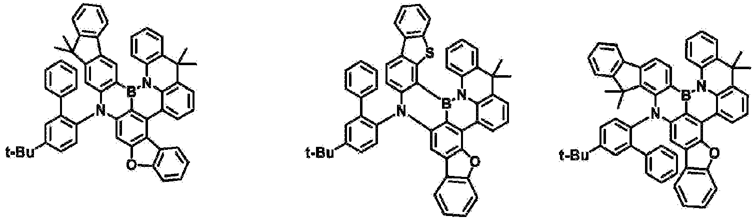

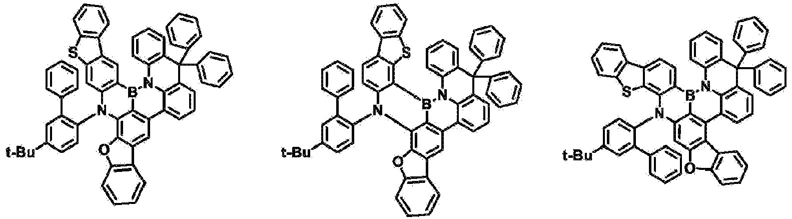

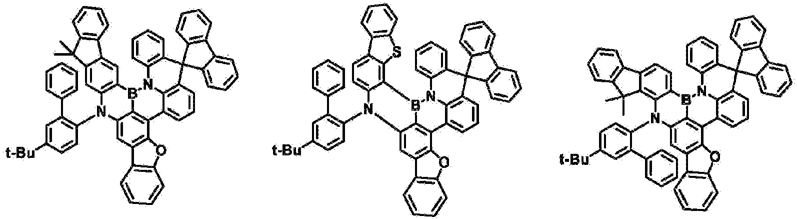

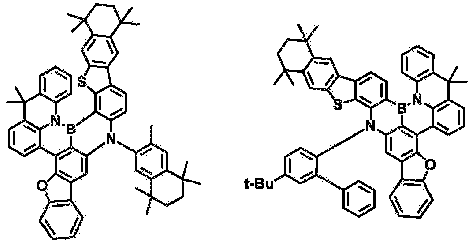

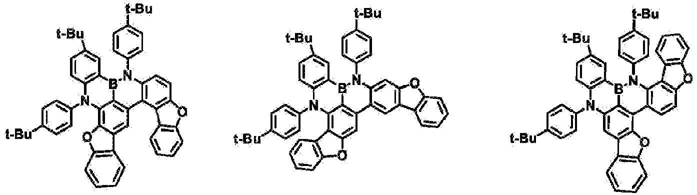

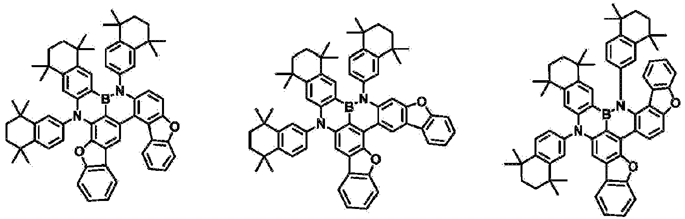

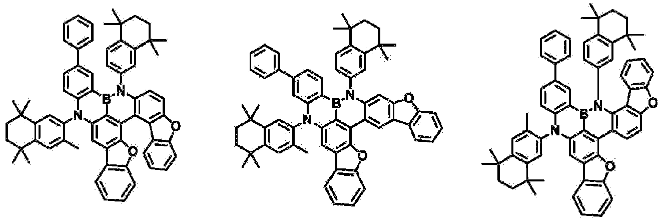

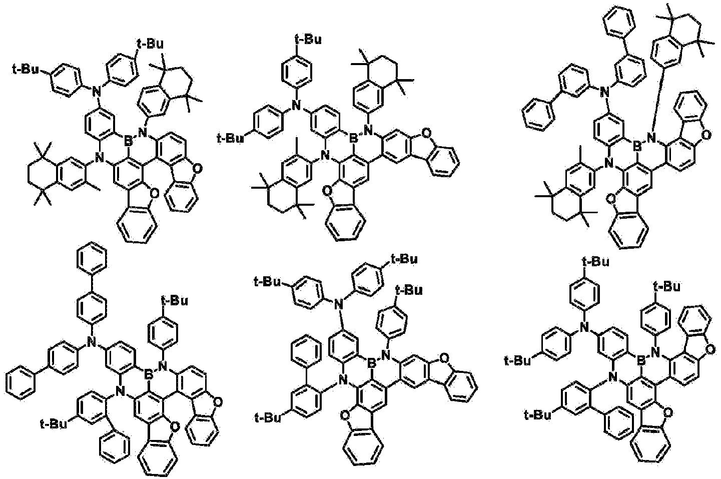

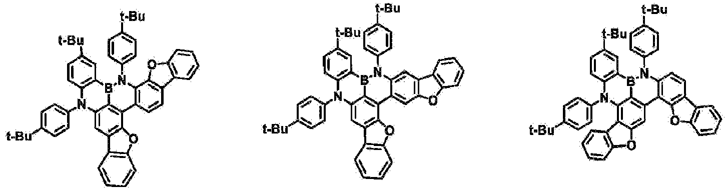

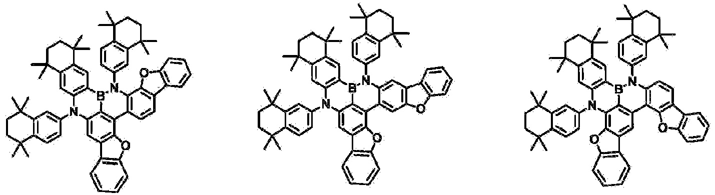

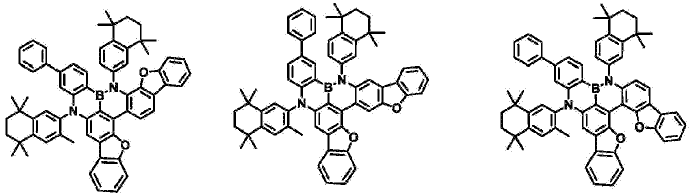

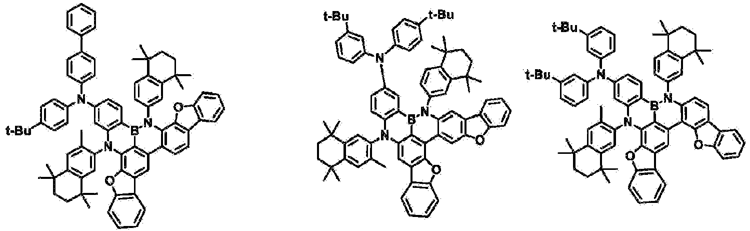

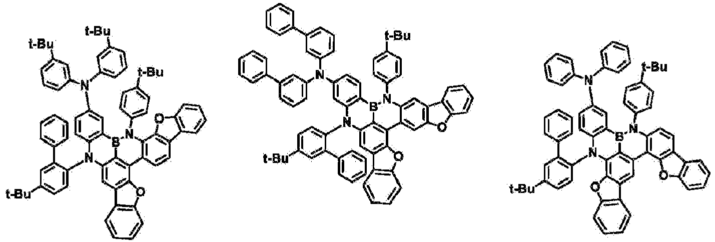

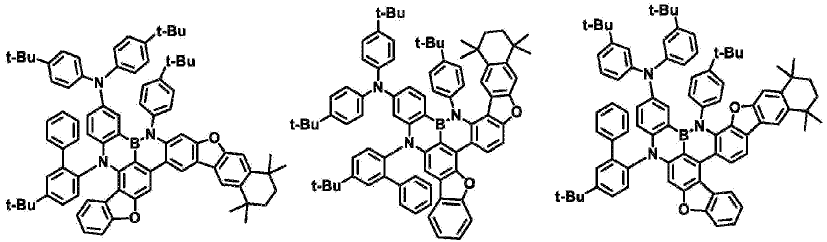

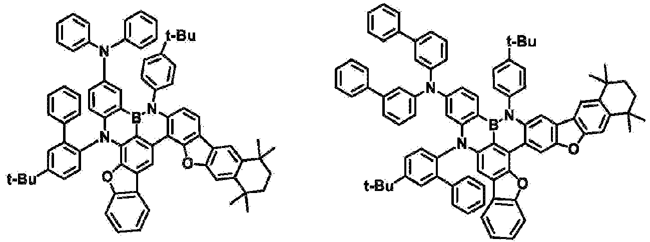

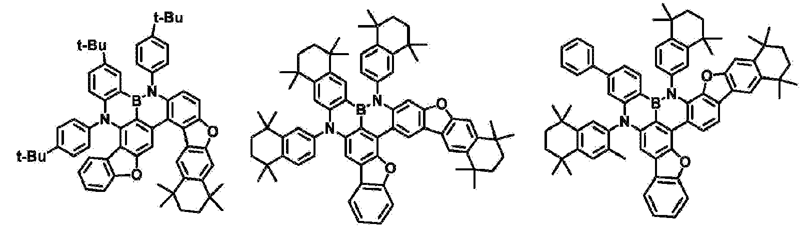

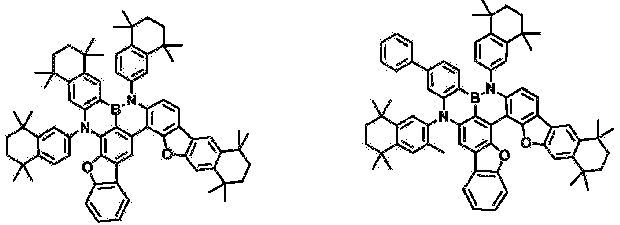

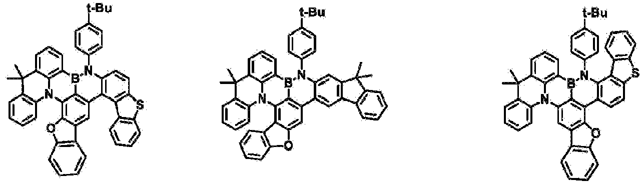

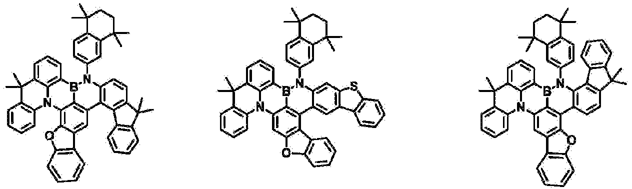

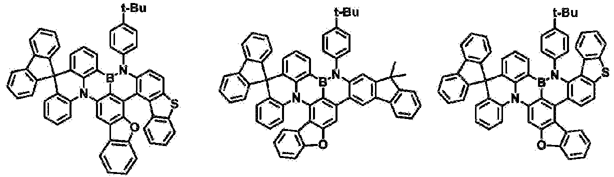

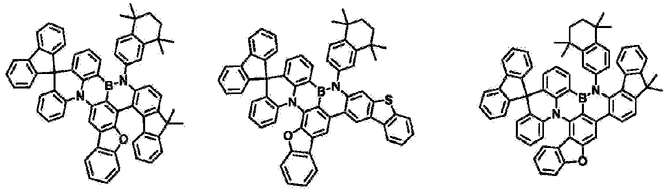

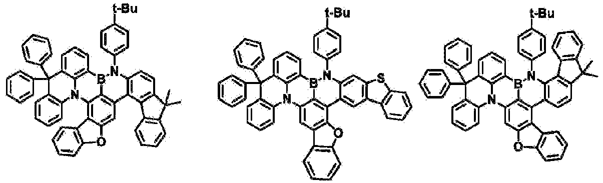

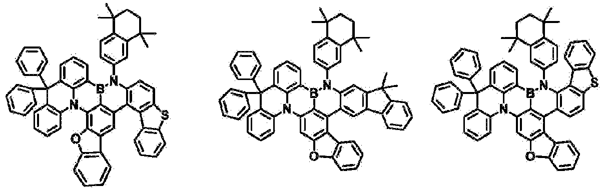

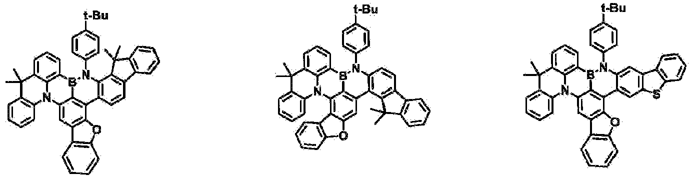

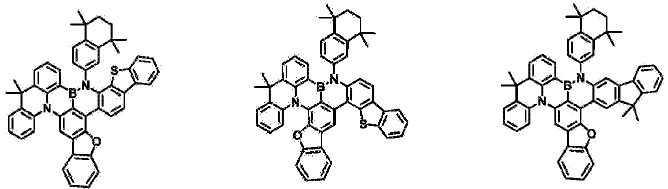

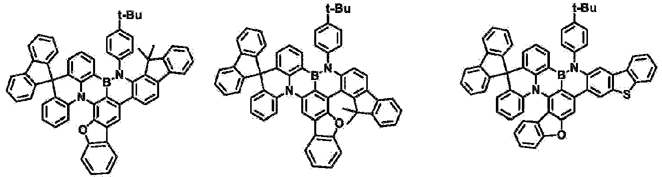

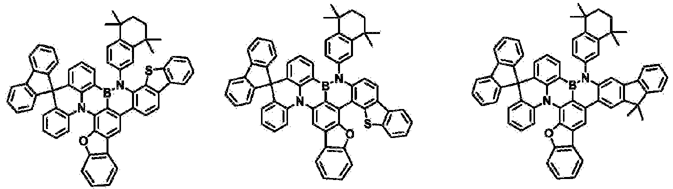

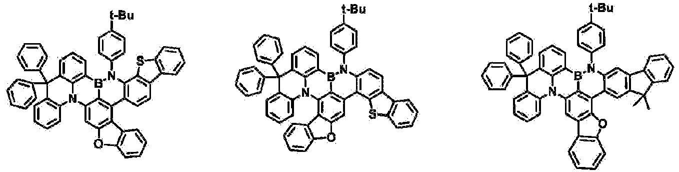

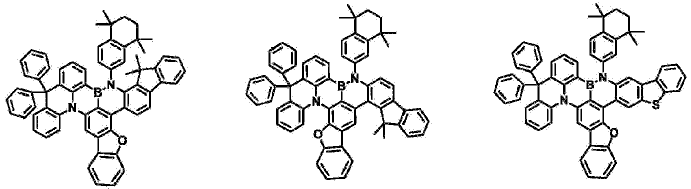

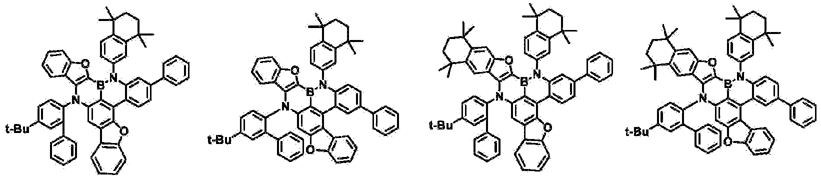

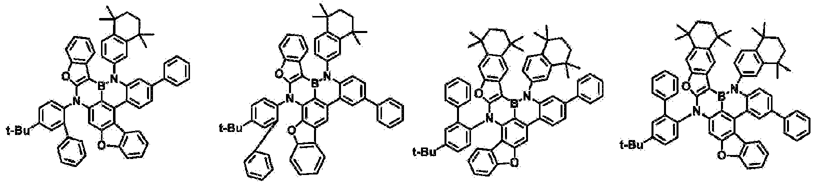

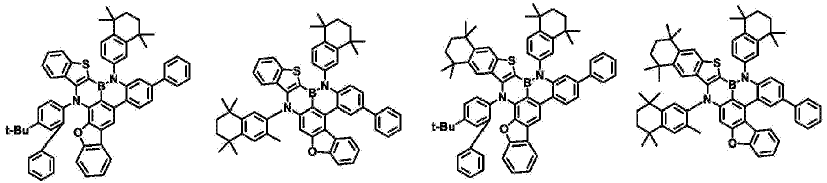

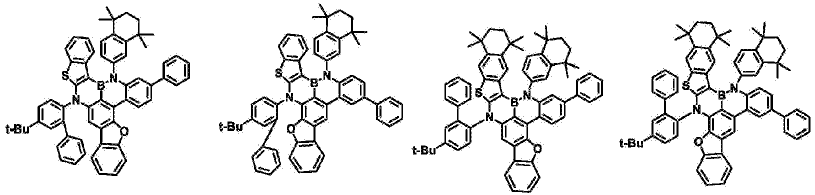

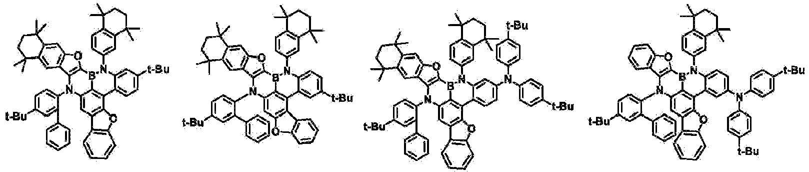

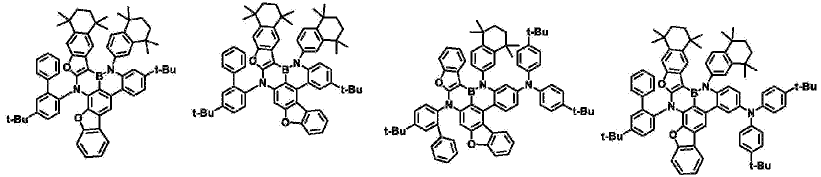

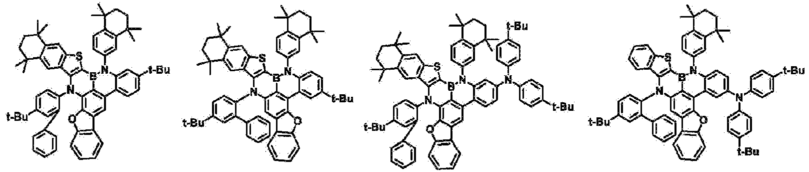

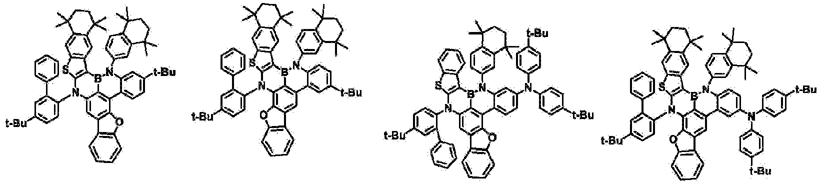

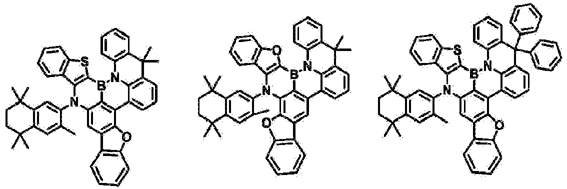

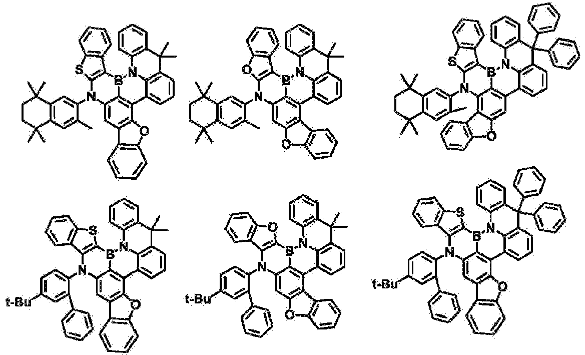

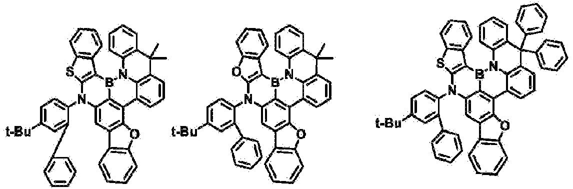

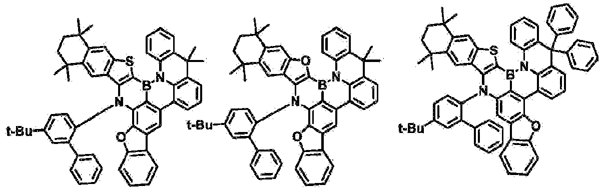

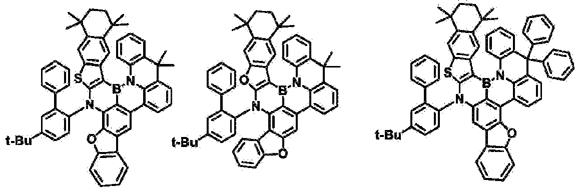

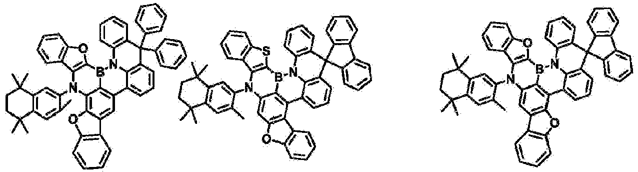

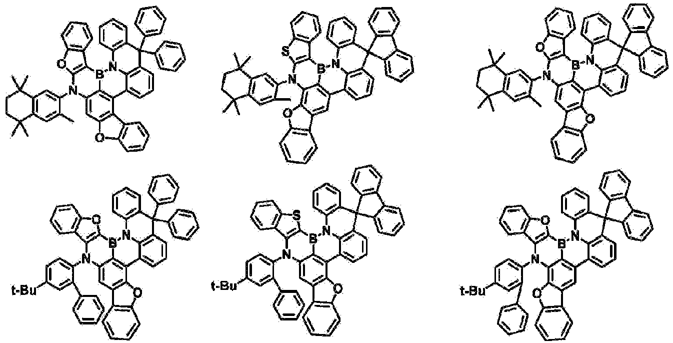

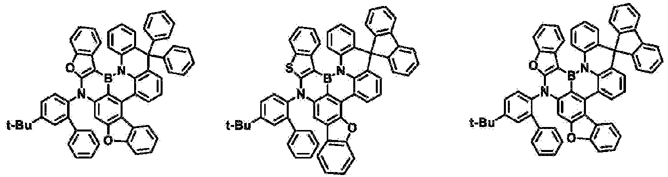

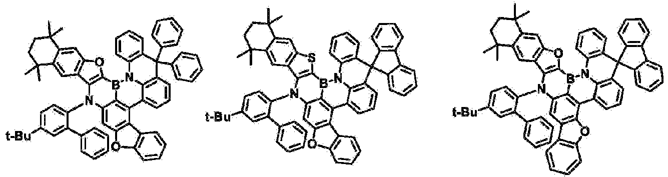

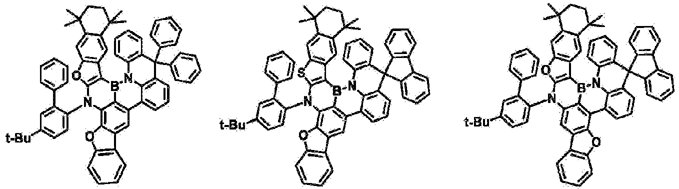

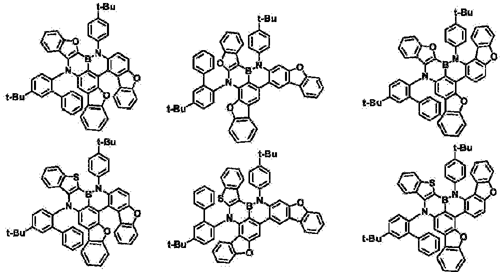

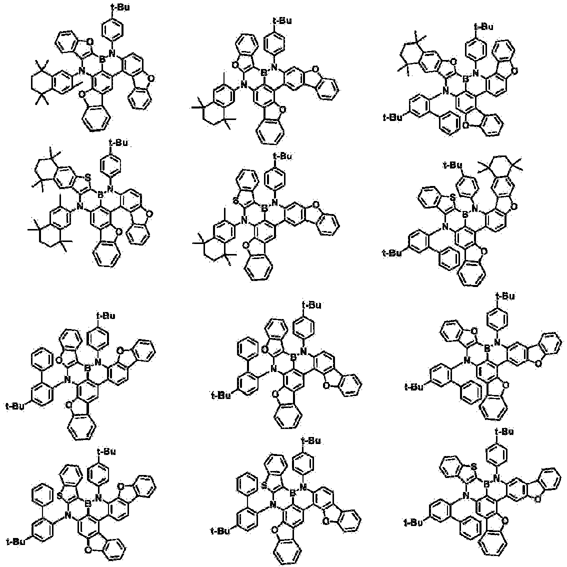

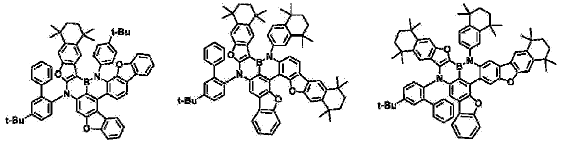

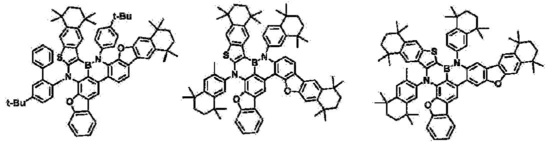

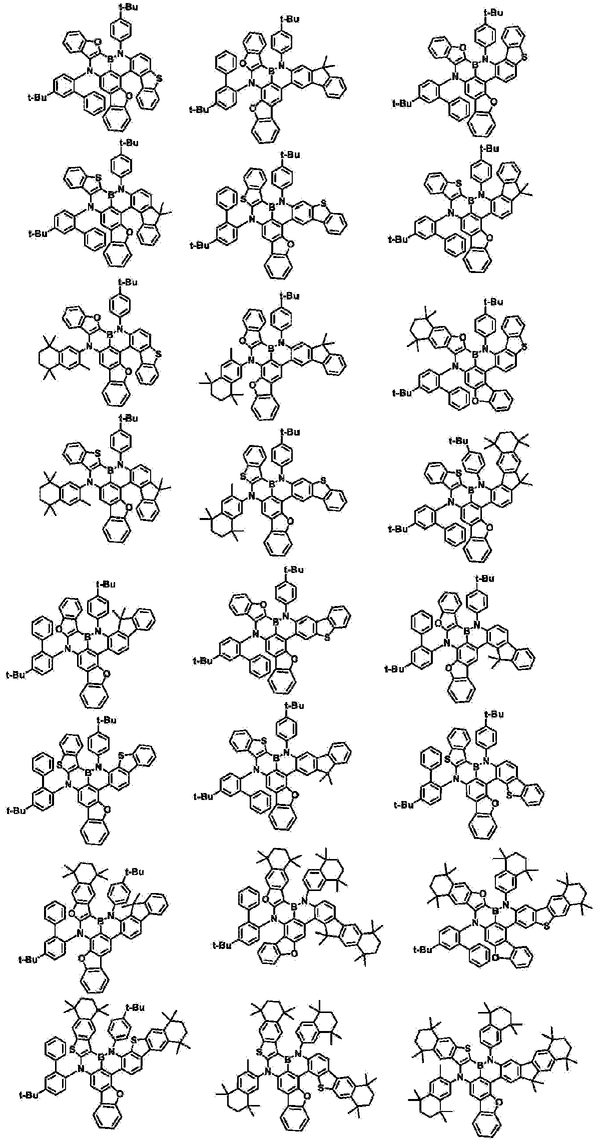

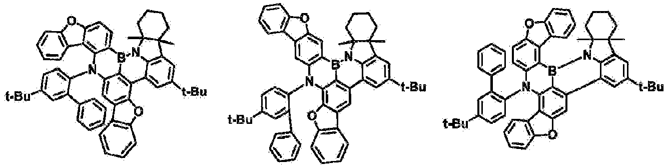

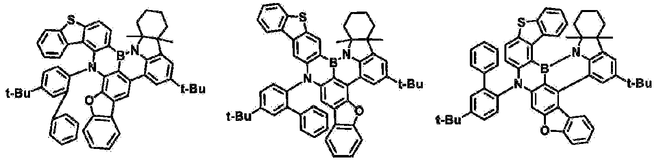

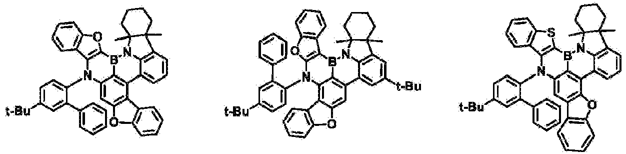

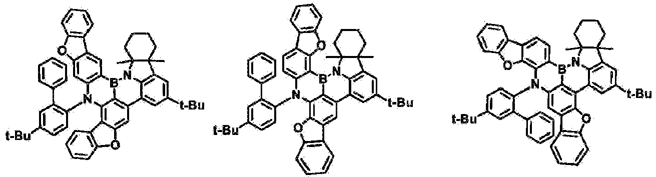

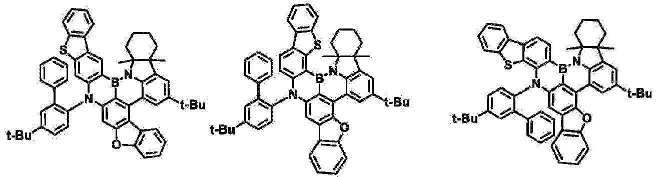

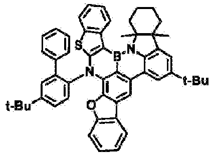

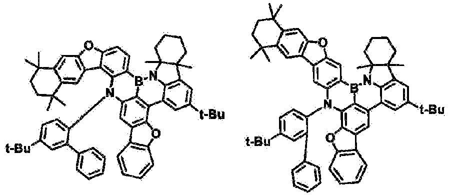

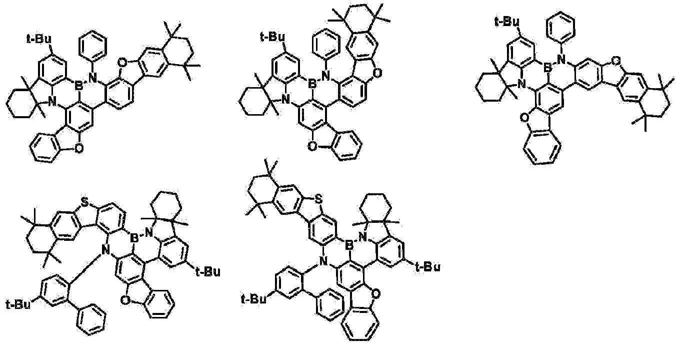

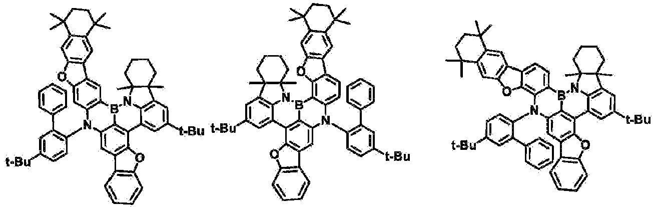

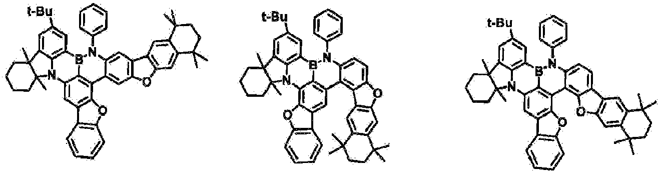

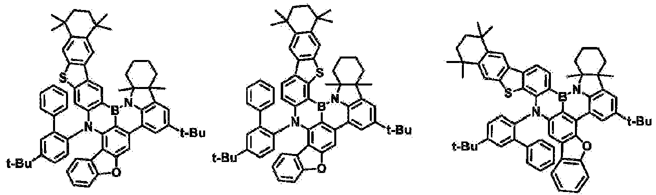

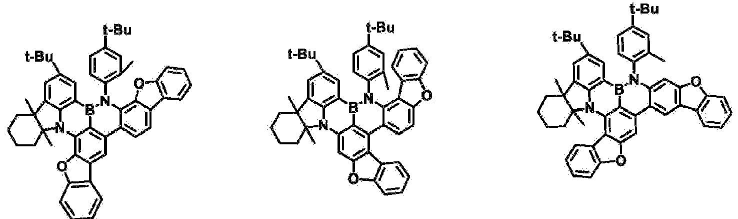

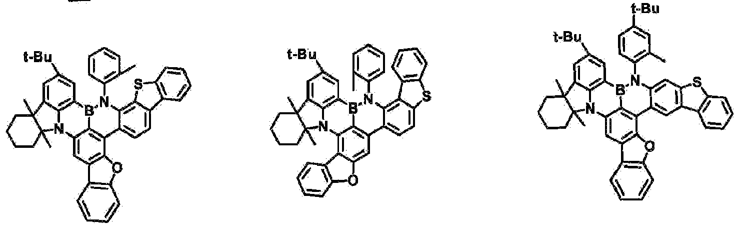

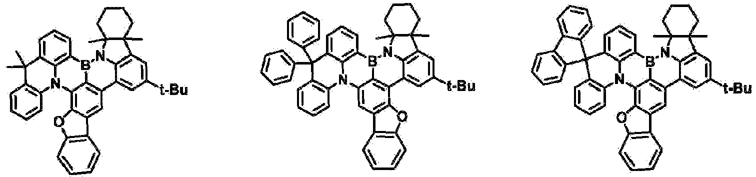

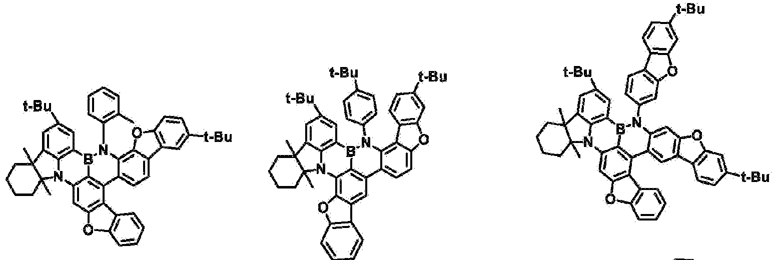

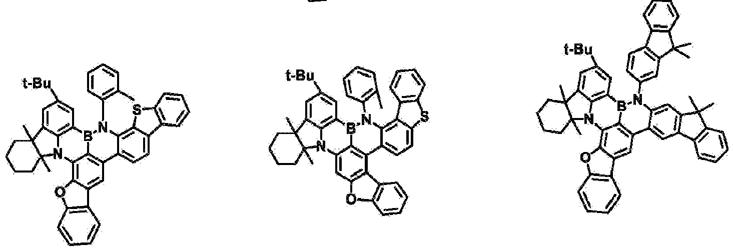

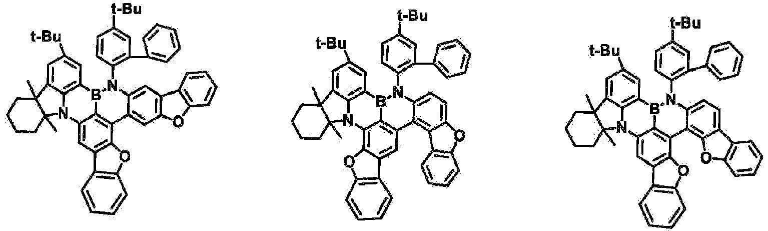

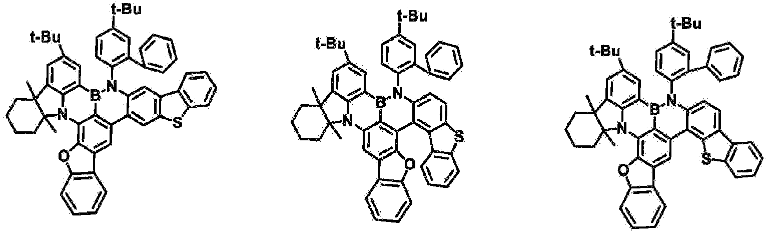

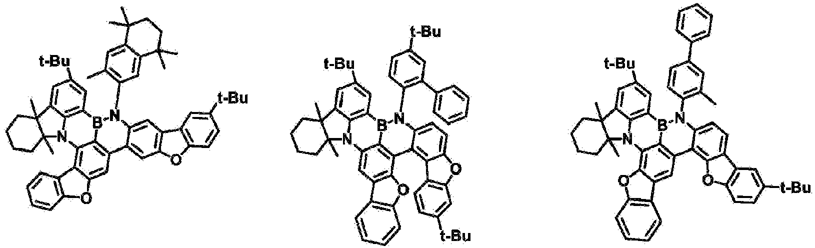

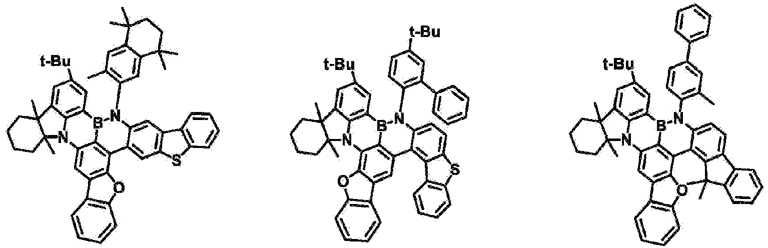

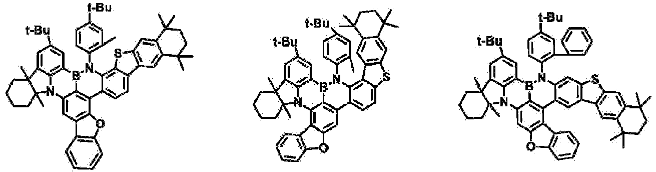

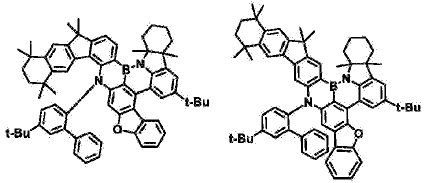

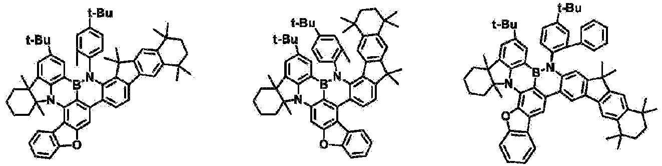

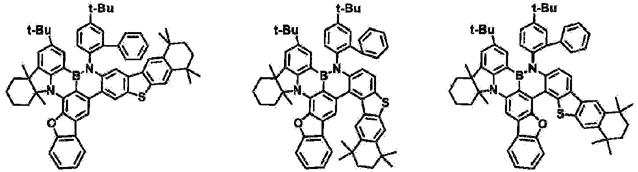

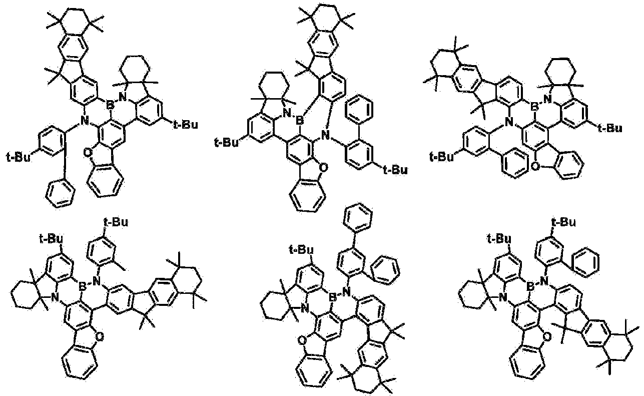

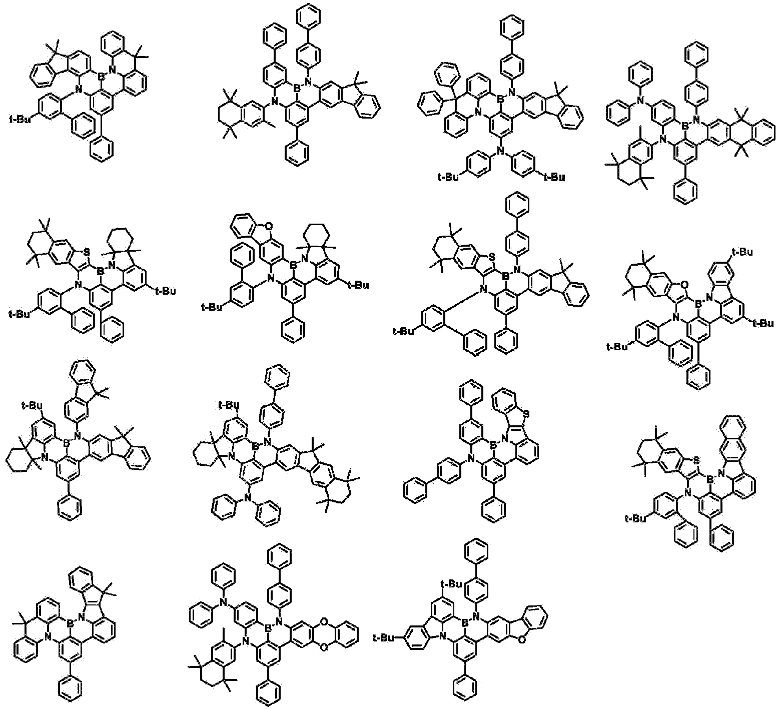

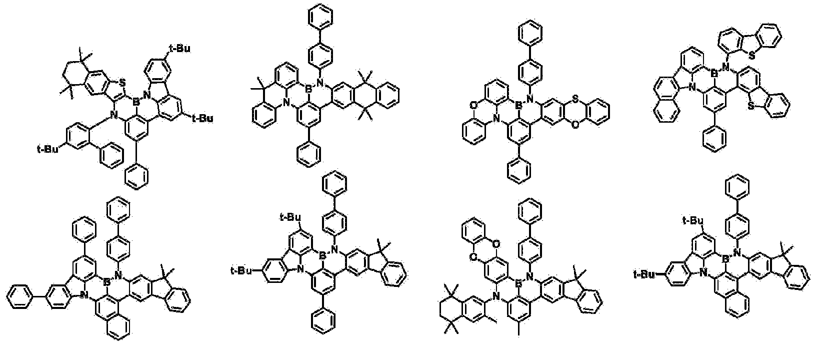

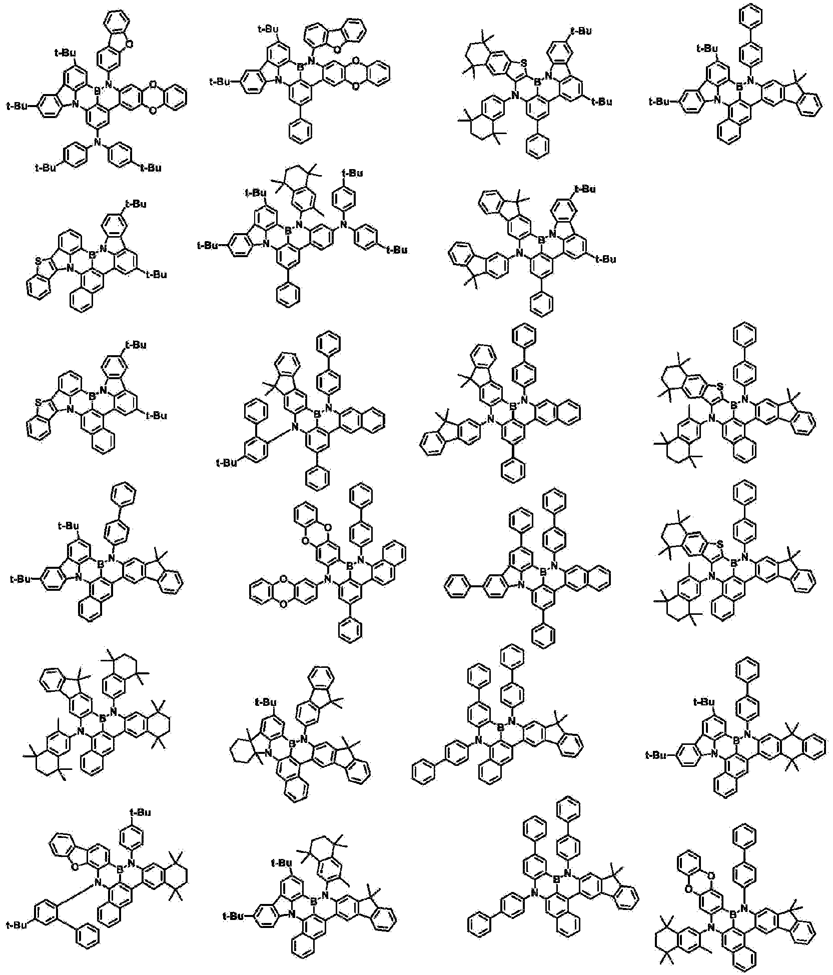

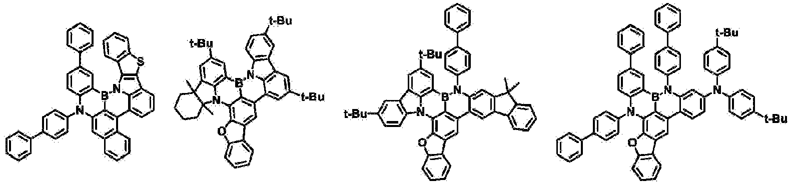

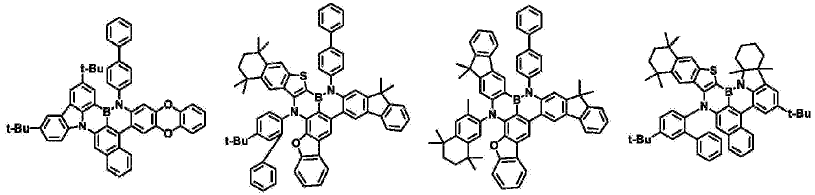

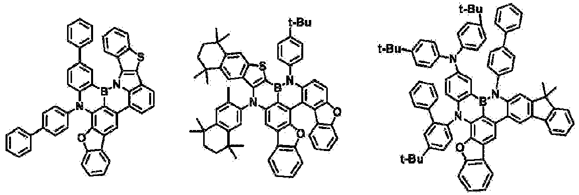

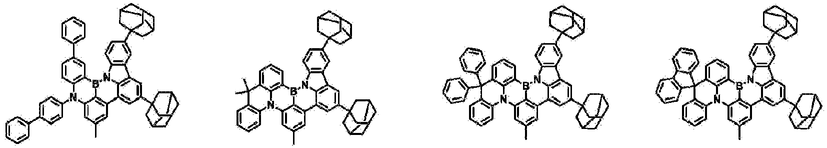

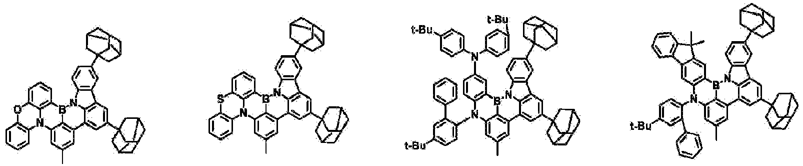

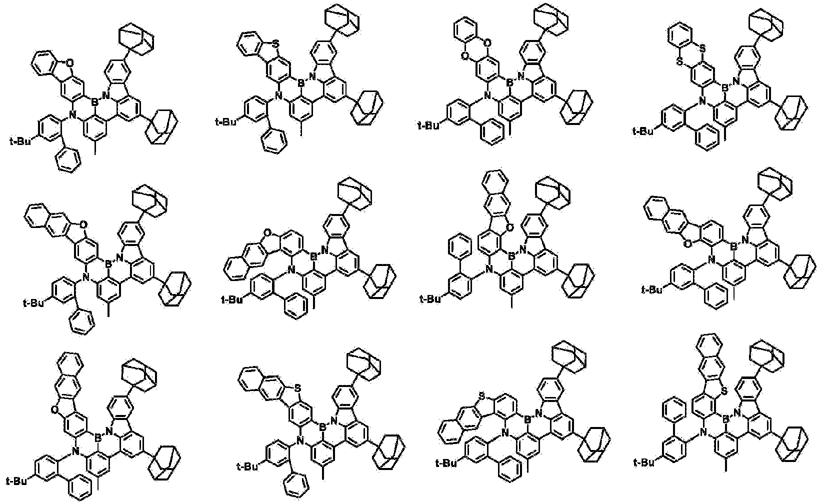

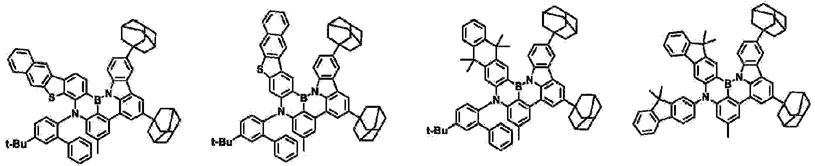

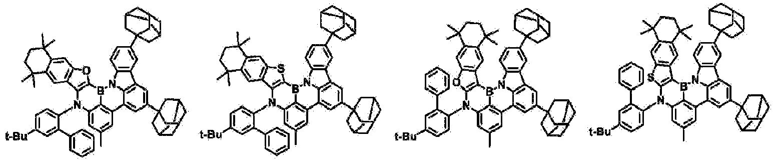

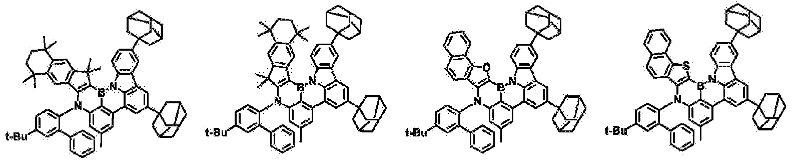

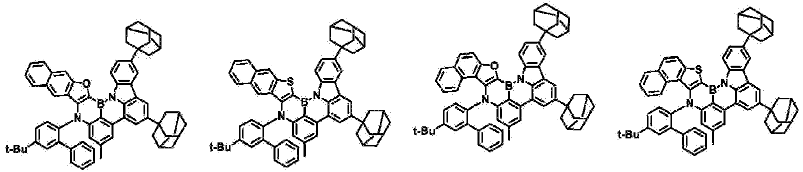

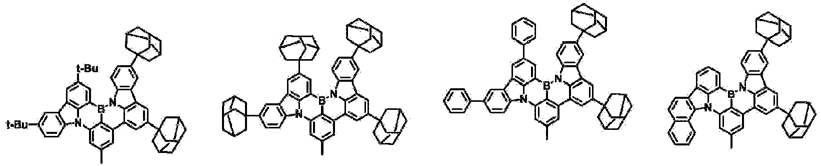

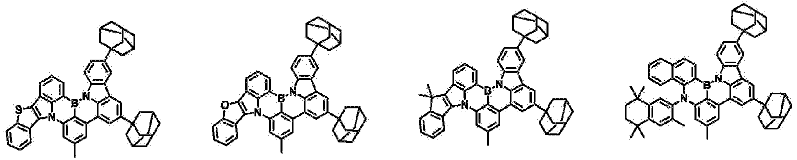

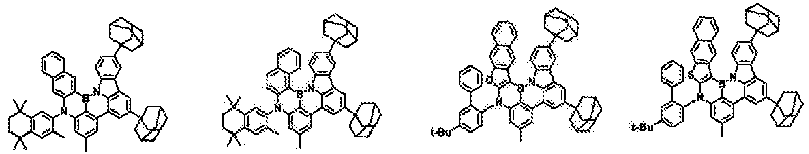

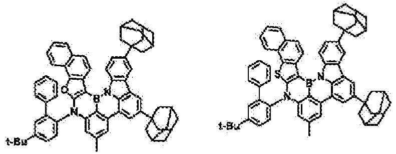

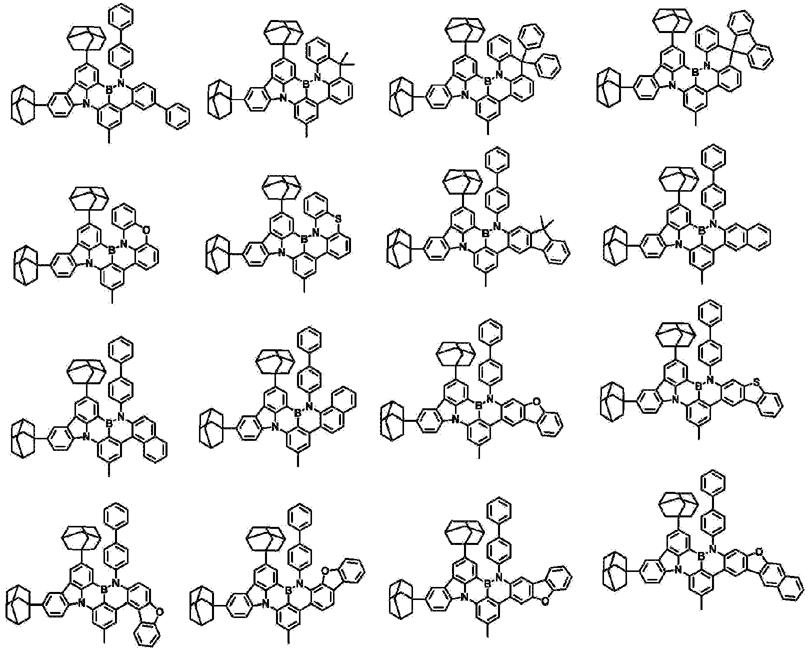

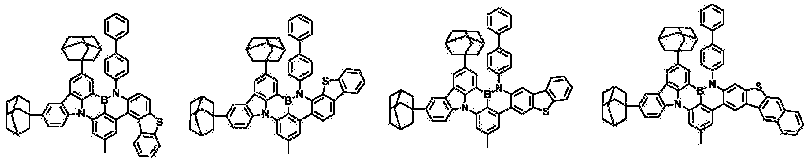

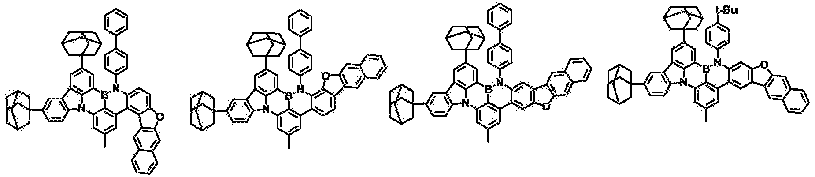

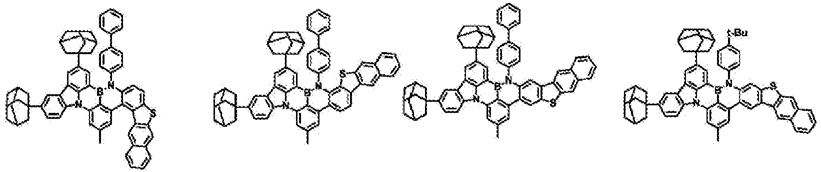

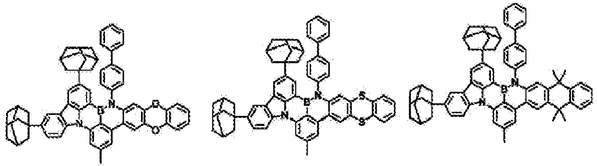

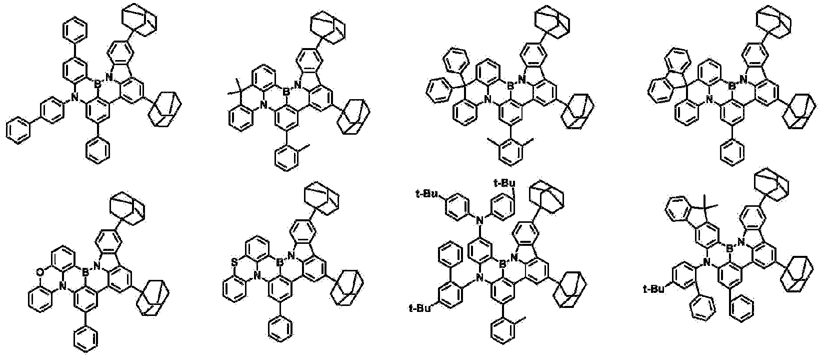

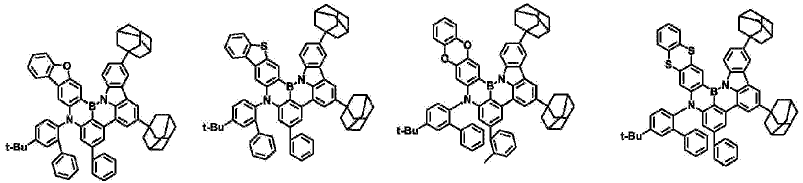

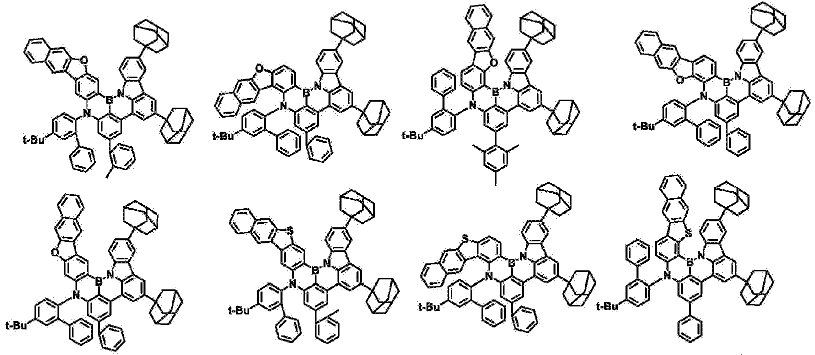

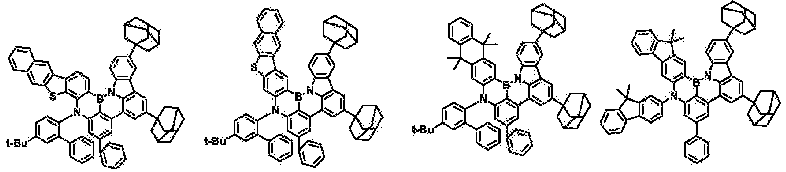

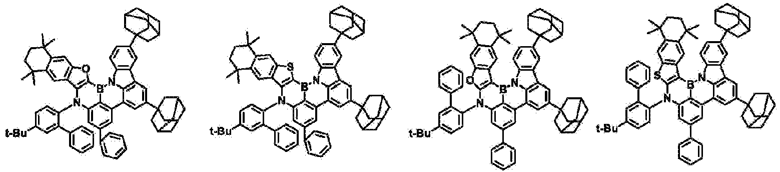

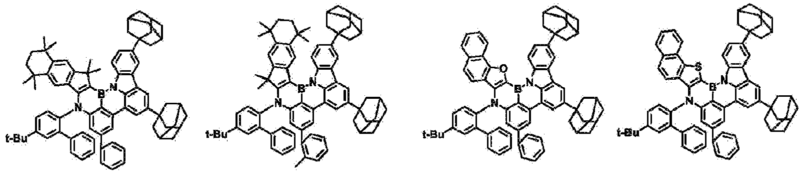

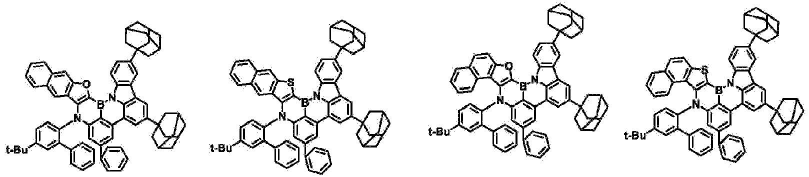

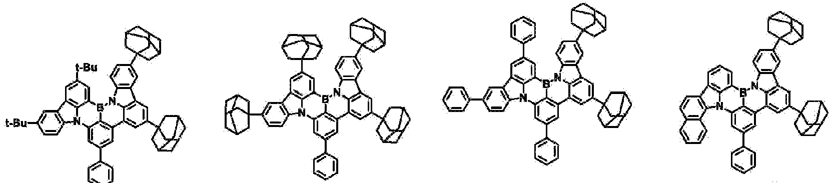

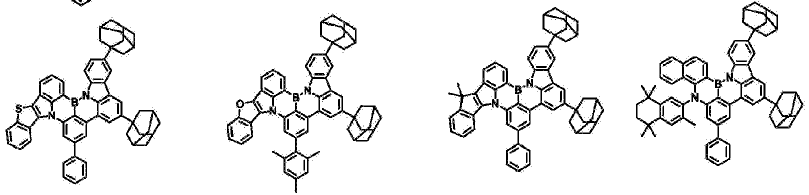

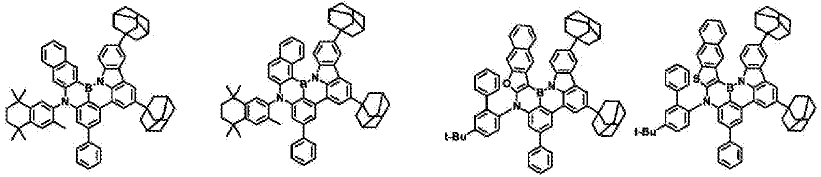

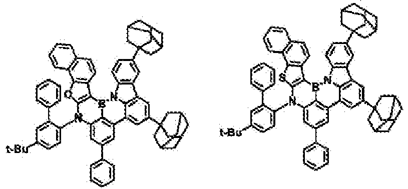

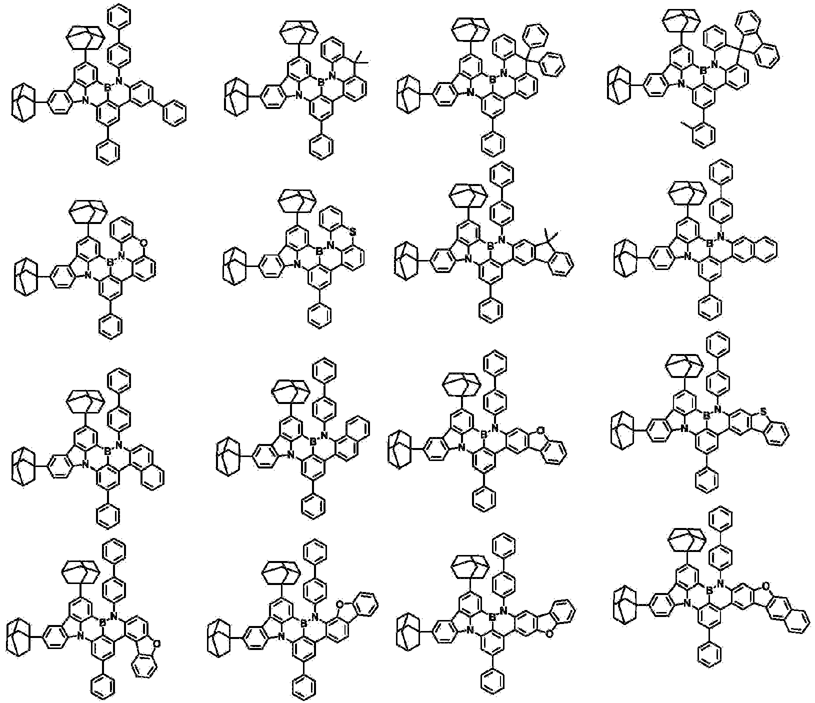

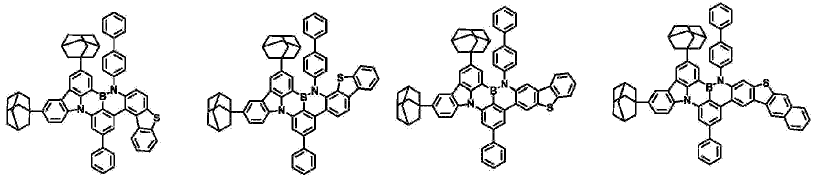

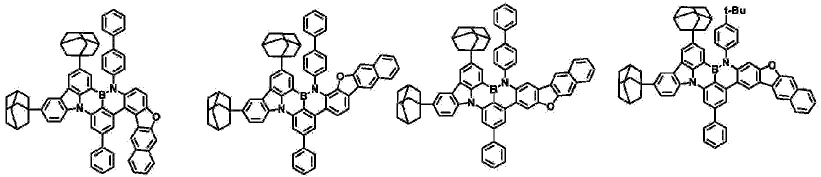

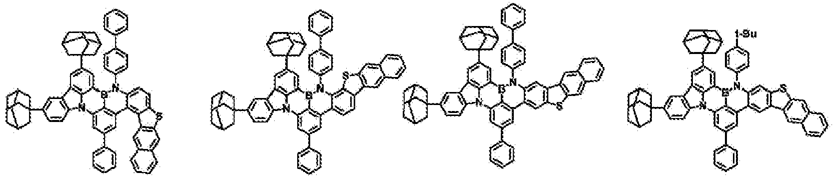

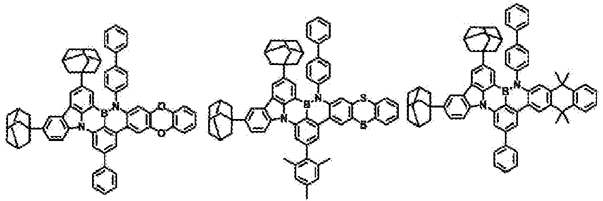

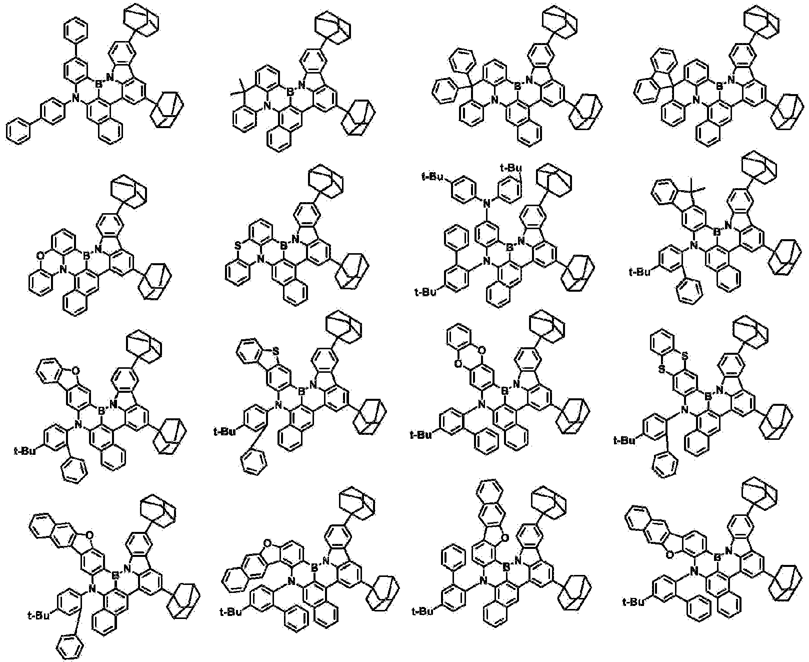

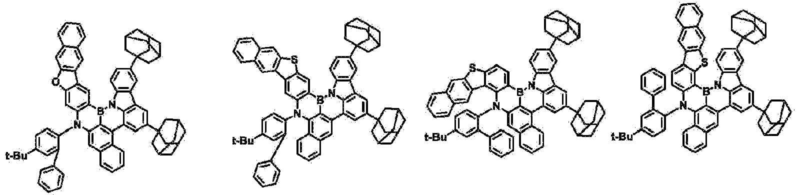

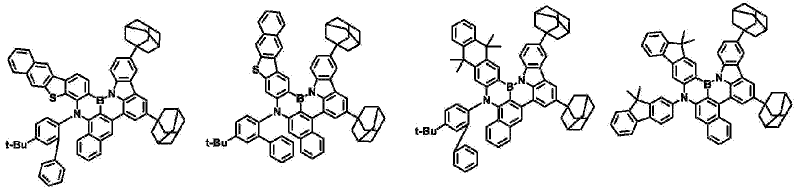

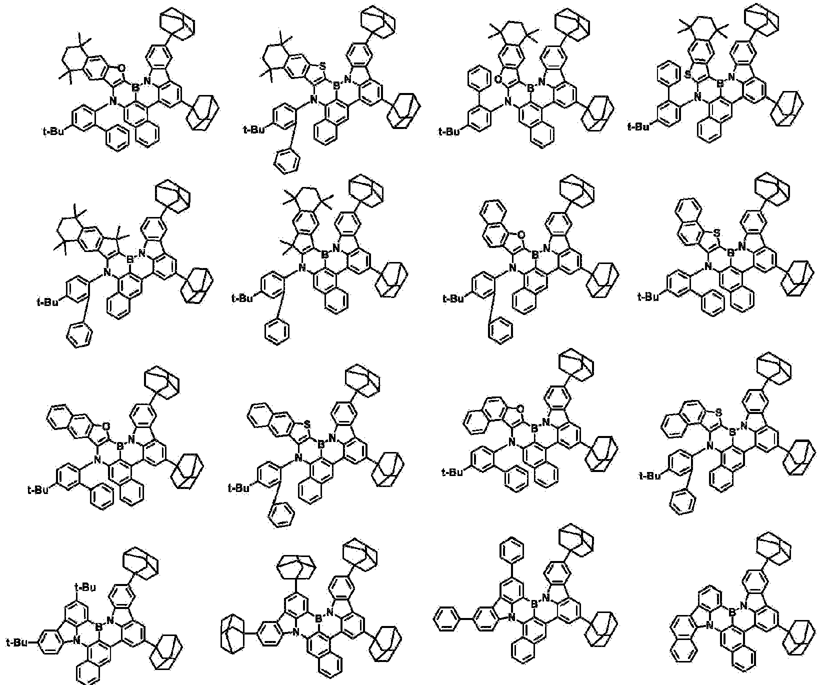

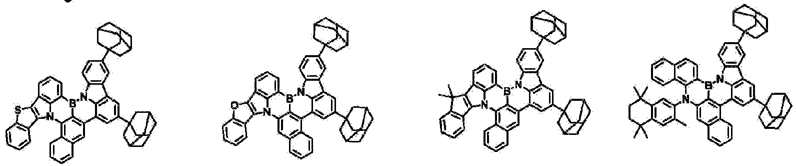

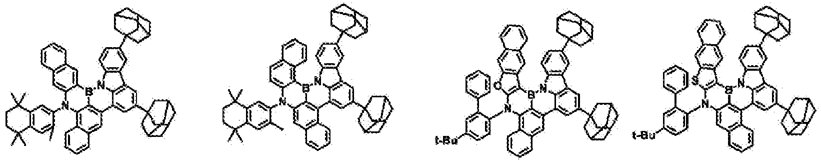

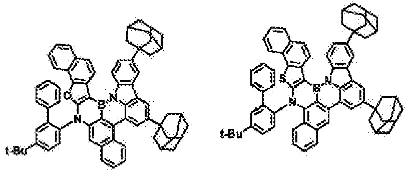

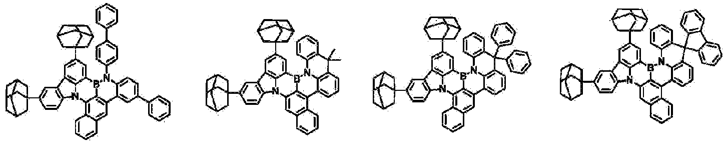

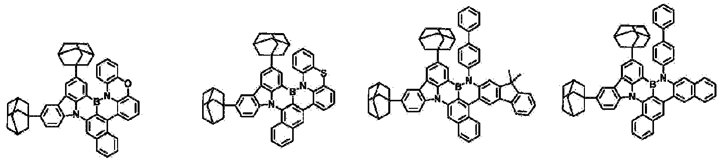

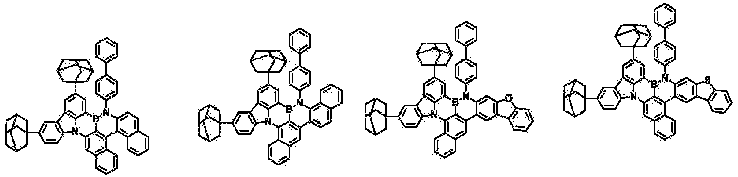

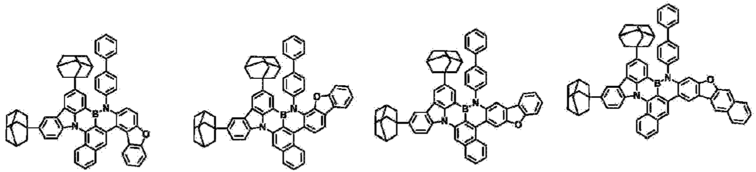

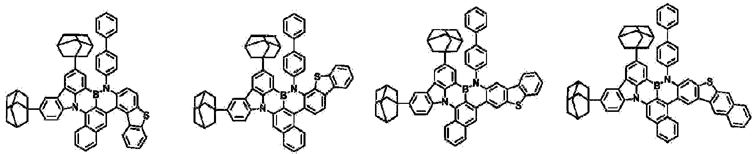

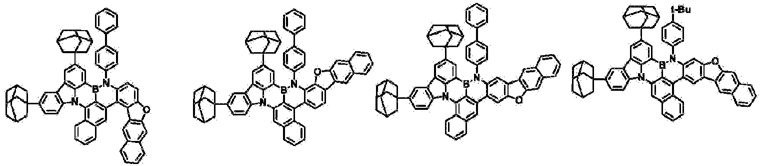

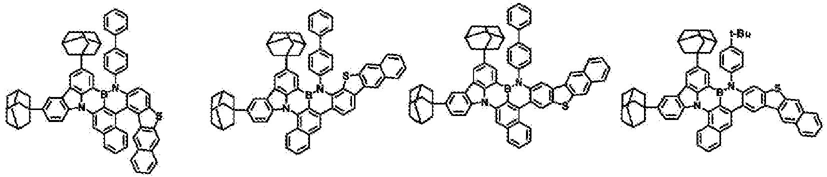

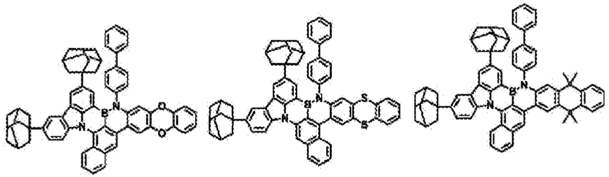

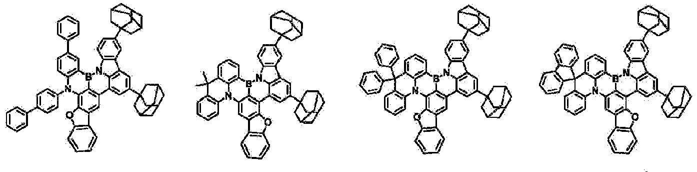

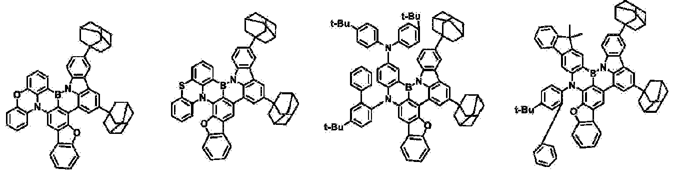

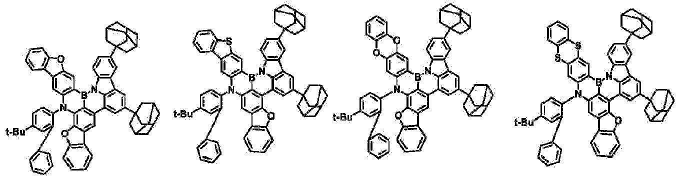

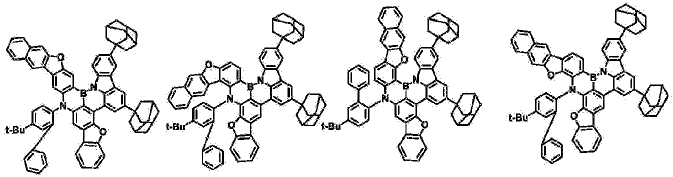

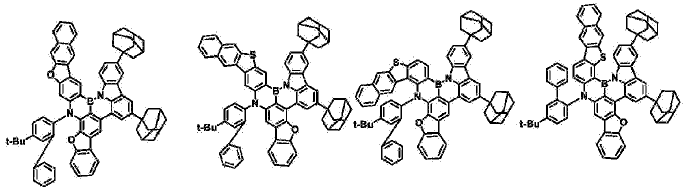

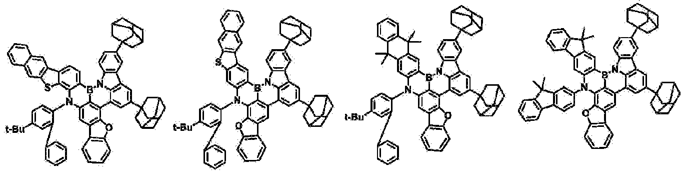

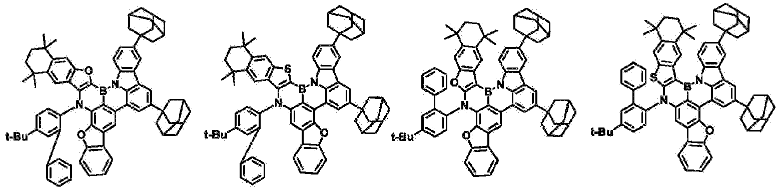

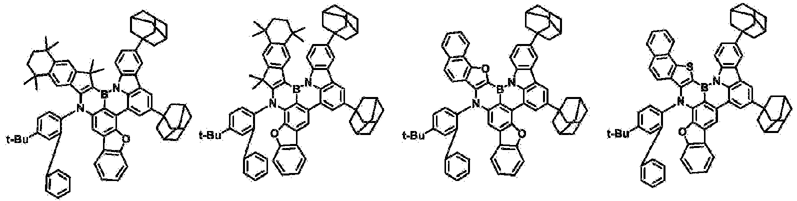

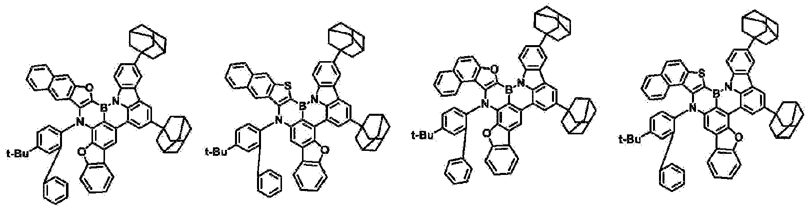

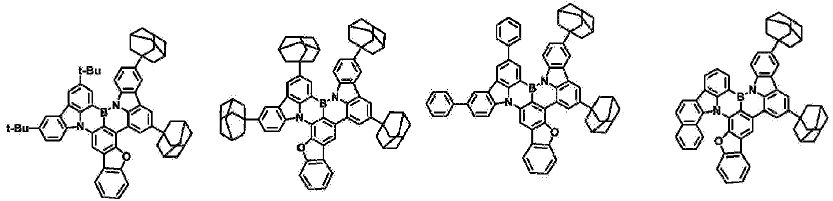

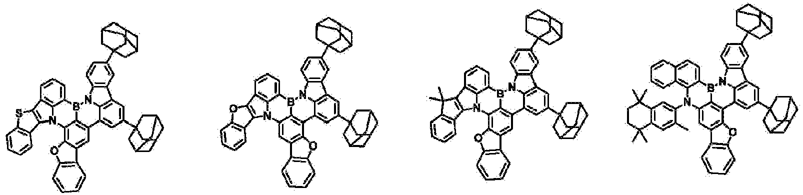

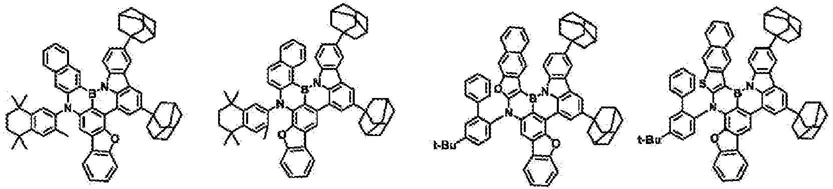

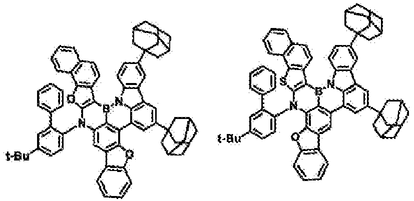

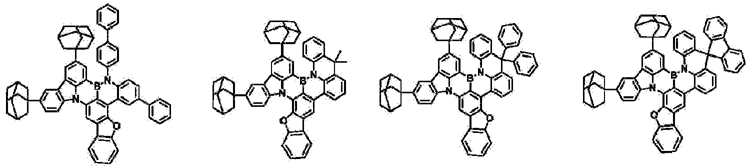

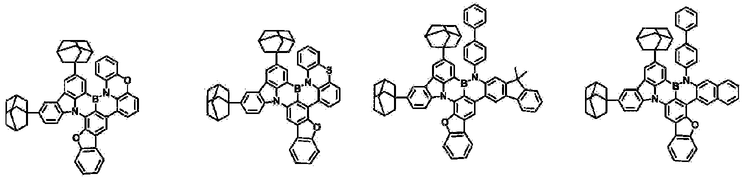

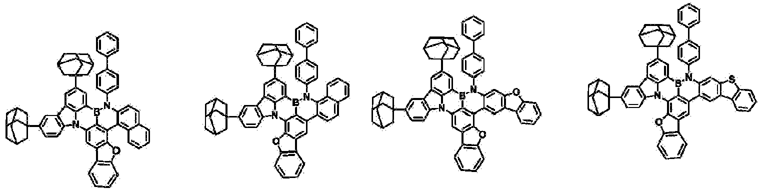

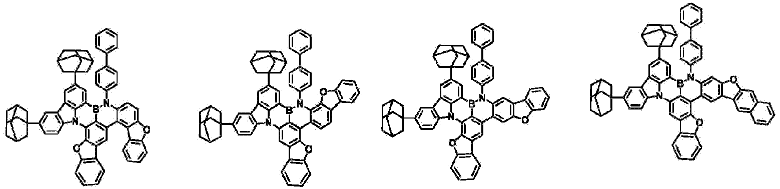

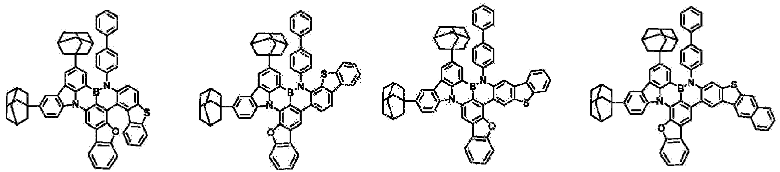

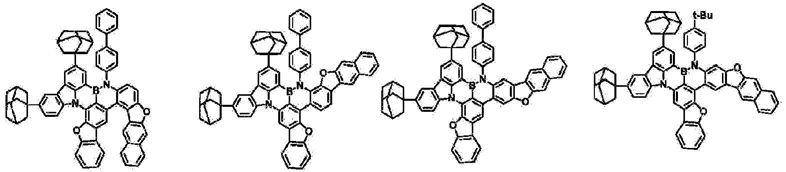

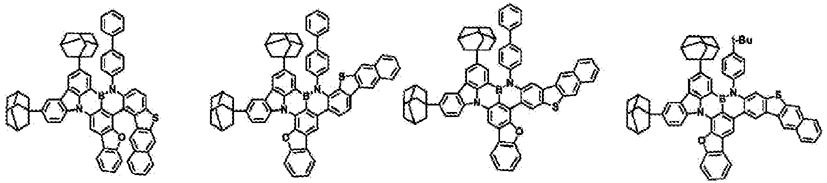

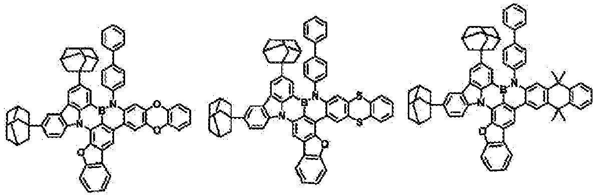

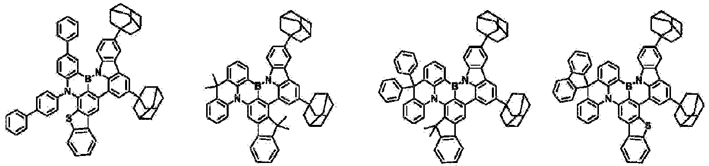

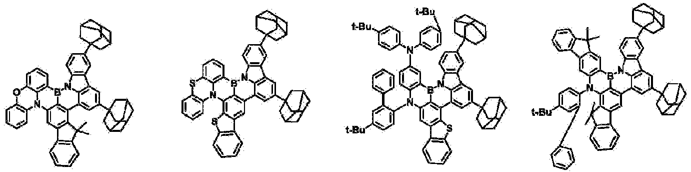

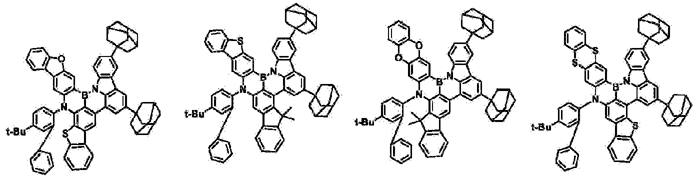

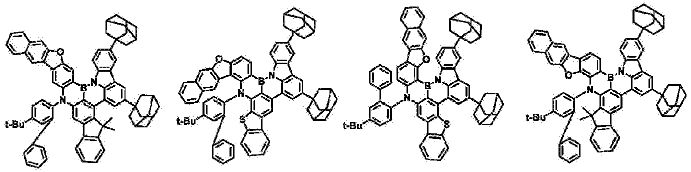

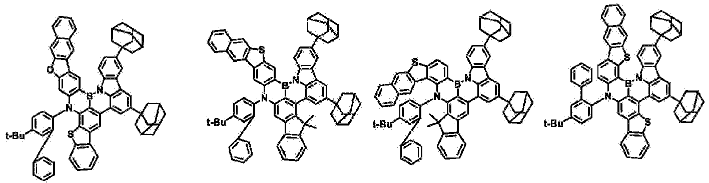

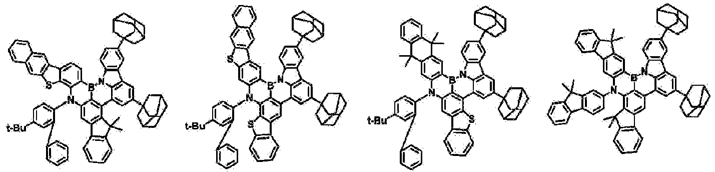

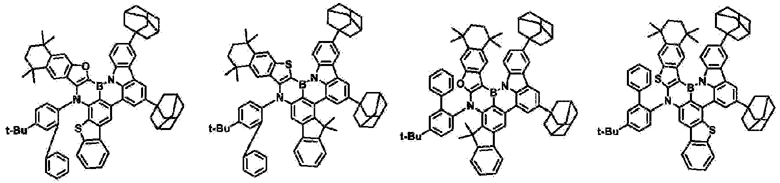

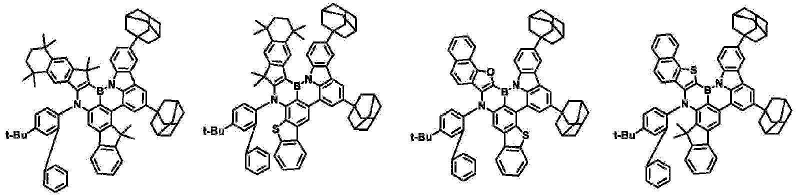

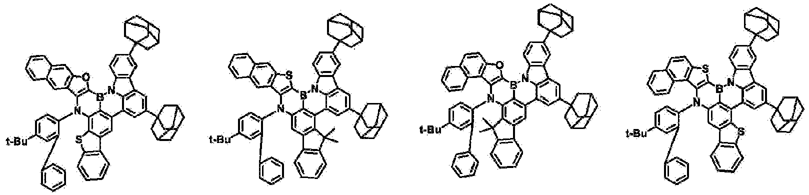

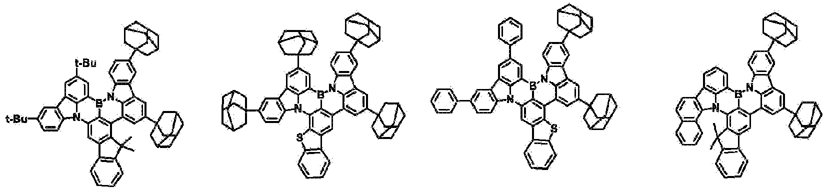

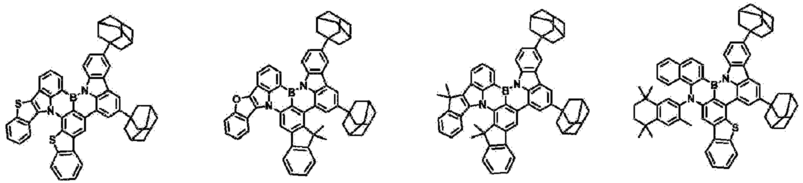

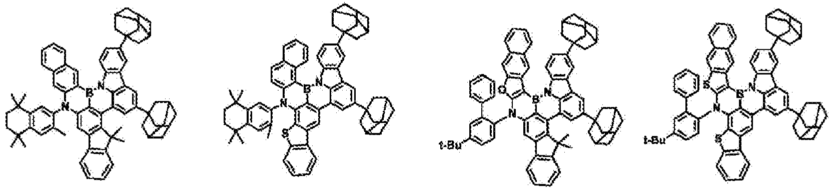

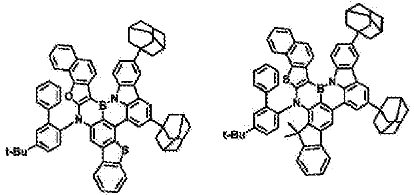

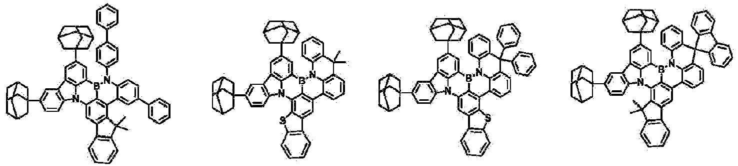

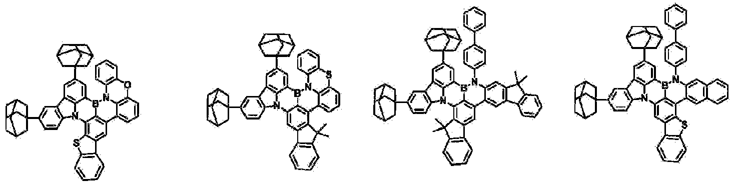

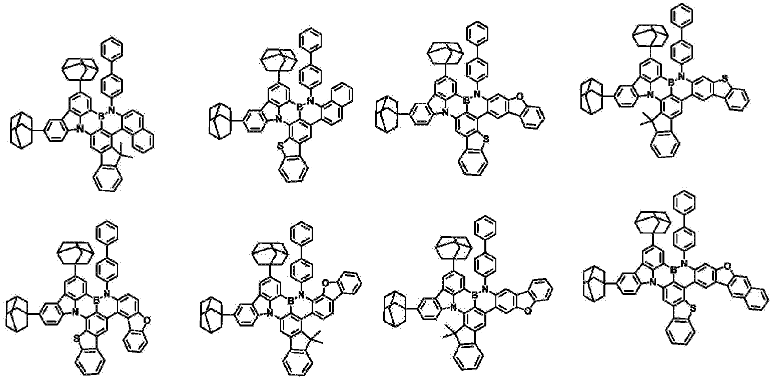

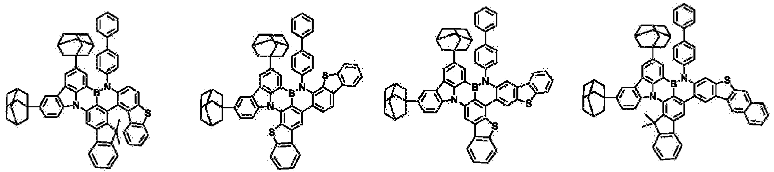

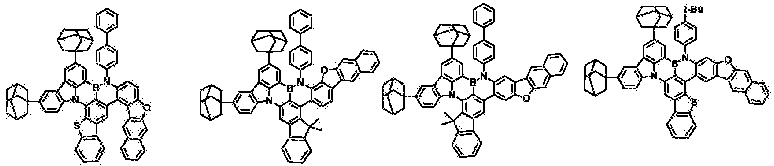

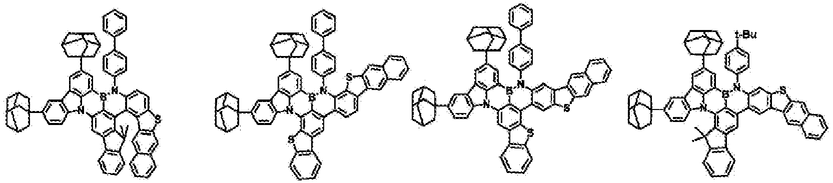

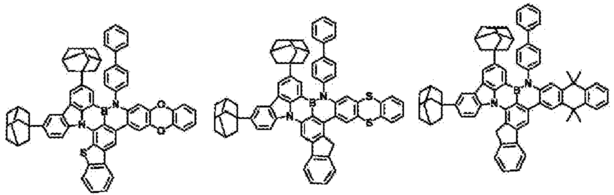

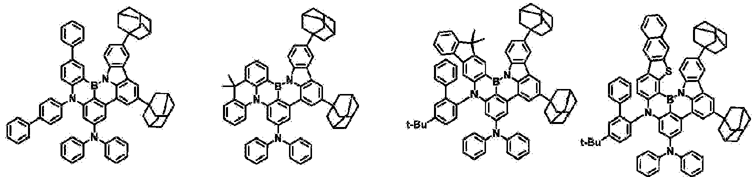

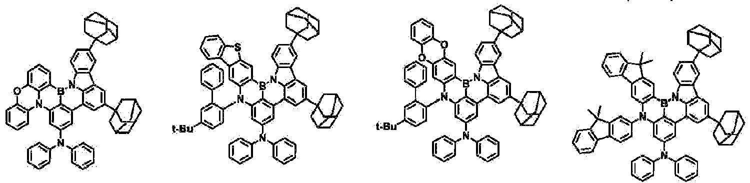

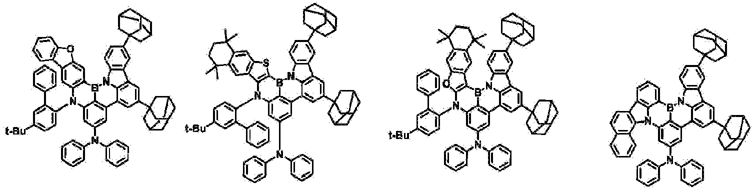

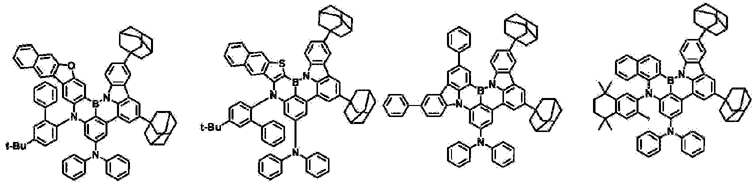

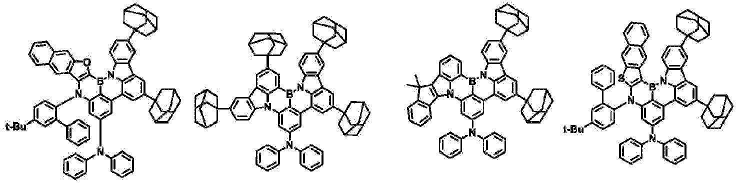

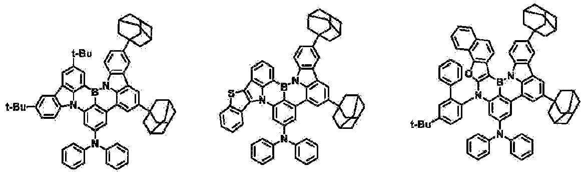

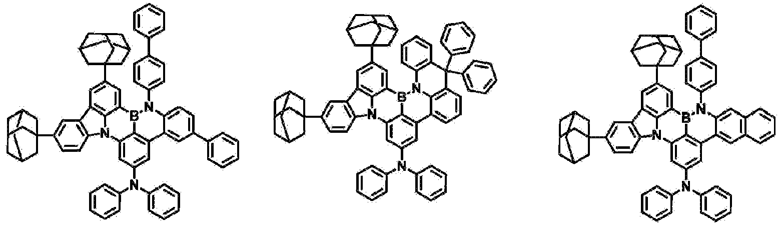

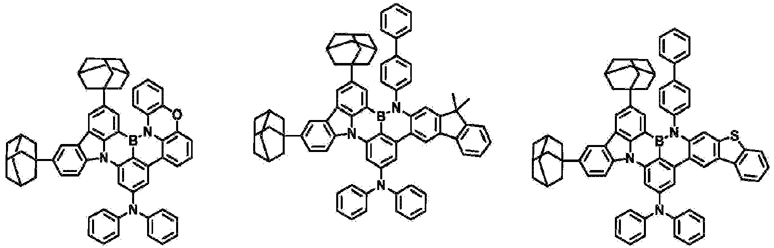

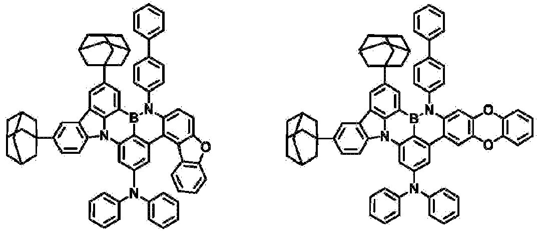

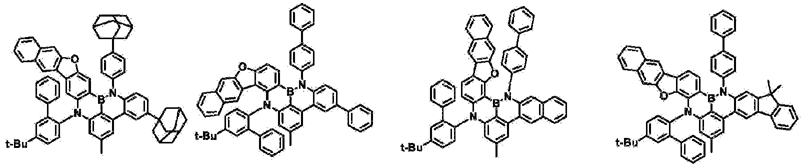

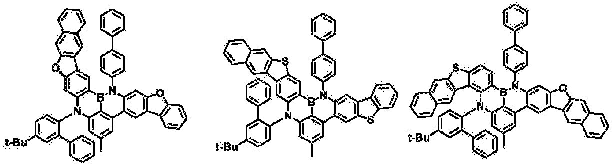

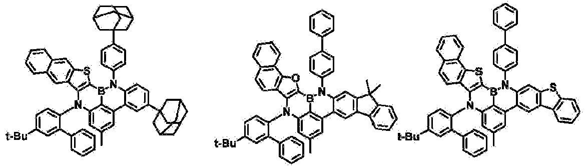

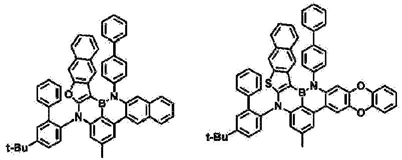

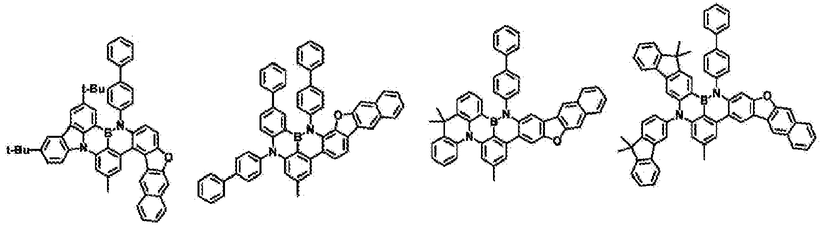

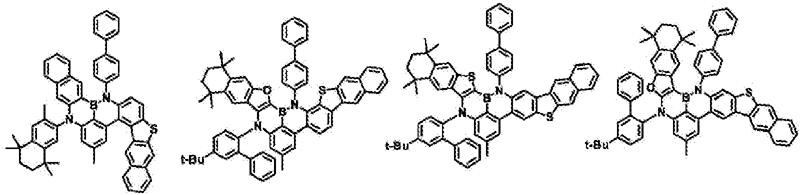

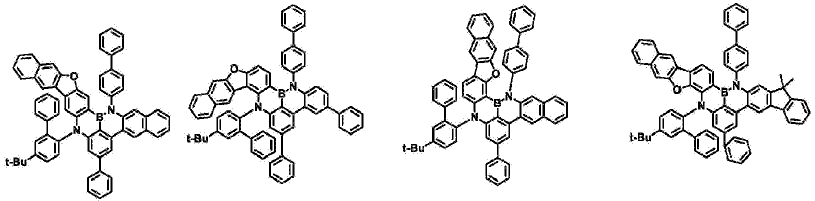

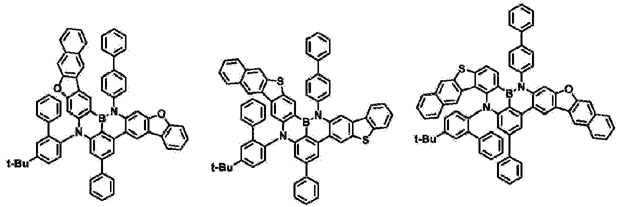

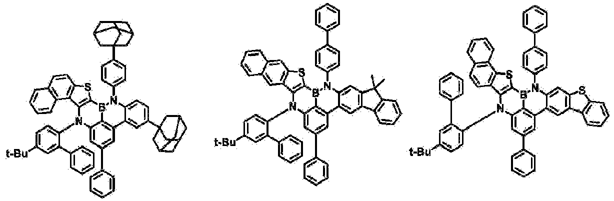

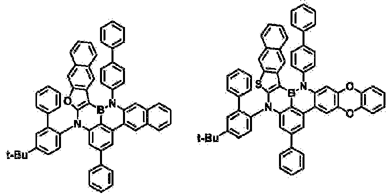

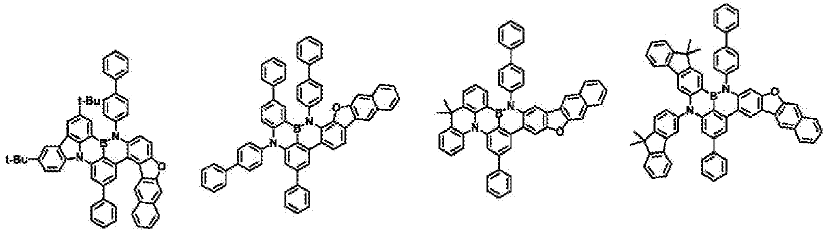

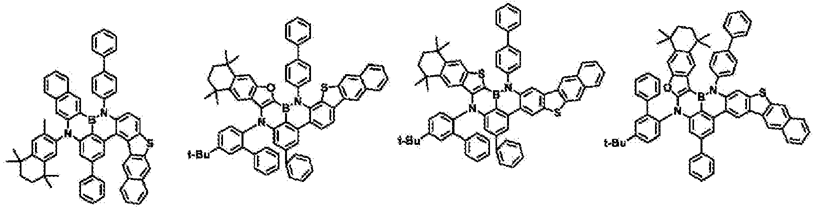

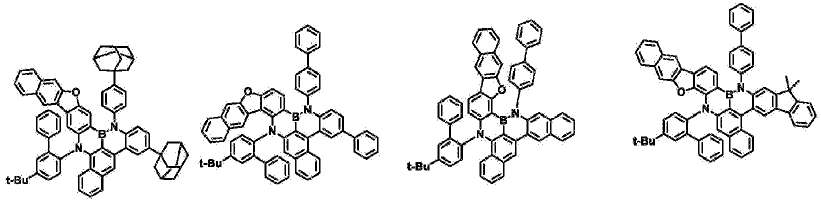

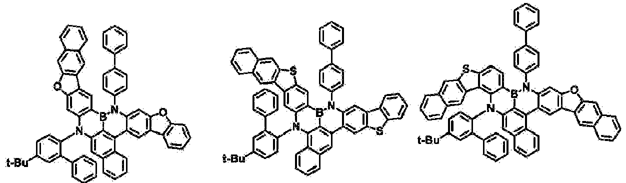

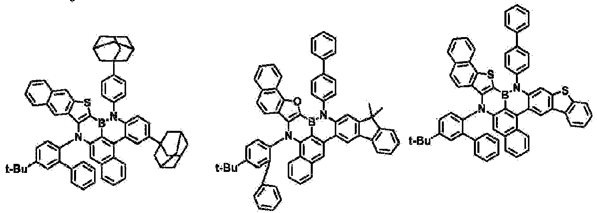

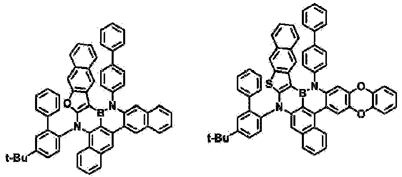

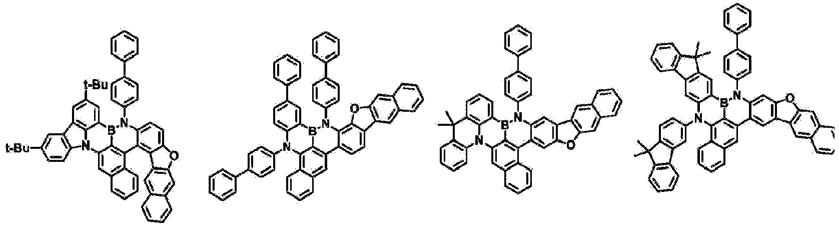

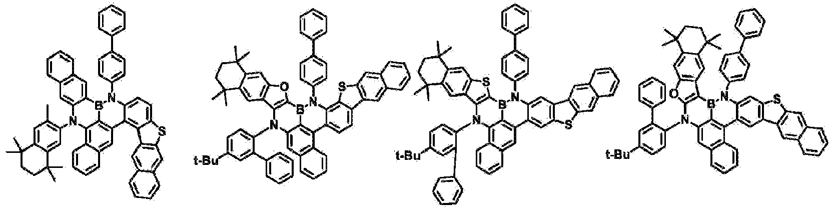

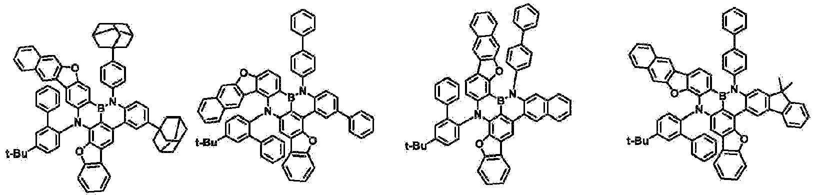

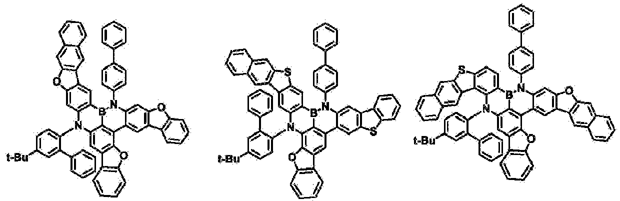

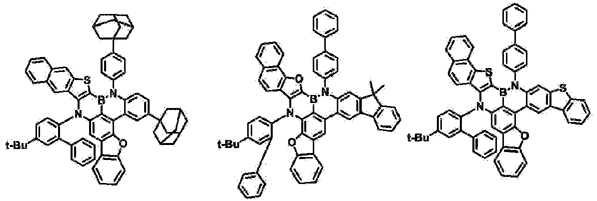

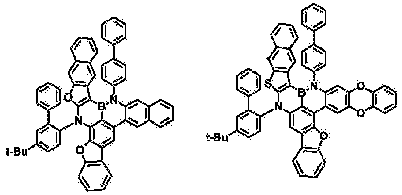

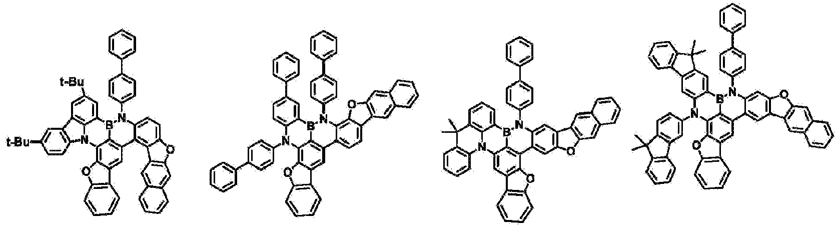

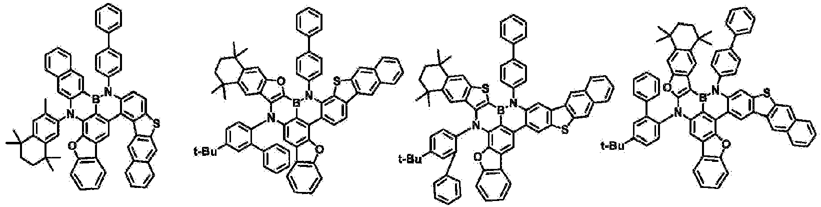

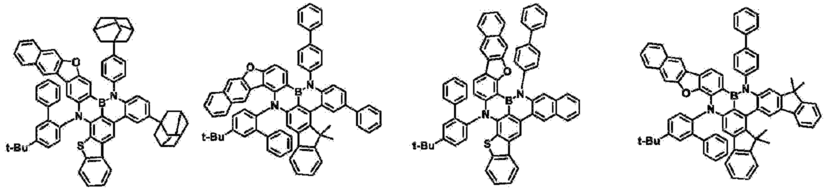

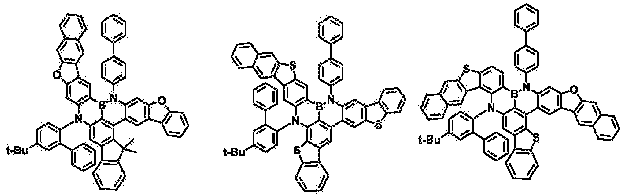

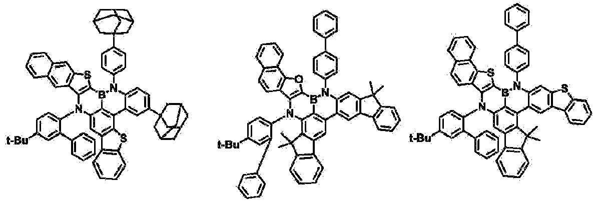

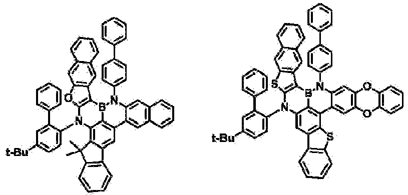

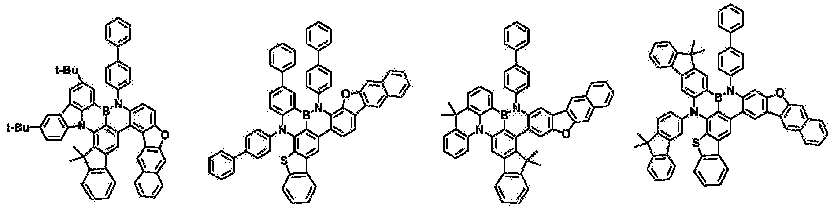

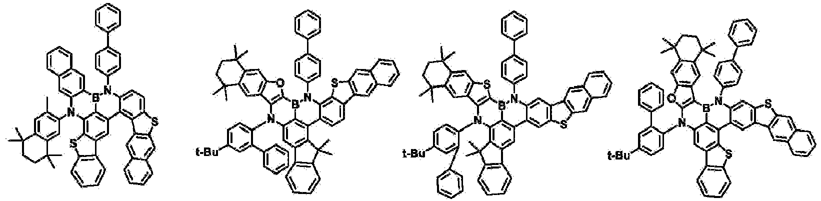

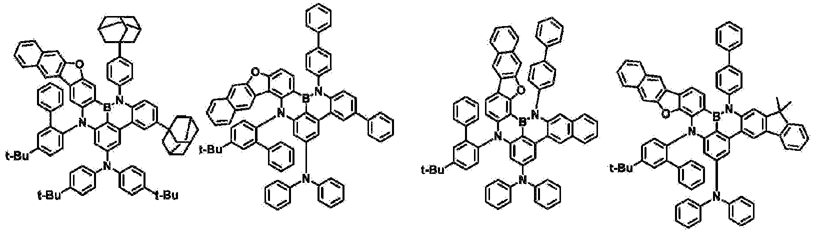

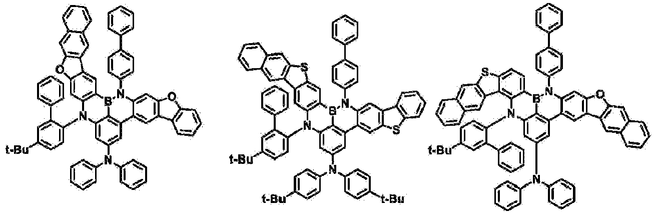

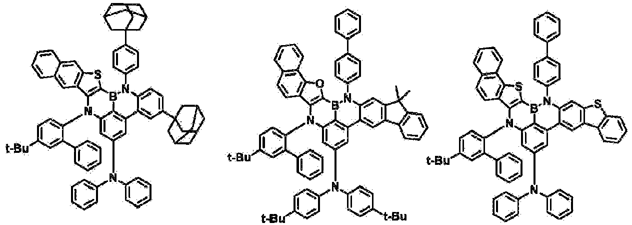

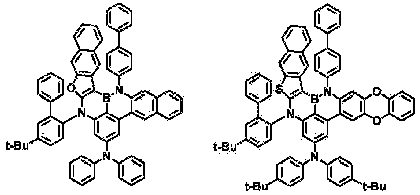

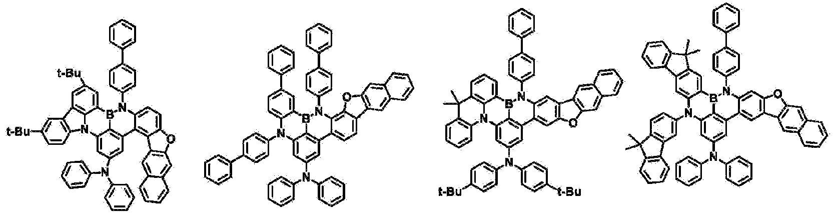

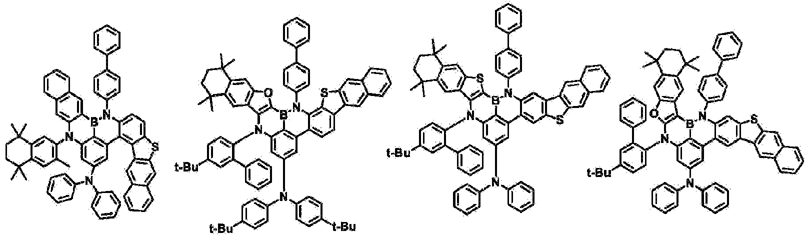

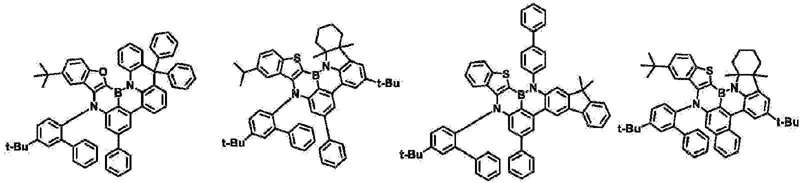

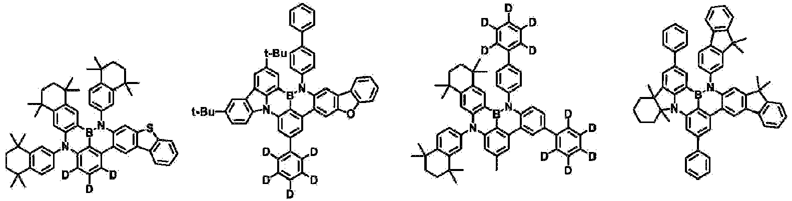

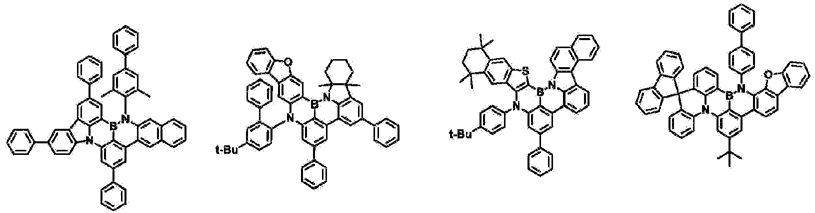

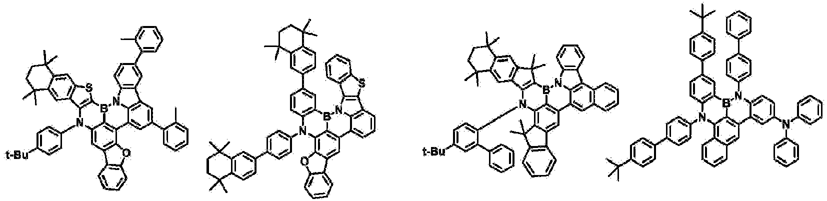

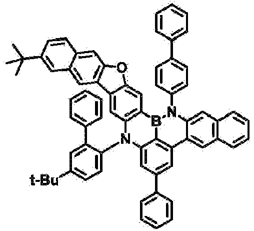

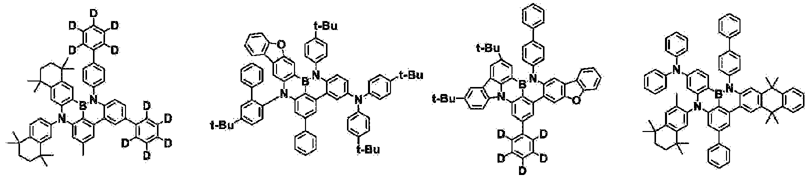

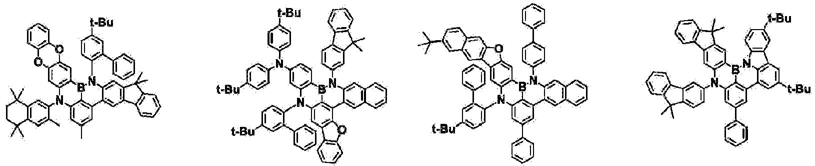

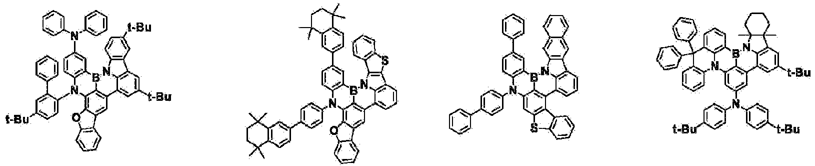

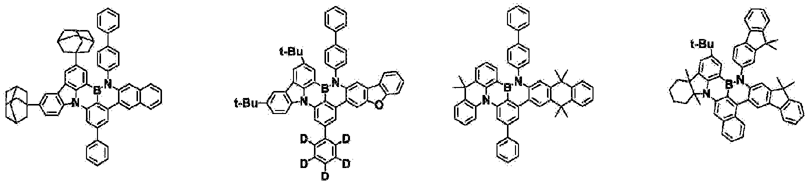

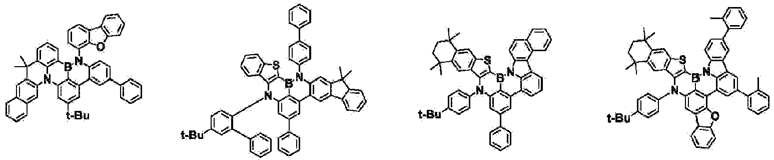

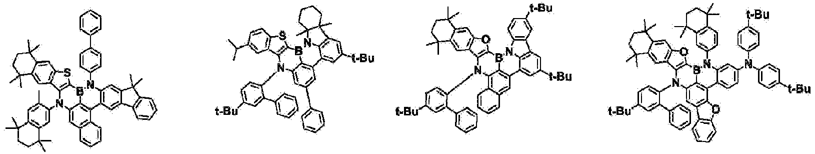

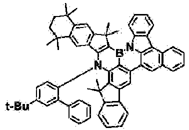

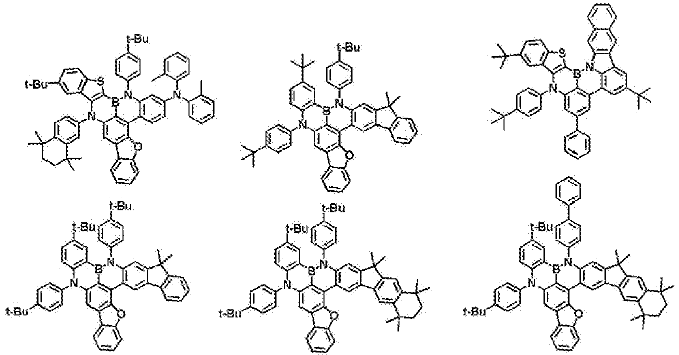

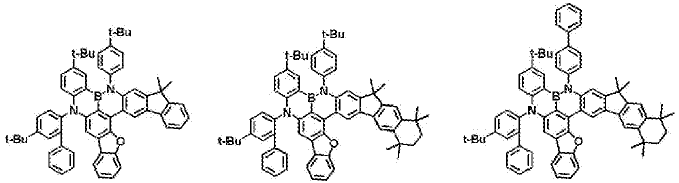

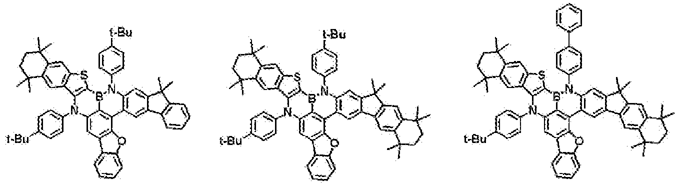

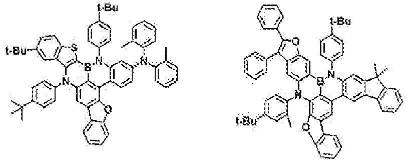

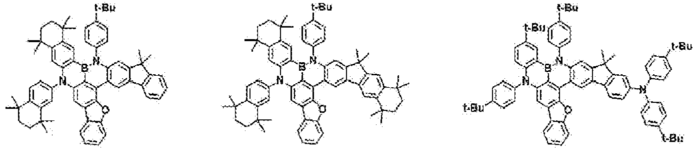

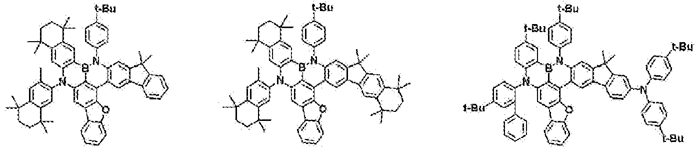

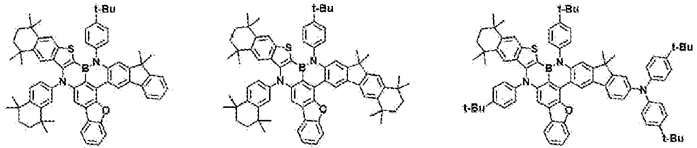

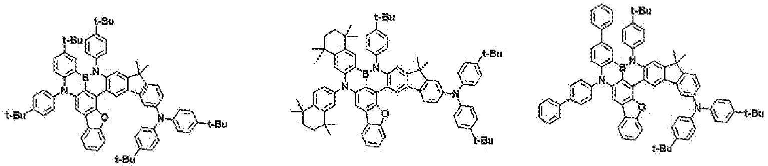

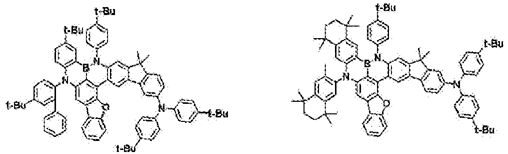

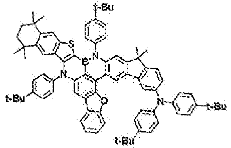

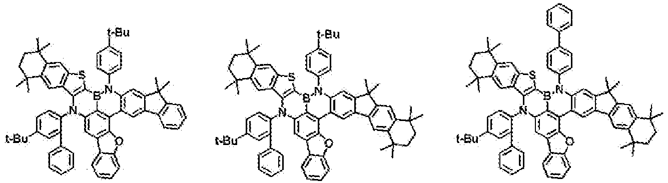

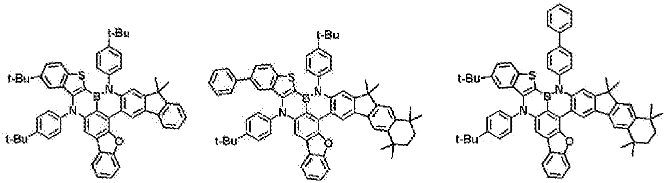

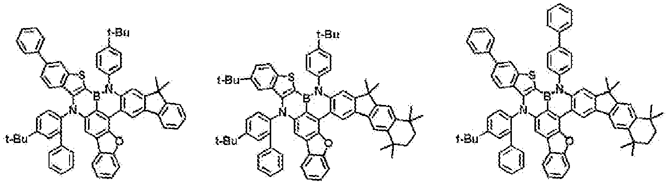

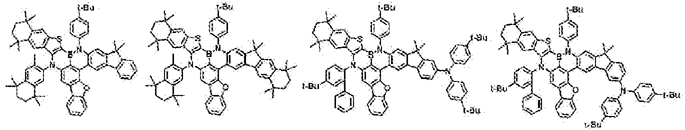

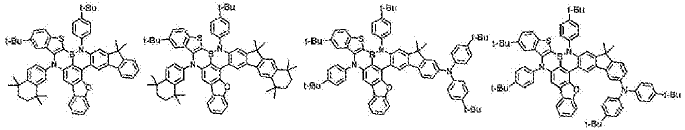

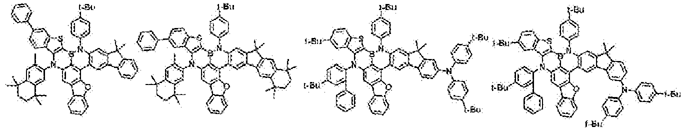

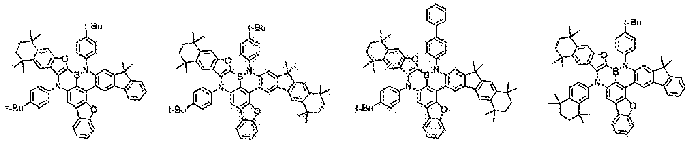

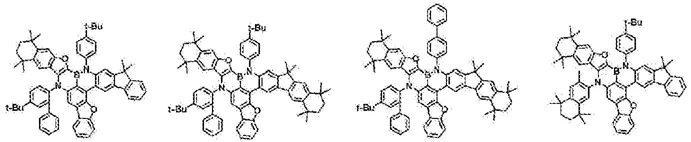

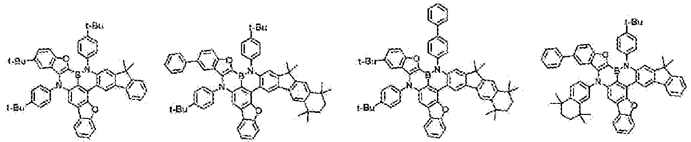

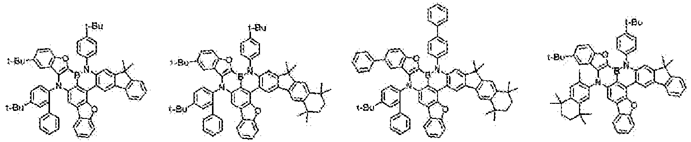

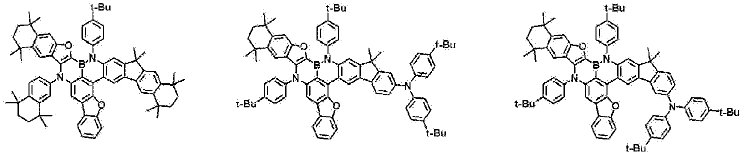

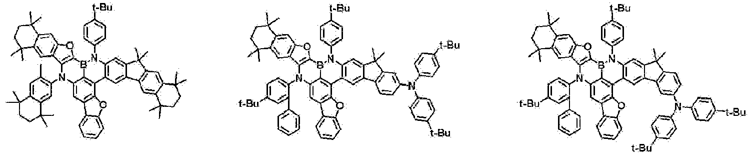

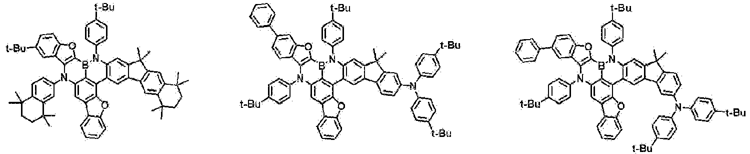

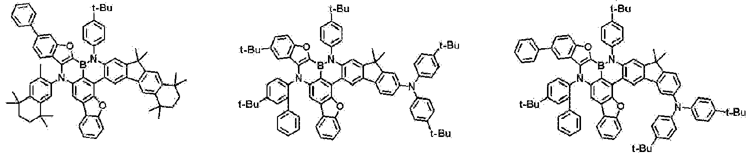

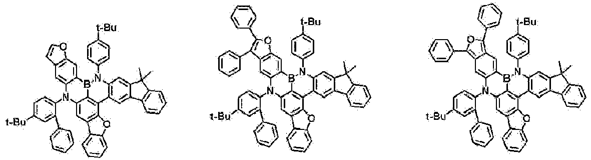

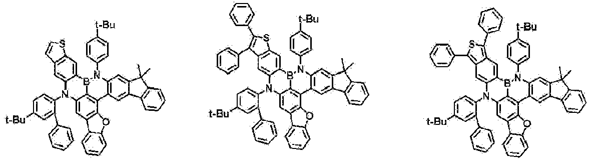

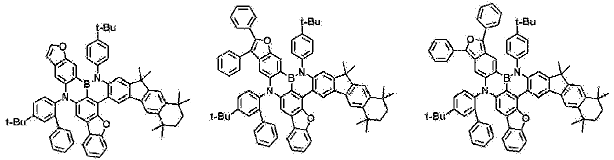

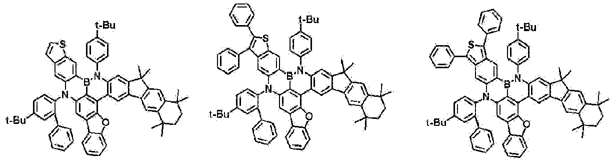

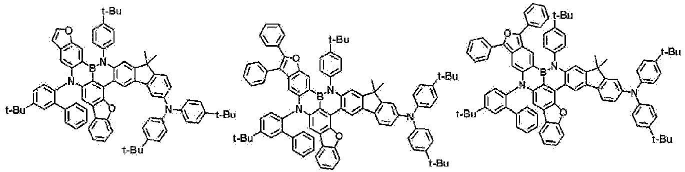

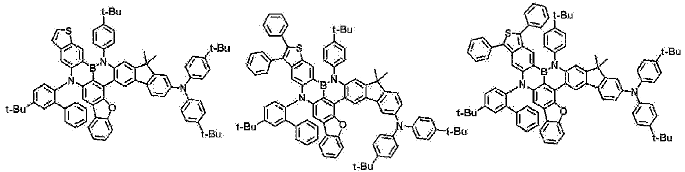

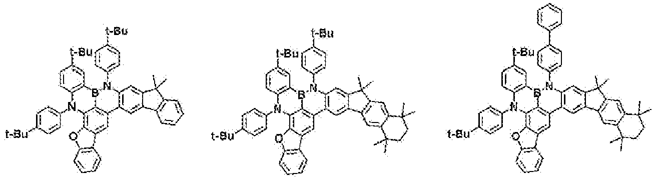

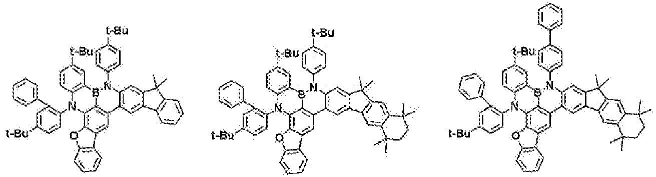

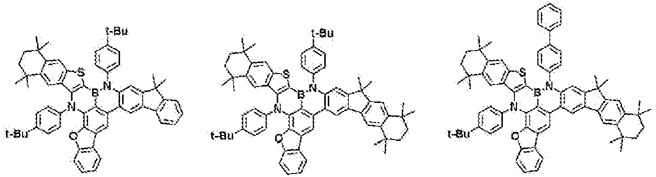

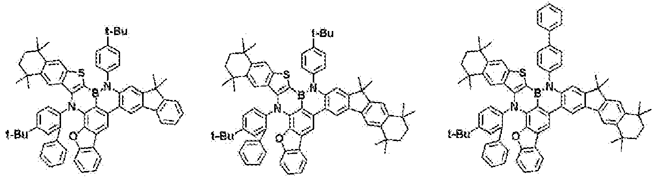

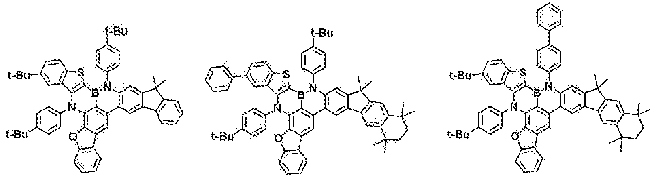

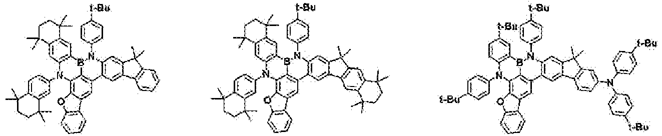

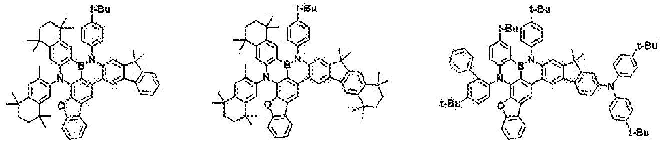

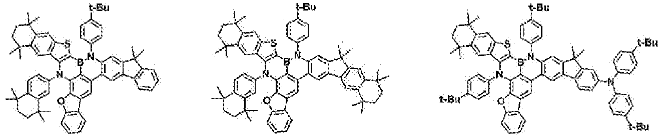

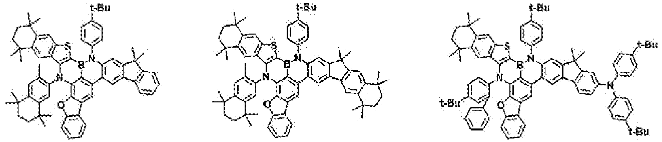

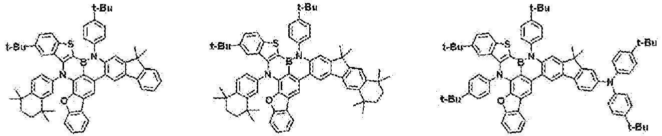

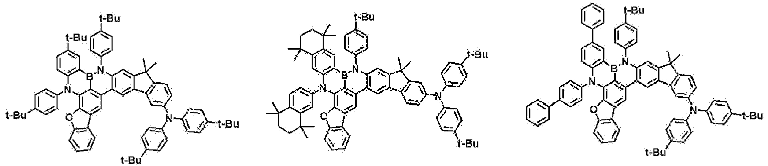

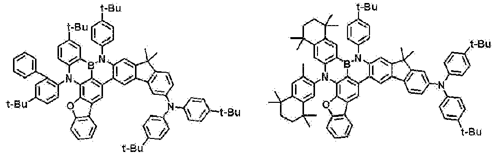

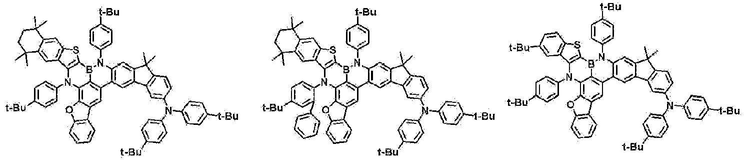

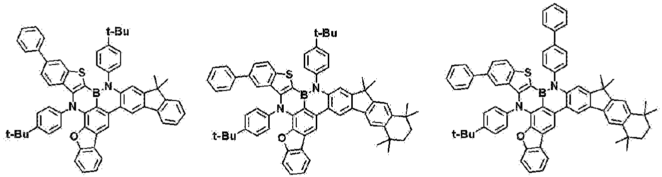

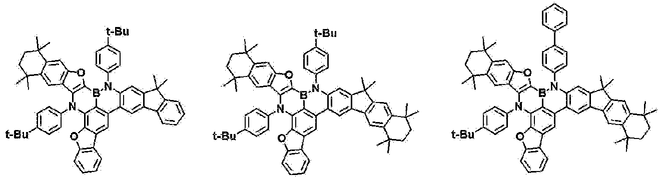

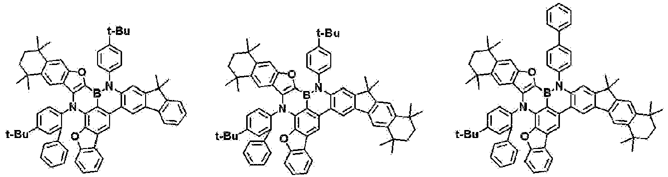

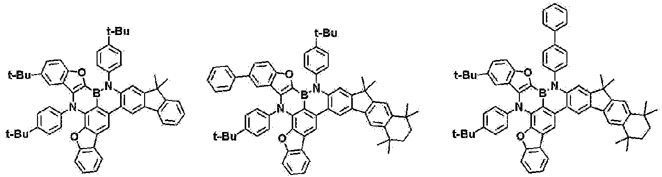

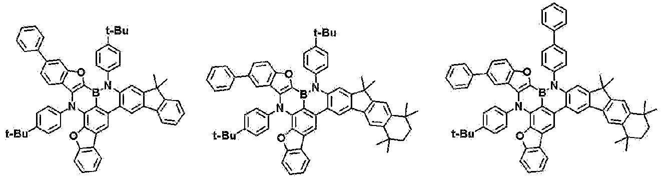

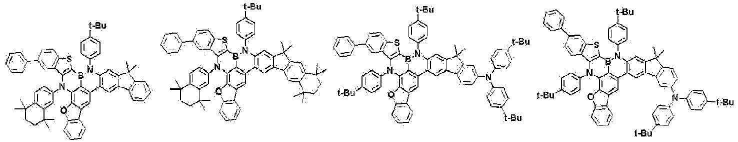

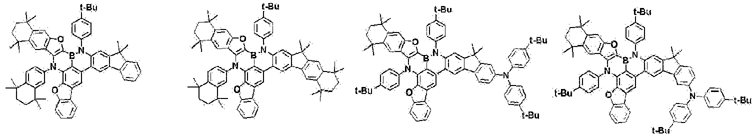

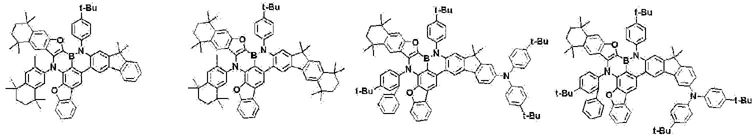

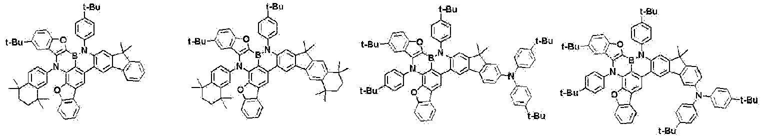

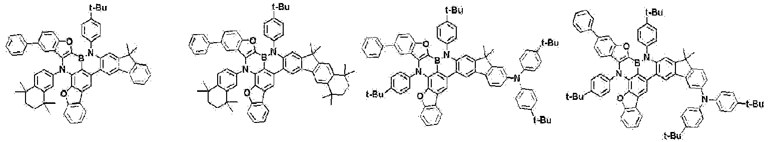

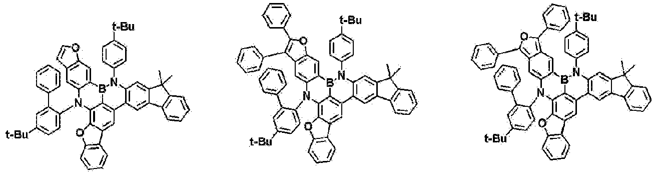

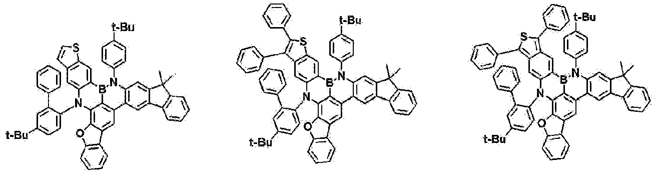

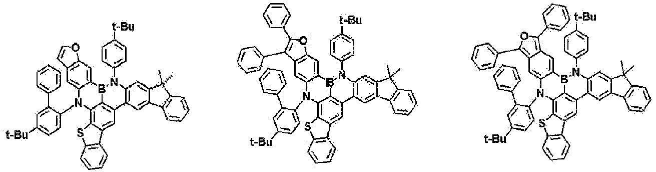

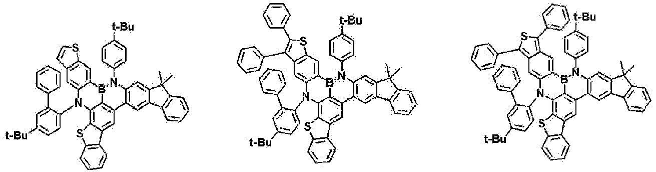

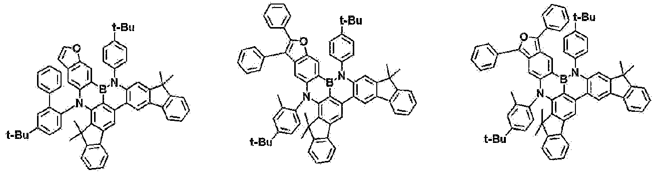

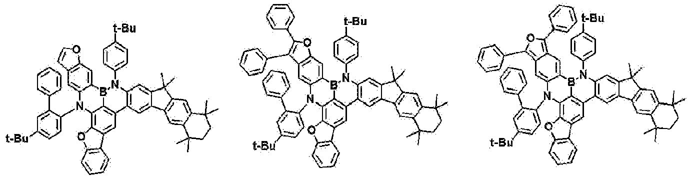

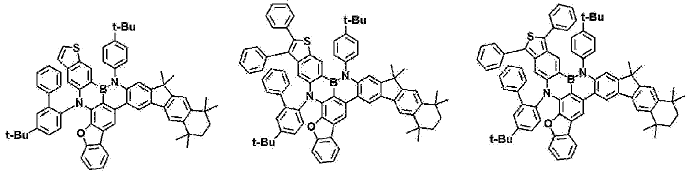

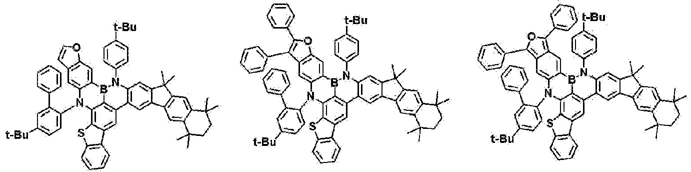

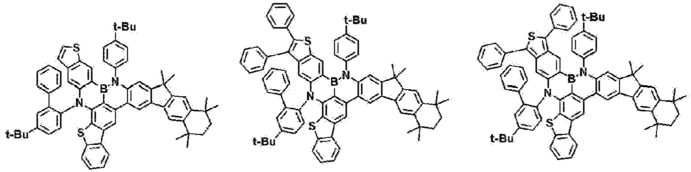

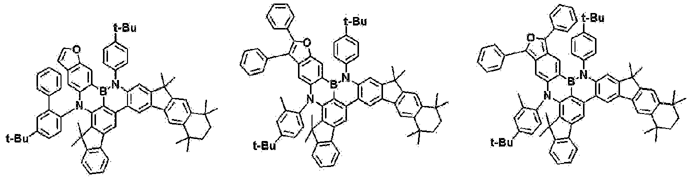

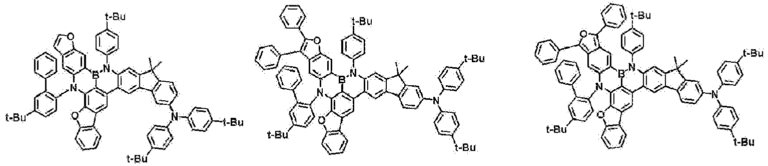

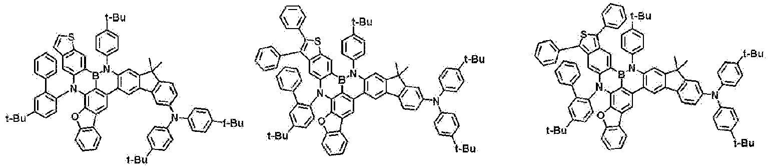

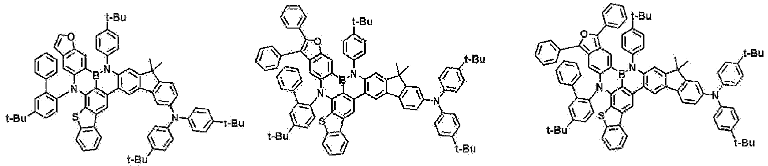

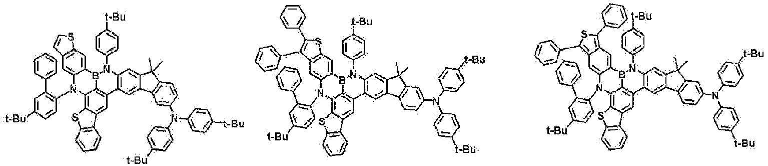

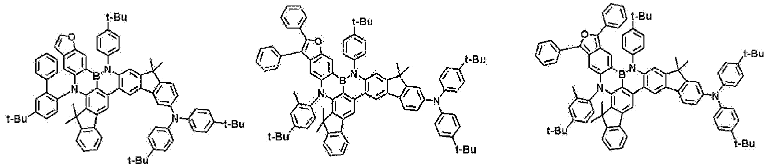

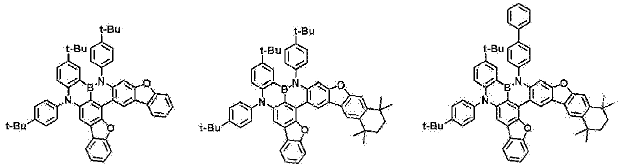

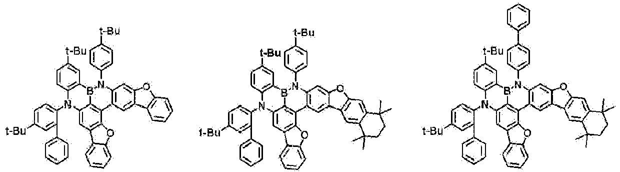

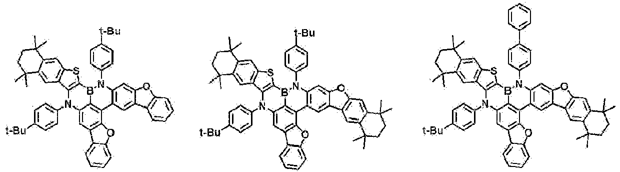

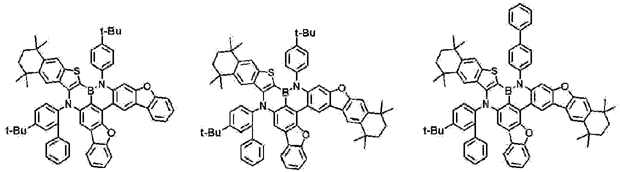

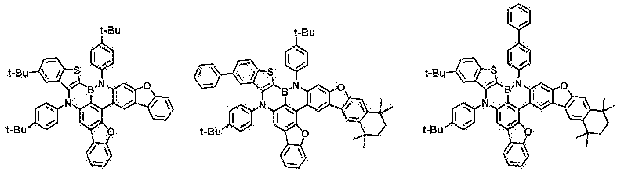

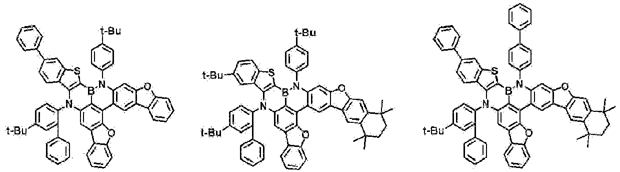

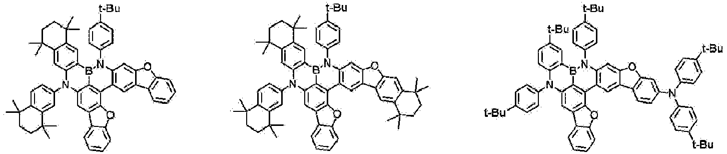

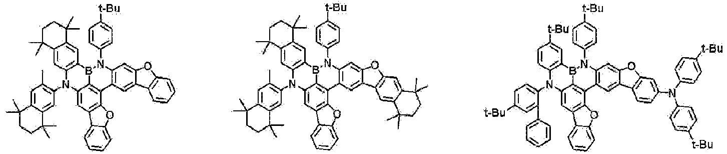

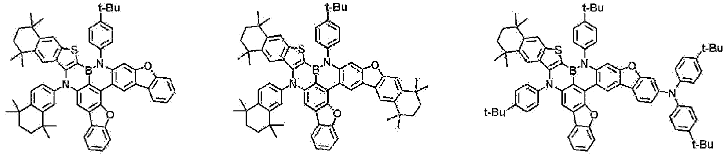

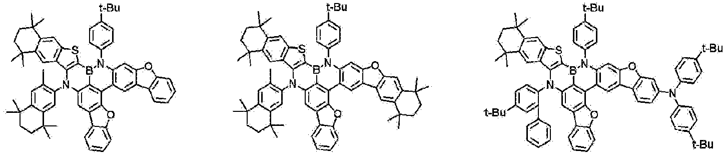

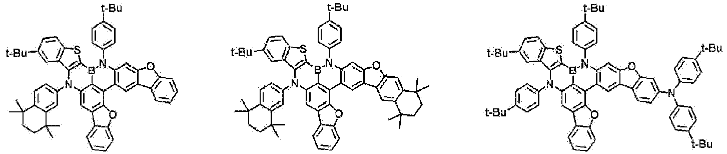

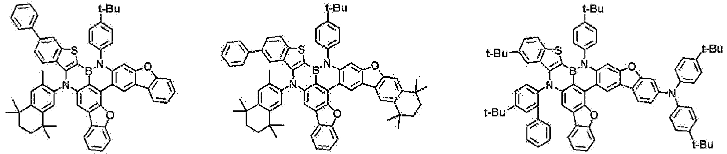

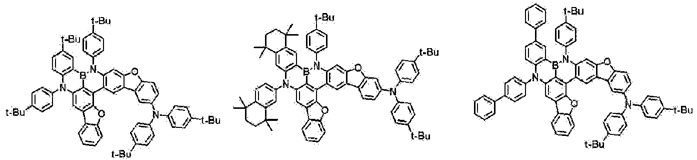

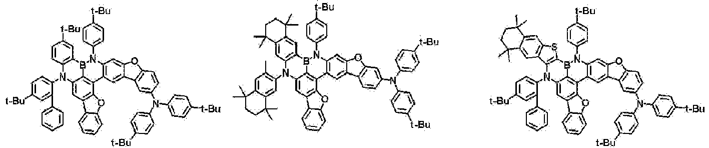

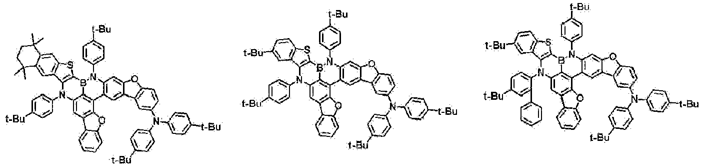

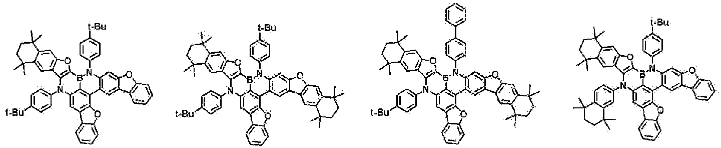

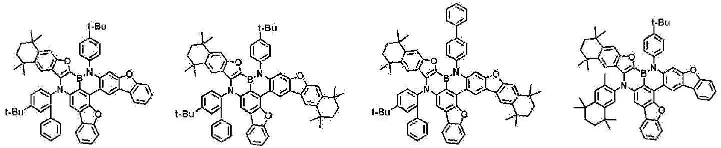

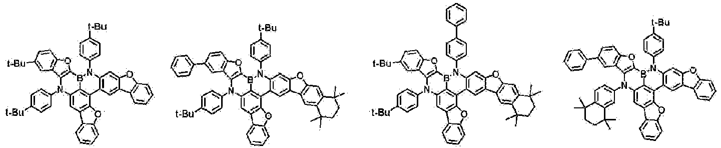

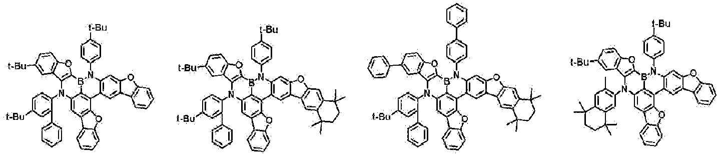

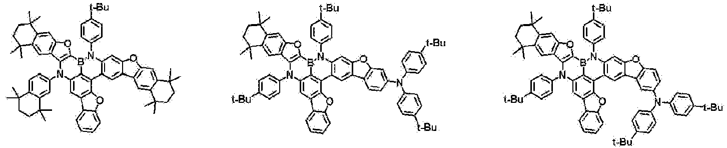

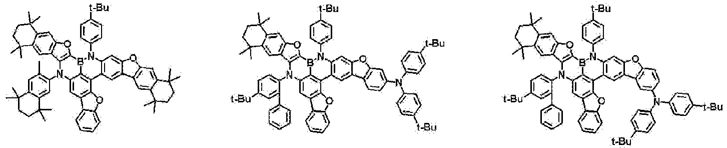

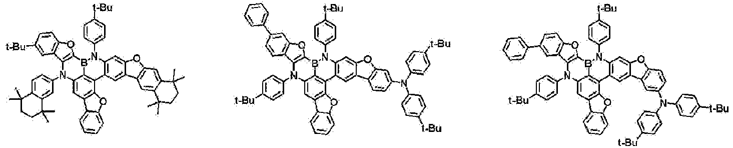

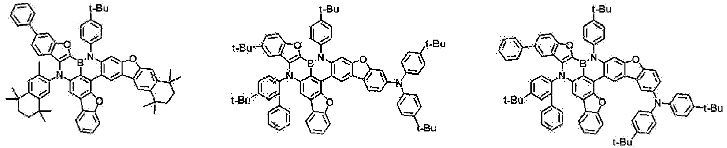

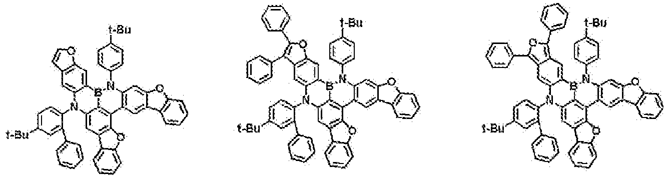

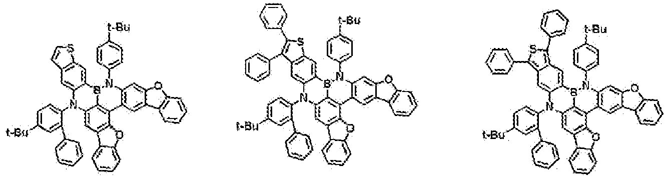

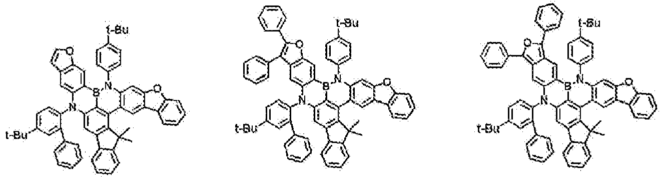

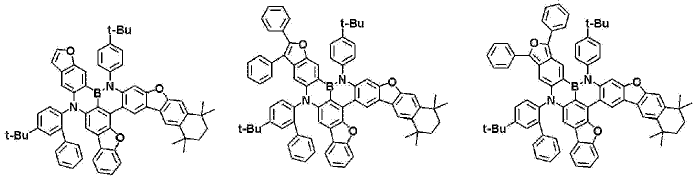

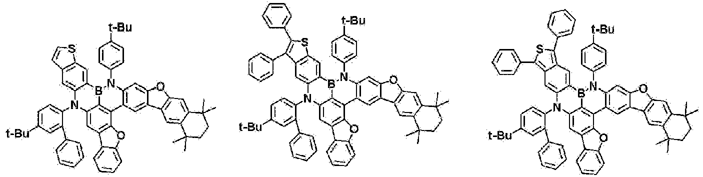

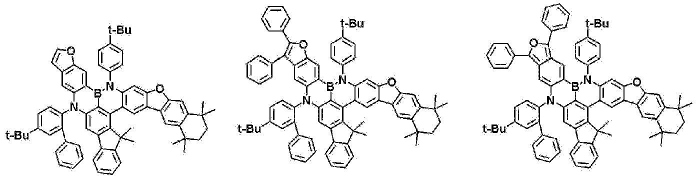

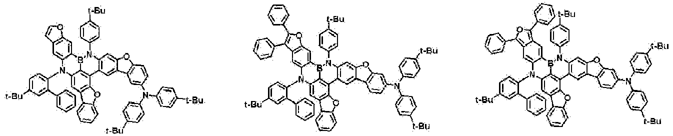

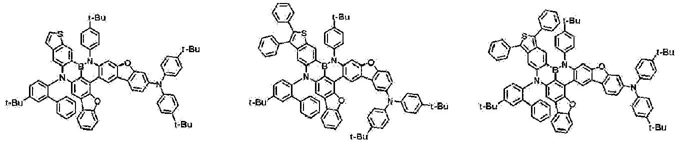

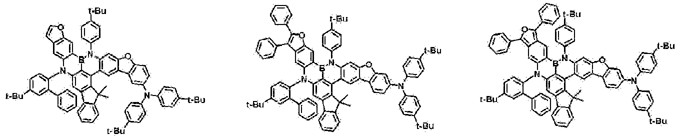

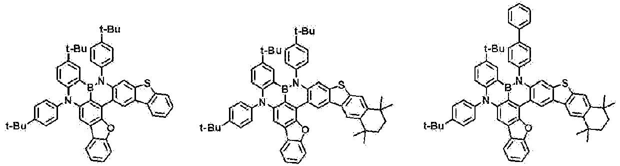

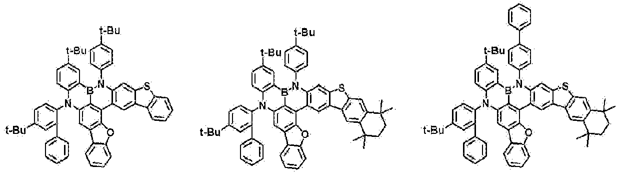

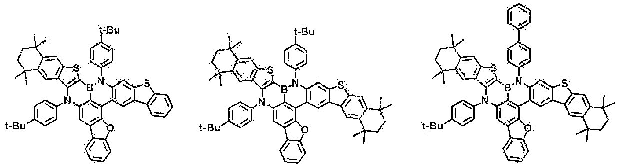

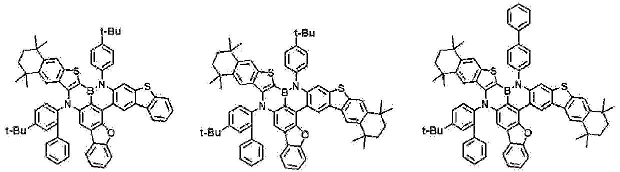

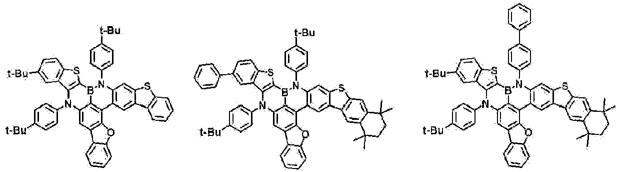

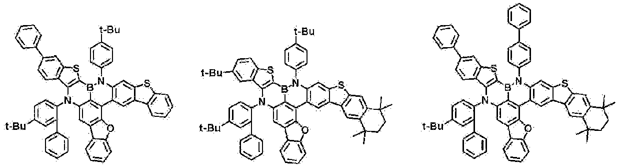

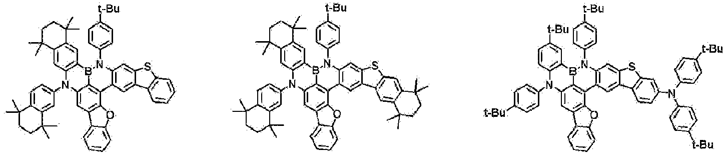

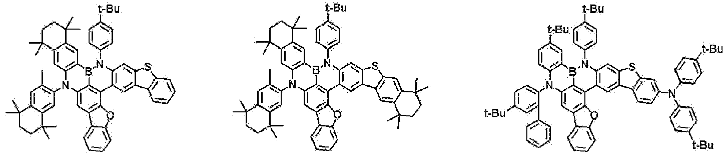

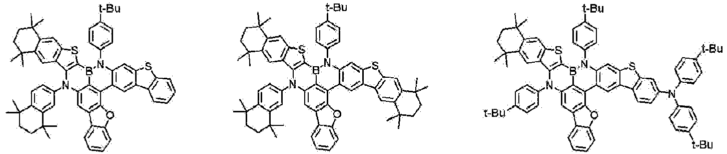

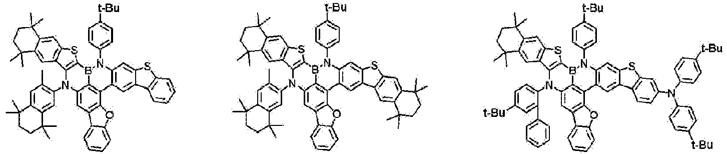

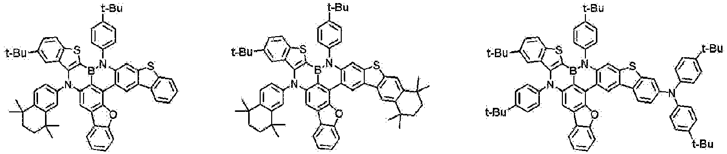

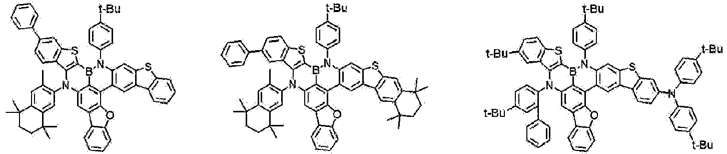

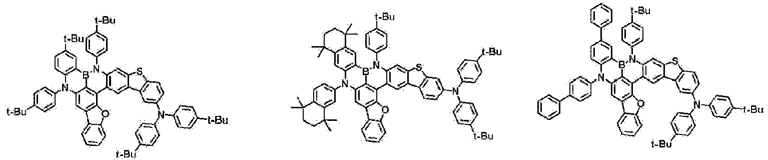

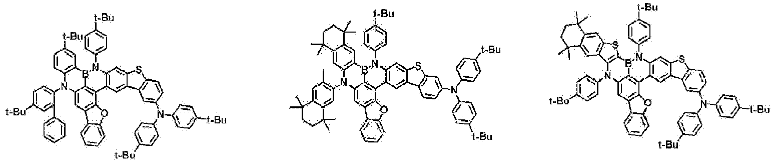

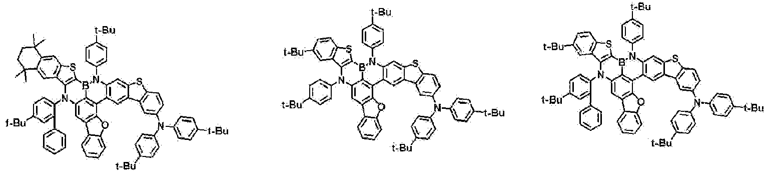

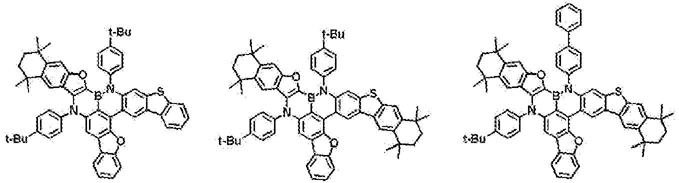

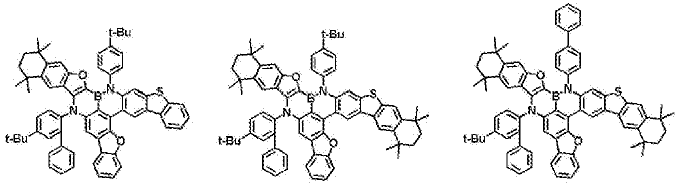

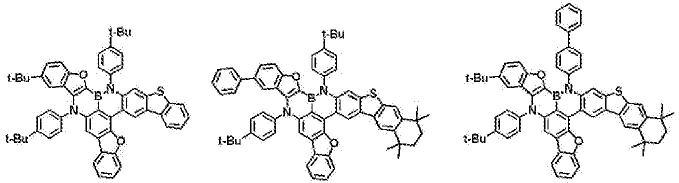

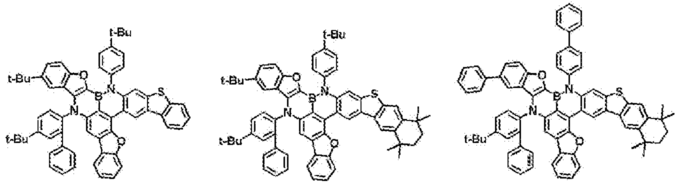

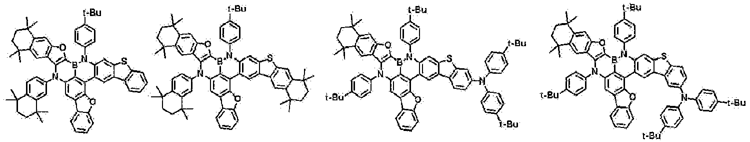

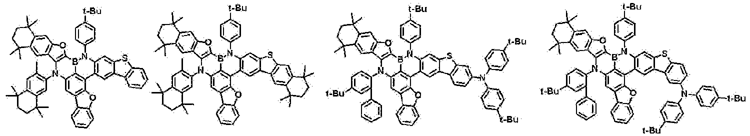

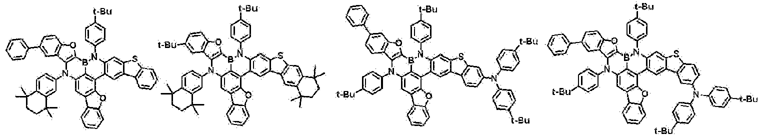

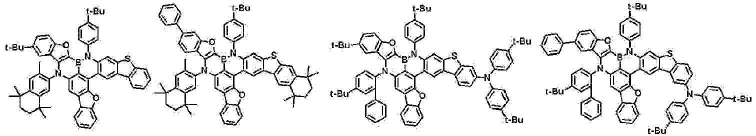

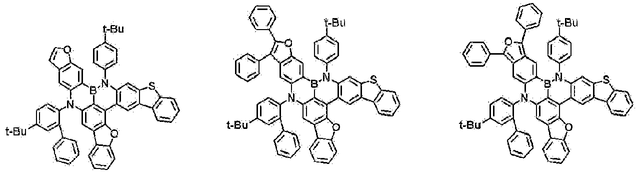

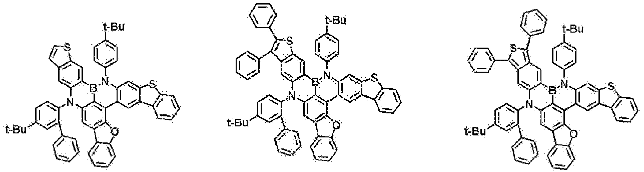

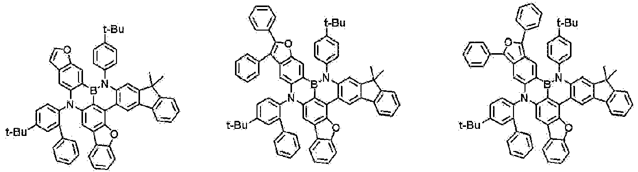

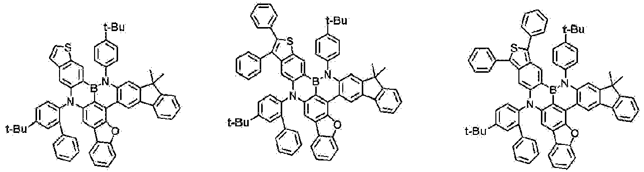

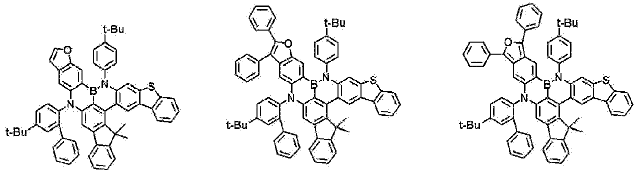

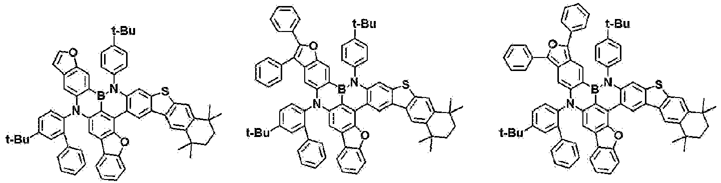

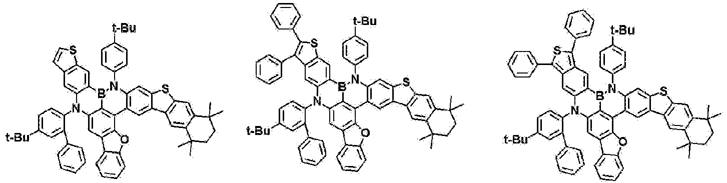

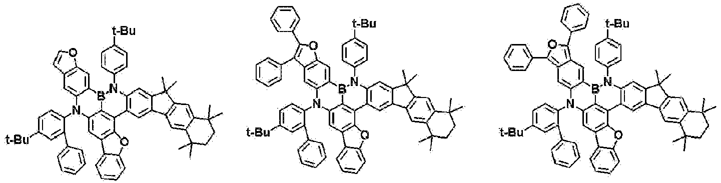

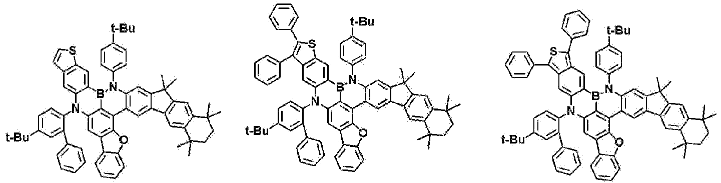

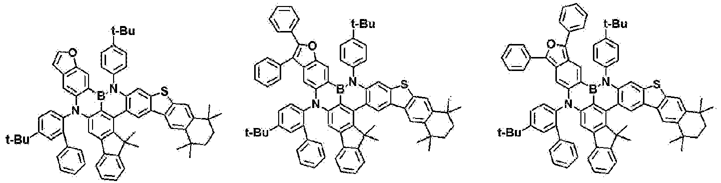

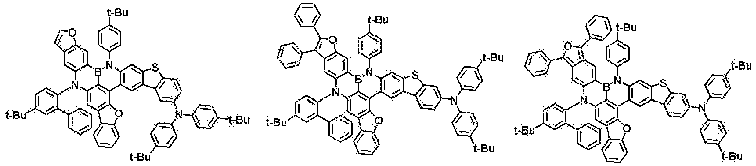

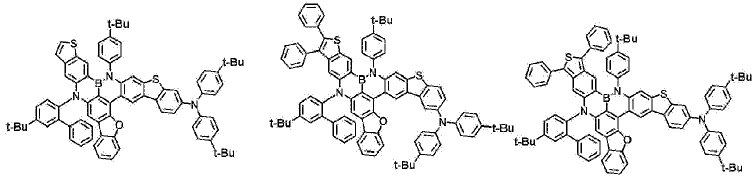

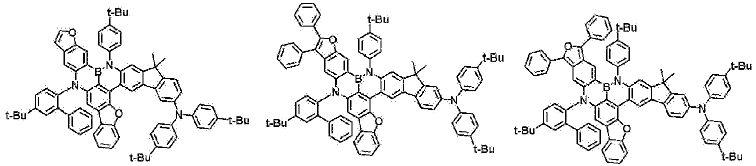

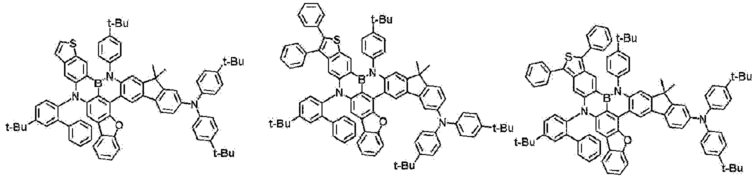

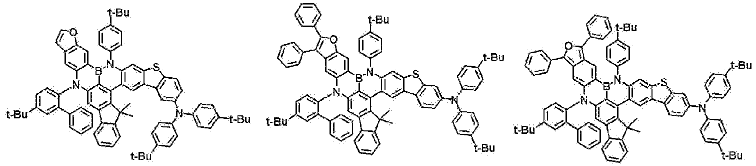

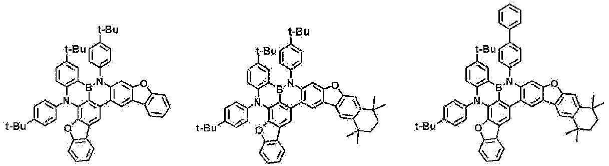

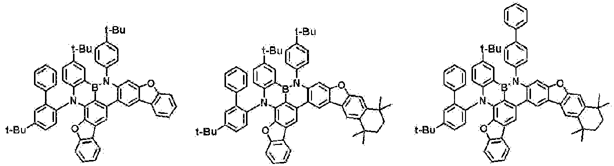

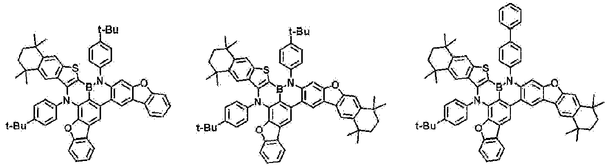

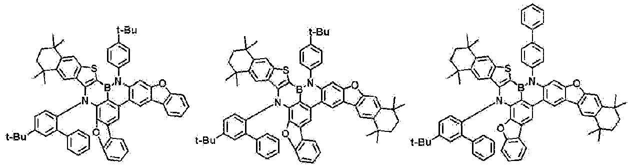

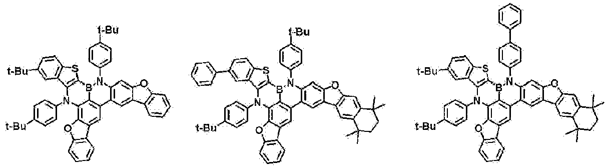

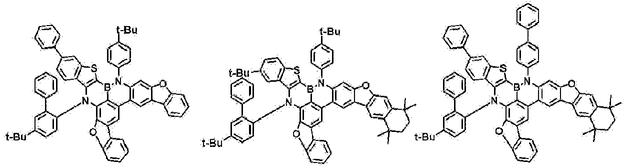

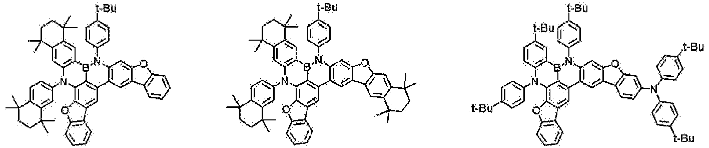

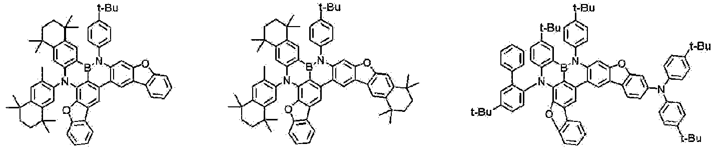

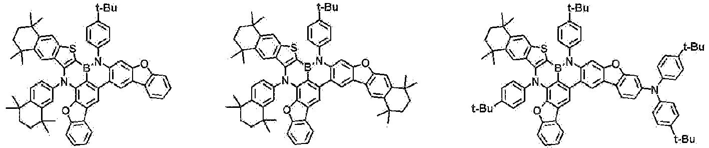

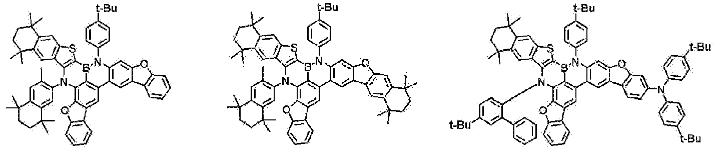

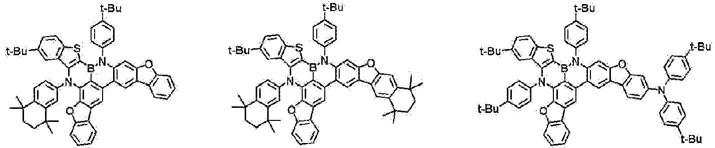

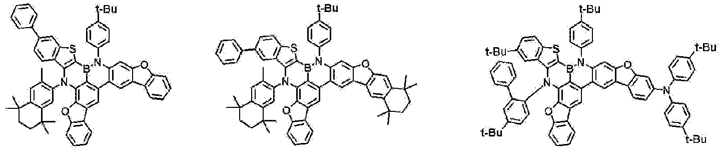

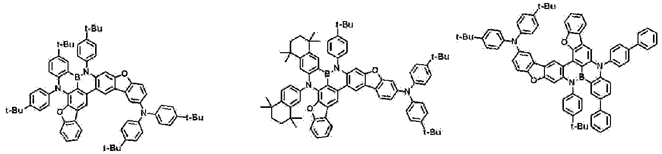

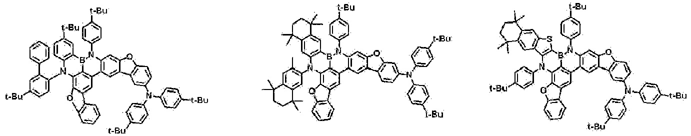

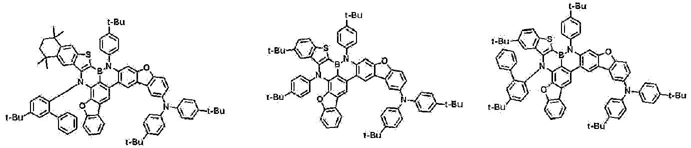

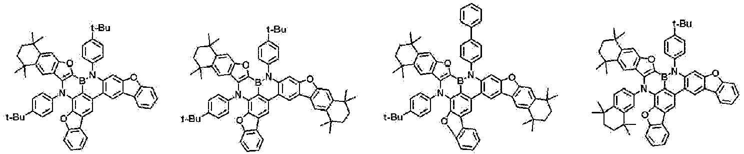

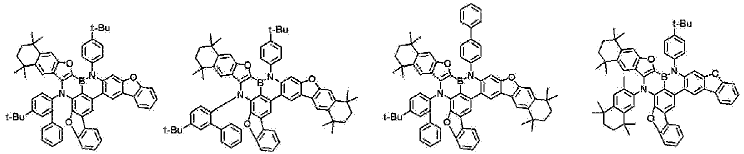

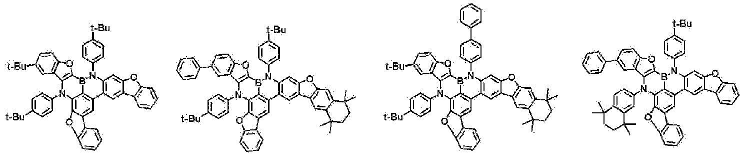

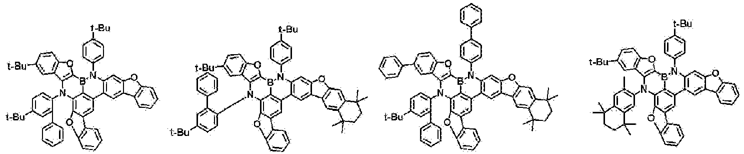

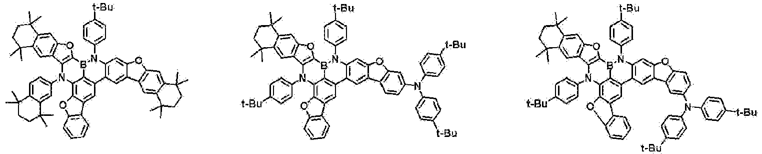

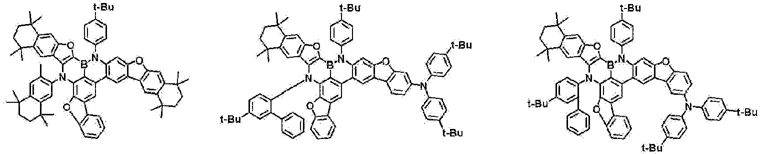

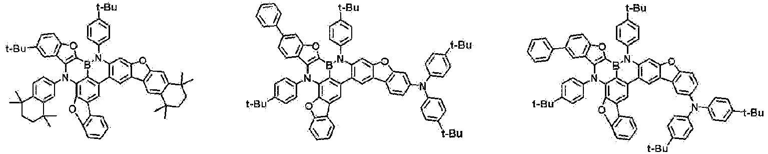

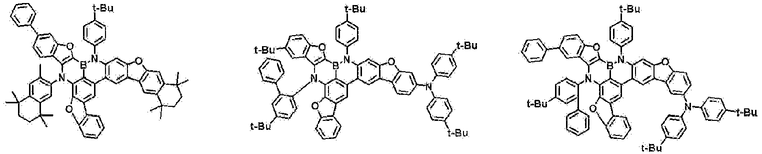

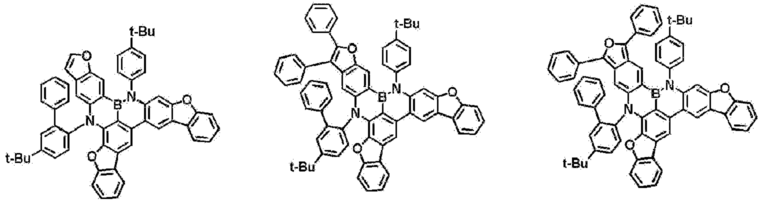

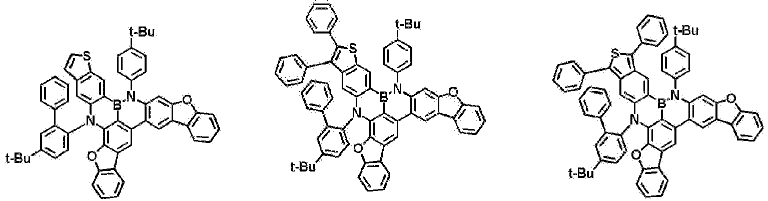

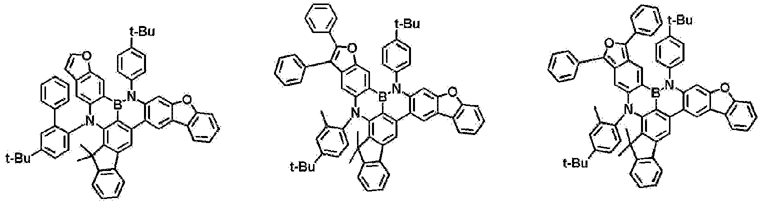

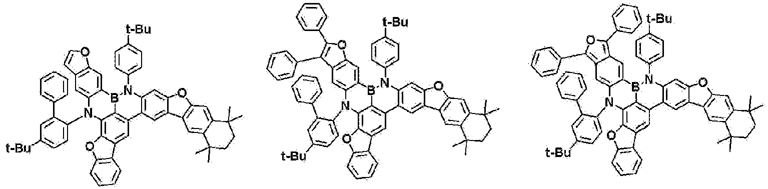

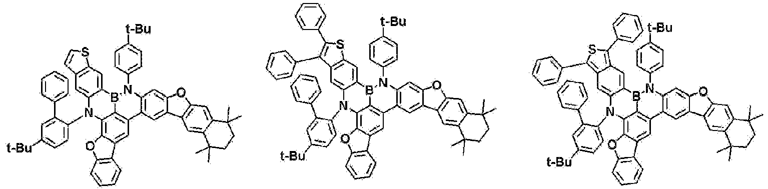

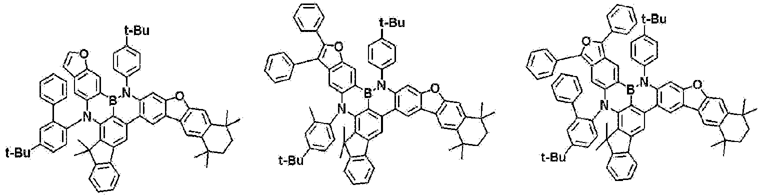

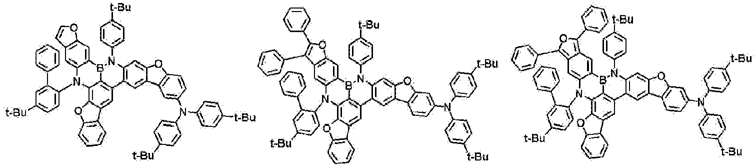

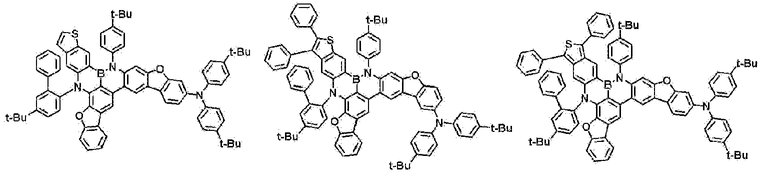

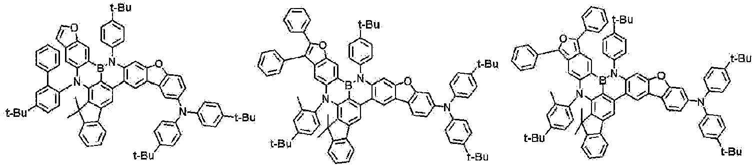

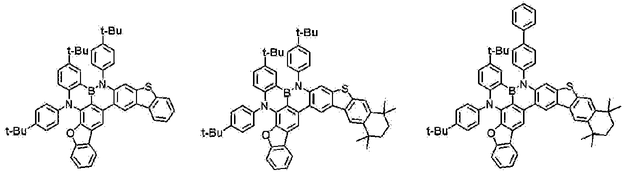

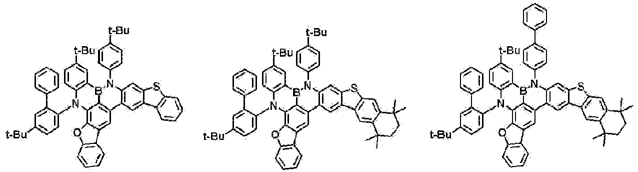

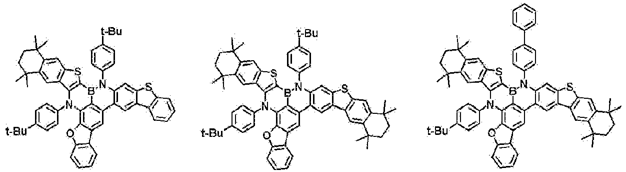

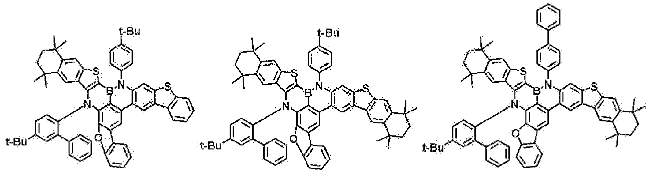

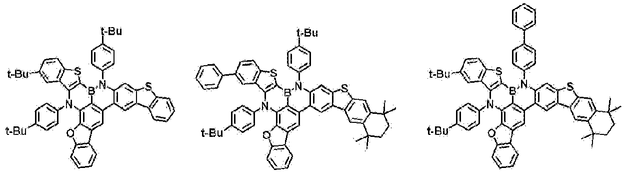

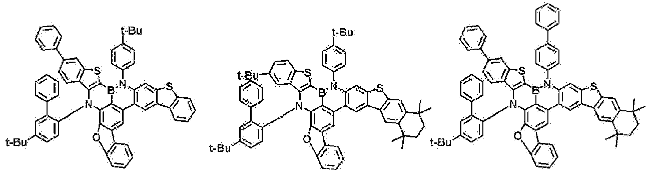

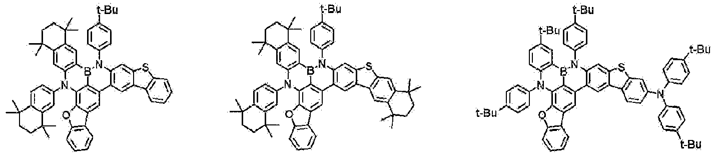

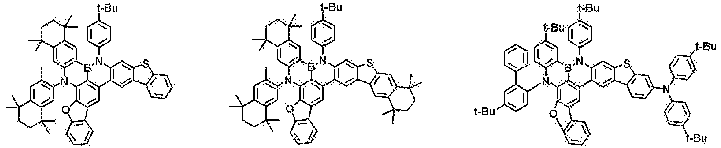

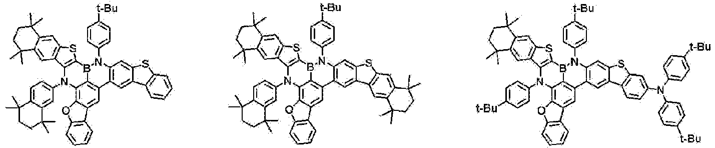

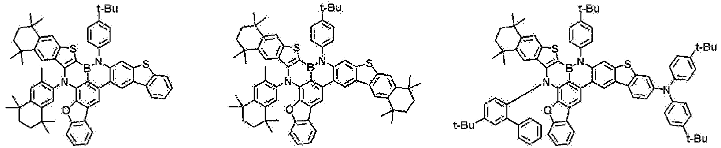

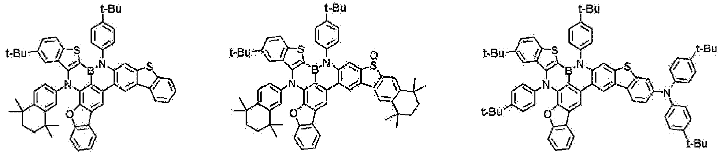

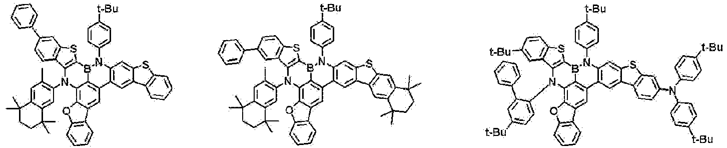

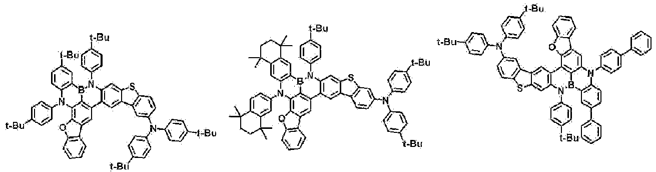

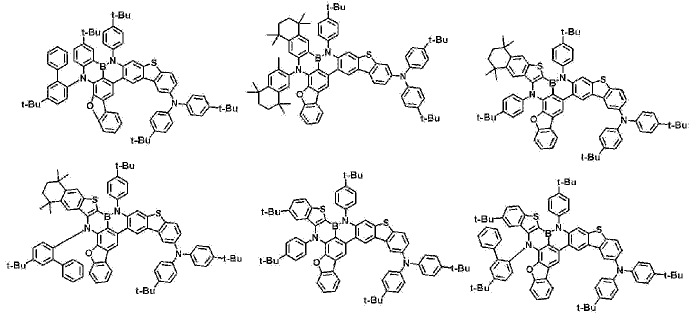

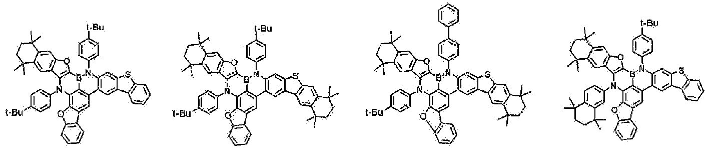

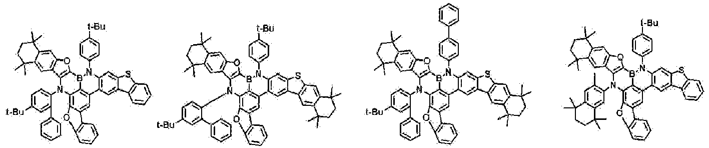

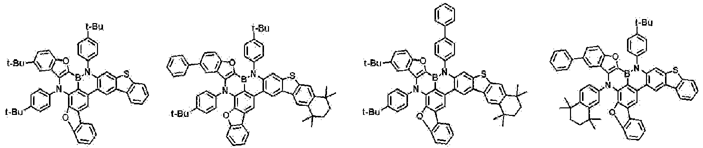

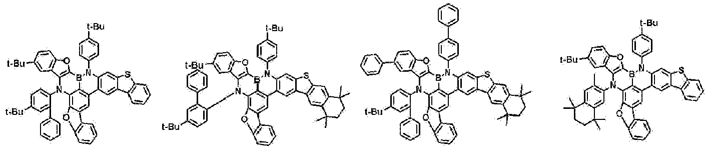

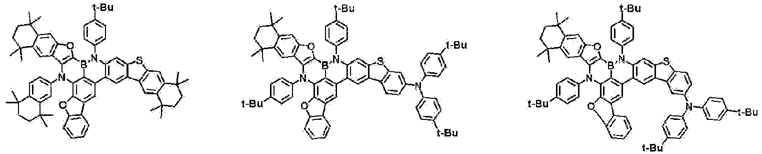

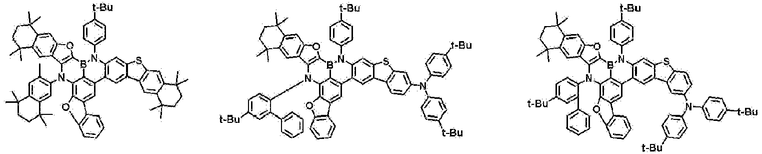

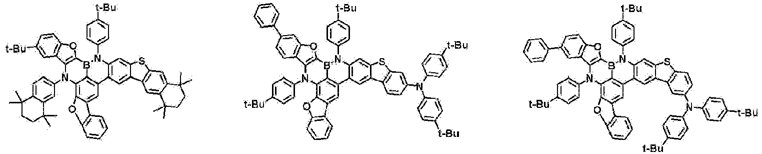

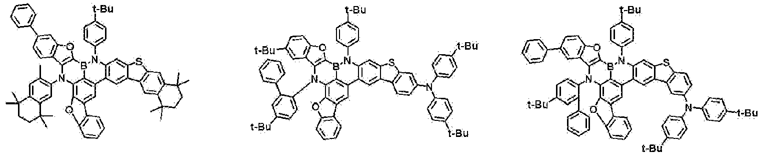

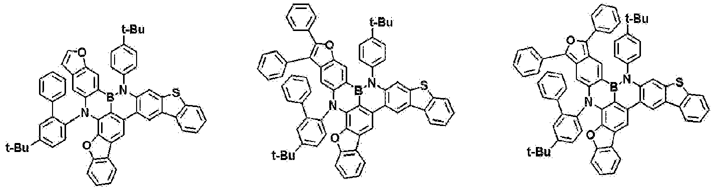

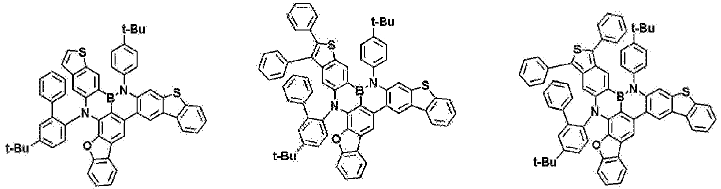

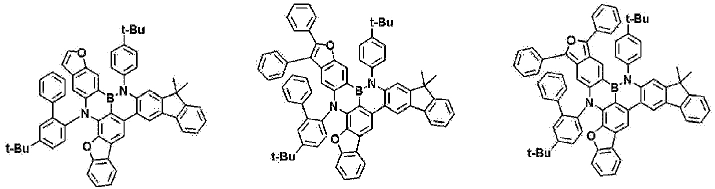

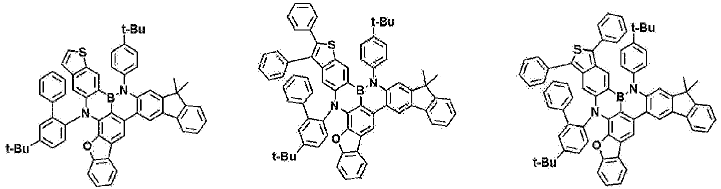

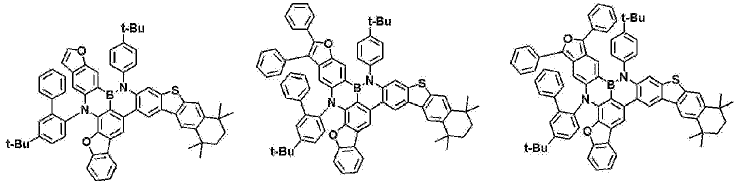

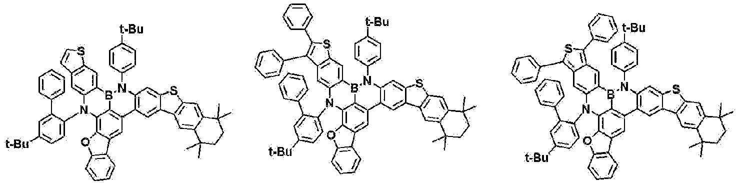

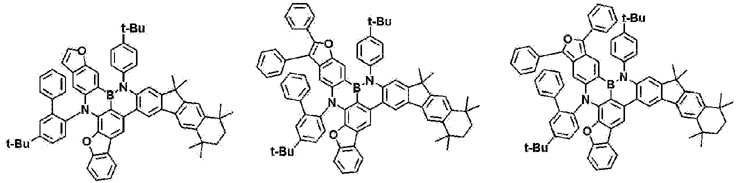

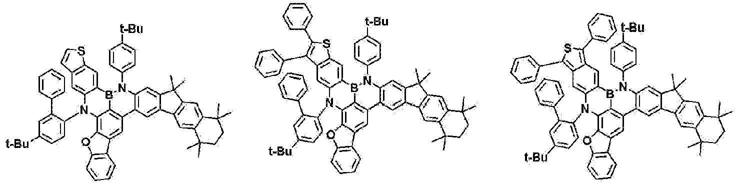

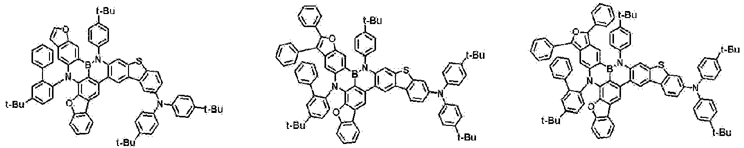

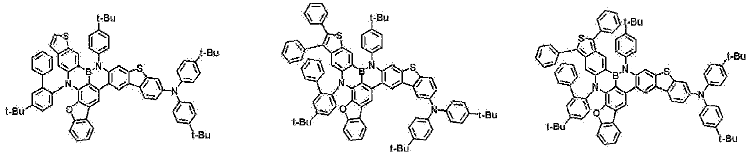

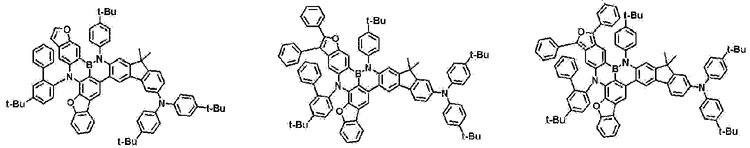

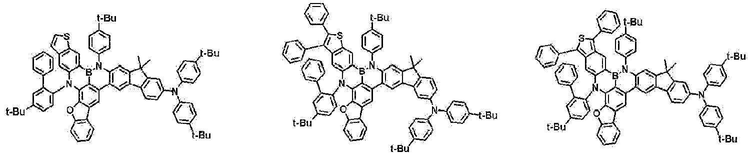

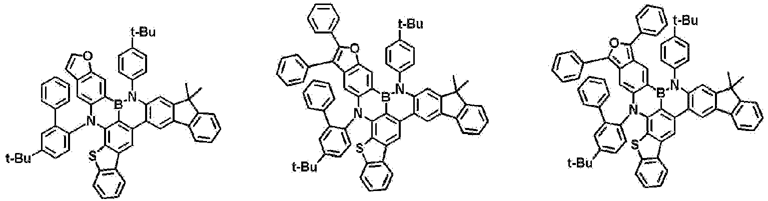

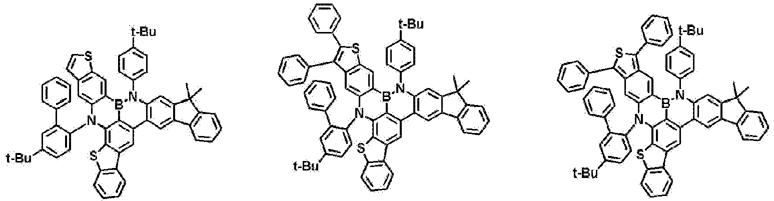

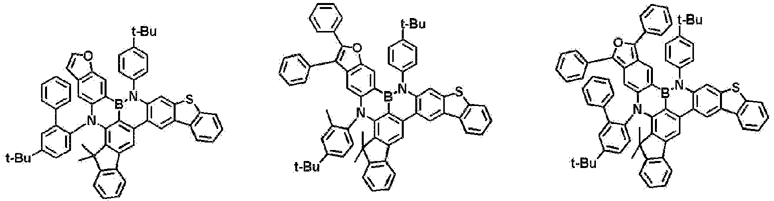

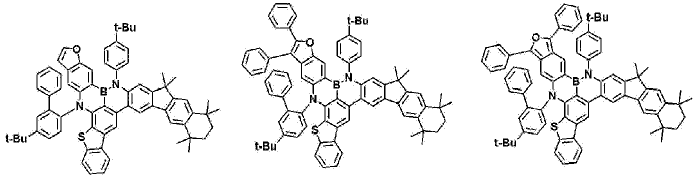

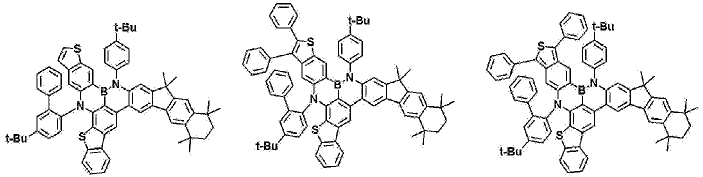

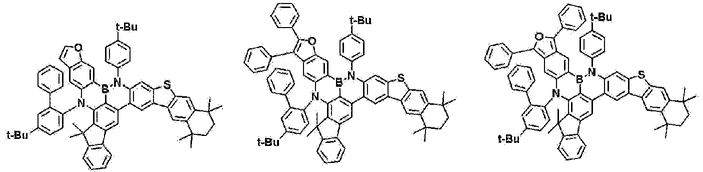

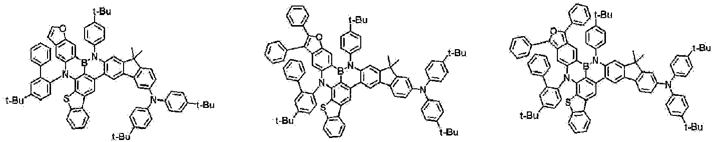

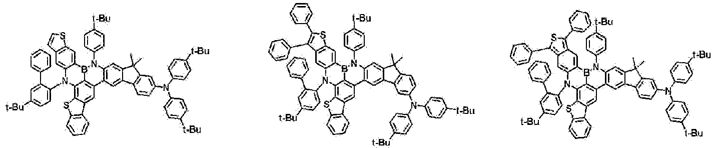

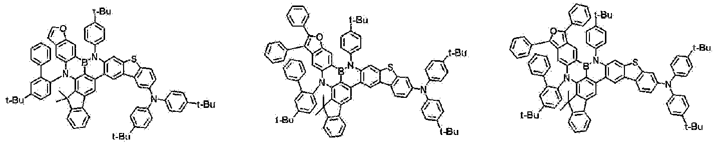

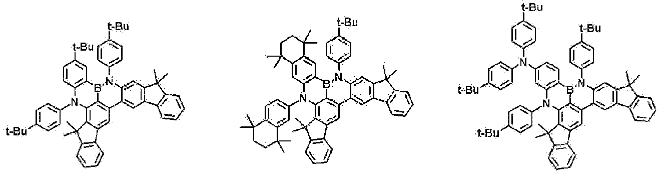

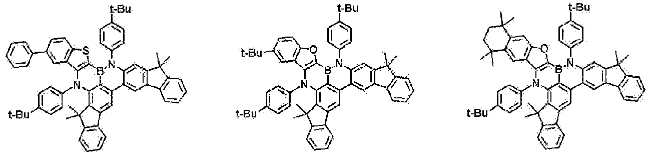

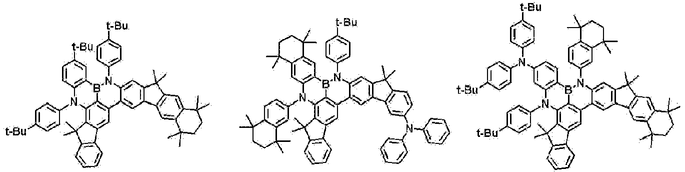

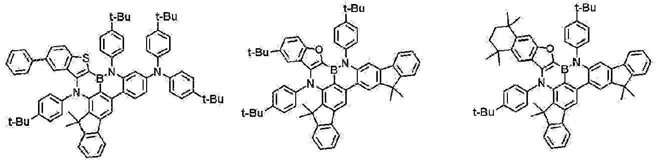

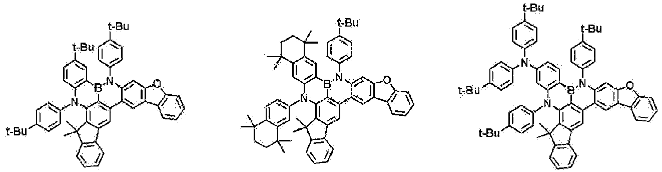

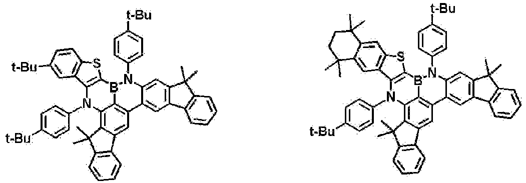

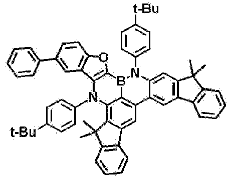

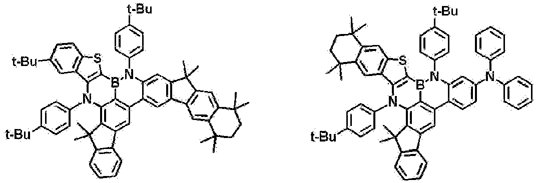

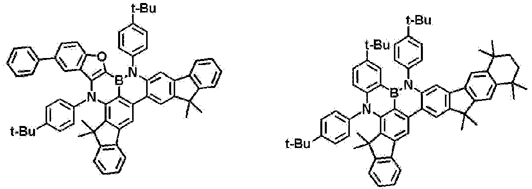

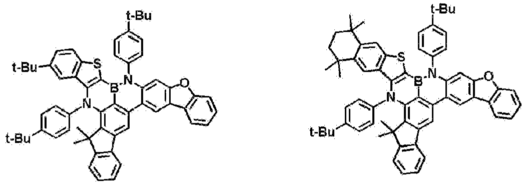

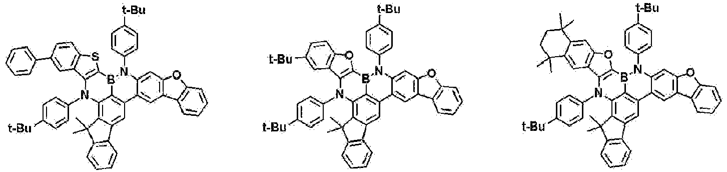

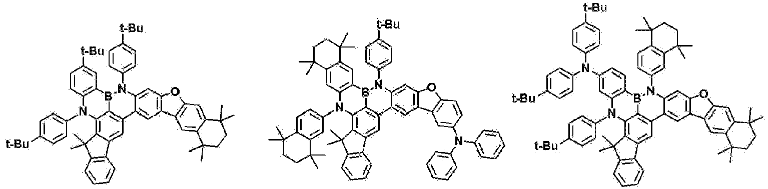

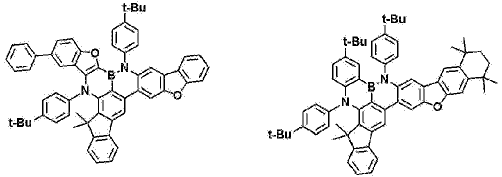

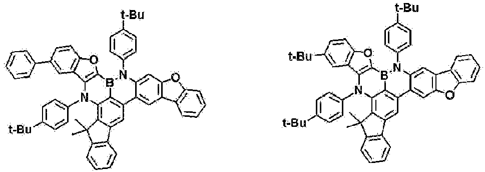

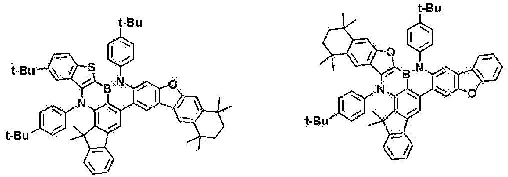

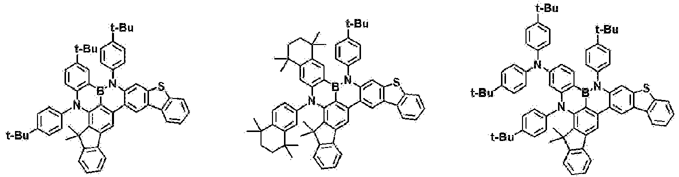

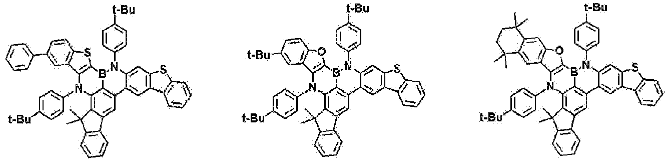

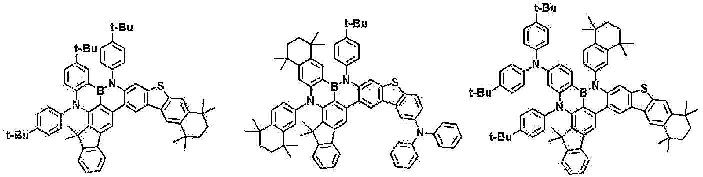

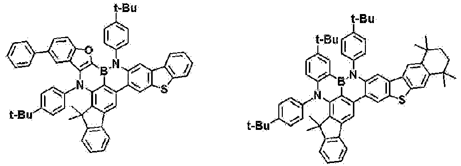

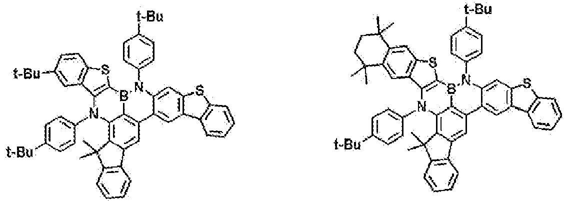

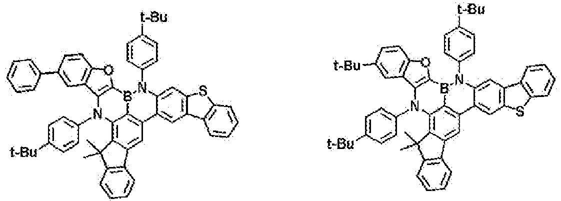

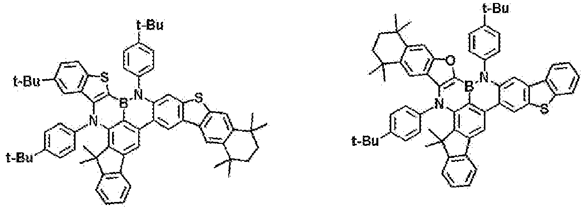

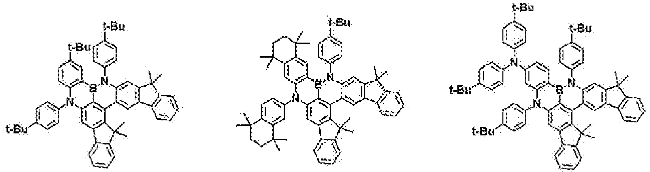

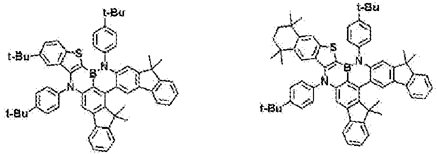

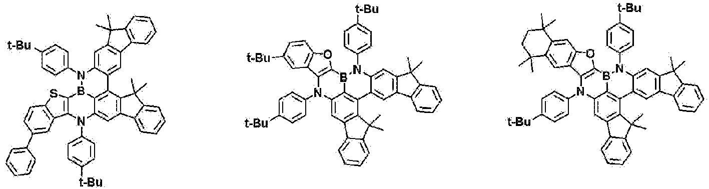

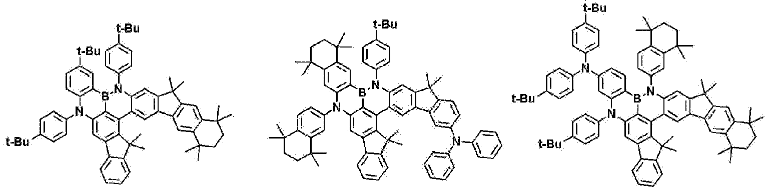

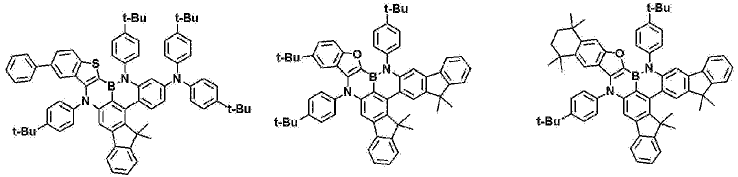

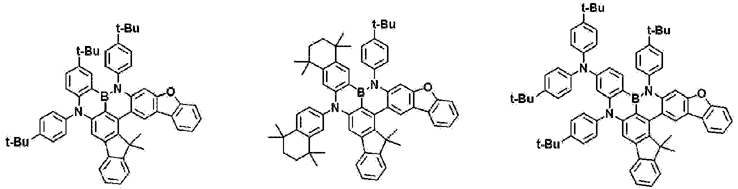

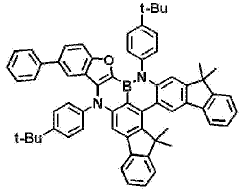

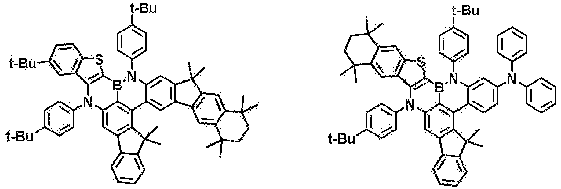

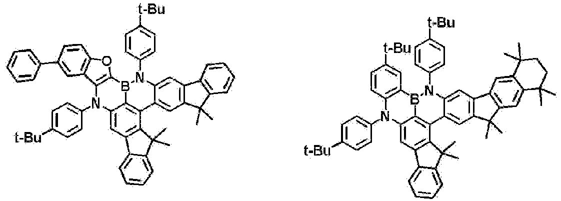

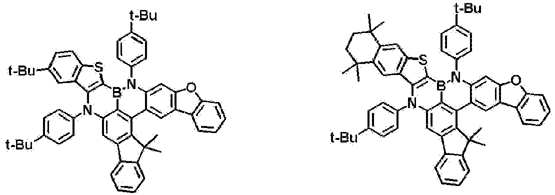

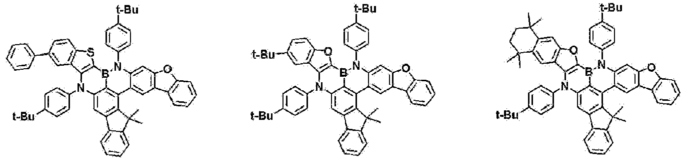

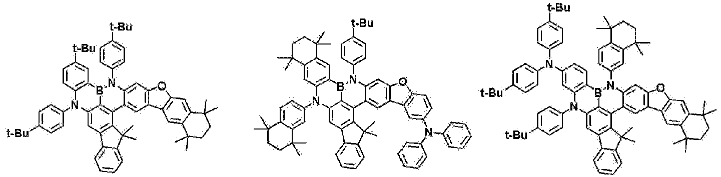

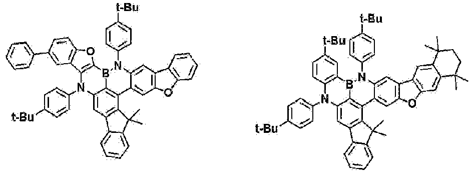

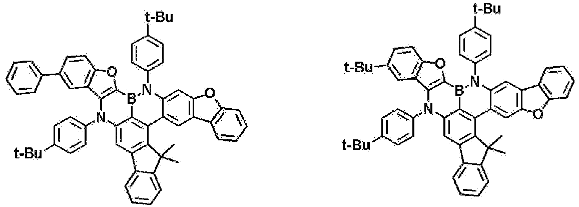

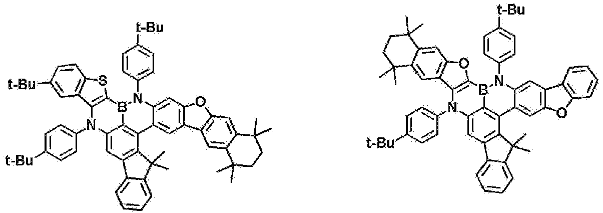

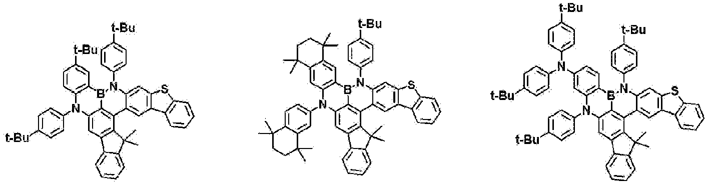

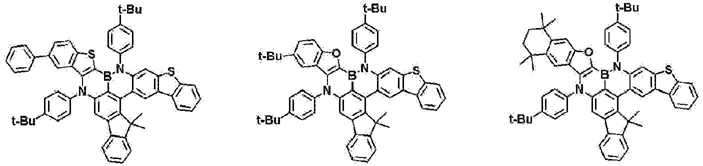

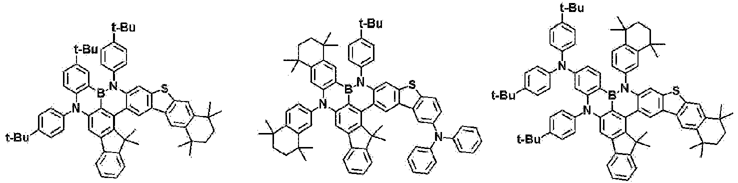

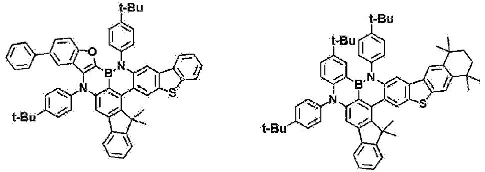

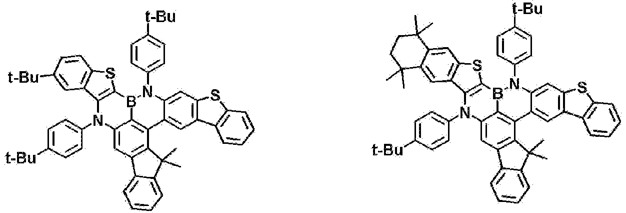

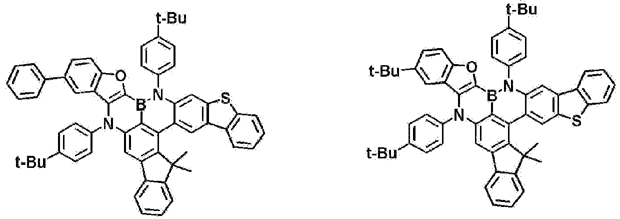

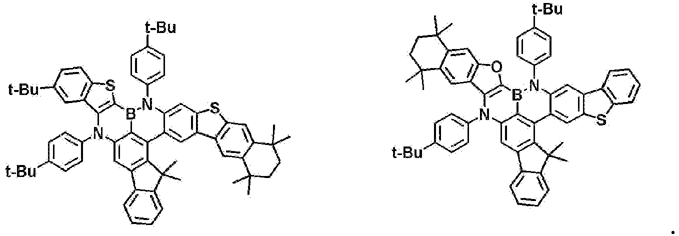

12. The organic light emitting device of Claim 1, wherein the compound of Chemical Formula H is one selected from the following compounds:

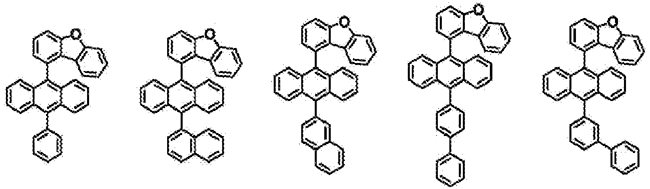

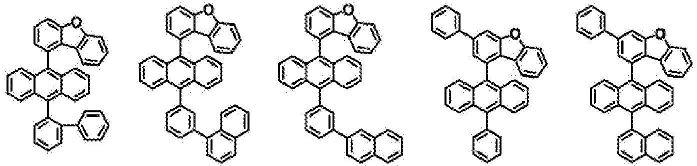

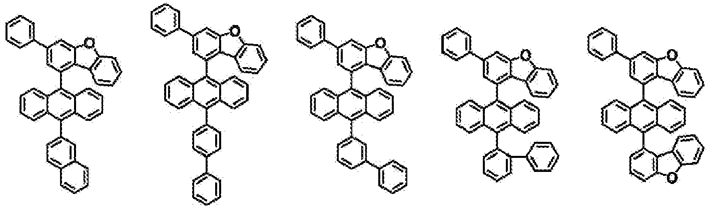

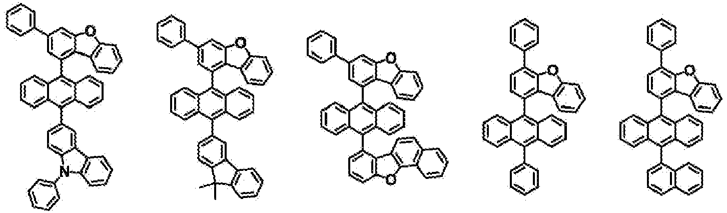

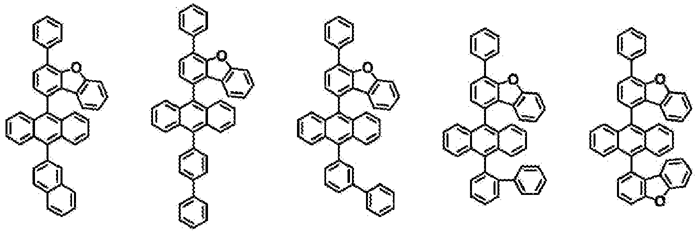

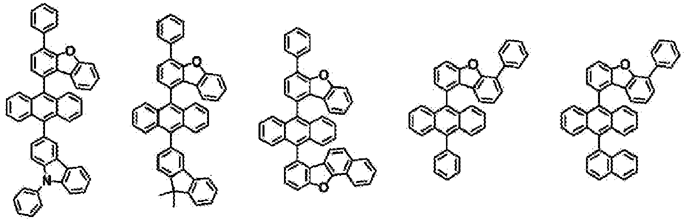

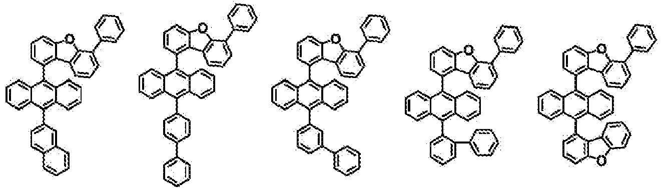

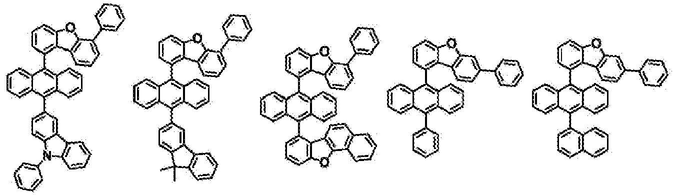

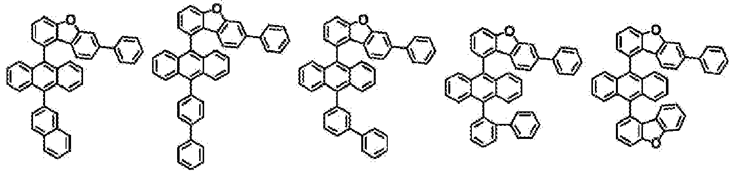

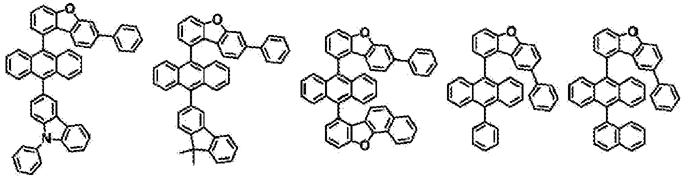

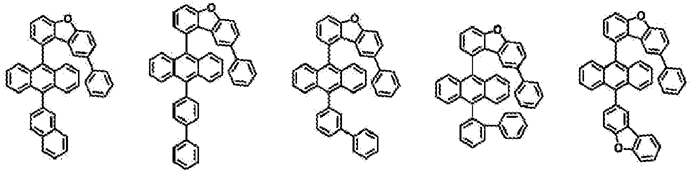

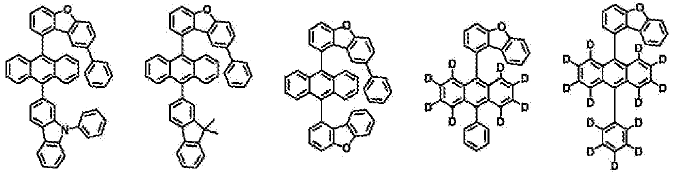

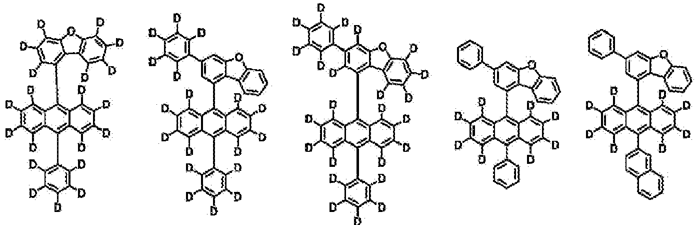

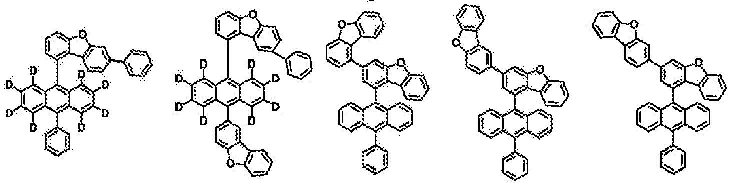

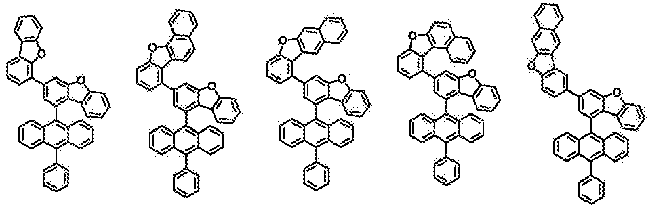

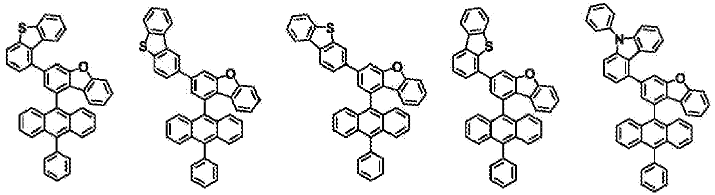

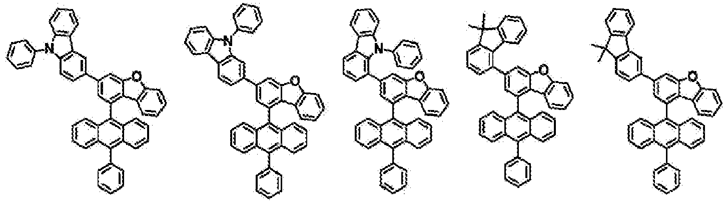

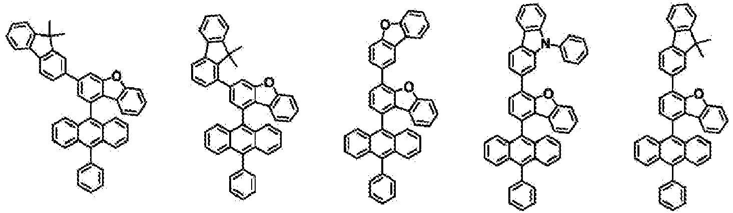

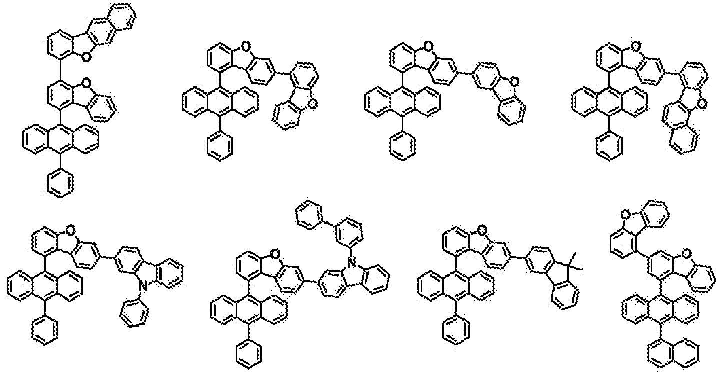

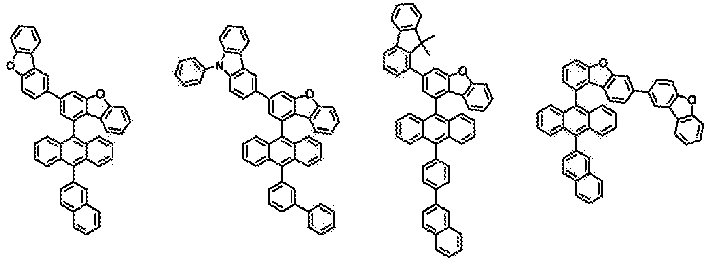

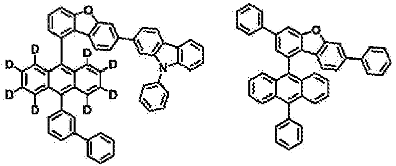

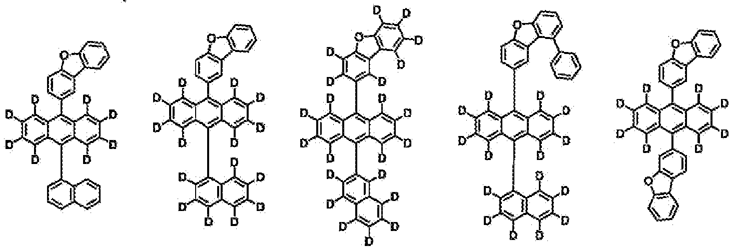

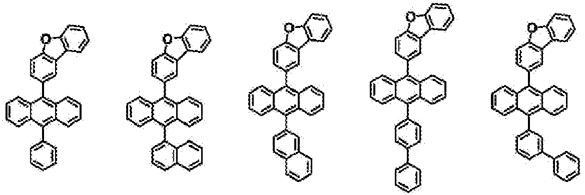

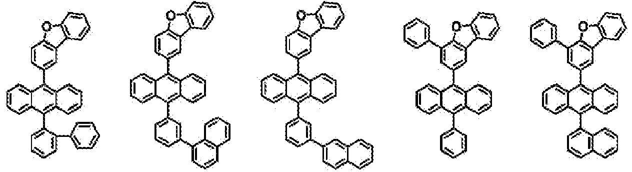

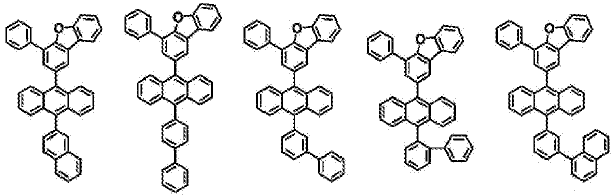

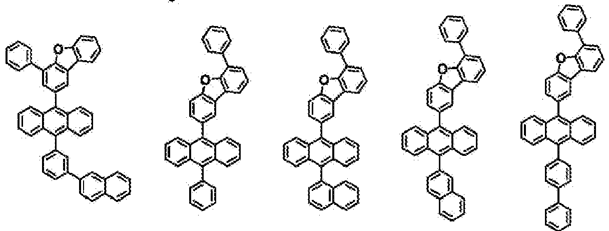

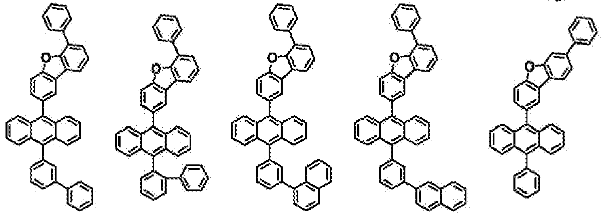

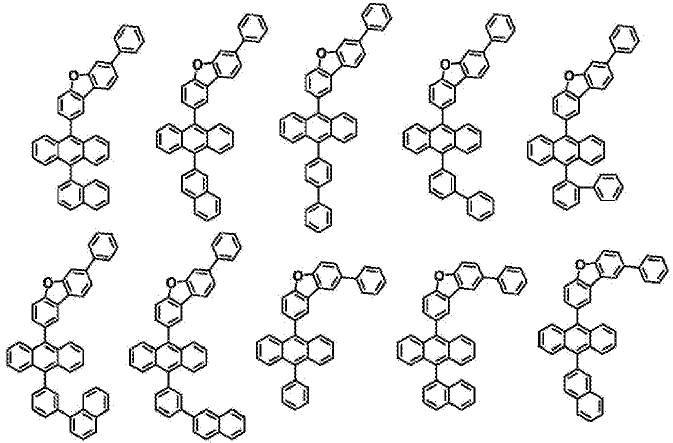

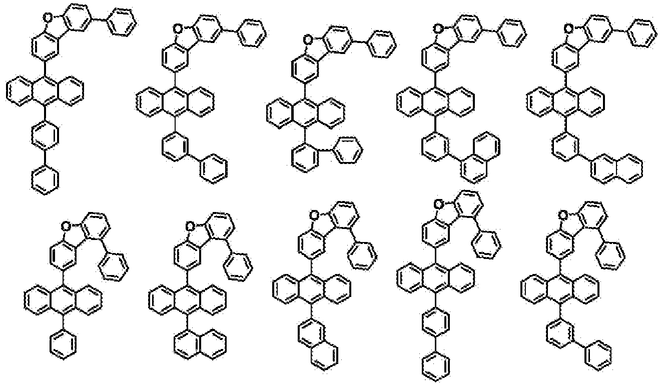

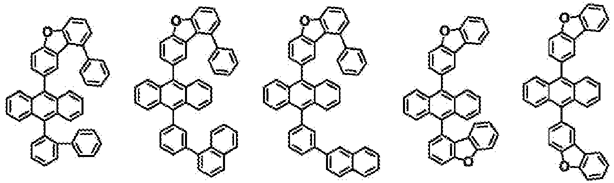

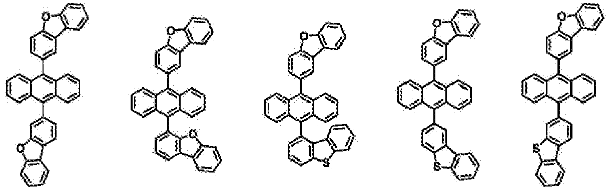

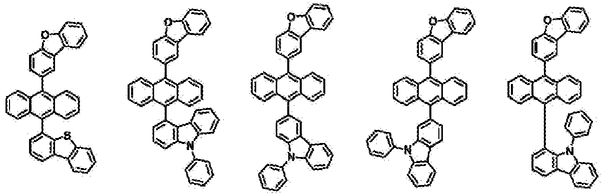

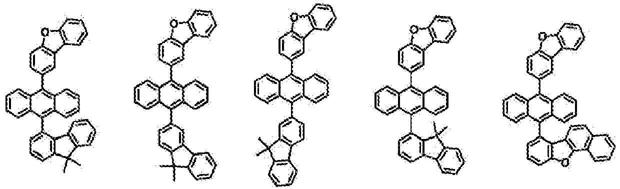

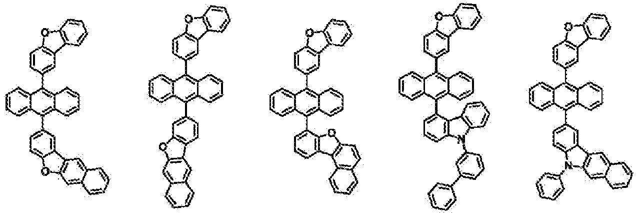

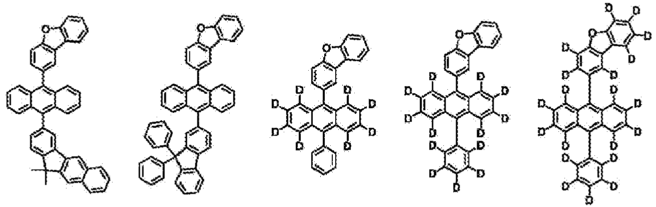

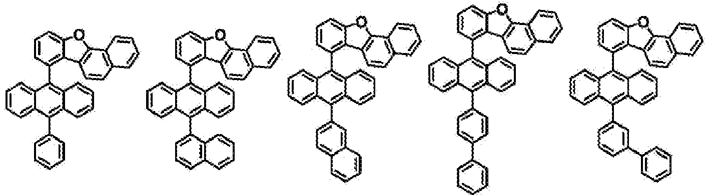

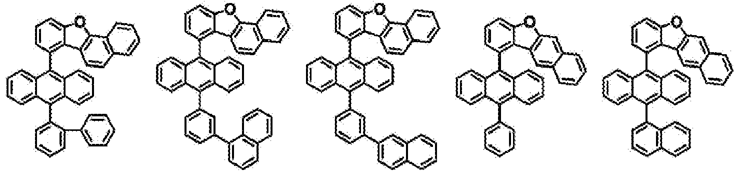

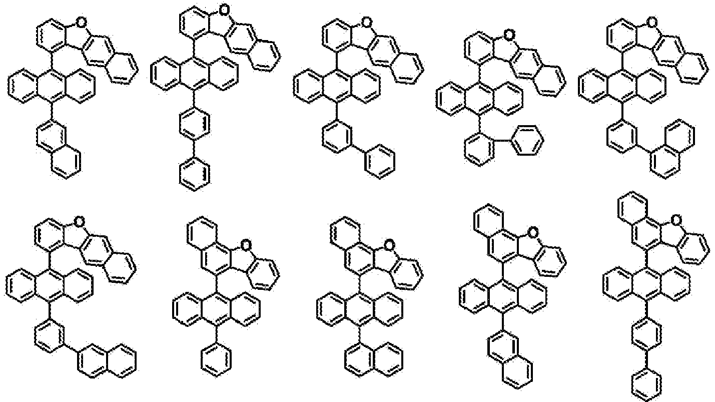

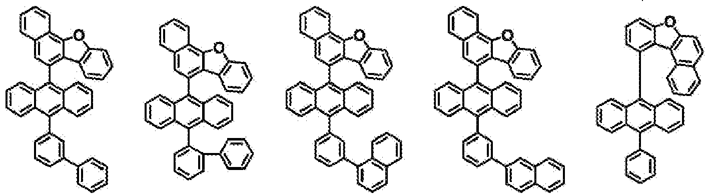

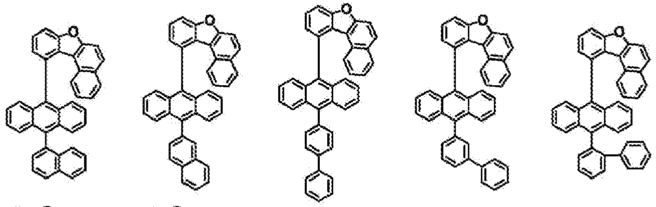

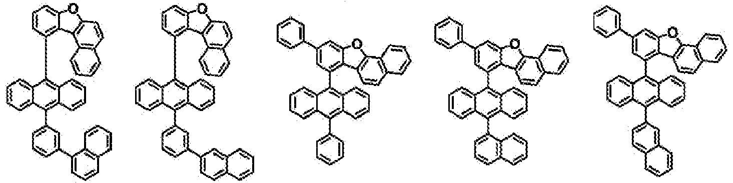

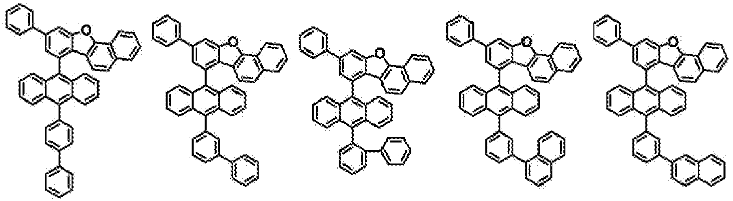

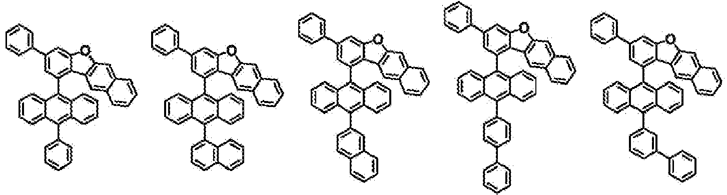

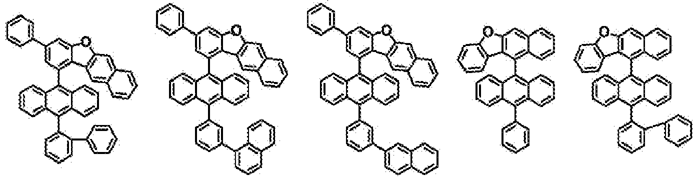

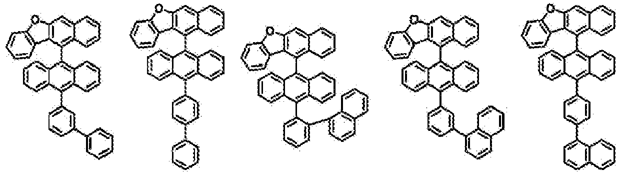

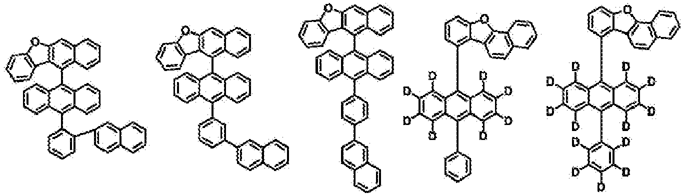

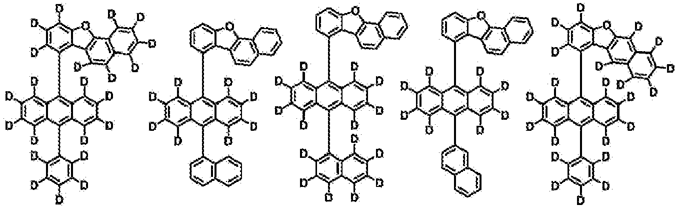

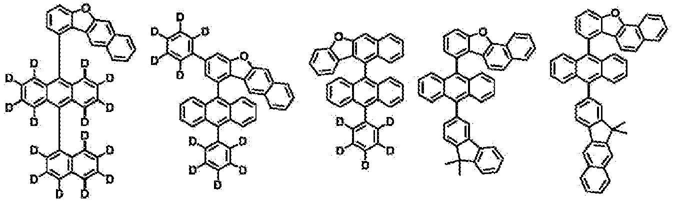

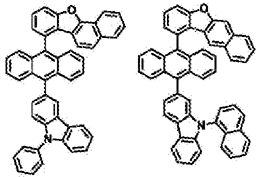

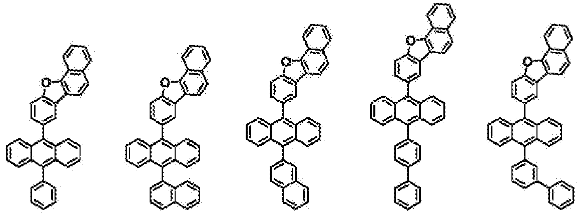

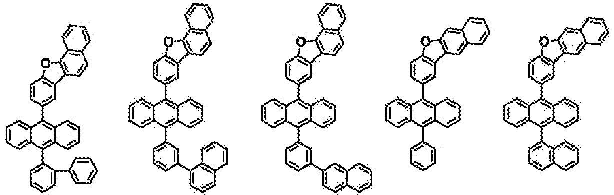

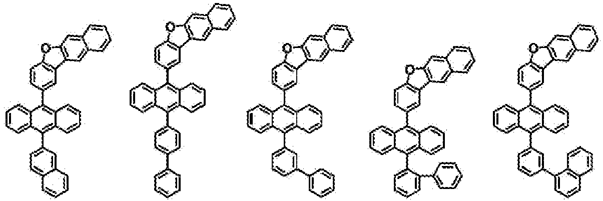

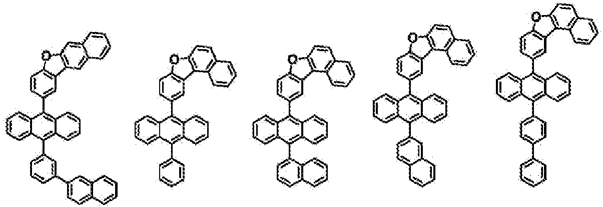

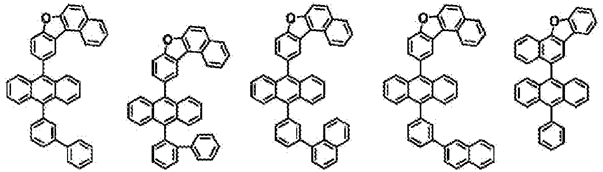

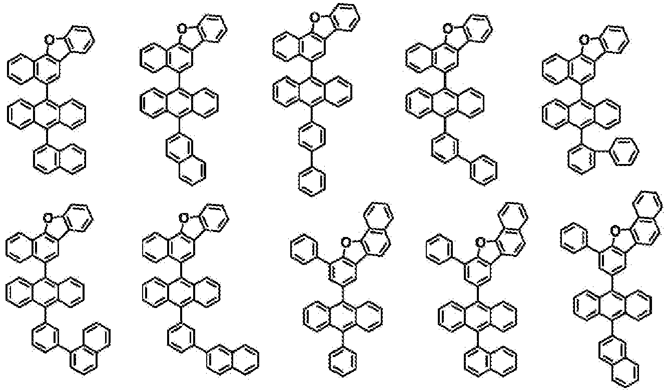

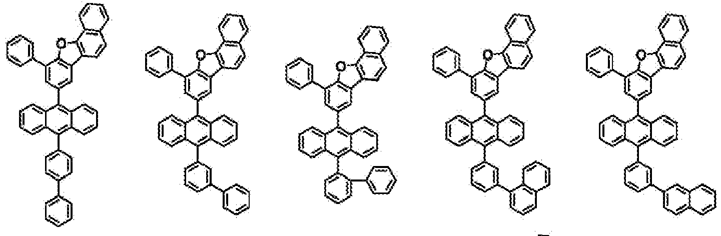

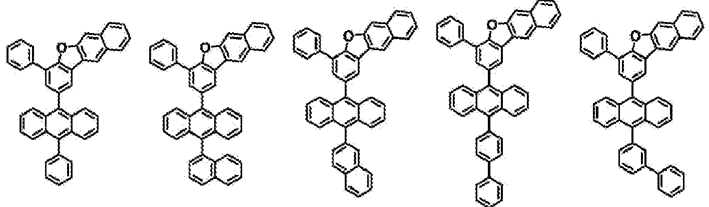

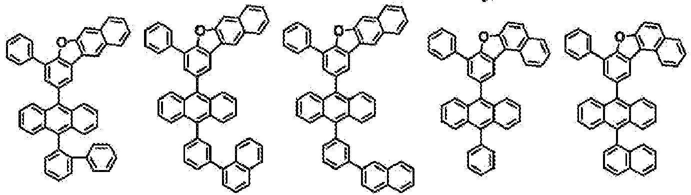

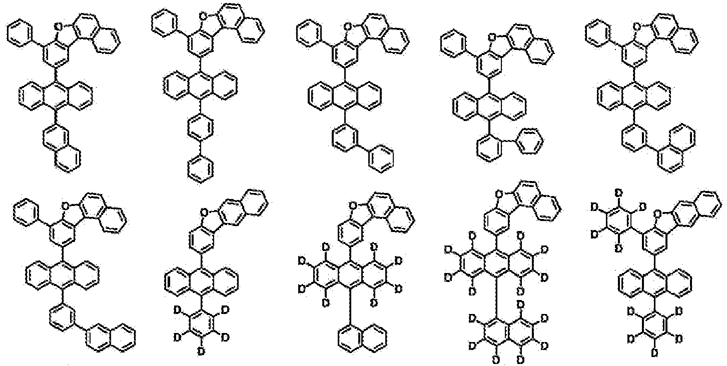

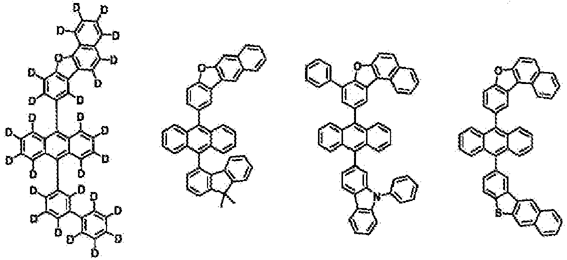

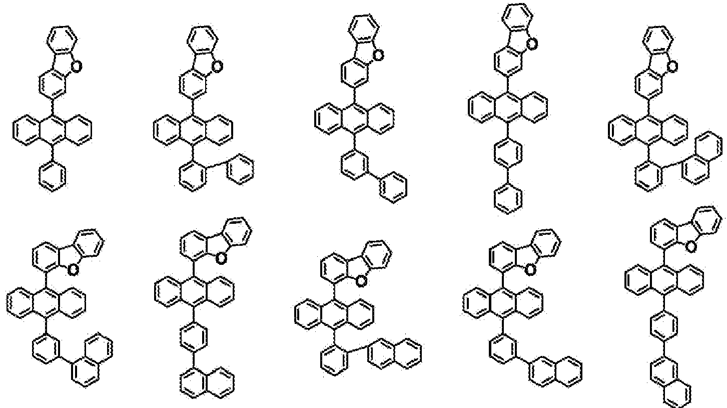

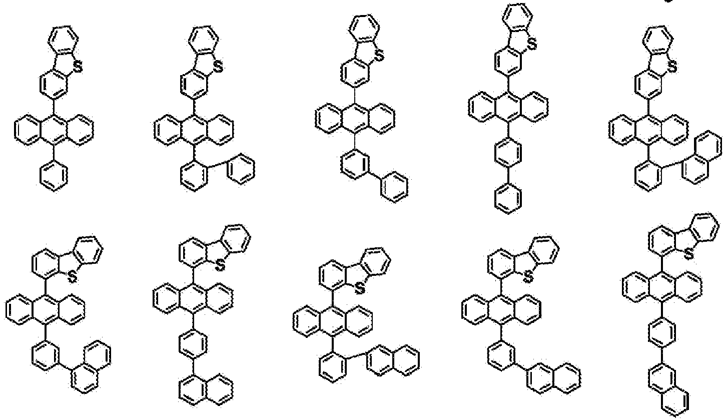

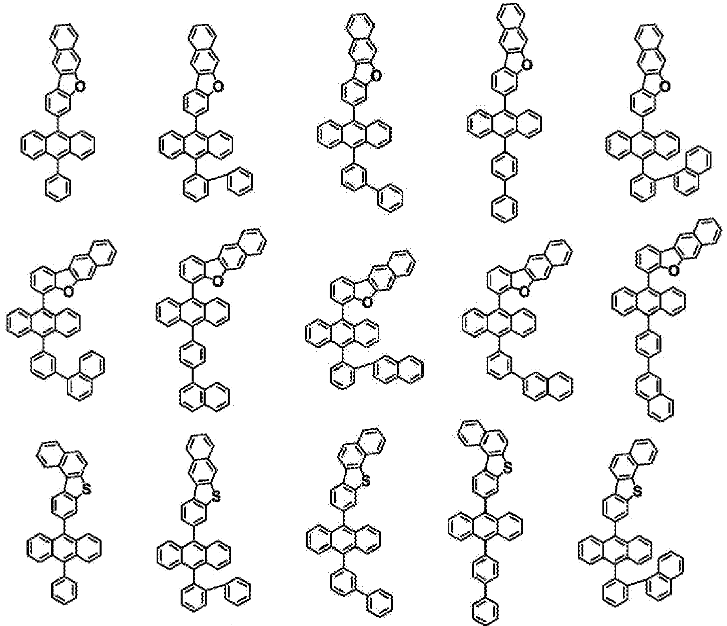

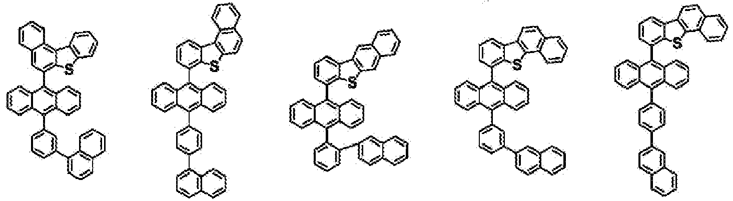

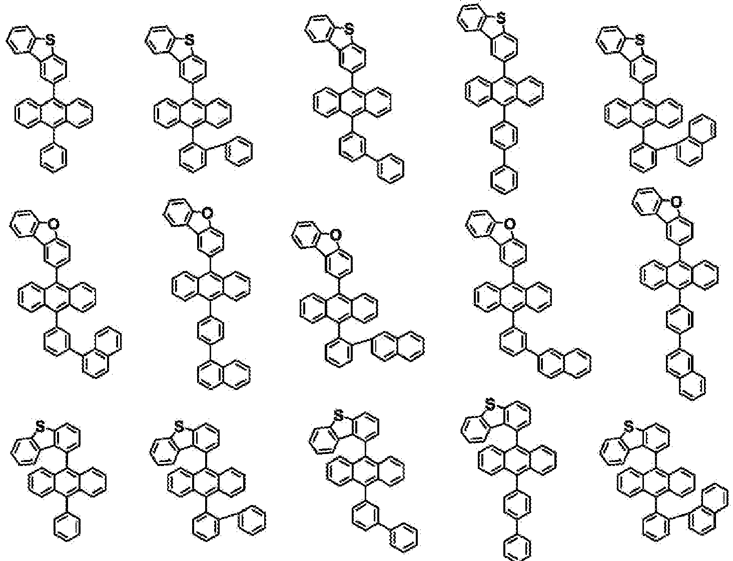

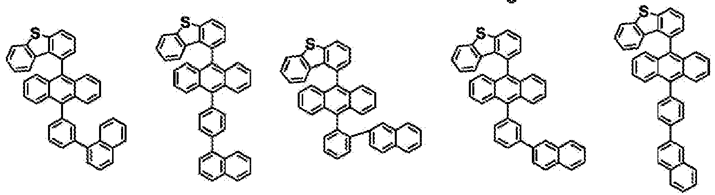

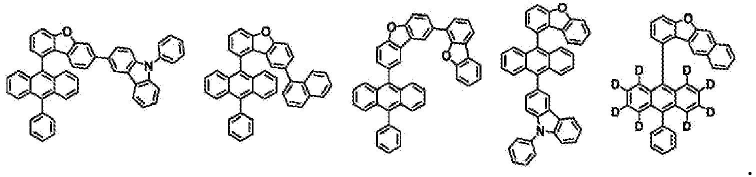

13. The organic light emitting device of Claim 1, wherein the light emitting layer includes the compound represented by Chemical Formula 1; and the compound represented by Chemical Formula H in a weight ratio of 1:99 to 30:70.
